# EUROPEAN PATENT SPECIFICATION

(11) **EP 4 328 285 B1**
(45) Date of publication and mention of the grant of the patent: **22.07.2026**
(21) Application number: 23192596.7
(22) Date of filing: 22.08.2023
(51) Int. Cl.: C09K 11/06, C07F 15/00, H10K 50/11, H10K 85/30, H10K 85/60, H10K 101/10, H10K 59/12, H10K 59/32

(54) **ORGANIC ELECTROLUMINESCENT MATERIAL AND DEVICE THEREOF**
ORGANISCHES ELEKTROLUMINESZENZMATERIAL UND VORRICHTUNG DAFÜR
MATÉRIAU ÉLECTROLUMINESCENT ORGANIQUE ET DISPOSITIF ASSOCIÉ

(30) Priority: 25.08.2022 CN 202211022393; 22.03.2023 CN 202310280294; 13.07.2023 CN 202310859895
(43) Date of publication of application: 28.02.2024
(73) Proprietor: Beijing Summer Sprout Technology Co., Ltd., Beijing 102308 (CN)
(72) Inventor: WANG, Zheng, Beijing, 102308 (CN); LI, Hongbo, Beijing, 102308 (CN); WANG, Zhen, Beijing, 102308 (CN); CAI, Wei, Beijing, 102308 (CN); KWONG, Chi Yuen Raymond, Beijing, 102308 (CN); XIA, Chuanjun, Beijing, 102308 (CN)
(74) Representative: Ricker, Mathias

(56) References cited:
- EP-A1- 3 825 320
- CN-A- 109 311 922
- CN-A- 111 655 705
- US-A1- 2017 069 848
- US-A1- 2022 165 968

## Description

### TECHNICAL FIELD

The present disclosure relates to compounds for organic electronic devices such as organic light-emitting devices. More particularly, the present disclosure relates to a metal complex comprising a ligand Lₐ having a structure of Formula 1, an organic electroluminescent device comprising the metal complex and a composition comprising the metal complex.

### BACKGROUND

Organic electronic devices include, but are not limited to, the following types: organic light-emitting diodes (OLEDs), organic field-effect transistors (O-FETs), organic light-emitting transistors (OLETs), organic photovoltaic devices (OPVs), dye-sensitized solar cells (DSSCs), organic optical detectors, organic photoreceptors, organic field-quench devices (OFQDs), light-emitting electrochemical cells (LECs), organic laser diodes and organic plasmon emitting devices.

In 1987, Tang and Van Slyke of Eastman Kodak reported a bilayer organic electroluminescent device, which includes an arylamine hole transporting layer and a tris-8-hydroxyquinolato-aluminum layer as the electron and emitting layer (Applied Physics Letters, 1987, 51 (12): 913-915). Once a bias is applied to the device, green light was emitted from the device. This device laid the foundation for the development of modern organic light-emitting diodes (OLEDs). State-of-the-art OLEDs may include multiple layers such as charge injection and transporting layers, charge and exciton blocking layers, and one or multiple emissive layers between the cathode and anode. Since the OLED is a self-emitting solid state device, it offers tremendous potential for display and lighting applications. In addition, the inherent properties of organic materials, such as their flexibility, may make them well suited for particular applications such as fabrication on flexible substrates.

The OLED can be categorized as three different types according to its emitting mechanism. The OLED invented by Tang and van Slyke is a fluorescent OLED. It only utilizes singlet emission. The triplets generated in the device are wasted through nonradiative decay channels. Therefore, the internal quantum efficiency (IQE) of the fluorescent OLED is only 25%. This limitation hindered the commercialization of OLED. In 1997, Forrest and Thompson reported phosphorescent OLED, which uses triplet emission from heavy metal containing complexes as the emitter. As a result, both singlet and triplets can be harvested, achieving 100% IQE. The discovery and development of phosphorescent OLED contributed directly to the commercialization of active-matrix OLED (AMOLED) due to its high efficiency. Recently, Adachi achieved high efficiency through thermally activated delayed fluorescence (TADF) of organic compounds. These emitters have small singlet-triplet gap that makes the transition from triplet back to singlet possible. In the TADF device, the triplet excitons can go through reverse intersystem crossing to generate singlet excitons, resulting in high IQE.

OLEDs can also be classified as small molecule and polymer OLEDs according to the forms of the materials used. A small molecule refers to any organic or organometallic material that is not a polymer. The molecular weight of the small molecule can be large as long as it has well defined structure. Dendrimers with well-defined structures are considered as small molecules. Polymer OLEDs include conjugated polymers and non-conjugated polymers with pendant emitting groups. Small molecule OLED can become the polymer OLED if post polymerization occurred during the fabrication process.

There are various methods for OLED fabrication. Small molecule OLEDs are generally fabricated by vacuum thermal evaporation. Polymer OLEDs are fabricated by solution process such as spin-coating, inkjet printing, and slit printing. If the material can be dissolved or dispersed in a solvent, the small molecule OLED can also be produced by solution process.

The emitting color of the OLED can be achieved by emitter structural design. An OLED may include one emitting layer or a plurality of emitting layers to achieve desired spectrum. In the case of green, yellow, and red OLEDs, phosphorescent emitters have successfully reached commercialization. Blue phosphorescent device still suffers from non-saturated blue color, short device lifetime, and high operating voltage. Commercial full-color OLED displays normally adopt a hybrid strategy, using fluorescent blue and phosphorescent yellow, or red and green. At present, efficiency roll-off of phosphorescent OLEDs at high brightness remains a problem. In addition, it is desirable to have more saturated emitting color, higher efficiency, and longer device lifetime.

At present, full-color displays are widely applied to our work and life, such as a display of a mobile phone, a display of a computer and an advertising display in a shopping mall. The displays are mainly used for displaying texts, graphics, animations, videos and other information, and imaging display is performed by pixel units of the displays. Each pixel unit displays full-color pictures of different colors by controlling RGB subpixels and is composed of one or more RGB subpixels. The color reproduction generally refers to a color that can be exhibited by RGB subpixels in the display. BT.2020 is a current color gamut requirement with the highest color reproduction. The higher the BT.2020 coverage of the full-color display, the higher the color reproduction of the full-color display. Although the color gamut specification of BT.2020 is higher, the three primary colors of BT.2020 are too saturated, which is difficult for general devices to achieve. The color coordinates of the red, green and blue primary colors are required to be (0.708, 0.292), (0.131, 0.046) and (0.170, 0.797) in BT. 2020, respectively. At present, both a red light device and a blue light device in a commonly used display panel can basically meet the color gamut requirement. However, the display panel is mainly limited by the performance of a green light device. At present, the green light device does not meet the color gamut requirement, and a color coordinate of the green light device needs to be adjusted to be close to the requirement of BT.2020.

CN111655705A has disclosed a metal complex having the following structure: 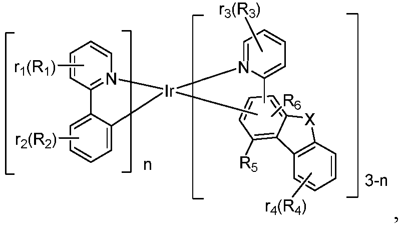 where R₅ is selected from groups such as halogen, a nitrile group, a nitro group, ... and substituted or unsubstituted alkyl having 3 to 30 carbon atoms, and CN111655705A has further disclosed the following specific structures: 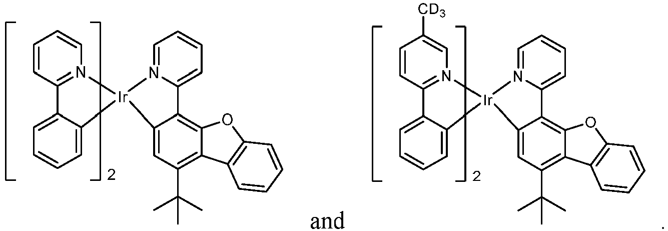 The application does not disclose or teach other particular substituents which are present at particular positions while a quaternary carbon atom is present at a position of R₅ in the metal complex and an effect of the metal complex on device performance.

The US 2017/069848 A1 discloses a composition of matter that includes a novel combination of host compounds containing indol-fused hosts and emissive dopants containing benzofuran or azabenzofuran ligand.

The EP 3 825 320 A1 discloses a an organometallic compound represented by the following formula, an organic light-emitting device including the organometallic compound, and a diagnostic composition including the organometallic compound, the formula being M(L₁)ₙ₁(L₂)ₙ₂.

### SUMMARY

The present disclosure aims to provide a series of metal complexes each comprising a ligand Lₐ having a structure of Formula 1 to solve at least part of the above-mentioned problems, where the ligand Lₐ has a (6-5-6)-multi-membered fused cyclic structural unit and comprises particular substituents R₁ and Rₙ. These new metal complexes are applied to electroluminescent devices so that very excellent device performance can be obtained, the luminescence performance of the devices can be significantly improved, more saturated luminescence can be obtained and a BT.2020 requirement for commercial application is met.

According to an embodiment of the present disclosure, disclosed is a metal complex, which comprises a metal M and a ligand Lₐ coordinated to the metal M, wherein Lₐ has a structure represented by Formula 1: 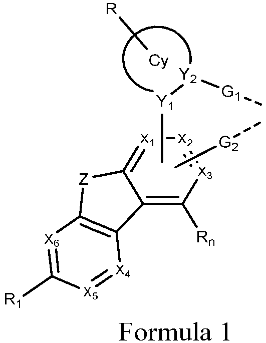 wherein in Formula 1,
the ring Cy is, at each occurrence identically or differently, selected from an aromatic ring having 6 to 24 ring atoms which comprises Y₁ and Y₂, a heteroaromatic ring having 5 to 24 ring atoms which comprises Y₁ and Y₂ or a combination thereof;
G₁ and G₂ are, at each occurrence identically or differently, selected from a single bond, O or S;
X₁ to X₆ are, at each occurrence identically or differently, selected from C, CRₓ or N, and one of X₁ to X₃ is selected from C and joined to Y₁;
one of X₁, X₂ and X₃ is selected from N and joined to the metal through a metal-nitrogen bond, or one of X₁, X₂ and X₃ is selected from C and joined to the metal through G₂;
Y₁ and Y₂ are, at each occurrence identically or differently, selected from C or N;
Z is selected from the group consisting of O, S, Se, NR', CR'R', SiR'R' and GeR'R'; when two R' are present at the same time, the two R' are identical or different;
R represents mono-substitution, multiple substitutions or non-substitution; when a plurality of R are present, the plurality of R are identical or different;
R, Rₓ and R' are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
R₁ is selected from a cyano group or fluorine; and
Rₙ has a structure represented by Formula 2: 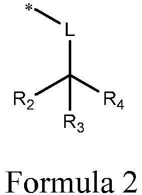
wherein in Formula 2, "*" represents a position where Formula 2 is joined to Formula 1;
L is selected from the group consisting of: a single bond, substituted or unsubstituted alkylene having 1 to 20 carbon atoms, substituted or unsubstituted cycloalkylene having 3 to 20 carbon atoms, substituted or unsubstituted arylene having 6 to 30 carbon atoms, substituted or unsubstituted heteroarylene having 3 to 30 carbon atoms and combinations thereof;
R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring;
adjacent substituents R' and Rₓ can be optionally joined to form a ring; and
adjacent substituents R₂, R₃ and R₄ can be optionally joined to form a ring.

According to another embodiment of the present disclosure, further disclosed is an organic electroluminescent device, which comprises an anode, a cathode and an organic layer disposed between the anode and the cathode, wherein at least one layer of the organic layer comprises the metal complex in the preceding embodiment.

According to another embodiment of the present disclosure, further disclosed is a composition, which comprises the metal complex in the preceding embodiment.

The present disclosure discloses the series of metal complexes each comprising the ligand Lₐ having the structure of Formula 1 to solve at least part of the above-mentioned problems, where the ligand Lₐ has the (6-5-6)-multi-membered fused cyclic structural unit and comprises the particular substituents R₁ and Rₙ. These new compounds are applied to the electroluminescent devices so that very excellent device performance can be obtained, full widths at half maximum of emission spectra can be further reduced while high performance of the devices can be maintained, the luminescence saturation of the devices can be improved and the devices can have high efficiency under a condition of being closer to a BT.2020 commercial luminescence requirement.

### BRIEF DESCRIPTION OF DRAWINGS

FIG. 1 is a schematic diagram of an organic light-emitting apparatus that may comprise a metal complex and a composition comprising the metal complex disclosed herein.
FIG. 2 is a schematic diagram of another organic light-emitting apparatus that may comprise a metal complex and a composition comprising the metal complex disclosed herein.
FIG. 3 is a structure diagram of a typical top-emitting OLED device.

### DETAILED DESCRIPTION

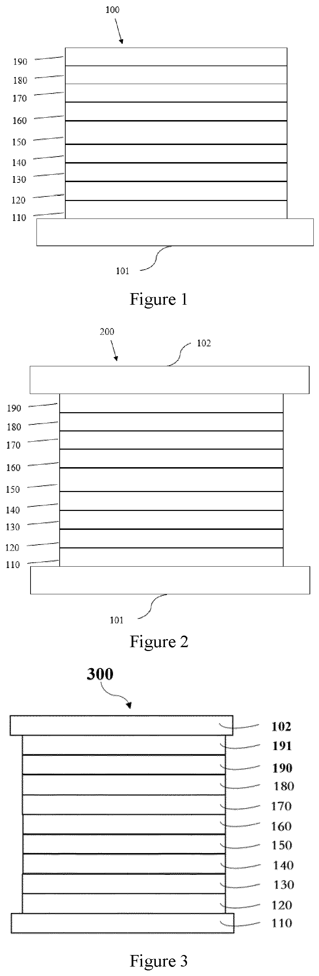

OLEDs can be fabricated on various types of substrates such as glass, plastic, and metal foil. FIG. 1 schematically shows an organic light-emitting device 100 without limitation. The figures are not necessarily drawn to scale. Some of the layers in the figures can also be omitted as needed. Device 100 may include a substrate 101, an anode 110, a hole injection layer 120, a hole transport layer 130, an electron blocking layer 140, an emissive layer 150, a hole blocking layer 160, an electron transport layer 170, an electron injection layer 180 and a cathode 190. Device 100 may be fabricated by depositing the layers described in order. The properties and functions of these various layers, as well as example materials, are described in more detail in U.S. Pat. No. 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F4-TCNQ at a molar ratio of 50:1, as disclosed in U.S. Patent Application Publication No. 2003/0230980. Examples of host materials are disclosed in U.S. Pat. No. 6,303,238 to Thompson et al.. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745, disclose examples of cathodes including composite cathodes having a thin layer of metal such as Mg:Ag with an overlying transparent, electrically-conductive, sputter-deposited ITO layer. The theory and use of blocking layers are described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

As used herein, the term "color coordinates" refers to the corresponding coordinates in the CIE 1931 color space.

A structure of a typical top-emitting OLED device is shown in FIG. 3. An OLED device 300 includes an anode 110, a hole injection layer (HIL) 120, a hole transporting layer (HTL) 130, an electron blocking layer (EBL) 140 (also referred to as a prime layer), an emissive layer (EML) 150, a hole blocking layer (HBL) 160 (optional), an electron transporting layer (ETL) 170, an electron injection layer (EIL) 180, a cathode 190, a capping layer 191, and an encapsulation layer 102. The anode 110 is a material or a combination of materials having a high reflectivity, including, but not limited to, Ag, Al, Ti, Cr, Pt, Ni, TiN, and a combination of the above materials with ITO and/or MoOx (molybdenum oxide). Generally, the reflectivity of the anode is greater than 50%; preferably, the reflectivity of the anode is greater than 70 %; more preferably, the reflectivity of the anode is greater than 80 %. The cathode 190 should be a translucent or transparent conductive material, including, but not limited to, a MgAg alloy, MoOx, Yb, Ca, ITO, IZO, or a combination thereof, and the average transmittance of the cathode for light having a wavelength in a visible light region is greater than 15%; preferably, the average transmittance of the cathode for light having a wavelength in the visible light region is greater than 20 %; more preferably, the average transmittance of the cathode for light having a wavelength in the visible light region is greater than 25 %. The hole injection layer 120 may be a single material layer such as commonly used HATCN. The hole injection layer 120 may also be a hole transporting material doped with a certain proportion of conductive p-type doping material, where the doping proportion is generally not higher than 5 % and commonly between 1 % and 3 %. The EBL 140 is optional. However, to better match an energy level of a host material, a device structure with the EBL is generally adopted. The thickness of the hole transporting layer is generally between 100 nm and 200 nm. Since the top-emitting device has a microcavity effect, the microcavity of the device is usually adjusted by adjusting the thickness of the hole transporting layer or the electron blocking layer. For example, to achieve the best microcavity effect of the top-emitting OLED device, that is, to achieve a highest value of current efficiency, the thickness of the EBL may be fixed, and then the microcavity may be adjusted by adjusting the thickness of the HTL. Apparently, those skilled in the art can understand that when two top-emitting devices differ only in that different materials are used in one organic layer, for example, different organic materials are only used in the EML (other functional layers use the same materials), since the different organic materials in the EML may have slightly different refractive indexes, the optimal microcavity lengths of the two top-emitting devices may be slightly different. That is, to achieve the same setting condition (such as CEₘₐₓ, CIEx coordinate, or EQEₘₐₓ), the optimal microcavity lengths of different top-emitting devices may be slightly different.

The layered structure described above is provided by way of non-limiting examples. Functional OLEDs may be achieved by combining the various layers described in different ways, or layers may be omitted entirely. It may also include other layers not specifically described. Within each layer, a single material or a mixture of multiple materials can be used to achieve optimum performance. Any functional layer may include several sublayers. For example, the emissive layer may have two layers of different emitting materials to achieve desired emission spectrum.

In one embodiment, an OLED may be described as having an "organic layer" disposed between a cathode and an anode. This organic layer may include a single layer or multiple layers.

An OLED can be encapsulated by a barrier layer. FIG. 2 schematically shows an organic light emitting device 200 without limitation. FIG. 2 differs from FIG. 1 in that the organic light emitting device include a barrier layer 102, which is above the cathode 190, to protect it from harmful species from the environment such as moisture and oxygen. Any material that can provide the barrier function can be used as the barrier layer such as glass or organic-inorganic hybrid layers. The barrier layer should be placed directly or indirectly outside of the OLED device. Multilayer thin film encapsulation was described in U.S. Pat. No. 7,968,146.

Devices fabricated in accordance with embodiments of the present disclosure can be incorporated into a wide variety of consumer products that have one or more of the electronic component modules (or units) incorporated therein. Some examples of such consumer products include flat panel displays, monitors, medical monitors, televisions, billboards, lights for interior or exterior illumination and/or signaling, heads-up displays, fully or partially transparent displays, flexible displays, smart phones, tablets, phablets, wearable devices, smart watches, laptop computers, digital cameras, camcorders, viewfinders, micro-displays, 3-D displays, vehicles displays, and vehicle tail lights.

The materials and structures described herein may be used in other organic electronic devices listed above.

As used herein, "top" means furthest away from the substrate, while "bottom" means closest to the substrate. Where a first layer is described as "disposed over" a second layer, the first layer is disposed further away from the substrate. There may be other layers between the first and second layers, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the transition between the triplet states and the singlet excited states. Compounds that are capable of generating E-type delayed fluorescence are required to have very small singlet-triplet gaps to convert between energy states. Thermal energy can activate the transition from the triplet state back to the singlet state. This type of delayed fluorescence is also known as thermally activated delayed fluorescence (TADF). A distinctive feature of TADF is that the delayed component increases as temperature rises. If the reverse intersystem crossing (RISC) rate is fast enough to minimize the non-radiative decay from the triplet state, the fraction of back populated singlet excited states can potentially reach 75%. The total singlet fraction can be 100%, far exceeding 25% of the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔE_{S-T}).Organic, non-metal containing, donor-acceptor luminescent materials may be able to achieve this. The emission in these materials is generally characterized as a donor-acceptor charge-transfer (CT) type emission. The spatial separation of the HOMO and LUMO in these donor-acceptor type compounds generally results in small ΔE_{S-T}. These states may involve CT states. Generally, donor-acceptor luminescent materials are constructed by connecting an electron donor moiety such as amino- or carbazole-derivatives and an electron acceptor moiety such as N-containing six-membered aromatic rings.

### Definition of terms of substituents

Halogen or halide - as used herein includes fluorine, chlorine, bromine, and iodine.

Alkyl - as used herein includes both straight and branched chain alkyl groups. Alkyl may be alkyl having 1 to 20 carbon atoms, preferably alkyl having 1 to 12 carbon atoms, and more preferably alkyl having 1 to 6 carbon atoms. Examples of alkyl groups include a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neopentyl group, a 1-methylpentyl group, a 2-methylpentyl group, a 1-pentylhexyl group, a 1-butylpentyl group, a 1-heptyloctyl group, and a 3-methylpentyl group.Of the above, preferred are a methyl group, an ethyl group, a propyl group, an isopropyl group, a n-butyl group, an s-butyl group, an isobutyl group, a t-butyl group, an n-pentyl group, a neopentyl group, and an n-hexyl group. Additionally, the alkyl group may be optionally substituted.

Cycloalkyl - as used herein includes cyclic alkyl groups. The cycloalkyl groups may be those having 3 to 20 ring carbon atoms, preferably those having 4 to 10 carbon atoms. Examples of cycloalkyl include cyclobutyl, cyclopentyl, cyclohexyl, 4-methylcyclohexyl, 4,4-dimethylcylcohexyl, 1-adamantyl, 2-adamantyl, 1-norbornyl, 2-norbornyl, and the like. Of the above, preferred are cyclopentyl, cyclohexyl, 4-methylcyclohexyl, and 4,4-dimethylcylcohexyl. Additionally, the cycloalkyl group may be optionally substituted.

Heteroalkyl - as used herein, includes a group formed by replacing one or more carbons in an alkyl chain with a hetero-atom(s) selected from the group consisting of a nitrogen atom, an oxygen atom, a sulfur atom, a selenium atom, a phosphorus atom, a silicon atom, a germanium atom, and a boron atom. Heteroalkyl may be those having 1 to 20 carbon atoms, preferably those having 1 to 10 carbon atoms, and more preferably those having 1 to 6 carbon atoms. Examples of heteroalkyl include methoxymethyl, ethoxymethyl, ethoxyethyl, methylthiomethyl, ethylthiomethyl, ethylthioethyl, methoxymethoxymethyl, ethoxymethoxymethyl, ethoxyethoxyethyl, hydroxymethyl, hydroxyethyl, hydroxypropyl, mercaptomethyl, mercaptoethyl, mercaptopropyl, aminomethyl, aminoethyl, aminopropyl, dimethylaminomethyl, trimethylgermanylmethyl, trimethylgermanylethyl, trimethylgermanylisopropyl, dimethylethylgermanylmethyl, dimethylisopropylgermanylmethyl, tert-butylmethylgermanylmethyl, triethylgermanylmethyl, triethylgermanylethyl, triisopropylgermanylmethyl, triisopropylgermanylethyl, trimethylsilylmethyl, trimethylsilylethyl, and trimethylsilylisopropyl, triisopropylsilylmethyl, triisopropylsilylethyl. Additionally, the heteroalkyl group may be optionally substituted.

Alkenyl - as used herein includes straight chain, branched chain, and cyclic alkene groups. Alkenyl may be those having 2 to 20 carbon atoms, preferably those having 2 to 10 carbon atoms. Examples of alkenyl include vinyl, 1-propenyl group, 1-butenyl, 2-butenyl, 3-butenyl, 1,3-butandienyl, 1-methylvinyl, styryl, 2,2-diphenylvinyl, 1,2-diphenylvinyl, 1-methylallyl, 1,1-dimethylallyl, 2-methylallyl, 1-phenylallyl, 2-phenylallyl, 3-phenylallyl, 3,3-diphenylallyl, 1,2-dimethylallyl, 1-phenyl-1-butenyl, 3-phenyl-1-butenyl, cyclopentenyl, cyclopentadienyl, cyclohexenyl, cycloheptenyl, cycloheptatrienyl, cyclooctenyl, cyclooctatetraenyl, and norbornenyl. Additionally, the alkenyl group may be optionally substituted.

Alkynyl - as used herein includes straight chain alkynyl groups. Alkynyl may be those having 2 to 20 carbon atoms, preferably those having 2 to 10 carbon atoms. Examples of alkynyl groups include ethynyl, propynyl, propargyl, 1-butynyl, 2-butynyl, 3-butynyl, 1-pentynyl, 2-pentynyl, 3,3-dimethyl-1-butynyl, 3-ethyl-3-methyl-1-pentynyl, 3,3-diisopropyl-1-pentynyl, phenylethynyl, phenylpropynyl, etc. Of the above, preferred are ethynyl, propynyl, propargyl, 1-butynyl, 2-butynyl, 3-butynyl, 1-pentynyl, and phenylethynyl. Additionally, the alkynyl group may be optionally substituted.

Aryl or an aromatic group - as used herein includes non-condensed and condensed systems. Aryl may be those having 6 to 30 carbon atoms, preferably those having 6 to 20 carbon atoms, and more preferably those having 6 to 12 carbon atoms. Examples of aryl groups include phenyl, biphenyl, terphenyl, triphenylene, tetraphenylene, naphthalene, anthracene, phenalene, phenanthrene, fluorene, pyrene, chrysene, perylene, and azulene, preferably phenyl, biphenyl, terphenyl, triphenylene, fluorene, and naphthalene. Examples of non-condensed aryl groups include phenyl, biphenyl-2-yl, biphenyl-3-yl, biphenyl-4-yl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-(2-phenylpropyl)phenyl, 4'-methylbiphenylyl, 4"-t-butyl-p-terphenyl-4-yl, o-cumenyl, m-cumenyl, p-cumenyl, 2,3-xylyl, 3,4-xylyl, 2,5-xylyl, mesityl, and m-quarterphenyl. Additionally, the aryl group may be optionally substituted.

Heterocyclic groups or heterocycle - as used herein include non-aromatic cyclic groups. Non-aromatic heterocyclic groups includes saturated heterocyclic groups having 3 to 20 ring atoms and unsaturated non-aromatic heterocyclic groups having 3 to 20 ring atoms, where at least one ring atom is selected from the group consisting of a nitrogen atom, an oxygen atom, a sulfur atom, a selenium atom, a silicon atom, a phosphorus atom, a germanium atom, and a boron atom. Preferred non-aromatic heterocyclic groups are those having 3 to 7 ring atoms, each of which includes at least one hetero-atom such as nitrogen, oxygen, silicon, or sulfur. Examples of non-aromatic heterocyclic groups include oxiranyl, oxetanyl, tetrahydrofuranyl, tetrahydropyranyl, dioxolanyl, dioxanyl, aziridinyl, dihydropyrrolyl, tetrahydropyrrolyl, piperidinyl, oxazolidinyl, morpholinyl, piperazinyl, oxepinyl, thiepinyl, azepinyl, and tetrahydrosilolyl. Additionally, the heterocyclic group may be optionally substituted.

Heteroaryl - as used herein, includes non-condensed and condensed hetero-aromatic groups having 1 to 5 hetero-atoms, where at least one hetero-atom is selected from the group consisting of a nitrogen atom, an oxygen atom, a sulfur atom, a selenium atom, a silicon atom, a phosphorus atom, a germanium atom, and a boron atom. A hetero-aromatic group is also referred to as heteroaryl. Heteroaryl may be those having 3 to 30 carbon atoms, preferably those having 3 to 20 carbon atoms, and more preferably those having 3 to 12 carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridoindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Alkoxy - as used herein, is represented by -O-alkyl, -O-cycloalkyl, -O-heteroalkyl, or - O-heterocyclic group. Examples and preferred examples of alkyl, cycloalkyl, heteroalkyl, and heterocyclic groups are the same as those described above. Alkoxy groups may be those having 1 to 20 carbon atoms, preferably those having 1 to 6 carbon atoms. Examples of alkoxy groups include methoxy, ethoxy, propoxy, butoxy, pentyloxy, hexyloxy, cyclopropyloxy, cyclobutyloxy, cyclopentyloxy, cyclohexyloxy, tetrahydrofuranyloxy, tetrahydropyranyloxy, methoxypropyloxy, ethoxyethyloxy, methoxymethyloxy, and ethoxymethyloxy. Additionally, the alkoxy group may be optionally substituted.

Aryloxy - as used herein, is represented by -O-aryl or -O-heteroaryl. Examples and preferred examples of aryl and heteroaryl are the same as those described above. Aryloxy groups may be those having 6 to 30 carbon atoms, preferably those having 6 to 20 carbon atoms. Examples of aryloxy groups include phenoxy and biphenyloxy. Additionally, the aryloxy group may be optionally substituted.

Arylalkyl - as used herein, contemplates alkyl substituted with an aryl group. Arylalkyl may be those having 7 to 30 carbon atoms, preferably those having 7 to 20 carbon atoms, and more preferably those having 7 to 13 carbon atoms. Examples of arylalkyl groups include benzyl, 1-phenylethyl, 2-phenylethyl, 1-phenylisopropyl, 2-phenylisopropyl, phenyl-t-butyl, alpha-naphthylmethyl, 1-alpha-naphthylethyl, 2-alpha-naphthylethyl, 1-alpha-naphthylisopropyl, 2-alpha-naphthylisopropyl, beta-naphthylmethyl, 1-beta-naphthylethyl, 2-beta-naphthylethyl, 1-beta-naphthylisopropyl, 2-beta-naphthylisopropyl, p-methylbenzyl, m-methylbenzyl, o-methylbenzyl, p-chlorobenzyl, m-chlorobenzyl, o-chlorobenzyl, p-bromobenzyl, m-bromobenzyl, o-bromobenzyl, p-iodobenzyl, m-iodobenzyl, o-iodobenzyl, p-hydroxybenzyl, m-hydroxybenzyl, o-hydroxybenzyl, p-aminobenzyl, m-aminobenzyl, o-aminobenzyl, p-nitrobenzyl, m-nitrobenzyl, o-nitrobenzyl, p-cyanobenzyl, m-cyanobenzyl, o-cyanobenzyl, 1-hydroxy-2-phenylisopropyl, and 1-chloro-2-phenylisopropyl. Of the above, preferred are benzyl, p-cyanobenzyl, m-cyanobenzyl, o-cyanobenzyl, 1-phenylethyl, 2-phenylethyl, 1-phenylisopropyl, and 2-phenylisopropyl. Additionally, the arylalkyl group may be optionally substituted.

Alkylsilyl - as used herein, contemplates a silyl group substituted with an alkyl group. Alkylsilyl groups may be those having 3 to 20 carbon atoms, preferably those having 3 to 10 carbon atoms. Examples of alkylsilyl groups include trimethylsilyl, triethylsilyl, methyldiethylsilyl, ethyldimethylsilyl, tripropylsilyl, tributylsilyl, triisopropylsilyl, methyldiisopropylsilyl, dimethylisopropylsilyl, tri-t-butylsilyl, triisobutylsilyl, dimethyl t-butylsilyl, and methyldi-t-butylsilyl. Additionally, the alkylsilyl group may be optionally substituted.

Arylsilyl - as used herein, contemplates a silyl group substituted with an aryl group. Arylsilyl groups may be those having 6 to 30 carbon atoms, preferably those having 8 to 20 carbon atoms. Examples of arylsilyl groups include triphenylsilyl, phenyldibiphenylylsilyl, diphenylbiphenylsilyl, phenyldiethylsilyl, diphenylethylsilyl, phenyldimethylsilyl, diphenylmethylsilyl, phenyldiisopropylsilyl, diphenylisopropylsilyl, diphenylbutylsilyl, diphenylisobutylsilyl, diphenyl t-butylsilyl. Additionally, the arylsilyl group may be optionally substituted.

Alkylgermanyl - as used herein contemplates a germanyl substituted with an alkyl group. The alkylgermanyl may be those having 3 to 20 carbon atoms, preferably those having 3 to 10 carbon atoms. Examples of alkylgermanyl include trimethylgermanyl, triethylgermanyl, methyldiethylgermanyl, ethyldimethylgermanyl, tripropylgermanyl, tributylgermanyl, triisopropylgermanyl, methyldiisopropylgermanyl, dimethylisopropylgermanyl, tri-t-butylgermanyl, triisobutylgermanyl, dimethyl-t-butylgermanyl, and methyldi-t-butylgermanyl. Additionally, the alkylgermanyl may be optionally substituted.

Arylgermanyl - as used herein contemplates a germanyl substituted with at least one aryl group or heteroaryl group. Arylgermanyl may be those having 6 to 30 carbon atoms, preferably those having 8 to 20 carbon atoms. Examples of arylgermanyl include triphenylgermanyl, phenyldibiphenylylgermanyl, diphenylbiphenylgermanyl, phenyldiethylgermanyl, diphenylethylgermanyl, phenyldimethylgermanyl, diphenylmethylgermanyl, phenyldiisopropylgermanyl, diphenylisopropylgermanyl, diphenylbutylgermanyl, diphenylisobutylgermanyl, and diphenyl-t-butylgermanyl. Additionally, the arylgermanyl may be optionally substituted.

The term "aza" in azadibenzofuran, azadibenzothiophene, etc. means that one or more of C-H groups in the respective aromatic fragment are replaced by a nitrogen atom. For example, azatriphenylene encompasses dibenzo[f,h]quinoxaline, dibenzo[f,h]quinoline and other analogs with two or more nitrogens in the ring system. One of ordinary skill in the art can readily envision other nitrogen analogs of the aza-derivatives described above, and all such analogs are intended to be encompassed by the terms as set forth herein.

In the present disclosure, unless otherwise defined, when any term of the group consisting of substituted alkyl, substituted cycloalkyl, substituted heteroalkyl, substituted heterocyclic group, substituted arylalkyl, substituted alkoxy, substituted aryloxy, substituted alkenyl, substituted alkynyl, substituted aryl, substituted heteroaryl, substituted alkylsilyl, substituted arylsilyl, substituted alkylgermanyl, substituted arylgermanyl, substituted amino, substituted acyl, substituted carbonyl, a substituted carboxylic acid group, a substituted ester group, a substituted hydroxyl group, a substituted sulfanyl group, substituted sulfinyl, substituted sulfonyl, and substituted phosphino is used, it means that any group of alkyl, cycloalkyl, heteroalkyl, heterocyclic group, arylalkyl, alkoxy, aryloxy, alkenyl, alkynyl, aryl, heteroaryl, alkylsilyl, arylsilyl, amino, acyl, carbonyl, a carboxylic acid group, an ester group, hydroxyl group, sulfanyl group, sulfinyl, sulfonyl, and phosphino may be substituted with one or more moieties selected from the group consisting of deuterium, halogen, unsubstituted alkyl having 1 to 20 carbon atoms, unsubstituted cycloalkyl having 3 to 20 ring carbon atoms, unsubstituted heteroalkyl having 1 to 20 carbon atoms, an unsubstituted heterocyclic group having 3 to 20 ring atoms, unsubstituted arylalkyl having 7 to 30 carbon atoms, unsubstituted alkoxy having 1 to 20 carbon atoms, unsubstituted aryloxy having 6 to 30 carbon atoms, unsubstituted alkenyl having 2 to 20 carbon atoms, unsubstituted alkynyl having 2 to 20 carbon atoms, unsubstituted aryl having 6 to 30 carbon atoms, unsubstituted heteroaryl having 3 to 30 carbon atoms, unsubstituted alkylsilyl having 3 to 20 carbon atoms, unsubstituted arylsilyl having 6 to 20 carbon atoms, unsubstituted alkylgermanyl having 3 to 20 carbon atoms, unsubstituted arylgermanyl group having 6 to 20 carbon atoms, unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or an attached fragment are considered to be equivalent.

In the compounds mentioned in the present disclosure, hydrogen atoms may be partially or fully replaced by deuterium. Other atoms such as carbon and nitrogen may also be replaced by their other stable isotopes. The replacement by other stable isotopes in the compounds may be preferred due to its enhancements of device efficiency and stability.

In the compounds mentioned in the present disclosure, multiple substitution refers to a range that includes a di-substitution, up to the maximum available substitution. When substitution in the compounds mentioned in the present disclosure represents multiple substitution (including di-, tri-, and tetra-substitutions, etc.), that means the substituent may exist at a plurality of available substitution positions on its linking structure, the substituents present at a plurality of available substitution positions may be the same structure or different structures.

In the compounds mentioned in the present disclosure, adjacent substituents in the compounds cannot be joined to form a ring unless otherwise explicitly defined, for example, adjacent substituents can be optionally joined to form a ring. In the compounds mentioned in the present disclosure, the expression that adjacent substituents can be optionally joined to form a ring includes a case where adjacent substituents may be joined to form a ring and a case where adjacent substituents are not joined to form a ring. When adjacent substituents can be optionally joined to form a ring, the ring formed may be monocyclic or polycyclic (including spirocyclic, endocyclic, fusedcyclic, and etc.), as well as alicyclic, heteroalicyclic, aromatic, or heteroaromatic. In such expression, adjacent substituents may refer to substituents bonded to the same atom, substituents bonded to carbon atoms which are directly bonded to each other, or substituents bonded to carbon atoms which are more distant from each other. Preferably, adjacent substituents refer to substituents bonded to the same carbon atom and substituents bonded to carbon atoms which are directly bonded to each other.

The expression that adjacent substituents can be optionally joined to form a ring is also intended to mean that two substituents bonded to the same carbon atom are joined to each other via a chemical bond to form a ring, which can be exemplified by the following formula:

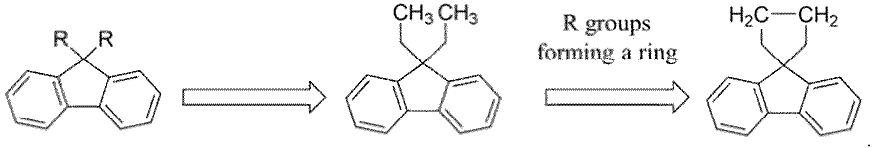

The expression that adjacent substituents can be optionally joined to form a ring is also intended to mean that two substituents bonded to carbon atoms which are directly bonded to each other are joined to each other via a chemical bond to form a ring, which can be exemplified by the following formula:

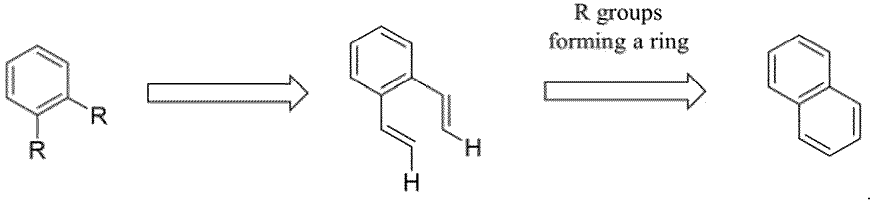

The expression that adjacent substituents can be optionally joined to form a ring is also intended to mean that two substituents bonded to a further distant carbon atom are joined to each other via a chemical bond to form a ring, which can be exemplified by the following formula:

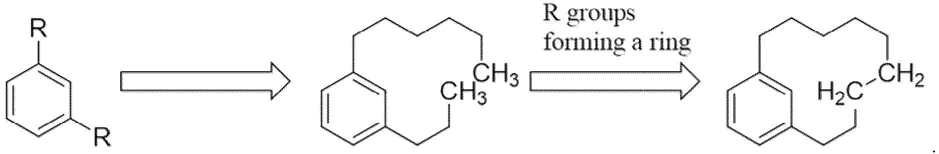

Furthermore, the expression that adjacent substituents can be optionally joined to form a ring is also intended to mean that, in the case where one of the two substituents bonded to carbon atoms which are directly bonded to each other represents hydrogen, the second substituent is bonded at a position at which the hydrogen atom is bonded, thereby forming a ring. This is exemplified by the following formula:

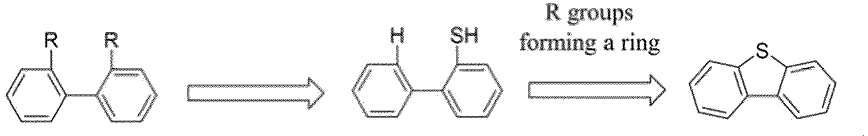

According to an embodiment of the present disclosure, disclosed is a metal complex, which comprises a metal M and a ligand Lₐ coordinated to the metal M, wherein Lₐ has a structure represented by Formula 1: 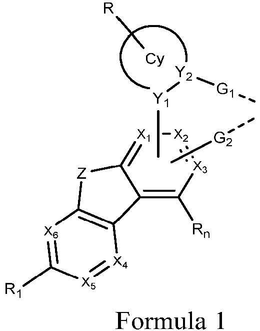 wherein in Formula 1,
the ring Cy is, at each occurrence identically or differently, selected from an aromatic ring having 6 to 24 ring atoms which comprises Y₁ and Y₂, a heteroaromatic ring having 5 to 24 ring atoms which comprises Y₁ and Y₂ or a combination thereof;
G₁ and G₂ are, at each occurrence identically or differently, selected from a single bond, O or S;
X₁ to X₆ are, at each occurrence identically or differently, selected from C, CRₓ or N, and one of X₁ to X₃ is selected from C and joined to Y₁;
one of X₁, X₂ and X₃ is selected from N and joined to the metal through a metal-nitrogen bond, or one of X₁, X₂ and X₃ is selected from C and joined to the metal through G₂;
Y₁ and Y₂ are, at each occurrence identically or differently, selected from C or N;
Z is selected from the group consisting of O, S, Se, NR', CR'R', SiR'R' and GeR'R'; when two R' are present at the same time, the two R' are identical or different;
R represents mono-substitution, multiple substitutions or non-substitution; when a plurality of R are present, the plurality of R are identical or different;
R, Rₓ and R' are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
R₁ is selected from a cyano group or fluorine; and
Rₙ has a structure represented by Formula 2: 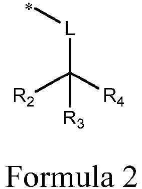
wherein in Formula 2, "*" represents a position where Formula 2 is joined to Formula 1;
L is selected from the group consisting of: a single bond, substituted or unsubstituted alkylene having 1 to 20 carbon atoms, substituted or unsubstituted cycloalkylene having 3 to 20 carbon atoms, substituted or unsubstituted arylene having 6 to 30 carbon atoms, substituted or unsubstituted heteroarylene having 3 to 30 carbon atoms and combinations thereof;
R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring;
adjacent substituents R' and Rₓ can be optionally joined to form a ring; and
adjacent substituents R₂, R₃ and R₄ can be optionally joined to form a ring.

In the present disclosure, the expression that "adjacent substituents R can be optionally joined to form a ring" is intended to mean that any one or more of groups of adjacent substituents, such as two substituents R, can be joined to form a ring. Obviously, it is also possible that none of these substituents are j oined to form a ring.

In the present disclosure, the expression that "adjacent substituents R' and Rₓ can be optionally joined to form a ring" is intended to mean that any one or more of groups of adjacent substituents, such as two substituents R', two substituents Rₓ, and substituents R' and Rₓ, can be joined to form a ring. Obviously, it is also possible that none of these substituents are joined to form a ring.

In the present disclosure, the expression that "adjacent substituents R₂, R₃ and R₄ can be optionally joined to form a ring" is intended to mean that any one or more of groups of adjacent substituents, such as substituents R₂ and R₃, substituents R₂ and R₄, and substituents R₄ and R₃, can be joined to form a ring. Obviously, it is also possible that none of these substituents are joined to form a ring.

According to an embodiment of the present disclosure, 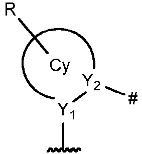 in Formula 1 is, at each occurrence identically or differently, selected from any one of the following structures: 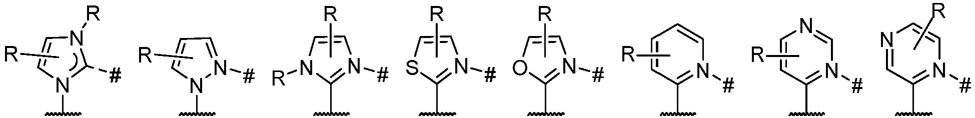 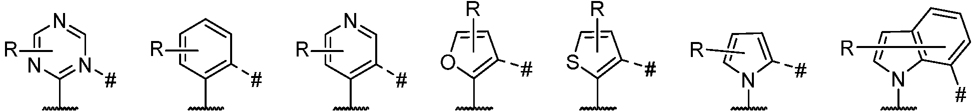 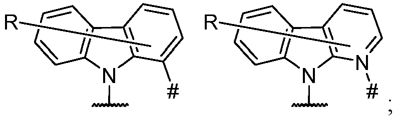 wherein
R represents, at each occurrence identically or differently, mono-substitution, multiple substitutions or non-substitution; when a plurality of R are present in any structure, the plurality of R are identical or different;
R is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring; and
"#" represents a position where G₁ is joined, and " 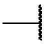 " represents a position where X₁, X₂ or X₃ is joined.

According to an embodiment of the present disclosure, the metal complex has a general formula of M(Lₐ)ₘ(L_{b})ₙ(L_{c})_{q};
Lₐ, L_{b} and L_{c} are a first ligand, a second ligand and a third ligand coordinated to the metal M, respectively, and L_{c} is the same as or different from Lₐ or L_{b}, wherein Lₐ, L_{b} and L_{c} can be optionally joined to form a multidentate ligand;
m is selected from 1, 2 or 3, n is selected from 0, 1 or 2, q is selected from 0, 1 or 2, and m+n+q is equal to an oxidation state of the metal M; when m is greater than or equal to 2, a plurality of Lₐ are identical or different; when n is equal to 2, two L_{b} are identical or different; when q is equal to 2, two L_{c} are identical or different;
Lₐ has, at each occurrence identically or differently, a structure represented by any one of Formula 1-1 to Formula 1-14: 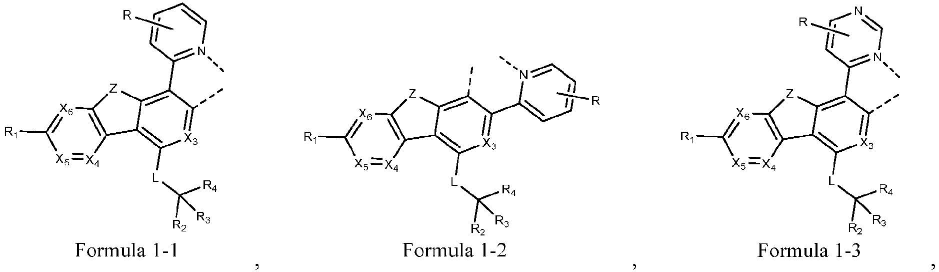 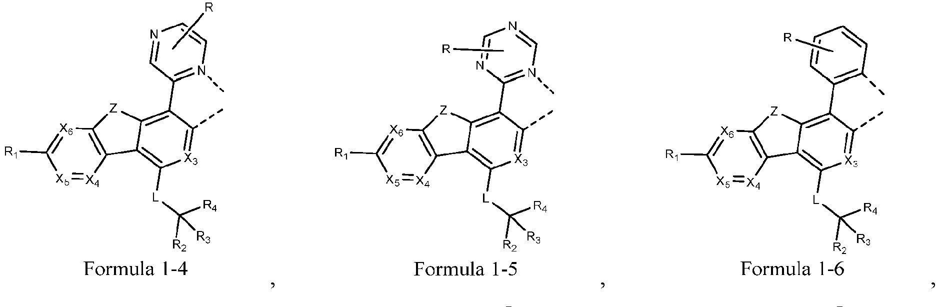 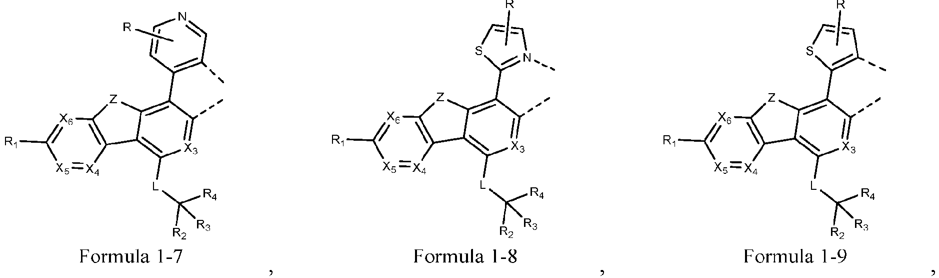 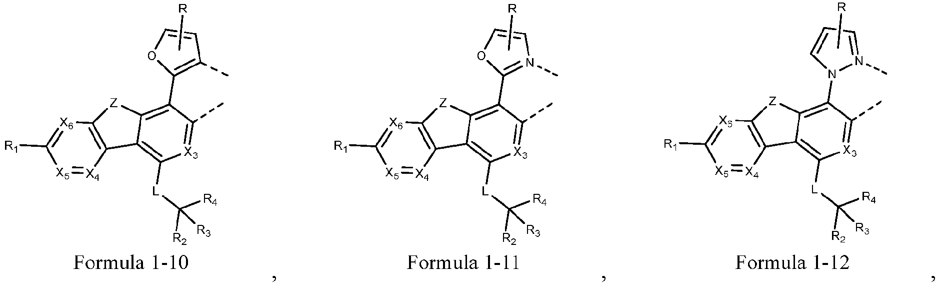 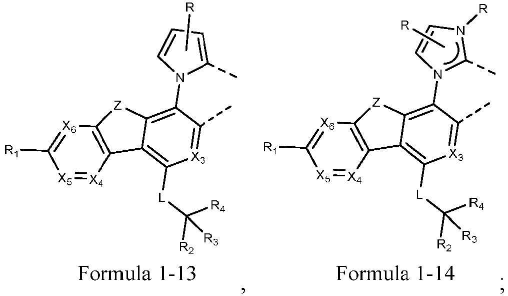
Z is selected from the group consisting of O, S, Se, NR', CR'R', SiR'R' and GeR'R'; when two R' are present at the same time, the two R' are identical or different;
X₃ to X₆ are, at each occurrence identically or differently, selected from CRₓ or N;
R represents mono-substitution, multiple substitutions or non-substitution; when a plurality of R are present, the plurality of R are identical or different;
R₁ is selected from a cyano group or fluorine;
L is selected from the group consisting of: a single bond, substituted or unsubstituted alkylene having 1 to 20 carbon atoms, substituted or unsubstituted cycloalkylene having 3 to 20 carbon atoms, substituted or unsubstituted arylene having 6 to 30 carbon atoms, substituted or unsubstituted heteroarylene having 3 to 30 carbon atoms and combinations thereof;
**R,** Rₓ and R' are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
R₂, R₃ and R₄ are, at each occurrence identically or differently, selected from the group consisting of: fluorine, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring;
adjacent substituents R' and Rₓ can be optionally joined to form a ring;
adjacent substituents R₂, R₃ and R₄ can be optionally joined to form a ring; and
L_{b} and L_{c} are, at each occurrence identically or differently, selected from a monoanionic bidentate ligand.

According to an embodiment of the present disclosure, L_{b} and L_{c} are, at each occurrence identically or differently, selected from a structure represented by any one of the group consisting of: 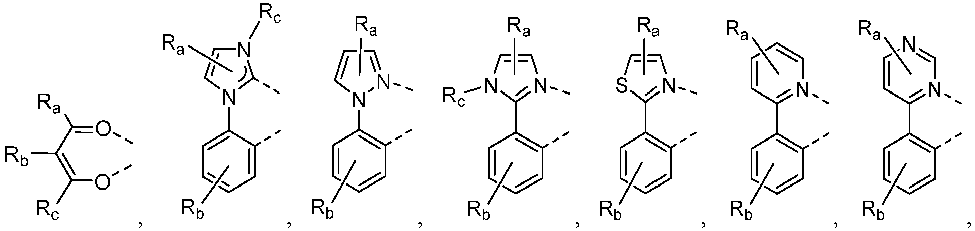 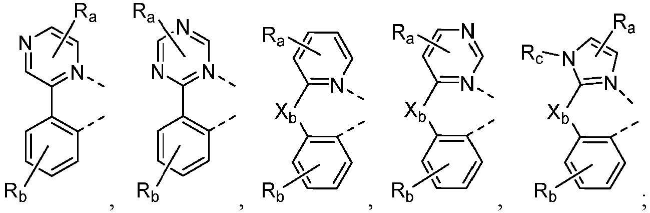 wherein
X_{b} is, at each occurrence identically or differently, selected from the group consisting of: O, S, Se, NR_{N1} and CR_{C1}R_{C2};
Rₐ and R_{b} represent, at each occurrence identically or differently, mono-substitution, multiple substitutions or non-substitution;
Rₐ, R_{b}, R_{c}, R_{N1}, R_{C1} and R_{C2} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents Rₐ, R_{b}, R_{c}, R_{N1}, R_{C1} and R_{C2} can be optionally joined to form a ring.

In the present disclosure, the expression that "adjacent substituents Rₐ, R_{b}, R_{c}, R_{N1}, R_{C1} and R_{C2} can be optionally joined to form a ring" is intended to mean that any one or more of groups of adjacent substituents, such as two substituents Rₐ, two substituents R_{b}, substituents Rₐ and R_{b}, substituents Rₐ and R_{c}, substituents R_{b} and R_{c}, substituents Rₐ and R_{N1}, substituents R_{b} and R_{N1}, substituents Rₐ and R_{C1}, substituents Rₐ and R_{C2}, substituents R_{b} and R_{C1}, substituents R_{b} and R_{C2}, and substituents R_{C1} and R_{C2}, can be joined to form a ring. Obviously, it is also possible that none of these substituents are joined to form a ring. For example, adjacent substituents Rₐ and R_{b} in 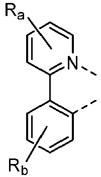 can be optionally joined to form a ring. When Rₐ is optionally joined to form a ring, 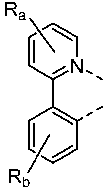 may form a structure of

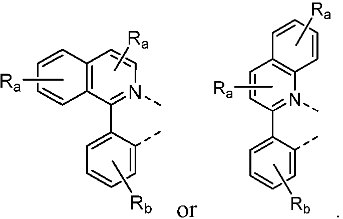

According to an embodiment of the present disclosure, the metal M is, at each occurrence identically or differently, selected from Pt or Ir.

According to an embodiment of the present disclosure, G₁ and G₂ are selected from a single bond.

According to an embodiment of the present disclosure, Y₁ is selected from C.

According to an embodiment of the present disclosure, the metal complex has a general formula structure of Ir(Lₐ)ₘ(L_{b})₃₋ₘ, and the structure is represented by Formula 3: 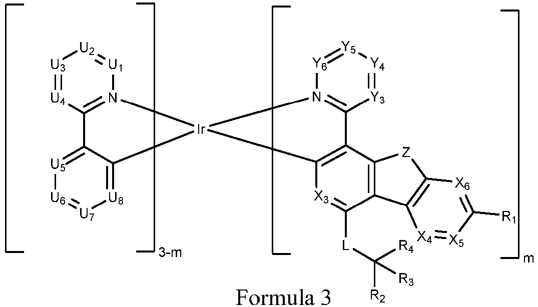 wherein
m is selected from 1, 2 or 3; when m is selected from 1, two L_{b} are identical or different; when m is selected from 2 or 3, a plurality of Lₐ are identical or different;
Z is selected from the group consisting of O, S, Se, NR', CR'R', SiR'R' and GeR'R'; when two R' are present at the same time, the two R' are identical or different;
U₁ to U₈ are, at each occurrence identically or differently, selected from CRᵤ or N;
X₃ to X₆ are, at each occurrence identically or differently, selected from CRₓ or N;
Y₃ to Y₆ are, at each occurrence identically or differently, selected from CR or N;
R₁ is selected from a cyano group or fluorine;
L is selected from the group consisting of: a single bond, substituted or unsubstituted alkylene having 1 to 20 carbon atoms, substituted or unsubstituted cycloalkylene having 3 to 20 carbon atoms, substituted or unsubstituted arylene having 6 to 30 carbon atoms, substituted or unsubstituted heteroarylene having 3 to 30 carbon atoms and combinations thereof;
R', Rᵤ, Rₓ and R are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents Rᵤ can be optionally joined to form a ring;
adjacent substituents R can be optionally joined to form a ring;
adjacent substituents R' and Rₓ can be optionally joined to form a ring; and
adjacent substituents R₂, R₃ and R₄ can be optionally joined to form a ring.

In the present disclosure, the expression that "adjacent substituents Rᵤ can be optionally joined to form a ring" is intended to mean that any one or more of groups of adjacent substituents, such as two substituents Rᵤ, can be joined to form a ring. Obviously, it is also possible that none of these substituents are joined to form a ring.

According to an embodiment of the present disclosure, Z is selected from O or S.

According to an embodiment of the present disclosure, Z is selected from O.

According to an embodiment of the present disclosure, L is selected from the group consisting of: a single bond, substituted or unsubstituted alkylene having 1 to 6 carbon atoms, substituted or unsubstituted cycloalkylene having 4 to 10 carbon atoms, substituted or unsubstituted arylene having 6 to 12 carbon atoms and combinations thereof.

According to an embodiment of the present disclosure, L is selected from a single bond and substituted or unsubstituted methylene.

According to an embodiment of the present disclosure, R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, a cyano group and combinations thereof.

According to an embodiment of the present disclosure, R₂, R₃ and R₄ are, at each occurrence identically or differently, selected from the group consisting of: fluorine, substituted or unsubstituted alkyl having 1 to 20 carbon atoms, substituted or unsubstituted aryl having 6 to 30 carbon atoms, a cyano group and combinations thereof.

According to an embodiment of the present disclosure, R₂, R₃ and R₄ are, at each occurrence identically or differently, selected from substituted or unsubstituted alkyl having 1 to 20 carbon atoms.

According to an embodiment of the present disclosure, R₂, R₃ and R₄ are, at each occurrence identically or differently, selected from substituted or unsubstituted alkyl having 1 to 6 carbon atoms.

According to an embodiment of the present disclosure, X₃ to X₆ are, at each occurrence identically or differently, selected from CRₓ.

According to an embodiment of the present disclosure, X₃ to X₆ are, at each occurrence identically or differently, selected from CRₓ or N, and at least one of X₃ to X₆ is N. For example, one of X₃ to X₆ is selected from N, or two of X₃ to X₆ are selected from N.

According to an embodiment of the present disclosure, X₆ is selected from N.

According to an embodiment of the present disclosure, Y₃ to Y₆ are, at each occurrence identically or differently, selected from CR.

According to an embodiment of the present disclosure, Y₃ to Y₆ are, at each occurrence identically or differently, selected from CR or N, and at least one of Y₃ to Y₆ is N. For example, one of Y₃ to Y₆ is selected from N, or two of Y₃ to Y₆ are selected from N.

According to an embodiment of the present disclosure, Rₓ and R are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted alkylgermanyl having 3 to 20 carbon atoms, a cyano group and combinations thereof.

According to an embodiment of the present disclosure, Rₓ and R are, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 12 carbon atoms, substituted or unsubstituted alkylgermanyl having 3 to 12 carbon atoms, a cyano group and combinations thereof.

According to an embodiment of the present disclosure, Rₓ and R are, at each occurrence identically or differently, selected from the group consisting of: hydrogen, deuterium, fluorine, a cyano group, methyl, ethyl, propyl, isopropyl, n-butyl, isobutyl, t-butyl, cyclopentyl, cyclohexyl, deuterated methyl, deuterated ethyl, deuterated propyl, deuterated isopropyl, deuterated n-butyl, deuterated isobutyl, deuterated t-butyl, deuterated cyclopentyl, deuterated cyclohexyl, phenyl, pyridyl, trimethylsilyl, trimethylgermanyl and combinations thereof.

According to an embodiment of the present disclosure, at least one R is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof.

According to an embodiment of the present disclosure, at least one R is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof.

According to an embodiment of the present disclosure, Y₃ to Y₆ are, at each occurrence identically or differently, selected from CR, and R is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted alkylsilyl having 3 to 20 carbon atoms, substituted or unsubstituted alkylgermanyl having 3 to 20 carbon atoms, a cyano group and combinations thereof.

According to an embodiment of the present disclosure, Y₃ to Y₆ are, at each occurrence identically or differently, selected from CR, and R is, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms and combinations thereof.

According to an embodiment of the present disclosure, at least one of X₃ to X₆ is selected from CRₓ, and Rₓ is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof.

According to an embodiment of the present disclosure, at least one of X₃ to X₆ is selected from CRₓ, and Rₓ is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, a cyano group and combinations thereof.

According to an embodiment of the present disclosure, at least one of X₃ to X₆ is selected from CRₓ, and Rₓ is selected from substituted or unsubstituted aryl having 6 to 30 carbon atoms, substituted or unsubstituted heteroaryl having 3 to 30 carbon atoms or a combination thereof.

According to an embodiment of the present disclosure, X₆ is selected from CRₓ, and Rₓ is selected from deuterium, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms or a combination thereof.

According to an embodiment of the present disclosure, X₆ is selected from CRₓ, and Rₓ is selected from substituted or unsubstituted aryl having 6 to 30 carbon atoms, substituted or unsubstituted heteroaryl having 3 to 30 carbon atoms or a combination thereof.

According to an embodiment of the present disclosure, X₆ is selected from CRₓ, and Rₓ is selected from substituted or unsubstituted aryl having 6 to 18 carbon atoms.

According to an embodiment of the present disclosure, X₆ is selected from CRₓ, and Rₓ is selected from substituted or unsubstituted phenyl, substituted or unsubstituted biphenyl, substituted or unsubstituted naphthyl, substituted or unsubstituted fluorenyl, substituted or unsubstituted phenanthryl, substituted or substituted anthryl or a combination thereof.

According to an embodiment of the present disclosure, at least one R is selected from the group consisting of: deuterium, halogen, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms and combinations thereof.

According to an embodiment of the present disclosure, at least one R is selected from the group consisting of: deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms and combinations thereof.

According to an embodiment of the present disclosure, Rₙ is, at each occurrence identically or differently, selected from the group consisting of: 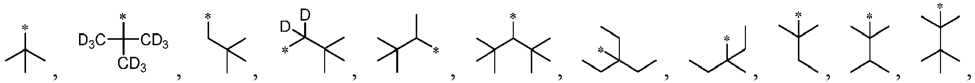 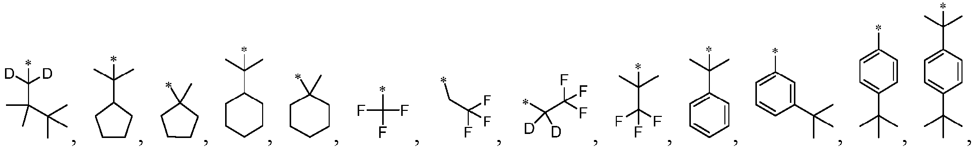 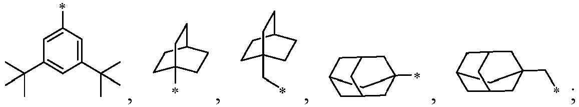 wherein optionally, hydrogens in the above Rₙ can be partially or fully substituted with deuterium.

According to an embodiment of the present disclosure, U₁ to U₈ are, at each occurrence identically or differently, selected from CRᵤ.

According to an embodiment of the present disclosure, U₁ to U₈ are, at each occurrence identically or differently, selected from CRᵤ or N, and at least one of U₁ to U₈ is selected from N. For example, one of U₁ to U₈ is selected from N, or two of U₁ to U₈ are selected from N.

According to an embodiment of the present disclosure, Rᵤ is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryloxy having 6 to 30 carbon atoms, substituted or unsubstituted alkenyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a cyano group, an isocyano group, a hydroxyl group, a sulfanyl group and combinations thereof.

According to an embodiment of the present disclosure, Rᵤ is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms and combinations thereof.

According to an embodiment of the present disclosure, Rᵤ is, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms and combinations thereof.

According to an embodiment of the present disclosure, Rᵤ is, at each occurrence identically or differently, selected from the group consisting of: hydrogen, deuterium, fluorine, a cyano group, methyl, ethyl, propyl, isopropyl, n-butyl, isobutyl, t-butyl, cyclopentyl, cyclohexyl, deuterated methyl, deuterated ethyl, deuterated propyl, deuterated isopropyl, deuterated n-butyl, deuterated isobutyl, deuterated t-butyl, deuterated cyclopentyl, deuterated cyclohexyl, phenyl, pyridyl, trimethylsilyl, trimethylgermanyl and combinations thereof.

According to an embodiment of the present disclosure, at least one or at least two of U₁ to U₈ are selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in all of Rᵤ is at least 4.

According to an embodiment of the present disclosure, at least one or at least two of U₅ to U₈ are selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in all of Rᵤ is at least 4.

According to an embodiment of the present disclosure, at least one or at least two of U₁ to U₄ are selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in all of Rᵤ is at least 4.

According to an embodiment of the present disclosure, U₆ or U₇ is selected from CRᵤ, and Rᵤ is selected from substituted or unsubstituted alkyl having 1 to 20 carbon atoms, substituted or unsubstituted cycloalkyl having 3 to 20 ring carbon atoms or a combination thereof.

According to an embodiment of the present disclosure, U₆ or U₇ is selected from CRᵤ, and Rᵤ is selected from substituted or unsubstituted alkyl having 4 to 20 carbon atoms, substituted or unsubstituted cycloalkyl having 4 to 20 ring carbon atoms or a combination thereof.

According to an embodiment of the present disclosure, at least one of U₁ to U₄ is selected from CRᵤ, at least one of Y₃ to Y₆ is selected from CR, Rᵤ and R are selected from substituted or unsubstituted alkyl having 1 to 20 carbon atoms, substituted or unsubstituted cycloalkyl having 3 to 20 ring carbon atoms or a combination thereof, and the total number of carbon atoms in Rᵤ and R is greater than or equal to 2.

According to an embodiment of the present disclosure, at least one of U₅ to U₈ is selected from CRᵤ, at least one of Y₃ to Y₆ is selected from CR, Rᵤ and R are selected from substituted or unsubstituted alkyl having 1 to 20 carbon atoms, substituted or unsubstituted cycloalkyl having 3 to 20 ring carbon atoms or a combination thereof, and the total number of carbon atoms in Rᵤ and R is greater than or equal to 2.

According to an embodiment of the present disclosure, at least one of U₁ to U₄ is selected from CRᵤ, at least one of U₅ to U₈ is selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in Rᵤ is greater than or equal to 2.

According to an embodiment of the present disclosure, R' is, at each occurrence identically or differently, selected from substituted or unsubstituted alkyl having 1 to 20 carbon atoms or substituted or unsubstituted cycloalkyl having 3 to 20 ring carbon atoms.

According to an embodiment of the present disclosure, R' is methyl or deuterated methyl.

According to an embodiment of the present disclosure, Lₐ is, at each occurrence identically or differently, selected from the group consisting of Lₐ₁ to Lₐ₃₅₃₀, wherein the specific structures of Lₐ₁ to Lₐ₃₅₃₀ are referred to claim 11.

According to an embodiment of the present disclosure, hydrogens in Lₐ₁ to Lₐ₃₅₃₀ can be partially or fully substituted with deuterium.

According to an embodiment of the present disclosure, L_{b} is, at each occurrence identically or differently, selected from the group consisting of L_{b1} to L_{b151}, wherein the specific structures of L_{b1} to L_{b151} are referred to claim 12.

According to an embodiment of the present disclosure, hydrogens in L_{b1} to L_{b18}, L_{b20} to L_{b26} and L_{b31} to L_{b151} can be partially or fully substituted with deuterium.

According to an embodiment of the present disclosure, L_{c} is, at each occurrence identically or differently, selected from the group consisting of:

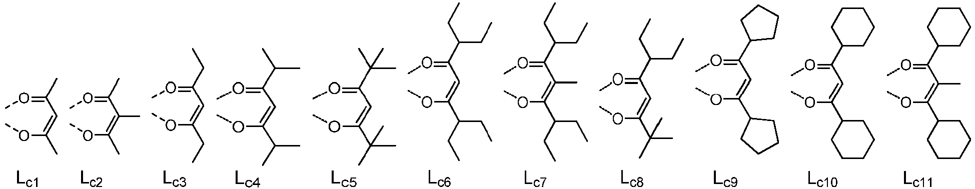

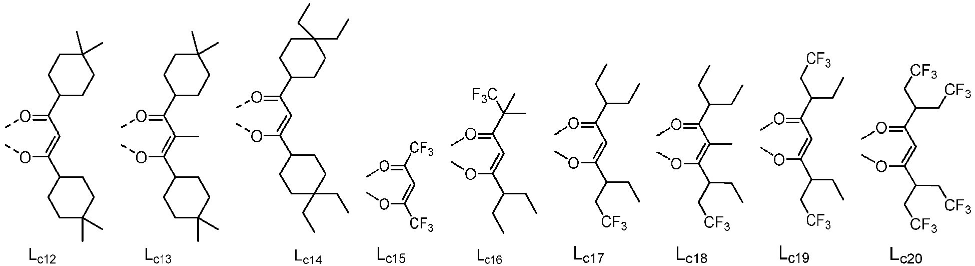

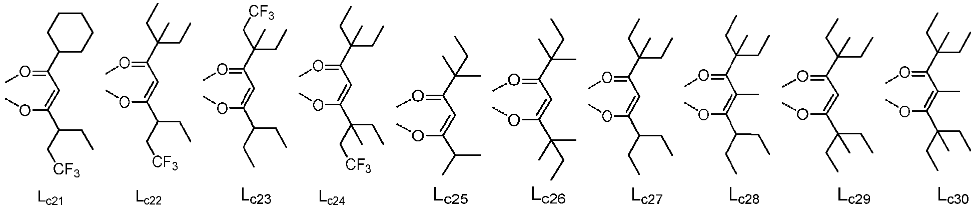

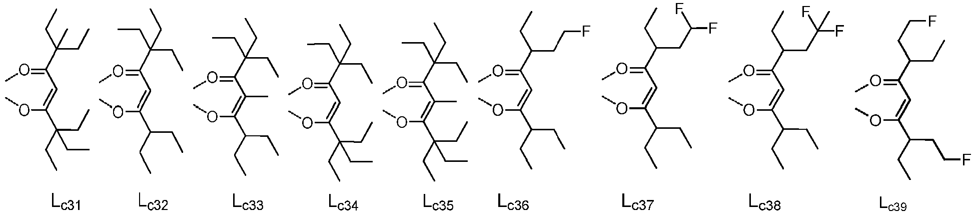

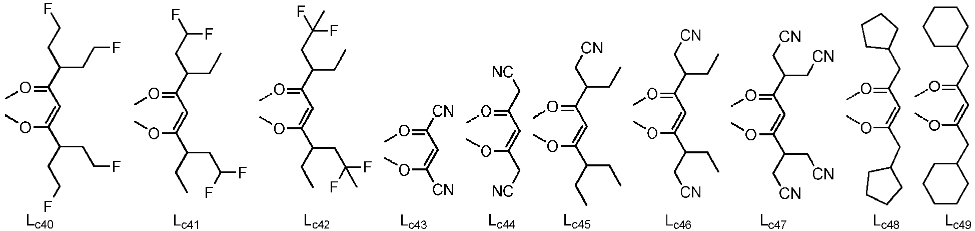

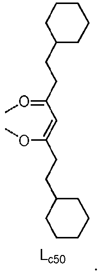

According to an embodiment of the present disclosure, the metal complex has a structure of Ir(Lₐ)₃, IrLₐ(L_{b})₂, Ir(Lₐ)₂L_{b}, Ir(Lₐ)₂L_{c}, IrLₐ(L_{c})₂ or IrLₐL_{b}L_{c}, wherein the ligand Lₐ is, at each occurrence identically or differently, selected from any one, any two or any three of the group consisting of Lₐ₁ to Lₐ₃₅₃₀, the ligand L_{b} is, at each occurrence identically or differently, selected from any one or any two of the group consisting of Lₐ₁ to L_{b151}, and the ligand L_{c} is, at each occurrence identically or differently, selected from any one or any two of the group consisting of L_{c1} to L_{c50}.

According to an embodiment of the present disclosure, the metal complex is selected from the group consisting of Metal Complex 1 to Metal Complex 3806, wherein the specific structures of Metal Complex 1 to Metal Complex 3806 are referred to claim 13.

According to an embodiment of the present disclosure, further disclosed is an organic electroluminescent device, which comprises an anode, a cathode and an organic layer disposed between the anode and the cathode, wherein at least one layer of the organic layer comprises the metal complex in any one of the preceding embodiments.

According to an embodiment of the present disclosure, in the organic electroluminescent device, the organic layer comprising the metal complex is a light-emitting layer.

According to an embodiment of the present disclosure, the organic electroluminescent device emits green light.

According to an embodiment of the present disclosure, the organic electroluminescent device emits white light.

According to an embodiment of the present disclosure, in the organic electroluminescent device, the light-emitting layer further comprises a first host compound.

According to an embodiment of the present disclosure, in the organic electroluminescent device, the light-emitting layer further comprises a first host compound and a second host compound.

According to an embodiment of the present disclosure, in the electroluminescent device, the first host compound and/or the second host compound comprise at least one chemical group selected from the group consisting of: benzene, pyridine, pyrimidine, triazine, carbazole, azacarbazole, indolocarbazole, dibenzothiophene, aza-dibenzothiophene, dibenzofuran, azadibenzofuran, dibenzoselenophene, triphenylene, azatriphenylene, fluorene, silafluorene, naphthalene, quinoline, isoquinoline, quinazoline, quinoxaline, phenanthrene, azaphenanthrene and combinations thereof.

According to an embodiment of the present disclosure, the first host compound has a structure represented by Formula X-1 or Formula X-2: 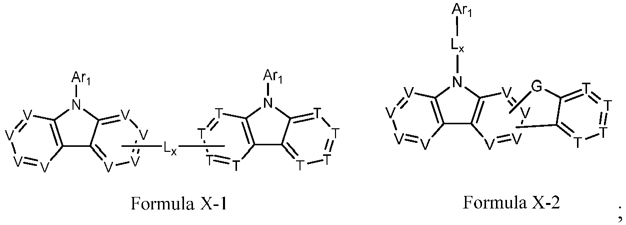 wherein
Lₓ is, at each occurrence identically or differently, selected from a single bond, substituted or unsubstituted alkylene having 1 to 20 carbon atoms, substituted or unsubstituted cycloalkylene having 3 to 20 carbon atoms, substituted or unsubstituted arylene having 6 to 20 carbon atoms, substituted or unsubstituted heteroarylene having 3 to 20 carbon atoms or a combination thereof;
G is, at each occurrence identically or differently, selected from C(R_{g})₂, NR_{g}, O or S;
V is, at each occurrence identically or differently, selected from C, CRᵥ or N;
in Formula X-1, T is, at each occurrence identically or differently, selected from C, CRt or N;
in Formula X-2, T is, at each occurrence identically or differently, selected from CRt or N;
R_{g}, Rᵥ and Rₜ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Ar₁ is, at each occurrence identically or differently, selected from substituted or unsubstituted aryl having 6 to 30 carbon atoms, substituted or unsubstituted heteroaryl having 3 to 30 carbon atoms or a combination thereof; and
adjacent substituents R_{g}, Rᵥ and Rₜ can be optionally joined to form a ring.

In this embodiment, the expression that "adjacent substituents R_{g}, Rᵥ and Rₜ can be optionally joined to form a ring" is intended to mean that any one or more of groups of adjacent substituents, such as two substituents Rᵥ, two substituents Rₜ, two substituents R_{g}, substituents Rᵥ and Rₜ, substituents Rᵥ and R_{g}, and substituents R_{g} and Rₜ, can be joined to form a ring. Obviously, it is also possible that none of these substituents are joined to form a ring.

According to an embodiment of the present disclosure, the first host compound has a structure represented by one of Formula X-a to Formula X-p: 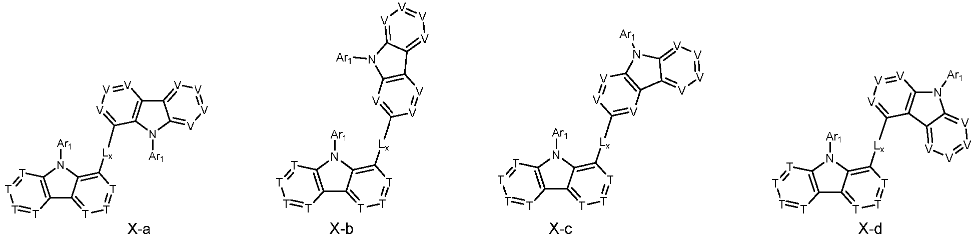 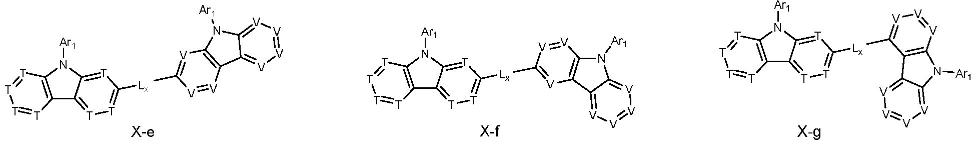 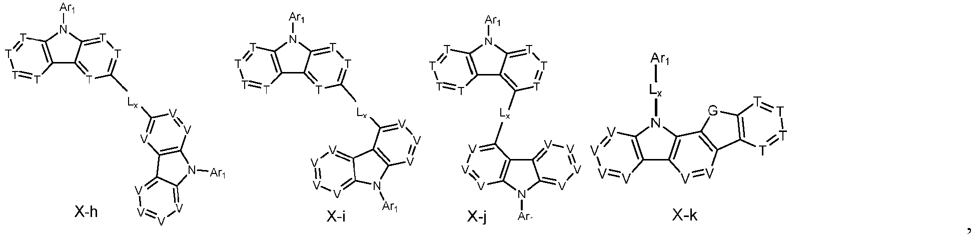 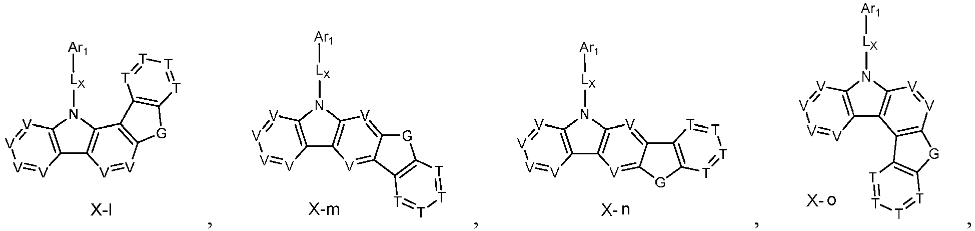 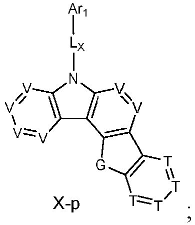 wherein
Lₓ is, at each occurrence identically or differently, selected from a single bond, substituted or unsubstituted alkylene having 1 to 20 carbon atoms, substituted or unsubstituted cycloalkylene having 3 to 20 carbon atoms, substituted or unsubstituted arylene having 6 to 20 carbon atoms, substituted or unsubstituted heteroarylene having 3 to 20 carbon atoms or a combination thereof;
G is, at each occurrence identically or differently, selected from C(R_{g})₂, NR_{g}, O or S;
V is, at each occurrence identically or differently, selected from CRᵥ or N;
T is, at each occurrence identically or differently, selected from CRt or N;
R_{g}, Rᵥ and Rₜ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
Ar₁ is, at each occurrence identically or differently, selected from substituted or unsubstituted aryl having 6 to 30 carbon atoms, substituted or unsubstituted heteroaryl having 3 to 30 carbon atoms or a combination thereof; and
adjacent substituents R_{g}, Rᵥ and Rₜ can be optionally joined to form a ring.

According to an embodiment of the present disclosure, the first host compound is selected from the group consisting of the following compounds:

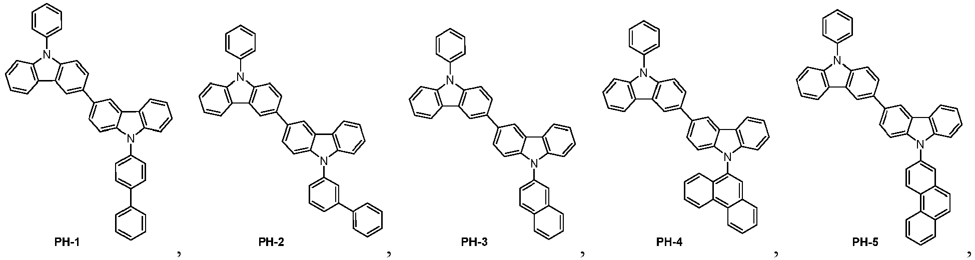

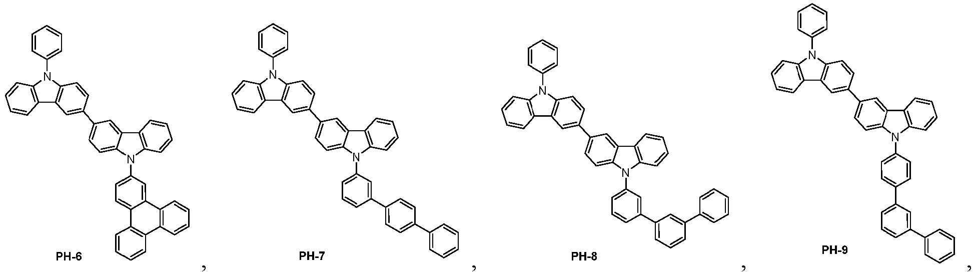

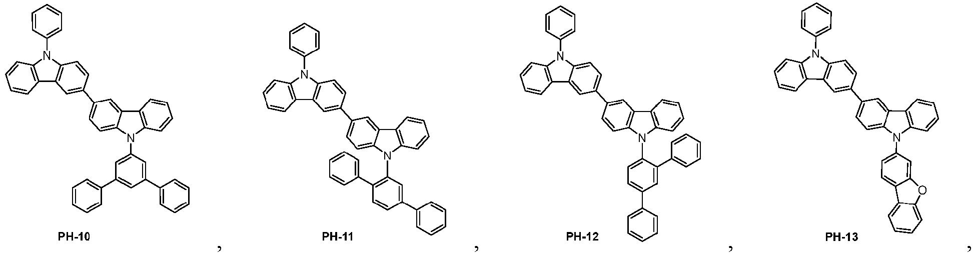

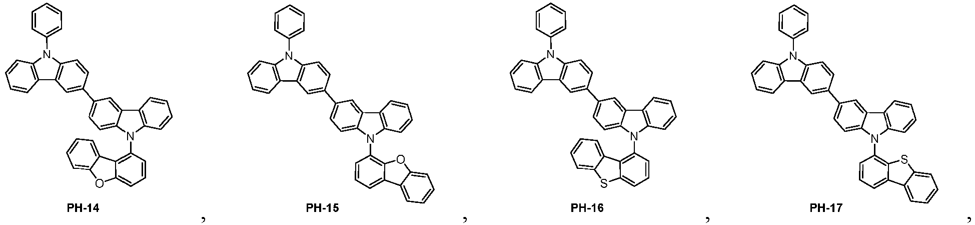

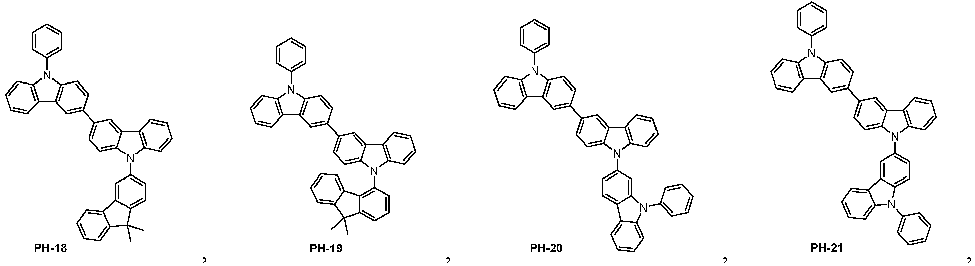

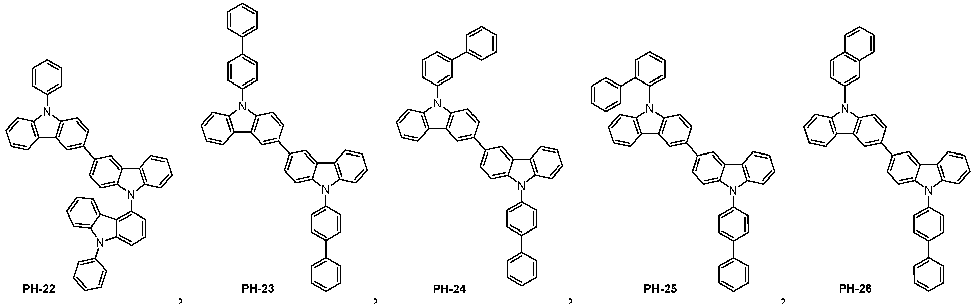

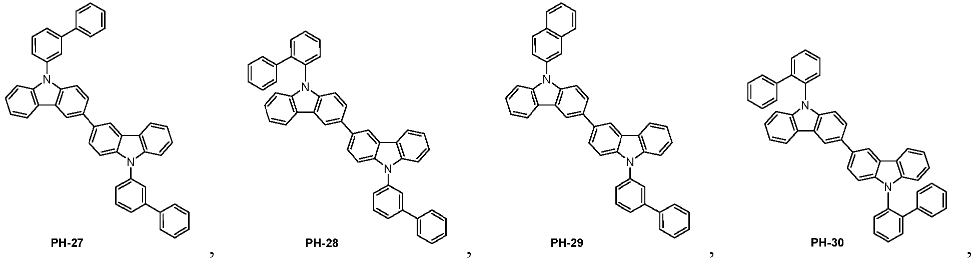

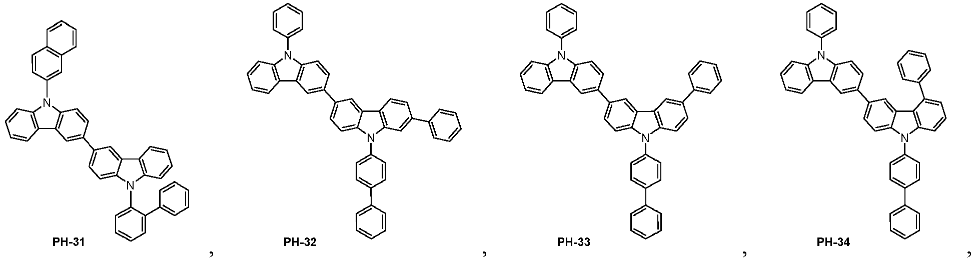

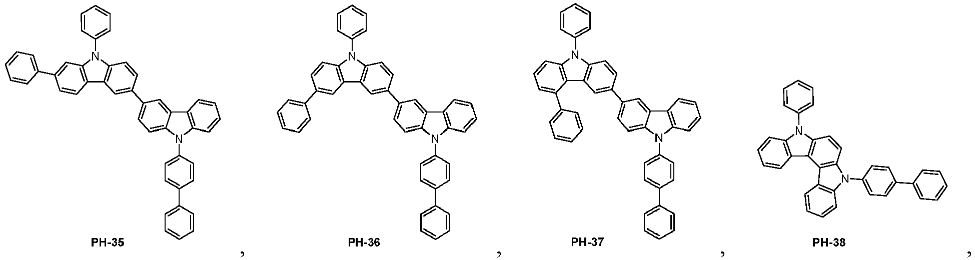

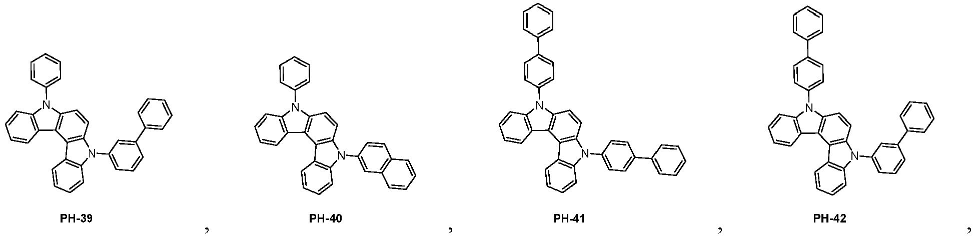

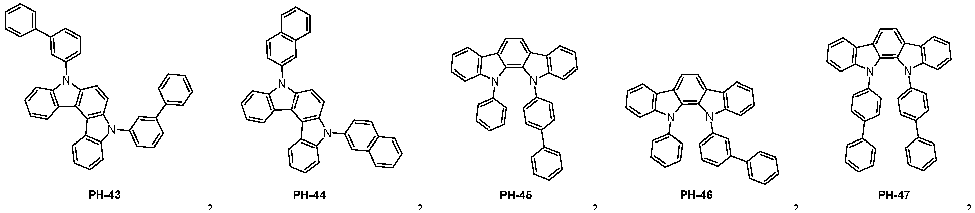

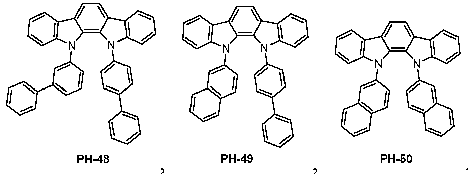

According to an embodiment of the present disclosure, wherein the second host compound has a structure represented by Formula 5: 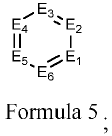 wherein
E₁ to E₆ are, at each occurrence identically or differently, selected from C, CRₑ or N, at least two of E₁ to E₆ are N, and at least one of E₁ to E₆ is C and is attached to Formula A: 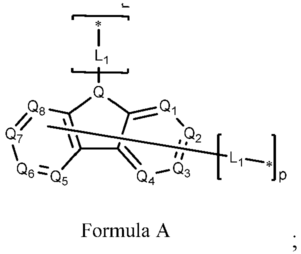
wherein,
Q is, at each occurrence identically or differently, selected from the group consisting of O, S, Se, N, NR_{Q}, CR_{Q}R_{Q}, SiR_{Q}R_{Q}, GeR_{Q}R_{Q}, and R_{Q}C=CR_{Q}; when two R_{Q} are present, the two R_{Q} can be the same or different;
p is 0 or 1; r is 0 or 1;
when Q is selected from N, p is 0, and r is 1;
when Q is selected from the group consisting of O, S, Se, NR_{Q}, CR_{Q}R_{Q}, SiR_{Q}R_{Q}, GeR_{Q}R_{Q}, and R_{Q}C=CR_{Q}, p is 1, and r is 0;
L₁ is, at each occurrence identically or differently, selected from a single bond, substituted or unsubstituted alkylene having 1 to 20 carbon atoms, substituted or unsubstituted cycloalkylene having 3 to 20 carbon atoms, substituted or unsubstituted arylene having 6 to 20 carbon atoms, substituted or unsubstituted heteroarylene having 3 to 20 carbon atoms or combinations thereof;
Q₁ to Q₈ are, at each occurrence identically or differently, selected from C, CR_{q} or N;
Rₑ, R_{Q}, and R_{q} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, a substituted or unsubstituted alkylgermanyl having 3 to 20 carbon atoms, a substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group, and combinations thereof;
"*" represents a position where Formula A is attached to Formula 5;
adjacent substituents Rₑ, R_{Q}, R_{q} can be optionally joined to form a ring.

Herein, the expression that "adjacent substituents Rₑ, R_{Q}, R_{q} can be optionally joined to form a ring" is intended to mean that any one or more of groups of adjacent substituents, such as two substituents Rₑ, two substituents R_{Q}, two substituents R_{q}, and substituents R_{Q} and R_{q}, can be joined to form a ring. Obviously, it is also possible that none of these substituents are joined to form a ring.

According to an embodiment of the present disclosure, the second host compound is selected from the group consisting of the following compounds:

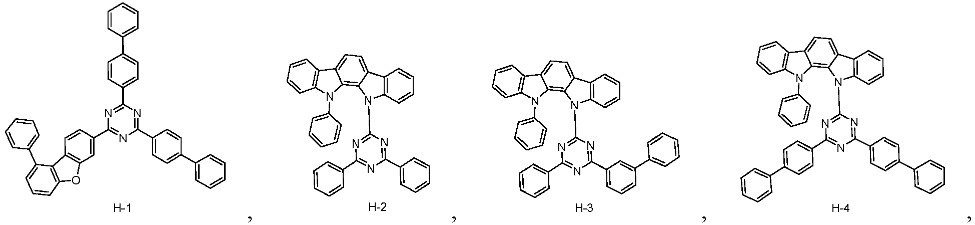

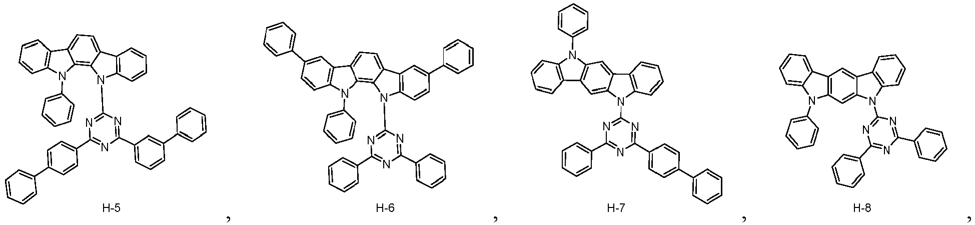

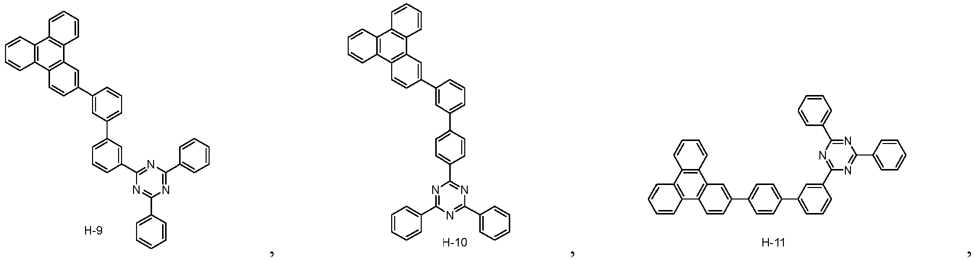

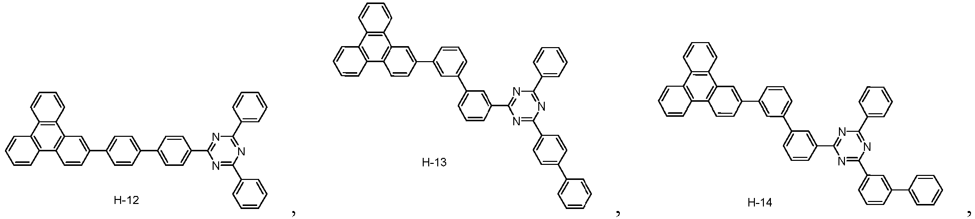

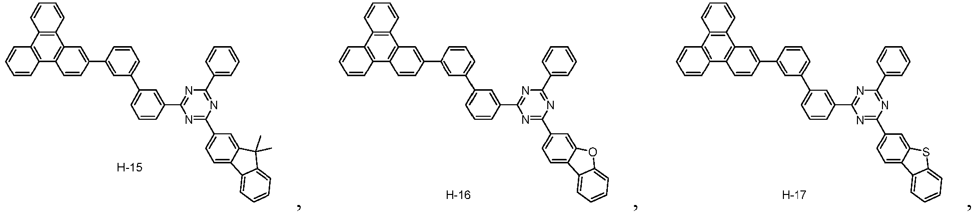

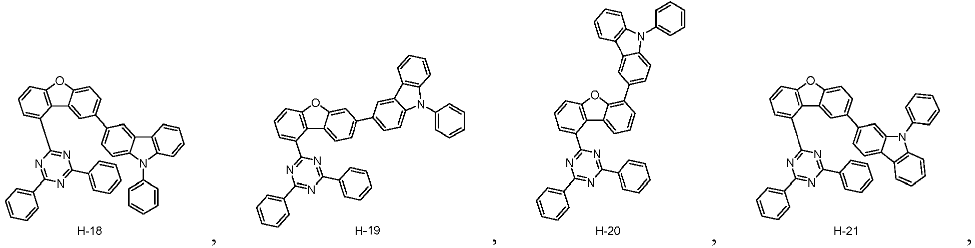

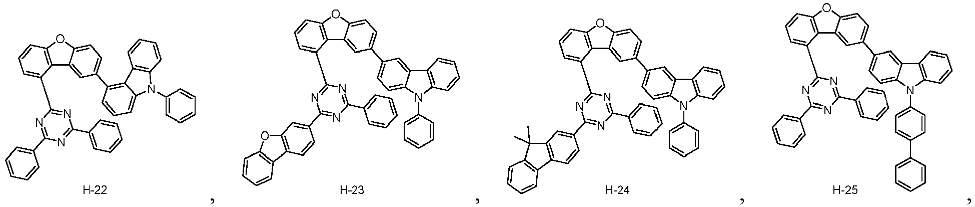

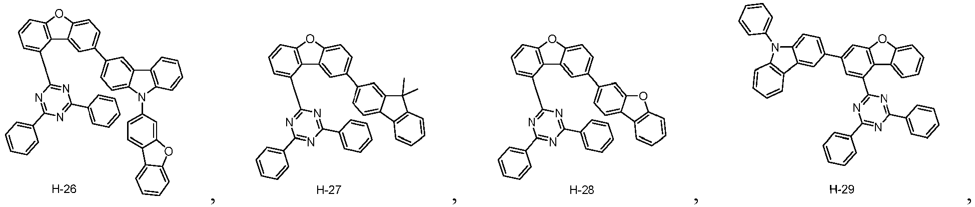

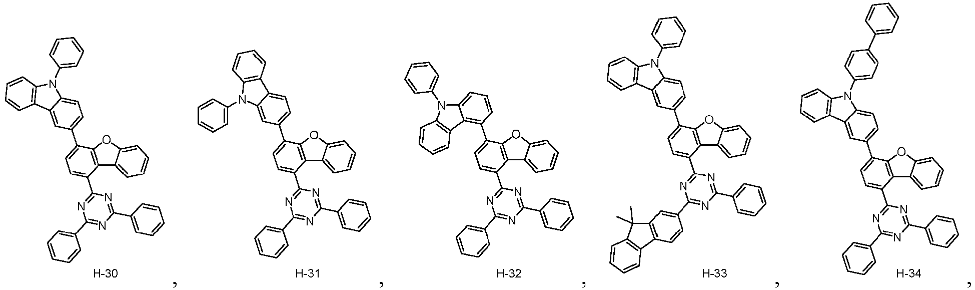

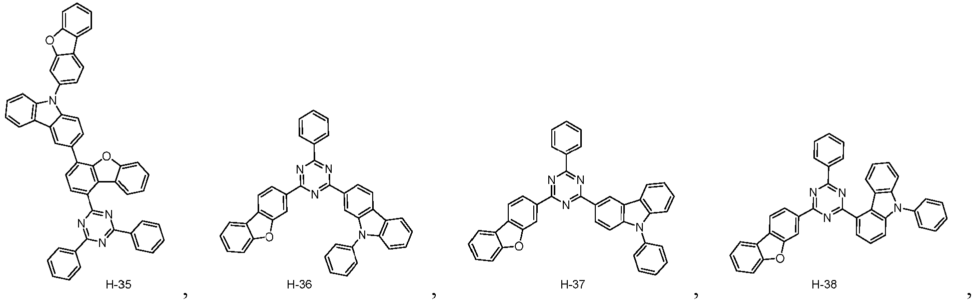

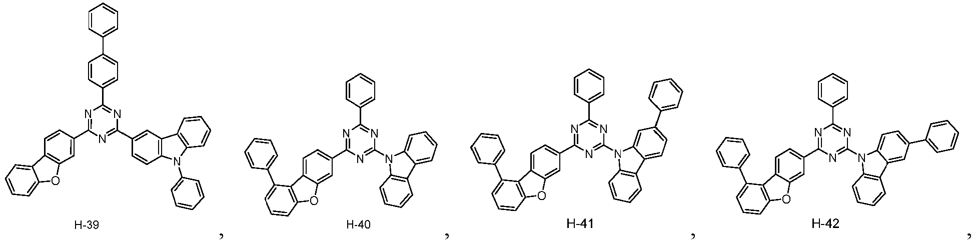

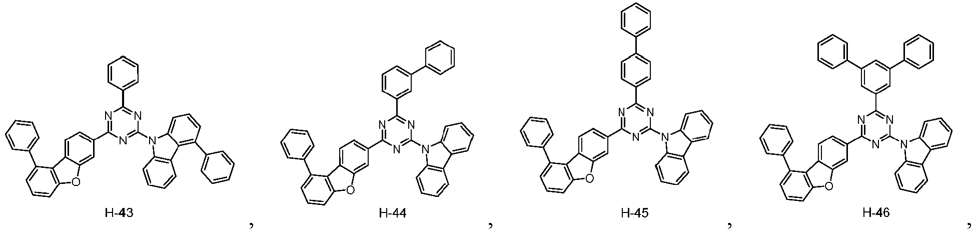

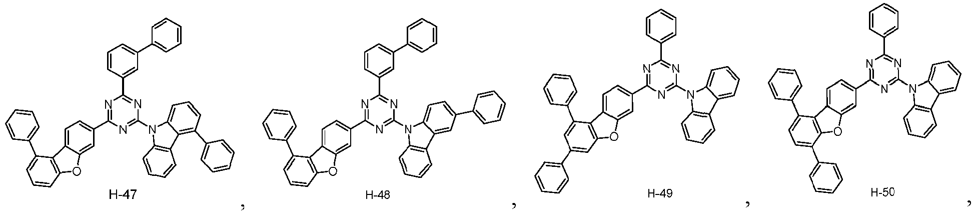

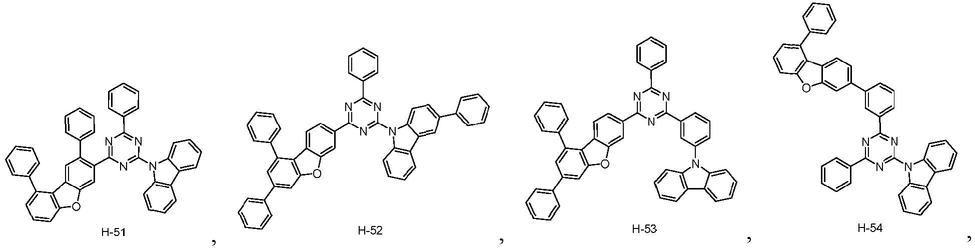

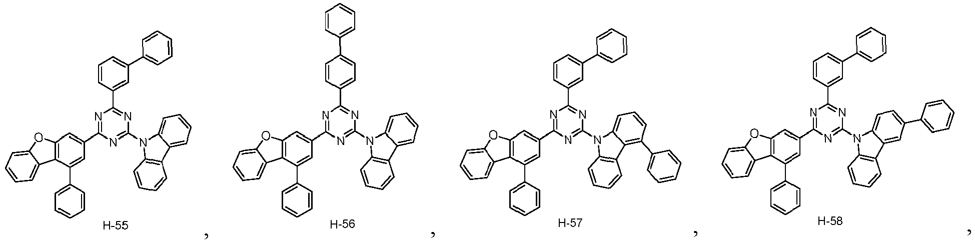

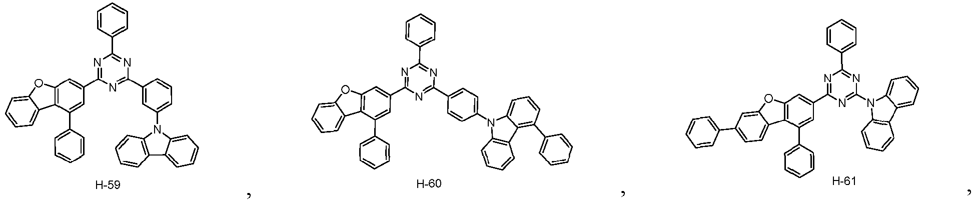

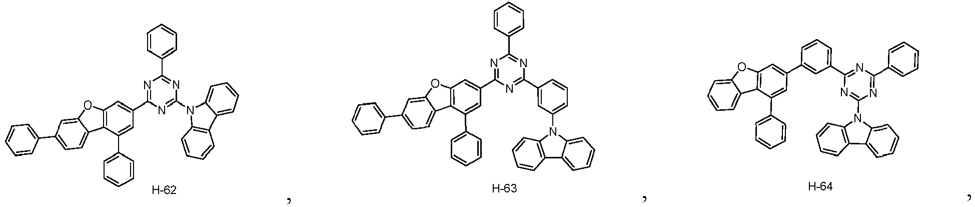

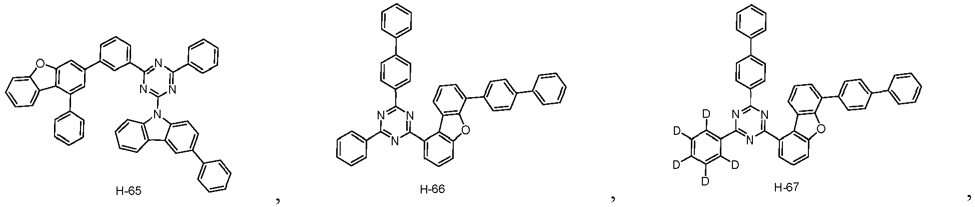

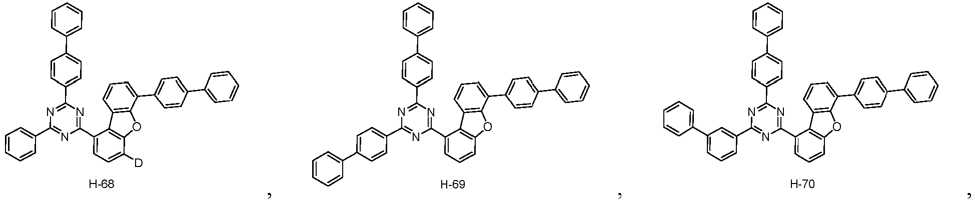

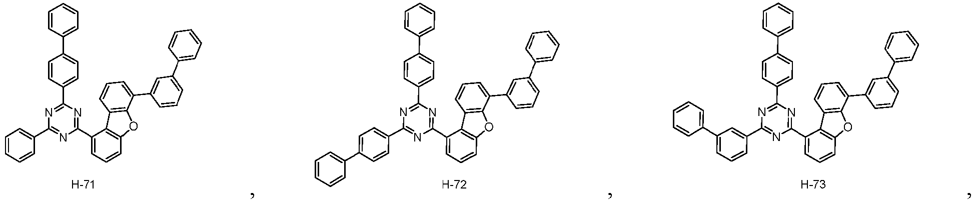

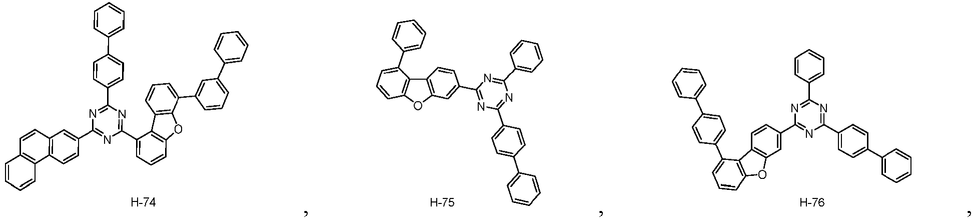

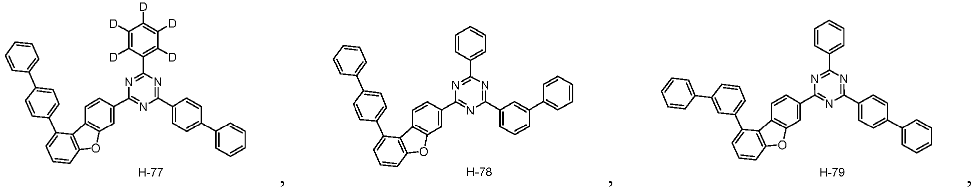

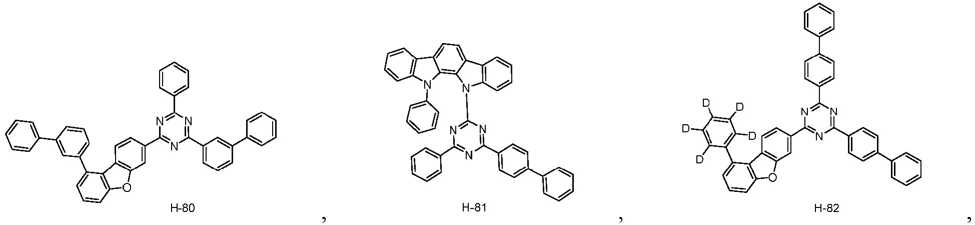

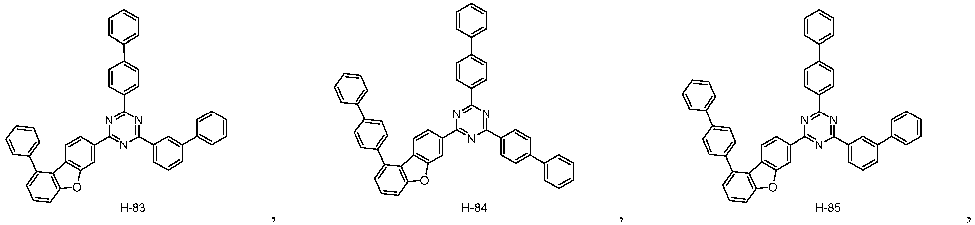

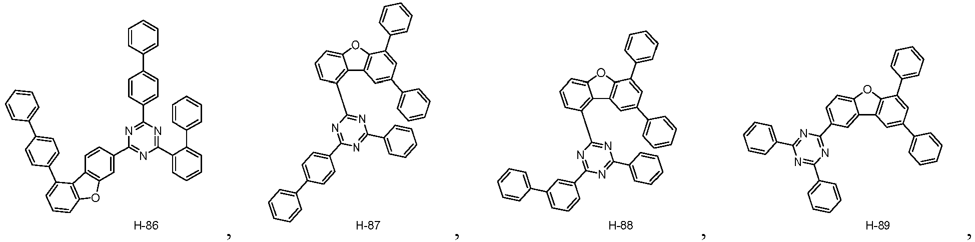

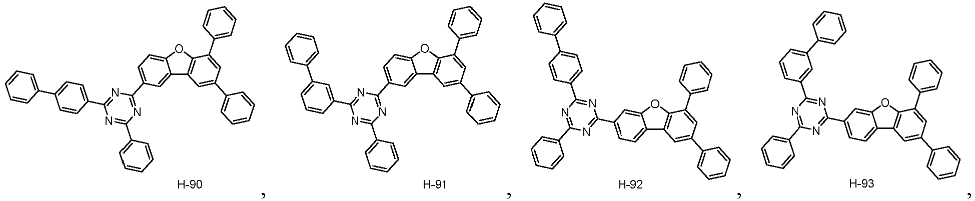

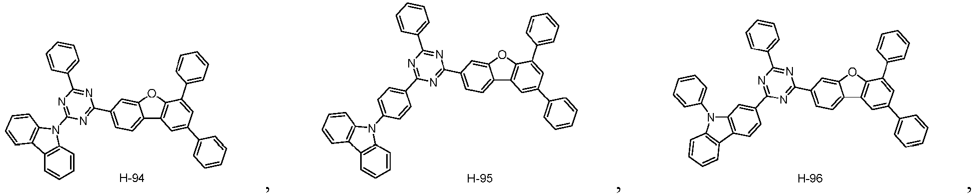

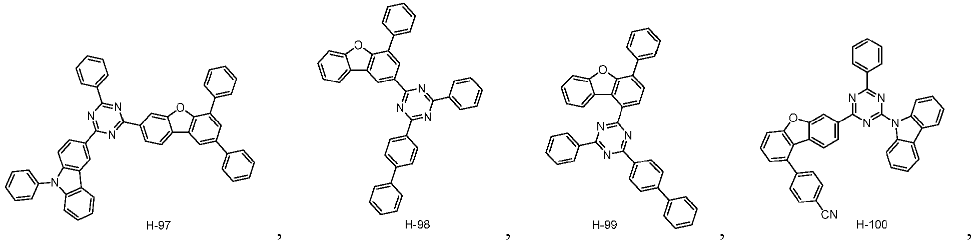

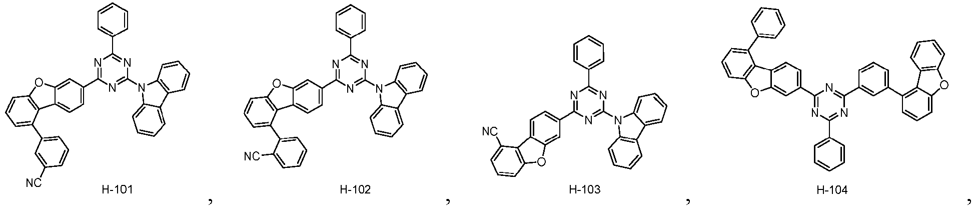

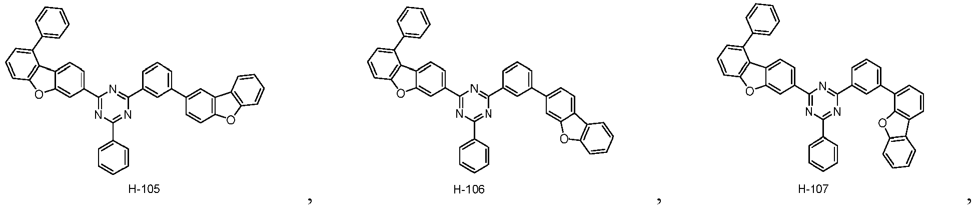

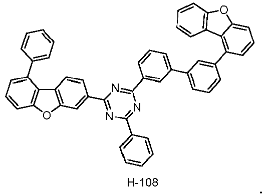

According to an embodiment of the present disclosure, in the electroluminescent device, the metal complex is doped in the first host compound and the second host compound, and the weight of the metal complex accounts for 1 % to 30 % of the total weight of the emissive layer.

According to an embodiment of the present disclosure, in the electroluminescent device, the metal complex is doped in the first host compound and the second host compound, and the weight of the metal complex accounts for 3 % to 13 % of the total weight of the emissive layer.

According to an embodiment of the present disclosure, the organic electroluminescent device further comprises a hole injection layer. The hole injection layer may be a functional layer containing a single material or a functional layer containing multiple materials, wherein the contained multiple materials which are the most commonly used are hole transport materials doped with a certain proportion of p-type conductive doping material. Common p-type doped materials are as follows:

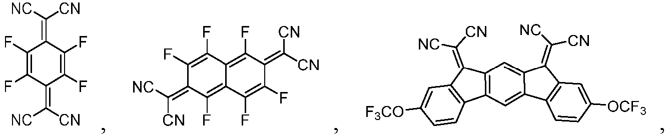

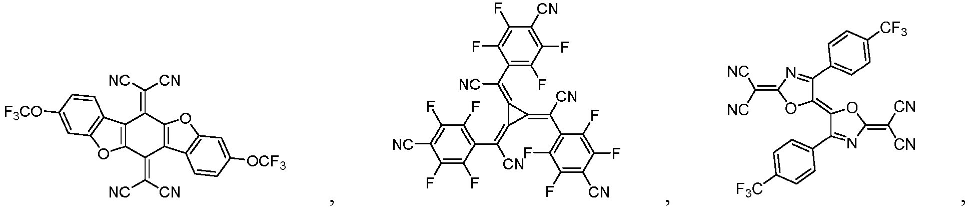

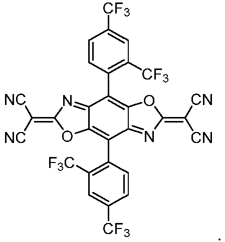

According to another embodiment of the present disclosure, further disclosed is a composition, which comprises a metal complex whose specific structure is as shown in any one of the preceding embodiments.

### Combination with Other Materials

The materials described in the present disclosure for a particular layer in an organic light-emitting device can be used in combination with various other materials present in the device. The combinations of these materials are described in more detail in U.S. Pat. App. Pub. No. 20160359122 at paragraphs 0132-0161. The materials described or referred to the disclosure are non-limiting examples of materials that may be useful in combination with the compounds disclosed herein, and one of skill in the art can readily consult the literature to identify other materials that may be useful in combination.

The materials described herein as useful for a particular layer in an organic light-emitting device may be used in combination with a variety of other materials present in the device. For example, dopants disclosed herein may be used in combination with a wide variety of hosts, transport layers, blocking layers, injection layers, electrodes and other layers that may be present. The combination of these materials is described in detail in paragraphs 0080-0101 of U.S. Pat. App. Pub. No. 20150349273. The materials described or referred to the disclosure are non-limiting examples of materials that may be useful in combination with the compounds disclosed herein, and one of skill in the art can readily consult the literature to identify other materials that may be useful in combination.

In the embodiments of material synthesis, all reactions were performed under nitrogen protection unless otherwise stated. All reaction solvents were anhydrous and used as received from commercial sources. Synthetic products were structurally confirmed and tested for properties using one or more conventional equipment in the art (including, but not limited to, nuclear magnetic resonance instrument produced by BRUKER, liquid chromatograph produced by SHIMADZU, liquid chromatograph-mass spectrometry produced by SHIMADZU, gas chromatograph-mass spectrometry produced by SHIMADZU, differential Scanning calorimeters produced by SHIMADZU, fluorescence spectrophotometer produced by SHANGHAI LENGGUANG TECH., electrochemical workstation produced by WUHAN CORRTEST, and sublimation apparatus produced by ANHUI BEQ, etc.) by methods well known to the persons skilled in the art. In the embodiments of the device, the characteristics of the device were also tested using conventional equipment in the art (including, but not limited to, evaporator produced by ANGSTROM ENGINEERING, optical testing system produced by SUZHOU FATAR, life testing system produced by SUZHOU FATAR, and ellipsometer produced by BEIJING ELLITOP, etc.) by methods well known to the persons skilled in the art. As the persons skilled in the art are aware of the above-mentioned equipment use, test methods and other related contents, the inherent data of the sample can be obtained with certainty and without influence, so the above related contents are not further described in this patent.

### Material Synthesis Example

### Synthesis Example 1: Synthesis of Metal Complex 1345

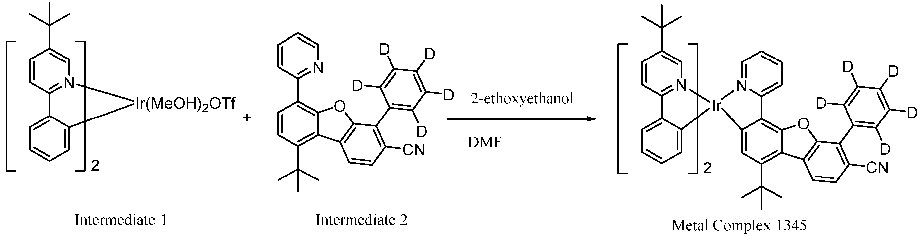

Intermediate 1 (1.8 g, 2.2 mmol), Intermediate 2 (1.0 g, 2.4 mmol), 2-ethoxyethanol (30 mL) and dimethylformamide (DMF) (30 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 1345 as a yellow solid (1.3 g, 1.2 mmol, with a yield of 55 %). The product was confirmed as the target product with a molecular weight of 1019.4 and a melting point of 407 °C.

### Synthesis Example 2: Synthesis of Metal Complex 2252

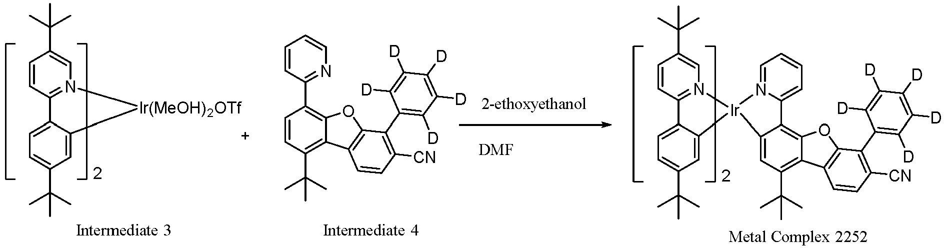

Intermediate 3 (0.7 g, 0.8 mmol), Intermediate 4 (0.4 g, 1.0 mmol), 2-ethoxyethanol (30 mL) and DMF (30 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2252 as a yellow solid (0.4 g, 0.3 mmol, with a yield of 38 %). The product was confirmed as the target product with a molecular weight of 1131.5.

### Synthesis Example 3: Synthesis of Metal Complex 1583

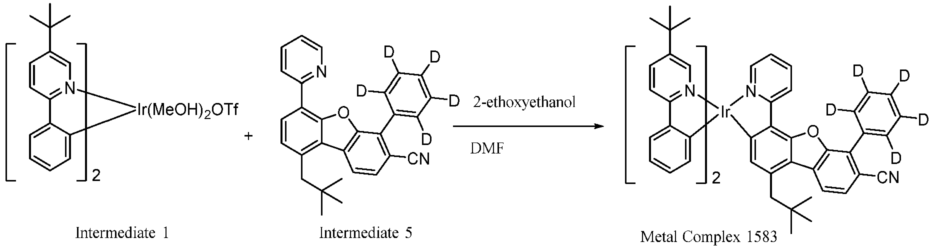

Intermediate 1 (2.8 g, 3.4 mmol), Intermediate 5 (2.0 g, 4.7 mmol), 2-ethoxyethanol (40 mL) and DMF (40 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 1583 as a yellow solid (1.6 g, 1.6 mmol, with a yield of 47 %). The product was confirmed as the target product with a molecular weight of 1033.4 and a melting point of 354 °C.

### Synthesis Example 4: Synthesis of Metal Complex 1493

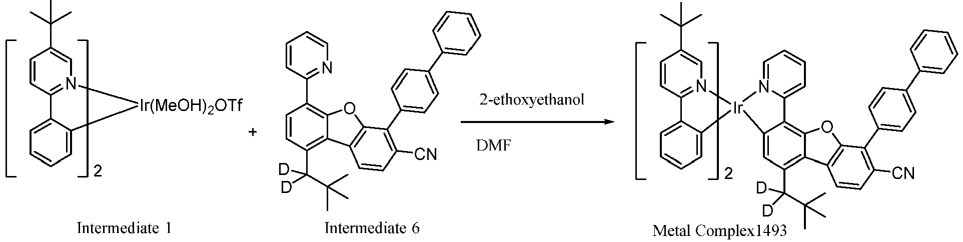

Intermediate 1 (1.2 g, 1.5 mmol), Intermediate 6 (0.9 g, 1.8 mmol), 2-ethoxyethanol (30 mL) and DMF (30 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 1493 as a yellow solid (0.72 g, 0.65 mmol, with a yield of 43 %). The product was confirmed as the target product with a molecular weight of 1106.4 and a melting point of 363 °C.

### Synthesis Example 5: Synthesis of Metal Complex 2262

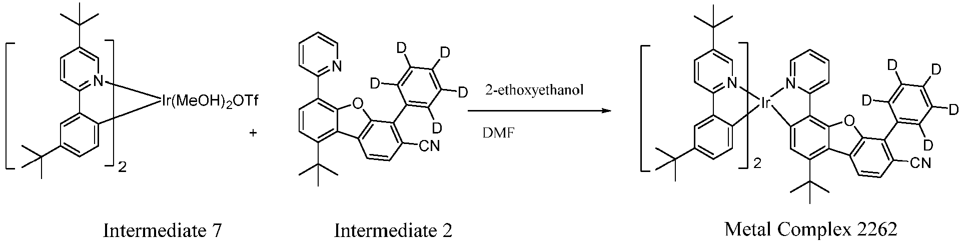

Intermediate 7 (2.6 g, 2.8 mmol), Intermediate 2 (1.7 g, 4.2 mmol), 2-ethoxyethanol (30 mL) and DMF (30 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2262 as a yellow solid (2.0 g, 1.8 mmol, with a yield of 63 %). The product was confirmed as the target product with a molecular weight of 1131.5 and a melting point of 388 °C.

### Synthesis Example 6: Synthesis of Metal Complex 2164

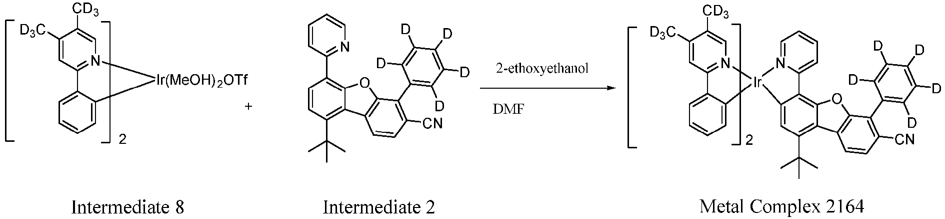

Intermediate 8 (1.4 g, 1.8 mmol), Intermediate 2 (1.0 g, 2.5 mmol), 2-ethoxyethanol (25 mL) and DMF (25 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2164 as a yellow solid (0.6 g, 0.6 mmol, with a yield of 34 %). The product was confirmed as the target product with a molecular weight of 975.4 and a melting point of 451 °C.

### Synthesis Example 7: Synthesis of Metal Complex 2394

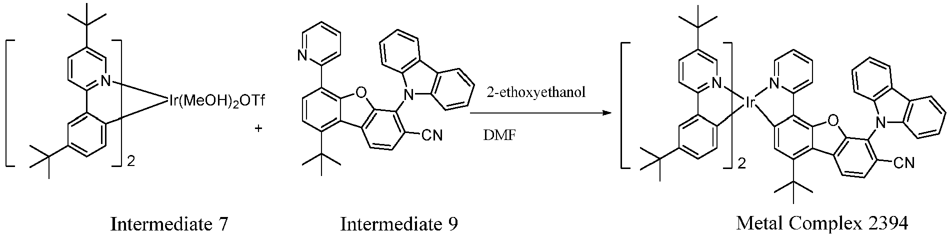

Intermediate 7 (1.2 g, 1.3 mmol), Intermediate 9 (1.0 g, 2.0 mmol), 2-ethoxyethanol (20 mL) and DMF (20 mL) were sequentially added to a dry 250 mL round-bottom flask and heated to react for 144 h at 100 °C under N₂ protection. The reaction was concentrated under reduced pressure and filtered through Celite. The reaction was washed twice with methanol and n-hexane separately. Yellow solids on the Celite were dissolved with dichloromethane. The organic phases were collected and purified through column chromatography to obtain Metal Complex 2394 as a yellow solid (1.1 g, 0.9 mmol, with a yield of 70 %). The product was confirmed as the target product with a molecular weight of 1215.5 and a melting point of 426 °C.

### Synthesis Example 8: Synthesis of Metal Complex 2955

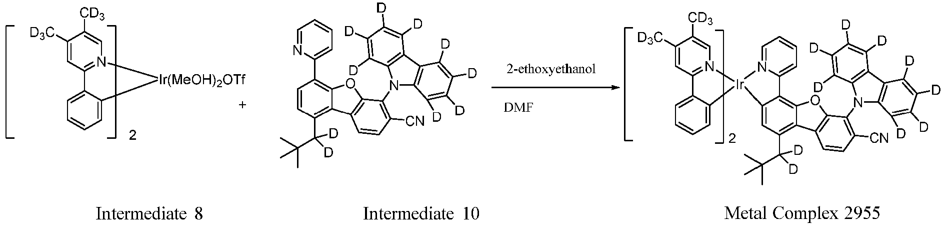

Intermediate 8 (1.3 g, 1.7 mmol), Intermediate 10 (1.0 g, 2.0 mmol), 2-ethoxyethanol (20 mL) and DMF (20 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2955 as a yellow solid (0.6 g, 0.6 mmol, with a yield of 33 %). The product was confirmed as the target product with a molecular weight of 1083.5 and a melting point of 379 °C.

### Synthesis Example 9: Synthesis of Metal Complex 982

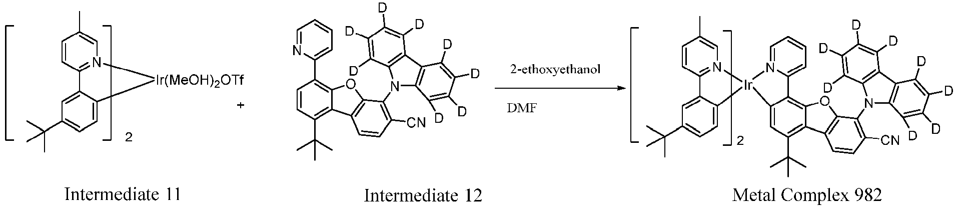

Intermediate 11 (3.0 g, 3.6 mmol), Intermediate 12 (2.5 g, 5.0 mmol), 2-ethoxyethanol (50 mL) and DMF (50 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 982 as a yellow solid (2.0 g, 1.8 mmol, with a yield of 49 %). The product was confirmed as the target product with a molecular weight of 1139.5 and a melting point of 364 °C.

### Synthesis Example 10: Synthesis of Metal Complex 3671

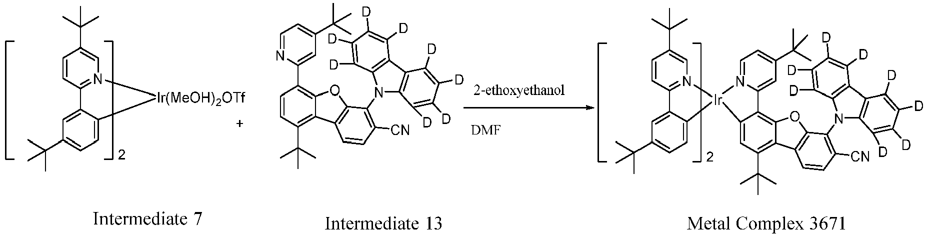

Intermediate 7 (2.7 g, 3.3 mmol), Intermediate 13 (2.5 g, 4.9 mmol), 2-ethoxyethanol (50 mL) and DMF (50 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 3671 as a yellow solid (1.6 g, 1.3 mmol, with a yield of 39 %). The product was confirmed as the target product with a molecular weight of 1279.6 and a melting point of 385 °C.

### Synthesis Example 11: Synthesis of Metal Complex 2526

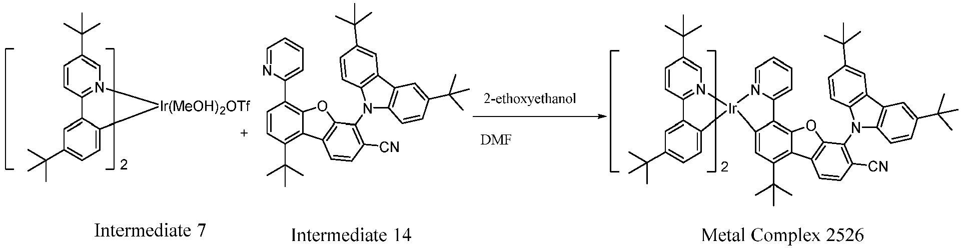

Intermediate 7 (4.8 g, 5.1 mmol), Intermediate 14 (4.0 g, 6.6 mmol), 2-ethoxyethanol (80 mL) and DMF (80 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2526 as a yellow solid (5.2 g, 3.9 mmol, with a yield of 76 %). The product was confirmed as the target product with a molecular weight of 1327.7 and a melting point of 383 °C.

### Synthesis Example 12: Synthesis of Metal Complex 2657

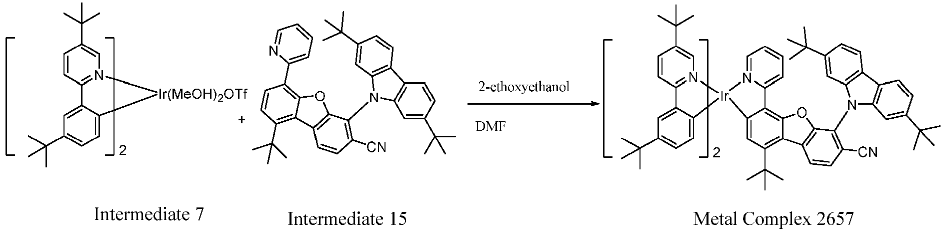

Intermediate 7 (5.1 g, 5.4 mmol), Intermediate 15 (3.6 g, 6.0 mmol), 2-ethoxyethanol (50 mL) and DMF (50 mL) were sequentially added to a dry 250 mL round-bottom flask and heated to react for 96 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2657 as a yellow solid (6.0 g, 4.7 mmol, with a yield of 87 %). The product was confirmed as the target product with a molecular weight of 1327.7 and a melting point of 422 °C.

### Synthesis Example 13: Synthesis of Metal Complex 1371

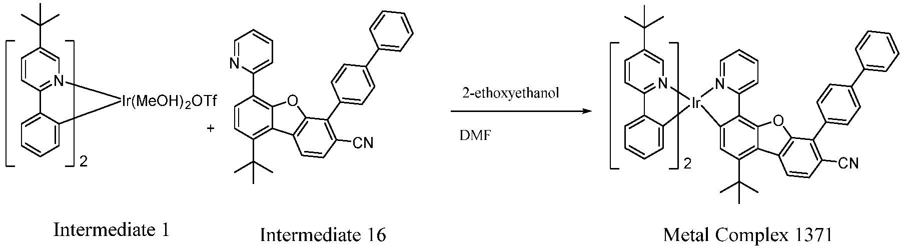

Intermediate 1 (0.7 g, 0.8 mmol), Intermediate 16 (0.5 g, 1.0 mmol), 2-ethoxyethanol (30 mL) and DMF (30 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 1371 as a yellow solid (0.28 g, 0.25 mmol, with a yield of 31 %). The product was confirmed as the target product with a molecular weight of 1090.4 and a melting point of 421 °C.

### Synthesis Example 14: Synthesis of Metal Complex 2393

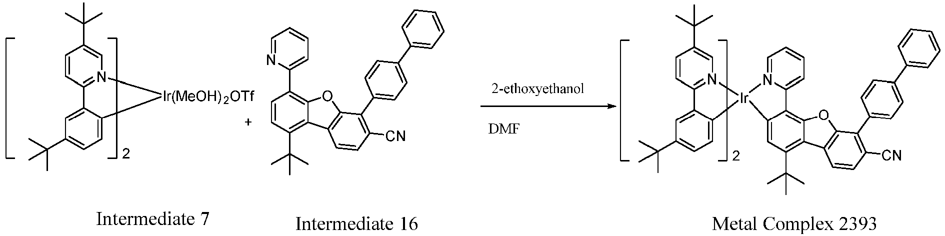

Intermediate 7 (1.8 g, 1.9 mmol), Intermediate 16 (1.3 g, 2.7 mmol), 2-ethoxyethanol (40 mL) and DMF (40 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2393 as a yellow solid (1.4 g, 1.2 mmol, with a yield of 63 %). The product was confirmed as the target product with a molecular weight of 1202.5 and a melting point of 350 °C.

### Synthesis Example 15: Synthesis of Metal Complex 2921

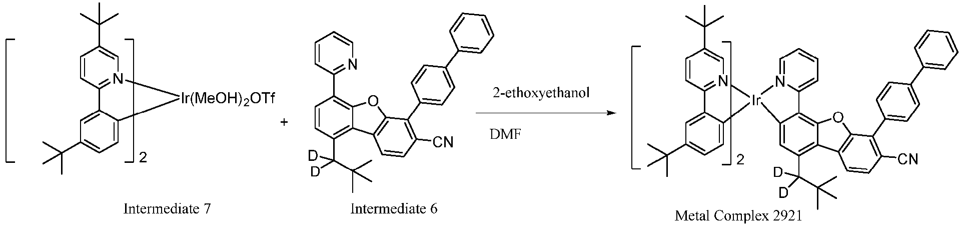

Intermediate 7 (1.5 g, 1.6 mmol), Intermediate 6 (1.1 g, 2.2 mmol), 2-ethoxyethanol (40 mL) and DMF (40 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2921 as a yellow solid (1.3 g, 1.1 mmol, with a yield of 69 %). The product was confirmed as the target product with a molecular weight of 1218.6 and a melting point of 387 °C.

### Synthesis Example 16: Synthesis of Metal Complex 2249

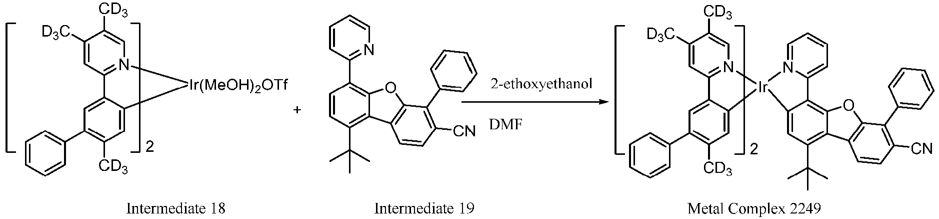

Intermediate 18 (1.7 g, 1.8 mmol), Intermediate 19 (1.0 g, 2.4 mmol), 2-ethoxyethanol (30 mL) and DMF (30 mL) were sequentially added to a dry 250 mL round-bottom flask and heated to react for 144 h at 100 °C under N₂ protection. The reaction was cooled and filtered through Celite. The reaction was washed twice with methanol and n-hexane separately. Yellow solids on the Celite were dissolved with dichloromethane. The organic phases were collected, concentrated under reduced pressure and purified through column chromatography to obtain Metal Complex 2249 as a yellow solid (0.9 g, 0.8 mmol, with a yield of 44%). The product was confirmed as the target product with a molecular weight of 1156.5 and a melting point of 439 °C.

Those skilled in the art will appreciate that the above preparation methods are merely exemplary. Those skilled in the art can obtain other compound structures of the present disclosure through the modifications of the preparation methods.

### Device Example 1

Firstly, a glass substrate having an indium tin oxide (ITO) anode with a thickness of 80 nm was cleaned and then treated with oxygen plasma and UV ozone. After the treatment, the substrate was dried in a glovebox to remove moisture. Then, the substrate was mounted on a substrate holder and placed in a vacuum chamber. Organic layers specified below were sequentially deposited through vacuum thermal evaporation on the ITO anode at a rate of 0.2 to 2 Angstroms per second and a vacuum degree of about 10⁻⁶ torr. Compound HI was used as a hole injection layer (HIL). Compound HT was used as a hole transporting layer (HTL). Compound PH-23 was used as an electron blocking layer (EBL). Metal Complex 1345 of the present disclosure was doped in Compound PH-23 and Compound H-40, all of which were co-deposited for use as an emissive layer (EML). On the EML, Compound H-2 was used as a hole blocking layer (HBL). On the HBL, Compound ET and 8-hydroxyquinolinolato-lithium (Liq) were co-deposited for use as an electron transporting layer (ETL). Finally, 8-hydroxyquinolinolato-lithium (Liq) was deposited for use as an electron injection layer with a thickness of 1 nm and Al was deposited for use as a cathode with a thickness of 120 nm. The device was transferred back to the glovebox and encapsulated with a glass lid and a moisture getter to complete the device.

### Device Example 2

The implementation mode in Device Example 2 was the same as that in Device Example 1, except that in the emissive layer (EML), Metal Complex 1345 of the present disclosure was replaced with Metal Complex 1583.

### Device Comparative Example 1

The implementation mode in Device Comparative Example 1 was the same as that in Device Example 1, except that in the emissive layer (EML), Metal Complex 1345 of the present disclosure was replaced with Compound GD1.

### Device Comparative Example 2

The implementation mode in Device Comparative Example 2 was the same as that in Device Example 1, except that in the emissive layer (EML), Metal Complex 1345 of the present disclosure was replaced with Compound GD2.

### Device Comparative Example 3

The implementation mode in Device Comparative Example 3 was the same as that in Device Example 1, except that in the emissive layer (EML), Metal Complex 1345 of the present disclosure was replaced with Compound GD3.

Detailed structures and thicknesses of layers of the devices are shown in the following table. A layer using more than one material is obtained by doping different compounds at their weight ratio as recorded.

**Table 1 Device structures in Examples 1 and 2 and Comparative Examples 1 to 3**

| Device ID | HIL | HTL | EBL | EML | HBL | ETL |
|---|---|---|---|---|---|---|
| Example 1 | Compound HI (100 Å) | Compound HT (350 Å) | Compound PH-23 (50 Å) | Compound PH-23:Compound H-40:Metal Complex 1345 (56:38:6) (400 Å) | Compound H-2 (50 Å) | Compound ET:Liq (40:60) (350 Å) |
| Example 2 | Compound HI (100 Å) | Compound HT (350 Å) | Compound PH-23 (50 Å) | Compound PH-23:Compound H-40:Metal Complex 1583 (56:38:6) (400 Å) | Compound H-2 (50 Å) | Compound ET:Liq (40:60) (350 Å) |
| Comparative Example 1 | Compound HI (100 Å) | Compound HT (350 Å) | Compound PH-23 (50 Å) | Compound PH-23:Compound H-40:Compound GD1 (56:38:6) (400 Å) | Compound H-2 (50 Å) | Compound ET:Liq (40:60) (350 Å) |
| Comparative Example 2 | Compound HI (100 Å) | Compound HT (350 Å) | Compound PH-23 (50 Å) | Compound PH-23:Compound H-40:Compound GD2 (56:38:6) (400 Å) | Compound H-2 (50 Å) | Compound ET:Liq (40:60) (350 Å) |
| Comparative Example 3 | Compound HI (100 Å) | Compound HT (350 Å) | Compound PH-23 (50 Å) | Compound PH-23:Compound H-40:Compound GD3 (56:38:6) (400 Å) | Compound H-2 (50 Å) | Compound ET:Liq (40:60) (350 Å) |

The materials used in the devices have the following structures:

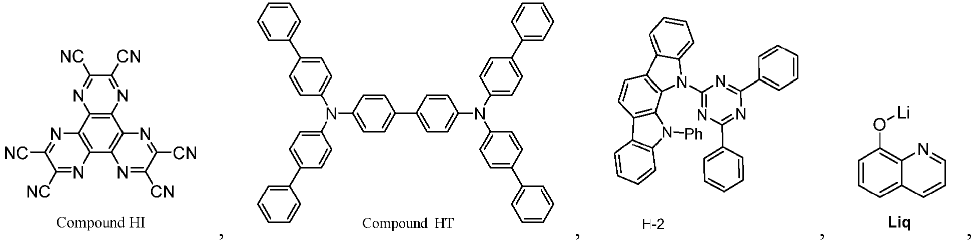

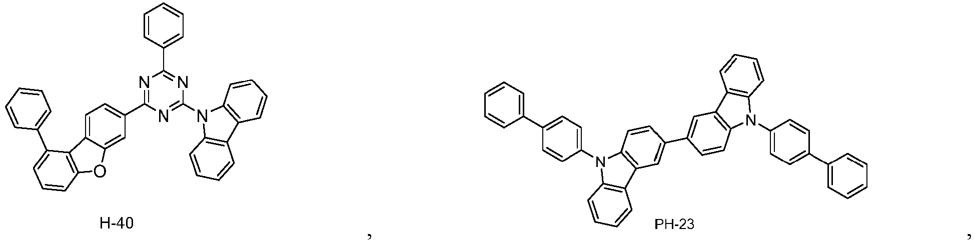

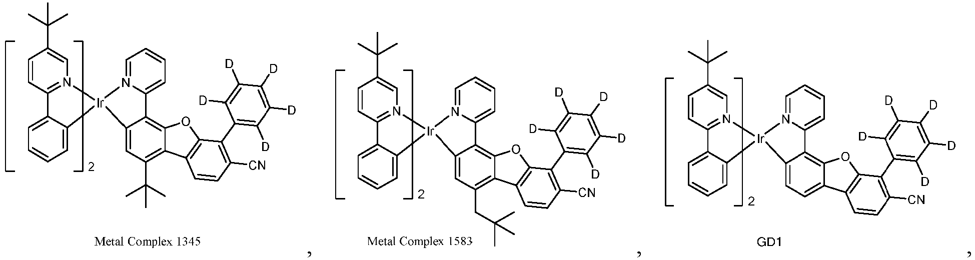

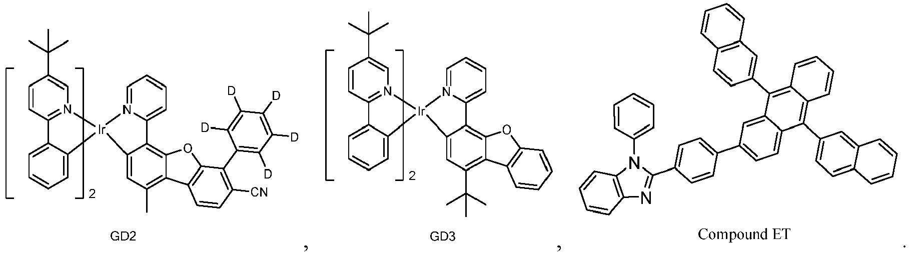

The IVL characteristics of the devices were measured. The CIE data, maximum emission wavelength (λₘₐₓ), full width at half maximum (FWHM), drive voltage (V), current efficiency (CE) and external quantum efficiency (EQE) of the devices were measured at a constant current of 10 mA/cm². The data are recorded and shown in Table 2.

**Table 2 Device data in Examples 1 and 2 and Comparative Examples 1 to 3**

| Device ID | CIE (x, y) | λₘₐₓ (nm) | FWHM (nm) | Voltage (V) | CE (cd/A) | EQE (%) |
|---|---|---|---|---|---|---|
| Example 1 | (0.293, 0.663) | 522 | 30.1 | 3.37 | 92.89 | 24.08 |
| Example 2 | (0.299, 0.659) | 522 | 32.4 | 3.43 | 92.21 | 23.91 |
| Comparative Example 1 | (0.342, 0.634) | 531 | 35.6 | 3.38 | 92.50 | 23.46 |
| Comparative Example 2 | (0.294, 0.660) | 520 | 34.5 | 3.44 | 90.69 | 23.72 |
| Comparative Example 3 | (0.314, 0.641) | 521 | 58.3 | 3.76 | 74.75 | 19.97 |

Examples 1 and 2 differ from Comparative Examples 1 and 2 respectively only in the presence or absence of a Rₙ group represented by Formula 2 of the present disclosure in the luminescent material. It can be seen from the data in Table 2 that compared with Comparative Examples 1 and 2, respectively, in Examples 1 and 2, the drive voltage was maintained substantially the same or slightly reduced and both the current efficiency and the external quantum efficiency were maintained substantially the same or slightly improved. However, unexpectedly, compared with the full widths at half maximum in Comparative Examples 1 and 2 that have been considered relatively narrow, the full widths at half maximum in Examples 1 and 2 were further narrowed. Compared with Comparative Example 1, the full widths at half maximum in Examples 1 and 2 were narrowed by 5.5 nm and 3.2 nm, respectively, and compared with Comparative Example 2, the full widths at half maximum in Examples 1 and 2 were narrowed by 4.4 nm and 2.1 nm, respectively. It is to be emphasized that the full widths at half maximum in Comparative Examples 1 and 2 have reached a relative high level in the industry, and it is very rare to further reduce the full widths at half maximum on the premise that the device efficiency and the voltages are maintained substantially comparable. Such a result is unexpected. With a narrower full width at half maximum, a higher color purity can be obtained, which is closer to a requirement of the industry for the luminescence performance of a green light material, indicating that with the metal complex provided in the present disclosure, a device with more excellent performance can be obtained.

Although the metal complex GD3 used in Comparative Example 3 has the substituent Rₙ of the present disclosure, the metal complex GD3 does not have the substituent R₁ of the present application. From the data in Table 2, compared with Comparative Example 3, in Examples 1 and 2, the full widths at half maximum were narrowed by 28.2 nm and 25.9 nm, respectively, the EQE was improved by 20.5% and 19.7%, respectively, and the CE was improved by 24.2% and 23.3%, respectively.

Moreover, it can also be seen from the data in Table 2 that Examples 1 and 2 were blue-shifted by 9 nm compared with Comparative Example 1, but red-shifted by 2 nm compared with Comparative Example 2. Such a result is completely different from the result disclosed in CN111655705A and is an unpredictable result for those skilled in the art.

From the above, it can be seen that in the present application, the metal complex comprising both the substituents R₁ and Rₙ can reduce the full width at half maximum in the case where excellent device efficiency is maintained, which is conducive to providing a high-performance device with more saturated luminescence.

### Device Example 3

The implementation mode in Device Example 3 was the same as that in Device Example 1, except that in the emissive layer (EML), Metal Complex 1345 of the present disclosure was replaced with Metal Complex 2252.

### Device Comparative Example 4

The implementation mode in Device Comparative Example 4 was the same as that in Device Example 1, except that in the emissive layer (EML), Metal Complex 1345 of the present disclosure was replaced with Compound GD4.

Detailed structures and thicknesses of layers of the devices are shown in the following table. A layer using more than one material is obtained by doping different compounds at their weight ratio as recorded.

**Table 3 Device structures in Example 3 and Comparative Example 4**

| Device ID | HIL | HTL | EBL | EML | HBL | ETL |
|---|---|---|---|---|---|---|
| Example 3 | Compound HI (100 Å) | Compound HT (350 Å) | Compound PH-23 (50 Å) | Compound PH-23:Compound H-40:Metal Complex 2252 (56:38:6) (400 Å) | Compound H-2 (50 Å) | Compound ET:Liq (40:60) (350 Å) |
| Comparative Example 4 | Compound HI (100 Å) | Compound HT (350 Å) | Compound PH-23 (50 Å) | Compound PH-23:Compound H-40:Compound GD4 (56:38:6) (400 Å) | Compound H-2 (50 Å) | Compound ET:Liq (40:60) (350 Å) |

The new metal complexes used in the devices have the following structures:

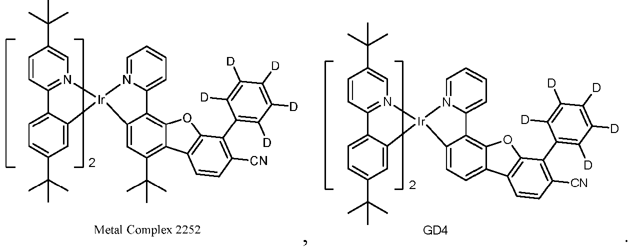

The IVL characteristics of the devices were measured. The CIE data, maximum emission wavelength (λₘₐₓ), full width at half maximum (FWHM), drive voltage (V), current efficiency (CE) and external quantum efficiency (EQE) of the devices were measured at 10 mA/cm². The data are recorded and shown in Table 4.

**Table 4 Device data in Example 3 and Comparative Example 4**

| Device ID | CIE (x, y) | λₘₐₓ (nm) | FWHM (nm) | Voltage (V) | CE (cd/A) | EQE (%) |
|---|---|---|---|---|---|---|
| Example 3 | (0.314, 0.651) | 525 | 33.0 | 3.77 | 89.84 | 23.05 |
| Comparative Example 4 | (0.362, 0.620) | 535 | 39.1 | 3.57 | 95.32 | 24.35 |

Example 3 differs from Comparative Example 4 only in the presence or absence of a Rₙ group represented by Formula 2 of the present disclosure in the luminescent material. It can be seen from the data in Table 4 that although the device voltage was improved by 0.2 V and the efficiency was reduced by 5.3%, Example 3 still reached a relatively high level of greater than 23%. More importantly, the emission wavelength in Example 3 was blue-shifted by 10 nm compared with that in Comparative Example 4, and the full width at half maximum in Example 3 was narrowed by 6.1 nm compared with that in Comparative Example 4. A more blue emission wavelength and a narrower full width at half maximum in Example 3 compared with those in Comparative Example 4 can enable the device to have a wider color gamut and a higher color purity, which is closer to a requirement of the industry for the luminescence performance of a green light material, indicating that with the metal complex provided in the present disclosure, a device with more excellent performance can be obtained.

### Device Example 4

The implementation mode in Device Example 4 was the same as that in Device Example 1, except that in the emissive layer (EML), Metal Complex 1345 of the present disclosure was replaced with Metal Complex 1493.

### Device Comparative Example 5

The implementation mode in Device Comparative Example 5 was the same as that in Device Example 1, except that in the emissive layer (EML), Metal Complex 1345 of the present disclosure was replaced with Compound GD5.

Detailed structures and thicknesses of layers of the devices are shown in the following table. A layer using more than one material is obtained by doping different compounds at their weight ratio as recorded.

**Table 5 Device structures in Example 4 and Comparative Example 5**

| Device ID | HIL | HTL | EBL | EML | HBL | ETL |
|---|---|---|---|---|---|---|
| Example 4 | Compound HI (100 Å) | Compound HT (350 Å) | Compound PH-23 (50 Å) | Compound PH-23:Compound H-40:Metal Complex 1493 (56:38:6) (400 Å) | Compound H-2 (50 Å) | Compound ET:Liq (40:60) (350 Å) |
| Comparative Example 5 | Compound HI (100 Å) | Compound HT (350 Å) | Compound PH-23 (50 Å) | Compound PH-23:Compound H-40:Compound GD5 (56:38:6) (400 Å) | Compound H-2 (50 Å) | Compound ET:Liq (40:60) (350 Å) |

The new metal complexes used in the devices have the following structures:

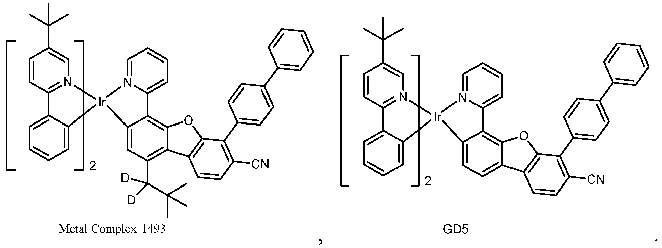

The IVL characteristics of the devices were measured. The CIE data, maximum emission wavelength (λₘₐₓ), full width at half maximum (FWHM), drive voltage (V), current efficiency (CE) and external quantum efficiency (EQE) of the devices were measured at a constant current of 10 mA/cm². The data are recorded and shown in Table 6.

**Table 6 Device data in Example 4 and Comparative Example 5**

| Device ID | CIE (x, y) | λₘₐₓ (nm) | FWHM (nm) | Voltage (V) | CE (cd/A) | EQE (%) |
|---|---|---|---|---|---|---|
| Example 4 | (0.295, 0.661) | 522 | 31.2 | 3.31 | 97.85 | 25.44 |
| Comparative Example 5 | (0.342, 0.635) | 532 | 34.6 | 3.43 | 100 | 25.34 |

Example 4 differs from Comparative Example 5 only in the presence or absence of a Rₙ group represented by Formula 2 of the present disclosure in the luminescent material. It can be seen from the data in Table 6 that compared with Comparative Example 5, in Example 4, the drive voltage was reduced by 0.12 V, the current efficiency was slightly reduced, the external quantum efficiency was slightly improved, the emission wavelength was blue-shifted by 10 nm and the full width at half maximum was narrowed by 3.4 nm. Again, it indicates that the metal complex of the present disclosure can have a wider color gamut and a higher color purity on the premise that excellent device performance is maintained, which is closer to a requirement of the industry for the luminescence performance of a green light material, indicating that with the metal complex provided in the present disclosure, a device with more excellent performance can be obtained.

Examples of top-emitting devices: To study the device performance of the metal complex most approaching the BT.2020 luminescence requirement, the microcavities of the following top-emitting devices were all adjusted to CIEx = 0.170, and the device performance at this time was recorded. As mentioned above about the top-emitting device, due to different refractive indexes of different metal complexes, the top-emitting devices comprising these different metal complexes may have slightly different microcavity lengths, that is, the HTLs have slightly different thicknesses.

### Device Example 5

Firstly, a 0.7 mm thick glass substrate was pre-patterned with ITO 75 Å/Ag 1500 Å/ITO 150 Å as an anode, where 150 Å ITO deposited on Ag had a hole injection function. Then, the substrate was dried in a glovebox to remove moisture, mounted on a holder and transferred into a vacuum chamber. Organic layers specified below were sequentially deposited through vacuum thermal evaporation on the anode at a rate of 0.01 to 10 Å/s and a vacuum degree of about 10⁻⁶ torr. Compound HT and Compound PD were co-deposited as a hole injection layer (HIL, 97:3, 100 Å). On the HIL, Compound HT was deposited as a hole transporting layer (HTL) (where the HTL also served as a microcavity adjustment layer, and the microcavity was adjusted within a range of 1000 to 1500 Å). On the HTL, Compound PH-23 was deposited as an electron blocking layer (EBL, 50 Å). Then, Metal Complex 1493, Compound PH-1, and Compound H-40 of the present disclosure were co-deposited as an emissive layer (EML, 4:48:48, 400 Å). Compound H-2 was deposited as a hole blocking layer (HBL, 50 Å). Compound ET and Liq were co-deposited as an electron transporting layer (ETL, 40:60, 350 Å). A metal Yb was deposited as an electron injection layer (EIL, 10 Å). Metals Ag and Mg were co-deposited at a ratio of 9:1 as a cathode (140 Å). Compound CP (a material with a refractive index of about 2.01 at 530 nm) was deposited as a capping layer with a thickness of 800 Å. The device was transferred back to the glovebox and encapsulated with a glass lid in a nitrogen atmosphere to complete the device. In this example, when the microcavity was adjusted to about 1340 Å, CIEx of the device was 0.170, and CE_{0.170} in this case was obtained.

### Device Example 6

The implementation mode in Device Example 6 was the same as that in Device Example 5, except that in the emissive layer, Metal Complex 1493 of the present disclosure was replaced with Metal Complex 1345 of the present disclosure. In this example, when the microcavity was adjusted to about 1370 Å, CIEx of the device was 0.170, and CE_{0.170} in this case was obtained.

### Device Comparative Example 6

The implementation mode in Device Comparative Example 6 was the same as that in Device Example 5, except that in the emissive layer, Metal Complex 1493 of the present disclosure was replaced with Metal Complex GD5 of the present disclosure. In this example, when the microcavity was adjusted to about 1410 Å, CIEx of the device was 0.170, and CE_{0.170} in this case was obtained.

### Device Comparative Example 7

The implementation mode in Device Comparative Example 7 was the same as that in Device Example 5, except that in the emissive layer, Metal Complex 1493 of the present disclosure was replaced with Metal Complex GD2 of the present disclosure. In this example, when the microcavity was adjusted to about 1370 Å, CIEx of the device was 0.170, and CE_{0.170} in this case was obtained.

Structures and thicknesses of part of layers of the devices are shown in the following table. A layer using more than one material is obtained by doping different compounds at their weight ratio as recorded.

**Table 7 Part of device structures in Examples 5 and 6 and Comparative Examples 6 and 7**

| Device ID | HIL | HTL | EBL | EML | HBL | ETL |
|---|---|---|---|---|---|---|
| Example 5 | Compound HT:Compound PD (97:3) (100 Å) | Compound HT (1340 Å) | Compound PH-23 (50 Å) | Compound PH-1:Compound H-40:Metal Complex 1493 (48:48:4) (400 Å) | Compound H-2 (50 Å) | Compound ET:Liq (40:60) (350 Å) |
| Example 6 | Compound HT:Compound PD (97:3) (100 Å) | Compound HT (1370 Å) | Compound PH-23 (50 Å) | Compound PH-1:Compound H-40:Metal Complex 1345 (48:48:4) (400 Å) | Compound H-2 (50 Å) | Compound ET:Liq (40:60) (350 Å) |
| Comparative Example 6 | Compound HT:Compound PD (97:3) (100 Å) | Compound HT (1410 Å) | Compound PH-23 (50 Å) | Compound PH-1:Compound H-40: Compound GD5 (48:48:4) (400 Å) | Compound H-2 (50 Å) | Compound ET:Liq (40:60) (350 Å) |
| Comparative Example 7 | Compound HT:Compound PD (97:3) (100 Å) | Compound HT (1370 Å) | Compound PH-23 (50 Å) | Compound PH-1:Compound H-40: Compound GD2 (48:48:4) (400 Å) | Compound H-2 (50 Å) | Compound ET:Liq (40:60) (350 Å) |

The new materials used in the devices have the following structures:

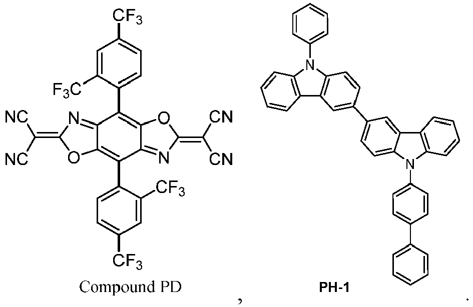

The IVL characteristics of the devices were measured at a constant current of 10 mA/cm². The corresponding color coordinate, current efficiency (CE_{0.170}) and external quantum efficiency (EQE_{0.170}) of the devices are recorded when x = 0.170 in the color coordinate CIE (x, y) of the devices. The data are recorded and shown in Table 8.

**Table 8 Device data in Examples 5 and 6 and Comparative Examples 6 and 7**

| Device ID | CIE (x, y) | CE_{0.170} (cd/A) | EQE_{0.170} (%) |
|---|---|---|---|
| Example 5 | (0.170, 0.777) | 171 | 41.29 |
| Example 6 | (0.170, 0.778) | 160 | 38.70 |
| Comparative Example 6 | (0.170, 0.780) | 147 | 35.45 |
| Comparative Example 7 | (0.170, 0.775) | 152 | 36.96 |

It can be seen from the data in Table 8 that when CIEx = 0.170 in the color coordinates CIE (x, y) in Example 5 and Comparative Example 6, both the color coordinates in Example 5 and Comparative Example 6 were close to the green coordinate CIE (0.170, 0.797) in BT.2020, that is, both Example 5 and Comparative Example 6 had a relatively saturated green light emission. However, in this case, compared with Comparative Example 6, the current efficiency and the external quantum efficiency in Example 5 were improved by 16.3% and 16.4%, respectively, both of which are significantly improved. It indicates that the technical solution provided in the present disclosure is used so that a device with more excellent performance and close to the BT.2020 luminescence requirement can be obtained and excellent device performance can be maintained under the luminescence requirement.

Similarly, when CIEx = 0.170 in the color coordinates CIE (x, y) in Example 6 and Comparative Example 7, both the color coordinates in Example 6 and Comparative Example 7 were close to the green coordinate CIE (0.170, 0.797) in BT.2020, that is, both Example 6 and Comparative Example 7 had a relatively saturated green light emission. However, in this case, compared with Comparative Example 7, both the current efficiency and the external quantum efficiency in Example 6 were improved by about 5%. It indicates that the technical solution provided in the present disclosure is used so that a device with more excellent performance and close to the BT.2020 luminescence requirement can be obtained and excellent device performance can be maintained under the luminescence requirement.

### Device Example 7

The implementation mode in Device Example 7 was the same as that in Device Example 1, except that in the emissive layer (EML), Metal Complex 1345 of the present disclosure was replaced with Metal Complex 2262.

### Device Example 8

The implementation mode in Device Example 8 was the same as that in Device Example 1, except that in the emissive layer (EML), Metal Complex 1345 of the present disclosure was replaced with Metal Complex 2164.

### Device Example 9

The implementation mode in Device Example 9 was the same as that in Device Example 1, except that in the emissive layer (EML), Metal Complex 1345 of the present disclosure was replaced with Metal Complex 2394.

### Device Example 10

The implementation mode in Device Example 10 was the same as that in Device Example 1, except that in the emissive layer (EML), Metal Complex 1345 of the present disclosure was replaced with Metal Complex 2955.

### Device Example 11

The implementation mode in Device Example 11 was the same as that in Device Example 1, except that in the emissive layer (EML), Metal Complex 1345 of the present disclosure was replaced with Metal Complex 982.

### Device Example 12

The implementation mode in Device Example 12 was the same as that in Device Example 1, except that in the emissive layer (EML), Metal Complex 1345 of the present disclosure was replaced with Metal Complex 3671.

### Device Example 13

The implementation mode in Device Example 13 was the same as that in Device Example 1, except that in the emissive layer (EML), Metal Complex 1345 of the present disclosure was replaced with Metal Complex 2526, and in the HIL, Compound HI was replaced with Compound HT:Compound PD = 97:3.

### Device Example 14

The implementation mode in Device Example 14 was the same as that in Device Example 13, except that in the emissive layer (EML), Metal Complex 2526 of the present disclosure was replaced with Metal Complex 2657.

### Device Example 15

The implementation mode in Device Example 15 was the same as that in Device Example 1, except that in the emissive layer (EML), Metal Complex 1345 of the present disclosure was replaced with Metal Complex 1371.

### Device Example 16

The implementation mode in Device Example 16 was the same as that in Device Example 13, except that in the emissive layer (EML), Metal Complex 2526 of the present disclosure was replaced with Metal Complex 2393.

### Device Example 17

The implementation mode in Device Example 17 was the same as that in Device Example 13, except that in the emissive layer (EML), Metal Complex 2526 of the present disclosure was replaced with Metal Complex 2921.

### Device Example 18

The implementation mode in Device Example 18 was the same as that in Device Example 13, except that in the emissive layer (EML), Metal Complex 2526 of the present disclosure was replaced with Metal Complex 2249.

Detailed structures and thicknesses of layers of the devices are shown in the following table. A layer using more than one material is obtained by doping different compounds at their weight ratio as recorded.

**Table 9 Device structures in Examples 7 to 18**

| Device ID | HIL | HTL | EBL | EML | HBL | ETL |
|---|---|---|---|---|---|---|
| Example 7 | Compound HI (100 Å) | Compound HT (350 Å) | Compound PH-23 (50 Å) | Compound PH-23:Compound H-40:Metal Complex 2262 (56:38:6) (400 Å) | Compound H-2 (50 Å) | Compound ET:Liq (40:60) (350 Å) |
| Example 8 | Compound HI (100 Å) | Compound HT (350 Å) | Compound PH-23 (50 Å) | Compound PH-23:Compound H-40:Metal Complex 2164 (56:38:6) (400 Å) | Compound H-2 (50 Å) | Compound ET:Liq (40:60) (350 Å) |
| Example 9 | Compound HI (100 Å) | Compound HT (350 Å) | Compound PH-23 (50 Å) | Compound PH-23:Compound H-40: Metal Complex 2394 (56:38:6) (400 Å) | Compound H-2 (50 Å) | Compound ET:Liq (40:60) (350 Å) |
| Example 10 | Compound HI (100 Å) | Compound HT (350 Å) | Compound PH-23 (50 Å) | Compound PH-23:Compound H-40: Metal Complex 2955 (56:38:6) (400 Å) | Compound H-2 (50 Å) | Compound ET:Liq (40:60) (350 Å) |
| Example 11 | Compound HI (100 Å) | Compound HT (350 Å) | Compound PH-23 (50 Å) | Compound PH-23:Compound H-40: Metal Complex 982 (56:38:6) (400 Å) | Compound H-2 (50 Å) | Compound ET:Liq (40:60) (350 Å) |
| Example 12 | Compound HI (100 Å) | Compound HT (350 Å) | Compound PH-23 (50 Å) | Compound PH-23:Compound H-40: Metal Complex 3671 (56:38:6) (400 Å) | Compound H-2 (50 Å) | Compound ET:Liq (40:60) (350 Å) |
| Example 13 | Compound HT:Compound PD (97:3) (100 Å) | Compound HT (350 Å) | Compound PH-23 (50 Å) | Compound PH-23:Compound H-40: Metal Complex 2526 (56:38:6) (400 Å) | Compound H-2 (50 Å) | Compound ET:Liq (40:60) (350 Å) |
| Example 14 | Compound HT:Compound PD (97:3) (100 Å) | Compound HT (350 Å) | Compound PH-23 (50 Å) | Compound PH-23:Compound H-40: Metal Complex 2657 (56:38:6) (400 Å) | Compound H-2 (50 Å) | Compound ET:Liq (40:60) (350 Å) |
| Example 15 | Compound HI (100 Å) | Compound HT (350 Å) | Compound PH-23 (50 Å) | Compound PH-23:Compound H-40: Metal Complex 1371 (56:38:6) (400 Å) | Compound H-2 (50 Å) | Compound ET:Liq (40:60) (350 Å) |
| Example 16 | Compound HT:Compound PD (97:3) (100 Å) | Compound HT (350 Å) | Compound PH-23 (50 Å) | Compound PH-23:Compound H-40: Metal Complex 2393 (56:38:6) (400 Å) | Compound H-2 (50 Å) | Compound ET:Liq (40:60) (350 Å) |
| Example 17 | Compound HT:Compound PD (97:3) (100 Å) | Compound HT (350 Å) | Compound PH-23 (50 Å) | Compound PH-23:Compound H-40: Metal Complex 2921 (56:38:6) (400 Å) | Compound H-2 (50 Å) | Compound ET:Liq (40:60) (350 Å) |
| Example 18 | Compound HT:Compound PD (97:3) (100 Å) | Compound HT (350 Å) | Compound PH-23 (50 Å) | Compound PH-23:Compound H-40: Metal Complex 2249 (56:38:6) (400 Å) | Compound H-2 (50 Å) | Compound ET:Liq (40:60) (350 Å) |

The new materials used in the devices have the following structures:

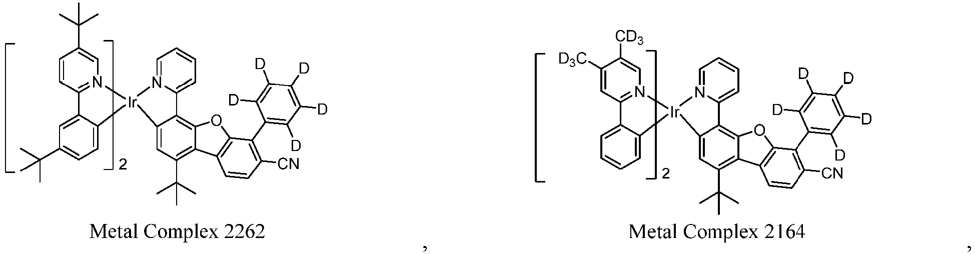

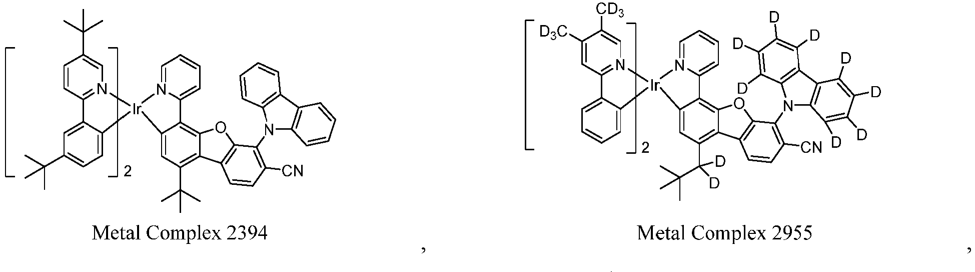

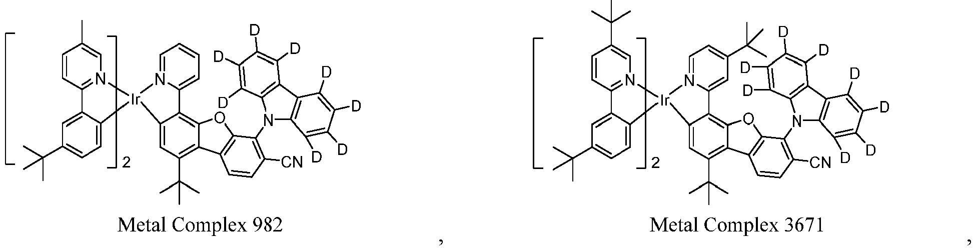

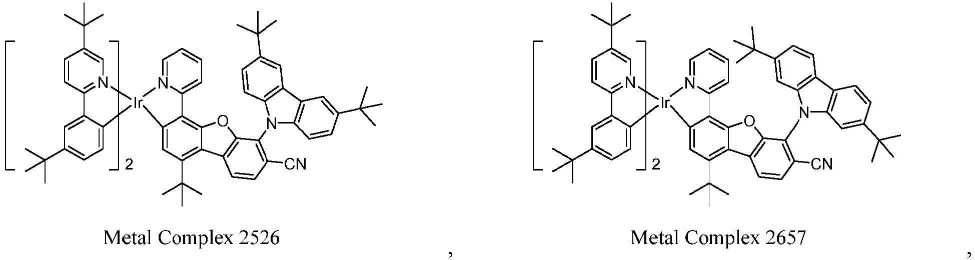

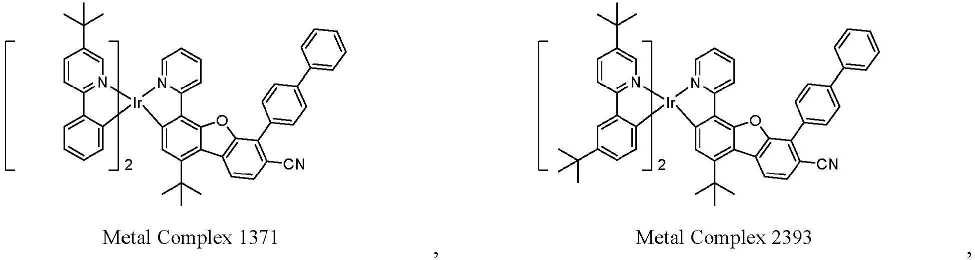

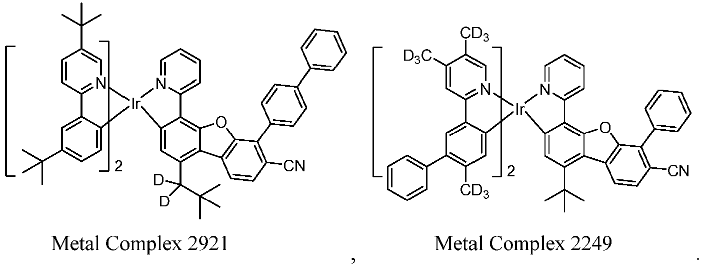

The IVL characteristics of the devices were measured. The CIE data, maximum emission wavelength (λₘₐₓ), full width at half maximum (FWHM), drive voltage (V), current efficiency (CE) and external quantum efficiency (EQE) of the devices were measured at a constant current of 10 mA/cm². The data are recorded and shown in Table 10.

**Table 10 Device data in Examples 7 to 18**

| Device ID | CIE (x, y) | Nmax (nm) | FWHM (nm) | Voltage (V) | CE (cd/A) | EQE (%) |
|---|---|---|---|---|---|---|
| Example 7 | (0.315, 0.651) | 525 | 34.0 | 3.68 | 95.04 | 24.29 |
| Example 8 | (0.309, 0.655) | 524 | 32.0 | 3.56 | 96.3 | 24.79 |
| Example 9 | (0.312, 0.654) | 527 | 33.1 | 3.46 | 97.66 | 24.94 |
| Example 10 | (0.311, 0.653) | 525 | 34.0 | 3.60 | 100.03 | 25.64 |
| Example 11 | (0.310, 0.654) | 526 | 33.8 | 4.18 | 95.17 | 24.37 |
| Example 12 | (0.296, 0.663) | 525 | 31.1 | 3.62 | 100.22 | 25.73 |
| Example 13 | (0.309, 0.655) | 526 | 32.6 | 3.39 | 105.94 | 27.02 |
| Example 14 | (0.299, 0.662) | 525 | 29.4 | 3.64 | 106.77 | 27.25 |
| Example 15 | (0.290, 0.665) | 522 | 29.2 | 3.41 | 97.61 | 25.25 |
| Example 16 | (0.314, 0.652) | 526 | 33.3 | 3.55 | 99.32 | 25.43 |
| Example 17 | (0.318, 0.649) | 526 | 36.3 | 3.54 | 101.05 | 25.92 |
| Example 18 | (0.315, 0.650) | 525 | 34.6 | 4.35 | 96.69 | 24.84 |

As can be seen from the data in Table 10, the luminescent materials used in Examples 7 to 18 each comprised the ligand Lₐ having a structure of Formula 1 of the present application. The devices of Examples 7 to 18 all had a deep green light emission, a narrow full width at half maximum and external quantum efficiency (EQE) of 24 % or more at a deep green emission wavelength, reaching a relatively high level in the art, where Examples 10, 12 to 14 and 17 all reached external quantum efficiency (EQE) of 25.5 % or more, and in particular, Examples 13 and 14 even reached surprising external quantum efficiency (EQE) of 27.02 % and 27.25 %, respectively. It also indicates that in the present application, the metal complexes each comprising the ligand Lₐ having the structure of Formula 1 comprising different substituents can all obtain excellent device performance. Moreover, in the present application, the ligand Lₐ having the structure of Formula 1 matched with different ligands L_{b} can also obtain excellent device performance.

The above results indicate that in the present application, the metal complex comprising the ligand Lₐ having the structure of Formula 1 comprising specific substituents R₁ and Rₙ is applied to an organic electroluminescent device so that a full width at half maximum of an emission spectrum can be further reduced while high performance of the device can be maintained, the luminescence saturation of the device can be improved and the device can have high efficiency under a condition of being closer to a BT.2020 commercial luminescence requirement. Therefore, in the present application, the metal complex comprising the ligand Lₐ having the structure of Formula 1 comprising specific substituents R₁ and Rₙ is a high-performance luminescent material with a commercial application prospect.

## Claims

1. A metal complex, comprising a metal M and a ligand Lₐ coordinated to the metal M, wherein Lₐ has a structure represented by Formula 1: 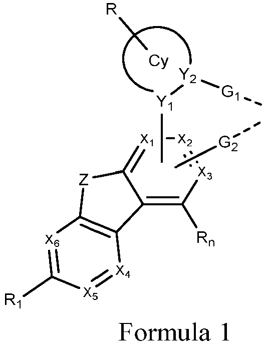 wherein in Formula 1,
the metal M is, at each occurrence identically or differently, selected from the group consisting of Cu, Ag, Au, Ru, Rh, Pd, Os, Ir and Pt;
the ring Cy is, at each occurrence identically or differently, selected from an aromatic ring having 6 to 24 ring atoms which comprises Y₁ and Y₂, a heteroaromatic ring having 5 to 24 ring atoms which comprises Y₁ and Y₂ or a combination thereof;
G₁ and G₂ are, at each occurrence identically or differently, selected from a single bond, O or S;
X₁ to X₆ are, at each occurrence identically or differently, selected from C, CRₓ or N, and one of X₁ to X₃ is selected from C and joined to Y₁;
one of X₁, X₂ and X₃ is selected from N and joined to the metal through a metal-nitrogen bond, or one of X₁, X₂ and X₃ is selected from C and joined to the metal through G₂;
Y₁ and Y₂ are, at each occurrence identically or differently, selected from C or N;
Z is selected from the group consisting of O, S, Se, NR', CR'R', SiR'R' and GeR'R'; when two R' are present at the same time, the two R' are identical or different;
R represents mono-substitution, multiple substitutions or non-substitution; when a plurality of R are present, the plurality of R are identical or different;
R, Rₓ and R' are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
R₁ is selected from a cyano group or fluorine; and
Rₙ has a structure represented by Formula 2: 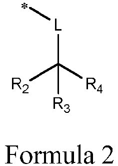
wherein in Formula 2, "*" represents a position where Formula 2 is joined to Formula 1;
L is selected from the group consisting of: a single bond, substituted or unsubstituted alkylene having 1 to 20 carbon atoms, substituted or unsubstituted cycloalkylene having 3 to 20 carbon atoms, substituted or unsubstituted arylene having 6 to 30 carbon atoms, substituted or unsubstituted heteroarylene having 3 to 30 carbon atoms and combinations thereof;
R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring;
adjacent substituents R' and Rₓ can be optionally joined to form a ring; and
adjacent substituents R₂, R₃ and R₄ can be optionally joined to form a ring.

2. The metal complex according to claim 1, wherein the metal complex has a general formula of M(Lₐ)ₘ(L_{b})ₐ(L_{c})_{q};
Lₐ, L_{b} and L_{c} are a first ligand, a second ligand and a third ligand coordinated to the metal M, respectively, and L_{c} is the same as or different from Lₐ or L_{b}, wherein Lₐ, L_{b} and L_{c} can be optionally joined to form a multidentate ligand;
m is selected from 1, 2 or 3, n is selected from 0, 1 or 2, q is selected from 0, 1 or 2, and m+n+q is equal to an oxidation state of the metal M; when m is greater than or equal to 2, a plurality of Lₐ are identical or different; when n is equal to 2, two L_{b} are identical or different; when q is equal to 2, two L_{c} are identical or different;
wherein 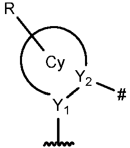 in Formula 1 is, at each occurrence identically or differently, selected from any one of the following structures: 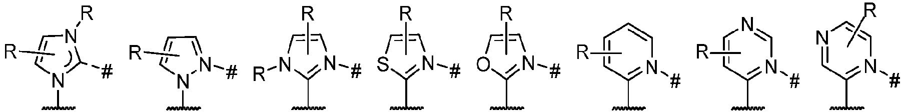 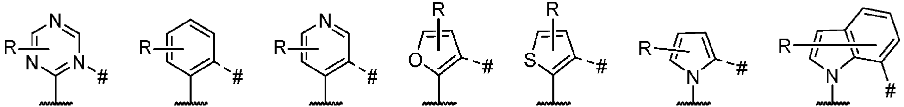 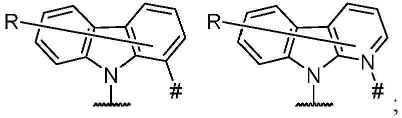
wherein
R represents, at each occurrence identically or differently, mono-substitution, multiple substitutions or non-substitution; when a plurality of R are present in any structure, the plurality of R are identical or different;
R is, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents R can be optionally joined to form a ring; and
"#" represents a position where G₁ is joined, and 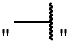 represents a position where X₁, X₂ or X₃ is joined;
L_{b} and L_{c} are, at each occurrence identically or differently, selected from a structure represented by any one of the group consisting of: 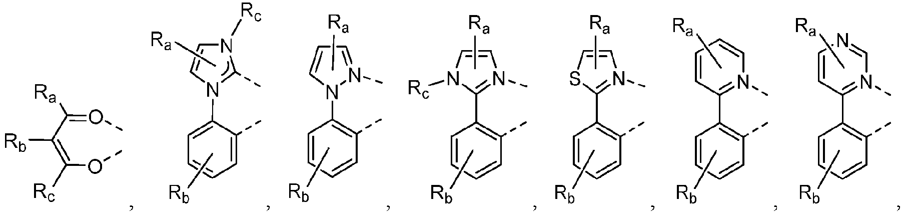 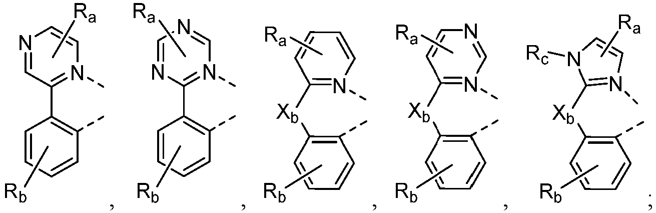
wherein
X_{b} is, at each occurrence identically or differently, selected from the group consisting of: O, S, Se, NR_{N1} and CR_{C1}R_{C2};
Rₐ and R_{b} represent, at each occurrence identically or differently, mono-substitution, multiple substitutions or non-substitution;
Rₐ, R_{b}, R_{c}, R_{N1}, R_{C1} and R_{C2} are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof; and
adjacent substituents Rₐ, R_{b}, R_{c}, R_{N1}, R_{C1} and R_{C2} can be optionally joined to form a ring;
the metal M is, at each occurrence identically or differently, selected from Pt or Ir.

3. The metal complex according to claim 1 or 2, wherein the metal complex has a general formula structure of Ir(Lₐ)ₘ(L_{b})₃₋ₘ, and the structure is represented by Formula 3: 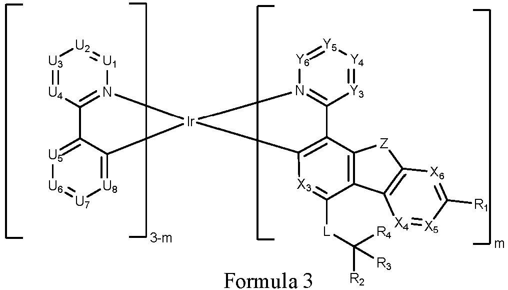 wherein
m is selected from 1, 2 or 3; when m is selected from 1, two L_{b} are identical or different; when m is selected from 2 or 3, a plurality of Lₐ are identical or different;
Z is selected from the group consisting of O, S, Se, NR', CR'R', SiR'R' and GeR'R'; when two R' are present at the same time, the two R' are identical or different;
U₁ to U₈ are, at each occurrence identically or differently, selected from CRᵤ or N;
X₃ to X₆ are, at each occurrence identically or differently, selected from CRₓ or N;
Y₃ to Y₆ are, at each occurrence identically or differently, selected from CR or N;
R₁ is selected from a cyano group or fluorine;
R', R_{y}, Rₓ and R are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
L is selected from the group consisting of: a single bond, substituted or unsubstituted alkylene having 1 to 20 carbon atoms, substituted or unsubstituted cycloalkylene having 3 to 20 carbon atoms, substituted or unsubstituted arylene having 6 to 30 carbon atoms, substituted or unsubstituted heteroarylene having 3 to 30 carbon atoms and combinations thereof;
R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
adjacent substituents Rᵤ can be optionally joined to form a ring;
adjacent substituents R can be optionally joined to form a ring;
adjacent substituents R' and Rₓ can be optionally joined to form a ring; and
adjacent substituents R₂, R₃ and R₄ can be optionally joined to form a ring;
preferably, Z is selected from O or S; more preferably, Z is selected from O.

4. The metal complex according to any one of claims 1 to 3, wherein L is selected from the group consisting of: a single bond, substituted or unsubstituted alkylene having 1 to 6 carbon atoms, substituted or unsubstituted cycloalkylene having 4 to 10 carbon atoms, substituted or unsubstituted arylene having 6 to 12 carbon atoms and combinations thereof; and
wherein R₂, R₃ and R₄ are, at each occurrence identically or differently, selected from the group consisting of: halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, a cyano group and combinations thereof;
preferably, L is selected from a single bond and substituted or unsubstituted methylene; preferably, R₂, R₃ and R₄ are, at each occurrence identically or differently, selected from the group consisting of: fluorine, substituted or unsubstituted alkyl having 1 to 20 carbon atoms, substituted or unsubstituted aryl having 6 to 30 carbon atoms, a cyano group and combinations thereof; and
more preferably, R₂, R₃ and R₄ are, at each occurrence identically or differently, selected from substituted or unsubstituted alkyl having 1 to 20 carbon atoms.

5. The metal complex according to claim 3, wherein X₃ to X₆ are, at each occurrence identically or differently, selected from CRₓ, and/or Y₃ to Y₆ are, at each occurrence identically or differently, selected from CR, and/or U₁ to U₈ are, at each occurrence identically or differently, selected from CRᵤ;
Rₓ, R and Rᵤ are, at each occurrence identically or differently, selected from the group consisting of: hydrogen, deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted alkylgermanyl having 3 to 20 carbon atoms, a cyano group and combinations thereof;
preferably, Rₓ, R and Rᵤ are, at each occurrence identically or differently, selected from the group consisting of: hydrogen, deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms, substituted or unsubstituted heteroaryl having 3 to 12 carbon atoms, substituted or unsubstituted alkylsilyl having 3 to 12 carbon atoms, substituted or unsubstituted alkylgermanyl having 3 to 12 carbon atoms, a cyano group and combinations thereof; and
more preferably, Rₓ, R and Rᵤ are, at each occurrence identically or differently, selected from the group consisting of: hydrogen, deuterium, fluorine, a cyano group, methyl, ethyl, propyl, isopropyl, n-butyl, isobutyl, neopentyl, t-butyl, cyclopentyl, cyclohexyl, deuterated methyl, deuterated ethyl, deuterated propyl, deuterated isopropyl, deuterated n-butyl, deuterated isobutyl, deuterated neopentyl, deuterated t-butyl, deuterated cyclopentyl, deuterated cyclohexyl, phenyl, pyridyl, trimethylsilyl, trimethylgermanyl and combinations thereof.

6. The metal complex according to claim 3, wherein Y₃ to Y₆ are, at each occurrence identically or differently, CR or N, at least one of Y₃ to Y₆ is selected from CR, and R is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof; and
preferably, R is selected from the group consisting of: deuterium, fluorine, substituted or unsubstituted alkyl having 1 to 6 carbon atoms, substituted or unsubstituted cycloalkyl having 3 to 6 ring carbon atoms, substituted or unsubstituted aryl having 6 to 12 carbon atoms and combinations thereof.

7. The metal complex according to claim 1 or 3, wherein at least one of X₃ to X₆ is selected from CRₓ, and Rₓ is selected from the group consisting of: deuterium, halogen, substituted or unsubstituted alkyl having 1 to 20 carbon atoms, substituted or unsubstituted cycloalkyl having 3 to 20 ring carbon atoms, substituted or unsubstituted heteroalkyl having 1 to 20 carbon atoms, a substituted or unsubstituted heterocyclic group having 3 to 20 ring atoms, substituted or unsubstituted arylalkyl having 7 to 30 carbon atoms, substituted or unsubstituted alkoxy having 1 to 20 carbon atoms, substituted or unsubstituted aryloxy having 6 to 30 carbon atoms, substituted or unsubstituted alkenyl having 2 to 20 carbon atoms, substituted or unsubstituted alkynyl having 2 to 20 carbon atoms, substituted or unsubstituted aryl having 6 to 30 carbon atoms, substituted or unsubstituted heteroaryl having 3 to 30 carbon atoms, substituted or unsubstituted alkylsilyl having 3 to 20 carbon atoms, substituted or unsubstituted arylsilyl having 6 to 20 carbon atoms, substituted or unsubstituted alkylgermanyl having 3 to 20 carbon atoms, substituted or unsubstituted arylgermanyl having 6 to 20 carbon atoms, substituted or unsubstituted amino having 0 to 20 carbon atoms, an acyl group, a carbonyl group, a carboxylic acid group, an ester group, a cyano group, an isocyano group, a hydroxyl group, a sulfanyl group, a sulfinyl group, a sulfonyl group, a phosphino group and combinations thereof;
preferably, X₆ is selected from CRₓ, and Rₓ is selected from the group consisting of: deuterium, substituted or unsubstituted alkyl having 1 to 20 carbon atoms, substituted or unsubstituted cycloalkyl having 3 to 20 ring carbon atoms, substituted or unsubstituted aryl having 6 to 30 carbon atoms, substituted or unsubstituted heteroaryl having 3 to 30 carbon atoms and combinations thereof; and
more preferably, X₆ is selected from CRₓ, and Rₓ is selected from substituted or unsubstituted aryl having 6 to 18 carbon atoms, substituted or unsubstituted heteroaryl having 3 to 18 carbon atoms or a combination thereof.

8. The metal complex according to any one of claims 1 to 7, wherein Rₙ is, at each occurrence identically or differently, selected from the group consisting of: 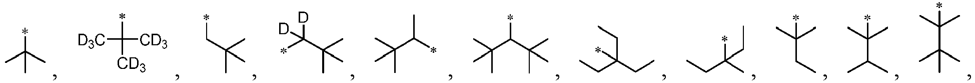 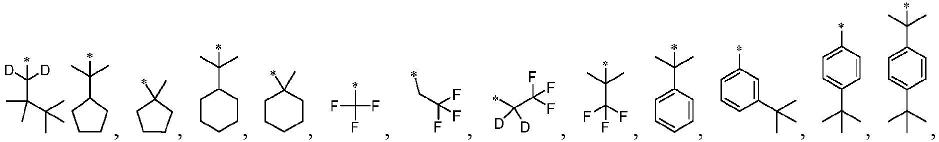 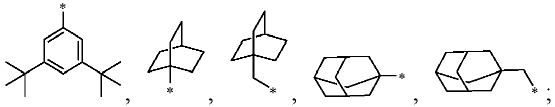 wherein optionally, hydrogens in the above Rₙ can be partially or fully substituted with deuterium.

9. The metal complex according to claim 3, wherein at least one or at least two of U₁ to U₈ are selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in all of Rᵤ is at least 4; and
preferably, at least one or at least two of U₁ to U₈ and/or U₈ to U₈ are selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in all of Rᵤ is at least 4.

10. The metal complex according to claim 3, wherein at least one of U₁ to U₄ is selected from CRᵤ, at least one of Y₃ to Y₆ is selected from CR, Rᵤ and R are selected from substituted or unsubstituted alkyl having 1 to 20 carbon atoms, substituted or unsubstituted cycloalkyl having 3 to 20 ring carbon atoms or a combination thereof, and the total number of carbon atoms in Rᵤ and R is greater than or equal to 2; or
at least one of U₅ to U₈ is selected from CRᵤ, at least one of Y₃ to Y₆ is selected from CR, Rᵤ and R are selected from substituted or unsubstituted alkyl having 1 to 20 carbon atoms, substituted or unsubstituted cycloalkyl having 3 to 20 ring carbon atoms or a combination thereof, and the total number of carbon atoms in Rᵤ and R is greater than or equal to 2; or
at least one of U₁ to U₄ is selected from CRᵤ, at least one of U₅ to U₈ is selected from CRᵤ, Rᵤ is selected from substituted or unsubstituted alkyl having 1 to 20 carbon atoms, substituted or unsubstituted cycloalkyl having 3 to 20 ring carbon atoms or a combination thereof, and the total number of carbon atoms in Rᵤ is greater than or equal to 2.

11. The metal complex according to claim 1, wherein Lₐ is, at each occurrence identically or differently, selected from the group consisting of Lₐ₁ to Lₐ₃₅₃₀;
wherein Lₐ₁ to Lₐ₃₄₅₇ each have the following structure: 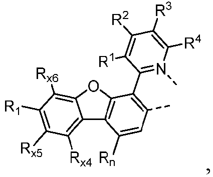 wherein R₁, Rₙ, R_{X4}, Rₓ₅, Rₓ₆ and R¹ to R⁴ are selected from the atoms or groups in the following table:
| Lₐ No. | Rₙ | R₁ | Rx₄ | Rx₅ | Rx₆ | R¹ | R² | R³ | R⁴ |
|---|---|---|---|---|---|---|---|---|---|
| Lₐ₁ | P6 | CN | H | H | H | H | H | H | H |
| Lₐ₂ | P6 | CN | H | H | H | H | P1 | H | H |
| Lₐ₃ | P6 | CN | H | H | H | H | P2 | H | H |
| Lₐ₄ | P6 | CN | H | H | H | H | P3 | H | H |
| Lₐ₅ | P6 | CN | H | H | H | H | P4 | H | H |
| Lₐ₆ | P6 | CN | H | H | H | H | P5 | H | H |
| Lₐ₇ | P6 | CN | H | H | H | H | P6 | H | H |
| Lₐ₈ | P6 | CN | H | H | H | H | P7 | H | H |
| Lₐ₉ | P6 | CN | H | H | H | H | P8 | H | H |
| Lₐ₁₀ | P6 | CN | H | H | H | H | P9 | H | H |
| Lₐ₁₁ | P6 | CN | H | H | H | H | P10 | H | H |
| Lₐ₁₂ | P6 | CN | H | H | H | H | P11 | H | H |
| Lₐ₁₃ | P6 | CN | H | H | H | H | P12 | H | H |
| Lₐ₁₄ | P6 | CN | H | H | H | H | P13 | H | H |
| Lₐ₁₅ | P6 | CN | H | H | H | H | P14 | H | H |
| Lₐ₁₆ | P6 | CN | H | H | H | H | P15 | H | H |
| Lₐ₁₇ | P6 | CN | H | H | H | H | P16 | H | H |
| Lₐ₁₈ | P6 | CN | H | H | H | H | P17 | H | H |
| Lₐ₁₉ | P6 | CN | H | H | H | H | P18 | H | H |
| Lₐ₂₀ | P6 | CN | H | H | H | H | P19 | H | H |
| Lₐ₂₁ | P6 | CN | H | H | H | H | P20 | H | H |
| Lₐ₂₂ | P6 | CN | H | H | H | H | P21 | H | H |
| Lₐ₂₃ | P6 | CN | H | H | H | H | P1 | F | H |
| Lₐ₂₄ | P6 | CN | H | H | H | H | P2 | F | H |
| Lₐ₂₅ | P6 | CN | H | H | H | H | P3 | F | H |
| Lₐ₂₆ | P6 | CN | H | H | H | H | P4 | F | H |
| Lₐ₂₇ | P6 | CN | H | H | H | H | P5 | F | H |
| Lₐ₂₈ | P6 | CN | H | H | H | H | P6 | F | H |
| Lₐ₂₉ | P6 | CN | H | H | H | H | P7 | F | H |
| Lₐ₃₀ | P6 | CN | H | H | H | H | P8 | F | H |
| Lₐ₃₁ | P6 | CN | H | H | H | H | P9 | F | H |
| Lₐ₃₂ | P6 | CN | H | H | H | H | P10 | F | H |
| Lₐ₂₆ | P6 | CN | H | H | H | H | P11 | F | H |
| Lₐ₂₆ | P6 | CN | H | H | H | H | P12 | F | H |
| Lₐ₂₆ | P6 | CN | H | H | H | H | P13 | F | H |
| Lₐ₂₆ | P6 | CN | H | H | H | H | P14 | F | H |
| Lₐ₃₇ | P6 | CN | H | H | H | H | P15 | F | H |
| Lₐ₂₆ | P6 | CN | H | H | H | H | P16 | F | H |
| Lₐ₃₉ | P6 | CN | H | H | H | H | P17 | F | H |
| Lₐ₄₀ | P6 | CN | H | H | H | H | P18 | F | H |
| Lₐ₄₁ | P6 | CN | H | H | H | H | P19 | F | H |
| Lₐ₄₂ | P6 | CN | H | H | H | H | P20 | F | H |
| Lₐ₂₆ | P6 | CN | H | H | H | H | P21 | F | H |
| Lₐ₄₄ | P6 | CN | H | H | H | H | H | P1 | H |
| Lₐ₂₆ | P6 | CN | H | H | H | H | H | P2 | H |
| Lₐ₂₆ | P6 | CN | H | H | H | H | H | P3 | H |
| Lₐ₄₇ | P6 | CN | H | H | H | H | H | P4 | H |
| Lₐ₄₈ | P6 | CN | H | H | H | H | H | P5 | H |
| Lₐ₂₆ | P6 | CN | H | H | H | H | H | P6 | H |
| Lₐ₅₀ | P6 | CN | H | H | H | H | H | P7 | H |
| Lₐ₅₁ | P6 | CN | H | H | H | H | H | P8 | H |
| Lₐ₅₂ | P6 | CN | H | H | H | H | H | P9 | H |
| Lₐ₂₆ | P6 | CN | H | H | H | H | H | P10 | H |
| Lₐ₂₆ | P6 | CN | H | H | H | H | H | P11 | H |
| Lₐ₂₆ | P6 | CN | H | H | H | H | H | P12 | H |
| Lₐ₂₆ | P6 | CN | H | H | H | H | H | P13 | H |
| Lₐ₂₆ | P6 | CN | H | H | H | H | H | P14 | H |
| Lₐ₂₆ | P6 | CN | H | H | H | H | H | P15 | H |
| Lₐ₅₉ | P6 | CN | H | H | H | H | H | P16 | H |
| Lₐ₆₀ | P6 | CN | H | H | H | H | H | P17 | H |
| Lₐ₆₁ | P6 | CN | H | H | H | H | H | P18 | H |
| Lₐ₆₂ | P6 | CN | H | H | H | H | H | P19 | H |
| Lₐ₂₆ | P6 | CN | H | H | H | H | H | P20 | H |
| Lₐ₂₆ | P6 | CN | H | H | H | H | H | P21 | H |
| Lₐ₂₆ | P6 | CN | H | H | H | H | F | P1 | H |
| Lₐ₆₆ | P6 | CN | H | H | H | H | F | P2 | H |
| Lₐ₆₇ | P6 | CN | H | H | H | H | F | P3 | H |
| Lₐ₂₆ | P6 | CN | H | H | H | H | F | P4 | H |
| Lₐ₆₉ | P6 | CN | H | H | H | H | F | P5 | H |
| Lₐ₇₀ | P6 | CN | H | H | H | H | F | P6 | H |
| Lₐ₇₁ | P6 | CN | H | H | H | H | F | P7 | H |
| Lₐ₇₂ | P6 | CN | H | H | H | H | F | P8 | H |
| Lₐ₇₃ | P6 | CN | H | H | H | H | F | P9 | H |
| Lₐ₇₄ | P6 | CN | H | H | H | H | F | P10 | H |
| Lₐ₇₅ | P6 | CN | H | H | H | H | F | P11 | H |
| Lₐ₇₆ | P6 | CN | H | H | H | H | F | P12 | H |
| Lₐ₇₇ | P6 | CN | H | H | H | H | F | P13 | H |
| Lₐ₇₈ | P6 | CN | H | H | H | H | F | P14 | H |
| Lₐ₇₉ | P6 | CN | H | H | H | H | F | P15 | H |
| Lₐ₈₀ | P6 | CN | H | H | H | H | F | P16 | H |
| Lₐ₈₁ | P6 | CN | H | H | H | H | F | P17 | H |
| Lₐ₈₂ | P6 | CN | H | H | H | H | F | P18 | H |
| Lₐ₂₆ | P6 | CN | H | H | H | H | F | P19 | H |
| Lₐ₂₆ | P6 | CN | H | H | H | H | F | P20 | H |
| Lₐ₂₆ | P6 | CN | H | H | H | H | F | P21 | H |
| Lₐ₂₆ | P6 | CN | H | H | H | H | P1 | P1 | H |
| Lₐ₈₇ | P6 | CN | H | H | H | H | P1 | P3 | H |
| Lₐ₂₆ | P6 | CN | H | H | H | H | P1 | P8 | H |
| Lₐ₈₉ | P6 | CN | H | H | H | H | P1 | P10 | H |
| Lₐ₉₀ | P6 | CN | H | H | H | H | P1 | P20 | H |
| Lₐ₉₁ | P6 | CN | H | H | H | H | P1 | P21 | H |
| Lₐ₉₂ | P6 | CN | H | H | H | H | P2 | P2 | H |
| Lₐ₉₃ | P6 | CN | H | H | H | H | P2 | P4 | H |
| Lₐ₉₄ | P6 | CN | H | H | H | H | P2 | P5 | H |
| Lₐ₉₅ | P6 | CN | H | H | H | H | P2 | P9 | H |
| Lₐ₉₆ | P6 | CN | H | H | H | H | P2 | P11 | H |
| Lₐ₉₇ | P6 | CN | H | H | H | H | P2 | P20 | H |
| Lₐ₉₈ | P6 | CN | H | H | H | H | P2 | P21 | H |
| Lₐ₉₉ | P6 | CN | H | H | H | D | D | D | D |
| Lₐ₁₀₀ | P6 | CN | H | H | H | D | F | D | D |
| Lₐ₁₀₁ | P6 | CN | H | H | H | D | D | F | D |
| Lₐ₁₀₂ | P6 | CN | H | H | H | D | P2 | D | D |
| Lₐ₁₀₃ | P6 | CN | H | H | H | D | D | P2 | D |
| Lₐ₁₀₄ | P6 | CN | H | H | H | D | P2 | P2 | D |
| Lₐ₁₀₅ | P6 | CN | H | H | D | H | H | H | H |
| Lₐ₁₀₆ | P6 | CN | H | H | D | H | P6 | H | H |
| Lₐ₁₀₇ | P6 | CN | H | H | D | H | P2 | H | H |
| Lₐ₁₀₈ | P6 | CN | H | H | D | H | P5 | H | H |
| Lₐ₁₀₉ | P6 | CN | H | H | D | H | P10 | H | H |
| Lₐ₁₁₀ | P6 | CN | H | H | D | H | P11 | H | H |
| Lₐ₁₁₁ | P6 | CN | H | H | D | H | H | P6 | H |
| Lₐ₁₁₂ | P6 | CN | H | H | D | H | H | P2 | H |
| Lₐ₁₁₃ | P6 | CN | H | H | D | H | H | P4 | H |
| Lₐ₁₁₄ | P6 | CN | H | H | D | H | H | P5 | H |
| Lₐ₁₁₅ | P6 | CN | H | H | D | H | H | P10 | H |
| Lₐ₁₁₆ | P6 | CN | H | H | D | H | H | P11 | H |
| Lₐ₁₁₇ | P6 | CN | H | H | D | H | P1 | F | H |
| Lₐ₁₁₈ | P6 | CN | H | H | D | H | P2 | F | H |
| Lₐ₁₁₉ | P6 | CN | H | H | D | H | P11 | F | H |
| Lₐ₁₂₀ | P6 | CN | H | H | D | H | F | P1 | H |
| Lₐ₁₂₁ | P6 | CN | H | H | D | H | F | P2 | H |
| Lₐ₁₂₂ | P6 | CN | H | H | D | H | F | P3 | H |
| Lₐ₁₂₃ | P6 | CN | H | H | D | H | F | P4 | H |
| Lₐ₁₂₄ | P6 | CN | H | H | D | H | F | P5 | H |
| Lₐ₁₂₅ | P6 | CN | H | H | D | H | F | P8 | H |
| Lₐ₁₂₆ | P6 | CN | H | H | D | H | F | P11 | H |
| Lₐ₁₂₇ | P6 | CN | H | H | D | H | P1 | P1 | H |
| Lₐ₁₂₈ | P6 | CN | H | H | D | H | P2 | P2 | H |
| Lₐ₁₂₉ | P6 | CN | H | H | D | H | P2 | P2 | D |
| Lₐ₁₃₀ | P6 | CN | H | H | P20 | H | H | H | H |
| Lₐ₁₃₁ | P6 | CN | H | H | P20 | H | P1 | H | H |
| Lₐ₁₃₂ | P6 | CN | H | H | P20 | H | P2 | H | H |
| Lₐ₁₃₃ | P6 | CN | H | H | P20 | H | P3 | H | H |
| Lₐ₁₃₄ | P6 | CN | H | H | P20 | H | P4 | H | H |
| Lₐ₁₃₅ | P6 | CN | H | H | P20 | H | P5 | H | H |
| Lₐ₁₃₆ | P6 | CN | H | H | P20 | H | P6 | H | H |
| Lₐ₁₃₇ | P6 | CN | H | H | P20 | H | P7 | H | H |
| Lₐ₁₃₈ | P6 | CN | H | H | P20 | H | P8 | H | H |
| Lₐ₁₃₉ | P6 | CN | H | H | P20 | H | P9 | H | H |
| Lₐ₁₄₀ | P6 | CN | H | H | P20 | H | P10 | H | H |
| Lₐ₁₄₁ | P6 | CN | H | H | P20 | H | P11 | H | H |
| Lₐ₁₄₂ | P6 | CN | H | H | P20 | H | P12 | H | H |
| Lₐ₁₄₃ | P6 | CN | H | H | P20 | H | P13 | H | H |
| Lₐ₁₄₄ | P6 | CN | H | H | P20 | H | P14 | H | H |
| Lₐ₁₄₅ | P6 | CN | H | H | P20 | H | P15 | H | H |
| Lₐ₁₄₆ | P6 | CN | H | H | P20 | H | P16 | H | H |
| Lₐ₁₄₇ | P6 | CN | H | H | P20 | H | P17 | H | H |
| Lₐ₁₄₈ | P6 | CN | H | H | P20 | H | P18 | H | H |
| Lₐ₁₄₉ | P6 | CN | H | H | P20 | H | P19 | H | H |
| Lₐ₁₅₀ | P6 | CN | H | H | P20 | H | P20 | H | H |
| Lₐ₁₅₁ | P6 | CN | H | H | P20 | H | P21 | H | H |
| Lₐ₁₅₂ | P6 | CN | H | H | P20 | H | H | P1 | H |
| Lₐ₁₅₃ | P6 | CN | H | H | P20 | H | H | P2 | H |
| Lₐ₁₅₄ | P6 | CN | H | H | P20 | H | H | P3 | H |
| Lₐ₁₅₅ | P6 | CN | H | H | P20 | H | H | P4 | H |
| Lₐ₁₅₆ | P6 | CN | H | H | P20 | H | H | P5 | H |
| Lₐ₁₅₇ | P6 | CN | H | H | P20 | H | H | P6 | H |
| Lₐ₁₅₈ | P6 | CN | H | H | P20 | H | H | P7 | H |
| Lₐ₁₅₉ | P6 | CN | H | H | P20 | H | H | P8 | H |
| Lₐ₁₆₀ | P6 | CN | H | H | P20 | H | H | P9 | H |
| Lₐ₁₆₁ | P6 | CN | H | H | P20 | H | H | P10 | H |
| Lₐ₁₆₂ | P6 | CN | H | H | P20 | H | H | P11 | H |
| Lₐ₁₆₃ | P6 | CN | H | H | P20 | H | H | P12 | H |
| Lₐ₁₆₄ | P6 | CN | H | H | P20 | H | H | P15 | H |
| Lₐ₁₆₅ | P6 | CN | H | H | P20 | H | H | P17 | H |
| Lₐ₁₆₆ | P6 | CN | H | H | P20 | H | H | P18 | H |
| Lₐ₁₆₇ | P6 | CN | H | H | P20 | H | H | P19 | H |
| Lₐ₁₆₈ | P6 | CN | H | H | P20 | H | H | P20 | H |
| Lₐ₁₆₉ | P6 | CN | H | H | P20 | H | H | P21 | H |
| Lₐ₁₇₀ | P6 | CN | H | H | P20 | H | F | H | H |
| Lₐ₁₇₁ | P6 | CN | H | H | P20 | H | F | P1 | H |
| Lₐ₁₇₂ | P6 | CN | H | H | P20 | H | F | P2 | H |
| Lₐ₁₇₃ | P6 | CN | H | H | P20 | H | F | P3 | H |
| Lₐ₁₇₄ | P6 | CN | H | H | P20 | H | F | P4 | H |
| Lₐ₁₇₅ | P6 | CN | H | H | P20 | H | F | P5 | H |
| Lₐ₁₇₆ | P6 | CN | H | H | P20 | H | F | P6 | H |
| Lₐ₁₇₇ | P6 | CN | H | H | P20 | H | F | P7 | H |
| Lₐ₁₇₈ | P6 | CN | H | H | P20 | H | F | P8 | H |
| Lₐ₁₇₉ | P6 | CN | H | H | P20 | H | F | P9 | H |
| Lₐ₁₈₀ | P6 | CN | H | H | P20 | H | F | P10 | H |
| Lₐ₁₈₁ | P6 | CN | H | H | P20 | H | F | P11 | H |
| Lₐ₁₈₂ | P6 | CN | H | H | P20 | H | P1 | F | H |
| Lₐ₁₈₃ | P6 | CN | H | H | P20 | H | P2 | F | H |
| Lₐ₁₈₄ | P6 | CN | H | H | P20 | H | P3 | F | H |
| Lₐ₁₈₅ | P6 | CN | H | H | P20 | H | P4 | F | H |
| Lₐ₁₈₆ | P6 | CN | H | H | P20 | H | P5 | F | H |
| Lₐ₁₈₇ | P6 | CN | H | H | P20 | H | P6 | F | H |
| Lₐ₁₈₈ | P6 | CN | H | H | P20 | H | P7 | F | H |
| Lₐ₁₈₀ | P6 | CN | H | H | P20 | H | P8 | F | H |
| Lₐ₁₈₀ | P6 | CN | H | H | P20 | H | P9 | F | H |
| Lₐ₁₉₁ | P6 | CN | H | H | P20 | H | P10 | F | H |
| Lₐ₁₉₂ | P6 | CN | H | H | P20 | H | P11 | F | H |
| Lₐ₁₉₃ | P6 | CN | H | H | P20 | H | P1 | P1 | H |
| Lₐ₁₉₄ | P6 | CN | H | H | P20 | H | P2 | P2 | H |
| Lₐ₁₉₅ | P6 | CN | H | H | P20 | D | D | D | D |
| Lₐ₁₉₆ | P6 | CN | H | H | P20 | D | P2 | P2 | D |
| Lₐ₁₉₇ | P6 | CN | H | H | P20 | D | F | P4 | D |
| Lₐ₁₉₈ | P6 | CN | H | H | P20 | D | F | P5 | D |
| Lₐ₁₉₉ | P6 | CN | H | H | P20 | D | F | P9 | D |
| Lₐ₂₀₀ | P6 | CN | H | H | P20 | D | F | P11 | D |
| Lₐ₂₀₁ | P6 | CN | H | H | P21 | H | H | H | H |
| Lₐ₂₀₂ | P6 | CN | H | H | P21 | H | P1 | H | H |
| Lₐ₂₀₃ | P6 | CN | H | H | P21 | H | P2 | H | H |
| Lₐ₂₀₄ | P6 | CN | H | H | P21 | H | P3 | H | H |
| Lₐ₂₀₅ | P6 | CN | H | H | P21 | H | P4 | H | H |
| Lₐ₂₀₆ | P6 | CN | H | H | P21 | H | P5 | H | H |
| Lₐ₂₀₇ | P6 | CN | H | H | P21 | H | P6 | H | H |
| Lₐ₂₀₈ | P6 | CN | H | H | P21 | H | P7 | H | H |
| Lₐ₂₀₉ | P6 | CN | H | H | P21 | H | P8 | H | H |
| Lₐ₂₁₀ | P6 | CN | H | H | P21 | H | P9 | H | H |
| Lₐ₂₁₁ | P6 | CN | H | H | P21 | H | P10 | H | H |
| Lₐ₂₁₂ | P6 | CN | H | H | P21 | H | P11 | H | H |
| Lₐ₂₁₃ | P6 | CN | H | H | P21 | H | P12 | H | H |
| Lₐ₂₁₄ | P6 | CN | H | H | P21 | H | P13 | H | H |
| Lₐ₂₁₅ | P6 | CN | H | H | P21 | H | P14 | H | H |
| Lₐ₂₁₆ | P6 | CN | H | H | P21 | H | P15 | H | H |
| Lₐ₂₁₇ | P6 | CN | H | H | P21 | H | P16 | H | H |
| Lₐ₂₁₈ | P6 | CN | H | H | P21 | H | P17 | H | H |
| Lₐ₂₁₉ | P6 | CN | H | H | P21 | H | P18 | H | H |
| Lₐ₂₂₀ | P6 | CN | H | H | P21 | H | P19 | H | H |
| Lₐ₂₂₁ | P6 | CN | H | H | P21 | H | P20 | H | H |
| Lₐ₂₂₂ | P6 | CN | H | H | P21 | H | P21 | H | H |
| Lₐ₂₂₃ | P6 | CN | H | H | P21 | H | H | P1 | H |
| Lₐ₂₂₄ | P6 | CN | H | H | P21 | H | H | P2 | H |
| Lₐ₂₂₅ | P6 | CN | H | H | P21 | H | H | P3 | H |
| Lₐ₂₂₆ | P6 | CN | H | H | P21 | H | H | P4 | H |
| Lₐ₂₂₇ | P6 | CN | H | H | P21 | H | H | P5 | H |
| Lₐ₂₂₈ | P6 | CN | H | H | P21 | H | H | P6 | H |
| Lₐ₂₂₉ | P6 | CN | H | H | P21 | H | H | P7 | H |
| Lₐ₂₃₀ | P6 | CN | H | H | P21 | H | H | P8 | H |
| Lₐ₂₃₁ | P6 | CN | H | H | P21 | H | H | P9 | H |
| Lₐ₂₃₂ | P6 | CN | H | H | P21 | H | H | P10 | H |
| Lₐ₂₃₃ | P6 | CN | H | H | P21 | H | H | P11 | H |
| Lₐ₂₃₄ | P6 | CN | H | H | P21 | H | H | P12 | H |
| Lₐ₂₃₅ | P6 | CN | H | H | P21 | H | H | P15 | H |
| Lₐ₂₃₆ | P6 | CN | H | H | P21 | H | H | P17 | H |
| Lₐ₂₃₇ | P6 | CN | H | H | P21 | H | H | P18 | H |
| Lₐ₂₃₈ | P6 | CN | H | H | P21 | H | H | P19 | H |
| Lₐ₂₃₉ | P6 | CN | H | H | P21 | H | H | P20 | H |
| Lₐ₂₄₀ | P6 | CN | H | H | P21 | H | H | P21 | H |
| Lₐ₂₄₁ | P6 | CN | H | H | P21 | H | F | H | H |
| Lₐ₂₄₂ | P6 | CN | H | H | P21 | H | F | P1 | H |
| Lₐ₂₄₃ | P6 | CN | H | H | P21 | H | F | P2 | H |
| Lₐ₂₄₄ | P6 | CN | H | H | P21 | H | F | P3 | H |
| Lₐ₂₄₅ | P6 | CN | H | H | P21 | H | F | P4 | H |
| Lₐ₂₄₆ | P6 | CN | H | H | P21 | H | F | P5 | H |
| Lₐ₂₄₇ | P6 | CN | H | H | P21 | H | F | P6 | H |
| Lₐ₂₄₈ | P6 | CN | H | H | P21 | H | F | P7 | H |
| Lₐ₂₄₉ | P6 | CN | H | H | P21 | H | F | P8 | H |
| Lₐ₂₅₀ | P6 | CN | H | H | P21 | H | F | P9 | H |
| Lₐ₂₅₁ | P6 | CN | H | H | P21 | H | F | P10 | H |
| Lₐ₂₅₂ | P6 | CN | H | H | P21 | H | F | P11 | H |
| Lₐ₂₅₃ | P6 | CN | H | H | P21 | H | P1 | F | H |
| Lₐ₂₅₄ | P6 | CN | H | H | P21 | H | P2 | F | H |
| Lₐ₂₅₅ | P6 | CN | H | H | P21 | H | P3 | F | H |
| Lₐ₂₅₆ | P6 | CN | H | H | P21 | H | P4 | F | H |
| Lₐ₂₅₇ | P6 | CN | H | H | P21 | H | P5 | F | H |
| Lₐ₂₅₈ | P6 | CN | H | H | P21 | H | P6 | F | H |
| Lₐ₂₅₉ | P6 | CN | H | H | P21 | H | P7 | F | H |
| Lₐ₂₆₀ | P6 | CN | H | H | P21 | H | P8 | F | H |
| Lₐ₂₆₁ | P6 | CN | H | H | P21 | H | P9 | F | H |
| Lₐ₂₆₂ | P6 | CN | H | H | P21 | H | P10 | F | H |
| Lₐ₂₆₃ | P6 | CN | H | H | P21 | H | P11 | F | H |
| Lₐ₂₆₄ | P6 | CN | H | H | P21 | H | P1 | P1 | H |
| Lₐ₂₆₅ | P6 | CN | H | H | P21 | H | P2 | P2 | H |
| Lₐ₂₆₆ | P6 | CN | H | H | P21 | D | D | D | D |
| Lₐ₂₆₇ | P6 | CN | H | H | P21 | D | P2 | P2 | D |
| Lₐ₂₆₈ | P6 | CN | H | H | P21 | D | F | P4 | D |
| Lₐ₂₆₉ | P6 | CN | H | H | P21 | D | F | P5 | D |
| Lₐ₂₇₀ | P6 | CN | H | H | P21 | D | F | P9 | D |
| Lₐ₂₇₁ | P6 | CN | H | H | P21 | D | F | P11 | D |
| Lₐ₂₇₂ | P6 | CN | H | H | P54 | H | H | H | H |
| Lₐ₂₇₃ | P6 | CN | H | H | P54 | H | P1 | H | H |
| Lₐ₂₇₄ | P6 | CN | H | H | P54 | H | P2 | H | H |
| Lₐ₂₇₅ | P6 | CN | H | H | P54 | H | P3 | H | H |
| Lₐ₂₇₆ | P6 | CN | H | H | P54 | H | P4 | H | H |
| Lₐ₂₇₇ | P6 | CN | H | H | P54 | H | P5 | H | H |
| Lₐ₂₇₈ | P6 | CN | H | H | P54 | H | P6 | H | H |
| Lₐ₂₇₉ | P6 | CN | H | H | P54 | H | P7 | H | H |
| Lₐ₂₈₀ | P6 | CN | H | H | P54 | H | P8 | H | H |
| Lₐ₂₈₁ | P6 | CN | H | H | P54 | H | P9 | H | H |
| Lₐ₂₈₂ | P6 | CN | H | H | P54 | H | P10 | H | H |
| Lₐ₂₈₃ | P6 | CN | H | H | P54 | H | P11 | H | H |
| Lₐ₂₈₄ | P6 | CN | H | H | P54 | H | P12 | H | H |
| Lₐ₂₈₅ | P6 | CN | H | H | P54 | H | P13 | H | H |
| Lₐ₂₈₆ | P6 | CN | H | H | P54 | H | P14 | H | H |
| Lₐ₂₈₇ | P6 | CN | H | H | P54 | H | P15 | H | H |
| Lₐ₂₈₈ | P6 | CN | H | H | P54 | H | P16 | H | H |
| Lₐ₂₈₉ | P6 | CN | H | H | P54 | H | P17 | H | H |
| Lₐ₂₉₀ | P6 | CN | H | H | P54 | H | P18 | H | H |
| Lₐ₂₉₁ | P6 | CN | H | H | P54 | H | P19 | H | H |
| Lₐ₂₉₂ | P6 | CN | H | H | P54 | H | P20 | H | H |
| Lₐ₂₉₃ | P6 | CN | H | H | P54 | H | P21 | H | H |
| Lₐ₂₉₄ | P6 | CN | H | H | P54 | H | H | P1 | H |
| Lₐ₂₉₅ | P6 | CN | H | H | P54 | H | H | P2 | H |
| Lₐ₂₉₆ | P6 | CN | H | H | P54 | H | H | P3 | H |
| Lₐ₂₉₇ | P6 | CN | H | H | P54 | H | H | P4 | H |
| Lₐ₂₉₈ | P6 | CN | H | H | P54 | H | H | P5 | H |
| Lₐ₂₉₉ | P6 | CN | H | H | P54 | H | H | P6 | H |
| Lₐ₃₀₀ | P6 | CN | H | H | P54 | H | H | P7 | H |
| Lₐ₃₀₁ | P6 | CN | H | H | P54 | H | H | P8 | H |
| Lₐ₃₀₂ | P6 | CN | H | H | P54 | H | H | P9 | H |
| Lₐ₃₀₃ | P6 | CN | H | H | P54 | H | H | P10 | H |
| Lₐ₃₀₄ | P6 | CN | H | H | P54 | H | H | P11 | H |
| Lₐ₃₀₅ | P6 | CN | H | H | P54 | H | H | P12 | H |
| Lₐ₃₀₆ | P6 | CN | H | H | P54 | H | H | P15 | H |
| Lₐ₃₀₇ | P6 | CN | H | H | P54 | H | H | P17 | H |
| Lₐ₃₀₈ | P6 | CN | H | H | P54 | H | H | P18 | H |
| Lₐ₃₀₉ | P6 | CN | H | H | P54 | H | H | P19 | H |
| Lₐ₃₁₀ | P6 | CN | H | H | P54 | H | H | P20 | H |
| Lₐ₃₁₁ | P6 | CN | H | H | P54 | H | H | P21 | H |
| Lₐ₃₁₂ | P6 | CN | H | H | P54 | H | F | H | H |
| Lₐ₃₁₃ | P6 | CN | H | H | P54 | H | F | P1 | H |
| Lₐ₃₁₄ | P6 | CN | H | H | P54 | H | F | P2 | H |
| Lₐ₃₁₅ | P6 | CN | H | H | P54 | H | F | P3 | H |
| Lₐ₃₁₆ | P6 | CN | H | H | P54 | H | F | P4 | H |
| Lₐ₃₁₇ | P6 | CN | H | H | P54 | H | F | P5 | H |
| Lₐ₃₁₈ | P6 | CN | H | H | P54 | H | F | P6 | H |
| Lₐ₃₁₉ | P6 | CN | H | H | P54 | H | F | P7 | H |
| Lₐ₃₂₀ | P6 | CN | H | H | P54 | H | F | P8 | H |
| Lₐ₃₂₁ | P6 | CN | H | H | P54 | H | F | P9 | H |
| Lₐ₃₂₂ | P6 | CN | H | H | P54 | H | F | P10 | H |
| Lₐ₃₂₃ | P6 | CN | H | H | P54 | H | F | P11 | H |
| Lₐ₃₂₄ | P6 | CN | H | H | P54 | H | P1 | F | H |
| Lₐ₃₂₅ | P6 | CN | H | H | P54 | H | P2 | F | H |
| Lₐ₃₂₆ | P6 | CN | H | H | P54 | H | P3 | F | H |
| Lₐ₃₂₇ | P6 | CN | H | H | P54 | H | P4 | F | H |
| Lₐ₃₂₈ | P6 | CN | H | H | P54 | H | P5 | F | H |
| Lₐ₃₂₉ | P6 | CN | H | H | P54 | H | P6 | F | H |
| Lₐ₃₃₀ | P6 | CN | H | H | P54 | H | P7 | F | H |
| Lₐ₃₃₁ | P6 | CN | H | H | P54 | H | P8 | F | H |
| Lₐ₃₃₂ | P6 | CN | H | H | P54 | H | P9 | F | H |
| Lₐ₂₆ | P6 | CN | H | H | P54 | H | P10 | F | H |
| Lₐ₃₃₄ | P6 | CN | H | H | P54 | H | P11 | F | H |
| Lₐ₃₃₅ | P6 | CN | H | H | P54 | H | P1 | P1 | H |
| Lₐ₃₃₆ | P6 | CN | H | H | P54 | H | P2 | P2 | H |
| Lₐ₃₃₇ | P6 | CN | H | H | P54 | D | D | D | D |
| Lₐ₃₃₈ | P6 | CN | H | H | P54 | D | P2 | P2 | D |
| Lₐ₃₃₉ | P6 | CN | H | H | P54 | D | F | P4 | D |
| Lₐ₃₄₀ | P6 | CN | H | H | P54 | D | F | P5 | D |
| Lₐ₃₄₁ | P6 | CN | H | H | P54 | D | F | P9 | D |
| Lₐ₃₄₂ | P6 | CN | H | H | P54 | D | F | P11 | D |
| Lₐ₃₄₃ | P6 | CN | H | H | P96 | H | H | H | H |
| Lₐ₃₄₄ | P6 | CN | H | H | P96 | H | P1 | H | H |
| Lₐ₃₄₅ | P6 | CN | H | H | P96 | H | P2 | H | H |
| Lₐ₃₄₆ | P6 | CN | H | H | P96 | H | P3 | H | H |
| Lₐ₃₄₇ | P6 | CN | H | H | P96 | H | P4 | H | H |
| Lₐ₃₄₈ | P6 | CN | H | H | P96 | H | P5 | H | H |
| Lₐ₃₄₉ | P6 | CN | H | H | P96 | H | P6 | H | H |
| Lₐ₃₅₀ | P6 | CN | H | H | P96 | H | P7 | H | H |
| Lₐ₃₅₁ | P6 | CN | H | H | P96 | H | P8 | H | H |
| Lₐ₃₅₂ | P6 | CN | H | H | P96 | H | P9 | H | H |
| Lₐ₃₅₃ | P6 | CN | H | H | P96 | H | P10 | H | H |
| Lₐ₃₅₄ | P6 | CN | H | H | P96 | H | P11 | H | H |
| Lₐ₃₅₅ | P6 | CN | H | H | P96 | H | P12 | H | H |
| Lₐ₃₅₆ | P6 | CN | H | H | P96 | H | P13 | H | H |
| Lₐ₃₅₇ | P6 | CN | H | H | P96 | H | P14 | H | H |
| Lₐ₃₅₈ | P6 | CN | H | H | P96 | H | P15 | H | H |
| Lₐ₃₅₉ | P6 | CN | H | H | P96 | H | P16 | H | H |
| Lₐ₃₆₀ | P6 | CN | H | H | P96 | H | P17 | H | H |
| Lₐ₃₆₁ | P6 | CN | H | H | P96 | H | P18 | H | H |
| Lₐ₃₆₂ | P6 | CN | H | H | P96 | H | P19 | H | H |
| Lₐ₃₆₃ | P6 | CN | H | H | P96 | H | P20 | H | H |
| Lₐ₃₆₄ | P6 | CN | H | H | P96 | H | P21 | H | H |
| Lₐ₃₆₅ | P6 | CN | H | H | P96 | H | H | P1 | H |
| Lₐ₃₆₆ | P6 | CN | H | H | P96 | H | H | P2 | H |
| Lₐ₃₆₇ | P6 | CN | H | H | P96 | H | H | P3 | H |
| Lₐ₃₆₈ | P6 | CN | H | H | P96 | H | H | P4 | H |
| Lₐ₃₆₉ | P6 | CN | H | H | P96 | H | H | P5 | H |
| Lₐ₃₇₀ | P6 | CN | H | H | P96 | H | H | P6 | H |
| Lₐ₃₇₁ | P6 | CN | H | H | P96 | H | H | P7 | H |
| Lₐ₃₇₂ | P6 | CN | H | H | P96 | H | H | P8 | H |
| Lₐ₃₇₃ | P6 | CN | H | H | P96 | H | H | P9 | H |
| Lₐ₃₇₄ | P6 | CN | H | H | P96 | H | H | P10 | H |
| Lₐ₃₇₅ | P6 | CN | H | H | P96 | H | H | P11 | H |
| Lₐ₃₇₆ | P6 | CN | H | H | P96 | H | H | P12 | H |
| Lₐ₃₇₇ | P6 | CN | H | H | P96 | H | H | P15 | H |
| Lₐ₃₇₈ | P6 | CN | H | H | P96 | H | H | P17 | H |
| Lₐ₃₇₉ | P6 | CN | H | H | P96 | H | H | P18 | H |
| Lₐ₃₈₀ | P6 | CN | H | H | P96 | H | H | P19 | H |
| Lₐ₃₈₁ | P6 | CN | H | H | P96 | H | H | P20 | H |
| Lₐ₃₈₂ | P6 | CN | H | H | P96 | H | H | P21 | H |
| Lₐ₃₈₃ | P6 | CN | H | H | P96 | H | F | H | H |
| Lₐ₃₈₄ | P6 | CN | H | H | P96 | H | F | P1 | H |
| Lₐ₃₈₅ | P6 | CN | H | H | P96 | H | F | P2 | H |
| Lₐ₃₈₆ | P6 | CN | H | H | P96 | H | F | P3 | H |
| Lₐ₃₈₇ | P6 | CN | H | H | P96 | H | F | P4 | H |
| Lₐ₃₈₈ | P6 | CN | H | H | P96 | H | F | P5 | H |
| Lₐ₃₈₉ | P6 | CN | H | H | P96 | H | F | P6 | H |
| Lₐ₃₉₀ | P6 | CN | H | H | P96 | H | F | P7 | H |
| Lₐ₃₉₁ | P6 | CN | H | H | P96 | H | F | P8 | H |
| Lₐ₃₉₂ | P6 | CN | H | H | P96 | H | F | P9 | H |
| Lₐ₃₉₃ | P6 | CN | H | H | P96 | H | F | P10 | H |
| Lₐ₃₉₄ | P6 | CN | H | H | P96 | H | F | P11 | H |
| Lₐ₃₉₅ | P6 | CN | H | H | P96 | H | P1 | F | H |
| Lₐ₃₉₆ | P6 | CN | H | H | P96 | H | P2 | F | H |
| Lₐ₃₉₇ | P6 | CN | H | H | P96 | H | P3 | F | H |
| Lₐ₃₉₈ | P6 | CN | H | H | P96 | H | P4 | F | H |
| Lₐ₃₉₉ | P6 | CN | H | H | P96 | H | P5 | F | H |
| Lₐ₄₀₀ | P6 | CN | H | H | P96 | H | P6 | F | H |
| Lₐ₄₀₁ | P6 | CN | H | H | P96 | H | P7 | F | H |
| Lₐ₄₀₂ | P6 | CN | H | H | P96 | H | P8 | F | H |
| Lₐ₄₀₃ | P6 | CN | H | H | P96 | H | P9 | F | H |
| Lₐ₄₀₄ | P6 | CN | H | H | P96 | H | P10 | F | H |
| Lₐ₄₀₅ | P6 | CN | H | H | P96 | H | P11 | F | H |
| Lₐ₄₀₆ | P6 | CN | H | H | P96 | H | P1 | P1 | H |
| Lₐ₄₀₇ | P6 | CN | H | H | P96 | H | P2 | P2 | H |
| Lₐ₄₀₈ | P6 | CN | H | H | P96 | D | D | D | D |
| Lₐ₄₀₉ | P6 | CN | H | H | P96 | D | P2 | P2 | D |
| Lₐ₄₁₀ | P6 | CN | H | H | P96 | D | F | P4 | D |
| Lₐ₄₁₁ | P6 | CN | H | H | P96 | D | F | P5 | D |
| Lₐ₄₁₂ | P6 | CN | H | H | P96 | D | F | P9 | D |
| Lₐ₄₁₃ | P6 | CN | H | H | P96 | D | F | P11 | D |
| Lₐ₄₁₄ | P6 | CN | H | H | P97 | H | H | H | H |
| Lₐ₄₁₅ | P6 | CN | H | H | P97 | H | P1 | H | H |
| Lₐ₄₁₆ | P6 | CN | H | H | P97 | H | P2 | H | H |
| Lₐ₄₁₇ | P6 | CN | H | H | P97 | H | P3 | H | H |
| Lₐ₄₁₈ | P6 | CN | H | H | P97 | H | P4 | H | H |
| Lₐ₄₁₉ | P6 | CN | H | H | P97 | H | P5 | H | H |
| Lₐ₄₂₀ | P6 | CN | H | H | P97 | H | P6 | H | H |
| Lₐ₄₂₁ | P6 | CN | H | H | P97 | H | P7 | H | H |
| Lₐ₄₂₂ | P6 | CN | H | H | P97 | H | P8 | H | H |
| Lₐ₄₂₃ | P6 | CN | H | H | P97 | H | P9 | H | H |
| Lₐ₄₂₄ | P6 | CN | H | H | P97 | H | P10 | H | H |
| Lₐ₄₂₅ | P6 | CN | H | H | P97 | H | P11 | H | H |
| Lₐ₄₂₆ | P6 | CN | H | H | P97 | H | P12 | H | H |
| Lₐ₄₂₇ | P6 | CN | H | H | P97 | H | P13 | H | H |
| Lₐ₄₂₈ | P6 | CN | H | H | P97 | H | P14 | H | H |
| Lₐ₄₂₉ | P6 | CN | H | H | P97 | H | P15 | H | H |
| Lₐ₄₃₀ | P6 | CN | H | H | P97 | H | P16 | H | H |
| Lₐ₄₃₁ | P6 | CN | H | H | P97 | H | P17 | H | H |
| Lₐ₄₃₂ | P6 | CN | H | H | P97 | H | P18 | H | H |
| Lₐ₄₃₃ | P6 | CN | H | H | P97 | H | P19 | H | H |
| Lₐ₄₃₄ | P6 | CN | H | H | P97 | H | P20 | H | H |
| Lₐ₄₃₅ | P6 | CN | H | H | P97 | H | P21 | H | H |
| Lₐ₄₃₆ | P6 | CN | H | H | P97 | H | H | P1 | H |
| Lₐ₄₃₇ | P6 | CN | H | H | P97 | H | H | P2 | H |
| Lₐ₄₃₈ | P6 | CN | H | H | P97 | H | H | P3 | H |
| Lₐ₄₃₉ | P6 | CN | H | H | P97 | H | H | P4 | H |
| Lₐ₄₄₀ | P6 | CN | H | H | P97 | H | H | P5 | H |
| Lₐ₄₄₁ | P6 | CN | H | H | P97 | H | H | P6 | H |
| Lₐ₄₄₂ | P6 | CN | H | H | P97 | H | H | P7 | H |
| Lₐ₄₄₃ | P6 | CN | H | H | P97 | H | H | P8 | H |
| Lₐ₄₄₄ | P6 | CN | H | H | P97 | H | H | P9 | H |
| Lₐ₄₄₅ | P6 | CN | H | H | P97 | H | H | P10 | H |
| Lₐ₄₄₆ | P6 | CN | H | H | P97 | H | H | P11 | H |
| Lₐ₄₄₇ | P6 | CN | H | H | P97 | H | H | P12 | H |
| Lₐ₄₄₈ | P6 | CN | H | H | P97 | H | H | P15 | H |
| Lₐ₄₄₉ | P6 | CN | H | H | P97 | H | H | P17 | H |
| Lₐ₄₅₀ | P6 | CN | H | H | P97 | H | H | P18 | H |
| Lₐ₄₅₁ | P6 | CN | H | H | P97 | H | H | P19 | H |
| Lₐ₄₅₂ | P6 | CN | H | H | P97 | H | H | P20 | H |
| Lₐ₄₅₃ | P6 | CN | H | H | P97 | H | H | P21 | H |
| Lₐ₄₅₄ | P6 | CN | H | H | P97 | H | F | H | H |
| Lₐ₄₅₅ | P6 | CN | H | H | P97 | H | F | P1 | H |
| Lₐ₄₅₆ | P6 | CN | H | H | P97 | H | F | P2 | H |
| Lₐ₄₅₇ | P6 | CN | H | H | P97 | H | F | P3 | H |
| Lₐ₄₅₈ | P6 | CN | H | H | P97 | H | F | P4 | H |
| Lₐ₄₅₉ | P6 | CN | H | H | P97 | H | F | P5 | H |
| Lₐ₄₆₀ | P6 | CN | H | H | P97 | H | F | P6 | H |
| Lₐ₄₆₁ | P6 | CN | H | H | P97 | H | F | P7 | H |
| Lₐ₄₆₂ | P6 | CN | H | H | P97 | H | F | P8 | H |
| Lₐ₄₆₃ | P6 | CN | H | H | P97 | H | F | P9 | H |
| Lₐ₄₆₄ | P6 | CN | H | H | P97 | H | F | P10 | H |
| Lₐ₄₆₅ | P6 | CN | H | H | P97 | H | F | P11 | H |
| Lₐ₄₆₆ | P6 | CN | H | H | P97 | H | P1 | F | H |
| Lₐ₄₆₇ | P6 | CN | H | H | P97 | H | P2 | F | H |
| Lₐ₄₆₈ | P6 | CN | H | H | P97 | H | P3 | F | H |
| Lₐ₄₆₉ | P6 | CN | H | H | P97 | H | P4 | F | H |
| Lₐ₄₇₀ | P6 | CN | H | H | P97 | H | P5 | F | H |
| Lₐ₄₇₁ | P6 | CN | H | H | P97 | H | P6 | F | H |
| Lₐ₄₇₂ | P6 | CN | H | H | P97 | H | P7 | F | H |
| Lₐ₄₇₃ | P6 | CN | H | H | P97 | H | P8 | F | H |
| Lₐ₄₇₄ | P6 | CN | H | H | P97 | H | P9 | F | H |
| Lₐ₄₇₅ | P6 | CN | H | H | P97 | H | P10 | F | H |
| Lₐ₄₇₆ | P6 | CN | H | H | P97 | H | P11 | F | H |
| Lₐ₄₇₇ | P6 | CN | H | H | P97 | H | P1 | P1 | H |
| Lₐ₄₇₈ | P6 | CN | H | H | P97 | H | P2 | P2 | H |
| Lₐ₄₇₉ | P6 | CN | H | H | P97 | D | D | D | D |
| Lₐ₄₈₀ | P6 | CN | H | H | P97 | D | P2 | P2 | D |
| Lₐ₄₈₁ | P6 | CN | H | H | P97 | D | F | P4 | D |
| Lₐ₄₈₂ | P6 | CN | H | H | P97 | D | F | P5 | D |
| Lₐ₄₈₃ | P6 | CN | H | H | P97 | D | F | P9 | D |
| Lₐ₄₈₄ | P6 | CN | H | H | P97 | D | F | P11 | D |
| Lₐ₄₈₅ | P6 | CN | H | H | P102 | H | P1 | H | H |
| Lₐ₄₈₆ | P6 | CN | H | H | P102 | H | P2 | H | H |
| Lₐ₄₈₇ | P6 | CN | H | H | P102 | H | P3 | H | H |
| Lₐ₄₈₈ | P6 | CN | H | H | P102 | H | P4 | H | H |
| Lₐ₄₈₉ | P6 | CN | H | H | P102 | H | P5 | H | H |
| Lₐ₄₉₀ | P6 | CN | H | H | P102 | H | P6 | H | H |
| Lₐ₄₉₁ | P6 | CN | H | H | P102 | H | P7 | H | H |
| Lₐ₄₉₂ | P6 | CN | H | H | P102 | H | P8 | H | H |
| Lₐ₄₉₃ | P6 | CN | H | H | P102 | H | P9 | H | H |
| Lₐ₄₉₄ | P6 | CN | H | H | P102 | H | P10 | H | H |
| Lₐ₄₉₅ | P6 | CN | H | H | P102 | H | P11 | H | H |
| Lₐ₄₉₆ | P6 | CN | H | H | P102 | H | P12 | H | H |
| Lₐ₄₉₇ | P6 | CN | H | H | P102 | H | P13 | H | H |
| Lₐ₄₉₈ | P6 | CN | H | H | P102 | H | P14 | H | H |
| Lₐ₄₉₀ | P6 | CN | H | H | P102 | H | P15 | H | H |
| Lₐ₅₀₀ | P6 | CN | H | H | P102 | H | P16 | H | H |
| Lₐ₅₀₁ | P6 | CN | H | H | P102 | H | P17 | H | H |
| Lₐ₅₀₂ | P6 | CN | H | H | P102 | H | P18 | H | H |
| Lₐ₅₀₃ | P6 | CN | H | H | P102 | H | P19 | H | H |
| Lₐ₅₀₄ | P6 | CN | H | H | P102 | H | P20 | H | H |
| Lₐ₅₀₅ | P6 | CN | H | H | P102 | H | P21 | H | H |
| Lₐ₅₀₆ | P6 | CN | H | H | P102 | H | H | P1 | H |
| Lₐ₅₀₇ | P6 | CN | H | H | P102 | H | H | P2 | H |
| Lₐ₅₀₈ | P6 | CN | H | H | P102 | H | H | P3 | H |
| Lₐ₅₀₉ | P6 | CN | H | H | P102 | H | H | P4 | H |
| Lₐ₅₁₀ | P6 | CN | H | H | P102 | H | H | P5 | H |
| Lₐ₅₁₁ | P6 | CN | H | H | P102 | H | H | P6 | H |
| Lₐ₅₁₂ | P6 | CN | H | H | P102 | H | H | P7 | H |
| Lₐ₅₁₃ | P6 | CN | H | H | P102 | H | H | P8 | H |
| Lₐ₅₁₄ | P6 | CN | H | H | P102 | H | H | P9 | H |
| Lₐ₅₁₅ | P6 | CN | H | H | P102 | H | H | P10 | H |
| Lₐ₅₁₆ | P6 | CN | H | H | P102 | H | H | P11 | H |
| Lₐ₅₁₇ | P6 | CN | H | H | P102 | H | H | P12 | H |
| Lₐ₅₁₈ | P6 | CN | H | H | P102 | H | H | P15 | H |
| Lₐ₅₁₉ | P6 | CN | H | H | P102 | H | H | P17 | H |
| Lₐ₅₂₀ | P6 | CN | H | H | P102 | H | H | P18 | H |
| Lₐ₅₂₁ | P6 | CN | H | H | P102 | H | H | P19 | H |
| Lₐ₅₂₂ | P6 | CN | H | H | P102 | H | H | P20 | H |
| Lₐ₅₂₃ | P6 | CN | H | H | P102 | H | H | P21 | H |
| Lₐ₅₂₄ | P6 | CN | H | H | P102 | H | F | H | H |
| Lₐ₅₂₅ | P6 | CN | H | H | P102 | H | F | P1 | H |
| Lₐ₅₂₆ | P6 | CN | H | H | P102 | H | F | P2 | H |
| Lₐ₅₂₇ | P6 | CN | H | H | P102 | H | F | P3 | H |
| Lₐ₅₂₈ | P6 | CN | H | H | P102 | H | F | P4 | H |
| Lₐ₅₂₉ | P6 | CN | H | H | P102 | H | F | P5 | H |
| Lₐ₅₃₀ | P6 | CN | H | H | P102 | H | F | P6 | H |
| Lₐ₅₃₁ | P6 | CN | H | H | P102 | H | F | P7 | H |
| Lₐ₅₃₂ | P6 | CN | H | H | P102 | H | F | P8 | H |
| Lₐ₅₃₃ | P6 | CN | H | H | P102 | H | F | P9 | H |
| Lₐ₅₃₄ | P6 | CN | H | H | P102 | H | F | P10 | H |
| Lₐ₅₃₅ | P6 | CN | H | H | P102 | H | F | P11 | H |
| Lₐ₅₃₆ | P6 | CN | H | H | P102 | H | P1 | F | H |
| Lₐ₅₃₇ | P6 | CN | H | H | P102 | H | P2 | F | H |
| Lₐ₅₃₈ | P6 | CN | H | H | P102 | H | P3 | F | H |
| Lₐ₅₃₉ | P6 | CN | H | H | P102 | H | P4 | F | H |
| Lₐ₅₄₀ | P6 | CN | H | H | P102 | H | P5 | F | H |
| Lₐ₅₄₁ | P6 | CN | H | H | P102 | H | P6 | F | H |
| Lₐ₅₄₂ | P6 | CN | H | H | P102 | H | P7 | F | H |
| Lₐ₅₄₃ | P6 | CN | H | H | P102 | H | P8 | F | H |
| Lₐ₅₄₄ | P6 | CN | H | H | P102 | H | P9 | F | H |
| Lₐ₅₄₅ | P6 | CN | H | H | P102 | H | P10 | F | H |
| Lₐ₅₄₆ | P6 | CN | H | H | P102 | H | P11 | F | H |
| Lₐ₅₄₇ | P6 | CN | H | H | P102 | H | P1 | P1 | H |
| Lₐ₅₄₈ | P6 | CN | H | H | P102 | H | P2 | P2 | H |
| Lₐ₅₄₉ | P6 | CN | H | H | P102 | D | D | D | D |
| Lₐ₅₅₀ | P6 | CN | H | H | P102 | D | P2 | P2 | D |
| Lₐ₅₅₁ | P6 | CN | H | H | P102 | D | F | P4 | D |
| Lₐ₅₅₂ | P6 | CN | H | H | P102 | D | F | P5 | D |
| Lₐ₅₅₃ | P6 | CN | H | H | P102 | D | F | P9 | D |
| Lₐ₅₅₄ | P6 | CN | H | H | P102 | D | F | P11 | D |
| Lₐ₅₅₅ | P6 | CN | H | H | P103 | H | P1 | H | H |
| Lₐ₅₅₆ | P6 | CN | H | H | P103 | H | P2 | H | H |
| Lₐ₅₅₇ | P6 | CN | H | H | P103 | H | P3 | H | H |
| Lₐ₅₅₈ | P6 | CN | H | H | P103 | H | P4 | H | H |
| Lₐ₅₅₉ | P6 | CN | H | H | P103 | H | P5 | H | H |
| Lₐ₅₆₀ | P6 | CN | H | H | P103 | H | P6 | H | H |
| Lₐ₅₆₁ | P6 | CN | H | H | P103 | H | P7 | H | H |
| Lₐ₅₆₂ | P6 | CN | H | H | P103 | H | P8 | H | H |
| Lₐ₅₆₃ | P6 | CN | H | H | P103 | H | P9 | H | H |
| Lₐ₅₆₄ | P6 | CN | H | H | P103 | H | P10 | H | H |
| Lₐ₅₆₅ | P6 | CN | H | H | P103 | H | P11 | H | H |
| Lₐ₅₆₆ | P6 | CN | H | H | P103 | H | P12 | H | H |
| Lₐ₅₆₇ | P6 | CN | H | H | P103 | H | P13 | H | H |
| Lₐ₅₆₈ | P6 | CN | H | H | P103 | H | P14 | H | H |
| Lₐ₅₆₉ | P6 | CN | H | H | P103 | H | P15 | H | H |
| Lₐ₅₇₀ | P6 | CN | H | H | P103 | H | P16 | H | H |
| Lₐ₅₇₁ | P6 | CN | H | H | P103 | H | P17 | H | H |
| Lₐ₅₇₂ | P6 | CN | H | H | P103 | H | P18 | H | H |
| Lₐ₅₇₃ | P6 | CN | H | H | P103 | H | P19 | H | H |
| Lₐ₅₇₄ | P6 | CN | H | H | P103 | H | P20 | H | H |
| Lₐ₅₇₅ | P6 | CN | H | H | P103 | H | P21 | H | H |
| Lₐ₅₇₆ | P6 | CN | H | H | P103 | H | H | P1 | H |
| Lₐ₅₇₇ | P6 | CN | H | H | P103 | H | H | P2 | H |
| Lₐ₅₇₈ | P6 | CN | H | H | P103 | H | H | P3 | H |
| Lₐ₅₇₉ | P6 | CN | H | H | P103 | H | H | P4 | H |
| Lₐ₅₈₀ | P6 | CN | H | H | P103 | H | H | P5 | H |
| Lₐ₅₈₁ | P6 | CN | H | H | P103 | H | H | P6 | H |
| Lₐ₅₈₂ | P6 | CN | H | H | P103 | H | H | P7 | H |
| Lₐ₅₈₃ | P6 | CN | H | H | P103 | H | H | P8 | H |
| Lₐ₅₈₄ | P6 | CN | H | H | P103 | H | H | P9 | H |
| Lₐ₅₈₅ | P6 | CN | H | H | P103 | H | H | P10 | H |
| Lₐ₅₈₆ | P6 | CN | H | H | P103 | H | H | P11 | H |
| Lₐ₅₈₇ | P6 | CN | H | H | P103 | H | H | P12 | H |
| Lₐ₅₈₈ | P6 | CN | H | H | P103 | H | H | P15 | H |
| Lₐ₅₈₉ | P6 | CN | H | H | P103 | H | H | P17 | H |
| Lₐ₅₉₀ | P6 | CN | H | H | P103 | H | H | P18 | H |
| Lₐ₅₉₁ | P6 | CN | H | H | P103 | H | H | P19 | H |
| Lₐ₅₉₂ | P6 | CN | H | H | P103 | H | H | P20 | H |
| Lₐ₅₉₃ | P6 | CN | H | H | P103 | H | H | P21 | H |
| Lₐ₅₉₄ | P6 | CN | H | H | P103 | H | F | H | H |
| Lₐ₅₉₅ | P6 | CN | H | H | P103 | H | F | P1 | H |
| Lₐ₅₉₆ | P6 | CN | H | H | P103 | H | F | P2 | H |
| Lₐ₅₉₇ | P6 | CN | H | H | P103 | H | F | P3 | H |
| Lₐ₅₉₈ | P6 | CN | H | H | P103 | H | F | P4 | H |
| Lₐ₅₉₉ | P6 | CN | H | H | P103 | H | F | P5 | H |
| Lₐ₆₀₀ | P6 | CN | H | H | P103 | H | F | P6 | H |
| Lₐ₆₀₁ | P6 | CN | H | H | P103 | H | F | P7 | H |
| Lₐ₆₀₂ | P6 | CN | H | H | P103 | H | F | P8 | H |
| Lₐ₆₀₃ | P6 | CN | H | H | P103 | H | F | P9 | H |
| Lₐ₆₀₄ | P6 | CN | H | H | P103 | H | F | P10 | H |
| Lₐ₆₀₅ | P6 | CN | H | H | P103 | H | F | P11 | H |
| Lₐ₆₀₆ | P6 | CN | H | H | P103 | H | P1 | F | H |
| Lₐ₆₀₇ | P6 | CN | H | H | P103 | H | P2 | F | H |
| Lₐ₆₀₈ | P6 | CN | H | H | P103 | H | P3 | F | H |
| Lₐ₆₀₉ | P6 | CN | H | H | P103 | H | P4 | F | H |
| Lₐ₆₁₀ | P6 | CN | H | H | P103 | H | P5 | F | H |
| Lₐ₆₁₁ | P6 | CN | H | H | P103 | H | P6 | F | H |
| Lₐ₆₁₂ | P6 | CN | H | H | P103 | H | P7 | F | H |
| Lₐ₆₁₃ | P6 | CN | H | H | P103 | H | P8 | F | H |
| Lₐ₆₁₄ | P6 | CN | H | H | P103 | H | P9 | F | H |
| Lₐ₆₁₅ | P6 | CN | H | H | P103 | H | P10 | F | H |
| Lₐ₆₁₆ | P6 | CN | H | H | P103 | H | P11 | F | H |
| Lₐ₆₁₇ | P6 | CN | H | H | P103 | H | P1 | P1 | H |
| Lₐ₆₁₈ | P6 | CN | H | H | P103 | H | P2 | P2 | H |
| Lₐ₆₁₉ | P6 | CN | H | H | P103 | D | D | D | D |
| Lₐ₆₂₀ | P6 | CN | H | H | P103 | D | P2 | P2 | D |
| Lₐ₆₂₁ | P6 | CN | H | H | P103 | D | F | P4 | D |
| Lₐ₆₂₂ | P6 | CN | H | H | P103 | D | F | P5 | D |
| Lₐ₆₂₃ | P6 | CN | H | H | P103 | D | F | P9 | D |
| Lₐ₆₂₄ | P6 | CN | H | H | P103 | D | F | P11 | D |
| Lₐ₆₂₅ | P6 | CN | H | H | H | H | P20 | P1 | H |
| Lₐ₆₂₆ | P6 | CN | H | H | H | H | P21 | P2 | H |
| Lₐ₆₂₇ | P6 | CN | H | H | H | H | P29 | H | H |
| Lₐ₆₂₈ | P6 | CN | H | H | H | H | P29 | P1 | H |
| Lₐ₆₂₉ | P6 | CN | H | H | H | H | P54 | H | H |
| Lₐ₆₃₀ | P6 | CN | H | H | H | H | P96 | H | H |
| Lₐ₆₃₁ | P6 | CN | H | H | H | H | P97 | H | H |
| Lₐ₆₃₂ | P6 | CN | H | H | H | H | P96 | P1 | H |
| Lₐ₆₃₃ | P6 | CN | H | H | H | H | P97 | P1 | H |
| Lₐ₆₃₄ | P6 | CN | H | H | H | H | P102 | H | H |
| Lₐ₆₃₅ | P6 | CN | H | H | H | H | P103 | H | H |
| Lₐ₆₃₆ | P6 | CN | H | H | D | H | P20 | P1 | H |
| Lₐ₆₃₇ | P6 | CN | H | H | D | H | P21 | P2 | H |
| Lₐ₆₃₈ | P6 | CN | H | H | D | H | P29 | H | H |
| Lₐ₆₃₉ | P6 | CN | H | H | D | H | P29 | P1 | H |
| Lₐ₆₄₀ | P6 | CN | H | H | D | H | P54 | H | H |
| Lₐ₆₄₁ | P6 | CN | H | H | D | H | P96 | H | H |
| Lₐ₆₄₂ | P6 | CN | H | H | D | H | P97 | H | H |
| Lₐ₆₄₃ | P6 | CN | H | H | D | H | P96 | P1 | H |
| Lₐ₆₄₄ | P6 | CN | H | H | D | H | P97 | P1 | H |
| Lₐ₆₄₅ | P6 | CN | H | H | D | H | P102 | H | H |
| Lₐ₆₄₆ | P6 | CN | H | H | D | H | P103 | H | H |
| Lₐ₆₄₇ | P6 | CN | H | H | P20 | H | P20 | P1 | H |
| Lₐ₆₄₈ | P6 | CN | H | H | P20 | H | P21 | P2 | H |
| Lₐ₆₄₉ | P6 | CN | H | H | P20 | H | P29 | H | H |
| Lₐ₆₅₀ | P6 | CN | H | H | P20 | H | P29 | P1 | H |
| Lₐ₆₅₁ | P6 | CN | H | H | P20 | H | P54 | H | H |
| Lₐ₆₅₂ | P6 | CN | H | H | P20 | H | P96 | H | H |
| Lₐ₆₅₃ | P6 | CN | H | H | P20 | H | P97 | H | H |
| Lₐ₆₅₄ | P6 | CN | H | H | P20 | H | P96 | P1 | H |
| Lₐ₆₅₅ | P6 | CN | H | H | P20 | H | P97 | P1 | H |
| Lₐ₆₅₆ | P6 | CN | H | H | P20 | H | P102 | H | H |
| Lₐ₆₅₇ | P6 | CN | H | H | P20 | H | P103 | H | H |
| Lₐ₆₅₈ | P6 | CN | H | H | P21 | H | P20 | P1 | H |
| Lₐ₆₅₉ | P6 | CN | H | H | P21 | H | P21 | P2 | H |
| Lₐ₆₆₀ | P6 | CN | H | H | P21 | H | P29 | H | H |
| Lₐ₆₆₁ | P6 | CN | H | H | P21 | H | P29 | P1 | H |
| Lₐ₆₆₂ | P6 | CN | H | H | P21 | H | P54 | H | H |
| Lₐ₆₆₃ | P6 | CN | H | H | P21 | H | P96 | H | H |
| Lₐ₆₆₄ | P6 | CN | H | H | P21 | H | P97 | H | H |
| Lₐ₆₆₅ | P6 | CN | H | H | P21 | H | P96 | P1 | H |
| Lₐ₆₆₆ | P6 | CN | H | H | P21 | H | P97 | P1 | H |
| Lₐ₆₆₇ | P6 | CN | H | H | P21 | H | P102 | H | H |
| Lₐ₆₆₈ | P6 | CN | H | H | P21 | H | P103 | H | H |
| Lₐ₆₆₉ | P6 | CN | H | H | P22 | H | H | H | H |
| Lₐ₆₇₀ | P6 | CN | H | H | P23 | H | H | H | H |
| Lₐ₆₇₁ | P6 | CN | H | H | P24 | H | H | H | H |
| Lₐ₆₇₂ | P6 | CN | H | H | P25 | H | H | H | H |
| Lₐ₆₇₃ | P6 | CN | H | H | P26 | H | H | H | H |
| Lₐ₆₇₄ | P6 | CN | H | H | P27 | H | H | H | H |
| Lₐ₆₇₅ | P6 | CN | H | H | P28 | H | H | H | H |
| Lₐ₆₇₆ | P6 | CN | H | H | P29 | H | H | H | H |
| Lₐ₆₇₇ | P6 | CN | H | H | P30 | H | H | H | H |
| Lₐ₆₇₈ | P6 | CN | H | H | P31 | H | H | H | H |
| Lₐ₆₇₉ | P6 | CN | H | H | P32 | H | H | H | H |
| Lₐ₆₈₀ | P6 | CN | H | H | P33 | H | H | H | H |
| Lₐ₆₈₁ | P6 | CN | H | H | P34 | H | H | H | H |
| Lₐ₆₈₂ | P6 | CN | H | H | P35 | H | H | H | H |
| Lₐ₆₈₃ | P6 | CN | H | H | P36 | H | H | H | H |
| Lₐ₆₈₄ | P6 | CN | H | H | P37 | H | H | H | H |
| Lₐ₆₈₅ | P6 | CN | H | H | P38 | H | H | H | H |
| Lₐ₆₈₆ | P6 | CN | H | H | P39 | H | H | H | H |
| Lₐ₆₈₇ | P6 | CN | H | H | P40 | H | H | H | H |
| Lₐ₆₈₈ | P6 | CN | H | H | P41 | H | H | H | H |
| Lₐ₆₈₉ | P6 | CN | H | H | P42 | H | H | H | H |
| Lₐ₆₉₀ | P6 | CN | H | H | P43 | H | H | H | H |
| Lₐ₆₉₁ | P6 | CN | H | H | P44 | H | H | H | H |
| Lₐ₆₉₂ | P6 | CN | H | H | P45 | H | H | H | H |
| Lₐ₆₉₃ | P6 | CN | H | H | P46 | H | H | H | H |
| Lₐ₆₉₄ | P6 | CN | H | H | P47 | H | H | H | H |
| Lₐ₆₉₅ | P6 | CN | H | H | P48 | H | H | H | H |
| Lₐ₆₉₆ | P6 | CN | H | H | P49 | H | H | H | H |
| Lₐ₆₉₇ | P6 | CN | H | H | P50 | H | H | H | H |
| Lₐ₆₉₈ | P6 | CN | H | H | P51 | H | H | H | H |
| Lₐ₆₉₉ | P6 | CN | H | H | P52 | H | H | H | H |
| Lₐ₇₀₀ | P6 | CN | H | H | P53 | H | H | H | H |
| Lₐ₇₀₁ | P6 | CN | H | H | P55 | H | H | H | H |
| Lₐ₇₀₂ | P6 | CN | H | H | P56 | H | H | H | H |
| Lₐ₇₀₃ | P6 | CN | H | H | P57 | H | H | H | H |
| Lₐ₇₀₄ | P6 | CN | H | H | P58 | H | H | H | H |
| Lₐ₇₀₅ | P6 | CN | H | H | P59 | H | H | H | H |
| Lₐ₇₀₆ | P6 | CN | H | H | P60 | H | H | H | H |
| Lₐ₇₀₇ | P6 | CN | H | H | P61 | H | H | H | H |
| Lₐ₇₀₈ | P6 | CN | H | H | P62 | H | H | H | H |
| Lₐ₇₀₉ | P6 | CN | H | H | P63 | H | H | H | H |
| Lₐ₇₁₀ | P6 | CN | H | H | P64 | H | H | H | H |
| Lₐ₇₁₁ | P6 | CN | H | H | P65 | H | H | H | H |
| Lₐ₇₁₂ | P6 | CN | H | H | P66 | H | H | H | H |
| Lₐ₇₁₃ | P6 | CN | H | H | P67 | H | H | H | H |
| Lₐ₇₁₄ | P6 | CN | H | H | P68 | H | H | H | H |
| Lₐ₇₁₅ | P6 | CN | H | H | P69 | H | H | H | H |
| Lₐ₇₁₆ | P6 | CN | H | H | P70 | H | H | H | H |
| Lₐ₇₁₇ | P6 | CN | H | H | P71 | H | H | H | H |
| Lₐ₇₁₈ | P6 | CN | H | H | P72 | H | H | H | H |
| Lₐ₇₁₉ | P6 | CN | H | H | P73 | H | H | H | H |
| Lₐ₇₂₀ | P6 | CN | H | H | P74 | H | H | H | H |
| Lₐ₇₂₁ | P6 | CN | H | H | P75 | H | H | H | H |
| Lₐ₇₂₂ | P6 | CN | H | H | P76 | H | H | H | H |
| Lₐ₇₂₃ | P6 | CN | H | H | P77 | H | H | H | H |
| Lₐ₇₂₄ | P6 | CN | H | H | P78 | H | H | H | H |
| Lₐ₇₂₅ | P6 | CN | H | H | P79 | H | H | H | H |
| Lₐ₇₂₆ | P6 | CN | H | H | P80 | H | H | H | H |
| Lₐ₇₂₇ | P6 | CN | H | H | P81 | H | H | H | H |
| Lₐ₇₂₈ | P6 | CN | H | H | P82 | H | H | H | H |
| Lₐ₇₂₉ | P6 | CN | H | H | P83 | H | H | H | H |
| Lₐ₇₃₀ | P6 | CN | H | H | P84 | H | H | H | H |
| Lₐ₇₃₁ | P6 | CN | H | H | P85 | H | H | H | H |
| Lₐ₇₃₂ | P6 | CN | H | H | P86 | H | H | H | H |
| Lₐ₇₃₃ | P6 | CN | H | H | P87 | H | H | H | H |
| Lₐ₇₃₄ | P6 | CN | H | H | P88 | H | H | H | H |
| Lₐ₇₃₅ | P6 | CN | H | H | P89 | H | H | H | H |
| Lₐ₇₃₆ | P6 | CN | H | H | P90 | H | H | H | H |
| Lₐ₇₃₇ | P6 | CN | H | H | P91 | H | H | H | H |
| Lₐ₇₃₈ | P6 | CN | H | H | P92 | H | H | H | H |
| Lₐ₇₃₉ | P6 | CN | H | H | P93 | H | H | H | H |
| Lₐ₇₄₀ | P6 | CN | H | H | P94 | H | H | H | H |
| Lₐ₇₄₁ | P6 | CN | H | H | P95 | H | H | H | H |
| Lₐ₇₄₂ | P6 | CN | H | H | P98 | H | H | H | H |
| Lₐ₇₄₃ | P6 | CN | P97 | H | P21 | H | H | H | H |
| Lₐ₇₄₄ | P6 | CN | P97 | H | P97 | H | H | H | H |
| Lₐ₇₄₅ | P6 | CN | H | H | P101 | H | H | H | H |
| Lₐ₇₄₆ | P6 | CN | H | H | P102 | H | H | H | H |
| Lₐ₇₄₇ | P6 | CN | H | H | P103 | H | H | H | H |
| Lₐ₇₄₈ | P6 | CN | H | H | P104 | H | H | H | H |
| Lₐ₇₄₉ | P6 | CN | H | H | P105 | H | H | H | H |
| Lₐ₇₅₀ | P6 | CN | H | H | P106 | H | H | H | H |
| Lₐ₇₅₁ | P6 | CN | H | H | P107 | H | H | H | H |
| Lₐ₇₅₂ | P6 | CN | H | H | P108 | H | H | H | H |
| Lₐ₇₅₃ | P6 | CN | H | H | P109 | H | H | H | H |
| Lₐ₇₅₄ | P6 | CN | H | H | P110 | H | H | H | H |
| Lₐ₇₅₅ | P6 | CN | H | H | P111 | H | H | H | H |
| Lₐ₇₅₆ | P6 | CN | H | H | P112 | H | H | H | H |
| Lₐ₇₅₇ | P6 | CN | H | H | P113 | H | H | H | H |
| Lₐ₇₅₈ | P6 | CN | H | H | P114 | H | H | H | H |
| Lₐ₇₅₉ | P6 | CN | H | H | P115 | H | H | H | H |
| Lₐ₇₆₀ | P6 | CN | H | H | P116 | H | H | H | H |
| Lₐ₇₆₁ | P6 | CN | H | H | P117 | H | H | H | H |
| Lₐ₇₆₂ | P6 | CN | H | H | P118 | H | H | H | H |
| Lₐ₇₆₃ | P6 | CN | H | H | P119 | H | H | H | H |
| Lₐ₇₆₄ | P6 | CN | H | H | P120 | H | H | H | H |
| Lₐ₇₆₅ | P6 | CN | H | H | P121 | H | H | H | H |
| Lₐ₇₆₆ | P6 | CN | H | H | P122 | H | H | H | H |
| Lₐ₇₆₇ | P6 | CN | H | H | P123 | H | H | H | H |
| Lₐ₇₆₈ | P6 | CN | H | H | P124 | H | H | H | H |
| Lₐ₇₆₉ | P6 | CN | H | H | P125 | H | H | H | H |
| Lₐ₇₇₀ | P6 | CN | H | H | P126 | H | H | H | H |
| Lₐ₇₇₁ | P6 | CN | H | H | P127 | H | H | H | H |
| Lₐ₇₇₂ | P6 | CN | H | H | P128 | H | H | H | H |
| Lₐ₇₇₃ | P6 | CN | H | H | P129 | H | H | H | H |
| Lₐ₇₇₄ | P6 | CN | H | H | P130 | H | H | H | H |
| Lₐ₇₇₅ | P6 | CN | H | H | P131 | H | H | H | H |
| Lₐ₇₇₆ | P6 | CN | H | H | P132 | H | H | H | H |
| Lₐ₇₇₇ | P6 | CN | H | H | P133 | H | H | H | H |
| Lₐ₇₇₈ | P6 | CN | H | H | P134 | H | H | H | H |
| Lₐ₇₇₉ | P6 | CN | H | H | P135 | H | H | H | H |
| Lₐ₇₈₀ | P6 | CN | H | H | P136 | H | H | H | H |
| Lₐ₇₈₁ | P6 | CN | H | H | P137 | H | H | H | H |
| Lₐ₇₈₂ | P6 | CN | H | H | P138 | H | H | H | H |
| Lₐ₇₈₃ | P6 | CN | H | H | P139 | H | H | H | H |
| Lₐ₇₈₄ | P6 | CN | H | H | P140 | H | H | H | H |
| Lₐ₇₈₅ | P6 | CN | H | H | P141 | H | H | H | H |
| Lₐ₇₈₆ | P6 | CN | H | H | P142 | H | H | H | H |
| Lₐ₇₈₇ | P6 | CN | H | H | P143 | H | H | H | H |
| Lₐ₇₈₈ | P6 | CN | H | H | P144 | H | H | H | H |
| Lₐ₇₈₉ | P6 | CN | H | H | P145 | H | H | H | H |
| Lₐ₇₉₀ | P6 | CN | H | H | P146 | H | H | H | H |
| Lₐ₇₉₁ | P6 | CN | H | H | P147 | H | H | H | H |
| Lₐ₇₉₂ | P6 | CN | H | H | P148 | H | H | H | H |
| Lₐ₇₉₃ | P6 | CN | H | H | P149 | H | H | H | H |
| Lₐ₇₉₄ | P6 | CN | H | H | P150 | H | H | H | H |
| Lₐ₇₉₅ | P6 | CN | H | H | P151 | H | H | H | H |
| Lₐ₇₉₆ | P6 | CN | H | P18 | H | H | H | H | H |
| Lₐ₇₉₇ | P6 | CN | H | P18 | D | H | H | H | H |
| Lₐ₇₉₈ | P6 | CN | H | P18 | P20 | H | H | H | H |
| Lₐ₇₉₉ | P6 | CN | H | P19 | H | H | H | H | H |
| Lₐ₈₀₀ | P6 | CN | H | P19 | D | H | H | H | H |
| Lₐ₈₀₁ | P6 | CN | H | P19 | P20 | H | H | H | H |
| Lₐ₈₀₂ | P6 | CN | H | P20 | H | H | H | H | H |
| Lₐ₈₀₃ | P6 | CN | H | P20 | D | H | H | H | H |
| Lₐ₈₀₄ | P6 | CN | H | P20 | H | H | P1 | H | H |
| Lₐ₈₀₅ | P6 | CN | H | P20 | D | H | P2 | H | H |
| Lₐ₈₀₆ | P6 | CN | H | P20 | H | H | H | P1 | H |
| Lₐ₈₀₇ | P6 | CN | H | P20 | D | H | H | P2 | H |
| Lₐ₈₀₈ | P6 | CN | H | P20 | H | H | P1 | P1 | H |
| Lₐ₈₀₉ | P6 | CN | H | P20 | D | H | P2 | P2 | H |
| Lₐ₈₁₀ | P6 | CN | H | P20 | H | H | P3 | H | H |
| Lₐ₈₁₁ | P6 | CN | H | P20 | D | H | P4 | H | H |
| Lₐ₈₁₂ | P6 | CN | H | P20 | H | H | P5 | H | H |
| Lₐ₈₁₃ | P6 | CN | H | P21 | H | H | H | H | H |
| Lₐ₈₁₄ | P6 | CN | H | P21 | D | H | H | H | H |
| Lₐ₈₁₅ | P6 | CN | H | P21 | H | H | P1 | H | H |
| Lₐ₈₁₆ | P6 | CN | H | P21 | D | H | P2 | H | H |
| Lₐ₈₁₇ | P6 | CN | H | P21 | H | H | H | P1 | H |
| Lₐ₈₁₈ | P6 | CN | H | P21 | D | H | H | P2 | H |
| Lₐ₈₁₉ | P6 | CN | H | P21 | H | H | P1 | P1 | H |
| Lₐ₈₂₀ | P6 | CN | H | P21 | D | H | P2 | P2 | H |
| Lₐ₈₂₁ | P6 | CN | H | P21 | H | H | P3 | H | H |
| Lₐ₈₂₂ | P6 | CN | H | P21 | D | H | P4 | H | H |
| Lₐ₈₂₃ | P6 | CN | H | P21 | H | H | P5 | H | H |
| Lₐ₈₂₄ | P11 | CN | H | H | H | H | H | H | H |
| Lₐ₈₂₅ | P11 | CN | H | H | H | H | P1 | H | H |
| Lₐ₈₂₆ | P11 | CN | H | H | H | H | P2 | H | H |
| Lₐ₈₂₇ | P11 | CN | H | H | H | H | P3 | H | H |
| Lₐ₈₂₈ | P11 | CN | H | H | H | H | P4 | H | H |
| Lₐ₈₂₉ | P11 | CN | H | H | H | H | P5 | H | H |
| Lₐ₈₃₀ | P11 | CN | H | H | H | H | P6 | H | H |
| Lₐ₈₃₁ | P11 | CN | H | H | H | H | P7 | H | H |
| Lₐ₈₃₂ | P11 | CN | H | H | H | H | P8 | H | H |
| Lₐ₈₃₃ | P11 | CN | H | H | H | H | P9 | H | H |
| Lₐ₈₃₄ | P11 | CN | H | H | H | H | P10 | H | H |
| Lₐ₈₃₅ | P11 | CN | H | H | H | H | P11 | H | H |
| Lₐ₈₃₆ | P11 | CN | H | H | H | H | P12 | H | H |
| Lₐ₈₃₇ | P11 | CN | H | H | H | H | P13 | H | H |
| Lₐ₈₃₈ | P11 | CN | H | H | H | H | P14 | H | H |
| Lₐ₈₃₉ | P11 | CN | H | H | H | H | P15 | H | H |
| Lₐ₈₄₀ | P11 | CN | H | H | H | H | P16 | H | H |
| Lₐ₈₄₁ | P11 | CN | H | H | H | H | P17 | H | H |
| Lₐ₈₄₂ | P11 | CN | H | H | H | H | P18 | H | H |
| Lₐ₈₄₃ | P11 | CN | H | H | H | H | P19 | H | H |
| Lₐ₈₄₄ | P11 | CN | H | H | H | H | P20 | H | H |
| Lₐ₈₄₅ | P11 | CN | H | H | H | H | P21 | H | H |
| Lₐ₈₄₆ | P11 | CN | H | H | H | H | P1 | F | H |
| Lₐ₈₄₇ | P11 | CN | H | H | H | H | P2 | F | H |
| Lₐ₈₄₈ | P11 | CN | H | H | H | H | P3 | F | H |
| Lₐ₈₄₉ | P11 | CN | H | H | H | H | P4 | F | H |
| Lₐ₈₅₀ | P11 | CN | H | H | H | H | P5 | F | H |
| Lₐ₈₅₁ | P11 | CN | H | H | H | H | P6 | F | H |
| Lₐ₈₅₂ | P11 | CN | H | H | H | H | P7 | F | H |
| Lₐ₈₅₃ | P11 | CN | H | H | H | H | P8 | F | H |
| Lₐ₈₅₄ | P11 | CN | H | H | H | H | P9 | F | H |
| Lₐ₈₅₅ | P11 | CN | H | H | H | H | P10 | F | H |
| Lₐ₈₅₆ | P11 | CN | H | H | H | H | P11 | F | H |
| Lₐ₈₅₇ | P11 | CN | H | H | H | H | P12 | F | H |
| Lₐ₈₅₈ | P11 | CN | H | H | H | H | P13 | F | H |
| Lₐ₈₅₉ | P11 | CN | H | H | H | H | P14 | F | H |
| Lₐ₈₆₀ | P11 | CN | H | H | H | H | P15 | F | H |
| Lₐ₈₆₁ | P11 | CN | H | H | H | H | P16 | F | H |
| Lₐ₈₆₂ | P11 | CN | H | H | H | H | P17 | F | H |
| Lₐ₈₆₃ | P11 | CN | H | H | H | H | P18 | F | H |
| Lₐ₈₆₄ | P11 | CN | H | H | H | H | P19 | F | H |
| Lₐ₈₆₅ | P11 | CN | H | H | H | H | P20 | F | H |
| Lₐ₈₆₆ | P11 | CN | H | H | H | H | P21 | F | H |
| Lₐ₈₆₇ | P11 | CN | H | H | H | H | H | P1 | H |
| Lₐ₈₆₈ | P11 | CN | H | H | H | H | H | P2 | H |
| Lₐ₈₆₉ | P11 | CN | H | H | H | H | H | P3 | H |
| Lₐ₈₇₀ | P11 | CN | H | H | H | H | H | P4 | H |
| Lₐ₈₇₁ | P11 | CN | H | H | H | H | H | P5 | H |
| Lₐ₈₇₂ | P11 | CN | H | H | H | H | H | P6 | H |
| Lₐ₈₇₃ | P11 | CN | H | H | H | H | H | P7 | H |
| Lₐ₈₇₄ | P11 | CN | H | H | H | H | H | P8 | H |
| Lₐ₈₇₅ | P11 | CN | H | H | H | H | H | P9 | H |
| Lₐ₈₇₆ | P11 | CN | H | H | H | H | H | P10 | H |
| Lₐ₈₇₇ | P11 | CN | H | H | H | H | H | P11 | H |
| Lₐ₈₇₈ | P11 | CN | H | H | H | H | H | P12 | H |
| Lₐ₈₇₉ | P11 | CN | H | H | H | H | H | P13 | H |
| Lₐ₈₈₀ | P11 | CN | H | H | H | H | H | P14 | H |
| Lₐ₈₈₁ | P11 | CN | H | H | H | H | H | P15 | H |
| Lₐ₈₈₂ | P11 | CN | H | H | H | H | H | P16 | H |
| Lₐ₈₈₃ | P11 | CN | H | H | H | H | H | P17 | H |
| Lₐ₈₈₄ | P11 | CN | H | H | H | H | H | P18 | H |
| Lₐ₈₈₅ | P11 | CN | H | H | H | H | H | P19 | H |
| Lₐ₈₈₆ | P11 | CN | H | H | H | H | H | P20 | H |
| Lₐ₈₈₇ | P11 | CN | H | H | H | H | H | P21 | H |
| Lₐ₈₈₈ | P11 | CN | H | H | H | H | F | P1 | H |
| Lₐ₈₈₉ | P11 | CN | H | H | H | H | F | P2 | H |
| Lₐ₈₉₀ | P11 | CN | H | H | H | H | F | P3 | H |
| Lₐ₈₉₁ | P11 | CN | H | H | H | H | F | P4 | H |
| Lₐ₈₉₂ | P11 | CN | H | H | H | H | F | P5 | H |
| Lₐ₈₉₃ | P11 | CN | H | H | H | H | F | P6 | H |
| Lₐ₈₉₄ | P11 | CN | H | H | H | H | F | P7 | H |
| Lₐ₈₉₅ | P11 | CN | H | H | H | H | F | P8 | H |
| Lₐ₈₉₆ | P11 | CN | H | H | H | H | F | P9 | H |
| Lₐ₈₉₇ | P11 | CN | H | H | H | H | F | P10 | H |
| Lₐ₈₉₈ | P11 | CN | H | H | H | H | F | P11 | H |
| Lₐ₈₉₉ | P11 | CN | H | H | H | H | F | P12 | H |
| Lₐ₉₀₀ | P11 | CN | H | H | H | H | F | P13 | H |
| Lₐ₉₀₁ | P11 | CN | H | H | H | H | F | P14 | H |
| Lₐ₉₀₂ | P11 | CN | H | H | H | H | F | P15 | H |
| Lₐ₉₀₃ | P11 | CN | H | H | H | H | F | P16 | H |
| Lₐ₉₀₄ | P11 | CN | H | H | H | H | F | P17 | H |
| Lₐ₉₀₅ | P11 | CN | H | H | H | H | F | P18 | H |
| Lₐ₉₀₆ | P11 | CN | H | H | H | H | F | P19 | H |
| Lₐ₉₀₇ | P11 | CN | H | H | H | H | F | P20 | H |
| Lₐ₉₀₈ | P11 | CN | H | H | H | H | F | P21 | H |
| Lₐ₉₀₉ | P11 | CN | H | H | H | H | P1 | P1 | H |
| Lₐ₉₁₀ | P11 | CN | H | H | H | H | P1 | P3 | H |
| Lₐ₉₁₁ | P11 | CN | H | H | H | H | P1 | P8 | H |
| Lₐ₉₁₂ | P11 | CN | H | H | H | H | P1 | P10 | H |
| Lₐ₉₁₃ | P11 | CN | H | H | H | H | P1 | P20 | H |
| Lₐ₉₁₄ | P11 | CN | H | H | H | H | P1 | P21 | H |
| Lₐ₉₁₅ | P11 | CN | H | H | H | H | P2 | P2 | H |
| Lₐ₉₁₆ | P11 | CN | H | H | H | H | P2 | P4 | H |
| Lₐ₉₁₇ | P11 | CN | H | H | H | H | P2 | P5 | H |
| Lₐ₉₁₈ | P11 | CN | H | H | H | H | P2 | P9 | H |
| Lₐ₉₁₉ | P11 | CN | H | H | H | H | P2 | P11 | H |
| Lₐ₉₂₀ | P11 | CN | H | H | H | H | P2 | P20 | H |
| Lₐ₉₂₁ | P11 | CN | H | H | H | H | P2 | P21 | H |
| Lₐ₉₂₂ | P11 | CN | H | H | H | D | D | D | D |
| Lₐ₉₂₃ | P11 | CN | H | H | H | D | F | D | D |
| Lₐ₉₂₄ | P11 | CN | H | H | H | D | D | F | D |
| Lₐ₉₂₅ | P11 | CN | H | H | H | D | P2 | D | D |
| Lₐ₉₂₆ | P11 | CN | H | H | H | D | D | P2 | D |
| Lₐ₉₂₇ | P11 | CN | H | H | H | D | P2 | P2 | D |
| Lₐ₉₂₈ | P11 | CN | H | H | D | H | H | H | H |
| Lₐ₉₂₉ | P11 | CN | H | H | D | H | P1 | H | H |
| Lₐ₉₃₀ | P11 | CN | H | H | D | H | P2 | H | H |
| Lₐ₉₃₁ | P11 | CN | H | H | D | H | P5 | H | H |
| Lₐ₉₃₂ | P11 | CN | H | H | D | H | P10 | H | H |
| Lₐ₉₃₃ | P11 | CN | H | H | D | H | P11 | H | H |
| Lₐ₉₃₄ | P11 | CN | H | H | D | H | H | P1 | H |
| Lₐ₉₃₅ | P11 | CN | H | H | D | H | H | P2 | H |
| Lₐ₉₃₆ | P11 | CN | H | H | D | H | H | P4 | H |
| Lₐ₉₃₇ | P11 | CN | H | H | D | H | H | P5 | H |
| Lₐ₉₃₈ | P11 | CN | H | H | D | H | H | P10 | H |
| Lₐ₉₃₉ | P11 | CN | H | H | D | H | H | P11 | H |
| Lₐ₉₄₀ | P11 | CN | H | H | D | H | P1 | F | H |
| Lₐ₉₄₁ | P11 | CN | H | H | D | H | P2 | F | H |
| Lₐ₉₄₂ | P11 | CN | H | H | D | H | P11 | F | H |
| Lₐ₉₄₃ | P11 | CN | H | H | D | H | F | P1 | H |
| Lₐ₉₄₄ | P11 | CN | H | H | D | H | F | P2 | H |
| Lₐ₉₄₅ | P11 | CN | H | H | D | H | F | P3 | H |
| Lₐ₉₄₆ | P11 | CN | H | H | D | H | F | P4 | H |
| Lₐ₉₄₇ | P11 | CN | H | H | D | H | F | P5 | H |
| Lₐ₉₄₈ | P11 | CN | H | H | D | H | F | P8 | H |
| Lₐ₉₄₉ | P11 | CN | H | H | D | H | F | P11 | H |
| Lₐ₉₅₀ | P11 | CN | H | H | D | H | P1 | P1 | H |
| Lₐ₉₅₁ | P11 | CN | H | H | D | H | P2 | P2 | H |
| Lₐ₉₅₂ | P11 | CN | H | H | D | H | P2 | P2 | D |
| Lₐ₉₅₃ | P11 | CN | H | H | P20 | H | H | H | H |
| Lₐ₉₅₄ | P11 | CN | H | H | P20 | H | P1 | H | H |
| Lₐ₉₅₅ | P11 | CN | H | H | P20 | H | P2 | H | H |
| Lₐ₉₅₆ | P11 | CN | H | H | P20 | H | P3 | H | H |
| Lₐ₉₅₇ | P11 | CN | H | H | P20 | H | P4 | H | H |
| Lₐ₉₅₈ | P11 | CN | H | H | P20 | H | P5 | H | H |
| Lₐ₉₅₉ | P11 | CN | H | H | P20 | H | P6 | H | H |
| Lₐ₉₆₀ | P11 | CN | H | H | P20 | H | P7 | H | H |
| Lₐ₉₆₁ | P11 | CN | H | H | P20 | H | P8 | H | H |
| Lₐ₉₆₂ | P11 | CN | H | H | P20 | H | P9 | H | H |
| Lₐ₉₆₃ | P11 | CN | H | H | P20 | H | P10 | H | H |
| Lₐ₉₆₄ | P11 | CN | H | H | P20 | H | P11 | H | H |
| Lₐ₉₆₅ | P11 | CN | H | H | P20 | H | P12 | H | H |
| Lₐ₉₆₆ | P11 | CN | H | H | P20 | H | P13 | H | H |
| Lₐ₉₆₇ | P11 | CN | H | H | P20 | H | P14 | H | H |
| Lₐ₉₆₈ | P11 | CN | H | H | P20 | H | P15 | H | H |
| Lₐ₉₆₉ | P11 | CN | H | H | P20 | H | P16 | H | H |
| Lₐ₉₇₀ | P11 | CN | H | H | P20 | H | P17 | H | H |
| Lₐ₉₇₁ | P11 | CN | H | H | P20 | H | P18 | H | H |
| Lₐ₉₇₂ | P11 | CN | H | H | P20 | H | P19 | H | H |
| Lₐ₉₇₃ | P11 | CN | H | H | P20 | H | P20 | H | H |
| Lₐ₉₇₄ | P11 | CN | H | H | P20 | H | P21 | H | H |
| Lₐ₉₇₅ | P11 | CN | H | H | P20 | H | H | P1 | H |
| Lₐ₉₇₆ | P11 | CN | H | H | P20 | H | H | P2 | H |
| Lₐ₉₇₇ | P11 | CN | H | H | P20 | H | H | P3 | H |
| Lₐ₉₇₈ | P11 | CN | H | H | P20 | H | H | P4 | H |
| Lₐ₉₇₉ | P11 | CN | H | H | P20 | H | H | P5 | H |
| Lₐ₉₈₀ | P11 | CN | H | H | P20 | H | H | P6 | H |
| Lₐ₉₈₁ | P11 | CN | H | H | P20 | H | H | P7 | H |
| Lₐ₉₈₂ | P11 | CN | H | H | P20 | H | H | P8 | H |
| Lₐ₉₈₃ | P11 | CN | H | H | P20 | H | H | P9 | H |
| Lₐ₉₈₄ | P11 | CN | H | H | P20 | H | H | P10 | H |
| Lₐ₉₈₅ | P11 | CN | H | H | P20 | H | H | P11 | H |
| Lₐ₉₈₆ | P11 | CN | H | H | P20 | H | H | P12 | H |
| Lₐ₉₈₇ | P11 | CN | H | H | P20 | H | H | P15 | H |
| Lₐ₉₈₈ | P11 | CN | H | H | P20 | H | H | P17 | H |
| Lₐ₉₈₉ | P11 | CN | H | H | P20 | H | H | P18 | H |
| Lₐ₉₉₀ | P11 | CN | H | H | P20 | H | H | P19 | H |
| Lₐ₉₉₁ | P11 | CN | H | H | P20 | H | H | P20 | H |
| Lₐ₉₉₂ | P11 | CN | H | H | P20 | H | H | P21 | H |
| Lₐ₉₉₃ | P11 | CN | H | H | P20 | H | F | H | H |
| Lₐ₉₉₄ | P11 | CN | H | H | P20 | H | F | P1 | H |
| Lₐ₉₉₅ | P11 | CN | H | H | P20 | H | F | P2 | H |
| Lₐ₉₉₆ | P11 | CN | H | H | P20 | H | F | P3 | H |
| Lₐ₉₉₇ | P11 | CN | H | H | P20 | H | F | P4 | H |
| Lₐ₉₉₈ | P11 | CN | H | H | P20 | H | F | P5 | H |
| Lₐ₉₉₉ | P11 | CN | H | H | P20 | H | F | P6 | H |
| Lₐ₁₀₀₀ | P11 | CN | H | H | P20 | H | F | P7 | H |
| Lₐ₁₀₀₁ | P11 | CN | H | H | P20 | H | F | P8 | H |
| Lₐ₁₀₀₂ | P11 | CN | H | H | P20 | H | F | P9 | H |
| Lₐ₁₀₀₃ | P11 | CN | H | H | P20 | H | F | P10 | H |
| Lₐ₁₀₀₄ | P11 | CN | H | H | P20 | H | F | P11 | H |
| Lₐ₁₀₀₅ | P11 | CN | H | H | P20 | H | P1 | F | H |
| Lₐ₁₀₀₆ | P11 | CN | H | H | P20 | H | P2 | F | H |
| Lₐ₁₀₀₇ | P11 | CN | H | H | P20 | H | P3 | F | H |
| Lₐ₁₀₀₈ | P11 | CN | H | H | P20 | H | P4 | F | H |
| Lₐ₁₀₀₉ | P11 | CN | H | H | P20 | H | P5 | F | H |
| Lₐ₁₀₁₀ | P11 | CN | H | H | P20 | H | P6 | F | H |
| Lₐ₁₀₁₁ | P11 | CN | H | H | P20 | H | P7 | F | H |
| Lₐ₁₀₁₂ | P11 | CN | H | H | P20 | H | P8 | F | H |
| Lₐ₁₀₁₃ | P11 | CN | H | H | P20 | H | P9 | F | H |
| Lₐ₁₀₁₄ | P11 | CN | H | H | P20 | H | P10 | F | H |
| Lₐ₁₀₁₅ | P11 | CN | H | H | P20 | H | P11 | F | H |
| Lₐ₁₀₁₆ | P11 | CN | H | H | P20 | H | P1 | P1 | H |
| Lₐ₁₀₁₇ | P11 | CN | H | H | P20 | H | P2 | P2 | H |
| Lₐ₁₀₁₈ | P11 | CN | H | H | P20 | D | D | D | D |
| Lₐ₁₀₁₉ | P11 | CN | H | H | P20 | D | P2 | P2 | D |
| Lₐ₁₀₂₀ | P11 | CN | H | H | P20 | D | F | P4 | D |
| Lₐ₁₀₂₁ | P11 | CN | H | H | P20 | D | F | P5 | D |
| Lₐ₁₀₂₂ | P11 | CN | H | H | P20 | D | F | P9 | D |
| Lₐ₁₀₂₃ | P11 | CN | H | H | P20 | D | F | P11 | D |
| Lₐ₁₀₂₄ | P11 | CN | H | H | P21 | H | H | H | H |
| Lₐ₁₀₂₅ | P11 | CN | H | H | P21 | H | P1 | H | H |
| Lₐ₁₀₂₆ | P11 | CN | H | H | P21 | H | P2 | H | H |
| Lₐ₁₀₂₇ | P11 | CN | H | H | P21 | H | P3 | H | H |
| Lₐ₁₀₂₈ | P11 | CN | H | H | P21 | H | P4 | H | H |
| Lₐ₁₀₂₉ | P11 | CN | H | H | P21 | H | P5 | H | H |
| Lₐ₁₀₃₀ | P11 | CN | H | H | P21 | H | P6 | H | H |
| Lₐ₁₀₃₁ | P11 | CN | H | H | P21 | H | P7 | H | H |
| Lₐ₁₀₃₂ | P11 | CN | H | H | P21 | H | P8 | H | H |
| Lₐ₁₀₃₃ | P11 | CN | H | H | P21 | H | P9 | H | H |
| Lₐ₁₀₃₄ | P11 | CN | H | H | P21 | H | P10 | H | H |
| Lₐ₁₀₃₅ | P11 | CN | H | H | P21 | H | P11 | H | H |
| Lₐ₁₀₃₆ | P11 | CN | H | H | P21 | H | P12 | H | H |
| Lₐ₁₀₃₇ | P11 | CN | H | H | P21 | H | P13 | H | H |
| Lₐ₁₀₃₈ | P11 | CN | H | H | P21 | H | P14 | H | H |
| Lₐ₁₀₃₉ | P11 | CN | H | H | P21 | H | P15 | H | H |
| Lₐ₁₀₄₀ | P11 | CN | H | H | P21 | H | P16 | H | H |
| Lₐ₁₀₄₁ | P11 | CN | H | H | P21 | H | P17 | H | H |
| Lₐ₁₀₄₂ | P11 | CN | H | H | P21 | H | P18 | H | H |
| Lₐ₁₀₄₃ | P11 | CN | H | H | P21 | H | P19 | H | H |
| Lₐ₁₀₄₄ | P11 | CN | H | H | P21 | H | P20 | H | H |
| Lₐ₁₀₄₅ | P11 | CN | H | H | P21 | H | P21 | H | H |
| Lₐ₁₀₄₆ | P11 | CN | H | H | P21 | H | H | P1 | H |
| Lₐ₁₀₄₇ | P11 | CN | H | H | P21 | H | H | P2 | H |
| Lₐ₁₀₄₈ | P11 | CN | H | H | P21 | H | H | P3 | H |
| Lₐ₁₀₄₉ | P11 | CN | H | H | P21 | H | H | P4 | H |
| Lₐ₁₀₅₀ | P11 | CN | H | H | P21 | H | H | P5 | H |
| Lₐ₁₀₅₁ | P11 | CN | H | H | P21 | H | H | P6 | H |
| Lₐ₁₀₅₂ | P11 | CN | H | H | P21 | H | H | P7 | H |
| Lₐ₁₀₅₃ | P11 | CN | H | H | P21 | H | H | P8 | H |
| Lₐ₁₀₅₄ | P11 | CN | H | H | P21 | H | H | P9 | H |
| Lₐ₁₀₅₅ | P11 | CN | H | H | P21 | H | H | P10 | H |
| Lₐ₁₀₅₆ | P11 | CN | H | H | P21 | H | H | P11 | H |
| Lₐ₁₀₅₇ | P11 | CN | H | H | P21 | H | H | P12 | H |
| Lₐ₁₀₅₈ | P11 | CN | H | H | P21 | H | H | P15 | H |
| Lₐ₁₀₅₉ | P11 | CN | H | H | P21 | H | H | P17 | H |
| Lₐ₁₀₆₀ | P11 | CN | H | H | P21 | H | H | P18 | H |
| Lₐ₁₀₆₁ | P11 | CN | H | H | P21 | H | H | P19 | H |
| Lₐ₁₀₆₂ | P11 | CN | H | H | P21 | H | H | P20 | H |
| Lₐ₁₀₆₃ | P11 | CN | H | H | P21 | H | H | P21 | H |
| Lₐ₁₀₆₄ | P11 | CN | H | H | P21 | H | F | H | H |
| Lₐ₁₀₆₅ | P11 | CN | H | H | P21 | H | F | P1 | H |
| Lₐ₁₀₆₆ | P11 | CN | H | H | P21 | H | F | P2 | H |
| Lₐ₁₀₆₇ | P11 | CN | H | H | P21 | H | F | P3 | H |
| Lₐ₁₀₆₈ | P11 | CN | H | H | P21 | H | F | P4 | H |
| Lₐ₁₀₆₉ | P11 | CN | H | H | P21 | H | F | P5 | H |
| Lₐ₁₀₇₀ | P11 | CN | H | H | P21 | H | F | P6 | H |
| Lₐ₁₀₇₁ | P11 | CN | H | H | P21 | H | F | P7 | H |
| Lₐ₁₀₇₂ | P11 | CN | H | H | P21 | H | F | P8 | H |
| Lₐ₁₀₇₃ | P11 | CN | H | H | P21 | H | F | P9 | H |
| Lₐ₁₀₇₄ | P11 | CN | H | H | P21 | H | F | P10 | H |
| Lₐ₁₀₇₅ | P11 | CN | H | H | P21 | H | F | P11 | H |
| Lₐ₁₀₇₆ | P11 | CN | H | H | P21 | H | P1 | F | H |
| Lₐ₁₀₇₇ | P11 | CN | H | H | P21 | H | P2 | F | H |
| Lₐ₁₀₇₈ | P11 | CN | H | H | P21 | H | P3 | F | H |
| Lₐ₁₀₇₉ | P11 | CN | H | H | P21 | H | P4 | F | H |
| Lₐ₁₀₈₀ | P11 | CN | H | H | P21 | H | P5 | F | H |
| Lₐ₁₀₈₁ | P11 | CN | H | H | P21 | H | P6 | F | H |
| Lₐ₁₀₈₂ | P11 | CN | H | H | P21 | H | P7 | F | H |
| Lₐ₁₀₈₃ | P11 | CN | H | H | P21 | H | P8 | F | H |
| Lₐ₁₀₈₄ | P11 | CN | H | H | P21 | H | P9 | F | H |
| Lₐ₁₀₈₅ | P11 | CN | H | H | P21 | H | P10 | F | H |
| Lₐ₁₀₈₆ | P11 | CN | H | H | P21 | H | P11 | F | H |
| Lₐ₁₀₈₇ | P11 | CN | H | H | P21 | H | P1 | P1 | H |
| Lₐ₁₀₈₈ | P11 | CN | H | H | P21 | H | P2 | P2 | H |
| Lₐ₁₀₈₉ | P11 | CN | H | H | P21 | D | D | D | D |
| Lₐ₁₀₉₀ | P11 | CN | H | H | P21 | D | P2 | P2 | D |
| Lₐ₁₀₉₁ | P11 | CN | H | H | P21 | D | F | P4 | D |
| Lₐ₁₀₉₂ | P11 | CN | H | H | P21 | D | F | P5 | D |
| Lₐ₁₀₉₃ | P11 | CN | H | H | P21 | D | F | P9 | D |
| Lₐ₁₀₉₄ | P11 | CN | H | H | P21 | D | F | P11 | D |
| Lₐ₁₀₉₅ | P11 | CN | H | H | P54 | H | H | H | H |
| Lₐ₁₀₉₆ | P11 | CN | H | H | P54 | H | P1 | H | H |
| Lₐ₁₀₉₇ | P11 | CN | H | H | P54 | H | P2 | H | H |
| Lₐ₁₀₉₈ | P11 | CN | H | H | P54 | H | P3 | H | H |
| Lₐ₁₀₉₉ | P11 | CN | H | H | P54 | H | P4 | H | H |
| Lₐ₁₁₀₀ | P11 | CN | H | H | P54 | H | P5 | H | H |
| Lₐ₁₁₀₁ | P11 | CN | H | H | P54 | H | P6 | H | H |
| Lₐ₁₁₀₂ | P11 | CN | H | H | P54 | H | P7 | H | H |
| Lₐ₁₁₀₃ | P11 | CN | H | H | P54 | H | P8 | H | H |
| Lₐ₁₁₀₄ | P11 | CN | H | H | P54 | H | P9 | H | H |
| Lₐ₁₁₀₅ | P11 | CN | H | H | P54 | H | P10 | H | H |
| Lₐ₁₁₀₆ | P11 | CN | H | H | P54 | H | P11 | H | H |
| Lₐ₁₁₀₇ | P11 | CN | H | H | P54 | H | P12 | H | H |
| Lₐ₁₁₀₈ | P11 | CN | H | H | P54 | H | P13 | H | H |
| Lₐ₁₁₀₉ | P11 | CN | H | H | P54 | H | P14 | H | H |
| Lₐ₁₁₁₀ | P11 | CN | H | H | P54 | H | P15 | H | H |
| Lₐ₁₁₁₁ | P11 | CN | H | H | P54 | H | P16 | H | H |
| Lₐ₁₁₁₂ | P11 | CN | H | H | P54 | H | P17 | H | H |
| Lₐ₁₁₁₃ | P11 | CN | H | H | P54 | H | P18 | H | H |
| Lₐ₁₁₁₄ | P11 | CN | H | H | P54 | H | P19 | H | H |
| Lₐ₁₁₁₅ | P11 | CN | H | H | P54 | H | P20 | H | H |
| Lₐ₁₁₁₆ | P11 | CN | H | H | P54 | H | P21 | H | H |
| Lₐ₁₁₁₇ | P11 | CN | H | H | P54 | H | H | P1 | H |
| Lₐ₁₁₁₈ | P11 | CN | H | H | P54 | H | H | P2 | H |
| Lₐ₁₁₁₉ | P11 | CN | H | H | P54 | H | H | P3 | H |
| Lₐ₁₁₂₀ | P11 | CN | H | H | P54 | H | H | P4 | H |
| Lₐ₁₁₂₁ | P11 | CN | H | H | P54 | H | H | P5 | H |
| Lₐ₁₁₂₂ | P11 | CN | H | H | P54 | H | H | P6 | H |
| Lₐ₁₁₂₃ | P11 | CN | H | H | P54 | H | H | P7 | H |
| Lₐ₁₁₂₄ | P11 | CN | H | H | P54 | H | H | P8 | H |
| Lₐ₁₁₂₅ | P11 | CN | H | H | P54 | H | H | P9 | H |
| Lₐ₁₁₂₆ | P11 | CN | H | H | P54 | H | H | P10 | H |
| Lₐ₁₁₂₇ | P11 | CN | H | H | P54 | H | H | P11 | H |
| Lₐ₁₁₂₈ | P11 | CN | H | H | P54 | H | H | P12 | H |
| Lₐ₁₁₂₉ | P11 | CN | H | H | P54 | H | H | P15 | H |
| Lₐ₁₁₃₀ | P11 | CN | H | H | P54 | H | H | P17 | H |
| Lₐ₁₁₃₁ | P11 | CN | H | H | P54 | H | H | P18 | H |
| Lₐ₁₁₃₂ | P11 | CN | H | H | P54 | H | H | P19 | H |
| Lₐ₁₁₃₃ | P11 | CN | H | H | P54 | H | H | P20 | H |
| Lₐ₁₁₃₄ | P11 | CN | H | H | P54 | H | H | P21 | H |
| Lₐ₁₁₃₅ | P11 | CN | H | H | P54 | H | F | H | H |
| Lₐ₁₁₃₆ | P11 | CN | H | H | P54 | H | F | P1 | H |
| Lₐ₁₁₃₇ | P11 | CN | H | H | P54 | H | F | P2 | H |
| Lₐ₁₁₃₈ | P11 | CN | H | H | P54 | H | F | P3 | H |
| Lₐ₁₁₃₉ | P11 | CN | H | H | P54 | H | F | P4 | H |
| Lₐ₁₁₄₀ | P11 | CN | H | H | P54 | H | F | P5 | H |
| Lₐ₁₁₄₁ | P11 | CN | H | H | P54 | H | F | P6 | H |
| Lₐ₁₁₄₂ | P11 | CN | H | H | P54 | H | F | P7 | H |
| Lₐ₁₁₄₃ | P11 | CN | H | H | P54 | H | F | P8 | H |
| Lₐ₁₁₄₄ | P11 | CN | H | H | P54 | H | F | P9 | H |
| Lₐ₁₁₄₅ | P11 | CN | H | H | P54 | H | F | P10 | H |
| Lₐ₁₁₄₆ | P11 | CN | H | H | P54 | H | F | P11 | H |
| Lₐ₁₁₄₇ | P11 | CN | H | H | P54 | H | P1 | F | H |
| Lₐ₁₁₄₈ | P11 | CN | H | H | P54 | H | P2 | F | H |
| Lₐ₁₁₄₉ | P11 | CN | H | H | P54 | H | P3 | F | H |
| Lₐ₁₁₅₀ | P11 | CN | H | H | P54 | H | P4 | F | H |
| Lₐ₁₁₅₁ | P11 | CN | H | H | P54 | H | P5 | F | H |
| Lₐ₁₁₅₂ | P11 | CN | H | H | P54 | H | P6 | F | H |
| Lₐ₁₁₅₃ | P11 | CN | H | H | P54 | H | P7 | F | H |
| Lₐ₁₁₅₄ | P11 | CN | H | H | P54 | H | P8 | F | H |
| Lₐ₁₁₅₅ | P11 | CN | H | H | P54 | H | P9 | F | H |
| Lₐ₁₁₅₆ | P11 | CN | H | H | P54 | H | P10 | F | H |
| Lₐ₁₁₅₇ | P11 | CN | H | H | P54 | H | P11 | F | H |
| Lₐ₁₁₅₈ | P11 | CN | H | H | P54 | H | P1 | P1 | H |
| Lₐ₁₁₅₉ | P11 | CN | H | H | P54 | H | P2 | P2 | H |
| Lₐ₁₁₆₀ | P11 | CN | H | H | P54 | D | D | D | D |
| Lₐ₁₁₆₁ | P11 | CN | H | H | P54 | D | P2 | P2 | D |
| Lₐ₁₁₆₂ | P11 | CN | H | H | P54 | D | F | P4 | D |
| Lₐ₁₁₆₃ | P11 | CN | H | H | P54 | D | F | P5 | D |
| Lₐ₁₁₆₄ | P11 | CN | H | H | P54 | D | F | P9 | D |
| Lₐ₁₁₆₅ | P11 | CN | H | H | P54 | D | F | P11 | D |
| Lₐ₁₁₆₆ | P11 | CN | H | H | P96 | H | H | H | H |
| Lₐ₁₁₆₇ | P11 | CN | H | H | P96 | H | P1 | H | H |
| Lₐ₁₁₆₈ | P11 | CN | H | H | P96 | H | P2 | H | H |
| Lₐ₁₁₆₉ | P11 | CN | H | H | P96 | H | P3 | H | H |
| Lₐ₁₁₇₀ | P11 | CN | H | H | P96 | H | P4 | H | H |
| Lₐ₁₁₇₁ | P11 | CN | H | H | P96 | H | P5 | H | H |
| Lₐ₁₁₇₂ | P11 | CN | H | H | P96 | H | P6 | H | H |
| Lₐ₁₁₇₃ | P11 | CN | H | H | P96 | H | P7 | H | H |
| Lₐ₁₁₇₄ | P11 | CN | H | H | P96 | H | P8 | H | H |
| Lₐ₁₁₇₅ | P11 | CN | H | H | P96 | H | P9 | H | H |
| Lₐ₁₁₇₆ | P11 | CN | H | H | P96 | H | P10 | H | H |
| Lₐ₁₁₇₇ | P11 | CN | H | H | P96 | H | P11 | H | H |
| Lₐ₁₁₇₈ | P11 | CN | H | H | P96 | H | P12 | H | H |
| Lₐ₁₁₇₉ | P11 | CN | H | H | P96 | H | P13 | H | H |
| Lₐ₁₁₈₀ | P11 | CN | H | H | P96 | H | P14 | H | H |
| Lₐ₁₁₈₁ | P11 | CN | H | H | P96 | H | P15 | H | H |
| Lₐ₁₁₈₂ | P11 | CN | H | H | P96 | H | P16 | H | H |
| Lₐ₁₁₈₃ | P11 | CN | H | H | P96 | H | P17 | H | H |
| Lₐ₁₁₈₄ | P11 | CN | H | H | P96 | H | P18 | H | H |
| Lₐ₁₁₈₅ | P11 | CN | H | H | P96 | H | P19 | H | H |
| Lₐ₁₁₈₆ | P11 | CN | H | H | P96 | H | P20 | H | H |
| Lₐ₁₁₈₇ | P11 | CN | H | H | P96 | H | P21 | H | H |
| Lₐ₁₁₈₈ | P11 | CN | H | H | P96 | H | H | P1 | H |
| Lₐ₁₁₈₉ | P11 | CN | H | H | P96 | H | H | P2 | H |
| Lₐ₁₁₉₀ | P11 | CN | H | H | P96 | H | H | P3 | H |
| Lₐ₁₁₉₁ | P11 | CN | H | H | P96 | H | H | P4 | H |
| Lₐ₁₁₉₂ | P11 | CN | H | H | P96 | H | H | P5 | H |
| Lₐ₁₁₉₃ | P11 | CN | H | H | P96 | H | H | P6 | H |
| Lₐ₁₁₉₄ | P11 | CN | H | H | P96 | H | H | P7 | H |
| Lₐ₁₁₉₅ | P11 | CN | H | H | P96 | H | H | P8 | H |
| Lₐ₁₁₉₆ | P11 | CN | H | H | P96 | H | H | P9 | H |
| Lₐ₁₁₉₇ | P11 | CN | H | H | P96 | H | H | P10 | H |
| Lₐ₁₁₉₈ | P11 | CN | H | H | P96 | H | H | P11 | H |
| Lₐ₁₁₉₉ | P11 | CN | H | H | P96 | H | H | P12 | H |
| Lₐ₁₂₀₀ | P11 | CN | H | H | P96 | H | H | P15 | H |
| Lₐ₁₂₀₁ | P11 | CN | H | H | P96 | H | H | P17 | H |
| Lₐ₁₂₀₂ | P11 | CN | H | H | P96 | H | H | P18 | H |
| Lₐ₁₂₀₃ | P11 | CN | H | H | P96 | H | H | P19 | H |
| Lₐ₁₂₀₄ | P11 | CN | H | H | P96 | H | H | P20 | H |
| Lₐ₁₂₀₅ | P11 | CN | H | H | P96 | H | H | P21 | H |
| Lₐ₁₂₀₆ | P11 | CN | H | H | P96 | H | F | H | H |
| Lₐ₁₂₀₇ | P11 | CN | H | H | P96 | H | F | P1 | H |
| Lₐ₁₂₀₈ | P11 | CN | H | H | P96 | H | F | P2 | H |
| Lₐ₁₂₀₉ | P11 | CN | H | H | P96 | H | F | P3 | H |
| Lₐ₁₂₁₀ | P11 | CN | H | H | P96 | H | F | P4 | H |
| Lₐ₁₂₁₁ | P11 | CN | H | H | P96 | H | F | P5 | H |
| Lₐ₁₂₁₂ | P11 | CN | H | H | P96 | H | F | P6 | H |
| Lₐ₁₂₁₃ | P11 | CN | H | H | P96 | H | F | P7 | H |
| Lₐ₁₂₁₄ | P11 | CN | H | H | P96 | H | F | P8 | H |
| Lₐ₁₂₁₅ | P11 | CN | H | H | P96 | H | F | P9 | H |
| Lₐ₁₂₁₆ | P11 | CN | H | H | P96 | H | F | P10 | H |
| Lₐ₁₂₁₇ | P11 | CN | H | H | P96 | H | F | P11 | H |
| Lₐ₁₂₁₈ | P11 | CN | H | H | P96 | H | P1 | F | H |
| Lₐ₁₂₁₉ | P11 | CN | H | H | P96 | H | P2 | F | H |
| Lₐ₁₂₂₀ | P11 | CN | H | H | P96 | H | P3 | F | H |
| Lₐ₁₂₂₁ | P11 | CN | H | H | P96 | H | P4 | F | H |
| Lₐ₁₂₂₂ | P11 | CN | H | H | P96 | H | P5 | F | H |
| Lₐ₁₂₂₃ | P11 | CN | H | H | P96 | H | P6 | F | H |
| Lₐ₁₂₂₄ | P11 | CN | H | H | P96 | H | P7 | F | H |
| Lₐ₁₂₂₅ | P11 | CN | H | H | P96 | H | P8 | F | H |
| Lₐ₁₂₂₆ | P11 | CN | H | H | P96 | H | P9 | F | H |
| Lₐ₁₂₂₇ | P11 | CN | H | H | P96 | H | P10 | F | H |
| Lₐ₁₂₂₈ | P11 | CN | H | H | P96 | H | P11 | F | H |
| Lₐ₁₂₂₉ | P11 | CN | H | H | P96 | H | P1 | P1 | H |
| Lₐ₁₂₃₀ | P11 | CN | H | H | P96 | H | P2 | P2 | H |
| Lₐ₁₂₃₁ | P11 | CN | H | H | P96 | D | D | D | D |
| Lₐ₁₂₃₂ | P11 | CN | H | H | P96 | D | P2 | P2 | D |
| Lₐ₁₂₃₃ | P11 | CN | H | H | P96 | D | F | P4 | D |
| Lₐ₁₂₃₄ | P11 | CN | H | H | P96 | D | F | P5 | D |
| Lₐ₁₂₃₅ | P11 | CN | H | H | P96 | D | F | P9 | D |
| Lₐ₁₂₃₆ | P11 | CN | H | H | P96 | D | F | P11 | D |
| Lₐ₁₂₃₇ | P11 | CN | H | H | P97 | H | H | H | H |
| Lₐ₁₂₃₈ | P11 | CN | H | H | P97 | H | P1 | H | H |
| Lₐ₁₂₃₉ | P11 | CN | H | H | P97 | H | P2 | H | H |
| Lₐ₁₂₄₀ | P11 | CN | H | H | P97 | H | P3 | H | H |
| Lₐ₁₂₄₁ | P11 | CN | H | H | P97 | H | P4 | H | H |
| Lₐ₁₂₄₂ | P11 | CN | H | H | P97 | H | P5 | H | H |
| Lₐ₁₂₄₃ | P11 | CN | H | H | P97 | H | P6 | H | H |
| Lₐ₁₂₄₄ | P11 | CN | H | H | P97 | H | P7 | H | H |
| Lₐ₁₂₄₅ | P11 | CN | H | H | P97 | H | P8 | H | H |
| Lₐ₁₂₄₆ | P11 | CN | H | H | P97 | H | P9 | H | H |
| Lₐ₁₂₄₇ | P11 | CN | H | H | P97 | H | P10 | H | H |
| Lₐ₁₂₄₈ | P11 | CN | H | H | P97 | H | P11 | H | H |
| Lₐ₁₂₄₉ | P11 | CN | H | H | P97 | H | P12 | H | H |
| Lₐ₁₂₅₀ | P11 | CN | H | H | P97 | H | P13 | H | H |
| Lₐ₁₂₅₁ | P11 | CN | H | H | P97 | H | P14 | H | H |
| Lₐ₁₂₅₂ | P11 | CN | H | H | P97 | H | P15 | H | H |
| Lₐ₁₂₅₃ | P11 | CN | H | H | P97 | H | P16 | H | H |
| Lₐ₁₂₅₄ | P11 | CN | H | H | P97 | H | P17 | H | H |
| Lₐ₁₂₅₅ | P11 | CN | H | H | P97 | H | P18 | H | H |
| Lₐ₁₂₅₆ | P11 | CN | H | H | P97 | H | P19 | H | H |
| Lₐ₁₂₅₇ | P11 | CN | H | H | P97 | H | P20 | H | H |
| Lₐ₁₂₅₈ | P11 | CN | H | H | P97 | H | P21 | H | H |
| Lₐ₁₂₅₉ | P11 | CN | H | H | P97 | H | H | P1 | H |
| Lₐ₁₂₆₀ | P11 | CN | H | H | P97 | H | H | P2 | H |
| Lₐ₁₂₆₁ | P11 | CN | H | H | P97 | H | H | P3 | H |
| Lₐ₁₂₆₂ | P11 | CN | H | H | P97 | H | H | P4 | H |
| Lₐ₁₂₆₃ | P11 | CN | H | H | P97 | H | H | P5 | H |
| Lₐ₁₂₆₄ | P11 | CN | H | H | P97 | H | H | P6 | H |
| Lₐ₁₂₆₅ | P11 | CN | H | H | P97 | H | H | P7 | H |
| Lₐ₁₂₆₆ | P11 | CN | H | H | P97 | H | H | P8 | H |
| Lₐ₁₂₆₇ | P11 | CN | H | H | P97 | H | H | P9 | H |
| Lₐ₁₂₆₈ | P11 | CN | H | H | P97 | H | H | P10 | H |
| Lₐ₁₂₆₉ | P11 | CN | H | H | P97 | H | H | P11 | H |
| Lₐ₁₂₇₀ | P11 | CN | H | H | P97 | H | H | P12 | H |
| Lₐ₁₂₇₁ | P11 | CN | H | H | P97 | H | H | P15 | H |
| Lₐ₁₂₇₂ | P11 | CN | H | H | P97 | H | H | P17 | H |
| Lₐ₁₂₇₃ | P11 | CN | H | H | P97 | H | H | P18 | H |
| Lₐ₁₂₇₄ | P11 | CN | H | H | P97 | H | H | P19 | H |
| Lₐ₁₂₇₅ | P11 | CN | H | H | P97 | H | H | P20 | H |
| Lₐ₁₂₇₆ | P11 | CN | H | H | P97 | H | H | P21 | H |
| Lₐ₁₂₇₇ | P11 | CN | H | H | P97 | H | F | H | H |
| Lₐ₁₂₇₈ | P11 | CN | H | H | P97 | H | F | P1 | H |
| Lₐ₁₂₇₉ | P11 | CN | H | H | P97 | H | F | P2 | H |
| Lₐ₁₂₈₀ | P11 | CN | H | H | P97 | H | F | P3 | H |
| Lₐ₁₂₈₁ | P11 | CN | H | H | P97 | H | F | P4 | H |
| Lₐ₁₂₈₂ | P11 | CN | H | H | P97 | H | F | P5 | H |
| Lₐ₁₂₈₃ | P11 | CN | H | H | P97 | H | F | P6 | H |
| Lₐ₁₂₈₄ | P11 | CN | H | H | P97 | H | F | P7 | H |
| Lₐ₁₂₈₅ | P11 | CN | H | H | P97 | H | F | P8 | H |
| Lₐ₁₂₈₆ | P11 | CN | H | H | P97 | H | F | P9 | H |
| Lₐ₁₂₈₇ | P11 | CN | H | H | P97 | H | F | P10 | H |
| Lₐ₁₂₈₈ | P11 | CN | H | H | P97 | H | F | P11 | H |
| Lₐ₁₂₈₉ | P11 | CN | H | H | P97 | H | P1 | F | H |
| Lₐ₁₂₉₀ | P11 | CN | H | H | P97 | H | P2 | F | H |
| Lₐ₁₂₉₁ | P11 | CN | H | H | P97 | H | P3 | F | H |
| Lₐ₁₂₉₂ | P11 | CN | H | H | P97 | H | P4 | F | H |
| Lₐ₁₂₉₃ | P11 | CN | H | H | P97 | H | P5 | F | H |
| Lₐ₁₂₉₄ | P11 | CN | H | H | P97 | H | P6 | F | H |
| Lₐ₁₂₉₅ | P11 | CN | H | H | P97 | H | P7 | F | H |
| Lₐ₁₂₉₆ | P11 | CN | H | H | P97 | H | P8 | F | H |
| Lₐ₁₂₉₇ | P11 | CN | H | H | P97 | H | P9 | F | H |
| Lₐ₁₂₉₈ | P11 | CN | H | H | P97 | H | P10 | F | H |
| Lₐ₁₂₉₉ | P11 | CN | H | H | P97 | H | P11 | F | H |
| Lₐ₁₃₀₀ | P11 | CN | H | H | P97 | H | P1 | P1 | H |
| Lₐ₁₃₀₁ | P11 | CN | H | H | P97 | H | P2 | P2 | H |
| Lₐ₁₃₀₂ | P11 | CN | H | H | P97 | D | D | D | D |
| Lₐ₁₃₀₃ | P11 | CN | H | H | P97 | D | P2 | P2 | D |
| Lₐ₁₃₀₄ | P11 | CN | H | H | P97 | D | F | P4 | D |
| Lₐ₁₃₀₅ | P11 | CN | H | H | P97 | D | F | P5 | D |
| Lₐ₁₃₀₆ | P11 | CN | H | H | P97 | D | F | P9 | D |
| Lₐ₁₃₀₇ | P11 | CN | H | H | P97 | D | F | P11 | D |
| Lₐ₁₃₀₈ | P11 | CN | H | H | P102 | H | P1 | H | H |
| Lₐ₁₃₀₉ | P11 | CN | H | H | P102 | H | P2 | H | H |
| Lₐ₁₃₁₀ | P11 | CN | H | H | P102 | H | P3 | H | H |
| Lₐ₁₃₁₁ | P11 | CN | H | H | P102 | H | P4 | H | H |
| Lₐ₁₃₁₂ | P11 | CN | H | H | P102 | H | P5 | H | H |
| Lₐ₁₃₁₃ | P11 | CN | H | H | P102 | H | P6 | H | H |
| Lₐ₁₃₁₄ | P11 | CN | H | H | P102 | H | P7 | H | H |
| Lₐ₁₃₁₅ | P11 | CN | H | H | P102 | H | P8 | H | H |
| Lₐ₁₃₁₆ | P11 | CN | H | H | P102 | H | P9 | H | H |
| Lₐ₁₃₁₇ | P11 | CN | H | H | P102 | H | P10 | H | H |
| Lₐ₁₃₁₈ | P11 | CN | H | H | P102 | H | P11 | H | H |
| Lₐ₁₃₁₉ | P11 | CN | H | H | P102 | H | P12 | H | H |
| Lₐ₁₃₂₀ | P11 | CN | H | H | P102 | H | P13 | H | H |
| Lₐ₁₃₂₁ | P11 | CN | H | H | P102 | H | P14 | H | H |
| Lₐ₁₃₂₂ | P11 | CN | H | H | P102 | H | P15 | H | H |
| Lₐ₁₃₂₃ | P11 | CN | H | H | P102 | H | P16 | H | H |
| Lₐ₁₃₂₄ | P11 | CN | H | H | P102 | H | P17 | H | H |
| Lₐ₁₃₂₅ | P11 | CN | H | H | P102 | H | P18 | H | H |
| Lₐ₁₃₂₆ | P11 | CN | H | H | P102 | H | P19 | H | H |
| Lₐ₁₃₂₇ | P11 | CN | H | H | P102 | H | P20 | H | H |
| Lₐ₁₃₂₈ | P11 | CN | H | H | P102 | H | P21 | H | H |
| Lₐ₁₃₂₉ | P11 | CN | H | H | P102 | H | H | P1 | H |
| Lₐ₁₃₃₀ | P11 | CN | H | H | P102 | H | H | P2 | H |
| Lₐ₁₃₃₁ | P11 | CN | H | H | P102 | H | H | P3 | H |
| Lₐ₁₃₃₂ | P11 | CN | H | H | P102 | H | H | P4 | H |
| Lₐ₁₃₃₃ | P11 | CN | H | H | P102 | H | H | P5 | H |
| Lₐ₁₃₃₄ | P11 | CN | H | H | P102 | H | H | P6 | H |
| Lₐ₁₃₃₅ | P11 | CN | H | H | P102 | H | H | P7 | H |
| Lₐ₁₃₃₆ | P11 | CN | H | H | P102 | H | H | P8 | H |
| Lₐ₁₃₃₇ | P11 | CN | H | H | P102 | H | H | P9 | H |
| Lₐ₁₃₃₈ | P11 | CN | H | H | P102 | H | H | P10 | H |
| Lₐ₁₃₃₉ | P11 | CN | H | H | P102 | H | H | P11 | H |
| Lₐ₁₃₄₀ | P11 | CN | H | H | P102 | H | H | P12 | H |
| Lₐ₁₃₄₁ | P11 | CN | H | H | P102 | H | H | P15 | H |
| Lₐ₁₃₄₂ | P11 | CN | H | H | P102 | H | H | P17 | H |
| Lₐ₁₃₄₃ | P11 | CN | H | H | P102 | H | H | P18 | H |
| Lₐ₁₃₄₄ | P11 | CN | H | H | P102 | H | H | P19 | H |
| Lₐ₁₃₄₅ | P11 | CN | H | H | P102 | H | H | P20 | H |
| Lₐ₁₃₄₆ | P11 | CN | H | H | P102 | H | H | P21 | H |
| Lₐ₁₃₄₇ | P11 | CN | H | H | P102 | H | F | H | H |
| Lₐ₁₃₄₈ | P11 | CN | H | H | P102 | H | F | P1 | H |
| Lₐ₁₃₄₉ | P11 | CN | H | H | P102 | H | F | P2 | H |
| Lₐ₁₃₅₀ | P11 | CN | H | H | P102 | H | F | P3 | H |
| Lₐ₁₃₅₁ | P11 | CN | H | H | P102 | H | F | P4 | H |
| Lₐ₁₃₅₂ | P11 | CN | H | H | P102 | H | F | P5 | H |
| Lₐ₁₃₅₃ | P11 | CN | H | H | P102 | H | F | P6 | H |
| Lₐ₁₃₅₄ | P11 | CN | H | H | P102 | H | F | P7 | H |
| Lₐ₁₃₅₅ | P11 | CN | H | H | P102 | H | F | P8 | H |
| Lₐ₁₃₅₆ | P11 | CN | H | H | P102 | H | F | P9 | H |
| Lₐ₁₃₅₇ | P11 | CN | H | H | P102 | H | F | P10 | H |
| Lₐ₁₃₅₈ | P11 | CN | H | H | P102 | H | F | P11 | H |
| Lₐ₁₃₅₉ | P11 | CN | H | H | P102 | H | P1 | F | H |
| Lₐ₁₃₆₀ | P11 | CN | H | H | P102 | H | P2 | F | H |
| Lₐ₁₃₆₁ | P11 | CN | H | H | P102 | H | P3 | F | H |
| Lₐ₁₃₆₂ | P11 | CN | H | H | P102 | H | P4 | F | H |
| Lₐ₁₃₆₃ | P11 | CN | H | H | P102 | H | P5 | F | H |
| Lₐ₁₃₆₄ | P11 | CN | H | H | P102 | H | P6 | F | H |
| Lₐ₁₃₆₅ | P11 | CN | H | H | P102 | H | P7 | F | H |
| Lₐ₁₃₆₆ | P11 | CN | H | H | P102 | H | P8 | F | H |
| Lₐ₁₃₆₇ | P11 | CN | H | H | P102 | H | P9 | F | H |
| Lₐ₁₃₆₈ | P11 | CN | H | H | P102 | H | P10 | F | H |
| Lₐ₁₃₆₉ | P11 | CN | H | H | P102 | H | P11 | F | H |
| Lₐ₁₃₇₀ | P11 | CN | H | H | P102 | H | P1 | P1 | H |
| Lₐ₁₃₇₁ | P11 | CN | H | H | P102 | H | P2 | P2 | H |
| Lₐ₁₃₇₂ | P11 | CN | H | H | P102 | D | D | D | D |
| Lₐ₁₃₇₃ | P11 | CN | H | H | P102 | D | P2 | P2 | D |
| Lₐ₁₃₇₄ | P11 | CN | H | H | P102 | D | F | P4 | D |
| Lₐ₁₃₇₅ | P11 | CN | H | H | P102 | D | F | P5 | D |
| Lₐ₁₃₇₆ | P11 | CN | H | H | P102 | D | F | P9 | D |
| Lₐ₁₃₇₇ | P11 | CN | H | H | P102 | D | F | P11 | D |
| Lₐ₁₃₇₈ | P11 | CN | H | H | P103 | H | P1 | H | H |
| Lₐ₁₃₇₉ | P11 | CN | H | H | P103 | H | P2 | H | H |
| Lₐ₁₃₈₀ | P11 | CN | H | H | P103 | H | P3 | H | H |
| Lₐ₁₃₈₁ | P11 | CN | H | H | P103 | H | P4 | H | H |
| Lₐ₁₃₈₂ | P11 | CN | H | H | P103 | H | P5 | H | H |
| Lₐ₁₃₈₃ | P11 | CN | H | H | P103 | H | P6 | H | H |
| Lₐ₁₃₈₄ | P11 | CN | H | H | P103 | H | P7 | H | H |
| Lₐ₁₃₈₅ | P11 | CN | H | H | P103 | H | P8 | H | H |
| Lₐ₁₃₈₆ | P11 | CN | H | H | P103 | H | P9 | H | H |
| Lₐ₁₃₈₇ | P11 | CN | H | H | P103 | H | P10 | H | H |
| Lₐ₁₃₈₈ | P11 | CN | H | H | P103 | H | P11 | H | H |
| Lₐ₁₃₈₉ | P11 | CN | H | H | P103 | H | P12 | H | H |
| Lₐ₁₃₉₀ | P11 | CN | H | H | P103 | H | P13 | H | H |
| Lₐ₁₃₉₁ | P11 | CN | H | H | P103 | H | P14 | H | H |
| Lₐ₁₃₉₂ | P11 | CN | H | H | P103 | H | P15 | H | H |
| Lₐ₁₃₉₃ | P11 | CN | H | H | P103 | H | P16 | H | H |
| Lₐ₁₃₉₄ | P11 | CN | H | H | P103 | H | P17 | H | H |
| Lₐ₁₃₉₅ | P11 | CN | H | H | P103 | H | P18 | H | H |
| Lₐ₁₃₉₆ | P11 | CN | H | H | P103 | H | P19 | H | H |
| Lₐ₁₃₉₇ | P11 | CN | H | H | P103 | H | P20 | H | H |
| Lₐ₁₃₉₈ | P11 | CN | H | H | P103 | H | P21 | H | H |
| Lₐ₁₃₉₉ | P11 | CN | H | H | P103 | H | H | P1 | H |
| Lₐ₁₄₀₀ | P11 | CN | H | H | P103 | H | H | P2 | H |
| Lₐ₁₄₀₁ | P11 | CN | H | H | P103 | H | H | P3 | H |
| Lₐ₁₄₀₂ | P11 | CN | H | H | P103 | H | H | P4 | H |
| Lₐ₁₄₀₃ | P11 | CN | H | H | P103 | H | H | P5 | H |
| Lₐ₁₄₀₄ | P11 | CN | H | H | P103 | H | H | P6 | H |
| Lₐ₁₄₀₅ | P11 | CN | H | H | P103 | H | H | P7 | H |
| Lₐ₁₄₀₆ | P11 | CN | H | H | P103 | H | H | P8 | H |
| Lₐ₁₄₀₇ | P11 | CN | H | H | P103 | H | H | P9 | H |
| Lₐ₁₄₀₈ | P11 | CN | H | H | P103 | H | H | P10 | H |
| Lₐ₁₄₀₉ | P11 | CN | H | H | P103 | H | H | P11 | H |
| Lₐ₁₄₁₀ | P11 | CN | H | H | P103 | H | H | P12 | H |
| Lₐ₁₄₁₁ | P11 | CN | H | H | P103 | H | H | P15 | H |
| Lₐ₁₄₁₂ | P11 | CN | H | H | P103 | H | H | P17 | H |
| Lₐ₁₄₁₃ | P11 | CN | H | H | P103 | H | H | P18 | H |
| Lₐ₁₄₁₄ | P11 | CN | H | H | P103 | H | H | P19 | H |
| Lₐ₁₄₁₅ | P11 | CN | H | H | P103 | H | H | P20 | H |
| Lₐ₁₄₁₆ | P11 | CN | H | H | P103 | H | H | P21 | H |
| Lₐ₁₄₁₇ | P11 | CN | H | H | P103 | H | F | H | H |
| Lₐ₁₄₁₈ | P11 | CN | H | H | P103 | H | F | P1 | H |
| Lₐ₁₄₁₉ | P11 | CN | H | H | P103 | H | F | P2 | H |
| Lₐ₁₄₂₀ | P11 | CN | H | H | P103 | H | F | P3 | H |
| Lₐ₁₄₂₁ | P11 | CN | H | H | P103 | H | F | P4 | H |
| Lₐ₁₄₂₂ | P11 | CN | H | H | P103 | H | F | P5 | H |
| Lₐ₁₄₂₃ | P11 | CN | H | H | P103 | H | F | P6 | H |
| Lₐ₁₄₂₄ | P11 | CN | H | H | P103 | H | F | P7 | H |
| Lₐ₁₄₂₅ | P11 | CN | H | H | P103 | H | F | P8 | H |
| Lₐ₁₄₂₆ | P11 | CN | H | H | P103 | H | F | P9 | H |
| Lₐ₁₄₂₇ | P11 | CN | H | H | P103 | H | F | P10 | H |
| Lₐ₁₄₂₈ | P11 | CN | H | H | P103 | H | F | P11 | H |
| Lₐ₁₄₂₉ | P11 | CN | H | H | P103 | H | P1 | F | H |
| Lₐ₁₄₃₀ | P11 | CN | H | H | P103 | H | P2 | F | H |
| Lₐ₁₄₃₁ | P11 | CN | H | H | P103 | H | P3 | F | H |
| Lₐ₁₄₃₂ | P11 | CN | H | H | P103 | H | P4 | F | H |
| Lₐ₁₄₃₃ | P11 | CN | H | H | P103 | H | P5 | F | H |
| Lₐ₁₄₃₄ | P11 | CN | H | H | P103 | H | P6 | F | H |
| Lₐ₁₄₃₅ | P11 | CN | H | H | P103 | H | P7 | F | H |
| Lₐ₁₄₃₆ | P11 | CN | H | H | P103 | H | P8 | F | H |
| Lₐ₁₄₃₇ | P11 | CN | H | H | P103 | H | P9 | F | H |
| Lₐ₁₄₃₈ | P11 | CN | H | H | P103 | H | P10 | F | H |
| Lₐ₁₄₃₉ | P11 | CN | H | H | P103 | H | P11 | F | H |
| Lₐ₁₄₄₀ | P11 | CN | H | H | P103 | H | P1 | P1 | H |
| Lₐ₁₄₄₁ | P11 | CN | H | H | P103 | H | P2 | P2 | H |
| Lₐ₁₄₄₂ | P11 | CN | H | H | P103 | D | D | D | D |
| Lₐ₁₄₄₃ | P11 | CN | H | H | P103 | D | P2 | P2 | D |
| Lₐ₁₄₄₄ | P11 | CN | H | H | P103 | D | F | P4 | D |
| Lₐ₁₄₄₅ | P11 | CN | H | H | P103 | D | F | P5 | D |
| Lₐ₁₄₄₆ | P11 | CN | H | H | P103 | D | F | P9 | D |
| Lₐ₁₄₄₇ | P11 | CN | H | H | P103 | D | F | P11 | D |
| Lₐ₁₄₄₈ | P11 | CN | H | H | H | H | P20 | P1 | H |
| Lₐ₁₄₄₉ | P11 | CN | H | H | H | H | P21 | P2 | H |
| Lₐ₁₄₅₀ | P11 | CN | H | H | H | H | P29 | H | H |
| Lₐ₁₄₅₁ | P11 | CN | H | H | H | H | P29 | P1 | H |
| Lₐ₁₄₅₂ | P11 | CN | H | H | H | H | P54 | H | H |
| Lₐ₁₄₅₃ | P11 | CN | H | H | H | H | P96 | H | H |
| Lₐ₁₄₅₄ | P11 | CN | H | H | H | H | P97 | H | H |
| Lₐ₁₄₅₅ | P11 | CN | H | H | H | H | P96 | P1 | H |
| Lₐ₁₄₅₆ | P11 | CN | H | H | H | H | P97 | P1 | H |
| Lₐ₁₄₅₇ | P11 | CN | H | H | H | H | P102 | H | H |
| Lₐ₁₄₅₈ | P11 | CN | H | H | H | H | P103 | H | H |
| Lₐ₁₄₅₉ | P11 | CN | H | H | D | H | P20 | P1 | H |
| Lₐ₁₄₆₀ | P11 | CN | H | H | D | H | P21 | P2 | H |
| Lₐ₁₄₆₁ | P11 | CN | H | H | D | H | P29 | H | H |
| Lₐ₁₄₆₂ | P11 | CN | H | H | D | H | P29 | P1 | H |
| Lₐ₁₄₆₃ | P11 | CN | H | H | D | H | P54 | H | H |
| Lₐ₁₄₆₄ | P11 | CN | H | H | D | H | P96 | H | H |
| Lₐ₁₄₆₅ | P11 | CN | H | H | D | H | P97 | H | H |
| Lₐ₁₄₆₆ | P11 | CN | H | H | D | H | P96 | P1 | H |
| Lₐ₁₄₆₇ | P11 | CN | H | H | D | H | P97 | P1 | H |
| Lₐ₁₄₆₈ | P11 | CN | H | H | D | H | P102 | H | H |
| Lₐ₁₄₆₉ | P11 | CN | H | H | D | H | P103 | H | H |
| Lₐ₁₄₇₀ | P11 | CN | H | H | P20 | H | P20 | P1 | H |
| Lₐ₁₄₇₁ | P11 | CN | H | H | P20 | H | P21 | P2 | H |
| Lₐ₁₄₇₂ | P11 | CN | H | H | P20 | H | P29 | H | H |
| Lₐ₁₄₇₃ | P11 | CN | H | H | P20 | H | P29 | P1 | H |
| Lₐ₁₄₇₄ | P11 | CN | H | H | P20 | H | P54 | H | H |
| Lₐ₁₄₇₅ | P11 | CN | H | H | P20 | H | P96 | H | H |
| Lₐ₁₄₇₆ | P11 | CN | H | H | P20 | H | P97 | H | H |
| Lₐ₁₄₇₇ | P11 | CN | H | H | P20 | H | P96 | P1 | H |
| Lₐ₁₄₇₈ | P11 | CN | H | H | P20 | H | P97 | P1 | H |
| Lₐ₁₄₇₉ | P11 | CN | H | H | P20 | H | P102 | H | H |
| Lₐ₁₄₈₀ | P11 | CN | H | H | P20 | H | P103 | H | H |
| Lₐ₁₄₈₁ | P11 | CN | H | H | P21 | H | P20 | P1 | H |
| Lₐ₁₄₈₂ | P11 | CN | H | H | P21 | H | P21 | P2 | H |
| Lₐ₁₄₈₃ | P11 | CN | H | H | P21 | H | P29 | H | H |
| Lₐ₁₄₈₄ | P11 | CN | H | H | P21 | H | P29 | P1 | H |
| Lₐ₁₄₈₅ | P11 | CN | H | H | P21 | H | P54 | H | H |
| Lₐ₁₄₈₆ | P11 | CN | H | H | P21 | H | P96 | H | H |
| Lₐ₁₄₈₇ | P11 | CN | H | H | P21 | H | P97 | H | H |
| Lₐ₁₄₈₈ | P11 | CN | H | H | P21 | H | P96 | P1 | H |
| Lₐ₁₄₈₉ | P11 | CN | H | H | P21 | H | P97 | P1 | H |
| Lₐ₁₄₉₀ | P11 | CN | H | H | P21 | H | P102 | H | H |
| Lₐ₁₄₉₁ | P11 | CN | H | H | P21 | H | P103 | H | H |
| Lₐ₁₄₉₂ | P11 | CN | H | H | P22 | H | H | H | H |
| Lₐ₁₄₉₃ | P11 | CN | H | H | P23 | H | H | H | H |
| Lₐ₁₄₉₄ | P11 | CN | H | H | P24 | H | H | H | H |
| Lₐ₁₄₉₅ | P11 | CN | H | H | P25 | H | H | H | H |
| Lₐ₁₄₉₆ | P11 | CN | H | H | P26 | H | H | H | H |
| Lₐ₁₄₉₇ | P11 | CN | H | H | P27 | H | H | H | H |
| Lₐ₁₄₉₈ | P11 | CN | H | H | P28 | H | H | H | H |
| Lₐ₁₄₉₉ | P11 | CN | H | H | P29 | H | H | H | H |
| Lₐ₁₅₀₀ | P11 | CN | H | H | P30 | H | H | H | H |
| Lₐ₁₅₀₁ | P11 | CN | H | H | P31 | H | H | H | H |
| Lₐ₁₅₀₂ | P11 | CN | H | H | P32 | H | H | H | H |
| Lₐ₁₅₀₃ | P11 | CN | H | H | P33 | H | H | H | H |
| Lₐ₁₅₀₄ | P11 | CN | H | H | P34 | H | H | H | H |
| Lₐ₁₅₀₅ | P11 | CN | H | H | P35 | H | H | H | H |
| Lₐ₁₅₀₆ | P11 | CN | H | H | P36 | H | H | H | H |
| Lₐ₁₅₀₇ | P11 | CN | H | H | P37 | H | H | H | H |
| Lₐ₁₅₀₈ | P11 | CN | H | H | P38 | H | H | H | H |
| Lₐ₁₅₀₉ | P11 | CN | H | H | P39 | H | H | H | H |
| Lₐ₁₅₁₀ | P11 | CN | H | H | P40 | H | H | H | H |
| Lₐ₁₅₁₁ | P11 | CN | H | H | P41 | H | H | H | H |
| Lₐ₁₅₁₂ | P11 | CN | H | H | P42 | H | H | H | H |
| Lₐ₁₅₁₃ | P11 | CN | H | H | P43 | H | H | H | H |
| Lₐ₁₅₁₄ | P11 | CN | H | H | P44 | H | H | H | H |
| Lₐ₁₅₁₅ | P11 | CN | H | H | P45 | H | H | H | H |
| Lₐ₁₅₁₆ | P11 | CN | H | H | P46 | H | H | H | H |
| Lₐ₁₅₁₇ | P11 | CN | H | H | P47 | H | H | H | H |
| Lₐ₁₅₁₈ | P11 | CN | H | H | P48 | H | H | H | H |
| Lₐ₁₅₁₉ | P11 | CN | H | H | P49 | H | H | H | H |
| Lₐ₁₅₂₀ | P11 | CN | H | H | P50 | H | H | H | H |
| Lₐ₁₅₂₁ | P11 | CN | H | H | P51 | H | H | H | H |
| Lₐ₁₅₂₂ | P11 | CN | H | H | P52 | H | H | H | H |
| Lₐ₁₅₂₃ | P11 | CN | H | H | P53 | H | H | H | H |
| Lₐ₁₅₂₄ | P11 | CN | H | H | P55 | H | H | H | H |
| Lₐ₁₅₂₅ | P11 | CN | H | H | P56 | H | H | H | H |
| Lₐ₁₅₂₆ | P11 | CN | H | H | P57 | H | H | H | H |
| Lₐ₁₅₂₇ | P11 | CN | H | H | P58 | H | H | H | H |
| Lₐ₁₅₂₈ | P11 | CN | H | H | P59 | H | H | H | H |
| Lₐ₁₅₂₉ | P11 | CN | H | H | P60 | H | H | H | H |
| Lₐ₁₅₃₀ | P11 | CN | H | H | P61 | H | H | H | H |
| Lₐ₁₅₃₁ | P11 | CN | H | H | P62 | H | H | H | H |
| Lₐ₁₅₃₂ | P11 | CN | H | H | P63 | H | H | H | H |
| Lₐ₁₅₃₃ | P11 | CN | H | H | P64 | H | H | H | H |
| Lₐ₁₅₃₄ | P11 | CN | H | H | P65 | H | H | H | H |
| Lₐ₁₅₃₅ | P11 | CN | H | H | P66 | H | H | H | H |
| Lₐ₁₅₃₆ | P11 | CN | H | H | P67 | H | H | H | H |
| Lₐ₁₅₃₇ | P11 | CN | H | H | P68 | H | H | H | H |
| Lₐ₁₅₃₈ | P11 | CN | H | H | P69 | H | H | H | H |
| Lₐ₁₅₃₉ | P11 | CN | H | H | P70 | H | H | H | H |
| Lₐ₁₅₄₀ | P11 | CN | H | H | P71 | H | H | H | H |
| Lₐ₁₅₄₁ | P11 | CN | H | H | P72 | H | H | H | H |
| Lₐ₁₅₄₂ | P11 | CN | H | H | P73 | H | H | H | H |
| Lₐ₁₅₄₃ | P11 | CN | H | H | P74 | H | H | H | H |
| Lₐ₁₅₄₄ | P11 | CN | H | H | P75 | H | H | H | H |
| Lₐ₁₅₄₅ | P11 | CN | H | H | P76 | H | H | H | H |
| Lₐ₁₅₄₆ | P11 | CN | H | H | P77 | H | H | H | H |
| Lₐ₁₅₄₇ | P11 | CN | H | H | P78 | H | H | H | H |
| Lₐ₁₅₄₈ | P11 | CN | H | H | P79 | H | H | H | H |
| Lₐ₁₅₄₉ | P11 | CN | H | H | P80 | H | H | H | H |
| Lₐ₁₅₅₀ | P11 | CN | H | H | P81 | H | H | H | H |
| Lₐ₁₅₅₁ | P11 | CN | H | H | P82 | H | H | H | H |
| Lₐ₁₅₅₂ | P11 | CN | H | H | P83 | H | H | H | H |
| Lₐ₁₅₅₃ | P11 | CN | H | H | P84 | H | H | H | H |
| Lₐ₁₅₅₄ | P11 | CN | H | H | P85 | H | H | H | H |
| Lₐ₁₅₅₅ | P11 | CN | H | H | P86 | H | H | H | H |
| Lₐ₁₅₅₆ | P11 | CN | H | H | P87 | H | H | H | H |
| Lₐ₁₅₅₇ | P11 | CN | H | H | P88 | H | H | H | H |
| Lₐ₁₅₅₈ | P11 | CN | H | H | P89 | H | H | H | H |
| Lₐ₁₅₅₉ | P11 | CN | H | H | P90 | H | H | H | H |
| Lₐ₁₅₆₀ | P11 | CN | H | H | P91 | H | H | H | H |
| Lₐ₁₅₆₁ | P11 | CN | H | H | P92 | H | H | H | H |
| Lₐ₁₅₆₂ | P11 | CN | H | H | P93 | H | H | H | H |
| Lₐ₁₅₆₃ | P11 | CN | H | H | P94 | H | H | H | H |
| Lₐ₁₅₆₄ | P11 | CN | H | H | P95 | H | H | H | H |
| Lₐ₁₅₆₅ | P11 | CN | H | H | P98 | H | H | H | H |
| Lₐ₁₅₆₆ | P11 | CN | H | H | P99 | H | H | H | H |
| Lₐ₁₅₆₇ | P11 | CN | H | H | P100 | H | H | H | H |
| Lₐ₁₅₆₈ | P11 | CN | H | H | P101 | H | H | H | H |
| Lₐ₁₅₆₉ | P11 | CN | H | H | P102 | H | H | H | H |
| Lₐ₁₅₇₀ | P11 | CN | H | H | P103 | H | H | H | H |
| Lₐ₁₅₇₁ | P11 | CN | H | H | P104 | H | H | H | H |
| Lₐ₁₅₇₂ | P11 | CN | H | H | P105 | H | H | H | H |
| Lₐ₁₅₇₃ | P11 | CN | H | H | P106 | H | H | H | H |
| Lₐ₁₅₇₄ | P11 | CN | H | H | P107 | H | H | H | H |
| Lₐ₁₅₇₅ | P11 | CN | H | H | P108 | H | H | H | H |
| Lₐ₁₅₇₆ | P11 | CN | H | H | P109 | H | H | H | H |
| Lₐ₁₅₇₇ | P11 | CN | H | H | P110 | H | H | H | H |
| Lₐ₁₅₇₈ | P11 | CN | H | H | P111 | H | H | H | H |
| Lₐ₁₅₇₉ | P11 | CN | H | H | P112 | H | H | H | H |
| Lₐ₁₅₈₀ | P11 | CN | H | H | P113 | H | H | H | H |
| Lₐ₁₅₈₁ | P11 | CN | H | H | P114 | H | H | H | H |
| Lₐ₁₅₈₂ | P11 | CN | H | H | P115 | H | H | H | H |
| Lₐ₁₅₈₃ | P11 | CN | H | H | P116 | H | H | H | H |
| Lₐ₁₅₈₄ | P11 | CN | H | H | P117 | H | H | H | H |
| Lₐ₁₅₈₅ | P11 | CN | H | H | P118 | H | H | H | H |
| Lₐ₁₅₈₆ | P11 | CN | H | H | P119 | H | H | H | H |
| Lₐ₁₅₈₇ | P11 | CN | H | H | P120 | H | H | H | H |
| Lₐ₁₅₈₈ | P11 | CN | H | H | P121 | H | H | H | H |
| Lₐ₁₅₈₉ | P11 | CN | H | H | P122 | H | H | H | H |
| Lₐ₁₅₉₀ | P11 | CN | H | H | P123 | H | H | H | H |
| Lₐ₁₅₉₁ | P11 | CN | H | H | P124 | H | H | H | H |
| Lₐ₁₅₉₂ | P11 | CN | H | H | P125 | H | H | H | H |
| Lₐ₁₅₉₃ | P11 | CN | H | H | P126 | H | H | H | H |
| Lₐ₁₅₉₄ | P11 | CN | H | H | P127 | H | H | H | H |
| Lₐ₁₅₉₅ | P11 | CN | H | H | P128 | H | H | H | H |
| Lₐ₁₅₉₆ | P11 | CN | H | H | P129 | H | H | H | H |
| Lₐ₁₅₉₇ | P11 | CN | H | H | P130 | H | H | H | H |
| Lₐ₁₅₉₈ | P11 | CN | H | H | P131 | H | H | H | H |
| Lₐ₁₅₉₉ | P11 | CN | H | H | P132 | H | H | H | H |
| Lₐ₁₆₀₀ | P11 | CN | H | H | P133 | H | H | H | H |
| Lₐ₁₆₀₁ | P11 | CN | H | H | P134 | H | H | H | H |
| Lₐ₁₆₀₂ | P11 | CN | H | H | P135 | H | H | H | H |
| Lₐ₁₆₀₃ | P11 | CN | H | H | P136 | H | H | H | H |
| Lₐ₁₆₀₄ | P11 | CN | H | H | P137 | H | H | H | H |
| Lₐ₁₆₀₅ | P11 | CN | H | H | P138 | H | H | H | H |
| Lₐ₁₆₀₆ | P11 | CN | H | H | P139 | H | H | H | H |
| Lₐ₁₆₀₇ | P11 | CN | H | H | P140 | H | H | H | H |
| Lₐ₁₆₀₈ | P11 | CN | H | H | P141 | H | H | H | H |
| Lₐ₁₆₀₉ | P11 | CN | H | H | P142 | H | H | H | H |
| Lₐ₁₆₁₀ | P11 | CN | H | H | P143 | H | H | H | H |
| Lₐ₁₆₁₁ | P11 | CN | H | H | P144 | H | H | H | H |
| Lₐ₁₆₁₂ | P11 | CN | H | H | P145 | H | H | H | H |
| Lₐ₁₆₁₃ | P11 | CN | H | H | P146 | H | H | H | H |
| Lₐ₁₆₁₄ | P11 | CN | H | H | P147 | H | H | H | H |
| Lₐ₁₆₁₅ | P11 | CN | H | H | P148 | H | H | H | H |
| Lₐ₁₆₁₆ | P11 | CN | H | H | P149 | H | H | H | H |
| Lₐ₁₆₁₇ | P11 | CN | H | H | P150 | H | H | H | H |
| Lₐ₁₆₁₈ | P11 | CN | H | H | P151 | H | H | H | H |
| Lₐ₁₆₁₉ | P11 | CN | H | P18 | H | H | H | H | H |
| Lₐ₁₆₂₀ | P11 | CN | H | P18 | D | H | H | H | H |
| Lₐ₁₆₂₁ | P11 | CN | H | P18 | P20 | H | H | H | H |
| Lₐ₁₆₂₂ | P11 | CN | H | P19 | H | H | H | H | H |
| Lₐ₁₆₂₃ | P11 | CN | H | P19 | D | H | H | H | H |
| Lₐ₁₆₂₄ | P11 | CN | H | P19 | P20 | H | H | H | H |
| Lₐ₁₆₂₅ | P11 | CN | H | P20 | H | H | H | H | H |
| Lₐ₁₆₂₆ | P11 | CN | H | P20 | D | H | H | H | H |
| Lₐ₁₆₂₇ | P11 | CN | H | P20 | H | H | P1 | H | H |
| Lₐ₁₆₂₈ | P11 | CN | H | P20 | D | H | P2 | H | H |
| Lₐ₁₆₂₉ | P11 | CN | H | P20 | H | H | H | P1 | H |
| Lₐ₁₆₃₀ | P11 | CN | H | P20 | D | H | H | P2 | H |
| Lₐ₁₆₃₁ | P11 | CN | H | P20 | H | H | P1 | P1 | H |
| Lₐ₁₆₃₂ | P11 | CN | H | P20 | D | H | P2 | P2 | H |
| Lₐ₁₆₃₃ | P11 | CN | H | P20 | H | H | P3 | H | H |
| Lₐ₁₆₃₄ | P11 | CN | H | P20 | D | H | P4 | H | H |
| Lₐ₁₆₃₅ | P11 | CN | H | P20 | H | H | P5 | H | H |
| Lₐ₁₆₃₆ | P11 | CN | H | P21 | H | H | H | H | H |
| Lₐ₁₆₃₇ | P11 | CN | H | P21 | D | H | H | H | H |
| Lₐ₁₆₃₈ | P11 | CN | H | P21 | H | H | P1 | H | H |
| Lₐ₁₆₃₉ | P11 | CN | H | P21 | D | H | P2 | H | H |
| Lₐ₁₆₄₀ | P11 | CN | H | P21 | H | H | H | P1 | H |
| Lₐ₁₆₄₁ | P11 | CN | H | P21 | D | H | H | P2 | H |
| Lₐ₁₆₄₂ | P11 | CN | H | P21 | H | H | P1 | P1 | H |
| Lₐ₁₆₄₃ | P11 | CN | H | P21 | D | H | P2 | P2 | H |
| Lₐ₁₆₄₄ | P11 | CN | H | P21 | H | H | P3 | H | H |
| Lₐ₁₆₄₅ | P11 | CN | H | P21 | D | H | P4 | H | H |
| Lₐ₁₆₄₆ | P11 | CN | H | P21 | H | H | P5 | H | H |
| Lₐ₁₆₄₇ | P10 | CN | H | H | H | H | H | H | H |
| Lₐ₁₆₄₈ | P10 | CN | H | H | D | H | H | H | H |
| Lₐ₁₆₄₉ | P10 | CN | H | H | P20 | H | H | H | H |
| Lₐ₁₆₅₀ | P10 | CN | H | H | P21 | H | H | H | H |
| Lₐ₁₆₅₁ | P10 | CN | H | H | P54 | H | H | H | H |
| Lₐ₁₆₅₂ | P10 | CN | H | H | P55 | H | H | H | H |
| Lₐ₁₆₅₃ | P10 | CN | H | H | P56 | H | H | H | H |
| Lₐ₁₆₅₄ | P10 | CN | H | H | P57 | H | H | H | H |
| Lₐ₁₆₅₅ | P10 | CN | H | H | P20 | H | P1 | H | H |
| Lₐ₁₆₅₆ | P10 | CN | H | H | P20 | H | P3 | H | H |
| Lₐ₁₆₅₇ | P10 | CN | H | H | P20 | H | P4 | H | H |
| Lₐ₁₆₅₈ | P10 | CN | H | H | P20 | H | P6 | H | H |
| Lₐ₁₆₅₉ | P10 | CN | H | H | P20 | H | P8 | H | H |
| Lₐ₁₆₆₀ | P10 | CN | H | H | P20 | H | P10 | H | H |
| Lₐ₁₆₆₁ | P10 | CN | H | H | P20 | H | P1 | F | H |
| Lₐ₁₆₆₂ | P10 | CN | H | H | P20 | H | P2 | F | H |
| Lₐ₁₆₆₃ | P10 | CN | H | H | P20 | H | P10 | F | H |
| Lₐ₁₆₆₄ | P10 | CN | H | H | P20 | H | F | P1 | H |
| Lₐ₁₆₆₅ | P10 | CN | H | H | P20 | H | F | P2 | H |
| Lₐ₁₆₆₆ | P10 | CN | H | H | P20 | H | F | P10 | H |
| Lₐ₁₆₆₇ | P10 | CN | H | H | P21 | H | P2 | P2 | H |
| Lₐ₁₆₆₈ | P10 | CN | H | H | P21 | H | P5 | H | H |
| Lₐ₁₆₆₉ | P10 | CN | H | H | P21 | H | P9 | H | H |
| Lₐ₁₆₇₀ | P10 | CN | H | H | P21 | H | P11 | H | H |
| Lₐ₁₆₇₁ | P10 | CN | H | H | P21 | H | P1 | F | H |
| Lₐ₁₆₇₂ | P10 | CN | H | H | P21 | H | P2 | F | H |
| Lₐ₁₆₇₃ | P10 | CN | H | H | P21 | H | P11 | F | H |
| Lₐ₁₆₇₄ | P10 | CN | H | H | P21 | H | F | P1 | H |
| Lₐ₁₆₇₅ | P10 | CN | H | H | P21 | H | F | P2 | H |
| Lₐ₁₆₇₆ | P10 | CN | H | H | P21 | H | F | P11 | H |
| Lₐ₁₆₇₇ | P10 | CN | H | H | P96 | H | H | H | H |
| Lₐ₁₆₇₈ | P10 | CN | H | H | P97 | H | H | H | H |
| Lₐ₁₆₇₉ | P10 | CN | H | H | P102 | H | H | H | H |
| Lₐ₁₆₈₀ | P10 | CN | H | H | P103 | H | H | H | H |
| Lₐ₁₆₈₁ | P7 | CN | H | H | P20 | H | H | H | H |
| Lₐ₁₆₈₂ | P7 | CN | H | H | P21 | H | H | H | H |
| Lₐ₁₆₈₃ | P7 | CN | H | H | P54 | H | H | H | H |
| Lₐ₁₆₈₄ | P7 | CN | H | H | P96 | H | H | H | H |
| Lₐ₁₆₈₅ | P7 | CN | H | H | P97 | H | H | H | H |
| Lₐ₁₆₈₆ | P14 | CN | H | H | P20 | H | H | H | H |
| Lₐ₁₆₈₇ | P14 | CN | H | H | P21 | H | H | H | H |
| Lₐ₁₆₈₈ | P14 | CN | H | H | P54 | H | H | H | H |
| Lₐ₁₆₈₉ | P14 | CN | H | H | P96 | H | H | H | H |
| Lₐ₁₆₉₀ | P14 | CN | H | H | P97 | H | H | H | H |
| Lₐ₁₆₉₁ | P6 | F | H | H | H | H | H | H | H |
| Lₐ₁₆₉₂ | P6 | F | H | H | H | H | P1 | H | H |
| Lₐ₁₆₉₃ | P6 | F | H | H | H | H | P2 | H | H |
| Lₐ₁₆₉₄ | P6 | F | H | H | H | H | P3 | H | H |
| Lₐ₁₆₉₅ | P6 | F | H | H | H | H | P4 | H | H |
| Lₐ₁₆₉₆ | P6 | F | H | H | H | H | P5 | H | H |
| Lₐ₁₆₉₇ | P6 | F | H | H | H | H | P6 | H | H |
| Lₐ₁₆₉₈ | P6 | F | H | H | H | H | P7 | H | H |
| Lₐ₁₆₉₉ | P6 | F | H | H | H | H | P8 | H | H |
| Lₐ₁₇₀₀ | P6 | F | H | H | H | H | P9 | H | H |
| Lₐ₁₇₀₁ | P6 | F | H | H | H | H | P10 | H | H |
| Lₐ₁₇₀₂ | P6 | F | H | H | H | H | P11 | H | H |
| Lₐ₁₇₀₃ | P6 | F | H | H | H | H | P12 | H | H |
| Lₐ₁₇₀₄ | P6 | F | H | H | H | H | P13 | H | H |
| Lₐ₁₇₀₅ | P6 | F | H | H | H | H | P14 | H | H |
| Lₐ₁₇₀₆ | P6 | F | H | H | H | H | P15 | H | H |
| Lₐ₁₇₀₇ | P6 | F | H | H | H | H | P16 | H | H |
| Lₐ₁₇₀₈ | P6 | F | H | H | H | H | P17 | H | H |
| Lₐ₁₇₀₉ | P6 | F | H | H | H | H | P18 | H | H |
| Lₐ₁₇₁₀ | P6 | F | H | H | H | H | P19 | H | H |
| Lₐ₁₇₁₁ | P6 | F | H | H | H | H | P20 | H | H |
| Lₐ₁₇₁₂ | P6 | F | H | H | H | H | P21 | H | H |
| Lₐ₁₇₁₃ | P6 | F | H | H | H | H | P1 | F | H |
| Lₐ₁₇₁₄ | P6 | F | H | H | H | H | P2 | F | H |
| Lₐ₁₇₁₅ | P6 | F | H | H | H | H | P3 | F | H |
| Lₐ₁₇₁₆ | P6 | F | H | H | H | H | P4 | F | H |
| Lₐ₁₇₁₇ | P6 | F | H | H | H | H | P5 | F | H |
| Lₐ₁₇₁₈ | P6 | F | H | H | H | H | P6 | F | H |
| Lₐ₁₇₁₉ | P6 | F | H | H | H | H | P7 | F | H |
| Lₐ₁₇₂₀ | P6 | F | H | H | H | H | P8 | F | H |
| Lₐ₁₇₂₁ | P6 | F | H | H | H | H | P9 | F | H |
| Lₐ₁₇₂₂ | P6 | F | H | H | H | H | P10 | F | H |
| Lₐ₁₇₂₃ | P6 | F | H | H | H | H | P11 | F | H |
| Lₐ₁₇₂₄ | P6 | F | H | H | H | H | P12 | F | H |
| Lₐ₁₇₂₅ | P6 | F | H | H | H | H | P13 | F | H |
| Lₐ₁₇₂₆ | P6 | F | H | H | H | H | P14 | F | H |
| Lₐ₁₇₂₇ | P6 | F | H | H | H | H | P15 | F | H |
| Lₐ₁₇₂₈ | P6 | F | H | H | H | H | P16 | F | H |
| Lₐ₁₇₂₉ | P6 | F | H | H | H | H | P17 | F | H |
| Lₐ₁₇₃₀ | P6 | F | H | H | H | H | P18 | F | H |
| Lₐ₁₇₃₁ | P6 | F | H | H | H | H | P19 | F | H |
| Lₐ₁₇₃₂ | P6 | F | H | H | H | H | P20 | F | H |
| Lₐ₁₇₃₃ | P6 | F | H | H | H | H | P21 | F | H |
| Lₐ₁₇₃₄ | P6 | F | H | H | H | H | H | P1 | H |
| Lₐ₁₇₃₅ | P6 | F | H | H | H | H | H | P2 | H |
| Lₐ₁₇₃₆ | P6 | F | H | H | H | H | H | P3 | H |
| Lₐ₁₇₃₇ | P6 | F | H | H | H | H | H | P4 | H |
| Lₐ₁₇₃₈ | P6 | F | H | H | H | H | H | P5 | H |
| Lₐ₁₇₃₉ | P6 | F | H | H | H | H | H | P6 | H |
| Lₐ₁₇₄₀ | P6 | F | H | H | H | H | H | P7 | H |
| Lₐ₁₇₄₁ | P6 | F | H | H | H | H | H | P8 | H |
| Lₐ₁₇₄₂ | P6 | F | H | H | H | H | H | P9 | H |
| Lₐ₁₇₄₃ | P6 | F | H | H | H | H | H | P10 | H |
| Lₐ₁₇₄₄ | P6 | F | H | H | H | H | H | P11 | H |
| Lₐ₁₇₄₅ | P6 | F | H | H | H | H | H | P12 | H |
| Lₐ₁₇₄₆ | P6 | F | H | H | H | H | H | P13 | H |
| Lₐ₁₇₄₇ | P6 | F | H | H | H | H | H | P14 | H |
| Lₐ₁₇₄₈ | P6 | F | H | H | H | H | H | P15 | H |
| Lₐ₁₇₄₉ | P6 | F | H | H | H | H | H | P16 | H |
| Lₐ₁₇₅₀ | P6 | F | H | H | H | H | H | P17 | H |
| Lₐ₁₇₅₁ | P6 | F | H | H | H | H | H | P18 | H |
| Lₐ₁₇₅₂ | P6 | F | H | H | H | H | H | P19 | H |
| Lₐ₁₇₅₃ | P6 | F | H | H | H | H | H | P20 | H |
| Lₐ₁₇₅₄ | P6 | F | H | H | H | H | H | P21 | H |
| Lₐ₁₇₅₅ | P6 | F | H | H | H | H | F | P1 | H |
| Lₐ₁₇₅₆ | P6 | F | H | H | H | H | F | P2 | H |
| Lₐ₁₇₅₇ | P6 | F | H | H | H | H | F | P3 | H |
| Lₐ₁₇₅₈ | P6 | F | H | H | H | H | F | P4 | H |
| Lₐ₁₇₅₉ | P6 | F | H | H | H | H | F | P5 | H |
| Lₐ₁₇₆₀ | P6 | F | H | H | H | H | F | P6 | H |
| Lₐ₁₇₆₁ | P6 | F | H | H | H | H | F | P7 | H |
| Lₐ₁₇₆₂ | P6 | F | H | H | H | H | F | P8 | H |
| Lₐ₁₇₆₃ | P6 | F | H | H | H | H | F | P9 | H |
| Lₐ₁₇₆₄ | P6 | F | H | H | H | H | F | P10 | H |
| Lₐ₁₇₆₅ | P6 | F | H | H | H | H | F | P11 | H |
| Lₐ₁₇₆₆ | P6 | F | H | H | H | H | F | P12 | H |
| Lₐ₁₇₆₇ | P6 | F | H | H | H | H | F | P13 | H |
| Lₐ₁₇₆₈ | P6 | F | H | H | H | H | F | P14 | H |
| Lₐ₁₇₆₉ | P6 | F | H | H | H | H | F | P15 | H |
| Lₐ₁₇₇₀ | P6 | F | H | H | H | H | F | P16 | H |
| Lₐ₁₇₇₁ | P6 | F | H | H | H | H | F | P17 | H |
| Lₐ₁₇₇₂ | P6 | F | H | H | H | H | F | P18 | H |
| Lₐ₁₇₇₃ | P6 | F | H | H | H | H | F | P19 | H |
| Lₐ₁₇₇₄ | P6 | F | H | H | H | H | F | P20 | H |
| Lₐ₁₇₇₅ | P6 | F | H | H | H | H | F | P21 | H |
| Lₐ₁₇₇₆ | P6 | F | H | H | H | H | P1 | P1 | H |
| Lₐ₁₇₇₇ | P6 | F | H | H | H | H | P1 | P3 | H |
| Lₐ₁₇₇₈ | P6 | F | H | H | H | H | P1 | P8 | H |
| Lₐ₁₇₇₉ | P6 | F | H | H | H | H | P1 | P10 | H |
| Lₐ₁₇₈₀ | P6 | F | H | H | H | H | P1 | P20 | H |
| Lₐ₁₇₈₁ | P6 | F | H | H | H | H | P1 | P21 | H |
| Lₐ₁₇₈₂ | P6 | F | H | H | H | H | P2 | P2 | H |
| Lₐ₁₇₈₃ | P6 | F | H | H | H | H | P2 | P4 | H |
| Lₐ₁₇₈₄ | P6 | F | H | H | H | H | P2 | P5 | H |
| Lₐ₁₇₈₅ | P6 | F | H | H | H | H | P2 | P9 | H |
| Lₐ₁₇₈₆ | P6 | F | H | H | H | H | P2 | P11 | H |
| Lₐ₁₇₈₇ | P6 | F | H | H | H | H | P2 | P20 | H |
| Lₐ₁₇₈₈ | P6 | F | H | H | H | H | P2 | P21 | H |
| Lₐ₁₇₈₉ | P6 | F | H | H | H | D | D | D | D |
| Lₐ₁₇₉₀ | P6 | F | H | H | H | D | F | D | D |
| Lₐ₁₇₉₁ | P6 | F | H | H | H | D | D | F | D |
| Lₐ₁₇₉₂ | P6 | F | H | H | H | D | P2 | D | D |
| Lₐ₁₇₉₃ | P6 | F | H | H | H | D | D | P2 | D |
| Lₐ₁₇₉₄ | P6 | F | H | H | H | D | P2 | P2 | D |
| Lₐ₁₇₉₅ | P6 | F | H | H | D | H | H | H | H |
| Lₐ₁₇₉₆ | P6 | F | H | H | D | H | P1 | H | H |
| Lₐ₁₇₉₇ | P6 | F | H | H | D | H | P2 | H | H |
| Lₐ₁₇₉₈ | P6 | F | H | H | D | H | P5 | H | H |
| Lₐ₁₇₉₉ | P6 | F | H | H | D | H | P10 | H | H |
| Lₐ₁₈₀₀ | P6 | F | H | H | D | H | P11 | H | H |
| Lₐ₁₈₀₁ | P6 | F | H | H | D | H | H | P1 | H |
| Lₐ₁₈₀₂ | P6 | F | H | H | D | H | H | P2 | H |
| Lₐ₁₈₀₃ | P6 | F | H | H | D | H | H | P4 | H |
| Lₐ₁₈₀₄ | P6 | F | H | H | D | H | H | P5 | H |
| Lₐ₁₈₀₅ | P6 | F | H | H | D | H | H | P10 | H |
| Lₐ₁₈₀₆ | P6 | F | H | H | D | H | H | P11 | H |
| Lₐ₁₈₀₇ | P6 | F | H | H | D | H | P1 | F | H |
| Lₐ₁₈₀₈ | P6 | F | H | H | D | H | P2 | F | H |
| Lₐ₁₈₀₉ | P6 | F | H | H | D | H | P11 | F | H |
| Lₐ₁₈₁₀ | P6 | F | H | H | D | H | F | P1 | H |
| Lₐ₁₈₁₁ | P6 | F | H | H | D | H | F | P2 | H |
| Lₐ₁₈₁₂ | P6 | F | H | H | D | H | F | P3 | H |
| Lₐ₁₈₁₃ | P6 | F | H | H | D | H | F | P4 | H |
| Lₐ₁₈₁₄ | P6 | F | H | H | D | H | F | P5 | H |
| Lₐ₁₈₁₅ | P6 | F | H | H | D | H | F | P8 | H |
| Lₐ₁₈₁₆ | P6 | F | H | H | D | H | F | P11 | H |
| Lₐ₁₈₁₇ | P6 | F | H | H | D | H | P1 | P1 | H |
| Lₐ₁₈₁₈ | P6 | F | H | H | D | H | P2 | P2 | H |
| Lₐ₁₈₁₉ | P6 | F | H | H | D | H | P2 | P2 | D |
| Lₐ₁₈₂₀ | P6 | F | H | H | P20 | H | H | H | H |
| Lₐ₁₈₂₁ | P6 | F | H | H | P20 | H | P1 | H | H |
| Lₐ₁₈₂₂ | P6 | F | H | H | P20 | H | P2 | H | H |
| Lₐ₁₈₂₃ | P6 | F | H | H | P20 | H | P3 | H | H |
| Lₐ₁₈₂₄ | P6 | F | H | H | P20 | H | P4 | H | H |
| Lₐ₁₈₂₅ | P6 | F | H | H | P20 | H | P5 | H | H |
| Lₐ₁₈₂₆ | P6 | F | H | H | P20 | H | P6 | H | H |
| Lₐ₁₈₂₇ | P6 | F | H | H | P20 | H | P7 | H | H |
| Lₐ₁₈₂₈ | P6 | F | H | H | P20 | H | P8 | H | H |
| Lₐ₁₈₂₉ | P6 | F | H | H | P20 | H | P9 | H | H |
| Lₐ₁₈₃₀ | P6 | F | H | H | P20 | H | P10 | H | H |
| Lₐ₁₈₃₁ | P6 | F | H | H | P20 | H | P11 | H | H |
| Lₐ₁₈₃₂ | P6 | F | H | H | P20 | H | P12 | H | H |
| Lₐ₁₈₃₃ | P6 | F | H | H | P20 | H | P13 | H | H |
| Lₐ₁₈₃₄ | P6 | F | H | H | P20 | H | P14 | H | H |
| Lₐ₁₈₃₅ | P6 | F | H | H | P20 | H | P15 | H | H |
| Lₐ₁₈₃₆ | P6 | F | H | H | P20 | H | P16 | H | H |
| Lₐ₁₈₃₇ | P6 | F | H | H | P20 | H | P17 | H | H |
| Lₐ₁₈₃₈ | P6 | F | H | H | P20 | H | P18 | H | H |
| Lₐ₁₈₃₉ | P6 | F | H | H | P20 | H | P19 | H | H |
| Lₐ₁₈₄₀ | P6 | F | H | H | P20 | H | P20 | H | H |
| Lₐ₁₈₄₁ | P6 | F | H | H | P20 | H | P21 | H | H |
| Lₐ₁₈₄₂ | P6 | F | H | H | P20 | H | H | P1 | H |
| Lₐ₁₈₄₃ | P6 | F | H | H | P20 | H | H | P2 | H |
| Lₐ₁₈₄₄ | P6 | F | H | H | P20 | H | H | P3 | H |
| Lₐ₁₈₄₅ | P6 | F | H | H | P20 | H | H | P4 | H |
| Lₐ₁₈₄₆ | P6 | F | H | H | P20 | H | H | P5 | H |
| Lₐ₁₈₄₇ | P6 | F | H | H | P20 | H | H | P6 | H |
| Lₐ₁₈₄₈ | P6 | F | H | H | P20 | H | H | P7 | H |
| Lₐ₁₈₄₉ | P6 | F | H | H | P20 | H | H | P8 | H |
| Lₐ₁₈₅₀ | P6 | F | H | H | P20 | H | H | P9 | H |
| Lₐ₁₈₅₁ | P6 | F | H | H | P20 | H | H | P10 | H |
| Lₐ₁₈₅₂ | P6 | F | H | H | P20 | H | H | P11 | H |
| Lₐ₁₈₅₃ | P6 | F | H | H | P20 | H | H | P12 | H |
| Lₐ₁₈₅₄ | P6 | F | H | H | P20 | H | H | P15 | H |
| Lₐ₁₈₅₅ | P6 | F | H | H | P20 | H | H | P17 | H |
| Lₐ₁₈₅₆ | P6 | F | H | H | P20 | H | H | P18 | H |
| Lₐ₁₈₅₇ | P6 | F | H | H | P20 | H | H | P19 | H |
| Lₐ₁₈₅₈ | P6 | F | H | H | P20 | H | H | P20 | H |
| Lₐ₁₈₅₉ | P6 | F | H | H | P20 | H | H | P21 | H |
| Lₐ₁₈₆₀ | P6 | F | H | H | P20 | H | F | H | H |
| Lₐ₁₈₆₁ | P6 | F | H | H | P20 | H | F | P1 | H |
| Lₐ₁₈₆₂ | P6 | F | H | H | P20 | H | F | P2 | H |
| Lₐ₁₈₆₃ | P6 | F | H | H | P20 | H | F | P3 | H |
| Lₐ₁₈₆₄ | P6 | F | H | H | P20 | H | F | P4 | H |
| Lₐ₁₈₆₅ | P6 | F | H | H | P20 | H | F | P5 | H |
| Lₐ₁₈₆₆ | P6 | F | H | H | P20 | H | F | P6 | H |
| Lₐ₁₈₆₇ | P6 | F | H | H | P20 | H | F | P7 | H |
| Lₐ₁₈₆₈ | P6 | F | H | H | P20 | H | F | P8 | H |
| Lₐ₁₈₆₉ | P6 | F | H | H | P20 | H | F | P9 | H |
| Lₐ₁₈₇₀ | P6 | F | H | H | P20 | H | F | P10 | H |
| Lₐ₁₈₇₁ | P6 | F | H | H | P20 | H | F | P11 | H |
| Lₐ₁₈₇₂ | P6 | F | H | H | P20 | H | P1 | F | H |
| Lₐ₁₈₇₃ | P6 | F | H | H | P20 | H | P2 | F | H |
| Lₐ₁₈₇₄ | P6 | F | H | H | P20 | H | P3 | F | H |
| Lₐ₁₈₇₅ | P6 | F | H | H | P20 | H | P4 | F | H |
| Lₐ₁₈₇₆ | P6 | F | H | H | P20 | H | P5 | F | H |
| Lₐ₁₈₇₇ | P6 | F | H | H | P20 | H | P6 | F | H |
| Lₐ₁₈₇₈ | P6 | F | H | H | P20 | H | P7 | F | H |
| Lₐ₁₈₇₉ | P6 | F | H | H | P20 | H | P8 | F | H |
| Lₐ₁₈₈₀ | P6 | F | H | H | P20 | H | P9 | F | H |
| Lₐ₁₈₈₁ | P6 | F | H | H | P20 | H | P10 | F | H |
| Lₐ₁₈₈₂ | P6 | F | H | H | P20 | H | P11 | F | H |
| Lₐ₁₈₈₃ | P6 | F | H | H | P20 | H | P1 | P1 | H |
| Lₐ₁₈₈₄ | P6 | F | H | H | P20 | H | P2 | P2 | H |
| Lₐ₁₈₈₅ | P6 | F | H | H | P20 | D | D | D | D |
| Lₐ₁₈₈₆ | P6 | F | H | H | P20 | D | P2 | P2 | D |
| Lₐ₁₈₈₇ | P6 | F | H | H | P20 | D | F | P4 | D |
| Lₐ₁₈₈₈ | P6 | F | H | H | P20 | D | F | P5 | D |
| Lₐ₁₈₈₉ | P6 | F | H | H | P20 | D | F | P9 | D |
| Lₐ₁₈₉₀ | P6 | F | H | H | P20 | D | F | P11 | D |
| Lₐ₁₈₉₁ | P6 | F | H | H | P21 | H | H | H | H |
| Lₐ₁₈₉₂ | P6 | F | H | H | P21 | H | P1 | H | H |
| Lₐ₁₈₉₃ | P6 | F | H | H | P21 | H | P2 | H | H |
| Lₐ₁₈₉₄ | P6 | F | H | H | P21 | H | P3 | H | H |
| Lₐ₁₈₉₅ | P6 | F | H | H | P21 | H | P4 | H | H |
| Lₐ₁₈₉₆ | P6 | F | H | H | P21 | H | P5 | H | H |
| Lₐ₁₈₉₇ | P6 | F | H | H | P21 | H | P6 | H | H |
| Lₐ₁₈₉₈ | P6 | F | H | H | P21 | H | P7 | H | H |
| Lₐ₁₈₉₉ | P6 | F | H | H | P21 | H | P8 | H | H |
| Lₐ₁₉₀₀ | P6 | F | H | H | P21 | H | P9 | H | H |
| Lₐ₁₉₀₁ | P6 | F | H | H | P21 | H | P10 | H | H |
| Lₐ₁₉₀₂ | P6 | F | H | H | P21 | H | P11 | H | H |
| Lₐ₁₉₀₃ | P6 | F | H | H | P21 | H | P12 | H | H |
| Lₐ₁₉₀₄ | P6 | F | H | H | P21 | H | P13 | H | H |
| Lₐ₁₉₀₅ | P6 | F | H | H | P21 | H | P14 | H | H |
| Lₐ₁₉₀₆ | P6 | F | H | H | P21 | H | P15 | H | H |
| Lₐ₁₉₀₇ | P6 | F | H | H | P21 | H | P16 | H | H |
| Lₐ₁₉₀₈ | P6 | F | H | H | P21 | H | P17 | H | H |
| Lₐ₁₉₀₉ | P6 | F | H | H | P21 | H | P18 | H | H |
| Lₐ₁₉₁₀ | P6 | F | H | H | P21 | H | P19 | H | H |
| Lₐ₁₉₁₁ | P6 | F | H | H | P21 | H | P20 | H | H |
| Lₐ₁₉₁₂ | P6 | F | H | H | P21 | H | P21 | H | H |
| Lₐ₁₉₁₃ | P6 | F | H | H | P21 | H | H | P1 | H |
| Lₐ₁₉₁₄ | P6 | F | H | H | P21 | H | H | P2 | H |
| Lₐ₁₉₁₅ | P6 | F | H | H | P21 | H | H | P3 | H |
| Lₐ₁₉₁₆ | P6 | F | H | H | P21 | H | H | P4 | H |
| Lₐ₁₉₁₇ | P6 | F | H | H | P21 | H | H | P5 | H |
| Lₐ₁₉₁₈ | P6 | F | H | H | P21 | H | H | P6 | H |
| Lₐ₁₉₁₉ | P6 | F | H | H | P21 | H | H | P7 | H |
| Lₐ₁₉₂₀ | P6 | F | H | H | P21 | H | H | P8 | H |
| Lₐ₁₉₂₁ | P6 | F | H | H | P21 | H | H | P9 | H |
| Lₐ₁₉₂₂ | P6 | F | H | H | P21 | H | H | P10 | H |
| Lₐ₁₉₂₃ | P6 | F | H | H | P21 | H | H | P11 | H |
| Lₐ₁₉₂₄ | P6 | F | H | H | P21 | H | H | P12 | H |
| Lₐ₁₉₂₅ | P6 | F | H | H | P21 | H | H | P15 | H |
| Lₐ₁₉₂₆ | P6 | F | H | H | P21 | H | H | P17 | H |
| Lₐ₁₉₂₇ | P6 | F | H | H | P21 | H | H | P18 | H |
| Lₐ₁₉₂₈ | P6 | F | H | H | P21 | H | H | P19 | H |
| Lₐ₁₉₂₉ | P6 | F | H | H | P21 | H | H | P20 | H |
| Lₐ₁₉₃₀ | P6 | F | H | H | P21 | H | H | P21 | H |
| Lₐ₁₉₃₁ | P6 | F | H | H | P21 | H | F | H | H |
| Lₐ₁₉₃₂ | P6 | F | H | H | P21 | H | F | P1 | H |
| Lₐ₁₉₃₃ | P6 | F | H | H | P21 | H | F | P2 | H |
| Lₐ₁₉₃₄ | P6 | F | H | H | P21 | H | F | P3 | H |
| Lₐ₁₉₃₅ | P6 | F | H | H | P21 | H | F | P4 | H |
| Lₐ₁₉₃₆ | P6 | F | H | H | P21 | H | F | P5 | H |
| Lₐ₁₉₃₇ | P6 | F | H | H | P21 | H | F | P6 | H |
| Lₐ₁₉₃₈ | P6 | F | H | H | P21 | H | F | P7 | H |
| Lₐ₁₉₃₉ | P6 | F | H | H | P21 | H | F | P8 | H |
| Lₐ₁₉₄₀ | P6 | F | H | H | P21 | H | F | P9 | H |
| Lₐ₁₉₄₁ | P6 | F | H | H | P21 | H | F | P10 | H |
| Lₐ₁₉₄₂ | P6 | F | H | H | P21 | H | F | P11 | H |
| Lₐ₁₉₄₃ | P6 | F | H | H | P21 | H | P1 | F | H |
| Lₐ₁₉₄₄ | P6 | F | H | H | P21 | H | P2 | F | H |
| Lₐ₁₉₄₅ | P6 | F | H | H | P21 | H | P3 | F | H |
| Lₐ₁₉₄₆ | P6 | F | H | H | P21 | H | P4 | F | H |
| Lₐ₁₉₄₇ | P6 | F | H | H | P21 | H | P5 | F | H |
| Lₐ₁₉₄₈ | P6 | F | H | H | P21 | H | P6 | F | H |
| Lₐ₁₉₄₉ | P6 | F | H | H | P21 | H | P7 | F | H |
| Lₐ₁₉₅₀ | P6 | F | H | H | P21 | H | P8 | F | H |
| Lₐ₁₉₅₁ | P6 | F | H | H | P21 | H | P9 | F | H |
| Lₐ₁₉₅₂ | P6 | F | H | H | P21 | H | P10 | F | H |
| Lₐ₁₉₅₃ | P6 | F | H | H | P21 | H | P11 | F | H |
| Lₐ₁₉₅₄ | P6 | F | H | H | P21 | H | P1 | P1 | H |
| Lₐ₁₉₅₅ | P6 | F | H | H | P21 | H | P2 | P2 | H |
| Lₐ₁₉₅₆ | P6 | F | H | H | P21 | D | D | D | D |
| Lₐ₁₉₅₇ | P6 | F | H | H | P21 | D | P2 | P2 | D |
| Lₐ₁₉₅₈ | P6 | F | H | H | P21 | D | F | P4 | D |
| Lₐ₁₉₅₉ | P6 | F | H | H | P21 | D | F | P5 | D |
| Lₐ₁₉₆₀ | P6 | F | H | H | P21 | D | F | P9 | D |
| Lₐ₁₉₆₁ | P6 | F | H | H | P21 | D | F | P11 | D |
| Lₐ₁₉₆₂ | P6 | F | H | H | P54 | H | H | H | H |
| Lₐ₁₉₆₃ | P6 | F | H | H | P54 | H | P1 | H | H |
| Lₐ₁₉₆₄ | P6 | F | H | H | P54 | H | P2 | H | H |
| Lₐ₁₉₆₅ | P6 | F | H | H | P54 | H | P3 | H | H |
| Lₐ₁₉₆₆ | P6 | F | H | H | P54 | H | P4 | H | H |
| Lₐ₁₉₆₇ | P6 | F | H | H | P54 | H | P5 | H | H |
| Lₐ₁₉₆₈ | P6 | F | H | H | P54 | H | P6 | H | H |
| Lₐ₁₉₆₉ | P6 | F | H | H | P54 | H | P7 | H | H |
| Lₐ₁₉₇₀ | P6 | F | H | H | P54 | H | P8 | H | H |
| Lₐ₁₉₇₁ | P6 | F | H | H | P54 | H | P9 | H | H |
| Lₐ₁₉₇₂ | P6 | F | H | H | P54 | H | P10 | H | H |
| Lₐ₁₉₇₃ | P6 | F | H | H | P54 | H | P11 | H | H |
| Lₐ₁₉₇₄ | P6 | F | H | H | P54 | H | P12 | H | H |
| Lₐ₁₉₇₅ | P6 | F | H | H | P54 | H | P13 | H | H |
| Lₐ₁₉₇₆ | P6 | F | H | H | P54 | H | P14 | H | H |
| Lₐ₁₉₇₇ | P6 | F | H | H | P54 | H | P15 | H | H |
| Lₐ₁₉₇₈ | P6 | F | H | H | P54 | H | P16 | H | H |
| Lₐ₁₉₇₉ | P6 | F | H | H | P54 | H | P17 | H | H |
| Lₐ₁₉₈₀ | P6 | F | H | H | P54 | H | P18 | H | H |
| Lₐ₁₉₈₁ | P6 | F | H | H | P54 | H | P19 | H | H |
| Lₐ₁₉₈₂ | P6 | F | H | H | P54 | H | P20 | H | H |
| Lₐ₁₉₈₃ | P6 | F | H | H | P54 | H | P21 | H | H |
| Lₐ₁₉₈₄ | P6 | F | H | H | P54 | H | H | P1 | H |
| Lₐ₁₉₈₅ | P6 | F | H | H | P54 | H | H | P2 | H |
| Lₐ₁₉₈₆ | P6 | F | H | H | P54 | H | H | P3 | H |
| Lₐ₁₉₈₇ | P6 | F | H | H | P54 | H | H | P4 | H |
| Lₐ₁₉₈₈ | P6 | F | H | H | P54 | H | H | P5 | H |
| Lₐ₁₉₈₉ | P6 | F | H | H | P54 | H | H | P6 | H |
| Lₐ₁₉₉₀ | P6 | F | H | H | P54 | H | H | P7 | H |
| Lₐ₁₉₉₁ | P6 | F | H | H | P54 | H | H | P8 | H |
| Lₐ₁₉₉₂ | P6 | F | H | H | P54 | H | H | P9 | H |
| Lₐ₁₉₉₃ | P6 | F | H | H | P54 | H | H | P10 | H |
| Lₐ₁₉₉₄ | P6 | F | H | H | P54 | H | H | P11 | H |
| Lₐ₁₉₉₅ | P6 | F | H | H | P54 | H | H | P12 | H |
| Lₐ₁₉₉₆ | P6 | F | H | H | P54 | H | H | P15 | H |
| Lₐ₁₉₉₇ | P6 | F | H | H | P54 | H | H | P17 | H |
| Lₐ₁₉₉₈ | P6 | F | H | H | P54 | H | H | P18 | H |
| Lₐ₁₉₉₉ | P6 | F | H | H | P54 | H | H | P19 | H |
| Lₐ₂₀₀₀ | P6 | F | H | H | P54 | H | H | P20 | H |
| Lₐ₂₀₀₁ | P6 | F | H | H | P54 | H | H | P21 | H |
| Lₐ₂₀₀₂ | P6 | F | H | H | P54 | H | F | H | H |
| Lₐ₂₀₀₃ | P6 | F | H | H | P54 | H | F | P1 | H |
| Lₐ₂₀₀₄ | P6 | F | H | H | P54 | H | F | P2 | H |
| Lₐ₂₀₀₅ | P6 | F | H | H | P54 | H | F | P3 | H |
| Lₐ₂₀₀₆ | P6 | F | H | H | P54 | H | F | P4 | H |
| Lₐ₂₀₀₇ | P6 | F | H | H | P54 | H | F | P5 | H |
| Lₐ₂₀₀₈ | P6 | F | H | H | P54 | H | F | P6 | H |
| Lₐ₂₀₀₉ | P6 | F | H | H | P54 | H | F | P7 | H |
| Lₐ₂₀₁₀ | P6 | F | H | H | P54 | H | F | P8 | H |
| Lₐ₂₀₁₁ | P6 | F | H | H | P54 | H | F | P9 | H |
| Lₐ₂₀₁₂ | P6 | F | H | H | P54 | H | F | P10 | H |
| Lₐ₂₀₁₃ | P6 | F | H | H | P54 | H | F | P11 | H |
| Lₐ₂₀₁₄ | P6 | F | H | H | P54 | H | P1 | F | H |
| Lₐ₂₀₁₅ | P6 | F | H | H | P54 | H | P2 | F | H |
| Lₐ₂₀₁₆ | P6 | F | H | H | P54 | H | P3 | F | H |
| Lₐ₂₀₁₇ | P6 | F | H | H | P54 | H | P4 | F | H |
| Lₐ₂₀₁₈ | P6 | F | H | H | P54 | H | P5 | F | H |
| Lₐ₂₀₁₉ | P6 | F | H | H | P54 | H | P6 | F | H |
| Lₐ₂₀₂₀ | P6 | F | H | H | P54 | H | P7 | F | H |
| Lₐ₂₀₂₁ | P6 | F | H | H | P54 | H | P8 | F | H |
| Lₐ₂₀₂₂ | P6 | F | H | H | P54 | H | P9 | F | H |
| Lₐ₂₀₂₃ | P6 | F | H | H | P54 | H | P10 | F | H |
| Lₐ₂₀₂₄ | P6 | F | H | H | P54 | H | P11 | F | H |
| Lₐ₂₀₂₅ | P6 | F | H | H | P54 | H | P1 | P1 | H |
| Lₐ₂₀₂₆ | P6 | F | H | H | P54 | H | P2 | P2 | H |
| Lₐ₂₀₂₇ | P6 | F | H | H | P54 | D | D | D | D |
| Lₐ₂₀₂₈ | P6 | F | H | H | P54 | D | P2 | P2 | D |
| Lₐ₂₀₂₉ | P6 | F | H | H | P54 | D | F | P4 | D |
| Lₐ₂₀₃₀ | P6 | F | H | H | P54 | D | F | P5 | D |
| Lₐ₂₀₃₁ | P6 | F | H | H | P54 | D | F | P9 | D |
| Lₐ₂₀₃₂ | P6 | F | H | H | P54 | D | F | P11 | D |
| Lₐ₂₀₃₃ | P6 | F | H | H | P96 | H | H | H | H |
| Lₐ₂₀₃₄ | P6 | F | H | H | P96 | H | P1 | H | H |
| Lₐ₂₀₃₅ | P6 | F | H | H | P96 | H | P2 | H | H |
| Lₐ₂₀₃₆ | P6 | F | H | H | P96 | H | P3 | H | H |
| Lₐ₂₀₃₇ | P6 | F | H | H | P96 | H | P4 | H | H |
| Lₐ₂₀₃₈ | P6 | F | H | H | P96 | H | P5 | H | H |
| Lₐ₂₀₃₉ | P6 | F | H | H | P96 | H | P6 | H | H |
| Lₐ₂₀₄₀ | P6 | F | H | H | P96 | H | P7 | H | H |
| Lₐ₂₀₄₁ | P6 | F | H | H | P96 | H | P8 | H | H |
| Lₐ₂₀₄₂ | P6 | F | H | H | P96 | H | P9 | H | H |
| Lₐ₂₀₄₃ | P6 | F | H | H | P96 | H | P10 | H | H |
| Lₐ₂₀₄₄ | P6 | F | H | H | P96 | H | P11 | H | H |
| Lₐ₂₀₄₅ | P6 | F | H | H | P96 | H | P12 | H | H |
| Lₐ₂₀₄₆ | P6 | F | H | H | P96 | H | P13 | H | H |
| Lₐ₂₀₄₇ | P6 | F | H | H | P96 | H | P14 | H | H |
| Lₐ₂₀₄₈ | P6 | F | H | H | P96 | H | P15 | H | H |
| Lₐ₂₀₄₉ | P6 | F | H | H | P96 | H | P16 | H | H |
| Lₐ₂₀₅₀ | P6 | F | H | H | P96 | H | P17 | H | H |
| Lₐ₂₀₅₁ | P6 | F | H | H | P96 | H | P18 | H | H |
| Lₐ₂₀₅₂ | P6 | F | H | H | P96 | H | P19 | H | H |
| Lₐ₂₀₅₃ | P6 | F | H | H | P96 | H | P20 | H | H |
| Lₐ₂₀₅₄ | P6 | F | H | H | P96 | H | P21 | H | H |
| Lₐ₂₀₅₅ | P6 | F | H | H | P96 | H | H | P1 | H |
| Lₐ₂₀₅₆ | P6 | F | H | H | P96 | H | H | P2 | H |
| Lₐ₂₀₅₇ | P6 | F | H | H | P96 | H | H | P3 | H |
| Lₐ₂₀₅₈ | P6 | F | H | H | P96 | H | H | P4 | H |
| Lₐ₂₀₅₉ | P6 | F | H | H | P96 | H | H | P5 | H |
| Lₐ₂₀₆₀ | P6 | F | H | H | P96 | H | H | P6 | H |
| Lₐ₂₀₆₁ | P6 | F | H | H | P96 | H | H | P7 | H |
| Lₐ₂₀₆₂ | P6 | F | H | H | P96 | H | H | P8 | H |
| Lₐ₂₀₆₃ | P6 | F | H | H | P96 | H | H | P9 | H |
| Lₐ₂₀₆₄ | P6 | F | H | H | P96 | H | H | P10 | H |
| Lₐ₂₀₆₅ | P6 | F | H | H | P96 | H | H | P11 | H |
| Lₐ₂₀₆₆ | P6 | F | H | H | P96 | H | H | P12 | H |
| Lₐ₂₀₆₇ | P6 | F | H | H | P96 | H | H | P15 | H |
| Lₐ₂₀₆₈ | P6 | F | H | H | P96 | H | H | P17 | H |
| Lₐ₂₀₆₉ | P6 | F | H | H | P96 | H | H | P18 | H |
| Lₐ₂₀₇₀ | P6 | F | H | H | P96 | H | H | P19 | H |
| Lₐ₂₀₇₁ | P6 | F | H | H | P96 | H | H | P20 | H |
| Lₐ₂₀₇₂ | P6 | F | H | H | P96 | H | H | P21 | H |
| Lₐ₂₀₇₃ | P6 | F | H | H | P96 | H | F | H | H |
| Lₐ₂₀₇₄ | P6 | F | H | H | P96 | H | F | P1 | H |
| Lₐ₂₀₇₅ | P6 | F | H | H | P96 | H | F | P2 | H |
| Lₐ₂₀₇₆ | P6 | F | H | H | P96 | H | F | P3 | H |
| Lₐ₂₀₇₇ | P6 | F | H | H | P96 | H | F | P4 | H |
| Lₐ₂₀₇₈ | P6 | F | H | H | P96 | H | F | P5 | H |
| Lₐ₂₀₇₉ | P6 | F | H | H | P96 | H | F | P6 | H |
| Lₐ₂₀₈₀ | P6 | F | H | H | P96 | H | F | P7 | H |
| Lₐ₂₀₈₁ | P6 | F | H | H | P96 | H | F | P8 | H |
| Lₐ₂₀₈₂ | P6 | F | H | H | P96 | H | F | P9 | H |
| Lₐ₂₀₈₃ | P6 | F | H | H | P96 | H | F | P10 | H |
| Lₐ₂₀₈₄ | P6 | F | H | H | P96 | H | F | P11 | H |
| Lₐ₂₀₈₅ | P6 | F | H | H | P96 | H | P1 | F | H |
| Lₐ₂₀₈₆ | P6 | F | H | H | P96 | H | P2 | F | H |
| Lₐ₂₀₈₇ | P6 | F | H | H | P96 | H | P3 | F | H |
| Lₐ₂₀₈₈ | P6 | F | H | H | P96 | H | P4 | F | H |
| Lₐ₂₀₈₉ | P6 | F | H | H | P96 | H | P5 | F | H |
| Lₐ₂₀₉₀ | P6 | F | H | H | P96 | H | P6 | F | H |
| Lₐ₂₀₉₁ | P6 | F | H | H | P96 | H | P7 | F | H |
| Lₐ₂₀₉₂ | P6 | F | H | H | P96 | H | P8 | F | H |
| Lₐ₂₀₉₃ | P6 | F | H | H | P96 | H | P9 | F | H |
| Lₐ₂₀₉₄ | P6 | F | H | H | P96 | H | P10 | F | H |
| Lₐ₂₀₉₅ | P6 | F | H | H | P96 | H | P11 | F | H |
| Lₐ₂₀₉₆ | P6 | F | H | H | P96 | H | P1 | P1 | H |
| Lₐ₂₀₉₇ | P6 | F | H | H | P96 | H | P2 | P2 | H |
| Lₐ₂₀₉₈ | P6 | F | H | H | P96 | D | D | D | D |
| Lₐ₂₀₉₉ | P6 | F | H | H | P96 | D | P2 | P2 | D |
| Lₐ₂₁₀₀ | P6 | F | H | H | P96 | D | F | P4 | D |
| Lₐ₂₁₀₁ | P6 | F | H | H | P96 | D | F | P5 | D |
| Lₐ₂₁₀₂ | P6 | F | H | H | P96 | D | F | P9 | D |
| Lₐ₂₁₀₃ | P6 | F | H | H | P96 | D | F | P11 | D |
| Lₐ₂₁₀₄ | P6 | F | H | H | P97 | H | H | H | H |
| Lₐ₂₁₀₅ | P6 | F | H | H | P97 | H | P1 | H | H |
| Lₐ₂₁₀₆ | P6 | F | H | H | P97 | H | P2 | H | H |
| Lₐ₂₁₀₇ | P6 | F | H | H | P97 | H | P3 | H | H |
| Lₐ₂₁₀₈ | P6 | F | H | H | P97 | H | P4 | H | H |
| Lₐ₂₁₀₉ | P6 | F | H | H | P97 | H | P5 | H | H |
| Lₐ₂₁₁₀ | P6 | F | H | H | P97 | H | P6 | H | H |
| Lₐ₂₁₁₁ | P6 | F | H | H | P97 | H | P7 | H | H |
| Lₐ₂₁₁₂ | P6 | F | H | H | P97 | H | P8 | H | H |
| Lₐ₂₁₁₃ | P6 | F | H | H | P97 | H | P9 | H | H |
| Lₐ₂₁₁₄ | P6 | F | H | H | P97 | H | P10 | H | H |
| Lₐ₂₁₁₅ | P6 | F | H | H | P97 | H | P11 | H | H |
| Lₐ₂₁₁₆ | P6 | F | H | H | P97 | H | P12 | H | H |
| Lₐ₂₁₁₇ | P6 | F | H | H | P97 | H | P13 | H | H |
| Lₐ₂₁₁₈ | P6 | F | H | H | P97 | H | P14 | H | H |
| Lₐ₂₁₁₉ | P6 | F | H | H | P97 | H | P15 | H | H |
| Lₐ₂₁₂₀ | P6 | F | H | H | P97 | H | P16 | H | H |
| Lₐ₂₁₂₁ | P6 | F | H | H | P97 | H | P17 | H | H |
| Lₐ₂₁₂₂ | P6 | F | H | H | P97 | H | P18 | H | H |
| Lₐ₂₁₂₃ | P6 | F | H | H | P97 | H | P19 | H | H |
| Lₐ₂₁₂₄ | P6 | F | H | H | P97 | H | P20 | H | H |
| Lₐ₂₁₂₅ | P6 | F | H | H | P97 | H | P21 | H | H |
| Lₐ₂₁₂₆ | P6 | F | H | H | P97 | H | H | P1 | H |
| Lₐ₂₁₂₇ | P6 | F | H | H | P97 | H | H | P2 | H |
| Lₐ₂₁₂₈ | P6 | F | H | H | P97 | H | H | P3 | H |
| Lₐ₂₁₂₉ | P6 | F | H | H | P97 | H | H | P4 | H |
| Lₐ₂₁₃₀ | P6 | F | H | H | P97 | H | H | P5 | H |
| Lₐ₂₁₃₁ | P6 | F | H | H | P97 | H | H | P6 | H |
| Lₐ₂₁₃₂ | P6 | F | H | H | P97 | H | H | P7 | H |
| Lₐ₂₁₃₃ | P6 | F | H | H | P97 | H | H | P8 | H |
| Lₐ₂₁₃₄ | P6 | F | H | H | P97 | H | H | P9 | H |
| Lₐ₂₁₃₅ | P6 | F | H | H | P97 | H | H | P10 | H |
| Lₐ₂₁₃₆ | P6 | F | H | H | P97 | H | H | P11 | H |
| Lₐ₂₁₃₇ | P6 | F | H | H | P97 | H | H | P12 | H |
| Lₐ₂₁₃₈ | P6 | F | H | H | P97 | H | H | P15 | H |
| Lₐ₂₁₃₉ | P6 | F | H | H | P97 | H | H | P17 | H |
| Lₐ₂₁₄₀ | P6 | F | H | H | P97 | H | H | P18 | H |
| Lₐ₂₁₄₁ | P6 | F | H | H | P97 | H | H | P19 | H |
| Lₐ₂₁₄₂ | P6 | F | H | H | P97 | H | H | P20 | H |
| Lₐ₂₁₄₃ | P6 | F | H | H | P97 | H | H | P21 | H |
| Lₐ₂₁₄₄ | P6 | F | H | H | P97 | H | F | H | H |
| Lₐ₂₁₄₅ | P6 | F | H | H | P97 | H | F | P1 | H |
| Lₐ₂₁₄₆ | P6 | F | H | H | P97 | H | F | P2 | H |
| Lₐ₂₁₄₇ | P6 | F | H | H | P97 | H | F | P3 | H |
| Lₐ₂₁₄₈ | P6 | F | H | H | P97 | H | F | P4 | H |
| Lₐ₂₁₄₉ | P6 | F | H | H | P97 | H | F | P5 | H |
| Lₐ₂₁₅₀ | P6 | F | H | H | P97 | H | F | P6 | H |
| Lₐ₂₁₅₁ | P6 | F | H | H | P97 | H | F | P7 | H |
| Lₐ₂₁₅₂ | P6 | F | H | H | P97 | H | F | P8 | H |
| Lₐ₂₁₅₃ | P6 | F | H | H | P97 | H | F | P9 | H |
| Lₐ₂₁₅₄ | P6 | F | H | H | P97 | H | F | P10 | H |
| Lₐ₂₁₅₅ | P6 | F | H | H | P97 | H | F | P11 | H |
| Lₐ₂₁₅₆ | P6 | F | H | H | P97 | H | P1 | F | H |
| Lₐ₂₁₅₇ | P6 | F | H | H | P97 | H | P2 | F | H |
| Lₐ₂₁₅₈ | P6 | F | H | H | P97 | H | P3 | F | H |
| Lₐ₂₁₅₉ | P6 | F | H | H | P97 | H | P4 | F | H |
| Lₐ₂₁₆₀ | P6 | F | H | H | P97 | H | P5 | F | H |
| Lₐ₂₁₆₁ | P6 | F | H | H | P97 | H | P6 | F | H |
| Lₐ₂₁₆₂ | P6 | F | H | H | P97 | H | P7 | F | H |
| Lₐ₂₁₆₃ | P6 | F | H | H | P97 | H | P8 | F | H |
| Lₐ₂₁₆₄ | P6 | F | H | H | P97 | H | P9 | F | H |
| Lₐ₂₁₆₅ | P6 | F | H | H | P97 | H | P10 | F | H |
| Lₐ₂₁₆₆ | P6 | F | H | H | P97 | H | P11 | F | H |
| Lₐ₂₁₆₇ | P6 | F | H | H | P97 | H | P1 | P1 | H |
| Lₐ₂₁₆₈ | P6 | F | H | H | P97 | H | P2 | P2 | H |
| Lₐ₂₁₆₉ | P6 | F | H | H | P97 | D | D | D | D |
| Lₐ₂₁₇₀ | P6 | F | H | H | P97 | D | P2 | P2 | D |
| Lₐ₂₁₇₁ | P6 | F | H | H | P97 | D | F | P4 | D |
| Lₐ₂₁₇₂ | P6 | F | H | H | P97 | D | F | P5 | D |
| Lₐ₂₁₇₃ | P6 | F | H | H | P97 | D | F | P9 | D |
| Lₐ₂₁₇₄ | P6 | F | H | H | P97 | D | F | P11 | D |
| Lₐ₂₁₇₅ | P6 | F | H | H | P102 | H | P1 | H | H |
| Lₐ₂₁₇₆ | P6 | F | H | H | P102 | H | P2 | H | H |
| Lₐ₂₁₇₇ | P6 | F | H | H | P102 | H | P3 | H | H |
| Lₐ₂₁₇₈ | P6 | F | H | H | P102 | H | P4 | H | H |
| Lₐ₂₁₇₉ | P6 | F | H | H | P102 | H | P5 | H | H |
| Lₐ₂₁₈₀ | P6 | F | H | H | P102 | H | P6 | H | H |
| Lₐ₂₁₈₁ | P6 | F | H | H | P102 | H | P7 | H | H |
| Lₐ₂₁₈₂ | P6 | F | H | H | P102 | H | P8 | H | H |
| Lₐ₂₁₈₃ | P6 | F | H | H | P102 | H | P9 | H | H |
| Lₐ₂₁₈₄ | P6 | F | H | H | P102 | H | P10 | H | H |
| Lₐ₂₁₈₅ | P6 | F | H | H | P102 | H | P11 | H | H |
| Lₐ₂₁₈₆ | P6 | F | H | H | P102 | H | P12 | H | H |
| Lₐ₂₁₈₇ | P6 | F | H | H | P102 | H | P13 | H | H |
| Lₐ₂₁₈₈ | P6 | F | H | H | P102 | H | P14 | H | H |
| Lₐ₂₁₈₉ | P6 | F | H | H | P102 | H | P15 | H | H |
| Lₐ₂₁₉₀ | P6 | F | H | H | P102 | H | P16 | H | H |
| Lₐ₂₁₉₁ | P6 | F | H | H | P102 | H | P17 | H | H |
| Lₐ₂₁₉₂ | P6 | F | H | H | P102 | H | P18 | H | H |
| Lₐ₂₁₉₃ | P6 | F | H | H | P102 | H | P19 | H | H |
| Lₐ₂₁₉₄ | P6 | F | H | H | P102 | H | P20 | H | H |
| Lₐ₂₁₉₅ | P6 | F | H | H | P102 | H | P21 | H | H |
| Lₐ₂₁₉₆ | P6 | F | H | H | P102 | H | H | P1 | H |
| Lₐ₂₁₉₇ | P6 | F | H | H | P102 | H | H | P2 | H |
| Lₐ₂₁₉₈ | P6 | F | H | H | P102 | H | H | P3 | H |
| Lₐ₂₁₉₉ | P6 | F | H | H | P102 | H | H | P4 | H |
| Lₐ₂₂₀₀ | P6 | F | H | H | P102 | H | H | P5 | H |
| Lₐ₂₂₀₁ | P6 | F | H | H | P102 | H | H | P6 | H |
| Lₐ₂₂₀₂ | P6 | F | H | H | P102 | H | H | P7 | H |
| Lₐ₂₂₀₃ | P6 | F | H | H | P102 | H | H | P8 | H |
| Lₐ₂₂₀₄ | P6 | F | H | H | P102 | H | H | P9 | H |
| Lₐ₂₂₀₅ | P6 | F | H | H | P102 | H | H | P10 | H |
| Lₐ₂₂₀₆ | P6 | F | H | H | P102 | H | H | P11 | H |
| Lₐ₂₂₀₇ | P6 | F | H | H | P102 | H | H | P12 | H |
| Lₐ₂₂₀₈ | P6 | F | H | H | P102 | H | H | P15 | H |
| Lₐ₂₂₀₉ | P6 | F | H | H | P102 | H | H | P17 | H |
| Lₐ₂₂₁₀ | P6 | F | H | H | P102 | H | H | P18 | H |
| Lₐ₂₂₁₁ | P6 | F | H | H | P102 | H | H | P19 | H |
| Lₐ₂₂₁₂ | P6 | F | H | H | P102 | H | H | P20 | H |
| Lₐ₂₂₁₃ | P6 | F | H | H | P102 | H | H | P21 | H |
| Lₐ₂₂₁₄ | P6 | F | H | H | P102 | H | F | H | H |
| Lₐ₂₂₁₅ | P6 | F | H | H | P102 | H | F | P1 | H |
| Lₐ₂₂₁₆ | P6 | F | H | H | P102 | H | F | P2 | H |
| Lₐ₂₂₁₇ | P6 | F | H | H | P102 | H | F | P3 | H |
| Lₐ₂₂₁₈ | P6 | F | H | H | P102 | H | F | P4 | H |
| Lₐ₂₂₁₉ | P6 | F | H | H | P102 | H | F | P5 | H |
| Lₐ₂₂₂₀ | P6 | F | H | H | P102 | H | F | P6 | H |
| Lₐ₂₂₂₁ | P6 | F | H | H | P102 | H | F | P7 | H |
| Lₐ₂₂₂₂ | P6 | F | H | H | P102 | H | F | P8 | H |
| Lₐ₂₂₂₃ | P6 | F | H | H | P102 | H | F | P9 | H |
| Lₐ₂₂₂₄ | P6 | F | H | H | P102 | H | F | P10 | H |
| Lₐ₂₂₂₅ | P6 | F | H | H | P102 | H | F | P11 | H |
| Lₐ₂₂₂₆ | P6 | F | H | H | P102 | H | P1 | F | H |
| Lₐ₂₂₂₇ | P6 | F | H | H | P102 | H | P2 | F | H |
| Lₐ₂₂₂₈ | P6 | F | H | H | P102 | H | P3 | F | H |
| Lₐ₂₂₂₉ | P6 | F | H | H | P102 | H | P4 | F | H |
| Lₐ₂₂₃₀ | P6 | F | H | H | P102 | H | P5 | F | H |
| Lₐ₂₂₃₁ | P6 | F | H | H | P102 | H | P6 | F | H |
| Lₐ₂₂₃₂ | P6 | F | H | H | P102 | H | P7 | F | H |
| Lₐ₂₂₃₃ | P6 | F | H | H | P102 | H | P8 | F | H |
| Lₐ₂₂₃₄ | P6 | F | H | H | P102 | H | P9 | F | H |
| Lₐ₂₂₃₅ | P6 | F | H | H | P102 | H | P10 | F | H |
| Lₐ₂₂₃₆ | P6 | F | H | H | P102 | H | P11 | F | H |
| Lₐ₂₂₃₇ | P6 | F | H | H | P102 | H | P1 | P1 | H |
| Lₐ₂₂₃₈ | P6 | F | H | H | P102 | H | P2 | P2 | H |
| Lₐ₂₂₃₉ | P6 | F | H | H | P102 | D | D | D | D |
| Lₐ₂₂₄₀ | P6 | F | H | H | P102 | D | P2 | P2 | D |
| Lₐ₂₂₄₁ | P6 | F | H | H | P102 | D | F | P4 | D |
| Lₐ₂₂₄₂ | P6 | F | H | H | P102 | D | F | P5 | D |
| Lₐ₂₂₄₃ | P6 | F | H | H | P102 | D | F | P9 | D |
| Lₐ₂₂₄₄ | P6 | F | H | H | P102 | D | F | P11 | D |
| Lₐ₂₂₄₅ | P6 | F | H | H | P103 | H | P1 | H | H |
| Lₐ₂₂₄₆ | P6 | F | H | H | P103 | H | P2 | H | H |
| Lₐ₂₂₄₇ | P6 | F | H | H | P103 | H | P3 | H | H |
| Lₐ₂₂₄₈ | P6 | F | H | H | P103 | H | P4 | H | H |
| Lₐ₂₂₄₉ | P6 | F | H | H | P103 | H | P5 | H | H |
| Lₐ₂₂₅₀ | P6 | F | H | H | P103 | H | P6 | H | H |
| Lₐ₂₂₅₁ | P6 | F | H | H | P103 | H | P7 | H | H |
| Lₐ₂₂₅₂ | P6 | F | H | H | P103 | H | P8 | H | H |
| Lₐ₂₂₅₃ | P6 | F | H | H | P103 | H | P9 | H | H |
| Lₐ₂₂₅₄ | P6 | F | H | H | P103 | H | P10 | H | H |
| Lₐ₂₂₅₅ | P6 | F | H | H | P103 | H | P11 | H | H |
| Lₐ₂₂₅₆ | P6 | F | H | H | P103 | H | P12 | H | H |
| Lₐ₂₂₅₇ | P6 | F | H | H | P103 | H | P13 | H | H |
| Lₐ₂₂₅₈ | P6 | F | H | H | P103 | H | P14 | H | H |
| Lₐ₂₂₅₉ | P6 | F | H | H | P103 | H | P15 | H | H |
| Lₐ₂₂₆₀ | P6 | F | H | H | P103 | H | P16 | H | H |
| Lₐ₂₂₆₁ | P6 | F | H | H | P103 | H | P17 | H | H |
| Lₐ₂₂₆₂ | P6 | F | H | H | P103 | H | P18 | H | H |
| Lₐ₂₂₆₃ | P6 | F | H | H | P103 | H | P19 | H | H |
| Lₐ₂₂₆₄ | P6 | F | H | H | P103 | H | P20 | H | H |
| Lₐ₂₂₆₅ | P6 | F | H | H | P103 | H | P21 | H | H |
| Lₐ₂₂₆₆ | P6 | F | H | H | P103 | H | H | P1 | H |
| Lₐ₂₂₆₇ | P6 | F | H | H | P103 | H | H | P2 | H |
| Lₐ₂₂₆₈ | P6 | F | H | H | P103 | H | H | P3 | H |
| Lₐ₂₂₆₉ | P6 | F | H | H | P103 | H | H | P4 | H |
| Lₐ₂₂₇₀ | P6 | F | H | H | P103 | H | H | P5 | H |
| Lₐ₂₂₇₁ | P6 | F | H | H | P103 | H | H | P6 | H |
| Lₐ₂₂₇₂ | P6 | F | H | H | P103 | H | H | P7 | H |
| Lₐ₂₂₇₃ | P6 | F | H | H | P103 | H | H | P8 | H |
| Lₐ₂₂₇₄ | P6 | F | H | H | P103 | H | H | P9 | H |
| Lₐ₂₂₇₅ | P6 | F | H | H | P103 | H | H | P10 | H |
| Lₐ₂₂₇₆ | P6 | F | H | H | P103 | H | H | P11 | H |
| Lₐ₂₂₇₇ | P6 | F | H | H | P103 | H | H | P12 | H |
| Lₐ₂₂₇₈ | P6 | F | H | H | P103 | H | H | P15 | H |
| Lₐ₂₂₇₉ | P6 | F | H | H | P103 | H | H | P17 | H |
| Lₐ₂₂₈₀ | P6 | F | H | H | P103 | H | H | P18 | H |
| Lₐ₂₂₈₁ | P6 | F | H | H | P103 | H | H | P19 | H |
| Lₐ₂₂₈₂ | P6 | F | H | H | P103 | H | H | P20 | H |
| Lₐ₂₂₈₃ | P6 | F | H | H | P103 | H | H | P21 | H |
| Lₐ₂₂₈₄ | P6 | F | H | H | P103 | H | F | H | H |
| Lₐ₂₂₈₅ | P6 | F | H | H | P103 | H | F | P1 | H |
| Lₐ₂₂₈₆ | P6 | F | H | H | P103 | H | F | P2 | H |
| Lₐ₂₂₈₇ | P6 | F | H | H | P103 | H | F | P3 | H |
| Lₐ₂₂₈₈ | P6 | F | H | H | P103 | H | F | P4 | H |
| Lₐ₂₂₈₉ | P6 | F | H | H | P103 | H | F | P5 | H |
| Lₐ₂₂₉₀ | P6 | F | H | H | P103 | H | F | P6 | H |
| Lₐ₂₂₉₁ | P6 | F | H | H | P103 | H | F | P7 | H |
| Lₐ₂₂₉₂ | P6 | F | H | H | P103 | H | F | P8 | H |
| Lₐ₂₂₉₃ | P6 | F | H | H | P103 | H | F | P9 | H |
| Lₐ₂₂₉₄ | P6 | F | H | H | P103 | H | F | P10 | H |
| Lₐ₂₂₉₅ | P6 | F | H | H | P103 | H | F | P11 | H |
| Lₐ₂₂₉₆ | P6 | F | H | H | P103 | H | P1 | F | H |
| Lₐ₂₂₉₇ | P6 | F | H | H | P103 | H | P2 | F | H |
| Lₐ₂₂₉₈ | P6 | F | H | H | P103 | H | P3 | F | H |
| Lₐ₂₂₉₉ | P6 | F | H | H | P103 | H | P4 | F | H |
| Lₐ₂₃₀₀ | P6 | F | H | H | P103 | H | P5 | F | H |
| Lₐ₂₃₀₁ | P6 | F | H | H | P103 | H | P6 | F | H |
| Lₐ₂₃₀₂ | P6 | F | H | H | P103 | H | P7 | F | H |
| Lₐ₂₃₀₃ | P6 | F | H | H | P103 | H | P8 | F | H |
| Lₐ₂₃₀₄ | P6 | F | H | H | P103 | H | P9 | F | H |
| Lₐ₂₃₀₅ | P6 | F | H | H | P103 | H | P10 | F | H |
| Lₐ₂₃₀₆ | P6 | F | H | H | P103 | H | P11 | F | H |
| Lₐ₂₃₀₇ | P6 | F | H | H | P103 | H | P1 | P1 | H |
| Lₐ₂₃₀₈ | P6 | F | H | H | P103 | H | P2 | P2 | H |
| Lₐ₂₃₀₉ | P6 | F | H | H | P103 | D | D | D | D |
| Lₐ₂₃₁₀ | P6 | F | H | H | P103 | D | P2 | P2 | D |
| Lₐ₂₃₁₁ | P6 | F | H | H | P103 | D | F | P4 | D |
| Lₐ₂₃₁₂ | P6 | F | H | H | P103 | D | F | P5 | D |
| Lₐ₂₃₁₃ | P6 | F | H | H | P103 | D | F | P9 | D |
| Lₐ₂₃₁₄ | P6 | F | H | H | P103 | D | F | P11 | D |
| Lₐ₂₃₁₅ | P6 | F | H | H | H | H | P20 | P1 | H |
| Lₐ₂₃₁₆ | P6 | F | H | H | H | H | P21 | P2 | H |
| Lₐ₂₃₁₇ | P6 | F | H | H | H | H | P29 | H | H |
| Lₐ₂₃₁₈ | P6 | F | H | H | H | H | P29 | P1 | H |
| Lₐ₂₃₁₉ | P6 | F | H | H | H | H | P54 | H | H |
| Lₐ₂₃₂₀ | P6 | F | H | H | H | H | P96 | H | H |
| Lₐ₂₃₂₁ | P6 | F | H | H | H | H | P97 | H | H |
| Lₐ₂₃₂₂ | P6 | F | H | H | H | H | P96 | P1 | H |
| Lₐ₂₃₂₃ | P6 | F | H | H | H | H | P97 | P1 | H |
| Lₐ₂₃₂₄ | P6 | F | H | H | H | H | P102 | H | H |
| Lₐ₂₃₂₅ | P6 | F | H | H | H | H | P103 | H | H |
| Lₐ₂₃₂₆ | P6 | F | H | H | D | H | P20 | P1 | H |
| Lₐ₂₃₂₇ | P6 | F | H | H | D | H | P21 | P2 | H |
| Lₐ₂₃₂₈ | P6 | F | H | H | D | H | P29 | H | H |
| Lₐ₂₃₂₉ | P6 | F | H | H | D | H | P29 | P1 | H |
| Lₐ₂₃₃₀ | P6 | F | H | H | D | H | P54 | H | H |
| Lₐ₂₃₃₁ | P6 | F | H | H | D | H | P96 | H | H |
| Lₐ₂₃₃₂ | P6 | F | H | H | D | H | P97 | H | H |
| Lₐ₂₃₃₃ | P6 | F | H | H | D | H | P96 | P1 | H |
| Lₐ₂₃₃₄ | P6 | F | H | H | D | H | P97 | P1 | H |
| Lₐ₂₃₃₅ | P6 | F | H | H | D | H | P102 | H | H |
| Lₐ₂₃₃₆ | P6 | F | H | H | D | H | P103 | H | H |
| Lₐ₂₃₃₇ | P6 | F | H | H | P20 | H | P20 | P1 | H |
| Lₐ₂₃₃₈ | P6 | F | H | H | P20 | H | P21 | P2 | H |
| Lₐ₂₃₃₉ | P6 | F | H | H | P20 | H | P29 | H | H |
| Lₐ₂₃₄₀ | P6 | F | H | H | P20 | H | P29 | P1 | H |
| Lₐ₂₃₄₁ | P6 | F | H | H | P20 | H | P54 | H | H |
| Lₐ₂₃₄₂ | P6 | F | H | H | P20 | H | P96 | H | H |
| Lₐ₂₃₄₃ | P6 | F | H | H | P20 | H | P97 | H | H |
| Lₐ₂₃₄₄ | P6 | F | H | H | P20 | H | P96 | P1 | H |
| Lₐ₂₃₄₅ | P6 | F | H | H | P20 | H | P97 | P1 | H |
| Lₐ₂₃₄₆ | P6 | F | H | H | P20 | H | P102 | H | H |
| Lₐ₂₃₄₇ | P6 | F | H | H | P20 | H | P103 | H | H |
| Lₐ₂₃₄₈ | P6 | F | H | H | P21 | H | P20 | P1 | H |
| Lₐ₂₃₄₉ | P6 | F | H | H | P21 | H | P21 | P2 | H |
| Lₐ₂₃₅₀ | P6 | F | H | H | P21 | H | P29 | H | H |
| Lₐ₂₃₅₁ | P6 | F | H | H | P21 | H | P29 | P1 | H |
| Lₐ₂₃₅₂ | P6 | F | H | H | P21 | H | P54 | H | H |
| Lₐ₂₃₅₃ | P6 | F | H | H | P21 | H | P96 | H | H |
| Lₐ₂₃₅₄ | P6 | F | H | H | P21 | H | P97 | H | H |
| Lₐ₂₃₅₅ | P6 | F | H | H | P21 | H | P96 | P1 | H |
| Lₐ₂₃₅₆ | P6 | F | H | H | P21 | H | P97 | P1 | H |
| Lₐ₂₃₅₇ | P6 | F | H | H | P21 | H | P102 | H | H |
| Lₐ₂₃₅₈ | P6 | F | H | H | P21 | H | P103 | H | H |
| Lₐ₂₃₅₉ | P6 | F | H | H | P22 | H | H | H | H |
| Lₐ₂₃₆₀ | P6 | F | H | H | P23 | H | H | H | H |
| Lₐ₂₃₆₁ | P6 | F | H | H | P24 | H | H | H | H |
| Lₐ₂₃₆₂ | P6 | F | H | H | P25 | H | H | H | H |
| Lₐ₂₃₆₃ | P6 | F | H | H | P26 | H | H | H | H |
| Lₐ₂₃₆₄ | P6 | F | H | H | P27 | H | H | H | H |
| Lₐ₂₃₆₅ | P6 | F | H | H | P28 | H | H | H | H |
| Lₐ₂₃₆₆ | P6 | F | H | H | P29 | H | H | H | H |
| Lₐ₂₃₆₇ | P6 | F | H | H | P30 | H | H | H | H |
| Lₐ₂₃₆₈ | P6 | F | H | H | P31 | H | H | H | H |
| Lₐ₂₃₆₉ | P6 | F | H | H | P32 | H | H | H | H |
| Lₐ₂₃₇₀ | P6 | F | H | H | P33 | H | H | H | H |
| Lₐ₂₃₇₁ | P6 | F | H | H | P34 | H | H | H | H |
| Lₐ₂₃₇₂ | P6 | F | H | H | P35 | H | H | H | H |
| Lₐ₂₃₇₃ | P6 | F | H | H | P36 | H | H | H | H |
| Lₐ₂₃₇₄ | P6 | F | H | H | P37 | H | H | H | H |
| Lₐ₂₃₇₅ | P6 | F | H | H | P38 | H | H | H | H |
| Lₐ₂₃₇₆ | P6 | F | H | H | P39 | H | H | H | H |
| Lₐ₂₃₇₇ | P6 | F | H | H | P40 | H | H | H | H |
| Lₐ₂₃₇₈ | P6 | F | H | H | P41 | H | H | H | H |
| Lₐ₂₃₇₉ | P6 | F | H | H | P42 | H | H | H | H |
| Lₐ₂₃₈₀ | P6 | F | H | H | P43 | H | H | H | H |
| Lₐ₂₃₈₁ | P6 | F | H | H | P44 | H | H | H | H |
| Lₐ₂₃₈₂ | P6 | F | H | H | P45 | H | H | H | H |
| Lₐ₂₃₈₃ | P6 | F | H | H | P46 | H | H | H | H |
| Lₐ₂₃₈₄ | P6 | F | H | H | P47 | H | H | H | H |
| Lₐ₂₃₈₅ | P6 | F | H | H | P48 | H | H | H | H |
| Lₐ₂₃₈₆ | P6 | F | H | H | P49 | H | H | H | H |
| Lₐ₂₃₈₇ | P6 | F | H | H | P50 | H | H | H | H |
| Lₐ₂₃₈₈ | P6 | F | H | H | P51 | H | H | H | H |
| Lₐ₂₃₈₉ | P6 | F | H | H | P52 | H | H | H | H |
| Lₐ₂₃₉₀ | P6 | F | H | H | P53 | H | H | H | H |
| Lₐ₂₃₉₁ | P6 | F | H | H | P55 | H | H | H | H |
| Lₐ₂₃₉₂ | P6 | F | H | H | P56 | H | H | H | H |
| Lₐ₂₃₉₃ | P6 | F | H | H | P57 | H | H | H | H |
| Lₐ₂₃₉₄ | P6 | F | H | H | P58 | H | H | H | H |
| Lₐ₂₃₉₅ | P6 | F | H | H | P59 | H | H | H | H |
| Lₐ₂₃₉₆ | P6 | F | H | H | P60 | H | H | H | H |
| Lₐ₂₃₉₇ | P6 | F | H | H | P61 | H | H | H | H |
| Lₐ₂₃₉₈ | P6 | F | H | H | P62 | H | H | H | H |
| Lₐ₂₃₉₉ | P6 | F | H | H | P63 | H | H | H | H |
| Lₐ₂₄₀₀ | P6 | F | H | H | P64 | H | H | H | H |
| Lₐ₂₄₀₁ | P6 | F | H | H | P65 | H | H | H | H |
| Lₐ₂₄₀₂ | P6 | F | H | H | P66 | H | H | H | H |
| Lₐ₂₄₀₃ | P6 | F | H | H | P67 | H | H | H | H |
| Lₐ₂₄₀₄ | P6 | F | H | H | P68 | H | H | H | H |
| Lₐ₂₄₀₅ | P6 | F | H | H | P69 | H | H | H | H |
| Lₐ₂₄₀₆ | P6 | F | H | H | P70 | H | H | H | H |
| Lₐ₂₄₀₇ | P6 | F | H | H | P71 | H | H | H | H |
| Lₐ₂₄₀₈ | P6 | F | H | H | P72 | H | H | H | H |
| Lₐ₂₄₀₉ | P6 | F | H | H | P73 | H | H | H | H |
| Lₐ₂₄₁₀ | P6 | F | H | H | P74 | H | H | H | H |
| Lₐ₂₄₁₁ | P6 | F | H | H | P75 | H | H | H | H |
| Lₐ₂₄₁₂ | P6 | F | H | H | P76 | H | H | H | H |
| Lₐ₂₄₁₃ | P6 | F | H | H | P77 | H | H | H | H |
| Lₐ₂₄₁₄ | P6 | F | H | H | P78 | H | H | H | H |
| Lₐ₂₄₁₅ | P6 | F | H | H | P79 | H | H | H | H |
| Lₐ₂₄₁₆ | P6 | F | H | H | P80 | H | H | H | H |
| Lₐ₂₄₁₇ | P6 | F | H | H | P81 | H | H | H | H |
| Lₐ₂₄₁₈ | P6 | F | H | H | P82 | H | H | H | H |
| Lₐ₂₄₁₉ | P6 | F | H | H | P83 | H | H | H | H |
| Lₐ₂₄₂₀ | P6 | F | H | H | P84 | H | H | H | H |
| Lₐ₂₄₂₁ | P6 | F | H | H | P85 | H | H | H | H |
| Lₐ₂₄₂₂ | P6 | F | H | H | P86 | H | H | H | H |
| Lₐ₂₄₂₃ | P6 | F | H | H | P87 | H | H | H | H |
| Lₐ₂₄₂₄ | P6 | F | H | H | P88 | H | H | H | H |
| Lₐ₂₄₂₅ | P6 | F | H | H | P89 | H | H | H | H |
| Lₐ₂₄₂₆ | P6 | F | H | H | P90 | H | H | H | H |
| Lₐ₂₄₂₇ | P6 | F | H | H | P91 | H | H | H | H |
| Lₐ₂₄₂₈ | P6 | F | H | H | P92 | H | H | H | H |
| Lₐ₂₄₂₉ | P6 | F | H | H | P93 | H | H | H | H |
| Lₐ₂₄₃₀ | P6 | F | H | H | P94 | H | H | H | H |
| Lₐ₂₄₃₁ | P6 | F | H | H | P95 | H | H | H | H |
| Lₐ₂₄₃₂ | P6 | F | H | H | P98 | H | H | H | H |
| Lₐ₂₄₃₃ | P6 | F | H | H | P99 | H | H | H | H |
| Lₐ₂₄₃₄ | P6 | F | H | H | P100 | H | H | H | H |
| Lₐ₂₄₃₅ | P6 | F | H | H | P101 | H | H | H | H |
| Lₐ₂₄₃₆ | P6 | F | H | H | P102 | H | H | H | H |
| Lₐ₂₄₃₇ | P6 | F | H | H | P103 | H | H | H | H |
| Lₐ₂₄₃₈ | P6 | F | H | H | P104 | H | H | H | H |
| Lₐ₂₄₃₉ | P6 | F | H | H | P105 | H | H | H | H |
| Lₐ₂₄₄₀ | P6 | F | H | H | P106 | H | H | H | H |
| Lₐ₂₄₄₁ | P6 | F | H | H | P107 | H | H | H | H |
| Lₐ₂₄₄₂ | P6 | F | H | H | P108 | H | H | H | H |
| Lₐ₂₄₄₃ | P6 | F | H | H | P109 | H | H | H | H |
| Lₐ₂₄₄₄ | P6 | F | H | H | P110 | H | H | H | H |
| Lₐ₂₄₄₅ | P6 | F | H | H | P111 | H | H | H | H |
| Lₐ₂₄₄₆ | P6 | F | H | H | P112 | H | H | H | H |
| Lₐ₂₄₄₇ | P6 | F | H | H | P113 | H | H | H | H |
| Lₐ₂₄₄₈ | P6 | F | H | H | P114 | H | H | H | H |
| Lₐ₂₄₄₉ | P6 | F | H | H | P115 | H | H | H | H |
| Lₐ₂₄₅₀ | P6 | F | H | H | P116 | H | H | H | H |
| Lₐ₂₄₅₁ | P6 | F | H | H | P117 | H | H | H | H |
| Lₐ₂₄₅₂ | P6 | F | H | H | P118 | H | H | H | H |
| Lₐ₂₄₅₃ | P6 | F | H | H | P119 | H | H | H | H |
| Lₐ₂₄₅₄ | P6 | F | H | H | P120 | H | H | H | H |
| Lₐ₂₄₅₅ | P6 | F | H | H | P121 | H | H | H | H |
| Lₐ₂₄₅₆ | P6 | F | H | H | P122 | H | H | H | H |
| Lₐ₂₄₅₇ | P6 | F | H | H | P123 | H | H | H | H |
| Lₐ₂₄₅₈ | P6 | F | H | H | P124 | H | H | H | H |
| Lₐ₂₄₅₉ | P6 | F | H | H | P125 | H | H | H | H |
| Lₐ₂₄₆₀ | P6 | F | H | H | P126 | H | H | H | H |
| Lₐ₂₄₆₁ | P6 | F | H | H | P127 | H | H | H | H |
| Lₐ₂₄₆₂ | P6 | F | H | H | P128 | H | H | H | H |
| Lₐ₂₄₆₃ | P6 | F | H | H | P129 | H | H | H | H |
| Lₐ₂₄₆₄ | P6 | F | H | H | P130 | H | H | H | H |
| Lₐ₂₄₆₅ | P6 | F | H | H | P131 | H | H | H | H |
| Lₐ₂₄₆₆ | P6 | F | H | H | P132 | H | H | H | H |
| Lₐ₂₄₆₇ | P6 | F | H | H | P133 | H | H | H | H |
| Lₐ₂₄₆₈ | P6 | F | H | H | P134 | H | H | H | H |
| Lₐ₂₄₆₉ | P6 | F | H | H | P135 | H | H | H | H |
| Lₐ₂₄₇₀ | P6 | F | H | H | P136 | H | H | H | H |
| Lₐ₂₄₇₁ | P6 | F | H | H | P137 | H | H | H | H |
| Lₐ₂₄₇₂ | P6 | F | H | H | P138 | H | H | H | H |
| Lₐ₂₄₇₃ | P6 | F | H | H | P139 | H | H | H | H |
| Lₐ₂₄₇₄ | P6 | F | H | H | P140 | H | H | H | H |
| Lₐ₂₄₇₅ | P6 | F | H | H | P141 | H | H | H | H |
| Lₐ₂₄₇₆ | P6 | F | H | H | P142 | H | H | H | H |
| Lₐ₂₄₇₇ | P6 | F | H | H | P143 | H | H | H | H |
| Lₐ₂₄₇₈ | P6 | F | H | H | P144 | H | H | H | H |
| Lₐ₂₄₇₉ | P6 | F | H | H | P145 | H | H | H | H |
| Lₐ₂₄₈₀ | P6 | F | H | H | P146 | H | H | H | H |
| Lₐ₂₄₈₁ | P6 | F | H | H | P147 | H | H | H | H |
| Lₐ₂₄₈₂ | P6 | F | H | H | P148 | H | H | H | H |
| Lₐ₂₄₈₃ | P6 | F | H | H | P149 | H | H | H | H |
| Lₐ₂₄₈₄ | P6 | F | H | H | P150 | H | H | H | H |
| Lₐ₂₄₈₅ | P6 | F | H | H | P151 | H | H | H | H |
| Lₐ₂₄₈₆ | P6 | F | H | P18 | H | H | H | H | H |
| Lₐ₂₄₈₇ | P6 | F | H | P18 | D | H | H | H | H |
| Lₐ₂₄₈₈ | P6 | F | H | P18 | P20 | H | H | H | H |
| Lₐ₂₄₈₉ | P6 | F | H | P19 | H | H | H | H | H |
| Lₐ₂₄₉₀ | P6 | F | H | P19 | D | H | H | H | H |
| Lₐ₂₄₉₁ | P6 | F | H | P19 | P20 | H | H | H | H |
| Lₐ₂₄₉₂ | P6 | F | H | P20 | H | H | H | H | H |
| Lₐ₂₄₉₃ | P6 | F | H | P20 | D | H | H | H | H |
| Lₐ₂₄₉₄ | P6 | F | H | P20 | H | H | P1 | H | H |
| Lₐ₂₄₉₅ | P6 | F | H | P20 | D | H | P2 | H | H |
| Lₐ₂₄₉₆ | P6 | F | H | P20 | H | H | H | P1 | H |
| Lₐ₂₄₉₇ | P6 | F | H | P20 | D | H | H | P2 | H |
| Lₐ₂₄₉₈ | P6 | F | H | P20 | H | H | P1 | P1 | H |
| Lₐ₂₄₉₉ | P6 | F | H | P20 | D | H | P2 | P2 | H |
| Lₐ₂₅₀₀ | P6 | F | H | P20 | H | H | P3 | H | H |
| Lₐ₂₅₀₁ | P6 | F | H | P20 | D | H | P4 | H | H |
| Lₐ₂₅₀₂ | P6 | F | H | P20 | H | H | P5 | H | H |
| Lₐ₂₅₀₃ | P6 | F | H | P21 | H | H | H | H | H |
| Lₐ₂₅₀₄ | P6 | F | H | P21 | D | H | H | H | H |
| Lₐ₂₅₀₅ | P6 | F | H | P21 | H | H | P1 | H | H |
| Lₐ₂₅₀₆ | P6 | F | H | P21 | D | H | P2 | H | H |
| Lₐ₂₅₀₇ | P6 | F | H | P21 | H | H | H | P1 | H |
| Lₐ₂₅₀₈ | P6 | F | H | P21 | D | H | H | P2 | H |
| Lₐ₂₅₀₉ | P6 | F | H | P21 | H | H | P1 | P1 | H |
| Lₐ₂₅₁₀ | P6 | F | H | P21 | D | H | P2 | P2 | H |
| Lₐ₂₅₁₁ | P6 | F | H | P21 | H | H | P3 | H | H |
| Lₐ₂₅₁₂ | P6 | F | H | P21 | D | H | P4 | H | H |
| Lₐ₂₅₁₃ | P6 | F | H | P21 | H | H | P5 | H | H |
| Lₐ₂₅₁₄ | P11 | F | H | H | H | H | H | H | H |
| Lₐ₂₅₁₅ | P11 | F | H | H | H | H | P1 | H | H |
| Lₐ₂₅₁₆ | P11 | F | H | H | H | H | P2 | H | H |
| Lₐ₂₅₁₇ | P11 | F | H | H | H | H | P3 | H | H |
| Lₐ₂₅₁₈ | P11 | F | H | H | H | H | P4 | H | H |
| Lₐ₂₅₁₉ | P11 | F | H | H | H | H | P5 | H | H |
| Lₐ₂₅₂₀ | P11 | F | H | H | H | H | P6 | H | H |
| Lₐ₂₅₂₁ | P11 | F | H | H | H | H | P7 | H | H |
| Lₐ₂₅₂₂ | P11 | F | H | H | H | H | P8 | H | H |
| Lₐ₂₅₂₃ | P11 | F | H | H | H | H | P9 | H | H |
| Lₐ₂₅₂₄ | P11 | F | H | H | H | H | P10 | H | H |
| Lₐ₂₅₂₅ | P11 | F | H | H | H | H | P11 | H | H |
| Lₐ₂₅₂₆ | P11 | F | H | H | H | H | P12 | H | H |
| Lₐ₂₅₂₇ | P11 | F | H | H | H | H | P13 | H | H |
| Lₐ₂₅₂₈ | P11 | F | H | H | H | H | P14 | H | H |
| Lₐ₂₅₂₉ | P11 | F | H | H | H | H | P15 | H | H |
| Lₐ₂₅₃₀ | P11 | F | H | H | H | H | P16 | H | H |
| Lₐ₂₅₃₁ | P11 | F | H | H | H | H | P17 | H | H |
| Lₐ₂₅₃₂ | P11 | F | H | H | H | H | P18 | H | H |
| Lₐ₂₅₃₃ | P11 | F | H | H | H | H | P19 | H | H |
| Lₐ₂₅₃₄ | P11 | F | H | H | H | H | P20 | H | H |
| Lₐ₂₅₃₅ | P11 | F | H | H | H | H | P21 | H | H |
| Lₐ₂₅₃₆ | P11 | F | H | H | H | H | P1 | F | H |
| Lₐ₂₅₃₇ | P11 | F | H | H | H | H | P2 | F | H |
| Lₐ₂₅₃₈ | P11 | F | H | H | H | H | P3 | F | H |
| Lₐ₂₅₃₉ | P11 | F | H | H | H | H | P4 | F | H |
| Lₐ₂₅₄₀ | P11 | F | H | H | H | H | P5 | F | H |
| Lₐ₂₅₄₁ | P11 | F | H | H | H | H | P6 | F | H |
| Lₐ₂₅₄₂ | P11 | F | H | H | H | H | P7 | F | H |
| Lₐ₂₅₄₃ | P11 | F | H | H | H | H | P8 | F | H |
| Lₐ₂₅₄₄ | P11 | F | H | H | H | H | P9 | F | H |
| Lₐ₂₅₄₅ | P11 | F | H | H | H | H | P10 | F | H |
| Lₐ₂₅₄₆ | P11 | F | H | H | H | H | P11 | F | H |
| Lₐ₂₅₄₇ | P11 | F | H | H | H | H | P12 | F | H |
| Lₐ₂₅₄₈ | P11 | F | H | H | H | H | P13 | F | H |
| Lₐ₂₅₄₉ | P11 | F | H | H | H | H | P14 | F | H |
| Lₐ₂₅₅₀ | P11 | F | H | H | H | H | P15 | F | H |
| Lₐ₂₅₅₁ | P11 | F | H | H | H | H | P16 | F | H |
| Lₐ₂₅₅₂ | P11 | F | H | H | H | H | P17 | F | H |
| Lₐ₂₅₅₃ | P11 | F | H | H | H | H | P18 | F | H |
| Lₐ₂₅₅₄ | P11 | F | H | H | H | H | P19 | F | H |
| Lₐ₂₅₅₅ | P11 | F | H | H | H | H | P20 | F | H |
| Lₐ₂₅₅₆ | P11 | F | H | H | H | H | P21 | F | H |
| Lₐ₂₅₅₇ | P11 | F | H | H | H | H | H | P1 | H |
| Lₐ₂₅₅₈ | P11 | F | H | H | H | H | H | P2 | H |
| Lₐ₂₅₅₉ | P11 | F | H | H | H | H | H | P3 | H |
| Lₐ₂₅₆₀ | P11 | F | H | H | H | H | H | P4 | H |
| Lₐ₂₅₆₁ | P11 | F | H | H | H | H | H | P5 | H |
| Lₐ₂₅₆₂ | P11 | F | H | H | H | H | H | P6 | H |
| Lₐ₂₅₆₃ | P11 | F | H | H | H | H | H | P7 | H |
| Lₐ₂₅₆₄ | P11 | F | H | H | H | H | H | P8 | H |
| Lₐ₂₅₆₅ | P11 | F | H | H | H | H | H | P9 | H |
| Lₐ₂₅₆₆ | P11 | F | H | H | H | H | H | P10 | H |
| Lₐ₂₅₆₇ | P11 | F | H | H | H | H | H | P11 | H |
| Lₐ₂₅₆₈ | P11 | F | H | H | H | H | H | P12 | H |
| Lₐ₂₅₆₉ | P11 | F | H | H | H | H | H | P13 | H |
| Lₐ₂₅₇₀ | P11 | F | H | H | H | H | H | P14 | H |
| Lₐ₂₅₇₁ | P11 | F | H | H | H | H | H | P15 | H |
| Lₐ₂₅₇₂ | P11 | F | H | H | H | H | H | P16 | H |
| Lₐ₂₅₇₃ | P11 | F | H | H | H | H | H | P17 | H |
| Lₐ₂₅₇₄ | P11 | F | H | H | H | H | H | P18 | H |
| Lₐ₂₅₇₅ | P11 | F | H | H | H | H | H | P19 | H |
| Lₐ₂₅₇₆ | P11 | F | H | H | H | H | H | P20 | H |
| Lₐ₂₅₇₇ | P11 | F | H | H | H | H | H | P21 | H |
| Lₐ₂₅₇₈ | P11 | F | H | H | H | H | F | P1 | H |
| Lₐ₂₅₇₉ | P11 | F | H | H | H | H | F | P2 | H |
| Lₐ₂₅₈₀ | P11 | F | H | H | H | H | F | P3 | H |
| Lₐ₂₅₈₁ | P11 | F | H | H | H | H | F | P4 | H |
| Lₐ₂₅₈₂ | P11 | F | H | H | H | H | F | P5 | H |
| Lₐ₂₅₈₃ | P11 | F | H | H | H | H | F | P6 | H |
| Lₐ₂₅₈₄ | P11 | F | H | H | H | H | F | P7 | H |
| Lₐ₂₅₈₅ | P11 | F | H | H | H | H | F | P8 | H |
| Lₐ₂₅₈₆ | P11 | F | H | H | H | H | F | P9 | H |
| Lₐ₂₅₈₇ | P11 | F | H | H | H | H | F | P10 | H |
| Lₐ₂₅₈₈ | P11 | F | H | H | H | H | F | P11 | H |
| Lₐ₂₅₈₉ | P11 | F | H | H | H | H | F | P12 | H |
| Lₐ₂₅₉₀ | P11 | F | H | H | H | H | F | P13 | H |
| Lₐ₂₅₉₁ | P11 | F | H | H | H | H | F | P14 | H |
| Lₐ₂₅₉₂ | P11 | F | H | H | H | H | F | P15 | H |
| Lₐ₂₅₉₃ | P11 | F | H | H | H | H | F | P16 | H |
| Lₐ₂₅₉₄ | P11 | F | H | H | H | H | F | P17 | H |
| Lₐ₂₅₉₅ | P11 | F | H | H | H | H | F | P18 | H |
| Lₐ₂₅₉₆ | P11 | F | H | H | H | H | F | P19 | H |
| Lₐ₂₅₉₇ | P11 | F | H | H | H | H | F | P20 | H |
| Lₐ₂₅₉₈ | P11 | F | H | H | H | H | F | P21 | H |
| Lₐ₂₅₉₉ | P11 | F | H | H | H | H | P1 | P1 | H |
| Lₐ₂₆₀₀ | P11 | F | H | H | H | H | P1 | P3 | H |
| Lₐ₂₆₀₁ | P11 | F | H | H | H | H | P1 | P8 | H |
| Lₐ₂₆₀₂ | P11 | F | H | H | H | H | P1 | P10 | H |
| Lₐ₂₆₀₃ | P11 | F | H | H | H | H | P1 | P20 | H |
| Lₐ₂₆₀₄ | P11 | F | H | H | H | H | P1 | P21 | H |
| Lₐ₂₆₀₅ | P11 | F | H | H | H | H | P2 | P2 | H |
| Lₐ₂₆₀₆ | P11 | F | H | H | H | H | P2 | P4 | H |
| Lₐ₂₆₀₇ | P11 | F | H | H | H | H | P2 | P5 | H |
| Lₐ₂₆₀₈ | P11 | F | H | H | H | H | P2 | P9 | H |
| Lₐ₂₆₀₉ | P11 | F | H | H | H | H | P2 | P11 | H |
| Lₐ₂₆₁₀ | P11 | F | H | H | H | H | P2 | P20 | H |
| Lₐ₂₆₁₁ | P11 | F | H | H | H | H | P2 | P21 | H |
| Lₐ₂₆₁₂ | P11 | F | H | H | H | D | D | D | D |
| Lₐ₂₆₁₃ | P11 | F | H | H | H | D | F | D | D |
| Lₐ₂₆₁₄ | P11 | F | H | H | H | D | D | F | D |
| Lₐ₂₆₁₅ | P11 | F | H | H | H | D | P2 | D | D |
| Lₐ₂₆₁₆ | P11 | F | H | H | H | D | D | P2 | D |
| Lₐ₂₆₁₇ | P11 | F | H | H | H | D | P2 | P2 | D |
| Lₐ₂₆₁₈ | P11 | F | H | H | D | H | H | H | H |
| Lₐ₂₆₁₉ | P11 | F | H | H | D | H | P1 | H | H |
| Lₐ₂₆₂₀ | P11 | F | H | H | D | H | P2 | H | H |
| Lₐ₂₆₂₁ | P11 | F | H | H | D | H | P5 | H | H |
| Lₐ₂₆₂₂ | P11 | F | H | H | D | H | P10 | H | H |
| Lₐ₂₆₂₃ | P11 | F | H | H | D | H | P11 | H | H |
| Lₐ₂₆₂₄ | P11 | F | H | H | D | H | H | P1 | H |
| Lₐ₂₆₂₅ | P11 | F | H | H | D | H | H | P2 | H |
| Lₐ₂₆₂₆ | P11 | F | H | H | D | H | H | P4 | H |
| Lₐ₂₆₂₇ | P11 | F | H | H | D | H | H | P5 | H |
| Lₐ₂₆₂₈ | P11 | F | H | H | D | H | H | P10 | H |
| Lₐ₂₆₂₉ | P11 | F | H | H | D | H | H | P11 | H |
| Lₐ₂₆₃₀ | P11 | F | H | H | D | H | P1 | F | H |
| Lₐ₂₆₃₁ | P11 | F | H | H | D | H | P2 | F | H |
| Lₐ₂₆₃₂ | P11 | F | H | H | D | H | P11 | F | H |
| Lₐ₂₆₃₃ | P11 | F | H | H | D | H | F | P1 | H |
| Lₐ₂₆₃₄ | P11 | F | H | H | D | H | F | P2 | H |
| Lₐ₂₆₃₅ | P11 | F | H | H | D | H | F | P3 | H |
| Lₐ₂₆₃₆ | P11 | F | H | H | D | H | F | P4 | H |
| Lₐ₂₆₃₇ | P11 | F | H | H | D | H | F | P5 | H |
| Lₐ₂₆₃₈ | P11 | F | H | H | D | H | F | P8 | H |
| Lₐ₂₆₃₉ | P11 | F | H | H | D | H | F | P11 | H |
| Lₐ₂₆₄₀ | P11 | F | H | H | D | H | P1 | P1 | H |
| Lₐ₂₆₄₁ | P11 | F | H | H | D | H | P2 | P2 | H |
| Lₐ₂₆₄₂ | P11 | F | H | H | D | H | P2 | P2 | D |
| Lₐ₂₆₄₃ | P11 | F | H | H | P20 | H | H | H | H |
| Lₐ₂₆₄₄ | P11 | F | H | H | P20 | H | P1 | H | H |
| Lₐ₂₆₄₅ | P11 | F | H | H | P20 | H | P2 | H | H |
| Lₐ₂₆₄₆ | P11 | F | H | H | P20 | H | P3 | H | H |
| Lₐ₂₆₄₇ | P11 | F | H | H | P20 | H | P4 | H | H |
| Lₐ₂₆₄₈ | P11 | F | H | H | P20 | H | P5 | H | H |
| Lₐ₂₆₄₉ | P11 | F | H | H | P20 | H | P6 | H | H |
| Lₐ₂₆₅₀ | P11 | F | H | H | P20 | H | P7 | H | H |
| Lₐ₂₆₅₁ | P11 | F | H | H | P20 | H | P8 | H | H |
| Lₐ₂₆₅₂ | P11 | F | H | H | P20 | H | P9 | H | H |
| Lₐ₂₆₅₃ | P11 | F | H | H | P20 | H | P10 | H | H |
| Lₐ₂₆₅₄ | P11 | F | H | H | P20 | H | P11 | H | H |
| Lₐ₂₆₅₅ | P11 | F | H | H | P20 | H | P12 | H | H |
| Lₐ₂₆₅₆ | P11 | F | H | H | P20 | H | P13 | H | H |
| Lₐ₂₆₅₇ | P11 | F | H | H | P20 | H | P14 | H | H |
| Lₐ₂₆₅₈ | P11 | F | H | H | P20 | H | P15 | H | H |
| Lₐ₂₆₅₉ | P11 | F | H | H | P20 | H | P16 | H | H |
| Lₐ₂₆₆₀ | P11 | F | H | H | P20 | H | P17 | H | H |
| Lₐ₂₆₆₁ | P11 | F | H | H | P20 | H | P18 | H | H |
| Lₐ₂₆₆₂ | P11 | F | H | H | P20 | H | P19 | H | H |
| Lₐ₂₆₆₃ | P11 | F | H | H | P20 | H | P20 | H | H |
| Lₐ₂₆₆₄ | P11 | F | H | H | P20 | H | P21 | H | H |
| Lₐ₂₆₆₅ | P11 | F | H | H | P20 | H | H | P1 | H |
| Lₐ₂₆₆₆ | P11 | F | H | H | P20 | H | H | P2 | H |
| Lₐ₂₆₆₇ | P11 | F | H | H | P20 | H | H | P3 | H |
| Lₐ₂₆₆₈ | P11 | F | H | H | P20 | H | H | P4 | H |
| Lₐ₂₆₆₉ | P11 | F | H | H | P20 | H | H | P5 | H |
| Lₐ₂₆₇₀ | P11 | F | H | H | P20 | H | H | P6 | H |
| Lₐ₂₆₇₁ | P11 | F | H | H | P20 | H | H | P7 | H |
| Lₐ₂₆₇₂ | P11 | F | H | H | P20 | H | H | P8 | H |
| Lₐ₂₆₇₃ | P11 | F | H | H | P20 | H | H | P9 | H |
| Lₐ₂₆₇₄ | P11 | F | H | H | P20 | H | H | P10 | H |
| Lₐ₂₆₇₅ | P11 | F | H | H | P20 | H | H | P11 | H |
| Lₐ₂₆₇₆ | P11 | F | H | H | P20 | H | H | P12 | H |
| Lₐ₂₆₇₇ | P11 | F | H | H | P20 | H | H | P15 | H |
| Lₐ₂₆₇₈ | P11 | F | H | H | P20 | H | H | P17 | H |
| Lₐ₂₆₇₉ | P11 | F | H | H | P20 | H | H | P18 | H |
| Lₐ₂₆₈₀ | P11 | F | H | H | P20 | H | H | P19 | H |
| Lₐ₂₆₈₁ | P11 | F | H | H | P20 | H | H | P20 | H |
| Lₐ₂₆₈₂ | P11 | F | H | H | P20 | H | H | P21 | H |
| Lₐ₂₆₈₃ | P11 | F | H | H | P20 | H | F | H | H |
| Lₐ₂₆₈₄ | P11 | F | H | H | P20 | H | F | P1 | H |
| Lₐ₂₆₈₅ | P11 | F | H | H | P20 | H | F | P2 | H |
| Lₐ₂₆₈₆ | P11 | F | H | H | P20 | H | F | P3 | H |
| Lₐ₂₆₈₇ | P11 | F | H | H | P20 | H | F | P4 | H |
| Lₐ₂₆₈₈ | P11 | F | H | H | P20 | H | F | P5 | H |
| Lₐ₂₆₈₉ | P11 | F | H | H | P20 | H | F | P6 | H |
| Lₐ₂₆₉₀ | P11 | F | H | H | P20 | H | F | P7 | H |
| Lₐ₂₆₉₁ | P11 | F | H | H | P20 | H | F | P8 | H |
| Lₐ₂₆₉₂ | P11 | F | H | H | P20 | H | F | P9 | H |
| Lₐ₂₆₉₃ | P11 | F | H | H | P20 | H | F | P10 | H |
| Lₐ₂₆₉₄ | P11 | F | H | H | P20 | H | F | P11 | H |
| Lₐ₂₆₉₅ | P11 | F | H | H | P20 | H | P1 | F | H |
| Lₐ₂₆₉₆ | P11 | F | H | H | P20 | H | P2 | F | H |
| Lₐ₂₆₉₇ | P11 | F | H | H | P20 | H | P3 | F | H |
| Lₐ₂₆₉₈ | P11 | F | H | H | P20 | H | P4 | F | H |
| Lₐ₂₆₉₉ | P11 | F | H | H | P20 | H | P5 | F | H |
| Lₐ₂₇₀₀ | P11 | F | H | H | P20 | H | P6 | F | H |
| Lₐ₂₇₀₁ | P11 | F | H | H | P20 | H | P7 | F | H |
| Lₐ₂₇₀₂ | P11 | F | H | H | P20 | H | P8 | F | H |
| Lₐ₂₇₀₃ | P11 | F | H | H | P20 | H | P9 | F | H |
| Lₐ₂₇₀₄ | P11 | F | H | H | P20 | H | P10 | F | H |
| Lₐ₂₇₀₅ | P11 | F | H | H | P20 | H | P11 | F | H |
| Lₐ₂₇₀₆ | P11 | F | H | H | P20 | H | P1 | P1 | H |
| Lₐ₂₇₀₇ | P11 | F | H | H | P20 | H | P2 | P2 | H |
| Lₐ₂₇₀₈ | P11 | F | H | H | P20 | D | D | D | D |
| Lₐ₂₇₀₉ | P11 | F | H | H | P20 | D | P2 | P2 | D |
| Lₐ₂₇₁₀ | P11 | F | H | H | P20 | D | F | P4 | D |
| Lₐ₂₇₁₁ | P11 | F | H | H | P20 | D | F | P5 | D |
| Lₐ₂₇₁₂ | P11 | F | H | H | P20 | D | F | P9 | D |
| Lₐ₂₇₁₃ | P11 | F | H | H | P20 | D | F | P11 | D |
| Lₐ₂₇₁₄ | P11 | F | H | H | P21 | H | H | H | H |
| Lₐ₂₇₁₅ | P11 | F | H | H | P21 | H | P1 | H | H |
| Lₐ₂₇₁₆ | P11 | F | H | H | P21 | H | P2 | H | H |
| Lₐ₂₇₁₇ | P11 | F | H | H | P21 | H | P3 | H | H |
| Lₐ₂₇₁₈ | P11 | F | H | H | P21 | H | P4 | H | H |
| Lₐ₂₇₁₉ | P11 | F | H | H | P21 | H | P5 | H | H |
| Lₐ₂₇₂₀ | P11 | F | H | H | P21 | H | P6 | H | H |
| Lₐ₂₇₂₁ | P11 | F | H | H | P21 | H | P7 | H | H |
| Lₐ₂₇₂₂ | P11 | F | H | H | P21 | H | P8 | H | H |
| Lₐ₂₇₂₃ | P11 | F | H | H | P21 | H | P9 | H | H |
| Lₐ₂₇₂₄ | P11 | F | H | H | P21 | H | P10 | H | H |
| Lₐ₂₇₂₅ | P11 | F | H | H | P21 | H | P11 | H | H |
| Lₐ₂₇₂₆ | P11 | F | H | H | P21 | H | P12 | H | H |
| Lₐ₂₇₂₇ | P11 | F | H | H | P21 | H | P13 | H | H |
| Lₐ₂₇₂₈ | P11 | F | H | H | P21 | H | P14 | H | H |
| Lₐ₂₇₂₉ | P11 | F | H | H | P21 | H | P15 | H | H |
| Lₐ₂₇₃₀ | P11 | F | H | H | P21 | H | P16 | H | H |
| Lₐ₂₇₃₁ | P11 | F | H | H | P21 | H | P17 | H | H |
| Lₐ₂₇₃₂ | P11 | F | H | H | P21 | H | P18 | H | H |
| Lₐ₂₇₃₃ | P11 | F | H | H | P21 | H | P19 | H | H |
| Lₐ₂₇₃₄ | P11 | F | H | H | P21 | H | P20 | H | H |
| Lₐ₂₇₃₅ | P11 | F | H | H | P21 | H | P21 | H | H |
| Lₐ₂₇₃₆ | P11 | F | H | H | P21 | H | H | P1 | H |
| Lₐ₂₇₃₇ | P11 | F | H | H | P21 | H | H | P2 | H |
| Lₐ₂₇₃₈ | P11 | F | H | H | P21 | H | H | P3 | H |
| Lₐ₂₇₃₉ | P11 | F | H | H | P21 | H | H | P4 | H |
| Lₐ₂₇₄₀ | P11 | F | H | H | P21 | H | H | P5 | H |
| Lₐ₂₇₄₁ | P11 | F | H | H | P21 | H | H | P6 | H |
| Lₐ₂₇₄₂ | P11 | F | H | H | P21 | H | H | P7 | H |
| Lₐ₂₇₄₃ | P11 | F | H | H | P21 | H | H | P8 | H |
| Lₐ₂₇₄₄ | P11 | F | H | H | P21 | H | H | P9 | H |
| Lₐ₂₇₄₅ | P11 | F | H | H | P21 | H | H | P10 | H |
| Lₐ₂₇₄₆ | P11 | F | H | H | P21 | H | H | P11 | H |
| Lₐ₂₇₄₇ | P11 | F | H | H | P21 | H | H | P12 | H |
| Lₐ₂₇₄₈ | P11 | F | H | H | P21 | H | H | P15 | H |
| Lₐ₂₇₄₉ | P11 | F | H | H | P21 | H | H | P17 | H |
| Lₐ₂₇₅₀ | P11 | F | H | H | P21 | H | H | P18 | H |
| Lₐ₂₇₅₁ | P11 | F | H | H | P21 | H | H | P19 | H |
| Lₐ₂₇₅₂ | P11 | F | H | H | P21 | H | H | P20 | H |
| Lₐ₂₇₅₃ | P11 | F | H | H | P21 | H | H | P21 | H |
| Lₐ₂₇₅₄ | P11 | F | H | H | P21 | H | F | H | H |
| Lₐ₂₇₅₅ | P11 | F | H | H | P21 | H | F | P1 | H |
| Lₐ₂₇₅₆ | P11 | F | H | H | P21 | H | F | P2 | H |
| Lₐ₂₇₅₇ | P11 | F | H | H | P21 | H | F | P3 | H |
| Lₐ₂₇₅₈ | P11 | F | H | H | P21 | H | F | P4 | H |
| Lₐ₂₇₅₉ | P11 | F | H | H | P21 | H | F | P5 | H |
| Lₐ₂₇₆₀ | P11 | F | H | H | P21 | H | F | P6 | H |
| Lₐ₂₇₆₁ | P11 | F | H | H | P21 | H | F | P7 | H |
| Lₐ₂₇₆₂ | P11 | F | H | H | P21 | H | F | P8 | H |
| Lₐ₂₇₆₃ | P11 | F | H | H | P21 | H | F | P9 | H |
| Lₐ₂₇₆₄ | P11 | F | H | H | P21 | H | F | P10 | H |
| Lₐ₂₇₆₅ | P11 | F | H | H | P21 | H | F | P11 | H |
| Lₐ₂₇₆₆ | P11 | F | H | H | P21 | H | P1 | F | H |
| Lₐ₂₇₆₇ | P11 | F | H | H | P21 | H | P2 | F | H |
| Lₐ₂₇₆₈ | P11 | F | H | H | P21 | H | P3 | F | H |
| Lₐ₂₇₆₉ | P11 | F | H | H | P21 | H | P4 | F | H |
| Lₐ₂₇₇₀ | P11 | F | H | H | P21 | H | P5 | F | H |
| Lₐ₂₇₇₁ | P11 | F | H | H | P21 | H | P6 | F | H |
| Lₐ₂₇₇₂ | P11 | F | H | H | P21 | H | P7 | F | H |
| Lₐ₂₇₇₃ | P11 | F | H | H | P21 | H | P8 | F | H |
| Lₐ₂₇₇₄ | P11 | F | H | H | P21 | H | P9 | F | H |
| Lₐ₂₇₇₅ | P11 | F | H | H | P21 | H | P10 | F | H |
| Lₐ₂₇₇₆ | P11 | F | H | H | P21 | H | P11 | F | H |
| Lₐ₂₇₇₇ | P11 | F | H | H | P21 | H | P1 | P1 | H |
| Lₐ₂₇₇₈ | P11 | F | H | H | P21 | H | P2 | P2 | H |
| Lₐ₂₇₇₉ | P11 | F | H | H | P21 | D | D | D | D |
| Lₐ₂₇₈₀ | P11 | F | H | H | P21 | D | P2 | P2 | D |
| Lₐ₂₇₈₁ | P11 | F | H | H | P21 | D | F | P4 | D |
| Lₐ₂₇₈₂ | P11 | F | H | H | P21 | D | F | P5 | D |
| Lₐ₂₇₈₃ | P11 | F | H | H | P21 | D | F | P9 | D |
| Lₐ₂₇₈₄ | P11 | F | H | H | P21 | D | F | P11 | D |
| Lₐ₂₇₈₅ | P11 | F | H | H | P54 | H | H | H | H |
| Lₐ₂₇₈₆ | P11 | F | H | H | P54 | H | P1 | H | H |
| Lₐ₂₇₈₇ | P11 | F | H | H | P54 | H | P2 | H | H |
| Lₐ₂₇₈₈ | P11 | F | H | H | P54 | H | P3 | H | H |
| Lₐ₂₇₈₉ | P11 | F | H | H | P54 | H | P4 | H | H |
| Lₐ₂₇₉₀ | P11 | F | H | H | P54 | H | P5 | H | H |
| Lₐ₂₇₉₁ | P11 | F | H | H | P54 | H | P6 | H | H |
| Lₐ₂₇₉₂ | P11 | F | H | H | P54 | H | P7 | H | H |
| Lₐ₂₇₉₃ | P11 | F | H | H | P54 | H | P8 | H | H |
| Lₐ₂₇₉₄ | P11 | F | H | H | P54 | H | P9 | H | H |
| Lₐ₂₇₉₅ | P11 | F | H | H | P54 | H | P10 | H | H |
| Lₐ₂₇₉₆ | P11 | F | H | H | P54 | H | P11 | H | H |
| Lₐ₂₇₉₇ | P11 | F | H | H | P54 | H | P12 | H | H |
| Lₐ₂₇₉₈ | P11 | F | H | H | P54 | H | P13 | H | H |
| Lₐ₂₇₉₉ | P11 | F | H | H | P54 | H | P14 | H | H |
| Lₐ₂₈₀₀ | P11 | F | H | H | P54 | H | P15 | H | H |
| Lₐ₂₈₀₁ | P11 | F | H | H | P54 | H | P16 | H | H |
| Lₐ₂₈₀₂ | P11 | F | H | H | P54 | H | P17 | H | H |
| Lₐ₂₈₀₃ | P11 | F | H | H | P54 | H | P18 | H | H |
| Lₐ₂₈₀₄ | P11 | F | H | H | P54 | H | P19 | H | H |
| Lₐ₂₈₀₅ | P11 | F | H | H | P54 | H | P20 | H | H |
| Lₐ₂₈₀₆ | P11 | F | H | H | P54 | H | P21 | H | H |
| Lₐ₂₈₀₇ | P11 | F | H | H | P54 | H | H | P1 | H |
| Lₐ₂₈₀₈ | P11 | F | H | H | P54 | H | H | P2 | H |
| Lₐ₂₈₀₉ | P11 | F | H | H | P54 | H | H | P3 | H |
| Lₐ₂₈₁₀ | P11 | F | H | H | P54 | H | H | P4 | H |
| Lₐ₂₈₁₁ | P11 | F | H | H | P54 | H | H | P5 | H |
| Lₐ₂₈₁₂ | P11 | F | H | H | P54 | H | H | P6 | H |
| Lₐ₂₈₁₃ | P11 | F | H | H | P54 | H | H | P7 | H |
| Lₐ₂₈₁₄ | P11 | F | H | H | P54 | H | H | P8 | H |
| Lₐ₂₈₁₅ | P11 | F | H | H | P54 | H | H | P9 | H |
| Lₐ₂₈₁₆ | P11 | F | H | H | P54 | H | H | P10 | H |
| Lₐ₂₈₁₇ | P11 | F | H | H | P54 | H | H | P11 | H |
| Lₐ₂₈₁₈ | P11 | F | H | H | P54 | H | H | P12 | H |
| Lₐ₂₈₁₉ | P11 | F | H | H | P54 | H | H | P15 | H |
| Lₐ₂₈₂₀ | P11 | F | H | H | P54 | H | H | P17 | H |
| Lₐ₂₈₂₁ | P11 | F | H | H | P54 | H | H | P18 | H |
| Lₐ₂₈₂₂ | P11 | F | H | H | P54 | H | H | P19 | H |
| Lₐ₂₈₂₃ | P11 | F | H | H | P54 | H | H | P20 | H |
| Lₐ₂₈₂₄ | P11 | F | H | H | P54 | H | H | P21 | H |
| Lₐ₂₈₂₅ | P11 | F | H | H | P54 | H | F | H | H |
| Lₐ₂₈₂₆ | P11 | F | H | H | P54 | H | F | P1 | H |
| Lₐ₂₈₂₇ | P11 | F | H | H | P54 | H | F | P2 | H |
| Lₐ₂₈₂₈ | P11 | F | H | H | P54 | H | F | P3 | H |
| Lₐ₂₈₂₉ | P11 | F | H | H | P54 | H | F | P4 | H |
| Lₐ₂₈₃₀ | P11 | F | H | H | P54 | H | F | P5 | H |
| Lₐ₂₈₃₁ | P11 | F | H | H | P54 | H | F | P6 | H |
| Lₐ₂₈₃₂ | P11 | F | H | H | P54 | H | F | P7 | H |
| Lₐ₂₈₃₃ | P11 | F | H | H | P54 | H | F | P8 | H |
| Lₐ₂₈₃₄ | P11 | F | H | H | P54 | H | F | P9 | H |
| Lₐ₂₈₃₅ | P11 | F | H | H | P54 | H | F | P10 | H |
| Lₐ₂₈₃₆ | P11 | F | H | H | P54 | H | F | P11 | H |
| Lₐ₂₈₃₇ | P11 | F | H | H | P54 | H | P1 | F | H |
| Lₐ₂₈₃₈ | P11 | F | H | H | P54 | H | P2 | F | H |
| Lₐ₂₈₃₉ | P11 | F | H | H | P54 | H | P3 | F | H |
| Lₐ₂₈₄₀ | P11 | F | H | H | P54 | H | P4 | F | H |
| Lₐ₂₈₄₁ | P11 | F | H | H | P54 | H | P5 | F | H |
| Lₐ₂₈₄₂ | P11 | F | H | H | P54 | H | P6 | F | H |
| Lₐ₂₈₄₃ | P11 | F | H | H | P54 | H | P7 | F | H |
| Lₐ₂₈₄₄ | P11 | F | H | H | P54 | H | P8 | F | H |
| Lₐ₂₈₄₅ | P11 | F | H | H | P54 | H | P9 | F | H |
| Lₐ₂₈₄₆ | P11 | F | H | H | P54 | H | P10 | F | H |
| Lₐ₂₈₄₇ | P11 | F | H | H | P54 | H | P11 | F | H |
| Lₐ₂₈₄₈ | P11 | F | H | H | P54 | H | P1 | P1 | H |
| Lₐ₂₈₄₉ | P11 | F | H | H | P54 | H | P2 | P2 | H |
| Lₐ₂₈₅₀ | P11 | F | H | H | P54 | D | D | D | D |
| Lₐ₂₈₅₁ | P11 | F | H | H | P54 | D | P2 | P2 | D |
| Lₐ₂₈₅₂ | P11 | F | H | H | P54 | D | F | P4 | D |
| Lₐ₂₈₅₃ | P11 | F | H | H | P54 | D | F | P5 | D |
| Lₐ₂₈₅₄ | P11 | F | H | H | P54 | D | F | P9 | D |
| Lₐ₂₈₅₅ | P11 | F | H | H | P54 | D | F | P11 | D |
| Lₐ₂₈₅₆ | P11 | F | H | H | P96 | H | H | H | H |
| Lₐ₂₈₅₇ | P11 | F | H | H | P96 | H | P1 | H | H |
| Lₐ₂₈₅₈ | P11 | F | H | H | P96 | H | P2 | H | H |
| Lₐ₂₈₅₉ | P11 | F | H | H | P96 | H | P3 | H | H |
| Lₐ₂₈₆₀ | P11 | F | H | H | P96 | H | P4 | H | H |
| Lₐ₂₈₆₁ | P11 | F | H | H | P96 | H | P5 | H | H |
| Lₐ₂₈₆₂ | P11 | F | H | H | P96 | H | P6 | H | H |
| Lₐ₂₈₆₃ | P11 | F | H | H | P96 | H | P7 | H | H |
| Lₐ₂₈₆₄ | P11 | F | H | H | P96 | H | P8 | H | H |
| Lₐ₂₈₆₅ | P11 | F | H | H | P96 | H | P9 | H | H |
| Lₐ₂₈₆₆ | P11 | F | H | H | P96 | H | P10 | H | H |
| Lₐ₂₈₆₇ | P11 | F | H | H | P96 | H | P11 | H | H |
| Lₐ₂₈₆₈ | P11 | F | H | H | P96 | H | P12 | H | H |
| Lₐ₂₈₆₉ | P11 | F | H | H | P96 | H | P13 | H | H |
| Lₐ₂₈₇₀ | P11 | F | H | H | P96 | H | P14 | H | H |
| Lₐ₂₈₇₁ | P11 | F | H | H | P96 | H | P15 | H | H |
| Lₐ₂₈₇₂ | P11 | F | H | H | P96 | H | P16 | H | H |
| Lₐ₂₈₇₃ | P11 | F | H | H | P96 | H | P17 | H | H |
| Lₐ₂₈₇₄ | P11 | F | H | H | P96 | H | P18 | H | H |
| Lₐ₂₈₇₅ | P11 | F | H | H | P96 | H | P19 | H | H |
| Lₐ₂₈₇₆ | P11 | F | H | H | P96 | H | P20 | H | H |
| Lₐ₂₈₇₇ | P11 | F | H | H | P96 | H | P21 | H | H |
| Lₐ₂₈₇₈ | P11 | F | H | H | P96 | H | H | P1 | H |
| Lₐ₂₈₇₉ | P11 | F | H | H | P96 | H | H | P2 | H |
| Lₐ₂₈₈₀ | P11 | F | H | H | P96 | H | H | P3 | H |
| Lₐ₂₈₈₁ | P11 | F | H | H | P96 | H | H | P4 | H |
| Lₐ₂₈₈₂ | P11 | F | H | H | P96 | H | H | P5 | H |
| Lₐ₂₈₈₃ | P11 | F | H | H | P96 | H | H | P6 | H |
| Lₐ₂₈₈₄ | P11 | F | H | H | P96 | H | H | P7 | H |
| Lₐ₂₆₈₅ | P11 | F | H | H | P96 | H | H | P8 | H |
| Lₐ₂₈₈₆ | P11 | F | H | H | P96 | H | H | P9 | H |
| Lₐ₂₈₈₇ | P11 | F | H | H | P96 | H | H | P10 | H |
| Lₐ₂₈₈₈ | P11 | F | H | H | P96 | H | H | P11 | H |
| Lₐ₂₈₈₉ | P11 | F | H | H | P96 | H | H | P12 | H |
| Lₐ₂₈₉₀ | P11 | F | H | H | P96 | H | H | P15 | H |
| Lₐ₂₈₉₁ | P11 | F | H | H | P96 | H | H | P17 | H |
| Lₐ₂₈₉₂ | P11 | F | H | H | P96 | H | H | P18 | H |
| Lₐ₂₈₉₃ | P11 | F | H | H | P96 | H | H | P19 | H |
| Lₐ₂₈₉₄ | P11 | F | H | H | P96 | H | H | P20 | H |
| Lₐ₂₈₉₅ | P11 | F | H | H | P96 | H | H | P21 | H |
| Lₐ₂₈₉₆ | P11 | F | H | H | P96 | H | F | H | H |
| Lₐ₂₈₉₇ | P11 | F | H | H | P96 | H | F | P1 | H |
| Lₐ₂₈₉₈ | P11 | F | H | H | P96 | H | F | P2 | H |
| Lₐ₂₈₉₉ | P11 | F | H | H | P96 | H | F | P3 | H |
| Lₐ₂₉₀₀ | P11 | F | H | H | P96 | H | F | P4 | H |
| Lₐ₂₉₀₁ | P11 | F | H | H | P96 | H | F | P5 | H |
| Lₐ₂₉₀₂ | P11 | F | H | H | P96 | H | F | P6 | H |
| Lₐ₂₉₀₃ | P11 | F | H | H | P96 | H | F | P7 | H |
| Lₐ₂₉₀₄ | P11 | F | H | H | P96 | H | F | P8 | H |
| Lₐ₂₉₀₅ | P11 | F | H | H | P96 | H | F | P9 | H |
| Lₐ₂₉₀₆ | P11 | F | H | H | P96 | H | F | P10 | H |
| Lₐ₂₉₀₇ | P11 | F | H | H | P96 | H | F | P11 | H |
| Lₐ₂₉₀₈ | P11 | F | H | H | P96 | H | P1 | F | H |
| Lₐ₂₉₀₉ | P11 | F | H | H | P96 | H | P2 | F | H |
| Lₐ₂₉₁₀ | P11 | F | H | H | P96 | H | P3 | F | H |
| Lₐ₂₉₁₁ | P11 | F | H | H | P96 | H | P4 | F | H |
| Lₐ₂₉₁₂ | P11 | F | H | H | P96 | H | P5 | F | H |
| Lₐ₂₉₁₃ | P11 | F | H | H | P96 | H | P6 | F | H |
| Lₐ₂₉₁₄ | P11 | F | H | H | P96 | H | P7 | F | H |
| Lₐ₂₉₁₅ | P11 | F | H | H | P96 | H | P8 | F | H |
| Lₐ₂₉₁₆ | P11 | F | H | H | P96 | H | P9 | F | H |
| Lₐ₂₉₁₇ | P11 | F | H | H | P96 | H | P10 | F | H |
| Lₐ₂₉₁₈ | P11 | F | H | H | P96 | H | P11 | F | H |
| Lₐ₂₉₁₉ | P11 | F | H | H | P96 | H | P1 | P1 | H |
| Lₐ₂₉₂₀ | P11 | F | H | H | P96 | H | P2 | P2 | H |
| Lₐ₂₉₂₁ | P11 | F | H | H | P96 | D | D | D | D |
| Lₐ₂₉₂₂ | P11 | F | H | H | P96 | D | P2 | P2 | D |
| Lₐ₂₉₂₃ | P11 | F | H | H | P96 | D | F | P4 | D |
| Lₐ₂₉₂₄ | P11 | F | H | H | P96 | D | F | P5 | D |
| Lₐ₂₉₂₅ | P11 | F | H | H | P96 | D | F | P9 | D |
| Lₐ₂₉₂₆ | P11 | F | H | H | P96 | D | F | P11 | D |
| Lₐ₂₉₂₇ | P11 | F | H | H | P97 | H | H | H | H |
| Lₐ₂₉₂₈ | P11 | F | H | H | P97 | H | P1 | H | H |
| Lₐ₂₉₂₉ | P11 | F | H | H | P97 | H | P2 | H | H |
| Lₐ₂₉₃₀ | P11 | F | H | H | P97 | H | P3 | H | H |
| Lₐ₂₉₃₁ | P11 | F | H | H | P97 | H | P4 | H | H |
| Lₐ₂₉₃₂ | P11 | F | H | H | P97 | H | P5 | H | H |
| Lₐ₂₉₃₃ | P11 | F | H | H | P97 | H | P6 | H | H |
| Lₐ₂₉₃₄ | P11 | F | H | H | P97 | H | P7 | H | H |
| Lₐ₂₉₃₅ | P11 | F | H | H | P97 | H | P8 | H | H |
| Lₐ₂₉₃₆ | P11 | F | H | H | P97 | H | P9 | H | H |
| Lₐ₂₉₃₇ | P11 | F | H | H | P97 | H | P10 | H | H |
| Lₐ₂₉₃₈ | P11 | F | H | H | P97 | H | P11 | H | H |
| Lₐ₂₉₃₉ | P11 | F | H | H | P97 | H | P12 | H | H |
| Lₐ₂₉₄₀ | P11 | F | H | H | P97 | H | P13 | H | H |
| Lₐ₂₉₄₁ | P11 | F | H | H | P97 | H | P14 | H | H |
| Lₐ₂₉₄₂ | P11 | F | H | H | P97 | H | P15 | H | H |
| Lₐ₂₉₄₃ | P11 | F | H | H | P97 | H | P16 | H | H |
| Lₐ₂₉₄₄ | P11 | F | H | H | P97 | H | P17 | H | H |
| Lₐ₂₉₄₅ | P11 | F | H | H | P97 | H | P18 | H | H |
| Lₐ₂₉₄₆ | P11 | F | H | H | P97 | H | P19 | H | H |
| Lₐ₂₉₄₇ | P11 | F | H | H | P97 | H | P20 | H | H |
| Lₐ₂₉₄₈ | P11 | F | H | H | P97 | H | P21 | H | H |
| Lₐ₂₉₄₉ | P11 | F | H | H | P97 | H | H | P1 | H |
| Lₐ₂₉₅₀ | P11 | F | H | H | P97 | H | H | P2 | H |
| Lₐ₂₉₅₁ | P11 | F | H | H | P97 | H | H | P3 | H |
| Lₐ₂₉₅₂ | P11 | F | H | H | P97 | H | H | P4 | H |
| Lₐ₂₉₅₃ | P11 | F | H | H | P97 | H | H | P5 | H |
| Lₐ₂₉₅₄ | P11 | F | H | H | P97 | H | H | P6 | H |
| Lₐ₂₉₅₅ | P11 | F | H | H | P97 | H | H | P7 | H |
| Lₐ₂₉₅₆ | P11 | F | H | H | P97 | H | H | P8 | H |
| Lₐ₂₉₅₇ | P11 | F | H | H | P97 | H | H | P9 | H |
| Lₐ₂₉₅₈ | P11 | F | H | H | P97 | H | H | P10 | H |
| Lₐ₂₉₅₉ | P11 | F | H | H | P97 | H | H | P11 | H |
| Lₐ₂₉₆₀ | P11 | F | H | H | P97 | H | H | P12 | H |
| Lₐ₂₉₆₁ | P11 | F | H | H | P97 | H | H | P15 | H |
| Lₐ₂₉₆₂ | P11 | F | H | H | P97 | H | H | P17 | H |
| Lₐ₂₉₆₃ | P11 | F | H | H | P97 | H | H | P18 | H |
| Lₐ₂₉₆₄ | P11 | F | H | H | P97 | H | H | P19 | H |
| Lₐ₂₉₆₅ | P11 | F | H | H | P97 | H | H | P20 | H |
| Lₐ₂₉₆₆ | P11 | F | H | H | P97 | H | H | P21 | H |
| Lₐ₂₉₆₇ | P11 | F | H | H | P97 | H | F | H | H |
| Lₐ₂₉₆₈ | P11 | F | H | H | P97 | H | F | P1 | H |
| Lₐ₂₉₆₉ | P11 | F | H | H | P97 | H | F | P2 | H |
| Lₐ₂₉₇₀ | P11 | F | H | H | P97 | H | F | P3 | H |
| Lₐ₂₉₇₁ | P11 | F | H | H | P97 | H | F | P4 | H |
| Lₐ₂₉₇₂ | P11 | F | H | H | P97 | H | F | P5 | H |
| Lₐ₂₉₇₃ | P11 | F | H | H | P97 | H | F | P6 | H |
| Lₐ₂₉₇₄ | P11 | F | H | H | P97 | H | F | P7 | H |
| Lₐ₂₉₇₅ | P11 | F | H | H | P97 | H | F | P8 | H |
| Lₐ₂₉₇₆ | P11 | F | H | H | P97 | H | F | P9 | H |
| Lₐ₂₉₇₇ | P11 | F | H | H | P97 | H | F | P10 | H |
| Lₐ₂₉₇₈ | P11 | F | H | H | P97 | H | F | P11 | H |
| Lₐ₂₉₇₉ | P11 | F | H | H | P97 | H | P1 | F | H |
| Lₐ₂₉₈₀ | P11 | F | H | H | P97 | H | P2 | F | H |
| Lₐ₂₉₈₁ | P11 | F | H | H | P97 | H | P3 | F | H |
| Lₐ₂₉₈₂ | P11 | F | H | H | P97 | H | P4 | F | H |
| Lₐ₂₉₈₃ | P11 | F | H | H | P97 | H | P5 | F | H |
| Lₐ₂₉₈₄ | P11 | F | H | H | P97 | H | P6 | F | H |
| Lₐ₂₉₈₅ | P11 | F | H | H | P97 | H | P7 | F | H |
| Lₐ₂₉₈₆ | P11 | F | H | H | P97 | H | P8 | F | H |
| Lₐ₂₉₈₇ | P11 | F | H | H | P97 | H | P9 | F | H |
| Lₐ₂₉₈₈ | P11 | F | H | H | P97 | H | P10 | F | H |
| Lₐ₂₉₈₉ | P11 | F | H | H | P97 | H | P11 | F | H |
| Lₐ₂₉₉₀ | P11 | F | H | H | P97 | H | P1 | P1 | H |
| Lₐ₂₉₉₁ | P11 | F | H | H | P97 | H | P2 | P2 | H |
| Lₐ₂₉₉₂ | P11 | F | H | H | P97 | D | D | D | D |
| Lₐ₂₉₉₃ | P11 | F | H | H | P97 | D | P2 | P2 | D |
| Lₐ₂₉₉₄ | P11 | F | H | H | P97 | D | F | P4 | D |
| Lₐ₂₉₉₅ | P11 | F | H | H | P97 | D | F | P5 | D |
| Lₐ₂₉₉₆ | P11 | F | H | H | P97 | D | F | P9 | D |
| Lₐ₂₉₉₇ | P11 | F | H | H | P97 | D | F | P11 | D |
| Lₐ₂₉₉₈ | P11 | F | H | H | P102 | H | P1 | H | H |
| Lₐ₂₉₉₉ | P11 | F | H | H | P102 | H | P2 | H | H |
| Lₐ₃₀₀₀ | P11 | F | H | H | P102 | H | P3 | H | H |
| Lₐ₃₀₀₁ | P11 | F | H | H | P102 | H | P4 | H | H |
| Lₐ₃₀₀₂ | P11 | F | H | H | P102 | H | P5 | H | H |
| Lₐ₃₀₀₃ | P11 | F | H | H | P102 | H | P6 | H | H |
| Lₐ₃₀₀₄ | P11 | F | H | H | P102 | H | P7 | H | H |
| Lₐ₃₀₀₅ | P11 | F | H | H | P102 | H | P8 | H | H |
| Lₐ₃₀₀₆ | P11 | F | H | H | P102 | H | P9 | H | H |
| Lₐ₃₀₀₇ | P11 | F | H | H | P102 | H | P10 | H | H |
| Lₐ₃₀₀₈ | P11 | F | H | H | P102 | H | P11 | H | H |
| Lₐ₃₀₀₉ | P11 | F | H | H | P102 | H | P12 | H | H |
| Lₐ₃₀₁₀ | P11 | F | H | H | P102 | H | P13 | H | H |
| Lₐ₃₀₁₁ | P11 | F | H | H | P102 | H | P14 | H | H |
| Lₐ₃₀₁₂ | P11 | F | H | H | P102 | H | P15 | H | H |
| Lₐ₃₀₁₃ | P11 | F | H | H | P102 | H | P16 | H | H |
| Lₐ₃₀₁₄ | P11 | F | H | H | P102 | H | P17 | H | H |
| Lₐ₃₀₁₅ | P11 | F | H | H | P102 | H | P18 | H | H |
| Lₐ₃₀₁₆ | P11 | F | H | H | P102 | H | P19 | H | H |
| Lₐ₃₀₁₇ | P11 | F | H | H | P102 | H | P20 | H | H |
| Lₐ₃₀₁₈ | P11 | F | H | H | P102 | H | P21 | H | H |
| Lₐ₃₀₁₉ | P11 | F | H | H | P102 | H | H | P1 | H |
| Lₐ₃₀₂₀ | P11 | F | H | H | P102 | H | H | P2 | H |
| Lₐ₃₀₂₁ | P11 | F | H | H | P102 | H | H | P3 | H |
| Lₐ₃₀₂₂ | P11 | F | H | H | P102 | H | H | P4 | H |
| Lₐ₃₀₂₃ | P11 | F | H | H | P102 | H | H | P5 | H |
| Lₐ₃₀₂₄ | P11 | F | H | H | P102 | H | H | P6 | H |
| Lₐ₃₀₂₅ | P11 | F | H | H | P102 | H | H | P7 | H |
| Lₐ₃₀₂₆ | P11 | F | H | H | P102 | H | H | P8 | H |
| Lₐ₃₀₂₇ | P11 | F | H | H | P102 | H | H | P9 | H |
| Lₐ₃₀₂₈ | P11 | F | H | H | P102 | H | H | P10 | H |
| Lₐ₃₀₂₉ | P11 | F | H | H | P102 | H | H | P11 | H |
| Lₐ₃₀₃₀ | P11 | F | H | H | P102 | H | H | P12 | H |
| Lₐ₃₀₃₁ | P11 | F | H | H | P102 | H | H | P15 | H |
| Lₐ₃₀₃₂ | P11 | F | H | H | P102 | H | H | P17 | H |
| Lₐ₃₀₃₃ | P11 | F | H | H | P102 | H | H | P18 | H |
| Lₐ₃₀₃₄ | P11 | F | H | H | P102 | H | H | P19 | H |
| Lₐ₃₀₃₅ | P11 | F | H | H | P102 | H | H | P20 | H |
| Lₐ₃₀₃₆ | P11 | F | H | H | P102 | H | H | P21 | H |
| Lₐ₃₀₃₇ | P11 | F | H | H | P102 | H | F | H | H |
| Lₐ₃₀₃₈ | P11 | F | H | H | P102 | H | F | P1 | H |
| Lₐ₃₀₃₉ | P11 | F | H | H | P102 | H | F | P2 | H |
| Lₐ₃₀₄₀ | P11 | F | H | H | P102 | H | F | P3 | H |
| Lₐ₃₀₄₁ | P11 | F | H | H | P102 | H | F | P4 | H |
| Lₐ₃₀₄₂ | P11 | F | H | H | P102 | H | F | P5 | H |
| Lₐ₃₀₄₃ | P11 | F | H | H | P102 | H | F | P6 | H |
| Lₐ₃₀₄₄ | P11 | F | H | H | P102 | H | F | P7 | H |
| Lₐ₃₀₄₅ | P11 | F | H | H | P102 | H | F | P8 | H |
| Lₐ₃₀₄₆ | P11 | F | H | H | P102 | H | F | P9 | H |
| Lₐ₃₀₄₇ | P11 | F | H | H | P102 | H | F | P10 | H |
| Lₐ₃₀₄₈ | P11 | F | H | H | P102 | H | F | P11 | H |
| Lₐ₃₀₄₉ | P11 | F | H | H | P102 | H | P1 | F | H |
| Lₐ₃₀₅₀ | P11 | F | H | H | P102 | H | P2 | F | H |
| Lₐ₃₀₅₁ | P11 | F | H | H | P102 | H | P3 | F | H |
| Lₐ₃₀₅₂ | P11 | F | H | H | P102 | H | P4 | F | H |
| Lₐ₃₀₅₃ | P11 | F | H | H | P102 | H | P5 | F | H |
| Lₐ₃₀₅₄ | P11 | F | H | H | P102 | H | P6 | F | H |
| Lₐ₃₀₅₅ | P11 | F | H | H | P102 | H | P7 | F | H |
| Lₐ₃₀₅₆ | P11 | F | H | H | P102 | H | P8 | F | H |
| Lₐ₃₀₅₇ | P11 | F | H | H | P102 | H | P9 | F | H |
| Lₐ₃₀₅₈ | P11 | F | H | H | P102 | H | P10 | F | H |
| Lₐ₃₀₅₉ | P11 | F | H | H | P102 | H | P11 | F | H |
| Lₐ₃₀₆₀ | P11 | F | H | H | P102 | H | P1 | P1 | H |
| Lₐ₃₀₆₁ | P11 | F | H | H | P102 | H | P2 | P2 | H |
| Lₐ₃₀₆₂ | P11 | F | H | H | P102 | D | D | D | D |
| Lₐ₃₀₆₃ | P11 | F | H | H | P102 | D | P2 | P2 | D |
| Lₐ₃₀₆₄ | P11 | F | H | H | P102 | D | F | P4 | D |
| Lₐ₃₀₆₅ | P11 | F | H | H | P102 | D | F | P5 | D |
| Lₐ₃₀₆₆ | P11 | F | H | H | P102 | D | F | P9 | D |
| Lₐ₃₀₆₇ | P11 | F | H | H | P102 | D | F | P11 | D |
| Lₐ₃₀₆₈ | P11 | F | H | H | P103 | H | P1 | H | H |
| Lₐ₃₀₆₉ | P11 | F | H | H | P103 | H | P2 | H | H |
| Lₐ₃₀₇₀ | P11 | F | H | H | P103 | H | P3 | H | H |
| Lₐ₃₀₇₁ | P11 | F | H | H | P103 | H | P4 | H | H |
| Lₐ₃₀₇₂ | P11 | F | H | H | P103 | H | P5 | H | H |
| Lₐ₃₀₇₃ | P11 | F | H | H | P103 | H | P6 | H | H |
| Lₐ₃₀₇₄ | P11 | F | H | H | P103 | H | P7 | H | H |
| Lₐ₃₀₇₅ | P11 | F | H | H | P103 | H | P8 | H | H |
| Lₐ₃₀₇₆ | P11 | F | H | H | P103 | H | P9 | H | H |
| Lₐ₃₀₇₇ | P11 | F | H | H | P103 | H | P10 | H | H |
| Lₐ₃₀₇₈ | P11 | F | H | H | P103 | H | P11 | H | H |
| Lₐ₃₀₇₉ | P11 | F | H | H | P103 | H | P12 | H | H |
| Lₐ₃₀₈₀ | P11 | F | H | H | P103 | H | P13 | H | H |
| Lₐ₃₀₈₁ | P11 | F | H | H | P103 | H | P14 | H | H |
| Lₐ₃₀₈₂ | P11 | F | H | H | P103 | H | P15 | H | H |
| Lₐ₃₀₈₃ | P11 | F | H | H | P103 | H | P16 | H | H |
| Lₐ₃₀₈₄ | P11 | F | H | H | P103 | H | P17 | H | H |
| Lₐ₃₀₈₅ | P11 | F | H | H | P103 | H | P18 | H | H |
| Lₐ₃₀₈₆ | P11 | F | H | H | P103 | H | P19 | H | H |
| Lₐ₃₀₈₇ | P11 | F | H | H | P103 | H | P20 | H | H |
| Lₐ₃₀₈₈ | P11 | F | H | H | P103 | H | P21 | H | H |
| Lₐ₃₀₈₉ | P11 | F | H | H | P103 | H | H | P1 | H |
| Lₐ₃₀₉₀ | P11 | F | H | H | P103 | H | H | P2 | H |
| Lₐ₃₀₉₁ | P11 | F | H | H | P103 | H | H | P3 | H |
| Lₐ₃₀₉₂ | P11 | F | H | H | P103 | H | H | P4 | H |
| Lₐ₃₀₉₃ | P11 | F | H | H | P103 | H | H | P5 | H |
| Lₐ₃₀₉₄ | P11 | F | H | H | P103 | H | H | P6 | H |
| Lₐ₃₀₉₅ | P11 | F | H | H | P103 | H | H | P7 | H |
| Lₐ₃₀₉₆ | P11 | F | H | H | P103 | H | H | P8 | H |
| Lₐ₃₀₉₇ | P11 | F | H | H | P103 | H | H | P9 | H |
| Lₐ₃₀₉₈ | P11 | F | H | H | P103 | H | H | P10 | H |
| Lₐ₃₀₉₉ | P11 | F | H | H | P103 | H | H | P11 | H |
| Lₐ₃₁₀₀ | P11 | F | H | H | P103 | H | H | P12 | H |
| Lₐ₃₁₀₁ | P11 | F | H | H | P103 | H | H | P15 | H |
| Lₐ₃₁₀₂ | P11 | F | H | H | P103 | H | H | P17 | H |
| Lₐ₃₁₀₃ | P11 | F | H | H | P103 | H | H | P18 | H |
| Lₐ₃₁₀₄ | P11 | F | H | H | P103 | H | H | P19 | H |
| Lₐ₃₁₀₅ | P11 | F | H | H | P103 | H | H | P20 | H |
| Lₐ₃₁₀₆ | P11 | F | H | H | P103 | H | H | P21 | H |
| Lₐ₃₁₀₇ | P11 | F | H | H | P103 | H | F | H | H |
| Lₐ₃₁₀₈ | P11 | F | H | H | P103 | H | F | P1 | H |
| Lₐ₃₁₀₉ | P11 | F | H | H | P103 | H | F | P2 | H |
| Lₐ₃₁₁₀ | P11 | F | H | H | P103 | H | F | P3 | H |
| Lₐ₃₁₁₁ | P11 | F | H | H | P103 | H | F | P4 | H |
| Lₐ₃₁₁₂ | P11 | F | H | H | P103 | H | F | P5 | H |
| Lₐ₃₁₁₃ | P11 | F | H | H | P103 | H | F | P6 | H |
| Lₐ₃₁₁₄ | P11 | F | H | H | P103 | H | F | P7 | H |
| Lₐ₃₁₁₅ | P11 | F | H | H | P103 | H | F | P8 | H |
| Lₐ₃₁₁₆ | P11 | F | H | H | P103 | H | F | P9 | H |
| Lₐ₃₁₁₇ | P11 | F | H | H | P103 | H | F | P10 | H |
| Lₐ₃₁₁₈ | P11 | F | H | H | P103 | H | F | P11 | H |
| Lₐ₃₁₁₉ | P11 | F | H | H | P103 | H | P1 | F | H |
| Lₐ₃₁₂₀ | P11 | F | H | H | P103 | H | P2 | F | H |
| Lₐ₃₁₂₁ | P11 | F | H | H | P103 | H | P3 | F | H |
| Lₐ₃₁₂₂ | P11 | F | H | H | P103 | H | P4 | F | H |
| Lₐ₃₁₂₃ | P11 | F | H | H | P103 | H | P5 | F | H |
| Lₐ₃₁₂₄ | P11 | F | H | H | P103 | H | P6 | F | H |
| Lₐ₃₁₂₅ | P11 | F | H | H | P103 | H | P7 | F | H |
| Lₐ₃₁₂₆ | P11 | F | H | H | P103 | H | P8 | F | H |
| Lₐ₃₁₂₇ | P11 | F | H | H | P103 | H | P9 | F | H |
| Lₐ₃₁₂₈ | P11 | F | H | H | P103 | H | P10 | F | H |
| Lₐ₃₁₂₉ | P11 | F | H | H | P103 | H | P11 | F | H |
| Lₐ₃₁₃₀ | P11 | F | H | H | P103 | H | P1 | P1 | H |
| Lₐ₃₁₃₁ | P11 | F | H | H | P103 | H | P2 | P2 | H |
| Lₐ₃₁₃₂ | P11 | F | H | H | P103 | D | D | D | D |
| Lₐ₃₁₃₃ | P11 | F | H | H | P103 | D | P2 | P2 | D |
| Lₐ₃₁₃₄ | P11 | F | H | H | P103 | D | F | P4 | D |
| Lₐ₃₁₃₅ | P11 | F | H | H | P103 | D | F | P5 | D |
| Lₐ₃₁₃₆ | P11 | F | H | H | P103 | D | F | P9 | D |
| Lₐ₃₁₃₇ | P11 | F | H | H | P103 | D | F | P11 | D |
| Lₐ₃₁₃₈ | P11 | F | H | H | H | H | P20 | P1 | H |
| Lₐ₃₁₃₉ | P11 | F | H | H | H | H | P21 | P2 | H |
| Lₐ₃₁₄₀ | P11 | F | H | H | H | H | P29 | H | H |
| Lₐ₃₁₄₁ | P11 | F | H | H | H | H | P29 | P1 | H |
| Lₐ₃₁₄₂ | P11 | F | H | H | H | H | P54 | H | H |
| Lₐ₃₁₄₃ | P11 | F | H | H | H | H | P96 | H | H |
| Lₐ₃₁₄₄ | P11 | F | H | H | H | H | P97 | H | H |
| Lₐ₃₁₄₅ | P11 | F | H | H | H | H | P96 | P1 | H |
| Lₐ₃₁₄₆ | P11 | F | H | H | H | H | P97 | P1 | H |
| Lₐ₃₁₄₇ | P11 | F | H | H | H | H | P102 | H | H |
| Lₐ₃₁₄₈ | P11 | F | H | H | H | H | P103 | H | H |
| Lₐ₃₁₄₉ | P11 | F | H | H | D | H | P20 | P1 | H |
| Lₐ₃₁₅₀ | P11 | F | H | H | D | H | P21 | P2 | H |
| Lₐ₃₁₅₁ | P11 | F | H | H | D | H | P29 | H | H |
| Lₐ₃₁₅₂ | P11 | F | H | H | D | H | P29 | P1 | H |
| Lₐ₃₁₅₃ | P11 | F | H | H | D | H | P54 | H | H |
| Lₐ₃₁₅₄ | P11 | F | H | H | D | H | P96 | H | H |
| Lₐ₃₁₅₅ | P11 | F | H | H | D | H | P97 | H | H |
| Lₐ₃₁₅₆ | P11 | F | H | H | D | H | P96 | P1 | H |
| Lₐ₃₁₅₇ | P11 | F | H | H | D | H | P97 | P1 | H |
| Lₐ₃₁₅₈ | P11 | F | H | H | D | H | P102 | H | H |
| Lₐ₃₁₅₉ | P11 | F | H | H | D | H | P103 | H | H |
| Lₐ₃₁₆₀ | P11 | F | H | H | P20 | H | P20 | P1 | H |
| Lₐ₃₁₆₁ | P11 | F | H | H | P20 | H | P21 | P2 | H |
| Lₐ₃₁₆₂ | P11 | F | H | H | P20 | H | P29 | H | H |
| Lₐ₃₁₆₃ | P11 | F | H | H | P20 | H | P29 | P1 | H |
| Lₐ₃₁₆₄ | P11 | F | H | H | P20 | H | P54 | H | H |
| Lₐ₃₁₆₅ | P11 | F | H | H | P20 | H | P96 | H | H |
| Lₐ₃₁₆₆ | P11 | F | H | H | P20 | H | P97 | H | H |
| Lₐ₃₁₆₇ | P11 | F | H | H | P20 | H | P96 | P1 | H |
| Lₐ₃₁₆₈ | P11 | F | H | H | P20 | H | P97 | P1 | H |
| Lₐ₃₁₆₉ | P11 | F | H | H | P20 | H | P102 | H | H |
| Lₐ₃₁₇₀ | P11 | F | H | H | P20 | H | P103 | H | H |
| Lₐ₃₁₇₁ | P11 | F | H | H | P21 | H | P20 | P1 | H |
| Lₐ₃₁₇₂ | P11 | F | H | H | P21 | H | P21 | P2 | H |
| Lₐ₃₁₇₃ | P11 | F | H | H | P21 | H | P29 | H | H |
| Lₐ₃₁₇₄ | P11 | F | H | H | P21 | H | P29 | P1 | H |
| Lₐ₃₁₇₅ | P11 | F | H | H | P21 | H | P54 | H | H |
| Lₐ₃₁₇₆ | P11 | F | H | H | P21 | H | P96 | H | H |
| Lₐ₃₁₇₇ | P11 | F | H | H | P21 | H | P97 | H | H |
| Lₐ₃₁₇₈ | P11 | F | H | H | P21 | H | P96 | P1 | H |
| Lₐ₃₁₇₉ | P11 | F | H | H | P21 | H | P97 | P1 | H |
| Lₐ₃₁₈₀ | P11 | F | H | H | P21 | H | P102 | H | H |
| Lₐ₃₁₈₁ | P11 | F | H | H | P21 | H | P103 | H | H |
| Lₐ₃₁₈₂ | P11 | F | H | H | P22 | H | H | H | H |
| Lₐ₃₁₈₃ | P11 | F | H | H | P23 | H | H | H | H |
| Lₐ₃₁₈₄ | P11 | F | H | H | P24 | H | H | H | H |
| Lₐ₃₁₈₅ | P11 | F | H | H | P25 | H | H | H | H |
| Lₐ₃₁₈₆ | P11 | F | H | H | P26 | H | H | H | H |
| Lₐ₃₁₈₇ | P11 | F | H | H | P27 | H | H | H | H |
| Lₐ₃₁₈₈ | P11 | F | H | H | P28 | H | H | H | H |
| Lₐ₃₁₈₉ | P11 | F | H | H | P29 | H | H | H | H |
| Lₐ₃₁₉₀ | P11 | F | H | H | P30 | H | H | H | H |
| Lₐ₃₁₉₁ | P11 | F | H | H | P31 | H | H | H | H |
| Lₐ₃₁₉₂ | P11 | F | H | H | P32 | H | H | H | H |
| Lₐ₃₁₉₃ | P11 | F | H | H | P33 | H | H | H | H |
| Lₐ₃₁₉₄ | P11 | F | H | H | P34 | H | H | H | H |
| Lₐ₃₁₉₅ | P11 | F | H | H | P35 | H | H | H | H |
| Lₐ₃₁₉₆ | P11 | F | H | H | P36 | H | H | H | H |
| Lₐ₃₁₉₇ | P11 | F | H | H | P37 | H | H | H | H |
| Lₐ₃₁₉₈ | P11 | F | H | H | P38 | H | H | H | H |
| Lₐ₃₁₉₉ | P11 | F | H | H | P39 | H | H | H | H |
| Lₐ₃₂₀₀ | P11 | F | H | H | P40 | H | H | H | H |
| Lₐ₃₂₀₁ | P11 | F | H | H | P41 | H | H | H | H |
| Lₐ₃₂₀₂ | P11 | F | H | H | P42 | H | H | H | H |
| Lₐ₃₂₀₃ | P11 | F | H | H | P43 | H | H | H | H |
| Lₐ₃₂₀₄ | P11 | F | H | H | P44 | H | H | H | H |
| Lₐ₃₂₀₅ | P11 | F | H | H | P45 | H | H | H | H |
| Lₐ₃₂₀₆ | P11 | F | H | H | P46 | H | H | H | H |
| Lₐ₃₂₀₇ | P11 | F | H | H | P47 | H | H | H | H |
| Lₐ₃₂₀₈ | P11 | F | H | H | P48 | H | H | H | H |
| Lₐ₃₂₀₉ | P11 | F | H | H | P49 | H | H | H | H |
| Lₐ₃₂₁₀ | P11 | F | H | H | P50 | H | H | H | H |
| Lₐ₃₂₁₁ | P11 | F | H | H | P51 | H | H | H | H |
| Lₐ₃₂₁₂ | P11 | F | H | H | P52 | H | H | H | H |
| Lₐ₃₂₁₃ | P11 | F | H | H | P53 | H | H | H | H |
| Lₐ₃₂₁₄ | P11 | F | H | H | P55 | H | H | H | H |
| Lₐ₃₂₁₅ | P11 | F | H | H | P56 | H | H | H | H |
| Lₐ₃₂₁₆ | P11 | F | H | H | P57 | H | H | H | H |
| Lₐ₃₂₁₇ | P11 | F | H | H | P58 | H | H | H | H |
| Lₐ₃₂₁₈ | P11 | F | H | H | P59 | H | H | H | H |
| Lₐ₃₂₁₉ | P11 | F | H | H | P60 | H | H | H | H |
| Lₐ₃₂₂₀ | P11 | F | H | H | P61 | H | H | H | H |
| Lₐ₃₂₂₁ | P11 | F | H | H | P62 | H | H | H | H |
| Lₐ₃₂₂₂ | P11 | F | H | H | P63 | H | H | H | H |
| Lₐ₃₂₂₃ | P11 | F | H | H | P64 | H | H | H | H |
| Lₐ₃₂₂₄ | P11 | F | H | H | P65 | H | H | H | H |
| Lₐ₃₂₂₅ | P11 | F | H | H | P66 | H | H | H | H |
| Lₐ₃₂₂₆ | P11 | F | H | H | P67 | H | H | H | H |
| Lₐ₃₂₂₇ | P11 | F | H | H | P68 | H | H | H | H |
| Lₐ₃₂₂₈ | P11 | F | H | H | P69 | H | H | H | H |
| Lₐ₃₂₂₉ | P11 | F | H | H | P70 | H | H | H | H |
| Lₐ₃₂₃₀ | P11 | F | H | H | P71 | H | H | H | H |
| Lₐ₃₂₃₁ | P11 | F | H | H | P72 | H | H | H | H |
| Lₐ₃₂₃₂ | P11 | F | H | H | P73 | H | H | H | H |
| Lₐ₃₂₃₃ | P11 | F | H | H | P74 | H | H | H | H |
| Lₐ₃₂₃₄ | P11 | F | H | H | P75 | H | H | H | H |
| Lₐ₃₂₃₅ | P11 | F | H | H | P76 | H | H | H | H |
| Lₐ₃₂₃₆ | P11 | F | H | H | P77 | H | H | H | H |
| Lₐ₃₂₃₇ | P11 | F | H | H | P78 | H | H | H | H |
| Lₐ₃₂₃₈ | P11 | F | H | H | P79 | H | H | H | H |
| Lₐ₃₂₃₉ | P11 | F | H | H | P80 | H | H | H | H |
| Lₐ₃₂₄₀ | P11 | F | H | H | P81 | H | H | H | H |
| Lₐ₃₂₄₁ | P11 | F | H | H | P82 | H | H | H | H |
| Lₐ₃₂₄₂ | P11 | F | H | H | P83 | H | H | H | H |
| Lₐ₃₂₄₃ | P11 | F | H | H | P84 | H | H | H | H |
| Lₐ₃₂₄₄ | P11 | F | H | H | P85 | H | H | H | H |
| Lₐ₃₂₄₅ | P11 | F | H | H | P86 | H | H | H | H |
| Lₐ₃₂₄₆ | P11 | F | H | H | P87 | H | H | H | H |
| Lₐ₃₂₄₇ | P11 | F | H | H | P88 | H | H | H | H |
| Lₐ₃₂₄₈ | P11 | F | H | H | P89 | H | H | H | H |
| Lₐ₃₂₄₉ | P11 | F | H | H | P90 | H | H | H | H |
| Lₐ₃₂₅₀ | P11 | F | H | H | P91 | H | H | H | H |
| Lₐ₃₂₅₁ | P11 | F | H | H | P92 | H | H | H | H |
| Lₐ₃₂₅₂ | P11 | F | H | H | P93 | H | H | H | H |
| Lₐ₃₂₅₃ | P11 | F | H | H | P94 | H | H | H | H |
| Lₐ₃₂₅₄ | P11 | F | H | H | P95 | H | H | H | H |
| Lₐ₃₂₅₅ | P11 | F | H | H | P98 | H | H | H | H |
| Lₐ₃₂₅₆ | P11 | F | H | H | P99 | H | H | H | H |
| Lₐ₃₂₅₇ | P11 | F | H | H | P100 | H | H | H | H |
| Lₐ₃₂₅₈ | P11 | F | H | H | P101 | H | H | H | H |
| Lₐ₃₂₅₉ | P11 | F | H | H | P102 | H | H | H | H |
| Lₐ₃₂₆₀ | P11 | F | H | H | P103 | H | H | H | H |
| Lₐ₃₂₆₁ | P11 | F | H | H | P104 | H | H | H | H |
| Lₐ₃₂₆₂ | P11 | F | H | H | P105 | H | H | H | H |
| Lₐ₃₂₆₃ | P11 | F | H | H | P106 | H | H | H | H |
| Lₐ₃₂₆₄ | P11 | F | H | H | P107 | H | H | H | H |
| Lₐ₃₂₆₅ | P11 | F | H | H | P108 | H | H | H | H |
| Lₐ₃₂₆₆ | P11 | F | H | H | P109 | H | H | H | H |
| Lₐ₃₂₆₇ | P11 | F | H | H | P110 | H | H | H | H |
| Lₐ₃₂₆₈ | P11 | F | H | H | P111 | H | H | H | H |
| Lₐ₃₂₆₉ | P11 | F | H | H | P112 | H | H | H | H |
| Lₐ₃₂₇₀ | P11 | F | H | H | P113 | H | H | H | H |
| Lₐ₃₂₇₁ | P11 | F | H | H | P114 | H | H | H | H |
| Lₐ₃₂₇₂ | P11 | F | H | H | P115 | H | H | H | H |
| Lₐ₃₂₇₃ | P11 | F | H | H | P116 | H | H | H | H |
| Lₐ₃₂₇₄ | P11 | F | H | H | P117 | H | H | H | H |
| Lₐ₃₂₇₅ | P11 | F | H | H | P118 | H | H | H | H |
| Lₐ₃₂₇₆ | P11 | F | H | H | P119 | H | H | H | H |
| Lₐ₃₂₇₇ | P11 | F | H | H | P120 | H | H | H | H |
| Lₐ₃₂₇₈ | P11 | F | H | H | P121 | H | H | H | H |
| Lₐ₃₂₇₉ | P11 | F | H | H | P122 | H | H | H | H |
| Lₐ₃₂₈₀ | P11 | F | H | H | P123 | H | H | H | H |
| Lₐ₃₂₈₁ | P11 | F | H | H | P124 | H | H | H | H |
| Lₐ₃₂₈₂ | P11 | F | H | H | P125 | H | H | H | H |
| Lₐ₃₂₈₃ | P11 | F | H | H | P126 | H | H | H | H |
| Lₐ₃₂₈₄ | P11 | F | H | H | P127 | H | H | H | H |
| Lₐ₃₂₈₅ | P11 | F | H | H | P128 | H | H | H | H |
| Lₐ₃₂₈₆ | P11 | F | H | H | P129 | H | H | H | H |
| Lₐ₃₂₈₇ | P11 | F | H | H | P130 | H | H | H | H |
| Lₐ₃₂₈₈ | P11 | F | H | H | P131 | H | H | H | H |
| Lₐ₃₂₈₉ | P11 | F | H | H | P132 | H | H | H | H |
| Lₐ₃₂₉₀ | P11 | F | H | H | P133 | H | H | H | H |
| Lₐ₃₂₉₁ | P11 | F | H | H | P134 | H | H | H | H |
| Lₐ₃₂₉₂ | P11 | F | H | H | P135 | H | H | H | H |
| Lₐ₃₂₉₃ | P11 | F | H | H | P136 | H | H | H | H |
| Lₐ₃₂₉₄ | P11 | F | H | H | P137 | H | H | H | H |
| Lₐ₃₂₉₅ | P11 | F | H | H | P138 | H | H | H | H |
| Lₐ₃₂₉₆ | P11 | F | H | H | P139 | H | H | H | H |
| Lₐ₃₂₉₇ | P11 | F | H | H | P140 | H | H | H | H |
| Lₐ₃₂₉₈ | P11 | F | H | H | P141 | H | H | H | H |
| Lₐ₃₂₉₉ | P11 | F | H | H | P142 | H | H | H | H |
| Lₐ₃₃₀₀ | P11 | F | H | H | P143 | H | H | H | H |
| Lₐ₃₃₀₁ | P11 | F | H | H | P144 | H | H | H | H |
| Lₐ₃₃₀₂ | P11 | F | H | H | P145 | H | H | H | H |
| Lₐ₃₃₀₃ | P11 | F | H | H | P146 | H | H | H | H |
| Lₐ₃₃₀₄ | P11 | F | H | H | P147 | H | H | H | H |
| Lₐ₃₃₀₅ | P11 | F | H | H | P148 | H | H | H | H |
| Lₐ₃₃₀₆ | P11 | F | H | H | P149 | H | H | H | H |
| Lₐ₃₃₀₇ | P11 | F | H | H | P150 | H | H | H | H |
| Lₐ₃₃₀₈ | P11 | F | H | H | P151 | H | H | H | H |
| Lₐ₃₃₀₉ | P11 | F | H | P18 | H | H | H | H | H |
| Lₐ₃₃₁₀ | P11 | F | H | P18 | D | H | H | H | H |
| Lₐ₃₃₁₁ | P11 | F | H | P18 | P20 | H | H | H | H |
| Lₐ₃₃₁₂ | P11 | F | H | P19 | H | H | H | H | H |
| Lₐ₃₃₁₃ | P11 | F | H | P19 | D | H | H | H | H |
| Lₐ₃₃₁₄ | P11 | F | H | P19 | P20 | H | H | H | H |
| Lₐ₃₃₁₅ | P11 | F | H | P20 | H | H | H | H | H |
| Lₐ₃₃₁₆ | P11 | F | H | P20 | D | H | H | H | H |
| Lₐ₃₃₁₇ | P11 | F | H | P20 | H | H | P1 | H | H |
| Lₐ₃₃₁₈ | P11 | F | H | P20 | D | H | P2 | H | H |
| Lₐ₃₃₁₉ | P11 | F | H | P20 | H | H | H | P1 | H |
| Lₐ₃₃₂₀ | P11 | F | H | P20 | D | H | H | P2 | H |
| Lₐ₃₃₂₁ | P11 | F | H | P20 | H | H | P1 | P1 | H |
| Lₐ₃₃₂₂ | P11 | F | H | P20 | D | H | P2 | P2 | H |
| Lₐ₃₃₂₃ | P11 | F | H | P20 | H | H | P3 | H | H |
| Lₐ₃₃₂₄ | P11 | F | H | P20 | D | H | P4 | H | H |
| Lₐ₃₃₂₅ | P11 | F | H | P20 | H | H | P5 | H | H |
| Lₐ₃₃₂₆ | P11 | F | H | P21 | H | H | H | H | H |
| Lₐ₃₃₂₇ | P11 | F | H | P21 | D | H | H | H | H |
| Lₐ₃₃₂₈ | P11 | F | H | P21 | H | H | P1 | H | H |
| Lₐ₃₃₂₉ | P11 | F | H | P21 | D | H | P2 | H | H |
| Lₐ₃₃₃₀ | P11 | F | H | P21 | H | H | H | P1 | H |
| Lₐ₃₃₃₁ | P11 | F | H | P21 | D | H | H | P2 | H |
| Lₐ₃₃₃₂ | P11 | F | H | P21 | H | H | P1 | P1 | H |
| Lₐ₃₃₃₃ | P11 | F | H | P21 | D | H | P2 | P2 | H |
| Lₐ₃₃₃₄ | P11 | F | H | P21 | H | H | P3 | H | H |
| Lₐ₃₃₃₅ | P11 | F | H | P21 | D | H | P4 | H | H |
| Lₐ₃₃₃₆ | P11 | F | H | P21 | H | H | P5 | H | H |
| Lₐ₃₃₃₇ | P10 | F | H | H | H | H | H | H | H |
| Lₐ₃₃₃₈ | P10 | F | H | H | D | H | H | H | H |
| Lₐ₃₃₃₉ | P10 | F | H | H | P20 | H | H | H | H |
| Lₐ₃₃₄₀ | P10 | F | H | H | P21 | H | H | H | H |
| Lₐ₃₃₄₁ | P10 | F | H | H | P54 | H | H | H | H |
| Lₐ₃₃₄₂ | P10 | F | H | H | P55 | H | H | H | H |
| Lₐ₃₃₄₃ | P10 | F | H | H | P56 | H | H | H | H |
| Lₐ₃₃₄₄ | P10 | F | H | H | P57 | H | H | H | H |
| Lₐ₃₃₄₅ | P10 | F | H | H | P20 | H | P1 | H | H |
| Lₐ₃₃₄₆ | P10 | F | H | H | P20 | H | P3 | H | H |
| Lₐ₃₃₄₇ | P10 | F | H | H | P20 | H | P4 | H | H |
| Lₐ₃₃₄₈ | P10 | F | H | H | P20 | H | P6 | H | H |
| Lₐ₃₃₄₉ | P10 | F | H | H | P20 | H | P8 | H | H |
| Lₐ₃₃₅₀ | P10 | F | H | H | P20 | H | P10 | H | H |
| Lₐ₃₃₅₁ | P10 | F | H | H | P20 | H | P1 | F | H |
| Lₐ₃₃₅₂ | P10 | F | H | H | P20 | H | P2 | F | H |
| Lₐ₃₃₅₃ | P10 | F | H | H | P20 | H | P10 | F | H |
| Lₐ₃₃₅₄ | P10 | F | H | H | P20 | H | F | P1 | H |
| Lₐ₃₃₅₅ | P10 | F | H | H | P20 | H | F | P2 | H |
| Lₐ₃₃₅₆ | P10 | F | H | H | P20 | H | F | P10 | H |
| Lₐ₃₃₅₇ | P10 | F | H | H | P21 | H | P2 | P2 | H |
| Lₐ₃₃₅₈ | P10 | F | H | H | P21 | H | P5 | H | H |
| Lₐ₃₃₅₉ | P10 | F | H | H | P21 | H | P9 | H | H |
| Lₐ₃₃₆₀ | P10 | F | H | H | P21 | H | P11 | H | H |
| Lₐ₃₃₆₁ | P10 | F | H | H | P21 | H | P1 | F | H |
| Lₐ₃₃₆₂ | P10 | F | H | H | P21 | H | P2 | F | H |
| Lₐ₃₃₆₃ | P10 | F | H | H | P21 | H | P11 | F | H |
| Lₐ₃₃₆₄ | P10 | F | H | H | P21 | H | F | P1 | H |
| Lₐ₃₃₆₅ | P10 | F | H | H | P21 | H | F | P2 | H |
| Lₐ₃₃₆₆ | P10 | F | H | H | P21 | H | F | P11 | H |
| Lₐ₃₃₆₇ | P6 | CN | F | H | H | H | H | H | H |
| Lₐ₃₃₆₈ | P6 | CN | F | H | D | H | H | H | H |
| Lₐ₃₃₆₉ | P6 | CN | F | H | P20 | H | H | H | H |
| Lₐ₃₃₇₀ | P6 | CN | F | H | P21 | H | H | H | H |
| Lₐ₃₃₇₁ | P6 | CN | F | H | P54 | H | H | H | H |
| Lₐ₃₃₇₂ | P6 | CN | F | H | P96 | H | H | H | H |
| Lₐ₃₃₇₃ | P6 | CN | F | H | P97 | H | H | H | H |
| Lₐ₃₃₇₄ | P6 | CN | F | H | P103 | H | H | H | H |
| Lₐ₃₃₇₅ | P11 | CN | F | H | H | H | H | H | H |
| Lₐ₃₃₇₆ | P11 | CN | F | H | D | H | H | H | H |
| Lₐ₃₃₇₇ | P11 | CN | F | H | P20 | H | H | H | H |
| Lₐ₃₃₇₈ | P11 | CN | F | H | P21 | H | H | H | H |
| Lₐ₃₃₇₉ | P11 | CN | F | H | P54 | H | H | H | H |
| Lₐ₃₃₈₀ | P11 | CN | F | H | P96 | H | H | H | H |
| Lₐ₃₃₈₁ | P11 | CN | F | H | P97 | H | H | H | H |
| Lₐ₃₃₈₂ | P11 | CN | F | H | P103 | H | H | H | H |
| Lₐ₃₃₈₃ | P152 | CN | H | H | H | H | H | H | H |
| Lₐ₃₃₈₄ | P153 | CN | H | H | H | H | H | H | H |
| Lₐ₃₃₈₅ | P154 | CN | H | H | H | H | H | H | H |
| Lₐ₃₃₈₆ | P155 | CN | H | H | H | H | H | H | H |
| Lₐ₃₃₈₇ | P156 | CN | H | H | H | H | H | H | H |
| Lₐ₃₃₈₈ | P157 | CN | H | H | H | H | H | H | H |
| Lₐ₃₃₈₉ | P158 | CN | H | H | H | H | H | H | H |
| Lₐ₃₃₉₀ | P159 | CN | H | H | H | H | H | H | H |
| Lₐ₃₃₉₁ | P160 | CN | H | H | H | H | H | H | H |
| Lₐ₃₃₉₂ | P161 | CN | H | H | H | H | H | H | H |
| Lₐ₃₃₉₃ | P162 | CN | H | H | H | H | H | H | H |
| Lₐ₃₃₉₄ | P163 | CN | H | H | H | H | H | H | H |
| Lₐ₃₃₉₅ | P164 | CN | H | H | H | H | H | H | H |
| Lₐ₃₃₉₆ | P165 | CN | H | H | H | H | H | H | H |
| Lₐ₃₃₉₇ | P166 | CN | H | H | H | H | H | H | H |
| Lₐ₃₃₉₈ | P152 | CN | H | H | P20 | H | H | H | H |
| Lₐ₃₃₉₉ | P153 | CN | H | H | P20 | H | H | H | H |
| Lₐ₃₄₀₀ | P154 | CN | H | H | P20 | H | H | H | H |
| Lₐ₃₄₀₁ | P155 | CN | H | H | P20 | H | H | H | H |
| Lₐ₃₄₀₂ | P156 | CN | H | H | P20 | H | H | H | H |
| Lₐ₃₄₀₃ | P157 | CN | H | H | P20 | H | H | H | H |
| Lₐ₃₄₀₄ | P158 | CN | H | H | P20 | H | H | H | H |
| Lₐ₃₄₀₅ | P159 | CN | H | H | P20 | H | H | H | H |
| Lₐ₃₄₀₆ | P160 | CN | H | H | P20 | H | H | H | H |
| Lₐ₃₄₀₇ | P161 | CN | H | H | P20 | H | H | H | H |
| Lₐ₃₄₀₈ | P29 | CN | H | H | H | H | H | H | H |
| Lₐ₃₄₀₉ | P30 | CN | H | H | H | H | H | H | H |
| Lₐ₃₄₁₀ | P31 | CN | H | H | H | H | H | H | H |
| Lₐ₃₄₁₁ | P165 | CN | H | H | P20 | H | H | H | H |
| Lₐ₃₄₁₂ | P166 | CN | H | H | P20 | H | H | H | H |
| Lₐ₃₄₁₃ | P152 | CN | H | H | P21 | H | H | H | H |
| Lₐ₃₄₁₄ | P153 | CN | H | H | P21 | H | H | H | H |
| Lₐ₃₄₁₅ | P154 | CN | H | H | P21 | H | H | H | H |
| Lₐ₃₄₁₆ | P155 | CN | H | H | P21 | H | H | H | H |
| Lₐ₃₄₁₇ | P156 | CN | H | H | P21 | H | H | H | H |
| Lₐ₃₄₁₈ | P157 | CN | H | H | P21 | H | H | H | H |
| Lₐ₃₄₁₉ | P158 | CN | H | H | P21 | H | H | H | H |
| Lₐ₃₄₂₀ | P159 | CN | H | H | P21 | H | H | H | H |
| Lₐ₃₄₂₁ | P160 | CN | H | H | P21 | H | H | H | H |
| Lₐ₃₄₂₂ | P161 | CN | H | H | P21 | H | H | H | H |
| Lₐ₃₄₂₃ | P29 | CN | H | H | P21 | H | H | H | H |
| Lₐ₃₄₂₄ | P30 | CN | H | H | P21 | H | H | H | H |
| Lₐ₃₄₂₅ | P31 | CN | H | H | P21 | H | H | H | H |
| Lₐ₃₄₂₆ | P165 | CN | H | H | P21 | H | H | H | H |
| Lₐ₃₄₂₇ | P166 | CN | H | H | P21 | H | H | H | H |
| Lₐ₃₄₂₈ | P152 | CN | H | H | P54 | H | H | H | H |
| Lₐ₃₄₂₉ | P153 | CN | H | H | P54 | H | H | H | H |
| Lₐ₃₄₃₀ | P154 | CN | H | H | P54 | H | H | H | H |
| Lₐ₃₄₃₁ | P155 | CN | H | H | P54 | H | H | H | H |
| Lₐ₃₄₃₂ | P156 | CN | H | H | P54 | H | H | H | H |
| Lₐ₃₄₃₃ | P157 | CN | H | H | P54 | H | H | H | H |
| Lₐ₃₄₃₄ | P158 | CN | H | H | P54 | H | H | H | H |
| Lₐ₃₄₃₅ | P159 | CN | H | H | P54 | H | H | H | H |
| Lₐ₃₄₃₆ | P160 | CN | H | H | P54 | H | H | H | H |
| Lₐ₃₄₃₇ | P161 | CN | H | H | P54 | H | H | H | H |
| Lₐ₃₄₃₈ | P29 | CN | H | H | P54 | H | H | H | H |
| Lₐ₃₄₃₉ | P30 | CN | H | H | P54 | H | H | H | H |
| Lₐ₃₄₄₀ | P31 | CN | H | H | P54 | H | H | H | H |
| Lₐ₃₄₄₁ | P165 | CN | H | H | P54 | H | H | H | H |
| Lₐ₃₄₄₂ | P166 | CN | H | H | P54 | H | H | H | H |
| Lₐ₃₄₄₃ | P152 | CN | H | H | P96 | H | H | H | H |
| Lₐ₃₄₄₄ | P153 | CN | H | H | P96 | H | H | H | H |
| Lₐ₃₄₄₅ | P154 | CN | H | H | P96 | H | H | H | H |
| Lₐ₃₄₄₆ | P155 | CN | H | H | P96 | H | H | H | H |
| Lₐ₃₄₄₇ | P156 | CN | H | H | P96 | H | H | H | H |
| Lₐ₃₄₄₈ | P157 | CN | H | H | P96 | H | H | H | H |
| Lₐ₃₄₄₉ | P158 | CN | H | H | P96 | H | H | H | H |
| Lₐ₃₄₅₀ | P159 | CN | H | H | P96 | H | H | H | H |
| Lₐ₃₄₅₁ | P160 | CN | H | H | P96 | H | H | H | H |
| Lₐ₃₄₅₂ | P161 | CN | H | H | P96 | H | H | H | H |
| Lₐ₃₄₅₃ | P29 | CN | H | H | P96 | H | H | H | H |
| Lₐ₃₄₅₄ | P30 | CN | H | H | P96 | H | H | H | H |
| Lₐ₃₄₅₅ | P31 | CN | H | H | P96 | H | H | H | H |
| Lₐ₃₄₅₆ | P165 | CN | H | H | P96 | H | H | H | H |
| Lₐ₃₄₅₇ | P166 | CN | H | H | P96 | H | H | H | H |
;
wherein P1 to P166 have the following structures: 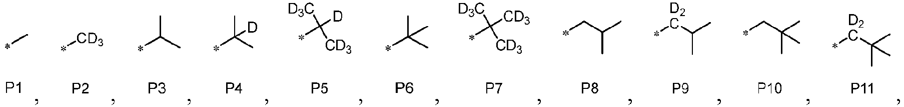 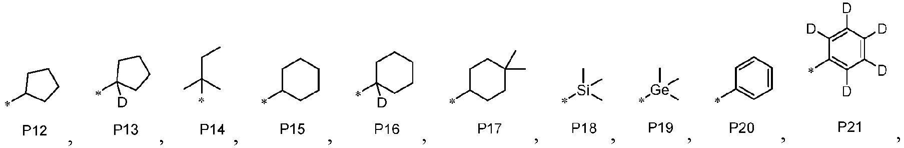 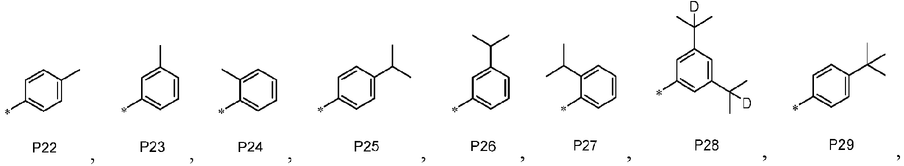 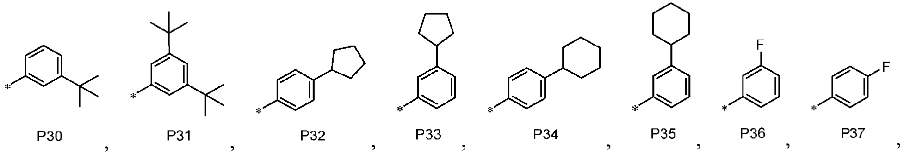 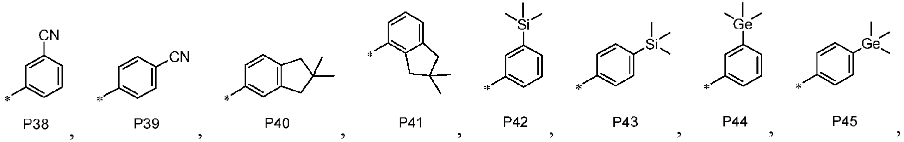 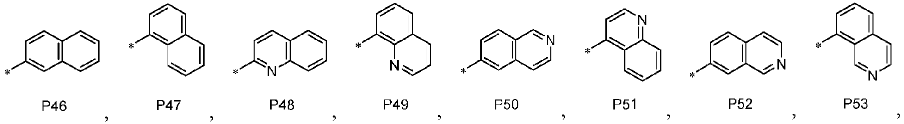 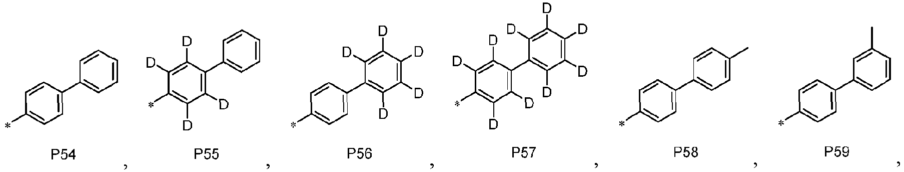 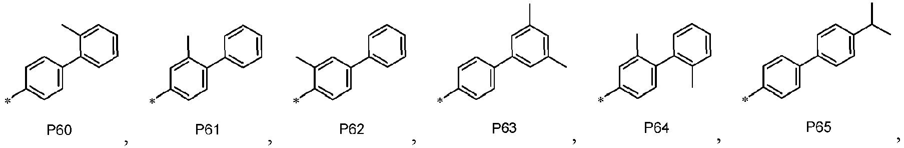 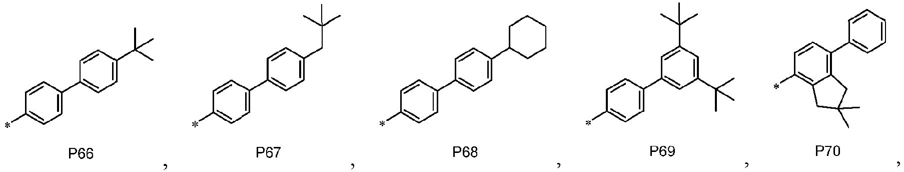 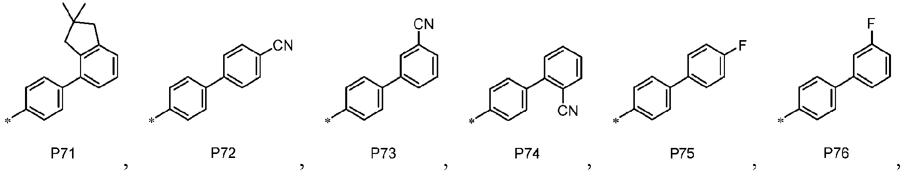 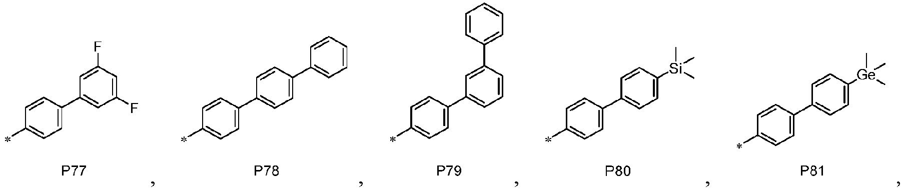 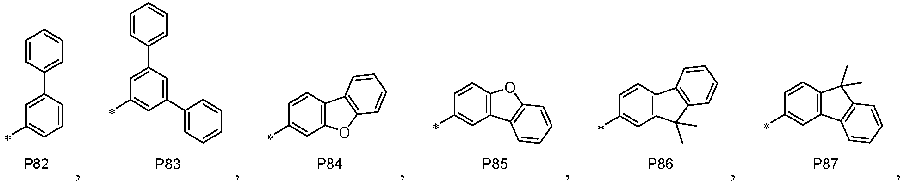 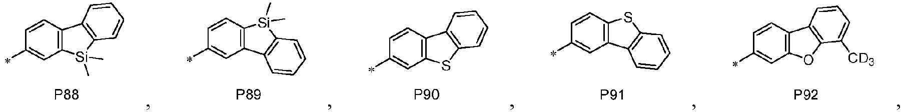 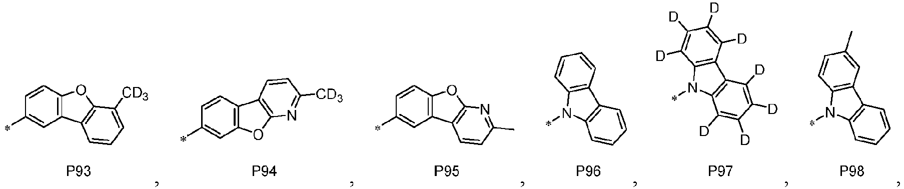 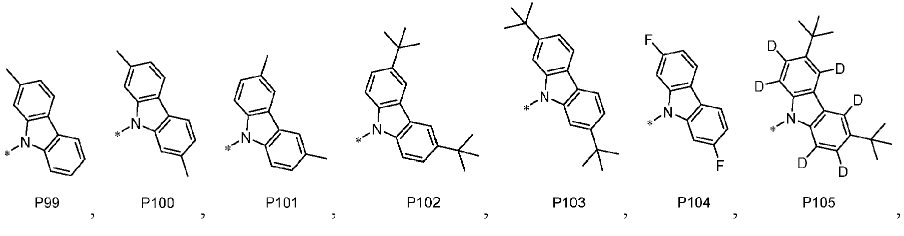 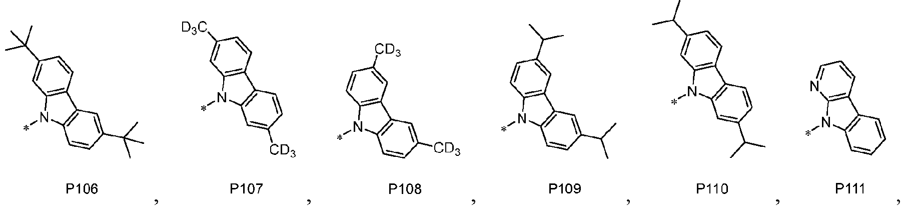 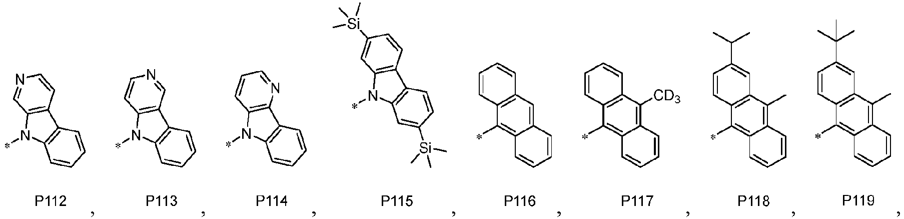 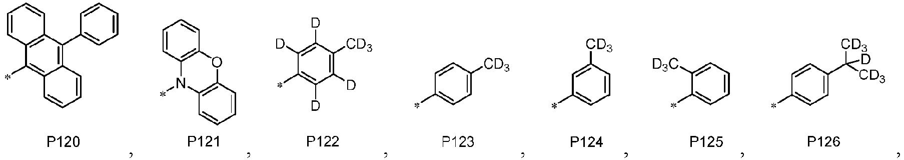 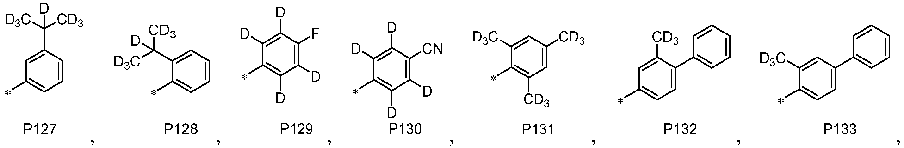 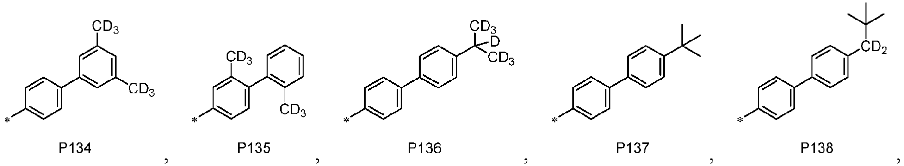 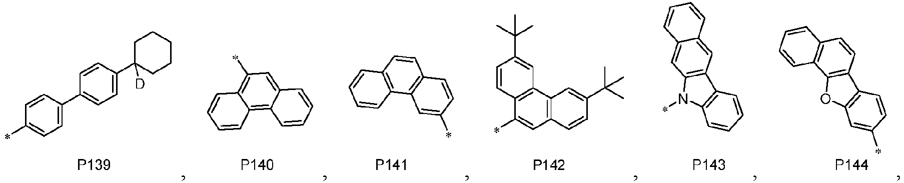 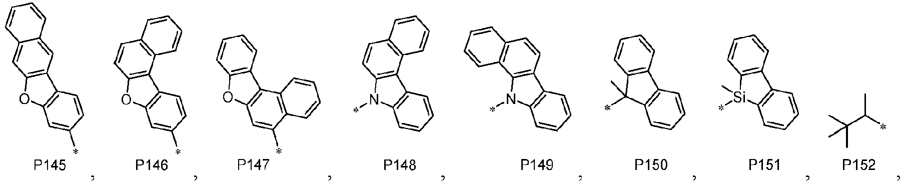 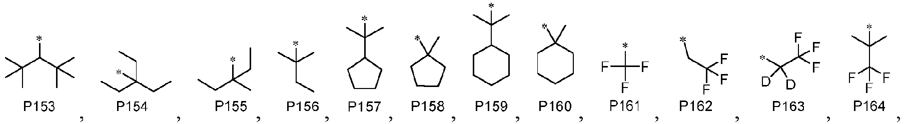 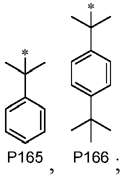
wherein Lₐ₃₄₅₈ to Lₐ₃₅₃₀ are shown as follows: 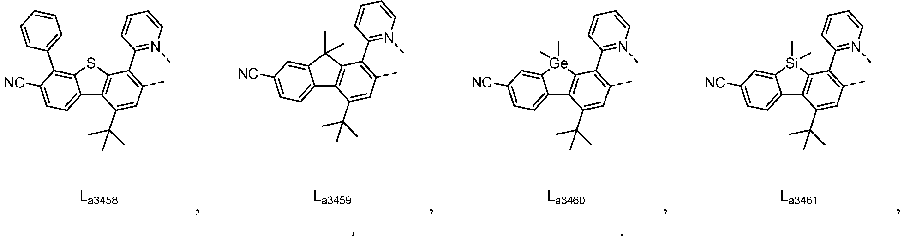 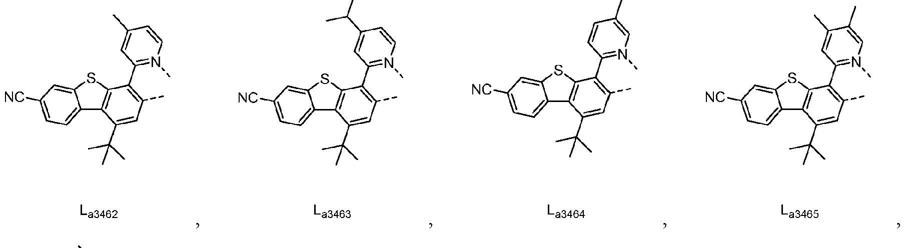 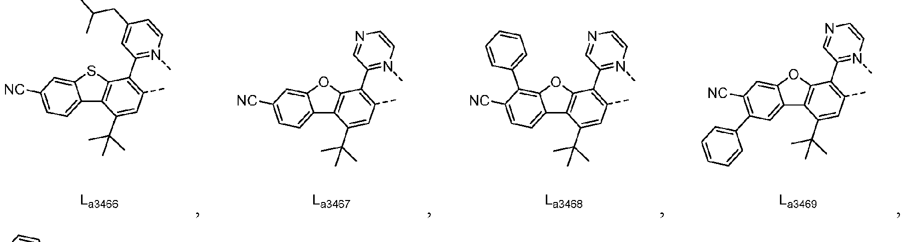 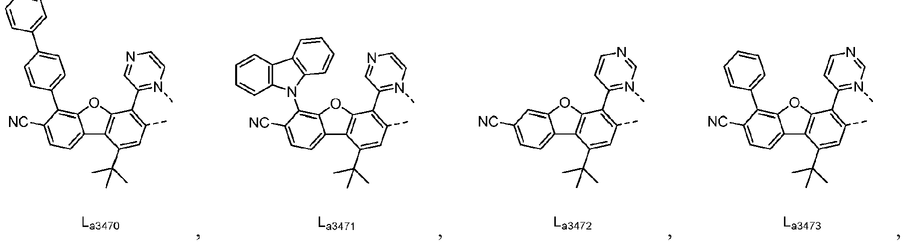 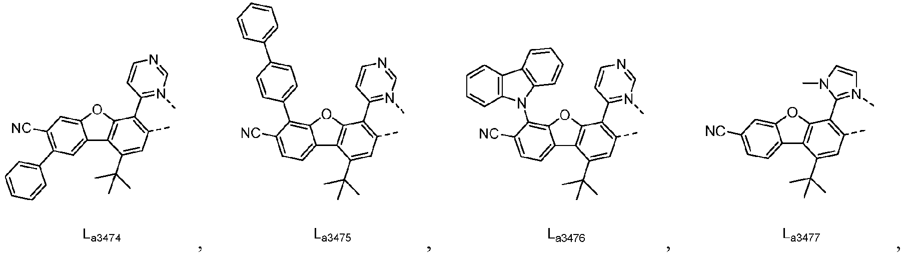 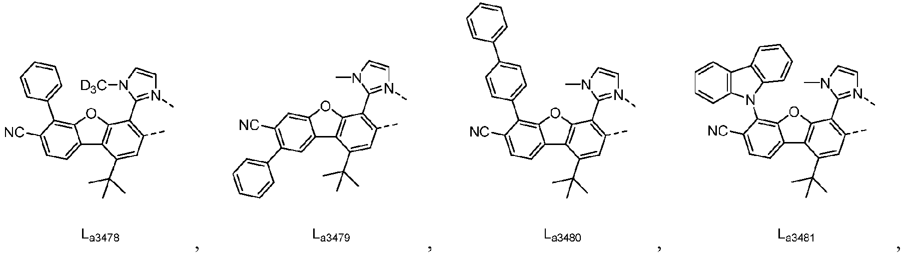 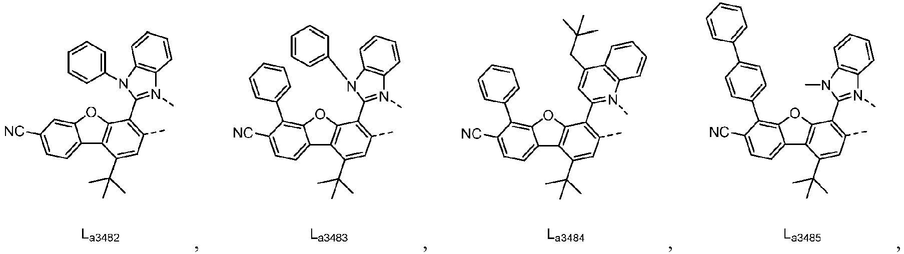 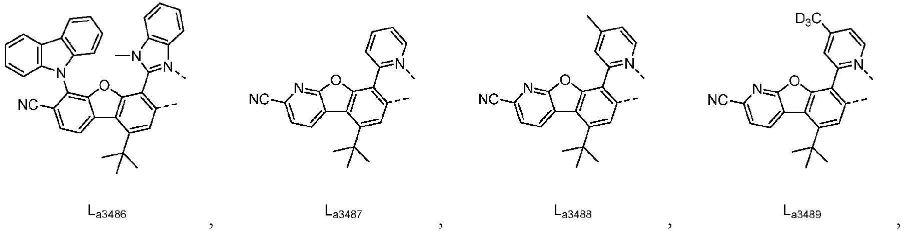 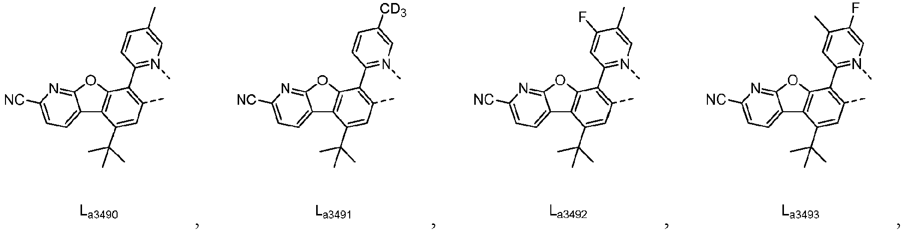 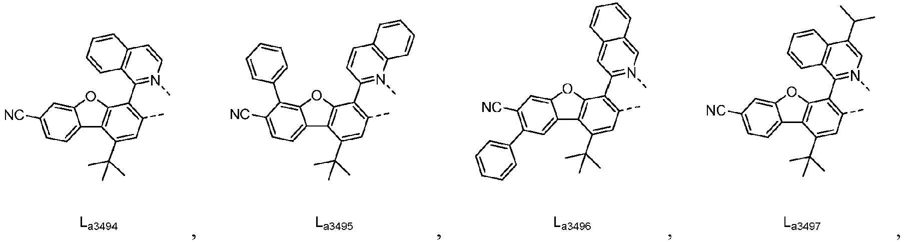 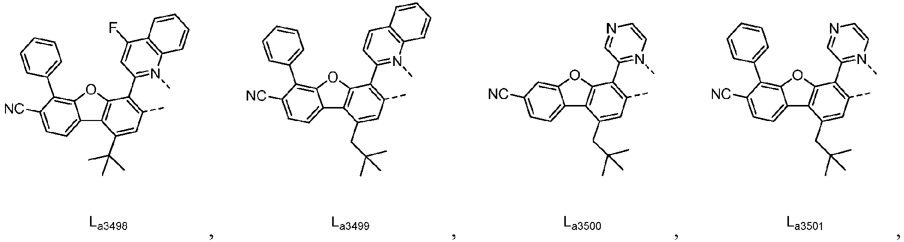 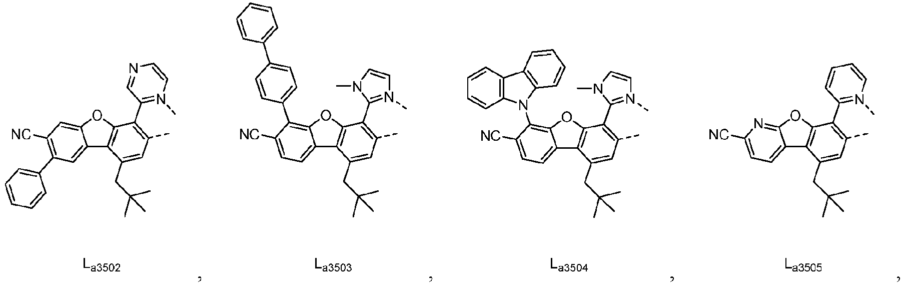 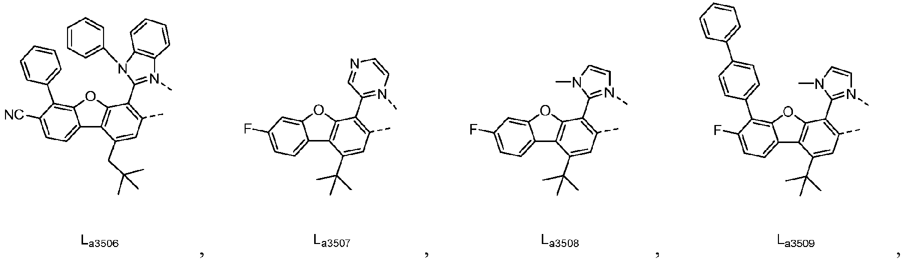 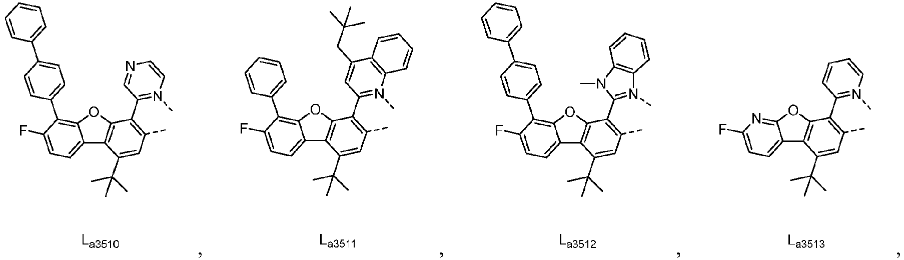 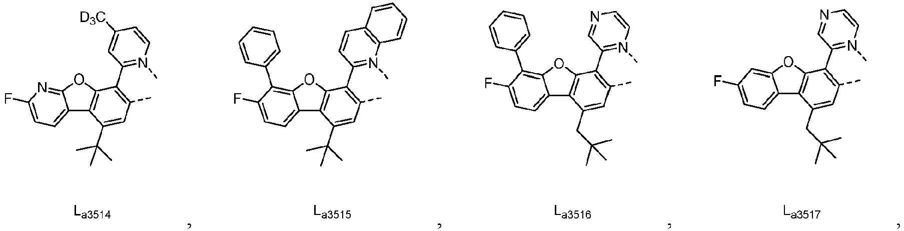 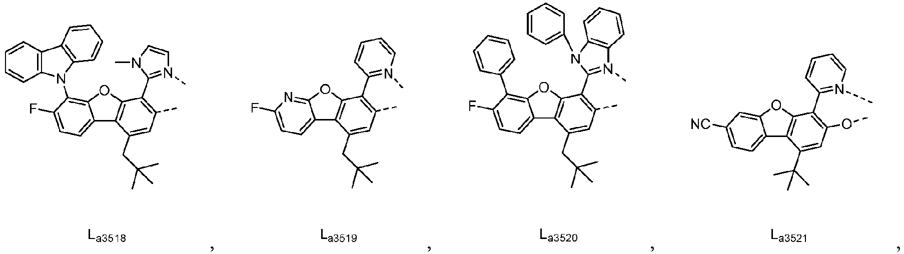 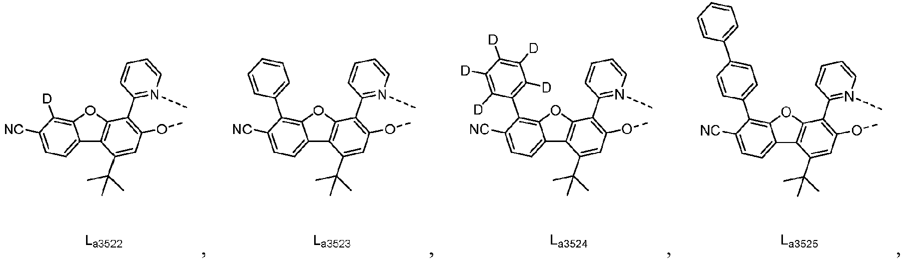 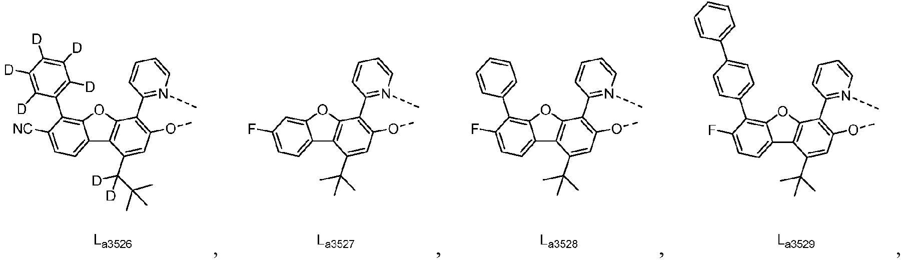 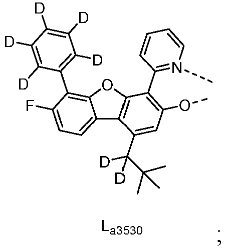
wherein optionally, hydrogens in Lₐ₁ to Lₐ₃₅₃₀ can be partially or fully substituted with deuterium.

12. The metal complex according to claim 2, 3 or 11, wherein L_{b} is, at each occurrence identically or differently, selected from the group consisting of: 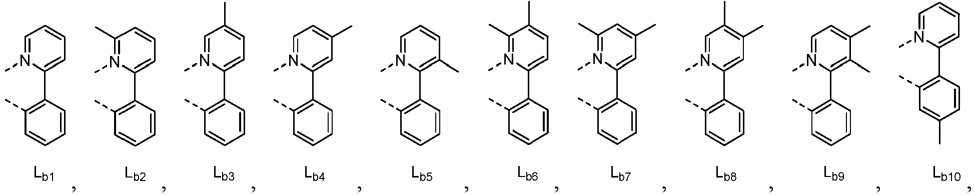 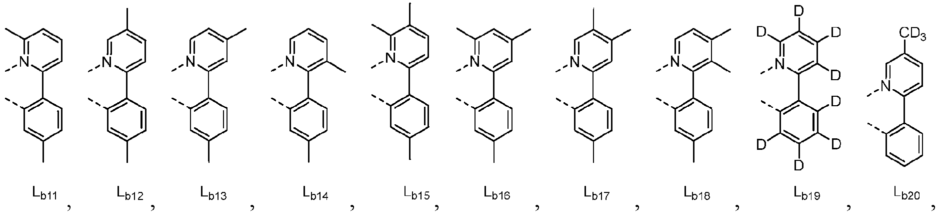 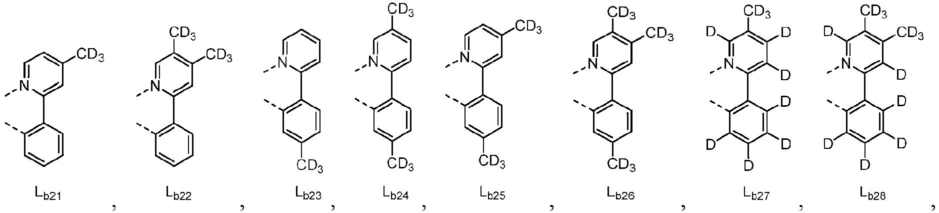 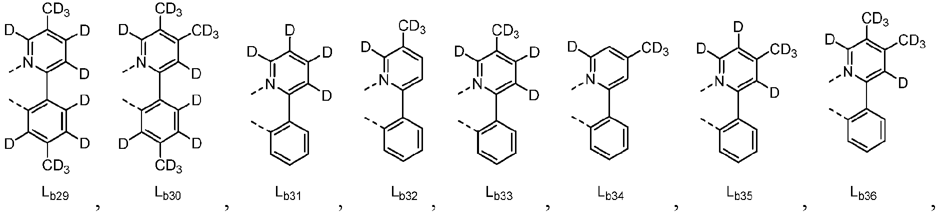 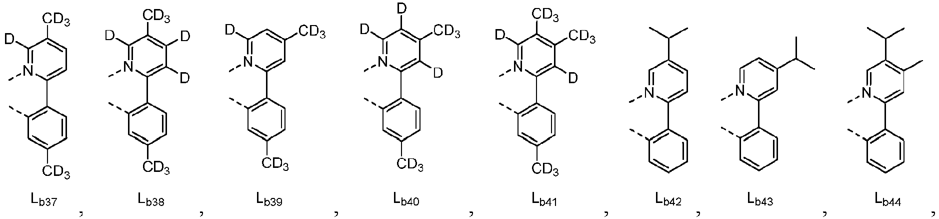 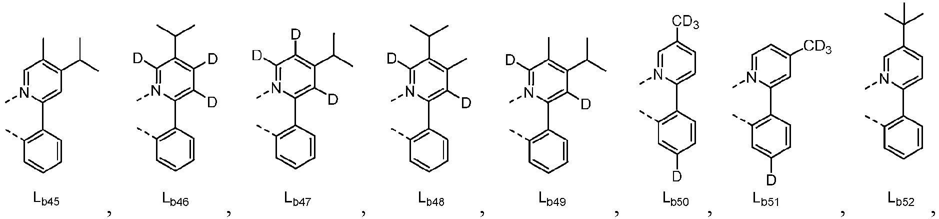 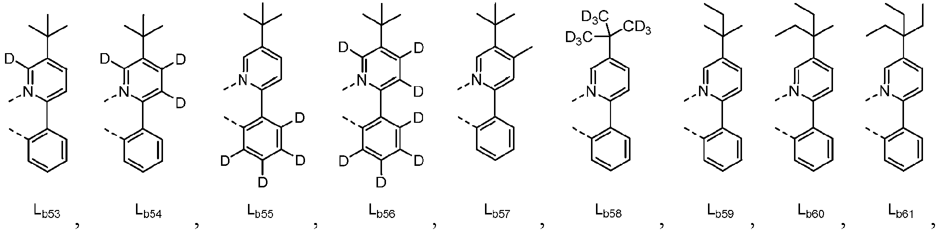 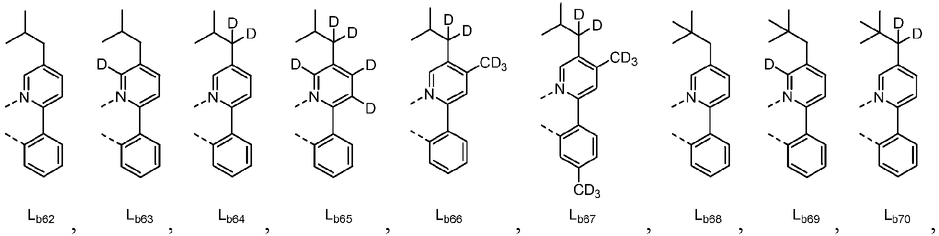 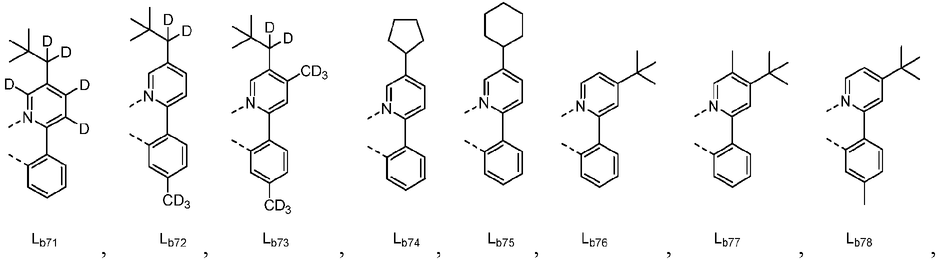 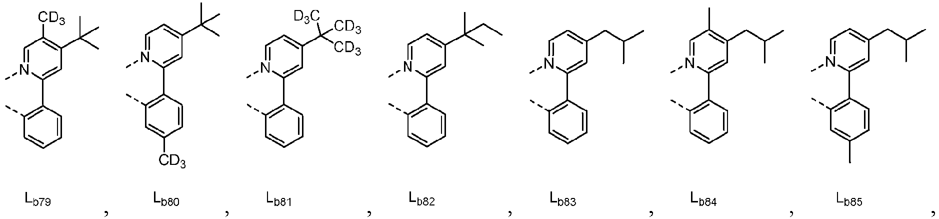 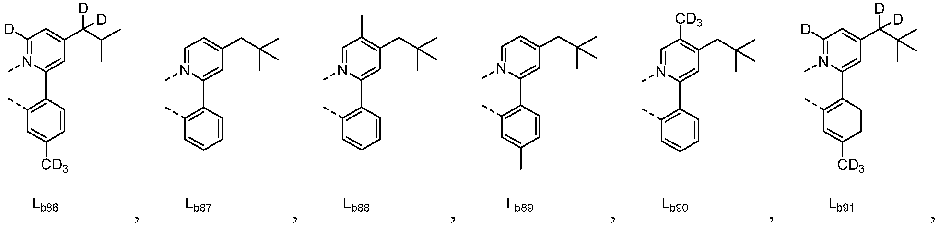 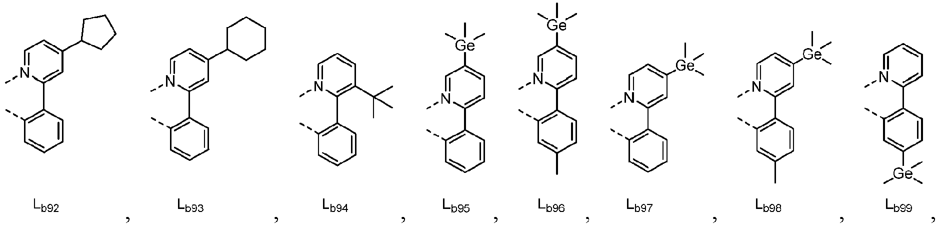 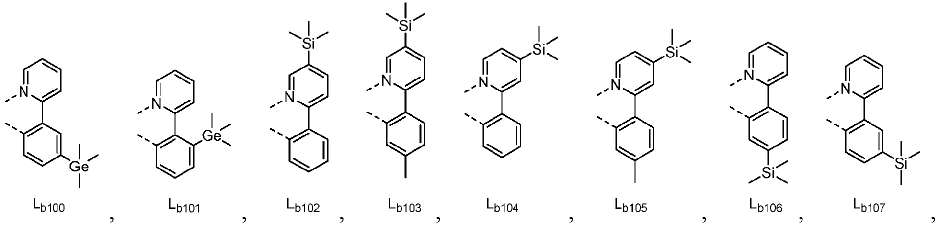 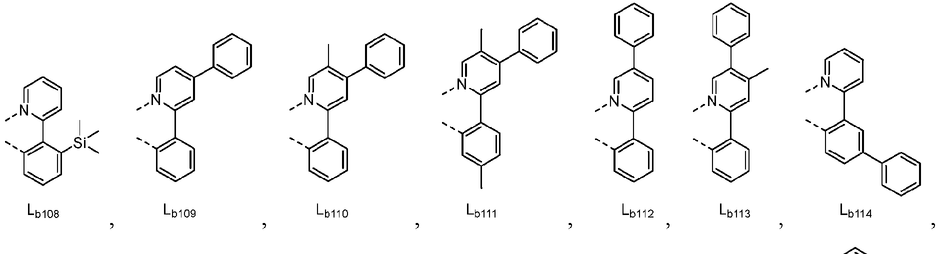 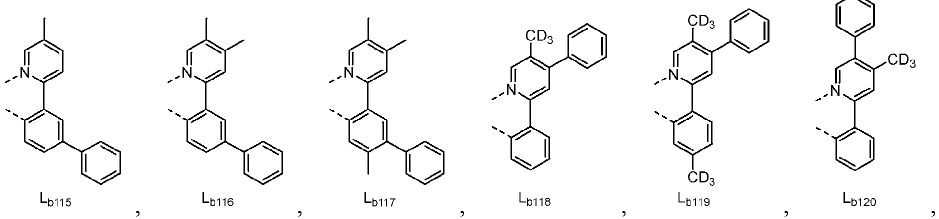 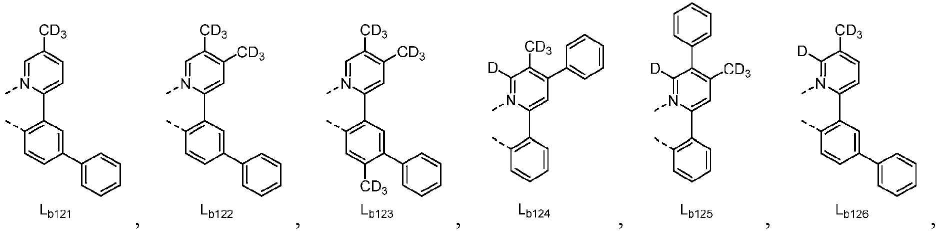 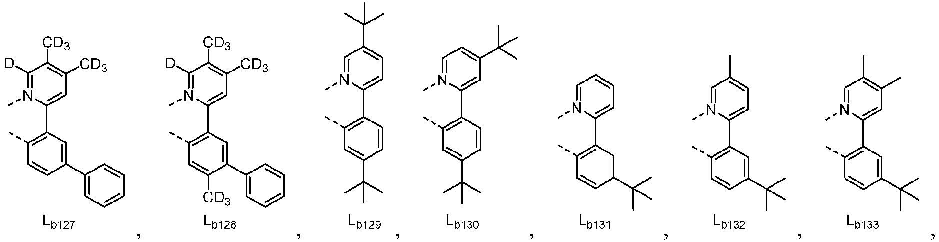 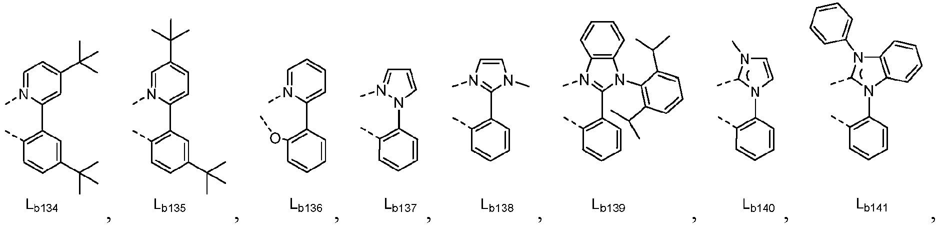 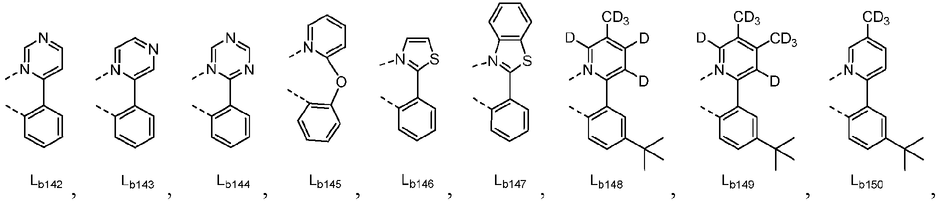 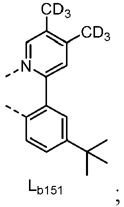 wherein optionally, hydrogens in the above L_{b1} to L_{b18}, L_{b20} to L_{b26} and L_{b31} to L_{b151} can be partially or fully substituted with deuterium.

13. The metal complex according to claim 12, wherein the metal complex has a structure of Ir(Lₐ)(L_{b})₂, wherein the two L_{b} are identical or different; and
preferably, the metal complex is selected from the group consisting of Metal Complex 1 to Metal Complex 3806, wherein Metal Complex 1 to Metal Complex 3806 each have a structure of Ir(Lₐ)(L_{b})₂, wherein the two L_{b} are identical, and Lₐ and L_{b} respectively correspond to the structures in the following table:
| Metal Complex No. | Lₐ | L_{b} | Metal Complex No. | Lₐ | L_{b} |
|---|---|---|---|---|---|
| 1 | Lₐ₁ | L_{b1} | 2 | Lₐ₁ | L_{b3} |
| 3 | Lₐ₁₂ | L_{b1} | 4 | Lₐ₁₂ | L_{b3} |
| 5 | Lₐ₂₁ | L_{b1} | 6 | Lₐ₂₁ | L_{b3} |
| 7 | Lₐ₂₃ | L_{b1} | 8 | Lₐ₂₃ | L_{b3} |
| 9 | Lₐ₃₃ | L_{b1} | 10 | Lₐ₃₃ | L_{b3} |
| 11 | Lₐ₄₂ | L_{b1} | 12 | Lₐ₄₂ | L_{b3} |
| 13 | Lₐ₆₃ | L_{b1} | 14 | Lₐ₆₃ | L_{b3} |
| 15 | Lₐ₆₆ | L_{b1} | 16 | Lₐ₆₆ | L_{b3} |
| 17 | Lₐ₇₅ | L_{b1} | 18 | Lₐ₇₅ | L_{b3} |
| 19 | Lₐ₆₃ | L_{b1} | 20 | Lₐ₆₃ | L_{b3} |
| 21 | Lₐ₁₀₅ | L_{b1} | 22 | Lₐ₁₀₅ | L_{b3} |
| 23 | Lₐ₁₀₇ | L_{b1} | 24 | Lₐ₁₀₇ | L_{b3} |
| 25 | Lₐ₁₂₁ | L_{b1} | 26 | Lₐ₁₂₁ | L_{b3} |
| 27 | Lₐ₁₂₈ | L_{b1} | 28 | Lₐ₁₂₈ | L_{b3} |
| 29 | Lₐ₁₃₀ | L_{b1} | 30 | Lₐ₁₃₀ | L_{b3} |
| 31 | Lₐ₁₃₁ | L_{b1} | 32 | Lₐ₁₃₁ | L_{b3} |
| 33 | Lₐ₁₃₂ | L_{b1} | 34 | Lₐ₁₃₂ | L_{b3} |
| 35 | Lₐ₁₃₃ | L_{b1} | 36 | Lₐ₁₃₃ | L_{b3} |
| 37 | Lₐ₁₃₅ | L_{b1} | 38 | Lₐ₁₃₅ | L_{b3} |
| 39 | Lₐ₁₃₆ | L_{b1} | 40 | Lₐ₁₃₆ | L_{b3} |
| 41 | Lₐ₁₄₀ | L_{b1} | 42 | Lₐ₁₄₀ | L_{b3} |
| 43 | Lₐ₁₅₀ | L_{b1} | 44 | Lₐ₁₅₀ | L_{b3} |
| 45 | Lₐ₁₅₂ | L_{b1} | 46 | Lₐ₁₅₂ | L_{b3} |
| 47 | Lₐ₁₅₄ | L_{b1} | 48 | Lₐ₁₅₄ | L_{b3} |
| 49 | Lₐ₁₅₇ | L_{b1} | 50 | Lₐ₁₅₇ | L_{b3} |
| 51 | Lₐ₁₆₁ | L_{b1} | 52 | Lₐ₁₆₁ | L_{b3} |
| 53 | Lₐ₁₇₀ | L_{b1} | 54 | Lₐ₁₇₀ | L_{b3} |
| 55 | Lₐ₁₇₁ | L_{b1} | 56 | Lₐ₁₇₁ | L_{b3} |
| 57 | Lₐ₁₈₀ | L_{b1} | 58 | Lₐ₁₈₀ | L_{b3} |
| 59 | Lₐ₁₈₂ | L_{b1} | 60 | Lₐ₁₈₂ | L_{b3} |
| 61 | Lₐ₁₈₉ | L_{b1} | 62 | Lₐ₁₈₉ | L_{b3} |
| 63 | Lₐ₁₉₁ | L_{b1} | 64 | Lₐ₁₉₁ | L_{b3} |
| 65 | Lₐ₁₉₃ | L_{b1} | 66 | Lₐ₁₉₃ | L_{b3} |
| 67 | Lₐ₂₀₁ | L_{b1} | 68 | Lₐ₂₀₁ | L_{b3} |
| 69 | Lₐ₂₀₃ | L_{b1} | 70 | Lₐ₂₀₃ | L_{b3} |
| 71 | Lₐ₂₀₅ | L_{b1} | 72 | Lₐ₂₀₅ | L_{b3} |
| 73 | Lₐ₂₀₆ | L_{b1} | 74 | Lₐ₂₀₆ | L_{b3} |
| 75 | Lₐ₂₁₂ | L_{b1} | 76 | Lₐ₂₁₂ | L_{b3} |
| 77 | Lₐ₂₂₄ | L_{b1} | 78 | Lₐ₂₂₄ | L_{b3} |
| 79 | Lₐ₂₂₇ | L_{b1} | 80 | Lₐ₂₂₇ | L_{b3} |
| 81 | Lₐ₂₃₃ | L_{b1} | 82 | Lₐ₂₃₃ | L_{b3} |
| 83 | Lₐ₂₄₀ | L_{b1} | 84 | Lₐ₂₄₀ | L_{b3} |
| 85 | Lₐ₂₄₃ | L_{b1} | 86 | Lₐ₂₄₃ | L_{b3} |
| 87 | Lₐ₂₅₂ | L_{b1} | 88 | Lₐ₂₅₂ | L_{b3} |
| 89 | Lₐ₂₅₃ | L_{b1} | 90 | Lₐ₂₅₃ | L_{b3} |
| 91 | Lₐ₂₆₅ | L_{b1} | 92 | Lₐ₂₆₅ | L_{b3} |
| 93 | Lₐ₂₇₂ | L_{b1} | 94 | Lₐ₂₇₂ | L_{b3} |
| 95 | Lₐ₂₇₃ | L_{b1} | 96 | Lₐ₂₇₃ | L_{b3} |
| 97 | Lₐ₂₇₈ | L_{b1} | 98 | Lₐ₂₇₈ | L_{b3} |
| 99 | Lₐ₂₈₂ | L_{b1} | 100 | Lₐ₂₈₂ | L_{b3} |
| 101 | Lₐ₂₈₃ | L_{b1} | 102 | Lₐ₂₈₃ | L_{b3} |
| 103 | Lₐ₂₉₃ | L_{b1} | 104 | Lₐ₂₉₃ | L_{b3} |
| 105 | Lₐ₂₉₄ | L_{b1} | 106 | Lₐ₂₉₄ | L_{b3} |
| 107 | Lₐ₂₉₅ | L_{b1} | 108 | Lₐ₂₉₅ | L_{b3} |
| 109 | Lₐ₃₁₀ | L_{b1} | 110 | Lₐ₃₁₀ | L_{b3} |
| 111 | Lₐ₃₁₄ | L_{b1} | 112 | Lₐ₃₁₄ | L_{b3} |
| 113 | Lₐ₃₂₅ | L_{b1} | 114 | Lₐ₃₂₅ | L_{b3} |
| 115 | Lₐ₃₄₃ | L_{b1} | 116 | Lₐ₃₄₃ | L_{b3} |
| 117 | Lₐ₃₄₅ | L_{b1} | 118 | Lₐ₃₄₅ | L_{b3} |
| 119 | Lₐ₃₆₃ | L_{b1} | 120 | Lₐ₃₆₃ | L_{b3} |
| 121 | Lₐ₃₈₅ | L_{b1} | 122 | Lₐ₃₈₅ | L_{b3} |
| 123 | Lₐ₃₉₆ | L_{b1} | 124 | Lₐ₃₉₆ | L_{b3} |
| 125 | Lₐ₄₀₇ | L_{b1} | 126 | Lₐ₄₀₇ | L_{b3} |
| 127 | Lₐ₄₀₈ | L_{b1} | 128 | Lₐ₄₀₈ | L_{b3} |
| 129 | Lₐ₄₁₄ | L_{b1} | 130 | Lₐ₄₁₄ | L_{b3} |
| 131 | Lₐ₄₂₃ | L_{b1} | 132 | Lₐ₄₂₃ | L_{b3} |
| 133 | Lₐ₄₃₄ | L_{b1} | 134 | Lₐ₄₃₄ | L_{b3} |
| 135 | Lₐ₄₅₆ | L_{b1} | 136 | Lₐ₄₅₆ | L_{b3} |
| 137 | Lₐ₄₆₇ | L_{b1} | 138 | Lₐ₄₆₇ | L_{b3} |
| 139 | Lₐ₆₃₀ | L_{b1} | 140 | Lₐ₆₃₀ | L_{b3} |
| 141 | Lₐ₆₃₁ | L_{b1} | 142 | Lₐ₆₃₁ | L_{b3} |
| 143 | Lₐ₆₄₅ | L_{b1} | 144 | Lₐ₆₄₅ | L_{b3} |
| 145 | Lₐ₆₄₆ | L_{b1} | 146 | Lₐ₆₄₆ | L_{b3} |
| 147 | Lₐ₆₄₇ | L_{b1} | 148 | Lₐ₆₄₇ | L_{b3} |
| 149 | Lₐ₆₄₈ | L_{b1} | 150 | Lₐ₆₄₈ | L_{b3} |
| 151 | Lₐ₆₆₅ | L_{b1} | 152 | Lₐ₆₆₅ | L_{b3} |
| 153 | Lₐ₇₄₆ | L_{b1} | 154 | Lₐ₇₄₆ | L_{b3} |
| 155 | Lₐ₇₄₇ | L_{b1} | 156 | Lₐ₇₄₇ | L_{b3} |
| 157 | Lₐ₈₂₄ | L_{b1} | 158 | Lₐ₈₂₄ | L_{b3} |
| 159 | Lₐ₈₂₅ | L_{b1} | 160 | Lₐ₈₂₅ | L_{b3} |
| 161 | Lₐ₈₄₄ | L_{b1} | 162 | Lₐ₈₄₄ | L_{b3} |
| 163 | Lₐ₈₄₆ | L_{b1} | 164 | Lₐ₈₄₆ | L_{b3} |
| 165 | Lₐ₈₆₅ | L_{b1} | 166 | Lₐ₈₆₅ | L_{b3} |
| 167 | Lₐ₈₆₈ | L_{b1} | 168 | Lₐ₈₆₈ | L_{b3} |
| 169 | Lₐ₈₈₉ | L_{b1} | 170 | Lₐ₈₈₉ | L_{b3} |
| 171 | Lₐ₉₀₉ | L_{b1} | 172 | Lₐ₉₀₉ | L_{b3} |
| 173 | Lₐ₉₁₃ | L_{b1} | 174 | Lₐ₉₁₃ | L_{b3} |
| 175 | Lₐ₉₁₅ | L_{b1} | 176 | Lₐ₉₁₅ | L_{b3} |
| 177 | Lₐ₉₂₀ | L_{b1} | 178 | Lₐ₉₂₀ | L_{b3} |
| 179 | Lₐ₉₂₂ | L_{b1} | 180 | Lₐ₉₂₂ | L_{b3} |
| 181 | Lₐ₉₂₃ | L_{b1} | 182 | Lₐ₉₂₃ | L_{b3} |
| 183 | Lₐ₉₂₄ | L_{b1} | 184 | Lₐ₉₂₄ | L_{b3} |
| 185 | Lₐ₉₂₅ | L_{b1} | 186 | Lₐ₉₂₅ | L_{b3} |
| 187 | Lₐ₉₂₈ | L_{b1} | 188 | Lₐ₉₂₈ | L_{b3} |
| 189 | Lₐ₉₅₃ | L_{b1} | 190 | Lₐ₉₅₃ | L_{b3} |
| 191 | Lₐ₉₅₄ | L_{b1} | 192 | Lₐ₉₅₄ | L_{b3} |
| 193 | Lₐ₉₇₄ | L_{b1} | 194 | Lₐ₉₇₄ | L_{b3} |
| 195 | Lₐ₉₇₆ | L_{b1} | 196 | Lₐ₉₇₆ | L_{b3} |
| 197 | Lₐ₉₉₅ | L_{b1} | 198 | Lₐ₉₉₅ | L_{b3} |
| 199 | Lₐ₁₀₀₆ | L_{b1} | 200 | Lₐ₁₀₀₆ | L_{b3} |
| 201 | Lₐ₁₀₁₇ | L_{b1} | 202 | Lₐ₁₀₁₇ | L_{b3} |
| 203 | Lₐ₁₀₁₈ | L_{b1} | 204 | Lₐ₁₀₁₈ | L_{b3} |
| 205 | Lₐ₁₀₂₃ | L_{b1} | 206 | Lₐ₁₀₂₃ | L_{b3} |
| 207 | Lₐ₁₀₂₄ | L_{b1} | 208 | Lₐ₁₀₂₄ | L_{b3} |
| 209 | Lₐ₁₀₂₆ | L_{b1} | 210 | Lₐ₁₀₂₆ | L_{b3} |
| 211 | Lₐ₁₀₈₈ | L_{b1} | 212 | Lₐ₁₀₈₈ | L_{b3} |
| 213 | Lₐ₁₀₈₉ | L_{b1} | 214 | Lₐ₁₀₈₉ | L_{b3} |
| 215 | Lₐ₁₀₉₅ | L_{b1} | 216 | Lₐ₁₀₉₅ | L_{b3} |
| 217 | Lₐ₁₁₀₀ | L_{b1} | 218 | Lₐ₁₁₀₀ | L_{b3} |
| 219 | Lₐ₁₁₁₆ | L_{b1} | 220 | Lₐ₁₁₁₆ | L_{b3} |
| 221 | Lₐ₁₁₁₈ | L_{b1} | 222 | Lₐ₁₁₁₈ | L_{b3} |
| 223 | Lₐ₁₁₃₆ | L_{b1} | 224 | Lₐ₁₁₃₆ | L_{b3} |
| 225 | Lₐ₁₁₄₈ | L_{b1} | 226 | Lₐ₁₁₄₈ | L_{b3} |
| 227 | Lₐ₁₁₅₈ | L_{b1} | 228 | Lₐ₁₁₅₈ | L_{b3} |
| 229 | Lₐ₁₁₅₉ | L_{b1} | 230 | Lₐ₁₁₅₉ | L_{b3} |
| 231 | Lₐ₁₁₆₁ | L_{b1} | 232 | Lₐ₁₁₆₁ | L_{b3} |
| 233 | Lₐ₁₁₆₆ | L_{b1} | 234 | Lₐ₁₁₆₆ | L_{b3} |
| 235 | Lₐ₁₁₇₁ | L_{b1} | 236 | Lₐ₁₁₇₁ | L_{b3} |
| 237 | Lₐ₁₁₈₇ | L_{b1} | 238 | Lₐ₁₁₈₇ | L_{b3} |
| 239 | Lₐ₁₁₉₂ | L_{b1} | 240 | Lₐ₁₁₉₂ | L_{b3} |
| 241 | Lₐ₁₂₀₅ | L_{b1} | 242 | Lₐ₁₂₀₅ | L_{b3} |
| 243 | Lₐ₁₂₀₈ | L_{b1} | 244 | Lₐ₁₂₀₈ | L_{b3} |
| 245 | Lₐ₁₂₁₇ | L_{b1} | 246 | Lₐ₁₂₁₇ | L_{b3} |
| 247 | Lₐ₁₂₁₉ | L_{b1} | 248 | Lₐ₁₂₁₉ | L_{b3} |
| 249 | Lₐ₁₂₃₀ | L_{b1} | 250 | Lₐ₁₂₃₀ | L_{b3} |
| 251 | Lₐ₁₂₃₇ | L_{b1} | 252 | Lₐ₁₂₃₇ | L_{b3} |
| 253 | Lₐ₁₂₃₈ | L_{b1} | 254 | Lₐ₁₂₃₈ | L_{b3} |
| 255 | Lₐ₁₂₃₉ | L_{b1} | 256 | Lₐ₁₂₃₉ | L_{b3} |
| 257 | Lₐ₁₂₄₅ | L_{b1} | 258 | Lₐ₁₂₄₅ | L_{b3} |
| 259 | Lₐ₁₂₄₆ | L_{b1} | 260 | Lₐ₁₂₄₆ | L_{b3} |
| 261 | Lₐ₁₂₄₇ | L_{b1} | 262 | Lₐ₁₂₄₇ | L_{b3} |
| 263 | Lₐ₁₂₄₈ | L_{b1} | 264 | Lₐ₁₂₄₈ | L_{b3} |
| 265 | Lₐ₁₂₅₈ | L_{b1} | 266 | Lₐ₁₂₅₈ | L_{b3} |
| 267 | Lₐ₁₂₆₀ | L_{b1} | 268 | Lₐ₁₂₆₀ | L_{b3} |
| 269 | Lₐ₁₂₆₁ | L_{b1} | 270 | Lₐ₁₂₆₁ | L_{b3} |
| 271 | Lₐ₁₂₇₇ | L_{b1} | 272 | Lₐ₁₂₇₇ | L_{b3} |
| 273 | Lₐ₁₂₇₈ | L_{b1} | 274 | Lₐ₁₂₇₈ | L_{b3} |
| 275 | Lₐ₁₂₇₉ | L_{b1} | 276 | Lₐ₁₂₇₉ | L_{b3} |
| 277 | Lₐ₁₂₈₈ | L_{b1} | 278 | Lₐ₁₂₈₈ | L_{b3} |
| 279 | Lₐ₁₂₈₉ | L_{b1} | 280 | Lₐ₁₂₈₉ | L_{b3} |
| 281 | Lₐ₁₃₀₁ | L_{b1} | 282 | Lₐ₁₃₀₁ | L_{b3} |
| 283 | Lₐ₁₃₀₂ | L_{b1} | 284 | Lₐ₁₃₀₂ | L_{b3} |
| 285 | Lₐ₁₄₄₂ | L_{b1} | 286 | Lₐ₁₄₄₂ | L_{b3} |
| 287 | Lₐ₁₄₄₈ | L_{b1} | 288 | Lₐ₁₄₄₈ | L_{b3} |
| 289 | Lₐ₁₄₄₉ | L_{b1} | 290 | Lₐ₁₄₄₉ | L_{b3} |
| 291 | Lₐ₁₄₆₀ | L_{b1} | 292 | Lₐ₁₄₆₀ | L_{b3} |
| 293 | Lₐ₁₄₇₁ | L_{b1} | 294 | Lₐ₁₄₇₁ | L_{b3} |
| 295 | Lₐ₁₅₆₉ | L_{b1} | 296 | Lₐ₁₅₆₉ | L_{b3} |
| 297 | Lₐ₁₅₇₀ | L_{b1} | 298 | Lₐ₁₅₇₀ | L_{b3} |
| 299 | Lₐ₁₆₄₇ | L_{b1} | 300 | Lₐ₁₆₄₇ | L_{b3} |
| 301 | Lₐ₁₆₄₈ | L_{b1} | 302 | Lₐ₁₆₄₈ | L_{b3} |
| 303 | Lₐ₁₆₄₉ | L_{b1} | 304 | Lₐ₁₆₄₉ | L_{b3} |
| 305 | Lₐ₁₆₅₀ | L_{b1} | 306 | Lₐ₁₆₅₀ | L_{b3} |
| 307 | Lₐ₁₆₅₁ | L_{b1} | 308 | Lₐ₁₆₅₁ | L_{b3} |
| 309 | Lₐ₁₆₇₇ | L_{b1} | 310 | Lₐ₁₆₇₇ | L_{b3} |
| 311 | Lₐ₁₆₇₈ | L_{b1} | 312 | Lₐ₁₆₇₈ | L_{b3} |
| 313 | Lₐ₁₆₇₉ | L_{b1} | 314 | Lₐ₁₆₇₉ | L_{b3} |
| 315 | Lₐ₁₆₈₀ | L_{b1} | 316 | Lₐ₁₆₈₀ | L_{b3} |
| 317 | Lₐ₁₆₉₁ | L_{b1} | 318 | Lₐ₁₆₉₁ | L_{b3} |
| 319 | Lₐ₁₆₉₃ | L_{b1} | 320 | Lₐ₁₆₉₃ | L_{b3} |
| 321 | Lₐ₁₆₉₅ | L_{b1} | 322 | Lₐ₁₆₉₅ | L_{b3} |
| 323 | Lₐ₁₆₉₆ | L_{b1} | 324 | Lₐ₁₆₉₆ | L_{b3} |
| 325 | Lₐ₁₆₉₉ | L_{b1} | 326 | Lₐ₁₆₉₉ | L_{b3} |
| 327 | Lₐ₁₇₀₁ | L_{b1} | 328 | Lₐ₁₇₀₁ | L_{b3} |
| 329 | Lₐ₁₇₀₂ | L_{b1} | 330 | Lₐ₁₇₀₂ | L_{b3} |
| 331 | Lₐ₁₇₁₂ | L_{b1} | 332 | Lₐ₁₇₁₂ | L_{b3} |
| 333 | Lₐ₁₇₁₃ | L_{b1} | 334 | Lₐ₁₇₁₃ | L_{b3} |
| 335 | Lₐ₁₇₃₅ | L_{b1} | 336 | Lₐ₁₇₃₅ | L_{b3} |
| 337 | Lₐ₁₇₉₅ | L_{b1} | 338 | Lₐ₁₇₉₅ | L_{b3} |
| 339 | Lₐ₁₈₂₀ | L_{b1} | 340 | Lₐ₁₈₂₀ | L_{b3} |
| 341 | Lₐ₁₈₉₁ | L_{b1} | 342 | Lₐ₁₈₉₁ | L_{b3} |
| 343 | Lₐ₁₈₉₂ | L_{b1} | 344 | Lₐ₁₈₉₂ | L_{b3} |
| 345 | Lₐ₁₈₉₃ | L_{b1} | 346 | Lₐ₁₈₉₃ | L_{b3} |
| 347 | Lₐ₁₈₉₉ | L_{b1} | 348 | Lₐ₁₈₉₉ | L_{b3} |
| 349 | Lₐ₁₉₀₂ | L_{b1} | 350 | Lₐ₁₉₀₂ | L_{b3} |
| 351 | Lₐ₁₉₁₃ | L_{b1} | 352 | Lₐ₁₉₁₃ | L_{b3} |
| 353 | Lₐ₁₉₁₄ | L_{b1} | 354 | Lₐ₁₉₁₄ | L_{b3} |
| 355 | Lₐ₁₉₃₃ | L_{b1} | 356 | Lₐ₁₉₃₃ | L_{b3} |
| 357 | Lₐ₁₉₄₅ | L_{b1} | 358 | Lₐ₁₉₄₅ | L_{b3} |
| 359 | Lₐ₁₉₅₄ | L_{b1} | 360 | Lₐ₁₉₅₄ | L_{b3} |
| 361 | Lₐ₁₉₅₅ | L_{b1} | 362 | Lₐ₁₉₅₅ | L_{b3} |
| 363 | Lₐ₁₉₅₆ | L_{b1} | 364 | Lₐ₁₉₅₆ | L_{b3} |
| 365 | Lₐ₁₉₆₂ | L_{b1} | 366 | Lₐ₁₉₆₂ | L_{b3} |
| 367 | Lₐ₁₉₆₄ | L_{b1} | 368 | Lₐ₁₉₆₄ | L_{b3} |
| 369 | Lₐ₁₉₆₅ | L_{b1} | 370 | Lₐ₁₉₆₅ | L_{b3} |
| 371 | Lₐ₁₉₆₆ | L_{b1} | 372 | Lₐ₁₉₆₆ | L_{b3} |
| 373 | Lₐ₁₉₇₀ | L_{b1} | 374 | Lₐ₁₉₇₀ | L_{b3} |
| 375 | Lₐ₁₉₇₃ | L_{b1} | 376 | Lₐ₁₉₇₃ | L_{b3} |
| 377 | Lₐ₂₀₀₂ | L_{b1} | 378 | Lₐ₂₀₀₂ | L_{b3} |
| 379 | Lₐ₂₀₀₃ | L_{b1} | 380 | Lₐ₂₀₀₃ | L_{b3} |
| 381 | Lₐ₂₀₁₃ | L_{b1} | 382 | Lₐ₂₀₁₃ | L_{b3} |
| 383 | Lₐ₂₀₁₄ | L_{b1} | 384 | Lₐ₂₀₁₄ | L_{b3} |
| 385 | Lₐ₂₀₁₅ | L_{b1} | 386 | Lₐ₂₀₁₅ | L_{b3} |
| 387 | Lₐ₂₀₃₃ | L_{b1} | 388 | Lₐ₂₀₃₃ | L_{b3} |
| 389 | Lₐ₂₁₀₄ | L_{b1} | 390 | Lₐ₂₁₀₄ | L_{b3} |
| 391 | Lₐ₂₃₂₆ | L_{b1} | 392 | Lₐ₂₃₂₆ | L_{b3} |
| 393 | Lₐ₂₃₃₇ | L_{b1} | 394 | Lₐ₂₃₃₇ | L_{b3} |
| 395 | Lₐ₂₄₃₆ | L_{b1} | 396 | Lₐ₂₄₃₆ | L_{b3} |
| 397 | Lₐ₂₄₃₇ | L_{b1} | 398 | Lₐ₂₄₃₇ | L_{b3} |
| 399 | Lₐ₂₅₁₄ | L_{b1} | 400 | Lₐ₂₅₁₄ | L_{b3} |
| 401 | Lₐ₂₆₁₂ | L_{b1} | 402 | Lₐ₂₆₁₂ | L_{b3} |
| 403 | Lₐ₂₆₁₈ | L_{b1} | 404 | Lₐ₂₆₁₈ | L_{b3} |
| 405 | Lₐ₂₆₄₃ | L_{b1} | 406 | Lₐ₂₆₄₃ | L_{b3} |
| 407 | Lₐ₂₆₅₄ | L_{b1} | 408 | Lₐ₂₆₅₄ | L_{b3} |
| 409 | Lₐ₂₇₁₄ | L_{b1} | 410 | Lₐ₂₇₁₄ | L_{b3} |
| 411 | Lₐ₂₇₈₅ | L_{b1} | 412 | Lₐ₂₇₈₅ | L_{b3} |
| 413 | Lₐ₂₈₅₆ | L_{b1} | 414 | Lₐ₂₈₅₆ | L_{b3} |
| 415 | Lₐ₂₉₂₇ | L_{b1} | 416 | Lₐ₂₉₂₇ | L_{b3} |
| 417 | Lₐ₃₃₃₇ | L_{b1} | 418 | Lₐ₃₃₃₇ | L_{b3} |
| 419 | Lₐ₃₃₃₈ | L_{b1} | 420 | Lₐ₃₃₃₈ | L_{b3} |
| 421 | Lₐ₃₃₃₉ | L_{b1} | 422 | Lₐ₃₃₃₉ | L_{b3} |
| 423 | Lₐ₃₃₄₀ | L_{b1} | 424 | Lₐ₃₃₄₀ | L_{b3} |
| 425 | Lₐ₃₃₄₁ | L_{b1} | 426 | Lₐ₃₃₄₁ | L_{b3} |
| 427 | Lₐ₁ | L_{b8} | 428 | Lₐ₁ | L_{b20} |
| 429 | Lₐ₁₂ | L_{b8} | 430 | Lₐ₁₂ | L_{b20} |
| 431 | Lₐ₂₁ | L_{b8} | 432 | Lₐ₂₁ | L_{b20} |
| 433 | Lₐ₂₃ | L_{b8} | 434 | Lₐ₂₃ | L_{b20} |
| 435 | Lₐ₃₃ | L_{b8} | 436 | Lₐ₃₃ | L_{b20} |
| 437 | Lₐ₄₂ | L_{b8} | 438 | Lₐ₄₂ | L_{b20} |
| 439 | Lₐ₆₃ | L_{b8} | 440 | Lₐ₆₃ | L_{b20} |
| 441 | Lₐ₆₆ | L_{b8} | 442 | Lₐ₆₆ | L_{b20} |
| 443 | Lₐ₇₅ | L_{b8} | 444 | Lₐ₇₅ | L_{b20} |
| 445 | Lₐ₈₄ | L_{b8} | 446 | Lₐ₈₄ | L_{b20} |
| 447 | Lₐ₁₀₅ | L_{b8} | 448 | Lₐ₁₀₅ | L_{b20} |
| 449 | Lₐ₁₀₇ | L_{b8} | 450 | Lₐ₁₀₇ | L_{b20} |
| 451 | Lₐ₁₂₁ | L_{b8} | 452 | Lₐ₁₂₁ | L_{b20} |
| 453 | Lₐ₁₂₈ | L_{b8} | 454 | Lₐ₁₂₈ | L_{b20} |
| 455 | Lₐ₁₃₀ | L_{b8} | 456 | Lₐ₁₃₀ | L_{b20} |
| 457 | Lₐ₁₃₁ | L_{b8} | 458 | Lₐ₁₃₁ | L_{b20} |
| 459 | Lₐ₁₃₂ | L_{b8} | 460 | Lₐ₁₃₂ | L_{b20} |
| 461 | Lₐ₁₃₃ | L_{b8} | 462 | Lₐ₁₃₃ | L_{b20} |
| 463 | Lₐ₁₃₅ | L_{b8} | 464 | Lₐ₁₃₅ | L_{b20} |
| 465 | Lₐ₁₃₆ | L_{b8} | 466 | Lₐ₁₃₆ | L_{b20} |
| 467 | Lₐ₁₄₀ | L_{b8} | 468 | Lₐ₁₄₀ | L_{b20} |
| 469 | Lₐ₁₅₀ | L_{b8} | 470 | Lₐ₁₅₀ | L_{b20} |
| 471 | Lₐ₁₅₂ | L_{b8} | 472 | Lₐ₁₅₂ | L_{b20} |
| 473 | Lₐ₁₅₄ | L_{b8} | 474 | Lₐ₁₅₄ | L_{b20} |
| 475 | Lₐ₁₅₇ | L_{b8} | 476 | Lₐ₁₅₇ | L_{b20} |
| 477 | Lₐ₁₆₁ | L_{b8} | 478 | Lₐ₁₆₁ | L_{b20} |
| 479 | Lₐ₁₇₀ | L_{b8} | 480 | Lₐ₁₇₀ | L_{b20} |
| 481 | Lₐ₁₇₁ | L_{b8} | 482 | Lₐ₁₇₁ | L_{b20} |
| 433 | Lₐ₁₈₀ | L_{b8} | 484 | Lₐ₁₈₀ | L_{b20} |
| 485 | Lₐ₁₈₂ | L_{b8} | 486 | Lₐ₁₈₂ | L_{b20} |
| 487 | Lₐ₁₈₉ | L_{b8} | 488 | Lₐ₁₈₉ | L_{b20} |
| 489 | Lₐ₁₉₁ | L_{b8} | 490 | Lₐ₁₉₁ | L_{b20} |
| 491 | Lₐ₁₉₃ | L_{b8} | 492 | Lₐ₁₉₃ | L_{b20} |
| 493 | Lₐ₂₀₁ | L_{b8} | 494 | Lₐ₂₀₁ | L_{b20} |
| 495 | Lₐ₂₀₃ | L_{b8} | 496 | Lₐ₂₀₃ | L_{b20} |
| 497 | Lₐ₂₀₅ | L_{b8} | 498 | Lₐ₂₀₅ | L_{b20} |
| 499 | Lₐ₂₀₆ | L_{b8} | 500 | Lₐ₂₀₆ | L_{b20} |
| 501 | Lₐ₂₁₂ | L_{b8} | 502 | Lₐ₂₁₂ | L_{b20} |
| 503 | Lₐ₂₂₄ | L_{b8} | 504 | Lₐ₂₂₄ | L_{b20} |
| 505 | Lₐ₂₂₇ | L_{b8} | 506 | Lₐ₂₂₇ | L_{b20} |
| 507 | Lₐ₂₃₃ | L_{b8} | 508 | Lₐ₂₃₃ | L_{b20} |
| 509 | Lₐ₂₄₀ | L_{b8} | 510 | Lₐ₂₄₀ | L_{b20} |
| 511 | Lₐ₂₄₃ | L_{b8} | 512 | Lₐ₂₄₃ | L_{b20} |
| 513 | Lₐ₂₅₂ | L_{b8} | 514 | Lₐ₂₅₂ | L_{b20} |
| 515 | Lₐ₂₅₃ | L_{b8} | 516 | Lₐ₂₅₃ | L_{b20} |
| 517 | Lₐ₂₆₅ | L_{b8} | 518 | Lₐ₂₆₅ | L_{b20} |
| 519 | Lₐ₂₇₂ | L_{b8} | 520 | Lₐ₂₇₂ | L_{b20} |
| 521 | Lₐ₂₇₃ | L_{b8} | 522 | Lₐ₂₇₃ | L_{b20} |
| 523 | Lₐ₂₇₈ | L_{b8} | 524 | Lₐ₂₇₈ | L_{b20} |
| 525 | Lₐ₂₈₂ | L_{b8} | 526 | Lₐ₂₈₂ | L_{b20} |
| 527 | Lₐ₂₈₃ | L_{b8} | 528 | Lₐ₂₈₃ | L_{b20} |
| 529 | Lₐ₂₉₃ | L_{b8} | 530 | Lₐ₂₉₃ | L_{b20} |
| 531 | Lₐ₂₉₄ | L_{b8} | 532 | Lₐ₂₉₄ | L_{b20} |
| 533 | Lₐ₂₉₅ | L_{b8} | 534 | Lₐ₂₉₅ | L_{b20} |
| 535 | Lₐ₃₁₀ | L_{b8} | 536 | Lₐ₃₁₀ | L_{b20} |
| 537 | Lₐ₃₁₄ | L_{b8} | 538 | Lₐ₃₁₄ | L_{b20} |
| 539 | Lₐ₃₂₅ | L_{b8} | 540 | Lₐ₃₂₅ | L_{b20} |
| 541 | Lₐ₃₄₃ | L_{b8} | 542 | Lₐ₃₄₃ | L_{b20} |
| 543 | Lₐ₃₄₅ | L_{b8} | 544 | Lₐ₃₄₅ | L_{b20} |
| 545 | Lₐ₃₆₃ | L_{b8} | 546 | Lₐ₃₆₃ | L_{b20} |
| 547 | Lₐ₃₈₅ | L_{b8} | 548 | Lₐ₃₈₅ | L_{b20} |
| 549 | Lₐ₃₉₆ | L_{b8} | 550 | Lₐ₃₉₆ | L_{b20} |
| 551 | Lₐ₄₀₇ | L_{b8} | 552 | Lₐ₄₀₇ | L_{b20} |
| 553 | Lₐ₄₀₈ | L_{b8} | 554 | Lₐ₄₀₈ | L_{b20} |
| 555 | Lₐ₄₁₄ | L_{b8} | 556 | Lₐ₄₁₄ | L_{b20} |
| 557 | Lₐ₄₂₃ | L_{b8} | 558 | Lₐ₄₂₃ | L_{b20} |
| 559 | Lₐ₄₃₄ | L_{b8} | 560 | Lₐ₄₃₄ | L_{b20} |
| 561 | Lₐ₄₅₆ | L_{b8} | 562 | Lₐ₄₅₆ | L_{b20} |
| 563 | Lₐ₄₆₇ | L_{b8} | 564 | Lₐ₄₆₇ | L_{b20} |
| 565 | Lₐ₆₃₀ | L_{b8} | 566 | Lₐ₆₃₀ | L_{b20} |
| 567 | Lₐ₆₃₁ | L_{b8} | 568 | Lₐ₆₃₁ | L_{b20} |
| 569 | Lₐ₆₄₅ | L_{b8} | 570 | Lₐ₆₄₅ | L_{b20} |
| 571 | Lₐ₆₄₆ | L_{b8} | 572 | Lₐ₆₄₆ | L_{b20} |
| 573 | Lₐ₆₄₇ | L_{b8} | 574 | Lₐ₆₄₇ | L_{b20} |
| 575 | Lₐ₆₄₈ | L_{b8} | 576 | Lₐ₆₄₈ | L_{b20} |
| 577 | Lₐ₆₆₅ | L_{b8} | 578 | Lₐ₆₆₅ | L_{b20} |
| 579 | Lₐ₇₄₆ | L_{b8} | 580 | Lₐ₇₄₆ | L_{b20} |
| 581 | Lₐ₇₄₇ | L_{b8} | 582 | Lₐ₇₄₇ | L_{b20} |
| 583 | Lₐ₈₂₄ | L_{b8} | 584 | Lₐ₈₂₄ | L_{b20} |
| 585 | Lₐ₈₂₅ | L_{b8} | 586 | Lₐ₈₂₅ | L_{b20} |
| 587 | Lₐ₈₄₄ | L_{b8} | 588 | Lₐ₈₄₄ | L_{b20} |
| 589 | Lₐ₈₄₆ | L_{b8} | 590 | Lₐ₈₄₆ | L_{b20} |
| 591 | Lₐ₈₆₅ | L_{b8} | 592 | Lₐ₈₆₅ | L_{b20} |
| 593 | Lₐ₈₆₈ | L_{b8} | 594 | Lₐ₈₆₈ | L_{b20} |
| 595 | Lₐ₈₈₉ | L_{b8} | 596 | Lₐ₈₈₉ | L_{b20} |
| 597 | Lₐ₉₀₉ | L_{b8} | 598 | Lₐ₉₀₉ | L_{b20} |
| 599 | Lₐ₉₁₃ | L_{b8} | 600 | Lₐ₉₁₃ | L_{b20} |
| 601 | Lₐ₉₁₅ | L_{b8} | 602 | Lₐ₉₁₅ | L_{b20} |
| 603 | Lₐ₉₂₀ | L_{b8} | 604 | Lₐ₉₂₀ | L_{b20} |
| 605 | Lₐ₉₂₂ | L_{b8} | 606 | Lₐ₉₂₂ | L_{b20} |
| 607 | Lₐ₉₂₃ | L_{b8} | 608 | Lₐ₉₂₃ | L_{b20} |
| 609 | Lₐ₉₂₄ | L_{b8} | 610 | Lₐ₉₂₄ | L_{b20} |
| 611 | Lₐ₉₂₅ | L_{b8} | 612 | Lₐ₉₂₅ | L_{b20} |
| 613 | Lₐ₉₂₈ | L_{b8} | 614 | Lₐ₉₂₈ | L_{b20} |
| 615 | Lₐ₉₅₃ | L_{b8} | 616 | Lₐ₉₅₃ | L_{b20} |
| 617 | Lₐ₉₅₄ | L_{b8} | 618 | Lₐ₉₅₄ | L_{b20} |
| 619 | Lₐ₉₇₄ | L_{b8} | 620 | Lₐ₉₇₄ | L_{b20} |
| 621 | Lₐ₉₇₆ | L_{b8} | 622 | Lₐ₉₇₆ | L_{b20} |
| 623 | Lₐ₉₉₅ | L_{b8} | 624 | Lₐ₉₉₅ | L_{b20} |
| 625 | Lₐ₁₀₀₆ | L_{b8} | 626 | Lₐ₁₀₀₆ | L_{b20} |
| 627 | Lₐ₁₀₁₇ | L_{b8} | 628 | Lₐ₁₀₁₇ | L_{b20} |
| 629 | Lₐ₁₀₁₈ | L_{b8} | 630 | Lₐ₁₀₁₈ | L_{b20} |
| 631 | Lₐ₁₀₂₃ | L_{b8} | 632 | Lₐ₁₀₂₃ | L_{b20} |
| 633 | Lₐ₁₀₂₄ | L_{b8} | 634 | Lₐ₁₀₂₄ | L_{b20} |
| 635 | Lₐ₁₀₂₆ | L_{b8} | 636 | Lₐ₁₀₂₆ | L_{b20} |
| 637 | Lₐ₁₀₈₈ | L_{b8} | 638 | Lₐ₁₀₈₈ | L_{b20} |
| 639 | Lₐ₁₀₈₉ | L_{b8} | 640 | Lₐ₁₀₈₉ | L_{b20} |
| 641 | Lₐ₁₀₉₅ | L_{b8} | 642 | Lₐ₁₀₉₅ | L_{b20} |
| 643 | Lₐ₁₁₀₀ | L_{b8} | 644 | Lₐ₁₁₀₀ | L_{b20} |
| 645 | Lₐ₁₁₁₆ | L_{b8} | 646 | Lₐ₁₁₁₆ | L_{b20} |
| 647 | Lₐ₁₁₁₈ | L_{b8} | 648 | Lₐ₁₁₁₈ | L_{b20} |
| 649 | Lₐ₁₁₃₆ | L_{b8} | 650 | Lₐ₁₁₃₆ | L_{b20} |
| 651 | Lₐ₁₁₄₈ | L_{b8} | 652 | Lₐ₁₁₄₈ | L_{b20} |
| 653 | Lₐ₁₁₅₈ | L_{b8} | 654 | Lₐ₁₁₅₈ | L_{b20} |
| 655 | Lₐ₁₁₅₉ | L_{b8} | 656 | Lₐ₁₁₅₉ | L_{b20} |
| 657 | Lₐ₁₁₆₁ | L_{b8} | 658 | Lₐ₁₁₆₁ | L_{b20} |
| 659 | Lₐ₁₁₆₆ | L_{b8} | 660 | Lₐ₁₁₆₆ | L_{b20} |
| 661 | Lₐ₁₁₇₁ | L_{b8} | 662 | Lₐ₁₁₇₁ | L_{b20} |
| 663 | Lₐ₁₁₈₇ | L_{b8} | 664 | Lₐ₁₁₈₇ | L_{b20} |
| 665 | Lₐ₁₁₉₂ | L_{b8} | 666 | Lₐ₁₁₉₂ | L_{b20} |
| 667 | Lₐ₁₂₀₅ | L_{b8} | 668 | Lₐ₁₂₀₅ | L_{b20} |
| 669 | Lₐ₁₂₀₈ | L_{b8} | 670 | Lₐ₁₂₀₈ | L_{b20} |
| 671 | Lₐ₁₂₁₇ | L_{b8} | 672 | Lₐ₁₂₁₇ | L_{b20} |
| 673 | Lₐ₁₂₁₉ | L_{b8} | 674 | Lₐ₁₂₁₉ | L_{b20} |
| 675 | Lₐ₁₂₃₀ | L_{b8} | 676 | Lₐ₁₂₃₀ | L_{b20} |
| 677 | Lₐ₁₂₃₇ | L_{b8} | 678 | Lₐ₁₂₃₇ | L_{b20} |
| 679 | Lₐ₁₂₃₈ | L_{b8} | 680 | Lₐ₁₂₃₈ | L_{b20} |
| 681 | Lₐ₁₂₃₉ | L_{b8} | 682 | Lₐ₁₂₃₉ | L_{b20} |
| 683 | Lₐ₁₂₄₅ | L_{b8} | 684 | Lₐ₁₂₄₅ | L_{b20} |
| 685 | Lₐ₁₂₄₆ | L_{b8} | 686 | Lₐ₁₂₄₆ | L_{b20} |
| 687 | Lₐ₁₂₄₇ | L_{b8} | 688 | Lₐ₁₂₄₇ | L_{b20} |
| 689 | Lₐ₁₂₄₈ | L_{b8} | 690 | Lₐ₁₂₄₈ | L_{b20} |
| 691 | Lₐ₁₂₅₈ | L_{b8} | 692 | Lₐ₁₂₅₈ | L_{b20} |
| 693 | Lₐ₁₂₆₀ | L_{b8} | 694 | Lₐ₁₂₆₀ | L_{b20} |
| 695 | Lₐ₁₂₆₁ | L_{b8} | 696 | Lₐ₁₂₆₁ | L_{b20} |
| 697 | Lₐ₁₂₇₇ | L_{b8} | 698 | Lₐ₁₂₇₇ | L_{b20} |
| 699 | Lₐ₁₂₇₈ | L_{b8} | 700 | Lₐ₁₂₇₈ | L_{b20} |
| 701 | Lₐ₁₂₇₉ | L_{b8} | 702 | Lₐ₁₂₇₉ | L_{b20} |
| 703 | Lₐ₁₂₈₈ | L_{b8} | 704 | Lₐ₁₂₈₈ | L_{b20} |
| 705 | Lₐ₁₂₈₉ | L_{b8} | 706 | Lₐ₁₂₈₉ | L_{b20} |
| 707 | Lₐ₁₃₀₁ | L_{b8} | 708 | Lₐ₁₃₀₁ | L_{b20} |
| 709 | Lₐ₁₃₀₂ | L_{b8} | 710 | Lₐ₁₃₀₂ | L_{b20} |
| 711 | Lₐ₁₄₄₂ | L_{b8} | 712 | Lₐ₁₄₄₂ | L_{b20} |
| 713 | Lₐ₁₄₄₈ | L_{b8} | 714 | Lₐ₁₄₄₈ | L_{b20} |
| 715 | Lₐ₁₄₄₉ | L_{b8} | 716 | Lₐ₁₄₄₉ | L_{b20} |
| 717 | Lₐ₁₄₆₀ | L_{b8} | 718 | Lₐ₁₄₆₀ | L_{b20} |
| 719 | Lₐ₁₄₇₁ | L_{b8} | 720 | Lₐ₁₄₇₁ | L_{b20} |
| 721 | Lₐ₁₅₆₉ | L_{b8} | 722 | Lₐ₁₅₆₉ | L_{b20} |
| 723 | Lₐ₁₅₇₀ | L_{b8} | 724 | Lₐ₁₅₇₀ | L_{b20} |
| 725 | Lₐ₁₆₄₇ | L_{b8} | 726 | Lₐ₁₆₄₇ | L_{b20} |
| 727 | Lₐ₁₆₄₈ | L_{b8} | 728 | Lₐ₁₆₄₈ | L_{b20} |
| 729 | Lₐ₁₆₄₉ | L_{b8} | 730 | Lₐ₁₆₄₉ | L_{b20} |
| 731 | Lₐ₁₆₅₀ | L_{b8} | 732 | Lₐ₁₆₅₀ | L_{b20} |
| 733 | Lₐ₁₆₅₁ | L_{b8} | 734 | Lₐ₁₆₅₁ | L_{b20} |
| 735 | Lₐ₁₆₇₇ | L_{b8} | 736 | Lₐ₁₆₇₇ | L_{b20} |
| 737 | Lₐ₁₆₇₈ | L_{b8} | 738 | Lₐ₁₆₇₈ | L_{b20} |
| 739 | Lₐ₁₆₇₉ | L_{b8} | 740 | Lₐ₁₆₇₉ | L_{b20} |
| 741 | Lₐ₁₆₈₀ | L_{b8} | 742 | Lₐ₁₆₈₀ | L_{b20} |
| 743 | Lₐ₁₆₉₁ | L_{b8} | 744 | Lₐ₁₆₉₁ | L_{b20} |
| 745 | Lₐ₁₆₉₃ | L_{b8} | 746 | Lₐ₁₆₉₃ | L_{b20} |
| 747 | Lₐ₁₆₉₅ | L_{b8} | 748 | Lₐ₁₆₉₅ | L_{b20} |
| 749 | Lₐ₁₆₉₆ | L_{b8} | 750 | Lₐ₁₆₉₆ | L_{b20} |
| 751 | Lₐ₁₆₉₉ | L_{b8} | 752 | Lₐ₁₆₉₉ | L_{b20} |
| 753 | Lₐ₁₇₀₁ | L_{b8} | 754 | Lₐ₁₇₀₁ | L_{b20} |
| 755 | Lₐ₁₇₀₂ | L_{b8} | 756 | Lₐ₁₇₀₂ | L_{b20} |
| 757 | Lₐ₁₇₁₂ | L_{b8} | 758 | Lₐ₁₇₁₂ | L_{b20} |
| 759 | Lₐ₁₇₁₃ | L_{b8} | 760 | Lₐ₁₇₁₃ | L_{b20} |
| 761 | Lₐ₁₇₃₅ | L_{b8} | 762 | Lₐ₁₇₃₅ | L_{b20} |
| 763 | Lₐ₁₇₉₅ | L_{b8} | 764 | Lₐ₁₇₉₅ | L_{b20} |
| 765 | Lₐ₁₈₂₀ | L_{b8} | 766 | Lₐ₁₈₂₀ | L_{b20} |
| 767 | Lₐ₁₈₉₁ | L_{b8} | 768 | Lₐ₁₈₉₁ | L_{b20} |
| 769 | Lₐ₁₈₉₂ | L_{b8} | 770 | Lₐ₁₈₉₂ | L_{b20} |
| 771 | Lₐ₁₈₉₃ | L_{b8} | 772 | Lₐ₁₈₉₃ | L_{b20} |
| 773 | Lₐ₁₈₉₉ | L_{b8} | 774 | Lₐ₁₈₉₉ | L_{b20} |
| 775 | Lₐ₁₉₀₂ | L_{b8} | 776 | Lₐ₁₉₀₂ | L_{b20} |
| 777 | Lₐ₁₉₁₃ | L_{b8} | 778 | Lₐ₁₉₁₃ | L_{b20} |
| 779 | Lₐ₁₉₁₄ | L_{b8} | 780 | Lₐ₁₉₁₄ | L_{b20} |
| 781 | Lₐ₁₉₃₃ | L_{b8} | 782 | Lₐ₁₉₃₃ | L_{b20} |
| 783 | Lₐ₁₉₄₅ | L_{b8} | 784 | Lₐ₁₉₄₅ | L_{b20} |
| 785 | Lₐ₁₉₅₄ | L_{b8} | 786 | Lₐ₁₉₅₄ | L_{b20} |
| 787 | Lₐ₁₉₅₅ | L_{b8} | 788 | Lₐ₁₉₅₅ | L_{b20} |
| 789 | Lₐ₁₉₅₆ | L_{b8} | 790 | Lₐ₁₉₅₆ | L_{b20} |
| 791 | Lₐ₁₉₆₂ | L_{b8} | 792 | Lₐ₁₉₆₂ | L_{b20} |
| 793 | Lₐ₁₉₆₄ | L_{b8} | 794 | Lₐ₁₉₆₄ | L_{b20} |
| 795 | Lₐ₁₉₆₅ | L_{b8} | 796 | Lₐ₁₉₆₅ | L_{b20} |
| 797 | Lₐ₁₉₆₆ | L_{b8} | 798 | Lₐ₁₉₆₆ | L_{b20} |
| 799 | Lₐ₁₉₇₀ | L_{b8} | 800 | Lₐ₁₉₇₀ | L_{b20} |
| 801 | Lₐ₁₉₇₃ | L_{b8} | 802 | Lₐ₁₉₇₃ | L_{b20} |
| 803 | Lₐ₂₀₀₂ | L_{b8} | 804 | Lₐ₂₀₀₂ | L_{b20} |
| 805 | Lₐ₂₀₀₃ | L_{b8} | 806 | Lₐ₂₀₀₃ | L_{b20} |
| 807 | Lₐ₂₀₁₃ | L_{b8} | 808 | Lₐ₂₀₁₃ | L_{b20} |
| 809 | Lₐ₂₀₁₄ | L_{b8} | 810 | Lₐ₂₀₁₄ | L_{b20} |
| 811 | Lₐ₂₀₁₅ | L_{b8} | 812 | Lₐ₂₀₁₅ | L_{b20} |
| 813 | Lₐ₂₀₃₃ | L_{b8} | 814 | Lₐ₂₀₃₃ | L_{b20} |
| 815 | Lₐ₂₁₀₄ | L_{b8} | 816 | Lₐ₂₁₀₄ | L_{b20} |
| 817 | Lₐ₂₃₂₆ | L_{b8} | 818 | Lₐ₂₃₂₆ | L_{b20} |
| 819 | Lₐ₂₃₃₇ | L_{b8} | 820 | Lₐ₂₃₃₇ | L_{b20} |
| 821 | Lₐ₂₄₃₆ | L_{b8} | 822 | Lₐ₂₄₃₆ | L_{b20} |
| 823 | Lₐ₂₄₃₇ | L_{b8} | 824 | Lₐ₂₄₃₇ | L_{b20} |
| 825 | Lₐ₂₅₁₄ | L_{b8} | 826 | Lₐ₂₅₁₄ | L_{b20} |
| 827 | Lₐ₂₆₁₂ | L_{b8} | 828 | Lₐ₂₆₁₂ | L_{b20} |
| 829 | Lₐ₂₆₁₈ | L_{b8} | 830 | Lₐ₂₆₁₈ | L_{b20} |
| 831 | Lₐ₂₆₄₃ | L_{b8} | 832 | Lₐ₂₆₄₃ | L_{b20} |
| 833 | Lₐ₂₆₅₄ | L_{b8} | 834 | Lₐ₂₆₅₄ | L_{b20} |
| 835 | Lₐ₂₇₁₄ | L_{b8} | 836 | Lₐ₂₇₁₄ | L_{b20} |
| 837 | Lₐ₂₇₈₅ | L_{b8} | 838 | Lₐ₂₇₈₅ | L_{b20} |
| 839 | Lₐ₂₈₅₆ | L_{b8} | 840 | Lₐ₂₈₅₆ | L_{b20} |
| 841 | Lₐ₂₉₂₇ | L_{b8} | 842 | Lₐ₂₉₂₇ | L_{b20} |
| 843 | Lₐ₃₃₃₇ | L_{b8} | 844 | Lₐ₃₃₃₇ | L_{b20} |
| 845 | Lₐ₃₃₃₈ | L_{b8} | 846 | Lₐ₃₃₃₈ | L_{b20} |
| 847 | Lₐ₃₃₃₉ | L_{b8} | 848 | Lₐ₃₃₃₉ | L_{b20} |
| 849 | Lₐ₃₃₄₀ | L_{b8} | 850 | Lₐ₃₃₄₀ | L_{b20} |
| 851 | Lₐ₃₃₄₁ | L_{b8} | 852 | Lₐ₃₃₄₁ | L_{b20} |
| 853 | Lₐ₁ | L_{b118} | 854 | Lₐ₁ | L_{b132} |
| 855 | Lₐ₁₂ | L_{b118} | 856 | Lₐ₁₂ | L_{b132} |
| 857 | Lₐ₂₁ | L_{b118} | 858 | Lₐ₂₁ | L_{b132} |
| 859 | Lₐ₂₃ | L_{b118} | 860 | Lₐ₂₃ | L_{b132} |
| 861 | Lₐ₃₃ | L_{b118} | 862 | Lₐ₃₃ | L_{b132} |
| 863 | Lₐ₄₂ | L_{b118} | 864 | Lₐ₄₂ | L_{b132} |
| 865 | Lₐ₆₂ | L_{b118} | 866 | Lₐ₆₃ | L_{b132} |
| 867 | Lₐ₆₆ | L_{b118} | 868 | Lₐ₆₆ | L_{b132} |
| 869 | Lₐ₇₅ | L_{b118} | 870 | Lₐ₇₅ | L_{b132} |
| 871 | Lₐ₈₄ | L_{b118} | 872 | Lₐ₈₄ | L_{b132} |
| 873 | Lₐ₁₀₅ | L_{b118} | 874 | Lₐ₁₀₅ | L_{b132} |
| 875 | Lₐ₁₀₇ | L_{b118} | 876 | Lₐ₁₀₇ | L_{b132} |
| 877 | Lₐ₁₂₁ | L_{b118} | 878 | Lₐ₁₂₁ | L_{b132} |
| 879 | Lₐ₁₂₈ | L_{b118} | 880 | Lₐ₁₂₈ | L_{b132} |
| 881 | Lₐ₁₃₀ | L_{b118} | 882 | Lₐ₁₃₀ | L_{b132} |
| 883 | Lₐ₁₃₁ | L_{b118} | 884 | Lₐ₁₃₁ | L_{b132} |
| 885 | Lₐ₁₃₂ | L_{b118} | 886 | Lₐ₁₃₂ | L_{b132} |
| 887 | Lₐ₁₃₃ | L_{b118} | 888 | Lₐ₁₃₃ | L_{b132} |
| 889 | Lₐ₁₃₅ | L_{b118} | 890 | Lₐ₁₃₅ | L_{b132} |
| 891 | Lₐ₁₃₆ | L_{b118} | 892 | Lₐ₁₃₆ | L_{b132} |
| 893 | Lₐ₁₄₀ | L_{b118} | 894 | Lₐ₁₄₀ | L_{b132} |
| 895 | Lₐ₁₅₀ | L_{b118} | 896 | Lₐ₁₅₀ | L_{b132} |
| 897 | Lₐ₁₅₂ | L_{b118} | 898 | Lₐ₁₅₂ | L_{b132} |
| 899 | Lₐ₁₅₄ | L_{b118} | 900 | Lₐ₁₅₄ | L_{b132} |
| 901 | Lₐ₁₅₇ | L_{b118} | 902 | Lₐ₁₅₇ | L_{b132} |
| 903 | Lₐ₁₆₁ | L_{b118} | 904 | Lₐ₁₆₁ | L_{b132} |
| 905 | Lₐ₁₇₀ | L_{b118} | 906 | Lₐ₁₇₀ | L_{b132} |
| 907 | Lₐ₁₇₁ | L_{b118} | 908 | Lₐ₁₇₁ | L_{b132} |
| 909 | Lₐ₁₈₀ | L_{b118} | 910 | Lₐ₁₈₀ | L_{b132} |
| 911 | Lₐ₁₈₂ | L_{b118} | 912 | Lₐ₁₈₂ | L_{b132} |
| 913 | Lₐ₁₈₉ | L_{b118} | 914 | Lₐ₁₈₉ | L_{b132} |
| 915 | Lₐ₁₉₁ | L_{b118} | 916 | Lₐ₁₉₁ | L_{b132} |
| 917 | Lₐ₁₉₃ | L_{b118} | 918 | Lₐ₁₉₃ | L_{b132} |
| 919 | Lₐ₂₀₁ | L_{b118} | 920 | Lₐ₂₀₁ | L_{b132} |
| 921 | Lₐ₂₀₃ | L_{b118} | 922 | Lₐ₂₀₃ | L_{b132} |
| 923 | Lₐ₂₀₅ | L_{b118} | 924 | Lₐ₂₀₅ | L_{b132} |
| 925 | Lₐ₂₀₆ | L_{b118} | 926 | Lₐ₂₀₆ | L_{b132} |
| 927 | Lₐ₂₁₂ | L_{b118} | 928 | Lₐ₂₁₂ | L_{b132} |
| 929 | Lₐ₂₂₄ | L_{b118} | 930 | Lₐ₂₂₄ | L_{b132} |
| 931 | Lₐ₂₂₇ | L_{b118} | 932 | Lₐ₂₂₇ | L_{b132} |
| 933 | Lₐ₂₃₃ | L_{b118} | 934 | Lₐ₂₃₃ | L_{b132} |
| 935 | Lₐ₂₄₀ | L_{b118} | 936 | Lₐ₂₄₀ | L_{b132} |
| 937 | Lₐ₂₄₃ | L_{b118} | 938 | Lₐ₂₄₃ | L_{b132} |
| 939 | Lₐ₂₅₂ | L_{b118} | 940 | Lₐ₂₅₂ | L_{b132} |
| 941 | Lₐ₂₅₃ | L_{b118} | 942 | Lₐ₂₅₃ | L_{b132} |
| 943 | Lₐ₂₆₅ | L_{b118} | 944 | Lₐ₂₆₅ | L_{b132} |
| 945 | Lₐ₂₇₂ | L_{b118} | 946 | Lₐ₂₇₂ | L_{b132} |
| 947 | Lₐ₂₇₃ | L_{b118} | 948 | Lₐ₂₇₃ | L_{b132} |
| 949 | Lₐ₂₇₈ | L_{b118} | 950 | Lₐ₂₇₈ | L_{b132} |
| 951 | Lₐ₂₈₂ | L_{b118} | 952 | Lₐ₂₈₂ | L_{b132} |
| 953 | Lₐ₂₈₃ | L_{b118} | 954 | Lₐ₂₈₃ | L_{b132} |
| 955 | Lₐ₂₉₃ | L_{b118} | 956 | Lₐ₂₉₃ | L_{b132} |
| 957 | Lₐ₂₉₄ | L_{b118} | 958 | Lₐ₂₉₄ | L_{b132} |
| 959 | Lₐ₂₉₅ | L_{b118} | 960 | Lₐ₂₉₅ | L_{b132} |
| 961 | Lₐ₃₁₀ | L_{b118} | 962 | Lₐ₃₁₀ | L_{b132} |
| 963 | Lₐ₃₁₄ | L_{b118} | 964 | Lₐ₃₁₄ | L_{b132} |
| 965 | Lₐ₃₂₅ | L_{b118} | 966 | Lₐ₃₂₅ | L_{b132} |
| 967 | Lₐ₃₄₃ | L_{b118} | 968 | Lₐ₃₄₃ | L_{b132} |
| 969 | Lₐ₃₄₅ | L_{b118} | 970 | Lₐ₃₄₅ | L_{b132} |
| 971 | Lₐ₃₆₃ | L_{b118} | 972 | Lₐ₃₆₃ | L_{b132} |
| 973 | Lₐ₃₈₅ | L_{b118} | 974 | Lₐ₃₈₅ | L_{b132} |
| 975 | Lₐ₃₉₆ | L_{b118} | 976 | Lₐ₃₉₆ | L_{b132} |
| 977 | Lₐ₄₀₇ | L_{b118} | 978 | Lₐ₄₀₇ | L_{b132} |
| 979 | Lₐ₄₀₈ | L_{b118} | 980 | Lₐ₄₀₈ | L_{b132} |
| 981 | Lₐ₄₁₄ | L_{b118} | 982 | Lₐ₄₁₄ | L_{b132} |
| 983 | Lₐ₄₂₃ | L_{b118} | 984 | Lₐ₄₂₃ | L_{b132} |
| 985 | Lₐ₄₃₄ | L_{b118} | 986 | Lₐ₄₃₄ | L_{b132} |
| 987 | Lₐ₄₅₆ | L_{b118} | 988 | Lₐ₄₅₆ | L_{b132} |
| 989 | Lₐ₄₆₇ | L_{b118} | 990 | Lₐ₄₆₇ | L_{b132} |
| 991 | Lₐ₆₃₀ | L_{b118} | 992 | Lₐ₆₃₀ | L_{b132} |
| 993 | Lₐ₆₃₁ | L_{b118} | 994 | Lₐ₆₃₁ | L_{b132} |
| 995 | Lₐ₆₄₅ | L_{b118} | 996 | Lₐ₆₄₅ | L_{b132} |
| 997 | Lₐ₆₄₆ | L_{b118} | 998 | Lₐ₆₄₆ | L_{b132} |
| 999 | Lₐ₆₄₇ | L_{b118} | 1000 | Lₐ₆₄₇ | L_{b132} |
| 1001 | Lₐ₆₄₈ | L_{b118} | 1002 | Lₐ₆₄₈ | L_{b132} |
| 1003 | Lₐ₆₆₅ | L_{b118} | 1004 | Lₐ₆₆₅ | L_{b132} |
| 1005 | Lₐ₇₄₆ | L_{b118} | 1006 | Lₐ₇₄₆ | L_{b132} |
| 1007 | Lₐ₇₄₇ | L_{b118} | 1008 | Lₐ₇₄₇ | L_{b132} |
| 1009 | Lₐ₈₂₄ | L_{b118} | 1010 | Lₐ₈₂₄ | L_{b132} |
| 1011 | Lₐ₈₂₅ | L_{b118} | 1012 | Lₐ₈₂₅ | L_{b132} |
| 1013 | Lₐ₈₄₄ | L_{b118} | 1014 | Lₐ₈₄₄ | L_{b132} |
| 1015 | Lₐ₈₄₆ | L_{b118} | 1016 | Lₐ₈₄₆ | L_{b132} |
| 1017 | Lₐ₈₆₅ | L_{b118} | 1018 | Lₐ₈₆₅ | L_{b132} |
| 1019 | Lₐ₈₆₈ | L_{b118} | 1020 | Lₐ₈₆₈ | L_{b132} |
| 1021 | Lₐ₈₈₉ | L_{b118} | 1022 | Lₐ₈₈₉ | L_{b132} |
| 1023 | Lₐ₉₀₉ | L_{b118} | 1024 | Lₐ₉₀₉ | L_{b132} |
| 1025 | Lₐ₉₁₃ | L_{b118} | 1026 | Lₐ₉₁₃ | L_{b132} |
| 1027 | Lₐ₉₁₅ | L_{b118} | 1028 | Lₐ₉₁₅ | L_{b132} |
| 1029 | Lₐ₉₂₀ | L_{b118} | 1030 | Lₐ₉₂₀ | L_{b132} |
| 1031 | Lₐ₉₂₂ | L_{b118} | 1032 | Lₐ₉₂₂ | L_{b132} |
| 1033 | Lₐ₉₂₃ | L_{b118} | 1034 | Lₐ₉₂₃ | L_{b132} |
| 1035 | Lₐ₉₂₄ | L_{b118} | 1036 | Lₐ₉₂₄ | L_{b132} |
| 1037 | Lₐ₉₂₅ | L_{b118} | 1038 | Lₐ₉₂₅ | L_{b132} |
| 1039 | Lₐ₉₂₈ | L_{b118} | 1040 | Lₐ₉₂₈ | L_{b132} |
| 1041 | Lₐ₉₅₃ | L_{b118} | 1042 | Lₐ₉₅₃ | L_{b132} |
| 1043 | Lₐ₉₅₄ | L_{b118} | 1044 | Lₐ₉₅₄ | L_{b132} |
| 1045 | Lₐ₉₇₄ | L_{b118} | 1046 | Lₐ₉₇₄ | L_{b132} |
| 1047 | Lₐ₉₇₆ | L_{b118} | 1048 | Lₐ₉₇₆ | L_{b132} |
| 1049 | Lₐ₉₉₅ | L_{b118} | 1050 | Lₐ₉₉₅ | L_{b132} |
| 1051 | Lₐ₁₀₀₆ | L_{b118} | 1052 | Lₐ₁₀₀₆ | L_{b132} |
| 1053 | Lₐ₁₀₁₇ | L_{b118} | 1054 | Lₐ₁₀₁₇ | L_{b132} |
| 1055 | Lₐ₁₀₁₈ | L_{b118} | 1056 | Lₐ₁₀₁₈ | L_{b132} |
| 1057 | Lₐ₁₀₂₃ | L_{b118} | 1058 | Lₐ₁₀₂₃ | L_{b132} |
| 1059 | Lₐ₁₀₂₄ | L_{b118} | 1060 | Lₐ₁₀₂₄ | L_{b132} |
| 1061 | Lₐ₁₀₂₆ | L_{b118} | 1062 | Lₐ₁₀₂₆ | L_{b132} |
| 1063 | Lₐ₁₀₈₈ | L_{b118} | 1064 | Lₐ₁₀₈₈ | L_{b132} |
| 1065 | Lₐ₁₀₈₉ | L_{b118} | 1066 | Lₐ₁₀₈₉ | L_{b132} |
| 1067 | Lₐ₁₀₉₅ | L_{b118} | 1068 | Lₐ₁₀₉₅ | L_{b132} |
| 1069 | Lₐ₁₁₀₀ | L_{b118} | 1070 | Lₐ₁₁₀₀ | L_{b132} |
| 1071 | Lₐ₁₁₁₆ | L_{b118} | 1072 | Lₐ₁₁₁₆ | L_{b132} |
| 1073 | Lₐ₁₁₁₈ | L_{b118} | 1074 | Lₐ₁₁₁₆ | L_{b132} |
| 1075 | Lₐ₁₁₃₆ | L_{b118} | 1076 | Lₐ₁₁₃₆ | L_{b132} |
| 1077 | Lₐ₁₁₄₈ | L_{b118} | 1078 | Lₐ₁₁₄₈ | L_{b132} |
| 1079 | Lₐ₁₁₅₈ | L_{b118} | 1080 | Lₐ₁₁₅₈ | L_{b132} |
| 1081 | Lₐ₁₁₅₉ | L_{b118} | 1082 | Lₐ₁₁₅₉ | L_{b132} |
| 1083 | Lₐ₁₁₆₁ | L_{b118} | 1084 | Lₐ₁₁₆₁ | L_{b132} |
| 1085 | Lₐ₁₁₆₆ | L_{b118} | 1086 | Lₐ₁₁₆₆ | L_{b132} |
| 1087 | Lₐ₁₁₇₁ | L_{b118} | 1088 | Lₐ₁₁₇₁ | L_{b132} |
| 1089 | Lₐ₁₁₈₇ | L_{b118} | 1090 | Lₐ₁₁₈₇ | L_{b132} |
| 1091 | Lₐ₁₁₉₂ | L_{b118} | 1092 | Lₐ₁₁₉₂ | L_{b132} |
| 1093 | Lₐ₁₂₀₅ | L_{b118} | 1094 | Lₐ₁₂₀₅ | L_{b132} |
| 1095 | Lₐ₁₂₀₈ | L_{b118} | 1096 | Lₐ₁₂₀₈ | L_{b132} |
| 1097 | Lₐ₁₂₁₇ | L_{b118} | 1098 | Lₐ₁₂₁₇ | L_{b132} |
| 1099 | Lₐ₁₂₁₉ | L_{b118} | 1100 | Lₐ₁₂₁₉ | L_{b132} |
| 1101 | Lₐ₁₂₃₀ | L_{b118} | 1102 | Lₐ₁₂₃₀ | L_{b132} |
| 1103 | Lₐ₁₂₃₇ | L_{b118} | 1104 | Lₐ₁₂₃₇ | L_{b132} |
| 1105 | Lₐ₁₂₃₈ | L_{b118} | 1106 | Lₐ₁₂₃₈ | L_{b132} |
| 1107 | Lₐ₁₂₃₉ | L_{b118} | 1108 | Lₐ₁₂₃₉ | L_{b132} |
| 1109 | Lₐ₁₂₄₅ | L_{b118} | 1110 | Lₐ₁₂₄₅ | L_{b132} |
| 1111 | Lₐ₁₂₄₆ | L_{b118} | 1112 | Lₐ₁₂₄₆ | L_{b132} |
| 1113 | Lₐ₁₂₄₇ | L_{b118} | 1114 | Lₐ₁₂₄₇ | L_{b132} |
| 1115 | Lₐ₁₂₄₈ | L_{b118} | 1116 | Lₐ₁₂₄₈ | L_{b132} |
| 1117 | Lₐ₁₂₅₈ | L_{b118} | 1118 | Lₐ₁₂₅₈ | L_{b132} |
| 1119 | Lₐ₁₂₆₀ | L_{b118} | 1120 | Lₐ₁₂₆₀ | L_{b132} |
| 1121 | Lₐ₁₂₆₁ | L_{b118} | 1122 | Lₐ₁₂₆₁ | L_{b132} |
| 1123 | Lₐ₁₂₇₇ | L_{b118} | 1124 | Lₐ₁₂₇₇ | L_{b132} |
| 1125 | Lₐ₁₂₇₈ | L_{b118} | 1126 | Lₐ₁₂₇₈ | L_{b132} |
| 1127 | Lₐ₁₂₇₉ | L_{b118} | 1128 | Lₐ₁₂₇₉ | L_{b132} |
| 1129 | Lₐ₁₂₈₈ | L₈₁₁₈ | 1130 | Lₐ₁₂₈₈ | L_{b132} |
| 1131 | Lₐ₁₂₈₉ | L₈₁₁₈ | 1132 | Lₐ₁₂₈₉ | L_{b132} |
| 1133 | Lₐ₁₃₀₁ | L₈₁₁₈ | 1134 | Lₐ₁₃₀₁ | L_{b132} |
| 1135 | Lₐ₁₃₀₂ | L₈₁₁₈ | 1136 | Lₐ₁₃₀₂ | L_{b132} |
| 1137 | Lₐ₁₄₄₂ | L₈₁₁₈ | 1138 | Lₐ₁₄₄₂ | L_{b132} |
| 1139 | Lₐ₁₄₄₈ | L₈₁₁₈ | 1140 | Lₐ₁₄₄₈ | L_{b132} |
| 1141 | Lₐ₁₄₄₉ | L₈₁₁₈ | 1142 | Lₐ₁₄₄₉ | L_{b132} |
| 1143 | Lₐ₁₄₆₀ | L₈₁₁₈ | 1144 | Lₐ₁₄₆₀ | L_{b132} |
| 1145 | Lₐ₁₄₇₁ | L₈₁₁₈ | 1146 | Lₐ₁₄₇₁ | L_{b132} |
| 1147 | Lₐ₁₅₆₉ | L₈₁₁₈ | 1148 | Lₐ₁₅₆₉ | L_{b132} |
| 1149 | Lₐ₁₅₇₀ | L₈₁₁₈ | 1150 | Lₐ₁₅₇₀ | L_{b132} |
| 1151 | Lₐ₁₆₄₇ | L₈₁₁₈ | 1152 | Lₐ₁₆₄₇ | L_{b132} |
| 1153 | Lₐ₁₆₄₈ | L₈₁₁₈ | 1154 | Lₐ₁₆₄₈ | L_{b132} |
| 1155 | Lₐ₁₆₄₉ | L₈₁₁₈ | 1156 | Lₐ₁₆₄₉ | L_{b132} |
| 1157 | Lₐ₁₆₅₀ | L₈₁₁₈ | 1158 | Lₐ₁₆₅₀ | L_{b132} |
| 1159 | Lₐ₁₆₅₁ | L_{b118} | 1160 | Lₐ₁₆₅₁ | L_{b132} |
| 1161 | Lₐ₁₆₇₇ | L_{b118} | 1162 | Lₐ₁₆₇₇ | L_{b132} |
| 1163 | Lₐ₁₆₇₈ | L_{b118} | 1164 | Lₐ₁₆₇₈ | L_{b132} |
| 1165 | Lₐ₁₆₇₉ | L_{b118} | 1166 | Lₐ₁₆₇₉ | L_{b132} |
| 1167 | Lₐ₁₆₈₀ | L_{b118} | 1168 | Lₐ₁₆₈₀ | L_{b132} |
| 1169 | Lₐ₁₆₉₁ | L_{b118} | 1170 | Lₐ₁₆₉₁ | L_{b132} |
| 1171 | Lₐ₁₆₉₃ | L_{b118} | 1172 | Lₐ₁₆₉₃ | L_{b132} |
| 1173 | Lₐ₁₆₉₅ | L_{b118} | 1174 | Lₐ₁₆₉₅ | L_{b132} |
| 1175 | Lₐ₁₆₉₆ | L_{b118} | 1176 | Lₐ₁₆₉₆ | L_{b132} |
| 1177 | Lₐ₁₆₉₉ | L_{b118} | 1178 | Lₐ₁₆₉₉ | L_{b132} |
| 1179 | Lₐ₁₇₀₁ | L_{b118} | 1180 | Lₐ₁₇₀₁ | L_{b132} |
| 1181 | Lₐ₁₇₀₂ | L_{b118} | 1182 | Lₐ₁₇₀₂ | L_{b132} |
| 1183 | Lₐ₁₇₁₂ | L_{b118} | 1184 | Lₐ₁₇₁₂ | L_{b132} |
| 1185 | Lₐ₁₇₁₃ | L_{b118} | 1186 | Lₐ₁₇₁₃ | L_{b132} |
| 1187 | Lₐ₁₇₃₅ | L_{b118} | 1188 | Lₐ₁₇₃₅ | L_{b132} |
| 1189 | Lₐ₁₇₉₅ | L_{b118} | 1190 | Lₐ₁₇₉₅ | L_{b132} |
| 1191 | Lₐ₁₈₂₀ | L_{b118} | 1192 | Lₐ₁₈₂₀ | L_{b132} |
| 1193 | Lₐ₁₈₉₁ | L_{b118} | 1194 | Lₐ₁₈₉₁ | L_{b132} |
| 1195 | Lₐ₁₈₉₂ | L_{b118} | 1196 | Lₐ₁₈₉₂ | L_{b132} |
| 1197 | Lₐ₁₈₉₃ | L_{b118} | 1198 | Lₐ₁₈₉₃ | L_{b132} |
| 1199 | Lₐ₁₈₉₉ | L_{b118} | 1200 | Lₐ₁₈₉₉ | L_{b132} |
| 1201 | Lₐ₁₉₀₂ | L_{b118} | 1202 | Lₐ₁₉₀₂ | L_{b132} |
| 1203 | Lₐ₁₉₁₃ | L_{b118} | 1204 | Lₐ₁₉₁₃ | L_{b132} |
| 1205 | Lₐ₁₉₁₄ | L_{b118} | 1206 | Lₐ₁₉₁₄ | L_{b132} |
| 1207 | Lₐ₁₉₃₃ | L_{b118} | 1208 | Lₐ₁₉₃₃ | L_{b132} |
| 1209 | Lₐ₁₉₄₅ | L_{b118} | 1210 | Lₐ₁₉₄₅ | L_{b132} |
| 1211 | Lₐ₁₉₅₄ | L_{b118} | 1212 | Lₐ₁₉₅₄ | L_{b132} |
| 1213 | Lₐ₁₉₅₅ | L_{b118} | 1214 | Lₐ₁₉₅₅ | L_{b132} |
| 1215 | Lₐ₁₉₅₆ | L_{b118} | 1216 | Lₐ₁₉₅₆ | L_{b132} |
| 1217 | Lₐ₁₉₆₂ | L_{b118} | 1218 | Lₐ₁₉₆₂ | L_{b132} |
| 1219 | Lₐ₁₉₆₄ | L_{b118} | 1220 | Lₐ₁₉₆₄ | L_{b132} |
| 1221 | Lₐ₁₉₆₅ | L_{b118} | 1222 | Lₐ₁₉₆₅ | L_{b132} |
| 1223 | Lₐ₁₉₆₆ | L_{b118} | 1224 | Lₐ₁₉₆₆ | L_{b132} |
| 1225 | Lₐ₁₉₇₀ | L_{b118} | 1226 | Lₐ₁₉₇₀ | L_{b132} |
| 1227 | Lₐ₁₉₇₃ | L_{b118} | 1228 | Lₐ₁₉₇₃ | L_{b132} |
| 1229 | Lₐ₂₀₀₂ | L_{b118} | 1230 | Lₐ₂₀₀₂ | L_{b132} |
| 1231 | Lₐ₂₀₀₃ | L_{b118} | 1232 | Lₐ₂₀₀₃ | L_{b132} |
| 1233 | Lₐ₂₀₁₃ | L_{b118} | 1234 | Lₐ₂₀₁₃ | L_{b132} |
| 1235 | Lₐ₂₀₁₄ | L_{b118} | 1236 | Lₐ₂₀₁₄ | L_{b132} |
| 1237 | Lₐ₂₀₁₅ | L_{b118} | 1238 | Lₐ₂₀₁₅ | L_{b132} |
| 1239 | Lₐ₂₀₃₃ | L_{b118} | 1240 | Lₐ₂₀₃₃ | L_{b132} |
| 1241 | Lₐ₂₁₀₄ | L_{b118} | 1242 | Lₐ₂₁₀₄ | L_{b132} |
| 1243 | Lₐ₂₃₂₆ | L_{b118} | 1244 | Lₐ₂₃₂₆ | L_{b132} |
| 1245 | Lₐ₂₃₃₇ | L_{b118} | 1246 | Lₐ₂₃₃₇ | L_{b132} |
| 1247 | Lₐ₂₄₃₆ | L_{b118} | 1248 | Lₐ₂₄₃₆ | L_{b132} |
| 1249 | Lₐ₂₄₃₇ | L_{b118} | 1250 | Lₐ₂₄₃₇ | L_{b132} |
| 1251 | Lₐ₂₅₁₄ | L_{b118} | 1252 | Lₐ₂₅₁₄ | L_{b132} |
| 1253 | Lₐ₂₆₁₂ | L_{b118} | 1254 | Lₐ₂₆₁₂ | L_{b132} |
| 1255 | Lₐ₂₆₁₈ | L_{b118} | 1256 | Lₐ₂₆₁₈ | L_{b132} |
| 1257 | Lₐ₂₆₄₃ | L_{b118} | 1258 | Lₐ₂₆₄₃ | L_{b132} |
| 1259 | Lₐ₂₆₅₄ | L_{b118} | 1260 | Lₐ₂₆₅₄ | L_{b132} |
| 1261 | Lₐ₂₇₁₄ | L_{b118} | 1262 | Lₐ₂₇₁₄ | L_{b132} |
| 1263 | Lₐ₂₇₈₅ | L_{b118} | 1264 | Lₐ₂₇₈₅ | L_{b132} |
| 1265 | Lₐ₂₈₅₆ | L_{b118} | 1266 | Lₐ₂₈₅₆ | L_{b132} |
| 1267 | Lₐ₂₉₂₇ | L_{b118} | 1268 | Lₐ₂₉₂₇ | L_{b132} |
| 1269 | Lₐ₃₃₃₇ | L_{b118} | 1270 | Lₐ₃₃₃₇ | L_{b132} |
| 1271 | Lₐ₃₃₃₈ | L_{b118} | 1272 | Lₐ₃₃₃₈ | L_{b132} |
| 1273 | Lₐ₃₃₃₉ | L_{b118} | 1274 | Lₐ₃₃₃₉ | L_{b132} |
| 1275 | Lₐ₃₃₄₀ | L_{b118} | 1276 | Lₐ₃₃₄₀ | L_{b132} |
| 1277 | Lₐ₃₃₄₁ | L_{b118} | 1278 | Lₐ₃₃₄₁ | L_{b132} |
| 1279 | Lₐ₁ | L_{b52} | 1280 | Lₐ₈₈ | L_{b52} |
| 1281 | Lₐ₁₂ | L_{b52} | 1282 | Lₐ₈₉ | L_{b52} |
| 1283 | Lₐ₂₁ | L_{b52} | 1284 | Lₐ₉₀ | L_{b52} |
| 1285 | Lₐ₂₃ | L_{b52} | 1286 | Lₐ₉₁ | L_{b52} |
| 1287 | Lₐ₃₃ | L_{b52} | 1288 | Lₐ₉₂ | L_{b52} |
| 1289 | Lₐ₄₂ | L_{b52} | 1290 | Lₐ₁₀₀ | L_{b52} |
| 1291 | Lₐ₆₃ | L_{b52} | 1292 | Lₐ₁₀₁ | L_{b52} |
| 1293 | Lₐ₆₆ | L_{b52} | 1294 | Lₐ₁₀₂ | L_{b52} |
| 1295 | Lₐ₇₅ | L_{b52} | 1296 | Lₐ₁₀₃ | L_{b52} |
| 1297 | Lₐ₈₄ | L_{b52} | 1298 | Lₐ₁₇₄ | L_{b52} |
| 1299 | Lₐ₁₀₅ | L_{b52} | 1300 | Lₐ₁₇₅ | L_{b52} |
| 1301 | Lₐ₁₀₇ | L_{b52} | 1302 | Lₐ₁₇₆ | L_{b52} |
| 1303 | Lₐ₁₂₁ | L_{b52} | 1304 | Lₐ₁₇₇ | L_{b52} |
| 1305 | Lₐ₁₂₈ | L_{b52} | 1306 | Lₐ₂₀₉ | L_{b52} |
| 1307 | Lₐ₁₃₀ | L_{b52} | 1308 | Lₐ₂₁₀ | L_{b52} |
| 1309 | Lₐ₁₃₁ | L_{b52} | 1310 | Lₐ₂₂₁ | L_{b52} |
| 1311 | Lₐ₁₃₂ | L_{b52} | 1312 | Lₐ₂₂₂ | L_{b52} |
| 1313 | Lₐ₁₃₃ | L_{b52} | 1314 | Lₐ₂₄₈ | L_{b52} |
| 1315 | Lₐ₁₃₅ | L_{b52} | 1316 | Lₐ₂₄₉ | L_{b52} |
| 1317 | Lₐ₁₃₆ | L_{b52} | 1318 | Lₐ₂₅₀ | L_{b52} |
| 1319 | Lₐ₁₄₀ | L_{b52} | 1320 | Lₐ₂₆₈ | L_{b52} |
| 1321 | Lₐ₁₅₀ | L_{b52} | 1322 | Lₐ₂₆₉ | L_{b52} |
| 1323 | Lₐ₁₅₂ | L_{b52} | 1324 | Lₐ₃₀₁ | L_{b52} |
| 1325 | Lₐ₁₅₄ | L_{b52} | 1326 | Lₐ₃₀₂ | L_{b52} |
| 1327 | Lₐ₁₅₇ | L_{b52} | 1328 | Lₐ₃₀₃ | L_{b52} |
| 1329 | Lₐ₁₆₁ | L_{b52} | 1330 | Lₐ₃₀₄ | L_{b52} |
| 1331 | Lₐ₁₇₀ | L_{b52} | 1332 | Lₐ₃₂₂ | L_{b52} |
| 1333 | Lₐ₁₇₁ | L_{b52} | 1334 | Lₐ₃₂₃ | L_{b52} |
| 1335 | Lₐ₁₈₀ | L_{b52} | 1336 | Lₐ₃₂₄ | L_{b52} |
| 1337 | Lₐ₁₈₂ | L_{b52} | 1338 | Lₐ₃₃₆ | L_{b52} |
| 1339 | Lₐ₁₈₉ | L_{b52} | 1340 | Lₐ₃₃₇ | L_{b52} |
| 1341 | Lₐ₁₉₁ | L_{b52} | 1342 | Lₐ₃₃₈ | L_{b52} |
| 1343 | Lₐ₁₉₃ | L_{b52} | 1344 | Lₐ₃₆₅ | L_{b52} |
| 1345 | Lₐ₂₀₁ | L_{b52} | 1346 | Lₐ₃₆₆ | L_{b52} |
| 1347 | Lₐ₂₀₃ | L_{b52} | 1348 | Lₐ₃₆₇ | L_{b52} |
| 1349 | Lₐ₂₀₅ | L_{b52} | 1350 | Lₐ₃₈₁ | L_{b52} |
| 1351 | Lₐ₂₀₆ | L_{b52} | 1352 | Lₐ₃₈₂ | L_{b52} |
| 1353 | Lₐ₂₁₂ | L_{b52} | 1354 | Lₐ₃₈₃ | L_{b52} |
| 1355 | Lₐ₂₂₄ | L_{b52} | 1356 | Lₐ₄₁₇ | L_{b52} |
| 1357 | Lₐ₂₂₇ | L_{b52} | 1358 | Lₐ₄₁₈ | L_{b52} |
| 1359 | Lₐ₂₃₃ | L_{b52} | 1360 | Lₐ₄₁₉ | L_{b52} |
| 1361 | Lₐ₂₄₀ | L_{b52} | 1362 | Lₐ₄₂₀ | L_{b52} |
| 1363 | Lₐ₂₄₃ | L_{b52} | 1364 | Lₐ₄₃₇ | L_{b52} |
| 1365 | Lₐ₂₅₂ | L_{b52} | 1366 | Lₐ₄₃₈ | L_{b52} |
| 1367 | Lₐ₂₅₃ | L_{b52} | 1368 | Lₐ₄₃₉ | L_{b52} |
| 1369 | Lₐ₂₆₅ | L_{b52} | 1370 | Lₐ₄₅₃ | L_{b52} |
| 1371 | Lₐ₂₇₂ | L_{b52} | 1372 | Lₐ₄₅₄ | L_{b52} |
| 1373 | Lₐ₂₇₃ | L_{b52} | 1374 | Lₐ₄₆₄ | L_{b52} |
| 1375 | Lₐ₂₇₈ | L_{b52} | 1376 | Lₐ₄₆₅ | L_{b52} |
| 1377 | Lₐ₂₈₂ | L_{b52} | 1378 | Lₐ₄₆₆ | L_{b52} |
| 1379 | Lₐ₂₈₃ | L_{b52} | 1380 | Lₐ₄₆₇ | L_{b52} |
| 1381 | Lₐ₂₉₃ | L_{b52} | 1382 | Lₐ₄₈₅ | L_{b52} |
| 1383 | Lₐ₂₉₄ | L_{b52} | 1384 | Lₐ₄₈₆ | L_{b52} |
| 1385 | Lₐ₂₉₅ | L_{b52} | 1386 | Lₐ₄₈₇ | L_{b52} |
| 1387 | Lₐ₃₁₀ | L_{b52} | 1388 | Lₐ₅₀₄ | L_{b52} |
| 1389 | Lₐ₃₁₄ | L_{b52} | 1390 | Lₐ₅₀₅ | L_{b52} |
| 1391 | Lₐ₃₂₅ | L_{b52} | 1392 | Lₐ₅₀₆ | L_{b52} |
| 1393 | Lₐ₃₄₃ | L_{b52} | 1394 | Lₐ₅₀₇ | L_{b52} |
| 1395 | Lₐ₃₄₅ | L_{b52} | 1396 | Lₐ₅₃₄ | L_{b52} |
| 1397 | Lₐ₃₆₃ | L_{b52} | 1398 | Lₐ₅₃₅ | L_{b52} |
| 1399 | Lₐ₃₈₅ | L_{b52} | 1400 | Lₐ₅₃₆ | L_{b52} |
| 1401 | Lₐ₃₉₆ | L_{b52} | 1402 | Lₐ₅₄₈ | L_{b52} |
| 1403 | Lₐ₄₀₇ | L_{b52} | 1404 | Lₐ₅₄₉ | L_{b52} |
| 1405 | Lₐ₄₀₈ | L_{b52} | 1406 | Lₐ₅₅₀ | L_{b52} |
| 1407 | Lₐ₄₁₄ | L_{b52} | 1408 | Lₐ₅₅₁ | L_{b52} |
| 1409 | Lₐ₄₂₃ | L_{b52} | 1410 | Lₐ₅₇₅ | L_{b52} |
| 1411 | Lₐ₄₃₄ | L_{b52} | 1412 | Lₐ₅₇₆ | L_{b52} |
| 1413 | Lₐ₄₅₆ | L_{b52} | 1414 | Lₐ₆₀₄ | L_{b52} |
| 1415 | Lₐ₄₆₇ | L_{b52} | 1416 | Lₐ₆₀₅ | L_{b52} |
| 1417 | Lₐ₆₃₀ | L_{b52} | 1418 | Lₐ₆₀₆ | L_{b52} |
| 1419 | Lₐ₆₃₁ | L_{b52} | 1420 | Lₐ₆₀₇ | L_{b52} |
| 1421 | Lₐ₆₄₅ | L_{b52} | 1422 | Lₐ₆₃₇ | L_{b52} |
| 1423 | Lₐ₆₄₆ | L_{b52} | 1424 | Lₐ₆₃₈ | L_{b52} |
| 1425 | Lₐ₆₄₇ | L_{b52} | 1426 | Lₐ₆₃₉ | Lb52 |
| 1427 | Lₐ₆₄₈ | L_{b52} | 1428 | Lₐ₆₅₄ | L_{b52} |
| 1429 | Lₐ₆₆₅ | L_{b52} | 1430 | Lₐ₆₅₅ | L_{b52} |
| 1431 | Lₐ₇₄₆ | L_{b52} | 1432 | Lₐ₆₅₆ | L_{b52} |
| 1433 | Lₐ₇₄₇ | L_{b52} | 1434 | Lₐ₆₅₇ | L_{b52} |
| 1435 | Lₐ₈₂₄ | L_{b52} | 1436 | Lₐ₆₇₀ | L_{b52} |
| 1437 | Lₐ₈₂₅ | L_{b52} | 1438 | Lₐ₆₇₁ | L_{b52} |
| 1439 | Lₐ₈₄₄ | L_{b52} | 1440 | Lₐ₆₇₂ | L_{b52} |
| 1441 | Lₐ₈₄₆ | L_{b52} | 1442 | Lₐ₆₇₃ | L_{b52} |
| 1443 | Lₐ₈₆₅ | L_{b52} | 1444 | Lₐ₆₇₄ | L_{b52} |
| 1445 | Lₐ₈₆₈ | L_{b52} | 1446 | Lₐ₆₇₅ | L_{b52} |
| 1447 | Lₐ₈₈₉ | L_{b52} | 1448 | Lₐ₆₈₄ | L_{b52} |
| 1449 | Lₐ₉₀₉ | L_{b52} | 1450 | Lₐ₆₈₅ | L_{b52} |
| 1451 | Lₐ₉₁₃ | L_{b52} | 1452 | Lₐ₆₈₆ | L_{b52} |
| 1453 | Lₐ₉₁₅ | L_{b52} | 1454 | Lₐ₆₈₇ | L_{b52} |
| 1455 | Lₐ₉₂₀ | L_{b52} | 1456 | Lₐ₇₀₁ | L_{b52} |
| 1457 | Lₐ₉₂₂ | L_{b52} | 1458 | Lₐ₇₀₂ | L_{b52} |
| 1459 | Lₐ₉₂₃ | L_{b52} | 1460 | Lₐ₇₀₃ | L_{b52} |
| 1461 | Lₐ₉₂₄ | L_{b52} | 1462 | Lₐ₇₀₄ | L_{b52} |
| 1463 | Lₐ₉₂₅ | L_{b52} | 1464 | Lₐ₇₀₈ | L_{b52} |
| 1465 | Lₐ₉₂₈ | L_{b52} | 1466 | Lₐ₇₀₉ | L_{b52} |
| 1467 | Lₐ₉₅₃ | L_{b52} | 1468 | Lₐ₇₁₀ | L_{b52} |
| 1469 | Lₐ₉₅₄ | L_{b52} | 1470 | Lₐ₇₁₁ | L_{b52} |
| 1471 | Lₐ₉₇₄ | L_{b52} | 1472 | Lₐ₇₁₂ | L_{b52} |
| 1473 | Lₐ₉₇₆ | L_{b52} | 1474 | Lₐ₇₁₃ | L_{b52} |
| 1475 | Lₐ₉₉₅ | L_{b52} | 1476 | Lₐ₇₁₄ | L_{b52} |
| 1477 | Lₐ₁₀₀₆ | L_{b52} | 1478 | Lₐ₇₂₉ | L_{b52} |
| 1479 | Lₐ₁₀₁₇ | L_{b52} | 1480 | Lₐ₇₃₁ | L_{b52} |
| 1481 | Lₐ₁₀₁₈ | L_{b52} | 1482 | Lₐ₇₃₂ | L_{b52} |
| 1483 | Lₐ₁₀₂₃ | L_{b52} | 1484 | Lₐ₇₃₃ | L_{b52} |
| 1485 | Lₐ₁₀₂₄ | L_{b52} | 1486 | Lₐ₇₄₁ | L_{b52} |
| 1487 | Lₐ₁₀₂₆ | L_{b52} | 1488 | Lₐ₇₄₂ | L_{b52} |
| 1489 | Lₐ₁₀₈₈ | L_{b52} | 1490 | Lₐ₇₄₃ | L_{b52} |
| 1491 | Lₐ₁₀₈₉ | L_{b52} | 1492 | Lₐ₇₄₄ | L_{b52} |
| 1493 | Lₐ₁₀₉₅ | L_{b52} | 1494 | Lₐ₇₄₈ | L_{b52} |
| 1495 | Lₐ₁₁₀₀ | L_{b52} | 1496 | Lₐ₇₄₉ | L_{b52} |
| 1497 | Lₐ₁₁₁₆ | L_{b52} | 1498 | Lₐ₇₅₀ | L_{b52} |
| 1499 | Lₐ₁₁₁₈ | L_{b52} | 1500 | Lₐ₇₅₁ | L_{b52} |
| 1501 | Lₐ₁₁₃₆ | L_{b52} | 1502 | Lₐ₇₅₂ | L_{b52} |
| 1503 | Lₐ₁₁₄₈ | L_{b52} | 1504 | Lₐ₇₅₃ | L_{b52} |
| 1505 | Lₐ₁₁₅₈ | L_{b52} | 1506 | Lₐ₇₅₄ | L_{b52} |
| 1507 | Lₐ₁₁₅₉ | L_{b52} | 1508 | Lₐ₇₅₅ | L_{b52} |
| 1509 | Lₐ₁₁₆₁ | L_{b52} | 1510 | Lₐ₇₅₆ | L_{b52} |
| 1511 | Lₐ₁₁₆₆ | L_{b52} | 1512 | Lₐ₇₅₇ | L_{b52} |
| 1513 | Lₐ₁₁₇₁ | L_{b52} | 1514 | Lₐ₇₅₈ | L_{b52} |
| 1515 | Lₐ₁₁₈₇ | L_{b52} | 1516 | Lₐ₇₆₆ | L_{b52} |
| 1517 | Lₐ₁₁₉₂ | L_{b52} | 1518 | Lₐ₇₆₇ | L_{b52} |
| 1519 | Lₐ₁₂₀₅ | L_{b52} | 1520 | Lₐ₇₆₈ | L_{b52} |
| 1521 | Lₐ₁₂₀₈ | L_{b52} | 1522 | Lₐ₇₆₉ | L_{b52} |
| 1523 | Lₐ₁₂₁₇ | L_{b52} | 1524 | Lₐ₇₇₀ | L_{b52} |
| 1525 | Lₐ₁₂₁₉ | L_{b52} | 1526 | Lₐ₇₇₁ | L_{b52} |
| 1527 | Lₐ₁₂₃₀ | L_{b52} | 1528 | Lₐ₇₇₂ | L_{b52} |
| 1529 | Lₐ₁₂₃₇ | L_{b52} | 1530 | Lₐ₇₇₃ | L_{b52} |
| 1531 | Lₐ₁₂₃₈ | L_{b52} | 1532 | Lₐ₇₇₄ | L_{b52} |
| 1533 | Lₐ₁₂₃₉ | L_{b52} | 1534 | Lₐ₇₇₅ | L_{b52} |
| 1535 | Lₐ₁₂₄₅ | L_{b52} | 1536 | Lₐ₇₇₆ | L_{b52} |
| 1537 | Lₐ₁₂₄₆ | L_{b52} | 1538 | Lₐ₇₇₇ | L_{b52} |
| 1539 | Lₐ₁₂₄₇ | L_{b52} | 1540 | Lₐ₇₇₈ | L_{b52} |
| 1541 | Lₐ₁₂₄₈ | L_{b52} | 1542 | Lₐ₇₇₉ | L_{b52} |
| 1543 | Lₐ₁₂₅₈ | L_{b52} | 1544 | Lₐ₇₈₀ | L_{b52} |
| 1545 | Lₐ₁₂₆₀ | L_{b52} | 1546 | Lₐ₇₈₁ | L_{b52} |
| 1547 | Lₐ₁₂₆₁ | L_{b52} | 1548 | Lₐ₇₈₂ | L_{b52} |
| 1549 | Lₐ₁₂₇₇ | L_{b52} | 1550 | Lₐ₇₉₀ | L_{b52} |
| 1551 | Lₐ₁₂₇₈ | L_{b52} | 1552 | Lₐ₇₉₁ | L_{b52} |
| 1553 | Lₐ₁₂₇₉ | L_{b52} | 1554 | Lₐ₇₉₂ | L_{b52} |
| 1555 | Lₐ₁₂₈₈ | L_{b52} | 1556 | Lₐ₇₉₃ | L_{b52} |
| 1557 | Lₐ₁₂₈₉ | L_{b52} | 1558 | Lₐ₇₉₄ | L_{b52} |
| 1559 | Lₐ₁₃₀₁ | L_{b52} | 1560 | Lₐ₈₀₀ | L_{b52} |
| 1561 | Lₐ₁₃₀₂ | L_{b52} | 1562 | Lₐ₈₀₄ | L_{b52} |
| 1563 | Lₐ₁₄₄₂ | L_{b52} | 1564 | Lₐ₈₀₅ | L_{b52} |
| 1565 | Lₐ₁₄₄₈ | L_{b52} | 1566 | Lₐ₉₃₃ | L_{b52} |
| 1567 | Lₐ₁₄₄₉ | L_{b52} | 1568 | Lₐ₉₃₄ | L_{b52} |
| 1569 | Lₐ₁₄₆₀ | L_{b52} | 1570 | Lₐ₉₃₅ | L_{b52} |
| 1571 | Lₐ₁₄₇₁ | L_{b52} | 1572 | Lₐ₉₃₆ | L_{b52} |
| 1573 | Lₐ₁₅₆₉ | L_{b52} | 1574 | Lₐ₉₉₂ | L_{b52} |
| 1575 | Lₐ₁₅₇₀ | L_{b52} | 1576 | Lₐ₉₉₃ | L_{b52} |
| 1577 | Lₐ₁₆₄₇ | L_{b52} | 1578 | Lₐ₉₉₄ | L_{b52} |
| 1579 | Lₐ₁₆₄₈ | L_{b52} | 1580 | Lₐ₁₀₁₅ | L_{b52} |
| 1581 | Lₐ₁₆₄₉ | L_{b52} | 1582 | Lₐ₁₀₁₆ | L_{b52} |
| 1583 | Lₐ₁₆₅₀ | L_{b52} | 1584 | Lₐ₁₀₂₈ | L_{b52} |
| 1585 | Lₐ₁₆₅₁ | L_{b52} | 1586 | Lₐ₁₀₂₉ | L_{b52} |
| 1587 | Lₐ₁₆₇₇ | L_{b52} | 1588 | Lₐ₁₀₃₀ | L_{b52} |
| 1589 | Lₐ₁₆₇₈ | L_{b52} | 1590 | Lₐ₁₀₃₁ | L_{b52} |
| 1591 | Lₐ₁₆₇₉ | L_{b52} | 1592 | Lₐ₁₀₄₄ | L_{b52} |
| 1593 | Lₐ₁₆₈₀ | L_{b52} | 1594 | Lₐ₁₀₄₅ | L_{b52} |
| 1595 | Lₐ₁₆₉₁ | L_{b52} | 1596 | Lₐ₁₀₄₆ | L_{b52} |
| 1597 | Lₐ₁₆₉₃ | L_{b52} | 1598 | Lₐ₁₀₄₇ | L_{b52} |
| 1599 | Lₐ₁₆₉₅ | L_{b52} | 1600 | Lₐ₁₀₆₁ | L_{b52} |
| 1601 | Lₐ₁₆₉₆ | L_{b52} | 1602 | Lₐ₁₀₆₂ | L_{b52} |
| 1603 | Lₐ₁₆₉₉ | L_{b52} | 1604 | Lₐ₁₀₆₃ | L_{b52} |
| 1605 | Lₐ₁₇₀₁ | L_{b52} | 1606 | Lₐ₁₀₆₄ | L_{b52} |
| 1607 | Lₐ₁₇₀₂ | L_{b52} | 1608 | Lₐ₁₀₆₅ | L_{b52} |
| 1609 | Lₐ₁₇₁₂ | L_{b52} | 1610 | Lₐ₁₀₇₄ | L_{b52} |
| 1611 | Lₐ₁₇₁₃ | L_{b52} | 1612 | Lₐ₁₀₇₅ | L_{b52} |
| 1613 | Lₐ₁₇₃₅ | L_{b52} | 1614 | Lₐ₁₀₇₆ | L_{b52} |
| 1615 | Lₐ₁₇₉₅ | L_{b52} | 1616 | Lₐ₁₀₈₃ | L_{b52} |
| 1617 | Lₐ₁₈₂₀ | L_{b52} | 1618 | Lₐ₁₀₈₄ | L_{b52} |
| 1619 | Lₐ₁₈₉₁ | L_{b52} | 1620 | Lₐ₁₀₈₅ | L_{b52} |
| 1621 | Lₐ₁₈₉₂ | L_{b52} | 1622 | Lₐ₁₀₉₀ | L_{b52} |
| 1623 | Lₐ₁₈₉₃ | L_{b52} | 1624 | Lₐ₁₀₉₁ | L_{b52} |
| 1625 | Lₐ₁₈₉₉ | L_{b52} | 1626 | Lₐ₁₀₉₂ | L_{b52} |
| 1627 | Lₐ₁₉₀₂ | L_{b52} | 1628 | Lₐ₁₁₁₃ | L_{b52} |
| 1629 | Lₐ₁₉₁₃ | L_{b52} | 1630 | Lₐ₁₁₁₄ | L_{b52} |
| 1631 | Lₐ₁₉₁₄ | L_{b52} | 1632 | Lₐ₁₁₂₁ | L_{b52} |
| 1633 | Lₐ₁₉₃₃ | L_{b52} | 1634 | Lₐ₁₁₂₂ | L_{b52} |
| 1635 | Lₐ₁₉₄₅ | L_{b52} | 1636 | Lₐ₁₁₂₃ | L_{b52} |
| 1637 | Lₐ₁₉₅₄ | L_{b52} | 1638 | Lₐ₁₁₂₄ | L_{b52} |
| 1639 | Lₐ₁₉₅₅ | L_{b52} | 1640 | Lₐ₁₁₃₃ | L_{b52} |
| 1641 | Lₐ₁₉₅₆ | L_{b52} | 1642 | Lₐ₁₁₃₄ | L_{b52} |
| 1643 | Lₐ₁₉₆₂ | L_{b52} | 1644 | Lₐ₁₁₃₅ | L_{b52} |
| 1645 | Lₐ₁₉₆₄ | L_{b52} | 1646 | Lₐ₁₁₄₅ | L_{b52} |
| 1647 | Lₐ₁₉₆₅ | L_{b52} | 1648 | Lₐ₁₁₄₆ | L_{b52} |
| 1649 | Lₐ₁₉₆₆ | L_{b52} | 1650 | Lₐ₁₁₄₇ | L_{b52} |
| 1651 | Lₐ₁₉₇₀ | L_{b52} | 1652 | Lₐ₁₁₇₅ | L_{b52} |
| 1653 | Lₐ₁₉₇₃ | L_{b52} | 1654 | Lₐ₁₁₇₆ | L_{b52} |
| 1655 | Lₐ₂₀₀₂ | L_{b52} | 1656 | Lₐ₁₁₇₇ | L_{b52} |
| 1657 | Lₐ₂₀₀₃ | L_{b52} | 1658 | Lₐ₁₂₂₇ | L_{b52} |
| 1659 | Lₐ₂₀₁₃ | L_{b52} | 1660 | Lₐ₁₂₂₈ | L_{b52} |
| 1661 | Lₐ₂₀₁₄ | L_{b52} | 1662 | Lₐ₁₂₄₁ | L_{b52} |
| 1663 | Lₐ₂₀₁₅ | L_{b52} | 1664 | Lₐ₁₂₄₂ | L_{b52} |
| 1665 | Lₐ₂₀₃₃ | L_{b52} | 1666 | Lₐ₁₂₆₅ | L_{b52} |
| 1667 | Lₐ₂₁₀₄ | L_{b52} | 1668 | Lₐ₁₂₆₆ | L_{b52} |
| 1669 | Lₐ₂₃₂₆ | L_{b52} | 1670 | Lₐ₁₂₆₇ | L_{b52} |
| 1671 | Lₐ₂₃₃₇ | L_{b52} | 1672 | Lₐ₁₂₉₈ | L_{b52} |
| 1673 | Lₐ₂₄₃₆ | L_{b52} | 1674 | Lₐ₁₂₉₉ | L_{b52} |
| 1675 | Lₐ₂₄₃₇ | L_{b52} | 1676 | Lₐ₁₃₀₈ | L_{b52} |
| 1677 | Lₐ₂₅₁₄ | L_{b52} | 1678 | Lₐ₁₃₀₉ | L_{b52} |
| 1679 | Lₐ₂₆₁₂ | L_{b52} | 1680 | Lₐ₁₃₂₉ | L_{b52} |
| 1681 | Lₐ₂₆₁₈ | L_{b52} | 1682 | Lₐ₁₃₃₀ | L_{b52} |
| 1683 | Lₐ₂₆₄₃ | L_{b52} | 1684 | Lₐ₁₃₃₄ | L_{b52} |
| 1685 | Lₐ₂₆₅₄ | L_{b52} | 1686 | Lₐ₁₃₃₅ | L_{b52} |
| 1687 | Lₐ₂₇₁₄ | L_{b52} | 1688 | Lₐ₁₃₃₆ | L_{b52} |
| 1689 | Lₐ₂₇₈₅ | L_{b52} | 1690 | Lₐ₁₃₄₅ | L_{b52} |
| 1691 | Lₐ₂₈₅₆ | L_{b52} | 1692 | Lₐ₁₃₄₆ | L_{b52} |
| 1693 | Lₐ₂₉₂₇ | L_{b52} | 1694 | Lₐ₁₃₄₇ | L_{b52} |
| 1695 | Lₐ₃₃₃₇ | L_{b52} | 1696 | Lₐ₁₃₄₈ | L_{b52} |
| 1697 | Lₐ₃₃₃₈ | L_{b52} | 1698 | Lₐ₁₃₅₇ | L_{b52} |
| 1699 | Lₐ₃₃₃₉ | L_{b52} | 1700 | Lₐ₁₃₅₈ | L_{b52} |
| 1701 | Lₐ₃₃₄₀ | L_{b52} | 1702 | Lₐ₁₃₅₉ | L_{b52} |
| 1703 | Lₐ₃₃₄₁ | L_{b52} | 1704 | Lₐ₁₃₆₀ | L_{b52} |
| 1705 | Lₐ₁₃₆₉ | L_{b52} | 1706 | Lₐ₁₄₂₇ | L_{b52} |
| 1707 | Lₐ₁₃₇₀ | L_{b52} | 1708 | Lₐ₁₄₂₈ | L_{b52} |
| 1709 | Lₐ₁₃₇₁ | L_{b52} | 1710 | Lₐ₁₄₂₉ | L_{b52} |
| 1711 | Lₐ₁₃₇₂ | L_{b52} | 1712 | Lₐ₁₄₃₀ | L_{b52} |
| 1713 | Lₐ₁₃₉₇ | L_{b52} | 1714 | Lₐ₁₄₃₁ | L_{b52} |
| 1715 | Lₐ₁₃₉₈ | L_{b52} | 1716 | Lₐ₁₄₃₈ | L_{b52} |
| 1717 | Lₐ₁₃₉₉ | L_{b52} | 1718 | Lₐ₁₄₃₉ | L_{b52} |
| 1719 | Lₐ₁₄₀₀ | L_{b52} | 1720 | Lₐ₁₄₄₀ | L_{b52} |
| 1721 | Lₐ₁₄₁₅ | L_{b52} | 1722 | Lₐ₁₄₄₁ | L_{b52} |
| 1723 | Lₐ₁₄₁₆ | L_{b52} | 1724 | Lₐ₁₄₆₃ | L_{b52} |
| 1725 | Lₐ₁₄₁₇ | L_{b52} | 1726 | Lₐ₁₄₆₄ | L_{b52} |
| 1727 | Lₐ₁₄₁₈ | L_{b52} | 1728 | Lₐ₁₄₆₅ | L_{b52} |
| 1729 | Lₐ₁₄₁₉ | L_{b52} | 1730 | Lₐ₁₄₆₆ | L_{b52} |
| 1731 | Lₐ₁₄₇₈ | L_{b52} | 1732 | Lₐ₁₄₉₁ | L_{b52} |
| 1733 | Lₐ₁₄₇₉ | L_{b52} | 1734 | Lₐ₁₄₉₂ | L_{b52} |
| 1735 | Lₐ₁₄₈₀ | L_{b52} | 1736 | Lₐ₁₄₉₃ | L_{b52} |
| 1737 | Lₐ₁₄₈₁ | L_{b52} | 1738 | Lₐ₁₅₀₅ | L_{b52} |
| 1739 | Lₐ₁₄₈₂ | L_{b52} | 1740 | Lₐ₁₅₀₆ | L_{b52} |
| 1741 | Lₐ₁₅₂₅ | L_{b52} | 1742 | Lₐ₁₅₀₇ | L_{b52} |
| 1743 | Lₐ₁₅₂₆ | L_{b52} | 1744 | Lₐ₁₅₀₈ | L_{b52} |
| 1745 | Lₐ₁₅₂₇ | L_{b52} | 1746 | Lₐ₁₅₃₇ | L_{b52} |
| 1747 | Lₐ₁₅₂₈ | L_{b52} | 1748 | Lₐ₁₅₃₈ | L_{b52} |
| 1749 | Lₐ₁₅₂₉ | L_{b52} | 1750 | Lₐ₁₅₃₉ | L_{b52} |
| 1751 | Lₐ₁₅₃₀ | L_{b52} | 1752 | Lₐ₁₅₄₀ | L_{b52} |
| 1753 | Lₐ₁₅₅₀ | L_{b52} | 1754 | Lₐ₁₅₄₁ | L_{b52} |
| 1755 | Lₐ₁₅₅₁ | L_{b52} | 1756 | Lₐ₁₅₄₂ | L_{b52} |
| 1757 | Lₐ₁₅₅₂ | L_{b52} | 1758 | Lₐ₁₅₇₇ | L_{b52} |
| 1759 | Lₐ₁₅₅₉ | L_{b52} | 1760 | Lₐ₁₅₇₈ | L_{b52} |
| 1761 | Lₐ₁₅₆₀ | L_{b52} | 1762 | Lₐ₁₅₇₉ | L_{b52} |
| 1763 | Lₐ₁₅₆₁ | L_{b52} | 1764 | Lₐ₁₅₈₀ | L_{b52} |
| 1765 | Lₐ₁₅₆₂ | L_{b52} | 1766 | Lₐ₁₅₉₂ | L_{b52} |
| 1767 | Lₐ₁₅₆₃ | L_{b52} | 1768 | Lₐ₁₅₉₃ | L_{b52} |
| 1769 | Lₐ₁₅₉₈ | L_{b52} | 1770 | Lₐ₁₅₉₄ | L_{b52} |
| 1771 | Lₐ₁₅₉₉ | L_{b52} | 1772 | Lₐ₁₆₀₆ | L_{b52} |
| 1773 | Lₐ₁₆₀₀ | L_{b52} | 1774 | Lₐ₁₆₀₇ | L_{b52} |
| 1775 | Lₐ₁₆₀₁ | L_{b52} | 1776 | Lₐ₁₆₀₈ | L_{b52} |
| 1777 | Lₐ₁₆₁₇ | L_{b52} | 1778 | Lₐ₁₆₄₃ | L_{b52} |
| 1779 | Lₐ₁₆₁₈ | L_{b52} | 1780 | Lₐ₁₆₄₄ | L_{b52} |
| 1781 | Lₐ₁₆₁₉ | L_{b52} | 1782 | Lₐ₁₆₅₄ | L_{b52} |
| 1783 | Lₐ₁₆₂₀ | L_{b52} | 1784 | Lₐ₁₆₅₅ | L_{b52} |
| 1785 | Lₐ₁₆₈₇ | L_{b52} | 1786 | Lₐ₁₆₅₆ | L_{b52} |
| 1787 | Lₐ₁₆₈₈ | L_{b52} | 1788 | Lₐ₁₆₅₇ | L_{b52} |
| 1789 | Lₐ₁₆₈₉ | L_{b52} | 1790 | Lₐ₁₆₅₈ | L_{b52} |
| 1791 | Lₐ₁₇₁₈ | L_{b52} | 1792 | Lₐ₁₆₅₉ | L_{b52} |
| 1793 | Lₐ₁₇₁₉ | L_{b52} | 1794 | Lₐ₁₇₅₃ | L_{b52} |
| 1795 | Lₐ₁₇₂₀ | L_{b52} | 1796 | Lₐ₁₇₅₄ | L_{b52} |
| 1797 | Lₐ₁₇₂₁ | L_{b52} | 1798 | Lₐ₁₇₅₅ | L_{b52} |
| 1799 | Lₐ₁₇₂₂ | L_{b52} | 1800 | Lₐ₁₇₅₆ | L_{b52} |
| 1801 | Lₐ₁₇₇₃ | L_{b52} | 1802 | Lₐ₁₇₅₇ | L_{b52} |
| 1803 | Lₐ₁₇₇₄ | L_{b52} | 1804 | Lₐ₁₇₅₈ | L_{b52} |
| 1805 | Lₐ₁₇₇₅ | L_{b52} | 1806 | Lₐ₁₇₉₉ | L_{b52} |
| 1807 | Lₐ₁₇₇₆ | L_{b52} | 1808 | Lₐ₁₈₀₀ | L_{b52} |
| 1809 | Lₐ₁₇₇₇ | L_{b52} | 1810 | Lₐ₁₈₀₁ | L_{b52} |
| 1811 | Lₐ₁₇₇₈ | L_{b52} | 1812 | Lₐ₁₈₁₅ | L_{b52} |
| 1813 | Lₐ₁₇₇₉ | L_{b52} | 1814 | Lₐ₁₈₁₆ | L_{b52} |
| 1815 | Lₐ₁₈₂₈ | L_{b52} | 1816 | Lₐ₁₈₁₇ | L_{b52} |
| 1817 | Lₐ₁₈₂₉ | L_{b52} | 1818 | Lₐ₁₈₄₁ | L_{b52} |
| 1819 | Lₐ₁₈₃₀ | L_{b52} | 1820 | Lₐ₁₈₄₂ | L_{b52} |
| 1821 | Lₐ₁₈₄₉ | L_{b52} | 1822 | Lₐ₁₈₄₃ | L_{b52} |
| 1823 | Lₐ₁₈₅₀ | L_{b52} | 1824 | Lₐ₁₈₄₄ | L_{b52} |
| 1825 | Lₐ₁₈₅₁ | L_{b52} | 1826 | Lₐ₁₈₅₉ | L_{b52} |
| 1827 | Lₐ₁₈₇₅ | L_{b52} | 1828 | Lₐ₁₈₆₀ | L_{b52} |
| 1829 | Lₐ₁₈₇₆ | L_{b52} | 1830 | Lₐ₁₈₆₁ | L_{b52} |
| 1831 | Lₐ₁₈₇₇ | L_{b52} | 1832 | Lₐ₁₈₆₂ | L_{b52} |
| 1833 | Lₐ₁₉₁₈ | L_{b52} | 1834 | Lₐ₁₈₈₅ | L_{b52} |
| 1835 | Lₐ₁₉₁₉ | L_{b52} | 1836 | Lₐ₁₈₈₆ | L_{b52} |
| 1837 | Lₐ₁₉₂₀ | L_{b52} | 1838 | Lₐ₁₈₈₇ | L_{b52} |
| 1839 | Lₐ₁₉₅₈ | L_{b52} | 1840 | Lₐ₁₉₈₃ | L_{b52} |
| 1841 | Lₐ₁₉₅₉ | L_{b52} | 1842 | Lₐ₁₉₈₄ | L_{b52} |
| 1843 | Lₐ₁₉₆₀ | L_{b52} | 1844 | Lₐ₁₉₈₅ | L_{b52} |
| 1845 | Lₐ₂₀₂₄ | L_{b52} | 1846 | Lₐ₁₉₈₆ | L_{b52} |
| 1847 | Lₐ₂₀₂₅ | L_{b52} | 1848 | Lₐ₂₀₇₂ | L_{b52} |
| 1849 | Lₐ₂₀₉₆ | L_{b52} | 1850 | Lₐ₂₀₇₃ | L_{b52} |
| 1851 | Lₐ₂₀₉₇ | L_{b52} | 1852 | Lₐ₂₁₂₄ | L_{b52} |
| 1853 | Lₐ₂₀₉₈ | L_{b52} | 1854 | Lₐ₂₁₂₅ | L_{b52} |
| 1855 | Lₐ₂₁₄₃ | L_{b52} | 1856 | Lₐ₂₁₂₆ | L_{b52} |
| 1857 | Lₐ₂₁₄₄ | L_{b52} | 1858 | Lₐ₂₁₂₇ | L_{b52} |
| 1859 | Lₐ₂₁₄₅ | L_{b52} | 1860 | Lₐ₂₁₂₈ | L_{b52} |
| 1861 | Lₐ₂₁₅₄ | L_{b52} | 1862 | Lₐ₂₁₆₀ | L_{b52} |
| 1863 | Lₐ₂₁₅₅ | L_{b52} | 1864 | Lₐ₂₁₆₁ | L_{b52} |
| 1865 | Lₐ₂₁₅₆ | L_{b52} | 1866 | Lₐ₂₁₉₅ | L_{b52} |
| 1867 | Lₐ₂₁₅₇ | L_{b52} | 1868 | Lₐ₂₁₉₆ | L_{b52} |
| 1869 | Lₐ₂₂₁₃ | L_{b52} | 1870 | Lₐ₂₁₉₇ | L_{b52} |
| 1871 | Lₐ₂₂₁₄ | L_{b52} | 1872 | Lₐ₂₂₂₅ | L_{b52} |
| 1873 | Lₐ₂₂₁₅ | L_{b52} | 1874 | Lₐ₂₂₂₆ | L_{b52} |
| 1875 | Lₐ₂₂₁₆ | L_{b52} | 1876 | Lₐ₂₂₂₇ | L_{b52} |
| 1877 | Lₐ₂₂₄₄ | L_{b52} | 1878 | Lₐ₂₂₆₅ | L_{b52} |
| 1879 | Lₐ₂₂₄₅ | L_{b52} | 1880 | Lₐ₂₂₆₆ | L_{b52} |
| 1881 | Lₐ₂₂₄₆ | L_{b52} | 1882 | Lₐ₂₃₀₀ | L_{b52} |
| 1883 | Lₐ₂₃₁₀ | L_{b52} | 1884 | Lₐ₂₃₀₁ | L_{b52} |
| 1885 | Lₐ₂₃₁₁ | L_{b52} | 1886 | Lₐ₂₃₂₀ | L_{b52} |
| 1887 | Lₐ₂₃₁₂ | L_{b52} | 1888 | Lₐ₂₃₂₁ | L_{b52} |
| 1889 | Lₐ₂₃₄₅ | L_{b52} | 1890 | Lₐ₂₃₉₂ | L_{b52} |
| 1891 | Lₐ₂₃₄₆ | L_{b52} | 1892 | Lₐ₂₃₉₃ | L_{b52} |
| 1893 | Lₐ₂₄₂₈ | L_{b52} | 1894 | Lₐ₂₃₉₄ | L_{b52} |
| 1895 | Lₐ₂₄₂₉ | L_{b52} | 1896 | Lₐ₂₃₉₅ | L_{b52} |
| 1897 | Lₐ₂₄₃₀ | L_{b52} | 1898 | Lₐ₂₄₈₅ | L_{b52} |
| 1899 | Lₐ₂₄₆₈ | L_{b52} | 1900 | Lₐ₂₄₈₆ | L_{b52} |
| 1901 | Lₐ₂₄₆₉ | L_{b52} | 1902 | Lₐ₂₄₈₇ | L_{b52} |
| 1903 | Lₐ₂₄₇₀ | L_{b52} | 1904 | Lₐ₂₄₈₈ | L_{b52} |
| 1905 | Lₐ₂₄₇₁ | L_{b52} | 1906 | Lₐ₂₅₃₅ | L_{b52} |
| 1907 | Lₐ₂₅₁₀ | L_{b52} | 1908 | Lₐ₂₅₃₆ | L_{b52} |
| 1909 | Lₐ₂₅₁₁ | L_{b52} | 1910 | Lₐ₂₅₃₇ | L_{b52} |
| 1911 | Lₐ₂₅₁₂ | L_{b52} | 1912 | Lₐ₂₅₅₆ | L_{b52} |
| 1913 | Lₐ₂₅₇₇ | L_{b52} | 1914 | Lₐ₂₅₅₇ | L_{b52} |
| 1915 | Lₐ₂₅₇₈ | L_{b52} | 1916 | Lₐ₂₅₅₈ | L_{b52} |
| 1917 | Lₐ₂₅₇₉ | L_{b52} | 1918 | Lₐ₂₆₃₆ | L_{b52} |
| 1919 | Lₐ₂₅₉₇ | L_{b52} | 1920 | Lₐ₂₆₃₇ | L_{b52} |
| 1921 | Lₐ₂₅₉₈ | L_{b52} | 1922 | Lₐ₂₆₃₈ | L_{b52} |
| 1923 | Lₐ₂₅₉₉ | L_{b52} | 1924 | Lₐ₂₆₈₂ | L_{b52} |
| 1925 | Lₐ₂₆₄₉ | L_{b52} | 1926 | Lₐ₂₆₈₃ | L_{b52} |
| 1927 | Lₐ₂₆₅₀ | L_{b52} | 1928 | Lₐ₂₆₈₄ | L_{b52} |
| 1929 | Lₐ₂₆₅₁ | L_{b52} | 1930 | Lₐ₂₇₂₂ | L_{b52} |
| 1931 | Lₐ₂₆₉₄ | L_{b52} | 1932 | Lₐ₂₇₂₃ | L_{b52} |
| 1933 | Lₐ₂₆₉₅ | L_{b52} | 1934 | Lₐ₂₇₂₄ | L_{b52} |
| 1935 | Lₐ₂₆₉₆ | L_{b52} | 1936 | Lₐ₂₇₃₅ | L_{b52} |
| 1937 | Lₐ₂₇₄₂ | L_{b52} | 1938 | Lₐ₂₇₃₆ | L_{b52} |
| 1939 | Lₐ₂₇₄₃ | L_{b52} | 1940 | Lₐ₂₇₃₇ | L_{b52} |
| 1941 | Lₐ₂₇₄₄ | L_{b52} | 1942 | Lₐ₂₈₀₄ | L_{b52} |
| 1943 | Lₐ₂₇₇₆ | L_{b52} | 1944 | Lₐ₂₈₀₅ | L_{b52} |
| 1945 | Lₐ₂₇₇₇ | L_{b52} | 1946 | Lₐ₂₈₀₆ | L_{b52} |
| 1947 | Lₐ₂₇₇₈ | L_{b52} | 1948 | Lₐ₂₈₀₇ | L_{b52} |
| 1949 | Lₐ₂₇₇₉ | L_{b52} | 1950 | Lₐ₂₈₀₈ | L_{b52} |
| 1951 | Lₐ₂₇₈₀ | L_{b52} | 1952 | Lₐ₂₈₂₅ | L_{b52} |
| 1953 | Lₐ₂₇₈₁ | L_{b52} | 1954 | Lₐ₂₈₂₆ | L_{b52} |
| 1955 | Lₐ₂₇₈₂ | L_{b52} | 1956 | Lₐ₂₈₂₇ | L_{b52} |
| 1957 | Lₐ₂₈₄₇ | L_{b52} | 1958 | Lₐ₂₈₅₅ | L_{b52} |
| 1959 | Lₐ₂₈₄₈ | L_{b52} | 1960 | Lₐ₂₈₅₆ | L_{b52} |
| 1961 | Lₐ₂₈₄₉ | L_{b52} | 1962 | Lₐ₂₈₅₇ | L_{b52} |
| 1963 | Lₐ₂₈₅₀ | L_{b52} | 1964 | Lₐ₂₈₇₆ | L_{b52} |
| 1965 | Lₐ₂₈₉₅ | L_{b52} | 1966 | Lₐ₂₈₇₇ | L_{b52} |
| 1967 | Lₐ₂₈₉₆ | L_{b52} | 1968 | Lₐ₂₈₇₈ | L_{b52} |
| 1969 | Lₐ₂₈₉₇ | L_{b52} | 1970 | Lₐ₂₉₀₇ | L_{b52} |
| 1971 | Lₐ₂₉₂₆ | L_{b52} | 1972 | Lₐ₂₉₀₈ | L_{b52} |
| 1973 | Lₐ₂₉₂₇ | L_{b52} | 1974 | Lₐ₂₉₀₉ | L_{b52} |
| 1975 | Lₐ₂₉₂₈ | L_{b52} | 1976 | Lₐ₂₉₄₈ | L_{b52} |
| 1977 | Lₐ₃₀₀₃ | L_{b52} | 1978 | Lₐ₂₉₄₉ | L_{b52} |
| 1979 | Lₐ₃₀₀₄ | L_{b52} | 1980 | Lₐ₂₉₅₀ | L_{b52} |
| 1981 | Lₐ₃₀₄₈ | L_{b52} | 1982 | Lₐ₃₀₈₈ | L_{b52} |
| 1983 | Lₐ₃₀₄₉ | L_{b52} | 1984 | Lₐ₃₀₈₉ | L_{b52} |
| 1985 | Lₐ₃₀₅₀ | L_{b52} | 1986 | Lₐ₃₀₉₀ | L_{b52} |
| 1987 | Lₐ₃₁₂₈ | L_{b52} | 1988 | Lₐ₃₁₄₇ | L_{b52} |
| 1989 | Lₐ₃₁₂₉ | L_{b52} | 1990 | Lₐ₃₁₄₈ | L_{b52} |
| 1991 | Lₐ₃₁₃₀ | L_{b52} | 1992 | Lₐ₃₁₄₉ | L_{b52} |
| 1993 | Lₐ₃₁₃₁ | L_{b52} | 1994 | Lₐ₃₁₅₀ | L_{b52} |
| 1995 | Lₐ₃₁₇₈ | L_{b52} | 1996 | Lₐ₃₂₈₇ | L_{b52} |
| 1997 | Lₐ₃₁₇₉ | L_{b52} | 1998 | Lₐ₃₂₈₈ | L_{b52} |
| 1999 | Lₐ₃₁₈₀ | L_{b52} | 2000 | Lₐ₃₂₈₉ | L_{b52} |
| 2001 | Lₐ₃₃₃₇ | L_{b52} | 2002 | Lₐ₃₃₆₃ | L_{b52} |
| 2003 | Lₐ₃₃₃₈ | L_{b52} | 2004 | Lₐ₃₃₆₄ | L_{b52} |
| 2005 | Lₐ₃₃₃₉ | L_{b52} | 2006 | Lₐ₃₃₆₅ | L_{b52} |
| 2007 | Lₐ₁ | L_{b5} | 2008 | Lₐ₁₀₅ | L_{b2} |
| 2009 | Lₐ₁ | L_{b4} | 2010 | Lₐ₁₀₅ | L_{b4} |
| 2011 | Lₐ₁ | L_{b5} | 2012 | Lₐ₁₀₅ | L_{b5} |
| 2013 | Lₐ₁ | L_{b10} | 2014 | Lₐ₁₀₅ | L_{b10} |
| 2015 | Lₐ₁ | L_{b11} | 2016 | Lₐ₁₀₅ | L_{b11} |
| 2017 | Lₐ₁ | L_{b12} | 2018 | Lₐ₁₀₅ | L_{b12} |
| 2019 | Lₐ₁ | L_{b13} | 2020 | Lₐ₁₀₅ | L_{b13} |
| 2021 | Lₐ₁ | L_{b14} | 2022 | Lₐ₁₀₅ | L_{b14} |
| 2023 | Lₐ₁ | L_{b15} | 2024 | Lₐ₁₀₅ | L_{b15} |
| 2025 | Lₐ₁ | L_{b17} | 2026 | Lₐ₁₀₅ | L_{b17} |
| 2027 | Lₐ₁ | L_{b19} | 2028 | Lₐ₁₀₅ | L_{b19} |
| 2029 | Lₐ₁ | L_{b21} | 2030 | Lₐ₁₀₅ | L_{b21} |
| 2031 | Lₐ₁ | L_{b22} | 2032 | Lₐ₁₀₅ | L_{b22} |
| 2033 | Lₐ₁ | L_{b23} | 2034 | Lₐ₁₀₅ | L_{b23} |
| 2035 | Lₐ₁ | L_{b24} | 2036 | Lₐ₁₀₅ | L_{b24} |
| 2037 | Lₐ₁ | L_{b25} | 2038 | Lₐ₁₀₅ | L_{b25} |
| 2039 | Lₐ₁ | L_{b26} | 2040 | Lₐ₁₀₅ | L_{b26} |
| 2041 | Lₐ₁ | L_{b27} | 2042 | Lₐ₁₀₅ | L_{b27} |
| 2043 | Lₐ₁ | L_{b28} | 2044 | Lₐ₁₀₅ | L_{b28} |
| 2045 | Lₐ₁ | L_{b29} | 2046 | Lₐ₁₀₅ | L_{b29} |
| 2047 | Lₐ₁ | L_{b30} | 2048 | Lₐ₁₀₅ | L_{b30} |
| 2049 | Lₐ₁ | L_{b31} | 2050 | Lₐ₁₀₅ | L_{b31} |
| 2051 | Lₐ₁ | L_{b32} | 2052 | Lₐ₁₀₅ | L_{b32} |
| 2053 | Lₐ₁ | L_{b33} | 2054 | Lₐ₁₀₅ | L_{b33} |
| 2055 | Lₐ₁ | L_{b42} | 2056 | Lₐ₁₀₅ | L_{b42} |
| 2057 | Lₐ₁ | L_{b43} | 2058 | Lₐ₁₀₅ | L_{b43} |
| 2059 | Lₐ₁ | L_{b44} | 2060 | Lₐ₁₀₅ | L_{b44} |
| 2061 | Lₐ₁ | L_{b45} | 2062 | Lₐ₁₀₅ | L_{b45} |
| 2063 | Lₐ₁ | L_{b46} | 2064 | Lₐ₁₀₅ | L_{b46} |
| 2065 | Lₐ₁ | L_{b50} | 2066 | Lₐ₁₀₅ | L_{b50} |
| 2067 | Lₐ₁ | L_{b51} | 2068 | Lₐ₁₀₅ | L_{b51} |
| 2069 | Lₐ₁ | L_{b53} | 2070 | Lₐ₁₀₅ | L_{b53} |
| 2071 | Lₐ₁ | L_{b54} | 2072 | Lₐ₁₀₅ | L_{b54} |
| 2073 | Lₐ₁ | L_{b55} | 2074 | Lₐ₁₀₅ | L_{b55} |
| 2075 | Lₐ₁ | L_{b56} | 2076 | Lₐ₁₀₅ | L_{b56} |
| 2077 | Lₐ₁ | L_{b57} | 2078 | Lₐ₁₀₅ | L_{b57} |
| 2079 | Lₐ₁ | L_{b58} | 2080 | Lₐ₁₀₅ | L_{b58} |
| 2081 | Lₐ₁ | L_{b59} | 2082 | Lₐ₁₀₅ | L_{b59} |
| 2083 | Lₐ₁ | L_{b66} | 2084 | Lₐ₁₀₅ | L_{b66} |
| 2085 | Lₐ₁ | L_{b68} | 2086 | Lₐ₁₀₅ | L_{b68} |
| 2087 | Lₐ₁ | L_{b70} | 2088 | Lₐ₁₀₅ | L_{b70} |
| 2089 | Lₐ₁ | L_{b75} | 2090 | Lₐ₁₀₅ | L_{b75} |
| 2091 | Lₐ₁ | L_{b76} | 2092 | Lₐ₁₀₅ | L_{b76} |
| 2093 | Lₐ₁ | L_{b87} | 2094 | Lₐ₁₀₅ | L_{b87} |
| 2095 | Lₐ₁ | L_{b95} | 2096 | Lₐ₁₀₅ | L_{b95} |
| 2097 | Lₐ₁ | L_{b96} | 2098 | Lₐ₁₀₅ | L_{b96} |
| 2099 | Lₐ₁ | L_{b97} | 2100 | Lₐ₁₀₅ | L_{b97} |
| 2101 | Lₐ₁ | L_{b98} | 2102 | Lₐ₁₀₅ | L_{b98} |
| 2103 | Lₐ₁ | L_{b109} | 2104 | Lₐ₁₀₅ | L_{b109} |
| 2105 | Lₐ₁ | L_{b110} | 2106 | Lₐ₁₀₅ | L_{b110} |
| 2107 | Lₐ₁ | L_{b111} | 2108 | Lₐ₁₀₅ | L_{b111} |
| 2109 | Lₐ₁ | L_{b112} | 2110 | Lₐ₁₀₅ | L_{b112} |
| 2111 | Lₐ₁ | L_{b114} | 2112 | Lₐ₁₀₅ | L_{b114} |
| 2113 | Lₐ₁ | L_{b117} | 2114 | Lₐ₁₀₅ | L_{b117} |
| 2115 | Lₐ₁ | L_{b122} | 2116 | Lₐ₁₀₅ | L_{b122} |
| 2117 | Lₐ₁ | L_{b123} | 2118 | Lₐ₁₀₅ | L_{b123} |
| 2119 | Lₐ₁ | L_{b129} | 2120 | Lₐ₁₀₅ | L_{b129} |
| 2121 | Lₐ₁ | L_{b130} | 2122 | Lₐ₁₀₅ | L_{b130} |
| 2123 | Lₐ₁ | L_{b131} | 2124 | Lₐ₁₀₅ | L_{b131} |
| 2125 | Lₐ₁ | L_{b133} | 2126 | Lₐ₁₀₅ | L_{b133} |
| 2127 | Lₐ₁ | L_{b134} | 2128 | Lₐ₁₀₅ | L_{b134} |
| 2129 | Lₐ₁ | L_{b135} | 2130 | Lₐ₁₀₅ | L_{b135} |
| 2131 | Lₐ₁ | L_{b148} | 2132 | Lₐ₁₀₅ | L_{b148} |
| 2133 | Lₐ₁ | L_{b149} | 2134 | Lₐ₁₀₅ | L_{b149} |
| 2135 | Lₐ₁ | L_{b150} | 2136 | Lₐ₁₀₅ | L_{b150} |
| 2137 | Lₐ₁ | L_{b151} | 2138 | Lₐ₁₀₅ | L_{b151} |
| 2139 | Lₐ₁₃₀ | L_{b2} | 2140 | Lₐ₂₀₁ | L_{b2} |
| 2141 | Lₐ₁₃₀ | L_{b4} | 2142 | Lₐ₂₀₁ | L_{b4} |
| 2143 | Lₐ₁₃₀ | L_{b5} | 2144 | Lₐ₂₀₁ | L_{b5} |
| 2145 | Lₐ₁₃₀ | L_{b10} | 2146 | Lₐ₂₀₁ | L_{b10} |
| 2147 | Lₐ₁₃₀ | L_{b11} | 2148 | Lₐ₂₀₁ | L_{b11} |
| 2149 | Lₐ₁₃₀ | L_{b12} | 2150 | Lₐ₂₀₁ | L_{b12} |
| 2151 | Lₐ₁₃₀ | L_{b13} | 2152 | Lₐ₂₀₁ | L_{b13} |
| 2153 | Lₐ₁₃₀ | L_{b14} | 2154 | Lₐ₂₀₁ | L_{b14} |
| 2155 | Lₐ₁₃₀ | L_{b15} | 2156 | Lₐ₂₀₁ | L_{b15} |
| 2157 | Lₐ₁₃₀ | L_{b17} | 2158 | Lₐ₂₀₁ | L_{b17} |
| 2159 | Lₐ₁₃₀ | L_{b19} | 2160 | Lₐ₂₀₁ | L_{b19} |
| 2161 | Lₐ₁₃₀ | L_{b21} | 2162 | Lₐ₂₀₁ | L_{b21} |
| 2163 | Lₐ₁₃₀ | L_{b22} | 2164 | Lₐ₂₀₁ | L_{b22} |
| 2165 | Lₐ₁₃₀ | L_{b23} | 2166 | Lₐ₂₀₁ | L_{b23} |
| 2167 | Lₐ₁₃₀ | L_{b24} | 2168 | Lₐ₂₀₁ | L_{b24} |
| 2169 | Lₐ₁₃₀ | L_{b25} | 2170 | Lₐ₂₀₁ | L_{b25} |
| 2171 | Lₐ₁₃₀ | L_{b26} | 2172 | Lₐ₂₀₁ | L_{b26} |
| 2173 | Lₐ₁₃₀ | L_{b27} | 2174 | Lₐ₂₀₁ | L_{b27} |
| 2175 | Lₐ₁₃₀ | L_{b28} | 2176 | Lₐ₂₀₁ | L_{b28} |
| 2177 | Lₐ₁₃₀ | L_{b29} | 2178 | Lₐ₂₀₁ | L_{b29} |
| 2179 | Lₐ₁₃₀ | L_{b30} | 2180 | Lₐ₂₀₁ | L_{b30} |
| 2181 | Lₐ₁₃₀ | L_{b31} | 2182 | Lₐ₂₀₁ | L_{b31} |
| 2183 | Lₐ₁₃₀ | L_{b32} | 2184 | Lₐ₂₀₁ | L_{b32} |
| 2185 | Lₐ₁₃₀ | L_{b33} | 2186 | Lₐ₂₀₁ | L_{b33} |
| 2187 | Lₐ₁₃₀ | L_{b42} | 2188 | Lₐ₂₀₁ | L_{b42} |
| 2189 | Lₐ₁₃₀ | L_{b43} | 2190 | Lₐ₂₀₁ | L_{b43} |
| 2191 | Lₐ₁₃₀ | L_{b44} | 2192 | Lₐ₂₀₁ | L_{b44} |
| 2193 | Lₐ₁₃₀ | L_{b45} | 2194 | Lₐ₂₀₁ | L_{b45} |
| 2195 | Lₐ₁₃₀ | L_{b46} | 2196 | Lₐ₂₀₁ | L_{b46} |
| 2197 | Lₐ₁₃₀ | L_{b50} | 2198 | Lₐ₂₀₁ | L_{b50} |
| 2199 | Lₐ₁₃₀ | L_{b51} | 2200 | Lₐ₂₀₁ | L_{b51} |
| 2201 | Lₐ₁₃₀ | L_{b53} | 2202 | Lₐ₂₀₁ | L_{b53} |
| 2203 | Lₐ₁₃₀ | L_{b54} | 2204 | Lₐ₂₀₁ | L_{b54} |
| 2205 | Lₐ₁₃₀ | L_{b53} | 2206 | Lₐ₂₀₁ | L_{b53} |
| 2207 | Lₐ₁₃₀ | L_{b56} | 2208 | Lₐ₂₀₁ | L_{b56} |
| 2209 | Lₐ₁₃₀ | L_{b57} | 2210 | Lₐ₂₀₁ | L_{b57} |
| 2211 | Lₐ₁₃₀ | L_{b58} | 2212 | Lₐ₂₀₁ | L_{b58} |
| 2213 | Lₐ₁₃₀ | L_{b59} | 2214 | Lₐ₂₀₁ | L_{b59} |
| 2215 | Lₐ₁₃₀ | L_{b66} | 2216 | Lₐ₂₀₁ | L_{b66} |
| 2217 | Lₐ₁₃₀ | L_{b68} | 2218 | Lₐ₂₀₁ | L_{b53} |
| 2219 | Lₐ₁₃₀ | L_{b70} | 2220 | Lₐ₂₀₁ | L_{b70} |
| 2221 | Lₐ₁₃₀ | L_{b75} | 2222 | Lₐ₂₀₁ | L_{b75} |
| 2223 | Lₐ₁₃₀ | L_{b76} | 2224 | Lₐ₂₀₁ | L_{b76} |
| 2225 | Lₐ₁₃₀ | L_{b87} | 2226 | Lₐ₂₀₁ | L_{b87} |
| 2227 | Lₐ₁₃₀ | L_{b95} | 2228 | Lₐ₂₀₁ | L_{b95} |
| 2229 | Lₐ₁₃₀ | L_{b96} | 2230 | Lₐ₂₀₁ | L_{b96} |
| 2231 | Lₐ₁₃₀ | L_{b97} | 2232 | Lₐ₂₀₁ | L_{b97} |
| 2233 | Lₐ₁₃₀ | L_{b98} | 2234 | Lₐ₂₀₁ | L_{b98} |
| 2235 | Lₐ₁₃₀ | L_{b109} | 2236 | Lₐ₂₀₁ | L_{b109} |
| 2237 | Lₐ₁₃₀ | L_{b110} | 2238 | Lₐ₂₀₁ | L_{b110} |
| 2239 | Lₐ₁₃₀ | L_{b111} | 2240 | Lₐ₂₀₁ | L_{b111} |
| 2241 | Lₐ₁₃₀ | L_{b112} | 2242 | Lₐ₂₀₁ | L_{b112} |
| 2243 | Lₐ₁₃₀ | L_{b114} | 2244 | Lₐ₂₀₁ | L_{b114} |
| 2245 | Lₐ₁₃₀ | L_{b117} | 2246 | Lₐ₂₀₁ | L_{b117} |
| 2247 | Lₐ₁₃₀ | L_{b122} | 2248 | Lₐ₂₀₁ | L_{b122} |
| 2249 | Lₐ₁₃₀ | L_{b123} | 2250 | Lₐ₂₀₁ | L_{b123} |
| 2251 | Lₐ₁₃₀ | L_{b129} | 2252 | Lₐ₂₀₁ | L_{b129} |
| 2253 | Lₐ₁₃₀ | L_{b130} | 2254 | Lₐ₂₀₁ | L_{b130} |
| 2255 | Lₐ₁₃₀ | L_{b131} | 2256 | Lₐ₂₀₁ | L_{b131} |
| 2257 | Lₐ₁₃₀ | L_{b133} | 2258 | Lₐ₂₀₁ | L_{b133} |
| 2259 | Lₐ₁₃₀ | L_{b134} | 2260 | Lₐ₂₀₁ | L_{b134} |
| 2261 | Lₐ₁₃₀ | L_{b135} | 2262 | Lₐ₂₀₁ | L_{b135} |
| 2263 | Lₐ₁₃₀ | L_{b148} | 2264 | Lₐ₂₀₁ | L_{b148} |
| 2265 | Lₐ₁₃₀ | L_{b149} | 2266 | Lₐ₂₀₁ | L_{b149} |
| 2267 | Lₐ₁₃₀ | L_{b150} | 2268 | Lₐ₂₀₁ | L_{b150} |
| 2269 | Lₐ₁₃₀ | L_{b151} | 2270 | Lₐ₂₀₁ | L_{b151} |
| 2271 | Lₐ₂₇₂ | L_{b2} | 2272 | Lₐ₃₄₃ | L_{b2} |
| 2273 | Lₐ₂₇₂ | L_{b4} | 2274 | Lₐ₃₄₃ | L_{b4} |
| 2275 | Lₐ₂₇₂ | L_{b5} | 2276 | Lₐ₃₄₃ | L_{b5} |
| 2277 | Lₐ₂₇₂ | L_{b10} | 2278 | Lₐ₃₄₃ | L_{b10} |
| 2279 | Lₐ₂₇₂ | L_{b11} | 2280 | Lₐ₃₄₃ | L_{b11} |
| 2281 | Lₐ₂₇₂ | L_{b12} | 2282 | Lₐ₃₄₃ | L_{b12} |
| 2283 | Lₐ₂₇₂ | L_{b13} | 2284 | Lₐ₃₄₃ | L_{b13} |
| 2285 | Lₐ₂₇₂ | L_{b14} | 2286 | Lₐ₃₄₃ | L_{b14} |
| 2287 | Lₐ₂₇₂ | L_{b15} | 2288 | Lₐ₃₄₃ | L_{b15} |
| 2289 | Lₐ₂₇₂ | L_{b17} | 2290 | Lₐ₃₄₃ | L_{b17} |
| 2291 | Lₐ₂₇₂ | L_{b19} | 2292 | Lₐ₃₄₃ | L_{b19} |
| 2293 | Lₐ₂₇₂ | L_{b21} | 2294 | Lₐ₃₄₃ | L_{b21} |
| 2295 | Lₐ₂₇₂ | L_{b22} | 2296 | Lₐ₃₄₃ | L_{b22} |
| 2297 | Lₐ₂₇₂ | L_{b23} | 2298 | Lₐ₃₄₃ | L_{b23} |
| 2299 | Lₐ₂₇₂ | L_{b24} | 2300 | Lₐ₃₄₃ | L_{b24} |
| 2301 | Lₐ₂₇₂ | L_{b25} | 2302 | Lₐ₃₄₃ | L_{b25} |
| 2303 | Lₐ₂₇₂ | L_{b26} | 2304 | Lₐ₃₄₃ | L_{b26} |
| 2305 | Lₐ₂₇₂ | L_{b27} | 2306 | Lₐ₃₄₃ | L_{b27} |
| 2307 | Lₐ₂₇₂ | L_{b28} | 2308 | Lₐ₃₄₃ | L_{b28} |
| 2309 | Lₐ₂₇₂ | L_{b29} | 2310 | Lₐ₃₄₃ | L_{b29} |
| 2311 | Lₐ₂₇₂ | L_{b30} | 2312 | Lₐ₃₄₃ | L_{b30} |
| 2313 | Lₐ₂₇₂ | L_{b31} | 2314 | Lₐ₃₄₃ | L_{b31} |
| 2315 | Lₐ₂₇₂ | L_{b32} | 2316 | Lₐ₃₄₃ | L_{b32} |
| 2317 | Lₐ₂₇₂ | L_{b33} | 2318 | Lₐ₃₄₃ | L_{b33} |
| 2319 | Lₐ₂₇₂ | L_{b42} | 2320 | Lₐ₃₄₃ | L_{b42} |
| 2321 | Lₐ₂₇₂ | L_{b43} | 2322 | Lₐ₃₄₃ | L_{b43} |
| 2323 | Lₐ₂₇₂ | L_{b44} | 2324 | Lₐ₃₄₃ | L_{b44} |
| 2325 | Lₐ₂₇₂ | L_{b45} | 2326 | Lₐ₃₄₃ | L_{b45} |
| 2327 | Lₐ₂₇₂ | L_{b46} | 2328 | Lₐ₃₄₃ | L_{b46} |
| 2329 | Lₐ₂₇₂ | L_{b50} | 2330 | Lₐ₃₄₃ | L_{b50} |
| 2331 | Lₐ₂₇₂ | L_{b51} | 2332 | Lₐ₃₄₃ | L_{b51} |
| 2333 | Lₐ₂₇₂ | L_{b53} | 2334 | Lₐ₃₄₃ | L_{b53} |
| 2335 | Lₐ₂₇₂ | L_{b54} | 2336 | Lₐ₃₄₃ | L_{b54} |
| 2337 | Lₐ₂₇₂ | L_{b55} | 2338 | Lₐ₃₄₃ | L_{b55} |
| 2339 | Lₐ₂₇₂ | L_{b56} | 2340 | Lₐ₃₄₃ | L_{b56} |
| 2341 | Lₐ₂₇₂ | L_{b57} | 2342 | Lₐ₃₄₃ | L_{b57} |
| 2343 | Lₐ₂₇₂ | L_{b58} | 2344 | Lₐ₃₄₃ | L_{b58} |
| 2345 | Lₐ₂₇₂ | L_{b59} | 2346 | Lₐ₃₄₃ | L_{b59} |
| 2347 | Lₐ₂₇₂ | L_{b66} | 2348 | Lₐ₃₄₃ | L_{b66} |
| 2349 | Lₐ₂₇₂ | L_{b68} | 2350 | Lₐ₃₄₃ | L_{b68} |
| 2351 | Lₐ₂₇₂ | L_{b70} | 2352 | Lₐ₃₄₃ | L_{b70} |
| 2353 | Lₐ₂₇₂ | L_{b75} | 2354 | Lₐ₃₄₃ | L_{b75} |
| 2355 | Lₐ₂₇₂ | L_{b76} | 2356 | Lₐ₃₄₃ | L_{b76} |
| 2357 | Lₐ₂₇₂ | L_{b87} | 2358 | Lₐ₃₄₃ | L_{b87} |
| 2359 | Lₐ₂₇₂ | L_{b95} | 2360 | Lₐ₃₄₃ | L_{b95} |
| 2361 | Lₐ₂₇₂ | L_{b96} | 2362 | Lₐ₃₄₃ | L_{b96} |
| 2363 | Lₐ₂₇₂ | L_{b97} | 2364 | Lₐ₃₄₃ | L_{b97} |
| 2365 | Lₐ₂₇₂ | L_{b98} | 2366 | Lₐ₃₄₃ | L_{b98} |
| 2367 | Lₐ₂₇₂ | L_{b109} | 2368 | Lₐ₃₄₃ | L_{b109} |
| 2369 | Lₐ₂₇₂ | L_{b110} | 2370 | Lₐ₃₄₃ | L_{b110} |
| 2371 | Lₐ₂₇₂ | L_{b111} | 2372 | Lₐ₃₄₃ | L_{b111} |
| 2373 | Lₐ₂₇₂ | L_{b112} | 2374 | Lₐ₃₄₃ | L_{b112} |
| 2375 | Lₐ₂₇₂ | L_{b114} | 2376 | Lₐ₃₄₃ | L_{b114} |
| 2377 | Lₐ₂₇₂ | L_{b117} | 2378 | Lₐ₃₄₃ | L_{b117} |
| 2379 | Lₐ₂₇₂ | L_{b122} | 2380 | Lₐ₃₄₃ | L_{b122} |
| 2381 | Lₐ₂₇₂ | L_{b123} | 2382 | Lₐ₃₄₃ | L_{b123} |
| 2383 | Lₐ₂₇₂ | L_{b129} | 2384 | Lₐ₃₄₃ | L_{b129} |
| 2385 | Lₐ₂₇₂ | L_{b130} | 2386 | Lₐ₃₄₃ | L_{b130} |
| 2387 | Lₐ₂₇₂ | L_{b131} | 2388 | Lₐ₃₄₃ | L_{b131} |
| 2389 | Lₐ₂₇₂ | L_{b133} | 2390 | Lₐ₃₄₃ | L_{b133} |
| 2391 | Lₐ₂₇₂ | L_{b134} | 2392 | Lₐ₃₄₃ | L_{b134} |
| 2393 | Lₐ₂₇₂ | L_{b135} | 2394 | Lₐ₃₄₃ | L_{b135} |
| 2395 | Lₐ₂₇₂ | L_{b148} | 2396 | Lₐ₃₄₃ | L_{b148} |
| 2397 | Lₐ₂₇₂ | L_{b149} | 2398 | Lₐ₃₄₃ | L_{b149} |
| 2399 | Lₐ₂₇₂ | L_{b150} | 2400 | Lₐ₃₄₃ | L_{b150} |
| 2401 | Lₐ₂₇₂ | L_{b151} | 2402 | Lₐ₃₄₃ | L_{b151} |
| 2403 | Lₐ₄₁₄ | L_{b2} | 2404 | Lₐ₇₄₆ | L_{b2} |
| 2405 | Lₐ₄₁₄ | L_{b4} | 2406 | Lₐ₇₄₆ | L_{b4} |
| 2407 | Lₐ₄₁₄ | L_{b5} | 2408 | Lₐ₇₄₆ | L_{b5} |
| 2409 | Lₐ₄₁₄ | L_{b10} | 2410 | Lₐ₇₄₆ | L_{b10} |
| 2411 | Lₐ₄₁₄ | L_{b11} | 2412 | Lₐ₇₄₆ | L_{b11} |
| 2413 | Lₐ₄₁₄ | L_{b12} | 2414 | Lₐ₇₄₆ | L_{b12} |
| 2415 | Lₐ₄₁₄ | L_{b13} | 2416 | Lₐ₇₄₆ | L_{b13} |
| 2417 | Lₐ₄₁₄ | L_{b14} | 2418 | Lₐ₇₄₆ | L_{b14} |
| 2419 | Lₐ₄₁₄ | L_{b15} | 2420 | Lₐ₇₄₆ | L_{b15} |
| 2421 | Lₐ₄₁₄ | L_{b17} | 2422 | Lₐ₇₄₆ | L_{b17} |
| 2423 | Lₐ₄₁₄ | L_{b19} | 2424 | Lₐ₇₄₆ | L_{b19} |
| 2425 | Lₐ₄₁₄ | L_{b21} | 2426 | Lₐ₇₄₆ | L_{b21} |
| 2427 | Lₐ₄₁₄ | L_{b22} | 2428 | Lₐ₇₄₆ | L_{b22} |
| 2429 | Lₐ₄₁₄ | L_{b23} | 2430 | Lₐ₇₄₆ | L_{b23} |
| 2431 | Lₐ₄₁₄ | L_{b24} | 2432 | Lₐ₇₄₆ | L_{b24} |
| 2433 | Lₐ₄₁₄ | L_{b25} | 2434 | Lₐ₇₄₆ | L_{b25} |
| 2435 | Lₐ₄₁₄ | L_{b26} | 2436 | Lₐ₇₄₆ | L_{b26} |
| 2437 | Lₐ₄₁₄ | L_{b27} | 2438 | Lₐ₇₄₆ | L_{b27} |
| 2439 | Lₐ₄₁₄ | L_{b28} | 2440 | Lₐ₇₄₆ | L_{b28} |
| 2441 | Lₐ₄₁₄ | L_{b29} | 2442 | Lₐ₇₄₆ | L_{b29} |
| 2443 | Lₐ₄₁₄ | L_{b30} | 2444 | Lₐ₇₄₆ | L_{b30} |
| 2445 | Lₐ₄₁₄ | L_{b31} | 2446 | Lₐ₇₄₆ | L_{b31} |
| 2447 | Lₐ₄₁₄ | L_{b32} | 2448 | Lₐ₇₄₆ | L_{b32} |
| 2449 | Lₐ₄₁₄ | L_{b33} | 2450 | Lₐ₇₄₆ | L_{b33} |
| 2451 | Lₐ₄₁₄ | L_{b42} | 2452 | Lₐ₇₄₆ | L_{b42} |
| 2453 | Lₐ₄₁₄ | L_{b43} | 2454 | Lₐ₇₄₆ | L_{b43} |
| 2455 | Lₐ₄₁₄ | L_{b44} | 2456 | Lₐ₇₄₆ | L_{b44} |
| 2457 | Lₐ₄₁₄ | L_{b45} | 2458 | Lₐ₇₄₆ | L_{b45} |
| 2459 | Lₐ₄₁₄ | L_{b46} | 2460 | Lₐ₇₄₆ | L_{b46} |
| 2461 | Lₐ₄₁₄ | L_{b50} | 2462 | Lₐ₇₄₆ | L_{b50} |
| 2463 | Lₐ₄₁₄ | L_{b51} | 2464 | Lₐ₇₄₆ | L_{b51} |
| 2465 | Lₐ₄₁₄ | L_{b53} | 2466 | Lₐ₇₄₆ | L_{b53} |
| 2467 | Lₐ₄₁₄ | L_{b54} | 2468 | Lₐ₇₄₆ | L_{b54} |
| 2469 | Lₐ₄₁₄ | L_{b55} | 2470 | Lₐ₇₄₆ | L_{b55} |
| 2471 | Lₐ₄₁₄ | L_{b56} | 2472 | Lₐ₇₄₆ | L_{b56} |
| 2473 | Lₐ₄₁₄ | L_{b57} | 2474 | Lₐ₇₄₆ | L_{b57} |
| 2475 | Lₐ₄₁₄ | L_{b58} | 2476 | Lₐ₇₄₆ | L_{b58} |
| 2477 | Lₐ₄₁₄ | L_{b59} | 2478 | Lₐ₇₄₆ | L_{b59} |
| 2479 | Lₐ₄₁₄ | L_{b66} | 2480 | Lₐ₇₄₆ | L_{b66} |
| 2481 | Lₐ₄₁₄ | L_{b68} | 2482 | Lₐ₇₄₆ | L_{b68} |
| 2483 | Lₐ₄₁₄ | L_{b70} | 2484 | Lₐ₇₄₆ | L_{b70} |
| 2485 | Lₐ₄₁₄ | L_{b75} | 2486 | Lₐ₇₄₆ | L_{b75} |
| 2487 | Lₐ₄₁₄ | L_{b76} | 2488 | Lₐ₇₄₆ | L_{b76} |
| 2489 | Lₐ₄₁₄ | L_{b87} | 2490 | Lₐ₇₄₆ | L_{b87} |
| 2491 | Lₐ₄₁₄ | L_{b95} | 2492 | Lₐ₇₄₆ | L_{b95} |
| 2493 | Lₐ₄₁₄ | L_{b96} | 2494 | Lₐ₇₄₆ | L_{b96} |
| 2495 | Lₐ₄₁₄ | L_{b97} | 2496 | Lₐ₇₄₆ | L_{b97} |
| 2497 | Lₐ₄₁₄ | L_{b98} | 2498 | Lₐ₇₄₆ | L_{b98} |
| 2499 | Lₐ₄₁₄ | L_{b109} | 2500 | Lₐ₇₄₆ | L_{b109} |
| 2501 | Lₐ₄₁₄ | L_{b110} | 2502 | Lₐ₇₄₆ | L_{b110} |
| 2503 | Lₐ₄₁₄ | L_{b111} | 2504 | Lₐ₇₄₆ | L_{b111} |
| 2505 | Lₐ₄₁₄ | L_{b112} | 2506 | Lₐ₇₄₆ | L_{b112} |
| 2507 | Lₐ₄₁₄ | L_{b114} | 2508 | Lₐ₇₄₆ | L_{b114} |
| 2509 | Lₐ₄₁₄ | L_{b117} | 2510 | Lₐ₇₄₆ | L_{b117} |
| 2511 | Lₐ₄₁₄ | L_{b122} | 2512 | Lₐ₇₄₆ | L_{b122} |
| 2513 | Lₐ₄₁₄ | L_{b123} | 2514 | Lₐ₇₄₆ | L_{b123} |
| 2515 | Lₐ₄₁₄ | L_{b129} | 2516 | Lₐ₇₄₆ | L_{b129} |
| 2517 | Lₐ₄₁₄ | L_{b130} | 2518 | Lₐ₇₄₆ | L_{b130} |
| 2519 | Lₐ₄₁₄ | L_{b131} | 2520 | Lₐ₇₄₆ | L_{b131} |
| 2521 | Lₐ₄₁₄ | L_{b133} | 2522 | Lₐ₇₄₆ | L_{b133} |
| 2523 | Lₐ₄₁₄ | L_{b134} | 2524 | Lₐ₇₄₆ | L_{b134} |
| 2525 | Lₐ₄₁₄ | L_{b135} | 2526 | Lₐ₇₄₆ | L_{b135} |
| 2527 | Lₐ₄₁₄ | L_{b148} | 2528 | Lₐ₇₄₆ | L_{b148} |
| 2529 | Lₐ₄₁₄ | L_{b149} | 2530 | Lₐ₇₄₆ | L_{b149} |
| 2531 | Lₐ₄₁₄ | L_{b150} | 2532 | Lₐ₇₄₆ | L_{b150} |
| 2533 | Lₐ₄₁₄ | L_{b151} | 2534 | Lₐ₇₄₆ | L_{b151} |
| 2535 | Lₐ₇₄₇ | L_{b2} | 2536 | Lₐ₈₂₄ | L_{b2} |
| 2537 | Lₐ₇₄₇ | L_{b4} | 2538 | Lₐ₈₂₄ | L_{b4} |
| 2539 | Lₐ₇₄₇ | L_{b5} | 2540 | Lₐ₈₂₄ | L_{b5} |
| 2541 | Lₐ₇₄₇ | L_{b10} | 2542 | Lₐ₈₂₄ | L_{b10} |
| 2543 | Lₐ₇₄₇ | L_{b11} | 2544 | Lₐ₈₂₄ | L_{b11} |
| 2545 | Lₐ₇₄₇ | L_{b12} | 2546 | Lₐ₈₂₄ | L_{b12} |
| 2547 | Lₐ₇₄₇ | L_{b13} | 2548 | Lₐ₈₂₄ | L_{b13} |
| 2549 | Lₐ₇₄₇ | L_{b14} | 2550 | Lₐ₈₂₄ | L_{b14} |
| 2551 | Lₐ₇₄₇ | L_{b15} | 2552 | Lₐ₈₂₄ | L_{b15} |
| 2553 | Lₐ₇₄₇ | L_{b17} | 2554 | Lₐ₈₂₄ | L_{b17} |
| 2555 | Lₐ₇₄₇ | L_{b19} | 2556 | Lₐ₈₂₄ | L_{b19} |
| 2557 | Lₐ₇₄₇ | L_{b21} | 2558 | Lₐ₈₂₄ | L_{b21} |
| 2559 | Lₐ₇₄₇ | L_{b22} | 2560 | Lₐ₈₂₄ | L_{b22} |
| 2561 | Lₐ₇₄₇ | L_{b23} | 2562 | Lₐ₈₂₄ | L_{b23} |
| 2563 | Lₐ₇₄₇ | L_{b24} | 2564 | Lₐ₈₂₄ | L_{b24} |
| 2565 | Lₐ₇₄₇ | L_{b25} | 2566 | Lₐ₈₂₄ | L_{b25} |
| 2567 | Lₐ₇₄₇ | L_{b26} | 2568 | Lₐ₈₂₄ | L_{b26} |
| 2569 | Lₐ₇₄₇ | L_{b27} | 2570 | Lₐ₈₂₄ | L_{b27} |
| 2571 | Lₐ₇₄₇ | L_{b28} | 2572 | Lₐ₈₂₄ | L_{b28} |
| 2573 | Lₐ₇₄₇ | L_{b29} | 2574 | Lₐ₈₂₄ | L_{b29} |
| 2575 | Lₐ₇₄₇ | L_{b30} | 2576 | Lₐ₈₂₄ | L_{b30} |
| 2577 | Lₐ₇₄₇ | L_{b31} | 2578 | Lₐ₈₂₄ | L_{b31} |
| 2579 | Lₐ₇₄₇ | L_{b32} | 2580 | Lₐ₈₂₄ | L_{b32} |
| 2581 | Lₐ₇₄₇ | L_{b33} | 2582 | Lₐ₈₂₄ | L_{b33} |
| 2583 | Lₐ₇₄₇ | L_{b42} | 2584 | Lₐ₈₂₄ | L_{b42} |
| 2585 | Lₐ₇₄₇ | L_{b43} | 2586 | Lₐ₈₂₄ | L_{b43} |
| 2587 | Lₐ₇₄₇ | L_{b44} | 2588 | Lₐ₈₂₄ | L_{b44} |
| 2589 | Lₐ₇₄₇ | L_{b45} | 2590 | Lₐ₈₂₄ | L_{b45} |
| 2591 | Lₐ₇₄₇ | L_{b46} | 2592 | Lₐ₈₂₄ | L_{b46} |
| 2593 | Lₐ₇₄₇ | L_{b50} | 2594 | Lₐ₈₂₄ | L_{b50} |
| 2595 | Lₐ₇₄₇ | L_{b51} | 2596 | Lₐ₈₂₄ | L_{b51} |
| 2597 | Lₐ₇₄₇ | L_{b53} | 2598 | Lₐ₈₂₄ | L_{b53} |
| 2599 | Lₐ₇₄₇ | L_{b54} | 2600 | Lₐ₈₂₄ | L_{b54} |
| 2601 | Lₐ₇₄₇ | L_{b55} | 2602 | Lₐ₈₂₄ | L_{b55} |
| 2603 | Lₐ₇₄₇ | L_{b56} | 2604 | Lₐ₈₂₄ | L_{b56} |
| 2605 | Lₐ₇₄₇ | L_{b57} | 2606 | Lₐ₈₂₄ | L_{b57} |
| 2607 | Lₐ₇₄₇ | L_{b58} | 2608 | Lₐ₈₂₄ | L_{b58} |
| 2609 | Lₐ₇₄₇ | L_{b59} | 2610 | Lₐ₈₂₄ | L_{b59} |
| 2611 | Lₐ₇₄₇ | L_{b66} | 2612 | Lₐ₈₂₄ | L_{b66} |
| 2613 | Lₐ₇₄₇ | L_{b68} | 2614 | Lₐ₈₂₄ | L_{b68} |
| 2615 | Lₐ₇₄₇ | L_{b70} | 2616 | Lₐ₈₂₄ | L_{b70} |
| 2617 | Lₐ₇₄₇ | L_{b75} | 2618 | Lₐ₈₂₄ | L_{b75} |
| 2619 | Lₐ₇₄₇ | L_{b76} | 2620 | Lₐ₈₂₄ | L_{b76} |
| 2621 | Lₐ₇₄₇ | L_{b87} | 2622 | Lₐ₈₂₄ | L_{b87} |
| 2623 | Lₐ₇₄₇ | L_{b95} | 2624 | Lₐ₈₂₄ | L_{b95} |
| 2625 | Lₐ₇₄₇ | L_{b96} | 2626 | Lₐ₈₂₄ | L_{b96} |
| 2627 | Lₐ₇₄₇ | L_{b97} | 2628 | Lₐ₈₂₄ | L_{b97} |
| 2629 | Lₐ₇₄₇ | L_{b98} | 2630 | Lₐ₈₂₄ | L_{b98} |
| 2631 | Lₐ₇₄₇ | L_{b109} | 2632 | Lₐ₈₂₄ | L_{b109} |
| 2633 | Lₐ₇₄₇ | L_{b110} | 2634 | Lₐ₈₂₄ | L_{b110} |
| 2635 | Lₐ₇₄₇ | L_{b111} | 2636 | Lₐ₈₂₄ | L_{b111} |
| 2637 | Lₐ₇₄₇ | L_{b112} | 2638 | Lₐ₈₂₄ | L_{b112} |
| 2639 | Lₐ₇₄₇ | L_{b114} | 2640 | Lₐ₈₂₄ | L_{b114} |
| 2641 | Lₐ₇₄₇ | L_{b117} | 2642 | Lₐ₈₂₄ | L_{b117} |
| 2643 | Lₐ₇₄₇ | L_{b122} | 2644 | Lₐ₈₂₄ | L_{b122} |
| 2645 | Lₐ₇₄₇ | L_{b123} | 2646 | Lₐ₈₂₄ | L_{b123} |
| 2647 | Lₐ₇₄₇ | L_{b129} | 2648 | Lₐ₈₂₄ | L_{b129} |
| 2649 | Lₐ₇₄₇ | L_{b130} | 2650 | Lₐ₈₂₄ | L_{b130} |
| 2651 | Lₐ₇₄₇ | L_{b131} | 2652 | Lₐ₈₂₄ | L_{b131} |
| 2653 | Lₐ₇₄₇ | L_{b133} | 2654 | Lₐ₈₂₄ | L_{b133} |
| 2655 | Lₐ₇₄₇ | L_{b134} | 2656 | Lₐ₈₂₄ | L_{b134} |
| 2657 | Lₐ₇₄₇ | L_{b135} | 2658 | Lₐ₈₂₄ | L_{b135} |
| 2659 | Lₐ₇₄₇ | L_{b148} | 2660 | Lₐ₈₂₄ | L_{b148} |
| 2661 | Lₐ₇₄₇ | L_{b149} | 2662 | Lₐ₈₂₄ | L_{b149} |
| 2663 | Lₐ₇₄₇ | L_{b150} | 2664 | Lₐ₈₂₄ | L_{b150} |
| 2665 | Lₐ₇₄₇ | L_{b151} | 2666 | Lₐ₈₂₄ | L_{b151} |
| 2667 | Lₐ₉₅₃ | L_{b2} | 2668 | Lₐ₁₀₂₄ | L_{b2} |
| 2669 | Lₐ₉₅₃ | L_{b4} | 2670 | Lₐ₁₀₂₄ | L_{b4} |
| 2671 | Lₐ₉₅₃ | L_{b5} | 2672 | Lₐ₁₀₂₄ | L_{b5} |
| 2673 | Lₐ₉₅₃ | L_{b10} | 2674 | Lₐ₁₀₂₄ | L_{b10} |
| 2675 | Lₐ₉₅₃ | L_{b11} | 2676 | Lₐ₁₀₂₄ | L_{b11} |
| 2677 | Lₐ₉₅₃ | L_{b12} | 2678 | Lₐ₁₀₂₄ | L_{b12} |
| 2679 | Lₐ₉₅₃ | L_{b13} | 2680 | Lₐ₁₀₂₄ | L_{b13} |
| 2681 | Lₐ₉₅₃ | L_{b14} | 2682 | Lₐ₁₀₂₄ | L_{b14} |
| 2683 | Lₐ₉₅₃ | L_{b15} | 2684 | Lₐ₁₀₂₄ | L_{b15} |
| 2685 | Lₐ₉₅₃ | L_{b17} | 2686 | Lₐ₁₀₂₄ | L_{b17} |
| 2687 | Lₐ₉₅₃ | L_{b19} | 2688 | Lₐ₁₀₂₄ | L_{b19} |
| 2689 | Lₐ₉₅₃ | L_{b21} | 2690 | Lₐ₁₀₂₄ | L_{b21} |
| 2691 | Lₐ₉₅₃ | L_{b22} | 2692 | Lₐ₁₀₂₄ | L_{b22} |
| 2693 | Lₐ₉₅₃ | L_{b23} | 2694 | Lₐ₁₀₂₄ | L_{b23} |
| 2695 | Lₐ₉₅₃ | L_{b24} | 2696 | Lₐ₁₀₂₄ | L_{b24} |
| 2697 | Lₐ₉₅₃ | L_{b25} | 2698 | Lₐ₁₀₂₄ | L_{b25} |
| 2699 | Lₐ₉₅₃ | L_{b26} | 2700 | Lₐ₁₀₂₄ | L_{b26} |
| 2701 | Lₐ₉₅₃ | L_{b27} | 2702 | Lₐ₁₀₂₄ | L_{b27} |
| 2703 | Lₐ₉₅₃ | L_{b28} | 2704 | Lₐ₁₀₂₄ | L_{b28} |
| 2705 | Lₐ₉₅₃ | L_{b29} | 2706 | Lₐ₁₀₂₄ | L_{b29} |
| 2707 | Lₐ₉₅₃ | L_{b30} | 2708 | Lₐ₁₀₂₄ | L_{b30} |
| 2709 | Lₐ₉₅₃ | L_{b31} | 2710 | Lₐ₁₀₂₄ | L_{b31} |
| 2711 | Lₐ₉₅₃ | L_{b32} | 2712 | Lₐ₁₀₂₄ | L_{b32} |
| 2713 | Lₐ₉₅₃ | L_{b33} | 2714 | Lₐ₁₀₂₄ | L_{b33} |
| 2715 | Lₐ₉₅₃ | L_{b42} | 2716 | Lₐ₁₀₂₄ | L_{b42} |
| 2717 | Lₐ₉₅₃ | L_{b43} | 2718 | Lₐ₁₀₂₄ | L_{b43} |
| 2719 | Lₐ₉₅₃ | L_{b44} | 2720 | Lₐ₁₀₂₄ | L_{b44} |
| 2721 | Lₐ₉₅₃ | L_{b45} | 2722 | Lₐ₁₀₂₄ | L_{b45} |
| 2723 | Lₐ₉₅₃ | L_{b46} | 2724 | Lₐ₁₀₂₄ | L_{b46} |
| 2725 | Lₐ₉₅₃ | L_{b50} | 2726 | Lₐ₁₀₂₄ | L_{b50} |
| 2727 | Lₐ₉₅₃ | L_{b51} | 2728 | Lₐ₁₀₂₄ | L_{b51} |
| 2729 | Lₐ₉₅₃ | L_{b53} | 2730 | Lₐ₁₀₂₄ | L_{b53} |
| 2731 | Lₐ₉₅₃ | L_{b54} | 2732 | Lₐ₁₀₂₄ | L_{b54} |
| 2733 | Lₐ₉₅₃ | L_{b55} | 2734 | Lₐ₁₀₂₄ | L_{b55} |
| 2735 | Lₐ₉₅₃ | L_{b56} | 2736 | Lₐ₁₀₂₄ | L_{b56} |
| 2737 | Lₐ₉₅₃ | L_{b57} | 2738 | Lₐ₁₀₂₄ | L_{b57} |
| 2739 | Lₐ₉₅₃ | L_{b58} | 2740 | Lₐ₁₀₂₄ | L_{b58} |
| 2741 | Lₐ₉₅₃ | L_{b59} | 2742 | Lₐ₁₀₂₄ | L_{b59} |
| 2743 | Lₐ₉₅₃ | L_{b66} | 2744 | Lₐ₁₀₂₄ | L_{b66} |
| 2745 | Lₐ₉₅₃ | L_{b68} | 2746 | Lₐ₁₀₂₄ | L_{b68} |
| 2747 | Lₐ₉₅₃ | L_{b70} | 2748 | Lₐ₁₀₂₄ | L_{b70} |
| 2749 | Lₐ₉₅₃ | L_{b75} | 2750 | Lₐ₁₀₂₄ | L_{b75} |
| 2751 | Lₐ₉₅₃ | L_{b76} | 2752 | Lₐ₁₀₂₄ | L_{b76} |
| 2753 | Lₐ₉₅₃ | L_{b87} | 2754 | Lₐ₁₀₂₄ | L_{b87} |
| 2755 | Lₐ₉₅₃ | L_{b95} | 2756 | Lₐ₁₀₂₄ | L_{b95} |
| 2757 | Lₐ₉₅₃ | L_{b96} | 2758 | Lₐ₁₀₂₄ | L_{b96} |
| 2759 | Lₐ₉₅₃ | L_{b97} | 2760 | Lₐ₁₀₂₄ | L_{b97} |
| 2761 | Lₐ₉₅₃ | L_{b98} | 2762 | Lₐ₁₀₂₄ | L_{b98} |
| 2763 | Lₐ₉₅₃ | L_{b109} | 2764 | Lₐ₁₀₂₄ | L_{b109} |
| 2765 | Lₐ₉₅₃ | L_{b110} | 2766 | Lₐ₁₀₂₄ | L_{b110} |
| 2767 | Lₐ₉₅₃ | L_{b111} | 2768 | Lₐ₁₀₂₄ | L_{b111} |
| 2769 | Lₐ₉₅₃ | L_{b112} | 2770 | Lₐ₁₀₂₄ | L_{b112} |
| 2771 | Lₐ₉₅₃ | L_{b114} | 2772 | Lₐ₁₀₂₄ | L_{b114} |
| 2773 | Lₐ₉₅₃ | L_{b117} | 2774 | Lₐ₁₀₂₄ | L_{b117} |
| 2775 | Lₐ₉₅₃ | L_{b122} | 2776 | Lₐ₁₀₂₄ | L_{b122} |
| 2777 | Lₐ₉₅₃ | L_{b123} | 2778 | Lₐ₁₀₂₄ | L_{b123} |
| 2779 | Lₐ₉₅₃ | L_{b129} | 2780 | Lₐ₁₀₂₄ | L_{b129} |
| 2781 | Lₐ₉₅₃ | L_{b130} | 2782 | Lₐ₁₀₂₄ | L_{b130} |
| 2783 | Lₐ₉₅₃ | L_{b131} | 2784 | Lₐ₁₀₂₄ | L_{b131} |
| 2785 | Lₐ₉₅₃ | L_{b133} | 2786 | Lₐ₁₀₂₄ | L_{b133} |
| 2787 | Lₐ₉₅₃ | L_{b134} | 2788 | Lₐ₁₀₂₄ | L_{b134} |
| 2789 | Lₐ₉₅₃ | L_{b135} | 2790 | Lₐ₁₀₂₄ | L_{b135} |
| 2791 | Lₐ₉₅₃ | L_{b148} | 2792 | Lₐ₁₀₂₄ | L_{b148} |
| 2793 | Lₐ₉₅₃ | L_{b149} | 2794 | Lₐ₁₀₂₄ | L_{b149} |
| 2795 | Lₐ₉₅₃ | L_{b150} | 2796 | Lₐ₁₀₂₄ | L_{b150} |
| 2797 | Lₐ₉₅₃ | L_{b151} | 2798 | Lₐ₁₀₂₄ | L_{b151} |
| 2799 | Lₐ₁₀₉₅ | L_{b2} | 2800 | Lₐ₁₁₆₆ | L_{b2} |
| 2801 | Lₐ₁₀₉₅ | L_{b4} | 2802 | Lₐ₁₁₆₆ | L_{b4} |
| 2803 | Lₐ₁₀₉₅ | L_{b5} | 2804 | Lₐ₁₁₆₆ | L_{b5} |
| 2805 | Lₐ₁₀₉₅ | L_{b10} | 2806 | Lₐ₁₁₆₆ | L_{b10} |
| 2807 | Lₐ₁₀₉₅ | L_{b11} | 2808 | Lₐ₁₁₆₆ | L_{b11} |
| 2809 | Lₐ₁₀₉₅ | L_{b12} | 2810 | Lₐ₁₁₆₆ | L_{b12} |
| 2811 | Lₐ₁₀₉₅ | L_{b13} | 2812 | Lₐ₁₁₆₆ | L_{b13} |
| 2813 | Lₐ₁₀₉₅ | L_{b14} | 2814 | Lₐ₁₁₆₆ | L_{b14} |
| 2815 | Lₐ₁₀₉₅ | L_{b15} | 2816 | Lₐ₁₁₆₆ | L_{b15} |
| 2817 | Lₐ₁₀₉₅ | L_{b17} | 2818 | Lₐ₁₁₆₆ | L_{b17} |
| 2819 | Lₐ₁₀₉₅ | L_{b19} | 2820 | Lₐ₁₁₆₆ | L_{b19} |
| 2821 | Lₐ₁₀₉₅ | L_{b21} | 2822 | Lₐ₁₁₆₆ | L_{b21} |
| 2823 | Lₐ₁₀₉₅ | L_{b22} | 2824 | Lₐ₁₁₆₆ | L_{b22} |
| 2825 | Lₐ₁₀₉₅ | L_{b23} | 2826 | Lₐ₁₁₆₆ | L_{b23} |
| 2827 | Lₐ₁₀₉₅ | L_{b24} | 2828 | Lₐ₁₁₆₆ | L_{b24} |
| 2829 | Lₐ₁₀₉₅ | L_{b25} | 2830 | Lₐ₁₁₆₆ | L_{b25} |
| 2831 | Lₐ₁₀₉₅ | L_{b26} | 2832 | Lₐ₁₁₆₆ | L_{b26} |
| 2833 | Lₐ₁₀₉₅ | L_{b27} | 2834 | Lₐ₁₁₆₆ | L_{b27} |
| 2835 | Lₐ₁₀₉₅ | L_{b28} | 2836 | Lₐ₁₁₆₆ | L_{b28} |
| 2837 | Lₐ₁₀₉₅ | L_{b29} | 2838 | Lₐ₁₁₆₆ | L_{b29} |
| 2839 | Lₐ₁₀₉₅ | L_{b30} | 2840 | Lₐ₁₁₆₆ | L_{b30} |
| 2841 | Lₐ₁₀₉₅ | L_{b31} | 2842 | Lₐ₁₁₆₆ | L_{b31} |
| 2843 | Lₐ₁₀₉₅ | L_{b32} | 2844 | Lₐ₁₁₆₆ | L_{b32} |
| 2845 | Lₐ₁₀₉₅ | L_{b33} | 2846 | Lₐ₁₁₆₆ | L_{b33} |
| 2847 | Lₐ₁₀₉₅ | L_{b42} | 2848 | Lₐ₁₁₆₆ | L_{b42} |
| 2849 | Lₐ₁₀₉₅ | L_{b43} | 2850 | Lₐ₁₁₆₆ | L_{b43} |
| 2851 | Lₐ₁₀₉₅ | L_{b44} | 2852 | Lₐ₁₁₆₆ | L_{b44} |
| 2853 | Lₐ₁₀₉₅ | L_{b45} | 2854 | Lₐ₁₁₆₆ | L_{b45} |
| 2855 | Lₐ₁₀₉₅ | L_{b46} | 2856 | Lₐ₁₁₆₆ | L_{b46} |
| 2857 | Lₐ₁₀₉₅ | L_{b50} | 2858 | Lₐ₁₁₆₆ | L_{b50} |
| 2859 | Lₐ₁₀₉₅ | L_{b51} | 2860 | Lₐ₁₁₆₆ | L_{b51} |
| 2861 | Lₐ₁₀₉₅ | L_{b53} | 2862 | Lₐ₁₁₆₆ | L_{b53} |
| 2863 | Lₐ₁₀₉₅ | L_{b54} | 2864 | Lₐ₁₁₆₆ | L_{b54} |
| 2865 | Lₐ₁₀₉₅ | L_{b55} | 2866 | Lₐ₁₁₆₆ | L_{b55} |
| 2867 | Lₐ₁₀₉₅ | L_{b56} | 2868 | Lₐ₁₁₆₆ | L_{b56} |
| 2869 | Lₐ₁₀₉₅ | L_{b57} | 2870 | Lₐ₁₁₆₆ | L_{b57} |
| 2871 | Lₐ₁₀₉₅ | L_{b58} | 2872 | Lₐ₁₁₆₆ | L_{b58} |
| 2873 | Lₐ₁₀₉₅ | L_{b59} | 2874 | Lₐ₁₁₆₆ | L_{b59} |
| 2875 | Lₐ₁₀₉₅ | L_{b66} | 2876 | Lₐ₁₁₆₆ | L_{b66} |
| 2877 | Lₐ₁₀₉₅ | L_{b68} | 2878 | Lₐ₁₁₆₆ | L_{b68} |
| 2879 | Lₐ₁₀₉₅ | L_{b70} | 2880 | Lₐ₁₁₆₆ | L_{b70} |
| 2881 | Lₐ₁₀₉₅ | L_{b75} | 2882 | Lₐ₁₁₆₆ | L_{b75} |
| 2883 | Lₐ₁₀₉₅ | L_{b76} | 2884 | Lₐ₁₁₆₆ | L_{b76} |
| 2885 | Lₐ₁₀₉₅ | L_{b87} | 2886 | Lₐ₁₁₆₆ | L_{b87} |
| 2887 | Lₐ₁₀₉₅ | L_{b95} | 2888 | Lₐ₁₁₆₆ | L_{b95} |
| 2889 | Lₐ₁₀₉₅ | L_{b96} | 2890 | Lₐ₁₁₆₆ | L_{b96} |
| 2891 | Lₐ₁₀₉₅ | L_{b97} | 2892 | Lₐ₁₁₆₆ | L_{b97} |
| 2893 | Lₐ₁₀₉₅ | L_{b98} | 2894 | Lₐ₁₁₆₆ | L_{b98} |
| 2895 | Lₐ₁₀₉₅ | L_{b109} | 2896 | Lₐ₁₁₆₆ | L_{b109} |
| 2897 | Lₐ₁₀₉₅ | L_{b110} | 2898 | Lₐ₁₁₆₆ | L_{b110} |
| 2899 | Lₐ₁₀₉₅ | L_{b111} | 2900 | Lₐ₁₁₆₆ | L_{b111} |
| 2901 | Lₐ₁₀₉₅ | L_{b112} | 2902 | Lₐ₁₁₆₆ | L_{b112} |
| 2903 | Lₐ₁₀₉₅ | L_{b114} | 2904 | Lₐ₁₁₆₆ | L_{b114} |
| 2905 | Lₐ₁₀₉₅ | L_{b117} | 2906 | Lₐ₁₁₆₆ | L_{b117} |
| 2907 | Lₐ₁₀₉₅ | L_{b122} | 2908 | Lₐ₁₁₆₆ | L_{b122} |
| 2909 | Lₐ₁₀₉₅ | L_{b123} | 2910 | Lₐ₁₁₆₆ | L_{b123} |
| 2911 | Lₐ₁₀₉₅ | L_{b129} | 2912 | Lₐ₁₁₆₆ | L_{b129} |
| 2913 | Lₐ₁₀₉₅ | L_{b130} | 2914 | Lₐ₁₁₆₆ | L_{b130} |
| 2915 | Lₐ₁₀₉₅ | L_{b131} | 2916 | Lₐ₁₁₆₆ | L_{b131} |
| 2917 | Lₐ₁₀₉₅ | L_{b133} | 2918 | Lₐ₁₁₆₆ | L_{b133} |
| 2919 | Lₐ₁₀₉₅ | L_{b134} | 2920 | Lₐ₁₁₆₆ | L_{b134} |
| 2921 | Lₐ₁₀₉₅ | L_{b135} | 2922 | Lₐ₁₁₆₆ | L_{b135} |
| 2923 | Lₐ₁₀₉₅ | L_{b148} | 2924 | Lₐ₁₁₆₆ | L_{b148} |
| 2925 | Lₐ₁₀₉₅ | L_{b149} | 2926 | Lₐ₁₁₆₆ | L_{b149} |
| 2927 | Lₐ₁₀₉₅ | L_{b150} | 2928 | Lₐ₁₁₆₆ | L_{b150} |
| 2929 | Lₐ₁₀₉₅ | L_{b151} | 2930 | Lₐ₁₁₆₆ | L_{b151} |
| 2931 | Lₐ₁₂₃₇ | L_{b2} | 2932 | Lₐ₁₅₆₉ | L_{b2} |
| 2933 | Lₐ₁₂₃₇ | L_{b4} | 2934 | Lₐ₁₅₆₉ | L_{b4} |
| 2935 | Lₐ₁₂₃₇ | L_{b5} | 2936 | Lₐ₁₅₆₉ | L_{b5} |
| 2937 | Lₐ₁₂₃₇ | L_{b10} | 2938 | Lₐ₁₅₆₉ | L_{b10} |
| 2939 | Lₐ₁₂₃₇ | L_{b11} | 2940 | Lₐ₁₅₆₉ | L_{b11} |
| 2941 | Lₐ₁₂₃₇ | L_{b12} | 2942 | Lₐ₁₅₆₉ | L_{b12} |
| 2943 | Lₐ₁₂₃₇ | L_{b13} | 2944 | Lₐ₁₅₆₉ | L_{b13} |
| 2945 | Lₐ₁₂₃₇ | L_{b14} | 2946 | Lₐ₁₅₆₉ | L_{b14} |
| 2947 | Lₐ₁₂₃₇ | L_{b15} | 2948 | Lₐ₁₅₆₉ | L_{b15} |
| 2949 | Lₐ₁₂₃₇ | L_{b17} | 2950 | Lₐ₁₅₆₉ | L_{b17} |
| 2951 | Lₐ₁₂₃₇ | L_{b19} | 2952 | Lₐ₁₅₆₉ | L_{b19} |
| 2953 | Lₐ₁₂₃₇ | L_{b21} | 2954 | Lₐ₁₅₆₉ | L_{b21} |
| 2955 | Lₐ₁₂₃₇ | L_{b22} | 2956 | Lₐ₁₅₆₉ | L_{b22} |
| 2957 | Lₐ₁₂₃₇ | L_{b23} | 2958 | Lₐ₁₅₆₉ | L_{b23} |
| 2959 | Lₐ₁₂₃₇ | L_{b24} | 2960 | Lₐ₁₅₆₉ | L_{b24} |
| 2961 | Lₐ₁₂₃₇ | L_{b25} | 2962 | Lₐ₁₅₆₉ | L_{b25} |
| 2963 | Lₐ₁₂₃₇ | L_{b26} | 2964 | Lₐ₁₅₆₉ | L_{b26} |
| 2965 | Lₐ₁₂₃₇ | L_{b27} | 2966 | Lₐ₁₅₆₉ | L_{b27} |
| 2967 | Lₐ₁₂₃₇ | L_{b28} | 2968 | Lₐ₁₅₆₉ | L_{b28} |
| 2969 | Lₐ₁₂₃₇ | L_{b29} | 2970 | Lₐ₁₅₆₉ | L_{b29} |
| 2971 | Lₐ₁₂₃₇ | L_{b30} | 2972 | Lₐ₁₅₆₉ | L_{b30} |
| 2973 | Lₐ₁₂₃₇ | L_{b31} | 2974 | Lₐ₁₅₆₉ | L_{b31} |
| 2975 | Lₐ₁₂₃₇ | L_{b32} | 2976 | Lₐ₁₅₆₉ | L_{b32} |
| 2977 | Lₐ₁₂₃₇ | L_{b33} | 2978 | Lₐ₁₅₆₉ | L_{b33} |
| 2979 | Lₐ₁₂₃₇ | L_{b42} | 2980 | Lₐ₁₅₆₉ | L_{b42} |
| 2981 | Lₐ₁₂₃₇ | L_{b43} | 2982 | Lₐ₁₅₆₉ | L_{b43} |
| 2983 | Lₐ₁₂₃₇ | L_{b44} | 2984 | Lₐ₁₅₆₉ | L_{b44} |
| 2985 | Lₐ₁₂₃₇ | L_{b45} | 2986 | Lₐ₁₅₆₉ | _{Lb45} |
| 2987 | Lₐ₁₂₃₇ | L_{b46} | 2988 | Lₐ₁₅₆₉ | L_{b46} |
| 2989 | Lₐ₁₂₃₇ | L_{b50} | 2990 | Lₐ₁₅₆₉ | L_{b50} |
| 2991 | Lₐ₁₂₃₇ | L_{b51} | 2992 | Lₐ₁₅₆₉ | L_{b51} |
| 2993 | Lₐ₁₂₃₇ | L_{b53} | 2994 | Lₐ₁₅₆₉ | L_{b53} |
| 2995 | Lₐ₁₂₃₇ | L_{b54} | 2996 | Lₐ₁₅₆₉ | L_{b54} |
| 2997 | Lₐ₁₂₃₇ | L_{b55} | 2998 | Lₐ₁₅₆₉ | L_{b55} |
| 2999 | Lₐ₁₂₃₇ | L_{b56} | 3000 | Lₐ₁₅₆₉ | L_{b56} |
| 3001 | Lₐ₁₂₃₇ | L_{b57} | 3002 | Lₐ₁₅₆₉ | L_{b57} |
| 3003 | Lₐ₁₂₃₇ | L_{b58} | 3004 | Lₐ₁₅₆₉ | L_{b58} |
| 3005 | Lₐ₁₂₃₇ | L_{b59} | 3006 | Lₐ₁₅₆₉ | L_{b59} |
| 3007 | Lₐ₁₂₃₇ | L_{b66} | 3008 | Lₐ₁₅₆₉ | L_{b66} |
| 3009 | Lₐ₁₂₃₇ | L_{b68} | 3010 | Lₐ₁₅₆₉ | L_{b68} |
| 3011 | Lₐ₁₂₃₇ | L_{b70} | 3012 | Lₐ₁₅₆₉ | L_{b70} |
| 3013 | Lₐ₁₂₃₇ | L_{b75} | 3014 | Lₐ₁₅₆₉ | L_{b75} |
| 3015 | Lₐ₁₂₃₇ | L_{b76} | 3016 | Lₐ₁₅₆₉ | L_{b76} |
| 3017 | Lₐ₁₂₃₇ | L_{b87} | 3018 | Lₐ₁₅₆₉ | L_{b87} |
| 3019 | Lₐ₁₂₃₇ | L_{b95} | 3020 | Lₐ₁₅₆₉ | L_{b95} |
| 3021 | Lₐ₁₂₃₇ | L_{b96} | 3022 | Lₐ₁₅₆₉ | L_{b96} |
| 3023 | Lₐ₁₂₃₇ | L_{b97} | 3024 | Lₐ₁₅₆₉ | L_{b97} |
| 3025 | Lₐ₁₂₃₇ | L_{b98} | 3026 | Lₐ₁₅₆₉ | L_{b98} |
| 3027 | Lₐ₁₂₃₇ | L_{b109} | 3028 | Lₐ₁₅₆₉ | L_{b109} |
| 3029 | Lₐ₁₂₃₇ | L_{b110} | 3030 | Lₐ₁₅₆₉ | L_{b110} |
| 3031 | Lₐ₁₂₃₇ | L_{b111} | 3032 | Lₐ₁₅₆₉ | L_{b111} |
| 3033 | Lₐ₁₂₃₇ | L_{b112} | 3034 | Lₐ₁₅₆₉ | L_{b112} |
| 3035 | Lₐ₁₂₃₇ | L_{b114} | 3036 | Lₐ₁₅₆₉ | L_{b114} |
| 3037 | Lₐ₁₂₃₇ | L_{b117} | 3038 | Lₐ₁₅₆₉ | L_{b117} |
| 3039 | Lₐ₁₂₃₇ | L_{b122} | 3040 | Lₐ₁₅₆₉ | L_{b122} |
| 3041 | Lₐ₁₂₃₇ | L_{b123} | 3042 | Lₐ₁₅₆₉ | L_{b123} |
| 3043 | Lₐ₁₂₃₇ | L_{b129} | 3044 | Lₐ₁₅₆₉ | L_{b129} |
| 3045 | Lₐ₁₂₃₇ | L_{b130} | 3046 | Lₐ₁₅₆₉ | L_{b130} |
| 3047 | Lₐ₁₂₃₇ | L_{b131} | 3048 | Lₐ₁₅₆₉ | L_{b131} |
| 3049 | Lₐ₁₂₃₇ | L_{b133} | 3050 | Lₐ₁₅₆₉ | L_{b133} |
| 3051 | Lₐ₁₂₃₇ | L_{b134} | 3052 | Lₐ₁₅₆₉ | L_{b134} |
| 3053 | Lₐ₁₂₃₇ | L_{b135} | 3054 | Lₐ₁₅₆₉ | L_{b135} |
| 3055 | Lₐ₁₂₃₇ | L_{b148} | 3056 | Lₐ₁₅₆₉ | L_{b148} |
| 3057 | Lₐ₁₂₃₇ | L_{b149} | 3058 | Lₐ₁₅₆₉ | L_{b149} |
| 3059 | Lₐ₁₂₃₇ | L_{b150} | 3060 | Lₐ₁₅₆₉ | L_{b150} |
| 3061 | Lₐ₁₂₃₇ | L_{b151} | 3062 | Lₐ₁₅₆₉ | L_{b151} |
| 3063 | Lₐ₁₅₇₀ | L_{b2} | 3064 | Lₐ₁₈₉₁ | L_{b2} |
| 3065 | Lₐ₁₅₇₀ | L_{b4} | 3066 | Lₐ₁₈₉₁ | Lb4 |
| 3067 | Lₐ₁₅₇₀ | L_{b5} | 3068 | Lₐ₁₈₉₁ | L_{b5} |
| 3069 | Lₐ₁₅₇₀ | L_{b10} | 3070 | Lₐ₁₈₉₁ | L_{b10} |
| 3071 | Lₐ₁₅₇₀ | L_{b11} | 3072 | Lₐ₁₈₉₁ | L_{b11} |
| 3073 | Lₐ₁₅₇₀ | L_{b12} | 3074 | Lₐ₁₈₉₁ | L_{b12} |
| 3075 | Lₐ₁₅₇₀ | L_{b13} | 3076 | Lₐ₁₈₉₁ | L_{b13} |
| 3077 | Lₐ₁₅₇₀ | L_{b14} | 3078 | Lₐ₁₈₉₁ | L_{b14} |
| 3079 | Lₐ₁₅₇₀ | L_{b15} | 3080 | Lₐ₁₈₉₁ | L_{b15} |
| 3081 | Lₐ₁₅₇₀ | L_{b17} | 3082 | Lₐ₁₈₉₁ | L_{b17} |
| 3083 | Lₐ₁₅₇₀ | L_{b19} | 3084 | Lₐ₁₈₉₁ | L_{b19} |
| 3085 | Lₐ₁₅₇₀ | L_{b21} | 3086 | Lₐ₁₈₉₁ | L_{b21} |
| 3087 | Lₐ₁₅₇₀ | L_{b22} | 3088 | Lₐ₁₈₉₁ | L_{b22} |
| 3089 | Lₐ₁₅₇₀ | L_{b23} | 3090 | Lₐ₁₈₉₁ | L_{b23} |
| 3091 | Lₐ₁₅₇₀ | L_{b24} | 3092 | Lₐ₁₈₉₁ | L_{b24} |
| 3093 | Lₐ₁₅₇₀ | L_{b25} | 3094 | Lₐ₁₈₉₁ | L_{b25} |
| 3095 | Lₐ₁₅₇₀ | L_{b26} | 3096 | Lₐ₁₈₉₁ | L_{b26} |
| 3097 | Lₐ₁₅₇₀ | L_{b27} | 3098 | Lₐ₁₈₉₁ | L_{b27} |
| 3099 | Lₐ₁₅₇₀ | L_{b28} | 3100 | Lₐ₁₈₉₁ | L_{b28} |
| 3101 | Lₐ₁₅₇₀ | L_{b29} | 3102 | Lₐ₁₈₉₁ | L_{b29} |
| 3103 | Lₐ₁₅₇₀ | L_{b30} | 3104 | Lₐ₁₈₉₁ | L_{b30} |
| 3105 | Lₐ₁₅₇₀ | L_{b31} | 3106 | Lₐ₁₈₉₁ | L_{b31} |
| 3107 | Lₐ₁₅₇₀ | L_{b32} | 3108 | Lₐ₁₈₉₁ | L_{b32} |
| 3109 | Lₐ₁₅₇₀ | L_{b33} | 3110 | Lₐ₁₈₉₁ | L_{b33} |
| 3111 | Lₐ₁₅₇₀ | L_{b42} | 3112 | Lₐ₁₈₉₁ | L_{b42} |
| 3113 | Lₐ₁₅₇₀ | L_{b43} | 3114 | Lₐ₁₈₉₁ | L_{b43} |
| 3115 | Lₐ₁₅₇₀ | L_{b44} | 3116 | Lₐ₁₈₉₁ | L_{b44} |
| 3117 | Lₐ₁₅₇₀ | L_{b45} | 3118 | Lₐ₁₈₉₁ | L_{b45} |
| 3119 | Lₐ₁₅₇₀ | L_{b46} | 3120 | Lₐ₁₈₉₁ | L_{b46} |
| 3121 | Lₐ₁₅₇₀ | L_{b50} | 3122 | Lₐ₁₈₉₁ | L_{b50} |
| 3123 | Lₐ₁₅₇₀ | L_{b51} | 3124 | Lₐ₁₈₉₁ | L_{b51} |
| 3125 | Lₐ₁₅₇₀ | L_{b53} | 3126 | Lₐ₁₈₉₁ | L_{b53} |
| 3127 | Lₐ₁₅₇₀ | L_{b54} | 3128 | Lₐ₁₈₉₁ | L_{b54} |
| 3129 | Lₐ₁₅₇₀ | L_{b55} | 3130 | Lₐ₁₈₉₁ | L_{b55} |
| 3131 | Lₐ₁₅₇₀ | L_{b56} | 3132 | Lₐ₁₈₉₁ | L_{b56} |
| 3133 | Lₐ₁₅₇₀ | L_{b57} | 3134 | Lₐ₁₈₉₁ | L_{b57} |
| 3135 | Lₐ₁₅₇₀ | L_{b58} | 3136 | Lₐ₁₈₉₁ | L_{b58} |
| 3137 | Lₐ₁₅₇₀ | L_{b59} | 3138 | Lₐ₁₈₉₁ | L_{b59} |
| 3139 | Lₐ₁₅₇₀ | L_{b66} | 3140 | Lₐ₁₈₉₁ | L_{b66} |
| 3141 | Lₐ₁₅₇₀ | L_{b68} | 3142 | Lₐ₁₈₉₁ | L_{b68} |
| 3143 | Lₐ₁₅₇₀ | L_{b70} | 3144 | Lₐ₁₈₉₁ | L_{b70} |
| 3145 | Lₐ₁₅₇₀ | L_{b75} | 3146 | Lₐ₁₈₉₁ | L_{b75} |
| 3147 | Lₐ₁₅₇₀ | L_{b76} | 3148 | Lₐ₁₈₉₁ | L_{b76} |
| 3149 | Lₐ₁₅₇₀ | L_{b87} | 3150 | Lₐ₁₈₉₁ | L_{b87} |
| 3151 | Lₐ₁₅₇₀ | L_{b95} | 3152 | Lₐ₁₈₉₁ | L_{b95} |
| 3153 | Lₐ₁₅₇₀ | L_{b96} | 3154 | Lₐ₁₈₉₁ | L_{b96} |
| 3155 | Lₐ₁₅₇₀ | L_{b97} | 3156 | Lₐ₁₈₉₁ | L_{b97} |
| 3157 | Lₐ₁₅₇₀ | L_{b98} | 3158 | Lₐ₁₈₉₁ | L_{b98} |
| 3159 | Lₐ₁₅₇₀ | L_{b109} | 3160 | Lₐ₁₈₉₁ | L_{b109} |
| 3161 | Lₐ₁₅₇₀ | L_{b110} | 3162 | Lₐ₁₈₉₁ | L_{b110} |
| 3163 | Lₐ₁₅₇₀ | L_{b111} | 3164 | Lₐ₁₈₉₁ | L_{b111} |
| 3165 | Lₐ₁₅₇₀ | L_{b112} | 3166 | Lₐ₁₈₉₁ | L_{b112} |
| 3167 | Lₐ₁₅₇₀ | L_{b114} | 3168 | Lₐ₁₈₉₁ | L_{b114} |
| 3169 | Lₐ₁₅₇₀ | L_{b117} | 3170 | Lₐ₁₈₉₁ | L_{b117} |
| 3171 | Lₐ₁₅₇₀ | L_{b122} | 3172 | Lₐ₁₈₉₁ | L_{b122} |
| 3173 | Lₐ₁₅₇₀ | L_{b123} | 3174 | Lₐ₁₈₉₁ | L_{b123} |
| 3175 | Lₐ₁₅₇₀ | L_{b129} | 3176 | Lₐ₁₈₉₁ | L_{b129} |
| 3177 | Lₐ₁₅₇₀ | L_{b130} | 3178 | Lₐ₁₈₉₁ | L_{b130} |
| 3179 | Lₐ₁₅₇₀ | L_{b131} | 3180 | Lₐ₁₈₉₁ | L_{b131} |
| 3181 | Lₐ₁₅₇₀ | L_{b133} | 3182 | Lₐ₁₈₉₁ | L_{b133} |
| 3183 | Lₐ₁₅₇₀ | L_{b134} | 3184 | Lₐ₁₈₉₁ | L_{b134} |
| 3185 | Lₐ₁₅₇₀ | L_{b135} | 3186 | Lₐ₁₈₉₁ | L_{b135} |
| 3187 | Lₐ₁₅₇₀ | L_{b148} | 3188 | Lₐ₁₈₉₁ | L_{b148} |
| 3189 | Lₐ₁₅₇₀ | L_{b149} | 3190 | Lₐ₁₈₉₁ | L_{b149} |
| 3191 | Lₐ₁₅₇₀ | L_{b150} | 3192 | Lₐ₁₈₉₁ | L_{b150} |
| 3193 | Lₐ₁₅₇₀ | L_{b151} | 3194 | Lₐ₁₈₉₁ | L_{b151} |
| 3195 | Lₐ₁₉₆₂ | L_{b2} | 3196 | Lₐ₂₇₈₅ | L_{b2} |
| 3197 | Lₐ₁₉₆₂ | L_{b4} | 3198 | Lₐ₂₇₈₅ | L_{b4} |
| 3199 | Lₐ₁₉₆₂ | L_{b5} | 3200 | Lₐ₂₇₈₅ | L_{b5} |
| 3201 | Lₐ₁₉₆₂ | L_{b10} | 3202 | Lₐ₂₇₈₅ | L_{b10} |
| 3203 | Lₐ₁₉₆₂ | L_{b11} | 3204 | Lₐ₂₇₈₅ | L_{b11} |
| 3205 | Lₐ₁₉₆₂ | L_{b12} | 3206 | Lₐ₂₇₈₅ | L_{b12} |
| 3207 | Lₐ₁₉₆₂ | L_{b13} | 3208 | Lₐ₂₇₈₅ | L_{b13} |
| 3209 | Lₐ₁₉₆₂ | L_{b14} | 3210 | Lₐ₂₇₈₅ | L_{b14} |
| 3211 | Lₐ₁₉₆₂ | L_{b15} | 3212 | Lₐ₂₇₈₅ | L_{b15} |
| 3213 | Lₐ₁₉₆₂ | L_{b17} | 3214 | Lₐ₂₇₈₅ | L_{b17} |
| 3215 | Lₐ₁₉₆₂ | L_{b19} | 3216 | Lₐ₂₇₈₅ | L_{b19} |
| 3217 | Lₐ₁₉₆₂ | L_{b21} | 3218 | Lₐ₂₇₈₅ | L_{b21} |
| 3219 | Lₐ₁₉₆₂ | L_{b22} | 3220 | Lₐ₂₇₈₅ | L_{b22} |
| 3221 | Lₐ₁₉₆₂ | L_{b23} | 3222 | Lₐ₂₇₈₅ | L_{b23} |
| 3223 | Lₐ₁₉₆₂ | L_{b24} | 3224 | Lₐ₂₇₈₅ | L_{b24} |
| 3225 | Lₐ₁₉₆₂ | L_{b25} | 3226 | Lₐ₂₇₈₅ | L_{b25} |
| 3227 | Lₐ₁₉₆₂ | L_{b26} | 3228 | Lₐ₂₇₈₅ | L_{b26} |
| 3229 | Lₐ₁₉₆₂ | L_{b27} | 3230 | Lₐ₂₇₈₅ | L_{b27} |
| 3231 | Lₐ₁₉₆₂ | L_{b28} | 3232 | Lₐ₂₇₈₅ | L_{b28} |
| 3233 | Lₐ₁₉₆₂ | L_{b29} | 3234 | Lₐ₂₇₈₅ | L_{b29} |
| 3235 | Lₐ₁₉₆₂ | L_{b30} | 3236 | Lₐ₂₇₈₅ | L_{b30} |
| 3237 | Lₐ₁₉₆₂ | L_{b31} | 3238 | Lₐ₂₇₈₅ | L_{b31} |
| 3239 | Lₐ₁₉₆₂ | L_{b32} | 3240 | Lₐ₂₇₈₅ | L_{b32} |
| 3241 | Lₐ₁₉₆₂ | L_{b33} | 3242 | Lₐ₂₇₈₅ | L_{b33} |
| 3243 | Lₐ₁₉₆₂ | L_{b42} | 3244 | Lₐ₂₇₈₅ | L_{b42} |
| 3245 | Lₐ₁₉₆₂ | L_{b43} | 3246 | Lₐ₂₇₈₅ | L_{b43} |
| 3247 | Lₐ₁₉₆₂ | L_{b44} | 3248 | Lₐ₂₇₈₅ | L_{b44} |
| 3249 | Lₐ₁₉₆₂ | L_{b45} | 3250 | Lₐ₂₇₈₅ | L_{b45} |
| 3251 | Lₐ₁₉₆₂ | L_{b46} | 3252 | Lₐ₂₇₈₅ | L_{b46} |
| 3253 | Lₐ₁₉₆₂ | L_{b50} | 3254 | Lₐ₂₇₈₅ | L_{b50} |
| 3255 | Lₐ₁₉₆₂ | L_{b51} | 3256 | Lₐ₂₇₈₅ | L_{b51} |
| 3257 | Lₐ₁₉₆₂ | L_{b53} | 3258 | Lₐ₂₇₈₅ | L_{b53} |
| 3259 | Lₐ₁₉₆₂ | L_{b54} | 3260 | Lₐ₂₇₈₅ | L_{b54} |
| 3261 | Lₐ₁₉₆₂ | L_{b55} | 3262 | Lₐ₂₇₈₅ | L_{b55} |
| 3263 | Lₐ₁₉₆₂ | L_{b56} | 3264 | Lₐ₂₇₈₅ | L_{b56} |
| 3265 | Lₐ₁₉₆₂ | L_{b57} | 3266 | Lₐ₂₇₈₅ | L_{b57} |
| 3267 | Lₐ₁₉₆₂ | L_{b58} | 3268 | Lₐ₂₇₈₅ | L_{b58} |
| 3269 | Lₐ₁₉₆₂ | L_{b59} | 3270 | Lₐ₂₇₈₅ | L_{b59} |
| 3271 | Lₐ₁₉₆₂ | L_{b66} | 3272 | Lₐ₂₇₈₅ | L_{b66} |
| 3273 | Lₐ₁₉₆₂ | L_{b68} | 3274 | Lₐ₂₇₈₅ | L_{b68} |
| 3275 | Lₐ₁₉₆₂ | L_{b70} | 3276 | Lₐ₂₇₈₅ | L_{b70} |
| 3277 | Lₐ₁₉₆₂ | L_{b75} | 3278 | Lₐ₂₇₈₅ | L_{b75} |
| 3279 | Lₐ₁₉₆₂ | L_{b76} | 3280 | Lₐ₂₇₈₅ | L_{b76} |
| 3281 | Lₐ₁₉₆₂ | L_{b87} | 3282 | Lₐ₂₇₈₅ | L_{b87} |
| 3283 | Lₐ₁₉₆₂ | L_{b95} | 3284 | Lₐ₂₇₈₅ | L_{b95} |
| 3285 | Lₐ₁₉₆₂ | L_{b96} | 3286 | Lₐ₂₇₈₅ | L_{b96} |
| 3287 | Lₐ₁₉₆₂ | L_{b97} | 3288 | Lₐ₂₇₈₅ | L_{b97} |
| 3289 | Lₐ₁₉₆₂ | L_{b98} | 3290 | Lₐ₂₇₈₅ | L_{b98} |
| 3291 | Lₐ₁₉₆₂ | L_{b109} | 3292 | Lₐ₂₇₈₅ | L_{b109} |
| 3293 | Lₐ₁₉₆₂ | L_{b110} | 3294 | Lₐ₂₇₈₅ | L_{b110} |
| 3295 | Lₐ₁₉₆₂ | L_{b111} | 3296 | Lₐ₂₇₈₅ | L_{b111} |
| 3297 | Lₐ₁₉₆₂ | L_{b112} | 3298 | Lₐ₂₇₈₅ | L_{b112} |
| 3299 | Lₐ₁₉₆₂ | L_{b114} | 3300 | Lₐ₂₇₈₅ | L_{b114} |
| 3301 | Lₐ₁₉₆₂ | L_{b117} | 3302 | Lₐ₂₇₈₅ | L_{b117} |
| 3303 | Lₐ₁₉₆₂ | L_{b122} | 3304 | Lₐ₂₇₈₅ | L_{b122} |
| 3305 | Lₐ₁₉₆₂ | L_{b123} | 3306 | Lₐ₂₇₈₅ | L_{b123} |
| 3307 | Lₐ₁₉₆₂ | L_{b129} | 3308 | Lₐ₂₇₈₅ | L_{b129} |
| 3309 | Lₐ₁₉₆₂ | L_{b130} | 3310 | Lₐ₂₇₈₅ | L_{b130} |
| 3311 | Lₐ₁₉₆₂ | L_{b131} | 3312 | Lₐ₂₇₈₅ | L_{b131} |
| 3313 | Lₐ₁₉₆₂ | L_{b133} | 3314 | Lₐ₂₇₈₅ | L_{b133} |
| 3315 | Lₐ₁₉₆₂ | L_{b134} | 3316 | Lₐ₂₇₈₅ | L_{b134} |
| 3317 | Lₐ₁₉₆₂ | L_{b135} | 3318 | Lₐ₂₇₈₅ | L_{b135} |
| 3319 | Lₐ₁₉₆₂ | L_{b148} | 3320 | Lₐ₂₇₈₅ | L_{b148} |
| 3321 | Lₐ₁₉₆₂ | L_{b149} | 3322 | Lₐ₂₇₈₅ | L_{b149} |
| 3323 | Lₐ₁₉₆₂ | L_{b150} | 3324 | Lₐ₂₇₈₅ | L_{b150} |
| 3325 | Lₐ₁₉₆₂ | L_{b151} | 3326 | Lₐ₂₇₈₅ | L_{b151} |
| 3327 | Lₐ₁₆₄₇ | L_{b2} | 3328 | Lₐ₁₆₇₇ | L_{b2} |
| 3329 | Lₐ₁₆₄₇ | L_{b4} | 3330 | Lₐ₁₆₇₇ | L_{b4} |
| 3331 | Lₐ₁₆₄₇ | L_{b5} | 3332 | Lₐ₁₆₇₇ | L_{b5} |
| 3333 | Lₐ₁₆₄₇ | L_{b10} | 3334 | Lₐ₁₆₇₇ | L_{b10} |
| 3335 | Lₐ₁₆₄₇ | L_{b11} | 3336 | Lₐ₁₆₇₇ | L_{b11} |
| 3337 | Lₐ₁₆₄₇ | L_{b12} | 3338 | Lₐ₁₆₇₇ | L_{b12} |
| 3339 | Lₐ₁₆₄₇ | L_{b13} | 3340 | Lₐ₂₈₅₆ | L_{b13} |
| 3341 | Lₐ₁₆₄₇ | L_{b14} | 3342 | Lₐ₂₈₅₆ | L_{b14} |
| 3343 | Lₐ₁₆₄₇ | L_{b15} | 3344 | Lₐ₂₈₅₆ | L_{b15} |
| 3345 | Lₐ₁₆₄₇ | L_{b17} | 3346 | Lₐ₂₈₅₆ | L_{b17} |
| 3347 | Lₐ₁₆₄₈ | L_{b19} | 3348 | Lₐ₂₈₅₆ | L_{b19} |
| 3349 | Lₐ₁₆₄₈ | L_{b21} | 3350 | Lₐ₂₈₅₆ | L_{b21} |
| 3351 | Lₐ₁₆₄₈ | L_{b22} | 3352 | Lₐ₂₈₅₆ | L_{b22} |
| 3353 | Lₐ₁₆₄₈ | L_{b23} | 3354 | Lₐ₁₆₅₁ | L_{b23} |
| 3355 | Lₐ₁₆₄₈ | L_{b24} | 3356 | Lₐ₁₆₅₁ | L_{b24} |
| 3357 | Lₐ₁₆₄₈ | L_{b25} | 3358 | Lₐ₁₆₅₁ | L_{b25} |
| 3359 | Lₐ₁₆₄₈ | L_{b26} | 3360 | Lₐ₁₆₅₁ | L_{b26} |
| 3361 | Lₐ₁₆₄₉ | L_{b27} | 3362 | Lₐ₁₆₅₁ | L_{b27} |
| 3363 | Lₐ₁₆₄₉ | L_{b28} | 3364 | Lₐ₁₆₅₁ | L_{b28} |
| 3365 | Lₐ₁₆₄₉ | L_{b29} | 3366 | Lₐ₁₆₅₁ | L_{b29} |
| 3367 | Lₐ₁₆₄₉ | L_{b30} | 3368 | Lₐ₁₆₅₁ | L_{b30} |
| 3369 | Lₐ₁₆₄₉ | L_{b31} | 3370 | Lₐ₁₆₅₁ | L_{b31} |
| 3371 | Lₐ₁₆₄₉ | L_{b32} | 3372 | Lₐ₁₆₇₈ | L_{b32} |
| 3373 | Lₐ₁₆₄₉ | L_{b33} | 3374 | Lₐ₁₆₇₈ | L_{b33} |
| 3375 | Lₐ₁₆₄₉ | L_{b42} | 3376 | Lₐ₁₆₇₈ | L_{b42} |
| 3377 | Lₐ₁₆₄₉ | L_{b43} | 3378 | Lₐ₁₆₇₈ | L_{b43} |
| 3379 | Lₐ₁₆₄₉ | L_{b44} | 3380 | Lₐ₁₆₇₈ | L_{b44} |
| 3381 | Lₐ₁₆₄₉ | L_{b45} | 3382 | Lₐ₁₆₇₈ | L_{b45} |
| 3383 | Lₐ₁₆₄₉ | L_{b46} | 3384 | Lₐ₁₆₇₈ | L_{b46} |
| 3385 | Lₐ₁₆₅₀ | L_{b50} | 3386 | Lₐ₁₆₇₈ | L_{b50} |
| 3387 | Lₐ₁₆₅₀ | L_{b51} | 3388 | Lₐ₂₁₀₄ | L_{b51} |
| 3389 | Lₐ₁₆₅₀ | L_{b53} | 3390 | Lₐ₂₁₀₄ | L_{b53} |
| 3391 | Lₐ₁₆₅₀ | L_{b54} | 3392 | Lₐ₂₁₀₄ | L_{b54} |
| 3393 | Lₐ₁₆₅₀ | L_{b55} | 3394 | Lₐ₂₁₀₄ | L_{b55} |
| 3395 | Lₐ₁₆₅₀ | L_{b56} | 3396 | Lₐ₂₁₀₄ | L_{b56} |
| 3397 | Lₐ₁₆₅₀ | L_{b57} | 3398 | Lₐ₂₁₀₄ | L_{b57} |
| 3399 | Lₐ₁₆₅₀ | L_{b58} | 3400 | Lₐ₂₁₀₄ | L_{b58} |
| 3401 | Lₐ₁₆₅₀ | L_{b59} | 3402 | Lₐ₂₁₀₄ | L_{b59} |
| 3403 | Lₐ₉₂₈ | L_{b66} | 3404 | Lₐ₂₁₀₄ | L_{b66} |
| 3405 | Lₐ₉₂₈ | L_{b68} | 3406 | Lₐ₂₁₀₄ | L_{b68} |
| 3407 | Lₐ₉₂₈ | L_{b70} | 3408 | Lₐ₂₁₀₄ | L_{b70} |
| 3409 | Lₐ₉₂₈ | L_{b75} | 3410 | Lₐ₂₉₂₇ | L_{b75} |
| 3411 | Lₐ₉₂₈ | L_{b76} | 3412 | Lₐ₂₉₂₇ | L_{b76} |
| 3413 | Lₐ₉₂₈ | L_{b87} | 3414 | Lₐ₂₉₂₇ | L_{b87} |
| 3415 | Lₐ₉₂₈ | L_{b95} | 3416 | Lₐ₂₉₂₇ | L_{b95} |
| 3417 | Lₐ₉₂₈ | L_{b96} | 3418 | Lₐ₂₉₂₇ | L_{b96} |
| 3419 | Lₐ₂₇₁₄ | L_{b97} | 3420 | Lₐ₂₉₂₇ | L_{b97} |
| 3421 | Lₐ₂₇₁₄ | L_{b98} | 3422 | Lₐ₂₉₂₇ | L_{b98} |
| 3423 | Lₐ₂₇₁₄ | L_{b109} | 3424 | Lₐ₂₉₂₇ | L_{b109} |
| 3425 | Lₐ₂₇₁₄ | L_{b110} | 3426 | Lₐ₂₉₂₇ | L_{b110} |
| 3427 | Lₐ₂₇₁₄ | L_{b111} | 3428 | Lₐ₁₆₇₉ | L_{b111} |
| 3429 | Lₐ₂₇₁₄ | L_{b112} | 3430 | Lₐ₁₆₇₉ | L_{b112} |
| 3431 | Lₐ₂₇₁₄ | L_{b114} | 3432 | Lₐ₁₆₇₉ | L_{b114} |
| 3433 | Lₐ₂₇₁₄ | L_{b117} | 3434 | Lₐ₁₆₇₉ | L_{b117} |
| 3435 | Lₐ₂₇₁₄ | L_{b122} | 3436 | Lₐ₁₆₇₉ | L_{b122} |
| 3437 | Lₐ₂₆₄₃ | L_{b123} | 3438 | Lₐ₁₆₇₉ | L_{b123} |
| 3439 | Lₐ₂₆₄₃ | L_{b129} | 3440 | Lₐ₁₆₇₉ | L_{b129} |
| 3441 | Lₐ₂₆₄₃ | L_{b130} | 3442 | Lₐ₁₆₇₉ | L_{b130} |
| 3443 | Lₐ₂₆₄₃ | L_{b131} | 3444 | Lₐ₁₆₈₀ | L_{b131} |
| 3445 | Lₐ₂₆₄₃ | L_{b133} | 3446 | Lₐ₁₆₈₀ | L_{b133} |
| 3447 | Lₐ₂₆₄₃ | L_{b134} | 3448 | Lₐ₁₆₈₀ | L_{b134} |
| 3449 | Lₐ₂₆₄₃ | L_{b135} | 3450 | Lₐ₁₆₈₀ | L_{b135} |
| 3451 | Lₐ₂₀₃₃ | L_{b148} | 3452 | Lₐ₁₆₈₀ | L_{b148} |
| 3453 | Lₐ₂₀₃₃ | L_{b149} | 3454 | Lₐ₁₆₈₀ | L_{b149} |
| 3455 | Lₐ₂₀₃₃ | L_{b150} | 3456 | Lₐ₁₆₈₀ | L_{b150} |
| 3457 | Lₐ₂₀₃₃ | L_{b151} | 3458 | Lₐ₁₆₈₀ | L_{b151} |
| 3459 | Lₐ₁₇₉₅ | L_{b2} | 3460 | Lₐ₁₅₇₀ | L_{b2} |
| 3461 | Lₐ₁₇₉₅ | L_{b4} | 3462 | Lₐ₁₅₇₀ | L_{b4} |
| 3463 | Lₐ₁₇₉₅ | L_{b5} | 3464 | Lₐ₁₅₇₀ | L_{b5} |
| 3465 | Lₐ₁₇₉₅ | L_{b10} | 3466 | Lₐ₁₅₇₀ | L_{b10} |
| 3467 | Lₐ₁₇₉₅ | L_{b11} | 3468 | Lₐ₁₅₇₀ | L_{b11} |
| 3469 | Lₐ₁₇₉₅ | L_{b12} | 3470 | Lₐ₁₅₇₀ | L_{b12} |
| 3471 | Lₐ₁₇₉₅ | L_{b13} | 3472 | Lₐ₁₅₇₀ | L_{b13} |
| 3473 | Lₐ₁₇₉₅ | L_{b14} | 3474 | Lₐ₁₅₇₀ | L_{b14} |
| 3475 | Lₐ₁₇₉₅ | L_{b15} | 3476 | Lₐ₁₅₇₀ | L_{b15} |
| 3477 | Lₐ₁₇₉₅ | L_{b17} | 3478 | Lₐ₁₅₇₀ | L_{b17} |
| 3479 | Lₐ₁₈₂₀ | L_{b19} | 3480 | Lₐ₁₅₇₀ | L_{b19} |
| 3481 | Lₐ₁₈₂₀ | L_{b21} | 3482 | Lₐ₁₅₇₀ | L_{b21} |
| 3483 | Lₐ₁₈₂₀ | L_{b22} | 3484 | Lₐ₁₆₉₁ | L_{b22} |
| 3485 | Lₐ₁₈₂₀ | L_{b23} | 3486 | Lₐ₁₆₉₁ | L_{b23} |
| 3487 | Lₐ₁₈₂₀ | L_{b24} | 3488 | Lₐ₁₆₉₁ | L_{b24} |
| 3489 | Lₐ₁₈₂₀ | L_{b25} | 3490 | Lₐ₁₆₉₁ | L_{b25} |
| 3491 | Lₐ₁₈₂₀ | L_{b26} | 3492 | Lₐ₁₆₉₁ | L_{b26} |
| 3493 | Lₐ₁₈₂₀ | L_{b27} | 3494 | Lₐ₁₆₉₁ | L_{b27} |
| 3495 | Lₐ₁₈₂₀ | L_{b28} | 3496 | Lₐ₁₆₉₁ | L_{b28} |
| 3497 | Lₐ₁₈₂₀ | L_{b29} | 3498 | Lₐ₁₆₉₁ | L_{b29} |
| 3499 | Lₐ₂₄₃₇ | L_{b30} | 3500 | Lₐ₁₆₉₁ | L_{b30} |
| 3501 | Lₐ₂₄₃₇ | L_{b31} | 3502 | Lₐ₁₆₉₁ | L_{b31} |
| 3503 | Lₐ₂₄₃₇ | L_{b32} | 3504 | Lₐ₁₆₉₁ | L_{b32} |
| 3505 | Lₐ₂₄₃₇ | L_{b33} | 3506 | Lₐ₁₆₉₁ | L_{b33} |
| 3507 | Lₐ₂₄₃₇ | L_{b42} | 3508 | Lₐ₂₄₃₆ | L_{b42} |
| 3509 | Lₐ₂₄₃₇ | L_{b43} | 3510 | Lₐ₂₄₃₆ | L_{b43} |
| 3511 | Lₐ₂₄₃₇ | L_{b44} | 3512 | Lₐ₂₄₃₆ | L_{b44} |
| 3513 | Lₐ₂₄₃₇ | L_{b45} | 3514 | Lₐ₂₄₃₆ | L_{b45} |
| 3515 | Lₐ₂₄₃₇ | L_{b46} | 3516 | Lₐ₂₄₃₆ | L_{b46} |
| 3517 | Lₐ₂₄₃₇ | L_{b50} | 3518 | Lₐ₂₄₃₆ | L_{b50} |
| 3519 | Lₐ₂₄₃₇ | L_{b51} | 3520 | Lₐ₂₄₃₆ | L_{b51} |
| 3521 | Lₐ₂₄₃₇ | L_{b53} | 3522 | Lₐ₂₄₃₆ | L_{b53} |
| 3523 | Lₐ₂₄₃₇ | L_{b54} | 3524 | Lₐ₂₄₃₆ | L_{b54} |
| 3525 | Lₐ₂₄₃₇ | L_{b55} | 3526 | Lₐ₂₄₃₆ | L_{b55} |
| 3527 | Lₐ₂₄₃₇ | L_{b56} | 3528 | Lₐ₂₄₃₆ | L_{b56} |
| 3529 | Lₐ₂₄₃₇ | L_{b57} | 3530 | Lₐ₂₄₃₆ | L_{b57} |
| 3531 | Lₐ₂₄₃₇ | L_{b58} | 3532 | Lₐ₂₄₃₆ | L_{b58} |
| 3533 | Lₐ₂₄₃₇ | L_{b59} | 3534 | Lₐ₂₄₃₆ | L_{b59} |
| 3535 | Lₐ₂₄₃₇ | L_{b66} | 3536 | Lₐ₂₄₃₆ | L_{b66} |
| 3537 | Lₐ₂₄₃₇ | L_{b68} | 3538 | Lₐ₂₄₃₆ | L_{b68} |
| 3539 | Lₐ₂₄₃₇ | L_{b70} | 3540 | Lₐ₂₄₃₆ | L_{b70} |
| 3541 | Lₐ₂₆₁₈ | L_{b75} | 3542 | Lₐ₂₄₃₆ | L_{b75} |
| 3543 | Lₐ₂₆₁₈ | L_{b76} | 3544 | Lₐ₂₄₃₆ | L_{b76} |
| 3545 | Lₐ₂₆₁₈ | L_{b87} | 3546 | Lₐ₂₄₃₆ | L_{b87} |
| 3547 | Lₐ₂₆₁₈ | L_{b95} | 3548 | Lₐ₂₄₃₆ | L_{b95} |
| 3549 | Lₐ₂₆₁₈ | L_{b96} | 3550 | Lₐ₂₄₃₆ | L_{b96} |
| 3551 | Lₐ₂₆₁₈ | L_{b97} | 3552 | Lₐ₂₄₃₆ | L_{b97} |
| 3553 | Lₐ₂₆₁₈ | L_{b98} | 3554 | Lₐ₂₄₃₆ | L_{b98} |
| 3555 | Lₐ₂₆₁₈ | L_{b109} | 3556 | Lₐ₂₄₃₆ | L_{b109} |
| 3557 | Lₐ₂₆₁₈ | L_{b110} | 3558 | Lₐ₃₃₆₅ | L_{b110} |
| 3559 | Lₐ₂₆₁₈ | L_{b111} | 3560 | Lₐ₃₃₆₅ | L_{b111} |
| 3561 | Lₐ₂₆₁₈ | L_{b112} | 3562 | Lₐ₃₃₆₅ | L_{b112} |
| 3563 | Lₐ₂₆₁₈ | L_{b114} | 3564 | Lₐ₃₃₆₅ | L_{b114} |
| 3565 | Lₐ₂₆₁₈ | L_{b117} | 3566 | Lₐ₃₃₆₅ | L_{b117} |
| 3567 | Lₐ₂₆₁₈ | L_{b122} | 3568 | Lₐ₃₃₆₅ | L_{b122} |
| 3569 | Lₐ₃₃₄₁ | L_{b123} | 3570 | Lₐ₃₃₆₅ | L_{b123} |
| 3571 | Lₐ₃₃₄₁ | L_{b129} | 3572 | Lₐ₃₃₆₅ | L_{b129} |
| 3573 | Lₐ₃₃₄₁ | L_{b130} | 3574 | Lₐ₃₃₆₅ | L_{b130} |
| 3575 | Lₐ₃₃₄₁ | L_{b131} | 3576 | Lₐ₃₃₆₅ | L_{b131} |
| 3577 | Lₐ₃₃₄₁ | L_{b133} | 3578 | Lₐ₃₃₆₅ | L_{b133} |
| 3579 | Lₐ₃₃₄₁ | L_{b134} | 3580 | Lₐ₃₃₆₅ | L_{b134} |
| 3581 | Lₐ₃₃₄₁ | L_{b135} | 3582 | Lₐ₃₃₆₅ | L_{b135} |
| 3583 | Lₐ₃₃₄₁ | L_{b148} | 3584 | Lₐ₃₃₆₅ | L_{b148} |
| 3585 | Lₐ₃₃₄₁ | L_{b149} | 3586 | Lₐ₃₃₆₅ | L_{b149} |
| 3587 | Lₐ₃₃₄₁ | L_{b150} | 3588 | Lₐ₃₃₆₅ | L_{b150} |
| 3589 | Lₐ₃₃₄₁ | L_{b151} | 3590 | Lₐ₃₃₆₅ | L_{b151} |
| 3591 | Lₐ₃₃₆₇ | L_{b52} | 3592 | Lₐ₃₃₉₁ | L_{b52} |
| 3593 | Lₐ₃₃₆₈ | L_{b52} | 3594 | Lₐ₃₄₀₀ | L_{b52} |
| 3595 | Lₐ₃₃₈₁ | L_{b52} | 3596 | Lₐ₃₄₁₆ | L_{b52} |
| 3597 | Lₐ₃₃₆₇ | L_{b52} | 3598 | Lₐ₃₃₆₇ | L_{b20} |
| 3599 | Lₐ₃₃₆₈ | L_{b52} | 3600 | Lₐ₃₃₆₈ | L_{b20} |
| 3601 | Lₐ₃₃₆₉ | L_{b52} | 3602 | Lₐ₃₃₆₉ | L_{b20} |
| 3603 | Lₐ₃₃₇₀ | L_{b52} | 3604 | Lₐ₃₃₇₀ | L_{b20} |
| 3605 | Lₐ₃₃₇₁ | L_{b52} | 3606 | Lₐ₃₃₇₁ | L_{b20} |
| 3607 | Lₐ₃₃₇₂ | L_{b52} | 3608 | Lₐ₃₃₇₂ | L_{b20} |
| 3609 | Lₐ₃₃₇₃ | L_{b52} | 3610 | Lₐ₃₃₇₃ | L_{b20} |
| 3611 | Lₐ₃₃₇₄ | L_{b52} | 3612 | Lₐ₃₃₇₄ | L_{b20} |
| 3613 | Lₐ₃₃₇₅ | L_{b52} | 3614 | Lₐ₃₃₇₅ | L_{b20} |
| 3615 | Lₐ₃₃₇₆ | L_{b52} | 3616 | Lₐ₃₃₇₆ | L_{b20} |
| 3617 | Lₐ₃₃₇₇ | L_{b52} | 3618 | Lₐ₃₃₇₇ | L_{b20} |
| 3619 | Lₐ₃₃₇₈ | L_{b52} | 3620 | Lₐ₃₃₇₈ | L_{b20} |
| 3621 | Lₐ₃₃₇₉ | L_{b52} | 3622 | Lₐ₃₃₇₉ | L_{b20} |
| 3623 | Lₐ₃₃₈₀ | L_{b52} | 3624 | Lₐ₃₃₈₀ | L_{b20} |
| 3625 | Lₐ₃₃₈₁ | L_{b52} | 3626 | Lₐ₃₃₈₁ | L_{b20} |
| 3627 | Lₐ₃₃₈₂ | L_{b52} | 3628 | Lₐ₃₃₈₂ | L_{b20} |
| 3629 | Lₐ₃₄₀₈ | L_{b52} | 3630 | Lₐ₃₄₀₈ | L_{b20} |
| 3631 | Lₐ₃₄₀₉ | L_{b52} | 3632 | Lₐ₃₄₀₉ | L_{b20} |
| 3633 | Lₐ₃₄₁₀ | L_{b52} | 3634 | Lₐ₃₄₁₀ | L_{b20} |
| 3635 | Lₐ₃₄₂₃ | L_{b52} | 3636 | Lₐ₃₄₂₃ | L_{b20} |
| 3637 | Lₐ₃₄₂₄ | L_{b52} | 3638 | Lₐ₃₄₂₄ | L_{b20} |
| 3639 | Lₐ₃₄₂₅ | L_{b52} | 3640 | Lₐ₃₄₂₅ | L_{b20} |
| 3641 | Lₐ₃₄₅₃ | L_{b52} | 3642 | Lₐ₃₄₅₃ | L_{b20} |
| 3643 | Lₐ₃₄₅₄ | L_{b52} | 3644 | Lₐ₃₄₅₄ | L_{b20} |
| 3645 | Lₐ₃₄₅₅ | L_{b52} | 3646 | Lₐ₃₄₅₅ | L_{b20} |
| 3647 | Lₐ₃₃₈₃ | L_{b52} | 3648 | Lₐ₃₃₈₃ | L_{b20} |
| 3649 | Lₐ₃₃₈₄ | L_{b52} | 3650 | Lₐ₃₃₈₄ | L_{b20} |
| 3651 | Lₐ₃₃₈₅ | L_{b52} | 3652 | Lₐ₃₃₈₅ | L_{b20} |
| 3653 | Lₐ₃₃₈₆ | L_{b52} | 3654 | Lₐ₃₃₈₆ | L_{b20} |
| 3655 | Lₐ₃₃₈₇ | L_{b52} | 3656 | Lₐ₃₃₈₇ | L_{b20} |
| 3657 | Lₐ₃₃₈₈ | L_{b52} | 3658 | Lₐ₃₃₈₈ | L_{b20} |
| 3659 | Lₐ₃₃₈₉ | L_{b52} | 3660 | Lₐ₃₃₈₉ | L_{b20} |
| 3661 | Lₐ₃₃₉₀ | L_{b52} | 3662 | Lₐ₃₃₉₀ | L_{b20} |
| 3663 | Lₐ₃₃₉₁ | L_{b52} | 3664 | Lₐ₃₃₉₁ | L_{b20} |
| 3665 | Lₐ₃₃₉₂ | L_{b52} | 3666 | Lₐ₃₃₉₂ | L_{b20} |
| 3667 | Lₐ₄₂₀ | L_{b52} | 3668 | Lₐ₄₉₀ | L_{b52} |
| 3669 | Lₐ₄₂₀ | L_{b20} | 3670 | Lₐ₄₉₀ | L_{b20} |
| 3671 | Lₐ₄₂₀ | L_{b135} | 3672 | Lₐ₄₉₀ | L_{b135} |
| 3673 | Lₐ₄₂₀ | L_{b1} | 3674 | Lₐ₄₉₀ | L_{b1} |
| 3675 | Lₐ₄₂₀ | L_{b3} | 3676 | Lₐ₄₉₀ | L_{b3} |
| 3677 | Lₐ₄₂₀ | L_{b8} | 3678 | Lₐ₄₉₀ | L_{b8} |
| 3679 | Lₐ₄₂₀ | L_{b118} | 3680 | Lₐ₄₉₀ | L_{b118} |
| 3681 | Lₐ₄₂₀ | L_{b132} | 3682 | Lₐ₄₉₀ | L_{b132} |
| 3683 | Lₐ₄₂₀ | L_{b150} | 3684 | Lₐ₄₉₀ | L_{b150} |
| 3685 | Lₐ₄₂₀ | L_{b151} | 3686 | Lₐ₄₉₀ | L_{b151} |
| 3687 | Lₐ₁₃₆ | L_{b135} | 3688 | Lₐ₁₅₇ | L_{b135} |
| 3689 | Lₐ₁₃₆ | L_{b150} | 3690 | Lₐ₁₅₇ | L_{b150} |
| 3691 | Lₐ₁₃₆ | L_{b151} | 3692 | Lₐ₁₅₇ | L_{b151} |
| 3693 | Lₐ₂₇₈ | L_{b135} | 3694 | Lₐ₆ | L_{b52} |
| 3695 | Lₐ₂₇₈ | L_{b150} | 3696 | Lₐ₆ | L_{b20} |
| 3697 | Lₐ₂₇₈ | L_{b151} | 3698 | Lₐ₆ | L_{b135} |
| 3699 | Lₐ₁₀₆ | L_{b52} | 3700 | Lₐ₆ | L_{b1} |
| 3701 | Lₐ₁₀₆ | L_{b20} | 3702 | Lₐ₆ | L_{b3} |
| 3703 | Lₐ₁₀₆ | L_{b135} | 3704 | Lₐ₆ | L_{b8} |
| 3705 | Lₐ₁₀₆ | L_{b1} | 3706 | Lₐ₆ | L_{b118} |
| 3707 | Lₐ₁₀₆ | L_{b3} | 3708 | Lₐ₆ | L_{b132} |
| 3709 | Lₐ₁₀₆ | L_{b8} | 3710 | Lₐ₆ | L_{b150} |
| 3711 | Lₐ₁₀₆ | L_{b118} | 3712 | Lₐ₆ | L_{b151} |
| 3713 | Lₐ₁₀₆ | L_{b132} | 3714 | Lₐ₁₁₁ | L_{b52} |
| 3715 | Lₐ₁₀₆ | L_{b150} | 3716 | Lₐ₁₁₁ | L_{b20} |
| 3717 | Lₐ₁₀₆ | L_{b151} | 3718 | Lₐ₁₁₁ | L_{b135} |
| 3719 | Lₐ₄₉ | L_{b52} | 3720 | Lₐ₁₁₁ | L_{b1} |
| 3721 | Lₐ₄₉ | L_{b20} | 3722 | Lₐ₁₁₁ | L_{b3} |
| 3723 | Lₐ₄₉ | L_{b135} | 3724 | Lₐ₁₁₁ | L_{b8} |
| 3725 | Lₐ₄₉ | L_{b1} | 3726 | Lₐ₁₁₁ | L_{b118} |
| 3727 | Lₐ₄₉ | L_{b3} | 3728 | Lₐ₁₁₁ | L_{b132} |
| 3729 | Lₐ₄₉ | L_{b8} | 3730 | Lₐ₁₁₁ | L_{b150} |
| 3731 | Lₐ₄₉ | L_{b118} | 3732 | Lₐ₁₁₁ | L_{b151} |
| 3733 | Lₐ₄₉ | L_{b132} | 3734 | Lₐ₂₂₈ | L_{b52} |
| 3735 | Lₐ₄₉ | L_{b150} | 3736 | Lₐ₂₂₈ | L_{b20} |
| 3737 | Lₐ₄₉ | L_{b151} | 3738 | Lₐ₂₂₈ | L_{b135} |
| 3739 | Lₐ₂₀₇ | L_{b52} | 3740 | Lₐ₂₂₈ | L_{b1} |
| 3741 | Lₐ₂₀₇ | L_{b20} | 3742 | Lₐ₂₂₈ | L_{b3} |
| 3743 | Lₐ₂₀₇ | L_{b135} | 3744 | Lₐ₂₂₈ | L_{b8} |
| 3745 | Lₐ₂₀₇ | L_{b1} | 3746 | Lₐ₂₂₈ | L_{b118} |
| 3747 | Lₐ₂₀₇ | L_{b3} | 3748 | Lₐ₂₂₈ | L_{b132} |
| 3749 | Lₐ₂₀₇ | L_{b8} | 3750 | Lₐ₂₂₈ | L_{b150} |
| 3751 | Lₐ₂₀₇ | L_{b118} | 3752 | Lₐ₂₂₈ | L_{b151} |
| 3753 | Lₐ₂₀₇ | L_{b132} | 3754 | Lₐ₃₇₀ | L_{b52} |
| 3755 | Lₐ₂₀₇ | L_{b150} | 3756 | Lₐ₃₇₀ | L_{b20} |
| 3757 | Lₐ₂₀₇ | L_{b151} | 3758 | Lₐ₃₇₀ | L_{b135} |
| 3759 | Lₐ₃₄₉ | L_{b52} | 3760 | Lₐ₃₇₀ | L_{b1} |
| 3761 | Lₐ₃₄₉ | L_{b20} | 3762 | Lₐ₃₇₀ | L_{b3} |
| 3763 | Lₐ₃₄₉ | L_{b135} | 3764 | Lₐ₃₇₀ | L_{b8} |
| 3765 | Lₐ₃₄₉ | L_{b1} | 3766 | Lₐ₃₇₀ | L_{b118} |
| 3767 | Lₐ₃₄₉ | L_{b3} | 3768 | Lₐ₃₇₀ | L_{b132} |
| 3769 | Lₐ₃₄₉ | L_{b8} | 3770 | Lₐ₃₇₀ | L_{b150} |
| 3771 | Lₐ₃₄₉ | L_{b118} | 3772 | Lₐ₃₇₀ | L_{b151} |
| 3773 | Lₐ₃₄₉ | L_{b132} | 3774 | Lₐ₅₁₁ | L_{b52} |
| 3775 | Lₐ₃₄₉ | L_{b150} | 3776 | Lₐ₅₁₁ | L_{b20} |
| 3777 | Lₐ₃₄₉ | L_{b151} | 3778 | Lₐ₅₁₁ | L_{b135} |
| 3779 | Lₐ₅₈₁ | L_{b52} | 3780 | Lₐ₅₁₁ | L_{b1} |
| 3781 | Lₐ₅₈₁ | L_{b20} | 3782 | Lₐ₅₁₁ | L_{b3} |
| 3783 | Lₐ₅₈₁ | L_{b135} | 3784 | Lₐ₅₁₁ | L_{b8} |
| 3785 | Lₐ₅₈₁ | L_{b1} | 3786 | Lₐ₅₁₁ | L_{b118} |
| 3787 | Lₐ₅₈₁ | L_{b3} | 3788 | Lₐ₅₁₁ | L_{b132} |
| 3789 | Lₐ₅₈₁ | L_{b8} | 3790 | Lₐ₅₁₁ | L_{b150} |
| 3791 | Lₐ₅₈₁ | L_{b118} | 3792 | Lₐ₅₁₁ | L_{b151} |
| 3793 | Lₐ₅₈₁ | L_{b132} | 3794 | Lₐ₅₆₀ | L_{b52} |
| 3795 | Lₐ₅₈₁ | L_{b150} | 3796 | Lₐ₅₆₀ | L_{b20} |
| 3797 | Lₐ₅₈₁ | L_{b151} | 3798 | Lₐ₅₆₀ | L_{b135} |
| 3799 | Lₐ₅₆₀ | L_{b118} | 3800 | Lₐ₅₆₀ | L_{b1} |
| 3801 | Lₐ₅₆₀ | L_{b132} | 3802 | Lₐ₅₆₀ | L_{b3} |
| 3803 | Lₐ₅₆₀ | L_{b150} | 3804 | Lₐ₅₆₀ | L_{b8} |
| 3805 | Lₐ₅₆₀ | L_{b151} | 3806 | Lₐ₅₆₀ | L_{b31} |

14. An organic electroluminescent device, comprising:
an anode,
a cathode, and
an organic layer disposed between the anode and the cathode, wherein at least one layer of the organic layer comprises the metal complex according to any one of claims 1 to 13;
preferably, wherein the organic layer comprising the metal complex is a light-emitting layer;
preferably, wherein the light-emitting layer further comprises a first host compound;
preferably, the light-emitting layer further comprises a second host compound; and
more preferably, the first host compound and/or the second host compound comprise at least one chemical group selected from the group consisting of: benzene, pyridine, pyrimidine, triazine, carbazole, azacarbazole, indolocarbazole, dibenzothiophene, aza-dibenzothiophene, dibenzofuran, azadibenzofuran, dibenzoselenophene, triphenylene, azatriphenylene, fluorene, silafluorene, naphthalene, quinoline, isoquinoline, quinazoline, quinoxaline, phenanthrene, azaphenanthrene and combinations thereof;
preferably, wherein the metal complex is doped in the first host compound and the second host compound, and the weight of the metal complex accounts for 1% to 30% of the total weight of the light-emitting layer; and
more preferably, the weight of the metal complex accounts for 3% to 13% of the total weight of the light-emitting layer.

15. A composition, comprising the metal complex according to any one of claims 1 to 13.

## Patentansprüche

1. Metallkomplex, umfassend ein Metall M und einen mit dem Metall M koordinierten Liganden Lₐ, wobei der Ligand Lₐ eine Struktur aufweist, die durch Formel 1 dargestellt ist: 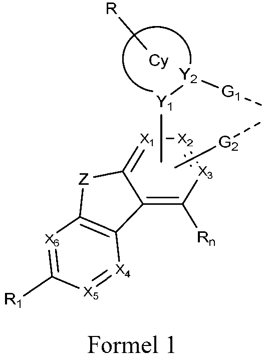 wobei in Formel 1
das Metall M bei jedem Auftreten identisch oder unterschiedlich aus der Gruppe bestehend aus Cu, Ag, Au, Ru, Rh, Pd, Os, Ir und Pt ausgewählt ist;
der Ring Cy bei jedem Auftreten identisch oder unterschiedlich aus einem aromatischen Ring, aufweisend 6 bis 24 Ringatome, der Y₁ und Y₂ umfasst, einem heteroaromatischen Ring, aufweisend 5 bis 24 Ringatome, der Y₁ und Y₂ umfasst, oder einer Kombination davon ausgewählt ist;
G₁ und G₂ bei jedem Auftreten identisch oder unterschiedlich aus einer Einfachbindung, O oder S ausgewählt sind;
X₁ bis X₆ bei jedem Auftreten identisch oder unterschiedlich aus C, CRₓ oder N ausgewählt sind und eines der Elemente X₁ bis X₃ aus C ausgewählt und mit Y₁ verknüpft ist;
eines der Elemente X₁, X₂ und X₃ aus N ausgewählt und mit dem Metall durch eine Metall-Stickstoff-Bindung verknüpft ist oder eines der Elemente X₁, X₂ und X₃ aus C ausgewählt und mit dem Metall durch G₂ verknüpft ist;
Y₁ und Y₂ bei jedem Auftreten identisch oder unterschiedlich aus C oder N ausgewählt sind;
Z aus der Gruppe bestehend aus O, S, Se, NR', CR'R', SiR'R' und GeR'R' ausgewählt ist, wenn zwei R' gleichzeitig vorhanden sind, die beiden R' identisch oder unterschiedlich sind;
R eine Monosubstitution, Mehrfachsubstitutionen oder eine Nichtsubstitution darstellt, und die Vielzahl von R, wenn eine Vielzahl von R vorhanden ist, identisch oder unterschiedlich sind;
R, Rₓ und R' bei jedem Auftreten identisch oder unterschiedlich aus der Gruppe bestehend aus Folgendem ausgewählt sind: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon;
R₁ aus einer Cyanogruppe oder Fluor ausgewählt ist und
Rₙ eine durch Formel 2 dargestellte Struktur aufweist: 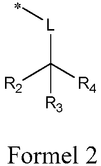
wobei "*" in Formel 2 eine Position darstellt, an der Formel 2 mit Formel 1 verknüpft ist;
L aus der Gruppe bestehend aus Folgendem ausgewählt ist: einer Einfachbindung,
substituiertem oder unsubstituiertem Alkylen mit 1 bis 20 Kohlenstoffatomen, substituiertem oder unsubstituiertem Cycloalkylen mit 3 bis 20 Kohlenstoffatomen, substituiertem oder unsubstituiertem Arylen mit 6 bis 30 Kohlenstoffatomen, substituiertem oder unsubstituiertem Heteroarylen mit 3 bis 30 Kohlenstoffatomen sowie Kombinationen davon;
R₂, R₃ und R₄ bei jedem Auftreten identisch oder unterschiedlich aus der Gruppe bestehend aus Folgendem ausgewählt sind: Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon;
benachbarte Substituenten R optional verknüpft sein können, um einen Ring zu bilden;
benachbarte Substituenten R' und Rₓ optional verknüpft sein können, um einen Ring zu bilden, und
benachbarte Substituenten R₂, R₃ und R₄ optional verknüpft sein können, um einen Ring zu bilden.

2. Metallkomplex nach Anspruch 1, wobei der Metallkomplex eine allgemeine Formel von M(Lₐ)ₘ(L_{b})ₙ(L_{c})_{q} aufweist,
Lₐ, L_{b} und L_{c} jeweils ein erster Ligand, ein zweiter Ligand und ein dritter Ligand sind, die mit dem Metall M koordiniert sind, und L_{c} gleich oder verschieden von Lₐ oder L_{b}, wobei Lₐ, L_{b} und L_{c} optional verknüpft sein können, um einen mehrzähnigen Liganden zu bilden,
wobei m aus 1, 2 oder 3 ausgewählt ist, n aus 0, 1 oder 2 ausgewählt ist, q aus 0, 1 oder 2 ausgewählt ist und m+n+q gleich einem Oxidationszustand des Metalls M ist, wobei, wenn m größer oder gleich 2 ist, eine Vielzahl von Lₐ identisch oder unterschiedlich ist, wobei, wenn n gleich 2 ist, zwei L_{b} identisch oder unterschiedlich sind, zwei L_{c}, wenn q gleich 2 ist, identisch oder unterschiedlich sind,
wobei 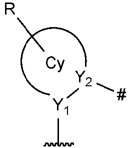 in Formel 1 bei jedem Auftreten identisch oder unterschiedlich aus einer der folgenden Strukturen ausgewählt ist: 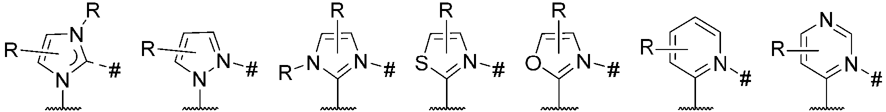 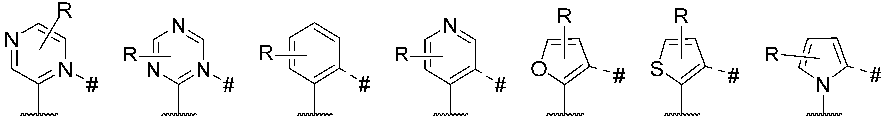 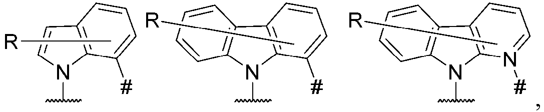
wobei
R bei jedem Auftreten identisch oder unterschiedlich eine Monosubstitution, Mehrfachsubstitutionen oder eine Nichtsubstitution darstellt, und die Vielzahl von R, wenn eine Vielzahl von R in einer beliebigen Struktur vorhanden ist, identisch oder unterschiedlich sind;
R bei jedem Auftreten identisch oder unterschiedlich aus der Gruppe bestehend aus Folgendem ausgewählt ist: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon;
benachbarte Substituenten R optional verknüpft sein können, um einen Ring zu bilden, und
"#" eine Position darstellt, an der G₁ verknüpft ist, und 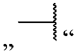 eine Position darstellt, an der X₁, X₂ oder X₃ verknüpft ist;
L_{b} und L_{c} bei jedem Auftreten identisch oder unterschiedlich aus einer Struktur ausgewählt sind, die durch eine der Gruppen bestehend aus Folgendem dargestellt ist: 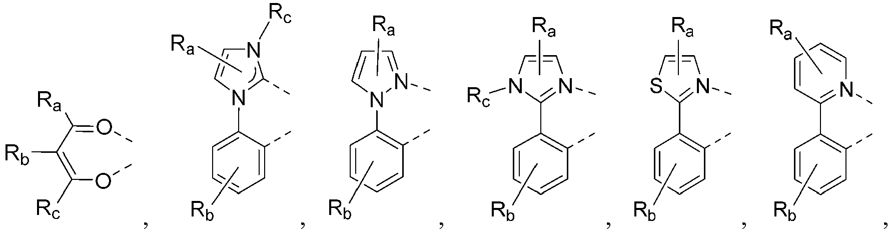 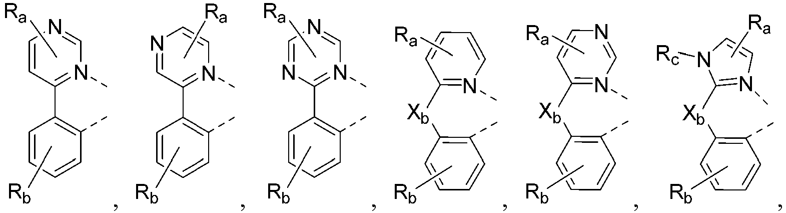
wobei
X_{b} bei jedem Auftreten identisch oder unterschiedlich aus der Gruppe bestehend aus Folgendem ausgewählt ist: O, S, Se, NR_{N1} und CR_{C1}R_{C2};
Rₐ und R_{b} bei jedem Auftreten identisch oder unterschiedlich eine Monosubstitution, Mehrfachsubstitutionen oder eine Nichtsubstitution darstellen;
Rₐ, R_{b}, R_{c}, R_{N1}, R_{C1} und R_{C2} bei jedem Auftreten identisch oder unterschiedlich aus der Gruppe bestehend aus Folgendem ausgewählt ist: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon, und
benachbarte Substituenten Rₐ, R_{b}, R_{c}, R_{N1}, R_{C1} und R_{C2} optional verknüpft sein können, um einen Ring zu bilden;
das Metall M bei jedem Auftreten identisch oder unterschiedlich aus Pt oder Ir ausgewählt ist.

3. Metallkomplex nach Anspruch 1 oder 2, wobei der Metallkomplex eine allgemeine Formelstruktur von Ir(Lₐ)ₘ(L_{b})₃₋ₘ aufweist und die Struktur durch Formel 3 dargestellt ist: 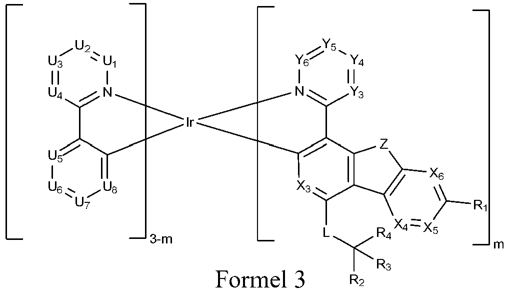 wobei
m aus 1, 2 oder 3 ausgewählt ist, zwei L_{b}, wenn m aus 1 ausgewählt ist, identisch oder unterschiedlich sind, eine Vielzahl von Lₐ, wenn m aus 2 oder 3 ausgewählt ist, identisch oder unterschiedlich sind;
Z aus der Gruppe bestehend aus O, S, Se, NR', CR'R', SiR'R' und GeR'R' ausgewählt ist, wenn zwei R' gleichzeitig vorhanden sind, die beiden R' identisch oder unterschiedlich sind;
U₁ bis U₈ bei jedem Auftreten identisch oder unterschiedlich aus CRᵤ oder N ausgewählt sind;
X₃ bis X₆ bei jedem Auftreten identisch oder unterschiedlich aus CRₓ oder N ausgewählt sind;
Y₃ bis Y₆ bei jedem Auftreten identisch oder unterschiedlich aus CR oder N ausgewählt sind;
R₁ aus einer Cyanogruppe oder Fluor ausgewählt ist;
R', Rᵤ, Rₓ und R bei jedem Auftreten identisch oder unterschiedlich aus der Gruppe bestehend aus Folgendem ausgewählt sind: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon;
L aus der Gruppe bestehend aus Folgendem ausgewählt ist: einer Einfachbindung, substituiertem oder unsubstituiertem Alkylen mit 1 bis 20 Kohlenstoffatomen, substituiertem oder unsubstituiertem Cycloalkylen mit 3 bis 20 Kohlenstoffatomen, substituiertem oder unsubstituiertem Arylen mit 6 bis 30 Kohlenstoffatomen, substituiertem oder unsubstituiertem Heteroarylen mit 3 bis 30 Kohlenstoffatomen sowie Kombinationen davon;
R₂, R₃ und R₄ bei jedem Auftreten identisch oder unterschiedlich aus der Gruppe bestehend aus Folgendem ausgewählt sind: Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon;
benachbarte Substituenten Rᵤ optional verknüpft sein können, um einen Ring zu bilden;
benachbarte Substituenten R optional verknüpft sein können, um einen Ring zu bilden;
benachbarte Substituenten R' und Rₓ optional verknüpft sein können, um einen Ring zu bilden, und
benachbarte Substituenten R₂, R₃ und R₄ optional verknüpft sein können, um einen Ring zu bilden;
Z vorzugsweise aus O oder S ausgewählt ist und Z insbesondere vorzugsweise aus O ausgewählt ist.

4. Metallkomplex nach einem der Ansprüche 1 bis 3, wobei L aus der Gruppe bestehend aus Folgendem ausgewählt ist: einer Einfachbindung, substituiertem oder unsubstituiertem Alkylen mit 1 bis 6 Kohlenstoffatomen, substituiertem oder unsubstituiertem Cycloalkylen mit 4 bis 10 Kohlenstoffatomen, substituiertem oder unsubstituiertem Arylen mit 6 bis 12 Kohlenstoffatomen sowie Kombinationen davon, und
wobei R₂, R₃ und R₄ bei jedem Auftreten identisch oder unterschiedlich aus der Gruppe bestehend aus Folgendem ausgewählt sind: Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, einer Cyanogruppe und Kombinationen davon;
L vorzugsweise aus einer Einfachbindung und substituiertem oder unsubstituiertem Methylen ausgewählt ist;
R₂, R₃ und R₄ vorzugsweise bei jedem Auftreten identisch oder unterschiedlich aus der Gruppe bestehend aus Folgendem ausgewählt sind: Fluor, substituiertem oder unsubstituiertem Alkyl mit 1 bis 20 Kohlenstoffatomen, substituiertem oder unsubstituiertem Aryl mit 6 bis 30 Kohlenstoffatomen, einer Cyanogruppe und Kombinationen davon, und
R₂, R₃ und R₄ weiter vorzugsweise bei jedem Auftreten identisch oder unterschiedlich aus substituiertem oder unsubstituiertem Alkyl mit 1 bis 20 Kohlenstoffatomen ausgewählt sind.

5. Metallkomplex nach Anspruch 3, wobei X₃ bis X₆ bei jedem Auftreten identisch oder unterschiedlich ausgewählt sind aus CRₓ und/oder Y₃ bis Y₆ bei jedem Auftreten identisch oder unterschiedlich ausgewählt sind aus CR und/oder U₁ bis U₈ bei jedem Auftreten identisch oder unterschiedlich ausgewählt sind aus CRᵤ,
wobei Rₓ, R und Rᵤ bei jedem Auftreten identisch oder unterschiedlich aus der Gruppe bestehend aus Folgendem ausgewählt sind: Wasserstoff, Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Alkylgermanyl mit 3 bis 20 Kohlenstoffatomen, einer Cyanogruppe und Kombinationen davon,
wobei Rₓ, R und Rᵤ vorzugsweise bei jedem Auftreten identisch oder unterschiedlich aus der Gruppe bestehend aus Folgendem ausgewählt sind: Wasserstoff, Deuterium, Fluor, substituiertem oder unsubstituiertem Alkyl mit 1 bis 6 Kohlenstoffatomen, substituiertem oder unsubstituiertem Cycloalkyl mit 3 bis 6 Ringkohlenstoffatomen, substituiertem oder unsubstituiertem Aryl mit 6 bis 12 Kohlenstoffatomen, substituiertem oder unsubstituiertem Heteroaryl mit 3 bis 12 Kohlenstoffatomen, substituiertem oder unsubstituiertem Alkylsilyl mit 3 bis 12 Kohlenstoffatomen, substituiertem oder unsubstituiertem Alkylgermanyl mit 3 bis 12 Kohlenstoffatomen, einer Cyanogruppe und Kombinationen davon, und
wobei Rₓ, R und Rᵤ weiter vorzugsweise bei jedem Auftreten identisch oder unterschiedlich aus der Gruppe bestehend aus Folgendem ausgewählt sind: Wasserstoff, Deuterium, Fluor, einer Cyanogruppe, Methyl, Ethyl, Propyl, Isopropyl, *n*-Butyl, Isobutyl, Neopentyl, *tert*-Butyl, Cyclopentyl, Cyclohexyl, deuteriertem Methyl, deuteriertem Ethyl, deuteriertem Propyl, deuteriertem Isopropyl, deuteriertem n-Butyl, deuteriertem Isobutyl, deuteriertem Neopentyl, deuteriertem *tert*-Butyl, deuteriertem Cyclopentyl, deuteriertem Cyclohexyl, Phenyl, Pyridyl, Trimethylsilyl, Trimethylgermanyl sowie Kombinationen davon.

6. Metallkomplex nach Anspruch 3, wobei Y₃ bis Y₆ bei jedem Auftreten identisch oder unterschiedlich CR oder N sind, mindestens eines der Elemente Y₃ bis Y₆ aus CR ausgewählt ist und R aus der Gruppe bestehend aus Folgendem ausgewählt ist: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen und Kombinationen davon, und wobei
R vorzugsweise aus der Gruppe bestehend aus Folgendem ausgewählt ist: Deuterium, Fluor, substituiertem oder unsubstituiertem Alkyl mit 1 bis 6 Kohlenstoffatomen, substituiertem oder unsubstituiertem Cycloalkyl mit 3 bis 6 Ringkohlenstoffatomen, substituiertem oder unsubstituiertem Aryl mit 6 bis 12 Kohlenstoffatomen sowie Kombinationen davon.

7. Metallkomplex nach Anspruch 1 oder 3, wobei mindestens eines der Elemente X₃ bis X₆ aus CRₓ ausgewählt ist und Rₓ aus der Gruppe bestehend aus Folgendem ausgewählt ist: Deuterium, Halogen, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Heteroalkyl mit 1 bis 20 Kohlenstoffatomen, einer substituierten oder unsubstituierten heterocyclischen Gruppe mit 3 bis 20 Ringatomen, substituiertem oder unsubstituiertem Arylalkyl mit 7 bis 30 Kohlenstoffatomen, substituiertem oder unsubstituiertem Alkoxy mit 1 bis 20 Kohlenstoffatomen, substituiertem oder unsubstituiertem Aryloxy mit 6 bis 30 Kohlenstoffatomen, substituiertem oder unsubstituiertem Alkenyl mit 2 bis 20 Kohlenstoffatomen, substituiertem oder unsubstituiertem Alkynyl mit 2 bis 20 Kohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen, substituiertem oder unsubstituiertem Alkylsilyl mit 3 bis 20 Kohlenstoffatomen, substituiertem oder unsubstituiertem Arylsilyl mit 6 bis 20 Kohlenstoffatomen, substituiertem oder unsubstituiertem Alkylgermanyl mit 3 bis 20 Kohlenstoffatomen, substituiertem oder unsubstituiertem Arylgermanyl mit 6 bis 20 Kohlenstoffatomen, substituiertem oder unsubstituiertem Amino mit 0 bis 20 Kohlenstoffatomen, einer Acylgruppe, einer Carbonylgruppe, einer Carbonsäuregruppe, einer Estergruppe, einer Cyanogruppe, einer Isocyanogruppe, einer Hydroxygruppe, einer Sulfanylgruppe, einer Sulfinylgruppe, einer Sulfonylgruppe, einer Phosphinogruppe und Kombinationen davon,
wobei X₆ aus CRₓ ausgewählt ist und Rₓ aus der Gruppe bestehend aus Folgendem ausgewählt ist: Deuterium, substituiertem oder unsubstituiertem Alkyl mit 1 bis 20 Kohlenstoffatomen, substituiertem oder unsubstituiertem Cycloalkyl mit 3 bis 20 Ringkohlenstoffatomen, substituiertem oder unsubstituiertem Aryl mit 6 bis 30 Kohlenstoffatomen, substituiertem oder unsubstituiertem Heteroaryl mit 3 bis 30 Kohlenstoffatomen und Kombinationen davon, und wobei
X₆ weiter vorzugsweise aus CRₓ ausgewählt ist und Rₓ aus substituiertem oder unsubstituiertem Aryl mit 6 bis 18 Kohlenstoffatomen, substituiertem oder unsubstituiertem Heteroaryl mit 3 bis 18 Kohlenstoffatomen oder einer Kombination davon ausgewählt ist.

8. Metallkomplex nach einem der Ansprüche 1 bis 7, wobei Rₙ bei jedem Auftreten identisch oder unterschiedlich aus der Gruppe bestehend aus Folgendem ausgewählt ist: 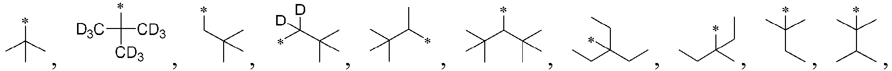 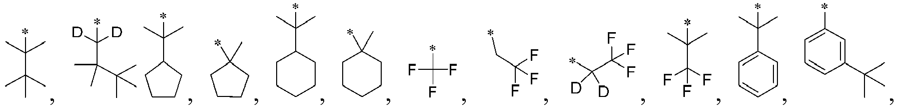 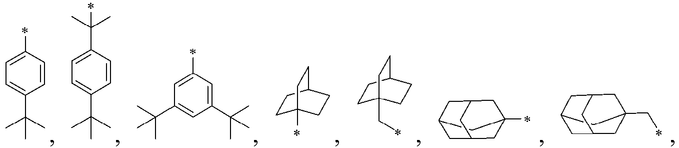 wobei Wasserstoffe in dem obigen Rₙ optional teilweise oder vollständig mit Deuterium substituiert sein können.

9. Metallkomplex nach Anspruch 3, wobei mindestens eines oder mindestens zwei der Elemente U₁ bis U₈ aus CRᵤ ausgewählt sind und Rᵤ aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen oder einer Kombination davon ausgewählt ist und die Gesamtzahl von Kohlenstoffatomen in allen Rᵤ mindestens 4 beträgt, und
wobei vorzugsweise mindestens eines oder mindestens zwei der Elemente U₁ bis U₄ und/oder U₅ bis U₈ aus CRᵤ ausgewählt sind, Rᵤ aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen oder einer Kombination davon ausgewählt ist und die Gesamtzahl von Kohlenstoffatomen in allen Rᵤ mindestens 4 beträgt.

10. Metallkomplex nach Anspruch 3, wobei mindestens eines der Elemente U₁ bis U₄ aus CRᵤ ausgewählt ist, mindestens eines der Elemente Y₃ bis Y₆ aus CR ausgewählt ist, Rᵤ und R aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen oder einer Kombination davon ausgewählt sind und die Gesamtzahl von Kohlenstoffatomen in Rᵤ und R größer oder gleich 2 ist, oder
mindestens eines der Elemente U₅ bis U₈ aus CRᵤ ausgewählt ist, mindestens eines der Elemente Y₃ bis Y₆ aus CR ausgewählt ist, Rᵤ und R aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen oder einer Kombination davon ausgewählt sind und die Gesamtzahl von Kohlenstoffatomen in Rᵤ und R größer oder gleich 2 ist, oder
mindestens eines der Elemente U₁ bis U₄ aus CRᵤ ausgewählt ist, mindestens eines der Elemente U₅ bis U₈ aus CRᵤ ausgewählt ist, Rᵤ aus substituiertem oder unsubstituiertem Alkyl mit 1 bis 20 Kohlenstoffatomen, substituiertem oder unsubstituiertem Cycloalkyl mit 3 bis 20 Ringkohlenstoffatomen oder einer Kombination davon ausgewählt ist und die Gesamtzahl von Kohlenstoffatomen in Rᵤ größer oder gleich 2 ist.

11. Metallkomplex nach Anspruch 1, wobei Lₐ bei jedem Auftreten identisch oder unterschiedlich aus der Gruppe bestehend aus Lₐ₁ bis Lₐ₃₅₃₀ ausgewählt ist,
wobei Lₐ₁ bis Lₐ₃₄₅₇ jeweils die folgende Struktur aufweisen: 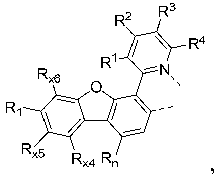 wobei R₁, Rₙ, Rₓ₄, Rₓ₅, Rₓ₆ und R¹ bis R⁴ aus den Atomen oder Gruppen in der folgenden Tabelle ausgewählt sind:
| Lₐ No. | Rₙ | R₁ | Rx₄ | Rx₅ | Rx₆ | R¹ | R² | R³ | R⁴ |
|---|---|---|---|---|---|---|---|---|---|
| Lₐ₁ | P6 | CN | H | H | H | H | H | H | H |
| Lₐ₂ | P6 | CN | H | H | H | H | P1 | H | H |
| Lₐ₃ | P6 | CN | H | H | H | H | P2 | H | H |
| Lₐ₄ | P6 | CN | H | H | H | H | P3 | H | H |
| Lₐ₅ | P6 | CN | H | H | H | H | P4 | H | H |
| Lₐ₆ | P6 | CN | H | H | H | H | P5 | H | H |
| Lₐ₇ | P6 | CN | H | H | H | H | P6 | H | H |
| Lₐ₈ | P6 | CN | H | H | H | H | P7 | H | H |
| Lₐ₉ | P6 | CN | H | H | H | H | P8 | H | H |
| Lₐ₁₀ | P6 | CN | H | H | H | H | P9 | H | H |
| Lₐ₁₁ | P6 | CN | H | H | H | H | P10 | H | H |
| Lₐ₁₂ | P6 | CN | H | H | H | H | P11 | H | H |
| Lₐ₁₃ | P6 | CN | H | H | H | H | P12 | H | H |
| Lₐ₁₄ | P6 | CN | H | H | H | H | P13 | H | H |
| Lₐ₁₅ | P6 | CN | H | H | H | H | P14 | H | H |
| Lₐ₁₆ | P6 | CN | H | H | H | H | P15 | H | H |
| Lₐ₁₇ | P6 | CN | H | H | H | H | P16 | H | H |
| Lₐ₁₈ | P6 | CN | H | H | H | H | P17 | H | H |
| Lₐ₁₉ | P6 | CN | H | H | H | H | P18 | H | H |
| Lₐ₂₀ | P6 | CN | H | H | H | H | P19 | H | H |
| Lₐ₂₁ | P6 | CN | H | H | H | H | P20 | H | H |
| Lₐ₂₂ | P6 | CN | H | H | H | H | P21 | H | H |
| Lₐ₂₃ | P6 | CN | H | H | H | H | P1 | F | H |
| Lₐ₂₄ | P6 | CN | H | H | H | H | P2 | F | H |
| Lₐ₂₅ | P6 | CN | H | H | H | H | P3 | F | H |
| Lₐ₂₆ | P6 | CN | H | H | H | H | P4 | F | H |
| Lₐ₂₇ | P6 | CN | H | H | H | H | P5 | F | H |
| Lₐ₂₈ | P6 | CN | H | H | H | H | P6 | F | H |
| Lₐ₂₉ | P6 | CN | H | H | H | H | P7 | F | H |
| Lₐ₃₀ | P6 | CN | H | H | H | H | P8 | F | H |
| Lₐ₃₁ | P6 | CN | H | H | H | H | P9 | F | H |
| Lₐ₃₂ | P6 | CN | H | H | H | H | P10 | F | H |
| Lₐ₃₃ | P6 | CN | H | H | H | H | P11 | F | H |
| Lₐ₃₄ | P6 | CN | H | H | H | H | P12 | F | H |
| Lₐ₃₅ | P6 | CN | H | H | H | H | P13 | F | H |
| Lₐ₃₆ | P6 | CN | H | H | H | H | P14 | F | H |
| Lₐ₃₇ | P6 | CN | H | H | H | H | P15 | F | H |
| Lₐ₃₈ | P6 | CN | H | H | H | H | P16 | F | H |
| Lₐ₃₉ | P6 | CN | H | H | H | H | P17 | F | H |
| Lₐ₄₀ | P6 | CN | H | H | H | H | P18 | F | H |
| Lₐ₄₁ | P6 | CN | H | H | H | H | P19 | F | H |
| Lₐ₄₂ | P6 | CN | H | H | H | H | P20 | F | H |
| Lₐ₄₃ | P6 | CN | H | H | H | H | P21 | F | H |
| Lₐ₄₄ | P6 | CN | H | H | H | H | H | P1 | H |
| Lₐ₄₅ | P6 | CN | H | H | H | H | H | P2 | H |
| Lₐ₄₆ | P6 | CN | H | H | H | H | H | P3 | H |
| Lₐ₄₇ | P6 | CN | H | H | H | H | H | P4 | H |
| Lₐ₄₈ | P6 | CN | H | H | H | H | H | P5 | H |
| Lₐ₄₉ | P6 | CN | H | H | H | H | H | P6 | H |
| Lₐ₅₀ | P6 | CN | H | H | H | H | H | P7 | H |
| Lₐ₅₁ | P6 | CN | H | H | H | H | H | P8 | H |
| Lₐ₅₂ | P6 | CN | H | H | H | H | H | P9 | H |
| Lₐ₅₃ | P6 | CN | H | H | H | H | H | P10 | H |
| Lₐ₅₄ | P6 | CN | H | H | H | H | H | P11 | H |
| Lₐ₅₅ | P6 | CN | H | H | H | H | H | P12 | H |
| Lₐ₅₆ | P6 | CN | H | H | H | H | H | P13 | H |
| Lₐ₅₇ | P6 | CN | H | H | H | H | H | P14 | H |
| Lₐ₅₈ | P6 | CN | H | H | H | H | H | P15 | H |
| Lₐ₅₉ | P6 | CN | H | H | H | H | H | P16 | H |
| Lₐ₆₀ | P6 | CN | H | H | H | H | H | P17 | H |
| Lₐ₆₁ | P6 | CN | H | H | H | H | H | P18 | H |
| Lₐ₆₂ | P6 | CN | H | H | H | H | H | P19 | H |
| Lₐ₆₃ | P6 | CN | H | H | H | H | H | P20 | H |
| Lₐ₆₄ | P6 | CN | H | H | H | H | H | P21 | H |
| Lₐ₆₅ | P6 | CN | H | H | H | H | F | P1 | H |
| Lₐ₆₆ | P6 | CN | H | H | H | H | F | P2 | H |
| Lₐ₆₇ | P6 | CN | H | H | H | H | F | P3 | H |
| Lₐ₆₈ | P6 | CN | H | H | H | H | F | P4 | H |
| Lₐ₆₉ | P6 | CN | H | H | H | H | F | P5 | H |
| Lₐ₇₀ | P6 | CN | H | H | H | H | F | P6 | H |
| Lₐ₇₁ | P6 | CN | H | H | H | H | F | P7 | H |
| Lₐ₇₂ | P6 | CN | H | H | H | H | F | P8 | H |
| Lₐ₇₃ | P6 | CN | H | H | H | H | F | P9 | H |
| Lₐ₇₄ | P6 | CN | H | H | H | H | F | P10 | H |
| Lₐ₇₅ | P6 | CN | H | H | H | H | F | P11 | H |
| Lₐ₇₆ | P6 | CN | H | H | H | H | F | P12 | H |
| Lₐ₇₇ | P6 | CN | H | H | H | H | F | P13 | H |
| Lₐ₇₈ | P6 | CN | H | H | H | H | F | P14 | H |
| Lₐ₇₉ | P6 | CN | H | H | H | H | F | P15 | H |
| Lₐ₈₀ | P6 | CN | H | H | H | H | F | P16 | H |
| Lₐ₈₁ | P6 | CN | H | H | H | H | F | P17 | H |
| Lₐ₈₂ | P6 | CN | H | H | H | H | F | P18 | H |
| Lₐ₈₃ | P6 | CN | H | H | H | H | F | P19 | H |
| Lₐ₈₄ | P6 | CN | H | H | H | H | F | P20 | H |
| Lₐ₈₅ | P6 | CN | H | H | H | H | F | P21 | H |
| Lₐ₈₆ | P6 | CN | H | H | H | H | P1 | P1 | H |
| Lₐ₈₇ | P6 | CN | H | H | H | H | P1 | P3 | H |
| Lₐ₈₈ | P6 | CN | H | H | H | H | P1 | P8 | H |
| Lₐ₈₉ | P6 | CN | H | H | H | H | P1 | P10 | H |
| Lₐ₉₀ | P6 | CN | H | H | H | H | P1 | P20 | H |
| Lₐ₉₁ | P6 | CN | H | H | H | H | P1 | P21 | H |
| Lₐ₉₂ | P6 | CN | H | H | H | H | P2 | P2 | H |
| Lₐ₉₃ | P6 | CN | H | H | H | H | P2 | P4 | H |
| Lₐ₉₄ | P6 | CN | H | H | H | H | P2 | P5 | H |
| Lₐ₉₅ | P6 | CN | H | H | H | H | P2 | P9 | H |
| Lₐ₉₆ | P6 | CN | H | H | H | H | P2 | P11 | H |
| Lₐ₉₇ | P6 | CN | H | H | H | H | P2 | P20 | H |
| Lₐ₉₈ | P6 | CN | H | H | H | H | P2 | P21 | H |
| Lₐ₉₉ | P6 | CN | H | H | H | D | D | D | D |
| Lₐ₁₀₀ | P6 | CN | H | H | H | D | F | D | D |
| Lₐ₁₀₁ | P6 | CN | H | H | H | D | D | F | D |
| Lₐ₁₀₂ | P6 | CN | H | H | H | D | P2 | D | D |
| Lₐ₁₀₃ | P6 | CN | H | H | H | D | D | P2 | D |
| Lₐ₁₀₄ | P6 | CN | H | H | H | D | P2 | P2 | D |
| Lₐ₁₀₅ | P6 | CN | H | H | D | H | H | H | H |
| Lₐ₁₀₆ | P6 | CN | H | H | D | H | P6 | H | H |
| Lₐ₁₀₇ | P6 | CN | H | H | D | H | P2 | H | H |
| Lₐ₁₀₈ | P6 | CN | H | H | D | H | P5 | H | H |
| Lₐ₁₀₉ | P6 | CN | H | H | D | H | P10 | H | H |
| Lₐ₁₁₀ | P6 | CN | H | H | D | H | P11 | H | H |
| Lₐ₁₁₁ | P6 | CN | H | H | D | H | H | P6 | H |
| Lₐ₁₁₂ | P6 | CN | H | H | D | H | H | P2 | H |
| Lₐ₁₁₃ | P6 | CN | H | H | D | H | H | P4 | H |
| Lₐ₁₁₄ | P6 | CN | H | H | D | H | H | P5 | H |
| Lₐ₁₁₅ | P6 | CN | H | H | D | H | H | P10 | H |
| Lₐ₁₁₆ | P6 | CN | H | H | D | H | H | P11 | H |
| Lₐ₁₁₇ | P6 | CN | H | H | D | H | P1 | F | H |
| Lₐ₁₁₈ | P6 | CN | H | H | D | H | P2 | F | H |
| Lₐ₁₁₉ | P6 | CN | H | H | D | H | P11 | F | H |
| Lₐ₁₂₀ | P6 | CN | H | H | D | H | F | P1 | H |
| Lₐ₁₂₁ | P6 | CN | H | H | D | H | F | P2 | H |
| Lₐ₁₂₂ | P6 | CN | H | H | D | H | F | P3 | H |
| Lₐ₁₂₃ | P6 | CN | H | H | D | H | F | P4 | H |
| Lₐ₁₂₄ | P6 | CN | H | H | D | H | F | P5 | H |
| Lₐ₁₂₅ | P6 | CN | H | H | D | H | F | P8 | H |
| Lₐ₁₂₆ | P6 | CN | H | H | D | H | F | P11 | H |
| Lₐ₁₂₇ | P6 | CN | H | H | D | H | P1 | P1 | H |
| Lₐ₁₂₈ | P6 | CN | H | H | D | H | P2 | P2 | H |
| Lₐ₁₂₉ | P6 | CN | H | H | D | H | P2 | P2 | D |
| Lₐ₁₃₀ | P6 | CN | H | H | P20 | H | H | H | H |
| Lₐ₁₃₁ | P6 | CN | H | H | P20 | H | P1 | H | H |
| Lₐ₁₃₂ | P6 | CN | H | H | P20 | H | P2 | H | H |
| Lₐ₁₃₃ | P6 | CN | H | H | P20 | H | P3 | H | H |
| Lₐ₁₃₄ | P6 | CN | H | H | P20 | H | P4 | H | H |
| Lₐ₁₃₅ | P6 | CN | H | H | P20 | H | P5 | H | H |
| Lₐ₁₃₆ | P6 | CN | H | H | P20 | H | P6 | H | H |
| Lₐ₁₃₇ | P6 | CN | H | H | P20 | H | P7 | H | H |
| Lₐ₁₃₈ | P6 | CN | H | H | P20 | H | P8 | H | H |
| Lₐ₁₃₉ | P6 | CN | H | H | P20 | H | P9 | H | H |
| Lₐ₁₄₀ | P6 | CN | H | H | P20 | H | P10 | H | H |
| Lₐ₁₄₁ | P6 | CN | H | H | P20 | H | P11 | H | H |
| Lₐ₁₄₂ | P6 | CN | H | H | P20 | H | P12 | H | H |
| Lₐ₁₄₃ | P6 | CN | H | H | P20 | H | P13 | H | H |
| Lₐ₁₄₄ | P6 | CN | H | H | P20 | H | P14 | H | H |
| Lₐ₁₄₅ | P6 | CN | H | H | P20 | H | P15 | H | H |
| Lₐ₁₄₆ | P6 | CN | H | H | P20 | H | P16 | H | H |
| Lₐ₁₄₇ | P6 | CN | H | H | P20 | H | P17 | H | H |
| Lₐ₁₄₈ | P6 | CN | H | H | P20 | H | P18 | H | H |
| Lₐ₁₄₉ | P6 | CN | H | H | P20 | H | P19 | H | H |
| Lₐ₁₅₀ | P6 | CN | H | H | P20 | H | P20 | H | H |
| Lₐ₁₅₁ | P6 | CN | H | H | P20 | H | P21 | H | H |
| Lₐ₁₅₂ | P6 | CN | H | H | P20 | H | H | P1 | H |
| Lₐ₁₅₃ | P6 | CN | H | H | P20 | H | H | P2 | H |
| Lₐ₁₅₄ | P6 | CN | H | H | P20 | H | H | P3 | H |
| Lₐ₁₅₅ | P6 | CN | H | H | P20 | H | H | P4 | H |
| Lₐ₁₅₆ | P6 | CN | H | H | P20 | H | H | P5 | H |
| Lₐ₁₅₇ | P6 | CN | H | H | P20 | H | H | P6 | H |
| Lₐ₁₅₈ | P6 | CN | H | H | P20 | H | H | P7 | H |
| Lₐ₁₅₉ | P6 | CN | H | H | P20 | H | H | P8 | H |
| Lₐ₁₆₀ | P6 | CN | H | H | P20 | H | H | P9 | H |
| Lₐ₁₆₁ | P6 | CN | H | H | P20 | H | H | P10 | H |
| Lₐ₁₆₂ | P6 | CN | H | H | P20 | H | H | P11 | H |
| Lₐ₁₆₃ | P6 | CN | H | H | P20 | H | H | P12 | H |
| Lₐ₁₆₄ | P6 | CN | H | H | P20 | H | H | P15 | H |
| Lₐ₁₆₅ | P6 | CN | H | H | P20 | H | H | P17 | H |
| Lₐ₁₆₆ | P6 | CN | H | H | P20 | H | H | P18 | H |
| Lₐ₁₆₇ | P6 | CN | H | H | P20 | H | H | P19 | H |
| Lₐ₁₆₈ | P6 | CN | H | H | P20 | H | H | P20 | H |
| Lₐ₁₆₉ | P6 | CN | H | H | P20 | H | H | P21 | H |
| Lₐ₁₇₀ | P6 | CN | H | H | P20 | H | F | H | H |
| Lₐ₁₇₁ | P6 | CN | H | H | P20 | H | F | P1 | H |
| Lₐ₁₇₂ | P6 | CN | H | H | P20 | H | F | P2 | H |
| Lₐ₁₇₃ | P6 | CN | H | H | P20 | H | F | P3 | H |
| Lₐ₁₇₄ | P6 | CN | H | H | P20 | H | F | P4 | H |
| Lₐ₁₇₅ | P6 | CN | H | H | P20 | H | F | P5 | H |
| Lₐ₁₇₆ | P6 | CN | H | H | P20 | H | F | P6 | H |
| Lₐ₁₇₇ | P6 | CN | H | H | P20 | H | F | P7 | H |
| Lₐ₁₇₈ | P6 | CN | H | H | P20 | H | F | P8 | H |
| Lₐ₁₇₉ | P6 | CN | H | H | P20 | H | F | P9 | H |
| Lₐ₁₈₀ | P6 | CN | H | H | P20 | H | F | P10 | H |
| Lₐ₁₈₁ | P6 | CN | H | H | P20 | H | F | P11 | H |
| Lₐ₁₈₂ | P6 | CN | H | H | P20 | H | P1 | F | H |
| Lₐ₁₈₃ | P6 | CN | H | H | P20 | H | P2 | F | H |
| Lₐ₁₈₄ | P6 | CN | H | H | P20 | H | P3 | F | H |
| Lₐ₁₈₅ | P6 | CN | H | H | P20 | H | P4 | F | H |
| Lₐ₁₈₆ | P6 | CN | H | H | P20 | H | P5 | F | H |
| Lₐ₁₈₇ | P6 | CN | H | H | P20 | H | P6 | F | H |
| Lₐ₁₈₈ | P6 | CN | H | H | P20 | H | P7 | F | H |
| Lₐ₁₈₉ | P6 | CN | H | H | P20 | H | P8 | F | H |
| Lₐ₁₉₀ | P6 | CN | H | H | P20 | H | P9 | F | H |
| Lₐ₁₉₁ | P6 | CN | H | H | P20 | H | P10 | F | H |
| Lₐ₁₉₂ | P6 | CN | H | H | P20 | H | P11 | F | H |
| Lₐ₁₉₃ | P6 | CN | H | H | P20 | H | P1 | P1 | H |
| Lₐ₁₉₄ | P6 | CN | H | H | P20 | H | P2 | P2 | H |
| Lₐ₁₉₅ | P6 | CN | H | H | P20 | D | D | D | D |
| Lₐ₁₉₆ | P6 | CN | H | H | P20 | D | P2 | P2 | D |
| Lₐ₁₉₇ | P6 | CN | H | H | P20 | D | F | P4 | D |
| Lₐ₁₉₈ | P6 | CN | H | H | P20 | D | F | P5 | D |
| Lₐ₁₉₉ | P6 | CN | H | H | P20 | D | F | P9 | D |
| Lₐ₂₀₀ | P6 | CN | H | H | P20 | D | F | P11 | D |
| Lₐ₂₀₁ | P6 | CN | H | H | P21 | H | H | H | H |
| Lₐ₂₀₂ | P6 | CN | H | H | P21 | H | P1 | H | H |
| Lₐ₂₀₃ | P6 | CN | H | H | P21 | H | P2 | H | H |
| Lₐ₂₀₄ | P6 | CN | H | H | P21 | H | P3 | H | H |
| Lₐ₂₀₅ | P6 | CN | H | H | P21 | H | P4 | H | H |
| Lₐ₂₀₆ | P6 | CN | H | H | P21 | H | P5 | H | H |
| Lₐ₂₀₇ | P6 | CN | H | H | P21 | H | P6 | H | H |
| Lₐ₂₀₈ | P6 | CN | H | H | P21 | H | P7 | H | H |
| Lₐ₂₀₉ | P6 | CN | H | H | P21 | H | P8 | H | H |
| Lₐ₂₁₀ | P6 | CN | H | H | P21 | H | P9 | H | H |
| Lₐ₂₁₁ | P6 | CN | H | H | P21 | H | P10 | H | H |
| Lₐ₂₁₂ | P6 | CN | H | H | P21 | H | P11 | H | H |
| Lₐ₂₁₃ | P6 | CN | H | H | P21 | H | P12 | H | H |
| Lₐ₂₁₄ | P6 | CN | H | H | P21 | H | P13 | H | H |
| Lₐ₂₁₅ | P6 | CN | H | H | P21 | H | P14 | H | H |
| Lₐ₂₁₆ | P6 | CN | H | H | P21 | H | P15 | H | H |
| Lₐ₂₁₇ | P6 | CN | H | H | P21 | H | P16 | H | H |
| Lₐ₂₁₈ | P6 | CN | H | H | P21 | H | P17 | H | H |
| Lₐ₂₁₉ | P6 | CN | H | H | P21 | H | P18 | H | H |
| Lₐ₂₂₀ | P6 | CN | H | H | P21 | H | P19 | H | H |
| Lₐ₂₂₁ | P6 | CN | H | H | P21 | H | P20 | H | H |
| Lₐ₂₂₂ | P6 | CN | H | H | P21 | H | P21 | H | H |
| Lₐ₂₂₃ | P6 | CN | H | H | P21 | H | H | P1 | H |
| Lₐ₂₂₄ | P6 | CN | H | H | P21 | H | H | P2 | H |
| Lₐ₂₂₅ | P6 | CN | H | H | P21 | H | H | P3 | H |
| Lₐ₂₂₆ | P6 | CN | H | H | P21 | H | H | P4 | H |
| Lₐ₂₂₇ | P6 | CN | H | H | P21 | H | H | P5 | H |
| Lₐ₂₂₈ | P6 | CN | H | H | P21 | H | H | P6 | H |
| Lₐ₂₂₉ | P6 | CN | H | H | P21 | H | H | P7 | H |
| Lₐ₂₃₀ | P6 | CN | H | H | P21 | H | H | P8 | H |
| Lₐ₂₃₁ | P6 | CN | H | H | P21 | H | H | P9 | H |
| Lₐ₂₃₂ | P6 | CN | H | H | P21 | H | H | P10 | H |
| Lₐ₂₃₃ | P6 | CN | H | H | P21 | H | H | P11 | H |
| Lₐ₂₃₄ | P6 | CN | H | H | P21 | H | H | P12 | H |
| Lₐ₂₃₅ | P6 | CN | H | H | P21 | H | H | P15 | H |
| Lₐ₂₃₆ | P6 | CN | H | H | P21 | H | H | P17 | H |
| Lₐ₂₃₇ | P6 | CN | H | H | P21 | H | H | P18 | H |
| Lₐ₂₃₈ | P6 | CN | H | H | P21 | H | H | P19 | H |
| Lₐ₂₃₉ | P6 | CN | H | H | P21 | H | H | P20 | H |
| Lₐ₂₄₀ | P6 | CN | H | H | P21 | H | H | P21 | H |
| Lₐ₂₄₁ | P6 | CN | H | H | P21 | H | F | H | H |
| Lₐ₂₄₂ | P6 | CN | H | H | P21 | H | F | P1 | H |
| Lₐ₂₄₃ | P6 | CN | H | H | P21 | H | F | P2 | H |
| Lₐ₂₄₄ | P6 | CN | H | H | P21 | H | F | P3 | H |
| Lₐ₂₄₅ | P6 | CN | H | H | P21 | H | F | P4 | H |
| Lₐ₂₄₆ | P6 | CN | H | H | P21 | H | F | P5 | H |
| Lₐ₂₄₇ | P6 | CN | H | H | P21 | H | F | P6 | H |
| Lₐ₂₄₈ | P6 | CN | H | H | P21 | H | F | P7 | H |
| Lₐ₂₄₉ | P6 | CN | H | H | P21 | H | F | P8 | H |
| Lₐ₂₅₀ | P6 | CN | H | H | P21 | H | F | P9 | H |
| Lₐ₂₅₁ | P6 | CN | H | H | P21 | H | F | P10 | H |
| Lₐ₂₅₂ | P6 | CN | H | H | P21 | H | F | P11 | H |
| Lₐ₂₅₃ | P6 | CN | H | H | P21 | H | P1 | F | H |
| Lₐ₂₅₄ | P6 | CN | H | H | P21 | H | P2 | F | H |
| Lₐ₂₅₅ | P6 | CN | H | H | P21 | H | P3 | F | H |
| Lₐ₂₅₆ | P6 | CN | H | H | P21 | H | P4 | F | H |
| Lₐ₂₅₇ | P6 | CN | H | H | P21 | H | P5 | F | H |
| Lₐ₂₅₈ | P6 | CN | H | H | P21 | H | P6 | F | H |
| Lₐ₂₅₉ | P6 | CN | H | H | P21 | H | P7 | F | H |
| Lₐ₂₆₀ | P6 | CN | H | H | P21 | H | P8 | F | H |
| Lₐ₂₆₁ | P6 | CN | H | H | P21 | H | P9 | F | H |
| Lₐ₂₆₂ | P6 | CN | H | H | P21 | H | P10 | F | H |
| Lₐ₂₆₃ | P6 | CN | H | H | P21 | H | P11 | F | H |
| Lₐ₂₆₄ | P6 | CN | H | H | P21 | H | P1 | P1 | H |
| Lₐ₂₆₅ | P6 | CN | H | H | P21 | H | P2 | P2 | H |
| Lₐ₂₆₆ | P6 | CN | H | H | P21 | D | D | D | D |
| Lₐ₂₆₇ | P6 | CN | H | H | P21 | D | P2 | P2 | D |
| Lₐ₂₆₈ | P6 | CN | H | H | P21 | D | F | P4 | D |
| Lₐ₂₆₉ | P6 | CN | H | H | P21 | D | F | P5 | D |
| Lₐ₂₇₀ | P6 | CN | H | H | P21 | D | F | P9 | D |
| Lₐ₂₇₁ | P6 | CN | H | H | P21 | D | F | P11 | D |
| Lₐ₂₇₂ | P6 | CN | H | H | P54 | H | H | H | H |
| Lₐ₂₇₃ | P6 | CN | H | H | P54 | H | P1 | H | H |
| Lₐ₂₇₄ | P6 | CN | H | H | P54 | H | P2 | H | H |
| Lₐ₂₇₅ | P6 | CN | H | H | P54 | H | P3 | H | H |
| Lₐ₂₇₆ | P6 | CN | H | H | P54 | H | P4 | H | H |
| Lₐ₂₇₇ | P6 | CN | H | H | P54 | H | P5 | H | H |
| Lₐ₂₇₈ | P6 | CN | H | H | P54 | H | P6 | H | H |
| Lₐ₂₇₉ | P6 | CN | H | H | P54 | H | P7 | H | H |
| Lₐ₂₈₀ | P6 | CN | H | H | P54 | H | P8 | H | H |
| Lₐ₂₈₁ | P6 | CN | H | H | P54 | H | P9 | H | H |
| Lₐ₂₈₂ | P6 | CN | H | H | P54 | H | P10 | H | H |
| Lₐ₂₈₃ | P6 | CN | H | H | P54 | H | P11 | H | H |
| Lₐ₂₈₄ | P6 | CN | H | H | P54 | H | P12 | H | H |
| Lₐ₂₈₅ | P6 | CN | H | H | P54 | H | P13 | H | H |
| Lₐ₂₈₆ | P6 | CN | H | H | P54 | H | P14 | H | H |
| Lₐ₂₈₇ | P6 | CN | H | H | P54 | H | P15 | H | H |
| Lₐ₂₈₈ | P6 | CN | H | H | P54 | H | P16 | H | H |
| Lₐ₂₈₉ | P6 | CN | H | H | P54 | H | P17 | H | H |
| Lₐ₂₉₀ | P6 | CN | H | H | P54 | H | P18 | H | H |
| Lₐ₂₉₁ | P6 | CN | H | H | P54 | H | P19 | H | H |
| Lₐ₂₉₂ | P6 | CN | H | H | P54 | H | P20 | H | H |
| Lₐ₂₉₃ | P6 | CN | H | H | P54 | H | P21 | H | H |
| Lₐ₂₉₄ | P6 | CN | H | H | P54 | H | H | P1 | H |
| Lₐ₂₉₅ | P6 | CN | H | H | P54 | H | H | P2 | H |
| Lₐ₂₉₆ | P6 | CN | H | H | P54 | H | H | P3 | H |
| Lₐ₂₉₇ | P6 | CN | H | H | P54 | H | H | P4 | H |
| Lₐ₂₉₈ | P6 | CN | H | H | P54 | H | H | P5 | H |
| Lₐ₂₉₉ | P6 | CN | H | H | P54 | H | H | P6 | H |
| Lₐ₃₀₀ | P6 | CN | H | H | P54 | H | H | P7 | H |
| Lₐ₃₀₁ | P6 | CN | H | H | P54 | H | H | P8 | H |
| Lₐ₃₀₂ | P6 | CN | H | H | P54 | H | H | P9 | H |
| Lₐ₃₀₃ | P6 | CN | H | H | P54 | H | H | P10 | H |
| Lₐ₃₀₄ | P6 | CN | H | H | P54 | H | H | P11 | H |
| Lₐ₃₀₅ | P6 | CN | H | H | P54 | H | H | P12 | H |
| Lₐ₃₀₆ | P6 | CN | H | H | P54 | H | H | P15 | H |
| Lₐ₃₀₇ | P6 | CN | H | H | P54 | H | H | P17 | H |
| Lₐ₃₀₈ | P6 | CN | H | H | P54 | H | H | P18 | H |
| Lₐ₃₀₉ | P6 | CN | H | H | P54 | H | H | P19 | H |
| Lₐ₃₁₀ | P6 | CN | H | H | P54 | H | H | P20 | H |
| Lₐ₃₁₁ | P6 | CN | H | H | P54 | H | H | P21 | H |
| Lₐ₃₁₂ | P6 | CN | H | H | P54 | H | F | H | H |
| Lₐ₃₁₃ | P6 | CN | H | H | P54 | H | F | P1 | H |
| Lₐ₃₁₄ | P6 | CN | H | H | P54 | H | F | P2 | H |
| Lₐ₃₁₅ | P6 | CN | H | H | P54 | H | F | P3 | H |
| Lₐ₃₁₆ | P6 | CN | H | H | P54 | H | F | P4 | H |
| Lₐ₃₁₇ | P6 | CN | H | H | P54 | H | F | P5 | H |
| Lₐ₃₁₈ | P6 | CN | H | H | P54 | H | F | P6 | H |
| Lₐ₃₁₉ | P6 | CN | H | H | P54 | H | F | P7 | H |
| Lₐ₃₂₀ | P6 | CN | H | H | P54 | H | F | P8 | H |
| Lₐ₃₂₁ | P6 | CN | H | H | P54 | H | F | P9 | H |
| Lₐ₃₂₂ | P6 | CN | H | H | P54 | H | F | P10 | H |
| Lₐ₃₂₃ | P6 | CN | H | H | P54 | H | F | P11 | H |
| Lₐ₃₂₄ | P6 | CN | H | H | P54 | H | P1 | F | H |
| Lₐ₃₂₅ | P6 | CN | H | H | P54 | H | P2 | F | H |
| Lₐ₃₂₆ | P6 | CN | H | H | P54 | H | P3 | F | H |
| Lₐ₃₂₇ | P6 | CN | H | H | P54 | H | P4 | F | H |
| Lₐ₃₂₈ | P6 | CN | H | H | P54 | H | P5 | F | H |
| Lₐ₃₂₉ | P6 | CN | H | H | P54 | H | P6 | F | H |
| Lₐ₃₃₀ | P6 | CN | H | H | P54 | H | P7 | F | H |
| Lₐ₃₃₁ | P6 | CN | H | H | P54 | H | P8 | F | H |
| Lₐ₃₃₂ | P6 | CN | H | H | P54 | H | P9 | F | H |
| Lₐ₃₃₃ | P6 | CN | H | H | P54 | H | P10 | F | H |
| Lₐ₃₃₄ | P6 | CN | H | H | P54 | H | P11 | F | H |
| Lₐ₃₃₅ | P6 | CN | H | H | P54 | H | P1 | P1 | H |
| Lₐ₃₃₆ | P6 | CN | H | H | P54 | H | P2 | P2 | H |
| Lₐ₃₃₇ | P6 | CN | H | H | P54 | D | D | D | D |
| Lₐ₃₃₈ | P6 | CN | H | H | P54 | D | P2 | P2 | D |
| Lₐ₃₃₉ | P6 | CN | H | H | P54 | D | F | P4 | D |
| Lₐ₃₄₀ | P6 | CN | H | H | P54 | D | F | P5 | D |
| Lₐ₃₄₁ | P6 | CN | H | H | P54 | D | F | P9 | D |
| Lₐ₃₄₂ | P6 | CN | H | H | P54 | D | F | P11 | D |
| Lₐ₃₄₃ | P6 | CN | H | H | P96 | H | H | H | H |
| Lₐ₃₄₄ | P6 | CN | H | H | P96 | H | P1 | H | H |
| Lₐ₃₄₅ | P6 | CN | H | H | P96 | H | P2 | H | H |
| Lₐ₃₄₆ | P6 | CN | H | H | P96 | H | P3 | H | H |
| Lₐ₃₄₇ | P6 | CN | H | H | P96 | H | P4 | H | H |
| Lₐ₃₄₈ | P6 | CN | H | H | P96 | H | P5 | H | H |
| Lₐ₃₄₉ | P6 | CN | H | H | P96 | H | P6 | H | H |
| Lₐ₃₅₀ | P6 | CN | H | H | P96 | H | P7 | H | H |
| Lₐ₃₅₁ | P6 | CN | H | H | P96 | H | P8 | H | H |
| Lₐ₃₅₂ | P6 | CN | H | H | P96 | H | P9 | H | H |
| Lₐ₃₅₃ | P6 | CN | H | H | P96 | H | P10 | H | H |
| Lₐ₃₅₄ | P6 | CN | H | H | P96 | H | P11 | H | H |
| Lₐ₃₅₅ | P6 | CN | H | H | P96 | H | P12 | H | H |
| Lₐ₃₅₆ | P6 | CN | H | H | P96 | H | P13 | H | H |
| Lₐ₃₅₇ | P6 | CN | H | H | P96 | H | P14 | H | H |
| Lₐ₃₅₈ | P6 | CN | H | H | P96 | H | P15 | H | H |
| Lₐ₃₅₉ | P6 | CN | H | H | P96 | H | P16 | H | H |
| Lₐ₃₆₀ | P6 | CN | H | H | P96 | H | P17 | H | H |
| Lₐ₃₆₁ | P6 | CN | H | H | P96 | H | P18 | H | H |
| Lₐ₃₆₂ | P6 | CN | H | H | P96 | H | P19 | H | H |
| Lₐ₃₆₃ | P6 | CN | H | H | P96 | H | P20 | H | H |
| Lₐ₃₆₄ | P6 | CN | H | H | P96 | H | P21 | H | H |
| Lₐ₃₆₅ | P6 | CN | H | H | P96 | H | H | P1 | H |
| Lₐ₃₆₆ | P6 | CN | H | H | P96 | H | H | P2 | H |
| Lₐ₃₆₇ | P6 | CN | H | H | P96 | H | H | P3 | H |
| Lₐ₃₆₈ | P6 | CN | H | H | P96 | H | H | P4 | H |
| Lₐ₃₆₉ | P6 | CN | H | H | P96 | H | H | P5 | H |
| Lₐ₃₇₀ | P6 | CN | H | H | P96 | H | H | P6 | H |
| Lₐ₃₇₁ | P6 | CN | H | H | P96 | H | H | P7 | H |
| Lₐ₃₇₂ | P6 | CN | H | H | P96 | H | H | P8 | H |
| Lₐ₃₇₃ | P6 | CN | H | H | P96 | H | H | P9 | H |
| Lₐ₃₇₄ | P6 | CN | H | H | P96 | H | H | P10 | H |
| Lₐ₃₇₅ | P6 | CN | H | H | P96 | H | H | P11 | H |
| Lₐ₃₇₆ | P6 | CN | H | H | P96 | H | H | P12 | H |
| Lₐ₃₇₇ | P6 | CN | H | H | P96 | H | H | P15 | H |
| Lₐ₃₇₈ | P6 | CN | H | H | P96 | H | H | P17 | H |
| Lₐ₃₇₉ | P6 | CN | H | H | P96 | H | H | P18 | H |
| Lₐ₃₈₀ | P6 | CN | H | H | P96 | H | H | P19 | H |
| Lₐ₃₈₁ | P6 | CN | H | H | P96 | H | H | P20 | H |
| Lₐ₃₈₂ | P6 | CN | H | H | P96 | H | H | P21 | H |
| Lₐ₃₈₃ | P6 | CN | H | H | P96 | H | F | H | H |
| Lₐ₃₈₄ | P6 | CN | H | H | P96 | H | F | P1 | H |
| Lₐ₃₈₅ | P6 | CN | H | H | P96 | H | F | P2 | H |
| Lₐ₃₈₆ | P6 | CN | H | H | P96 | H | F | P3 | H |
| Lₐ₃₈₇ | P6 | CN | H | H | P96 | H | F | P4 | H |
| Lₐ₃₈₈ | P6 | CN | H | H | P96 | H | F | P5 | H |
| Lₐ₃₈₉ | P6 | CN | H | H | P96 | H | F | P6 | H |
| Lₐ₃₉₀ | P6 | CN | H | H | P96 | H | F | P7 | H |
| Lₐ₃₉₁ | P6 | CN | H | H | P96 | H | F | P8 | H |
| Lₐ₃₉₂ | P6 | CN | H | H | P96 | H | F | P9 | H |
| Lₐ₃₉₃ | P6 | CN | H | H | P96 | H | F | P10 | H |
| Lₐ₃₉₄ | P6 | CN | H | H | P96 | H | F | P11 | H |
| Lₐ₃₉₅ | P6 | CN | H | H | P96 | H | P1 | F | H |
| Lₐ₃₉₆ | P6 | CN | H | H | P96 | H | P2 | F | H |
| Lₐ₃₉₇ | P6 | CN | H | H | P96 | H | P3 | F | H |
| Lₐ₃₉₈ | P6 | CN | H | H | P96 | H | P4 | F | H |
| Lₐ₃₉₉ | P6 | CN | H | H | P96 | H | P5 | F | H |
| Lₐ₄₀₀ | P6 | CN | H | H | P96 | H | P6 | F | H |
| Lₐ₄₀₁ | P6 | CN | H | H | P96 | H | P7 | F | H |
| Lₐ₄₀₂ | P6 | CN | H | H | P96 | H | P8 | F | H |
| Lₐ₄₀₃ | P6 | CN | H | H | P96 | H | P9 | F | H |
| Lₐ₄₀₄ | P6 | CN | H | H | P96 | H | P10 | F | H |
| Lₐ₄₀₅ | P6 | CN | H | H | P96 | H | P11 | F | H |
| Lₐ₄₀₆ | P6 | CN | H | H | P96 | H | P1 | P1 | H |
| Lₐ₄₀₇ | P6 | CN | H | H | P96 | H | P2 | P2 | H |
| Lₐ₄₀₈ | P6 | CN | H | H | P96 | D | D | D | D |
| Lₐ₄₀₉ | P6 | CN | H | H | P96 | D | P2 | P2 | D |
| Lₐ₄₁₀ | P6 | CN | H | H | P96 | D | F | P4 | D |
| Lₐ₄₁₁ | P6 | CN | H | H | P96 | D | F | P5 | D |
| Lₐ₄₁₂ | P6 | CN | H | H | P96 | D | F | P9 | D |
| Lₐ₄₁₃ | P6 | CN | H | H | P96 | D | F | P11 | D |
| Lₐ₄₁₄ | P6 | CN | H | H | P97 | H | H | H | H |
| Lₐ₄₁₅ | P6 | CN | H | H | P97 | H | P1 | H | H |
| Lₐ₄₁₆ | P6 | CN | H | H | P97 | H | P2 | H | H |
| Lₐ₄₁₇ | P6 | CN | H | H | P97 | H | P3 | H | H |
| Lₐ₄₁₈ | P6 | CN | H | H | P97 | H | P4 | H | H |
| Lₐ₄₁₉ | P6 | CN | H | H | P97 | H | P5 | H | H |
| Lₐ₄₂₀ | P6 | CN | H | H | P97 | H | P6 | H | H |
| Lₐ₄₂₁ | P6 | CN | H | H | P97 | H | P7 | H | H |
| Lₐ₄₂₂ | P6 | CN | H | H | P97 | H | P8 | H | H |
| Lₐ₄₂₃ | P6 | CN | H | H | P97 | H | P9 | H | H |
| Lₐ₄₂₄ | P6 | CN | H | H | P97 | H | P10 | H | H |
| Lₐ₄₂₅ | P6 | CN | H | H | P97 | H | P11 | H | H |
| Lₐ₄₂₆ | P6 | CN | H | H | P97 | H | P12 | H | H |
| Lₐ₄₂₇ | P6 | CN | H | H | P97 | H | P13 | H | H |
| Lₐ₄₂₈ | P6 | CN | H | H | P97 | H | P14 | H | H |
| Lₐ₄₂₉ | P6 | CN | H | H | P97 | H | P15 | H | H |
| Lₐ₄₃₀ | P6 | CN | H | H | P97 | H | P16 | H | H |
| Lₐ₄₃₁ | P6 | CN | H | H | P97 | H | P17 | H | H |
| Lₐ₄₃₂ | P6 | CN | H | H | P97 | H | P18 | H | H |
| Lₐ₄₃₃ | P6 | CN | H | H | P97 | H | P19 | H | H |
| Lₐ₄₃₄ | P6 | CN | H | H | P97 | H | P20 | H | H |
| Lₐ₄₃₅ | P6 | CN | H | H | P97 | H | P21 | H | H |
| Lₐ₄₃₆ | P6 | CN | H | H | P97 | H | H | P1 | H |
| Lₐ₄₃₇ | P6 | CN | H | H | P97 | H | H | P2 | H |
| Lₐ₄₃₈ | P6 | CN | H | H | P97 | H | H | P3 | H |
| Lₐ₄₃₉ | P6 | CN | H | H | P97 | H | H | P4 | H |
| Lₐ₄₄₀ | P6 | CN | H | H | P97 | H | H | P5 | H |
| Lₐ₄₄₁ | P6 | CN | H | H | P97 | H | H | P6 | H |
| Lₐ₄₄₂ | P6 | CN | H | H | P97 | H | H | P7 | H |
| Lₐ₄₄₃ | P6 | CN | H | H | P97 | H | H | P8 | H |
| Lₐ₄₄₄ | P6 | CN | H | H | P97 | H | H | P9 | H |
| Lₐ₄₄₅ | P6 | CN | H | H | P97 | H | H | P10 | H |
| Lₐ₄₄₆ | P6 | CN | H | H | P97 | H | H | P11 | H |
| Lₐ₄₄₇ | P6 | CN | H | H | P97 | H | H | P12 | H |
| Lₐ₄₄₈ | P6 | CN | H | H | P97 | H | H | P15 | H |
| Lₐ₄₄₉ | P6 | CN | H | H | P97 | H | H | P17 | H |
| Lₐ₄₅₀ | P6 | CN | H | H | P97 | H | H | P18 | H |
| Lₐ₄₅₁ | P6 | CN | H | H | P97 | H | H | P19 | H |
| Lₐ₄₅₂ | P6 | CN | H | H | P97 | H | H | P20 | H |
| Lₐ₄₅₃ | P6 | CN | H | H | P97 | H | H | P21 | H |
| Lₐ₄₅₄ | P6 | CN | H | H | P97 | H | F | H | H |
| Lₐ₄₅₅ | P6 | CN | H | H | P97 | H | F | P1 | H |
| Lₐ₄₅₆ | P6 | CN | H | H | P97 | H | F | P2 | H |
| Lₐ₄₅₇ | P6 | CN | H | H | P97 | H | F | P3 | H |
| Lₐ₄₅₈ | P6 | CN | H | H | P97 | H | F | P4 | H |
| Lₐ₄₅₉ | P6 | CN | H | H | P97 | H | F | P5 | H |
| Lₐ₄₆₀ | P6 | CN | H | H | P97 | H | F | P6 | H |
| Lₐ₄₆₁ | P6 | CN | H | H | P97 | H | F | P7 | H |
| Lₐ₄₆₂ | P6 | CN | H | H | P97 | H | F | P8 | H |
| Lₐ₄₆₃ | P6 | CN | H | H | P97 | H | F | P9 | H |
| Lₐ₄₆₄ | P6 | CN | H | H | P97 | H | F | P10 | H |
| Lₐ₄₆₅ | P6 | CN | H | H | P97 | H | F | P11 | H |
| Lₐ₄₆₆ | P6 | CN | H | H | P97 | H | P1 | F | H |
| Lₐ₄₆₇ | P6 | CN | H | H | P97 | H | P2 | F | H |
| Lₐ₄₆₈ | P6 | CN | H | H | P97 | H | P3 | F | H |
| Lₐ₄₆₉ | P6 | CN | H | H | P97 | H | P4 | F | H |
| Lₐ₄₇₀ | P6 | CN | H | H | P97 | H | P5 | F | H |
| Lₐ₄₇₁ | P6 | CN | H | H | P97 | H | P6 | F | H |
| Lₐ₄₇₂ | P6 | CN | H | H | P97 | H | P7 | F | H |
| Lₐ₄₇₃ | P6 | CN | H | H | P97 | H | P8 | F | H |
| Lₐ₄₇₄ | P6 | CN | H | H | P97 | H | P9 | F | H |
| Lₐ₄₇₅ | P6 | CN | H | H | P97 | H | P10 | F | H |
| Lₐ₄₇₆ | P6 | CN | H | H | P97 | H | P11 | F | H |
| Lₐ₄₇₇ | P6 | CN | H | H | P97 | H | P1 | P1 | H |
| Lₐ₄₇₈ | P6 | CN | H | H | P97 | H | P2 | P2 | H |
| Lₐ₄₇₉ | P6 | CN | H | H | P97 | D | D | D | D |
| Lₐ₄₈₀ | P6 | CN | H | H | P97 | D | P2 | P2 | D |
| Lₐ₄₈₁ | P6 | CN | H | H | P97 | D | F | P4 | D |
| Lₐ₄₈₂ | P6 | CN | H | H | P97 | D | F | P5 | D |
| Lₐ₄₈₃ | P6 | CN | H | H | P97 | D | F | P9 | D |
| Lₐ₄₈₄ | P6 | CN | H | H | P97 | D | F | P11 | D |
| Lₐ₄₈₅ | P6 | CN | H | H | P102 | H | P1 | H | H |
| Lₐ₄₈₆ | P6 | CN | H | H | P102 | H | P2 | H | H |
| Lₐ₄₈₇ | P6 | CN | H | H | P102 | H | P3 | H | H |
| Lₐ₄₈₈ | P6 | CN | H | H | P102 | H | P4 | H | H |
| Lₐ₄₈₉ | P6 | CN | H | H | P102 | H | P5 | H | H |
| Lₐ₄₉₀ | P6 | CN | H | H | P102 | H | P6 | H | H |
| Lₐ₄₉₁ | P6 | CN | H | H | P102 | H | P7 | H | H |
| Lₐ₄₉₂ | P6 | CN | H | H | P102 | H | P8 | H | H |
| Lₐ₄₉₃ | P6 | CN | H | H | P102 | H | P9 | H | H |
| Lₐ₄₉₄ | P6 | CN | H | H | P102 | H | P10 | H | H |
| Lₐ₄₉₅ | P6 | CN | H | H | P102 | H | P11 | H | H |
| Lₐ₄₉₆ | P6 | CN | H | H | P102 | H | P12 | H | H |
| Lₐ₄₉₇ | P6 | CN | H | H | P102 | H | P13 | H | H |
| Lₐ₄₉₈ | P6 | CN | H | H | P102 | H | P14 | H | H |
| Lₐ₄₉₉ | P6 | CN | H | H | P102 | H | P15 | H | H |
| Lₐ₅₀₀ | P6 | CN | H | H | P102 | H | P16 | H | H |
| Lₐ₅₀₁ | P6 | CN | H | H | P102 | H | P17 | H | H |
| Lₐ₅₀₂ | P6 | CN | H | H | P102 | H | P18 | H | H |
| Lₐ₅₀₃ | P6 | CN | H | H | P102 | H | P19 | H | H |
| Lₐ₅₀₄ | P6 | CN | H | H | P102 | H | P20 | H | H |
| Lₐ₅₀₅ | P6 | CN | H | H | P102 | H | P21 | H | H |
| Lₐ₅₀₆ | P6 | CN | H | H | P102 | H | H | P1 | H |
| Lₐ₅₀₇ | P6 | CN | H | H | P102 | H | H | P2 | H |
| Lₐ₅₀₈ | P6 | CN | H | H | P102 | H | H | P3 | H |
| Lₐ₅₀₉ | P6 | CN | H | H | P102 | H | H | P4 | H |
| Lₐ₅₁₀ | P6 | CN | H | H | P102 | H | H | P5 | H |
| Lₐ₅₁₁ | P6 | CN | H | H | P102 | H | H | P6 | H |
| Lₐ₅₁₂ | P6 | CN | H | H | P102 | H | H | P7 | H |
| Lₐ₅₁₃ | P6 | CN | H | H | P102 | H | H | P8 | H |
| Lₐ₅₁₄ | P6 | CN | H | H | P102 | H | H | P9 | H |
| Lₐ₅₁₅ | P6 | CN | H | H | P102 | H | H | P10 | H |
| Lₐ₅₁₆ | P6 | CN | H | H | P102 | H | H | P11 | H |
| Lₐ₅₁₇ | P6 | CN | H | H | P102 | H | H | P12 | H |
| Lₐ₅₁₈ | P6 | CN | H | H | P102 | H | H | P15 | H |
| Lₐ₅₁₉ | P6 | CN | H | H | P102 | H | H | P17 | H |
| Lₐ₅₂₀ | P6 | CN | H | H | P102 | H | H | P18 | H |
| Lₐ₅₂₁ | P6 | CN | H | H | P102 | H | H | P19 | H |
| Lₐ₅₂₂ | P6 | CN | H | H | P102 | H | H | P20 | H |
| Lₐ₅₂₃ | P6 | CN | H | H | P102 | H | H | P21 | H |
| Lₐ₅₂₄ | P6 | CN | H | H | P102 | H | F | H | H |
| Lₐ₅₂₅ | P6 | CN | H | H | P102 | H | F | P1 | H |
| Lₐ₅₂₆ | P6 | CN | H | H | P102 | H | F | P2 | H |
| Lₐ₅₂₇ | P6 | CN | H | H | P102 | H | F | P3 | H |
| Lₐ₅₂₈ | P6 | CN | H | H | P102 | H | F | P4 | H |
| Lₐ₅₂₉ | P6 | CN | H | H | P102 | H | F | P5 | H |
| Lₐ₅₃₀ | P6 | CN | H | H | P102 | H | F | P6 | H |
| Lₐ₅₃₁ | P6 | CN | H | H | P102 | H | F | P7 | H |
| Lₐ₅₃₂ | P6 | CN | H | H | P102 | H | F | P8 | H |
| Lₐ₅₃₃ | P6 | CN | H | H | P102 | H | F | P9 | H |
| Lₐ₅₃₄ | P6 | CN | H | H | P102 | H | F | P10 | H |
| Lₐ₅₃₅ | P6 | CN | H | H | P102 | H | F | P11 | H |
| Lₐ₅₃₆ | P6 | CN | H | H | P102 | H | P1 | F | H |
| Lₐ₅₃₇ | P6 | CN | H | H | P102 | H | P2 | F | H |
| Lₐ₅₃₈ | P6 | CN | H | H | P102 | H | P3 | F | H |
| Lₐ₅₃₉ | P6 | CN | H | H | P102 | H | P4 | F | H |
| Lₐ₅₄₀ | P6 | CN | H | H | P102 | H | P5 | F | H |
| Lₐ₅₄₁ | P6 | CN | H | H | P102 | H | P6 | F | H |
| Lₐ₅₄₂ | P6 | CN | H | H | P102 | H | P7 | F | H |
| Lₐ₅₄₃ | P6 | CN | H | H | P102 | H | P8 | F | H |
| Lₐ₅₄₄ | P6 | CN | H | H | P102 | H | P9 | F | H |
| Lₐ₅₄₅ | P6 | CN | H | H | P102 | H | P10 | F | H |
| Lₐ₅₄₆ | P6 | CN | H | H | P102 | H | P11 | F | H |
| Lₐ₅₄₇ | P6 | CN | H | H | P102 | H | P1 | P1 | H |
| Lₐ₅₄₈ | P6 | CN | H | H | P102 | H | P2 | P2 | H |
| Lₐ₅₄₉ | P6 | CN | H | H | P102 | D | D | D | D |
| Lₐ₅₅₀ | P6 | CN | H | H | P102 | D | P2 | P2 | D |
| Lₐ₅₅₁ | P6 | CN | H | H | P102 | D | F | P4 | D |
| Lₐ₅₅₂ | P6 | CN | H | H | P102 | D | F | P5 | D |
| Lₐ₅₅₃ | P6 | CN | H | H | P102 | D | F | P9 | D |
| Lₐ₅₅₄ | P6 | CN | H | H | P102 | D | F | P11 | D |
| Lₐ₅₅₅ | P6 | CN | H | H | P103 | H | P1 | H | H |
| Lₐ₅₅₆ | P6 | CN | H | H | P103 | H | P2 | H | H |
| Lₐ₅₅₇ | P6 | CN | H | H | P103 | H | P3 | H | H |
| Lₐ₅₅₈ | P6 | CN | H | H | P103 | H | P4 | H | H |
| Lₐ₅₅₉ | P6 | CN | H | H | P103 | H | P5 | H | H |
| Lₐ₅₆₀ | P6 | CN | H | H | P103 | H | P6 | H | H |
| Lₐ₅₆₁ | P6 | CN | H | H | P103 | H | P7 | H | H |
| Lₐ₅₆₂ | P6 | CN | H | H | P103 | H | P8 | H | H |
| Lₐ₅₆₃ | P6 | CN | H | H | P103 | H | P9 | H | H |
| Lₐ₅₆₄ | P6 | CN | H | H | P103 | H | P10 | H | H |
| Lₐ₅₆₅ | P6 | CN | H | H | P103 | H | P11 | H | H |
| Lₐ₅₆₆ | P6 | CN | H | H | P103 | H | P12 | H | H |
| Lₐ₅₆₇ | P6 | CN | H | H | P103 | H | P13 | H | H |
| Lₐ₅₆₈ | P6 | CN | H | H | P103 | H | P14 | H | H |
| Lₐ₅₆₉ | P6 | CN | H | H | P103 | H | P15 | H | H |
| Lₐ₅₇₀ | P6 | CN | H | H | P103 | H | P16 | H | H |
| Lₐ₅₇₁ | P6 | CN | H | H | P103 | H | P17 | H | H |
| Lₐ₅₇₂ | P6 | CN | H | H | P103 | H | P18 | H | H |
| Lₐ₅₇₃ | P6 | CN | H | H | P103 | H | P19 | H | H |
| Lₐ₅₇₄ | P6 | CN | H | H | P103 | H | P20 | H | H |
| Lₐ₅₇₅ | P6 | CN | H | H | P103 | H | P21 | H | H |
| Lₐ₅₇₆ | P6 | CN | H | H | P103 | H | H | P1 | H |
| Lₐ₅₇₇ | P6 | CN | H | H | P103 | H | H | P2 | H |
| Lₐ₅₇₈ | P6 | CN | H | H | P103 | H | H | P3 | H |
| Lₐ₅₇₉ | P6 | CN | H | H | P103 | H | H | P4 | H |
| Lₐ₅₈₀ | P6 | CN | H | H | P103 | H | H | P5 | H |
| Lₐ₅₈₁ | P6 | CN | H | H | P103 | H | H | P6 | H |
| Lₐ₅₈₂ | P6 | CN | H | H | P103 | H | H | P7 | H |
| Lₐ₅₈₃ | P6 | CN | H | H | P103 | H | H | P8 | H |
| Lₐ₅₈₄ | P6 | CN | H | H | P103 | H | H | P9 | H |
| Lₐ₅₈₅ | P6 | CN | H | H | P103 | H | H | P10 | H |
| Lₐ₅₈₆ | P6 | CN | H | H | P103 | H | H | P11 | H |
| Lₐ₅₈₇ | P6 | CN | H | H | P103 | H | H | P12 | H |
| Lₐ₅₈₈ | P6 | CN | H | H | P103 | H | H | P15 | H |
| Lₐ₅₈₉ | P6 | CN | H | H | P103 | H | H | P17 | H |
| Lₐ₅₉₀ | P6 | CN | H | H | P103 | H | H | P18 | H |
| Lₐ₅₉₁ | P6 | CN | H | H | P103 | H | H | P19 | H |
| Lₐ₅₉₂ | P6 | CN | H | H | P103 | H | H | P20 | H |
| Lₐ₅₉₃ | P6 | CN | H | H | P103 | H | H | P21 | H |
| Lₐ₅₉₄ | P6 | CN | H | H | P103 | H | F | H | H |
| Lₐ₅₉₅ | P6 | CN | H | H | P103 | H | F | P1 | H |
| Lₐ₅₉₆ | P6 | CN | H | H | P103 | H | F | P2 | H |
| Lₐ₅₉₇ | P6 | CN | H | H | P103 | H | F | P3 | H |
| Lₐ₅₉₈ | P6 | CN | H | H | P103 | H | F | P4 | H |
| Lₐ₅₉₉ | P6 | CN | H | H | P103 | H | F | P5 | H |
| Lₐ₆₀₀ | P6 | CN | H | H | P103 | H | F | P6 | H |
| Lₐ₆₀₁ | P6 | CN | H | H | P103 | H | F | P7 | H |
| Lₐ₆₀₂ | P6 | CN | H | H | P103 | H | F | P8 | H |
| Lₐ₆₀₃ | P6 | CN | H | H | P103 | H | F | P9 | H |
| Lₐ₆₀₄ | P6 | CN | H | H | P103 | H | F | P10 | H |
| Lₐ₆₀₅ | P6 | CN | H | H | P103 | H | F | P11 | H |
| Lₐ₆₀₆ | P6 | CN | H | H | P103 | H | P1 | F | H |
| Lₐ₆₀₇ | P6 | CN | H | H | P103 | H | P2 | F | H |
| Lₐ₆₀₈ | P6 | CN | H | H | P103 | H | P3 | F | H |
| Lₐ₆₀₉ | P6 | CN | H | H | P103 | H | P4 | F | H |
| Lₐ₆₁₀ | P6 | CN | H | H | P103 | H | P5 | F | H |
| Lₐ₆₁₁ | P6 | CN | H | H | P103 | H | P6 | F | H |
| Lₐ₆₁₂ | P6 | CN | H | H | P103 | H | P7 | F | H |
| Lₐ₆₁₃ | P6 | CN | H | H | P103 | H | P8 | F | H |
| Lₐ₆₁₄ | P6 | CN | H | H | P103 | H | P9 | F | H |
| Lₐ₆₁₅ | P6 | CN | H | H | P103 | H | P10 | F | H |
| Lₐ₆₁₆ | P6 | CN | H | H | P103 | H | P11 | F | H |
| Lₐ₆₁₇ | P6 | CN | H | H | P103 | H | P1 | P1 | H |
| Lₐ₆₁₈ | P6 | CN | H | H | P103 | H | P2 | P2 | H |
| Lₐ₆₁₉ | P6 | CN | H | H | P103 | D | D | D | D |
| Lₐ₆₂₀ | P6 | CN | H | H | P103 | D | P2 | P2 | D |
| Lₐ₆₂₁ | P6 | CN | H | H | P103 | D | F | P4 | D |
| Lₐ₆₂₂ | P6 | CN | H | H | P103 | D | F | P5 | D |
| Lₐ₆₂₃ | P6 | CN | H | H | P103 | D | F | P9 | D |
| Lₐ₆₂₄ | P6 | CN | H | H | P103 | D | F | P11 | D |
| Lₐ₆₂₅ | P6 | CN | H | H | H | H | P20 | P1 | H |
| Lₐ₆₂₆ | P6 | CN | H | H | H | H | P21 | P2 | H |
| Lₐ₆₂₇ | P6 | CN | H | H | H | H | P29 | H | H |
| Lₐ₆₂₈ | P6 | CN | H | H | H | H | P29 | P1 | H |
| Lₐ₆₂₉ | P6 | CN | H | H | H | H | P54 | H | H |
| Lₐ₆₃₀ | P6 | CN | H | H | H | H | P96 | H | H |
| Lₐ₆₃₁ | P6 | CN | H | H | H | H | P97 | H | H |
| Lₐ₆₃₂ | P6 | CN | H | H | H | H | P96 | P1 | H |
| Lₐ₆₃₃ | P6 | CN | H | H | H | H | P97 | P1 | H |
| Lₐ₆₃₄ | P6 | CN | H | H | H | H | P102 | H | H |
| Lₐ₆₃₅ | P6 | CN | H | H | H | H | P103 | H | H |
| Lₐ₆₃₆ | P6 | CN | H | H | D | H | P20 | P1 | H |
| Lₐ₆₃₇ | P6 | CN | H | H | D | H | P21 | P2 | H |
| Lₐ₆₃₈ | P6 | CN | H | H | D | H | P29 | H | H |
| Lₐ₆₃₉ | P6 | CN | H | H | D | H | P29 | P1 | H |
| Lₐ₆₄₀ | P6 | CN | H | H | D | H | P54 | H | H |
| Lₐ₆₄₁ | P6 | CN | H | H | D | H | P96 | H | H |
| Lₐ₆₄₂ | P6 | CN | H | H | D | H | P97 | H | H |
| Lₐ₆₄₃ | P6 | CN | H | H | D | H | P96 | P1 | H |
| Lₐ₆₄₄ | P6 | CN | H | H | D | H | P97 | P1 | H |
| Lₐ₆₄₅ | P6 | CN | H | H | D | H | P102 | H | H |
| Lₐ₆₄₆ | P6 | CN | H | H | D | H | P103 | H | H |
| Lₐ₆₄₇ | P6 | CN | H | H | P20 | H | P20 | P1 | H |
| Lₐ₆₄₈ | P6 | CN | H | H | P20 | H | P21 | P2 | H |
| Lₐ₆₄₉ | P6 | CN | H | H | P20 | H | P29 | H | H |
| Lₐ₆₅₀ | P6 | CN | H | H | P20 | H | P29 | P1 | H |
| Lₐ₆₅₁ | P6 | CN | H | H | P20 | H | P54 | H | H |
| Lₐ₆₅₂ | P6 | CN | H | H | P20 | H | P96 | H | H |
| Lₐ₆₅₃ | P6 | CN | H | H | P20 | H | P97 | H | H |
| Lₐ₆₅₄ | P6 | CN | H | H | P20 | H | P96 | P1 | H |
| Lₐ₆₅₅ | P6 | CN | H | H | P20 | H | P97 | P1 | H |
| Lₐ₆₅₆ | P6 | CN | H | H | P20 | H | P102 | H | H |
| Lₐ₆₅₇ | P6 | CN | H | H | P20 | H | P103 | H | H |
| Lₐ₆₅₈ | P6 | CN | H | H | P21 | H | P20 | P1 | H |
| Lₐ₆₅₉ | P6 | CN | H | H | P21 | H | P21 | P2 | H |
| Lₐ₆₆₀ | P6 | CN | H | H | P21 | H | P29 | H | H |
| Lₐ₆₆₁ | P6 | CN | H | H | P21 | H | P29 | P1 | H |
| Lₐ₆₆₂ | P6 | CN | H | H | P21 | H | P54 | H | H |
| Lₐ₆₆₃ | P6 | CN | H | H | P21 | H | P96 | H | H |
| Lₐ₆₆₄ | P6 | CN | H | H | P21 | H | P97 | H | H |
| Lₐ₆₆₅ | P6 | CN | H | H | P21 | H | P96 | P1 | H |
| Lₐ₆₆₆ | P6 | CN | H | H | P21 | H | P97 | P1 | H |
| Lₐ₆₆₇ | P6 | CN | H | H | P21 | H | P102 | H | H |
| Lₐ₆₆₈ | P6 | CN | H | H | P21 | H | P103 | H | H |
| Lₐ₆₆₉ | P6 | CN | H | H | P22 | H | H | H | H |
| Lₐ₆₇₀ | P6 | CN | H | H | P23 | H | H | H | H |
| Lₐ₆₇₁ | P6 | CN | H | H | P24 | H | H | H | H |
| Lₐ₆₇₂ | P6 | CN | H | H | P25 | H | H | H | H |
| Lₐ₆₇₃ | P6 | CN | H | H | P26 | H | H | H | H |
| Lₐ₆₇₄ | P6 | CN | H | H | P27 | H | H | H | H |
| Lₐ₆₇₅ | P6 | CN | H | H | P28 | H | H | H | H |
| Lₐ₆₇₆ | P6 | CN | H | H | P29 | H | H | H | H |
| Lₐ₆₇₇ | P6 | CN | H | H | P30 | H | H | H | H |
| Lₐ₆₇₈ | P6 | CN | H | H | P31 | H | H | H | H |
| Lₐ₆₇₉ | P6 | CN | H | H | P32 | H | H | H | H |
| Lₐ₆₈₀ | P6 | CN | H | H | P33 | H | H | H | H |
| Lₐ₆₈₁ | P6 | CN | H | H | P34 | H | H | H | H |
| Lₐ₆₈₂ | P6 | CN | H | H | P35 | H | H | H | H |
| Lₐ₆₈₃ | P6 | CN | H | H | P36 | H | H | H | H |
| Lₐ₆₈₄ | P6 | CN | H | H | P37 | H | H | H | H |
| Lₐ₆₈₅ | P6 | CN | H | H | P38 | H | H | H | H |
| Lₐ₆₈₆ | P6 | CN | H | H | P39 | H | H | H | H |
| Lₐ₆₈₇ | P6 | CN | H | H | P40 | H | H | H | H |
| Lₐ₆₈₈ | P6 | CN | H | H | P41 | H | H | H | H |
| Lₐ₆₈₉ | P6 | CN | H | H | P42 | H | H | H | H |
| Lₐ₆₉₀ | P6 | CN | H | H | P43 | H | H | H | H |
| Lₐ₆₉₁ | P6 | CN | H | H | P44 | H | H | H | H |
| Lₐ₆₉₂ | P6 | CN | H | H | P45 | H | H | H | H |
| Lₐ₆₉₃ | P6 | CN | H | H | P46 | H | H | H | H |
| Lₐ₆₉₄ | P6 | CN | H | H | P47 | H | H | H | H |
| Lₐ₆₉₅ | P6 | CN | H | H | P48 | H | H | H | H |
| Lₐ₆₉₆ | P6 | CN | H | H | P49 | H | H | H | H |
| Lₐ₆₉₇ | P6 | CN | H | H | P50 | H | H | H | H |
| Lₐ₆₉₈ | P6 | CN | H | H | P51 | H | H | H | H |
| Lₐ₆₉₉ | P6 | CN | H | H | P52 | H | H | H | H |
| Lₐ₇₀₀ | P6 | CN | H | H | P53 | H | H | H | H |
| Lₐ₇₀₁ | P6 | CN | H | H | P55 | H | H | H | H |
| Lₐ₇₀₂ | P6 | CN | H | H | P56 | H | H | H | H |
| Lₐ₇₀₃ | P6 | CN | H | H | P57 | H | H | H | H |
| Lₐ₇₀₄ | P6 | CN | H | H | P58 | H | H | H | H |
| Lₐ₇₀₅ | P6 | CN | H | H | P59 | H | H | H | H |
| Lₐ₇₀₆ | P6 | CN | H | H | P60 | H | H | H | H |
| Lₐ₇₀₇ | P6 | CN | H | H | P61 | H | H | H | H |
| Lₐ₇₀₈ | P6 | CN | H | H | P62 | H | H | H | H |
| Lₐ₇₀₉ | P6 | CN | H | H | P63 | H | H | H | H |
| Lₐ₇₁₀ | P6 | CN | H | H | P64 | H | H | H | H |
| Lₐ₇₁₁ | P6 | CN | H | H | P65 | H | H | H | H |
| Lₐ₇₁₂ | P6 | CN | H | H | P66 | H | H | H | H |
| Lₐ₇₁₃ | P6 | CN | H | H | P67 | H | H | H | H |
| Lₐ₇₁₄ | P6 | CN | H | H | P68 | H | H | H | H |
| Lₐ₇₁₅ | P6 | CN | H | H | P69 | H | H | H | H |
| Lₐ₇₁₆ | P6 | CN | H | H | P70 | H | H | H | H |
| Lₐ₇₁₇ | P6 | CN | H | H | P71 | H | H | H | H |
| Lₐ₇₁₈ | P6 | CN | H | H | P72 | H | H | H | H |
| Lₐ₇₁₉ | P6 | CN | H | H | P73 | H | H | H | H |
| Lₐ₇₂₀ | P6 | CN | H | H | P74 | H | H | H | H |
| Lₐ₇₂₁ | P6 | CN | H | H | P75 | H | H | H | H |
| Lₐ₇₂₂ | P6 | CN | H | H | P76 | H | H | H | H |
| Lₐ₇₂₃ | P6 | CN | H | H | P77 | H | H | H | H |
| Lₐ₇₂₄ | P6 | CN | H | H | P78 | H | H | H | H |
| Lₐ₇₂₅ | P6 | CN | H | H | P79 | H | H | H | H |
| Lₐ₇₂₆ | P6 | CN | H | H | P80 | H | H | H | H |
| Lₐ₇₂₇ | P6 | CN | H | H | P81 | H | H | H | H |
| Lₐ₇₂₈ | P6 | CN | H | H | P82 | H | H | H | H |
| Lₐ₇₂₉ | P6 | CN | H | H | P83 | H | H | H | H |
| Lₐ₇₃₀ | P6 | CN | H | H | P84 | H | H | H | H |
| Lₐ₇₃₁ | P6 | CN | H | H | P85 | H | H | H | H |
| Lₐ₇₃₂ | P6 | CN | H | H | P86 | H | H | H | H |
| Lₐ₇₃₃ | P6 | CN | H | H | P87 | H | H | H | H |
| Lₐ₇₃₄ | P6 | CN | H | H | P88 | H | H | H | H |
| Lₐ₇₃₅ | P6 | CN | H | H | P89 | H | H | H | H |
| Lₐ₇₃₆ | P6 | CN | H | H | P90 | H | H | H | H |
| Lₐ₇₃₇ | P6 | CN | H | H | P91 | H | H | H | H |
| Lₐ₇₃₈ | P6 | CN | H | H | P92 | H | H | H | H |
| Lₐ₇₃₉ | P6 | CN | H | H | P93 | H | H | H | H |
| Lₐ₇₄₀ | P6 | CN | H | H | P94 | H | H | H | H |
| Lₐ₇₄₁ | P6 | CN | H | H | P95 | H | H | H | H |
| Lₐ₇₄₂ | P6 | CN | H | H | P98 | H | H | H | H |
| Lₐ₇₄₃ | P6 | CN | P97 | H | P21 | H | H | H | H |
| Lₐ₇₄₄ | P6 | CN | P97 | H | P97 | H | H | H | H |
| Lₐ₇₄₅ | P6 | CN | H | H | P101 | H | H | H | H |
| Lₐ₇₄₆ | P6 | CN | H | H | P102 | H | H | H | H |
| Lₐ₇₄₇ | P6 | CN | H | H | P103 | H | H | H | H |
| Lₐ₇₄₈ | P6 | CN | H | H | P104 | H | H | H | H |
| Lₐ₇₄₉ | P6 | CN | H | H | P105 | H | H | H | H |
| Lₐ₇₅₀ | P6 | CN | H | H | P106 | H | H | H | H |
| Lₐ₇₅₁ | P6 | CN | H | H | P107 | H | H | H | H |
| Lₐ₇₅₂ | P6 | CN | H | H | P108 | H | H | H | H |
| Lₐ₇₅₃ | P6 | CN | H | H | P109 | H | H | H | H |
| Lₐ₇₅₄ | P6 | CN | H | H | P110 | H | H | H | H |
| Lₐ₇₅₅ | P6 | CN | H | H | P111 | H | H | H | H |
| Lₐ₇₅₆ | P6 | CN | H | H | P112 | H | H | H | H |
| Lₐ₇₅₇ | P6 | CN | H | H | P113 | H | H | H | H |
| Lₐ₇₅₈ | P6 | CN | H | H | P114 | H | H | H | H |
| Lₐ₇₅₉ | P6 | CN | H | H | P115 | H | H | H | H |
| Lₐ₇₆₀ | P6 | CN | H | H | P116 | H | H | H | H |
| Lₐ₇₆₁ | P6 | CN | H | H | P117 | H | H | H | H |
| Lₐ₇₆₂ | P6 | CN | H | H | P118 | H | H | H | H |
| Lₐ₇₆₃ | P6 | CN | H | H | P119 | H | H | H | H |
| Lₐ₇₆₄ | P6 | CN | H | H | P120 | H | H | H | H |
| Lₐ₇₆₅ | P6 | CN | H | H | P121 | H | H | H | H |
| Lₐ₇₆₆ | P6 | CN | H | H | P122 | H | H | H | H |
| Lₐ₇₆₇ | P6 | CN | H | H | P123 | H | H | H | H |
| Lₐ₇₆₈ | P6 | CN | H | H | P124 | H | H | H | H |
| Lₐ₇₆₉ | P6 | CN | H | H | P125 | H | H | H | H |
| Lₐ₇₇₀ | P6 | CN | H | H | P126 | H | H | H | H |
| Lₐ₇₇₁ | P6 | CN | H | H | P127 | H | H | H | H |
| Lₐ₇₇₂ | P6 | CN | H | H | P128 | H | H | H | H |
| Lₐ₇₇₃ | P6 | CN | H | H | P129 | H | H | H | H |
| Lₐ₇₇₄ | P6 | CN | H | H | P130 | H | H | H | H |
| Lₐ₇₇₅ | P6 | CN | H | H | P131 | H | H | H | H |
| Lₐ₇₇₆ | P6 | CN | H | H | P132 | H | H | H | H |
| Lₐ₇₇₇ | P6 | CN | H | H | P133 | H | H | H | H |
| Lₐ₇₇₈ | P6 | CN | H | H | P134 | H | H | H | H |
| Lₐ₇₇₉ | P6 | CN | H | H | P135 | H | H | H | H |
| Lₐ₇₈₀ | P6 | CN | H | H | P136 | H | H | H | H |
| Lₐ₇₈₁ | P6 | CN | H | H | P137 | H | H | H | H |
| Lₐ₇₈₂ | P6 | CN | H | H | P138 | H | H | H | H |
| Lₐ₇₈₃ | P6 | CN | H | H | P139 | H | H | H | H |
| Lₐ₇₈₄ | P6 | CN | H | H | P140 | H | H | H | H |
| Lₐ₇₈₅ | P6 | CN | H | H | P141 | H | H | H | H |
| Lₐ₇₈₆ | P6 | CN | H | H | P142 | H | H | H | H |
| Lₐ₇₈₇ | P6 | CN | H | H | P143 | H | H | H | H |
| Lₐ₇₈₈ | P6 | CN | H | H | P144 | H | H | H | H |
| Lₐ₇₈₉ | P6 | CN | H | H | P145 | H | H | H | H |
| Lₐ₇₉₀ | P6 | CN | H | H | P146 | H | H | H | H |
| Lₐ₇₉₁ | P6 | CN | H | H | P147 | H | H | H | H |
| Lₐ₇₉₂ | P6 | CN | H | H | P148 | H | H | H | H |
| Lₐ₇₉₃ | P6 | CN | H | H | P149 | H | H | H | H |
| Lₐ₇₉₄ | P6 | CN | H | H | P150 | H | H | H | H |
| Lₐ₇₉₅ | P6 | CN | H | H | P151 | H | H | H | H |
| Lₐ₇₉₆ | P6 | CN | H | P18 | H | H | H | H | H |
| Lₐ₇₉₇ | P6 | CN | H | P18 | D | H | H | H | H |
| Lₐ₇₉₈ | P6 | CN | H | P18 | P20 | H | H | H | H |
| Lₐ₇₉₉ | P6 | CN | H | P19 | H | H | H | H | H |
| Lₐ₈₀₀ | P6 | CN | H | P19 | D | H | H | H | H |
| Lₐ₈₀₁ | P6 | CN | H | P19 | P20 | H | H | H | H |
| Lₐ₈₀₂ | P6 | CN | H | P20 | H | H | H | H | H |
| Lₐ₈₀₃ | P6 | CN | H | P20 | D | H | H | H | H |
| Lₐ₈₀₄ | P6 | CN | H | P20 | H | H | P1 | H | H |
| Lₐ₈₀₅ | P6 | CN | H | P20 | D | H | P2 | H | H |
| Lₐ₈₀₆ | P6 | CN | H | P20 | H | H | H | P1 | H |
| Lₐ₈₀₇ | P6 | CN | H | P20 | D | H | H | P2 | H |
| Lₐ₈₀₈ | P6 | CN | H | P20 | H | H | P1 | P1 | H |
| Lₐ₈₀₉ | P6 | CN | H | P20 | D | H | P2 | P2 | H |
| Lₐ₈₁₀ | P6 | CN | H | P20 | H | H | P3 | H | H |
| Lₐ₈₁₁ | P6 | CN | H | P20 | D | H | P4 | H | H |
| Lₐ₈₁₂ | P6 | CN | H | P20 | H | H | P5 | H | H |
| Lₐ₈₁₃ | P6 | CN | H | P21 | H | H | H | H | H |
| Lₐ₈₁₅₄ | P6 | CN | H | P21 | D | H | H | H | H |
| Lₐ₈₁₅ | P6 | CN | H | P21 | H | H | P1 | H | H |
| Lₐ₈₁₆ | P6 | CN | H | P21 | D | H | P2 | H | H |
| Lₐ₈₁₇ | P6 | CN | H | P21 | H | H | H | P1 | H |
| Lₐ₈₁₈ | P6 | CN | H | P21 | D | H | H | P2 | H |
| Lₐ₈₁₉ | P6 | CN | H | P21 | H | H | P1 | P1 | H |
| Lₐ₈₂₀ | P6 | CN | H | P21 | D | H | P2 | P2 | H |
| Lₐ₈₂₁ | P6 | CN | H | P21 | H | H | P3 | H | H |
| Lₐ₈₂₂ | P6 | CN | H | P21 | D | H | P4 | H | H |
| Lₐ₈₂₃ | P6 | CN | H | P21 | H | H | P5 | H | H |
| Lₐ₈₂₄ | P11 | CN | H | H | H | H | H | H | H |
| Lₐ₈₂₅ | P11 | CN | H | H | H | H | P1 | H | H |
| Lₐ₈₂₆ | P11 | CN | H | H | H | H | P2 | H | H |
| Lₐ₈₂₇ | P11 | CN | H | H | H | H | P3 | H | H |
| Lₐ₈₂₈ | P11 | CN | H | H | H | H | P4 | H | H |
| Lₐ₈₂₉ | P11 | CN | H | H | H | H | P5 | H | H |
| Lₐ₈₃₀ | P11 | CN | H | H | H | H | P6 | H | H |
| Lₐ₈₃₁ | P11 | CN | H | H | H | H | P7 | H | H |
| Lₐ₈₃₂ | P11 | CN | H | H | H | H | P8 | H | H |
| Lₐ₈₃₃ | P11 | CN | H | H | H | H | P9 | H | H |
| Lₐ₈₃₄ | P11 | CN | H | H | H | H | P10 | H | H |
| Lₐ₈₃₅ | P11 | CN | H | H | H | H | P11 | H | H |
| Lₐ₈₃₆ | P11 | CN | H | H | H | H | P12 | H | H |
| Lₐ₈₃₇ | P11 | CN | H | H | H | H | P13 | H | H |
| Lₐ₈₃₈ | P11 | CN | H | H | H | H | P14 | H | H |
| Lₐ₈₃₉ | P11 | CN | H | H | H | H | P15 | H | H |
| Lₐ₈₄₀ | P11 | CN | H | H | H | H | P16 | H | H |
| Lₐ₈₄₁ | P11 | CN | H | H | H | H | P17 | H | H |
| Lₐ₈₄₂ | P11 | CN | H | H | H | H | P18 | H | H |
| Lₐ₈₄₃ | P11 | CN | H | H | H | H | P19 | H | H |
| Lₐ₈₄₄ | P11 | CN | H | H | H | H | P20 | H | H |
| Lₐ₈₄₅ | P11 | CN | H | H | H | H | P21 | H | H |
| Lₐ₈₄₆ | P11 | CN | H | H | H | H | P1 | F | H |
| Lₐ₈₄₇ | P11 | CN | H | H | H | H | P2 | F | H |
| Lₐ₈₄₈ | P11 | CN | H | H | H | H | P3 | F | H |
| Lₐ₈₄₉ | P11 | CN | H | H | H | H | P4 | F | H |
| Lₐ₈₅₀ | P11 | CN | H | H | H | H | P5 | F | H |
| Lₐ₈₅₁ | P11 | CN | H | H | H | H | P6 | F | H |
| Lₐ₈₅₂ | P11 | CN | H | H | H | H | P7 | F | H |
| Lₐ₈₅₃ | P11 | CN | H | H | H | H | P8 | F | H |
| Lₐ₈₅₄ | P11 | CN | H | H | H | H | P9 | F | H |
| Lₐ₈₅₅ | P11 | CN | H | H | H | H | P10 | F | H |
| Lₐ₈₅₆ | P11 | CN | H | H | H | H | P11 | F | H |
| Lₐ₈₅₇ | P11 | CN | H | H | H | H | P12 | F | H |
| Lₐ₈₅₈ | P11 | CN | H | H | H | H | P13 | F | H |
| Lₐ₈₅₉ | P11 | CN | H | H | H | H | P14 | F | H |
| Lₐ₈₆₀ | P11 | CN | H | H | H | H | P15 | F | H |
| Lₐ₈₆₁ | P11 | CN | H | H | H | H | P16 | F | H |
| Lₐ₈₆₂ | P11 | CN | H | H | H | H | P17 | F | H |
| Lₐ₈₆₃ | P11 | CN | H | H | H | H | P18 | F | H |
| Lₐ₈₆₄ | P11 | CN | H | H | H | H | P19 | F | H |
| Lₐ₈₆₅ | P11 | CN | H | H | H | H | P20 | F | H |
| Lₐ₈₆₆ | P11 | CN | H | H | H | H | P21 | F | H |
| Lₐ₈₆₇ | P11 | CN | H | H | H | H | H | P1 | H |
| Lₐ₈₆₈ | P11 | CN | H | H | H | H | H | P2 | H |
| Lₐ₈₆₉ | P11 | CN | H | H | H | H | H | P3 | H |
| Lₐ₈₇₀ | P11 | CN | H | H | H | H | H | P4 | H |
| Lₐ₈₇₁ | P11 | CN | H | H | H | H | H | P5 | H |
| Lₐ₈₇₂ | P11 | CN | H | H | H | H | H | P6 | H |
| Lₐ₈₇₃ | P11 | CN | H | H | H | H | H | P7 | H |
| Lₐ₈₇₄ | P11 | CN | H | H | H | H | H | P8 | H |
| Lₐ₈₇₅ | P11 | CN | H | H | H | H | H | P9 | H |
| Lₐ₈₇₆ | P11 | CN | H | H | H | H | H | P10 | H |
| Lₐ₈₇₇ | P11 | CN | H | H | H | H | H | P11 | H |
| Lₐ₈₇₈ | P11 | CN | H | H | H | H | H | P12 | H |
| Lₐ₈₇₉ | P11 | CN | H | H | H | H | H | P13 | H |
| Lₐ₈₈₀ | P11 | CN | H | H | H | H | H | P14 | H |
| Lₐ₈₈₁ | P11 | CN | H | H | H | H | H | P15 | H |
| Lₐ₈₈₂ | P11 | CN | H | H | H | H | H | P16 | H |
| Lₐ₈₈₃ | P11 | CN | H | H | H | H | H | P17 | H |
| Lₐ₈₈₄ | P11 | CN | H | H | H | H | H | P18 | H |
| Lₐ₈₈₅ | P11 | CN | H | H | H | H | H | P19 | H |
| Lₐ₈₈₆ | P11 | CN | H | H | H | H | H | P20 | H |
| Lₐ₈₈₇ | P11 | CN | H | H | H | H | H | P21 | H |
| Lₐ₈₈₈ | P11 | CN | H | H | H | H | F | P1 | H |
| Lₐ₈₈₉ | P11 | CN | H | H | H | H | F | P2 | H |
| Lₐ₈₉₀ | P11 | CN | H | H | H | H | F | P3 | H |
| Lₐ₈₉₁ | P11 | CN | H | H | H | H | F | P4 | H |
| Lₐ₈₉₂ | P11 | CN | H | H | H | H | F | P5 | H |
| Lₐ₈₉₃ | P11 | CN | H | H | H | H | F | P6 | H |
| Lₐ₈₉₄ | P11 | CN | H | H | H | H | F | P7 | H |
| Lₐ₈₉₅ | P11 | CN | H | H | H | H | F | P8 | H |
| Lₐ₈₉₆ | P11 | CN | H | H | H | H | F | P9 | H |
| Lₐ₈₉₇ | P11 | CN | H | H | H | H | F | P10 | H |
| Lₐ₈₉₈ | P11 | CN | H | H | H | H | F | P11 | H |
| Lₐ₈₉₉ | P11 | CN | H | H | H | H | F | P12 | H |
| Lₐ₉₀₀ | P11 | CN | H | H | H | H | F | P13 | H |
| Lₐ₉₀₁ | P11 | CN | H | H | H | H | F | P14 | H |
| Lₐ₉₀₂ | P11 | CN | H | H | H | H | F | P15 | H |
| Lₐ₉₀₃ | P11 | CN | H | H | H | H | F | P16 | H |
| Lₐ₉₀₄ | P11 | CN | H | H | H | H | F | P17 | H |
| Lₐ₉₀₅ | P11 | CN | H | H | H | H | F | P18 | H |
| Lₐ₉₀₆ | P11 | CN | H | H | H | H | F | P19 | H |
| Lₐ₉₀₇ | P11 | CN | H | H | H | H | F | P20 | H |
| Lₐ₉₀₈ | P11 | CN | H | H | H | H | F | P21 | H |
| Lₐ₉₀₉ | P11 | CN | H | H | H | H | P1 | P1 | H |
| Lₐ₉₁₀ | P11 | CN | H | H | H | H | P1 | P3 | H |
| Lₐ₉₁₁ | P11 | CN | H | H | H | H | P1 | P8 | H |
| Lₐ₉₁₂ | P11 | CN | H | H | H | H | P1 | P10 | H |
| Lₐ₉₁₃ | P11 | CN | H | H | H | H | P1 | P20 | H |
| Lₐ₉₁₄ | P11 | CN | H | H | H | H | P1 | P21 | H |
| Lₐ₉₁₅ | P11 | CN | H | H | H | H | P2 | P2 | H |
| Lₐ₉₁₆ | P11 | CN | H | H | H | H | P2 | P4 | H |
| Lₐ₉₁₇ | P11 | CN | H | H | H | H | P2 | P5 | H |
| Lₐ₉₁₈ | P11 | CN | H | H | H | H | P2 | P9 | H |
| Lₐ₉₁₉ | P11 | CN | H | H | H | H | P2 | P11 | H |
| Lₐ₉₂₀ | P11 | CN | H | H | H | H | P2 | P20 | H |
| Lₐ₉₂₁ | P11 | CN | H | H | H | H | P2 | P21 | H |
| Lₐ₉₂₂ | P11 | CN | H | H | H | D | D | D | D |
| Lₐ₉₂₃ | P11 | CN | H | H | H | D | F | D | D |
| Lₐ₉₂₄ | P11 | CN | H | H | H | D | D | F | D |
| Lₐ₉₂₅ | P11 | CN | H | H | H | D | P2 | D | D |
| Lₐ₉₂₆ | P11 | CN | H | H | H | D | D | P2 | D |
| Lₐ₉₂₇ | P11 | CN | H | H | H | D | P2 | P2 | D |
| Lₐ₉₂₈ | P11 | CN | H | H | D | H | H | H | H |
| Lₐ₉₂₉ | P11 | CN | H | H | D | H | P1 | H | H |
| Lₐ₉₃₀ | P11 | CN | H | H | D | H | P2 | H | H |
| Lₐ₉₃₁ | P11 | CN | H | H | D | H | P5 | H | H |
| Lₐ₉₃₂ | P11 | CN | H | H | D | H | P10 | H | H |
| Lₐ₉₃₃ | P11 | CN | H | H | D | H | P11 | H | H |
| Lₐ₉₃₄ | P11 | CN | H | H | D | H | H | P1 | H |
| Lₐ₉₃₅ | P11 | CN | H | H | D | H | H | P2 | H |
| Lₐ₉₃₆ | P11 | CN | H | H | D | H | H | P4 | H |
| Lₐ₉₃₇ | P11 | CN | H | H | D | H | H | P5 | H |
| Lₐ₉₃₈ | P11 | CN | H | H | D | H | H | P10 | H |
| Lₐ₉₃₉ | P11 | CN | H | H | D | H | H | P11 | H |
| Lₐ₉₄₀ | P11 | CN | H | H | D | H | P1 | F | H |
| Lₐ₉₄₁ | P11 | CN | H | H | D | H | P2 | F | H |
| Lₐ₉₄₂ | P11 | CN | H | H | D | H | P11 | F | H |
| Lₐ₉₄₃ | P11 | CN | H | H | D | H | F | P1 | H |
| Lₐ₉₄₄ | P11 | CN | H | H | D | H | F | P2 | H |
| Lₐ₉₄₅ | P11 | CN | H | H | D | H | F | P3 | H |
| Lₐ₉₄₆ | P11 | CN | H | H | D | H | F | P4 | H |
| Lₐ₉₄₇ | P11 | CN | H | H | D | H | F | P5 | H |
| Lₐ₉₄₈ | P11 | CN | H | H | D | H | F | P8 | H |
| Lₐ₉₄₉ | P11 | CN | H | H | D | H | F | P11 | H |
| Lₐ₉₅₀ | P11 | CN | H | H | D | H | P1 | P1 | H |
| Lₐ₉₅₁ | P11 | CN | H | H | D | H | P2 | P2 | H |
| Lₐ₉₅₂ | P11 | CN | H | H | D | H | P2 | P2 | D |
| Lₐ₉₅₃ | P11 | CN | H | H | P20 | H | H | H | H |
| Lₐ₉₅₄ | P11 | CN | H | H | P20 | H | P1 | H | H |
| Lₐ₉₅₅ | P11 | CN | H | H | P20 | H | P2 | H | H |
| Lₐ₉₅₆ | P11 | CN | H | H | P20 | H | P3 | H | H |
| Lₐ₉₅₇ | P11 | CN | H | H | P20 | H | P4 | H | H |
| Lₐ₉₅₈ | P11 | CN | H | H | P20 | H | P5 | H | H |
| Lₐ₉₅₉ | P11 | CN | H | H | P20 | H | P6 | H | H |
| Lₐ₉₆₀ | P11 | CN | H | H | P20 | H | P7 | H | H |
| Lₐ₉₆₁ | P11 | CN | H | H | P20 | H | P8 | H | H |
| Lₐ₉₆₂ | P11 | CN | H | H | P20 | H | P9 | H | H |
| Lₐ₉₆₃ | P11 | CN | H | H | P20 | H | P10 | H | H |
| Lₐ₉₆₄ | P11 | CN | H | H | P20 | H | P11 | H | H |
| Lₐ₉₆₅ | P11 | CN | H | H | P20 | H | P12 | H | H |
| Lₐ₉₆₆ | P11 | CN | H | H | P20 | H | P13 | H | H |
| Lₐ₉₆₇ | P11 | CN | H | H | P20 | H | P14 | H | H |
| Lₐ₉₆₈ | P11 | CN | H | H | P20 | H | P15 | H | H |
| Lₐ₉₆₉ | P11 | CN | H | H | P20 | H | P16 | H | H |
| Lₐ₉₇₀ | P11 | CN | H | H | P20 | H | P17 | H | H |
| Lₐ₉₇₁ | P11 | CN | H | H | P20 | H | P18 | H | H |
| Lₐ₉₇₂ | P11 | CN | H | H | P20 | H | P19 | H | H |
| Lₐ₉₇₃ | P11 | CN | H | H | P20 | H | P20 | H | H |
| Lₐ₉₇₄ | P11 | CN | H | H | P20 | H | P21 | H | H |
| Lₐ₉₇₅ | P11 | CN | H | H | P20 | H | H | P1 | H |
| Lₐ₉₇₆ | P11 | CN | H | H | P20 | H | H | P2 | H |
| Lₐ₉₇₇ | P11 | CN | H | H | P20 | H | H | P3 | H |
| Lₐ₉₇₈ | P11 | CN | H | H | P20 | H | H | P4 | H |
| Lₐ₉₇₉ | P11 | CN | H | H | P20 | H | H | P5 | H |
| Lₐ₉₈₀ | P11 | CN | H | H | P20 | H | H | P6 | H |
| Lₐ₉₈₁ | P11 | CN | H | H | P20 | H | H | P7 | H |
| Lₐ₉₈₂ | P11 | CN | H | H | P20 | H | H | P8 | H |
| Lₐ₉₈₃ | P11 | CN | H | H | P20 | H | H | P9 | H |
| Lₐ₉₈₄ | P11 | CN | H | H | P20 | H | H | P10 | H |
| Lₐ₉₈₅ | P11 | CN | H | H | P20 | H | H | P11 | H |
| Lₐ₉₈₆ | P11 | CN | H | H | P20 | H | H | P12 | H |
| Lₐ₉₈₇ | P11 | CN | H | H | P20 | H | H | P15 | H |
| Lₐ₉₈₈ | P11 | CN | H | H | P20 | H | H | P17 | H |
| Lₐ₉₈₉ | P11 | CN | H | H | P20 | H | H | P18 | H |
| Lₐ₉₉₀ | P11 | CN | H | H | P20 | H | H | P19 | H |
| Lₐ₉₉₁ | P11 | CN | H | H | P20 | H | H | P20 | H |
| Lₐ₉₉₂ | P11 | CN | H | H | P20 | H | H | P21 | H |
| Lₐ₉₉₃ | P11 | CN | H | H | P20 | H | F | H | H |
| Lₐ₉₉₄ | P11 | CN | H | H | P20 | H | F | P1 | H |
| Lₐ₉₉₅ | P11 | CN | H | H | P20 | H | F | P2 | H |
| Lₐ₉₉₆ | P11 | CN | H | H | P20 | H | F | P3 | H |
| Lₐ₉₉₇ | P11 | CN | H | H | P20 | H | F | P4 | H |
| Lₐ₉₉₈ | P11 | CN | H | H | P20 | H | F | P5 | H |
| Lₐ₉₉₉ | P11 | CN | H | H | P20 | H | F | P6 | H |
| Lₐ₁₀₀₀ | P11 | CN | H | H | P20 | H | F | P7 | H |
| Lₐ₁₀₀₁ | P11 | CN | H | H | P20 | H | F | P8 | H |
| Lₐ₁₀₀₂ | P11 | CN | H | H | P20 | H | F | P9 | H |
| Lₐ₁₀₀₃ | P11 | CN | H | H | P20 | H | F | P10 | H |
| Lₐ₁₀₀₄ | P11 | CN | H | H | P20 | H | F | P11 | H |
| Lₐ₁₀₀₅ | P11 | CN | H | H | P20 | H | P1 | F | H |
| Lₐ₁₀₀₆ | P11 | CN | H | H | P20 | H | P2 | F | H |
| Lₐ₁₀₀₇ | P11 | CN | H | H | P20 | H | P3 | F | H |
| Lₐ₁₀₀₈ | P11 | CN | H | H | P20 | H | P4 | F | H |
| Lₐ₁₀₀₉ | P11 | CN | H | H | P20 | H | P5 | F | H |
| Lₐ₁₀₁₀ | P11 | CN | H | H | P20 | H | P6 | F | H |
| Lₐ₁₀₁₁ | P11 | CN | H | H | P20 | H | P7 | F | H |
| Lₐ₁₀₁₂ | P11 | CN | H | H | P20 | H | P8 | F | H |
| Lₐ₁₀₁₃ | P11 | CN | H | H | P20 | H | P9 | F | H |
| Lₐ₁₀₁₄ | P11 | CN | H | H | P20 | H | P10 | F | H |
| Lₐ₁₀₁₅ | P11 | CN | H | H | P20 | H | P11 | F | H |
| Lₐ₁₀₁₆ | P11 | CN | H | H | P20 | H | P1 | P1 | H |
| Lₐ₁₀₁₇ | P11 | CN | H | H | P20 | H | P2 | P2 | H |
| Lₐ₁₀₁₈ | P11 | CN | H | H | P20 | D | D | D | D |
| Lₐ₁₀₁₉ | P11 | CN | H | H | P20 | D | P2 | P2 | D |
| Lₐ₁₀₂₀ | P11 | CN | H | H | P20 | D | F | P4 | D |
| Lₐ₁₀₂₁ | P11 | CN | H | H | P20 | D | F | P5 | D |
| Lₐ₁₀₂₂ | P11 | CN | H | H | P20 | D | F | P9 | D |
| Lₐ₁₀₂₃ | P11 | CN | H | H | P20 | D | F | P11 | D |
| Lₐ₁₀₂₄ | P11 | CN | H | H | P21 | H | H | H | H |
| Lₐ₁₀₂₅ | P11 | CN | H | H | P21 | H | P1 | H | H |
| Lₐ₁₀₂₆ | P11 | CN | H | H | P21 | H | P2 | H | H |
| Lₐ₁₀₂₇ | P11 | CN | H | H | P21 | H | P3 | H | H |
| Lₐ₁₀₂₈ | P11 | CN | H | H | P21 | H | P4 | H | H |
| Lₐ₁₀₂₉ | P11 | CN | H | H | P21 | H | P5 | H | H |
| Lₐ₁₀₃₀ | P11 | CN | H | H | P21 | H | P6 | H | H |
| Lₐ₁₀₃₁ | P11 | CN | H | H | P21 | H | P7 | H | H |
| Lₐ₁₀₃₂ | P11 | CN | H | H | P21 | H | P8 | H | H |
| Lₐ₁₀₃₃ | P11 | CN | H | H | P21 | H | P9 | H | H |
| Lₐ₁₀₃₄ | P11 | CN | H | H | P21 | H | P10 | H | H |
| Lₐ₁₀₃₅ | P11 | CN | H | H | P21 | H | P11 | H | H |
| Lₐ₁₀₃₆ | P11 | CN | H | H | P21 | H | P12 | H | H |
| Lₐ₁₀₃₇ | P11 | CN | H | H | P21 | H | P13 | H | H |
| Lₐ₁₀₃₈ | P11 | CN | H | H | P21 | H | P14 | H | H |
| Lₐ₁₀₃₉ | P11 | CN | H | H | P21 | H | P15 | H | H |
| Lₐ₁₀₄₀ | P11 | CN | H | H | P21 | H | P16 | H | H |
| Lₐ₁₀₄₁ | P11 | CN | H | H | P21 | H | P17 | H | H |
| Lₐ₁₀₄₂ | P11 | CN | H | H | P21 | H | P18 | H | H |
| Lₐ₁₀₄₃ | P11 | CN | H | H | P21 | H | P19 | H | H |
| Lₐ₁₀₄₄ | P11 | CN | H | H | P21 | H | P20 | H | H |
| Lₐ₁₀₄₅ | P11 | CN | H | H | P21 | H | P21 | H | H |
| Lₐ₁₀₄₆ | P11 | CN | H | H | P21 | H | H | P1 | H |
| Lₐ₁₀₄₇ | P11 | CN | H | H | P21 | H | H | P2 | H |
| Lₐ₁₀₄₈ | P11 | CN | H | H | P21 | H | H | P3 | H |
| Lₐ₁₀₄₉ | P11 | CN | H | H | P21 | H | H | P4 | H |
| Lₐ₁₀₅₀ | P11 | CN | H | H | P21 | H | H | P5 | H |
| Lₐ₁₀₅₁ | P11 | CN | H | H | P21 | H | H | P6 | H |
| Lₐ₁₀₅₂ | P11 | CN | H | H | P21 | H | H | P7 | H |
| Lₐ₁₀₅₃ | P11 | CN | H | H | P21 | H | H | P8 | H |
| Lₐ₁₀₅₄ | P11 | CN | H | H | P21 | H | H | P9 | H |
| Lₐ₁₀₅₅ | P11 | CN | H | H | P21 | H | H | P10 | H |
| Lₐ₁₀₅₆ | P11 | CN | H | H | P21 | H | H | P11 | H |
| Lₐ₁₀₅₇ | P11 | CN | H | H | P21 | H | H | P12 | H |
| Lₐ₁₀₅₈ | P11 | CN | H | H | P21 | H | H | P15 | H |
| Lₐ₁₀₅₉ | P11 | CN | H | H | P21 | H | H | P17 | H |
| Lₐ₁₀₆₀ | P11 | CN | H | H | P21 | H | H | P18 | H |
| Lₐ₁₀₆₁ | P11 | CN | H | H | P21 | H | H | P19 | H |
| Lₐ₁₀₆₂ | P11 | CN | H | H | P21 | H | H | P20 | H |
| Lₐ₁₀₆₃ | P11 | CN | H | H | P21 | H | H | P21 | H |
| Lₐ₁₀₆₄ | P11 | CN | H | H | P21 | H | F | H | H |
| Lₐ₁₀₆₅ | P11 | CN | H | H | P21 | H | F | P1 | H |
| Lₐ₁₀₆₆ | P11 | CN | H | H | P21 | H | F | P2 | H |
| Lₐ₁₀₆₇ | P11 | CN | H | H | P21 | H | F | P3 | H |
| Lₐ₁₀₆₈ | P11 | CN | H | H | P21 | H | F | P4 | H |
| Lₐ₁₀₆₉ | P11 | CN | H | H | P21 | H | F | P5 | H |
| Lₐ₁₀₇₀ | P11 | CN | H | H | P21 | H | F | P6 | H |
| Lₐ₁₀₇₁ | P11 | CN | H | H | P21 | H | F | P7 | H |
| Lₐ₁₀₇₂ | P11 | CN | H | H | P21 | H | F | P8 | H |
| Lₐ₁₀₇₃ | P11 | CN | H | H | P21 | H | F | P9 | H |
| Lₐ₁₀₇₄ | P11 | CN | H | H | P21 | H | F | P10 | H |
| Lₐ₁₀₇₅ | P11 | CN | H | H | P21 | H | F | P11 | H |
| Lₐ₁₀₇₆ | P11 | CN | H | H | P21 | H | P1 | F | H |
| Lₐ₁₀₇₇ | P11 | CN | H | H | P21 | H | P2 | F | H |
| Lₐ₁₀₇₈ | P11 | CN | H | H | P21 | H | P3 | F | H |
| Lₐ₁₀₇₉ | P11 | CN | H | H | P21 | H | P4 | F | H |
| Lₐ₁₀₈₀ | P11 | CN | H | H | P21 | H | P5 | F | H |
| Lₐ₁₀₈₁ | P11 | CN | H | H | P21 | H | P6 | F | H |
| Lₐ₁₀₈₂ | P11 | CN | H | H | P21 | H | P7 | F | H |
| Lₐ₁₀₈₃ | P11 | CN | H | H | P21 | H | P8 | F | H |
| Lₐ₁₀₈₄ | P11 | CN | H | H | P21 | H | P9 | F | H |
| Lₐ₁₀₈₅ | P11 | CN | H | H | P21 | H | P10 | F | H |
| Lₐ₁₀₈₆ | P11 | CN | H | H | P21 | H | P11 | F | H |
| Lₐ₁₀₈₇ | P11 | CN | H | H | P21 | H | P1 | P1 | H |
| Lₐ₁₀₈₈ | P11 | CN | H | H | P21 | H | P2 | P2 | H |
| Lₐ₁₀₈₉ | P11 | CN | H | H | P21 | D | D | D | D |
| Lₐ₁₀₉₀ | P11 | CN | H | H | P21 | D | P2 | P2 | D |
| Lₐ₁₀₉₁ | P11 | CN | H | H | P21 | D | F | P4 | D |
| Lₐ₁₀₉₂ | P11 | CN | H | H | P21 | D | F | P5 | D |
| Lₐ₁₀₉₃ | P11 | CN | H | H | P21 | D | F | P9 | D |
| Lₐ₁₀₉₄ | P11 | CN | H | H | P21 | D | F | P11 | D |
| Lₐ₁₀₉₅ | P11 | CN | H | H | P54 | H | H | H | H |
| Lₐ₁₀₉₆ | P11 | CN | H | H | P54 | H | P1 | H | H |
| Lₐ₁₀₉₇ | P11 | CN | H | H | P54 | H | P2 | H | H |
| Lₐ₁₀₉₈ | P11 | CN | H | H | P54 | H | P3 | H | H |
| Lₐ₁₀₉₉ | P11 | CN | H | H | P54 | H | P4 | H | H |
| Lₐ₁₁₀₀ | P11 | CN | H | H | P54 | H | P5 | H | H |
| Lₐ₁₁₀₁ | P11 | CN | H | H | P54 | H | P6 | H | H |
| Lₐ₁₁₀₂ | P11 | CN | H | H | P54 | H | P7 | H | H |
| Lₐ₁₁₀₃ | P11 | CN | H | H | P54 | H | P8 | H | H |
| Lₐ₁₁₀₄ | P11 | CN | H | H | P54 | H | P9 | H | H |
| Lₐ₁₁₀₅ | P11 | CN | H | H | P54 | H | P10 | H | H |
| Lₐ₁₁₀₆ | P11 | CN | H | H | P54 | H | P11 | H | H |
| Lₐ₁₁₀₇ | P11 | CN | H | H | P54 | H | P12 | H | H |
| Lₐ₁₁₀₈ | P11 | CN | H | H | P54 | H | P13 | H | H |
| Lₐ₁₁₀₉ | P11 | CN | H | H | P54 | H | P14 | H | H |
| Lₐ₁₁₁₀ | P11 | CN | H | H | P54 | H | P15 | H | H |
| Lₐ₁₁₁₁ | P11 | CN | H | H | P54 | H | P16 | H | H |
| Lₐ₁₁₁₂ | P11 | CN | H | H | P54 | H | P17 | H | H |
| Lₐ₁₁₁₃ | P11 | CN | H | H | P54 | H | P18 | H | H |
| Lₐ₁₁₁₄ | P11 | CN | H | H | P54 | H | P19 | H | H |
| Lₐ₁₁₁₅ | P11 | CN | H | H | P54 | H | P20 | H | H |
| Lₐ₁₁₁₆ | P11 | CN | H | H | P54 | H | P21 | H | H |
| Lₐ₁₁₁₇ | P11 | CN | H | H | P54 | H | H | P1 | H |
| Lₐ₁₁₁₈ | P11 | CN | H | H | P54 | H | H | P2 | H |
| Lₐ₁₁₁₉ | P11 | CN | H | H | P54 | H | H | P3 | H |
| Lₐ₁₁₂₀ | P11 | CN | H | H | P54 | H | H | P4 | H |
| Lₐ₁₁₂₁ | P11 | CN | H | H | P54 | H | H | P5 | H |
| Lₐ₁₁₂₂ | P11 | CN | H | H | P54 | H | H | P6 | H |
| Lₐ₁₁₂₃ | P11 | CN | H | H | P54 | H | H | P7 | H |
| Lₐ₁₁₂₄ | P11 | CN | H | H | P54 | H | H | P8 | H |
| Lₐ₁₁₂₅ | P11 | CN | H | H | P54 | H | H | P9 | H |
| Lₐ₁₁₂₆ | P11 | CN | H | H | P54 | H | H | P10 | H |
| Lₐ₁₁₂₇ | P11 | CN | H | H | P54 | H | H | P11 | H |
| Lₐ₁₁₂₈ | P11 | CN | H | H | P54 | H | H | P12 | H |
| Lₐ₁₁₂₉ | P11 | CN | H | H | P54 | H | H | P15 | H |
| Lₐ₁₁₃₀ | P11 | CN | H | H | P54 | H | H | P17 | H |
| Lₐ₁₁₃₁ | P11 | CN | H | H | P54 | H | H | P18 | H |
| Lₐ₁₁₃₂ | P11 | CN | H | H | P54 | H | H | P19 | H |
| Lₐ₁₁₃₃ | P11 | CN | H | H | P54 | H | H | P20 | H |
| Lₐ₁₁₃₄ | P11 | CN | H | H | P54 | H | H | P21 | H |
| Lₐ₁₁₃₅ | P11 | CN | H | H | P54 | H | F | H | H |
| Lₐ₁₁₃₆ | P11 | CN | H | H | P54 | H | F | P1 | H |
| Lₐ₁₁₃₇ | P11 | CN | H | H | P54 | H | F | P2 | H |
| Lₐ₁₁₃₈ | P11 | CN | H | H | P54 | H | F | P3 | H |
| Lₐ₁₁₃₉ | P11 | CN | H | H | P54 | H | F | P4 | H |
| Lₐ₁₁₄₀ | P11 | CN | H | H | P54 | H | F | P5 | H |
| Lₐ₁₁₄₁ | P11 | CN | H | H | P54 | H | F | P6 | H |
| Lₐ₁₁₄₂ | P11 | CN | H | H | P54 | H | F | P7 | H |
| Lₐ₁₁₄₃ | P11 | CN | H | H | P54 | H | F | P8 | H |
| Lₐ₁₁₄₄ | P11 | CN | H | H | P54 | H | F | P9 | H |
| Lₐ₁₁₄₅ | P11 | CN | H | H | P54 | H | F | P10 | H |
| Lₐ₁₁₄₆ | P11 | CN | H | H | P54 | H | F | P11 | H |
| Lₐ₁₁₄₇ | P11 | CN | H | H | P54 | H | P1 | F | H |
| Lₐ₁₁₄₈ | P11 | CN | H | H | P54 | H | P2 | F | H |
| Lₐ₁₁₄₉ | P11 | CN | H | H | P54 | H | P3 | F | H |
| Lₐ₁₁₅₀ | P11 | CN | H | H | P54 | H | P4 | F | H |
| Lₐ₁₁₅₁ | P11 | CN | H | H | P54 | H | P5 | F | H |
| Lₐ₁₁₅₂ | P11 | CN | H | H | P54 | H | P6 | F | H |
| Lₐ₁₁₅₃ | P11 | CN | H | H | P54 | H | P7 | F | H |
| Lₐ₁₁₅₄ | P11 | CN | H | H | P54 | H | P8 | F | H |
| Lₐ₁₁₅₅ | P11 | CN | H | H | P54 | H | P9 | F | H |
| Lₐ₁₁₅₆ | P11 | CN | H | H | P54 | H | P10 | F | H |
| Lₐ₁₁₅₇ | P11 | CN | H | H | P54 | H | P11 | F | H |
| Lₐ₁₁₅₈ | P11 | CN | H | H | P54 | H | P1 | P1 | H |
| Lₐ₁₁₅₉ | P11 | CN | H | H | P54 | H | P2 | P2 | H |
| Lₐ₁₁₆₀ | P11 | CN | H | H | P54 | D | D | D | D |
| Lₐ₁₁₆₁ | P11 | CN | H | H | P54 | D | P2 | P2 | D |
| Lₐ₁₁₆₂ | P11 | CN | H | H | P54 | D | F | P4 | D |
| Lₐ₁₁₆₃ | P11 | CN | H | H | P54 | D | F | P5 | D |
| Lₐ₁₁₆₄ | P11 | CN | H | H | P54 | D | F | P9 | D |
| Lₐ₁₁₆₅ | P11 | CN | H | H | P54 | D | F | P11 | D |
| Lₐ₁₁₆₆ | P11 | CN | H | H | P96 | H | H | H | H |
| Lₐ₁₁₆₇ | P11 | CN | H | H | P96 | H | P1 | H | H |
| Lₐ₁₁₆₈ | P11 | CN | H | H | P96 | H | P2 | H | H |
| Lₐ₁₁₆₉ | P11 | CN | H | H | P96 | H | P3 | H | H |
| Lₐ₁₁₇₀ | P11 | CN | H | H | P96 | H | P4 | H | H |
| Lₐ₁₁₇₁ | P11 | CN | H | H | P96 | H | P5 | H | H |
| Lₐ₁₁₇₂ | P11 | CN | H | H | P96 | H | P6 | H | H |
| Lₐ₁₁₇₃ | P11 | CN | H | H | P96 | H | P7 | H | H |
| Lₐ₁₁₇₄ | P11 | CN | H | H | P96 | H | P8 | H | H |
| Lₐ₁₁₇₅ | P11 | CN | H | H | P96 | H | P9 | H | H |
| Lₐ₁₁₇₆ | P11 | CN | H | H | P96 | H | P10 | H | H |
| Lₐ₁₁₇₇ | P11 | CN | H | H | P96 | H | P11 | H | H |
| Lₐ₁₁₇₈ | P11 | CN | H | H | P96 | H | P12 | H | H |
| Lₐ₁₁₇₉ | P11 | CN | H | H | P96 | H | P13 | H | H |
| Lₐ₁₁₈₀ | P11 | CN | H | H | P96 | H | P14 | H | H |
| Lₐ₁₁₈₁ | P11 | CN | H | H | P96 | H | P15 | H | H |
| Lₐ₁₁₈₂ | P11 | CN | H | H | P96 | H | P16 | H | H |
| Lₐ₁₁₈₃ | P11 | CN | H | H | P96 | H | P17 | H | H |
| Lₐ₁₁₈₄ | P11 | CN | H | H | P96 | H | P18 | H | H |
| Lₐ₁₁₈₅ | P11 | CN | H | H | P96 | H | P19 | H | H |
| Lₐ₁₁₈₆ | P11 | CN | H | H | P96 | H | P20 | H | H |
| Lₐ₁₁₈₇ | P11 | CN | H | H | P96 | H | P21 | H | H |
| Lₐ₁₁₈₈ | P11 | CN | H | H | P96 | H | H | P1 | H |
| Lₐ₁₁₈₉ | P11 | CN | H | H | P96 | H | H | P2 | H |
| Lₐ₁₁₉₀ | P11 | CN | H | H | P96 | H | H | P3 | H |
| Lₐ₁₁₉₁ | P11 | CN | H | H | P96 | H | H | P4 | H |
| Lₐ₁₁₉₂ | P11 | CN | H | H | P96 | H | H | P5 | H |
| Lₐ₁₁₉₃ | P11 | CN | H | H | P96 | H | H | P6 | H |
| Lₐ₁₁₉₄ | P11 | CN | H | H | P96 | H | H | P7 | H |
| Lₐ₁₁₉₅ | P11 | CN | H | H | P96 | H | H | P8 | H |
| Lₐ₁₁₉₆ | P11 | CN | H | H | P96 | H | H | P9 | H |
| Lₐ₁₁₉₇ | P11 | CN | H | H | P96 | H | H | P10 | H |
| Lₐ₁₁₉₈ | P11 | CN | H | H | P96 | H | H | P11 | H |
| Lₐ₁₁₉₉ | P11 | CN | H | H | P96 | H | H | P12 | H |
| Lₐ₁₂₀₀ | P11 | CN | H | H | P96 | H | H | P15 | H |
| Lₐ₁₂₀₁ | P11 | CN | H | H | P96 | H | H | P17 | H |
| Lₐ₁₂₀₂ | P11 | CN | H | H | P96 | H | H | P18 | H |
| Lₐ₁₂₀₃ | P11 | CN | H | H | P96 | H | H | P19 | H |
| Lₐ₁₂₀₄ | P11 | CN | H | H | P96 | H | H | P20 | H |
| Lₐ₁₂₀₅ | P11 | CN | H | H | P96 | H | H | P21 | H |
| Lₐ₁₂₀₆ | P11 | CN | H | H | P96 | H | F | H | H |
| Lₐ₁₂₀₇ | P11 | CN | H | H | P96 | H | F | P1 | H |
| Lₐ₁₂₀₈ | P11 | CN | H | H | P96 | H | F | P2 | H |
| Lₐ₁₂₀₉ | P11 | CN | H | H | P96 | H | F | P3 | H |
| Lₐ₁₂₁₀ | P11 | CN | H | H | P96 | H | F | P4 | H |
| Lₐ₁₂₁₁ | P11 | CN | H | H | P96 | H | F | P5 | H |
| Lₐ₁₂₁₂ | P11 | CN | H | H | P96 | H | F | P6 | H |
| Lₐ₁₂₁₃ | P11 | CN | H | H | P96 | H | F | P7 | H |
| Lₐ₁₂₁₄ | P11 | CN | H | H | P96 | H | F | P8 | H |
| Lₐ₁₂₁₅ | P11 | CN | H | H | P96 | H | F | P9 | H |
| Lₐ₁₂₁₆ | P11 | CN | H | H | P96 | H | F | P10 | H |
| Lₐ₁₂₁₇ | P11 | CN | H | H | P96 | H | F | P11 | H |
| Lₐ₁₂₁₈ | P11 | CN | H | H | P96 | H | P1 | F | H |
| Lₐ₁₂₁₉ | P11 | CN | H | H | P96 | H | P2 | F | H |
| Lₐ₁₂₂₀ | P11 | CN | H | H | P96 | H | P3 | F | H |
| Lₐ₁₂₂₁ | P11 | CN | H | H | P96 | H | P4 | F | H |
| Lₐ₁₂₂₂ | P11 | CN | H | H | P96 | H | P5 | F | H |
| Lₐ₁₂₂₃ | P11 | CN | H | H | P96 | H | P6 | F | H |
| Lₐ₁₂₂₄ | P11 | CN | H | H | P96 | H | P7 | F | H |
| Lₐ₁₂₂₅ | P11 | CN | H | H | P96 | H | P8 | F | H |
| Lₐ₁₂₂₆ | P11 | CN | H | H | P96 | H | P9 | F | H |
| Lₐ₁₂₂₇ | P11 | CN | H | H | P96 | H | P10 | F | H |
| Lₐ₁₂₂₈ | P11 | CN | H | H | P96 | H | P11 | F | H |
| Lₐ₁₂₂₉ | P11 | CN | H | H | P96 | H | P1 | P1 | H |
| Lₐ₁₂₃₀ | P11 | CN | H | H | P96 | H | P2 | P2 | H |
| Lₐ₁₂₃₁ | P11 | CN | H | H | P96 | D | D | D | D |
| Lₐ₁₂₃₂ | P11 | CN | H | H | P96 | D | P2 | P2 | D |
| Lₐ₁₂₃₃ | P11 | CN | H | H | P96 | D | F | P4 | D |
| Lₐ₁₂₃₄ | P11 | CN | H | H | P96 | D | F | P5 | D |
| Lₐ₁₂₃₅ | P11 | CN | H | H | P96 | D | F | P9 | D |
| Lₐ₁₂₃₆ | P11 | CN | H | H | P96 | D | F | P11 | D |
| Lₐ₁₂₃₇ | P11 | CN | H | H | P97 | H | H | H | H |
| Lₐ₁₂₃₈ | P11 | CN | H | H | P97 | H | P1 | H | H |
| Lₐ₁₂₃₉ | P11 | CN | H | H | P97 | H | P2 | H | H |
| Lₐ₁₂₄₀ | P11 | CN | H | H | P97 | H | P3 | H | H |
| Lₐ₁₂₄₁ | P11 | CN | H | H | P97 | H | P4 | H | H |
| Lₐ₁₂₄₂ | P11 | CN | H | H | P97 | H | P5 | H | H |
| Lₐ₁₂₄₃ | P11 | CN | H | H | P97 | H | P6 | H | H |
| Lₐ₁₂₄₄ | P11 | CN | H | H | P97 | H | P7 | H | H |
| Lₐ₁₂₄₅ | P11 | CN | H | H | P97 | H | P8 | H | H |
| Lₐ₁₂₄₆ | P11 | CN | H | H | P97 | H | P9 | H | H |
| Lₐ₁₂₄₇ | P11 | CN | H | H | P97 | H | P10 | H | H |
| Lₐ₁₂₄₈ | P11 | CN | H | H | P97 | H | P11 | H | H |
| Lₐ₁₂₄₉ | P11 | CN | H | H | P97 | H | P12 | H | H |
| Lₐ₁₂₅₀ | P11 | CN | H | H | P97 | H | P13 | H | H |
| Lₐ₁₂₅₁ | P11 | CN | H | H | P97 | H | P14 | H | H |
| Lₐ₁₂₅₂ | P11 | CN | H | H | P97 | H | P15 | H | H |
| Lₐ₁₂₅₃ | P11 | CN | H | H | P97 | H | P16 | H | H |
| Lₐ₁₂₅₄ | P11 | CN | H | H | P97 | H | P17 | H | H |
| Lₐ₁₂₅₅ | P11 | CN | H | H | P97 | H | P18 | H | H |
| Lₐ₁₂₅₆ | P11 | CN | H | H | P97 | H | P19 | H | H |
| Lₐ₁₂₅₇ | P11 | CN | H | H | P97 | H | P20 | H | H |
| Lₐ₁₂₅₈ | P11 | CN | H | H | P97 | H | P21 | H | H |
| Lₐ₁₂₅₉ | P11 | CN | H | H | P97 | H | H | P1 | H |
| Lₐ₁₂₆₀ | P11 | CN | H | H | P97 | H | H | P2 | H |
| Lₐ₁₂₆₁ | P11 | CN | H | H | P97 | H | H | P3 | H |
| Lₐ₁₂₆₂ | P11 | CN | H | H | P97 | H | H | P4 | H |
| Lₐ₁₂₆₃ | P11 | CN | H | H | P97 | H | H | P5 | H |
| Lₐ₁₂₆₄ | P11 | CN | H | H | P97 | H | H | P6 | H |
| Lₐ₁₂₆₅ | P11 | CN | H | H | P97 | H | H | P7 | H |
| Lₐ₁₂₆₆ | P11 | CN | H | H | P97 | H | H | P8 | H |
| Lₐ₁₂₆₇ | P11 | CN | H | H | P97 | H | H | P9 | H |
| Lₐ₁₂₆₈ | P11 | CN | H | H | P97 | H | H | P10 | H |
| Lₐ₁₂₆₉ | P11 | CN | H | H | P97 | H | H | P11 | H |
| Lₐ₁₂₇₀ | P11 | CN | H | H | P97 | H | H | P12 | H |
| Lₐ₁₂₇₁ | P11 | CN | H | H | P97 | H | H | P15 | H |
| Lₐ₁₂₇₂ | P11 | CN | H | H | P97 | H | H | P17 | H |
| Lₐ₁₂₇₃ | P11 | CN | H | H | P97 | H | H | P18 | H |
| Lₐ₁₂₇₄ | P11 | CN | H | H | P97 | H | H | P19 | H |
| Lₐ₁₂₇₅ | P11 | CN | H | H | P97 | H | H | P20 | H |
| Lₐ₁₂₇₆ | P11 | CN | H | H | P97 | H | H | P21 | H |
| Lₐ₁₂₇₇ | P11 | CN | H | H | P97 | H | F | H | H |
| Lₐ₁₂₇₈ | P11 | CN | H | H | P97 | H | F | P1 | H |
| Lₐ₁₂₇₉ | P11 | CN | H | H | P97 | H | F | P2 | H |
| Lₐ₁₂₈₀ | P11 | CN | H | H | P97 | H | F | P3 | H |
| Lₐ₁₂₈₁ | P11 | CN | H | H | P97 | H | F | P4 | H |
| Lₐ₁₂₈₂ | P11 | CN | H | H | P97 | H | F | P5 | H |
| Lₐ₁₂₈₃ | P11 | CN | H | H | P97 | H | F | P6 | H |
| Lₐ₁₂₈₄ | P11 | CN | H | H | P97 | H | F | P7 | H |
| Lₐ₁₂₈₅ | P11 | CN | H | H | P97 | H | F | P8 | H |
| Lₐ₁₂₈₆ | P11 | CN | H | H | P97 | H | F | P9 | H |
| Lₐ₁₂₈₇ | P11 | CN | H | H | P97 | H | F | P10 | H |
| Lₐ₁₂₈₈ | P11 | CN | H | H | P97 | H | F | P11 | H |
| Lₐ₁₂₈₉ | P11 | CN | H | H | P97 | H | P1 | F | H |
| Lₐ₁₂₉₀ | P11 | CN | H | H | P97 | H | P2 | F | H |
| Lₐ₁₂₉₁ | P11 | CN | H | H | P97 | H | P3 | F | H |
| Lₐ₁₂₉₂ | P11 | CN | H | H | P97 | H | P4 | F | H |
| Lₐ₁₂₉₃ | P11 | CN | H | H | P97 | H | P5 | F | H |
| Lₐ₁₂₉₄ | P11 | CN | H | H | P97 | H | P6 | F | H |
| Lₐ₁₂₉₅ | P11 | CN | H | H | P97 | H | P7 | F | H |
| Lₐ₁₂₉₆ | P11 | CN | H | H | P97 | H | P8 | F | H |
| Lₐ₁₂₉₇ | P11 | CN | H | H | P97 | H | P9 | F | H |
| Lₐ₁₂₉₈ | P11 | CN | H | H | P97 | H | P10 | F | H |
| Lₐ₁₂₉₉ | P11 | CN | H | H | P97 | H | P11 | F | H |
| Lₐ₁₃₀₀ | P11 | CN | H | H | P97 | H | P1 | P1 | H |
| Lₐ₁₃₀₁ | P11 | CN | H | H | P97 | H | P2 | P2 | H |
| Lₐ₁₃₀₂ | P11 | CN | H | H | P97 | D | D | D | D |
| Lₐ₁₃₀₃ | P11 | CN | H | H | P97 | D | P2 | P2 | D |
| Lₐ₁₃₀₄ | P11 | CN | H | H | P97 | D | F | P4 | D |
| Lₐ₁₃₀₅ | P11 | CN | H | H | P97 | D | F | P5 | D |
| Lₐ₁₃₀₆ | P11 | CN | H | H | P97 | D | F | P9 | D |
| Lₐ₁₃₀₇ | P11 | CN | H | H | P97 | D | F | P11 | D |
| Lₐ₁₃₀₈ | P11 | CN | H | H | P102 | H | P1 | H | H |
| Lₐ₁₃₀₉ | P11 | CN | H | H | P102 | H | P2 | H | H |
| Lₐ₁₃₁₀ | P11 | CN | H | H | P102 | H | P3 | H | H |
| Lₐ₁₃₁₁ | P11 | CN | H | H | P102 | H | P4 | H | H |
| Lₐ₁₃₁₂ | P11 | CN | H | H | P102 | H | P5 | H | H |
| Lₐ₁₃₁₃ | P11 | CN | H | H | P102 | H | P6 | H | H |
| Lₐ₁₃₁₄ | P11 | CN | H | H | P102 | H | P7 | H | H |
| Lₐ₁₃₁₅ | P11 | CN | H | H | P102 | H | P8 | H | H |
| Lₐ₁₃₁₆ | P11 | CN | H | H | P102 | H | P9 | H | H |
| Lₐ₁₃₁₇ | P11 | CN | H | H | P102 | H | P10 | H | H |
| Lₐ₁₃₁₈ | P11 | CN | H | H | P102 | H | P11 | H | H |
| Lₐ₁₃₁₉ | P11 | CN | H | H | P102 | H | P12 | H | H |
| Lₐ₁₃₂₀ | P11 | CN | H | H | P102 | H | P13 | H | H |
| Lₐ₁₃₂₁ | P11 | CN | H | H | P102 | H | P14 | H | H |
| Lₐ₁₃₂₂ | P11 | CN | H | H | P102 | H | P15 | H | H |
| Lₐ₁₃₂₃ | P11 | CN | H | H | P102 | H | P16 | H | H |
| Lₐ₁₃₂₄ | P11 | CN | H | H | P102 | H | P17 | H | H |
| Lₐ₁₃₂₅ | P11 | CN | H | H | P102 | H | P18 | H | H |
| Lₐ₁₃₂₆ | P11 | CN | H | H | P102 | H | P19 | H | H |
| Lₐ₁₃₂₇ | P11 | CN | H | H | P102 | H | P20 | H | H |
| Lₐ₁₃₂₈ | P11 | CN | H | H | P102 | H | P21 | H | H |
| Lₐ₁₃₂₉ | P11 | CN | H | H | P102 | H | H | P1 | H |
| Lₐ₁₃₃₀ | P11 | CN | H | H | P102 | H | H | P2 | H |
| Lₐ₁₃₃₁ | P11 | CN | H | H | P102 | H | H | P3 | H |
| Lₐ₁₃₃₂ | P11 | CN | H | H | P102 | H | H | P4 | H |
| Lₐ₁₃₃₃ | P11 | CN | H | H | P102 | H | H | P5 | H |
| Lₐ₁₃₃₄ | P11 | CN | H | H | P102 | H | H | P6 | H |
| Lₐ₁₃₃₅ | P11 | CN | H | H | P102 | H | H | P7 | H |
| Lₐ₁₃₃₆ | P11 | CN | H | H | P102 | H | H | P8 | H |
| Lₐ₁₃₃₇ | P11 | CN | H | H | P102 | H | H | P9 | H |
| Lₐ₁₃₃₈ | P11 | CN | H | H | P102 | H | H | P10 | H |
| Lₐ₁₃₃₉ | P11 | CN | H | H | P102 | H | H | P11 | H |
| Lₐ₁₃₄₀ | P11 | CN | H | H | P102 | H | H | P12 | H |
| Lₐ₁₃₄₁ | P11 | CN | H | H | P102 | H | H | P15 | H |
| Lₐ₁₃₄₂ | P11 | CN | H | H | P102 | H | H | P17 | H |
| Lₐ₁₃₄₃ | P11 | CN | H | H | P102 | H | H | P18 | H |
| Lₐ₁₃₄₄ | P11 | CN | H | H | P102 | H | H | P19 | H |
| Lₐ₁₃₄₅ | P11 | CN | H | H | P102 | H | H | P20 | H |
| Lₐ₁₃₄₆ | P11 | CN | H | H | P102 | H | H | P21 | H |
| Lₐ₁₃₄₇ | P11 | CN | H | H | P102 | H | F | H | H |
| Lₐ₁₃₄₈ | P11 | CN | H | H | P102 | H | F | P1 | H |
| Lₐ₁₃₄₉ | P11 | CN | H | H | P102 | H | F | P2 | H |
| Lₐ₁₃₅₀ | P11 | CN | H | H | P102 | H | F | P3 | H |
| Lₐ₁₃₅₁ | P11 | CN | H | H | P102 | H | F | P4 | H |
| Lₐ₁₃₅₂ | P11 | CN | H | H | P102 | H | F | P5 | H |
| Lₐ₁₃₅₃ | P11 | CN | H | H | P102 | H | F | P6 | H |
| Lₐ₁₃₅₄ | P11 | CN | H | H | P102 | H | F | P7 | H |
| Lₐ₁₃₅₅ | P11 | CN | H | H | P102 | H | F | P8 | H |
| Lₐ₁₃₅₆ | P11 | CN | H | H | P102 | H | F | P9 | H |
| Lₐ₁₃₅₇ | P11 | CN | H | H | P102 | H | F | P10 | H |
| Lₐ₁₃₅₈ | P11 | CN | H | H | P102 | H | F | P11 | H |
| Lₐ₁₃₅₉ | P11 | CN | H | H | P102 | H | P1 | F | H |
| Lₐ₁₃₆₀ | P11 | CN | H | H | P102 | H | P2 | F | H |
| Lₐ₁₃₆₁ | P11 | CN | H | H | P102 | H | P3 | F | H |
| Lₐ₁₃₆₂ | P11 | CN | H | H | P102 | H | P4 | F | H |
| Lₐ₁₃₆₃ | P11 | CN | H | H | P102 | H | P5 | F | H |
| Lₐ₁₃₆₄ | P11 | CN | H | H | P102 | H | P6 | F | H |
| Lₐ₁₃₆₅ | P11 | CN | H | H | P102 | H | P7 | F | H |
| Lₐ₁₃₆₆ | P11 | CN | H | H | P102 | H | P8 | F | H |
| Lₐ₁₃₆₇ | P11 | CN | H | H | P102 | H | P9 | F | H |
| Lₐ₁₃₆₈ | P11 | CN | H | H | P102 | H | P10 | F | H |
| Lₐ₁₃₆₉ | P11 | CN | H | H | P102 | H | P11 | F | H |
| Lₐ₁₃₇₀ | P11 | CN | H | H | P102 | H | P1 | P1 | H |
| Lₐ₁₃₇₁ | P11 | CN | H | H | P102 | H | P2 | P2 | H |
| Lₐ₁₃₇₂ | P11 | CN | H | H | P102 | D | D | D | D |
| Lₐ₁₃₇₃ | P11 | CN | H | H | P102 | D | P2 | P2 | D |
| Lₐ₁₃₇₄ | P11 | CN | H | H | P102 | D | F | P4 | D |
| Lₐ₁₃₇₅ | P11 | CN | H | H | P102 | D | F | P5 | D |
| Lₐ₁₃₇₆ | P11 | CN | H | H | P102 | D | F | P9 | D |
| Lₐ₁₃₇₇ | P11 | CN | H | H | P102 | D | F | P11 | D |
| Lₐ₁₃₇₈ | P11 | CN | H | H | P103 | H | P1 | H | H |
| Lₐ₁₃₇₉ | P11 | CN | H | H | P103 | H | P2 | H | H |
| Lₐ₁₃₈₀ | P11 | CN | H | H | P103 | H | P3 | H | H |
| Lₐ₁₃₈₁ | P11 | CN | H | H | P103 | H | P4 | H | H |
| Lₐ₁₃₈₂ | P11 | CN | H | H | P103 | H | P5 | H | H |
| Lₐ₁₃₈₃ | P11 | CN | H | H | P103 | H | P6 | H | H |
| Lₐ₁₃₈₄ | P11 | CN | H | H | P103 | H | P7 | H | H |
| Lₐ₁₃₈₅ | P11 | CN | H | H | P103 | H | P8 | H | H |
| Lₐ₁₃₈₆ | P11 | CN | H | H | P103 | H | P9 | H | H |
| Lₐ₁₃₈₇ | P11 | CN | H | H | P103 | H | P10 | H | H |
| Lₐ₁₃₈₈ | P11 | CN | H | H | P103 | H | P11 | H | H |
| Lₐ₁₃₈₉ | P11 | CN | H | H | P103 | H | P12 | H | H |
| Lₐ₁₃₉₀ | P11 | CN | H | H | P103 | H | P13 | H | H |
| Lₐ₁₃₉₁ | P11 | CN | H | H | P103 | H | P14 | H | H |
| Lₐ₁₃₉₂ | P11 | CN | H | H | P103 | H | P15 | H | H |
| Lₐ₁₃₉₃ | P11 | CN | H | H | P103 | H | P16 | H | H |
| Lₐ₁₃₉₄ | P11 | CN | H | H | P103 | H | P17 | H | H |
| Lₐ₁₃₉₅ | P11 | CN | H | H | P103 | H | P18 | H | H |
| Lₐ₁₃₉₆ | P11 | CN | H | H | P103 | H | P19 | H | H |
| Lₐ₁₃₉₇ | P11 | CN | H | H | P103 | H | P20 | H | H |
| Lₐ₁₃₉₈ | P11 | CN | H | H | P103 | H | P21 | H | H |
| Lₐ₁₃₉₉ | P11 | CN | H | H | P103 | H | H | P1 | H |
| Lₐ₁₄₀₀ | P11 | CN | H | H | P103 | H | H | P2 | H |
| Lₐ₁₄₀₁ | P11 | CN | H | H | P103 | H | H | P3 | H |
| Lₐ₁₄₀₂ | P11 | CN | H | H | P103 | H | H | P4 | H |
| Lₐ₁₄₀₃ | P11 | CN | H | H | P103 | H | H | P5 | H |
| Lₐ₁₄₀₄ | P11 | CN | H | H | P103 | H | H | P6 | H |
| Lₐ₁₄₀₅ | P11 | CN | H | H | P103 | H | H | P7 | H |
| Lₐ₁₄₀₆ | P11 | CN | H | H | P103 | H | H | P8 | H |
| Lₐ₁₄₀₇ | P11 | CN | H | H | P103 | H | H | P9 | H |
| Lₐ₁₄₀₈ | P11 | CN | H | H | P103 | H | H | P10 | H |
| Lₐ₁₄₀₉ | P11 | CN | H | H | P103 | H | H | P11 | H |
| Lₐ₁₄₁₀ | P11 | CN | H | H | P103 | H | H | P12 | H |
| Lₐ₁₄₁₁ | P11 | CN | H | H | P103 | H | H | P15 | H |
| Lₐ₁₄₁₂ | P11 | CN | H | H | P103 | H | H | P17 | H |
| Lₐ₁₄₁₃ | P11 | CN | H | H | P103 | H | H | P18 | H |
| Lₐ₁₄₁₄ | P11 | CN | H | H | P103 | H | H | P19 | H |
| Lₐ₁₄₁₅ | P11 | CN | H | H | P103 | H | H | P20 | H |
| Lₐ₁₄₁₆ | P11 | CN | H | H | P103 | H | H | P21 | H |
| Lₐ₁₄₁₇ | P11 | CN | H | H | P103 | H | F | H | H |
| Lₐ₁₄₁₈ | P11 | CN | H | H | P103 | H | F | P1 | H |
| Lₐ₁₄₁₉ | P11 | CN | H | H | P103 | H | F | P2 | H |
| Lₐ₁₄₂₀ | P11 | CN | H | H | P103 | H | F | P3 | H |
| Lₐ₁₄₂₁ | P11 | CN | H | H | P103 | H | F | P4 | H |
| Lₐ₁₄₂₂ | P11 | CN | H | H | P103 | H | F | P5 | H |
| Lₐ₁₄₂₃ | P11 | CN | H | H | P103 | H | F | P6 | H |
| Lₐ₁₄₂₄ | P11 | CN | H | H | P103 | H | F | P7 | H |
| Lₐ₁₄₂₅ | P11 | CN | H | H | P103 | H | F | P8 | H |
| Lₐ₁₄₂₆ | P11 | CN | H | H | P103 | H | F | P9 | H |
| Lₐ₁₄₂₇ | P11 | CN | H | H | P103 | H | F | P10 | H |
| Lₐ₁₄₂₈ | P11 | CN | H | H | P103 | H | F | P11 | H |
| Lₐ₁₄₂₉ | P11 | CN | H | H | P103 | H | P1 | F | H |
| Lₐ₁₄₃₀ | P11 | CN | H | H | P103 | H | P2 | F | H |
| Lₐ₁₄₃₁ | P11 | CN | H | H | P103 | H | P3 | F | H |
| Lₐ₁₄₃₂ | P11 | CN | H | H | P103 | H | P4 | F | H |
| Lₐ₁₄₃₃ | P11 | CN | H | H | P103 | H | P5 | F | H |
| Lₐ₁₄₃₄ | P11 | CN | H | H | P103 | H | P6 | F | H |
| Lₐ₁₄₃₅ | P11 | CN | H | H | P103 | H | P7 | F | H |
| Lₐ₁₄₃₆ | P11 | CN | H | H | P103 | H | P8 | F | H |
| Lₐ₁₄₃₇ | P11 | CN | H | H | P103 | H | P9 | F | H |
| Lₐ₁₄₃₈ | P11 | CN | H | H | P103 | H | P10 | F | H |
| Lₐ₁₄₃₉ | P11 | CN | H | H | P103 | H | P11 | F | H |
| Lₐ₁₄₄₀ | P11 | CN | H | H | P103 | H | P1 | P1 | H |
| Lₐ₁₄₄₁ | P11 | CN | H | H | P103 | H | P2 | P2 | H |
| Lₐ₁₄₄₂ | P11 | CN | H | H | P103 | D | D | D | D |
| Lₐ₁₄₄₃ | P11 | CN | H | H | P103 | D | P2 | P2 | D |
| Lₐ₁₄₄₄ | P11 | CN | H | H | P103 | D | F | P4 | D |
| Lₐ₁₄₄₅ | P11 | CN | H | H | P103 | D | F | P5 | D |
| Lₐ₁₄₄₆ | P11 | CN | H | H | P103 | D | F | P9 | D |
| Lₐ₁₄₄₇ | P11 | CN | H | H | P103 | D | F | P11 | D |
| Lₐ₁₄₄₈ | P11 | CN | H | H | H | H | P20 | P1 | H |
| Lₐ₁₄₄₉ | P11 | CN | H | H | H | H | P21 | P2 | H |
| Lₐ₁₄₅₀ | P11 | CN | H | H | H | H | P29 | H | H |
| Lₐ₁₄₅₁ | P11 | CN | H | H | H | H | P29 | P1 | H |
| Lₐ₁₄₅₂ | P11 | CN | H | H | H | H | P54 | H | H |
| Lₐ₁₄₅₃ | P11 | CN | H | H | H | H | P96 | H | H |
| Lₐ₁₄₅₄ | P11 | CN | H | H | H | H | P97 | H | H |
| Lₐ₁₄₅₅ | P11 | CN | H | H | H | H | P96 | P1 | H |
| Lₐ₁₄₅₆ | P11 | CN | H | H | H | H | P97 | P1 | H |
| Lₐ₁₄₅₇ | P11 | CN | H | H | H | H | P102 | H | H |
| Lₐ₁₄₅₈ | P11 | CN | H | H | H | H | P103 | H | H |
| Lₐ₁₄₅₉ | P11 | CN | H | H | D | H | P20 | P1 | H |
| Lₐ₁₄₆₀ | P11 | CN | H | H | D | H | P21 | P2 | H |
| Lₐ₁₄₆₁ | P11 | CN | H | H | D | H | P29 | H | H |
| Lₐ₁₄₆₂ | P11 | CN | H | H | D | H | P29 | P1 | H |
| Lₐ₁₄₆₃ | P11 | CN | H | H | D | H | P54 | H | H |
| Lₐ₁₄₆₄ | P11 | CN | H | H | D | H | P96 | H | H |
| Lₐ₁₄₆₅ | P11 | CN | H | H | D | H | P97 | H | H |
| Lₐ₁₄₆₆ | P11 | CN | H | H | D | H | P96 | P1 | H |
| Lₐ₁₄₆₇ | P11 | CN | H | H | D | H | P97 | P1 | H |
| Lₐ₁₄₆₈ | P11 | CN | H | H | D | H | P102 | H | H |
| Lₐ₁₄₆₉ | P11 | CN | H | H | D | H | P103 | H | H |
| Lₐ₁₄₇₀ | P11 | CN | H | H | P20 | H | P20 | P1 | H |
| Lₐ₁₄₇₁ | P11 | CN | H | H | P20 | H | P21 | P2 | H |
| Lₐ₁₄₇₂ | P11 | CN | H | H | P20 | H | P29 | H | H |
| Lₐ₁₄₇₃ | P11 | CN | H | H | P20 | H | P29 | P1 | H |
| Lₐ₁₄₇₄ | P11 | CN | H | H | P20 | H | P54 | H | H |
| Lₐ₁₄₇₅ | P11 | CN | H | H | P20 | H | P96 | H | H |
| Lₐ₁₄₇₆ | P11 | CN | H | H | P20 | H | P97 | H | H |
| Lₐ₁₄₇₇ | P11 | CN | H | H | P20 | H | P96 | P1 | H |
| Lₐ₁₄₇₈ | P11 | CN | H | H | P20 | H | P97 | P1 | H |
| Lₐ₁₄₇₉ | P11 | CN | H | H | P20 | H | P102 | H | H |
| Lₐ₁₄₈₀ | P11 | CN | H | H | P20 | H | P103 | H | H |
| Lₐ₁₄₈₁ | P11 | CN | H | H | P21 | H | P20 | P1 | H |
| Lₐ₁₄₈₂ | P11 | CN | H | H | P21 | H | P21 | P2 | H |
| Lₐ₁₄₈₃ | P11 | CN | H | H | P21 | H | P29 | H | H |
| Lₐ₁₄₈₄ | P11 | CN | H | H | P21 | H | P29 | P1 | H |
| Lₐ₁₄₈₅ | P11 | CN | H | H | P21 | H | P54 | H | H |
| Lₐ₁₄₈₆ | P11 | CN | H | H | P21 | H | P96 | H | H |
| Lₐ₁₄₈₇ | P11 | CN | H | H | P21 | H | P97 | H | H |
| Lₐ₁₄₈₈ | P11 | CN | H | H | P21 | H | P96 | P1 | H |
| Lₐ₁₄₈₉ | P11 | CN | H | H | P21 | H | P97 | P1 | H |
| Lₐ₁₄₉₀ | P11 | CN | H | H | P21 | H | P102 | H | H |
| Lₐ₁₄₉₁ | P11 | CN | H | H | P21 | H | P103 | H | H |
| Lₐ₁₄₉₂ | P11 | CN | H | H | P22 | H | H | H | H |
| Lₐ₁₄₉₃ | P11 | CN | H | H | P23 | H | H | H | H |
| Lₐ₁₄₉₄ | P11 | CN | H | H | P24 | H | H | H | H |
| Lₐ₁₄₉₅ | P11 | CN | H | H | P25 | H | H | H | H |
| Lₐ₁₄₉₆ | P11 | CN | H | H | P26 | H | H | H | H |
| Lₐ₁₄₉₇ | P11 | CN | H | H | P27 | H | H | H | H |
| Lₐ₁₄₉₈ | P11 | CN | H | H | P28 | H | H | H | H |
| Lₐ₁₄₉₉ | P11 | CN | H | H | P29 | H | H | H | H |
| Lₐ₁₅₀₀ | P11 | CN | H | H | P30 | H | H | H | H |
| Lₐ₁₅₀₁ | P11 | CN | H | H | P31 | H | H | H | H |
| Lₐ₁₅₀₂ | P11 | CN | H | H | P32 | H | H | H | H |
| Lₐ₁₅₀₃ | P11 | CN | H | H | P33 | H | H | H | H |
| Lₐ₁₅₀₄ | P11 | CN | H | H | P34 | H | H | H | H |
| Lₐ₁₅₀₅ | P11 | CN | H | H | P35 | H | H | H | H |
| Lₐ₁₅₀₆ | P11 | CN | H | H | P36 | H | H | H | H |
| Lₐ₁₅₀₇ | P11 | CN | H | H | P37 | H | H | H | H |
| Lₐ₁₅₀₈ | P11 | CN | H | H | P38 | H | H | H | H |
| Lₐ₁₅₀₉ | P11 | CN | H | H | P39 | H | H | H | H |
| Lₐ₁₅₁₀ | P11 | CN | H | H | P40 | H | H | H | H |
| Lₐ₁₅₁₁ | P11 | CN | H | H | P41 | H | H | H | H |
| Lₐ₁₅₁₂ | P11 | CN | H | H | P42 | H | H | H | H |
| Lₐ₁₅₁₃ | P11 | CN | H | H | P43 | H | H | H | H |
| Lₐ₁₅₁₄ | P11 | CN | H | H | P44 | H | H | H | H |
| Lₐ₁₅₁₅ | P11 | CN | H | H | P45 | H | H | H | H |
| Lₐ₁₅₁₆ | P11 | CN | H | H | P46 | H | H | H | H |
| Lₐ₁₅₁₇ | P11 | CN | H | H | P47 | H | H | H | H |
| Lₐ₁₅₁₈ | P11 | CN | H | H | P48 | H | H | H | H |
| Lₐ₁₅₁₉ | P11 | CN | H | H | P49 | H | H | H | H |
| Lₐ₁₅₂₀ | P11 | CN | H | H | P50 | H | H | H | H |
| Lₐ₁₅₂₁ | P11 | CN | H | H | P51 | H | H | H | H |
| Lₐ₁₅₂₂ | P11 | CN | H | H | P52 | H | H | H | H |
| Lₐ₁₅₂₃ | P11 | CN | H | H | P53 | H | H | H | H |
| Lₐ₁₅₂₄ | P11 | CN | H | H | P55 | H | H | H | H |
| Lₐ₁₅₂₅ | P11 | CN | H | H | P56 | H | H | H | H |
| Lₐ₁₅₂₆ | P11 | CN | H | H | P57 | H | H | H | H |
| Lₐ₁₅₂₇ | P11 | CN | H | H | P58 | H | H | H | H |
| Lₐ₁₅₂₈ | P11 | CN | H | H | P59 | H | H | H | H |
| Lₐ₁₅₂₉ | P11 | CN | H | H | P60 | H | H | H | H |
| Lₐ₁₅₃₀ | P11 | CN | H | H | P61 | H | H | H | H |
| Lₐ₁₅₃₁ | P11 | CN | H | H | P62 | H | H | H | H |
| Lₐ₁₅₃₂ | P11 | CN | H | H | P63 | H | H | H | H |
| Lₐ₁₅₃₃ | P11 | CN | H | H | P64 | H | H | H | H |
| Lₐ₁₅₃₄ | P11 | CN | H | H | P65 | H | H | H | H |
| Lₐ₁₅₃₅ | P11 | CN | H | H | P66 | H | H | H | H |
| Lₐ₁₅₃₆ | P11 | CN | H | H | P67 | H | H | H | H |
| Lₐ₁₅₃₇ | P11 | CN | H | H | P68 | H | H | H | H |
| Lₐ₁₅₃₈ | P11 | CN | H | H | P69 | H | H | H | H |
| Lₐ₁₅₃₉ | P11 | CN | H | H | P70 | H | H | H | H |
| Lₐ₁₅₄₀ | P11 | CN | H | H | P71 | H | H | H | H |
| Lₐ₁₅₄₁ | P11 | CN | H | H | P72 | H | H | H | H |
| Lₐ₁₅₄₂ | P11 | CN | H | H | P73 | H | H | H | H |
| Lₐ₁₅₄₃ | P11 | CN | H | H | P74 | H | H | H | H |
| Lₐ₁₅₄₄ | P11 | CN | H | H | P75 | H | H | H | H |
| Lₐ₁₅₄₅ | P11 | CN | H | H | P76 | H | H | H | H |
| Lₐ₁₅₄₆ | P11 | CN | H | H | P77 | H | H | H | H |
| Lₐ₁₅₄₇ | P11 | CN | H | H | P78 | H | H | H | H |
| Lₐ₁₅₄₈ | P11 | CN | H | H | P79 | H | H | H | H |
| Lₐ₁₅₄₉ | P11 | CN | H | H | P80 | H | H | H | H |
| Lₐ₁₅₅₀ | P11 | CN | H | H | P81 | H | H | H | H |
| Lₐ₁₅₅₁ | P11 | CN | H | H | P82 | H | H | H | H |
| Lₐ₁₅₅₂ | P11 | CN | H | H | P83 | H | H | H | H |
| Lₐ₁₅₅₃ | P11 | CN | H | H | P84 | H | H | H | H |
| Lₐ₁₅₅₄ | P11 | CN | H | H | P85 | H | H | H | H |
| Lₐ₁₅₅₅ | P11 | CN | H | H | P86 | H | H | H | H |
| Lₐ₁₅₅₆ | P11 | CN | H | H | P87 | H | H | H | H |
| Lₐ₁₅₅₇ | P11 | CN | H | H | P88 | H | H | H | H |
| Lₐ₁₅₅₈ | P11 | CN | H | H | P89 | H | H | H | H |
| Lₐ₁₅₅₉ | P11 | CN | H | H | P90 | H | H | H | H |
| Lₐ₁₅₆₀ | P11 | CN | H | H | P91 | H | H | H | H |
| Lₐ₁₅₆₁ | P11 | CN | H | H | P92 | H | H | H | H |
| Lₐ₁₅₆₂ | P11 | CN | H | H | P93 | H | H | H | H |
| Lₐ₁₅₆₃ | P11 | CN | H | H | P94 | H | H | H | H |
| Lₐ₁₅₆₄ | P11 | CN | H | H | P95 | H | H | H | H |
| Lₐ₁₅₆₅ | P11 | CN | H | H | P98 | H | H | H | H |
| Lₐ₁₅₆₆ | P11 | CN | H | H | P99 | H | H | H | H |
| Lₐ₁₅₆₇ | P11 | CN | H | H | P100 | H | H | H | H |
| Lₐ₁₅₆₈ | P11 | CN | H | H | P101 | H | H | H | H |
| Lₐ₁₅₆₉ | P11 | CN | H | H | P102 | H | H | H | H |
| Lₐ₁₅₇₀ | P11 | CN | H | H | P103 | H | H | H | H |
| Lₐ₁₅₇₁ | P11 | CN | H | H | P104 | H | H | H | H |
| Lₐ₁₅₇₂ | P11 | CN | H | H | P105 | H | H | H | H |
| Lₐ₁₅₇₃ | P11 | CN | H | H | P106 | H | H | H | H |
| Lₐ₁₅₇₄ | P11 | CN | H | H | P107 | H | H | H | H |
| Lₐ₁₅₇₅ | P11 | CN | H | H | P108 | H | H | H | H |
| Lₐ₁₅₇₆ | P11 | CN | H | H | P109 | H | H | H | H |
| Lₐ₁₅₇₇ | P11 | CN | H | H | P110 | H | H | H | H |
| Lₐ₁₅₇₈ | P11 | CN | H | H | P111 | H | H | H | H |
| Lₐ₁₅₇₉ | P11 | CN | H | H | P112 | H | H | H | H |
| Lₐ₁₅₈₀ | P11 | CN | H | H | P113 | H | H | H | H |
| Lₐ₁₅₈₁ | P11 | CN | H | H | P114 | H | H | H | H |
| Lₐ₁₅₈₂ | P11 | CN | H | H | P115 | H | H | H | H |
| Lₐ₁₅₈₃ | P11 | CN | H | H | P116 | H | H | H | H |
| Lₐ₁₅₈₄ | P11 | CN | H | H | P117 | H | H | H | H |
| Lₐ₁₅₈₅ | P11 | CN | H | H | P118 | H | H | H | H |
| Lₐ₁₅₈₆ | P11 | CN | H | H | P119 | H | H | H | H |
| Lₐ₁₅₈₇ | P11 | CN | H | H | P120 | H | H | H | H |
| Lₐ₁₅₈₈ | P11 | CN | H | H | P121 | H | H | H | H |
| Lₐ₁₅₈₉ | P11 | CN | H | H | P122 | H | H | H | H |
| Lₐ₁₅₉₀ | P11 | CN | H | H | P123 | H | H | H | H |
| Lₐ₁₅₉₁ | P11 | CN | H | H | P124 | H | H | H | H |
| Lₐ₁₅₉₂ | P11 | CN | H | H | P125 | H | H | H | H |
| Lₐ₁₅₉₃ | P11 | CN | H | H | P126 | H | H | H | H |
| Lₐ₁₅₉₄ | P11 | CN | H | H | P127 | H | H | H | H |
| Lₐ₁₅₉₅ | P11 | CN | H | H | P128 | H | H | H | H |
| Lₐ₁₅₉₆ | P11 | CN | H | H | P129 | H | H | H | H |
| Lₐ₁₅₉₇ | P11 | CN | H | H | P130 | H | H | H | H |
| Lₐ₁₅₉₈ | P11 | CN | H | H | P131 | H | H | H | H |
| Lₐ₁₅₉₉ | P11 | CN | H | H | P132 | H | H | H | H |
| Lₐ₁₆₀₀ | P11 | CN | H | H | P133 | H | H | H | H |
| Lₐ₁₆₀₁ | P11 | CN | H | H | P134 | H | H | H | H |
| Lₐ₁₆₀₂ | P11 | CN | H | H | P135 | H | H | H | H |
| Lₐ₁₆₀₃ | P11 | CN | H | H | P136 | H | H | H | H |
| Lₐ₁₆₀₄ | P11 | CN | H | H | P137 | H | H | H | H |
| Lₐ₁₆₀₅ | P11 | CN | H | H | P138 | H | H | H | H |
| Lₐ₁₆₀₆ | P11 | CN | H | H | P139 | H | H | H | H |
| Lₐ₁₆₀₇ | P11 | CN | H | H | P140 | H | H | H | H |
| Lₐ₁₆₀₈ | P11 | CN | H | H | P141 | H | H | H | H |
| Lₐ₁₆₀₉ | P11 | CN | H | H | P142 | H | H | H | H |
| Lₐ₁₆₁₀ | P11 | CN | H | H | P143 | H | H | H | H |
| Lₐ₁₆₁₁ | P11 | CN | H | H | P144 | H | H | H | H |
| Lₐ₁₆₁₂ | P11 | CN | H | H | P145 | H | H | H | H |
| Lₐ₁₆₁₃ | P11 | CN | H | H | P146 | H | H | H | H |
| Lₐ₁₆₁₄ | P11 | CN | H | H | P147 | H | H | H | H |
| Lₐ₁₆₁₅ | P11 | CN | H | H | P148 | H | H | H | H |
| Lₐ₁₆₁₆ | P11 | CN | H | H | P149 | H | H | H | H |
| Lₐ₁₆₁₇ | P11 | CN | H | H | P150 | H | H | H | H |
| Lₐ₁₆₁₈ | P11 | CN | H | H | P151 | H | H | H | H |
| Lₐ₁₆₁₉ | P11 | CN | H | P18 | H | H | H | H | H |
| Lₐ₁₆₂₀ | P11 | CN | H | P18 | D | H | H | H | H |
| Lₐ₁₆₂₁ | P11 | CN | H | P18 | P20 | H | H | H | H |
| Lₐ₁₆₂₂ | P11 | CN | H | P19 | H | H | H | H | H |
| Lₐ₁₆₂₃ | P11 | CN | H | P19 | D | H | H | H | H |
| Lₐ₁₆₂₄ | P11 | CN | H | P19 | P20 | H | H | H | H |
| Lₐ₁₆₂₅ | P11 | CN | H | P20 | H | H | H | H | H |
| Lₐ₁₆₂₆ | P11 | CN | H | P20 | D | H | H | H | H |
| Lₐ₁₆₂₇ | P11 | CN | H | P20 | H | H | P1 | H | H |
| Lₐ₁₆₂₈ | P11 | CN | H | P20 | D | H | P2 | H | H |
| Lₐ₁₆₂₉ | P11 | CN | H | P20 | H | H | H | P1 | H |
| Lₐ₁₆₃₀ | P11 | CN | H | P20 | D | H | H | P2 | H |
| Lₐ₁₆₃₁ | P11 | CN | H | P20 | H | H | P1 | P1 | H |
| Lₐ₁₆₃₂ | P11 | CN | H | P20 | D | H | P2 | P2 | H |
| Lₐ₁₆₃₃ | P11 | CN | H | P20 | H | H | P3 | H | H |
| Lₐ₁₆₃₄ | P11 | CN | H | P20 | D | H | P4 | H | H |
| Lₐ₁₆₃₅ | P11 | CN | H | P20 | H | H | P5 | H | H |
| Lₐ₁₆₃₆ | P11 | CN | H | P21 | H | H | H | H | H |
| Lₐ₁₆₃₇ | P11 | CN | H | P21 | D | H | H | H | H |
| Lₐ₁₆₃₈ | P11 | CN | H | P21 | H | H | P1 | H | H |
| Lₐ₁₆₃₉ | P11 | CN | H | P21 | D | H | P2 | H | H |
| Lₐ₁₆₄₀ | P11 | CN | H | P21 | H | H | H | P1 | H |
| Lₐ₁₆₄₁ | P11 | CN | H | P21 | D | H | H | P2 | H |
| Lₐ₁₆₄₂ | P11 | CN | H | P21 | H | H | P1 | P1 | H |
| Lₐ₁₆₄₃ | P11 | CN | H | P21 | D | H | P2 | P2 | H |
| Lₐ₁₆₄₄ | P11 | CN | H | P21 | H | H | P3 | H | H |
| Lₐ₁₆₄₅ | P11 | CN | H | P21 | D | H | P4 | H | H |
| Lₐ₁₆₄₆ | P11 | CN | H | P21 | H | H | P5 | H | H |
| Lₐ₁₆₄₇ | P10 | CN | H | H | H | H | H | H | H |
| Lₐ₁₆₄₈ | P10 | CN | H | H | D | H | H | H | H |
| Lₐ₁₆₄₉ | P10 | CN | H | H | P20 | H | H | H | H |
| Lₐ₁₆₅₀ | P10 | CN | H | H | P21 | H | H | H | H |
| Lₐ₁₆₅₁ | P10 | CN | H | H | P54 | H | H | H | H |
| Lₐ₁₆₅₂ | P10 | CN | H | H | P55 | H | H | H | H |
| Lₐ₁₆₅₃ | P10 | CN | H | H | P56 | H | H | H | H |
| Lₐ₁₆₅₄ | P10 | CN | H | H | P57 | H | H | H | H |
| Lₐ₁₆₅₅ | P10 | CN | H | H | P20 | H | P1 | H | H |
| Lₐ₁₆₅₆ | P10 | CN | H | H | P20 | H | P3 | H | H |
| Lₐ₁₆₅₇ | P10 | CN | H | H | P20 | H | P4 | H | H |
| Lₐ₁₆₅₈ | P10 | CN | H | H | P20 | H | P6 | H | H |
| Lₐ₁₆₅₉ | P10 | CN | H | H | P20 | H | P8 | H | H |
| Lₐ₁₆₆₀ | P10 | CN | H | H | P20 | H | P10 | H | H |
| Lₐ₁₆₆₁ | P10 | CN | H | H | P20 | H | P1 | F | H |
| Lₐ₁₆₆₂ | P10 | CN | H | H | P20 | H | P2 | F | H |
| Lₐ₁₆₆₃ | P10 | CN | H | H | P20 | H | P10 | F | H |
| Lₐ₁₆₆₄ | P10 | CN | H | H | P20 | H | F | P1 | H |
| Lₐ₁₆₆₅ | P10 | CN | H | H | P20 | H | F | P2 | H |
| Lₐ₁₆₆₆ | P10 | CN | H | H | P20 | H | F | P10 | H |
| Lₐ₁₆₆₇ | P10 | CN | H | H | P21 | H | P2 | P2 | H |
| Lₐ₁₆₆₈ | P10 | CN | H | H | P21 | H | P5 | H | H |
| Lₐ₁₆₆₉ | P10 | CN | H | H | P21 | H | P9 | H | H |
| Lₐ₁₆₇₀ | P10 | CN | H | H | P21 | H | P11 | H | H |
| Lₐ₁₆₇₁ | P10 | CN | H | H | P21 | H | P1 | F | H |
| Lₐ₁₆₇₂ | P10 | CN | H | H | P21 | H | P2 | F | H |
| Lₐ₁₆₇₃ | P10 | CN | H | H | P21 | H | P11 | F | H |
| Lₐ₁₆₇₄ | P10 | CN | H | H | P21 | H | F | P1 | H |
| Lₐ₁₆₇₅ | P10 | CN | H | H | P21 | H | F | P2 | H |
| Lₐ₁₆₇₆ | P10 | CN | H | H | P21 | H | F | P11 | H |
| Lₐ₁₆₇₇ | P10 | CN | H | H | P96 | H | H | H | H |
| Lₐ₁₆₇₈ | P10 | CN | H | H | P97 | H | H | H | H |
| Lₐ₁₆₇₉ | P10 | CN | H | H | P102 | H | H | H | H |
| Lₐ₁₆₈₀ | P10 | CN | H | H | P103 | H | H | H | H |
| Lₐ₁₆₈₁ | P7 | CN | H | H | P20 | H | H | H | H |
| Lₐ₁₆₈₂ | P7 | CN | H | H | P21 | H | H | H | H |
| Lₐ₁₆₈₃ | P7 | CN | H | H | P54 | H | H | H | H |
| Lₐ₁₆₈₄ | P7 | CN | H | H | P96 | H | H | H | H |
| Lₐ₁₆₈₅ | P7 | CN | H | H | P97 | H | H | H | H |
| Lₐ₁₆₈₆ | P14 | CN | H | H | P20 | H | H | H | H |
| Lₐ₁₆₈₇ | P14 | CN | H | H | P21 | H | H | H | H |
| Lₐ₁₆₈₈ | P14 | CN | H | H | P54 | H | H | H | H |
| Lₐ₁₆₈₉ | P14 | CN | H | H | P96 | H | H | H | H |
| Lₐ₁₆₉₀ | P14 | CN | H | H | P97 | H | H | H | H |
| Lₐ₁₆₉₁ | P6 | F | H | H | H | H | H | H | H |
| Lₐ₁₆₉₂ | P6 | F | H | H | H | H | P1 | H | H |
| Lₐ₁₆₉₃ | P6 | F | H | H | H | H | P2 | H | H |
| Lₐ₁₆₉₄ | P6 | F | H | H | H | H | P3 | H | H |
| Lₐ₁₆₉₅ | P6 | F | H | H | H | H | P4 | H | H |
| Lₐ₁₆₉₆ | P6 | F | H | H | H | H | P5 | H | H |
| Lₐ₁₆₉₇ | P6 | F | H | H | H | H | P6 | H | H |
| Lₐ₁₆₉₈ | P6 | F | H | H | H | H | P7 | H | H |
| Lₐ₁₆₉₉ | P6 | F | H | H | H | H | P8 | H | H |
| Lₐ₁₇₀₀ | P6 | F | H | H | H | H | P9 | H | H |
| Lₐ₁₇₀₁ | P6 | F | H | H | H | H | P10 | H | H |
| Lₐ₁₇₀₂ | P6 | F | H | H | H | H | P11 | H | H |
| Lₐ₁₇₀₃ | P6 | F | H | H | H | H | P12 | H | H |
| Lₐ₁₇₀₄ | P6 | F | H | H | H | H | P13 | H | H |
| Lₐ₁₇₀₅ | P6 | F | H | H | H | H | P14 | H | H |
| Lₐ₁₇₀₆ | P6 | F | H | H | H | H | P15 | H | H |
| Lₐ₁₇₀₇ | P6 | F | H | H | H | H | P16 | H | H |
| Lₐ₁₇₀₈ | P6 | F | H | H | H | H | P17 | H | H |
| Lₐ₁₇₀₉ | P6 | F | H | H | H | H | P18 | H | H |
| Lₐ₁₇₁₀ | P6 | F | H | H | H | H | P19 | H | H |
| Lₐ₁₇₁₁ | P6 | F | H | H | H | H | P20 | H | H |
| Lₐ₁₇₁₂ | P6 | F | H | H | H | H | P21 | H | H |
| Lₐ₁₇₁₃ | P6 | F | H | H | H | H | P1 | F | H |
| Lₐ₁₇₁₄ | P6 | F | H | H | H | H | P2 | F | H |
| Lₐ₁₇₁₅ | P6 | F | H | H | H | H | P3 | F | H |
| Lₐ₁₇₁₆ | P6 | F | H | H | H | H | P4 | F | H |
| Lₐ₁₇₁₇ | P6 | F | H | H | H | H | P5 | F | H |
| Lₐ₁₇₁₈ | P6 | F | H | H | H | H | P6 | F | H |
| Lₐ₁₇₁₉ | P6 | F | H | H | H | H | P7 | F | H |
| Lₐ₁₇₂₀ | P6 | F | H | H | H | H | P8 | F | H |
| Lₐ₁₇₂₁ | P6 | F | H | H | H | H | P9 | F | H |
| Lₐ₁₇₂₂ | P6 | F | H | H | H | H | P10 | F | H |
| Lₐ₁₇₂₃ | P6 | F | H | H | H | H | P11 | F | H |
| Lₐ₁₇₂₄ | P6 | F | H | H | H | H | P12 | F | H |
| Lₐ₁₇₂₅ | P6 | F | H | H | H | H | P13 | F | H |
| Lₐ₁₇₂₆ | P6 | F | H | H | H | H | P14 | F | H |
| Lₐ₁₇₂₇ | P6 | F | H | H | H | H | P15 | F | H |
| Lₐ₁₇₂₈ | P6 | F | H | H | H | H | P16 | F | H |
| Lₐ₁₇₂₉ | P6 | F | H | H | H | H | P17 | F | H |
| Lₐ₁₇₃₀ | P6 | F | H | H | H | H | P18 | F | H |
| Lₐ₁₇₃₁ | P6 | F | H | H | H | H | P19 | F | H |
| Lₐ₁₇₃₂ | P6 | F | H | H | H | H | P20 | F | H |
| Lₐ₁₇₃₃ | P6 | F | H | H | H | H | P21 | F | H |
| Lₐ₁₇₃₄ | P6 | F | H | H | H | H | H | P1 | H |
| Lₐ₁₇₃₅ | P6 | F | H | H | H | H | H | P2 | H |
| Lₐ₁₇₃₆ | P6 | F | H | H | H | H | H | P3 | H |
| Lₐ₁₇₃₇ | P6 | F | H | H | H | H | H | P4 | H |
| Lₐ₁₇₃₈ | P6 | F | H | H | H | H | H | P5 | H |
| Lₐ₁₇₃₉ | P6 | F | H | H | H | H | H | P6 | H |
| Lₐ₁₇₄₀ | P6 | F | H | H | H | H | H | P7 | H |
| Lₐ₁₇₄₁ | P6 | F | H | H | H | H | H | P8 | H |
| Lₐ₁₇₄₂ | P6 | F | H | H | H | H | H | P9 | H |
| Lₐ₁₇₄₃ | P6 | F | H | H | H | H | H | P10 | H |
| Lₐ₁₇₄₄ | P6 | F | H | H | H | H | H | P11 | H |
| Lₐ₁₇₄₅ | P6 | F | H | H | H | H | H | P12 | H |
| Lₐ₁₇₄₆ | P6 | F | H | H | H | H | H | P13 | H |
| Lₐ₁₇₄₇ | P6 | F | H | H | H | H | H | P14 | H |
| Lₐ₁₇₄₈ | P6 | F | H | H | H | H | H | P15 | H |
| Lₐ₁₇₄₉ | P6 | F | H | H | H | H | H | P16 | H |
| Lₐ₁₇₅₀ | P6 | F | H | H | H | H | H | P17 | H |
| Lₐ₁₇₅₁ | P6 | F | H | H | H | H | H | P18 | H |
| Lₐ₁₇₅₂ | P6 | F | H | H | H | H | H | P19 | H |
| Lₐ₁₇₅₃ | P6 | F | H | H | H | H | H | P20 | H |
| Lₐ₁₇₅₄ | P6 | F | H | H | H | H | H | P21 | H |
| Lₐ₁₇₅₅ | P6 | F | H | H | H | H | F | P1 | H |
| Lₐ₁₇₅₆ | P6 | F | H | H | H | H | F | P2 | H |
| Lₐ₁₇₅₇ | P6 | F | H | H | H | H | F | P3 | H |
| Lₐ₁₇₅₈ | P6 | F | H | H | H | H | F | P4 | H |
| Lₐ₁₇₅₉ | P6 | F | H | H | H | H | F | P5 | H |
| Lₐ₁₇₆₀ | P6 | F | H | H | H | H | F | P6 | H |
| Lₐ₁₇₆₁ | P6 | F | H | H | H | H | F | P7 | H |
| Lₐ₁₇₆₂ | P6 | F | H | H | H | H | F | P8 | H |
| Lₐ₁₇₆₃ | P6 | F | H | H | H | H | F | P9 | H |
| Lₐ₁₇₆₄ | P6 | F | H | H | H | H | F | P10 | H |
| Lₐ₁₇₆₅ | P6 | F | H | H | H | H | F | P11 | H |
| Lₐ₁₇₆₆ | P6 | F | H | H | H | H | F | P12 | H |
| Lₐ₁₇₆₇ | P6 | F | H | H | H | H | F | P13 | H |
| Lₐ₁₇₆₈ | P6 | F | H | H | H | H | F | P14 | H |
| Lₐ₁₇₆₉ | P6 | F | H | H | H | H | F | P15 | H |
| Lₐ₁₇₇₀ | P6 | F | H | H | H | H | F | P16 | H |
| Lₐ₁₇₇₁ | P6 | F | H | H | H | H | F | P17 | H |
| Lₐ₁₇₇₂ | P6 | F | H | H | H | H | F | P18 | H |
| Lₐ₁₇₇₃ | P6 | F | H | H | H | H | F | P19 | H |
| Lₐ₁₇₇₄ | P6 | F | H | H | H | H | F | P20 | H |
| Lₐ₁₇₇₅ | P6 | F | H | H | H | H | F | P21 | H |
| Lₐ₁₇₇₆ | P6 | F | H | H | H | H | P1 | P1 | H |
| Lₐ₁₇₇₇ | P6 | F | H | H | H | H | P1 | P3 | H |
| Lₐ₁₇₇₈ | P6 | F | H | H | H | H | P1 | P8 | H |
| Lₐ₁₇₇₉ | P6 | F | H | H | H | H | P1 | P10 | H |
| Lₐ₁₇₈₀ | P6 | F | H | H | H | H | P1 | P20 | H |
| Lₐ₁₇₈₁ | P6 | F | H | H | H | H | P1 | P21 | H |
| Lₐ₁₇₈₂ | P6 | F | H | H | H | H | P2 | P2 | H |
| Lₐ₁₇₈₃ | P6 | F | H | H | H | H | P2 | P4 | H |
| Lₐ₁₇₈₄ | P6 | F | H | H | H | H | P2 | P5 | H |
| Lₐ₁₇₈₅ | P6 | F | H | H | H | H | P2 | P9 | H |
| Lₐ₁₇₈₆ | P6 | F | H | H | H | H | P2 | P11 | H |
| Lₐ₁₇₈₇ | P6 | F | H | H | H | H | P2 | P20 | H |
| Lₐ₁₇₈₈ | P6 | F | H | H | H | H | P2 | P21 | H |
| Lₐ₁₇₈₉ | P6 | F | H | H | H | D | D | D | D |
| Lₐ₁₇₉₀ | P6 | F | H | H | H | D | F | D | D |
| Lₐ₁₇₉₁ | P6 | F | H | H | H | D | D | F | D |
| Lₐ₁₇₉₂ | P6 | F | H | H | H | D | P2 | D | D |
| Lₐ₁₇₉₃ | P6 | F | H | H | H | D | D | P2 | D |
| Lₐ₁₇₉₄ | P6 | F | H | H | H | D | P2 | P2 | D |
| Lₐ₁₇₉₅ | P6 | F | H | H | D | H | H | H | H |
| Lₐ₁₇₉₆ | P6 | F | H | H | D | H | P1 | H | H |
| Lₐ₁₇₉₇ | P6 | F | H | H | D | H | P2 | H | H |
| Lₐ₁₇₉₈ | P6 | F | H | H | D | H | P5 | H | H |
| Lₐ₁₇₉₉ | P6 | F | H | H | D | H | P10 | H | H |
| Lₐ₁₈₀₀ | P6 | F | H | H | D | H | P11 | H | H |
| Lₐ₁₈₀₁ | P6 | F | H | H | D | H | H | P1 | H |
| Lₐ₁₈₀₂ | P6 | F | H | H | D | H | H | P2 | H |
| Lₐ₁₈₀₃ | P6 | F | H | H | D | H | H | P4 | H |
| Lₐ₁₈₀₄ | P6 | F | H | H | D | H | H | P5 | H |
| Lₐ₁₈₀₅ | P6 | F | H | H | D | H | H | P10 | H |
| Lₐ₁₈₀₆ | P6 | F | H | H | D | H | H | P11 | H |
| Lₐ₁₈₀₇ | P6 | F | H | H | D | H | P1 | F | H |
| Lₐ₁₈₀₈ | P6 | F | H | H | D | H | P2 | F | H |
| Lₐ₁₈₀₉ | P6 | F | H | H | D | H | P11 | F | H |
| Lₐ₁₈₁₀ | P6 | F | H | H | D | H | F | P1 | H |
| Lₐ₁₈₁₁ | P6 | F | H | H | D | H | F | P2 | H |
| Lₐ₁₈₁₂ | P6 | F | H | H | D | H | F | P3 | H |
| Lₐ₁₈₁₃ | P6 | F | H | H | D | H | F | P4 | H |
| Lₐ₁₈₁₄ | P6 | F | H | H | D | H | F | P5 | H |
| Lₐ₁₈₁₅ | P6 | F | H | H | D | H | F | P8 | H |
| Lₐ₁₈₁₆ | P6 | F | H | H | D | H | F | P11 | H |
| Lₐ₁₈₁₇ | P6 | F | H | H | D | H | P1 | P1 | H |
| Lₐ₁₈₁₈ | P6 | F | H | H | D | H | P2 | P2 | H |
| Lₐ₁₈₁₉ | P6 | F | H | H | D | H | P2 | P2 | D |
| Lₐ₁₈₂₀ | P6 | F | H | H | P20 | H | H | H | H |
| Lₐ₁₈₂₁ | P6 | F | H | H | P20 | H | P1 | H | H |
| Lₐ₁₈₂₂ | P6 | F | H | H | P20 | H | P2 | H | H |
| Lₐ₁₈₂₃ | P6 | F | H | H | P20 | H | P3 | H | H |
| Lₐ₁₈₂₄ | P6 | F | H | H | P20 | H | P4 | H | H |
| Lₐ₁₈₂₅ | P6 | F | H | H | P20 | H | P5 | H | H |
| Lₐ₁₈₂₆ | P6 | F | H | H | P20 | H | P6 | H | H |
| Lₐ₁₈₂₇ | P6 | F | H | H | P20 | H | P7 | H | H |
| Lₐ₁₈₂₈ | P6 | F | H | H | P20 | H | P8 | H | H |
| Lₐ₁₈₂₉ | P6 | F | H | H | P20 | H | P9 | H | H |
| Lₐ₁₈₃₀ | P6 | F | H | H | P20 | H | P10 | H | H |
| Lₐ₁₈₃₁ | P6 | F | H | H | P20 | H | P11 | H | H |
| Lₐ₁₈₃₂ | P6 | F | H | H | P20 | H | P12 | H | H |
| Lₐ₁₈₃₃ | P6 | F | H | H | P20 | H | P13 | H | H |
| Lₐ₁₈₃₄ | P6 | F | H | H | P20 | H | P14 | H | H |
| Lₐ₁₈₃₅ | P6 | F | H | H | P20 | H | P15 | H | H |
| Lₐ₁₈₃₆ | P6 | F | H | H | P20 | H | P16 | H | H |
| Lₐ₁₈₃₇ | P6 | F | H | H | P20 | H | P17 | H | H |
| Lₐ₁₈₃₈ | P6 | F | H | H | P20 | H | P18 | H | H |
| Lₐ₁₈₃₉ | P6 | F | H | H | P20 | H | P19 | H | H |
| Lₐ₁₈₄₀ | P6 | F | H | H | P20 | H | P20 | H | H |
| Lₐ₁₈₄₁ | P6 | F | H | H | P20 | H | P21 | H | H |
| Lₐ₁₈₄₂ | P6 | F | H | H | P20 | H | H | P1 | H |
| Lₐ₁₈₄₃ | P6 | F | H | H | P20 | H | H | P2 | H |
| Lₐ₁₈₄₄ | P6 | F | H | H | P20 | H | H | P3 | H |
| Lₐ₁₈₄₅ | P6 | F | H | H | P20 | H | H | P4 | H |
| Lₐ₁₈₄₆ | P6 | F | H | H | P20 | H | H | P5 | H |
| Lₐ₁₈₄₇ | P6 | F | H | H | P20 | H | H | P6 | H |
| Lₐ₁₈₄₈ | P6 | F | H | H | P20 | H | H | P7 | H |
| Lₐ₁₈₄₉ | P6 | F | H | H | P20 | H | H | P8 | H |
| Lₐ₁₈₅₀ | P6 | F | H | H | P20 | H | H | P9 | H |
| Lₐ₁₈₅₁ | P6 | F | H | H | P20 | H | H | P10 | H |
| Lₐ₁₈₅₂ | P6 | F | H | H | P20 | H | H | P11 | H |
| Lₐ₁₈₅₃ | P6 | F | H | H | P20 | H | H | P12 | H |
| Lₐ₁₈₅₄ | P6 | F | H | H | P20 | H | H | P15 | H |
| Lₐ₁₈₅₅ | P6 | F | H | H | P20 | H | H | P17 | H |
| Lₐ₁₈₅₆ | P6 | F | H | H | P20 | H | H | P18 | H |
| Lₐ₁₈₅₇ | P6 | F | H | H | P20 | H | H | P19 | H |
| Lₐ₁₈₅₈ | P6 | F | H | H | P20 | H | H | P20 | H |
| Lₐ₁₈₅₉ | P6 | F | H | H | P20 | H | H | P21 | H |
| Lₐ₁₈₆₀ | P6 | F | H | H | P20 | H | F | H | H |
| Lₐ₁₈₆₁ | P6 | F | H | H | P20 | H | F | P1 | H |
| Lₐ₁₈₆₂ | P6 | F | H | H | P20 | H | F | P2 | H |
| Lₐ₁₈₆₃ | P6 | F | H | H | P20 | H | F | P3 | H |
| Lₐ₁₈₆₄ | P6 | F | H | H | P20 | H | F | P4 | H |
| Lₐ₁₈₆₅ | P6 | F | H | H | P20 | H | F | P5 | H |
| Lₐ₁₈₆₆ | P6 | F | H | H | P20 | H | F | P6 | H |
| Lₐ₁₈₆₇ | P6 | F | H | H | P20 | H | F | P7 | H |
| Lₐ₁₈₆₈ | P6 | F | H | H | P20 | H | F | P8 | H |
| Lₐ₁₈₆₉ | P6 | F | H | H | P20 | H | F | P9 | H |
| Lₐ₁₈₇₀ | P6 | F | H | H | P20 | H | F | P10 | H |
| Lₐ₁₈₇₁ | P6 | F | H | H | P20 | H | F | P11 | H |
| Lₐ₁₈₇₂ | P6 | F | H | H | P20 | H | P1 | F | H |
| Lₐ₁₈₇₃ | P6 | F | H | H | P20 | H | P2 | F | H |
| Lₐ₁₈₇₄ | P6 | F | H | H | P20 | H | P3 | F | H |
| Lₐ₁₈₇₅ | P6 | F | H | H | P20 | H | P4 | F | H |
| Lₐ₁₈₇₆ | P6 | F | H | H | P20 | H | P5 | F | H |
| Lₐ₁₈₇₇ | P6 | F | H | H | P20 | H | P6 | F | H |
| Lₐ₁₈₇₈ | P6 | F | H | H | P20 | H | P7 | F | H |
| Lₐ₁₈₇₉ | P6 | F | H | H | P20 | H | P8 | F | H |
| Lₐ₁₈₈₀ | P6 | F | H | H | P20 | H | P9 | F | H |
| Lₐ₁₈₈₁ | P6 | F | H | H | P20 | H | P10 | F | H |
| Lₐ₁₈₈₂ | P6 | F | H | H | P20 | H | P11 | F | H |
| Lₐ₁₈₈₃ | P6 | F | H | H | P20 | H | P1 | P1 | H |
| Lₐ₁₈₈₄ | P6 | F | H | H | P20 | H | P2 | P2 | H |
| Lₐ₁₈₈₅ | P6 | F | H | H | P20 | D | D | D | D |
| Lₐ₁₈₈₆ | P6 | F | H | H | P20 | D | P2 | P2 | D |
| Lₐ₁₈₈₇ | P6 | F | H | H | P20 | D | F | P4 | D |
| Lₐ₁₈₈₈ | P6 | F | H | H | P20 | D | F | P5 | D |
| Lₐ₁₈₈₉ | P6 | F | H | H | P20 | D | F | P9 | D |
| Lₐ₁₈₉₀ | P6 | F | H | H | P20 | D | F | P11 | D |
| Lₐ₁₈₉₁ | P6 | F | H | H | P21 | H | H | H | H |
| Lₐ₁₈₉₂ | P6 | F | H | H | P21 | H | P1 | H | H |
| Lₐ₁₈₉₃ | P6 | F | H | H | P21 | H | P2 | H | H |
| Lₐ₁₈₉₄ | P6 | F | H | H | P21 | H | P3 | H | H |
| Lₐ₁₈₉₅ | P6 | F | H | H | P21 | H | P4 | H | H |
| Lₐ₁₈₉₆ | P6 | F | H | H | P21 | H | P5 | H | H |
| Lₐ₁₈₉₇ | P6 | F | H | H | P21 | H | P6 | H | H |
| Lₐ₁₈₉₈ | P6 | F | H | H | P21 | H | P7 | H | H |
| Lₐ₁₈₉₉ | P6 | F | H | H | P21 | H | P8 | H | H |
| Lₐ₁₉₀₀ | P6 | F | H | H | P21 | H | P9 | H | H |
| Lₐ₁₉₀₁ | P6 | F | H | H | P21 | H | P10 | H | H |
| Lₐ₁₉₀₂ | P6 | F | H | H | P21 | H | P11 | H | H |
| Lₐ₁₉₀₃ | P6 | F | H | H | P21 | H | P12 | H | H |
| Lₐ₁₉₀₄ | P6 | F | H | H | P21 | H | P13 | H | H |
| Lₐ₁₉₀₅ | P6 | F | H | H | P21 | H | P14 | H | H |
| Lₐ₁₉₀₆ | P6 | F | H | H | P21 | H | P15 | H | H |
| Lₐ₁₉₀₇ | P6 | F | H | H | P21 | H | P16 | H | H |
| Lₐ₁₉₀₈ | P6 | F | H | H | P21 | H | P17 | H | H |
| Lₐ₁₉₀₉ | P6 | F | H | H | P21 | H | P18 | H | H |
| Lₐ₁₉₁₀ | P6 | F | H | H | P21 | H | P19 | H | H |
| Lₐ₁₉₁₁ | P6 | F | H | H | P21 | H | P20 | H | H |
| Lₐ₁₉₁₂ | P6 | F | H | H | P21 | H | P21 | H | H |
| Lₐ₁₉₁₃ | P6 | F | H | H | P21 | H | H | P1 | H |
| Lₐ₁₉₁₄ | P6 | F | H | H | P21 | H | H | P2 | H |
| Lₐ₁₉₁₅ | P6 | F | H | H | P21 | H | H | P3 | H |
| Lₐ₁₉₁₆ | P6 | F | H | H | P21 | H | H | P4 | H |
| Lₐ₁₉₁₇ | P6 | F | H | H | P21 | H | H | P5 | H |
| Lₐ₁₉₁₈ | P6 | F | H | H | P21 | H | H | P6 | H |
| Lₐ₁₉₁₉ | P6 | F | H | H | P21 | H | H | P7 | H |
| Lₐ₁₉₂₀ | P6 | F | H | H | P21 | H | H | P8 | H |
| Lₐ₁₉₂₁ | P6 | F | H | H | P21 | H | H | P9 | H |
| Lₐ₁₉₂₂ | P6 | F | H | H | P21 | H | H | P10 | H |
| Lₐ₁₉₂₃ | P6 | F | H | H | P21 | H | H | P11 | H |
| Lₐ₁₉₂₄ | P6 | F | H | H | P21 | H | H | P12 | H |
| Lₐ₁₉₂₅ | P6 | F | H | H | P21 | H | H | P15 | H |
| Lₐ₁₉₂₆ | P6 | F | H | H | P21 | H | H | P17 | H |
| Lₐ₁₉₂₇ | P6 | F | H | H | P21 | H | H | P18 | H |
| Lₐ₁₉₂₈ | P6 | F | H | H | P21 | H | H | P19 | H |
| Lₐ₁₉₂₉ | P6 | F | H | H | P21 | H | H | P20 | H |
| Lₐ₁₉₃₀ | P6 | F | H | H | P21 | H | H | P21 | H |
| Lₐ₁₉₃₁ | P6 | F | H | H | P21 | H | F | H | H |
| Lₐ₁₉₃₂ | P6 | F | H | H | P21 | H | F | P1 | H |
| Lₐ₁₉₃₃ | P6 | F | H | H | P21 | H | F | P2 | H |
| Lₐ₁₉₃₄ | P6 | F | H | H | P21 | H | F | P3 | H |
| Lₐ₁₉₃₅ | P6 | F | H | H | P21 | H | F | P4 | H |
| Lₐ₁₉₃₆ | P6 | F | H | H | P21 | H | F | P5 | H |
| Lₐ₁₉₃₇ | P6 | F | H | H | P21 | H | F | P6 | H |
| Lₐ₁₉₃₈ | P6 | F | H | H | P21 | H | F | P7 | H |
| Lₐ₁₉₃₉ | P6 | F | H | H | P21 | H | F | P8 | H |
| Lₐ₁₉₄₀ | P6 | F | H | H | P21 | H | F | P9 | H |
| Lₐ₁₉₄₁ | P6 | F | H | H | P21 | H | F | P10 | H |
| Lₐ₁₉₄₂ | P6 | F | H | H | P21 | H | F | P11 | H |
| Lₐ₁₉₄₃ | P6 | F | H | H | P21 | H | P1 | F | H |
| Lₐ₁₉₄₄ | P6 | F | H | H | P21 | H | P2 | F | H |
| Lₐ₁₉₄₅ | P6 | F | H | H | P21 | H | P3 | F | H |
| Lₐ₁₉₄₆ | P6 | F | H | H | P21 | H | P4 | F | H |
| Lₐ₁₉₄₇ | P6 | F | H | H | P21 | H | P5 | F | H |
| Lₐ₁₉₄₈ | P6 | F | H | H | P21 | H | P6 | F | H |
| Lₐ₁₉₄₉ | P6 | F | H | H | P21 | H | P7 | F | H |
| Lₐ₁₉₅₀ | P6 | F | H | H | P21 | H | P8 | F | H |
| Lₐ₁₉₅₁ | P6 | F | H | H | P21 | H | P9 | F | H |
| Lₐ₁₉₅₂ | P6 | F | H | H | P21 | H | P10 | F | H |
| Lₐ₁₉₅₃ | P6 | F | H | H | P21 | H | P11 | F | H |
| Lₐ₁₉₅₄ | P6 | F | H | H | P21 | H | P1 | P1 | H |
| Lₐ₁₉₅₅ | P6 | F | H | H | P21 | H | P2 | P2 | H |
| Lₐ₁₉₅₆ | P6 | F | H | H | P21 | D | D | D | D |
| Lₐ₁₉₅₇ | P6 | F | H | H | P21 | D | P2 | P2 | D |
| Lₐ₁₉₅₈ | P6 | F | H | H | P21 | D | F | P4 | D |
| Lₐ₁₉₅₉ | P6 | F | H | H | P21 | D | F | P5 | D |
| Lₐ₁₉₆₀ | P6 | F | H | H | P21 | D | F | P9 | D |
| Lₐ₁₉₆₁ | P6 | F | H | H | P21 | D | F | P11 | D |
| Lₐ₁₉₆₂ | P6 | F | H | H | P54 | H | H | H | H |
| Lₐ₁₉₆₃ | P6 | F | H | H | P54 | H | P1 | H | H |
| Lₐ₁₉₆₄ | P6 | F | H | H | P54 | H | P2 | H | H |
| Lₐ₁₉₆₅ | P6 | F | H | H | P54 | H | P3 | H | H |
| Lₐ₁₉₆₆ | P6 | F | H | H | P54 | H | P4 | H | H |
| Lₐ₁₉₆₇ | P6 | F | H | H | P54 | H | P5 | H | H |
| Lₐ₁₉₆₈ | P6 | F | H | H | P54 | H | P6 | H | H |
| Lₐ₁₉₆₉ | P6 | F | H | H | P54 | H | P7 | H | H |
| Lₐ₁₉₇₀ | P6 | F | H | H | P54 | H | P8 | H | H |
| Lₐ₁₉₇₁ | P6 | F | H | H | P54 | H | P9 | H | H |
| Lₐ₁₉₇₂ | P6 | F | H | H | P54 | H | P10 | H | H |
| Lₐ₁₉₇₃ | P6 | F | H | H | P54 | H | P11 | H | H |
| Lₐ₁₉₇₄ | P6 | F | H | H | P54 | H | P12 | H | H |
| Lₐ₁₉₇₅ | P6 | F | H | H | P54 | H | P13 | H | H |
| Lₐ₁₉₇₆ | P6 | F | H | H | P54 | H | P14 | H | H |
| Lₐ₁₉₇₇ | P6 | F | H | H | P54 | H | P15 | H | H |
| Lₐ₁₉₇₈ | P6 | F | H | H | P54 | H | P16 | H | H |
| Lₐ₁₉₇₉ | P6 | F | H | H | P54 | H | P17 | H | H |
| Lₐ₁₉₈₀ | P6 | F | H | H | P54 | H | P18 | H | H |
| Lₐ₁₉₈₁ | P6 | F | H | H | P54 | H | P19 | H | H |
| Lₐ₁₉₈₂ | P6 | F | H | H | P54 | H | P20 | H | H |
| Lₐ₁₉₈₃ | P6 | F | H | H | P54 | H | P21 | H | H |
| Lₐ₁₉₈₄ | P6 | F | H | H | P54 | H | H | P1 | H |
| Lₐ₁₉₈₅ | P6 | F | H | H | P54 | H | H | P2 | H |
| Lₐ₁₉₈₆ | P6 | F | H | H | P54 | H | H | P3 | H |
| Lₐ₁₉₈₇ | P6 | F | H | H | P54 | H | H | P4 | H |
| Lₐ₁₉₈₈ | P6 | F | H | H | P54 | H | H | P5 | H |
| Lₐ₁₉₈₉ | P6 | F | H | H | P54 | H | H | P6 | H |
| Lₐ₁₉₉₀ | P6 | F | H | H | P54 | H | H | P7 | H |
| Lₐ₁₉₉₁ | P6 | F | H | H | P54 | H | H | P8 | H |
| Lₐ₁₉₉₂ | P6 | F | H | H | P54 | H | H | P9 | H |
| Lₐ₁₉₉₃ | P6 | F | H | H | P54 | H | H | P10 | H |
| Lₐ₁₉₉₄ | P6 | F | H | H | P54 | H | H | P11 | H |
| Lₐ₁₉₉₅ | P6 | F | H | H | P54 | H | H | P12 | H |
| Lₐ₁₉₉₆ | P6 | F | H | H | P54 | H | H | P15 | H |
| Lₐ₁₉₉₇ | P6 | F | H | H | P54 | H | H | P17 | H |
| Lₐ₁₉₉₈ | P6 | F | H | H | P54 | H | H | P18 | H |
| Lₐ₁₉₉₉ | P6 | F | H | H | P54 | H | H | P19 | H |
| Lₐ₂₀₀₀ | P6 | F | H | H | P54 | H | H | P20 | H |
| Lₐ₂₀₀₁ | P6 | F | H | H | P54 | H | H | P21 | H |
| Lₐ₂₀₀₂ | P6 | F | H | H | P54 | H | F | H | H |
| Lₐ₂₀₀₃ | P6 | F | H | H | P54 | H | F | P1 | H |
| Lₐ₂₀₀₄ | P6 | F | H | H | P54 | H | F | P2 | H |
| Lₐ₂₀₀₅ | P6 | F | H | H | P54 | H | F | P3 | H |
| Lₐ₂₀₀₆ | P6 | F | H | H | P54 | H | F | P4 | H |
| Lₐ₂₀₀₇ | P6 | F | H | H | P54 | H | F | P5 | H |
| Lₐ₂₀₀₈ | P6 | F | H | H | P54 | H | F | P6 | H |
| Lₐ₂₀₀₉ | P6 | F | H | H | P54 | H | F | P7 | H |
| Lₐ₂₀₁₀ | P6 | F | H | H | P54 | H | F | P8 | H |
| Lₐ₂₀₁₁ | P6 | F | H | H | P54 | H | F | P9 | H |
| Lₐ₂₀₁₂ | P6 | F | H | H | P54 | H | F | P10 | H |
| Lₐ₂₀₁₃ | P6 | F | H | H | P54 | H | F | P11 | H |
| Lₐ₂₀₁₄ | P6 | F | H | H | P54 | H | P1 | F | H |
| Lₐ₂₀₁₅ | P6 | F | H | H | P54 | H | P2 | F | H |
| Lₐ₂₀₁₆ | P6 | F | H | H | P54 | H | P3 | F | H |
| Lₐ₂₀₁₇ | P6 | F | H | H | P54 | H | P4 | F | H |
| Lₐ₂₀₁₈ | P6 | F | H | H | P54 | H | P5 | F | H |
| Lₐ₂₀₁₉ | P6 | F | H | H | P54 | H | P6 | F | H |
| Lₐ₂₀₂₀ | P6 | F | H | H | P54 | H | P7 | F | H |
| Lₐ₂₀₂₁ | P6 | F | H | H | P54 | H | P8 | F | H |
| Lₐ₂₀₂₂ | P6 | F | H | H | P54 | H | P9 | F | H |
| Lₐ₂₀₂₃ | P6 | F | H | H | P54 | H | P10 | F | H |
| Lₐ₂₀₂₄ | P6 | F | H | H | P54 | H | P11 | F | H |
| Lₐ₂₀₂₅ | P6 | F | H | H | P54 | H | P1 | P1 | H |
| Lₐ₂₀₂₆ | P6 | F | H | H | P54 | H | P2 | P2 | H |
| Lₐ₂₀₂₇ | P6 | F | H | H | P54 | D | D | D | D |
| Lₐ₂₀₂₈ | P6 | F | H | H | P54 | D | P2 | P2 | D |
| Lₐ₂₀₂₉ | P6 | F | H | H | P54 | D | F | P4 | D |
| Lₐ₂₀₃₀ | P6 | F | H | H | P54 | D | F | P5 | D |
| Lₐ₂₀₃₁ | P6 | F | H | H | P54 | D | F | P9 | D |
| Lₐ₂₀₃₂ | P6 | F | H | H | P54 | D | F | P11 | D |
| Lₐ₂₀₃₃ | P6 | F | H | H | P96 | H | H | H | H |
| Lₐ₂₀₃₄ | P6 | F | H | H | P96 | H | P1 | H | H |
| Lₐ₂₀₃₅ | P6 | F | H | H | P96 | H | P2 | H | H |
| Lₐ₂₀₃₆ | P6 | F | H | H | P96 | H | P3 | H | H |
| Lₐ₂₀₃₇ | P6 | F | H | H | P96 | H | P4 | H | H |
| Lₐ₂₀₃₈ | P6 | F | H | H | P96 | H | P5 | H | H |
| Lₐ₂₀₃₉ | P6 | F | H | H | P96 | H | P6 | H | H |
| Lₐ₂₀₄₀ | P6 | F | H | H | P96 | H | P7 | H | H |
| Lₐ₂₀₄₁ | P6 | F | H | H | P96 | H | P8 | H | H |
| Lₐ₂₀₄₂ | P6 | F | H | H | P96 | H | P9 | H | H |
| Lₐ₂₀₄₃ | P6 | F | H | H | P96 | H | P10 | H | H |
| Lₐ₂₀₄₄ | P6 | F | H | H | P96 | H | P11 | H | H |
| Lₐ₂₀₄₅ | P6 | F | H | H | P96 | H | P12 | H | H |
| Lₐ₂₀₄₆ | P6 | F | H | H | P96 | H | P13 | H | H |
| Lₐ₂₀₄₇ | P6 | F | H | H | P96 | H | P14 | H | H |
| Lₐ₂₀₄₈ | P6 | F | H | H | P96 | H | P15 | H | H |
| Lₐ₂₀₄₉ | P6 | F | H | H | P96 | H | P16 | H | H |
| Lₐ₂₀₅₀ | P6 | F | H | H | P96 | H | P17 | H | H |
| Lₐ₂₀₅₁ | P6 | F | H | H | P96 | H | P18 | H | H |
| Lₐ₂₀₅₂ | P6 | F | H | H | P96 | H | P19 | H | H |
| Lₐ₂₀₅₃ | P6 | F | H | H | P96 | H | P20 | H | H |
| Lₐ₂₀₅₄ | P6 | F | H | H | P96 | H | P21 | H | H |
| Lₐ₂₀₅₅ | P6 | F | H | H | P96 | H | H | P1 | H |
| Lₐ₂₀₅₆ | P6 | F | H | H | P96 | H | H | P2 | H |
| Lₐ₂₀₅₇ | P6 | F | H | H | P96 | H | H | P3 | H |
| Lₐ₂₀₅₈ | P6 | F | H | H | P96 | H | H | P4 | H |
| Lₐ₂₀₅₉ | P6 | F | H | H | P96 | H | H | P5 | H |
| Lₐ₂₀₆₀ | P6 | F | H | H | P96 | H | H | P6 | H |
| Lₐ₂₀₆₁ | P6 | F | H | H | P96 | H | H | P7 | H |
| Lₐ₂₀₆₂ | P6 | F | H | H | P96 | H | H | P8 | H |
| Lₐ₂₀₆₃ | P6 | F | H | H | P96 | H | H | P9 | H |
| Lₐ₂₀₆₄ | P6 | F | H | H | P96 | H | H | P10 | H |
| Lₐ₂₀₆₅ | P6 | F | H | H | P96 | H | H | P11 | H |
| Lₐ₂₀₆₆ | P6 | F | H | H | P96 | H | H | P12 | H |
| Lₐ₂₀₆₇ | P6 | F | H | H | P96 | H | H | P15 | H |
| Lₐ₂₀₆₈ | P6 | F | H | H | P96 | H | H | P17 | H |
| Lₐ₂₀₆₉ | P6 | F | H | H | P96 | H | H | P18 | H |
| Lₐ₂₀₇₀ | P6 | F | H | H | P96 | H | H | P19 | H |
| Lₐ₂₀₇₁ | P6 | F | H | H | P96 | H | H | P20 | H |
| Lₐ₂₀₇₂ | P6 | F | H | H | P96 | H | H | P21 | H |
| Lₐ₂₀₇₃ | P6 | F | H | H | P96 | H | F | H | H |
| Lₐ₂₀₇₄ | P6 | F | H | H | P96 | H | F | P1 | H |
| Lₐ₂₀₇₅ | P6 | F | H | H | P96 | H | F | P2 | H |
| Lₐ₂₀₇₆ | P6 | F | H | H | P96 | H | F | P3 | H |
| Lₐ₂₀₇₇ | P6 | F | H | H | P96 | H | F | P4 | H |
| Lₐ₂₀₇₈ | P6 | F | H | H | P96 | H | F | P5 | H |
| Lₐ₂₀₇₉ | P6 | F | H | H | P96 | H | F | P6 | H |
| Lₐ₂₀₈₀ | P6 | F | H | H | P96 | H | F | P7 | H |
| Lₐ₂₀₈₁ | P6 | F | H | H | P96 | H | F | P8 | H |
| Lₐ₂₀₈₂ | P6 | F | H | H | P96 | H | F | P9 | H |
| Lₐ₂₀₈₃ | P6 | F | H | H | P96 | H | F | P10 | H |
| Lₐ₂₀₈₄ | P6 | F | H | H | P96 | H | F | P11 | H |
| Lₐ₂₀₈₅ | P6 | F | H | H | P96 | H | P1 | F | H |
| Lₐ₂₀₈₆ | P6 | F | H | H | P96 | H | P2 | F | H |
| Lₐ₂₀₈₇ | P6 | F | H | H | P96 | H | P3 | F | H |
| Lₐ₂₀₈₈ | P6 | F | H | H | P96 | H | P4 | F | H |
| Lₐ₂₀₈₉ | P6 | F | H | H | P96 | H | P5 | F | H |
| Lₐ₂₀₉₀ | P6 | F | H | H | P96 | H | P6 | F | H |
| Lₐ₂₀₉₁ | P6 | F | H | H | P96 | H | P7 | F | H |
| Lₐ₂₀₉₂ | P6 | F | H | H | P96 | H | P8 | F | H |
| Lₐ₂₀₉₃ | P6 | F | H | H | P96 | H | P9 | F | H |
| Lₐ₂₀₉₄ | P6 | F | H | H | P96 | H | P10 | F | H |
| Lₐ₂₀₉₅ | P6 | F | H | H | P96 | H | P11 | F | H |
| Lₐ₂₀₉₆ | P6 | F | H | H | P96 | H | P1 | P1 | H |
| Lₐ₂₀₉₇ | P6 | F | H | H | P96 | H | P2 | P2 | H |
| Lₐ₂₀₉₈ | P6 | F | H | H | P96 | D | D | D | D |
| Lₐ₂₀₉₉ | P6 | F | H | H | P96 | D | P2 | P2 | D |
| Lₐ₂₁₀₀ | P6 | F | H | H | P96 | D | F | P4 | D |
| Lₐ₂₁₀₁ | P6 | F | H | H | P96 | D | F | P5 | D |
| Lₐ₂₁₀₂ | P6 | F | H | H | P96 | D | F | P9 | D |
| Lₐ₂₁₀₃ | P6 | F | H | H | P96 | D | F | P11 | D |
| Lₐ₂₁₀₄ | P6 | F | H | H | P97 | H | H | H | H |
| Lₐ₂₁₀₅ | P6 | F | H | H | P97 | H | P1 | H | H |
| Lₐ₂₁₀₆ | P6 | F | H | H | P97 | H | P2 | H | H |
| Lₐ₂₁₀₇ | P6 | F | H | H | P97 | H | P3 | H | H |
| Lₐ₂₁₀₈ | P6 | F | H | H | P97 | H | P4 | H | H |
| Lₐ₂₁₀₉ | P6 | F | H | H | P97 | H | P5 | H | H |
| Lₐ₂₁₁₀ | P6 | F | H | H | P97 | H | P6 | H | H |
| Lₐ₂₁₁₁ | P6 | F | H | H | P97 | H | P7 | H | H |
| Lₐ₂₁₁₂ | P6 | F | H | H | P97 | H | P8 | H | H |
| Lₐ₂₁₁₃ | P6 | F | H | H | P97 | H | P9 | H | H |
| Lₐ₂₁₁₄ | P6 | F | H | H | P97 | H | P10 | H | H |
| Lₐ₂₁₁₅ | P6 | F | H | H | P97 | H | P11 | H | H |
| Lₐ₂₁₁₆ | P6 | F | H | H | P97 | H | P12 | H | H |
| Lₐ₂₁₁₇ | P6 | F | H | H | P97 | H | P13 | H | H |
| Lₐ₂₁₁₈ | P6 | F | H | H | P97 | H | P14 | H | H |
| Lₐ₂₁₁₉ | P6 | F | H | H | P97 | H | P15 | H | H |
| Lₐ₂₁₂₀ | P6 | F | H | H | P97 | H | P16 | H | H |
| Lₐ₂₁₂₁ | P6 | F | H | H | P97 | H | P17 | H | H |
| Lₐ₂₁₂₂ | P6 | F | H | H | P97 | H | P18 | H | H |
| Lₐ₂₁₂₃ | P6 | F | H | H | P97 | H | P19 | H | H |
| Lₐ₂₁₂₄ | P6 | F | H | H | P97 | H | P20 | H | H |
| Lₐ₂₁₂₅ | P6 | F | H | H | P97 | H | P21 | H | H |
| Lₐ₂₁₂₆ | P6 | F | H | H | P97 | H | H | P1 | H |
| Lₐ₂₁₂₇ | P6 | F | H | H | P97 | H | H | P2 | H |
| Lₐ₂₁₂₈ | P6 | F | H | H | P97 | H | H | P3 | H |
| Lₐ₂₁₂₉ | P6 | F | H | H | P97 | H | H | P4 | H |
| Lₐ₂₁₃₀ | P6 | F | H | H | P97 | H | H | P5 | H |
| Lₐ₂₁₃₁ | P6 | F | H | H | P97 | H | H | P6 | H |
| Lₐ₂₁₃₂ | P6 | F | H | H | P97 | H | H | P7 | H |
| Lₐ₂₁₃₃ | P6 | F | H | H | P97 | H | H | P8 | H |
| Lₐ₂₁₃₄ | P6 | F | H | H | P97 | H | H | P9 | H |
| Lₐ₂₁₃₅ | P6 | F | H | H | P97 | H | H | P10 | H |
| Lₐ₂₁₃₆ | P6 | F | H | H | P97 | H | H | P11 | H |
| Lₐ₂₁₃₇ | P6 | F | H | H | P97 | H | H | P12 | H |
| Lₐ₂₁₃₈ | P6 | F | H | H | P97 | H | H | P15 | H |
| Lₐ₂₁₃₉ | P6 | F | H | H | P97 | H | H | P17 | H |
| Lₐ₂₁₄₀ | P6 | F | H | H | P97 | H | H | P18 | H |
| Lₐ₂₁₄₁ | P6 | F | H | H | P97 | H | H | P19 | H |
| Lₐ₂₁₄₂ | P6 | F | H | H | P97 | H | H | P20 | H |
| Lₐ₂₁₄₃ | P6 | F | H | H | P97 | H | H | P21 | H |
| Lₐ₂₁₄₄ | P6 | F | H | H | P97 | H | F | H | H |
| Lₐ₂₁₄₅ | P6 | F | H | H | P97 | H | F | P1 | H |
| Lₐ₂₁₄₆ | P6 | F | H | H | P97 | H | F | P2 | H |
| Lₐ₂₁₄₇ | P6 | F | H | H | P97 | H | F | P3 | H |
| Lₐ₂₁₄₈ | P6 | F | H | H | P97 | H | F | P4 | H |
| Lₐ₂₁₄₉ | P6 | F | H | H | P97 | H | F | P5 | H |
| Lₐ₂₁₅₀ | P6 | F | H | H | P97 | H | F | P6 | H |
| Lₐ₂₁₅₁ | P6 | F | H | H | P97 | H | F | P7 | H |
| Lₐ₂₁₅₂ | P6 | F | H | H | P97 | H | F | P8 | H |
| Lₐ₂₁₅₃ | P6 | F | H | H | P97 | H | F | P9 | H |
| Lₐ₂₁₅₄ | P6 | F | H | H | P97 | H | F | P10 | H |
| Lₐ₂₁₅₅ | P6 | F | H | H | P97 | H | F | P11 | H |
| Lₐ₂₁₅₆ | P6 | F | H | H | P97 | H | P1 | F | H |
| Lₐ₂₁₅₇ | P6 | F | H | H | P97 | H | P2 | F | H |
| Lₐ₂₁₅₈ | P6 | F | H | H | P97 | H | P3 | F | H |
| Lₐ₂₁₅₉ | P6 | F | H | H | P97 | H | P4 | F | H |
| Lₐ₂₁₆₀ | P6 | F | H | H | P97 | H | P5 | F | H |
| Lₐ₂₁₆₁ | P6 | F | H | H | P97 | H | P6 | F | H |
| Lₐ₂₁₆₂ | P6 | F | H | H | P97 | H | P7 | F | H |
| Lₐ₂₁₆₃ | P6 | F | H | H | P97 | H | P8 | F | H |
| Lₐ₂₁₆₄ | P6 | F | H | H | P97 | H | P9 | F | H |
| Lₐ₂₁₆₅ | P6 | F | H | H | P97 | H | P10 | F | H |
| Lₐ₂₁₆₆ | P6 | F | H | H | P97 | H | P11 | F | H |
| Lₐ₂₁₆₇ | P6 | F | H | H | P97 | H | P1 | P1 | H |
| Lₐ₂₁₆₈ | P6 | F | H | H | P97 | H | P2 | P2 | H |
| Lₐ₂₁₆₉ | P6 | F | H | H | P97 | D | D | D | D |
| Lₐ₂₁₇₀ | P6 | F | H | H | P97 | D | P2 | P2 | D |
| Lₐ₂₁₇₁ | P6 | F | H | H | P97 | D | F | P4 | D |
| Lₐ₂₁₇₂ | P6 | F | H | H | P97 | D | F | P5 | D |
| Lₐ₂₁₇₃ | P6 | F | H | H | P97 | D | F | P9 | D |
| Lₐ₂₁₇₄ | P6 | F | H | H | P97 | D | F | P11 | D |
| Lₐ₂₁₇₅ | P6 | F | H | H | P102 | H | P1 | H | H |
| Lₐ₂₁₇₆ | P6 | F | H | H | P102 | H | P2 | H | H |
| Lₐ₂₁₇₇ | P6 | F | H | H | P102 | H | P3 | H | H |
| Lₐ₂₁₇₈ | P6 | F | H | H | P102 | H | P4 | H | H |
| Lₐ₂₁₇₉ | P6 | F | H | H | P102 | H | P5 | H | H |
| Lₐ₂₁₈₀ | P6 | F | H | H | P102 | H | P6 | H | H |
| Lₐ₂₁₈₁ | P6 | F | H | H | P102 | H | P7 | H | H |
| Lₐ₂₁₈₂ | P6 | F | H | H | P102 | H | P8 | H | H |
| Lₐ₂₁₈₃ | P6 | F | H | H | P102 | H | P9 | H | H |
| Lₐ₂₁₈₄ | P6 | F | H | H | P102 | H | P10 | H | H |
| Lₐ₂₁₈₅ | P6 | F | H | H | P102 | H | P11 | H | H |
| Lₐ₂₁₈₆ | P6 | F | H | H | P102 | H | P12 | H | H |
| Lₐ₂₁₈₇ | P6 | F | H | H | P102 | H | P13 | H | H |
| Lₐ₂₁₈₈ | P6 | F | H | H | P102 | H | P14 | H | H |
| Lₐ₂₁₈₉ | P6 | F | H | H | P102 | H | P15 | H | H |
| Lₐ₂₁₉₀ | P6 | F | H | H | P102 | H | P16 | H | H |
| Lₐ₂₁₉₁ | P6 | F | H | H | P102 | H | P17 | H | H |
| Lₐ₂₁₉₂ | P6 | F | H | H | P102 | H | P18 | H | H |
| Lₐ₂₁₉₃ | P6 | F | H | H | P102 | H | P19 | H | H |
| Lₐ₂₁₉₄ | P6 | F | H | H | P102 | H | P20 | H | H |
| Lₐ₂₁₉₅ | P6 | F | H | H | P102 | H | P21 | H | H |
| Lₐ₂₁₉₆ | P6 | F | H | H | P102 | H | H | P1 | H |
| Lₐ₂₁₉₇ | P6 | F | H | H | P102 | H | H | P2 | H |
| Lₐ₂₁₉₈ | P6 | F | H | H | P102 | H | H | P3 | H |
| Lₐ₂₁₉₉ | P6 | F | H | H | P102 | H | H | P4 | H |
| Lₐ₂₂₀₀ | P6 | F | H | H | P102 | H | H | P5 | H |
| Lₐ₂₂₀₁ | P6 | F | H | H | P102 | H | H | P6 | H |
| Lₐ₂₂₀₂ | P6 | F | H | H | P102 | H | H | P7 | H |
| Lₐ₂₂₀₃ | P6 | F | H | H | P102 | H | H | P8 | H |
| Lₐ₂₂₀₄ | P6 | F | H | H | P102 | H | H | P9 | H |
| Lₐ₂₂₀₅ | P6 | F | H | H | P102 | H | H | P10 | H |
| Lₐ₂₂₀₆ | P6 | F | H | H | P102 | H | H | P11 | H |
| Lₐ₂₂₀₇ | P6 | F | H | H | P102 | H | H | P12 | H |
| Lₐ₂₂₀₈ | P6 | F | H | H | P102 | H | H | P15 | H |
| Lₐ₂₂₀₉ | P6 | F | H | H | P102 | H | H | P17 | H |
| Lₐ₂₂₁₀ | P6 | F | H | H | P102 | H | H | P18 | H |
| Lₐ₂₂₁₁ | P6 | F | H | H | P102 | H | H | P19 | H |
| Lₐ₂₂₁₂ | P6 | F | H | H | P102 | H | H | P20 | H |
| Lₐ₂₂₁₃ | P6 | F | H | H | P102 | H | H | P21 | H |
| Lₐ₂₂₁₄ | P6 | F | H | H | P102 | H | F | H | H |
| Lₐ₂₂₁₅ | P6 | F | H | H | P102 | H | F | P1 | H |
| Lₐ₂₂₁₆ | P6 | F | H | H | P102 | H | F | P2 | H |
| Lₐ₂₂₁₇ | P6 | F | H | H | P102 | H | F | P3 | H |
| Lₐ₂₂₁₈ | P6 | F | H | H | P102 | H | F | P4 | H |
| Lₐ₂₂₁₉ | P6 | F | H | H | P102 | H | F | P5 | H |
| Lₐ₂₂₂₀ | P6 | F | H | H | P102 | H | F | P6 | H |
| Lₐ₂₂₂₁ | P6 | F | H | H | P102 | H | F | P7 | H |
| Lₐ₂₂₂₂ | P6 | F | H | H | P102 | H | F | P8 | H |
| Lₐ₂₂₂₃ | P6 | F | H | H | P102 | H | F | P9 | H |
| Lₐ₂₂₂₄ | P6 | F | H | H | P102 | H | F | P10 | H |
| Lₐ₂₂₂₅ | P6 | F | H | H | P102 | H | F | P11 | H |
| Lₐ₂₂₂₆ | P6 | F | H | H | P102 | H | P1 | F | H |
| Lₐ₂₂₂₇ | P6 | F | H | H | P102 | H | P2 | F | H |
| Lₐ₂₂₂₈ | P6 | F | H | H | P102 | H | P3 | F | H |
| Lₐ₂₂₂₉ | P6 | F | H | H | P102 | H | P4 | F | H |
| Lₐ₂₂₃₀ | P6 | F | H | H | P102 | H | P5 | F | H |
| Lₐ₂₂₃₁ | P6 | F | H | H | P102 | H | P6 | F | H |
| Lₐ₂₂₃₂ | P6 | F | H | H | P102 | H | P7 | F | H |
| Lₐ₂₂₃₃ | P6 | F | H | H | P102 | H | P8 | F | H |
| Lₐ₂₂₃₄ | P6 | F | H | H | P102 | H | P9 | F | H |
| Lₐ₂₂₃₅ | P6 | F | H | H | P102 | H | P10 | F | H |
| Lₐ₂₂₃₆ | P6 | F | H | H | P102 | H | P11 | F | H |
| Lₐ₂₂₃₇ | P6 | F | H | H | P102 | H | P1 | P1 | H |
| Lₐ₂₂₃₈ | P6 | F | H | H | P102 | H | P2 | P2 | H |
| Lₐ₂₂₃₉ | P6 | F | H | H | P102 | D | D | D | D |
| Lₐ₂₂₄₀ | P6 | F | H | H | P102 | D | P2 | P2 | D |
| Lₐ₂₂₄₁ | P6 | F | H | H | P102 | D | F | P4 | D |
| Lₐ₂₂₄₂ | P6 | F | H | H | P102 | D | F | P5 | D |
| Lₐ₂₂₄₃ | P6 | F | H | H | P102 | D | F | P9 | D |
| Lₐ₂₂₄₄ | P6 | F | H | H | P102 | D | F | P11 | D |
| Lₐ₂₂₄₅ | P6 | F | H | H | P103 | H | P1 | H | H |
| Lₐ₂₂₄₆ | P6 | F | H | H | P103 | H | P2 | H | H |
| Lₐ₂₂₄₇ | P6 | F | H | H | P103 | H | P3 | H | H |
| Lₐ₂₂₄₈ | P6 | F | H | H | P103 | H | P4 | H | H |
| Lₐ₂₂₄₉ | P6 | F | H | H | P103 | H | P5 | H | H |
| Lₐ₂₂₅₀ | P6 | F | H | H | P103 | H | P6 | H | H |
| Lₐ₂₂₅₁ | P6 | F | H | H | P103 | H | P7 | H | H |
| Lₐ₂₂₅₂ | P6 | F | H | H | P103 | H | P8 | H | H |
| Lₐ₂₂₅₃ | P6 | F | H | H | P103 | H | P9 | H | H |
| Lₐ₂₂₅₄ | P6 | F | H | H | P103 | H | P10 | H | H |
| Lₐ₂₂₅₅ | P6 | F | H | H | P103 | H | P11 | H | H |
| Lₐ₂₂₅₆ | P6 | F | H | H | P103 | H | P12 | H | H |
| Lₐ₂₂₅₇ | P6 | F | H | H | P103 | H | P13 | H | H |
| Lₐ₂₂₅₈ | P6 | F | H | H | P103 | H | P14 | H | H |
| Lₐ₂₂₅₉ | P6 | F | H | H | P103 | H | P15 | H | H |
| Lₐ₂₂₆₀ | P6 | F | H | H | P103 | H | P16 | H | H |
| Lₐ₂₂₆₁ | P6 | F | H | H | P103 | H | P17 | H | H |
| Lₐ₂₂₆₂ | P6 | F | H | H | P103 | H | P18 | H | H |
| Lₐ₂₂₆₃ | P6 | F | H | H | P103 | H | P19 | H | H |
| Lₐ₂₂₆₄ | P6 | F | H | H | P103 | H | P20 | H | H |
| Lₐ₂₂₆₅ | P6 | F | H | H | P103 | H | P21 | H | H |
| Lₐ₂₂₆₆ | P6 | F | H | H | P103 | H | H | P1 | H |
| Lₐ₂₂₆₇ | P6 | F | H | H | P103 | H | H | P2 | H |
| Lₐ₂₂₆₈ | P6 | F | H | H | P103 | H | H | P3 | H |
| Lₐ₂₂₆₉ | P6 | F | H | H | P103 | H | H | P4 | H |
| Lₐ₂₂₇₀ | P6 | F | H | H | P103 | H | H | P5 | H |
| Lₐ₂₂₇₁ | P6 | F | H | H | P103 | H | H | P6 | H |
| Lₐ₂₂₇₂ | P6 | F | H | H | P103 | H | H | P7 | H |
| Lₐ₂₂₇₃ | P6 | F | H | H | P103 | H | H | P8 | H |
| Lₐ₂₂₇₄ | P6 | F | H | H | P103 | H | H | P9 | H |
| Lₐ₂₂₇₅ | P6 | F | H | H | P103 | H | H | P10 | H |
| Lₐ₂₂₇₆ | P6 | F | H | H | P103 | H | H | P11 | H |
| Lₐ₂₂₇₇ | P6 | F | H | H | P103 | H | H | P12 | H |
| Lₐ₂₂₇₈ | P6 | F | H | H | P103 | H | H | P15 | H |
| Lₐ₂₂₇₉ | P6 | F | H | H | P103 | H | H | P17 | H |
| Lₐ₂₂₈₀ | P6 | F | H | H | P103 | H | H | P18 | H |
| Lₐ₂₂₈₁ | P6 | F | H | H | P103 | H | H | P19 | H |
| Lₐ₂₂₈₂ | P6 | F | H | H | P103 | H | H | P20 | H |
| Lₐ₂₂₈₃ | P6 | F | H | H | P103 | H | H | P21 | H |
| Lₐ₂₂₈₄ | P6 | F | H | H | P103 | H | F | H | H |
| Lₐ₂₂₈₅ | P6 | F | H | H | P103 | H | F | P1 | H |
| Lₐ₂₂₈₆ | P6 | F | H | H | P103 | H | F | P2 | H |
| Lₐ₂₂₈₇ | P6 | F | H | H | P103 | H | F | P3 | H |
| Lₐ₂₂₈₈ | P6 | F | H | H | P103 | H | F | P4 | H |
| Lₐ₂₂₈₉ | P6 | F | H | H | P103 | H | F | P5 | H |
| Lₐ₂₂₉₀ | P6 | F | H | H | P103 | H | F | P6 | H |
| Lₐ₂₂₉₁ | P6 | F | H | H | P103 | H | F | P7 | H |
| Lₐ₂₂₉₂ | P6 | F | H | H | P103 | H | F | P8 | H |
| Lₐ₂₂₉₃ | P6 | F | H | H | P103 | H | F | P9 | H |
| Lₐ₂₂₉₄ | P6 | F | H | H | P103 | H | F | P10 | H |
| Lₐ₂₂₉₅ | P6 | F | H | H | P103 | H | F | P11 | H |
| Lₐ₂₂₉₆ | P6 | F | H | H | P103 | H | P1 | F | H |
| Lₐ₂₂₉₇ | P6 | F | H | H | P103 | H | P2 | F | H |
| Lₐ₂₂₉₈ | P6 | F | H | H | P103 | H | P3 | F | H |
| Lₐ₂₂₉₉ | P6 | F | H | H | P103 | H | P4 | F | H |
| Lₐ₂₃₀₀ | P6 | F | H | H | P103 | H | P5 | F | H |
| Lₐ₂₃₀₁ | P6 | F | H | H | P103 | H | P6 | F | H |
| Lₐ₂₃₀₂ | P6 | F | H | H | P103 | H | P7 | F | H |
| Lₐ₂₃₀₃ | P6 | F | H | H | P103 | H | P8 | F | H |
| Lₐ₂₃₀₄ | P6 | F | H | H | P103 | H | P9 | F | H |
| Lₐ₂₃₀₅ | P6 | F | H | H | P103 | H | P10 | F | H |
| Lₐ₂₃₀₆ | P6 | F | H | H | P103 | H | P11 | F | H |
| Lₐ₂₃₀₇ | P6 | F | H | H | P103 | H | P1 | P1 | H |
| Lₐ₂₃₀₈ | P6 | F | H | H | P103 | H | P2 | P2 | H |
| Lₐ₂₃₀₉ | P6 | F | H | H | P103 | D | D | D | D |
| Lₐ₂₃₁₀ | P6 | F | H | H | P103 | D | P2 | P2 | D |
| Lₐ₂₃₁₁ | P6 | F | H | H | P103 | D | F | P4 | D |
| Lₐ₂₃₁₂ | P6 | F | H | H | P103 | D | F | P5 | D |
| Lₐ₂₃₁₃ | P6 | F | H | H | P103 | D | F | P9 | D |
| Lₐ₂₃₁₄ | P6 | F | H | H | P103 | D | F | P11 | D |
| Lₐ₂₃₁₅ | P6 | F | H | H | H | H | P20 | P1 | H |
| Lₐ₂₃₁₆ | P6 | F | H | H | H | H | P21 | P2 | H |
| Lₐ₂₃₁₇ | P6 | F | H | H | H | H | P29 | H | H |
| Lₐ₂₃₁₈ | P6 | F | H | H | H | H | P29 | P1 | H |
| Lₐ₂₃₁₉ | P6 | F | H | H | H | H | P54 | H | H |
| Lₐ₂₃₂₀ | P6 | F | H | H | H | H | P96 | H | H |
| Lₐ₂₃₂₁ | P6 | F | H | H | H | H | P97 | H | H |
| Lₐ₂₃₂₂ | P6 | F | H | H | H | H | P96 | P1 | H |
| Lₐ₂₃₂₃ | P6 | F | H | H | H | H | P97 | P1 | H |
| Lₐ₂₃₂₄ | P6 | F | H | H | H | H | P102 | H | H |
| Lₐ₂₃₂₅ | P6 | F | H | H | H | H | P103 | H | H |
| Lₐ₂₃₂₆ | P6 | F | H | H | D | H | P20 | P1 | H |
| Lₐ₂₃₂₇ | P6 | F | H | H | D | H | P21 | P2 | H |
| Lₐ₂₃₂₈ | P6 | F | H | H | D | H | P29 | H | H |
| Lₐ₂₃₂₉ | P6 | F | H | H | D | H | P29 | P1 | H |
| Lₐ₂₃₃₀ | P6 | F | H | H | D | H | P54 | H | H |
| Lₐ₂₃₃₁ | P6 | F | H | H | D | H | P96 | H | H |
| Lₐ₂₃₃₂ | P6 | F | H | H | D | H | P97 | H | H |
| Lₐ₂₃₃₃ | P6 | F | H | H | D | H | P96 | P1 | H |
| Lₐ₂₃₃₄ | P6 | F | H | H | D | H | P97 | P1 | H |
| Lₐ₂₃₃₅ | P6 | F | H | H | D | H | P102 | H | H |
| Lₐ₂₃₃₆ | P6 | F | H | H | D | H | P103 | H | H |
| Lₐ₂₃₃₇ | P6 | F | H | H | P20 | H | P20 | P1 | H |
| Lₐ₂₃₃₈ | P6 | F | H | H | P20 | H | P21 | P2 | H |
| Lₐ₂₃₃₉ | P6 | F | H | H | P20 | H | P29 | H | H |
| Lₐ₂₃₄₀ | P6 | F | H | H | P20 | H | P29 | P1 | H |
| Lₐ₂₃₄₁ | P6 | F | H | H | P20 | H | P54 | H | H |
| Lₐ₂₃₄₂ | P6 | F | H | H | P20 | H | P96 | H | H |
| Lₐ₂₃₄₃ | P6 | F | H | H | P20 | H | P97 | H | H |
| Lₐ₂₃₄₄ | P6 | F | H | H | P20 | H | P96 | P1 | H |
| Lₐ₂₃₄₅ | P6 | F | H | H | P20 | H | P97 | P1 | H |
| Lₐ₂₃₄₆ | P6 | F | H | H | P20 | H | P102 | H | H |
| Lₐ₂₃₄₇ | P6 | F | H | H | P20 | H | P103 | H | H |
| Lₐ₂₃₄₈ | P6 | F | H | H | P21 | H | P20 | P1 | H |
| Lₐ₂₃₄₉ | P6 | F | H | H | P21 | H | P21 | P2 | H |
| Lₐ₂₃₅₀ | P6 | F | H | H | P21 | H | P29 | H | H |
| Lₐ₂₃₅₁ | P6 | F | H | H | P21 | H | P29 | P1 | H |
| Lₐ₂₃₅₂ | P6 | F | H | H | P21 | H | P54 | H | H |
| Lₐ₂₃₅₃ | P6 | F | H | H | P21 | H | P96 | H | H |
| Lₐ₂₃₅₄ | P6 | F | H | H | P21 | H | P97 | H | H |
| Lₐ₂₃₅₅ | P6 | F | H | H | P21 | H | P96 | P1 | H |
| Lₐ₂₃₅₆ | P6 | F | H | H | P21 | H | P97 | P1 | H |
| Lₐ₂₃₅₇ | P6 | F | H | H | P21 | H | P102 | H | H |
| Lₐ₂₃₅₈ | P6 | F | H | H | P21 | H | P103 | H | H |
| Lₐ₂₃₅₉ | P6 | F | H | H | P22 | H | H | H | H |
| Lₐ₂₃₆₀ | P6 | F | H | H | P23 | H | H | H | H |
| Lₐ₂₃₆₁ | P6 | F | H | H | P24 | H | H | H | H |
| Lₐ₂₃₆₂ | P6 | F | H | H | P25 | H | H | H | H |
| Lₐ₂₃₆₃ | P6 | F | H | H | P26 | H | H | H | H |
| Lₐ₂₃₆₄ | P6 | F | H | H | P27 | H | H | H | H |
| Lₐ₂₃₆₅ | P6 | F | H | H | P28 | H | H | H | H |
| Lₐ₂₃₆₆ | P6 | F | H | H | P29 | H | H | H | H |
| Lₐ₂₃₆₇ | P6 | F | H | H | P30 | H | H | H | H |
| Lₐ₂₃₆₈ | P6 | F | H | H | P31 | H | H | H | H |
| Lₐ₂₃₆₉ | P6 | F | H | H | P32 | H | H | H | H |
| Lₐ₂₃₇₀ | P6 | F | H | H | P33 | H | H | H | H |
| Lₐ₂₃₇₁ | P6 | F | H | H | P34 | H | H | H | H |
| Lₐ₂₃₇₂ | P6 | F | H | H | P35 | H | H | H | H |
| Lₐ₂₃₇₃ | P6 | F | H | H | P36 | H | H | H | H |
| Lₐ₂₃₇₄ | P6 | F | H | H | P37 | H | H | H | H |
| Lₐ₂₃₇₅ | P6 | F | H | H | P38 | H | H | H | H |
| Lₐ₂₃₇₆ | P6 | F | H | H | P39 | H | H | H | H |
| Lₐ₂₃₇₇ | P6 | F | H | H | P40 | H | H | H | H |
| Lₐ₂₃₇₈ | P6 | F | H | H | P41 | H | H | H | H |
| Lₐ₂₃₇₉ | P6 | F | H | H | P42 | H | H | H | H |
| Lₐ₂₃₈₀ | P6 | F | H | H | P43 | H | H | H | H |
| Lₐ₂₃₈₁ | P6 | F | H | H | P44 | H | H | H | H |
| Lₐ₂₃₈₂ | P6 | F | H | H | P45 | H | H | H | H |
| Lₐ₂₃₈₃ | P6 | F | H | H | P46 | H | H | H | H |
| Lₐ₂₃₈₄ | P6 | F | H | H | P47 | H | H | H | H |
| Lₐ₂₃₈₅ | P6 | F | H | H | P48 | H | H | H | H |
| Lₐ₂₃₈₆ | P6 | F | H | H | P49 | H | H | H | H |
| Lₐ₂₃₈₇ | P6 | F | H | H | P50 | H | H | H | H |
| Lₐ₂₃₈₈ | P6 | F | H | H | P51 | H | H | H | H |
| Lₐ₂₃₈₉ | P6 | F | H | H | P52 | H | H | H | H |
| Lₐ₂₃₉₀ | P6 | F | H | H | P53 | H | H | H | H |
| Lₐ₂₃₉₁ | P6 | F | H | H | P55 | H | H | H | H |
| Lₐ₂₃₉₂ | P6 | F | H | H | P56 | H | H | H | H |
| Lₐ₂₃₉₃ | P6 | F | H | H | P57 | H | H | H | H |
| Lₐ₂₃₉₄ | P6 | F | H | H | P58 | H | H | H | H |
| Lₐ₂₃₉₅ | P6 | F | H | H | P59 | H | H | H | H |
| Lₐ₂₃₉₆ | P6 | F | H | H | P60 | H | H | H | H |
| Lₐ₂₃₉₇ | P6 | F | H | H | P61 | H | H | H | H |
| Lₐ₂₃₉₈ | P6 | F | H | H | P62 | H | H | H | H |
| Lₐ₂₃₉₉ | P6 | F | H | H | P63 | H | H | H | H |
| Lₐ₂₄₀₀ | P6 | F | H | H | P64 | H | H | H | H |
| Lₐ₂₄₀₁ | P6 | F | H | H | P65 | H | H | H | H |
| Lₐ₂₄₀₂ | P6 | F | H | H | P66 | H | H | H | H |
| Lₐ₂₄₀₃ | P6 | F | H | H | P67 | H | H | H | H |
| Lₐ₂₄₀₄ | P6 | F | H | H | P68 | H | H | H | H |
| Lₐ₂₄₀₅ | P6 | F | H | H | P69 | H | H | H | H |
| Lₐ₂₄₀₆ | P6 | F | H | H | P70 | H | H | H | H |
| Lₐ₂₄₀₇ | P6 | F | H | H | P71 | H | H | H | H |
| Lₐ₂₄₀₈ | P6 | F | H | H | P72 | H | H | H | H |
| Lₐ₂₄₀₉ | P6 | F | H | H | P73 | H | H | H | H |
| Lₐ₂₄₁₀ | P6 | F | H | H | P74 | H | H | H | H |
| Lₐ₂₄₁₁ | P6 | F | H | H | P75 | H | H | H | H |
| Lₐ₂₄₁₂ | P6 | F | H | H | P76 | H | H | H | H |
| Lₐ₂₄₁₃ | P6 | F | H | H | P77 | H | H | H | H |
| Lₐ₂₄₁₄ | P6 | F | H | H | P78 | H | H | H | H |
| Lₐ₂₄₁₅ | P6 | F | H | H | P79 | H | H | H | H |
| Lₐ₂₄₁₆ | P6 | F | H | H | P80 | H | H | H | H |
| Lₐ₂₄₁₇ | P6 | F | H | H | P81 | H | H | H | H |
| Lₐ₂₄₁₈ | P6 | F | H | H | P82 | H | H | H | H |
| Lₐ₂₄₁₉ | P6 | F | H | H | P83 | H | H | H | H |
| Lₐ₂₄₂₀ | P6 | F | H | H | P84 | H | H | H | H |
| Lₐ₂₄₂₁ | P6 | F | H | H | P85 | H | H | H | H |
| Lₐ₂₄₂₂ | P6 | F | H | H | P86 | H | H | H | H |
| Lₐ₂₄₂₃ | P6 | F | H | H | P87 | H | H | H | H |
| Lₐ₂₄₂₄ | P6 | F | H | H | P88 | H | H | H | H |
| Lₐ₂₄₂₅ | P6 | F | H | H | P89 | H | H | H | H |
| Lₐ₂₄₂₆ | P6 | F | H | H | P90 | H | H | H | H |
| Lₐ₂₄₂₇ | P6 | F | H | H | P91 | H | H | H | H |
| Lₐ₂₄₂₈ | P6 | F | H | H | P92 | H | H | H | H |
| Lₐ₂₄₂₉ | P6 | F | H | H | P93 | H | H | H | H |
| Lₐ₂₄₃₀ | P6 | F | H | H | P94 | H | H | H | H |
| Lₐ₂₄₃₁ | P6 | F | H | H | P95 | H | H | H | H |
| Lₐ₂₄₃₂ | P6 | F | H | H | P98 | H | H | H | H |
| Lₐ₂₄₃₃ | P6 | F | H | H | P99 | H | H | H | H |
| Lₐ₂₄₃₄ | P6 | F | H | H | P100 | H | H | H | H |
| Lₐ₂₄₃₅ | P6 | F | H | H | P101 | H | H | H | H |
| Lₐ₂₄₃₆ | P6 | F | H | H | P102 | H | H | H | H |
| Lₐ₂₄₃₇ | P6 | F | H | H | P103 | H | H | H | H |
| Lₐ₂₄₃₈ | P6 | F | H | H | P104 | H | H | H | H |
| Lₐ₂₄₃₉ | P6 | F | H | H | P105 | H | H | H | H |
| Lₐ₂₄₄₀ | P6 | F | H | H | P106 | H | H | H | H |
| Lₐ₂₄₄₁ | P6 | F | H | H | P107 | H | H | H | H |
| Lₐ₂₄₄₂ | P6 | F | H | H | P108 | H | H | H | H |
| Lₐ₂₄₄₃ | P6 | F | H | H | P109 | H | H | H | H |
| Lₐ₂₄₄₄ | P6 | F | H | H | P110 | H | H | H | H |
| Lₐ₂₄₄₅ | P6 | F | H | H | P111 | H | H | H | H |
| Lₐ₂₄₄₆ | P6 | F | H | H | P112 | H | H | H | H |
| Lₐ₂₄₄₇ | P6 | F | H | H | P113 | H | H | H | H |
| Lₐ₂₄₄₈ | P6 | F | H | H | P114 | H | H | H | H |
| Lₐ₂₄₄₉ | P6 | F | H | H | P115 | H | H | H | H |
| Lₐ₂₄₅₀ | P6 | F | H | H | P116 | H | H | H | H |
| Lₐ₂₄₅₁ | P6 | F | H | H | P117 | H | H | H | H |
| Lₐ₂₄₅₂ | P6 | F | H | H | P118 | H | H | H | H |
| Lₐ₂₄₅₃ | P6 | F | H | H | P119 | H | H | H | H |
| Lₐ₂₄₅₄ | P6 | F | H | H | P120 | H | H | H | H |
| Lₐ₂₄₅₅ | P6 | F | H | H | P121 | H | H | H | H |
| Lₐ₂₄₅₆ | P6 | F | H | H | P122 | H | H | H | H |
| Lₐ₂₄₅₇ | P6 | F | H | H | P123 | H | H | H | H |
| Lₐ₂₄₅₈ | P6 | F | H | H | P124 | H | H | H | H |
| Lₐ₂₄₅₉ | P6 | F | H | H | P125 | H | H | H | H |
| Lₐ₂₄₆₀ | P6 | F | H | H | P126 | H | H | H | H |
| Lₐ₂₄₆₁ | P6 | F | H | H | P127 | H | H | H | H |
| Lₐ₂₄₆₂ | P6 | F | H | H | P128 | H | H | H | H |
| Lₐ₂₄₆₃ | P6 | F | H | H | P129 | H | H | H | H |
| Lₐ₂₄₆₄ | P6 | F | H | H | P130 | H | H | H | H |
| Lₐ₂₄₆₅ | P6 | F | H | H | P131 | H | H | H | H |
| Lₐ₂₄₆₆ | P6 | F | H | H | P132 | H | H | H | H |
| Lₐ₂₄₆₇ | P6 | F | H | H | P133 | H | H | H | H |
| Lₐ₂₄₆₈ | P6 | F | H | H | P134 | H | H | H | H |
| Lₐ₂₄₆₉ | P6 | F | H | H | P135 | H | H | H | H |
| Lₐ₂₄₇₀ | P6 | F | H | H | P136 | H | H | H | H |
| Lₐ₂₄₇₁ | P6 | F | H | H | P137 | H | H | H | H |
| Lₐ₂₄₇₂ | P6 | F | H | H | P138 | H | H | H | H |
| Lₐ₂₄₇₃ | P6 | F | H | H | P139 | H | H | H | H |
| Lₐ₂₄₇₄ | P6 | F | H | H | P140 | H | H | H | H |
| Lₐ₂₄₇₅ | P6 | F | H | H | P141 | H | H | H | H |
| Lₐ₂₄₇₆ | P6 | F | H | H | P142 | H | H | H | H |
| Lₐ₂₄₇₇ | P6 | F | H | H | P143 | H | H | H | H |
| Lₐ₂₄₇₈ | P6 | F | H | H | P144 | H | H | H | H |
| Lₐ₂₄₇₉ | P6 | F | H | H | P145 | H | H | H | H |
| Lₐ₂₄₈₀ | P6 | F | H | H | P146 | H | H | H | H |
| Lₐ₂₄₈₁ | P6 | F | H | H | P147 | H | H | H | H |
| Lₐ₂₄₈₂ | P6 | F | H | H | P148 | H | H | H | H |
| Lₐ₂₄₈₃ | P6 | F | H | H | P149 | H | H | H | H |
| Lₐ₂₄₈₄ | P6 | F | H | H | P150 | H | H | H | H |
| Lₐ₂₄₈₅ | P6 | F | H | H | P151 | H | H | H | H |
| Lₐ₂₄₈₆ | P6 | F | H | P18 | H | H | H | H | H |
| Lₐ₂₄₈₇ | P6 | F | H | P18 | D | H | H | H | H |
| Lₐ₂₄₈₈ | P6 | F | H | P18 | P20 | H | H | H | H |
| Lₐ₂₄₈₉ | P6 | F | H | P19 | H | H | H | H | H |
| Lₐ₂₄₉₀ | P6 | F | H | P19 | D | H | H | H | H |
| Lₐ₂₄₉₁ | P6 | F | H | P19 | P20 | H | H | H | H |
| Lₐ₂₄₉₂ | P6 | F | H | P20 | H | H | H | H | H |
| Lₐ₂₄₉₃ | P6 | F | H | P20 | D | H | H | H | H |
| Lₐ₂₄₉₄ | P6 | F | H | P20 | H | H | P1 | H | H |
| Lₐ₂₄₉₅ | P6 | F | H | P20 | D | H | P2 | H | H |
| Lₐ₂₄₉₆ | P6 | F | H | P20 | H | H | H | P1 | H |
| Lₐ₂₄₉₇ | P6 | F | H | P20 | D | H | H | P2 | H |
| Lₐ₂₄₉₈ | P6 | F | H | P20 | H | H | P1 | P1 | H |
| Lₐ₂₄₉₉ | P6 | F | H | P20 | D | H | P2 | P2 | H |
| Lₐ₂₅₀₀ | P6 | F | H | P20 | H | H | P3 | H | H |
| Lₐ₂₅₀₁ | P6 | F | H | P20 | D | H | P4 | H | H |
| Lₐ₂₅₀₂ | P6 | F | H | P20 | H | H | P5 | H | H |
| Lₐ₂₅₀₃ | P6 | F | H | P21 | H | H | H | H | H |
| Lₐ₂₅₀₄ | P6 | F | H | P21 | D | H | H | H | H |
| Lₐ₂₅₀₅ | P6 | F | H | P21 | H | H | P1 | H | H |
| Lₐ₂₅₀₆ | P6 | F | H | P21 | D | H | P2 | H | H |
| Lₐ₂₅₀₇ | P6 | F | H | P21 | H | H | H | P1 | H |
| Lₐ₂₅₀₈ | P6 | F | H | P21 | D | H | H | P2 | H |
| Lₐ₂₅₀₉ | P6 | F | H | P21 | H | H | P1 | P1 | H |
| Lₐ₂₅₁₀ | P6 | F | H | P21 | D | H | P2 | P2 | H |
| Lₐ₂₅₁₁ | P6 | F | H | P21 | H | H | P3 | H | H |
| Lₐ₂₅₁₂ | P6 | F | H | P21 | D | H | P4 | H | H |
| Lₐ₂₅₁₃ | P6 | F | H | P21 | H | H | P5 | H | H |
| Lₐ₂₅₁₄ | P11 | F | H | H | H | H | H | H | H |
| Lₐ₂₅₁₅ | P11 | F | H | H | H | H | P1 | H | H |
| Lₐ₂₅₁₆ | P11 | F | H | H | H | H | P2 | H | H |
| Lₐ₂₅₁₇ | P11 | F | H | H | H | H | P3 | H | H |
| Lₐ₂₅₁₈ | P11 | F | H | H | H | H | P4 | H | H |
| Lₐ₂₅₁₉ | P11 | F | H | H | H | H | P5 | H | H |
| Lₐ₂₅₂₀ | P11 | F | H | H | H | H | P6 | H | H |
| Lₐ₂₅₂₁ | P11 | F | H | H | H | H | P7 | H | H |
| Lₐ₂₅₂₂ | P11 | F | H | H | H | H | P8 | H | H |
| Lₐ₂₅₂₃ | P11 | F | H | H | H | H | P9 | H | H |
| Lₐ₂₅₂₄ | P11 | F | H | H | H | H | P10 | H | H |
| Lₐ₂₅₂₅ | P11 | F | H | H | H | H | P11 | H | H |
| Lₐ₂₅₂₆ | P11 | F | H | H | H | H | P12 | H | H |
| Lₐ₂₅₂₇ | P11 | F | H | H | H | H | P13 | H | H |
| Lₐ₂₅₂₈ | P11 | F | H | H | H | H | P14 | H | H |
| Lₐ₂₅₂₉ | P11 | F | H | H | H | H | P15 | H | H |
| Lₐ₂₅₃₀ | P11 | F | H | H | H | H | P16 | H | H |
| Lₐ₂₅₃₁ | P11 | F | H | H | H | H | P17 | H | H |
| Lₐ₂₅₃₂ | P11 | F | H | H | H | H | P18 | H | H |
| Lₐ₂₅₃₃ | P11 | F | H | H | H | H | P19 | H | H |
| Lₐ₂₅₃₄ | P11 | F | H | H | H | H | P20 | H | H |
| Lₐ₂₅₃₅ | P11 | F | H | H | H | H | P21 | H | H |
| Lₐ₂₅₃₆ | P11 | F | H | H | H | H | P1 | F | H |
| Lₐ₂₅₃₇ | P11 | F | H | H | H | H | P2 | F | H |
| Lₐ₂₅₃₈ | P11 | F | H | H | H | H | P3 | F | H |
| Lₐ₂₅₃₉ | P11 | F | H | H | H | H | P4 | F | H |
| Lₐ₂₅₄₀ | P11 | F | H | H | H | H | P5 | F | H |
| Lₐ₂₅₄₁ | P11 | F | H | H | H | H | P6 | F | H |
| Lₐ₂₅₄₂ | P11 | F | H | H | H | H | P7 | F | H |
| Lₐ₂₅₄₃ | P11 | F | H | H | H | H | P8 | F | H |
| Lₐ₂₅₄₄ | P11 | F | H | H | H | H | P9 | F | H |
| Lₐ₂₅₄₅ | P11 | F | H | H | H | H | P10 | F | H |
| Lₐ₂₅₄₆ | P11 | F | H | H | H | H | P11 | F | H |
| Lₐ₂₅₄₇ | P11 | F | H | H | H | H | P12 | F | H |
| Lₐ₂₅₄₈ | P11 | F | H | H | H | H | P13 | F | H |
| Lₐ₂₅₄₉ | P11 | F | H | H | H | H | P14 | F | H |
| Lₐ₂₅₅₀ | P11 | F | H | H | H | H | P15 | F | H |
| Lₐ₂₅₅₁ | P11 | F | H | H | H | H | P16 | F | H |
| Lₐ₂₅₅₂ | P11 | F | H | H | H | H | P17 | F | H |
| Lₐ₂₅₅₃ | P11 | F | H | H | H | H | P18 | F | H |
| Lₐ₂₅₅₄ | P11 | F | H | H | H | H | P19 | F | H |
| Lₐ₂₅₅₅ | P11 | F | H | H | H | H | P20 | F | H |
| Lₐ₂₅₅₆ | P11 | F | H | H | H | H | P21 | F | H |
| Lₐ₂₅₅₇ | P11 | F | H | H | H | H | H | P1 | H |
| Lₐ₂₅₅₈ | P11 | F | H | H | H | H | H | P2 | H |
| Lₐ₂₅₅₉ | P11 | F | H | H | H | H | H | P3 | H |
| Lₐ₂₅₆₀ | P11 | F | H | H | H | H | H | P4 | H |
| Lₐ₂₅₆₁ | P11 | F | H | H | H | H | H | P5 | H |
| Lₐ₂₅₆₂ | P11 | F | H | H | H | H | H | P6 | H |
| Lₐ₂₅₆₃ | P11 | F | H | H | H | H | H | P7 | H |
| Lₐ₂₅₆₄ | P11 | F | H | H | H | H | H | P8 | H |
| Lₐ₂₅₆₅ | P11 | F | H | H | H | H | H | P9 | H |
| Lₐ₂₅₆₆ | P11 | F | H | H | H | H | H | P10 | H |
| Lₐ₂₅₆₇ | P11 | F | H | H | H | H | H | P11 | H |
| Lₐ₂₅₆₈ | P11 | F | H | H | H | H | H | P12 | H |
| Lₐ₂₅₆₉ | P11 | F | H | H | H | H | H | P13 | H |
| Lₐ₂₅₇₀ | P11 | F | H | H | H | H | H | P14 | H |
| Lₐ₂₅₇₁ | P11 | F | H | H | H | H | H | P15 | H |
| Lₐ₂₅₇₂ | P11 | F | H | H | H | H | H | P16 | H |
| Lₐ₂₅₇₃ | P11 | F | H | H | H | H | H | P17 | H |
| Lₐ₂₅₇₄ | P11 | F | H | H | H | H | H | P18 | H |
| Lₐ₂₅₇₅ | P11 | F | H | H | H | H | H | P19 | H |
| Lₐ₂₅₇₆ | P11 | F | H | H | H | H | H | P20 | H |
| Lₐ₂₅₇₇ | P11 | F | H | H | H | H | H | P21 | H |
| Lₐ₂₅₇₈ | P11 | F | H | H | H | H | F | P1 | H |
| Lₐ₂₅₇₉ | P11 | F | H | H | H | H | F | P2 | H |
| Lₐ₂₅₈₀ | P11 | F | H | H | H | H | F | P3 | H |
| Lₐ₂₅₈₁ | P11 | F | H | H | H | H | F | P4 | H |
| Lₐ₂₅₈₂ | P11 | F | H | H | H | H | F | P5 | H |
| Lₐ₂₅₈₃ | P11 | F | H | H | H | H | F | P6 | H |
| Lₐ₂₅₈₄ | P11 | F | H | H | H | H | F | P7 | H |
| Lₐ₂₅₈₅ | P11 | F | H | H | H | H | F | P8 | H |
| Lₐ₂₅₈₆ | P11 | F | H | H | H | H | F | P9 | H |
| Lₐ₂₅₈₇ | P11 | F | H | H | H | H | F | P10 | H |
| Lₐ₂₅₈₈ | P11 | F | H | H | H | H | F | P11 | H |
| Lₐ₂₅₈₉ | P11 | F | H | H | H | H | F | P12 | H |
| Lₐ₂₅₉₀ | P11 | F | H | H | H | H | F | P13 | H |
| Lₐ₂₅₉₁ | P11 | F | H | H | H | H | F | P14 | H |
| Lₐ₂₅₉₂ | P11 | F | H | H | H | H | F | P15 | H |
| Lₐ₂₅₉₃ | P11 | F | H | H | H | H | F | P16 | H |
| Lₐ₂₅₉₄ | P11 | F | H | H | H | H | F | P17 | H |
| Lₐ₂₅₉₅ | P11 | F | H | H | H | H | F | P18 | H |
| Lₐ₂₅₉₆ | P11 | F | H | H | H | H | F | P19 | H |
| Lₐ₂₅₉₇ | P11 | F | H | H | H | H | F | P20 | H |
| Lₐ₂₅₉₈ | P11 | F | H | H | H | H | F | P21 | H |
| Lₐ₂₅₉₉ | P11 | F | H | H | H | H | P1 | P1 | H |
| Lₐ₂₆₀₀ | P11 | F | H | H | H | H | P1 | P3 | H |
| Lₐ₂₆₀₁ | P11 | F | H | H | H | H | P1 | P8 | H |
| Lₐ₂₆₀₂ | P11 | F | H | H | H | H | P1 | P10 | H |
| Lₐ₂₆₀₃ | P11 | F | H | H | H | H | P1 | P20 | H |
| Lₐ₂₆₀₄ | P11 | F | H | H | H | H | P1 | P21 | H |
| Lₐ₂₆₀₅ | P11 | F | H | H | H | H | P2 | P2 | H |
| Lₐ₂₆₀₆ | P11 | F | H | H | H | H | P2 | P4 | H |
| Lₐ₂₆₀₇ | P11 | F | H | H | H | H | P2 | P5 | H |
| Lₐ₂₆₀₈ | P11 | F | H | H | H | H | P2 | P9 | H |
| Lₐ₂₆₀₉ | P11 | F | H | H | H | H | P2 | P11 | H |
| Lₐ₂₆₁₀ | P11 | F | H | H | H | H | P2 | P20 | H |
| Lₐ₂₆₁₁ | P11 | F | H | H | H | H | P2 | P21 | H |
| Lₐ₂₆₁₂ | P11 | F | H | H | H | D | D | D | D |
| Lₐ₂₆₁₃ | P11 | F | H | H | H | D | F | D | D |
| Lₐ₂₆₁₄ | P11 | F | H | H | H | D | D | F | D |
| Lₐ₂₆₁₅ | P11 | F | H | H | H | D | P2 | D | D |
| Lₐ₂₆₁₆ | P11 | F | H | H | H | D | D | P2 | D |
| Lₐ₂₆₁₇ | P11 | F | H | H | H | D | P2 | P2 | D |
| Lₐ₂₆₁₈ | P11 | F | H | H | D | H | H | H | H |
| Lₐ₂₆₁₉ | P11 | F | H | H | D | H | P1 | H | H |
| Lₐ₂₆₂₀ | P11 | F | H | H | D | H | P2 | H | H |
| Lₐ₂₆₂₁ | P11 | F | H | H | D | H | P5 | H | H |
| Lₐ₂₆₂₂ | P11 | F | H | H | D | H | P10 | H | H |
| Lₐ₂₆₂₃ | P11 | F | H | H | D | H | P11 | H | H |
| Lₐ₂₆₂₄ | P11 | F | H | H | D | H | H | P1 | H |
| Lₐ₂₆₂₅ | P11 | F | H | H | D | H | H | P2 | H |
| Lₐ₂₆₂₆ | P11 | F | H | H | D | H | H | P4 | H |
| Lₐ₂₆₂₇ | P11 | F | H | H | D | H | H | P5 | H |
| Lₐ₂₆₂₈ | P11 | F | H | H | D | H | H | P10 | H |
| Lₐ₂₆₂₉ | P11 | F | H | H | D | H | H | P11 | H |
| Lₐ₂₆₃₀ | P11 | F | H | H | D | H | P1 | F | H |
| Lₐ₂₆₃₁ | P11 | F | H | H | D | H | P2 | F | H |
| Lₐ₂₆₃₂ | P11 | F | H | H | D | H | P11 | F | H |
| Lₐ₂₆₃₃ | P11 | F | H | H | D | H | F | P1 | H |
| Lₐ₂₆₃₄ | P11 | F | H | H | D | H | F | P2 | H |
| Lₐ₂₆₃₅ | P11 | F | H | H | D | H | F | P3 | H |
| Lₐ₂₆₃₆ | P11 | F | H | H | D | H | F | P4 | H |
| Lₐ₂₆₃₇ | P11 | F | H | H | D | H | F | P5 | H |
| Lₐ₂₆₃₈ | P11 | F | H | H | D | H | F | P8 | H |
| Lₐ₂₆₃₉ | P11 | F | H | H | D | H | F | P11 | H |
| Lₐ₂₆₄₀ | P11 | F | H | H | D | H | P1 | P1 | H |
| Lₐ₂₆₄₁ | P11 | F | H | H | D | H | P2 | P2 | H |
| Lₐ₂₆₄₂ | P11 | F | H | H | D | H | P2 | P2 | D |
| Lₐ₂₆₄₃ | P11 | F | H | H | P20 | H | H | H | H |
| Lₐ₂₆₄₄ | P11 | F | H | H | P20 | H | P1 | H | H |
| Lₐ₂₆₄₅ | P11 | F | H | H | P20 | H | P2 | H | H |
| Lₐ₂₆₄₆ | P11 | F | H | H | P20 | H | P3 | H | H |
| Lₐ₂₆₄₇ | P11 | F | H | H | P20 | H | P4 | H | H |
| Lₐ₂₆₄₈ | P11 | F | H | H | P20 | H | P5 | H | H |
| Lₐ₂₆₄₉ | P11 | F | H | H | P20 | H | P6 | H | H |
| Lₐ₂₆₅₀ | P11 | F | H | H | P20 | H | P7 | H | H |
| Lₐ₂₆₅₁ | P11 | F | H | H | P20 | H | P8 | H | H |
| Lₐ₂₆₅₂ | P11 | F | H | H | P20 | H | P9 | H | H |
| Lₐ₂₆₅₃ | P11 | F | H | H | P20 | H | P10 | H | H |
| Lₐ₂₆₅₄ | P11 | F | H | H | P20 | H | P11 | H | H |
| Lₐ₂₆₅₅ | P11 | F | H | H | P20 | H | P12 | H | H |
| Lₐ₂₆₅₆ | P11 | F | H | H | P20 | H | P13 | H | H |
| Lₐ₂₆₅₇ | P11 | F | H | H | P20 | H | P14 | H | H |
| Lₐ₂₆₅₈ | P11 | F | H | H | P20 | H | P15 | H | H |
| Lₐ₂₆₅₉ | P11 | F | H | H | P20 | H | P16 | H | H |
| Lₐ₂₆₆₀ | P11 | F | H | H | P20 | H | P17 | H | H |
| Lₐ₂₆₆₁ | P11 | F | H | H | P20 | H | P18 | H | H |
| Lₐ₂₆₆₂ | P11 | F | H | H | P20 | H | P19 | H | H |
| Lₐ₂₆₆₃ | P11 | F | H | H | P20 | H | P20 | H | H |
| Lₐ₂₆₆₄ | P11 | F | H | H | P20 | H | P21 | H | H |
| Lₐ₂₆₆₅ | P11 | F | H | H | P20 | H | H | P1 | H |
| Lₐ₂₆₆₆ | P11 | F | H | H | P20 | H | H | P2 | H |
| Lₐ₂₆₆₇ | P11 | F | H | H | P20 | H | H | P3 | H |
| Lₐ₂₆₆₈ | P11 | F | H | H | P20 | H | H | P4 | H |
| Lₐ₂₆₆₉ | P11 | F | H | H | P20 | H | H | P5 | H |
| Lₐ₂₆₇₀ | P11 | F | H | H | P20 | H | H | P6 | H |
| Lₐ₂₆₇₁ | P11 | F | H | H | P20 | H | H | P7 | H |
| Lₐ₂₆₇₂ | P11 | F | H | H | P20 | H | H | P8 | H |
| Lₐ₂₆₇₃ | P11 | F | H | H | P20 | H | H | P9 | H |
| Lₐ₂₆₇₄ | P11 | F | H | H | P20 | H | H | P10 | H |
| Lₐ₂₆₇₅ | P11 | F | H | H | P20 | H | H | P11 | H |
| Lₐ₂₆₇₆ | P11 | F | H | H | P20 | H | H | P12 | H |
| Lₐ₂₆₇₇ | P11 | F | H | H | P20 | H | H | P15 | H |
| Lₐ₂₆₇₈ | P11 | F | H | H | P20 | H | H | P17 | H |
| Lₐ₂₆₇₉ | P11 | F | H | H | P20 | H | H | P18 | H |
| Lₐ₂₆₈₀ | P11 | F | H | H | P20 | H | H | P19 | H |
| Lₐ₂₆₈₁ | P11 | F | H | H | P20 | H | H | P20 | H |
| Lₐ₂₆₈₂ | P11 | F | H | H | P20 | H | H | P21 | H |
| Lₐ₂₆₈₃ | P11 | F | H | H | P20 | H | F | H | H |
| Lₐ₂₆₈₄ | P11 | F | H | H | P20 | H | F | P1 | H |
| Lₐ₂₆₈₅ | P11 | F | H | H | P20 | H | F | P2 | H |
| Lₐ₂₆₈₆ | P11 | F | H | H | P20 | H | F | P3 | H |
| Lₐ₂₆₈₇ | P11 | F | H | H | P20 | H | F | P4 | H |
| Lₐ₂₆₈₈ | P11 | F | H | H | P20 | H | F | P5 | H |
| Lₐ₂₆₈₉ | P11 | F | H | H | P20 | H | F | P6 | H |
| Lₐ₂₆₉₀ | P11 | F | H | H | P20 | H | F | P7 | H |
| Lₐ₂₆₉₁ | P11 | F | H | H | P20 | H | F | P8 | H |
| Lₐ₂₆₉₂ | P11 | F | H | H | P20 | H | F | P9 | H |
| Lₐ₂₆₉₃ | P11 | F | H | H | P20 | H | F | P10 | H |
| Lₐ₂₆₉₄ | P11 | F | H | H | P20 | H | F | P11 | H |
| Lₐ₂₆₉₅ | P11 | F | H | H | P20 | H | P1 | F | H |
| Lₐ₂₆₉₆ | P11 | F | H | H | P20 | H | P2 | F | H |
| Lₐ₂₆₉₇ | P11 | F | H | H | P20 | H | P3 | F | H |
| Lₐ₂₆₉₈ | P11 | F | H | H | P20 | H | P4 | F | H |
| Lₐ₂₆₉₉ | P11 | F | H | H | P20 | H | P5 | F | H |
| Lₐ₂₇₀₀ | P11 | F | H | H | P20 | H | P6 | F | H |
| Lₐ₂₇₀₁ | P11 | F | H | H | P20 | H | P7 | F | H |
| Lₐ₂₇₀₂ | P11 | F | H | H | P20 | H | P8 | F | H |
| Lₐ₂₇₀₃ | P11 | F | H | H | P20 | H | P9 | F | H |
| Lₐ₂₇₀₄ | P11 | F | H | H | P20 | H | P10 | F | H |
| Lₐ₂₇₀₅ | P11 | F | H | H | P20 | H | P11 | F | H |
| Lₐ₂₇₀₆ | P11 | F | H | H | P20 | H | P1 | P1 | H |
| Lₐ₂₇₀₇ | P11 | F | H | H | P20 | H | P2 | P2 | H |
| Lₐ₂₇₀₈ | P11 | F | H | H | P20 | D | D | D | D |
| Lₐ₂₇₀₉ | P11 | F | H | H | P20 | D | P2 | P2 | D |
| Lₐ₂₇₁₀ | P11 | F | H | H | P20 | D | F | P4 | D |
| Lₐ₂₇₁₁ | P11 | F | H | H | P20 | D | F | P5 | D |
| Lₐ₂₇₁₂ | P11 | F | H | H | P20 | D | F | P9 | D |
| Lₐ₂₇₁₃ | P11 | F | H | H | P20 | D | F | P11 | D |
| Lₐ₂₇₁₄ | P11 | F | H | H | P21 | H | H | H | H |
| Lₐ₂₇₁₅ | P11 | F | H | H | P21 | H | P1 | H | H |
| Lₐ₂₇₁₆ | P11 | F | H | H | P21 | H | P2 | H | H |
| Lₐ₂₇₁₇ | P11 | F | H | H | P21 | H | P3 | H | H |
| Lₐ₂₇₁₈ | P11 | F | H | H | P21 | H | P4 | H | H |
| Lₐ₂₇₁₉ | P11 | F | H | H | P21 | H | P5 | H | H |
| Lₐ₂₇₂₀ | P11 | F | H | H | P21 | H | P6 | H | H |
| Lₐ₂₇₂₁ | P11 | F | H | H | P21 | H | P7 | H | H |
| Lₐ₂₇₂₂ | P11 | F | H | H | P21 | H | P8 | H | H |
| Lₐ₂₇₂₃ | P11 | F | H | H | P21 | H | P9 | H | H |
| Lₐ₂₇₂₄ | P11 | F | H | H | P21 | H | P10 | H | H |
| Lₐ₂₇₂₅ | P11 | F | H | H | P21 | H | P11 | H | H |
| Lₐ₂₇₂₆ | P11 | F | H | H | P21 | H | P12 | H | H |
| Lₐ₂₇₂₇ | P11 | F | H | H | P21 | H | P13 | H | H |
| Lₐ₂₇₂₈ | P11 | F | H | H | P21 | H | P14 | H | H |
| Lₐ₂₇₂₉ | P11 | F | H | H | P21 | H | P15 | H | H |
| Lₐ₂₇₃₀ | P11 | F | H | H | P21 | H | P16 | H | H |
| Lₐ₂₇₃₁ | P11 | F | H | H | P21 | H | P17 | H | H |
| Lₐ₂₇₃₂ | P11 | F | H | H | P21 | H | P18 | H | H |
| Lₐ₂₇₃₃ | P11 | F | H | H | P21 | H | P19 | H | H |
| Lₐ₂₇₃₄ | P11 | F | H | H | P21 | H | P20 | H | H |
| Lₐ₂₇₃₅ | P11 | F | H | H | P21 | H | P21 | H | H |
| Lₐ₂₇₃₆ | P11 | F | H | H | P21 | H | H | P1 | H |
| Lₐ₂₇₃₇ | P11 | F | H | H | P21 | H | H | P2 | H |
| Lₐ₂₇₃₈ | P11 | F | H | H | P21 | H | H | P3 | H |
| Lₐ₂₇₃₉ | P11 | F | H | H | P21 | H | H | P4 | H |
| Lₐ₂₇₄₀ | P11 | F | H | H | P21 | H | H | P5 | H |
| Lₐ₂₇₄₁ | P11 | F | H | H | P21 | H | H | P6 | H |
| Lₐ₂₇₄₂ | P11 | F | H | H | P21 | H | H | P7 | H |
| Lₐ₂₇₄₃ | P11 | F | H | H | P21 | H | H | P8 | H |
| Lₐ₂₇₄₄ | P11 | F | H | H | P21 | H | H | P9 | H |
| Lₐ₂₇₄₅ | P11 | F | H | H | P21 | H | H | P10 | H |
| Lₐ₂₇₄₆ | P11 | F | H | H | P21 | H | H | P11 | H |
| Lₐ₂₇₄₇ | P11 | F | H | H | P21 | H | H | P12 | H |
| Lₐ₂₇₄₈ | P11 | F | H | H | P21 | H | H | P15 | H |
| Lₐ₂₇₄₉ | P11 | F | H | H | P21 | H | H | P17 | H |
| Lₐ₂₇₅₀ | P11 | F | H | H | P21 | H | H | P18 | H |
| Lₐ₂₇₅₁ | P11 | F | H | H | P21 | H | H | P19 | H |
| Lₐ₂₇₅₂ | P11 | F | H | H | P21 | H | H | P20 | H |
| Lₐ₂₇₅₃ | P11 | F | H | H | P21 | H | H | P21 | H |
| Lₐ₂₇₅₄ | P11 | F | H | H | P21 | H | F | H | H |
| Lₐ₂₇₅₅ | P11 | F | H | H | P21 | H | F | P1 | H |
| Lₐ₂₇₅₆ | P11 | F | H | H | P21 | H | F | P2 | H |
| Lₐ₂₇₅₇ | P11 | F | H | H | P21 | H | F | P3 | H |
| Lₐ₂₇₅₈ | P11 | F | H | H | P21 | H | F | P4 | H |
| Lₐ₂₇₅₉ | P11 | F | H | H | P21 | H | F | P5 | H |
| Lₐ₂₇₆₀ | P11 | F | H | H | P21 | H | F | P6 | H |
| Lₐ₂₇₆₁ | P11 | F | H | H | P21 | H | F | P7 | H |
| Lₐ₂₇₆₂ | P11 | F | H | H | P21 | H | F | P8 | H |
| Lₐ₂₇₆₃ | P11 | F | H | H | P21 | H | F | P9 | H |
| Lₐ₂₇₆₄ | P11 | F | H | H | P21 | H | F | P10 | H |
| Lₐ₂₇₆₅ | P11 | F | H | H | P21 | H | F | P11 | H |
| Lₐ₂₇₆₆ | P11 | F | H | H | P21 | H | P1 | F | H |
| Lₐ₂₇₆₇ | P11 | F | H | H | P21 | H | P2 | F | H |
| Lₐ₂₇₆₈ | P11 | F | H | H | P21 | H | P3 | F | H |
| Lₐ₂₇₆₉ | P11 | F | H | H | P21 | H | P4 | F | H |
| Lₐ₂₇₇₀ | P11 | F | H | H | P21 | H | P5 | F | H |
| Lₐ₂₇₇₁ | P11 | F | H | H | P21 | H | P6 | F | H |
| Lₐ₂₇₇₂ | P11 | F | H | H | P21 | H | P7 | F | H |
| Lₐ₂₇₇₃ | P11 | F | H | H | P21 | H | P8 | F | H |
| Lₐ₂₇₇₄ | P11 | F | H | H | P21 | H | P9 | F | H |
| Lₐ₂₇₇₅ | P11 | F | H | H | P21 | H | P10 | F | H |
| Lₐ₂₇₇₆ | P11 | F | H | H | P21 | H | P11 | F | H |
| Lₐ₂₇₇₇ | P11 | F | H | H | P21 | H | P1 | P1 | H |
| Lₐ₂₇₇₈ | P11 | F | H | H | P21 | H | P2 | P2 | H |
| Lₐ₂₇₇₉ | P11 | F | H | H | P21 | D | D | D | D |
| Lₐ₂₇₈₀ | P11 | F | H | H | P21 | D | P2 | P2 | D |
| Lₐ₂₇₈₁ | P11 | F | H | H | P21 | D | F | P4 | D |
| Lₐ₂₇₈₂ | P11 | F | H | H | P21 | D | F | P5 | D |
| Lₐ₂₇₈₃ | P11 | F | H | H | P21 | D | F | P9 | D |
| Lₐ₂₇₈₄ | P11 | F | H | H | P21 | D | F | P11 | D |
| Lₐ₂₇₈₅ | P11 | F | H | H | P54 | H | H | H | H |
| Lₐ₂₇₈₆ | P11 | F | H | H | P54 | H | P1 | H | H |
| Lₐ₂₇₈₇ | P11 | F | H | H | P54 | H | P2 | H | H |
| Lₐ₂₇₈₈ | P11 | F | H | H | P54 | H | P3 | H | H |
| Lₐ₂₇₈₉ | P11 | F | H | H | P54 | H | P4 | H | H |
| Lₐ₂₇₉₀ | P11 | F | H | H | P54 | H | P5 | H | H |
| Lₐ₂₇₉₁ | P11 | F | H | H | P54 | H | P6 | H | H |
| Lₐ₂₇₉₂ | P11 | F | H | H | P54 | H | P7 | H | H |
| Lₐ₂₇₉₃ | P11 | F | H | H | P54 | H | P8 | H | H |
| Lₐ₂₇₉₄ | P11 | F | H | H | P54 | H | P9 | H | H |
| Lₐ₂₇₉₅ | P11 | F | H | H | P54 | H | P10 | H | H |
| Lₐ₂₇₉₆ | P11 | F | H | H | P54 | H | P11 | H | H |
| Lₐ₂₇₉₇ | P11 | F | H | H | P54 | H | P12 | H | H |
| Lₐ₂₇₉₈ | P11 | F | H | H | P54 | H | P13 | H | H |
| Lₐ₂₇₉₉ | P11 | F | H | H | P54 | H | P14 | H | H |
| Lₐ₂₈₀₀ | P11 | F | H | H | P54 | H | P15 | H | H |
| Lₐ₂₈₀₁ | P11 | F | H | H | P54 | H | P16 | H | H |
| Lₐ₂₈₀₂ | P11 | F | H | H | P54 | H | P17 | H | H |
| Lₐ₂₈₀₃ | P11 | F | H | H | P54 | H | P18 | H | H |
| Lₐ₂₈₀₄ | P11 | F | H | H | P54 | H | P19 | H | H |
| Lₐ₂₈₀₅ | P11 | F | H | H | P54 | H | P20 | H | H |
| Lₐ₂₈₀₆ | P11 | F | H | H | P54 | H | P21 | H | H |
| Lₐ₂₈₀₇ | P11 | F | H | H | P54 | H | H | P1 | H |
| Lₐ₂₈₀₈ | P11 | F | H | H | P54 | H | H | P2 | H |
| Lₐ₂₈₀₉ | P11 | F | H | H | P54 | H | H | P3 | H |
| Lₐ₂₈₁₀ | P11 | F | H | H | P54 | H | H | P4 | H |
| Lₐ₂₈₁₁ | P11 | F | H | H | P54 | H | H | P5 | H |
| Lₐ₂₈₁₂ | P11 | F | H | H | P54 | H | H | P6 | H |
| Lₐ₂₈₁₃ | P11 | F | H | H | P54 | H | H | P7 | H |
| Lₐ₂₈₁₄ | P11 | F | H | H | P54 | H | H | P8 | H |
| Lₐ₂₈₁₅ | P11 | F | H | H | P54 | H | H | P9 | H |
| Lₐ₂₈₁₆ | P11 | F | H | H | P54 | H | H | P10 | H |
| Lₐ₂₈₁₇ | P11 | F | H | H | P54 | H | H | P11 | H |
| Lₐ₂₈₁₈ | P11 | F | H | H | P54 | H | H | P12 | H |
| Lₐ₂₈₁₉ | P11 | F | H | H | P54 | H | H | P15 | H |
| Lₐ₂₈₂₀ | P11 | F | H | H | P54 | H | H | P17 | H |
| Lₐ₂₈₂₁ | P11 | F | H | H | P54 | H | H | P18 | H |
| Lₐ₂₈₂₂ | P11 | F | H | H | P54 | H | H | P19 | H |
| Lₐ₂₈₂₃ | P11 | F | H | H | P54 | H | H | P20 | H |
| Lₐ₂₈₂₄ | P11 | F | H | H | P54 | H | H | P21 | H |
| Lₐ₂₈₂₅ | P11 | F | H | H | P54 | H | F | H | H |
| Lₐ₂₈₂₆ | P11 | F | H | H | P54 | H | F | P1 | H |
| Lₐ₂₈₂₇ | P11 | F | H | H | P54 | H | F | P2 | H |
| Lₐ₂₈₂₈ | P11 | F | H | H | P54 | H | F | P3 | H |
| Lₐ₂₈₂₉ | P11 | F | H | H | P54 | H | F | P4 | H |
| Lₐ₂₈₃₀ | P11 | F | H | H | P54 | H | F | P5 | H |
| Lₐ₂₈₃₁ | P11 | F | H | H | P54 | H | F | P6 | H |
| Lₐ₂₈₃₂ | P11 | F | H | H | P54 | H | F | P7 | H |
| Lₐ₂₈₃₃ | P11 | F | H | H | P54 | H | F | P8 | H |
| Lₐ₂₈₃₄ | P11 | F | H | H | P54 | H | F | P9 | H |
| Lₐ₂₈₃₅ | P11 | F | H | H | P54 | H | F | P10 | H |
| Lₐ₂₈₃₆ | P11 | F | H | H | P54 | H | F | P11 | H |
| Lₐ₂₈₃₇ | P11 | F | H | H | P54 | H | P1 | F | H |
| Lₐ₂₈₃₈ | P11 | F | H | H | P54 | H | P2 | F | H |
| Lₐ₂₈₃₉ | P11 | F | H | H | P54 | H | P3 | F | H |
| Lₐ₂₈₄₀ | P11 | F | H | H | P54 | H | P4 | F | H |
| Lₐ₂₈₄₁ | P11 | F | H | H | P54 | H | P5 | F | H |
| Lₐ₂₈₄₂ | P11 | F | H | H | P54 | H | P6 | F | H |
| Lₐ₂₈₄₃ | P11 | F | H | H | P54 | H | P7 | F | H |
| Lₐ₂₈₄₄ | P11 | F | H | H | P54 | H | P8 | F | H |
| Lₐ₂₈₄₅ | P11 | F | H | H | P54 | H | P9 | F | H |
| Lₐ₂₈₄₆ | P11 | F | H | H | P54 | H | P10 | F | H |
| Lₐ₂₈₄₇ | P11 | F | H | H | P54 | H | P11 | F | H |
| Lₐ₂₈₄₈ | P11 | F | H | H | P54 | H | P1 | P1 | H |
| Lₐ₂₈₄₉ | P11 | F | H | H | P54 | H | P2 | P2 | H |
| Lₐ₂₈₅₀ | P11 | F | H | H | P54 | D | D | D | D |
| Lₐ₂₈₅₁ | P11 | F | H | H | P54 | D | P2 | P2 | D |
| Lₐ₂₈₅₂ | P11 | F | H | H | P54 | D | F | P4 | D |
| Lₐ₂₈₅₃ | P11 | F | H | H | P54 | D | F | P5 | D |
| Lₐ₂₈₅₄ | P11 | F | H | H | P54 | D | F | P9 | D |
| Lₐ₂₈₅₅ | P11 | F | H | H | P54 | D | F | P11 | D |
| Lₐ₂₈₅₆ | P11 | F | H | H | P96 | H | H | H | H |
| Lₐ₂₈₅₇ | P11 | F | H | H | P96 | H | P1 | H | H |
| Lₐ₂₈₅₈ | P11 | F | H | H | P96 | H | P2 | H | H |
| Lₐ₂₈₅₉ | P11 | F | H | H | P96 | H | P3 | H | H |
| Lₐ₂₈₆₀ | P11 | F | H | H | P96 | H | P4 | H | H |
| Lₐ₂₈₆₁ | P11 | F | H | H | P96 | H | P5 | H | H |
| Lₐ₂₈₆₂ | P11 | F | H | H | P96 | H | P6 | H | H |
| Lₐ₂₈₆₃ | P11 | F | H | H | P96 | H | P7 | H | H |
| Lₐ₂₈₆₄ | P11 | F | H | H | P96 | H | P8 | H | H |
| Lₐ₂₈₆₅ | P11 | F | H | H | P96 | H | P9 | H | H |
| Lₐ₂₈₆₆ | P11 | F | H | H | P96 | H | P10 | H | H |
| Lₐ₂₈₆₇ | P11 | F | H | H | P96 | H | P11 | H | H |
| Lₐ₂₈₆₈ | P11 | F | H | H | P96 | H | P12 | H | H |
| Lₐ₂₈₆₉ | P11 | F | H | H | P96 | H | P13 | H | H |
| Lₐ₂₈₇₀ | P11 | F | H | H | P96 | H | P14 | H | H |
| Lₐ₂₈₇₁ | P11 | F | H | H | P96 | H | P15 | H | H |
| Lₐ₂₈₇₂ | P11 | F | H | H | P96 | H | P16 | H | H |
| Lₐ₂₈₇₃ | P11 | F | H | H | P96 | H | P17 | H | H |
| Lₐ₂₈₇₄ | P11 | F | H | H | P96 | H | P18 | H | H |
| Lₐ₂₈₇₅ | P11 | F | H | H | P96 | H | P19 | H | H |
| Lₐ₂₈₇₆ | P11 | F | H | H | P96 | H | P20 | H | H |
| Lₐ₂₈₇₇ | P11 | F | H | H | P96 | H | P21 | H | H |
| Lₐ₂₈₇₈ | P11 | F | H | H | P96 | H | H | P1 | H |
| Lₐ₂₈₇₉ | P11 | F | H | H | P96 | H | H | P2 | H |
| Lₐ₂₈₈₀ | P11 | F | H | H | P96 | H | H | P3 | H |
| Lₐ₂₈₈₁ | P11 | F | H | H | P96 | H | H | P4 | H |
| Lₐ₂₈₈₂ | P11 | F | H | H | P96 | H | H | P5 | H |
| Lₐ₂₈₈₃ | P11 | F | H | H | P96 | H | H | P6 | H |
| Lₐ₂₈₈₄ | P11 | F | H | H | P96 | H | H | P7 | H |
| Lₐ₂₈₈₅ | P11 | F | H | H | P96 | H | H | P8 | H |
| Lₐ₂₈₈₆ | P11 | F | H | H | P96 | H | H | P9 | H |
| Lₐ₂₈₈₇ | P11 | F | H | H | P96 | H | H | P10 | H |
| Lₐ₂₈₈₈ | P11 | F | H | H | P96 | H | H | P11 | H |
| Lₐ₂₈₈₉ | P11 | F | H | H | P96 | H | H | P12 | H |
| Lₐ₂₈₉₀ | P11 | F | H | H | P96 | H | H | P15 | H |
| Lₐ₂₈₉₁ | P11 | F | H | H | P96 | H | H | P17 | H |
| Lₐ₂₈₉₂ | P11 | F | H | H | P96 | H | H | P18 | H |
| Lₐ₂₈₉₃ | P11 | F | H | H | P96 | H | H | P19 | H |
| Lₐ₂₈₉₄ | P11 | F | H | H | P96 | H | H | P20 | H |
| Lₐ₂₈₉₅ | P11 | F | H | H | P96 | H | H | P21 | H |
| Lₐ₂₈₉₆ | P11 | F | H | H | P96 | H | F | H | H |
| Lₐ₂₈₉₇ | P11 | F | H | H | P96 | H | F | P1 | H |
| Lₐ₂₈₉₈ | P11 | F | H | H | P96 | H | F | P2 | H |
| Lₐ₂₈₉₉ | P11 | F | H | H | P96 | H | F | P3 | H |
| Lₐ₂₉₀₀ | P11 | F | H | H | P96 | H | F | P4 | H |
| Lₐ₂₉₀₁ | P11 | F | H | H | P96 | H | F | P5 | H |
| Lₐ₂₉₀₂ | P11 | F | H | H | P96 | H | F | P6 | H |
| Lₐ₂₉₀₃ | P11 | F | H | H | P96 | H | F | P7 | H |
| Lₐ₂₉₀₄ | P11 | F | H | H | P96 | H | F | P8 | H |
| Lₐ₂₉₀₅ | P11 | F | H | H | P96 | H | F | P9 | H |
| Lₐ₂₉₀₆ | P11 | F | H | H | P96 | H | F | P10 | H |
| Lₐ₂₉₀₇ | P11 | F | H | H | P96 | H | F | P11 | H |
| Lₐ₂₉₀₈ | P11 | F | H | H | P96 | H | P1 | F | H |
| Lₐ₂₉₀₉ | P11 | F | H | H | P96 | H | P2 | F | H |
| Lₐ₂₉₁₀ | P11 | F | H | H | P96 | H | P3 | F | H |
| Lₐ₂₉₁₁ | P11 | F | H | H | P96 | H | P4 | F | H |
| Lₐ₂₉₁₂ | P11 | F | H | H | P96 | H | P5 | F | H |
| Lₐ₂₉₁₃ | P11 | F | H | H | P96 | H | P6 | F | H |
| Lₐ₂₉₁₄ | P11 | F | H | H | P96 | H | P7 | F | H |
| Lₐ₂₉₁₅ | P11 | F | H | H | P96 | H | P8 | F | H |
| Lₐ₂₉₁₆ | P11 | F | H | H | P96 | H | P9 | F | H |
| Lₐ₂₉₁₇ | P11 | F | H | H | P96 | H | P10 | F | H |
| Lₐ₂₉₁₈ | P11 | F | H | H | P96 | H | P11 | F | H |
| Lₐ₂₉₁₉ | P11 | F | H | H | P96 | H | P1 | P1 | H |
| Lₐ₂₉₂₀ | P11 | F | H | H | P96 | H | P2 | P2 | H |
| Lₐ₂₉₂₁ | P11 | F | H | H | P96 | D | D | D | D |
| Lₐ₂₉₂₂ | P11 | F | H | H | P96 | D | P2 | P2 | D |
| Lₐ₂₉₂₃ | P11 | F | H | H | P96 | D | F | P4 | D |
| Lₐ₂₉₂₄ | P11 | F | H | H | P96 | D | F | P5 | D |
| Lₐ₂₉₂₅ | P11 | F | H | H | P96 | D | F | P9 | D |
| Lₐ₂₉₂₆ | P11 | F | H | H | P96 | D | F | P11 | D |
| Lₐ₂₉₂₇ | P11 | F | H | H | P97 | H | H | H | H |
| Lₐ₂₉₂₈ | P11 | F | H | H | P97 | H | P1 | H | H |
| Lₐ₂₉₂₉ | P11 | F | H | H | P97 | H | P2 | H | H |
| Lₐ₂₉₃₀ | P11 | F | H | H | P97 | H | P3 | H | H |
| Lₐ₂₉₃₁ | P11 | F | H | H | P97 | H | P4 | H | H |
| Lₐ₂₉₃₂ | P11 | F | H | H | P97 | H | P5 | H | H |
| Lₐ₂₉₃₃ | P11 | F | H | H | P97 | H | P6 | H | H |
| Lₐ₂₉₃₄ | P11 | F | H | H | P97 | H | P7 | H | H |
| Lₐ₂₉₃₅ | P11 | F | H | H | P97 | H | P8 | H | H |
| Lₐ₂₉₃₆ | P11 | F | H | H | P97 | H | P9 | H | H |
| Lₐ₂₉₃₇ | P11 | F | H | H | P97 | H | P10 | H | H |
| Lₐ₂₉₃₈ | P11 | F | H | H | P97 | H | P11 | H | H |
| Lₐ₂₉₃₉ | P11 | F | H | H | P97 | H | P12 | H | H |
| Lₐ₂₉₄₀ | P11 | F | H | H | P97 | H | P13 | H | H |
| Lₐ₂₉₄₁ | P11 | F | H | H | P97 | H | P14 | H | H |
| Lₐ₂₉₄₂ | P11 | F | H | H | P97 | H | P15 | H | H |
| Lₐ₂₉₄₃ | P11 | F | H | H | P97 | H | P16 | H | H |
| Lₐ₂₉₄₄ | P11 | F | H | H | P97 | H | P17 | H | H |
| Lₐ₂₉₄₅ | P11 | F | H | H | P97 | H | P18 | H | H |
| Lₐ₂₉₄₆ | P11 | F | H | H | P97 | H | P19 | H | H |
| Lₐ₂₉₄₇ | P11 | F | H | H | P97 | H | P20 | H | H |
| Lₐ₂₉₄₈ | P11 | F | H | H | P97 | H | P21 | H | H |
| Lₐ₂₉₄₉ | P11 | F | H | H | P97 | H | H | P1 | H |
| Lₐ₂₉₅₀ | P11 | F | H | H | P97 | H | H | P2 | H |
| Lₐ₂₉₅₁ | P11 | F | H | H | P97 | H | H | P3 | H |
| Lₐ₂₉₅₂ | P11 | F | H | H | P97 | H | H | P4 | H |
| Lₐ₂₉₅₃ | P11 | F | H | H | P97 | H | H | P5 | H |
| Lₐ₂₉₅₄ | P11 | F | H | H | P97 | H | H | P6 | H |
| Lₐ₂₉₅₅ | P11 | F | H | H | P97 | H | H | P7 | H |
| Lₐ₂₉₅₆ | P11 | F | H | H | P97 | H | H | P8 | H |
| Lₐ₂₉₅₇ | P11 | F | H | H | P97 | H | H | P9 | H |
| Lₐ₂₉₅₈ | P11 | F | H | H | P97 | H | H | P10 | H |
| Lₐ₂₉₅₉ | P11 | F | H | H | P97 | H | H | P11 | H |
| Lₐ₂₉₆₀ | P11 | F | H | H | P97 | H | H | P12 | H |
| Lₐ₂₉₆₁ | P11 | F | H | H | P97 | H | H | P15 | H |
| Lₐ₂₉₆₂ | P11 | F | H | H | P97 | H | H | P17 | H |
| Lₐ₂₉₆₃ | P11 | F | H | H | P97 | H | H | P18 | H |
| Lₐ₂₉₆₄ | P11 | F | H | H | P97 | H | H | P19 | H |
| Lₐ₂₉₆₅ | P11 | F | H | H | P97 | H | H | P20 | H |
| Lₐ₂₉₆₆ | P11 | F | H | H | P97 | H | H | P21 | H |
| Lₐ₂₉₆₇ | P11 | F | H | H | P97 | H | F | H | H |
| Lₐ₂₉₆₈ | P11 | F | H | H | P97 | H | F | P1 | H |
| Lₐ₂₉₆₉ | P11 | F | H | H | P97 | H | F | P2 | H |
| Lₐ₂₉₇₀ | P11 | F | H | H | P97 | H | F | P3 | H |
| Lₐ₂₉₇₁ | P11 | F | H | H | P97 | H | F | P4 | H |
| Lₐ₂₉₇₂ | P11 | F | H | H | P97 | H | F | P5 | H |
| Lₐ₂₉₇₃ | P11 | F | H | H | P97 | H | F | P6 | H |
| Lₐ₂₉₇₄ | P11 | F | H | H | P97 | H | F | P7 | H |
| Lₐ₂₉₇₅ | P11 | F | H | H | P97 | H | F | P8 | H |
| Lₐ₂₉₇₆ | P11 | F | H | H | P97 | H | F | P9 | H |
| Lₐ₂₉₇₇ | P11 | F | H | H | P97 | H | F | P10 | H |
| Lₐ₂₉₇₈ | P11 | F | H | H | P97 | H | F | P11 | H |
| Lₐ₂₉₇₉ | P11 | F | H | H | P97 | H | P1 | F | H |
| Lₐ₂₉₈₀ | P11 | F | H | H | P97 | H | P2 | F | H |
| Lₐ₂₉₈₁ | P11 | F | H | H | P97 | H | P3 | F | H |
| Lₐ₂₉₈₂ | P11 | F | H | H | P97 | H | P4 | F | H |
| Lₐ₂₉₈₃ | P11 | F | H | H | P97 | H | P5 | F | H |
| Lₐ₂₉₈₄ | P11 | F | H | H | P97 | H | P6 | F | H |
| Lₐ₂₉₈₅ | P11 | F | H | H | P97 | H | P7 | F | H |
| Lₐ₂₉₈₆ | P11 | F | H | H | P97 | H | P8 | F | H |
| Lₐ₂₉₈₇ | P11 | F | H | H | P97 | H | P9 | F | H |
| Lₐ₂₉₈₈ | P11 | F | H | H | P97 | H | P10 | F | H |
| Lₐ₂₉₈₉ | P11 | F | H | H | P97 | H | P11 | F | H |
| Lₐ₂₉₉₀ | P11 | F | H | H | P97 | H | P1 | P1 | H |
| Lₐ₂₉₉₁ | P11 | F | H | H | P97 | H | P2 | P2 | H |
| Lₐ₂₉₉₂ | P11 | F | H | H | P97 | D | D | D | D |
| Lₐ₂₉₉₃ | P11 | F | H | H | P97 | D | P2 | P2 | D |
| Lₐ₂₉₉₄ | P11 | F | H | H | P97 | D | F | P4 | D |
| Lₐ₂₉₉₅ | P11 | F | H | H | P97 | D | F | P5 | D |
| Lₐ₂₉₉₆ | P11 | F | H | H | P97 | D | F | P9 | D |
| Lₐ₂₉₉₇ | P11 | F | H | H | P97 | D | F | P11 | D |
| Lₐ₂₉₉₈ | P11 | F | H | H | P102 | H | P1 | H | H |
| Lₐ₂₉₉₉ | P11 | F | H | H | P102 | H | P2 | H | H |
| Lₐ₃₀₀₀ | P11 | F | H | H | P102 | H | P3 | H | H |
| Lₐ₃₀₀₁ | P11 | F | H | H | P102 | H | P4 | H | H |
| Lₐ₃₀₀₂ | P11 | F | H | H | P102 | H | P5 | H | H |
| Lₐ₃₀₀₃ | P11 | F | H | H | P102 | H | P6 | H | H |
| Lₐ₃₀₀₄ | P11 | F | H | H | P102 | H | P7 | H | H |
| Lₐ₃₀₀₅ | P11 | F | H | H | P102 | H | P8 | H | H |
| Lₐ₃₀₀₆ | P11 | F | H | H | P102 | H | P9 | H | H |
| Lₐ₃₀₀₇ | P11 | F | H | H | P102 | H | P10 | H | H |
| Lₐ₃₀₀₈ | P11 | F | H | H | P102 | H | P11 | H | H |
| Lₐ₃₀₀₉ | P11 | F | H | H | P102 | H | P12 | H | H |
| Lₐ₃₀₁₀ | P11 | F | H | H | P102 | H | P13 | H | H |
| Lₐ₃₀₁₁ | P11 | F | H | H | P102 | H | P14 | H | H |
| Lₐ₃₀₁₂ | P11 | F | H | H | P102 | H | P15 | H | H |
| Lₐ₃₀₁₃ | P11 | F | H | H | P102 | H | P16 | H | H |
| Lₐ₃₀₁₄ | P11 | F | H | H | P102 | H | P17 | H | H |
| Lₐ₃₀₁₅ | P11 | F | H | H | P102 | H | P18 | H | H |
| Lₐ₃₀₁₆ | P11 | F | H | H | P102 | H | P19 | H | H |
| Lₐ₃₀₁₇ | P11 | F | H | H | P102 | H | P20 | H | H |
| Lₐ₃₀₁₈ | P11 | F | H | H | P102 | H | P21 | H | H |
| Lₐ₃₀₁₉ | P11 | F | H | H | P102 | H | H | P1 | H |
| Lₐ₃₀₂₀ | P11 | F | H | H | P102 | H | H | P2 | H |
| Lₐ₃₀₂₁ | P11 | F | H | H | P102 | H | H | P3 | H |
| Lₐ₃₀₂₂ | P11 | F | H | H | P102 | H | H | P4 | H |
| Lₐ₃₀₂₃ | P11 | F | H | H | P102 | H | H | P5 | H |
| Lₐ₃₀₂₄ | P11 | F | H | H | P102 | H | H | P6 | H |
| Lₐ₃₀₀₆ | P11 | F | H | H | P102 | H | H | P7 | H |
| Lₐ₃₀₂₆ | P11 | F | H | H | P102 | H | H | P8 | H |
| Lₐ₃₀₂₇ | P11 | F | H | H | P102 | H | H | P9 | H |
| Lₐ₃₀₂₈ | P11 | F | H | H | P102 | H | H | P10 | H |
| Lₐ₃₀₂₉ | P11 | F | H | H | P102 | H | H | P11 | H |
| Lₐ₃₀₃₀ | P11 | F | H | H | P102 | H | H | P12 | H |
| Lₐ₃₀₃₁ | P11 | F | H | H | P102 | H | H | P15 | H |
| Lₐ₃₀₃₂ | P11 | F | H | H | P102 | H | H | P17 | H |
| Lₐ₃₀₃₃ | P11 | F | H | H | P102 | H | H | P18 | H |
| Lₐ₃₀₃₄ | P11 | F | H | H | P102 | H | H | P19 | H |
| Lₐ₃₀₃₅ | P11 | F | H | H | P102 | H | H | P20 | H |
| Lₐ₃₀₃₆ | P11 | F | H | H | P102 | H | H | P21 | H |
| Lₐ₃₀₃₇ | P11 | F | H | H | P102 | H | F | H | H |
| Lₐ₃₀₃₈ | P11 | F | H | H | P102 | H | F | P1 | H |
| Lₐ₃₀₃₉ | P11 | F | H | H | P102 | H | F | P2 | H |
| Lₐ₃₀₄₀ | P11 | F | H | H | P102 | H | F | P3 | H |
| Lₐ₃₀₄₁ | P11 | F | H | H | P102 | H | F | P4 | H |
| Lₐ₃₀₄₂ | P11 | F | H | H | P102 | H | F | P5 | H |
| Lₐ₃₀₄₃ | P11 | F | H | H | P102 | H | F | P6 | H |
| Lₐ₃₀₄₄ | P11 | F | H | H | P102 | H | F | P7 | H |
| Lₐ₃₀₄₅ | P11 | F | H | H | P102 | H | F | P8 | H |
| Lₐ₃₀₄₆ | P11 | F | H | H | P102 | H | F | P9 | H |
| Lₐ₃₀₄₇ | P11 | F | H | H | P102 | H | F | P10 | H |
| Lₐ₃₀₄₈ | P11 | F | H | H | P102 | H | F | P11 | H |
| Lₐ₃₀₄₉ | P11 | F | H | H | P102 | H | P1 | F | H |
| Lₐ₃₀₅₀ | P11 | F | H | H | P102 | H | P2 | F | H |
| Lₐ₃₀₅₁ | P11 | F | H | H | P102 | H | P3 | F | H |
| Lₐ₃₀₅₂ | P11 | F | H | H | P102 | H | P4 | F | H |
| Lₐ₃₀₅₃ | P11 | F | H | H | P102 | H | P5 | F | H |
| Lₐ₃₀₅₄ | P11 | F | H | H | P102 | H | P6 | F | H |
| Lₐ₃₀₅₅ | P11 | F | H | H | P102 | H | P7 | F | H |
| Lₐ₃₀₅₆ | P11 | F | H | H | P102 | H | P8 | F | H |
| Lₐ₃₀₅₇ | P11 | F | H | H | P102 | H | P9 | F | H |
| Lₐ₃₀₅₅ | P11 | F | H | H | P102 | H | P10 | F | H |
| Lₐ₃₀₅₉ | P11 | F | H | H | P102 | H | P11 | F | H |
| Lₐ₃₀₆₀ | P11 | F | H | H | P102 | H | P1 | P1 | H |
| Lₐ₃₀₆₁ | P11 | F | H | H | P102 | H | P2 | P2 | H |
| Lₐ₃₀₆₂ | P11 | F | H | H | P102 | D | D | D | D |
| Lₐ₃₀₆₃ | P11 | F | H | H | P102 | D | P2 | P2 | D |
| Lₐ₃₀₆₄ | P11 | F | H | H | P102 | D | F | P4 | D |
| Lₐ₃₀₅₅ | P11 | F | H | H | P102 | D | F | P5 | D |
| Lₐ₃₀₆₆ | P11 | F | H | H | P102 | D | F | P9 | D |
| Lₐ₃₀₆₇ | P11 | F | H | H | P102 | D | F | P11 | D |
| Lₐ₃₀₆₈ | P11 | F | H | H | P103 | H | P1 | H | H |
| Lₐ₃₀₆₉ | P11 | F | H | H | P103 | H | P2 | H | H |
| Lₐ₃₀₇₀ | P11 | F | H | H | P103 | H | P3 | H | H |
| Lₐ₃₀₇₁ | P11 | F | H | H | P103 | H | P4 | H | H |
| Lₐ₃₀₇₂ | P11 | F | H | H | P103 | H | P5 | H | H |
| Lₐ₃₀₇₃ | P11 | F | H | H | P103 | H | P6 | H | H |
| Lₐ₃₀₇₄ | P11 | F | H | H | P103 | H | P7 | H | H |
| Lₐ₃₀₇₅ | P11 | F | H | H | P103 | H | P8 | H | H |
| Lₐ₃₀₇₆ | P11 | F | H | H | P103 | H | P9 | H | H |
| Lₐ₃₀₇₇ | P11 | F | H | H | P103 | H | P10 | H | H |
| Lₐ₃₀₇₈ | P11 | F | H | H | P103 | H | P11 | H | H |
| Lₐ₃₀₇₉ | P11 | F | H | H | P103 | H | P12 | H | H |
| Lₐ₃₀₈₀ | P11 | F | H | H | P103 | H | P13 | H | H |
| Lₐ₃₀₈₁ | P11 | F | H | H | P103 | H | P14 | H | H |
| Lₐ₃₀₈₂ | P11 | F | H | H | P103 | H | P15 | H | H |
| Lₐ₃₀₈₃ | P11 | F | H | H | P103 | H | P16 | H | H |
| Lₐ₃₀₈₄ | P11 | F | H | H | P103 | H | P17 | H | H |
| Lₐ₃₀₅₅ | P11 | F | H | H | P103 | H | P18 | H | H |
| Lₐ₃₀₈₆ | P11 | F | H | H | P103 | H | P19 | H | H |
| Lₐ₃₀₈₇ | P11 | F | H | H | P103 | H | P20 | H | H |
| Lₐ₃₀₅₅ | P11 | F | H | H | P103 | H | P21 | H | H |
| Lₐ₃₀₈₉ | P11 | F | H | H | P103 | H | H | P1 | H |
| Lₐ₃₀₉₀ | P11 | F | H | H | P103 | H | H | P2 | H |
| Lₐ₃₀₉₁ | P11 | F | H | H | P103 | H | H | P3 | H |
| Lₐ₃₀₉₂ | P11 | F | H | H | P103 | H | H | P4 | H |
| Lₐ₃₀₉₃ | P11 | F | H | H | P103 | H | H | P5 | H |
| Lₐ₃₀₉₄ | P11 | F | H | H | P103 | H | H | P6 | H |
| Lₐ₃₀₉₅ | P11 | F | H | H | P103 | H | H | P7 | H |
| Lₐ₃₀₉₆ | P11 | F | H | H | P103 | H | H | P8 | H |
| Lₐ₃₀₉₇ | P11 | F | H | H | P103 | H | H | P9 | H |
| Lₐ₃₀₉₈ | P11 | F | H | H | P103 | H | H | P10 | H |
| Lₐ₃₀₉₉ | P11 | F | H | H | P103 | H | H | P11 | H |
| Lₐ₃₁₀₀ | P11 | F | H | H | P103 | H | H | P12 | H |
| Lₐ₃₁₀₁ | P11 | F | H | H | P103 | H | H | P15 | H |
| Lₐ₃₁₀₂ | P11 | F | H | H | P103 | H | H | P17 | H |
| Lₐ₃₀₀₆ | P11 | F | H | H | P103 | H | H | P18 | H |
| Lₐ₃₁₀₄ | P11 | F | H | H | P103 | H | H | P19 | H |
| Lₐ₃₀₀₆ | P11 | F | H | H | P103 | H | H | P20 | H |
| Lₐ₃₁₀₆ | P11 | F | H | H | P103 | H | H | P21 | H |
| Lₐ₃₁₀₇ | P11 | F | H | H | P103 | H | F | H | H |
| Lₐ₃₁₀₈ | P11 | F | H | H | P103 | H | F | P1 | H |
| Lₐ₃₁₀₉ | P11 | F | H | H | P103 | H | F | P2 | H |
| Lₐ₃₁₁₀ | P11 | F | H | H | P103 | H | F | P3 | H |
| Lₐ₃₁₁₁ | P11 | F | H | H | P103 | H | F | P4 | H |
| Lₐ₃₁₁₂ | P11 | F | H | H | P103 | H | F | P5 | H |
| Lₐ₃₁₁₃ | P11 | F | H | H | P103 | H | F | P6 | H |
| Lₐ₃₁₁₄ | P11 | F | H | H | P103 | H | F | P7 | H |
| Lₐ₃₁₁₅ | P11 | F | H | H | P103 | H | F | P8 | H |
| Lₐ₃₁₁₆ | P11 | F | H | H | P103 | H | F | P9 | H |
| Lₐ₃₁₁₇ | P11 | F | H | H | P103 | H | F | P10 | H |
| Lₐ₃₁₁₈ | P11 | F | H | H | P103 | H | F | P11 | H |
| Lₐ₃₁₁₉ | P11 | F | H | H | P103 | H | P1 | F | H |
| Lₐ₃₁₂₀ | P11 | F | H | H | P103 | H | P2 | F | H |
| Lₐ₃₁₂₁ | P11 | F | H | H | P103 | H | P3 | F | H |
| Lₐ₃₁₂₂ | P11 | F | H | H | P103 | H | P4 | F | H |
| Lₐ₃₁₂₃ | P11 | F | H | H | P103 | H | P5 | F | H |
| Lₐ₃₁₂₄ | P11 | F | H | H | P103 | H | P6 | F | H |
| Lₐ₃₁₂₅ | P11 | F | H | H | P103 | H | P7 | F | H |
| Lₐ₃₁₂₆ | P11 | F | H | H | P103 | H | P8 | F | H |
| Lₐ₃₁₂₇ | P11 | F | H | H | P103 | H | P9 | F | H |
| Lₐ₃₁₂₈ | P11 | F | H | H | P103 | H | P10 | F | H |
| Lₐ₃₁₂₉ | P11 | F | H | H | P103 | H | P11 | F | H |
| Lₐ₃₁₃₀ | P11 | F | H | H | P103 | H | P1 | P1 | H |
| Lₐ₃₁₃₁ | P11 | F | H | H | P103 | H | P2 | P2 | H |
| Lₐ₃₁₃₂ | P11 | F | H | H | P103 | D | D | D | D |
| Lₐ₃₁₃₃ | P11 | F | H | H | P103 | D | P2 | P2 | D |
| Lₐ₃₁₃₄ | P11 | F | H | H | P103 | D | F | P4 | D |
| Lₐ₃₁₃₅ | P11 | F | H | H | P103 | D | F | P5 | D |
| Lₐ₃₁₃₆ | P11 | F | H | H | P103 | D | F | P9 | D |
| Lₐ₃₁₃₇ | P11 | F | H | H | P103 | D | F | P11 | D |
| Lₐ₃₁₃₈ | P11 | F | H | H | H | H | P20 | P1 | H |
| Lₐ₃₁₃₉ | P11 | F | H | H | H | H | P21 | P2 | H |
| Lₐ₃₁₄₀ | P11 | F | H | H | H | H | P29 | H | H |
| Lₐ₃₁₄₁ | P11 | F | H | H | H | H | P29 | P1 | H |
| Lₐ₃₁₄₂ | P11 | F | H | H | H | H | P54 | H | H |
| Lₐ₃₁₄₃ | P11 | F | H | H | H | H | P96 | H | H |
| Lₐ₃₁₄₄ | P11 | F | H | H | H | H | P97 | H | H |
| Lₐ₃₁₄₅ | P11 | F | H | H | H | H | P96 | P1 | H |
| Lₐ₃₁₄₆ | P11 | F | H | H | H | H | P97 | P1 | H |
| Lₐ₃₁₄₇ | P11 | F | H | H | H | H | P102 | H | H |
| Lₐ₃₁₄₈ | P11 | F | H | H | H | H | P103 | H | H |
| Lₐ₃₁₄₉ | P11 | F | H | H | D | H | P20 | P1 | H |
| Lₐ₃₁₅₀ | P11 | F | H | H | D | H | P21 | P2 | H |
| Lₐ₃₁₅₁ | P11 | F | H | H | D | H | P29 | H | H |
| Lₐ₃₁₅₂ | P11 | F | H | H | D | H | P29 | P1 | H |
| Lₐ₃₁₅₃ | P11 | F | H | H | D | H | P54 | H | H |
| Lₐ₃₁₅₄ | P11 | F | H | H | D | H | P96 | H | H |
| Lₐ₃₁₅₅ | P11 | F | H | H | D | H | P97 | H | H |
| Lₐ₃₁₅₆ | P11 | F | H | H | D | H | P96 | P1 | H |
| Lₐ₃₁₅₇ | P11 | F | H | H | D | H | P97 | P1 | H |
| Lₐ₃₁₅₈ | P11 | F | H | H | D | H | P102 | H | H |
| Lₐ₃₁₅₉ | P11 | F | H | H | D | H | P103 | H | H |
| Lₐ₃₁₆₀ | P11 | F | H | H | P20 | H | P20 | P1 | H |
| Lₐ₃₁₆₁ | P11 | F | H | H | P20 | H | P21 | P2 | H |
| Lₐ₃₁₆₂ | P11 | F | H | H | P20 | H | P29 | H | H |
| Lₐ₃₁₆₃ | P11 | F | H | H | P20 | H | P29 | P1 | H |
| Lₐ₃₁₆₄ | P11 | F | H | H | P20 | H | P54 | H | H |
| Lₐ₃₁₆₅ | P11 | F | H | H | P20 | H | P96 | H | H |
| Lₐ₃₁₆₆ | P11 | F | H | H | P20 | H | P97 | H | H |
| Lₐ₃₁₆₇ | P11 | F | H | H | P20 | H | P96 | P1 | H |
| Lₐ₃₁₆₈ | P11 | F | H | H | P20 | H | P97 | P1 | H |
| Lₐ₃₁₆₉ | P11 | F | H | H | P20 | H | P102 | H | H |
| Lₐ₃₁₇₀ | P11 | F | H | H | P20 | H | P103 | H | H |
| Lₐ₃₁₇₁ | P11 | F | H | H | P21 | H | P20 | P1 | H |
| Lₐ₃₁₇₂ | P11 | F | H | H | P21 | H | P21 | P2 | H |
| Lₐ₃₁₇₃ | P11 | F | H | H | P21 | H | P29 | H | H |
| Lₐ₃₁₇₄ | P11 | F | H | H | P21 | H | P29 | P1 | H |
| Lₐ₃₁₇₅ | P11 | F | H | H | P21 | H | P54 | H | H |
| Lₐ₃₁₇₆ | P11 | F | H | H | P21 | H | P96 | H | H |
| Lₐ₃₁₇₇ | P11 | F | H | H | P21 | H | P97 | H | H |
| Lₐ₃₁₇₈ | P11 | F | H | H | P21 | H | P96 | P1 | H |
| Lₐ₃₁₇₉ | P11 | F | H | H | P21 | H | P97 | P1 | H |
| Lₐ₃₁₈₀ | P11 | F | H | H | P21 | H | P102 | H | H |
| Lₐ₃₁₈₁ | P11 | F | H | H | P21 | H | P103 | H | H |
| Lₐ₃₁₈₂ | P11 | F | H | H | P22 | H | H | H | H |
| Lₐ₃₁₈₃ | P11 | F | H | H | P23 | H | H | H | H |
| Lₐ₃₁₈₄ | P11 | F | H | H | P24 | H | H | H | H |
| Lₐ₃₁₈₅ | P11 | F | H | H | P25 | H | H | H | H |
| Lₐ₃₁₈₆ | P11 | F | H | H | P26 | H | H | H | H |
| Lₐ₃₁₈₇ | P11 | F | H | H | P27 | H | H | H | H |
| Lₐ₃₁₈₈ | P11 | F | H | H | P28 | H | H | H | H |
| Lₐ₃₁₈₉ | P11 | F | H | H | P29 | H | H | H | H |
| Lₐ₃₁₉₀ | P11 | F | H | H | P30 | H | H | H | H |
| Lₐ₃₁₉₁ | P11 | F | H | H | P31 | H | H | H | H |
| Lₐ₃₁₉₂ | P11 | F | H | H | P32 | H | H | H | H |
| Lₐ₃₁₉₃ | P11 | F | H | H | P33 | H | H | H | H |
| Lₐ₃₁₉₄ | P11 | F | H | H | P34 | H | H | H | H |
| Lₐ₃₁₉₅ | P11 | F | H | H | P35 | H | H | H | H |
| Lₐ₃₁₉₆ | P11 | F | H | H | P36 | H | H | H | H |
| Lₐ₃₁₉₇ | P11 | F | H | H | P37 | H | H | H | H |
| Lₐ₃₁₉₈ | P11 | F | H | H | P38 | H | H | H | H |
| Lₐ₃₁₉₉ | P11 | F | H | H | P39 | H | H | H | H |
| Lₐ₃₂₀₀ | P11 | F | H | H | P40 | H | H | H | H |
| Lₐ₃₂₀₁ | P11 | F | H | H | P41 | H | H | H | H |
| Lₐ₃₂₀₂ | P11 | F | H | H | P42 | H | H | H | H |
| Lₐ₃₂₀₃ | P11 | F | H | H | P43 | H | H | H | H |
| Lₐ₃₂₀₄ | P11 | F | H | H | P44 | H | H | H | H |
| Lₐ₃₂₀₅ | P11 | F | H | H | P45 | H | H | H | H |
| Lₐ₃₂₀₆ | P11 | F | H | H | P46 | H | H | H | H |
| Lₐ₃₂₀₇ | P11 | F | H | H | P47 | H | H | H | H |
| Lₐ₃₂₀₈ | P11 | F | H | H | P48 | H | H | H | H |
| Lₐ₃₂₀₉ | P11 | F | H | H | P49 | H | H | H | H |
| Lₐ₃₂₁₀ | P11 | F | H | H | P50 | H | H | H | H |
| Lₐ₃₂₁₁ | P11 | F | H | H | P51 | H | H | H | H |
| Lₐ₃₂₁₂ | P11 | F | H | H | P52 | H | H | H | H |
| Lₐ₃₂₁₃ | P11 | F | H | H | P53 | H | H | H | H |
| Lₐ₃₂₁₄ | P11 | F | H | H | P55 | H | H | H | H |
| Lₐ₃₂₁₅ | P11 | F | H | H | P56 | H | H | H | H |
| Lₐ₃₂₁₆ | P11 | F | H | H | P57 | H | H | H | H |
| Lₐ₃₂₁₇ | P11 | F | H | H | P58 | H | H | H | H |
| Lₐ₃₂₁₈ | P11 | F | H | H | P59 | H | H | H | H |
| Lₐ₃₂₁₉ | P11 | F | H | H | P60 | H | H | H | H |
| Lₐ₃₂₂₀ | P11 | F | H | H | P61 | H | H | H | H |
| Lₐ₃₂₂₁ | P11 | F | H | H | P62 | H | H | H | H |
| Lₐ₃₂₂₂ | P11 | F | H | H | P63 | H | H | H | H |
| Lₐ₃₂₂₃ | P11 | F | H | H | P64 | H | H | H | H |
| Lₐ₃₂₂₄ | P11 | F | H | H | P65 | H | H | H | H |
| Lₐ₃₂₂₅ | P11 | F | H | H | P66 | H | H | H | H |
| Lₐ₃₂₂₆ | P11 | F | H | H | P67 | H | H | H | H |
| Lₐ₃₂₂₇ | P11 | F | H | H | P68 | H | H | H | H |
| Lₐ₃₂₂₈ | P11 | F | H | H | P69 | H | H | H | H |
| Lₐ₃₂₂₉ | P11 | F | H | H | P70 | H | H | H | H |
| Lₐ₃₂₃₀ | P11 | F | H | H | P71 | H | H | H | H |
| Lₐ₃₂₃₁ | P11 | F | H | H | P72 | H | H | H | H |
| Lₐ₃₂₃₂ | P11 | F | H | H | P73 | H | H | H | H |
| Lₐ₃₂₃₃ | P11 | F | H | H | P74 | H | H | H | H |
| Lₐ₃₂₃₄ | P11 | F | H | H | P75 | H | H | H | H |
| Lₐ₃₂₃₅ | P11 | F | H | H | P76 | H | H | H | H |
| Lₐ₃₂₃₆ | P11 | F | H | H | P77 | H | H | H | H |
| Lₐ₃₂₃₇ | P11 | F | H | H | P78 | H | H | H | H |
| Lₐ₃₂₃₈ | P11 | F | H | H | P79 | H | H | H | H |
| Lₐ₃₂₃₉ | P11 | F | H | H | P80 | H | H | H | H |
| Lₐ₃₂₄₀ | P11 | F | H | H | P81 | H | H | H | H |
| Lₐ₃₂₄₁ | P11 | F | H | H | P82 | H | H | H | H |
| Lₐ₃₂₄₂ | P11 | F | H | H | P83 | H | H | H | H |
| Lₐ₃₂₄₃ | P11 | F | H | H | P84 | H | H | H | H |
| Lₐ₃₂₄₄ | P11 | F | H | H | P85 | H | H | H | H |
| Lₐ₃₂₄₅ | P11 | F | H | H | P86 | H | H | H | H |
| Lₐ₃₂₄₆ | P11 | F | H | H | P87 | H | H | H | H |
| Lₐ₃₂₄₇ | P11 | F | H | H | P88 | H | H | H | H |
| Lₐ₃₂₄₈ | P11 | F | H | H | P89 | H | H | H | H |
| Lₐ₃₂₄₉ | P11 | F | H | H | P90 | H | H | H | H |
| Lₐ₃₂₅₀ | P11 | F | H | H | P91 | H | H | H | H |
| Lₐ₃₂₅₁ | P11 | F | H | H | P92 | H | H | H | H |
| Lₐ₃₂₅₂ | P11 | F | H | H | P93 | H | H | H | H |
| Lₐ₃₂₅₃ | P11 | F | H | H | P94 | H | H | H | H |
| Lₐ₃₂₅₄ | P11 | F | H | H | P95 | H | H | H | H |
| Lₐ₃₂₅₅ | P11 | F | H | H | P98 | H | H | H | H |
| Lₐ₃₂₅₆ | P11 | F | H | H | P99 | H | H | H | H |
| Lₐ₃₂₅₇ | P11 | F | H | H | P100 | H | H | H | H |
| Lₐ₃₂₅₈ | P11 | F | H | H | P101 | H | H | H | H |
| Lₐ₃₂₅₉ | P11 | F | H | H | P102 | H | H | H | H |
| Lₐ₃₂₆₀ | P11 | F | H | H | P103 | H | H | H | H |
| Lₐ₃₂₆₁ | P11 | F | H | H | P104 | H | H | H | H |
| Lₐ₃₂₆₂ | P11 | F | H | H | P105 | H | H | H | H |
| Lₐ₃₂₆₃ | P11 | F | H | H | P106 | H | H | H | H |
| Lₐ₃₂₆₄ | P11 | F | H | H | P107 | H | H | H | H |
| Lₐ₃₂₆₅ | P11 | F | H | H | P108 | H | H | H | H |
| Lₐ₃₂₆₆ | P11 | F | H | H | P109 | H | H | H | H |
| Lₐ₃₂₆₇ | P11 | F | H | H | P110 | H | H | H | H |
| Lₐ₃₂₆₈ | P11 | F | H | H | P111 | H | H | H | H |
| Lₐ₃₂₆₉ | P11 | F | H | H | P112 | H | H | H | H |
| Lₐ₃₂₇₀ | P11 | F | H | H | P113 | H | H | H | H |
| Lₐ₃₂₇₁ | P11 | F | H | H | P114 | H | H | H | H |
| Lₐ₃₂₇₂ | P11 | F | H | H | P115 | H | H | H | H |
| Lₐ₃₂₇₃ | P11 | F | H | H | P116 | H | H | H | H |
| Lₐ₃₂₇₄ | P11 | F | H | H | P117 | H | H | H | H |
| Lₐ₃₂₇₅ | P11 | F | H | H | P118 | H | H | H | H |
| Lₐ₃₂₇₆ | P11 | F | H | H | P119 | H | H | H | H |
| Lₐ₃₂₇₇ | P11 | F | H | H | P120 | H | H | H | H |
| Lₐ₃₂₇₈ | P11 | F | H | H | P121 | H | H | H | H |
| Lₐ₃₂₇₉ | P11 | F | H | H | P122 | H | H | H | H |
| Lₐ₃₂₈₀ | P11 | F | H | H | P123 | H | H | H | H |
| Lₐ₃₂₈₁ | P11 | F | H | H | P124 | H | H | H | H |
| Lₐ₃₂₈₂ | P11 | F | H | H | P125 | H | H | H | H |
| Lₐ₃₂₈₃ | P11 | F | H | H | P126 | H | H | H | H |
| Lₐ₃₂₈₄ | P11 | F | H | H | P127 | H | H | H | H |
| Lₐ₃₂₈₅ | P11 | F | H | H | P128 | H | H | H | H |
| Lₐ₃₂₈₆ | P11 | F | H | H | P129 | H | H | H | H |
| Lₐ₃₂₈₇ | P11 | F | H | H | P130 | H | H | H | H |
| Lₐ₃₂₈₈ | P11 | F | H | H | P131 | H | H | H | H |
| Lₐ₃₂₈₉ | P11 | F | H | H | P132 | H | H | H | H |
| Lₐ₃₂₉₀ | P11 | F | H | H | P133 | H | H | H | H |
| Lₐ₃₂₉₁ | P11 | F | H | H | P134 | H | H | H | H |
| Lₐ₃₂₉₂ | P11 | F | H | H | P135 | H | H | H | H |
| Lₐ₃₂₉₃ | P11 | F | H | H | P136 | H | H | H | H |
| Lₐ₃₂₉₄ | P11 | F | H | H | P137 | H | H | H | H |
| Lₐ₃₂₉₅ | P11 | F | H | H | P138 | H | H | H | H |
| Lₐ₃₂₉₆ | P11 | F | H | H | P139 | H | H | H | H |
| Lₐ₃₂₉₇ | P11 | F | H | H | P140 | H | H | H | H |
| Lₐ₃₂₉₈ | P11 | F | H | H | P141 | H | H | H | H |
| Lₐ₃₂₉₉ | P11 | F | H | H | P142 | H | H | H | H |
| Lₐ₃₃₀₀ | P11 | F | H | H | P143 | H | H | H | H |
| Lₐ₃₃₀₁ | P11 | F | H | H | P144 | H | H | H | H |
| Lₐ₃₃₀₂ | P11 | F | H | H | P145 | H | H | H | H |
| Lₐ₃₃₀₃ | P11 | F | H | H | P146 | H | H | H | H |
| Lₐ₃₃₀₄ | P11 | F | H | H | P147 | H | H | H | H |
| Lₐ₃₃₀₅ | P11 | F | H | H | P148 | H | H | H | H |
| Lₐ₃₃₀₆ | P11 | F | H | H | P149 | H | H | H | H |
| Lₐ₃₃₀₇ | P11 | F | H | H | P150 | H | H | H | H |
| Lₐ₃₃₀₈ | P11 | F | H | H | P151 | H | H | H | H |
| Lₐ₃₃₀₉ | P11 | F | H | P18 | H | H | H | H | H |
| Lₐ₃₃₁₀ | P11 | F | H | P18 | D | H | H | H | H |
| Lₐ₃₃₁₁ | P11 | F | H | P18 | P20 | H | H | H | H |
| Lₐ₃₃₁₂ | P11 | F | H | P19 | H | H | H | H | H |
| Lₐ₃₃₁₃ | P11 | F | H | P19 | D | H | H | H | H |
| Lₐ₃₃₁₄ | P11 | F | H | P19 | P20 | H | H | H | H |
| Lₐ₃₃₁₅ | P11 | F | H | P20 | H | H | H | H | H |
| Lₐ₃₃₁₆ | P11 | F | H | P20 | D | H | H | H | H |
| Lₐ₃₃₁₇ | P11 | F | H | P20 | H | H | P1 | H | H |
| Lₐ₃₃₁₈ | P11 | F | H | P20 | D | H | P2 | H | H |
| Lₐ₃₃₁₉ | P11 | F | H | P20 | H | H | H | P1 | H |
| Lₐ₃₃₂₀ | P11 | F | H | P20 | D | H | H | P2 | H |
| Lₐ₃₃₂₁ | P11 | F | H | P20 | H | H | P1 | P1 | H |
| Lₐ₃₃₂₂ | P11 | F | H | P20 | D | H | P2 | P2 | H |
| Lₐ₃₃₂₃ | P11 | F | H | P20 | H | H | P3 | H | H |
| Lₐ₃₃₂₄ | P11 | F | H | P20 | D | H | P4 | H | H |
| Lₐ₃₃₂₅ | P11 | F | H | P20 | H | H | P5 | H | H |
| Lₐ₃₃₂₆ | P11 | F | H | P21 | H | H | H | H | H |
| Lₐ₃₃₂₇ | P11 | F | H | P21 | D | H | H | H | H |
| Lₐ₃₃₂₈ | P11 | F | H | P21 | H | H | P1 | H | H |
| Lₐ₃₃₂₉ | P11 | F | H | P21 | D | H | P2 | H | H |
| Lₐ₃₃₃₀ | P11 | F | H | P21 | H | H | H | P1 | H |
| Lₐ₃₃₃₁ | P11 | F | H | P21 | D | H | H | P2 | H |
| Lₐ₃₃₃₂ | P11 | F | H | P21 | H | H | P1 | P1 | H |
| Lₐ₃₃₃₃ | P11 | F | H | P21 | D | H | P2 | P2 | H |
| Lₐ₃₃₃₄ | P11 | F | H | P21 | H | H | P3 | H | H |
| Lₐ₃₃₃₅ | P11 | F | H | P21 | D | H | P4 | H | H |
| Lₐ₃₃₃₆ | P11 | F | H | P21 | H | H | P5 | H | H |
| Lₐ₃₃₃₇ | P10 | F | H | H | H | H | H | H | H |
| Lₐ₃₃₃₈ | P10 | F | H | H | D | H | H | H | H |
| Lₐ₃₃₃₉ | P10 | F | H | H | P20 | H | H | H | H |
| Lₐ₃₃₄₀ | P10 | F | H | H | P21 | H | H | H | H |
| Lₐ₃₃₄₁ | P10 | F | H | H | P54 | H | H | H | H |
| Lₐ₃₃₄₂ | P10 | F | H | H | P55 | H | H | H | H |
| Lₐ₃₃₄₃ | P10 | F | H | H | P56 | H | H | H | H |
| Lₐ₃₃₄₄ | P10 | F | H | H | P57 | H | H | H | H |
| Lₐ₃₃₄₅ | P10 | F | H | H | P20 | H | P1 | H | H |
| Lₐ₃₃₄₆ | P10 | F | H | H | P20 | H | P3 | H | H |
| Lₐ₃₃₄₇ | P10 | F | H | H | P20 | H | P4 | H | H |
| Lₐ₃₃₄₈ | P10 | F | H | H | P20 | H | P6 | H | H |
| Lₐ₃₃₄₉ | P10 | F | H | H | P20 | H | P8 | H | H |
| Lₐ₃₃₅₀ | P10 | F | H | H | P20 | H | P10 | H | H |
| Lₐ₃₃₅₁ | P10 | F | H | H | P20 | H | P1 | F | H |
| Lₐ₃₃₅₂ | P10 | F | H | H | P20 | H | P2 | F | H |
| Lₐ₃₃₅₃ | P10 | F | H | H | P20 | H | P10 | F | H |
| Lₐ₃₃₅₄ | P10 | F | H | H | P20 | H | F | P1 | H |
| Lₐ₃₃₅₅ | P10 | F | H | H | P20 | H | F | P2 | H |
| Lₐ₃₃₅₆ | P10 | F | H | H | P20 | H | F | P10 | H |
| Lₐ₃₃₅₇ | P10 | F | H | H | P21 | H | P2 | P2 | H |
| Lₐ₃₃₅₈ | P10 | F | H | H | P21 | H | P5 | H | H |
| Lₐ₃₃₅₉ | P10 | F | H | H | P21 | H | P9 | H | H |
| Lₐ₃₃₆₀ | P10 | F | H | H | P21 | H | P11 | H | H |
| Lₐ₃₃₆₁ | P10 | F | H | H | P21 | H | P1 | F | H |
| Lₐ₃₃₆₂ | P10 | F | H | H | P21 | H | P2 | F | H |
| Lₐ₃₃₆₃ | P10 | F | H | H | P21 | H | P11 | F | H |
| Lₐ₃₃₆₄ | P10 | F | H | H | P21 | H | F | P1 | H |
| Lₐ₃₃₆₅ | P10 | F | H | H | P21 | H | F | P2 | H |
| Lₐ₃₃₆₆ | P10 | F | H | H | P21 | H | F | P11 | H |
| Lₐ₃₃₆₇ | P6 | CN | F | H | H | H | H | H | H |
| Lₐ₃₃₆₈ | P6 | CN | F | H | D | H | H | H | H |
| Lₐ₃₃₆₉ | P6 | CN | F | H | P20 | H | H | H | H |
| Lₐ₃₃₇₀ | P6 | CN | F | H | P21 | H | H | H | H |
| Lₐ₃₃₇₁ | P6 | CN | F | H | P54 | H | H | H | H |
| Lₐ₃₃₇₂ | P6 | CN | F | H | P96 | H | H | H | H |
| Lₐ₃₃₇₃ | P6 | CN | F | H | P97 | H | H | H | H |
| Lₐ₃₃₇₄ | P6 | CN | F | H | P103 | H | H | H | H |
| Lₐ₃₃₇₅ | P11 | CN | F | H | H | H | H | H | H |
| Lₐ₃₃₇₆ | P11 | CN | F | H | D | H | H | H | H |
| Lₐ₃₃₇₇ | P11 | CN | F | H | P20 | H | H | H | H |
| Lₐ₃₃₇₈ | P11 | CN | F | H | P21 | H | H | H | H |
| Lₐ₃₃₇₉ | P11 | CN | F | H | P54 | H | H | H | H |
| Lₐ₃₃₈₀ | P11 | CN | F | H | P96 | H | H | H | H |
| Lₐ₃₃₈₁ | P11 | CN | F | H | P97 | H | H | H | H |
| Lₐ₃₃₈₂ | P11 | CN | F | H | P103 | H | H | H | H |
| Lₐ₃₃₈₃ | P152 | CN | H | H | H | H | H | H | H |
| Lₐ₃₃₈₄ | P153 | CN | H | H | H | H | H | H | H |
| Lₐ₃₃₈₅ | P154 | CN | H | H | H | H | H | H | H |
| Lₐ₃₃₈₆ | P155 | CN | H | H | H | H | H | H | H |
| Lₐ₃₃₈₇ | P156 | CN | H | H | H | H | H | H | H |
| Lₐ₃₃₈₈ | P157 | CN | H | H | H | H | H | H | H |
| Lₐ₃₃₈₉ | P158 | CN | H | H | H | H | H | H | H |
| Lₐ₃₃₉₀ | P159 | CN | H | H | H | H | H | H | H |
| Lₐ₃₃₉₁ | P160 | CN | H | H | H | H | H | H | H |
| Lₐ₃₃₉₂ | P161 | CN | H | H | H | H | H | H | H |
| Lₐ₃₃₉₃ | P162 | CN | H | H | H | H | H | H | H |
| Lₐ₃₃₉₄ | P163 | CN | H | H | H | H | H | H | H |
| Lₐ₃₃₉₅ | P164 | CN | H | H | H | H | H | H | H |
| Lₐ₃₃₉₆ | P165 | CN | H | H | H | H | H | H | H |
| Lₐ₃₃₉₇ | P166 | CN | H | H | H | H | H | H | H |
| Lₐ₃₃₉₈ | P152 | CN | H | H | P20 | H | H | H | H |
| Lₐ₃₃₉₉ | P153 | CN | H | H | P20 | H | H | H | H |
| Lₐ₃₄₀₀ | P154 | CN | H | H | P20 | H | H | H | H |
| Lₐ₃₄₀₁ | P155 | CN | H | H | P20 | H | H | H | H |
| Lₐ₃₄₀₂ | P156 | CN | H | H | P20 | H | H | H | H |
| Lₐ₃₄₀₃ | P157 | CN | H | H | P20 | H | H | H | H |
| Lₐ₃₄₀₄ | P158 | CN | H | H | P20 | H | H | H | H |
| Lₐ₃₄₀₅ | P159 | CN | H | H | P20 | H | H | H | H |
| Lₐ₃₄₀₆ | P160 | CN | H | H | P20 | H | H | H | H |
| Lₐ₃₄₀₇ | P161 | CN | H | H | P20 | H | H | H | H |
| Lₐ₃₄₀₈ | P29 | CN | H | H | H | H | H | H | H |
| Lₐ₃₄₀₉ | P30 | CN | H | H | H | H | H | H | H |
| Lₐ₃₄₁₀ | P31 | CN | H | H | H | H | H | H | H |
| Lₐ₃₄₁₁ | P165 | CN | H | H | P20 | H | H | H | H |
| Lₐ₃₄₁₂ | P166 | CN | H | H | P20 | H | H | H | H |
| Lₐ₃₄₁₃ | P152 | CN | H | H | P21 | H | H | H | H |
| Lₐ₃₄₁₄ | P153 | CN | H | H | P21 | H | H | H | H |
| Lₐ₃₄₁₅ | P154 | CN | H | H | P21 | H | H | H | H |
| Lₐ₃₄₁₆ | P155 | CN | H | H | P21 | H | H | H | H |
| Lₐ₃₄₁₇ | P156 | CN | H | H | P21 | H | H | H | H |
| Lₐ₃₄₁₈ | P157 | CN | H | H | P21 | H | H | H | H |
| Lₐ₃₄₁₉ | P158 | CN | H | H | P21 | H | H | H | H |
| Lₐ₃₄₂₀ | P159 | CN | H | H | P21 | H | H | H | H |
| Lₐ₃₄₂₁ | P160 | CN | H | H | P21 | H | H | H | H |
| Lₐ₃₄₂₂ | P161 | CN | H | H | P21 | H | H | H | H |
| Lₐ₃₄₂₃ | P29 | CN | H | H | P21 | H | H | H | H |
| Lₐ₃₄₂₄ | P30 | CN | H | H | P21 | H | H | H | H |
| Lₐ₃₄₂₅ | P31 | CN | H | H | P21 | H | H | H | H |
| Lₐ₃₄₂₆ | P165 | CN | H | H | P21 | H | H | H | H |
| Lₐ₃₄₂₇ | P166 | CN | H | H | P21 | H | H | H | H |
| Lₐ₃₄₂₈ | P152 | CN | H | H | P54 | H | H | H | H |
| Lₐ₃₄₂₉ | P153 | CN | H | H | P54 | H | H | H | H |
| Lₐ₃₄₃₀ | P154 | CN | H | H | P54 | H | H | H | H |
| Lₐ₃₄₃₁ | P155 | CN | H | H | P54 | H | H | H | H |
| Lₐ₃₄₃₂ | P156 | CN | H | H | P54 | H | H | H | H |
| Lₐ₃₄₃₃ | P157 | CN | H | H | P54 | H | H | H | H |
| Lₐ₃₄₃₄ | P158 | CN | H | H | P54 | H | H | H | H |
| Lₐ₃₄₃₅ | P159 | CN | H | H | P54 | H | H | H | H |
| Lₐ₃₄₃₆ | P160 | CN | H | H | P54 | H | H | H | H |
| Lₐ₃₄₃₇ | P161 | CN | H | H | P54 | H | H | H | H |
| Lₐ₃₄₃₈ | P29 | CN | H | H | P54 | H | H | H | H |
| Lₐ₃₄₃₉ | P30 | CN | H | H | P54 | H | H | H | H |
| Lₐ₃₄₄₀ | P31 | CN | H | H | P54 | H | H | H | H |
| Lₐ₃₄₄₁ | P165 | CN | H | H | P54 | H | H | H | H |
| Lₐ₃₄₄₂ | P166 | CN | H | H | P54 | H | H | H | H |
| Lₐ₃₄₄₃ | P152 | CN | H | H | P96 | H | H | H | H |
| Lₐ₃₄₄₄ | P153 | CN | H | H | P96 | H | H | H | H |
| Lₐ₃₄₄₅ | P154 | CN | H | H | P96 | H | H | H | H |
| Lₐ₃₄₄₆ | P155 | CN | H | H | P96 | H | H | H | H |
| Lₐ₃₄₄₇ | P156 | CN | H | H | P96 | H | H | H | H |
| Lₐ₃₄₄₈ | P157 | CN | H | H | P96 | H | H | H | H |
| Lₐ₃₄₄₉ | P158 | CN | H | H | P96 | H | H | H | H |
| Lₐ₃₄₅₀ | P159 | CN | H | H | P96 | H | H | H | H |
| Lₐ₃₄₅₁ | P160 | CN | H | H | P96 | H | H | H | H |
| Lₐ₃₄₅₂ | P161 | CN | H | H | P96 | H | H | H | H |
| Lₐ₃₄₅₃ | P29 | CN | H | H | P96 | H | H | H | H |
| Lₐ₃₄₅₄ | P30 | CN | H | H | P96 | H | H | H | H |
| Lₐ₃₄₅₅ | P31 | CN | H | H | P96 | H | H | H | H |
| Lₐ₃₄₅₆ | P165 | CN | H | H | P96 | H | H | H | H |
| Lₐ₃₄₅₇ | P166 | CN | H | H | P96 | H | H | H | H |
,
wobei P1 bis P166 die folgenden Strukturen aufweisen: 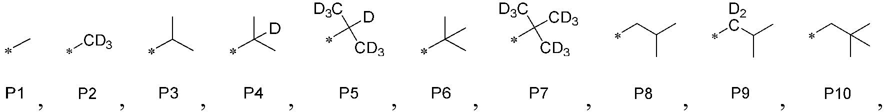 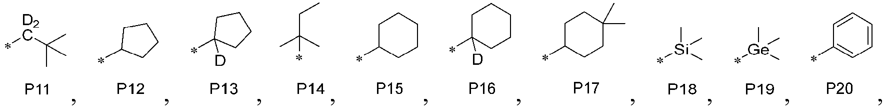 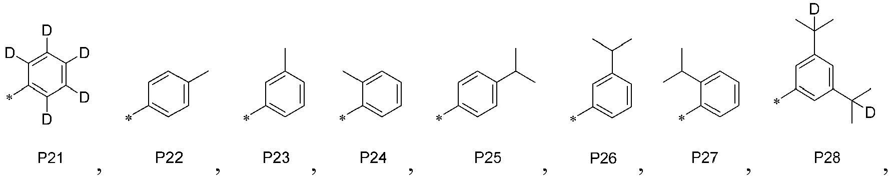 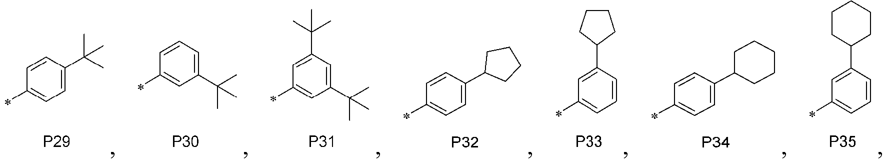 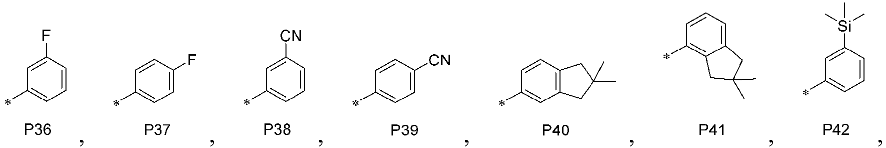 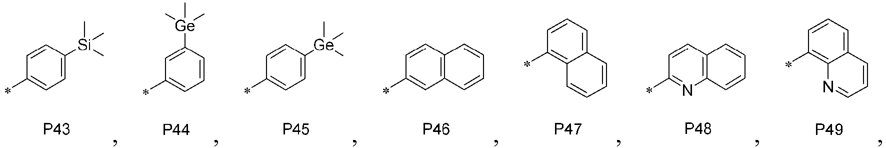 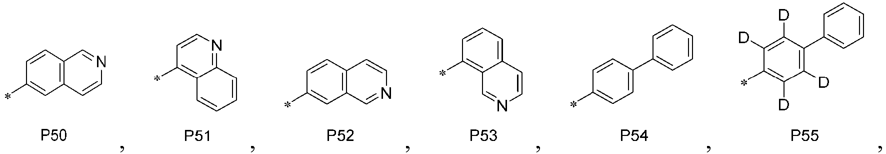 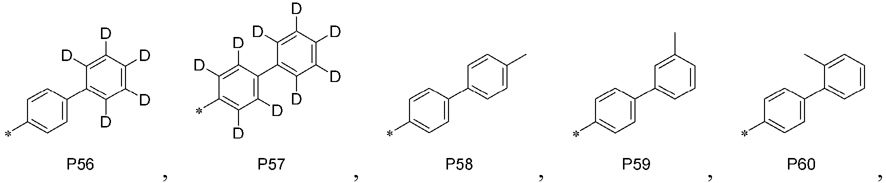 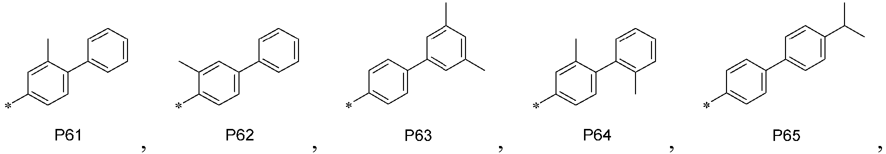 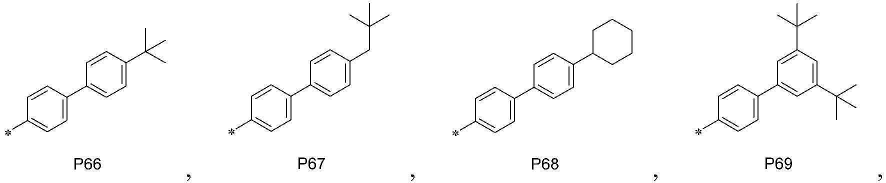 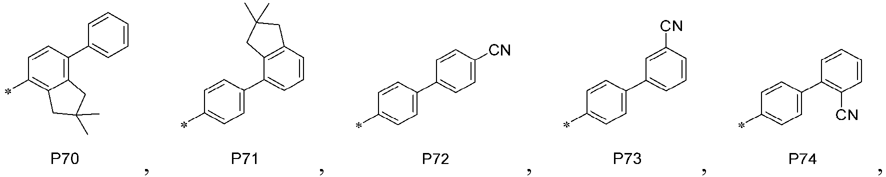 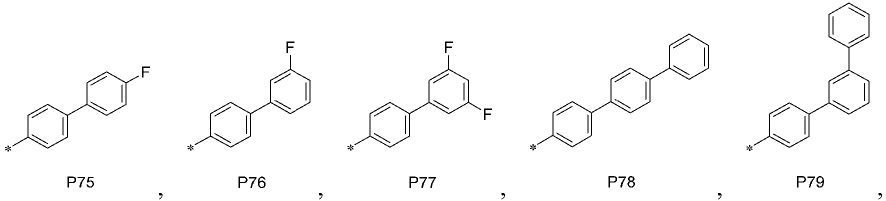 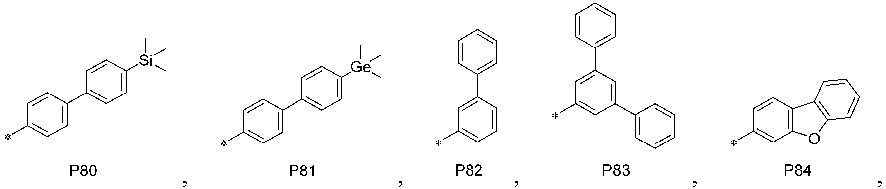 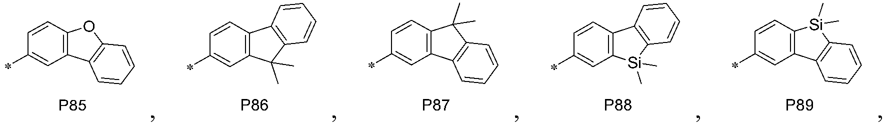 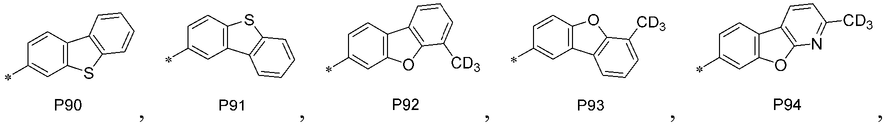 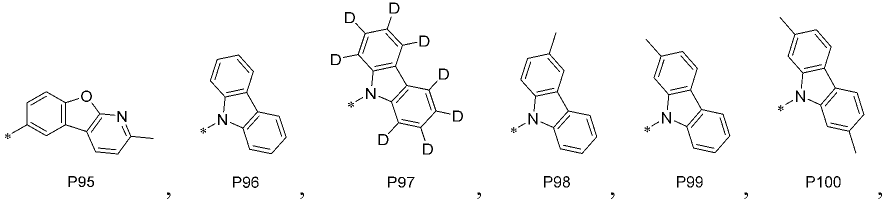 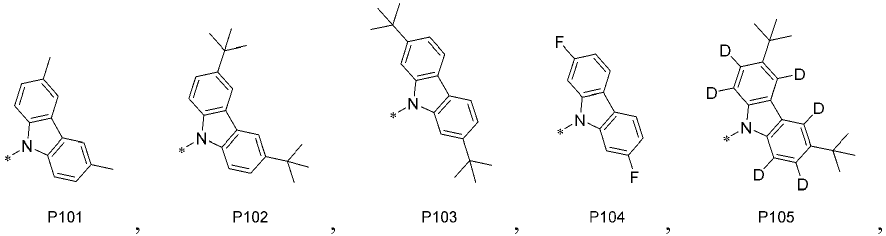 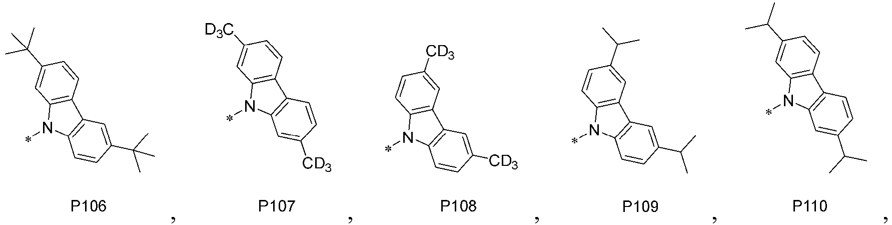 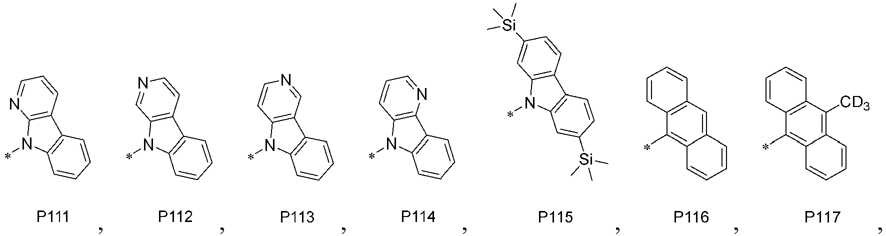 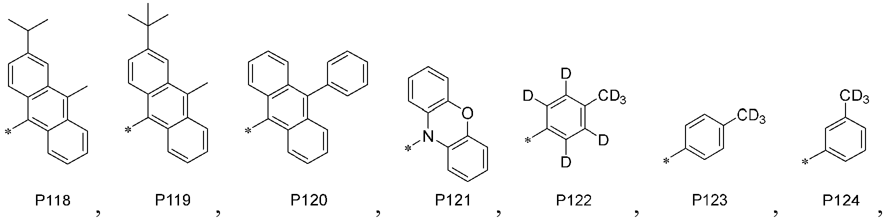 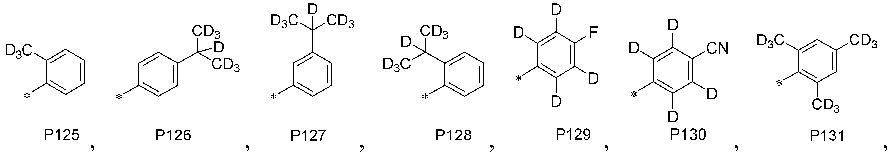 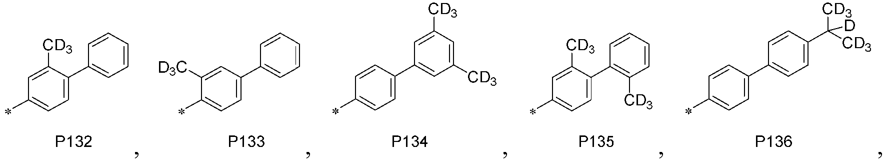 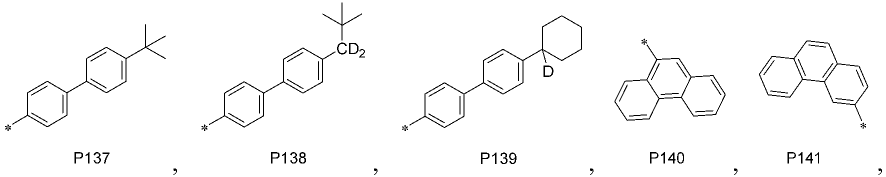 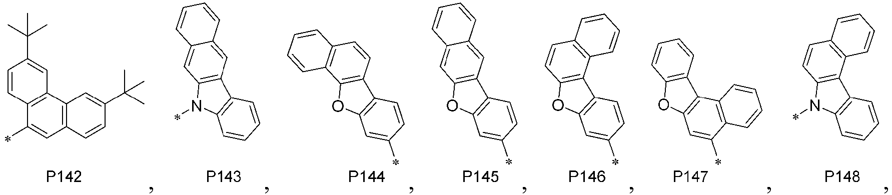 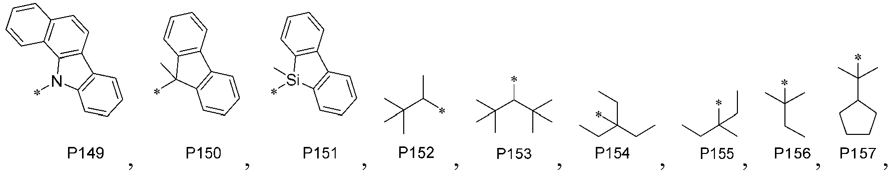 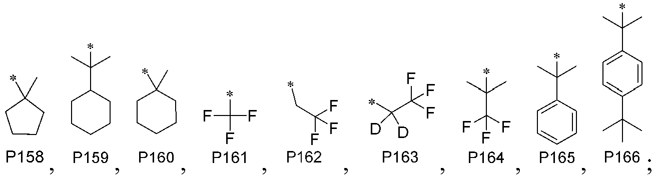
wobei Lₐ₃₄₅₈ bis Lₐ₃₅₃₀ wie folgt dargestellt sind: 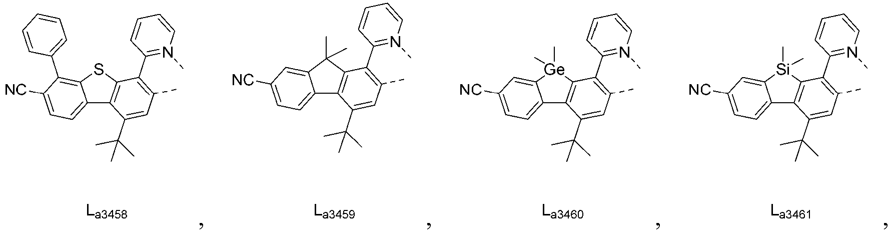 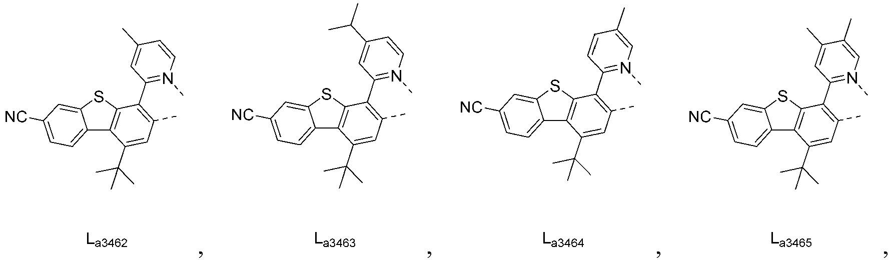 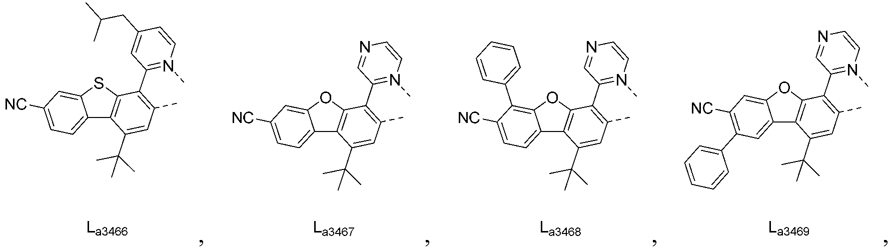 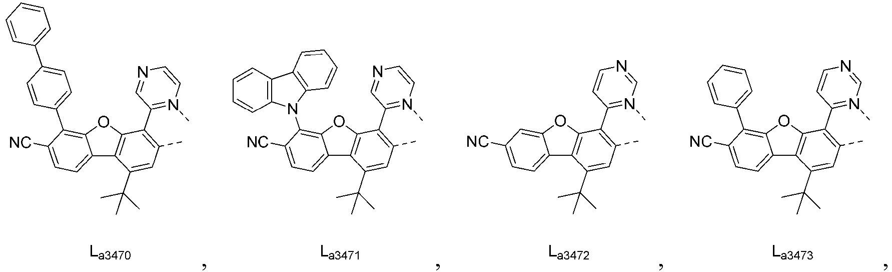 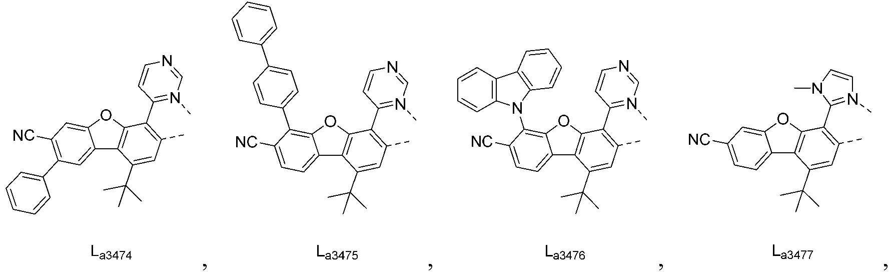 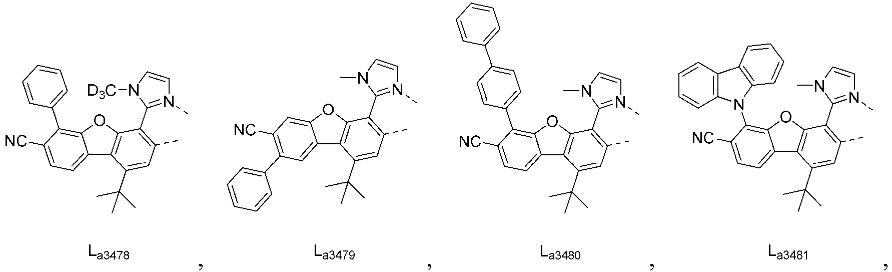 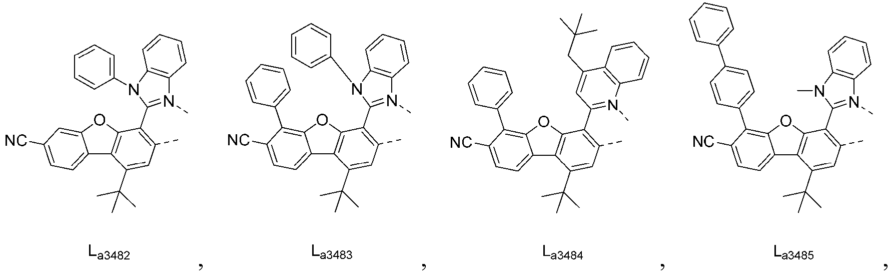 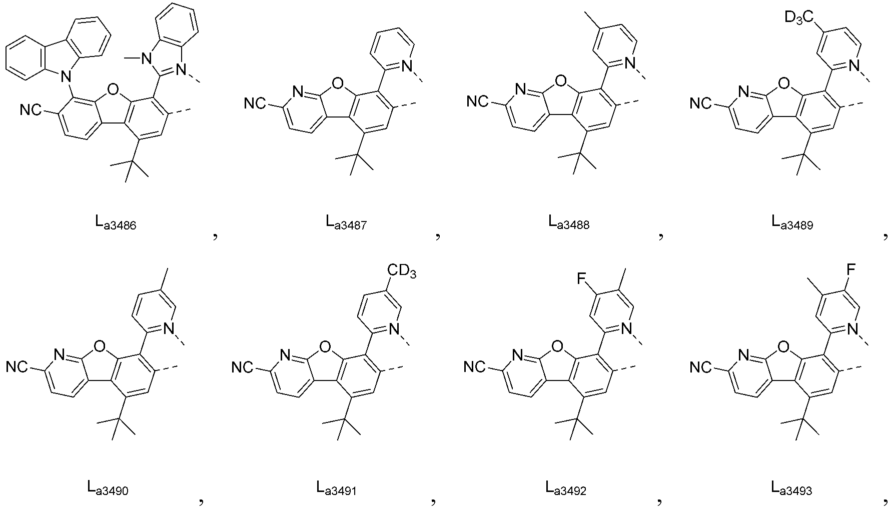 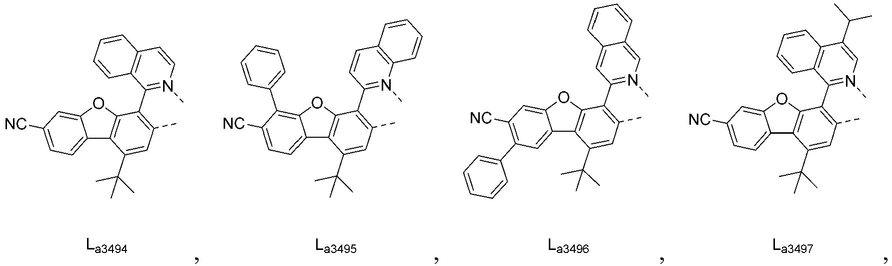 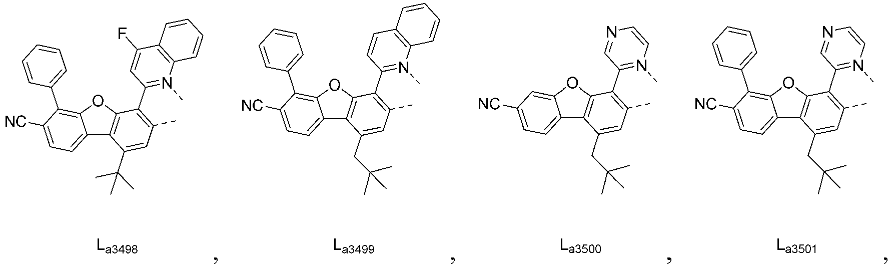 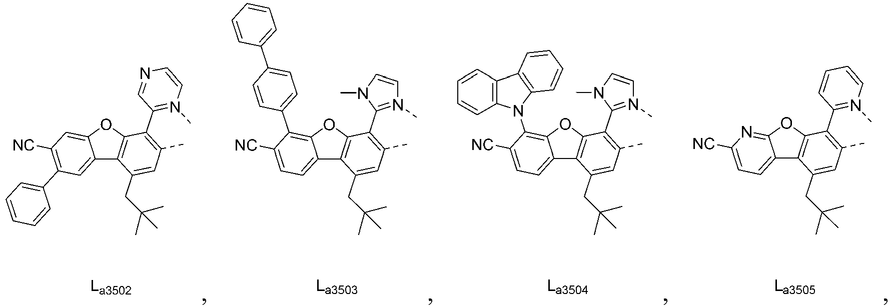 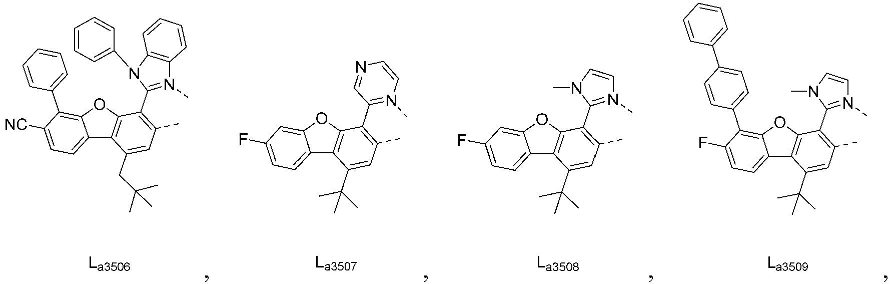 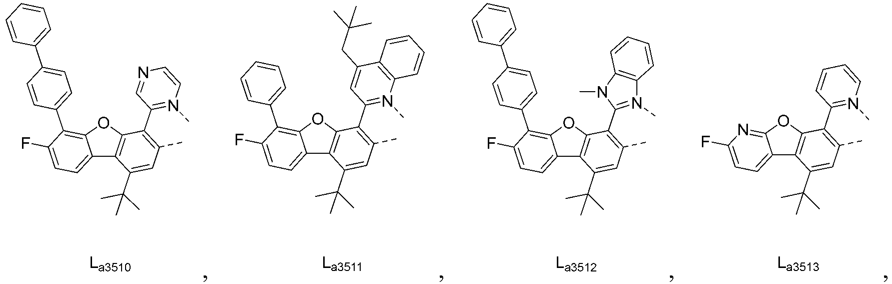 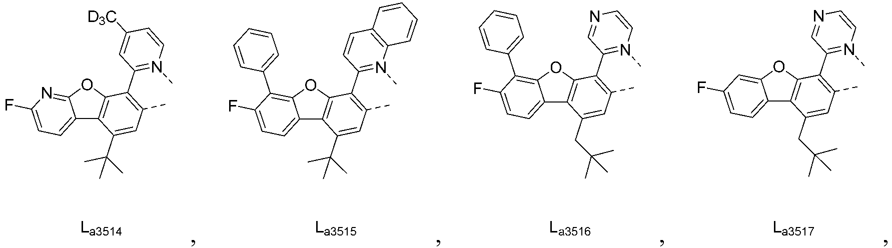 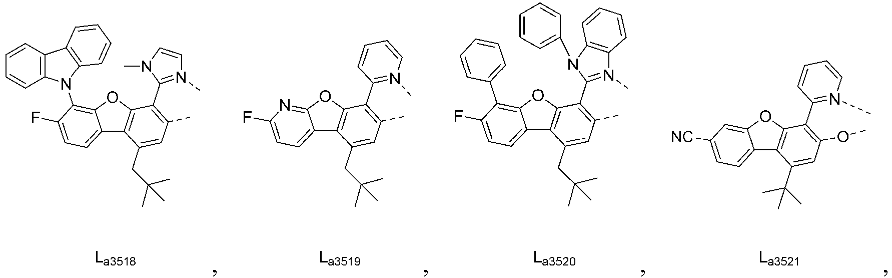 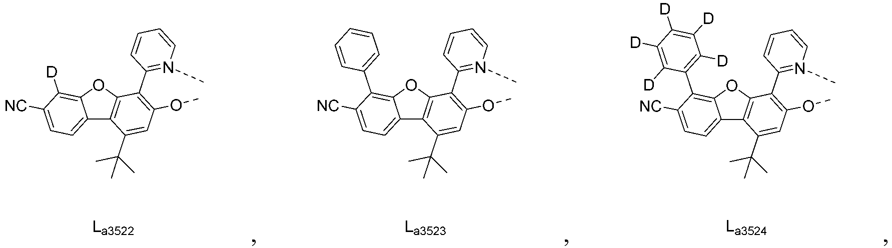 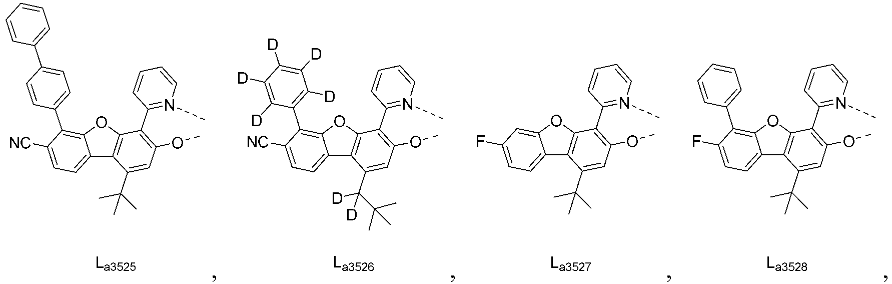 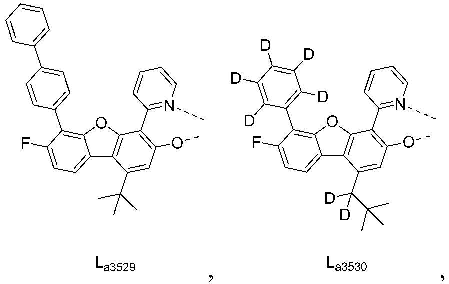
wobei Wasserstoffe in Lₐ₁ bis Lₐ₃₅₃₀ teilweise oder vollständig mit Deuterium substituiert sein können.

12. Metallkomplex nach Anspruch 2, 3 oder 11, wobei L_{b} bei jedem Auftreten identisch oder unterschiedlich aus der Gruppe bestehend aus Folgendem ausgewählt ist: 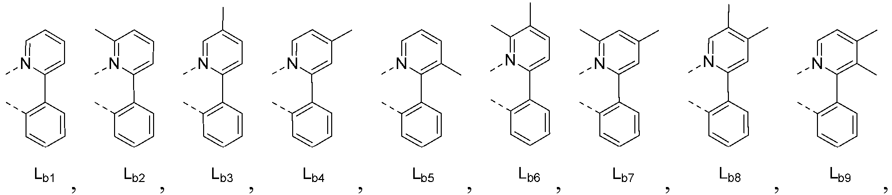 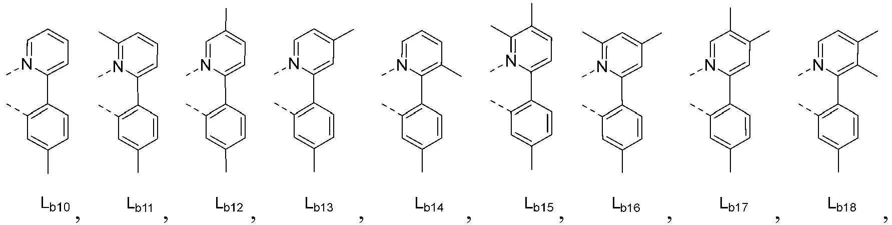 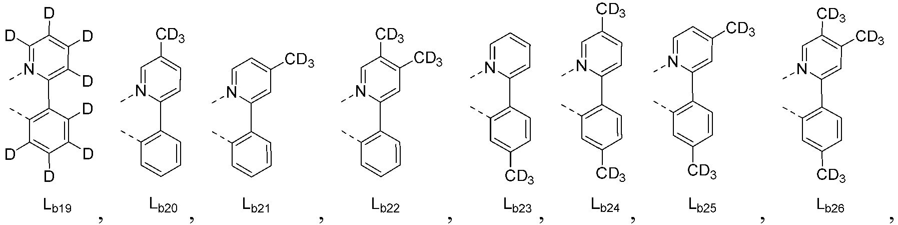 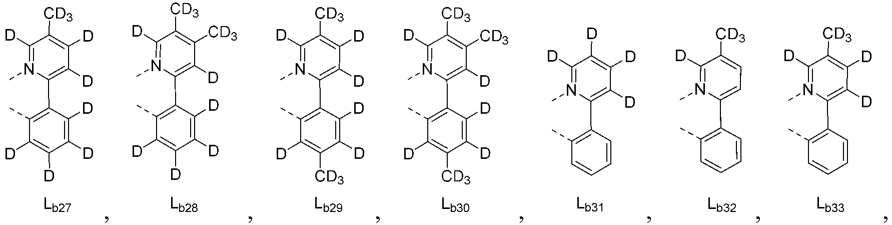 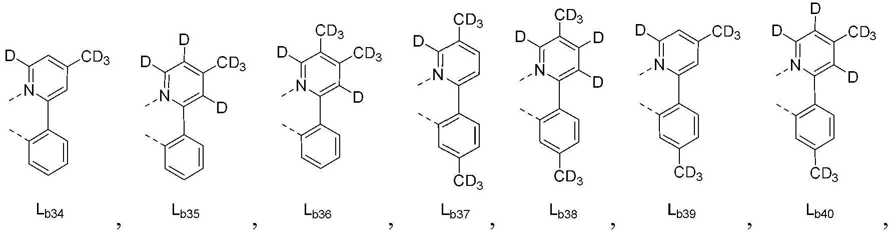 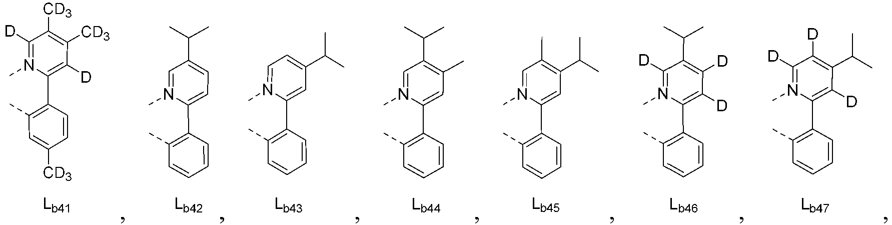 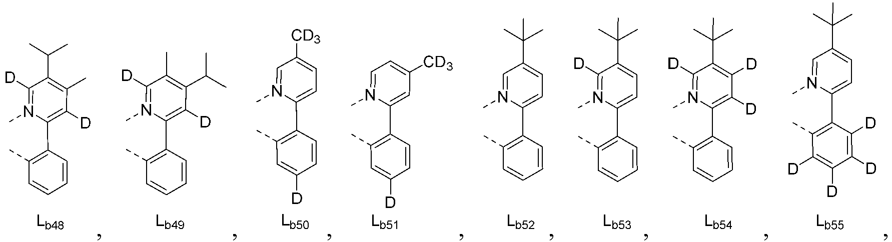 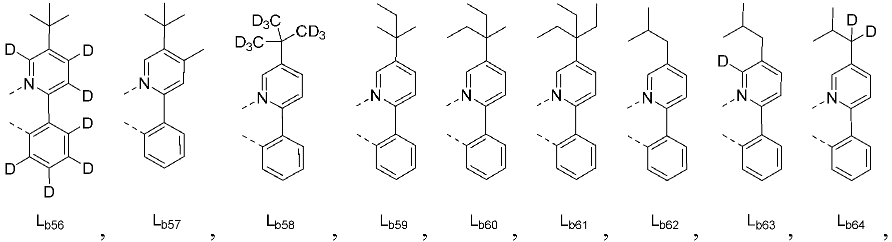 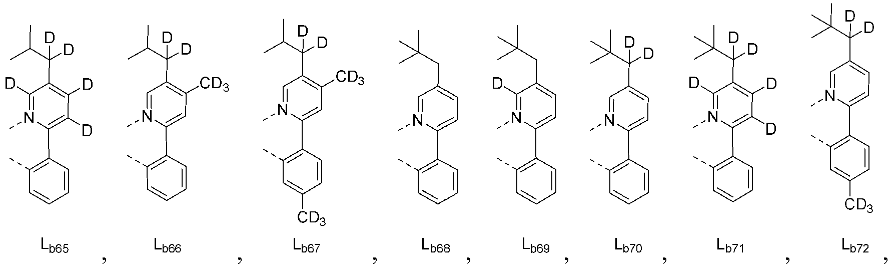 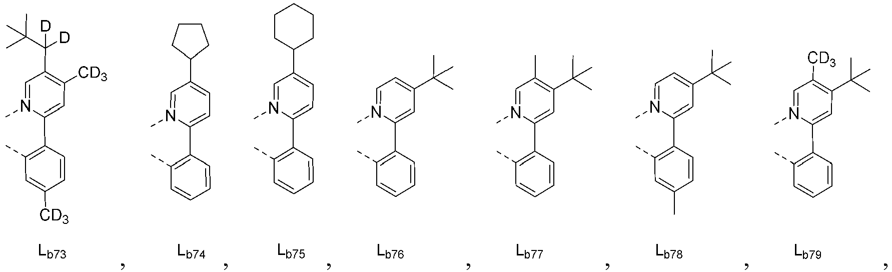 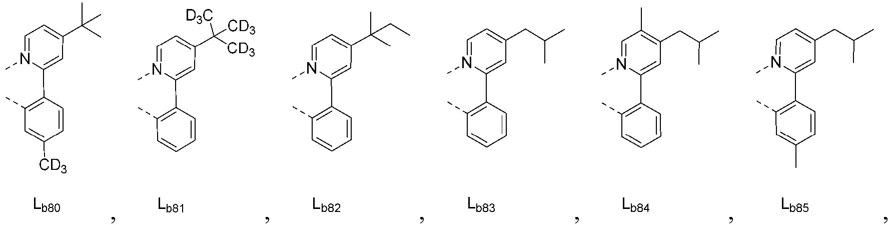 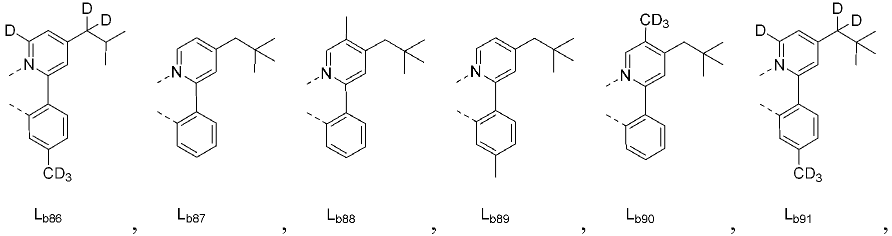 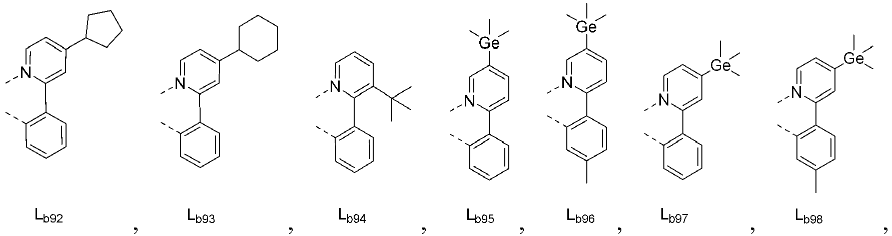 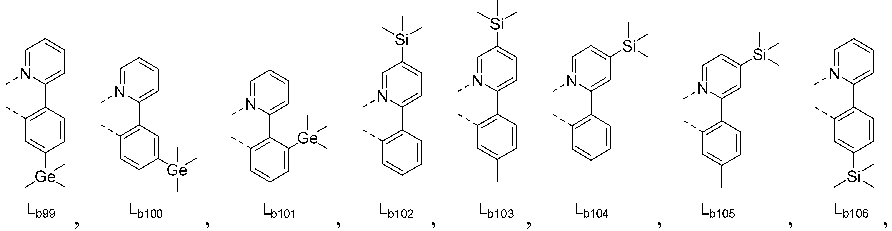 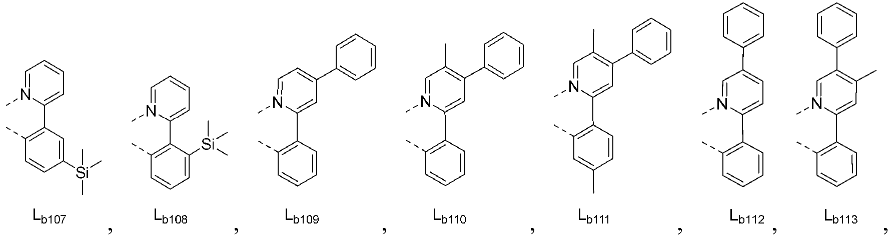 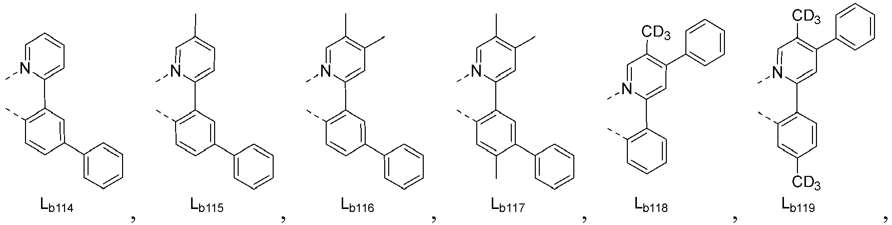 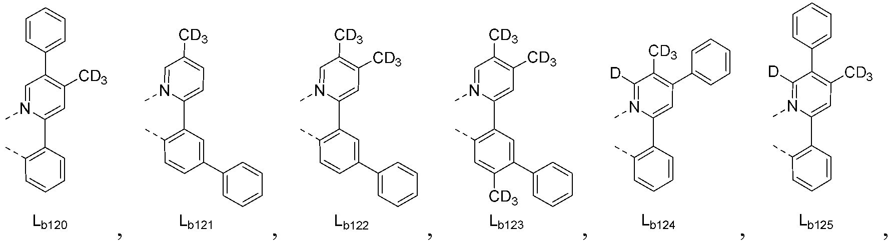 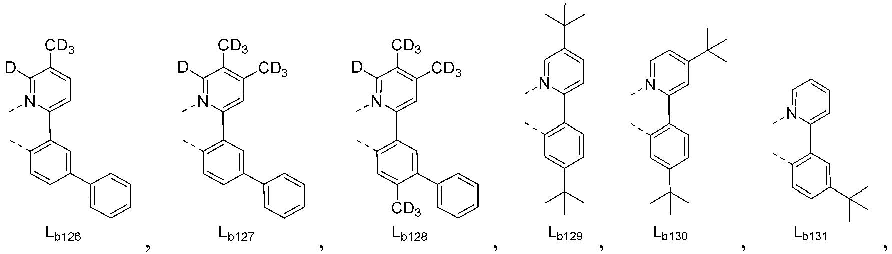 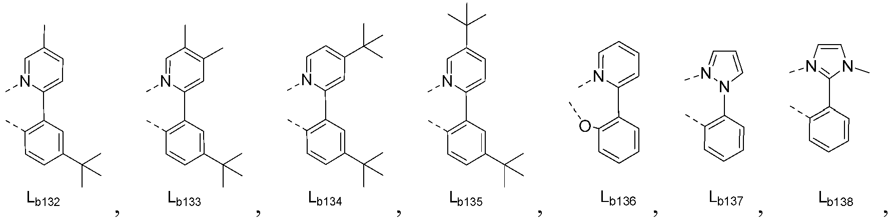 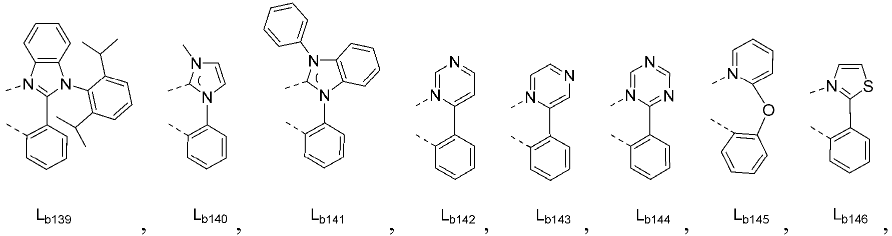 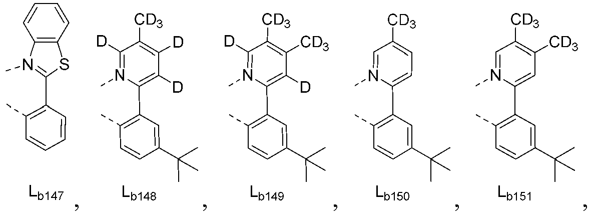 wobei Wasserstoffe in den obigen L_{b1} bis L_{b18}, L_{b20} bis L_{b26} und L_{b31} bis L_{b151} optional teilweise oder vollständig mit Deuterium substituiert sein können.

13. Metallkomplex nach Anspruch 12, wobei der Metallkomplex eine Struktur von Ir(Lₐ)(L_{b})₂ aufweist, wobei die beiden L_{b} identisch oder unterschiedlich sind, und
wobei der Metallkomplex vorzugsweise aus der Gruppe bestehend aus Metallkomplex 1 bis Metallkomplex 3806 ausgewählt ist, wobei Metallkomplex 1 bis Metallkomplex 3806 jeweils eine Struktur von Ir(Lₐ)(L_{b})₂ aufweisen, wobei die beiden L_{b} identisch sind und Lₐ und L_{b} jeweils den Strukturen in der folgenden Tabelle entsprechen:
| Metallkomplex Nr. | Lₐ | L_{b} | Metallkomplex Nr. | Lₐ | L_{b} |
|---|---|---|---|---|---|
| 1 | Lₐ₁ | L_{b1} | 2 | Lₐ₁ | L_{b3} |
| 3 | Lₐ₁₂ | L_{b1} | 4 | Lₐ₁₂ | L_{b3} |
| 5 | Lₐ₂₁ | L_{b1} | 6 | Lₐ₂₁ | L_{b3} |
| 7 | Lₐ₂₃ | L_{b1} | 8 | Lₐ₂₃ | L_{b3} |
| 9 | Lₐ₃₃ | L_{b1} | 10 | Lₐ₃₃ | L_{b3} |
| 11 | Lₐ₄₂ | L_{b1} | 12 | Lₐ₄₂ | L_{b3} |
| 13 | Lₐ₆₃ | L_{b1} | 14 | Lₐ₆₆ | L_{b3} |
| 15 | Lₐ₆₆ | L_{b1} | 16 | Lₐ₆₆ | L_{b3} |
| 17 | Lₐ₇₅ | L_{b1} | 18 | Lₐ₇₅ | L_{b3} |
| 19 | Lₐ₈₄ | L_{b1} | 20 | Lₐ₈₄ | L_{b3} |
| 21 | Lₐ₁₀₅ | L_{b1} | 22 | Lₐ₁₀₅ | L_{b3} |
| 23 | Lₐ₁₀₇ | L_{b1} | 24 | Lₐ₁₀₇ | L_{b3} |
| 25 | Lₐ₁₂₁ | L_{b1} | 26 | Lₐ₁₂₁ | L_{b3} |
| 27 | Lₐ₁₂₈ | L_{b1} | 28 | Lₐ₁₂₈ | L_{b3} |
| 29 | Lₐ₁₃₀ | L_{b1} | 30 | Lₐ₁₃₀ | L_{b3} |
| 31 | Lₐ₁₃₁ | L_{b1} | 32 | Lₐ₁₃₁ | L_{b3} |
| 33 | Lₐ₁₃₂ | L_{b1} | 34 | Lₐ₁₃₂ | L_{b3} |
| 35 | Lₐ₁₃₃ | L_{b1} | 36 | Lₐ₁₃₃ | L_{b3} |
| 37 | Lₐ₁₃₅ | L_{b1} | 38 | Lₐ₁₃₅ | L_{b3} |
| 39 | Lₐ₁₃₆ | L_{b1} | 40 | Lₐ₁₃₆ | L_{b3} |
| 41 | Lₐ₁₄₀ | L_{b1} | 42 | Lₐ₁₄₀ | L_{b3} |
| 43 | Lₐ₁₅₀ | L_{b1} | 44 | Lₐ₁₅₀ | L_{b3} |
| 45 | Lₐ₁₅₂ | L_{b1} | 46 | Lₐ₁₅₂ | L_{b3} |
| 47 | Lₐ₁₅₄ | L_{b1} | 48 | Lₐ₁₅₄ | L_{b3} |
| 49 | Lₐ₁₅₇ | L_{b1} | 50 | Lₐ₁₅₇ | L_{b3} |
| 51 | Lₐ₁₆₁ | L_{b1} | 52 | Lₐ₁₆₁ | L_{b3} |
| 53 | Lₐ₁₇₀ | L_{b1} | 54 | Lₐ₁₇₀ | L_{b3} |
| 55 | Lₐ₁₇₁ | L_{b1} | 56 | Lₐ₁₇₁ | L_{b3} |
| 57 | Lₐ₁₈₀ | L_{b1} | 58 | Lₐ₁₈₀ | L_{b3} |
| 59 | Lₐ₁₈₂ | L_{b1} | 60 | Lₐ₁₈₂ | L_{b3} |
| 61 | Lₐ₁₈₉ | L_{b1} | 62 | Lₐ₁₈₉ | L_{b3} |
| 63 | Lₐ₁₉₁ | L_{b1} | 64 | Lₐ₁₉₁ | L_{b3} |
| 65 | Lₐ₁₉₃ | L_{b1} | 66 | Lₐ₁₉₃ | L_{b3} |
| 67 | Lₐ₂₀₁ | L_{b1} | 68 | Lₐ₂₀₁ | L_{b3} |
| 69 | Lₐ₂₀₃ | L_{b1} | 70 | Lₐ₂₀₃ | L_{b3} |
| 71 | Lₐ₂₀₅ | L_{b1} | 72 | Lₐ₂₀₅ | L_{b3} |
| 73 | Lₐ₂₀₆ | L_{b1} | 74 | Lₐ₂₀₆ | L_{b3} |
| 75 | Lₐ₂₁₂ | L_{b1} | 76 | Lₐ₂₁₂ | L_{b3} |
| 77 | Lₐ₂₂₄ | L_{b1} | 78 | Lₐ₂₂₄ | L_{b3} |
| 79 | Lₐ₂₂₇ | L_{b1} | 80 | Lₐ₂₂₇ | L_{b3} |
| 81 | Lₐ₂₃₃ | L_{b1} | 82 | Lₐ₂₃₃ | L_{b3} |
| 83 | Lₐ₂₄₀ | L_{b1} | 84 | Lₐ₂₄₀ | L_{b3} |
| 85 | Lₐ₂₄₃ | L_{b1} | 86 | Lₐ₂₄₃ | L_{b3} |
| 87 | Lₐ₂₅₂ | L_{b1} | 88 | Lₐ₂₅₂ | L_{b3} |
| 89 | Lₐ₂₅₃ | L_{b1} | 90 | Lₐ₂₅₃ | L_{b3} |
| 91 | Lₐ₂₆₅ | L_{b1} | 92 | Lₐ₂₆₅ | L_{b3} |
| 93 | Lₐ₂₇₂ | L_{b1} | 94 | Lₐ₂₇₂ | L_{b3} |
| 95 | Lₐ₂₇₃ | L_{b1} | 96 | Lₐ₂₇₃ | L_{b3} |
| 97 | Lₐ₂₇₈ | L_{b1} | 98 | Lₐ₂₇₈ | L_{b3} |
| 99 | Lₐ₂₈₂ | L_{b1} | 100 | Lₐ₂₈₂ | L_{b3} |
| 101 | Lₐ₂₈₃ | L_{b1} | 102 | Lₐ₂₈₃ | L_{b3} |
| 103 | Lₐ₂₉₃ | L_{b1} | 104 | Lₐ₂₉₃ | L_{b3} |
| 105 | Lₐ₂₉₄ | L_{b1} | 106 | Lₐ₂₉₄ | L_{b3} |
| 107 | Lₐ₂₉₅ | L_{b1} | 108 | Lₐ₂₉₅ | L_{b3} |
| 109 | Lₐ₃₁₀ | L_{b1} | 110 | Lₐ₃₁₀ | L_{b3} |
| 111 | Lₐ₃₁₄ | L_{b1} | 112 | Lₐ₃₁₄ | L_{b3} |
| 113 | Lₐ₃₂₅ | L_{b1} | 114 | Lₐ₃₂₅ | L_{b3} |
| 115 | Lₐ₃₄₃ | L_{b1} | 116 | Lₐ₃₄₃ | L_{b3} |
| 117 | Lₐ₃₄₅ | L_{b1} | 118 | Lₐ₃₄₅ | L_{b3} |
| 119 | Lₐ₃₆₃ | L_{b1} | 120 | Lₐ₃₆₃ | L_{b3} |
| 121 | Lₐ₃₈₅ | L_{b1} | 122 | Lₐ₃₈₅ | L_{b3} |
| 123 | Lₐ₃₉₆ | L_{b1} | 124 | Lₐ₃₉₆ | L_{b3} |
| 125 | Lₐ₄₀₇ | L_{b1} | 126 | Lₐ₄₀₇ | L_{b3} |
| 127 | Lₐ₄₀₈ | L_{b1} | 128 | Lₐ₄₀₈ | L_{b3} |
| 129 | Lₐ₄₁₄ | L_{b1} | 130 | Lₐ₄₁₄ | L_{b3} |
| 131 | Lₐ₄₂₃ | L_{b1} | 132 | Lₐ₄₂₃ | L_{b3} |
| 133 | Lₐ₄₃₄ | L_{b1} | 134 | Lₐ₄₃₄ | L_{b3} |
| 135 | Lₐ₄₅₆ | L_{b1} | 136 | Lₐ₄₅₆ | L_{b3} |
| 137 | Lₐ₄₆₇ | L_{b1} | 138 | Lₐ₄₆₇ | L_{b3} |
| 139 | Lₐ₆₃₀ | L_{b1} | 140 | Lₐ₆₃₀ | L_{b3} |
| 141 | Lₐ₆₃₁ | L_{b1} | 142 | Lₐ₆₃₁ | L_{b3} |
| 143 | Lₐ₆₄₅ | L_{b1} | 144 | Lₐ₆₄₅ | L_{b3} |
| 145 | Lₐ₆₄₆ | L_{b1} | 146 | Lₐ₆₄₆ | L_{b3} |
| 147 | Lₐ₆₄₇ | L_{b1} | 148 | Lₐ₆₄₇ | L_{b3} |
| 149 | Lₐ₆₄₈ | L_{b1} | 150 | Lₐ₆₄₈ | L_{b3} |
| 151 | Lₐ₆₆₅ | L_{b1} | 152 | Lₐ₆₆₅ | L_{b3} |
| 153 | Lₐ₇₄₆ | L_{b1} | 154 | Lₐ₇₄₆ | L_{b3} |
| 155 | Lₐ₇₄₇ | L_{b1} | 156 | Lₐ₇₄₇ | L_{b3} |
| 157 | Lₐ₈₂₄ | L_{b1} | 158 | Lₐ₈₂₄ | L_{b3} |
| 159 | Lₐ₈₂₅ | L_{b1} | 160 | Lₐ₈₂₅ | L_{b3} |
| 161 | Lₐ₈₄₄ | L_{b1} | 162 | Lₐ₈₄₄ | L_{b3} |
| 163 | Lₐ₈₄₆ | L_{b1} | 164 | Lₐ₈₄₆ | L_{b3} |
| 165 | Lₐ₈₆₅ | L_{b1} | 166 | Lₐ₈₆₅ | L_{b3} |
| 167 | Lₐ₈₆₈ | L_{b1} | 168 | Lₐ₈₆₈ | L_{b3} |
| 169 | Lₐ₈₈₉ | L_{b1} | 170 | Lₐ₈₈₉ | L_{b3} |
| 171 | Lₐ₉₀₉ | L_{b1} | 172 | Lₐ₉₀₉ | L_{b3} |
| 173 | Lₐ₉₁₃ | L_{b1} | 174 | Lₐ₉₁₃ | L_{b3} |
| 175 | Lₐ₉₁₅ | L_{b1} | 176 | Lₐ₉₁₅ | L_{b3} |
| 177 | Lₐ₉₂₀ | L_{b1} | 178 | Lₐ₉₂₀ | L_{b3} |
| 179 | Lₐ₉₂₂ | L_{b1} | 180 | Lₐ₉₂₂ | L_{b3} |
| 181 | Lₐ₉₂₃ | L_{b1} | 182 | Lₐ₉₂₃ | L_{b3} |
| 183 | Lₐ₉₂₄ | L_{b1} | 184 | Lₐ₉₂₄ | L_{b3} |
| 185 | Lₐ₉₂₅ | L_{b1} | 186 | Lₐ₉₂₅ | L_{b3} |
| 187 | Lₐ₉₂₈ | L_{b1} | 188 | Lₐ₉₂₈ | L_{b3} |
| 189 | Lₐ₉₅₃ | L_{b1} | 190 | Lₐ₉₅₃ | L_{b3} |
| 191 | Lₐ₉₅₄ | L_{b1} | 192 | Lₐ₉₅₄ | L_{b3} |
| 193 | Lₐ₉₇₄ | L_{b1} | 194 | Lₐ₉₇₄ | L_{b3} |
| 195 | Lₐ₉₇₆ | L_{b1} | 196 | Lₐ₉₇₆ | L_{b3} |
| 197 | Lₐ₉₉₅ | L_{b1} | 198 | Lₐ₉₉₅ | L_{b3} |
| 199 | Lₐ₁₀₀₆ | L_{b1} | 200 | Lₐ₁₀₀₆ | L_{b3} |
| 201 | Lₐ₁₀₁₇ | L_{b1} | 202 | Lₐ₁₀₁₇ | L_{b3} |
| 203 | Lₐ₁₀₁₈ | L_{b1} | 204 | Lₐ₁₀₁₈ | L_{b3} |
| 205 | Lₐ₁₀₂₃ | L_{b1} | 206 | Lₐ₁₀₂₃ | L_{b3} |
| 207 | Lₐ₁₀₂₄ | L_{b1} | 208 | Lₐ₁₀₂₄ | L_{b3} |
| 209 | Lₐ₁₀₂₆ | L_{b1} | 210 | Lₐ₁₀₂₆ | L_{b3} |
| 211 | Lₐ₁₀₈₈ | L_{b1} | 212 | Lₐ₁₀₈₈ | L_{b3} |
| 213 | Lₐ₁₀₈₉ | L_{b1} | 214 | Lₐ₁₀₈₉ | L_{b3} |
| 215 | Lₐ₁₀₉₅ | L_{b1} | 216 | Lₐ₁₀₉₅ | L_{b3} |
| 217 | Lₐ₁₁₀₀ | L_{b1} | 218 | Lₐ₁₁₀₀ | L_{b3} |
| 219 | Lₐ₁₁₁₆ | L_{b1} | 220 | Lₐ₁₁₁₆ | L_{b3} |
| 221 | Lₐ₁₁₁₈ | L_{b1} | 222 | Lₐ₁₁₁₈ | L_{b3} |
| 223 | Lₐ₁₁₃₆ | L_{b1} | 224 | Lₐ₁₁₃₆ | L_{b3} |
| 225 | Lₐ₁₁₄₈ | L_{b1} | 226 | Lₐ₁₁₄₈ | L_{b3} |
| 227 | Lₐ₁₁₅₈ | L_{b1} | 228 | Lₐ₁₁₅₈ | L_{b3} |
| 229 | Lₐ₁₁₅₉ | L_{b1} | 230 | Lₐ₁₁₅₉ | L_{b3} |
| 231 | Lₐ₁₁₆₁ | L_{b1} | 232 | Lₐ₁₁₆₁ | L_{b3} |
| 233 | Lₐ₁₁₆₆ | L_{b1} | 234 | Lₐ₁₁₆₆ | L_{b3} |
| 235 | Lₐ₁₁₇₁ | L_{b1} | 236 | Lₐ₁₁₇₁ | L_{b3} |
| 237 | Lₐ₁₁₈₇ | L_{b1} | 238 | Lₐ₁₁₈₇ | L_{b3} |
| 239 | Lₐ₁₁₉₂ | L_{b1} | 240 | Lₐ₁₁₉₂ | L_{b3} |
| 241 | Lₐ₁₂₀₅ | L_{b1} | 242 | Lₐ₁₂₀₅ | L_{b3} |
| 243 | Lₐ₁₂₀₈ | L_{b1} | 244 | Lₐ₁₂₀₈ | L_{b3} |
| 245 | Lₐ₁₂₁₇ | L_{b1} | 246 | Lₐ₁₂₁₇ | L_{b3} |
| 247 | Lₐ₁₂₁₉ | L_{b1} | 248 | Lₐ₁₂₁₉ | L_{b3} |
| 249 | Lₐ₁₂₃₀ | L_{b1} | 250 | Lₐ₁₂₃₀ | L_{b3} |
| 251 | Lₐ₁₂₃₇ | L_{b1} | 252 | Lₐ₁₂₃₇ | L_{b3} |
| 253 | Lₐ₁₂₃₈ | L_{b1} | 254 | Lₐ₁₂₃₈ | L_{b3} |
| 255 | Lₐ₁₂₃₉ | L_{b1} | 256 | Lₐ₁₂₃₉ | L_{b3} |
| 257 | Lₐ₁₂₄₅ | L_{b1} | 258 | Lₐ₁₂₄₅ | L_{b3} |
| 259 | Lₐ₁₂₄₆ | L_{b1} | 260 | Lₐ₁₂₄₆ | L_{b3} |
| 261 | Lₐ₁₂₄₇ | L_{b1} | 262 | Lₐ₁₂₄₇ | L_{b3} |
| 263 | Lₐ₁₂₄₈ | L_{b1} | 264 | Lₐ₁₂₄₈ | L_{b3} |
| 265 | Lₐ₁₂₅₈ | L_{b1} | 266 | Lₐ₁₂₅₈ | L_{b3} |
| 267 | Lₐ₁₂₆₀ | L_{b1} | 268 | Lₐ₁₂₆₀ | L_{b3} |
| 269 | Lₐ₁₂₆₁ | L_{b1} | 270 | Lₐ₁₂₆₁ | L_{b3} |
| 271 | Lₐ₁₂₇₇ | L_{b1} | 272 | Lₐ₁₂₇₇ | L_{b3} |
| 273 | Lₐ₁₂₇₈ | L_{b1} | 274 | Lₐ₁₂₇₈ | L_{b3} |
| 275 | Lₐ₁₂₇₉ | L_{b1} | 276 | Lₐ₁₂₇₉ | L_{b3} |
| 277 | Lₐ₁₂₈₈ | L_{b1} | 278 | Lₐ₁₂₈₈ | L_{b3} |
| 279 | Lₐ₁₂₈₉ | L_{b1} | 280 | Lₐ₁₂₈₉ | L_{b3} |
| 281 | Lₐ₁₃₀₁ | L_{b1} | 282 | Lₐ₁₃₀₁ | L_{b3} |
| 283 | Lₐ₁₃₀₂ | L_{b1} | 284 | Lₐ₁₃₀₂ | L_{b3} |
| 285 | Lₐ₁₄₄₂ | L_{b1} | 286 | Lₐ₁₄₄₂ | L_{b3} |
| 287 | Lₐ₁₄₄₈ | L_{b1} | 288 | Lₐ₁₄₄₈ | L_{b3} |
| 289 | Lₐ₁₄₄₉ | L_{b1} | 290 | Lₐ₁₄₄₉ | L_{b3} |
| 291 | Lₐ₁₄₆₀ | L_{b1} | 292 | Lₐ₁₄₆₀ | L_{b3} |
| 293 | Lₐ₁₄₇₁ | L_{b1} | 294 | Lₐ₁₄₇₁ | L_{b3} |
| 295 | Lₐ₁₅₆₉ | L_{b1} | 296 | Lₐ₁₅₆₉ | L_{b3} |
| 297 | Lₐ₁₅₇₀ | L_{b1} | 298 | Lₐ₁₅₇₀ | L_{b3} |
| 299 | Lₐ₁₆₄₇ | L_{b1} | 300 | Lₐ₁₆₄₇ | L_{b3} |
| 301 | Lₐ₁₆₄₈ | L_{b1} | 302 | Lₐ₁₆₄₈ | L_{b3} |
| 303 | Lₐ₁₆₄₉ | L_{b1} | 304 | Lₐ₁₆₄₉ | L_{b3} |
| 305 | Lₐ₁₆₅₀ | L_{b1} | 306 | Lₐ₁₆₅₀ | L_{b3} |
| 307 | Lₐ₁₆₅₁ | L_{b1} | 308 | Lₐ₁₆₅₁ | L_{b3} |
| 309 | Lₐ₁₆₇₇ | L_{b1} | 310 | Lₐ₁₆₇₇ | L_{b3} |
| 311 | Lₐ₁₆₇₈ | L_{b1} | 312 | Lₐ₁₆₇₈ | L_{b3} |
| 313 | Lₐ₁₆₇₉ | L_{b1} | 314 | Lₐ₁₆₇₉ | L_{b3} |
| 315 | Lₐ₁₆₈₀ | L_{b1} | 316 | Lₐ₁₆₈₀ | L_{b3} |
| 317 | Lₐ₁₆₉₁ | L_{b1} | 318 | Lₐ₁₆₉₁ | L_{b3} |
| 319 | Lₐ₁₆₉₃ | L_{b1} | 320 | Lₐ₁₆₉₃ | L_{b3} |
| 321 | Lₐ₁₆₉₅ | L_{b1} | 322 | Lₐ₁₆₉₅ | L_{b3} |
| 323 | Lₐ₁₆₉₆ | L_{b1} | 324 | Lₐ₁₆₉₆ | L_{b3} |
| 325 | Lₐ₁₆₉₉ | L_{b1} | 326 | Lₐ₁₆₉₉ | L_{b3} |
| 327 | Lₐ₁₇₀₁ | L_{b1} | 328 | Lₐ₁₇₀₁ | L_{b3} |
| 329 | Lₐ₁₇₀₂ | L_{b1} | 330 | Lₐ₁₇₀₂ | L_{b3} |
| 331 | Lₐ₁₇₁₂ | L_{b1} | 332 | Lₐ₁₇₁₂ | L_{b3} |
| 333 | Lₐ₁₇₁₃ | L_{b1} | 334 | Lₐ₁₇₁₃ | L_{b3} |
| 335 | Lₐ₁₇₃₅ | L_{b1} | 336 | Lₐ₁₇₃₅ | L_{b3} |
| 337 | Lₐ₁₇₉₅ | L_{b1} | 338 | Lₐ₁₇₉₅ | L_{b3} |
| 339 | Lₐ₁₈₂₀ | L_{b1} | 340 | Lₐ₁₈₂₀ | L_{b3} |
| 341 | Lₐ₁₈₉₁ | L_{b1} | 342 | Lₐ₁₈₉₁ | L_{b3} |
| 343 | Lₐ₁₈₉₂ | L_{b1} | 344 | Lₐ₁₈₉₂ | L_{b3} |
| 345 | Lₐ₁₅₆₉ | L_{b1} | 346 | Lₐ₁₅₆₉ | L_{b3} |
| 347 | Lₐ₁₈₉₉ | L_{b1} | 348 | Lₐ₁₈₉₉ | L_{b3} |
| 349 | Lₐ₁₉₀₂ | L_{b1} | 350 | Lₐ₁₉₀₂ | L_{b3} |
| 351 | Lₐ₁₉₁₃ | L_{b1} | 352 | Lₐ₁₉₁₃ | L_{b3} |
| 353 | Lₐ₁₉₁₄ | L_{b1} | 354 | Lₐ₁₉₁₄ | L_{b3} |
| 355 | Lₐ₁₉₃₃ | L_{b1} | 356 | Lₐ₁₉₃₃ | L_{b3} |
| 357 | Lₐ₁₉₄₅ | L_{b1} | 358 | Lₐ₁₉₄₅ | L_{b3} |
| 359 | Lₐ₁₉₅₄ | L_{b1} | 360 | Lₐ₁₉₅₄ | L_{b3} |
| 361 | Lₐ₁₉₅₅ | L_{b1} | 362 | Lₐ₁₉₅₅ | L_{b3} |
| 363 | Lₐ₁₉₅₆ | L_{b1} | 364 | Lₐ₁₉₅₆ | L_{b3} |
| 365 | Lₐ₁₉₆₂ | L_{b1} | 366 | Lₐ₁₉₆₂ | L_{b3} |
| 367 | Lₐ₁₉₆₄ | L_{b1} | 368 | Lₐ₁₉₆₄ | L_{b3} |
| 369 | Lₐ₁₉₆₅ | L_{b1} | 370 | Lₐ₁₉₆₅ | L_{b3} |
| 371 | Lₐ₁₉₆₆ | L_{b1} | 372 | Lₐ₁₉₆₆ | L_{b3} |
| 373 | Lₐ₁₉₇₀ | L_{b1} | 374 | Lₐ₁₉₇₀ | L_{b3} |
| 375 | Lₐ₁₉₇₃ | L_{b1} | 376 | Lₐ₁₉₇₃ | L_{b3} |
| 377 | Lₐ₂₀₀₂ | L_{b1} | 378 | Lₐ₂₀₀₂ | L_{b3} |
| 379 | Lₐ₂₀₀₃ | L_{b1} | 380 | Lₐ₂₀₀₃ | L_{b3} |
| 381 | Lₐ₂₀₁₃ | L_{b1} | 382 | Lₐ₂₀₁₃ | L_{b3} |
| 383 | Lₐ₂₀₁₄ | L_{b1} | 384 | Lₐ₂₀₁₄ | L_{b3} |
| 385 | Lₐ₂₀₁₅ | L_{b1} | 386 | Lₐ₂₀₁₅ | L_{b3} |
| 387 | Lₐ₂₀₃₃ | L_{b1} | 388 | Lₐ₂₀₃₃ | L_{b3} |
| 389 | Lₐ₂₁₀₄ | L_{b1} | 390 | Lₐ₂₁₀₄ | L_{b3} |
| 391 | Lₐ₂₃₂₆ | L_{b1} | 392 | Lₐ₂₃₂₆ | L_{b3} |
| 393 | Lₐ₂₃₃₇ | L_{b1} | 394 | Lₐ₂₃₃₇ | L_{b3} |
| 395 | Lₐ₂₄₃₆ | L_{b1} | 396 | Lₐ₂₄₃₆ | L_{b3} |
| 397 | Lₐ₂₄₃₇ | L_{b1} | 398 | Lₐ₂₄₃₇ | L_{b3} |
| 399 | Lₐ₂₅₁₄ | L_{b1} | 400 | Lₐ₂₅₁₄ | L_{b3} |
| 401 | Lₐ₂₆₁₂ | L_{b1} | 402 | Lₐ₂₆₁₂ | L_{b3} |
| 403 | Lₐ₂₆₁₈ | L_{b1} | 404 | Lₐ₂₆₁₈ | L_{b3} |
| 405 | Lₐ₂₆₄₃ | L_{b1} | 406 | Lₐ₂₆₄₃ | L_{b3} |
| 407 | Lₐ₂₆₅₄ | L_{b1} | 408 | Lₐ₂₆₅₄ | L_{b3} |
| 409 | Lₐ₂₇₁₄ | L_{b1} | 410 | Lₐ₂₇₁₄ | L_{b3} |
| 411 | Lₐ₂₇₈₅ | L_{b1} | 412 | Lₐ₂₇₈₅ | L_{b3} |
| 413 | Lₐ₂₈₅₆ | L_{b1} | 414 | Lₐ₂₈₅₆ | L_{b3} |
| 415 | Lₐ₂₉₂₇ | L_{b1} | 416 | Lₐ₂₉₂₇ | L_{b3} |
| 417 | Lₐ₃₃₃₇ | L_{b1} | 418 | Lₐ₃₃₃₇ | L_{b3} |
| 419 | Lₐ₃₃₃₈ | L_{b1} | 420 | Lₐ₃₃₃₈ | L_{b3} |
| 421 | Lₐ₃₃₃₉ | L_{b1} | 422 | Lₐ₃₃₃₉ | L_{b3} |
| 423 | Lₐ₃₃₄₀ | L_{b1} | 424 | Lₐ₃₃₄₀ | L_{b3} |
| 425 | Lₐ₃₃₄₁ | L_{b1} | 426 | Lₐ₃₃₄₁ | L_{b3} |
| 427 | Lₐ₁ | L_{b8} | 428 | Lₐ₁ | L_{b20} |
| 429 | Lₐ₁₂ | L_{b8} | 430 | Lₐ₁₂ | L_{b20} |
| 431 | Lₐ₂₁ | L_{b8} | 432 | Lₐ₂₁ | L_{b20} |
| 433 | Lₐ₂₃ | L_{b8} | 434 | Lₐ₂₃ | L_{b20} |
| 435 | Lₐ₃₃ | L_{b8} | 436 | Lₐ₃₃ | L_{b20} |
| 437 | Lₐ₄₂ | L_{b8} | 438 | Lₐ₄₂ | L_{b20} |
| 439 | Lₐ₆₃ | L_{b8} | 440 | Lₐ₆₃ | L_{b20} |
| 441 | Lₐ₆₆ | L_{b8} | 442 | Lₐ₆₆ | L_{b20} |
| 443 | Lₐ₇₅ | L_{b8} | 444 | Lₐ₇₅ | L_{b20} |
| 445 | Lₐ₈₄ | L_{b8} | 446 | Lₐ₈₄ | L_{b20} |
| 447 | Lₐ₁₀₅ | L_{b8} | 448 | Lₐ₁₀₅ | L_{b20} |
| 449 | Lₐ₁₀₇ | L_{b8} | 450 | Lₐ₁₀₇ | L_{b20} |
| 451 | Lₐ₁₂₁ | L_{b8} | 452 | Lₐ₁₂₁ | L_{b20} |
| 453 | Lₐ₁₂₈ | L_{b8} | 454 | Lₐ₁₂₈ | L_{b20} |
| 455 | Lₐ₁₃₀ | L_{b8} | 456 | Lₐ₁₃₀ | L_{b20} |
| 457 | Lₐ₁₃₁ | L_{b8} | 458 | Lₐ₁₃₁ | L_{b20} |
| 459 | Lₐ₁₃₂ | L_{b8} | 460 | Lₐ₁₃₂ | L_{b20} |
| 461 | Lₐ₁₃₃ | L_{b8} | 462 | Lₐ₁₃₃ | L_{b20} |
| 463 | Lₐ₁₃₅ | L_{b8} | 464 | Lₐ₁₃₅ | L_{b20} |
| 465 | Lₐ₁₃₆ | L_{b8} | 466 | Lₐ₁₃₆ | L_{b20} |
| 467 | Lₐ₁₄₀ | L_{b8} | 468 | Lₐ₁₄₀ | L_{b20} |
| 469 | Lₐ₁₅₀ | L_{b8} | 470 | Lₐ₁₅₀ | L_{b20} |
| 471 | Lₐ₁₅₂ | L_{b8} | 472 | Lₐ₁₅₂ | L_{b20} |
| 473 | Lₐ₁₅₄ | L_{b8} | 474 | Lₐ₁₅₄ | L_{b20} |
| 475 | Lₐ₁₅₇ | L_{b8} | 476 | Lₐ₁₅₇ | L_{b20} |
| 477 | Lₐ₁₆₁ | L_{b8} | 478 | Lₐ₁₆₁ | L_{b20} |
| 479 | Lₐ₁₇₀ | L_{b8} | 480 | Lₐ₁₇₀ | L_{b20} |
| 481 | Lₐ₁₇₁ | L_{b8} | 482 | Lₐ₁₇₁ | L_{b20} |
| 483 | Lₐ₁₈₀ | L_{b8} | 484 | Lₐ₁₈₀ | L_{b20} |
| 485 | Lₐ₁₈₂ | L_{b8} | 486 | Lₐ₁₈₂ | L_{b20} |
| 487 | Lₐ₁₈₉ | L_{b8} | 488 | Lₐ₁₈₉ | L_{b20} |
| 489 | Lₐ₁₉₁ | L_{b8} | 490 | Lₐ₁₉₁ | L_{b20} |
| 491 | Lₐ₁₉₃ | L_{b8} | 492 | Lₐ₁₉₃ | L_{b20} |
| 493 | Lₐ₂₀₁ | L_{b8} | 494 | Lₐ₂₀₁ | L_{b20} |
| 495 | Lₐ₂₀₃ | L_{b8} | 496 | Lₐ₂₀₃ | L_{b20} |
| 497 | Lₐ₂₀₅ | L_{b8} | 498 | Lₐ₂₀₅ | L_{b20} |
| 499 | Lₐ₂₀₆ | L_{b8} | 500 | Lₐ₂₀₆ | L_{b20} |
| 501 | Lₐ₂₁₂ | L_{b8} | 502 | Lₐ₂₁₂ | L_{b20} |
| 503 | Lₐ₂₂₄ | L_{b8} | 504 | Lₐ₂₂₄ | L_{b20} |
| 505 | Lₐ₂₂₇ | L_{b8} | 506 | Lₐ₂₂₇ | L_{b20} |
| 507 | Lₐ₂₃₃ | L_{b8} | 508 | Lₐ₂₃₃ | L_{b20} |
| 509 | Lₐ₂₄₀ | L_{b8} | 510 | Lₐ₂₄₀ | L_{b20} |
| 511 | Lₐ₂₄₃ | L_{b8} | 512 | Lₐ₂₄₃ | L_{b20} |
| 513 | Lₐ₂₅₂ | L_{b8} | 514 | Lₐ₂₅₂ | L_{b20} |
| 515 | Lₐ₂₅₃ | L_{b8} | 516 | Lₐ₂₅₃ | L_{b20} |
| 517 | Lₐ₂₆₅ | L_{b8} | 518 | Lₐ₂₆₅ | L_{b20} |
| 519 | Lₐ₂₇₂ | L_{b8} | 520 | Lₐ₂₇₂ | L_{b20} |
| 521 | Lₐ₂₇₃ | L_{b8} | 522 | Lₐ₂₇₃ | L_{b20} |
| 523 | Lₐ₂₇₈ | L_{b8} | 524 | Lₐ₂₇₈ | L_{b20} |
| 525 | Lₐ₂₈₂ | L_{b8} | 526 | Lₐ₂₈₂ | L_{b20} |
| 527 | Lₐ₂₈₃ | L_{b8} | 528 | Lₐ₂₈₃ | L_{b20} |
| 529 | Lₐ₂₉₃ | L_{b8} | 530 | Lₐ₂₉₃ | L_{b20} |
| 531 | Lₐ₂₉₄ | L_{b8} | 532 | Lₐ₂₉₄ | L_{b20} |
| 533 | Lₐ₂₉₅ | L_{b8} | 534 | Lₐ₂₉₅ | L_{b20} |
| 535 | Lₐ₃₁₀ | L_{b8} | 536 | Lₐ₃₁₀ | L_{b20} |
| 537 | Lₐ₃₁₄ | L_{b8} | 538 | Lₐ₃₁₄ | L_{b20} |
| 539 | Lₐ₃₂₅ | L_{b8} | 540 | Lₐ₃₂₅ | L_{b20} |
| 541 | Lₐ₃₄₃ | L_{b8} | 542 | Lₐ₃₄₃ | L_{b20} |
| 543 | Lₐ₃₄₅ | L_{b8} | 544 | Lₐ₃₄₅ | L_{b20} |
| 545 | Lₐ₃₆₃ | L_{b8} | 546 | Lₐ₃₆₃ | L_{b20} |
| 547 | Lₐ₃₈₅ | L_{b8} | 548 | Lₐ₃₈₅ | L_{b20} |
| 549 | Lₐ₃₉₆ | L_{b8} | 550 | Lₐ₃₉₆ | L_{b20} |
| 551 | Lₐ₄₀₇ | L_{b8} | 552 | Lₐ₄₀₇ | L_{b20} |
| 553 | Lₐ₄₀₈ | L_{b8} | 554 | Lₐ₄₀₈ | L_{b20} |
| 555 | Lₐ₄₁₄ | L_{b8} | 556 | Lₐ₄₁₄ | L_{b20} |
| 557 | Lₐ₄₂₃ | L_{b8} | 558 | Lₐ₄₂₃ | L_{b20} |
| 559 | Lₐ₄₃₄ | L_{b8} | 560 | Lₐ₄₃₄ | L_{b20} |
| 561 | Lₐ₄₅₆ | L_{b8} | 562 | Lₐ₄₅₆ | L_{b20} |
| 563 | Lₐ₄₆₇ | L_{b8} | 564 | Lₐ₄₆₇ | L_{b20} |
| 565 | Lₐ₆₃₀ | L_{b8} | 566 | Lₐ₆₃₀ | L_{b20} |
| 567 | Lₐ₆₃₁ | L_{b8} | 568 | Lₐ₆₃₁ | L_{b20} |
| 569 | Lₐ₆₄₅ | L_{b8} | 570 | Lₐ₆₄₅ | L_{b20} |
| 571 | Lₐ₆₄₆ | L_{b8} | 572 | Lₐ₆₄₆ | L_{b20} |
| 573 | Lₐ₆₄₇ | L_{b8} | 574 | Lₐ₆₄₇ | L_{b20} |
| 575 | Lₐ₆₄₈ | L_{b8} | 576 | Lₐ₆₄₈ | L_{b20} |
| 577 | Lₐ₆₆₅ | L_{b8} | 578 | Lₐ₆₆₅ | L_{b20} |
| 579 | Lₐ₇₄₆ | L_{b8} | 580 | Lₐ₇₄₆ | L_{b20} |
| 581 | Lₐ₇₄₇ | L_{b8} | 582 | Lₐ₇₄₇ | L_{b20} |
| 583 | Lₐ₈₂₄ | L_{b8} | 584 | Lₐ₈₂₄ | L_{b20} |
| 585 | Lₐ₈₂₅ | L_{b8} | 586 | Lₐ₈₂₅ | L_{b20} |
| 587 | Lₐ₈₄₄ | L_{b8} | 588 | Lₐ₈₄₄ | L_{b20} |
| 589 | Lₐ₈₄₆ | L_{b8} | 590 | Lₐ₈₄₆ | L_{b20} |
| 591 | Lₐ₈₆₅ | L_{b8} | 592 | Lₐ₈₆₅ | L_{b20} |
| 593 | Lₐ₈₆₈ | L_{b8} | 594 | Lₐ₈₆₈ | L_{b20} |
| 595 | Lₐ₈₈₉ | L_{b8} | 596 | Lₐ₈₈₉ | L_{b20} |
| 597 | Lₐ₉₀₉ | L_{b8} | 598 | Lₐ₉₀₉ | L_{b20} |
| 599 | Lₐ₉₁₃ | L_{b8} | 600 | Lₐ₉₁₃ | L_{b20} |
| 601 | Lₐ₉₁₅ | L_{b8} | 602 | Lₐ₉₁₅ | L_{b20} |
| 603 | Lₐ₉₂₀ | L_{b8} | 604 | Lₐ₉₂₀ | L_{b20} |
| 605 | Lₐ₉₂₂ | L_{b8} | 606 | Lₐ₉₂₂ | L_{b20} |
| 607 | Lₐ₉₂₃ | L_{b8} | 608 | Lₐ₉₂₃ | L_{b20} |
| 609 | Lₐ₉₂₄ | L_{b8} | 610 | Lₐ₉₂₄ | L_{b20} |
| 611 | Lₐ₉₂₅ | L_{b8} | 612 | Lₐ₉₂₅ | L_{b20} |
| 613 | Lₐ₉₂₈ | L_{b8} | 614 | Lₐ₉₂₈ | L_{b20} |
| 615 | Lₐ₉₅₃ | L_{b8} | 616 | Lₐ₉₅₃ | L_{b20} |
| 617 | Lₐ₉₅₄ | L_{b8} | 618 | Lₐ₉₅₄ | L_{b20} |
| 619 | Lₐ₉₇₄ | L_{b8} | 620 | Lₐ₉₇₄ | L_{b20} |
| 621 | Lₐ₉₇₆ | L_{b8} | 622 | Lₐ₉₇₆ | L_{b20} |
| 623 | Lₐ₉₉₅ | L_{b8} | 624 | Lₐ₉₉₅ | L_{b20} |
| 625 | Lₐ₁₀₀₆ | L_{b8} | 626 | Lₐ₁₀₀₆ | L_{b20} |
| 627 | Lₐ₁₀₁₇ | L_{b8} | 628 | Lₐ₁₀₁₇ | L_{b20} |
| 629 | Lₐ₁₀₁₈ | L_{b8} | 630 | Lₐ₁₀₁₈ | L_{b20} |
| 631 | Lₐ₁₀₂₃ | L_{b8} | 632 | Lₐ₁₀₂₃ | L_{b20} |
| 633 | Lₐ₁₀₂₄ | L_{b8} | 634 | Lₐ₁₀₂₄ | L_{b20} |
| 635 | Lₐ₁₀₂₆ | L_{b8} | 636 | Lₐ₁₀₂₆ | L_{b20} |
| 637 | Lₐ₁₀₈₈ | L_{b8} | 638 | Lₐ₁₀₈₈ | L_{b20} |
| 639 | Lₐ₁₀₈₉ | L_{b8} | 640 | Lₐ₁₀₈₉ | L_{b20} |
| 641 | Lₐ₁₀₉₅ | L_{b8} | 642 | Lₐ₁₀₉₅ | L_{b20} |
| 643 | Lₐ₁₁₀₀ | L_{b8} | 644 | Lₐ₁₁₀₀ | L_{b20} |
| 645 | Lₐ₁₁₁₆ | L_{b8} | 646 | Lₐ₁₁₁₆ | L_{b20} |
| 647 | Lₐ₁₁₁₈ | L_{b8} | 648 | Lₐ₁₁₁₈ | L_{b20} |
| 649 | Lₐ₁₁₃₆ | L_{b8} | 650 | Lₐ₁₁₃₆ | L_{b20} |
| 651 | Lₐ₁₁₄₈ | L_{b8} | 652 | Lₐ₁₁₄₈ | L_{b20} |
| 653 | Lₐ₁₁₅₈ | L_{b8} | 654 | Lₐ₁₁₅₈ | L_{b20} |
| 655 | Lₐ₁₁₅₉ | L_{b8} | 656 | Lₐ₁₁₅₉ | L_{b20} |
| 657 | Lₐ₁₁₆₁ | L_{b8} | 658 | Lₐ₁₁₆₁ | L_{b20} |
| 659 | Lₐ₁₁₆₆ | L_{b8} | 660 | Lₐ₁₁₆₆ | L_{b20} |
| 661 | Lₐ₁₁₇₁ | L_{b8} | 662 | Lₐ₁₁₇₁ | L_{b20} |
| 663 | Lₐ₁₁₈₇ | L_{b8} | 664 | Lₐ₁₁₈₇ | L_{b20} |
| 665 | Lₐ₁₁₉₂ | L_{b8} | 666 | Lₐ₁₁₉₂ | L_{b20} |
| 667 | Lₐ₁₂₀₅ | L_{b8} | 668 | Lₐ₁₂₀₅ | L_{b20} |
| 669 | Lₐ₁₂₀₈ | L_{b8} | 670 | Lₐ₁₂₀₈ | L_{b20} |
| 671 | Lₐ₁₂₁₇ | L_{b8} | 672 | Lₐ₁₂₁₇ | L_{b20} |
| 673 | Lₐ₁₂₁₉ | L_{b8} | 674 | Lₐ₁₂₁₉ | L_{b20} |
| 675 | Lₐ₁₂₃₀ | L_{b8} | 676 | Lₐ₁₂₃₀ | L_{b20} |
| 677 | Lₐ₁₂₃₇ | L_{b8} | 678 | Lₐ₁₂₃₇ | L_{b20} |
| 679 | Lₐ₁₂₃₈ | L_{b8} | 680 | Lₐ₁₂₃₈ | L_{b20} |
| 681 | Lₐ₁₂₃₉ | L_{b8} | 682 | Lₐ₁₂₃₉ | L_{b20} |
| 683 | Lₐ₁₂₄₅ | L_{b8} | 684 | Lₐ₁₂₄₅ | L_{b20} |
| 685 | Lₐ₁₂₄₆ | L_{b8} | 686 | Lₐ₁₂₄₆ | L_{b20} |
| 687 | Lₐ₁₂₄₇ | L_{b8} | 688 | Lₐ₁₂₄₇ | L_{b20} |
| 689 | Lₐ₁₂₄₈ | L_{b8} | 690 | Lₐ₁₂₄₈ | L_{b20} |
| 691 | Lₐ₁₂₅₈ | L_{b8} | 692 | Lₐ₁₂₅₈ | L_{b20} |
| 693 | Lₐ₁₂₆₀ | L_{b8} | 694 | Lₐ₁₂₆₀ | L_{b20} |
| 695 | Lₐ₁₂₆₁ | L_{b8} | 696 | Lₐ₁₂₆₁ | L_{b20} |
| 697 | Lₐ₁₂₇₇ | L_{b8} | 698 | Lₐ₁₂₇₇ | L_{b20} |
| 699 | Lₐ₁₂₇₈ | L_{b8} | 700 | Lₐ₁₂₇₈ | L_{b20} |
| 701 | Lₐ₁₂₇₉ | L_{b8} | 702 | Lₐ₁₂₇₉ | L_{b20} |
| 703 | Lₐ₁₂₈₈ | L_{b8} | 704 | Lₐ₁₂₈₈ | L_{b20} |
| 705 | Lₐ₁₂₈₉ | L_{b8} | 706 | Lₐ₁₂₈₉ | L_{b20} |
| 707 | Lₐ₁₃₀₁ | L_{b8} | 708 | Lₐ₁₃₀₁ | L_{b20} |
| 709 | Lₐ₁₃₀₂ | L_{b8} | 710 | Lₐ₁₃₀₂ | L_{b20} |
| 711 | Lₐ₁₄₄₂ | L_{b8} | 712 | Lₐ₁₄₄₂ | L_{b20} |
| 713 | Lₐ₁₄₄₈ | L_{b8} | 714 | Lₐ₁₄₄₈ | L_{b20} |
| 715 | Lₐ₁₄₄₉ | L_{b8} | 716 | Lₐ₁₄₄₉ | L_{b20} |
| 717 | Lₐ₁₄₆₀ | L_{b8} | 718 | Lₐ₁₄₆₀ | L_{b20} |
| 719 | Lₐ₁₄₇₁ | L_{b8} | 720 | Lₐ₁₄₇₁ | L_{b20} |
| 721 | Lₐ₁₅₆₉ | L_{b8} | 722 | Lₐ₁₅₆₉ | L_{b20} |
| 723 | Lₐ₁₅₇₀ | L_{b8} | 724 | Lₐ₁₅₇₀ | L_{b20} |
| 725 | Lₐ₁₆₄₇ | L_{b8} | 726 | Lₐ₁₆₄₇ | L_{b20} |
| 727 | Lₐ₁₆₄₈ | L_{b8} | 728 | Lₐ₁₆₄₈ | L_{b20} |
| 729 | Lₐ₁₆₄₉ | L_{b8} | 730 | Lₐ₁₆₄₉ | L_{b20} |
| 731 | Lₐ₁₆₅₀ | L_{b8} | 732 | Lₐ₁₆₅₀ | L_{b20} |
| 733 | Lₐ₁₆₅₁ | L_{b8} | 734 | Lₐ₁₆₅₁ | L_{b20} |
| 735 | Lₐ₁₆₇₇ | L_{b8} | 736 | Lₐ₁₆₇₇ | L_{b20} |
| 737 | Lₐ₁₆₇₈ | L_{b8} | 738 | Lₐ₁₆₇₈ | L_{b20} |
| 739 | Lₐ₁₆₇₉ | L_{b8} | 740 | Lₐ₁₆₇₉ | L_{b20} |
| 741 | Lₐ₁₆₈₀ | L_{b8} | 742 | Lₐ₁₆₈₀ | L_{b20} |
| 743 | Lₐ₁₆₉₁ | L_{b8} | 744 | Lₐ₁₆₉₁ | L_{b20} |
| 745 | Lₐ₁₆₉₃ | L_{b8} | 746 | Lₐ₁₆₉₃ | L_{b20} |
| 747 | Lₐ₁₆₉₅ | L_{b8} | 748 | Lₐ₁₆₉₅ | L_{b20} |
| 749 | Lₐ₁₆₉₆ | L_{b8} | 750 | Lₐ₁₆₉₆ | L_{b20} |
| 751 | Lₐ₁₆₉₉ | L_{b8} | 752 | Lₐ₁₆₉₉ | L_{b20} |
| 753 | Lₐ₁₇₀₁ | L_{b8} | 754 | Lₐ₁₇₀₁ | L_{b20} |
| 755 | Lₐ₁₇₀₂ | L_{b8} | 756 | Lₐ₁₇₀₂ | L_{b20} |
| 757 | Lₐ₁₇₁₂ | L_{b8} | 758 | Lₐ₁₇₁₂ | L_{b20} |
| 759 | Lₐ₁₇₁₃ | L_{b8} | 760 | Lₐ₁₇₁₃ | L_{b20} |
| 761 | Lₐ₁₇₃₅ | L_{b8} | 762 | Lₐ₁₇₃₅ | L_{b20} |
| 763 | Lₐ₁₇₉₅ | L_{b8} | 764 | Lₐ₁₇₉₅ | L_{b20} |
| 765 | Lₐ₁₈₂₀ | L_{b8} | 766 | Lₐ₁₈₂₀ | L_{b20} |
| 767 | Lₐ₁₈₉₁ | L_{b8} | 768 | Lₐ₁₈₉₁ | L_{b20} |
| 769 | Lₐ₁₈₉₂ | L_{b8} | 770 | Lₐ₁₈₉₂ | L_{b20} |
| 771 | Lₐ₁₈₉₃ | L_{b8} | 772 | Lₐ₁₈₉₃ | L_{b20} |
| 773 | Lₐ₁₈₉₉ | L_{b8} | 774 | Lₐ₁₈₉₉ | L_{b20} |
| 775 | Lₐ₁₉₀₂ | L_{b8} | 776 | Lₐ₁₉₀₂ | L_{b20} |
| 777 | Lₐ₁₉₁₃ | L_{b8} | 778 | Lₐ₁₉₁₃ | L_{b20} |
| 779 | Lₐ₁₉₁₄ | L_{b8} | 780 | Lₐ₁₉₁₄ | L_{b20} |
| 781 | Lₐ₁₉₃₃ | L_{b8} | 782 | Lₐ₁₉₃₃ | L_{b20} |
| 783 | Lₐ₁₉₄₅ | L_{b8} | 784 | Lₐ₁₉₄₅ | L_{b20} |
| 785 | Lₐ₁₉₅₄ | L_{b8} | 786 | Lₐ₁₉₅₄ | L_{b20} |
| 787 | Lₐ₁₉₅₅ | L_{b8} | 788 | Lₐ₁₉₅₅ | L_{b20} |
| 789 | Lₐ₁₉₅₆ | L_{b8} | 790 | Lₐ₁₉₅₆ | L_{b20} |
| 791 | Lₐ₁₉₆₂ | L_{b8} | 792 | Lₐ₁₉₆₂ | L_{b20} |
| 793 | Lₐ₁₉₆₄ | L_{b8} | 794 | Lₐ₁₉₆₄ | L_{b20} |
| 795 | Lₐ₁₉₆₅ | L_{b8} | 796 | Lₐ₁₉₆₅ | L_{b20} |
| 797 | Lₐ₁₉₆₆ | L_{b8} | 798 | Lₐ₁₉₆₆ | L_{b20} |
| 799 | Lₐ₁₉₇₀ | L_{b8} | 800 | Lₐ₁₉₇₀ | L_{b20} |
| 801 | Lₐ₁₉₇₃ | L_{b8} | 802 | Lₐ₁₉₇₃ | L_{b20} |
| 803 | Lₐ₂₀₀₂ | L_{b8} | 804 | Lₐ₂₀₀₂ | L_{b20} |
| 805 | Lₐ₂₀₀₃ | L_{b8} | 806 | Lₐ₂₀₀₃ | L_{b20} |
| 807 | Lₐ₂₀₁₃ | L_{b8} | 808 | Lₐ₂₀₁₃ | L_{b20} |
| 809 | Lₐ₂₀₁₄ | L_{b8} | 810 | Lₐ₂₀₁₄ | L_{b20} |
| 811 | Lₐ₂₀₁₅ | L_{b8} | 812 | Lₐ₂₀₁₅ | L_{b20} |
| 813 | Lₐ₂₀₃₃ | L_{b8} | 814 | Lₐ₂₀₃₃ | L_{b20} |
| 815 | Lₐ₂₁₀₄ | L_{b8} | 816 | Lₐ₂₁₀₄ | L_{b20} |
| 817 | Lₐ₂₃₂₆ | L_{b8} | 818 | Lₐ₂₃₂₆ | L_{b20} |
| 819 | Lₐ₂₃₃₇ | L_{b8} | 820 | Lₐ₂₃₃₇ | L_{b20} |
| 821 | Lₐ₂₄₃₆ | L_{b8} | 822 | Lₐ₂₄₃₆ | L_{b20} |
| 823 | Lₐ₂₄₃₇ | L_{b8} | 824 | Lₐ₂₄₃₇ | L_{b20} |
| 825 | Lₐ₂₅₁₄ | L_{b8} | 826 | Lₐ₂₅₁₄ | L_{b20} |
| 827 | Lₐ₂₆₁₂ | L_{b8} | 828 | Lₐ₂₆₁₂ | L_{b20} |
| 829 | Lₐ₂₆₁₈ | L_{b8} | 830 | Lₐ₂₆₁₈ | L_{b20} |
| 831 | Lₐ₂₆₄₃ | L_{b8} | 832 | Lₐ₂₆₄₃ | L_{b20} |
| 833 | Lₐ₂₆₅₄ | L_{b8} | 834 | Lₐ₂₆₅₄ | L_{b20} |
| 835 | Lₐ₂₇₁₄ | L_{b8} | 836 | Lₐ₂₇₁₄ | L_{b20} |
| 837 | Lₐ₂₇₈₅ | L_{b8} | 838 | Lₐ₂₇₈₅ | L_{b20} |
| 839 | Lₐ₂₈₅₆ | L_{b8} | 840 | Lₐ₂₈₅₆ | L_{b20} |
| 841 | Lₐ₂₉₂₇ | L_{b8} | 842 | Lₐ₂₉₂₇ | L_{b20} |
| 843 | Lₐ₃₃₃₇ | L_{b8} | 844 | Lₐ₃₃₃₇ | L_{b20} |
| 845 | Lₐ₃₃₃₈ | L_{b8} | 846 | Lₐ₃₃₃₈ | L_{b20} |
| 847 | Lₐ₃₃₃₉ | L_{b8} | 848 | Lₐ₃₃₃₉ | L_{b20} |
| 849 | Lₐ₃₃₄₀ | L_{b8} | 850 | Lₐ₃₃₄₀ | L_{b20} |
| 851 | Lₐ₃₃₄₁ | L_{b8} | 852 | Lₐ₃₃₄₁ | L_{b20} |
| 853 | Lₐ₁ | L_{b118} | 854 | Lₐ₁ | L_{b132} |
| 855 | Lₐ₁₂ | L_{b118} | 856 | Lₐ₁₂ | L_{b132} |
| 857 | Lₐ₂₁ | L_{b118} | 858 | Lₐ₂₁ | L_{b132} |
| 859 | Lₐ₂₃ | L_{b118} | 860 | Lₐ₂₃ | L_{b132} |
| 861 | Lₐ₃₃ | L_{b118} | 862 | Lₐ₃₃ | L_{b132} |
| 863 | Lₐ₄₂ | L_{b118} | 864 | Lₐ₄₂ | L_{b132} |
| 865 | Lₐ₆₃ | L_{b118} | 866 | Lₐ₆₃ | L_{b132} |
| 867 | Lₐ₆₆ | L_{b118} | 868 | Lₐ₆₆ | L_{b132} |
| 869 | Lₐ₇₅ | L_{b118} | 870 | Lₐ₇₅ | L_{b132} |
| 871 | Lₐ₈₄ | L_{b118} | 872 | Lₐ₈₄ | L_{b132} |
| 873 | Lₐ₁₀₅ | L_{b118} | 874 | Lₐ₁₀₅ | L_{b132} |
| 875 | Lₐ₁₀₇ | L_{b118} | 876 | Lₐ₁₀₇ | L_{b132} |
| 877 | Lₐ₁₂₁ | L_{b118} | 878 | Lₐ₁₂₁ | L_{b132} |
| 879 | Lₐ₁₂₈ | L_{b118} | 880 | Lₐ₁₂₈ | L_{b132} |
| 881 | Lₐ₁₃₀ | L_{b118} | 882 | Lₐ₁₃₀ | L_{b132} |
| 883 | Lₐ₁₃₁ | L_{b118} | 884 | Lₐ₁₃₁ | L_{b132} |
| 885 | Lₐ₁₃₂ | L_{b118} | 886 | Lₐ₁₃₂ | L_{b132} |
| 887 | Lₐ₁₃₃ | L_{b118} | 888 | Lₐ₁₃₃ | L_{b132} |
| 889 | Lₐ₁₃₅ | L_{b118} | 890 | Lₐ₁₃₅ | L_{b132} |
| 891 | Lₐ₁₃₆ | L_{b118} | 892 | Lₐ₁₃₆ | L_{b132} |
| 893 | Lₐ₁₄₀ | L_{b118} | 894 | Lₐ₁₄₀ | L_{b132} |
| 895 | Lₐ₁₅₀ | L_{b118} | 896 | Lₐ₁₅₀ | L_{b132} |
| 897 | Lₐ₁₅₂ | L_{b118} | 898 | Lₐ₁₅₂ | L_{b132} |
| 899 | Lₐ₁₅₄ | L_{b118} | 900 | Lₐ₁₅₄ | L_{b132} |
| 901 | Lₐ₁₅₇ | L_{b118} | 902 | Lₐ₁₅₇ | L_{b132} |
| 903 | Lₐ₁₆₁ | L_{b118} | 904 | Lₐ₁₆₁ | L_{b132} |
| 905 | Lₐ₁₇₀ | L_{b118} | 906 | Lₐ₁₇₀ | L_{b132} |
| 907 | Lₐ₁₇₁ | L_{b118} | 908 | Lₐ₁₇₁ | L_{b132} |
| 909 | Lₐ₁₈₀ | L_{b118} | 910 | Lₐ₁₈₀ | L_{b132} |
| 911 | Lₐ₁₈₂ | L_{b118} | 912 | Lₐ₁₈₂ | L_{b132} |
| 913 | Lₐ₁₈₉ | L_{b118} | 914 | Lₐ₁₈₉ | L_{b132} |
| 915 | Lₐ₁₉₁ | L_{b118} | 916 | Lₐ₁₉₁ | L_{b132} |
| 917 | Lₐ₁₉₃ | L_{b118} | 918 | Lₐ₁₉₃ | L_{b132} |
| 919 | Lₐ₂₀₁ | L_{b118} | 920 | Lₐ₂₀₁ | L_{b132} |
| 921 | Lₐ₂₀₃ | L_{b118} | 922 | Lₐ₂₀₃ | L_{b132} |
| 923 | Lₐ₂₀₅ | L_{b118} | 924 | Lₐ₂₀₅ | L_{b132} |
| 925 | Lₐ₂₀₆ | L_{b118} | 926 | Lₐ₂₀₆ | L_{b132} |
| 927 | Lₐ₂₁₂ | L_{b118} | 928 | Lₐ₂₁₂ | L_{b132} |
| 929 | Lₐ₂₂₄ | L_{b118} | 930 | Lₐ₂₂₄ | L_{b132} |
| 931 | Lₐ₂₂₇ | L_{b118} | 932 | Lₐ₂₂₇ | L_{b132} |
| 933 | Lₐ₂₃₃ | L_{b118} | 934 | Lₐ₂₃₃ | L_{b132} |
| 935 | Lₐ₂₄₀ | L_{b118} | 936 | Lₐ₂₄₀ | L_{b132} |
| 937 | Lₐ₂₄₃ | L_{b118} | 938 | Lₐ₂₄₃ | L_{b132} |
| 939 | Lₐ₂₅₂ | L_{b118} | 940 | Lₐ₂₅₂ | L_{b132} |
| 941 | Lₐ₂₅₃ | L_{b118} | 942 | Lₐ₂₅₃ | L_{b132} |
| 943 | Lₐ₂₆₅ | L_{b118} | 944 | Lₐ₂₆₅ | L_{b132} |
| 945 | Lₐ₂₇₂ | L_{b118} | 946 | Lₐ₂₇₂ | L_{b132} |
| 947 | Lₐ₂₇₃ | L_{b118} | 948 | Lₐ₂₇₃ | L_{b132} |
| 949 | Lₐ₂₇₈ | L_{b118} | 950 | Lₐ₂₇₈ | L_{b132} |
| 951 | Lₐ₂₈₂ | L_{b118} | 952 | Lₐ₂₈₂ | L_{b132} |
| 953 | Lₐ₂₈₃ | L_{b118} | 954 | Lₐ₂₈₃ | L_{b132} |
| 955 | Lₐ₂₉₃ | L_{b118} | 956 | Lₐ₂₉₃ | L_{b132} |
| 957 | Lₐ₂₉₄ | L_{b118} | 958 | Lₐ₂₉₄ | L_{b132} |
| 959 | Lₐ₂₉₅ | L_{b118} | 960 | Lₐ₂₉₅ | L_{b132} |
| 961 | Lₐ₃₁₀ | L_{b118} | 962 | Lₐ₃₁₀ | L_{b132} |
| 963 | Lₐ₃₁₄ | L_{b118} | 964 | Lₐ₃₁₄ | L_{b132} |
| 965 | Lₐ₃₂₅ | L_{b118} | 966 | Lₐ₃₂₅ | L_{b132} |
| 967 | Lₐ₃₄₃ | L_{b118} | 968 | Lₐ₃₄₃ | L_{b132} |
| 969 | Lₐ₃₄₅ | L_{b118} | 970 | Lₐ₃₄₅ | L_{b132} |
| 971 | Lₐ₃₆₃ | L_{b118} | 972 | Lₐ₃₆₃ | L_{b132} |
| 973 | Lₐ₃₈₅ | L_{b118} | 974 | Lₐ₃₈₅ | L_{b132} |
| 975 | Lₐ₃₉₆ | L_{b118} | 976 | Lₐ₃₉₆ | L_{b132} |
| 977 | Lₐ₄₀₇ | L_{b118} | 978 | Lₐ₄₀₇ | L_{b132} |
| 979 | Lₐ₄₀₈ | L_{b118} | 980 | Lₐ₄₀₈ | L_{b132} |
| 981 | Lₐ₄₁₄ | L_{b118} | 982 | Lₐ₄₁₄ | L_{b132} |
| 983 | Lₐ₄₂₃ | L_{b118} | 984 | Lₐ₄₂₃ | L_{b132} |
| 985 | Lₐ₄₃₄ | L_{b118} | 986 | Lₐ₄₃₄ | L_{b132} |
| 987 | Lₐ₄₅₆ | L_{b118} | 988 | Lₐ₄₅₆ | L_{b132} |
| 989 | Lₐ₄₆₇ | L_{b118} | 990 | Lₐ₄₆₇ | L_{b132} |
| 991 | Lₐ₆₃₀ | L_{b118} | 992 | Lₐ₆₃₀ | L_{b132} |
| 993 | Lₐ₆₃₁ | L_{b118} | 994 | Lₐ₆₃₁ | L_{b132} |
| 995 | Lₐ₆₄₅ | L_{b118} | 996 | Lₐ₆₄₅ | L_{b132} |
| 997 | Lₐ₆₄₆ | L_{b118} | 998 | Lₐ₆₄₆ | L_{b132} |
| 999 | Lₐ₆₄₇ | L_{b118} | 1000 | Lₐ₆₄₇ | L_{b132} |
| 1001 | Lₐ₆₄₈ | L_{b118} | 1002 | Lₐ₆₄₈ | L_{b132} |
| 1003 | Lₐ₆₆₅ | L_{b118} | 1004 | Lₐ₆₆₅ | L_{b132} |
| 1005 | Lₐ₇₄₆ | L_{b118} | 1006 | Lₐ₇₄₆ | L_{b132} |
| 1007 | Lₐ₇₄₇ | L_{b118} | 1008 | Lₐ₇₄₇ | L_{b132} |
| 1009 | Lₐ₈₂₄ | L_{b118} | 1010 | Lₐ₈₂₄ | L_{b132} |
| 1011 | Lₐ₈₂₅ | L_{b118} | 1012 | Lₐ₈₂₅ | L_{b132} |
| 1013 | Lₐ₈₄₄ | L_{b118} | 1014 | Lₐ₈₄₄ | L_{b132} |
| 1015 | Lₐ₈₄₆ | L_{b118} | 1016 | Lₐ₈₄₆ | L_{b132} |
| 1017 | Lₐ₈₆₅ | L_{b118} | 1018 | Lₐ₈₆₅ | L_{b132} |
| 1019 | Lₐ₈₆₈ | L_{b118} | 1020 | Lₐ₈₆₈ | L_{b132} |
| 1021 | Lₐ₈₈₉ | L_{b118} | 1022 | Lₐ₈₈₉ | L_{b132} |
| 1023 | Lₐ₉₀₉ | L_{b118} | 1024 | Lₐ₉₀₉ | L_{b132} |
| 1025 | Lₐ₉₁₃ | L_{b118} | 1026 | Lₐ₉₁₃ | L_{b132} |
| 1027 | Lₐ₉₁₅ | L_{b118} | 1028 | Lₐ₉₁₅ | L_{b132} |
| 1029 | Lₐ₉₂₀ | L_{b118} | 1030 | Lₐ₉₂₀ | L_{b132} |
| 1031 | Lₐ₉₂₂ | L_{b118} | 1032 | Lₐ₉₂₂ | L_{b132} |
| 1033 | Lₐ₉₂₃ | L_{b118} | 1034 | Lₐ₉₂₃ | L_{b132} |
| 1035 | Lₐ₉₂₄ | L_{b118} | 1036 | Lₐ₉₂₄ | L_{b132} |
| 1037 | Lₐ₉₂₅ | L_{b118} | 1038 | Lₐ₉₂₅ | L_{b132} |
| 1039 | Lₐ₉₂₈ | L_{b118} | 1040 | Lₐ₉₂₈ | L_{b132} |
| 1041 | Lₐ₉₅₃ | _{Lb118} | 1042 | Lₐ₉₅₃ | L_{b132} |
| 1043 | Lₐ₉₅₄ | L_{b118} | 1044 | Lₐ₉₅₄ | L_{b132} |
| 1045 | Lₐ₉₇₄ | L_{b118} | 1046 | Lₐ₉₇₄ | L_{b132} |
| 1047 | Lₐ₉₇₆ | L_{b118} | 1048 | Lₐ₉₇₆ | L_{b132} |
| 1049 | Lₐ₉₉₅ | L_{b118} | 1050 | Lₐ₉₉₅ | L_{b132} |
| 1051 | Lₐ₁₀₀₆ | L_{b118} | 1052 | Lₐ₁₀₀₆ | L_{b132} |
| 1053 | Lₐ₁₀₁₇ | L_{b118} | 1054 | Lₐ₁₀₁₇ | L_{b132} |
| 1055 | Lₐ₁₀₁₈ | L_{b118} | 1056 | Lₐ₁₀₁₈ | L_{b132} |
| 1057 | Lₐ₁₀₂₃ | L_{b118} | 1058 | Lₐ₁₀₂₃ | L_{b132} |
| 1059 | Lₐ₁₀₂₄ | L_{b118} | 1060 | Lₐ₁₀₂₄ | L_{b132} |
| 1061 | Lₐ₁₀₂₆ | L_{b118} | 1062 | Lₐ₁₀₂₆ | L_{b132} |
| 1063 | Lₐ₁₀₈₈ | L_{b118} | 1064 | Lₐ₁₀₈₈ | L_{b132} |
| 1065 | Lₐ₁₀₈₉ | L_{b118} | 1066 | Lₐ₁₀₈₉ | L_{b132} |
| 1067 | Lₐ₁₀₉₅ | L_{b118} | 1068 | Lₐ₁₀₉₅ | L_{b132} |
| 1069 | Lₐ₁₁₀₀ | L_{b118} | 1070 | Lₐ₁₁₀₀ | L_{b132} |
| 1071 | Lₐ₁₁₁₆ | L_{b118} | 1072 | Lₐ₁₁₁₆ | L_{b132} |
| 1073 | Lₐ₁₁₁₈ | L_{b118} | 1074 | Lₐ₁₁₁₈ | L_{b132} |
| 1075 | Lₐ₁₁₃₆ | L_{b118} | 1076 | Lₐ₁₁₃₆ | L_{b132} |
| 1077 | Lₐ₁₁₄₈ | L_{b118} | 1078 | Lₐ₁₁₄₈ | L_{b132} |
| 1079 | Lₐ₁₁₅₈ | L_{b118} | 1080 | Lₐ₁₁₅₈ | L_{b132} |
| 1081 | Lₐ₁₁₅₉ | L_{b118} | 1082 | Lₐ₁₁₅₉ | L_{b132} |
| 1083 | Lₐ₁₁₆₁ | L_{b118} | 1084 | Lₐ₁₁₆₁ | L_{b132} |
| 1085 | Lₐ₁₁₆₆ | L_{b118} | 1086 | Lₐ₁₁₆₆ | L_{b132} |
| 1087 | Lₐ₁₁₇₁ | L_{b118} | 1088 | Lₐ₁₁₇₁ | L_{b132} |
| 1089 | Lₐ₁₁₈₇ | L_{b118} | 1090 | Lₐ₁₁₈₇ | L_{b132} |
| 1091 | Lₐ₁₁₉₂ | L_{b118} | 1092 | Lₐ₁₁₉₂ | L_{b132} |
| 1093 | Lₐ₁₂₀₅ | L_{b118} | 1094 | Lₐ₁₂₀₅ | L_{b132} |
| 1095 | Lₐ₁₂₀₈ | L_{b118} | 1096 | Lₐ₁₂₀₈ | L_{b132} |
| 1097 | Lₐ₁₂₁₇ | L_{b118} | 1098 | Lₐ₁₂₁₇ | L_{b132} |
| 1099 | Lₐ₁₂₁₉ | L_{b118} | 1100 | Lₐ₁₂₁₉ | L_{b132} |
| 1101 | Lₐ₁₂₃₀ | L_{b118} | 1102 | Lₐ₁₂₃₀ | L_{b132} |
| 1103 | Lₐ₁₂₃₇ | L_{b118} | 1104 | Lₐ₁₂₃₇ | L_{b132} |
| 1105 | Lₐ₁₂₃₈ | L_{b118} | 1106 | Lₐ₁₂₃₈ | L_{b132} |
| 1107 | Lₐ₁₂₃₉ | L_{b118} | 1108 | Lₐ₁₂₃₉ | L_{b132} |
| 1109 | Lₐ₁₂₄₅ | L_{b118} | 1110 | Lₐ₁₂₄₅ | L_{b132} |
| 1111 | Lₐ₁₂₄₆ | L_{b118} | 1112 | Lₐ₁₂₄₆ | L_{b132} |
| 1113 | Lₐ₁₂₄₇ | L_{b118} | 1114 | Lₐ₁₂₄₇ | L_{b132} |
| 1115 | Lₐ₁₂₄₈ | L_{b118} | 1116 | Lₐ₁₂₄₈ | L_{b132} |
| 1117 | Lₐ₁₂₅₈ | L_{b118} | 1118 | Lₐ₁₂₅₈ | L_{b132} |
| 1119 | Lₐ₁₂₆₀ | L_{b118} | 1120 | Lₐ₁₂₆₀ | L_{b132} |
| 1121 | Lₐ₁₂₆₁ | L_{b118} | 1122 | Lₐ₁₂₆₁ | L_{b132} |
| 1123 | Lₐ₁₂₇₇ | L_{b118} | 1124 | Lₐ₁₂₇₇ | L_{b132} |
| 1125 | Lₐ₁₂₇₈ | L_{b118} | 1126 | Lₐ₁₂₇₈ | L_{b132} |
| 1127 | Lₐ₁₂₇₉ | L_{b118} | 1128 | Lₐ₁₂₇₉ | L_{b132} |
| 1129 | Lₐ₁₂₈₈ | L_{b118} | 1130 | Lₐ₁₂₈₈ | L_{b132} |
| 1131 | Lₐ₁₂₈₉ | L_{b118} | 1132 | Lₐ₁₂₈₉ | L_{b132} |
| 1133 | Lₐ₁₃₀₁ | L_{b118} | 1134 | Lₐ₁₃₀₁ | L_{b132} |
| 1135 | Lₐ₁₃₀₂ | L_{b118} | 1136 | Lₐ₁₃₀₂ | L_{b132} |
| 1137 | Lₐ₁₄₄₂ | L_{b118} | 1138 | Lₐ₁₄₄₂ | L_{b132} |
| 1139 | Lₐ₁₄₄₈ | L_{b118} | 1140 | Lₐ₁₄₄₈ | L_{b132} |
| 1141 | Lₐ₁₄₄₉ | L_{b118} | 1142 | Lₐ₁₄₄₉ | L_{b132} |
| 1143 | Lₐ₁₄₆₀ | L_{b118} | 1144 | Lₐ₁₄₆₀ | L_{b132} |
| 1145 | Lₐ₁₄₇₁ | L_{b118} | 1146 | Lₐ₁₄₇₁ | L_{b132} |
| 1147 | Lₐ₁₅₆₉ | L_{b118} | 1148 | Lₐ₁₅₆₉ | L_{b132} |
| 1149 | Lₐ₁₅₇₀ | L_{b118} | 1150 | Lₐ₁₅₇₀ | L_{b132} |
| 1151 | Lₐ₁₆₄₇ | L_{b118} | 1152 | Lₐ₁₆₄₇ | L_{b132} |
| 1153 | Lₐ₁₆₄₈ | L_{b118} | 1154 | Lₐ₁₆₄₈ | L_{b132} |
| 1155 | Lₐ₁₆₄₉ | L_{b118} | 1156 | Lₐ₁₆₄₉ | L_{b132} |
| 1157 | Lₐ₁₆₅₀ | L_{b118} | 1158 | Lₐ₁₆₅₀ | L_{b132} |
| 1159 | Lₐ₁₆₅₁ | L_{b118} | 1160 | Lₐ₁₆₅₁ | L_{b132} |
| 1161 | Lₐ₁₆₇₇ | L_{b118} | 1162 | Lₐ₁₆₇₇ | L_{b132} |
| 1163 | Lₐ₁₆₇₈ | L_{b118} | 1164 | Lₐ₁₆₇₈ | L_{b132} |
| 1165 | Lₐ₁₆₇₉ | L_{b118} | 1166 | Lₐ₁₆₇₉ | L_{b132} |
| 1167 | Lₐ₁₆₈₀ | L_{b118} | 1168 | Lₐ₁₆₈₀ | L_{b132} |
| 1169 | Lₐ₁₆₉₁ | L_{b118} | 1170 | Lₐ₁₆₉₁ | L_{b132} |
| 1171 | Lₐ₁₆₉₃ | L_{b118} | 1172 | Lₐ₁₆₉₃ | L_{b132} |
| 1173 | Lₐ₁₆₉₅ | L_{b118} | 1174 | Lₐ₁₆₉₅ | L_{b132} |
| 1175 | Lₐ₁₆₉₆ | L_{b118} | 1176 | Lₐ₁₆₉₆ | L_{b132} |
| 1177 | Lₐ₁₆₉₉ | L_{b118} | 1178 | Lₐ₁₆₉₉ | L_{b132} |
| 1179 | Lₐ₁₇₀₁ | L_{b118} | 1180 | Lₐ₁₇₀₁ | L_{b132} |
| 1181 | Lₐ₁₇₀₂ | L_{b118} | 1182 | Lₐ₁₇₀₂ | L_{b132} |
| 1183 | Lₐ₁₇₁₂ | L_{b118} | 1184 | Lₐ₁₇₁₂ | L_{b132} |
| 1185 | Lₐ₁₇₁₃ | L_{b118} | 1186 | Lₐ₁₇₁₃ | L_{b132} |
| 1187 | Lₐ₁₇₃₅ | L_{b118} | 1188 | Lₐ₁₇₃₅ | L_{b132} |
| 1189 | Lₐ₁₇₉₅ | L_{b118} | 1190 | Lₐ₁₇₉₅ | L_{b132} |
| 1191 | Lₐ₁₈₂₀ | L_{b118} | 1192 | Lₐ₁₈₂₀ | L_{b132} |
| 1193 | Lₐ₁₈₉₁ | L_{b118} | 1194 | Lₐ₁₈₉₁ | L_{b132} |
| 1195 | Lₐ₁₈₉₂ | L_{b118} | 1196 | Lₐ₁₈₉₂ | L_{b132} |
| 1197 | Lₐ₁₈₉₃ | L_{b118} | 1198 | Lₐ₁₈₉₃ | L_{b132} |
| 1199 | Lₐ₁₈₉₉ | L_{b118} | 1200 | Lₐ₁₈₉₉ | L_{b132} |
| 1201 | Lₐ₁₉₀₂ | L_{b118} | 1202 | Lₐ₁₉₀₂ | L_{b132} |
| 1203 | Lₐ₁₉₁₃ | L_{b118} | 1204 | Lₐ₁₉₁₃ | L_{b132} |
| 1205 | Lₐ₁₉₁₄ | L_{b118} | 1206 | Lₐ₁₉₁₄ | L_{b132} |
| 1207 | Lₐ₁₉₃₃ | L_{b118} | 1208 | Lₐ₁₉₃₃ | L_{b132} |
| 1209 | Lₐ₁₉₄₅ | L_{b118} | 1210 | Lₐ₁₉₄₅ | L_{b132} |
| 1211 | Lₐ₁₉₅₄ | L_{b118} | 1212 | Lₐ₁₉₅₄ | L_{b132} |
| 1213 | Lₐ₁₉₅₅ | L_{b118} | 1214 | Lₐ₁₉₅₅ | L_{b132} |
| 1215 | Lₐ₁₉₅₆ | L_{b118} | 1216 | Lₐ₁₉₅₆ | L_{b132} |
| 1217 | Lₐ₁₉₆₂ | L_{b118} | 1218 | Lₐ₁₉₆₂ | L_{b132} |
| 1219 | Lₐ₁₉₆₄ | L_{b118} | 1220 | Lₐ₁₉₆₄ | L_{b132} |
| 1221 | Lₐ₁₉₆₅ | L_{b118} | 1222 | Lₐ₁₉₆₅ | L_{b132} |
| 1223 | Lₐ₁₉₆₆ | L_{b118} | 1224 | Lₐ₁₉₆₆ | L_{b132} |
| 1225 | Lₐ₁₉₇₀ | L_{b118} | 1226 | Lₐ₁₉₇₀ | L_{b132} |
| 1227 | Lₐ₁₉₇₃ | L_{b118} | 1228 | Lₐ₁₉₇₃ | L_{b132} |
| 1229 | Lₐ₂₀₀₂ | L_{b118} | 1230 | Lₐ₂₀₀₂ | L_{b132} |
| 1231 | Lₐ₂₀₀₃ | L_{b118} | 1232 | Lₐ₂₀₀₃ | L_{b132} |
| 1233 | Lₐ₂₀₁₃ | L_{b118} | 1234 | Lₐ₂₀₁₃ | L_{b132} |
| 1235 | Lₐ₂₀₁₄ | L_{b118} | 1236 | Lₐ₂₀₁₄ | L_{b132} |
| 1237 | Lₐ₂₀₁₅ | L_{b118} | 1238 | Lₐ₂₀₁₅ | L_{b132} |
| 1239 | Lₐ₂₀₃₃ | L_{b118} | 1240 | Lₐ₂₀₃₃ | L_{b132} |
| 1241 | Lₐ₂₁₀₄ | L_{b118} | 1242 | Lₐ₂₁₀₄ | L_{b132} |
| 1243 | Lₐ₂₃₂₆ | L_{b118} | 1244 | Lₐ₂₃₂₆ | L_{b132} |
| 1245 | Lₐ₂₃₃₇ | L_{b118} | 1246 | Lₐ₂₃₃₇ | L_{b132} |
| 1247 | Lₐ₂₄₃₆ | L_{b118} | 1248 | Lₐ₂₄₃₆ | L_{b132} |
| 1249 | Lₐ₂₄₃₇ | L_{b118} | 1250 | Lₐ₂₄₃₇ | L_{b132} |
| 1251 | Lₐ₂₅₁₄ | L_{b118} | 1252 | Lₐ₂₅₁₄ | L_{b132} |
| 1253 | Lₐ₂₆₁₂ | L_{b118} | 1254 | Lₐ₂₆₁₂ | L_{b132} |
| 1255 | Lₐ₂₆₁₈ | L_{b118} | 1256 | Lₐ₂₆₁₈ | L_{b132} |
| 1257 | Lₐ₂₆₄₃ | L_{b118} | 1258 | Lₐ₂₆₄₃ | L_{b132} |
| 1259 | Lₐ₂₆₅₄ | L_{b118} | 1260 | Lₐ₂₆₅₄ | L_{b132} |
| 1261 | Lₐ₂₇₁₄ | L_{b118} | 1262 | Lₐ₂₇₁₄ | L_{b132} |
| 1263 | Lₐ₂₇₈₅ | L_{b118} | 1264 | Lₐ₂₇₈₅ | L_{b132} |
| 1265 | Lₐ₂₈₅₆ | L_{b118} | 1266 | Lₐ₂₈₅₆ | L_{b132} |
| 1267 | Lₐ₂₉₂₇ | L_{b118} | 1268 | Lₐ₂₉₂₇ | L_{b132} |
| 1269 | Lₐ₃₃₃₇ | L_{b118} | 1270 | Lₐ₃₃₃₇ | L_{b132} |
| 1271 | Lₐ₃₃₃₈ | L_{b118} | 1272 | Lₐ₃₃₃₈ | L_{b132} |
| 1273 | Lₐ₃₃₃₉ | L_{b118} | 1274 | Lₐ₃₃₃₉ | L_{b132} |
| 1275 | Lₐ₃₃₄₀ | L_{b118} | 1276 | Lₐ₃₃₄₀ | L_{b132} |
| 1277 | Lₐ₃₃₄₁ | L_{b118} | 1278 | Lₐ₃₃₄₁ | L_{b132} |
| 1279 | Lₐ₁ | L_{b52} | 1280 | Lₐ₈₈ | L_{b52} |
| 1281 | Lₐ₁₂ | L_{b52} | 1282 | Lₐ₈₉ | L_{b52} |
| 1283 | Lₐ₂₁ | L_{b52} | 1284 | Lₐ₉₀ | L_{b52} |
| 1285 | Lₐ₂₃ | L_{b52} | 1286 | Lₐ₉₁ | L_{b52} |
| 1287 | Lₐ₃₃ | L_{b52} | 1288 | Lₐ₉₂ | L_{b52} |
| 1289 | Lₐ₄₂ | L_{b52} | 1290 | Lₐ₁₀₀ | L_{b52} |
| 1291 | Lₐ₆₃ | L_{b52} | 1292 | Lₐ₁₀₁ | L_{b52} |
| 1293 | Lₐ₆₆ | L_{b52} | 1294 | Lₐ₁₀₂ | L_{b52} |
| 1295 | Lₐ₇₅ | L_{b52} | 1296 | Lₐ₁₀₃ | L_{b52} |
| 1297 | Lₐ₁₈₄ | L_{b52} | 1298 | Lₐ₁₇₄ | L_{b52} |
| 1299 | Lₐ₁₀₅ | L_{b52} | 1300 | Lₐ₁₇₅ | L_{b52} |
| 1301 | Lₐ₁₀₇ | L_{b52} | 1302 | Lₐ₁₇₆ | L_{b52} |
| 1303 | Lₐ₁₂₁ | L_{b52} | 1304 | Lₐ₁₇₇ | L_{b52} |
| 1305 | Lₐ₁₂₈ | L_{b52} | 1306 | Lₐ₂₀₉ | L_{b52} |
| 1307 | Lₐ₁₃₀ | L_{b52} | 1308 | Lₐ₂₁₀ | L_{b52} |
| 1309 | Lₐ₁₃₁ | L_{b52} | 1310 | Lₐ₂₂₁ | L_{b52} |
| 1311 | Lₐ₁₃₂ | L_{b52} | 1312 | Lₐ₂₂₂ | L_{b52} |
| 1313 | Lₐ₁₃₃ | L_{b52} | 1314 | Lₐ₂₄₈ | L_{b52} |
| 1315 | Lₐ₁₃₅ | L_{b52} | 1316 | Lₐ₂₄₉ | L_{b52} |
| 1317 | Lₐ₁₃₆ | L_{b52} | 1318 | Lₐ₂₅₀ | L_{b52} |
| 1319 | Lₐ₁₄₀ | L_{b52} | 1320 | Lₐ₂₆₈ | L_{b52} |
| 1321 | Lₐ₁₅₀ | L_{b52} | 1322 | Lₐ₂₆₉ | L_{b52} |
| 1323 | Lₐ₁₅₂ | L_{b52} | 1324 | Lₐ₃₀₁ | L_{b52} |
| 1325 | Lₐ₁₅₄ | L_{b52} | 1326 | Lₐ₃₀₂ | L_{b52} |
| 1327 | Lₐ₁₅₇ | L_{b52} | 1328 | Lₐ₃₀₃ | L_{b52} |
| 1329 | Lₐ₁₆₁ | L_{b52} | 1330 | Lₐ₃₀₄ | L_{b52} |
| 1331 | Lₐ₁₇₀ | L_{b52} | 1332 | Lₐ₃₂₂ | L_{b52} |
| 1333 | Lₐ₁₇₁ | L_{b52} | 1334 | Lₐ₃₂₃ | L_{b52} |
| 1335 | Lₐ₁₈₀ | L_{b52} | 1336 | Lₐ₃₂₄ | L_{b52} |
| 1337 | Lₐ₁₈₂ | L_{b52} | 1338 | Lₐ₃₃₆ | L_{b52} |
| 1339 | Lₐ₁₈₉ | L_{b52} | 1340 | Lₐ₃₃₇ | L_{b52} |
| 1341 | Lₐ₁₉₁ | L_{b52} | 1342 | Lₐ₃₃₈ | L_{b52} |
| 1343 | Lₐ₁₉₃ | L_{b52} | 1344 | Lₐ₃₆₅ | L_{b52} |
| 1345 | Lₐ₂₀₁ | L_{b52} | 1346 | Lₐ₃₆₆ | L_{b52} |
| 1347 | Lₐ₂₀₃ | L_{b52} | 1348 | Lₐ₃₆₇ | L_{b52} |
| 1349 | Lₐ₂₀₅ | L_{b52} | 1350 | Lₐ₃₈₁ | L_{b52} |
| 1351 | Lₐ₂₀₆ | L_{b52} | 1352 | Lₐ₃₈₂ | L_{b52} |
| 1353 | Lₐ₂₁₂ | L_{b52} | 1354 | Lₐ₃₈₃ | L_{b52} |
| 1355 | Lₐ₂₂₄ | L_{b52} | 1356 | Lₐ₄₁₇ | L_{b52} |
| 1357 | Lₐ₂₂₇ | L_{b52} | 1358 | Lₐ₄₁₈ | L_{b52} |
| 1359 | Lₐ₂₃₃ | L_{b52} | 1360 | Lₐ₄₁₉ | L_{b52} |
| 1361 | Lₐ₂₄₀ | L_{b52} | 1362 | Lₐ₄₂₀ | L_{b52} |
| 1363 | Lₐ₂₄₃ | L_{b52} | 1364 | Lₐ₄₃₇ | L_{b52} |
| 1365 | Lₐ₂₅₂ | L_{b52} | 1366 | Lₐ₄₃₈ | L_{b52} |
| 1367 | Lₐ₂₅₃ | L_{b52} | 1368 | Lₐ₄₃₉ | L_{b52} |
| 1369 | Lₐ₂₆₅ | L_{b52} | 1370 | Lₐ₄₅₃ | L_{b52} |
| 1371 | Lₐ₂₇₂ | L_{b52} | 1372 | Lₐ₄₅₄ | L_{b52} |
| 1373 | Lₐ₂₇₃ | L_{b52} | 1374 | Lₐ₄₆₄ | L_{b52} |
| 1375 | Lₐ₂₇₈ | L_{b52} | 1376 | Lₐ₄₆₅ | L_{b52} |
| 1377 | Lₐ₂₈₂ | L_{b52} | 1378 | Lₐ₄₆₆ | L_{b52} |
| 1379 | Lₐ₂₈₃ | L_{b52} | 1380 | Lₐ₄₆₇ | L_{b52} |
| 1381 | Lₐ₂₉₃ | L_{b52} | 1382 | Lₐ₄₈₅ | L_{b52} |
| 1383 | Lₐ₂₉₄ | L_{b52} | 1384 | Lₐ₄₈₆ | L_{b52} |
| 1385 | Lₐ₂₉₅ | L_{b52} | 1386 | Lₐ₄₈₇ | L_{b52} |
| 1387 | Lₐ₃₁₀ | L_{b52} | 1388 | Lₐ₅₀₄ | L_{b52} |
| 1389 | Lₐ₃₁₄ | L_{b52} | 1390 | Lₐ₅₀₅ | L_{b52} |
| 1391 | Lₐ₃₂₅ | L_{b52} | 1392 | Lₐ₅₀₆ | L_{b52} |
| 1393 | Lₐ₃₄₃ | L_{b52} | 1394 | Lₐ₅ₒ₇ | L_{b52} |
| 1395 | Lₐ₃₄₅ | L_{b52} | 1396 | Lₐ₅₃₄ | L_{b52} |
| 1397 | Lₐ₃₆₃ | L_{b52} | 1398 | Lₐ₅₃₅ | L_{b52} |
| 1399 | Lₐ₃₈₅ | L_{b52} | 1400 | Lₐ₅₃₆ | L_{b52} |
| 1401 | Lₐ₃₉₆ | L_{b52} | 1402 | Lₐ₅₄₈ | L_{b52} |
| 1403 | Lₐ₄₀₇ | L_{b52} | 1404 | Lₐ₅₄₉ | L_{b52} |
| 1405 | Lₐ₄₀₈ | L_{b52} | 1406 | Lₐ₅₅₀ | L_{b52} |
| 1407 | Lₐ₄₁₄ | L_{b52} | 1408 | Lₐ₅₅₁ | L_{b52} |
| 1409 | Lₐ₄₂₃ | L_{b52} | 1410 | Lₐ₅₇₅ | L_{b52} |
| 1411 | Lₐ₄₃₄ | L_{b52} | 1412 | Lₐ₅₇₆ | L_{b52} |
| 1413 | Lₐ₄₅₆ | L_{b52} | 1414 | Lₐ₆₀₄ | L_{b52} |
| 1415 | Lₐ₄₆₇ | L_{b52} | 1416 | Lₐ₆₀₅ | L_{b52} |
| 1417 | Lₐ₆₃₀ | L_{b52} | 1418 | Lₐ₆₀₆ | L_{b52} |
| 1419 | Lₐ₆₃₁ | L_{b52} | 1420 | Lₐ₆₀₇ | L_{b52} |
| 1421 | Lₐ₆₄₅ | L_{b52} | 1422 | Lₐ₆₃₇ | L_{b52} |
| 1423 | Lₐ₆₄₆ | L_{b52} | 1424 | Lₐ₆₃₈ | L_{b52} |
| 1425 | Lₐ₆₄₇ | L_{b52} | 1426 | Lₐ₆₃₉ | L_{b52} |
| 1427 | Lₐ₆₄₈ | L_{b52} | 1428 | Lₐ₆₅₄ | L_{b52} |
| 1429 | Lₐ₆₆₅ | L_{b52} | 1430 | Lₐ₆₅₅ | L_{b52} |
| 1431 | Lₐ₇₄₆ | L_{b52} | 1432 | Lₐ₆₅₆ | L_{b52} |
| 1433 | Lₐ₇₄₇ | L_{b52} | 1434 | Lₐ₆₅₇ | L_{b52} |
| 1435 | Lₐ₈₂₄ | L_{b52} | 1436 | Lₐ₆₇₀ | L_{b52} |
| 1437 | Lₐ₈₂₅ | L_{b52} | 1438 | Lₐ₆₇₁ | L_{b52} |
| 1439 | Lₐ₈₄₄ | L_{b52} | 1440 | Lₐ₆₇₂ | L_{b52} |
| 1441 | Lₐ₈₄₆ | L_{b52} | 1442 | Lₐ₆₇₃ | L_{b52} |
| 1443 | Lₐ₈₆₅ | L_{b52} | 1444 | Lₐ₆₇₄ | L_{b52} |
| 1445 | Lₐ₈₆₈ | L_{b52} | 1446 | Lₐ₆₇₅ | L_{b52} |
| 1447 | Lₐ₈₈₉ | L_{b52} | 1448 | Lₐ₆₈₄ | L_{b52} |
| 1449 | Lₐ₉₀₉ | L_{b52} | 1450 | Lₐ₆₈₅ | L_{b52} |
| 1451 | Lₐ₉₁₃ | L_{b52} | 1452 | Lₐ₆₈₆ | L_{b52} |
| 1453 | Lₐ₉₁₅ | L_{b52} | 1454 | Lₐ₆₈₇ | L_{b52} |
| 1455 | Lₐ₉₂₀ | L_{b52} | 1456 | Lₐ₇₀₁ | L_{b52} |
| 1457 | Lₐ₉₂₂ | L_{b52} | 1458 | Lₐ₇₀₂ | L_{b52} |
| 1459 | Lₐ₉₂₃ | L_{b52} | 1460 | Lₐ₇₀₃ | L_{b52} |
| 1461 | Lₐ₉₂₄ | L_{b52} | 1462 | Lₐ₇₀₄ | L_{b52} |
| 1463 | Lₐ₉₂₅ | L_{b52} | 1464 | Lₐ₇₀₈ | L_{b52} |
| 1465 | Lₐ₉₂₈ | L_{b52} | 1466 | Lₐ₇₀₉ | L_{b52} |
| 1467 | Lₐ₉₅₃ | L_{b52} | 1468 | Lₐ₇₁₀ | L_{b52} |
| 1469 | Lₐ₉₅₄ | L_{b52} | 1470 | Lₐ₇₁₁ | L_{b52} |
| 1471 | Lₐ₉₇₄ | L_{b52} | 1472 | Lₐ₇₁₂ | L_{b52} |
| 1473 | Lₐ₉₇₆ | L_{b52} | 1474 | Lₐ₇₁₃ | L_{b52} |
| 1475 | Lₐ₉₉₅ | L_{b52} | 1476 | Lₐ₇₁₄ | L_{b52} |
| 1477 | Lₐ₁₀₀₆ | L_{b52} | 1478 | Lₐ₇₂₉ | L_{b52} |
| 1479 | Lₐ₁₀₁₇ | L_{b52} | 1480 | Lₐ₇₃₁ | L_{b52} |
| 1481 | Lₐ₁₀₁₈ | L_{b52} | 1482 | Lₐ₇₃₂ | L_{b52} |
| 1483 | Lₐ₁₀₂₃ | L_{b52} | 1484 | Lₐ₇₃₃ | L_{b52} |
| 1485 | Lₐ₁₀₂₄ | L_{b52} | 1486 | Lₐ₇₄₁ | L_{b52} |
| 1487 | Lₐ₁₀₂₆ | L_{b52} | 1488 | Lₐ₇₄₂ | L_{b52} |
| 1489 | Lₐ₁₀₈₈ | L_{b52} | 1490 | Lₐ₇₄₃ | L_{b52} |
| 1491 | Lₐ₁₀₈₉ | L_{b52} | 1492 | Lₐ₇₄₄ | L_{b52} |
| 1493 | Lₐ₁₀₉₅ | L_{b52} | 1494 | Lₐ₇₄₈ | L_{b52} |
| 1495 | Lₐ₁₁₀₀ | L_{b52} | 1496 | Lₐ₇₄₉ | L_{b52} |
| 1497 | Lₐ₁₁₁₆ | L_{b52} | 1498 | Lₐ₇₅₀ | L_{b52} |
| 1499 | Lₐ₁₁₁₈ | L_{b52} | 1500 | Lₐ₇₅₁ | L_{b52} |
| 1501 | Lₐ₁₁₃₆ | L_{b52} | 1502 | Lₐ₇₅₂ | L_{b52} |
| 1503 | Lₐ₁₁₄₈ | L_{b52} | 1504 | Lₐ₇₅₃ | L_{b52} |
| 1505 | Lₐ₁₁₅₈ | L_{b52} | 1506 | Lₐ₇₅₄ | L_{b52} |
| 1507 | Lₐ₁₁₅₉ | L_{b52} | 1508 | Lₐ₇₅₅ | L_{b52} |
| 1509 | Lₐ₁₁₆₁ | L_{b52} | 1510 | Lₐ₇₅₆ | L_{b52} |
| 1511 | Lₐ₁₁₆₆ | L_{b52} | 1512 | Lₐ₇₅₇ | L_{b52} |
| 1513 | Lₐ₁₁₇₁ | L_{b52} | 1514 | Lₐ₇₅₈ | L_{b52} |
| 1515 | Lₐ₁₁₈₇ | L_{b52} | 1516 | Lₐ₇₆₆ | L_{b52} |
| 1517 | Lₐ₁₁₉₂ | L_{b52} | 1518 | Lₐ₇₆₇ | L_{b52} |
| 1519 | Lₐ₁₂₀₅ | L_{b52} | 1520 | Lₐ₇₆₈ | L_{b52} |
| 1521 | Lₐ₁₂₀₈ | L_{b52} | 1522 | Lₐ₇₆₉ | L_{b52} |
| 1523 | Lₐ₁₂₁₇ | L_{b52} | 1524 | Lₐ₇₇₀ | L_{b52} |
| 1525 | Lₐ₁₂₁₉ | L_{b52} | 1526 | Lₐ₇₇₁ | L_{b52} |
| 1527 | Lₐ₁₂₃₀ | L_{b52} | 1528 | Lₐ₇₇₂ | L_{b52} |
| 1529 | Lₐ₁₂₃₇ | L_{b52} | 1530 | Lₐ₇₇₃ | L_{b52} |
| 1531 | Lₐ₁₂₃₈ | L_{b52} | 1532 | Lₐ₇₇₄ | L_{b52} |
| 1533 | Lₐ₁₂₃₉ | L_{b52} | 1534 | Lₐ₇₇₅ | L_{b52} |
| 1535 | Lₐ₁₂₄₅ | L_{b52} | 1536 | Lₐ₇₇₆ | L_{b52} |
| 1537 | Lₐ₁₂₄₆ | L_{b52} | 1538 | Lₐ₇₇₇ | L_{b52} |
| 1539 | Lₐ₁₂₄₇ | L_{b52} | 1540 | Lₐ₇₇₈ | L_{b52} |
| 1541 | Lₐ₁₂₄₈ | L_{b52} | 1542 | Lₐ₇₇₉ | L_{b52} |
| 1543 | Lₐ₁₂₅₈ | L_{b52} | 1544 | Lₐ₇₈₀ | L_{b52} |
| 1545 | Lₐ₁₂₆₀ | L_{b52} | 1546 | Lₐ₇₈₁ | L_{b52} |
| 1547 | Lₐ₁₂₆₁ | L_{b52} | 1548 | Lₐ₇₈₂ | L_{b52} |
| 1549 | Lₐ₁₂₇₇ | L_{b52} | 1550 | Lₐ₇₉₀ | L_{b52} |
| 1551 | Lₐ₁₂₇₈ | L_{b52} | 1552 | Lₐ₇₉₁ | L_{b52} |
| 1553 | Lₐ₁₂₇₉ | L_{b52} | 1554 | Lₐ₇₉₂ | L_{b52} |
| 1555 | Lₐ₁₂₈₈ | L_{b52} | 1556 | Lₐ₇₉₃ | L_{b52} |
| 1557 | Lₐ₁₂₈₉ | L_{b52} | 1558 | Lₐ₇₉₄ | L_{b52} |
| 1559 | Lₐ₁₃₀₁ | L_{b52} | 1560 | Lₐ₈₀₀ | L_{b52} |
| 1561 | Lₐ₁₃₀₂ | L_{b52} | 1562 | Lₐ₈₀₄ | L_{b52} |
| 1563 | Lₐ₁₄₄₂ | L_{b52} | 1564 | Lₐ₈₀₅ | L_{b52} |
| 1565 | Lₐ₁₄₄₈ | L_{b52} | 1566 | Lₐ₉₃₃ | L_{b52} |
| 1567 | Lₐ₁₄₄₉ | L_{b52} | 1568 | Lₐ₉₃₄ | L_{b52} |
| 1569 | Lₐ₁₄₆₀ | L_{b52} | 1570 | Lₐ₉₃₅ | L_{b52} |
| 1571 | Lₐ₁₄₇₁ | L_{b52} | 1572 | Lₐ₉₃₆ | L_{b52} |
| 1573 | Lₐ₁₅₆₉ | L_{b52} | 1574 | Lₐ₉₉₂ | L_{b52} |
| 1575 | Lₐ₁₅₇₀ | L_{b52} | 1576 | Lₐ₉₉₃ | L_{b52} |
| 1577 | Lₐ₁₆₄₇ | L_{b52} | 1578 | Lₐ₉₉₄ | L_{b52} |
| 1579 | Lₐ₁₆₄₈ | L_{b52} | 1580 | Lₐ₁₀₁₅ | L_{b52} |
| 1581 | Lₐ₁₆₄₉ | L_{b52} | 1582 | Lₐ₁₀₁₆ | L_{b52} |
| 1583 | Lₐ₁₆₅₀ | L_{b52} | 1584 | L₁₀₂₈ | L_{b52} |
| 1585 | Lₐ₁₆₅₁ | L_{b52} | 1586 | Lₐ₁₀₂₉ | L_{b52} |
| 1587 | Lₐ₁₆₇₇ | L_{b52} | 1588 | Lₐ₁₀₃₀ | L_{b52} |
| 1589 | Lₐ₁₆₇₈ | L_{b52} | 1590 | Lₐ₁₀₃₁ | L_{b52} |
| 1591 | Lₐ₁₆₇₉ | L_{b52} | 1592 | Lₐ₁₀₄₄ | L_{b52} |
| 1593 | Lₐ₁₆₈₀ | L_{b52} | 1594 | Lₐ₁₀₄₅ | L_{b52} |
| 1595 | Lₐ₁₆₉₁ | L_{b52} | 1596 | Lₐ₁₀₄₆ | L_{b52} |
| 1597 | Lₐ₁₆₉₃ | L_{b52} | 1598 | Lₐ₁₀₄₇ | L_{b52} |
| 1599 | Lₐ₁₆₉₅ | L_{b52} | 1600 | Lₐ₁₀₆₁ | L_{b52} |
| 1601 | Lₐ₁₆₉₆ | L_{b52} | 1602 | Lₐ₁₀₆₂ | L_{b52} |
| 1603 | Lₐ₁₆₉₉ | L_{b52} | 1604 | Lₐ₁₀₆₃ | L_{b52} |
| 1605 | Lₐ₁₇₀₁ | L_{b52} | 1606 | Lₐ₁₀₆₄ | L_{b52} |
| 1607 | Lₐ₁₇₀₂ | L_{b52} | 1608 | Lₐ₁₀₆₅ | L_{b52} |
| 1609 | Lₐ₁₇₁₂ | L_{b52} | 1610 | Lₐ₁₀₇₄ | L_{b52} |
| 1611 | Lₐ₁₇₁₃ | L_{b52} | 1612 | Lₐ₁₀₇₅ | L_{b52} |
| 1613 | Lₐ₁₇₃₅ | L_{b52} | 1614 | Lₐ₁₀₇₆ | L_{b52} |
| 1615 | Lₐ₁₇₉₅ | L_{b52} | 1616 | Lₐ₁₀₈₃ | L_{b52} |
| 1617 | Lₐ₁₈₂₀ | L_{b52} | 1618 | Lₐ₁₀₈₄ | L_{b52} |
| 1619 | Lₐ₁₈₉₁ | L_{b52} | 1620 | Lₐ₁₀₈₅ | L_{b52} |
| 1621 | Lₐ₁₈₉₂ | L_{b52} | 1622 | Lₐ₁₀₉₀ | L_{b52} |
| 1623 | Lₐ₁₈₉₃ | L_{b52} | 1624 | Lₐ₁₀₉₁ | L_{b52} |
| 1625 | Lₐ₁₈₉₉ | L_{b52} | 1626 | Lₐ₁₀₉₂ | L_{b52} |
| 1627 | Lₐ₁₉₀₂ | L_{b52} | 1628 | Lₐ₁₁₁₃ | L_{b52} |
| 1629 | Lₐ₁₉₁₃ | L_{b52} | 1630 | Lₐ₁₁₁₄ | L_{b52} |
| 1631 | Lₐ₁₉₁₄ | L_{b52} | 1632 | Lₐ₁₁₂₁ | L_{b52} |
| 1633 | Lₐ₁₉₃₃ | L_{b52} | 1634 | Lₐ₁₁₂₂ | L_{b52} |
| 1635 | Lₐ₁₉₄₅ | L_{b52} | 1636 | Lₐ₁₁₂₃ | L_{b52} |
| 1637 | Lₐ₁₉₅₄ | L_{b52} | 1638 | Lₐ₁₁₂₄ | L_{b52} |
| 1639 | Lₐ₁₉₅₅ | L_{b52} | 1640 | Lₐ₁₁₃₃ | L_{b52} |
| 1641 | Lₐ₁₉₅₆ | L_{b52} | 1642 | Lₐ₁₁₃₄ | L_{b52} |
| 1643 | Lₐ₁₉₆₂ | L_{b52} | 1644 | Lₐ₁₁₃₅ | L_{b52} |
| 1645 | Lₐ₁₉₆₄ | L_{b52} | 1646 | Lₐ₁₁₄₅ | L_{b52} |
| 1647 | Lₐ₁₉₆₅ | L_{b52} | 1648 | Lₐ₁₁₄₆ | L_{b52} |
| 1649 | Lₐ₁₉₆₆ | L_{b52} | 1650 | Lₐ₁₁₄₇ | L_{b52} |
| 1651 | Lₐ₁₉₇₀ | L_{b52} | 1652 | Lₐ₁₁₇₅ | L_{b52} |
| 1653 | Lₐ₁₉₇₃ | L_{b52} | 1654 | Lₐ₁₁₇₆ | L_{b52} |
| 1655 | Lₐ₂₀₀₂ | L_{b52} | 1656 | Lₐ₁₁₇₇ | L_{b52} |
| 1657 | Lₐ₂₀₀₃ | L_{b52} | 1658 | Lₐ₁₂₂₇ | L_{b52} |
| 1659 | Lₐ₂₀₁₃ | L_{b52} | 1660 | Lₐ₁₂₂₈ | L_{b52} |
| 1661 | Lₐ₂₀₁₄ | L_{b52} | 1662 | Lₐ₁₂₄₁ | L_{b52} |
| 1663 | Lₐ₂₀₁₅ | L_{b52} | 1664 | Lₐ₁₂₄₂ | L_{b52} |
| 1665 | Lₐ₂₀₃₃ | L_{b52} | 1666 | Lₐ₁₂₆₅ | L_{b52} |
| 1667 | Lₐ₂₁₀₄ | L_{b52} | 1668 | Lₐ₁₂₆₆ | L_{b52} |
| 1669 | Lₐ₂₃₂₆ | L_{b52} | 1670 | Lₐ₁₂₆₇ | L_{b52} |
| 1671 | Lₐ₂₃₃₇ | L_{b52} | 1672 | Lₐ₁₂₉₈ | L_{b52} |
| 1673 | Lₐ₂₄₃₆ | L_{b52} | 1674 | Lₐ₁₂₉₉ | L_{b52} |
| 1675 | Lₐ₂₄₃₇ | L_{b52} | 1676 | Lₐ₁₃₀₈ | L_{b52} |
| 1677 | Lₐ₂₅₁₄ | L_{b52} | 1678 | Lₐ₁₃₀₉ | L_{b52} |
| 1679 | Lₐ₂₆₁₂ | L_{b52} | 1680 | Lₐ₁₃₂₉ | L_{b52} |
| 1681 | Lₐ₂₆₁₈ | L_{b52} | 1682 | Lₐ₁₃₃₀ | L_{b52} |
| 1683 | Lₐ₂₆₄₃ | L_{b52} | 1684 | Lₐ₁₃₃₄ | L_{b52} |
| 1685 | Lₐ₂₆₅₄ | L_{b52} | 1686 | Lₐ₁₃₃₅ | L_{b52} |
| 1687 | Lₐ₂₇₁₄ | L_{b52} | 1688 | Lₐ₁₃₃₆ | L_{b52} |
| 1689 | Lₐ₂₇₈₅ | L_{b52} | 1690 | Lₐ₁₃₄₅ | L_{b52} |
| 1691 | Lₐ₂₈₅₆ | L_{b52} | 1692 | Lₐ₁₃₄₆ | L_{b52} |
| 1693 | Lₐ₂₉₂₇ | L_{b52} | 1694 | Lₐ₁₃₄₇ | L_{b52} |
| 1695 | Lₐ₃₃₃₇ | L_{b52} | 1696 | Lₐ₁₃₄₈ | L_{b52} |
| 1697 | Lₐ₃₃₃₈ | L_{b52} | 1698 | Lₐ₁₃₅₇ | L_{b52} |
| 1699 | Lₐ₃₃₃₉ | L_{b52} | 1700 | Lₐ₁₃₅₈ | L_{b52} |
| 1701 | Lₐ₃₃₄₀ | L_{b52} | 1702 | Lₐ₁₃₅₉ | L_{b52} |
| 1703 | Lₐ₃₃₄₁ | L_{b52} | 1704 | Lₐ₁₃₆₀ | L_{b52} |
| 1705 | Lₐ₁₃₆₉ | L_{b52} | 1706 | Lₐ₁₄₂₇ | L_{b52} |
| 1707 | Lₐ₁₃₇₀ | L_{b52} | 1708 | Lₐ₁₄₂₈ | L_{b52} |
| 1709 | Lₐ₁₃₇₁ | L_{b52} | 1710 | Lₐ₁₄₂₉ | L_{b52} |
| 1711 | Lₐ₁₃₇₂ | L_{b52} | 1712 | Lₐ₁₄₃₀ | L_{b52} |
| 1713 | Lₐ₁₃₉₇ | L_{b52} | 1714 | Lₐ₁₄₃₁ | L_{b52} |
| 1715 | Lₐ₁₃₉₈ | L_{b52} | 1716 | Lₐ₁₄₃₈ | L_{b52} |
| 1717 | Lₐ₁₃₉₉ | L_{b52} | 1718 | Lₐ₁₄₃₉ | L_{b52} |
| 1719 | Lₐ₁₄₀₀ | L_{b52} | 1720 | Lₐ₁₄₄₀ | L_{b52} |
| 1721 | Lₐ₁₄₁₅ | L_{b52} | 1722 | Lₐ₁₄₄₁ | L_{b52} |
| 1723 | Lₐ₁₄₁₆ | L_{b52} | 1724 | Lₐ₁₄₆₃ | L_{b52} |
| 1725 | Lₐ₁₄₁₇ | L_{b52} | 1726 | Lₐ₁₄₆₄ | L_{b52} |
| 1727 | Lₐ₁₄₁₈ | L_{b52} | 1728 | Lₐ₁₄₆₅ | L_{b52} |
| 1729 | Lₐ₁₄₁₉ | L_{b52} | 1730 | Lₐ₁₄₆₆ | L_{b52} |
| 1731 | Lₐ₁₄₇₈ | L_{b52} | 1732 | Lₐ₁₄₉₁ | L_{b52} |
| 1733 | Lₐ₁₄₇₉ | L_{b52} | 1734 | Lₐ₁₄₉₂ | L_{b52} |
| 1735 | Lₐ₁₄₈₀ | L_{b52} | 1736 | Lₐ₁₄₉₃ | L_{b52} |
| 1737 | Lₐ₁₄₈₁ | L_{b52} | 1738 | Lₐ₁₅₀₅ | L_{b52} |
| 1739 | Lₐ₁₄₈₂ | L_{b52} | 1740 | Lₐ₁₅₀₆ | L_{b52} |
| 1741 | Lₐ₁₅₂₅ | L_{b52} | 1742 | Lₐ₁₅₀₇ | L_{b52} |
| 1743 | Lₐ₁₅₂₆ | L_{b52} | 1744 | Lₐ₁₅₀₈ | L_{b52} |
| 1745 | Lₐ₁₅₂₇ | L_{b52} | 1746 | Lₐ₁₅₃₇ | L_{b52} |
| 1747 | Lₐ₁₅₂₈ | L_{b52} | 1748 | Lₐ₁₅₃₈ | L_{b52} |
| 1749 | Lₐ₁₅₂₉ | L_{b52} | 1750 | Lₐ₁₅₃₉ | L_{b52} |
| 1751 | Lₐ₁₅₃₀ | L_{b52} | 1752 | Lₐ₁₅₄₀ | L_{b52} |
| 1753 | Lₐ₁₅₅₀ | L_{b52} | 1754 | Lₐ₁₅₄₁ | L_{b52} |
| 1755 | Lₐ₁₅₅₁ | L_{b52} | 1756 | Lₐ₁₅₄₂ | L_{b52} |
| 1757 | Lₐ₁₅₅₂ | L_{b52} | 1758 | Lₐ₁₅₇₇ | L_{b52} |
| 1759 | Lₐ₁₅₅₉ | L_{b52} | 1760 | Lₐ₁₅₇₈ | L_{b52} |
| 1761 | Lₐ₁₅₆₀ | L_{b52} | 1762 | Lₐ₁₅₇₉ | L_{b52} |
| 1763 | Lₐ₁₅₆₁ | L_{b52} | 1764 | Lₐ₁₅₈₀ | L_{b52} |
| 1765 | Lₐ₁₅₆₂ | L_{b52} | 1766 | Lₐ₁₅₉₂ | L_{b52} |
| 1767 | Lₐ₁₅₆₃ | L_{b52} | 1768 | Lₐ₁₅₉₃ | L_{b52} |
| 1769 | Lₐ₁₅₉₈ | L_{b52} | 1770 | Lₐ₁₅₉₄ | L_{b52} |
| 1771 | Lₐ₁₅₉₉ | L_{b52} | 1772 | Lₐ₁₆₀₆ | L_{b52} |
| 1773 | Lₐ₁₆₀₀ | L_{b52} | 1774 | Lₐ₁₆₀₇ | L_{b52} |
| 1775 | Lₐ₁₆₀₁ | L_{b52} | 1776 | Lₐ₁₆₀₈ | L_{b52} |
| 1777 | Lₐ₁₆₁₇ | L_{b52} | 1778 | Lₐ₁₆₄₃ | L_{b52} |
| 1779 | Lₐ₁₆₁₈ | L_{b52} | 1780 | Lₐ₁₆₄₄ | L_{b52} |
| 1781 | Lₐ₁₆₁₉ | L_{b52} | 1782 | Lₐ₁₆₅₄ | L_{b52} |
| 1783 | Lₐ₁₆₂₀ | L_{b52} | 1784 | Lₐ₁₆₅₅ | L_{b52} |
| 1785 | Lₐ₁₆₈₇ | L_{b52} | 1786 | Lₐ₁₆₅₆ | L_{b52} |
| 1787 | Lₐ₁₆₈₈ | L_{b52} | 1788 | Lₐ₁₆₅₇ | L_{b52} |
| 1789 | Lₐ₁₆₈₉ | L_{b52} | 1790 | Lₐ₁₆₅₈ | L_{b52} |
| 1791 | Lₐ₁₇₁₈ | L_{b52} | 1792 | Lₐ₁₆₅₉ | L_{b52} |
| 1793 | Lₐ₁₇₁₉ | L_{b52} | 1794 | Lₐ₁₇₅₃ | L_{b52} |
| 1795 | Lₐ₁₇₂₀ | L_{b52} | 1796 | Lₐ₁₇₅₄ | L_{b52} |
| 1797 | Lₐ₁₇₂₁ | L_{b52} | 1798 | Lₐ₁₇₅₅ | L_{b52} |
| 1799 | Lₐ₁₇₂₂ | L_{b52} | 1800 | Lₐ₁₇₅₆ | L_{b52} |
| 1801 | Lₐ₁₇₇₃ | L_{b52} | 1802 | Lₐ₁₇₅₇ | L_{b52} |
| 1803 | Lₐ₁₇₇₄ | L_{b52} | 1804 | Lₐ₁₇₅₈ | L_{b52} |
| 1805 | Lₐ₁₇₇₅ | L_{b52} | 1806 | Lₐ₁₇₉₉ | L_{b52} |
| 1807 | Lₐ₁₇₇₆ | L_{b52} | 1808 | Lₐ₁₈₀₀ | L_{b52} |
| 1809 | Lₐ₁₇₇₇ | L_{b52} | 1810 | Lₐ₁₈₀₁ | L_{b52} |
| 1811 | Lₐ₁₇₇₈ | L_{b52} | 1812 | Lₐ₁₈₁₅ | L_{b52} |
| 1813 | Lₐ₁₇₇₉ | L_{b52} | 1814 | Lₐ₁₈₁₆ | L_{b52} |
| 1815 | Lₐ₁₈₂₈ | L_{b52} | 1816 | Lₐ₁₈₁₇ | L_{b52} |
| 1817 | Lₐ₁₈₂₉ | L_{b52} | 1818 | Lₐ₁₈₄₁ | L_{b52} |
| 1819 | Lₐ₁₈₃₀ | L_{b52} | 1820 | Lₐ₁₈₄₂ | L_{b52} |
| 1821 | Lₐ₁₈₄₉ | L_{b52} | 1822 | Lₐ₁₈₄₃ | L_{b52} |
| 1823 | Lₐ₁₈₅₀ | L_{b52} | 1824 | Lₐ₁₈₄₄ | L_{b52} |
| 1825 | Lₐ₁₈₅₁ | L_{b52} | 1826 | Lₐ₁₈₅₉ | L_{b52} |
| 1827 | Lₐ₁₈₇₅ | L_{b52} | 1828 | Lₐ₁₈₆₀ | L_{b52} |
| 1829 | Lₐ₁₈₇₆ | L_{b52} | 1830 | Lₐ₁₈₆₁ | L_{b52} |
| 1831 | Lₐ₁₈₇₇ | L_{b52} | 1832 | Lₐ₁₈₆₂ | L_{b52} |
| 1833 | Lₐ₁₉₁₈ | L_{b52} | 1834 | Lₐ₁₈₈₅ | L_{b52} |
| 1835 | Lₐ₁₉₁₉ | L_{b52} | 1836 | Lₐ₁₈₈₆ | L_{b52} |
| 1837 | Lₐ₁₉₂₀ | L_{b52} | 1838 | Lₐ₁₈₈₇ | L_{b52} |
| 1839 | Lₐ₁₉₅₈ | L_{b52} | 1840 | Lₐ₁₉₈₃ | L_{b52} |
| 1841 | Lₐ₁₉₅₉ | L_{b52} | 1842 | Lₐ₁₉₈₄ | L_{b52} |
| 1843 | Lₐ₁₉₆₀ | L_{b52} | 1844 | Lₐ₁₉₈₅ | L_{b52} |
| 1845 | Lₐ₂₀₂₄ | L_{b52} | 1846 | Lₐ₁₉₈₆ | L_{b52} |
| 1847 | Lₐ₂₀₂₅ | L_{b52} | 1848 | Lₐ₂₀₇₂ | L_{b52} |
| 1849 | Lₐ₂₀₉₆ | L_{b52} | 1850 | Lₐ₂₀₇₃ | L_{b52} |
| 1851 | Lₐ₂₀₉₇ | L_{b52} | 1852 | Lₐ₂₁₂₄ | L_{b52} |
| 1853 | Lₐ₂₀₉₈ | L_{b52} | 1854 | Lₐ₂₁₂₅ | L_{b52} |
| 1855 | Lₐ₂₁₄₃ | L_{b52} | 1856 | Lₐ₂₁₂₆ | L_{b52} |
| 1857 | Lₐ₂₁₄₄ | L_{b52} | 1858 | Lₐ₂₁₂₇ | L_{b52} |
| 1859 | Lₐ₂₁₄₅ | L_{b52} | 1860 | Lₐ₂₁₂₈ | L_{b52} |
| 1861 | Lₐ₂₁₅₄ | L_{b52} | 1862 | Lₐ₂₁₆₀ | L_{b52} |
| 1863 | Lₐ₂₁₅₅ | L_{b52} | 1864 | Lₐ₂₁₆₁ | L_{b52} |
| 1865 | Lₐ₂₁₅₆ | L_{b52} | 1866 | Lₐ₂₁₉₅ | L_{b52} |
| 1867 | Lₐ₂₁₅₇ | L_{b52} | 1868 | Lₐ₂₁₉₆ | L_{b52} |
| 1869 | Lₐ₂₂₁₃ | L_{b52} | 1870 | Lₐ₂₁₉₇ | L_{b52} |
| 1871 | Lₐ₂₂₁₄ | L_{b52} | 1872 | Lₐ₂₂₂₅ | L_{b52} |
| 1873 | Lₐ₂₂₁₅ | L_{b52} | 1874 | Lₐ₂₂₂₆ | L_{b52} |
| 1875 | Lₐ₂₂₁₆ | L_{b52} | 1876 | Lₐ₂₂₂₇ | L_{b52} |
| 1877 | Lₐ₂₂₄₄ | L_{b52} | 1878 | Lₐ₂₂₆₅ | L_{b52} |
| 1879 | Lₐ₂₂₄₅ | L_{b52} | 1880 | Lₐ₂₂₆₆ | L_{b52} |
| 1881 | Lₐ₂₂₄₆ | L_{b52} | 1882 | Lₐ₂₃₀₀ | L_{b52} |
| 1883 | Lₐ₂₃₁₀ | L_{b52} | 1884 | Lₐ₂₃₀₁ | L_{b52} |
| 1885 | Lₐ₂₃₁₁ | L_{b52} | 1886 | Lₐ₂₃₂₀ | L_{b52} |
| 1887 | Lₐ₂₃₁₂ | L_{b52} | 1888 | Lₐ₂₃₂₁ | L_{b52} |
| 1889 | Lₐ₂₃₄₅ | L_{b52} | 1890 | Lₐ₂₃₉₂ | L_{b52} |
| 1891 | Lₐ₂₃₄₆ | L_{b52} | 1892 | Lₐ₂₃₉₃ | L_{b52} |
| 1893 | Lₐ₂₄₂₈ | L_{b52} | 1894 | Lₐ₂₃₉₄ | L_{b52} |
| 1895 | Lₐ₂₄₂₉ | L_{b52} | 1896 | Lₐ₂₃₉₅ | L_{b52} |
| 1897 | Lₐ₂₄₃₀ | L_{b52} | 1898 | Lₐ₂₄₈₅ | L_{b52} |
| 1899 | Lₐ₂₄₆₈ | L_{b52} | 1900 | Lₐ₂₄₈₆ | L_{b52} |
| 1901 | Lₐ₂₄₆₉ | L_{b52} | 1902 | Lₐ₂₄₈₇ | L_{b52} |
| 1903 | Lₐ₂₄₇₀ | L_{b52} | 1904 | Lₐ₂₄₈₈ | L_{b52} |
| 1905 | Lₐ₂₄₇₁ | L_{b52} | 1906 | Lₐ₂₅₃₅ | L_{b52} |
| 1907 | Lₐ₂₅₁₀ | L_{b52} | 1908 | Lₐ₂₅₃₆ | L_{b52} |
| 1909 | Lₐ₂₅₁₁ | L_{b52} | 1910 | Lₐ₂₅₃₇ | L_{b52} |
| 1911 | Lₐ₂₅₁₂ | L_{b52} | 1912 | Lₐ₂₅₅₆ | L_{b52} |
| 1913 | Lₐ₂₅₇₇ | L_{b52} | 1914 | Lₐ₂₅₅₇ | L_{b52} |
| 1915 | Lₐ₂₅₇₈ | L_{b52} | 1916 | Lₐ₂₅₅₈ | L_{b52} |
| 1917 | Lₐ₂₅₇₉ | L_{b52} | 1918 | Lₐ₂₆₃₆ | L_{b52} |
| 1919 | Lₐ₂₅₉₇ | L_{b52} | 1920 | Lₐ₂₆₃₇ | L_{b52} |
| 1921 | Lₐ₂₅₉₈ | L_{b52} | 1922 | Lₐ₂₆₃₈ | L_{b52} |
| 1923 | Lₐ₂₅₉₉ | L_{b52} | 1924 | Lₐ₂₆₈₂ | L_{b52} |
| 1925 | Lₐ₂₆₄₉ | L_{b52} | 1926 | Lₐ₂₆₈₃ | L_{b52} |
| 1927 | Lₐ₂₆₅₀ | L_{b52} | 1928 | Lₐ₂₆₈₄ | L_{b52} |
| 1929 | Lₐ₂₆₅₁ | L_{b52} | 1930 | Lₐ₂₇₂₂ | L_{b52} |
| 1931 | Lₐ₂₆₉₄ | L_{b52} | 1932 | Lₐ₂₇₂₃ | L_{b52} |
| 1933 | Lₐ₂₆₉₅ | L_{b52} | 1934 | Lₐ₂₇₂₄ | L_{b52} |
| 1935 | Lₐ₂₆₉₆ | L_{b52} | 1936 | Lₐ₂₇₃₅ | L_{b52} |
| 1937 | Lₐ₂₇₄₂ | L_{b52} | 1938 | Lₐ₂₇₃₆ | L_{b52} |
| 1939 | Lₐ₂₇₄₃ | L_{b52} | 1940 | Lₐ₂₇₃₇ | L_{b52} |
| 1941 | Lₐ₂₇₄₄ | L_{b52} | 1942 | Lₐ₂₈₀₄ | L_{b52} |
| 1943 | Lₐ₂₇₇₆ | L_{b52} | 1944 | Lₐ₂₈₀₅ | L_{b52} |
| 1945 | Lₐ₂₇₇₇ | L_{b52} | 1946 | Lₐ₂₈₀₆ | L_{b52} |
| 1947 | Lₐ₂₇₇₈ | L_{b52} | 1948 | Lₐ₂₈₀₇ | L_{b52} |
| 1949 | Lₐ₂₇₇₉ | L_{b52} | 1950 | Lₐ₂₈₀₈ | L_{b52} |
| 1951 | Lₐ₂₇₈₀ | L_{b52} | 1952 | Lₐ₂₈₂₅ | L_{b52} |
| 1953 | Lₐ₂₇₈₁ | L_{b52} | 1954 | Lₐ₂₈₂₆ | L_{b52} |
| 1955 | Lₐ₂₇₈₂ | L_{b52} | 1956 | Lₐ₂₈₂₇ | L_{b52} |
| 1957 | Lₐ₂₈₄₇ | L_{b52} | 1958 | Lₐ₂₈₅₅ | L_{b52} |
| 1959 | Lₐ₂₈₄₈ | L_{b52} | 1960 | Lₐ₂₈₅₆ | L_{b52} |
| 1961 | Lₐ₂₈₄₉ | L_{b52} | 1962 | Lₐ₂₈₅₇ | L_{b52} |
| 1963 | Lₐ₂₈₅₀ | L_{b52} | 1964 | Lₐ₂₈₇₆ | L_{b52} |
| 1965 | Lₐ₂₈₉₅ | L_{b52} | 1966 | Lₐ₂₈₇₇ | L_{b52} |
| 1967 | Lₐ₂₈₉₆ | L_{b52} | 1968 | Lₐ₂₈₇₈ | L_{b52} |
| 1969 | Lₐ₂₈₉₇ | L_{b52} | 1970 | Lₐ₂₉₀₇ | L_{b52} |
| 1971 | Lₐ₂₉₂₆ | L_{b52} | 1972 | Lₐ₂₉₀₈ | L_{b52} |
| 1973 | Lₐ₂₉₂₇ | L_{b52} | 1974 | Lₐ₂₉₀₉ | L_{b52} |
| 1975 | Lₐ₂₉₂₈ | L_{b52} | 1976 | Lₐ₂₉₄₈ | L_{b52} |
| 1977 | Lₐ₃₀₀₃ | L_{b52} | 1978 | Lₐ₂₉₄₉ | L_{b52} |
| 1979 | Lₐ₃₀₀₄ | L_{b52} | 1980 | Lₐ₂₉₅₀ | L_{b52} |
| 1981 | Lₐ₃₀₄₈ | L_{b52} | 1982 | Lₐ₃₀₈₈ | L_{b52} |
| 1983 | Lₐ₃₀₄₉ | L_{b52} | 1984 | Lₐ₃₀₈₉ | L_{b52} |
| 1985 | Lₐ₃₀₅₀ | L_{b52} | 1986 | Lₐ₃₀₉₀ | L_{b52} |
| 1987 | Lₐ₃₁₂₈ | L_{b52} | 1988 | Lₐ₃₁₄₇ | L_{b52} |
| 1989 | Lₐ₃₁₂₉ | L_{b52} | 1990 | Lₐ₃₁₄₈ | L_{b52} |
| 1991 | Lₐ₃₁₃₀ | L_{b52} | 1992 | Lₐ₃₁₄₉ | L_{b52} |
| 1993 | Lₐ₃₁₃₁ | L_{b52} | 1994 | Lₐ₃₁₅₀ | L_{b52} |
| 1995 | Lₐ₃₁₇₈ | L_{b52} | 1996 | Lₐ₃₂₈₇ | L_{b52} |
| 1997 | Lₐ₃₁₇₉ | L_{b52} | 1998 | Lₐ₃₂₈₈ | L_{b52} |
| 1999 | Lₐ₃₁₈₀ | L_{b52} | 2000 | Lₐ₃₂₈₉ | L_{b52} |
| 2001 | Lₐ₃₃₃₇ | L_{b52} | 2002 | Lₐ₃₃₆₃ | L_{b52} |
| 2003 | Lₐ₃₃₃₈ | L_{b52} | 2004 | Lₐ₃₃₆₄ | L_{b52} |
| 2005 | Lₐ₃₃₃₉ | L_{b52} | 2006 | Lₐ₃₃₆₅ | L_{b52} |
| 2007 | Lₐ₁ | L_{b2} | 2008 | Lₐ₁₀₅ | L_{b2} |
| 2009 | Lₐ₁ | L_{b4} | 2010 | Lₐ₁₀₅ | L_{b4} |
| 2011 | Lₐ₁ | L_{b5} | 2012 | Lₐ₁₀₅ | L_{b5} |
| 2013 | Lₐ₁ | L_{b10} | 2014 | Lₐ₁₀₅ | L_{b10} |
| 2015 | Lₐ₁ | L_{b11} | 2016 | Lₐ₁₀₅ | L_{b11} |
| 2017 | Lₐ₁ | L_{b12} | 2018 | Lₐ₁₀₅ | L_{b12} |
| 2019 | Lₐ₁ | L_{b13} | 2020 | Lₐ₁₀₅ | L_{b13} |
| 2021 | Lₐ₁ | L_{b14} | 2022 | Lₐ₁₀₅ | L_{b14} |
| 2023 | Lₐ₁ | L_{b15} | 2024 | Lₐ₁₀₅ | L_{b15} |
| 2025 | Lₐ₁ | L_{b17} | 2026 | Lₐ₁₀₅ | L_{b17} |
| 2027 | Lₐ₁ | L_{b19} | 2028 | Lₐ₁₀₅ | L_{b19} |
| 2029 | Lₐ₁ | L_{b21} | 2030 | Lₐ₁₀₅ | L_{b21} |
| 2031 | Lₐ₁ | L_{b22} | 2032 | Lₐ₁₀₅ | L_{b22} |
| 2033 | Lₐ₁ | L_{b23} | 2034 | Lₐ₁₀₅ | L_{b23} |
| 2035 | Lₐ₁ | L_{b24} | 2036 | Lₐ₁₀₅ | L_{b24} |
| 2037 | Lₐ₁ | L_{b25} | 2038 | Lₐ₁₀₅ | L_{b25} |
| 2039 | Lₐ₁ | L_{b26} | 2040 | Lₐ₁₀₅ | L_{b26} |
| 2041 | Lₐ₁ | L_{b27} | 2042 | Lₐ₁₀₅ | L_{b27} |
| 2043 | Lₐ₁ | L_{b28} | 2044 | Lₐ₁₀₅ | L_{b28} |
| 2045 | Lₐ₁ | L_{b29} | 2046 | Lₐ₁₀₅ | L_{b29} |
| 2047 | Lₐ₁ | L_{b30} | 2048 | Lₐ₁₀₅ | L_{b30} |
| 2049 | Lₐ₁ | L_{b31} | 2050 | Lₐ₁₀₅ | L_{b31} |
| 2051 | Lₐ₁ | L_{b32} | 2052 | Lₐ₁₀₅ | L_{b32} |
| 2053 | Lₐ₁ | L_{b33} | 2054 | Lₐ₁₀₅ | L_{b33} |
| 2055 | Lₐ₁ | L_{b42} | 2056 | Lₐ₁₀₅ | L_{b42} |
| 2057 | Lₐ₁ | L_{b43} | 2058 | Lₐ₁₀₅ | L_{b43} |
| 2059 | Lₐ₁ | L_{b44} | 2060 | Lₐ₁₀₅ | L_{b44} |
| 2061 | Lₐ₁ | L_{b45} | 2062 | Lₐ₁₀₅ | L_{b45} |
| 2063 | Lₐ₁ | L_{b46} | 2064 | Lₐ₁₀₅ | L_{b46} |
| 2065 | Lₐ₁ | L_{b50} | 2066 | Lₐ₁₀₅ | L_{b50} |
| 2067 | Lₐ₁ | L_{b51} | 2068 | Lₐ₁₀₅ | L_{b51} |
| 2069 | Lₐ₁ | L_{b53} | 2070 | Lₐ₁₀₅ | L_{b53} |
| 2071 | Lₐ₁ | L_{b54} | 2072 | Lₐ₁₀₅ | L_{b54} |
| 2073 | Lₐ₁ | L_{b55} | 2074 | Lₐ₁₀₅ | L_{b55} |
| 2075 | Lₐ₁ | L_{b56} | 2076 | Lₐ₁₀₅ | L_{b56} |
| 2077 | Lₐ₁ | L_{b57} | 2078 | Lₐ₁₀₅ | L_{b57} |
| 2079 | Lₐ₁ | L_{b58} | 2080 | Lₐ₁₀₅ | L_{b58} |
| 2081 | Lₐ₁ | L_{b59} | 2082 | Lₐ₁₀₅ | L_{b59} |
| 2083 | Lₐ₁ | L_{b66} | 2084 | Lₐ₁₀₅ | L_{b66} |
| 2085 | Lₐ₁ | L_{b68} | 2086 | Lₐ₁₀₅ | L_{b68} |
| 2087 | Lₐ₁ | L_{b70} | 2088 | Lₐ₁₀₅ | L_{b70} |
| 2089 | Lₐ₁ | L_{b75} | 2090 | Lₐ₁₀₅ | L_{b75} |
| 2091 | Lₐ₁ | L_{b76} | 2092 | Lₐ₁₀₅ | L_{b76} |
| 2093 | Lₐ₁ | L_{b87} | 2094 | Lₐ₁₀₅ | L_{b87} |
| 2095 | Lₐ₁ | L_{b95} | 2096 | Lₐ₁₀₅ | L_{b95} |
| 2097 | Lₐ₁ | L_{b96} | 2098 | Lₐ₁₀₅ | L_{b96} |
| 2099 | Lₐ₁ | L_{b97} | 2100 | Lₐ₁₀₅ | L_{b97} |
| 2101 | Lₐ₁ | L_{b98} | 2102 | Lₐ₁₀₅ | L_{b98} |
| 2103 | Lₐ₁ | L_{b109} | 2104 | Lₐ₁₀₅ | L_{b109} |
| 2105 | Lₐ₁ | L_{b110} | 2106 | Lₐ₁₀₅ | L_{b110} |
| 2107 | Lₐ₁ | L_{b111} | 2108 | Lₐ₁₀₅ | L_{b111} |
| 2109 | Lₐ₁ | L_{b112} | 2110 | Lₐ₁₀₅ | L_{b112} |
| 2111 | Lₐ₁ | L_{b114} | 2112 | Lₐ₁₀₅ | L_{b114} |
| 2113 | Lₐ₁ | L_{b117} | 2114 | Lₐ₁₀₅ | L_{b117} |
| 2115 | Lₐ₁ | L_{b122} | 2116 | Lₐ₁₀₅ | L_{b122} |
| 2117 | Lₐ₁ | L_{b123} | 2118 | Lₐ₁₀₅ | L_{b123} |
| 2119 | Lₐ₁ | L_{b129} | 2120 | Lₐ₁₀₅ | L_{b129} |
| 2121 | Lₐ₁ | L_{b130} | 2122 | Lₐ₁₀₅ | L_{b130} |
| 2123 | Lₐ₁ | L_{b131} | 2124 | Lₐ₁₀₅ | L_{b131} |
| 2125 | Lₐ₁ | L_{b133} | 2126 | Lₐ₁₀₅ | L_{b133} |
| 2127 | Lₐ₁ | L_{b134} | 2128 | Lₐ₁₀₅ | L_{b134} |
| 2129 | Lₐ₁ | L_{b135} | 2130 | Lₐ₁₀₅ | L_{b135} |
| 2131 | Lₐ₁ | L_{b148} | 2132 | Lₐ₁₀₅ | L_{b148} |
| 2133 | Lₐ₁ | L_{b149} | 2134 | Lₐ₁₀₅ | L_{b149} |
| 2135 | Lₐ₁ | L_{b150} | 2136 | Lₐ₁₀₅ | L_{b150} |
| 2137 | Lₐ₁ | L_{b151} | 2138 | Lₐ₁₀₅ | L_{b151} |
| 2139 | Lₐ₁₃₀ | L_{b2} | 2140 | Lₐ₂₀₁ | L_{b2} |
| 2141 | Lₐ₁₃₀ | L_{b4} | 2142 | Lₐ₂₀₁ | L_{b4} |
| 2143 | Lₐ₁₃₀ | L_{b5} | 2144 | Lₐ₂₀₁ | L_{b5} |
| 2145 | Lₐ₁₃₀ | L_{b10} | 2146 | Lₐ₂₀₁ | L_{b10} |
| 2147 | Lₐ₁₃₀ | L_{b11} | 2148 | Lₐ₂₀₁ | L_{b11} |
| 2149 | Lₐ₁₃₀ | L_{b12} | 2150 | Lₐ₂₀₁ | L_{b12} |
| 2151 | Lₐ₁₃₀ | L_{b13} | 2152 | Lₐ₂₀₁ | L_{b13} |
| 2153 | Lₐ₁₃₀ | L_{b14} | 2154 | Lₐ₂₀₁ | L_{b14} |
| 2155 | Lₐ₁₃₀ | L_{b15} | 2156 | Lₐ₂₀₁ | L_{b15} |
| 2157 | Lₐ₁₃₀ | L_{b17} | 2158 | Lₐ₂₀₁ | L_{b17} |
| 2159 | Lₐ₁₃₀ | L_{b19} | 2160 | Lₐ₂₀₁ | L_{b19} |
| 2161 | Lₐ₁₃₀ | L_{b21} | 2162 | Lₐ₂₀₁ | L_{b21} |
| 2163 | Lₐ₁₃₀ | L_{b22} | 2164 | Lₐ₂₀₁ | L_{b22} |
| 2165 | Lₐ₁₃₀ | L_{b23} | 2166 | Lₐ₂₀₁ | L_{b23} |
| 2167 | Lₐ₁₃₀ | L_{b24} | 2168 | Lₐ₂₀₁ | L_{b24} |
| 2169 | Lₐ₁₃₀ | L_{b25} | 2170 | Lₐ₂₀₁ | L_{b25} |
| 2171 | Lₐ₁₃₀ | L_{b26} | 2172 | Lₐ₂₀₁ | L_{b26} |
| 2173 | Lₐ₁₃₀ | L_{b27} | 2174 | Lₐ₂₀₁ | L_{b27} |
| 2175 | Lₐ₁₃₀ | L_{b28} | 2176 | Lₐ₂₀₁ | L_{b28} |
| 2177 | Lₐ₁₃₀ | L_{b29} | 2178 | Lₐ₂₀₁ | L_{b29} |
| 2179 | Lₐ₁₃₀ | L_{b30} | 2180 | Lₐ₂₀₁ | L_{b30} |
| 2181 | Lₐ₁₃₀ | L_{b31} | 2182 | Lₐ₂₀₁ | L_{b31} |
| 2183 | Lₐ₁₃₀ | L_{b32} | 2184 | Lₐ₂₀₁ | L_{b32} |
| 2185 | Lₐ₁₃₀ | L_{b33} | 2186 | _{La201} | L_{b33} |
| 2187 | Lₐ₁₃₀ | L_{b42} | 2188 | Lₐ₂₀₁ | L_{b42} |
| 2189 | Lₐ₁₃₀ | L_{b43} | 2190 | Lₐ₂₀₁ | L_{b43} |
| 2191 | Lₐ₁₃₀ | L_{b44} | 2192 | Lₐ₂₀₁ | L_{b44} |
| 2193 | Lₐ₁₃₀ | L_{b45} | 2194 | Lₐ₂₀₁ | L_{b45} |
| 2195 | Lₐ₁₃₀ | L_{b46} | 2196 | Lₐ₂₀₁ | L_{b46} |
| 2197 | Lₐ₁₃₀ | L_{b50} | 2198 | Lₐ₂₀₁ | L_{b50} |
| 2199 | Lₐ₁₃₀ | L_{b51} | 2200 | Lₐ₂₀₁ | L_{b51} |
| 2201 | Lₐ₁₃₀ | L_{b53} | 2202 | Lₐ₂₀₁ | L_{b53} |
| 2203 | Lₐ₁₃₀ | L_{b54} | 2204 | Lₐ₂₀₁ | L_{b54} |
| 2205 | Lₐ₁₃₀ | L_{b55} | 2206 | Lₐ₂₀₁ | L_{b55} |
| 2207 | Lₐ₁₃₀ | L_{b56} | 2208 | Lₐ₂₀₁ | L_{b56} |
| 2209 | Lₐ₁₃₀ | L_{b57} | 2210 | Lₐ₂₀₁ | L_{b57} |
| 2211 | Lₐ₁₃₀ | L_{b58} | 2212 | Lₐ₂₀₁ | L_{b58} |
| 2213 | Lₐ₁₃₀ | L_{b59} | 2214 | Lₐ₂₀₁ | L_{b59} |
| 2215 | Lₐ₁₃₀ | L_{b66} | 2216 | Lₐ₂₀₁ | L_{b66} |
| 2217 | Lₐ₁₃₀ | L_{b68} | 2218 | Lₐ₂₀₁ | L_{b68} |
| 2219 | Lₐ₁₃₀ | L_{b70} | 2220 | Lₐ₂₀₁ | L_{b70} |
| 2221 | Lₐ₁₃₀ | L_{b75} | 2222 | Lₐ₂₀₁ | L_{b75} |
| 2223 | Lₐ₁₃₀ | L_{b76} | 2224 | Lₐ₂₀₁ | L_{b76} |
| 2225 | Lₐ₁₃₀ | L_{b87} | 2226 | Lₐ₂₀₁ | L_{b87} |
| 2227 | Lₐ₁₃₀ | L_{b95} | 2228 | Lₐ₂₀₁ | L_{b95} |
| 2229 | Lₐ₁₃₀ | L_{b96} | 2230 | Lₐ₂₀₁ | L_{b96} |
| 2231 | Lₐ₁₃₀ | L_{b97} | 2232 | Lₐ₂₀₁ | L_{b97} |
| 2233 | Lₐ₁₃₀ | L_{b98} | 2234 | Lₐ₂₀₁ | L_{b98} |
| 2235 | Lₐ₁₃₀ | L_{b109} | 2236 | Lₐ₂₀₁ | L_{b109} |
| 2237 | Lₐ₁₃₀ | L_{b110} | 2238 | Lₐ₂₀₁ | L_{b110} |
| 2239 | Lₐ₁₃₀ | L_{b111} | 2240 | Lₐ₂₀₁ | L_{b111} |
| 2241 | Lₐ₁₃₀ | L_{b112} | 2242 | Lₐ₂₀₁ | L_{b112} |
| 2243 | Lₐ₁₃₀ | L_{b114} | 2244 | Lₐ₂₀₁ | L_{b114} |
| 2245 | Lₐ₁₃₀ | L_{b117} | 2246 | Lₐ₂₀₁ | L_{b117} |
| 2247 | Lₐ₁₃₀ | L_{b122} | 2248 | Lₐ₂₀₁ | L_{b122} |
| 2249 | Lₐ₁₃₀ | L_{b123} | 2250 | Lₐ₂₀₁ | L_{b123} |
| 2251 | Lₐ₁₃₀ | L_{b129} | 2252 | Lₐ₂₀₁ | L_{b129} |
| 2253 | Lₐ₁₃₀ | L_{b130} | 2254 | Lₐ₂₀₁ | L_{b130} |
| 2255 | Lₐ₁₃₀ | L_{b131} | 2256 | Lₐ₂₀₁ | L_{b131} |
| 2257 | Lₐ₁₃₀ | L_{b133} | 2258 | Lₐ₂₀₁ | L_{b133} |
| 2259 | Lₐ₁₃₀ | L_{b134} | 2260 | Lₐ₂₀₁ | L_{b134} |
| 2261 | Lₐ₁₃₀ | L_{b135} | 2262 | Lₐ₂₀₁ | L_{b135} |
| 2263 | Lₐ₁₃₀ | L_{b148} | 2264 | Lₐ₂₀₁ | L_{b148} |
| 2265 | Lₐ₁₃₀ | L_{b149} | 2266 | Lₐ₂₀₁ | L_{b149} |
| 2267 | Lₐ₁₃₀ | L_{b150} | 2268 | Lₐ₂₀₁ | L_{b150} |
| 2269 | Lₐ₁₃₀ | L_{b151} | 2270 | Lₐ₂₀₁ | L_{b151} |
| 2271 | Lₐ₂₇₂ | L_{b2} | 2272 | Lₐ₃₄₃ | L_{b2} |
| 2273 | Lₐ₂₇₂ | L_{b4} | 2274 | Lₐ₃₄₃ | L_{b4} |
| 2275 | Lₐ₂₇₂ | L_{b5} | 2276 | Lₐ₃₄₃ | L_{b5} |
| 2277 | Lₐ₂₇₂ | L_{b10} | 2278 | Lₐ₃₄₃ | L_{b10} |
| 2279 | Lₐ₂₇₂ | L_{b11} | 2280 | Lₐ₃₄₃ | L_{b11} |
| 2281 | Lₐ₂₇₂ | L_{b12} | 2282 | Lₐ₃₄₃ | L_{b12} |
| 2283 | Lₐ₂₇₂ | L_{b13} | 2284 | Lₐ₃₄₃ | L_{b13} |
| 2285 | Lₐ₂₇₂ | L_{b14} | 2286 | Lₐ₃₄₃ | L_{b14} |
| 2287 | Lₐ₂₇₂ | L_{b15} | 2288 | Lₐ₃₄₃ | L_{b15} |
| 2289 | Lₐ₂₇₂ | L_{b17} | 2290 | Lₐ₃₄₃ | L_{b17} |
| 2291 | Lₐ₂₇₂ | L_{b19} | 2292 | Lₐ₃₄₃ | L_{b19} |
| 2293 | Lₐ₂₇₂ | L_{b21} | 2294 | Lₐ₃₄₃ | L_{b21} |
| 2295 | Lₐ₂₇₂ | L_{b22} | 2296 | Lₐ₃₄₃ | L_{b22} |
| 2297 | Lₐ₂₇₂ | L_{b23} | 2298 | Lₐ₃₄₃ | L_{b23} |
| 2299 | Lₐ₂₇₂ | L_{b24} | 2300 | Lₐ₃₄₃ | L_{b24} |
| 2301 | Lₐ₂₇₂ | L_{b25} | 2302 | Lₐ₃₄₃ | L_{b25} |
| 2303 | Lₐ₂₇₂ | L_{b26} | 2304 | Lₐ₃₄₃ | L_{b26} |
| 2305 | Lₐ₂₇₂ | L_{b27} | 2306 | Lₐ₃₄₃ | L_{b27} |
| 2307 | Lₐ₂₇₂ | L_{b28} | 2308 | Lₐ₃₄₃ | L_{b28} |
| 2309 | Lₐ₂₇₂ | L_{b29} | 2310 | Lₐ₃₄₃ | L_{b29} |
| 2311 | Lₐ₂₇₂ | L_{b30} | 2312 | Lₐ₃₄₃ | L_{b30} |
| 2313 | Lₐ₂₇₂ | L_{b31} | 2314 | Lₐ₃₄₃ | L_{b31} |
| 2315 | Lₐ₂₇₂ | L_{b32} | 2316 | Lₐ₃₄₃ | L_{b32} |
| 2317 | Lₐ₂₇₂ | L_{b33} | 2318 | Lₐ₃₄₃ | L_{b33} |
| 2319 | Lₐ₂₇₂ | L_{b42} | 2320 | Lₐ₃₄₃ | L_{b42} |
| 2321 | Lₐ₂₇₂ | L_{b43} | 2322 | Lₐ₃₄₃ | L_{b43} |
| 2323 | Lₐ₂₇₂ | L_{b44} | 2324 | Lₐ₃₄₃ | L_{b44} |
| 2325 | Lₐ₂₇₂ | L_{b45} | 2326 | Lₐ₃₄₃ | L_{b45} |
| 2327 | Lₐ₂₇₂ | L_{b46} | 2328 | Lₐ₃₄₃ | L_{b46} |
| 2329 | Lₐ₂₇₂ | L_{b50} | 2330 | Lₐ₃₄₃ | L_{b50} |
| 2331 | Lₐ₂₇₂ | L_{b51} | 2332 | Lₐ₃₄₃ | L_{b51} |
| 2333 | Lₐ₂₇₂ | L_{b53} | 2334 | Lₐ₃₄₃ | L_{b53} |
| 2335 | Lₐ₂₇₂ | L_{b54} | 2336 | Lₐ₃₄₃ | L_{b54} |
| 2337 | Lₐ₂₇₂ | L_{b55} | 2338 | Lₐ₃₄₃ | L_{b55} |
| 2339 | Lₐ₂₇₂ | L_{b56} | 2340 | Lₐ₃₄₃ | L_{b56} |
| 2341 | Lₐ₂₇₂ | L_{b57} | 2342 | Lₐ₃₄₃ | L_{b57} |
| 2343 | Lₐ₂₇₂ | L_{b58} | 2344 | Lₐ₃₄₃ | L_{b58} |
| 2345 | Lₐ₂₇₂ | L_{b59} | 2346 | Lₐ₃₄₃ | L_{b59} |
| 2347 | Lₐ₂₇₂ | L_{b66} | 2348 | Lₐ₃₄₃ | L_{b66} |
| 2349 | Lₐ₂₇₂ | L_{b68} | 2350 | Lₐ₃₄₃ | L_{b68} |
| 2351 | Lₐ₂₇₂ | L_{b70} | 2352 | Lₐ₃₄₃ | L_{b70} |
| 2353 | Lₐ₂₇₂ | L_{b75} | 2354 | Lₐ₃₄₃ | L_{b75} |
| 2355 | Lₐ₂₇₂ | L_{b76} | 2356 | Lₐ₃₄₃ | L_{b76} |
| 2357 | Lₐ₂₇₂ | L_{b87} | 2358 | Lₐ₃₄₃ | L_{b87} |
| 2359 | Lₐ₂₇₂ | L_{b95} | 2360 | Lₐ₃₄₃ | L_{b95} |
| 2361 | Lₐ₂₇₂ | L_{b96} | 2362 | Lₐ₃₄₃ | L_{b96} |
| 2363 | Lₐ₂₇₂ | L_{b97} | 2364 | Lₐ₃₄₃ | L_{b97} |
| 2365 | Lₐ₂₇₂ | L_{b98} | 2366 | Lₐ₃₄₃ | L_{b98} |
| 2367 | Lₐ₂₇₂ | L_{b109} | 2368 | Lₐ₃₄₃ | L_{b109} |
| 2369 | Lₐ₂₇₂ | L_{b110} | 2370 | Lₐ₃₄₃ | L_{b110} |
| 2371 | Lₐ₂₇₂ | L_{b111} | 2372 | Lₐ₃₄₃ | L_{b111} |
| 2373 | Lₐ₂₇₂ | L_{b112} | 2374 | Lₐ₃₄₃ | L_{b112} |
| 2375 | Lₐ₂₇₂ | L_{b114} | 2376 | Lₐ₃₄₃ | L_{b114} |
| 2377 | Lₐ₂₇₂ | L_{b117} | 2378 | Lₐ₃₄₃ | L_{b117} |
| 2379 | Lₐ₂₇₂ | L_{b122} | 2380 | Lₐ₃₄₃ | L_{b122} |
| 2381 | Lₐ₂₇₂ | L_{b123} | 2382 | Lₐ₃₄₃ | L_{b123} |
| 2383 | Lₐ₂₇₂ | L_{b129} | 2384 | Lₐ₃₄₃ | L_{b129} |
| 2385 | Lₐ₂₇₂ | L_{b130} | 2386 | Lₐ₃₄₃ | L_{b130} |
| 2387 | Lₐ₂₇₂ | L_{b131} | 2388 | Lₐ₃₄₃ | L_{b131} |
| 2389 | Lₐ₂₇₂ | L_{b133} | 2390 | Lₐ₃₄₃ | L_{b133} |
| 2391 | Lₐ₂₇₂ | L_{b134} | 2392 | Lₐ₃₄₃ | L_{b134} |
| 2393 | Lₐ₂₇₂ | L_{b135} | 2394 | Lₐ₃₄₃ | L_{b135} |
| 2395 | Lₐ₂₇₂ | L_{b148} | 2396 | Lₐ₃₄₃ | L_{b148} |
| 2397 | Lₐ₂₇₂ | L_{b149} | 2398 | Lₐ₃₄₃ | L_{b149} |
| 2399 | Lₐ₂₇₂ | L_{b150} | 2400 | Lₐ₃₄₃ | L_{b150} |
| 2401 | Lₐ₂₇₂ | L_{b151} | 2402 | Lₐ₃₄₃ | L_{b151} |
| 2403 | Lₐ₄₁₄ | L_{b2} | 2404 | Lₐ₇₄₆ | L_{b2} |
| 2405 | Lₐ₄₁₄ | L_{b4} | 2406 | Lₐ₇₄₆ | L_{b4} |
| 2407 | Lₐ₄₁₄ | L_{b5} | 2408 | Lₐ₇₄₆ | L_{b5} |
| 2409 | Lₐ₄₁₄ | L_{b10} | 2410 | Lₐ₇₄₆ | L_{b10} |
| 2411 | Lₐ₄₁₄ | L_{b11} | 2412 | Lₐ₇₄₆ | L_{b11} |
| 2413 | Lₐ₄₁₄ | L_{b12} | 2414 | Lₐ₇₄₆ | L_{b12} |
| 2415 | Lₐ₄₁₄ | L_{b13} | 2416 | Lₐ₇₄₆ | L_{b13} |
| 2417 | Lₐ₄₁₄ | L_{b14} | 2418 | Lₐ₇₄₆ | L_{b14} |
| 2419 | Lₐ₄₁₄ | L_{b15} | 2420 | Lₐ₇₄₆ | L_{b15} |
| 2421 | Lₐ₄₁₄ | L_{b17} | 2422 | Lₐ₇₄₆ | L_{b17} |
| 2423 | Lₐ₄₁₄ | L_{b19} | 2424 | Lₐ₇₄₆ | L_{b19} |
| 2425 | Lₐ₄₁₄ | L_{b21} | 2426 | Lₐ₇₄₆ | L_{b21} |
| 2427 | Lₐ₄₁₄ | L_{b22} | 2428 | Lₐ₇₄₆ | L_{b22} |
| 2429 | Lₐ₄₁₄ | L_{b23} | 2430 | Lₐ₇₄₆ | L_{b23} |
| 2431 | Lₐ₄₁₄ | L_{b24} | 2432 | Lₐ₇₄₆ | L_{b24} |
| 2433 | Lₐ₄₁₄ | L_{b25} | 2434 | Lₐ₇₄₆ | L_{b25} |
| 2435 | Lₐ₄₁₄ | L_{b26} | 2436 | Lₐ₇₄₆ | L_{b26} |
| 2437 | Lₐ₄₁₄ | L_{b27} | 2438 | Lₐ₇₄₆ | L_{b27} |
| 2439 | Lₐ₄₁₄ | L_{b28} | 2440 | Lₐ₇₄₆ | L_{b28} |
| 2441 | Lₐ₄₁₄ | L_{b29} | 2442 | Lₐ₇₄₆ | L_{b29} |
| 2443 | Lₐ₄₁₄ | L_{b30} | 2444 | Lₐ₇₄₆ | L_{b30} |
| 2445 | Lₐ₄₁₄ | L_{b31} | 2446 | Lₐ₇₄₆ | L_{b31} |
| 2447 | Lₐ₄₁₄ | L_{b32} | 2448 | Lₐ₇₄₆ | L_{b32} |
| 2449 | Lₐ₄₁₄ | L_{b33} | 2450 | Lₐ₇₄₆ | L_{b33} |
| 2451 | Lₐ₄₁₄ | L_{b42} | 2452 | Lₐ₇₄₆ | L_{b42} |
| 2453 | Lₐ₄₁₄ | L_{b43} | 2454 | Lₐ₇₄₆ | L_{b43} |
| 2455 | Lₐ₄₁₄ | L_{b44} | 2456 | Lₐ₇₄₆ | L_{b44} |
| 2457 | Lₐ₄₁₄ | L_{b45} | 2458 | Lₐ₇₄₆ | L_{b45} |
| 2459 | Lₐ₄₁₄ | L_{b46} | 2460 | Lₐ₇₄₆ | L_{b46} |
| 2461 | Lₐ₄₁₄ | L_{b50} | 2462 | Lₐ₇₄₆ | L_{b50} |
| 2463 | Lₐ₄₁₄ | L_{b51} | 2464 | Lₐ₇₄₆ | L_{b51} |
| 2465 | Lₐ₄₁₄ | L_{b53} | 2466 | Lₐ₇₄₆ | L_{b53} |
| 2467 | Lₐ₄₁₄ | L_{b54} | 2468 | Lₐ₇₄₆ | L_{b54} |
| 2469 | Lₐ₄₁₄ | L_{b55} | 2470 | Lₐ₇₄₆ | L_{b55} |
| 2471 | Lₐ₄₁₄ | L_{b56} | 2472 | Lₐ₇₄₆ | L_{b56} |
| 2473 | Lₐ₄₁₄ | L_{b57} | 2474 | Lₐ₇₄₆ | L_{b57} |
| 2475 | Lₐ₄₁₄ | L_{b58} | 2476 | Lₐ₇₄₆ | L_{b58} |
| 2477 | Lₐ₄₁₄ | L_{b59} | 2478 | Lₐ₇₄₆ | L_{b59} |
| 2479 | Lₐ₄₁₄ | L_{b66} | 2480 | Lₐ₇₄₆ | L_{b66} |
| 2481 | Lₐ₄₁₄ | L_{b68} | 2482 | Lₐ₇₄₆ | L_{b68} |
| 2483 | Lₐ₄₁₄ | L_{b70} | 2484 | Lₐ₇₄₆ | L_{b70} |
| 2485 | Lₐ₄₁₄ | L_{b75} | 2486 | Lₐ₇₄₆ | L_{b75} |
| 2487 | Lₐ₄₁₄ | L_{b76} | 2488 | Lₐ₇₄₆ | L_{b76} |
| 2489 | Lₐ₄₁₄ | L_{b87} | 2490 | Lₐ₇₄₆ | L_{b87} |
| 2491 | Lₐ₄₁₄ | L_{b95} | 2492 | Lₐ₇₄₆ | L_{b95} |
| 2493 | Lₐ₄₁₄ | L_{b96} | 2494 | Lₐ₇₄₆ | L_{b96} |
| 2495 | Lₐ₄₁₄ | L_{b97} | 2496 | Lₐ₇₄₆ | L_{b97} |
| 2497 | Lₐ₄₁₄ | L_{b98} | 2498 | Lₐ₇₄₆ | L_{b98} |
| 2499 | Lₐ₄₁₄ | L_{b109} | 2500 | Lₐ₇₄₆ | L_{b109} |
| 2501 | Lₐ₄₁₄ | L_{b110} | 2502 | Lₐ₇₄₆ | L_{b110} |
| 2503 | Lₐ₄₁₄ | L_{b111} | 2504 | Lₐ₇₄₆ | L_{b111} |
| 2505 | Lₐ₄₁₄ | L_{b112} | 2506 | Lₐ₇₄₆ | L_{b112} |
| 2507 | Lₐ₄₁₄ | L_{b114} | 2508 | Lₐ₇₄₆ | L_{b114} |
| 2509 | Lₐ₄₁₄ | L_{b117} | 2510 | Lₐ₇₄₆ | L_{b117} |
| 2511 | Lₐ₄₁₄ | L_{b122} | 2512 | Lₐ₇₄₆ | L_{b122} |
| 2513 | Lₐ₄₁₄ | L_{b123} | 2514 | Lₐ₇₄₆ | L_{b123} |
| 2515 | Lₐ₄₁₄ | L_{b129} | 2516 | Lₐ₇₄₆ | L_{b129} |
| 2517 | Lₐ₄₁₄ | L_{b130} | 2518 | Lₐ₇₄₆ | L_{b130} |
| 2519 | Lₐ₄₁₄ | L_{b131} | 2520 | Lₐ₇₄₆ | L_{b131} |
| 2521 | Lₐ₄₁₄ | L_{b133} | 2522 | Lₐ₇₄₆ | L_{b133} |
| 2523 | Lₐ₄₁₄ | L_{b134} | 2524 | Lₐ₇₄₆ | L_{b134} |
| 2525 | Lₐ₄₁₄ | L_{b135} | 2526 | Lₐ₇₄₆ | L_{b135} |
| 2527 | Lₐ₄₁₄ | L_{b148} | 2528 | Lₐ₇₄₆ | L_{b148} |
| 2529 | Lₐ₄₁₄ | L_{b149} | 2530 | Lₐ₇₄₆ | L_{b149} |
| 2531 | Lₐ₄₁₄ | L_{b150} | 2532 | Lₐ₇₄₆ | L_{b150} |
| 2533 | Lₐ₄₁₄ | L_{b151} | 2534 | Lₐ₇₄₆ | L_{b151} |
| 2535 | Lₐ₇₄₇ | L_{b2} | 2536 | Lₐ₈₂₄ | L_{b2} |
| 2537 | Lₐ₇₄₇ | L_{b4} | 2538 | Lₐ₈₂₄ | L_{b4} |
| 2539 | Lₐ₇₄₇ | L_{b5} | 2540 | Lₐ₈₂₄ | L_{b5} |
| 2541 | Lₐ₇₄₇ | L_{b10} | 2542 | Lₐ₈₂₄ | L_{b10} |
| 2543 | Lₐ₇₄₇ | L_{b11} | 2544 | Lₐ₈₂₄ | L_{b11} |
| 2545 | Lₐ₇₄₇ | L_{b12} | 2546 | Lₐ₈₂₄ | L_{b12} |
| 2547 | Lₐ₇₄₇ | L_{b13} | 2548 | Lₐ₈₂₄ | L_{b13} |
| 2549 | Lₐ₇₄₇ | L_{b14} | 2550 | Lₐ₈₂₄ | L_{b14} |
| 2551 | Lₐ₇₄₇ | L_{b15} | 2552 | Lₐ₈₂₄ | L_{b15} |
| 2553 | Lₐ₇₄₇ | L_{b17} | 2554 | Lₐ₈₂₄ | L_{b17} |
| 2555 | Lₐ₇₄₇ | L_{b19} | 2556 | Lₐ₈₂₄ | L_{b19} |
| 2557 | Lₐ₇₄₇ | L_{b21} | 2558 | Lₐ₈₂₄ | L_{b21} |
| 2559 | Lₐ₇₄₇ | L_{b22} | 2560 | Lₐ₈₂₄ | L_{b22} |
| 2561 | Lₐ₇₄₇ | L_{b23} | 2562 | Lₐ₈₂₄ | L_{b23} |
| 2563 | Lₐ₇₄₇ | L_{b24} | 2564 | Lₐ₈₂₄ | L_{b24} |
| 2565 | Lₐ₇₄₇ | L_{b25} | 2566 | Lₐ₈₂₄ | L_{b25} |
| 2567 | Lₐ₇₄₇ | L_{b26} | 2568 | Lₐ₈₂₄ | L_{b26} |
| 2569 | Lₐ₇₄₇ | L_{b27} | 2570 | Lₐ₈₂₄ | L_{b27} |
| 2571 | Lₐ₇₄₇ | L_{b28} | 2572 | Lₐ₈₂₄ | L_{b28} |
| 2573 | Lₐ₇₄₇ | L_{b29} | 2574 | Lₐ₈₂₄ | L_{b29} |
| 2575 | Lₐ₇₄₇ | L_{b30} | 2576 | Lₐ₈₂₄ | L_{b30} |
| 2577 | Lₐ₇₄₇ | L_{b31} | 2578 | Lₐ₈₂₄ | L_{b31} |
| 2579 | Lₐ₇₄₇ | L_{b32} | 2580 | Lₐ₈₂₄ | L_{b32} |
| 2581 | Lₐ₇₄₇ | L_{b33} | 2582 | Lₐ₈₂₄ | L_{b33} |
| 2583 | Lₐ₇₄₇ | L_{b42} | 2584 | Lₐ₈₂₄ | L_{b42} |
| 2585 | Lₐ₇₄₇ | L_{b43} | 2586 | Lₐ₈₂₄ | L_{b43} |
| 2587 | Lₐ₇₄₇ | L_{b44} | 2588 | Lₐ₈₂₄ | L_{b44} |
| 2589 | Lₐ₇₄₇ | L_{b45} | 2590 | Lₐ₈₂₄ | L_{b45} |
| 2591 | Lₐ₇₄₇ | L_{b46} | 2592 | Lₐ₈₂₄ | L_{b46} |
| 2593 | Lₐ₇₄₇ | L_{b50} | 2594 | Lₐ₈₂₄ | L_{b50} |
| 2595 | Lₐ₇₄₇ | L_{b51} | 2596 | Lₐ₈₂₄ | L_{b51} |
| 2597 | Lₐ₇₄₇ | L_{b53} | 2598 | Lₐ₈₂₄ | L_{b53} |
| 2599 | Lₐ₇₄₇ | L_{b54} | 2600 | Lₐ₈₂₄ | L_{b54} |
| 2601 | Lₐ₇₄₇ | L_{b55} | 2602 | Lₐ₈₂₄ | L_{b55} |
| 2603 | Lₐ₇₄₇ | L_{b56} | 2604 | Lₐ₈₂₄ | L_{b56} |
| 2605 | Lₐ₇₄₇ | L_{b57} | 2606 | Lₐ₈₂₄ | L_{b57} |
| 2607 | Lₐ₇₄₇ | L_{b58} | 2608 | Lₐ₈₂₄ | L_{b58} |
| 2609 | Lₐ₇₄₇ | L_{b59} | 2610 | Lₐ₈₂₄ | L_{b59} |
| 2611 | Lₐ₇₄₇ | L_{b66} | 2612 | Lₐ₈₂₄ | L_{b66} |
| 2613 | Lₐ₇₄₇ | L_{b68} | 2614 | Lₐ₈₂₄ | L_{b68} |
| 2615 | Lₐ₇₄₇ | L_{b70} | 2616 | Lₐ₈₂₄ | L_{b70} |
| 2617 | Lₐ₇₄₇ | L_{b75} | 2618 | Lₐ₈₂₄ | L_{b75} |
| 2619 | Lₐ₇₄₇ | L_{b76} | 2620 | Lₐ₈₂₄ | L_{b76} |
| 2621 | Lₐ₇₄₇ | L_{b87} | 2622 | Lₐ₈₂₄ | L_{b87} |
| 2623 | Lₐ₇₄₇ | L_{b95} | 2624 | Lₐ₈₂₄ | L_{b95} |
| 2625 | Lₐ₇₄₇ | L_{b96} | 2626 | Lₐ₈₂₄ | L_{b96} |
| 2627 | Lₐ₇₄₇ | L_{b97} | 2628 | Lₐ₈₂₄ | L_{b97} |
| 2629 | Lₐ₇₄₇ | L_{b98} | 2630 | Lₐ₈₂₄ | L_{b98} |
| 2631 | Lₐ₇₄₇ | L_{b109} | 2632 | Lₐ₈₂₄ | L_{b109} |
| 2633 | Lₐ₇₄₇ | L_{b110} | 2634 | Lₐ₈₂₄ | L_{b110} |
| 2635 | Lₐ₇₄₇ | L_{b111} | 2636 | Lₐ₈₂₄ | L_{b111} |
| 2637 | Lₐ₇₄₇ | L_{b112} | 2638 | Lₐ₈₂₄ | L_{b112} |
| 2639 | Lₐ₇₄₇ | L_{b114} | 2640 | Lₐ₈₂₄ | L_{b114} |
| 2641 | Lₐ₇₄₇ | L_{b117} | 2642 | Lₐ₈₂₄ | L_{b117} |
| 2643 | Lₐ₇₄₇ | L_{b122} | 2644 | Lₐ₈₂₄ | L_{b122} |
| 2645 | Lₐ₇₄₇ | L_{b123} | 2646 | Lₐ₈₂₄ | L_{b123} |
| 2647 | Lₐ₇₄₇ | L_{b129} | 2648 | Lₐ₈₂₄ | L_{b129} |
| 2649 | Lₐ₇₄₇ | L_{b130} | 2650 | Lₐ₈₂₄ | L_{b130} |
| 2651 | Lₐ₇₄₇ | L_{b131} | 2652 | Lₐ₈₂₄ | L_{b131} |
| 2653 | Lₐ₇₄₇ | L_{b133} | 2654 | Lₐ₈₂₄ | L_{b133} |
| 2655 | Lₐ₇₄₇ | L_{b134} | 2656 | Lₐ₈₂₄ | L_{b134} |
| 2657 | Lₐ₇₄₇ | L_{b135} | 2658 | Lₐ₈₂₄ | L_{b135} |
| 2659 | Lₐ₇₄₇ | L_{b148} | 2660 | Lₐ₈₂₄ | L_{b148} |
| 2661 | Lₐ₇₄₇ | L_{b149} | 2662 | Lₐ₈₂₄ | L_{b149} |
| 2663 | Lₐ₇₄₇ | L_{b150} | 2664 | Lₐ₈₂₄ | L_{b150} |
| 2665 | Lₐ₇₄₇ | L_{b151} | 2666 | Lₐ₈₂₄ | L_{b151} |
| 2667 | Lₐ₉₅₃ | L_{b2} | 2668 | Lₐ₁₀₂₄ | L_{b2} |
| 2669 | Lₐ₉₅₃ | L_{b4} | 2670 | Lₐ₁₀₂₄ | L_{b4} |
| 2671 | Lₐ₉₅₃ | L_{b5} | 2672 | Lₐ₁₀₂₄ | L_{b5} |
| 2673 | Lₐ₉₅₃ | L_{b10} | 2674 | Lₐ₁₀₂₄ | L_{b10} |
| 2675 | Lₐ₉₅₃ | L_{b11} | 2676 | Lₐ₁₀₂₄ | L_{b11} |
| 2677 | Lₐ₉₅₃ | L_{b12} | 2678 | Lₐ₁₀₂₄ | L_{b12} |
| 2679 | Lₐ₉₅₃ | L_{b13} | 2680 | Lₐ₁₀₂₄ | L_{b13} |
| 2681 | Lₐ₉₅₃ | L_{b14} | 2682 | Lₐ₁₀₂₄ | L_{b14} |
| 2683 | Lₐ₉₅₃ | L_{b15} | 2684 | Lₐ₁₀₂₄ | L_{b15} |
| 2685 | Lₐ₉₅₃ | L_{b17} | 2686 | Lₐ₁₀₂₄ | L_{b17} |
| 2687 | Lₐ₉₅₃ | L_{b19} | 2688 | Lₐ₁₀₂₄ | L_{b19} |
| 2689 | Lₐ₉₅₃ | L_{b21} | 2690 | Lₐ₁₀₂₄ | L_{b21} |
| 2691 | Lₐ₉₅₃ | L_{b22} | 2692 | Lₐ₁₀₂₄ | L_{b22} |
| 2693 | Lₐ₉₅₃ | L_{b23} | 2694 | Lₐ₁₀₂₄ | L_{b23} |
| 2695 | Lₐ₉₅₃ | L_{b24} | 2696 | Lₐ₁₀₂₄ | L_{b24} |
| 2697 | Lₐ₉₅₃ | L_{b25} | 2698 | Lₐ₁₀₂₄ | L_{b25} |
| 2699 | Lₐ₉₅₃ | L_{b26} | 2700 | Lₐ₁₀₂₄ | L_{b26} |
| 2701 | Lₐ₉₅₃ | L_{b27} | 2702 | Lₐ₁₀₂₄ | L_{b27} |
| 2703 | Lₐ₉₅₃ | L_{b28} | 2704 | Lₐ₁₀₂₄ | L_{b28} |
| 2705 | Lₐ₉₅₃ | L_{b29} | 2706 | Lₐ₁₀₂₄ | L_{b29} |
| 2707 | Lₐ₉₅₃ | L_{b30} | 2708 | Lₐ₁₀₂₄ | L_{b30} |
| 2709 | Lₐ₉₅₃ | L_{b31} | 2710 | Lₐ₁₀₂₄ | L_{b31} |
| 2711 | Lₐ₉₅₃ | L_{b32} | 2712 | Lₐ₁₀₂₄ | L_{b32} |
| 2713 | Lₐ₉₅₃ | L_{b33} | 2714 | Lₐ₁₀₂₄ | L_{b33} |
| 2715 | Lₐ₉₅₃ | L_{b42} | 2716 | Lₐ₁₀₂₄ | L_{b42} |
| 2717 | Lₐ₉₅₃ | L_{b43} | 2718 | Lₐ₁₀₂₄ | L_{b43} |
| 2719 | Lₐ₉₅₃ | L_{b44} | 2720 | Lₐ₁₀₂₄ | L_{b44} |
| 2721 | Lₐ₉₅₃ | L_{b45} | 2722 | Lₐ₁₀₂₄ | L_{b45} |
| 2723 | Lₐ₉₅₃ | L_{b46} | 2724 | Lₐ₁₀₂₄ | L_{b46} |
| 2725 | Lₐ₉₅₃ | L_{b50} | 2726 | Lₐ₁₀₂₄ | L_{b50} |
| 2727 | Lₐ₉₅₃ | L_{b51} | 2728 | Lₐ₁₀₂₄ | L_{b51} |
| 2729 | Lₐ₉₅₃ | L_{b53} | 2730 | Lₐ₁₀₂₄ | L_{b53} |
| 2731 | Lₐ₉₅₃ | L_{b54} | 2732 | Lₐ₁₀₂₄ | L_{b54} |
| 2733 | Lₐ₉₅₃ | L_{b55} | 2734 | Lₐ₁₀₂₄ | L_{b55} |
| 2735 | Lₐ₉₅₃ | L_{b56} | 2736 | Lₐ₁₀₂₄ | L_{b56} |
| 2737 | Lₐ₉₅₃ | L_{b57} | 2738 | Lₐ₁₀₂₄ | L_{b57} |
| 2739 | Lₐ₉₅₃ | L_{b58} | 2740 | Lₐ₁₀₂₄ | L_{b58} |
| 2741 | Lₐ₉₅₃ | L_{b59} | 2742 | Lₐ₁₀₂₄ | L_{b59} |
| 2743 | Lₐ₉₅₃ | L_{b66} | 2744 | Lₐ₁₀₂₄ | L_{b66} |
| 2745 | Lₐ₉₅₃ | L_{b68} | 2746 | Lₐ₁₀₂₄ | L_{b68} |
| 2747 | Lₐ₉₅₃ | L_{b70} | 2748 | Lₐ₁₀₂₄ | L_{b70} |
| 2749 | Lₐ₉₅₃ | L_{b75} | 2750 | Lₐ₁₀₂₄ | L_{b75} |
| 2751 | Lₐ₉₅₃ | L_{b76} | 2752 | Lₐ₁₀₂₄ | L_{b76} |
| 2753 | Lₐ₉₅₃ | L_{b87} | 2754 | Lₐ₁₀₂₄ | L_{b87} |
| 2755 | Lₐ₉₅₃ | L_{b95} | 2756 | Lₐ₁₀₂₄ | L_{b95} |
| 2757 | Lₐ₉₅₃ | L_{b96} | 2758 | Lₐ₁₀₂₄ | L_{b96} |
| 2759 | Lₐ₉₅₃ | L_{b97} | 2760 | Lₐ₁₀₂₄ | L_{b97} |
| 2761 | Lₐ₉₅₃ | L_{b98} | 2762 | Lₐ₁₀₂₄ | L_{b98} |
| 2763 | Lₐ₉₅₃ | L_{b109} | 2764 | Lₐ₁₀₂₄ | L_{b109} |
| 2765 | Lₐ₉₅₃ | L_{b110} | 2766 | Lₐ₁₀₂₄ | L_{b110} |
| 2767 | Lₐ₉₅₃ | L_{b111} | 2768 | Lₐ₁₀₂₄ | L_{b111} |
| 2769 | Lₐ₉₅₃ | L_{b112} | 2770 | Lₐ₁₀₂₄ | L_{b112} |
| 2771 | Lₐ₉₅₃ | L_{b114} | 2772 | Lₐ₁₀₂₄ | L_{b114} |
| 2773 | Lₐ₉₅₃ | L_{b117} | 2774 | Lₐ₁₀₂₄ | L_{b117} |
| 2775 | Lₐ₉₅₃ | L_{b122} | 2776 | Lₐ₁₀₂₄ | L_{b122} |
| 2777 | Lₐ₉₅₃ | L_{b123} | 2778 | Lₐ₁₀₂₄ | L_{b123} |
| 2779 | Lₐ₉₅₃ | L_{b129} | 2780 | Lₐ₁₀₂₄ | L_{b129} |
| 2781 | Lₐ₉₅₃ | L_{b130} | 2782 | Lₐ₁₀₂₄ | L_{b130} |
| 2783 | Lₐ₉₅₃ | L_{b131} | 2784 | Lₐ₁₀₂₄ | L_{b131} |
| 2785 | Lₐ₉₅₃ | L_{b133} | 2786 | Lₐ₁₀₂₄ | L_{b133} |
| 2787 | Lₐ₉₅₃ | L_{b134} | 2788 | Lₐ₁₀₂₄ | L_{b134} |
| 2789 | Lₐ₉₅₃ | L_{b135} | 2790 | Lₐ₁₀₂₄ | L_{b135} |
| 2791 | Lₐ₉₅₃ | L_{b148} | 2792 | Lₐ₁₀₂₄ | L_{b148} |
| 2793 | Lₐ₉₅₃ | L_{b149} | 2794 | Lₐ₁₀₂₄ | L_{b149} |
| 2795 | Lₐ₉₅₃ | L_{b150} | 2796 | Lₐ₁₀₂₄ | L_{b150} |
| 2797 | Lₐ₉₅₃ | L_{b151} | 2798 | Lₐ₁₀₂₄ | L_{b151} |
| 2799 | Lₐ₁₀₉₅ | L_{b2} | 2800 | Lₐ₁₁₆₆ | L_{b2} |
| 2801 | Lₐ₁₀₉₅ | L_{b4} | 2802 | Lₐ₁₁₆₆ | L_{b4} |
| 2803 | Lₐ₁₀₉₅ | L_{b5} | 2804 | Lₐ₁₁₆₆ | L_{b5} |
| 2805 | Lₐ₁₀₉₅ | L_{b10} | 2806 | Lₐ₁₁₆₆ | L_{b10} |
| 2807 | Lₐ₁₀₉₅ | L_{b11} | 2808 | Lₐ₁₁₆₆ | L_{b11} |
| 2809 | Lₐ₁₀₉₅ | L_{b12} | 2810 | Lₐ₁₁₆₆ | L_{b12} |
| 2811 | Lₐ₁₀₉₅ | L_{b13} | 2812 | Lₐ₁₁₆₆ | L_{b13} |
| 2813 | Lₐ₁₀₉₅ | L_{b14} | 2814 | Lₐ₁₁₆₆ | L_{b14} |
| 2815 | Lₐ₁₀₉₅ | L_{b15} | 2816 | Lₐ₁₁₆₆ | L_{b15} |
| 2817 | Lₐ₁₀₉₅ | L_{b17} | 2818 | Lₐ₁₁₆₆ | L_{b17} |
| 2819 | Lₐ₁₀₉₅ | L_{b19} | 2820 | Lₐ₁₁₆₆ | L_{b19} |
| 2821 | Lₐ₁₀₉₅ | L_{b21} | 2822 | Lₐ₁₁₆₆ | L_{b21} |
| 2823 | Lₐ₁₀₉₅ | L_{b22} | 2824 | Lₐ₁₁₆₆ | L_{b22} |
| 2825 | Lₐ₁₀₉₅ | L_{b23} | 2826 | Lₐ₁₁₆₆ | L_{b23} |
| 2827 | Lₐ₁₀₉₅ | L_{b24} | 2828 | Lₐ₁₁₆₆ | L_{b24} |
| 2829 | Lₐ₁₀₉₅ | L_{b25} | 2830 | Lₐ₁₁₆₆ | L_{b25} |
| 2831 | Lₐ₁₀₉₅ | L_{b26} | 2832 | Lₐ₁₁₆₆ | L_{b26} |
| 2833 | Lₐ₁₀₉₅ | L_{b27} | 2834 | Lₐ₁₁₆₆ | L_{b27} |
| 2835 | Lₐ₁₀₉₅ | L_{b28} | 2836 | Lₐ₁₁₆₆ | L_{b28} |
| 2837 | Lₐ₁₀₉₅ | L_{b29} | 2838 | Lₐ₁₁₆₆ | L_{b29} |
| 2839 | Lₐ₁₀₉₅ | L_{b30} | 2840 | Lₐ₁₁₆₆ | L_{b30} |
| 2841 | Lₐ₁₀₉₅ | L_{b31} | 2842 | Lₐ₁₁₆₆ | L_{b31} |
| 2843 | Lₐ₁₀₉₅ | L_{b32} | 2844 | Lₐ₁₁₆₆ | L_{b32} |
| 2845 | Lₐ₁₀₉₅ | L_{b33} | 2846 | Lₐ₁₁₆₆ | L_{b33} |
| 2847 | Lₐ₁₀₉₅ | L_{b42} | 2848 | Lₐ₁₁₆₆ | L_{b42} |
| 2849 | Lₐ₁₀₉₅ | L_{b43} | 2850 | Lₐ₁₁₆₆ | L_{b43} |
| 2851 | Lₐ₁₀₉₅ | L_{b44} | 2852 | Lₐ₁₁₆₆ | L_{b44} |
| 2853 | Lₐ₁₀₉₅ | L_{b45} | 2854 | Lₐ₁₁₆₆ | L_{b45} |
| 2855 | Lₐ₁₀₉₅ | L_{b46} | 2856 | Lₐ₁₁₆₆ | L_{b46} |
| 2857 | Lₐ₁₀₉₅ | L_{b50} | 2858 | Lₐ₁₁₆₆ | L_{b50} |
| 2859 | Lₐ₁₀₉₅ | L_{b51} | 2860 | Lₐ₁₁₆₆ | L_{b51} |
| 2861 | Lₐ₁₀₉₅ | L_{b53} | 2862 | Lₐ₁₁₆₆ | L_{b53} |
| 2863 | Lₐ₁₀₉₅ | L_{b54} | 2864 | Lₐ₁₁₆₆ | L_{b54} |
| 2865 | Lₐ₁₀₉₅ | L_{b55} | 2866 | Lₐ₁₁₆₆ | L_{b55} |
| 2867 | Lₐ₁₀₉₅ | L_{b56} | 2868 | Lₐ₁₁₆₆ | L_{b56} |
| 2869 | Lₐ₁₀₉₅ | L_{b57} | 2870 | Lₐ₁₁₆₆ | L_{b57} |
| 2871 | Lₐ₁₀₉₅ | L_{b58} | 2872 | Lₐ₁₁₆₆ | L_{b58} |
| 2873 | Lₐ₁₀₉₅ | L_{b59} | 2874 | Lₐ₁₁₆₆ | L_{b59} |
| 2875 | Lₐ₁₀₉₅ | L_{b66} | 2876 | Lₐ₁₁₆₆ | L_{b66} |
| 2877 | Lₐ₁₀₉₅ | L_{b68} | 2878 | Lₐ₁₁₆₆ | L_{b68} |
| 2879 | Lₐ₁₀₉₅ | L_{b70} | 2880 | Lₐ₁₁₆₆ | L_{b70} |
| 2881 | Lₐ₁₀₉₅ | L_{b75} | 2882 | Lₐ₁₁₆₆ | L_{b75} |
| 2883 | Lₐ₁₀₉₅ | L_{b76} | 2884 | Lₐ₁₁₆₆ | L_{b76} |
| 2885 | Lₐ₁₀₉₅ | L_{b87} | 2886 | Lₐ₁₁₆₆ | L_{b87} |
| 2887 | Lₐ₁₀₉₅ | L_{b95} | 2888 | Lₐ₁₁₆₆ | L_{b95} |
| 2889 | Lₐ₁₀₉₅ | L_{b96} | 2890 | Lₐ₁₁₆₆ | L_{b96} |
| 2891 | Lₐ₁₀₉₅ | L_{b97} | 2892 | Lₐ₁₁₆₆ | L_{b97} |
| 2893 | Lₐ₁₀₉₅ | L_{b98} | 2894 | Lₐ₁₁₆₆ | L_{b98} |
| 2895 | Lₐ₁₀₉₅ | L_{b109} | 2896 | Lₐ₁₁₆₆ | L_{b109} |
| 2897 | Lₐ₁₀₉₅ | L_{b110} | 2898 | Lₐ₁₁₆₆ | L_{b110} |
| 2899 | Lₐ₁₀₉₅ | L_{b111} | 2900 | Lₐ₁₁₆₆ | L_{b111} |
| 2901 | Lₐ₁₀₉₅ | L_{b112} | 2902 | Lₐ₁₁₆₆ | L_{b112} |
| 2903 | Lₐ₁₀₉₅ | L_{b114} | 2904 | Lₐ₁₁₆₆ | L_{b114} |
| 2905 | Lₐ₁₀₉₅ | L_{b117} | 2906 | Lₐ₁₁₆₆ | L_{b117} |
| 2907 | Lₐ₁₀₉₅ | L_{b122} | 2908 | Lₐ₁₁₆₆ | L_{b122} |
| 2909 | Lₐ₁₀₉₅ | L_{b123} | 2910 | Lₐ₁₁₆₆ | L_{b123} |
| 2911 | Lₐ₁₀₉₅ | L_{b129} | 2912 | Lₐ₁₁₆₆ | L_{b129} |
| 2913 | Lₐ₁₀₉₅ | L_{b130} | 2914 | Lₐ₁₁₆₆ | L_{b130} |
| 2915 | Lₐ₁₀₉₅ | L_{b131} | 2916 | Lₐ₁₁₆₆ | L_{b131} |
| 2917 | Lₐ₁₀₉₅ | L_{b133} | 2918 | Lₐ₁₁₆₆ | L_{b133} |
| 2919 | Lₐ₁₀₉₅ | L_{b134} | 2920 | Lₐ₁₁₆₆ | L_{b134} |
| 2921 | Lₐ₁₀₉₅ | L_{b135} | 2922 | Lₐ₁₁₆₆ | L_{b135} |
| 2923 | Lₐ₁₀₉₅ | L_{b148} | 2924 | Lₐ₁₁₆₆ | L_{b148} |
| 2925 | Lₐ₁₀₉₅ | L_{b149} | 2926 | Lₐ₁₁₆₆ | L_{b149} |
| 2927 | Lₐ₁₀₉₅ | L_{b150} | 2928 | Lₐ₁₁₆₆ | L_{b150} |
| 2929 | Lₐ₁₀₉₅ | L_{b151} | 2930 | Lₐ₁₁₆₆ | L_{b151} |
| 2931 | Lₐ₁₂₃₇ | L_{b2} | 2932 | Lₐ₁₅₆₉ | L_{b2} |
| 2933 | Lₐ₁₂₃₇ | L_{b4} | 2934 | Lₐ₁₅₆₉ | L_{b4} |
| 2935 | Lₐ₁₂₃₇ | L_{b5} | 2936 | Lₐ₁₅₆₉ | L_{b5} |
| 2937 | Lₐ₁₂₃₇ | L_{b10} | 2938 | Lₐ₁₅₆₉ | L_{b10} |
| 2939 | Lₐ₁₂₃₇ | L_{b11} | 2940 | Lₐ₁₅₆₉ | L_{b11} |
| 2941 | Lₐ₁₂₃₇ | L_{b12} | 2942 | Lₐ₁₅₆₉ | L_{b12} |
| 2943 | Lₐ₁₂₃₇ | L_{b13} | 2944 | Lₐ₁₅₆₉ | L_{b13} |
| 2945 | Lₐ₁₂₃₇ | L_{b14} | 2946 | Lₐ₁₅₆₉ | L_{b14} |
| 2947 | Lₐ₁₂₃₇ | L_{b15} | 2948 | Lₐ₁₅₆₉ | L_{b15} |
| 2949 | Lₐ₁₂₃₇ | L_{b17} | 2950 | Lₐ₁₅₆₉ | L_{b17} |
| 2951 | Lₐ₁₂₃₇ | L_{b19} | 2952 | Lₐ₁₅₆₉ | L_{b19} |
| 2953 | Lₐ₁₂₃₇ | L_{b21} | 2954 | Lₐ₁₅₆₉ | L_{b21} |
| 2955 | Lₐ₁₂₃₇ | L_{b22} | 2956 | Lₐ₁₅₆₉ | L_{b22} |
| 2957 | Lₐ₁₂₃₇ | L_{b23} | 2958 | Lₐ₁₅₆₉ | L_{b23} |
| 2959 | Lₐ₁₂₃₇ | L_{b24} | 2960 | Lₐ₁₅₆₉ | L_{b24} |
| 2961 | Lₐ₁₂₃₇ | L_{b25} | 2962 | Lₐ₁₅₆₉ | L_{b25} |
| 2963 | Lₐ₁₂₃₇ | L_{b26} | 2964 | Lₐ₁₅₆₉ | L_{b26} |
| 2965 | Lₐ₁₂₃₇ | L_{b27} | 2966 | Lₐ₁₅₆₉ | L_{b27} |
| 2967 | Lₐ₁₂₃₇ | L_{b28} | 2968 | Lₐ₁₅₆₉ | L_{b28} |
| 2969 | Lₐ₁₂₃₇ | L_{b29} | 2970 | Lₐ₁₅₆₉ | L_{b29} |
| 2971 | Lₐ₁₂₃₇ | L_{b30} | 2972 | Lₐ₁₅₆₉ | L_{b30} |
| 2973 | Lₐ₁₂₃₇ | L_{b31} | 2974 | Lₐ₁₅₆₉ | L_{b31} |
| 2975 | Lₐ₁₂₃₇ | L_{b32} | 2976 | Lₐ₁₅₆₉ | L_{b32} |
| 2977 | Lₐ₁₂₃₇ | L_{b33} | 2978 | Lₐ₁₅₆₉ | L_{b33} |
| 2979 | Lₐ₁₂₃₇ | L_{b42} | 2980 | Lₐ₁₅₆₉ | L_{b42} |
| 2981 | Lₐ₁₂₃₇ | L_{b43} | 2982 | Lₐ₁₅₆₉ | L_{b43} |
| 2983 | Lₐ₁₂₃₇ | L_{b44} | 2984 | Lₐ₁₅₆₉ | L_{b44} |
| 2985 | Lₐ₁₂₃₇ | L_{b45} | 2986 | Lₐ₁₅₆₉ | L_{b45} |
| 2987 | Lₐ₁₂₃₇ | L_{b46} | 2988 | Lₐ₁₅₆₉ | L_{b46} |
| 2989 | Lₐ₁₂₃₇ | L_{b50} | 2990 | Lₐ₁₅₆₉ | L_{b50} |
| 2991 | Lₐ₁₂₃₇ | L_{b51} | 2992 | Lₐ₁₅₆₉ | L_{b51} |
| 2993 | Lₐ₁₂₃₇ | L_{b53} | 2994 | Lₐ₁₅₆₉ | L_{b53} |
| 2995 | Lₐ₁₂₃₇ | L_{b54} | 2996 | Lₐ₁₅₆₉ | L_{b54} |
| 2997 | Lₐ₁₂₃₇ | L_{b55} | 2998 | Lₐ₁₅₆₉ | L_{b55} |
| 2999 | Lₐ₁₂₃₇ | L_{b56} | 3000 | Lₐ₁₅₆₉ | L_{b56} |
| 3001 | Lₐ₁₂₃₇ | L_{b57} | 3002 | Lₐ₁₅₆₉ | L_{b57} |
| 3003 | Lₐ₁₂₃₇ | L_{b58} | 3004 | Lₐ₁₅₆₉ | L_{b58} |
| 3005 | Lₐ₁₂₃₇ | L_{b59} | 3006 | Lₐ₁₅₆₉ | L_{b59} |
| 3007 | Lₐ₁₂₃₇ | L_{b66} | 3008 | Lₐ₁₅₆₉ | L_{b66} |
| 3009 | Lₐ₁₂₃₇ | L_{b68} | 3010 | Lₐ₁₅₆₉ | L_{b68} |
| 3011 | Lₐ₁₂₃₇ | L_{b70} | 3012 | Lₐ₁₅₆₉ | L_{b70} |
| 3013 | Lₐ₁₂₃₇ | L_{b75} | 3014 | Lₐ₁₅₆₉ | L_{b75} |
| 3015 | Lₐ₁₂₃₇ | L_{b76} | 3016 | Lₐ₁₅₆₉ | L_{b76} |
| 3017 | Lₐ₁₂₃₇ | L_{b87} | 3018 | Lₐ₁₅₆₉ | L_{b87} |
| 3019 | Lₐ₁₂₃₇ | L_{b95} | 3020 | Lₐ₁₅₆₉ | L_{b95} |
| 3021 | Lₐ₁₂₃₇ | L_{b96} | 3022 | Lₐ₁₅₆₉ | L_{b96} |
| 3023 | Lₐ₁₂₃₇ | L_{b97} | 3024 | Lₐ₁₅₆₉ | L_{b97} |
| 3025 | Lₐ₁₂₃₇ | L_{b98} | 3026 | Lₐ₁₅₆₉ | L_{b98} |
| 3027 | Lₐ₁₂₃₇ | L_{b109} | 3028 | Lₐ₁₅₆₉ | L_{b109} |
| 3029 | Lₐ₁₂₃₇ | L_{b110} | 3030 | Lₐ₁₅₆₉ | L_{b110} |
| 3031 | Lₐ₁₂₃₇ | L_{b111} | 3032 | Lₐ₁₅₆₉ | L_{b111} |
| 3033 | Lₐ₁₂₃₇ | L_{b112} | 3034 | Lₐ₁₅₆₉ | L_{b112} |
| 3035 | Lₐ₁₂₃₇ | L_{b114} | 3036 | Lₐ₁₅₆₉ | L_{b114} |
| 3037 | Lₐ₁₂₃₇ | L_{b117} | 3038 | Lₐ₁₅₆₉ | L_{b117} |
| 3039 | Lₐ₁₂₃₇ | L_{b122} | 3040 | Lₐ₁₅₆₉ | L_{b122} |
| 3041 | Lₐ₁₂₃₇ | L_{b123} | 3042 | Lₐ₁₅₆₉ | L_{b123} |
| 3043 | Lₐ₁₂₃₇ | L_{b129} | 3044 | Lₐ₁₅₆₉ | L_{b129} |
| 3045 | Lₐ₁₂₃₇ | L_{b130} | 3046 | Lₐ₁₅₆₉ | L_{b130} |
| 3047 | Lₐ₁₂₃₇ | L_{b131} | 3048 | Lₐ₁₅₆₉ | L_{b131} |
| 3049 | Lₐ₁₂₃₇ | L_{b133} | 3050 | Lₐ₁₅₆₉ | L_{b133} |
| 3051 | Lₐ₁₂₃₇ | L_{b134} | 3052 | Lₐ₁₅₆₉ | L_{b134} |
| 3053 | Lₐ₁₂₃₇ | L_{b135} | 3054 | Lₐ₁₅₆₉ | L_{b135} |
| 3055 | Lₐ₁₂₃₇ | L_{b148} | 3056 | Lₐ₁₅₆₉ | L_{b148} |
| 3057 | Lₐ₁₂₃₇ | L_{b149} | 3058 | Lₐ₁₅₆₉ | L_{b149} |
| 3059 | Lₐ₁₂₃₇ | L_{b150} | 3060 | Lₐ₁₅₆₉ | L_{b150} |
| 3061 | Lₐ₁₂₃₇ | L_{b151} | 3062 | Lₐ₁₅₆₉ | L_{b151} |
| 3063 | Lₐ₁₅₇₀ | L_{b2} | 3064 | Lₐ₁₈₉₁ | L_{b2} |
| 3065 | Lₐ₁₅₇₀ | L_{b4} | 3066 | Lₐ₁₈₉₁ | L_{b4} |
| 3067 | Lₐ₁₅₇₀ | L_{b5} | 3068 | Lₐ₁₈₉₁ | L_{b5} |
| 3069 | Lₐ₁₅₇₀ | L_{b10} | 3070 | Lₐ₁₈₉₁ | L_{b10} |
| 3071 | Lₐ₁₅₇₀ | L_{b11} | 3072 | Lₐ₁₈₉₁ | L_{b11} |
| 3073 | Lₐ₁₅₇₀ | L_{b12} | 3074 | Lₐ₁₈₉₁ | L_{b12} |
| 3075 | Lₐ₁₅₇₀ | L_{b13} | 3076 | Lₐ₁₈₉₁ | L_{b13} |
| 3077 | Lₐ₁₅₇₀ | L_{b14} | 3078 | Lₐ₁₈₉₁ | L_{b14} |
| 3079 | Lₐ₁₅₇₀ | L_{b15} | 3080 | Lₐ₁₈₉₁ | L_{b15} |
| 3081 | Lₐ₁₅₇₀ | L_{b17} | 3082 | Lₐ₁₈₉₁ | L_{b17} |
| 3083 | Lₐ₁₅₇₀ | L_{b19} | 3084 | Lₐ₁₈₉₁ | L_{b19} |
| 3085 | Lₐ₁₅₇₀ | L_{b21} | 3086 | Lₐ₁₈₉₁ | L_{b21} |
| 3087 | Lₐ₁₅₇₀ | L_{b22} | 3088 | Lₐ₁₈₉₁ | L_{b22} |
| 3089 | Lₐ₁₅₇₀ | L_{b23} | 3090 | Lₐ₁₈₉₁ | L_{b23} |
| 3091 | Lₐ₁₅₇₀ | L_{b24} | 3092 | Lₐ₁₈₉₁ | L_{b24} |
| 3093 | Lₐ₁₅₇₀ | L_{b25} | 3094 | Lₐ₁₈₉₁ | L_{b25} |
| 3095 | Lₐ₁₅₇₀ | L_{b26} | 3096 | Lₐ₁₈₉₁ | L_{b26} |
| 3097 | Lₐ₁₅₇₀ | L_{b27} | 3098 | Lₐ₁₈₉₁ | L_{b27} |
| 3099 | Lₐ₁₅₇₀ | L_{b28} | 3100 | Lₐ₁₈₉₁ | L_{b28} |
| 3101 | Lₐ₁₅₇₀ | L_{b29} | 3102 | Lₐ₁₈₉₁ | L_{b29} |
| 3103 | Lₐ₁₅₇₀ | L_{b30} | 3104 | Lₐ₁₈₉₁ | L_{b30} |
| 3105 | Lₐ₁₅₇₀ | L_{b31} | 3106 | Lₐ₁₈₉₁ | L_{b31} |
| 3107 | Lₐ₁₅₇₀ | L_{b32} | 3108 | Lₐ₁₈₉₁ | L_{b32} |
| 3109 | Lₐ₁₅₇₀ | L_{b33} | 3110 | Lₐ₁₈₉₁ | L_{b33} |
| 3111 | Lₐ₁₅₇₀ | L_{b42} | 3112 | Lₐ₁₈₉₁ | L_{b42} |
| 3113 | Lₐ₁₅₇₀ | L_{b43} | 3114 | Lₐ₁₈₉₁ | L_{b43} |
| 3115 | Lₐ₁₅₇₀ | L_{b44} | 3116 | Lₐ₁₈₉₁ | L_{b44} |
| 3117 | Lₐ₁₅₇₀ | L_{b45} | 3118 | Lₐ₁₈₉₁ | L_{b45} |
| 3119 | Lₐ₁₅₇₀ | L_{b46} | 3120 | Lₐ₁₈₉₁ | L_{b56} |
| 3121 | Lₐ₁₅₇₀ | L_{b50} | 3122 | Lₐ₁₈₉₁ | L_{b50} |
| 3123 | Lₐ₁₅₇₀ | L_{b51} | 3124 | Lₐ₁₈₉₁ | L_{b51} |
| 3125 | Lₐ₁₅₇₀ | L_{b53} | 3126 | Lₐ₁₈₉₁ | L_{b53} |
| 3127 | Lₐ₁₅₇₀ | L_{b54} | 3128 | Lₐ₁₈₉₁ | L_{b54} |
| 3129 | Lₐ₁₅₇₀ | L_{b55} | 3130 | Lₐ₁₈₉₁ | L_{b55} |
| 3131 | Lₐ₁₅₇₀ | L_{b56} | 3132 | Lₐ₁₈₉₁ | L_{b56} |
| 3133 | Lₐ₁₅₇₀ | L_{b57} | 3134 | Lₐ₁₈₉₁ | L_{b57} |
| 3135 | Lₐ₁₅₇₀ | L_{b58} | 3136 | Lₐ₁₈₉₁ | L_{b58} |
| 3137 | Lₐ₁₅₇₀ | L_{b59} | 3138 | Lₐ₁₈₉₁ | L_{b59} |
| 3139 | Lₐ₁₅₇₀ | L_{b66} | 3140 | Lₐ₁₈₉₁ | L_{b66} |
| 3141 | Lₐ₁₅₇₀ | L_{b68} | 3142 | Lₐ₁₈₉₁ | L_{b68} |
| 3143 | Lₐ₁₅₇₀ | L_{b70} | 3144 | Lₐ₁₈₉₁ | L_{b70} |
| 3145 | Lₐ₁₅₇₀ | L_{b75} | 3146 | Lₐ₁₈₉₁ | L_{b75} |
| 3147 | Lₐ₁₅₇₀ | L_{b76} | 3148 | Lₐ₁₈₉₁ | L_{b76} |
| 3149 | Lₐ₁₅₇₀ | L_{b87} | 3150 | Lₐ₁₈₉₁ | L_{b87} |
| 3151 | Lₐ₁₅₇₀ | L_{b95} | 3152 | Lₐ₁₈₉₁ | L_{b95} |
| 3153 | Lₐ₁₅₇₀ | L_{b96} | 3154 | Lₐ₁₈₉₁ | L_{b96} |
| 3155 | Lₐ₁₅₇₀ | L_{b97} | 3156 | Lₐ₁₈₉₁ | L_{b97} |
| 3157 | Lₐ₁₅₇₀ | L_{b98} | 3158 | Lₐ₁₈₉₁ | L_{b98} |
| 3159 | Lₐ₁₅₇₀ | L_{b109} | 3160 | Lₐ₁₈₉₁ | L_{b109} |
| 3161 | Lₐ₁₅₇₀ | L_{b110} | 3162 | Lₐ₁₈₉₁ | L_{b110} |
| 3163 | Lₐ₁₅₇₀ | L_{b111} | 3164 | Lₐ₁₈₉₁ | L_{b111} |
| 3165 | Lₐ₁₅₇₀ | L_{b112} | 3166 | Lₐ₁₈₉₁ | L_{b112} |
| 3167 | Lₐ₁₅₇₀ | L_{b114} | 3168 | Lₐ₁₈₉₁ | L_{b114} |
| 3169 | Lₐ₁₅₇₀ | L_{b117} | 3170 | Lₐ₁₈₉₁ | L_{b117} |
| 3171 | Lₐ₁₅₇₀ | L_{b122} | 3172 | Lₐ₁₈₉₁ | L_{b122} |
| 3173 | Lₐ₁₅₇₀ | L_{b123} | 3174 | Lₐ₁₈₉₁ | L_{b123} |
| 3175 | Lₐ₁₅₇₀ | L_{b129} | 3176 | Lₐ₁₈₉₁ | L_{b129} |
| 3177 | Lₐ₁₅₇₀ | L_{b130} | 3178 | Lₐ₁₈₉₁ | L_{b130} |
| 3179 | Lₐ₁₅₇₀ | L_{b131} | 3180 | Lₐ₁₈₉₁ | L_{b131} |
| 3181 | Lₐ₁₅₇₀ | L_{b133} | 3182 | Lₐ₁₈₉₁ | L_{b133} |
| 3183 | Lₐ₁₅₇₀ | L_{b134} | 3184 | Lₐ₁₈₉₁ | L_{b134} |
| 3185 | Lₐ₁₅₇₀ | L_{b135} | 3186 | Lₐ₁₈₉₁ | L_{b135} |
| 3187 | Lₐ₁₅₇₀ | L_{b148} | 3188 | Lₐ₁₈₉₁ | L_{b148} |
| 3189 | Lₐ₁₅₇₀ | L_{b149} | 3190 | Lₐ₁₈₉₁ | L_{b149} |
| 3191 | Lₐ₁₅₇₀ | L_{b150} | 3192 | Lₐ₁₈₉₁ | L_{b150} |
| 3193 | Lₐ₁₅₇₀ | L_{b151} | 3194 | Lₐ₁₈₉₁ | L_{b151} |
| 3195 | Lₐ₁₉₆₂ | L_{b2} | 3196 | Lₐ₂₇₈₅ | L_{b2} |
| 3197 | Lₐ₁₉₆₂ | L_{b4} | 3198 | Lₐ₂₇₈₅ | L_{b4} |
| 3199 | Lₐ₁₉₆₂ | L_{b5} | 3200 | Lₐ₂₇₈₅ | L_{b5} |
| 3201 | Lₐ₁₉₆₂ | L_{b10} | 3202 | Lₐ₂₇₈₅ | L_{b10} |
| 3203 | Lₐ₁₉₆₂ | L_{b11} | 3204 | Lₐ₂₇₈₅ | L_{b11} |
| 3205 | Lₐ₁₉₆₂ | L_{b12} | 3206 | Lₐ₂₇₈₅ | L_{b12} |
| 3207 | Lₐ₁₉₆₂ | L_{b13} | 3208 | Lₐ₂₇₈₅ | L_{b13} |
| 3209 | Lₐ₁₉₆₂ | L_{b14} | 3210 | Lₐ₂₇₈₅ | L_{b14} |
| 3211 | Lₐ₁₉₆₂ | L_{b15} | 3212 | Lₐ₂₇₈₅ | L_{b15} |
| 3213 | Lₐ₁₉₆₂ | L_{b17} | 3214 | Lₐ₂₇₈₅ | L_{b17} |
| 3215 | Lₐ₁₉₆₂ | L_{b19} | 3216 | Lₐ₂₇₈₅ | L_{b19} |
| 3217 | Lₐ₁₉₆₂ | L_{b21} | 3218 | Lₐ₂₇₈₅ | L_{b21} |
| 3219 | Lₐ₁₉₆₂ | L_{b22} | 3220 | Lₐ₂₇₈₅ | L_{b22} |
| 3221 | Lₐ₁₉₆₂ | L_{b23} | 3222 | Lₐ₂₇₈₅ | L_{b23} |
| 3223 | Lₐ₁₉₆₂ | L_{b24} | 3224 | Lₐ₂₇₈₅ | L_{b24} |
| 3225 | Lₐ₁₉₆₂ | L_{b25} | 3226 | Lₐ₂₇₈₅ | L_{b25} |
| 3227 | Lₐ₁₉₆₂ | L_{b26} | 3228 | Lₐ₂₇₈₅ | L_{b26} |
| 3229 | Lₐ₁₉₆₂ | L_{b27} | 3230 | Lₐ₂₇₈₅ | L_{b27} |
| 3231 | Lₐ₁₉₆₂ | L_{b28} | 3232 | Lₐ₂₇₈₅ | L_{b28} |
| 3233 | Lₐ₁₉₆₂ | L_{b29} | 3234 | Lₐ₂₇₈₅ | L_{b29} |
| 3235 | Lₐ₁₉₆₂ | L_{b30} | 3236 | Lₐ₂₇₈₅ | L_{b30} |
| 3237 | Lₐ₁₉₆₂ | L_{b31} | 3238 | Lₐ₂₇₈₅ | L_{b31} |
| 3239 | Lₐ₁₉₆₂ | L_{b32} | 3240 | Lₐ₂₇₈₅ | L_{b32} |
| 3241 | Lₐ₁₉₆₂ | L_{b33} | 3242 | Lₐ₂₇₈₅ | L_{b33} |
| 3243 | Lₐ₁₉₆₂ | L_{b42} | 3244 | Lₐ₂₇₈₅ | L_{b42} |
| 3245 | Lₐ₁₉₆₂ | L_{b43} | 3246 | Lₐ₂₇₈₅ | L_{b43} |
| 3247 | Lₐ₁₉₆₂ | L_{b44} | 3248 | Lₐ₂₇₈₅ | L_{b44} |
| 3249 | Lₐ₁₉₆₂ | L_{b45} | 3250 | Lₐ₂₇₈₅ | L_{b45} |
| 3251 | Lₐ₁₉₆₂ | L_{b46} | 3252 | Lₐ₂₇₈₅ | L_{b46} |
| 3253 | Lₐ₁₉₆₂ | L_{b50} | 3254 | Lₐ₂₇₈₅ | L_{b50} |
| 3255 | Lₐ₁₉₆₂ | L_{b51} | 3256 | Lₐ₂₇₈₅ | L_{b51} |
| 3257 | Lₐ₁₉₆₂ | L_{b53} | 3258 | Lₐ₂₇₈₅ | L_{b53} |
| 3259 | Lₐ₁₉₆₂ | L_{b54} | 3260 | Lₐ₂₇₈₅ | L_{b54} |
| 3261 | Lₐ₁₉₆₂ | L_{b55} | 3262 | Lₐ₂₇₈₅ | L_{b55} |
| 3263 | Lₐ₁₉₆₂ | L_{b56} | 3264 | Lₐ₂₇₈₅ | L_{b56} |
| 3265 | Lₐ₁₉₆₂ | L_{b57} | 3266 | Lₐ₂₇₈₅ | L_{b57} |
| 3267 | Lₐ₁₉₆₂ | L_{b58} | 3268 | Lₐ₂₇₈₅ | L_{b58} |
| 3269 | Lₐ₁₉₆₂ | L_{b59} | 3270 | Lₐ₂₇₈₅ | L_{b59} |
| 3271 | Lₐ₁₉₆₂ | L_{b66} | 3272 | Lₐ₂₇₈₅ | L_{b66} |
| 3273 | Lₐ₁₉₆₂ | L_{b68} | 3274 | Lₐ₂₇₈₅ | L_{b68} |
| 3275 | Lₐ₁₉₆₂ | L_{b70} | 3276 | Lₐ₂₇₈₅ | L_{b70} |
| 3277 | Lₐ₁₉₆₂ | L_{b75} | 3278 | Lₐ₂₇₈₅ | L_{b75} |
| 3279 | Lₐ₁₉₆₂ | L_{b76} | 3280 | Lₐ₂₇₈₅ | L_{b76} |
| 3281 | Lₐ₁₉₆₂ | L_{b87} | 3282 | Lₐ₂₇₈₅ | L_{b87} |
| 3283 | Lₐ₁₉₆₂ | L_{b95} | 3284 | Lₐ₂₇₈₅ | L_{b95} |
| 3285 | Lₐ₁₉₆₂ | L_{b96} | 3286 | Lₐ₂₇₈₅ | L_{b96} |
| 3287 | Lₐ₁₉₆₂ | L_{b97} | 3288 | Lₐ₂₇₈₅ | L_{b97} |
| 3289 | Lₐ₁₉₆₂ | L_{b98} | 3290 | Lₐ₂₇₈₅ | L_{b98} |
| 3291 | Lₐ₁₉₆₂ | L_{b109} | 3292 | Lₐ₂₇₈₅ | L_{b109} |
| 3293 | Lₐ₁₉₆₂ | L_{b110} | 3294 | Lₐ₂₇₈₅ | L_{b110} |
| 3295 | Lₐ₁₉₆₂ | L_{b111} | 3296 | Lₐ₂₇₈₅ | L_{b111} |
| 3297 | Lₐ₁₉₆₂ | L_{b112} | 3298 | Lₐ₂₇₈₅ | L_{b112} |
| 3299 | Lₐ₁₉₆₂ | L_{b114} | 3300 | Lₐ₂₇₈₅ | L_{b114} |
| 3301 | Lₐ₁₉₆₂ | L_{b117} | 3302 | Lₐ₂₇₈₅ | L_{b117} |
| 3303 | Lₐ₁₉₆₂ | L_{b122} | 3304 | Lₐ₂₇₈₅ | L_{b122} |
| 3305 | Lₐ₁₉₆₂ | L_{b123} | 3306 | Lₐ₂₇₈₅ | L_{b123} |
| 3307 | Lₐ₁₉₆₂ | L_{b129} | 3308 | Lₐ₂₇₈₅ | L_{b129} |
| 3309 | Lₐ₁₉₆₂ | L_{b130} | 3310 | Lₐ₂₇₈₅ | L_{b130} |
| 3311 | Lₐ₁₉₆₂ | L_{b131} | 3312 | Lₐ₂₇₈₅ | L_{b131} |
| 3313 | Lₐ₁₉₆₂ | L_{b133} | 3314 | Lₐ₂₇₈₅ | L_{b133} |
| 3315 | Lₐ₁₉₆₂ | L_{b134} | 3316 | Lₐ₂₇₈₅ | L_{b134} |
| 3317 | Lₐ₁₉₆₂ | L_{b135} | 3318 | Lₐ₂₇₈₅ | L_{b135} |
| 3319 | Lₐ₁₉₆₂ | L_{b148} | 3320 | Lₐ₂₇₈₅ | L_{b148} |
| 3321 | Lₐ₁₉₆₂ | L_{b149} | 3322 | Lₐ₂₇₈₅ | L_{b149} |
| 3323 | Lₐ₁₉₆₂ | L_{b150} | 3324 | Lₐ₂₇₈₅ | L_{b150} |
| 3325 | Lₐ₁₉₆₂ | L_{b151} | 3326 | Lₐ₂₇₈₅ | L_{b151} |
| 3327 | Lₐ₁₆₄₇ | L_{b2} | 3328 | Lₐ₁₆₇₇ | L_{b2} |
| 3329 | Lₐ₁₆₄₇ | L_{b4} | 3330 | Lₐ₁₆₇₇ | L_{b4} |
| 3331 | Lₐ₁₆₄₇ | L_{b5} | 3332 | Lₐ₁₆₇₇ | L_{b5} |
| 3333 | Lₐ₁₆₄₇ | L_{b10} | 3334 | Lₐ₁₆₇₇ | L_{b10} |
| 3335 | Lₐ₁₆₄₇ | L_{b11} | 3336 | Lₐ₁₆₇₇ | L_{b11} |
| 3337 | Lₐ₁₆₄₇ | L_{b12} | 3338 | Lₐ₁₆₇₇ | L_{b12} |
| 3339 | Lₐ₁₆₄₇ | L_{b13} | 3340 | Lₐ₂₈₅₆ | L_{b13} |
| 3341 | Lₐ₁₆₄₇ | L_{b14} | 3342 | Lₐ₂₈₅₆ | L_{b14} |
| 3343 | Lₐ₁₆₄₇ | L_{b15} | 3344 | Lₐ₂₈₅₆ | L_{b15} |
| 3345 | Lₐ₁₆₄₇ | L_{b17} | 3346 | Lₐ₂₈₅₆ | L_{b17} |
| 3347 | Lₐ₁₄₈ | L_{b19} | 3348 | Lₐ₂₈₅₆ | L_{b19} |
| 3349 | Lₐ₁₆₄₈ | L_{b21} | 3350 | Lₐ₂₈₅₆ | L_{b21} |
| 3351 | Lₐ₁₆₄₈ | L_{b22} | 3352 | Lₐ₂₈₅₆ | L_{b22} |
| 3353 | Lₐ₁₄₈ | L_{b23} | 3354 | Lₐ₁₆₅₁ | L_{b23} |
| 3355 | Lₐ₁₆₄₈ | L_{b24} | 3356 | Lₐ₁₆₅₁ | L_{b24} |
| 3357 | Lₐ₁₆₄₈ | L_{b25} | 3358 | Lₐ₁₆₅₁ | L_{b25} |
| 3359 | Lₐ₁₆₄₈ | L_{b26} | 3360 | Lₐ₁₆₅₁ | L_{b26} |
| 3361 | Lₐ₁₆₄₉ | L_{b27} | 3362 | Lₐ₁₆₅₁ | _{Lb27} |
| 3363 | Lₐ₁₆₄₉ | L_{b28} | 3364 | Lₐ₁₆₅₁ | L_{b28} |
| 3365 | Lₐ₁₆₄₉ | L_{b29} | 3366 | Lₐ₁₆₅₁ | L_{b29} |
| 3367 | Lₐ₁₆₄₉ | L_{b30} | 3368 | Lₐ₁₆₅₁ | L_{b30} |
| 3369 | Lₐ₁₆₄₉ | L_{b31} | 3370 | Lₐ₁₆₅₁ | L_{b31} |
| 3371 | Lₐ₁₆₄₉ | L_{b32} | 3372 | Lₐ₁₆₇₈ | L_{b32} |
| 3373 | Lₐ₁₆₄₉ | L_{b33} | 3374 | Lₐ₁₆₇₈ | L_{b33} |
| 3375 | Lₐ₁₆₄₉ | L_{b42} | 3376 | Lₐ₁₆₇₈ | L_{b42} |
| 3377 | Lₐ₁₆₄₉ | L_{b43} | 3378 | Lₐ₁₆₇₈ | L_{b43} |
| 3379 | Lₐ₁₆₄₉ | L_{b44} | 3380 | Lₐ₁₆₇₈ | L_{b44} |
| 3381 | Lₐ₁₆₄₉ | L_{b45} | 3382 | Lₐ₁₆₇₈ | L_{b45} |
| 3383 | Lₐ₁₆₄₉ | L_{b46} | 3384 | Lₐ₁₆₇₈ | L_{b46} |
| 3385 | Lₐ₁₆₅₀ | L_{b50} | 3386 | Lₐ₁₆₇₈ | L_{b50} |
| 3387 | Lₐ₁₆₅₀ | L_{b51} | 3388 | Lₐ₂₁₀₄ | L_{b51} |
| 3389 | Lₐ₁₆₅₀ | L_{b53} | 3390 | Lₐ₂₁₀₄ | L_{b53} |
| 3391 | Lₐ₁₆₅₀ | L_{b54} | 3392 | Lₐ₂₁₀₄ | L_{b54} |
| 3393 | Lₐ₁₆₅₀ | L_{b55} | 3394 | Lₐ₂₁₀₄ | L_{b55} |
| 3395 | Lₐ₁₆₅₀ | L_{b56} | 3396 | Lₐ₂₁₀₄ | L_{b56} |
| 3397 | Lₐ₁₆₅₀ | L_{b57} | 3398 | Lₐ₂₁₀₄ | L_{b57} |
| 3399 | Lₐ₁₆₅₀ | L_{b58} | 3400 | Lₐ₂₁₀₄ | L_{b58} |
| 3401 | Lₐ₁₆₅₀ | L_{b59} | 3402 | Lₐ₂₁₀₄ | L_{b59} |
| 3403 | Lₐ₉₂₈ | L_{b66} | 3404 | Lₐ₂₁₀₄ | L_{b66} |
| 3405 | Lₐ₉₂₈ | L_{b68} | 3406 | Lₐ₂₁₀₄ | L_{b68} |
| 3407 | Lₐ₉₂₈ | L_{b70} | 3408 | Lₐ₂₁₀₄ | L_{b70} |
| 3409 | Lₐ₉₂₈ | L_{b75} | 3410 | Lₐ₂₉₂₇ | L_{b75} |
| 3411 | Lₐ₉₂₈ | L_{b76} | 3412 | Lₐ₂₉₂₇ | L_{b76} |
| 3413 | Lₐ₉₂₈ | L_{b87} | 3414 | Lₐ₂₉₂₇ | L_{b87} |
| 3415 | Lₐ₉₂₈ | L_{b95} | 3416 | Lₐ₂₉₂₇ | L_{b95} |
| 3417 | Lₐ₉₂₈ | L_{b96} | 3418 | Lₐ₂₉₂₇ | L_{b96} |
| 3419 | Lₐ₂₇₁₄ | L_{b97} | 3420 | Lₐ₂₉₂₇ | L_{b97} |
| 3421 | Lₐ₂₇₁₄ | L_{b98} | 3422 | Lₐ₂₉₂₇ | L_{b98} |
| 3423 | Lₐ₂₇₁₄ | L_{b109} | 3424 | Lₐ₂₉₂₇ | L_{b109} |
| 3425 | Lₐ₂₇₁₄ | L_{b110} | 3426 | Lₐ₂₉₂₇ | L_{b110} |
| 3427 | Lₐ₂₇₁₄ | L_{b111} | 3428 | Lₐ₁₆₇₉ | L_{b111} |
| 3429 | Lₐ₂₇₁₄ | L_{b112} | 3430 | Lₐ₁₆₇₉ | L_{b112} |
| 3431 | Lₐ₂₇₁₄ | L_{b114} | 3432 | Lₐ₁₆₇₉ | L_{b114} |
| 3433 | Lₐ₂₇₁₄ | L_{b117} | 3434 | Lₐ₁₆₇₉ | L_{b117} |
| 3435 | Lₐ₂₇₁₄ | L_{b122} | 3436 | Lₐ₁₆₇₉ | L_{b122} |
| 3437 | Lₐ₂₆₄₃ | L_{b123} | 3438 | Lₐ₁₆₇₉ | L_{b123} |
| 3439 | Lₐ₂₆₄₃ | L_{b129} | 3440 | Lₐ₁₆₇₉ | L_{b129} |
| 3441 | Lₐ₂₆₄₃ | L_{b130} | 3442 | Lₐ₁₆₇₉ | L_{b130} |
| 3443 | Lₐ₂₆₄₃ | L_{b131} | 3444 | Lₐ₁₆₈₀ | L_{b131} |
| 3445 | Lₐ₂₆₄₃ | L_{b133} | 3446 | Lₐ₁₆₈₀ | L_{b133} |
| 3447 | Lₐ₂₆₄₃ | L_{b134} | 3448 | Lₐ₁₆₈₀ | L_{b134} |
| 3449 | Lₐ₂₆₄₃ | L_{b135} | 3450 | Lₐ₁₆₈₀ | L_{b135} |
| 3451 | Lₐ₂₀₃₃ | L_{b148} | 3452 | Lₐ₁₆₈₀ | L_{b148} |
| 3453 | Lₐ₂₀₃₃ | L_{b149} | 3454 | Lₐ₁₆₈₀ | L_{b149} |
| 3455 | Lₐ₂₀₃₃ | L_{b150} | 3456 | Lₐ₁₆₈₀ | L_{b150} |
| 3457 | Lₐ₂₀₃₃ | L_{b151} | 3458 | Lₐ₁₆₈₀ | L_{b151} |
| 3459 | Lₐ₁₇₉₅ | L_{b2} | 3460 | Lₐ₁₅₇₀ | L_{b2} |
| 3461 | Lₐ₁₇₉₅ | L_{b4} | 3462 | Lₐ₁₅₇₀ | L_{b4} |
| 3463 | Lₐ₁₇₉₅ | L_{b5} | 3464 | Lₐ₁₅₇₀ | L_{b5} |
| 3465 | Lₐ₁₇₉₅ | L_{b10} | 3466 | Lₐ₁₅₇₀ | L_{b10} |
| 3467 | Lₐ₁₇₉₅ | L_{b11} | 3468 | Lₐ₁₅₇₀ | L_{b11} |
| 3469 | Lₐ₁₇₉₅ | L_{b12} | 3470 | Lₐ₁₅₇₀ | L_{b12} |
| 3471 | Lₐ₁₇₉₅ | L_{b13} | 3472 | Lₐ₁₅₇₀ | L_{b13} |
| 3473 | Lₐ₁₇₉₅ | L_{b14} | 3474 | Lₐ₁₅₇₀ | L_{b14} |
| 3475 | Lₐ₁₇₉₅ | L_{b15} | 3476 | Lₐ₁₅₇₀ | L_{b15} |
| 3477 | Lₐ₁₇₉₅ | L_{b17} | 3478 | Lₐ₁₅₇₀ | L_{b17} |
| 3479 | Lₐ₁₈₂₀ | L_{b19} | 3480 | Lₐ₁₅₇₀ | L_{b19} |
| 3481 | Lₐ₁₈₂₀ | L_{b21} | 3482 | Lₐ₁₅₇₀ | L_{b21} |
| 3483 | Lₐ₁₈₂₀ | L_{b22} | 3484 | Lₐ₁₆₉₁ | L_{b22} |
| 3485 | Lₐ₁₈₂₀ | L_{b23} | 3486 | Lₐ₁₆₉₁ | L_{b23} |
| 3487 | Lₐ₁₈₂₀ | L_{b24} | 3488 | Lₐ₁₆₉₁ | L_{b24} |
| 3489 | Lₐ₁₈₂₀ | L_{b25} | 3490 | Lₐ₁₆₉₁ | L_{b25} |
| 3491 | Lₐ₁₈₂₀ | L_{b26} | 3492 | Lₐ₁₆₉₁ | L_{b26} |
| 3493 | Lₐ₁₈₂₀ | L_{b27} | 3494 | Lₐ₁₆₉₁ | L_{b27} |
| 3495 | Lₐ₁₈₂₀ | L_{b28} | 3496 | Lₐ₁₆₉₁ | L_{b28} |
| 3497 | Lₐ₁₈₂₀ | L_{b29} | 3498 | Lₐ₁₆₉₁ | L_{b29} |
| 3499 | Lₐ₂₄₃₇ | L_{b30} | 3500 | Lₐ₁₆₉₁ | L_{b30} |
| 3501 | Lₐ₂₄₃₇ | L_{b31} | 3502 | Lₐ₁₆₉₁ | L_{b31} |
| 3503 | Lₐ₂₄₃₇ | L_{b32} | 3504 | Lₐ₁₆₉₁ | L_{b32} |
| 3505 | Lₐ₂₄₃₇ | L_{b33} | 3506 | Lₐ₁₆₉₁ | L_{b33} |
| 3507 | Lₐ₂₄₃₇ | L_{b42} | 3508 | Lₐ₂₄₃₆ | L_{b42} |
| 3509 | Lₐ₂₄₃₇ | L_{b43} | 3510 | Lₐ₂₄₃₆ | L_{b43} |
| 3511 | Lₐ₂₄₃₇ | L_{b44} | 3512 | Lₐ₂₄₃₆ | L_{b44} |
| 3513 | Lₐ₂₄₃₇ | L_{b45} | 3514 | Lₐ₂₄₃₆ | L_{b45} |
| 3515 | Lₐ₂₄₃₇ | L_{b46} | 3516 | Lₐ₂₄₃₆ | L_{b46} |
| 3517 | Lₐ₂₄₃₇ | L_{b50} | 3518 | Lₐ₂₄₃₆ | L_{b50} |
| 3519 | Lₐ₂₄₃₇ | L_{b51} | 3520 | Lₐ₂₄₃₆ | L_{b51} |
| 3521 | Lₐ₂₄₃₇ | L_{b53} | 3522 | Lₐ₂₄₃₆ | L_{b53} |
| 3523 | Lₐ₂₄₃₇ | L_{b54} | 3524 | Lₐ₂₄₃₆ | L_{b54} |
| 3525 | Lₐ₂₄₃₇ | L_{b55} | 3526 | Lₐ₂₄₃₆ | L_{b55} |
| 3527 | Lₐ₂₄₃₇ | L_{b56} | 3528 | Lₐ₂₄₃₆ | L_{b56} |
| 3529 | Lₐ₂₄₃₇ | L_{b57} | 3530 | Lₐ₂₄₃₆ | L_{b57} |
| 3531 | Lₐ₂₄₃₇ | L_{b58} | 3532 | Lₐ₂₄₃₆ | L_{b58} |
| 3533 | Lₐ₂₄₃₇ | L_{b59} | 3534 | Lₐ₂₄₃₆ | L_{b59} |
| 3535 | Lₐ₂₄₃₇ | L_{b66} | 3536 | Lₐ₂₄₃₆ | L_{b66} |
| 3537 | Lₐ₂₄₃₇ | L_{b68} | 3538 | Lₐ₂₄₃₆ | L_{b68} |
| 3539 | Lₐ₂₄₃₇ | L_{b70} | 3540 | Lₐ₂₄₃₆ | L_{b70} |
| 3541 | Lₐ₂₆₁₈ | L_{b75} | 3542 | Lₐ₂₄₃₆ | L_{b75} |
| 3543 | Lₐ₂₆₁₈ | L_{b76} | 3544 | Lₐ₂₄₃₆ | L_{b76} |
| 3545 | Lₐ₂₆₁₈ | L_{b87} | 3546 | Lₐ₂₄₃₆ | L_{b87} |
| 3547 | Lₐ₂₆₁₈ | L_{b95} | 3548 | Lₐ₂₄₃₆ | L_{b95} |
| 3549 | Lₐ₂₆₁₈ | L_{b96} | 3550 | Lₐ₂₄₃₆ | L_{b96} |
| 3551 | Lₐ₂₆₁₈ | L_{b97} | 3552 | Lₐ₂₄₃₆ | L_{b97} |
| 3553 | Lₐ₂₆₁₈ | L_{b98} | 3554 | Lₐ₂₄₃₆ | L_{b98} |
| 3555 | Lₐ₂₆₁₈ | L_{b109} | 3556 | Lₐ₂₄₃₆ | L_{b109} |
| 3557 | Lₐ₂₆₁₈ | L_{b110} | 3558 | Lₐ₃₃₆₅ | L_{b110} |
| 3559 | Lₐ₂₆₁₈ | L_{b111} | 3560 | Lₐ₃₃₆₅ | L_{b111} |
| 3561 | Lₐ₂₆₁₈ | L_{b112} | 3562 | Lₐ₃₃₆₅ | L_{b112} |
| 3563 | Lₐ₂₆₁₈ | L_{b114} | 3564 | Lₐ₃₃₆₅ | L_{b114} |
| 3565 | Lₐ₂₆₁₈ | L_{b117} | 3566 | Lₐ₃₃₆₅ | L_{b117} |
| 3567 | Lₐ₂₆₁₈ | L_{b122} | 3568 | Lₐ₃₃₆₅ | L_{b122} |
| 3569 | Lₐ₃₃₄₁ | L_{b123} | 3570 | Lₐ₃₃₆₅ | L_{b123} |
| 3571 | Lₐ₃₃₄₁ | L_{b129} | 3572 | Lₐ₃₃₆₅ | L_{b129} |
| 3573 | Lₐ₃₃₄₁ | L_{b130} | 3574 | Lₐ₃₃₆₅ | L_{b130} |
| 3575 | Lₐ₃₃₄₁ | L_{b131} | 3576 | Lₐ₃₃₆₅ | L_{b131} |
| 3577 | Lₐ₃₃₄₁ | L_{b133} | 3578 | Lₐ₃₃₆₅ | L_{b133} |
| 3579 | Lₐ₃₃₄₁ | L_{b134} | 3580 | Lₐ₃₃₆₅ | L_{b134} |
| 3581 | Lₐ₃₃₄₁ | L_{b135} | 3582 | Lₐ₃₃₆₅ | L_{b135} |
| 3583 | Lₐ₃₃₄₁ | L_{b148} | 3584 | Lₐ₃₃₆₅ | L_{b148} |
| 3585 | Lₐ₃₃₄₁ | L_{b149} | 3586 | Lₐ₃₃₆₅ | L_{b149} |
| 3587 | Lₐ₃₃₄₁ | L_{b150} | 3588 | Lₐ₃₃₆₅ | L_{b150} |
| 3589 | Lₐ₃₃₄₁ | L_{b151} | 3590 | Lₐ₃₃₆₅ | L_{b151} |
| 3591 | Lₐ₃₃₆₇ | L_{b52} | 3592 | Lₐ₃₃₉₁ | L_{b52} |
| 3593 | Lₐ₃₃₆₈ | L_{b52} | 3594 | Lₐ₃₄₀₀ | L_{b52} |
| 3595 | Lₐ₃₃₈₁ | L_{b52} | 3596 | Lₐ₃₄₁₆ | L_{b52} |
| 3597 | Lₐ₃₃₆₇ | L_{b52} | 3598 | Lₐ₃₃₆₇ | L_{b20} |
| 3599 | Lₐ₃₃₆₈ | L_{b52} | 3600 | Lₐ₃₃₆₈ | L_{b20} |
| 3601 | Lₐ₃₃₆₉ | L_{b52} | 3602 | Lₐ₃₃₆₉ | L_{b20} |
| 3603 | Lₐ₃₃₇₀ | L_{b52} | 3604 | Lₐ₃₃₇₀ | L_{b20} |
| 3605 | Lₐ₃₃₇₁ | L_{b52} | 3606 | Lₐ₃₃₇₁ | L_{b20} |
| 3607 | Lₐ₃₃₇₂ | L_{b52} | 3608 | Lₐ₃₃₇₂ | L_{b20} |
| 3609 | Lₐ₃₃₇₃ | L_{b52} | 3610 | Lₐ₃₃₇₃ | L_{b20} |
| 3611 | Lₐ₃₃₇₄ | L_{b52} | 3612 | Lₐ₃₃₇₄ | L_{b20} |
| 3613 | Lₐ₃₃₇₅ | L_{b52} | 3614 | Lₐ₃₃₇₅ | L_{b20} |
| 3615 | Lₐ₃₃₇₆ | L_{b52} | 3616 | Lₐ₃₃₇₆ | L_{b20} |
| 3617 | Lₐ₃₃₇₇ | L_{b52} | 3618 | Lₐ₃₃₇₇ | L_{b20} |
| 3619 | Lₐ₃₃₇₈ | L_{b52} | 3620 | Lₐ₃₃₇₈ | L_{b20} |
| 3621 | Lₐ₃₃₇₉ | L_{b52} | 3622 | Lₐ₃₃₇₉ | L_{b20} |
| 3623 | Lₐ₃₃₈₀ | L_{b52} | 3624 | Lₐ₃₃₈₀ | L_{b20} |
| 3625 | Lₐ₃₃₈₁ | L_{b52} | 3626 | Lₐ₃₃₈₁ | L_{b20} |
| 3627 | Lₐ₃₃₈₂ | L_{b52} | 3628 | Lₐ₃₃₈₂ | L_{b20} |
| 3629 | Lₐ₃₄₀₈ | L_{b52} | 3630 | Lₐ₃₄₀₈ | L_{b20} |
| 3631 | Lₐ₃₄₀₉ | L_{b52} | 3632 | Lₐ₃₄₀₉ | L_{b20} |
| 3633 | Lₐ₃₄₁₀ | L_{b52} | 3634 | Lₐ₃₄₁₀ | L_{b20} |
| 3635 | Lₐ₃₄₂₃ | L_{b52} | 3636 | Lₐ₃₄₂₃ | L_{b20} |
| 3637 | Lₐ₃₄₂₄ | L_{b52} | 3638 | Lₐ₃₄₂₄ | L_{b20} |
| 3639 | Lₐ₃₄₂₅ | L_{b52} | 3640 | Lₐ₃₄₂₅ | L_{b20} |
| 3641 | Lₐ₃₄₅₃ | L_{b52} | 3642 | Lₐ₃₄₅₃ | L_{b20} |
| 3643 | Lₐ₃₄₅₄ | L_{b52} | 3644 | Lₐ₃₄₅₄ | L_{b20} |
| 3645 | Lₐ₃₄₅₅ | L_{b52} | 3646 | Lₐ₃₄₅₅ | L_{b20} |
| 3647 | Lₐ₃₃₈₃ | L_{b52} | 3648 | Lₐ₃₃₈₃ | L_{b20} |
| 3649 | Lₐ₃₃₈₄ | L_{b52} | 3650 | Lₐ₃₃₈₄ | L_{b20} |
| 3651 | Lₐ₃₃₈₅ | L_{b52} | 3652 | Lₐ₃₃₈₅ | L_{b20} |
| 3653 | Lₐ₃₃₈₆ | L_{b52} | 3654 | Lₐ₃₃₈₆ | L_{b20} |
| 3655 | Lₐ₃₃₈₇ | L_{b52} | 3656 | Lₐ₃₃₈₇ | L_{b20} |
| 3657 | Lₐ₃₃₈₈ | L_{b52} | 3658 | Lₐ₃₃₈₈ | L_{b20} |
| 3659 | Lₐ₃₃₈₉ | L_{b52} | 3660 | Lₐ₃₃₈₉ | L_{b20} |
| 3661 | Lₐ₃₃₉₀ | L_{b52} | 3662 | Lₐ₃₃₉₀ | L_{b20} |
| 3663 | Lₐ₃₃₉₁ | L_{b52} | 3664 | Lₐ₃₃₉₁ | L_{b20} |
| 3665 | Lₐ₃₃₉₂ | L_{b52} | 3666 | Lₐ₃₃₉₂ | L_{b20} |
| 3667 | Lₐ₄₂₀ | L_{b52} | 3668 | Lₐ₄₉₀ | L_{b52} |
| 3669 | Lₐ₄₂₀ | L_{b20} | 3670 | Lₐ₄₉₀ | L_{b20} |
| 3671 | Lₐ₄₂₀ | L_{b135} | 3672 | Lₐ₄₉₀ | L_{b135} |
| 3673 | Lₐ₄₂₀ | L_{b1} | 3674 | Lₐ₄₉₀ | L_{b1} |
| 3675 | Lₐ₄₂₀ | L_{b3} | 3676 | Lₐ₄₉₀ | L_{b3} |
| 3677 | Lₐ₄₂₀ | L_{b8} | 3678 | Lₐ₄₉₀ | L_{b8} |
| 3679 | Lₐ₄₂₀ | L_{b118} | 3680 | Lₐ₄₉₀ | L_{b118} |
| 3681 | Lₐ₄₂₀ | L_{b132} | 3682 | Lₐ₄₉₀ | L_{b132} |
| 3683 | Lₐ₄₂₀ | L_{b150} | 3684 | Lₐ₄₉₀ | L_{b150} |
| 3685 | Lₐ₄₂₀ | L_{b151} | 3686 | Lₐ₄₉₀ | L_{b151} |
| 3687 | Lₐ₁₃₆ | L_{b135} | 3688 | Lₐ₁₅₇ | L_{b135} |
| 3689 | Lₐ₁₃₆ | L_{b150} | 3690 | Lₐ₁₅₇ | L_{b150} |
| 3691 | Lₐ₁₃₆ | L_{b151} | 3692 | Lₐ₁₅₇ | L_{b151} |
| 3693 | Lₐ₂₇₈ | L_{b135} | 3694 | Lₐ₆ | L_{b52} |
| 3695 | Lₐ₂₇₈ | L_{b150} | 3696 | Lₐ₆ | L_{b20} |
| 3697 | Lₐ₂₇₈ | L_{b151} | 3698 | Lₐ₆ | L_{b135} |
| 3699 | Lₐ₁₀₆ | L_{b52} | 3700 | Lₐ₆ | L_{b1} |
| 3701 | Lₐ₁₀₆ | L_{b20} | 3702 | Lₐ₆ | L_{b3} |
| 3703 | Lₐ₁₀₆ | L_{b135} | 3704 | Lₐ₆ | L_{b8} |
| 3705 | Lₐ₁₀₆ | L_{b1} | 3706 | Lₐ₆ | L_{b118} |
| 3707 | Lₐ₁₀₆ | L_{b3} | 3708 | Lₐ₆ | L_{b132} |
| 3709 | Lₐ₁₀₆ | L_{b8} | 3710 | Lₐ₆ | L_{b150} |
| 3711 | Lₐ₁₀₆ | L_{b118} | 3712 | Lₐ₆ | L_{b151} |
| 3713 | Lₐ₁₀₆ | L_{b132} | 3714 | Lₐ₁₁₁ | L_{b52} |
| 3715 | Lₐ₁₀₆ | L_{b150} | 3716 | Lₐ₁₁₁ | L_{b20} |
| 3717 | Lₐ₁₀₆ | L_{b151} | 3718 | Lₐ₁₁₁ | L_{b135} |
| 3719 | Lₐ₄₉ | L_{b52} | 3720 | Lₐ₁₁₁ | L_{b1} |
| 3721 | Lₐ₄₉ | L_{b20} | 3722 | Lₐ₁₁₁ | L_{b3} |
| 3723 | Lₐ₄₉ | L_{b135} | 3724 | Lₐ₁₁₁ | L_{b8} |
| 3725 | Lₐ₄₉ | L_{b1} | 3726 | Lₐ₁₁₁ | L_{b118} |
| 3727 | Lₐ₄₉ | L_{b3} | 3728 | Lₐ₁₁₁ | L_{b132} |
| 3729 | Lₐ₄₉ | L_{b8} | 3730 | Lₐ₁₁₁ | L_{b150} |
| 3731 | Lₐ₄₉ | L_{b118} | 3732 | Lₐ₁₁₁ | L_{b151} |
| 3733 | Lₐ₄₉ | L_{b132} | 3734 | Lₐ₂₂₈ | L_{b52} |
| 3735 | Lₐ₄₉ | L_{b150} | 3736 | Lₐ₂₂₈ | L_{b20} |
| 3737 | Lₐ₄₉ | L_{b151} | 3738 | Lₐ₂₂₈ | L_{b135} |
| 3739 | Lₐ₂₀₇ | L_{b52} | 3740 | Lₐ₂₂₈ | L_{b1} |
| 3741 | Lₐ₂₀₇ | L_{b20} | 3742 | Lₐ₂₂₈ | L_{b3} |
| 3743 | Lₐ₂₀₇ | L_{b135} | 3744 | Lₐ₂₂₈ | L_{b8} |
| 3745 | Lₐ₂₀₇ | L_{b1} | 3746 | Lₐ₂₂₈ | L_{b118} |
| 3747 | Lₐ₂₀₇ | L_{b3} | 3748 | Lₐ₂₂₈ | L_{b132} |
| 3749 | Lₐ₂₀₇ | L_{b8} | 3750 | Lₐ₂₂₈ | L_{b150} |
| 3751 | Lₐ₂₀₇ | L_{b118} | 3752 | Lₐ₂₂₈ | L_{b151} |
| 3753 | Lₐ₂₀₇ | L_{b132} | 3754 | Lₐ₃₇₀ | L_{b52} |
| 3755 | Lₐ₂₀₇ | L_{b150} | 3756 | Lₐ₃₇₀ | L_{b20} |
| 3757 | Lₐ₂₀₇ | L_{b151} | 3758 | Lₐ₃₇₀ | L_{b135} |
| 3759 | Lₐ₃₄₉ | L_{b52} | 3760 | Lₐ₃₇₀ | L_{b1} |
| 3761 | Lₐ₃₄₉ | L_{b20} | 3762 | Lₐ₃₇₀ | L_{b3} |
| 3763 | Lₐ₃₄₉ | L_{b135} | 3764 | Lₐ₃₇₀ | L_{b8} |
| 3765 | Lₐ₃₄₉ | L_{b1} | 3766 | Lₐ₃₇₀ | L_{b118} |
| 3767 | Lₐ₃₄₉ | L_{b3} | 3768 | Lₐ₃₇₀ | L_{b132} |
| 3769 | Lₐ₃₄₉ | L_{b8} | 3770 | Lₐ₃₇₀ | L_{b150} |
| 3771 | Lₐ₃₄₉ | L_{b118} | 3772 | Lₐ₃₇₀ | L_{b151} |
| 3773 | Lₐ₃₄₉ | L_{b132} | 3774 | Lₐ₅₁₁ | L_{b52} |
| 3775 | Lₐ₃₄₉ | L_{b150} | 3776 | Lₐ₅₁₁ | L_{b20} |
| 3777 | Lₐ₃₄₉ | L_{b151} | 3778 | Lₐ₅₁₁ | L_{b135} |
| 3779 | Lₐ₅₈₁ | L_{b52} | 3780 | Lₐ₅₁₁ | L_{b1} |
| 3781 | Lₐ₅₈₁ | L_{b20} | 3782 | Lₐ₅₁₁ | L_{b3} |
| 3783 | Lₐ₅₈₁ | L_{b135} | 3784 | Lₐ₅₁₁ | L_{b8} |
| 3785 | Lₐ₅₈₁ | L_{b1} | 3786 | Lₐ₅₁₁ | L_{b118} |
| 3787 | Lₐ₅₈₁ | L_{b3} | 3788 | Lₐ₅₁₁ | L_{b132} |
| 3789 | Lₐ₅₈₁ | L_{b8} | 3790 | Lₐ₅₁₁ | L_{b150} |
| 3791 | Lₐ₅₈₁ | L_{b118} | 3792 | Lₐ₅₁₁ | L_{b151} |
| 3793 | Lₐ₅₈₁ | L_{b132} | 3794 | Lₐ₅₆₀ | L_{b52} |
| 3795 | Lₐ₅₈₁ | L_{b150} | 3796 | Lₐ₅₆₀ | L_{b20} |
| 3797 | Lₐ₅₈₁ | L_{b151} | 3798 | Lₐ₅₆₀ | L_{b135} |
| 3799 | Lₐ₅₆₀ | L_{b118} | 3800 | Lₐ₅₆₀ | L_{b1} |
| 3801 | Lₐ₅₆₀ | L_{b132} | 3802 | Lₐ₅₆₀ | L_{b3} |
| 3803 | Lₐ₅₆₀ | L_{b150} | 3804 | Lₐ₅₆₀ | L_{b8} |
| 3805 | Lₐ₅₆₀ | L_{b151} | 3806 | Lₐ₅₆₀ | L_{b31} |
.

14. Organische Elektrolumineszenzvorrichtung, umfassend:
eine Anode,
eine Kathode und
eine organische Schicht, die zwischen der Anode und der Kathode angeordnet ist, wobei mindestens eine Schicht der organischen Schicht den Metallkomplex nach einem der Ansprüche 1 bis 13 umfasst,
wobei die den Metallkomplex umfassende organische Schicht vorzugsweise eine lichtemittierende Schicht ist,
wobei die lichtemittierende Schicht vorzugsweise ferner eine erste Wirtsverbindung umfasst,
wobei die lichtemittierende Schicht vorzugsweise ferner eine zweite Wirtsverbindung umfasst und
wobei die erste Wirtsverbindung und/oder die zweite Wirtsverbindung weiter vorzugsweise mindestens eine chemische Gruppe umfassen, ausgewählt aus der Gruppe bestehend aus: Benzol, Pyridin, Pyrimidin, Triazin, Carbazol, Azacarbazol, Indolocarbazol, Dibenzothiophen, Aza-Dibenzothiophen, Dibenzofuran, Azadibenzofuran, Dibenzoselenophen, Triphenylen, Azatriphenylen, Fluoren, Silafluoren, Naphthalin, Chinolin, Isochinolin, Chinazolin, Chinoxalin, Phenanthren, Azaphenanthren und Kombinationen davon,
wobei der Metallkomplex vorzugsweise in die erste Wirtsverbindung und die zweite Wirtsverbindung dotiert ist und das Gewicht des Metallkomplexes 1 % bis 30 % des Gesamtgewichts der lichtemittierenden Schicht ausmacht, und
wobei das Gewicht des Metallkomplexes weiter vorzugsweise 3 % bis 13 % des Gesamtgewichts der lichtemittierenden Schicht ausmacht.

15. Zusammensetzung, umfassend den Metallkomplex nach einem der Ansprüche 1 bis 13.

## Revendications

1. Complexe métallique, comprenant un métal M et un ligand Lₐ coordonné au métal M, dans lequel Lₐ présente une structure représentée par la Formule 1 : 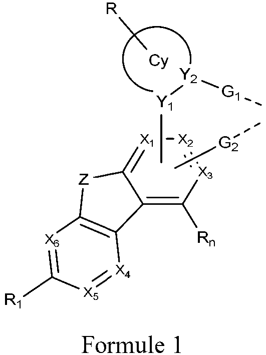 où, dans la Formule 1,
le métal M est, à chaque occurrence de manière identique ou différente, choisi parmi Cu, Ag, Au, Ru, Rh, Pd, Os, Ir et Pt ;
le cycle Cy est, à chaque occurrence de manière identique ou différente, choisi parmi un cycle aromatique ayant 6 à 24 atomes cycliques qui comprend Y₁ et Y₂, un cycle hétéroaromatique ayant 5 à 24 atomes cycliques qui comprend Y₁ et Y₂ ou une combinaison de ceux-ci ;
G₁ et G₂ sont, à chaque occurrence de manière identique ou différente, choisis parmi une liaison simple, O ou S ;
X₁ à X₆ sont, à chaque occurrence de manière identique ou différente, choisis parmi C, CRₓ ou N, et l'un parmi X₁ à X₃ est choisi parmi C et lié à Y₁ ;
l'un parmi X₁, X₂ et X₃ est choisi parmi N et lié au métal à travers une liaison métal-azote, ou l'un parmi X₁, X₂ et X₃ est choisi parmi C et lié au métal à travers G₂ ;
Y₁ et Y₂ sont, à chaque occurrence de manière identique ou différente, choisis parmi C ou N ;
Z est choisi parmi O, S, Se, NR', CR'R', SiR'R' et GeR'R' ; lorsque deux R' sont présents en même temps, les deux R' sont identiques ou différents ;
R représente une mono-substitution, de multiples substitutions ou une non-substitution ; lorsqu'une pluralité de R sont présents, la pluralité de R sont identiques ou différents ;
R, Rₓ et R' sont, à chaque occurrence de manière identique ou différente, choisis parmi : l'hydrogène, le deutérium, un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et les combinaisons de ceux-ci ;
R₁ est choisi parmi un groupe cyano ou un fluor ; et
Rₙ présente une structure représentée par la Formule 2 : 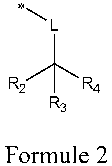
où, dans la Formule 2, « * » représente une position où la Formule 2 est liée à la Formule 1 ;
L est choisi parmi : une liaison simple, un alkylène substitué ou non-substitué ayant 1 à 20 atomes de carbone, un cycloalkylène substitué ou non-substitué ayant 3 à 20 atomes de carbone, un arylène substitué ou non-substitué ayant 6 à 30 atomes de carbone, un hétéroarylène substitué ou non-substitué ayant 3 à 30 atomes de carbone et les combinaisons de ceux-ci ;
R₂, R₃ et R₄ sont, à chaque occurrence de manière identique ou différente, choisis parmi : un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et les combinaisons de ceux-ci ;
les substituants R adjacents peuvent être optionnellement liés de façon à former un cycle ;
les substituants R' et Rₓ adjacents peuvent être optionnellement liés de façon à former un cycle ; et
les substituants R₂, R₃ et R₄ adjacents peuvent être optionnellement liés de façon à former un cycle.

2. Complexe métallique selon la revendication 1, dans lequel le complexe métallique présente une formule générale M(Lₐ)ₘ(L_{b})ₙ(L_{c})_{q} ;
Lₐ, L_{b} et L_{c} représentent un premier ligand, un deuxième ligand et un troisième ligand coordonnés au métal M, respectivement, et L_{c} est identique ou différent de Lₐ ou L_{b}, où Lₐ, L_{b} et L_{c} peuvent être optionnellement liés de façon à former un ligand polydenté ;
m est choisi parmi 1, 2 ou 3, n est choisi parmi 0, 1 ou 2, q est choisi parmi 0, 1 ou 2, et m+n+q est égal à un état d'oxydation du métal M ; lorsque m est supérieur ou égal à 2, une pluralité de Lₐ sont identiques ou différents ; lorsque n est égal à 2, deux L_{c} sont identiques ou différents ; lorsque q est égal à 2, deux L_{c} sont identiques ou différents ;
où 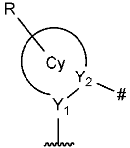 dans la Formule 1 est, à chaque occurrence de manière identique ou différente, choisi parmi l'une quelconque des structures suivantes : 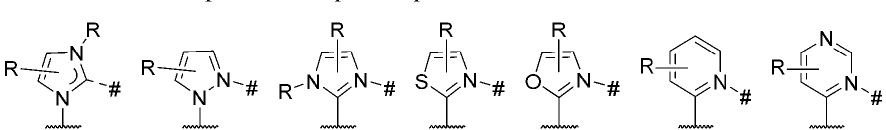 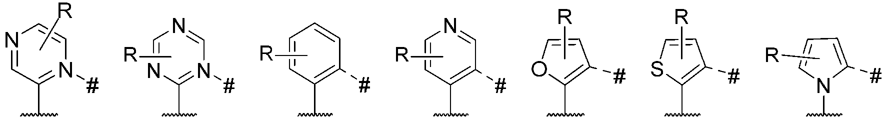 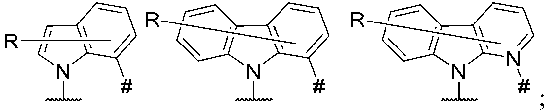 où
R représente, à chaque occurrence de manière identique ou différente, une mono-substitution, de multiples substitutions ou une non-substitution ; lorsqu'une pluralité de R sont présents dans n'importe quelle structure, la pluralité de R sont identiques ou différents ;
R est, à chaque occurrence de manière identique ou différente, choisi parmi : l'hydrogène, le deutérium, un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et les combinaisons de ceux-ci ;
les substituants R adjacents peuvent être optionnellement liés de façon à former un cycle ; et
« # » représente une position où G₁ est lié, et 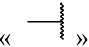 représente une position où X₁, X₂ ou X₃ est lié ;
L_{b} et L_{c} sont, à chaque occurrence de manière identique ou différente, choisis parmi une structure représentée par l'un quelconque parmi : 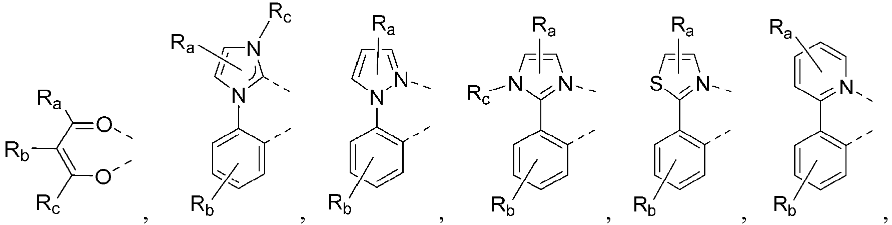 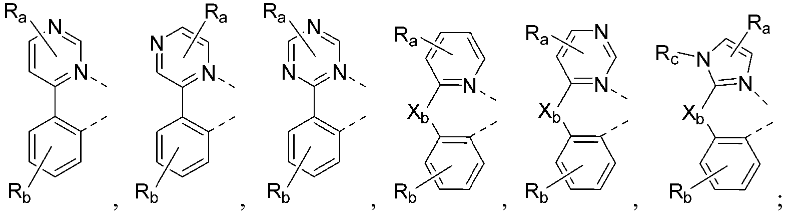 où
X_{b} est, à chaque occurrence de manière identique ou différente, choisi parmi : O, S, Se, NR_{N1} et CR_{C1}R_{C2} ;
Rₐ et R_{b} représentent, à chaque occurrence de manière identique ou différente, une mono-substitution, de multiples substitutions ou une non-substitution ;
Rₐ, R_{b}, R_{c}, R_{N1}, R_{C1} et R_{C2} sont, à chaque occurrence de manière identique ou différente, choisis parmi : l'hydrogène, le deutérium, un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et les combinaisons de ceux-ci ; et
les substituants adjacents Rₐ, R_{b}, R_{c}, R_{N1}, R_{C1} et R_{C2} peuvent être optionnellement liés de façon à former un cycle ;
le métal M est, à chaque occurrence de manière identique ou différente, choisi parmi Pt ou Ir.

3. Complexe métallique selon la revendication 1 ou 2, dans lequel le complexe métallique présente une structure de formule générale Ir(Lₐ)ₘ(L_{b})₃₋ₘ, et la structure est représentée par la Formule 3 : 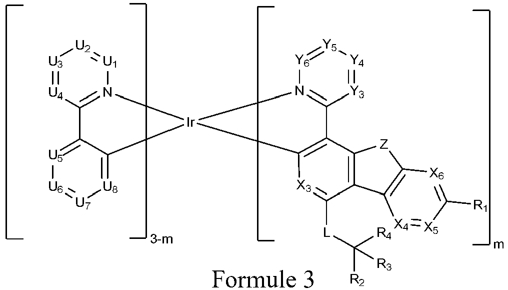 où
m est choisi parmi 1, 2 ou 3 ; lorsque m est choisi parmi 1, deux L_{c} sont identiques ou différents ; lorsque m est choisi parmi 2 ou 3, une pluralité de Lₐ sont identiques ou différents ;
Z est choisi parmi O, S, Se, NR', CR'R', SiR'R' et GeR'R' ; lorsque deux R' sont présents en même temps, les deux R' sont identiques ou différents ;
U₁ à U₈ sont, à chaque occurrence de manière identique ou différente, choisis parmi CRᵤ ou N ;
X₃ à X₆ sont, à chaque occurrence de manière identique ou différente, choisis parmi CRₓ ou N ;
Y₃ à Y₆ sont, à chaque occurrence de manière identique ou différente, choisis parmi CR ou N ;
R₁ est choisi parmi un groupe cyano ou un fluor;
R', Rᵤ, Rₓ et R sont, à chaque occurrence de manière identique ou différente, choisis parmi : l'hydrogène, le deutérium, un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et les combinaisons de ceux-ci ;
L est choisi parmi : une liaison simple, un alkylène substitué ou non-substitué ayant 1 à 20 atomes de carbone, un cycloalkylène substitué ou non-substitué ayant 3 à 20 atomes de carbone, un arylène substitué ou non-substitué ayant 6 à 30 atomes de carbone, un hétéroarylène substitué ou non-substitué ayant 3 à 30 atomes de carbone et les combinaisons de ceux-ci ;
R₂, R₃ et R₄ sont, à chaque occurrence de manière identique ou différente, choisis parmi : un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et les combinaisons de ceux-ci ;
les substituants Rᵤ adjacents peuvent être optionnellement liés de façon à former un cycle ;
les substituants R adjacents peuvent être optionnellement liés de façon à former un cycle ;
les substituants R' et Rₓ adjacents peuvent être optionnellement liés de façon à former un cycle ; et
les substituants R₂, R₃ et R₄ adjacents peuvent être optionnellement liés de façon à former un cycle ;
de préférence, Z est choisi parmi O ou S ; plus préférablement, Z est choisi parmi O.

4. Complexe métallique selon l'une quelconque des revendications 1 à 3, dans lequel L est choisi parmi : une liaison simple, un alkylène substitué ou non-substitué ayant 1 à 6 atomes de carbone, un cycloalkylène substitué ou non-substitué ayant 4 à 10 atomes de carbone, un arylène substitué ou non-substitué ayant 6 à 12 atomes de carbone et les combinaisons de ceux-ci ; et
dans lequel R₂, R₃ et R₄ sont, à chaque occurrence de manière identique ou différente, choisis parmi : un halogène, un alkyle substitué ou non-substitué ayant 1 à 20 atomes de carbone, un cycloalkyle substitué ou non-substitué ayant 3 à 20 atomes de carbone cycliques, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un groupe cyano et les combinaisons de ceux-ci ;
de préférence, L est choisi parmi une liaison simple et un méthylène substitué ou non-substitué ;
de préférence, R₂, R₃ et R₄ sont, à chaque occurrence de manière identique ou différente, choisis parmi : le fluor, un alkyle substitué ou non-substitué ayant 1 à 20 atomes de carbone, un aryle substitué ou non-substitué ayant 6 à 30 atomes de carbone, un groupe cyano et les combinaisons de ceux-ci ; et
plus préférablement, R₂, R₃ et R₄ sont, à chaque occurrence de manière identique ou différente, choisis parmi un alkyle substitué ou non-substitué ayant 1 à 20 atomes de carbone.

5. Complexe métallique selon la revendication 3, dans lequel X₃ à X₆ sont, à chaque occurrence de manière identique ou différente, choisis parmi CRₓ, et/ou Y₃ à Y₆ sont, à chaque occurrence de manière identique ou différente, choisis parmi CR, et/ou U₁ à U₈ sont, à chaque occurrence de manière identique ou différente, choisis parmi CRᵤ ;
Rₓ, R et Rᵤ sont, à chaque occurrence de manière identique ou différente, choisis parmi : l'hydrogène, le deutérium, un halogène, un alkyle substitué ou non-substitué ayant 1 à 20 atomes de carbone, un cycloalkyle substitué ou non-substitué ayant 3 à 20 atomes de carbone cycliques, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un alkylgermanyle substitué ou non-substitué ayant 3 à 20 atomes de carbone, un groupe cyano et les combinaisons de ceux-ci ;
de préférence, Rₓ, R et Rᵤ sont, à chaque occurrence de manière identique ou différente, choisis parmi : l'hydrogène, le deutérium, le fluor, un alkyle substitué ou non-substitué ayant 1 à 6 atomes de carbone, un cycloalkyle substitué ou non-substitué ayant 3 à 6 atomes de carbone cycliques, un aryle substitué ou non-substitué ayant 6 à 12 atomes de carbone, un hétéroaryle substitué ou non-substitué ayant 3 à 12 atomes de carbone, un alkylsilyle substitué ou non-substitué ayant 3 à 12 atomes de carbone, un alkylgermanyle substitué ou non-substitué ayant 3 à 12 atomes de carbone, un groupe cyano et les combinaisons de ceux-ci ; et
plus préférablement, Rₓ, R et Rᵤ sont, à chaque occurrence de manière identique ou différente, choisis parmi : l'hydrogène, le deutérium, le fluor, un groupe cyano, un méthyle, un éthyle, un propyle, un isopropyle, un n-butyle, un isobutyle, un néopentyle, un t-butyle, un cyclopentyle, un cyclohexyle, un méthyle deutéré, un éthyle deutéré, un propyle deutéré, un isopropyle deutéré, un n-butyle deutéré, un isobutyle deutéré, un néopentyle deutéré, un t-butyle deutéré, un cyclopentyle deutéré, un cyclohexyle deutéré, un phényle, un pyridyle, un triméthylsilyle, un triméthylgermanyle et les combinaisons de ceux-ci.

6. Complexe métallique selon la revendication 3, dans lequel Y₃ à Y₆ sont, à chaque occurrence de manière identique ou différente, CR ou N, au moins l'un parmi Y₃ à Y₆ est choisi parmi CR, et R est choisi parmi : le deutérium, un halogène, un alkyle substitué ou non-substitué ayant 1 à 20 atomes de carbone, un cycloalkyle substitué ou non-substitué ayant 3 à 20 atomes de carbone cycliques, un aryle substitué ou non-substitué ayant 6 à 30 atomes de carbone, un hétéroaryle substitué ou non-substitué ayant 3 à 30 atomes de carbone et des combinaisons de ceux-ci ; et
de préférence, R est choisi parmi : le deutérium, le fluor, un alkyle substitué ou non-substitué ayant 1 à 6 atomes de carbone, un cycloalkyle substitué ou non-substitué ayant 3 à 6 atomes de carbone cycliques, un aryle substitué ou non-substitué ayant 6 à 12 atomes de carbone et des combinaisons de ceux-ci.

7. Complexe métallique selon la revendication 1 ou 3, dans lequel au moins l'un parmi X₃ à X₆ est choisi parmi CRₓ, et Rₓ est choisi parmi : le deutérium, un halogène, un alkyle substitué ou non-substitué ayant 1 à 20 atomes de carbone, un cycloalkyle substitué ou non-substitué ayant 3 à 20 atomes de carbone cycliques, un hétéroalkyle substitué ou non-substitué ayant 1 à 20 atomes de carbone, un groupe hétérocyclique substitué ou non-substitué ayant 3 à 20 atomes cycliques, un arylalkyle substitué ou non-substitué ayant 7 à 30 atomes de carbone, un alcoxy substitué ou non-substitué ayant 1 à 20 atomes de carbone, un aryloxy substitué ou non-substitué ayant 6 à 30 atomes de carbone, un alcényle substitué ou non-substitué ayant 2 à 20 atomes de carbone, un alcynyle substitué ou non-substitué ayant 2 à 20 atomes de carbone, un aryle substitué ou non-substitué ayant 6 à 30 atomes de carbone, un hétéroaryle substitué ou non-substitué ayant 3 à 30 atomes de carbone, un alkylsilyle substitué ou non-substitué ayant 3 à 20 atomes de carbone, un arylsilyle substitué ou non-substitué ayant 6 à 20 atomes de carbone, un alkylgermanyle substitué ou non-substitué ayant 3 à 20 atomes de carbone, un arylgermanyle substitué ou non-substitué ayant 6 à 20 atomes de carbone, un amino substitué ou non-substitué ayant 0 à 20 atomes de carbone, un groupe acyle, un groupe carbonyle, un groupe acide carboxylique, un groupe ester, un groupe cyano, un groupe isocyano, un groupe hydroxyle, un groupe sulfanyle, un groupe sulfinyle, un groupe sulfonyle, un groupe phosphino et des combinaisons de ceux-ci ;
de préférence, X₆ est choisi parmi CRₓ, et Rₓ est choisi parmi : le deutérium, un alkyle substitué ou non-substitué ayant 1 à 20 atomes de carbone, un cycloalkyle substitué ou non-substitué ayant 3 à 20 atomes de carbone cycliques, un aryle substitué ou non-substitué ayant 6 à 30 atomes de carbone, un hétéroaryle substitué ou non-substitué ayant 3 à 30 atomes de carbone et des combinaisons de ceux-ci ; et
plus préférablement, X₆ est choisi parmi CRₓ, et Rₓ est choisi parmi un aryle substitué ou non-substitué ayant 6 à 18 atomes de carbone, un hétéroaryle substitué ou non-substitué ayant 3 à 18 atomes de carbone ou une combinaison de ceux-ci.

8. Complexe métallique selon l'une quelconque des revendications 1 à 7, dans lequel Rₙ est, à chaque occurrence de manière identique ou différente, choisi parmi : 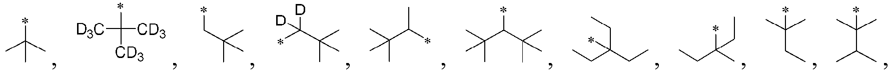 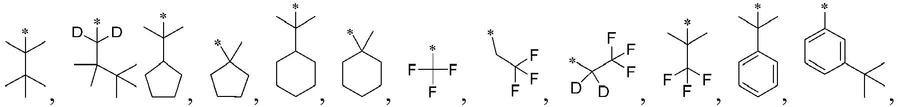 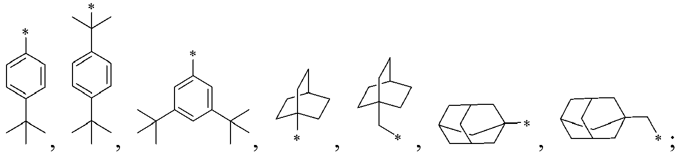 dans lequel, optionnellement, les hydrogènes dans Rₙ ci-dessus peuvent être substitués partiellement ou complètement par du deutérium.

9. Complexe métallique selon la revendication 3, dans lequel au moins un ou au moins deux parmi U₁ à U₈ est/sont choisi(s) parmi CRᵤ, Rᵤ est choisi parmi un alkyle substitué ou non-substitué ayant de 1 à 20 atomes de carbone, un cycloalkyle substitué ou non-substitué ayant de 3 à 20 atomes de carbone cycliques ou une combinaison de ceux-ci, et le nombre total d'atomes de carbone dans tous les Rᵤ est d'au moins 4 ; et
de préférence, au moins un ou au moins deux parmi U₁ à U₄ et/ou U₈ à U₈ est/sont choisi(s) parmi CRᵤ, Rᵤ est choisi parmi un alkyle substitué ou non-substitué ayant de 1 à 20 atomes de carbone, un cycloalkyle substitué ou non-substitué ayant de 3 à 20 atomes de carbone cycliques ou une combinaison de ceux-ci, et le nombre total d'atomes de carbone dans tous les Rᵤ est d'au moins 4.

10. Complexe métallique selon la revendication 3, dans lequel au moins l'un parmi U₁ à U₄ est choisi parmi CRᵤ, au moins l'un parmi Y₃ à Y₆ est choisi parmi CR, Rᵤ et R sont choisis parmi un alkyle substitué ou non-substitué ayant 1 à 20 atomes de carbone, un cycloalkyle substitué ou non-substitué ayant 3 à 20 atomes de carbone cycliques ou une combinaison de ceux-ci, et le nombre total d'atomes de carbone dans Rᵤ et R est supérieur ou égal à 2 ; ou
au moins l'un parmi U₈ à U₈ est choisi parmi CRᵤ, au moins l'un parmi Y₃ à Y₆ est choisi parmi CR, Rᵤ et R sont choisis parmi un alkyle substitué ou non-substitué ayant 1 à 20 atomes de carbone, un cycloalkyle substitué ou non-substitué ayant 3 à 20 atomes de carbone cycliques ou une combinaison de ceux-ci, et le nombre total d'atomes de carbone dans Rᵤ et R est supérieur ou égal à 2 ; ou
au moins l'un parmi U₁ à U₄ est choisi parmi CRᵤ, au moins l'un parmi U₈ à U₈ est choisi parmi CRᵤ, Rᵤ est choisi parmi un alkyle substitué ou non-substitué ayant 1 à 20 atomes de carbone, un cycloalkyle substitué ou non-substitué ayant 3 à 20 atomes de carbone cycliques ou une combinaison de ceux-ci, et le nombre total d'atomes de carbone dans Rᵤ est supérieur ou égal à 2.

11. Complexe métallique selon la revendication 1, dans lequel Lₐ est, à chaque occurrence de manière identique ou différente, choisi dans le groupe constitué de Lₐ₁ à La3530 ;
où Lₐ₁ à Lₐ₃₄₅₇ présentent chacun la structure suivante : 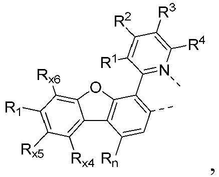 où R₁, Rₙ, Rₓ₄, Rₓ₅, Rₓ₆ et R¹ à R⁴ sont choisis parmi les atomes ou les groupes dans le tableau suivant : 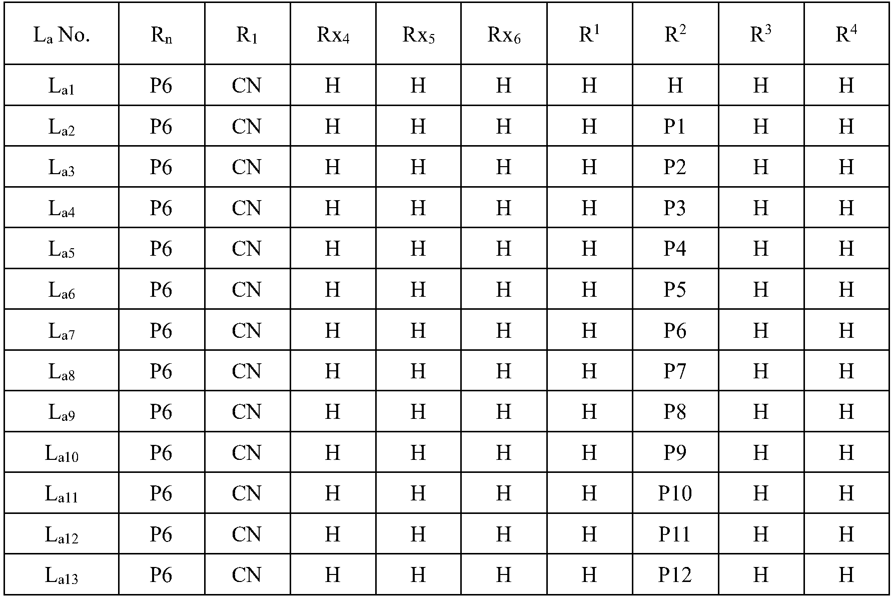 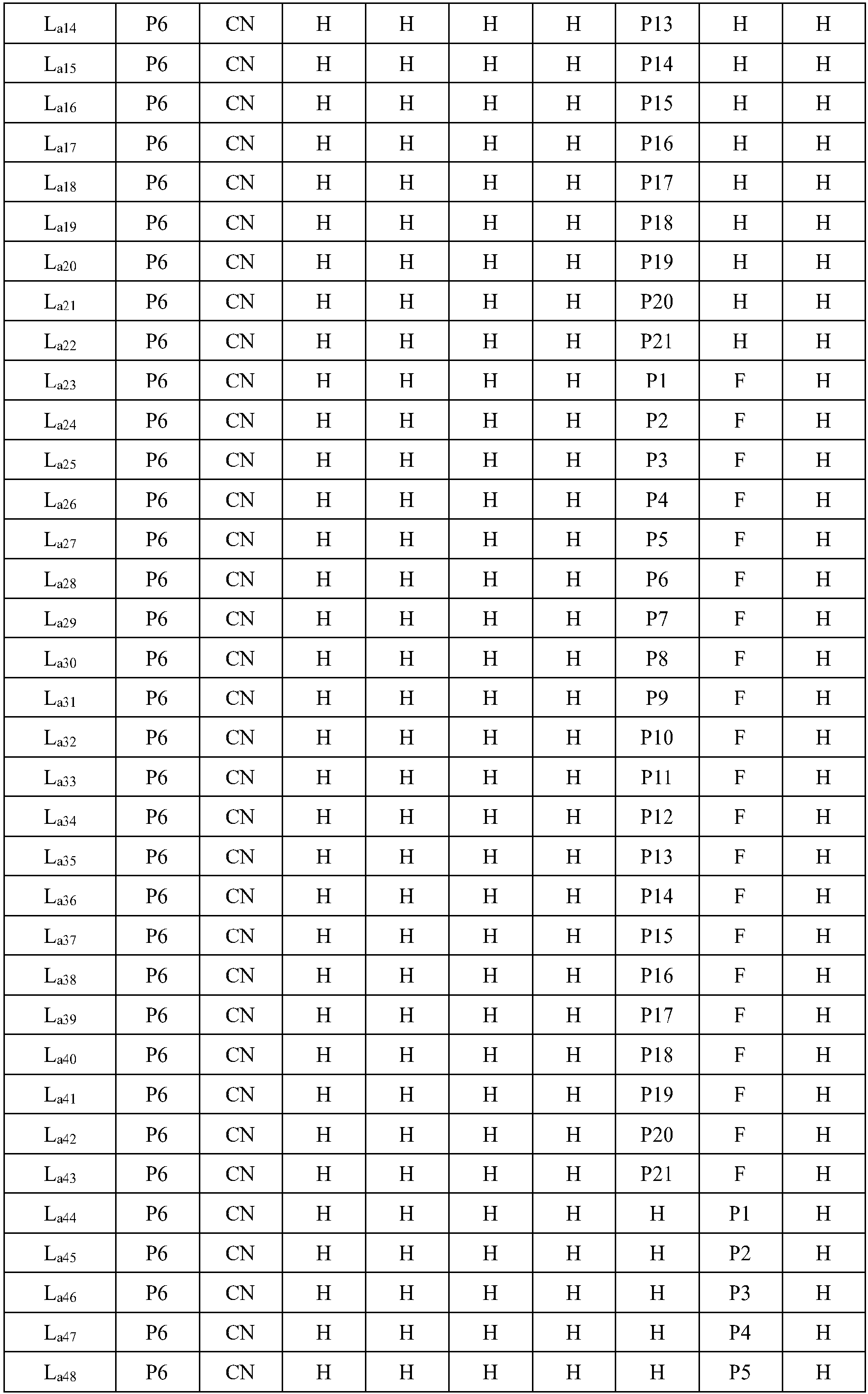 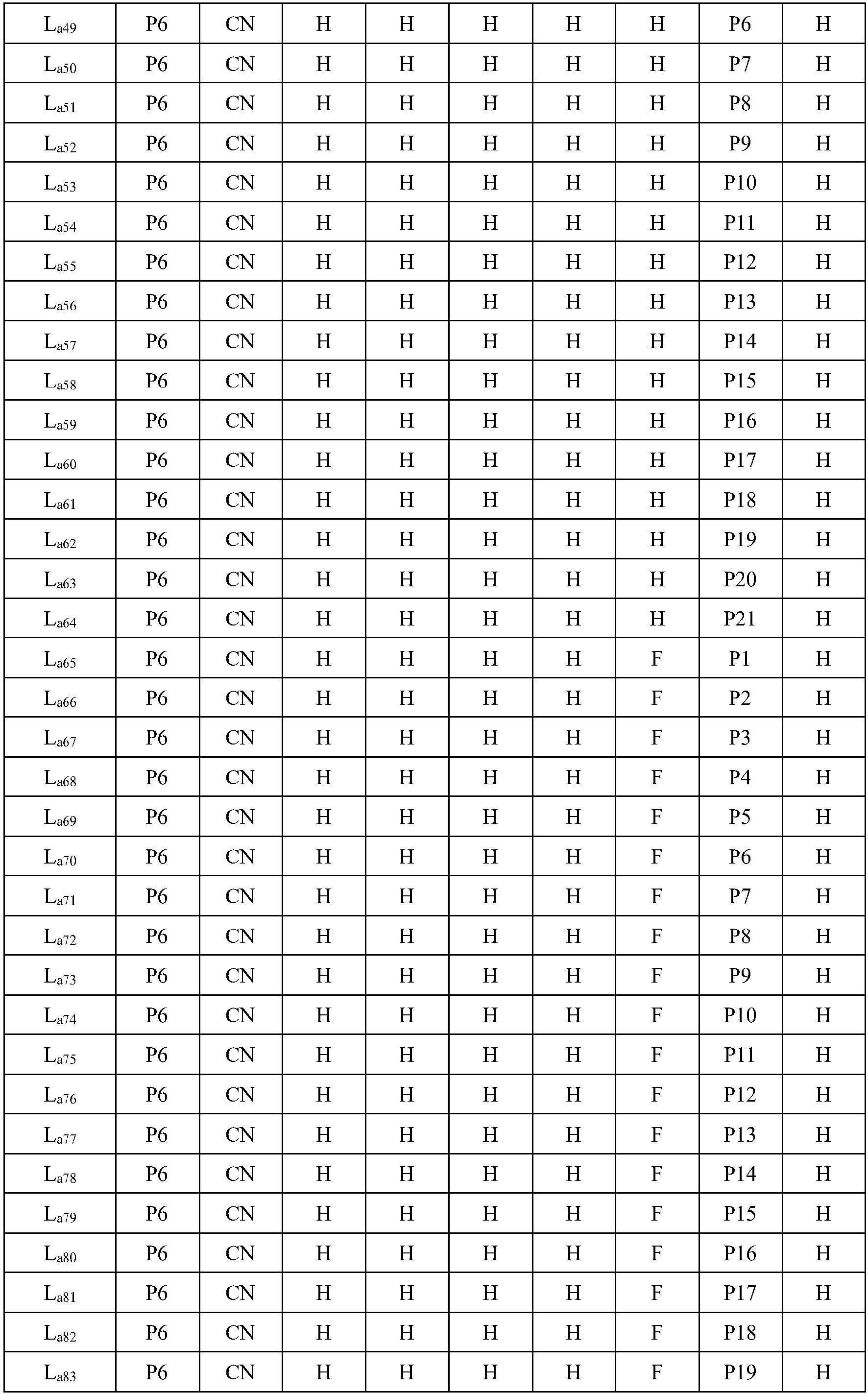 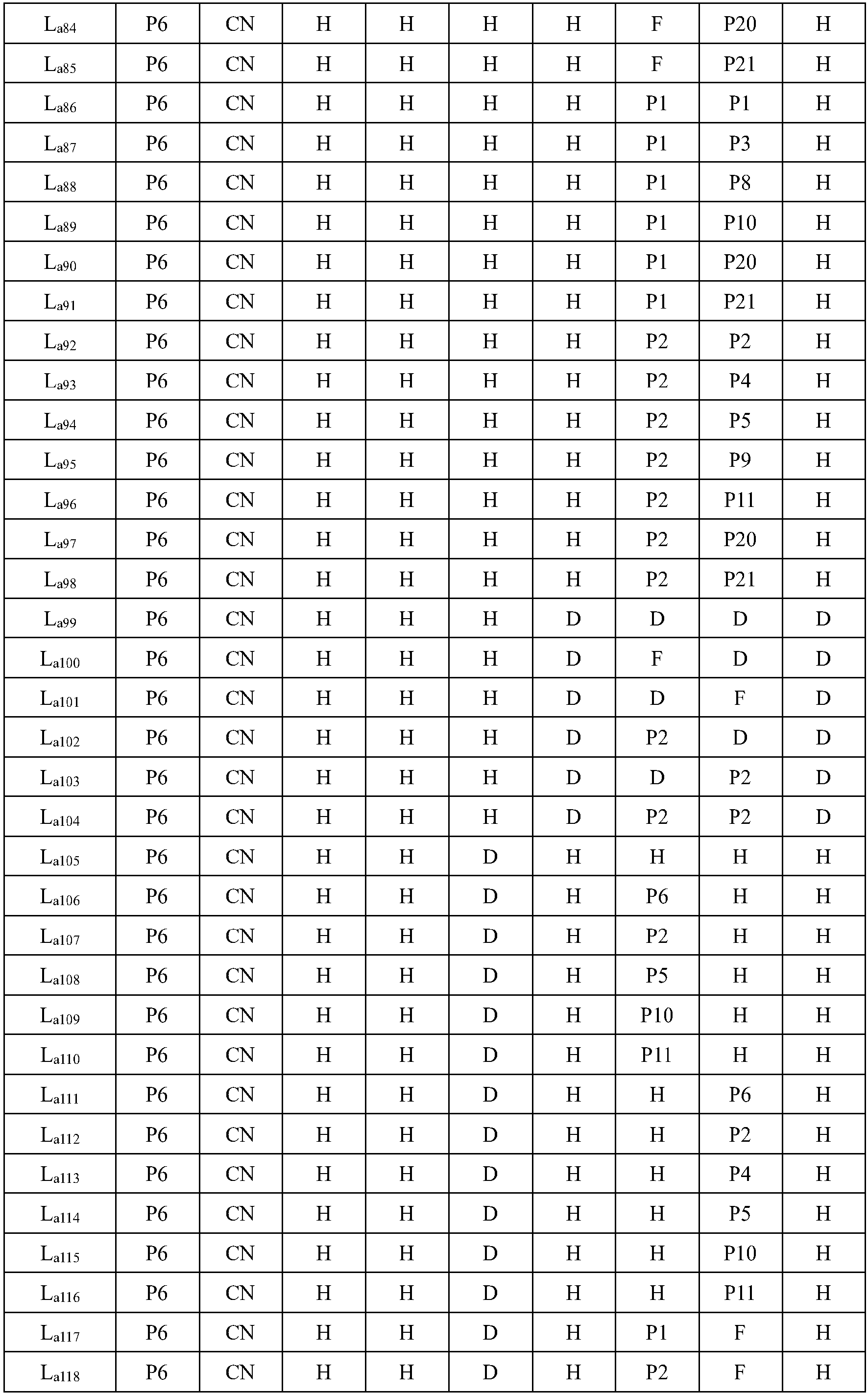 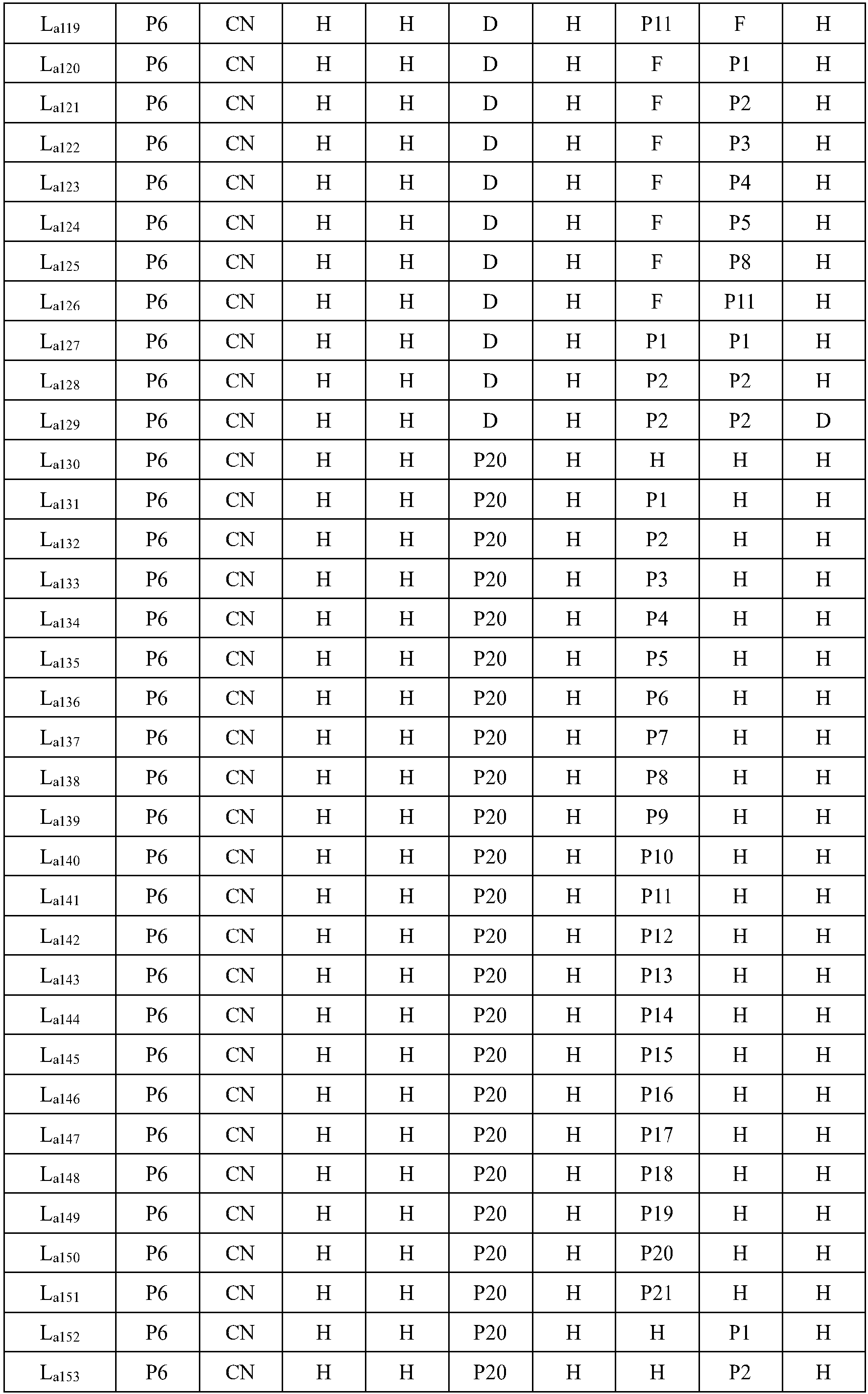 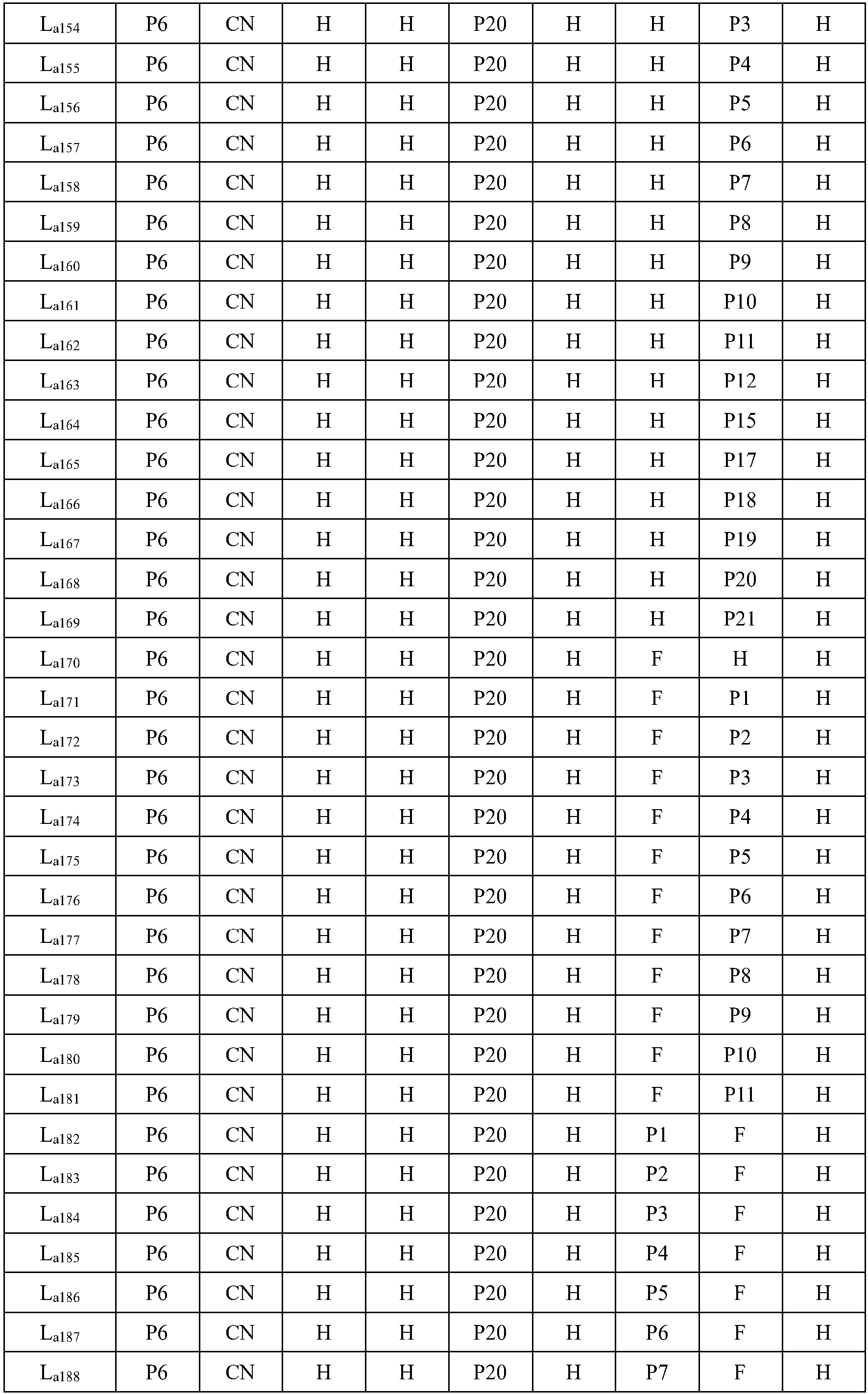 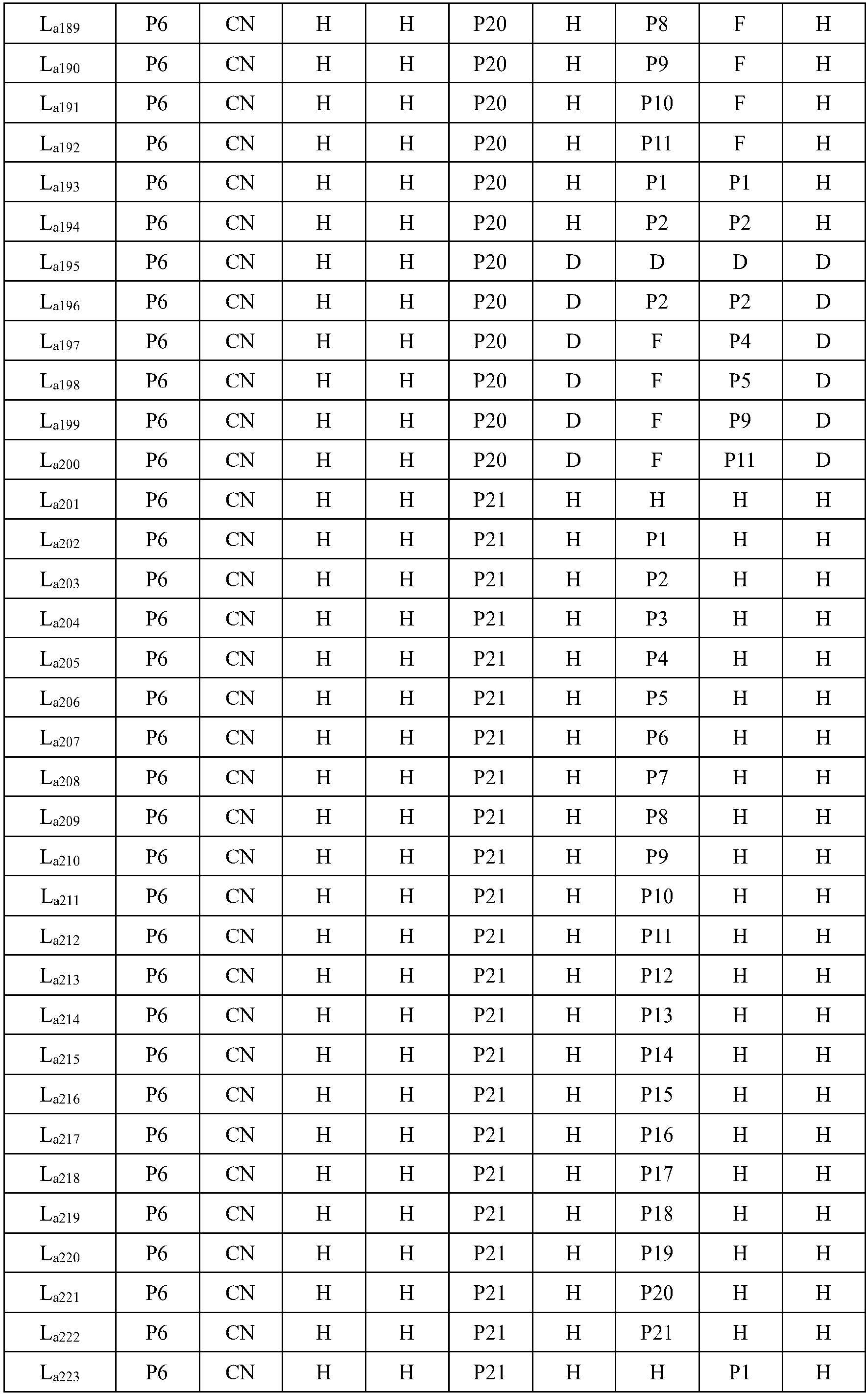 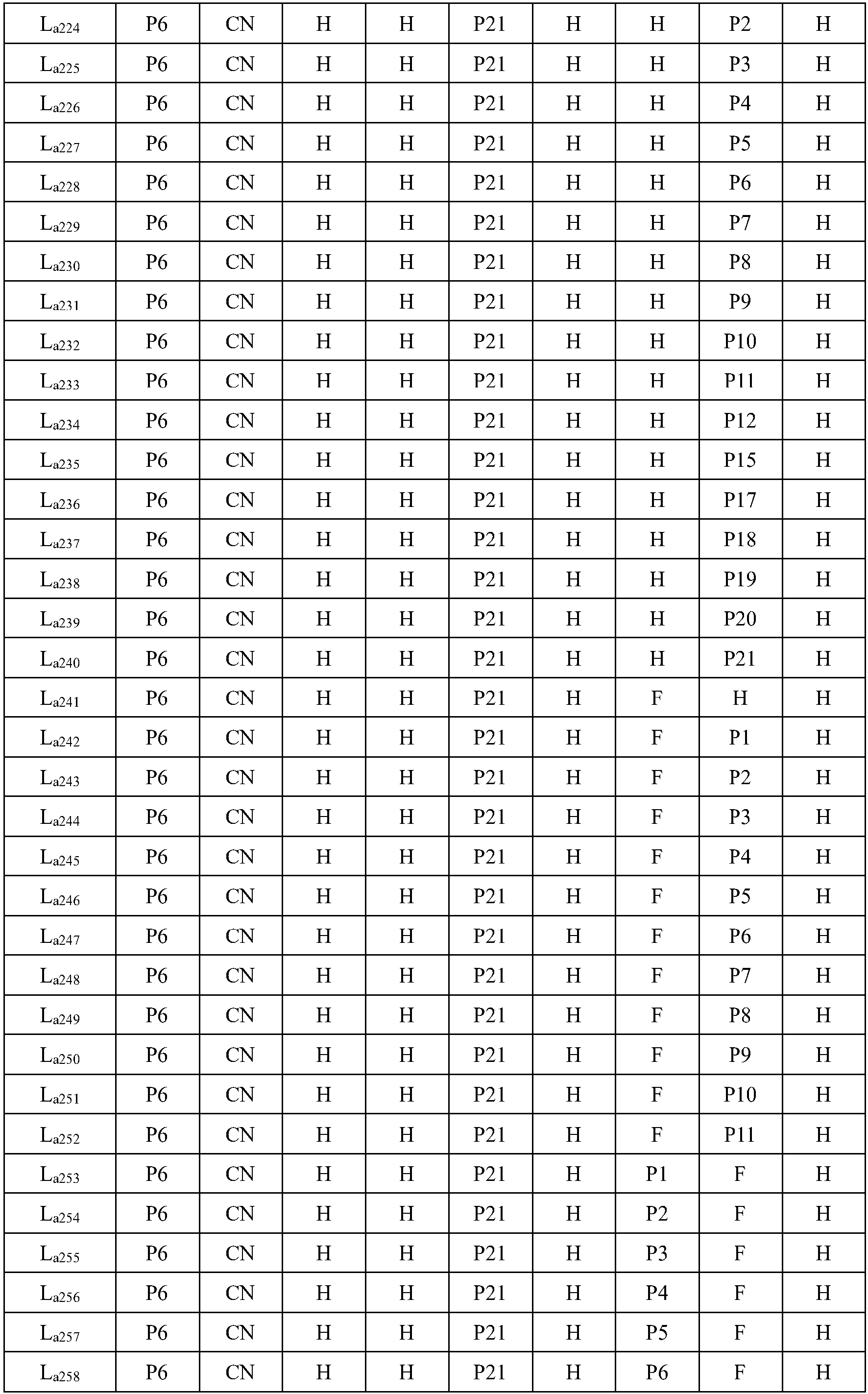 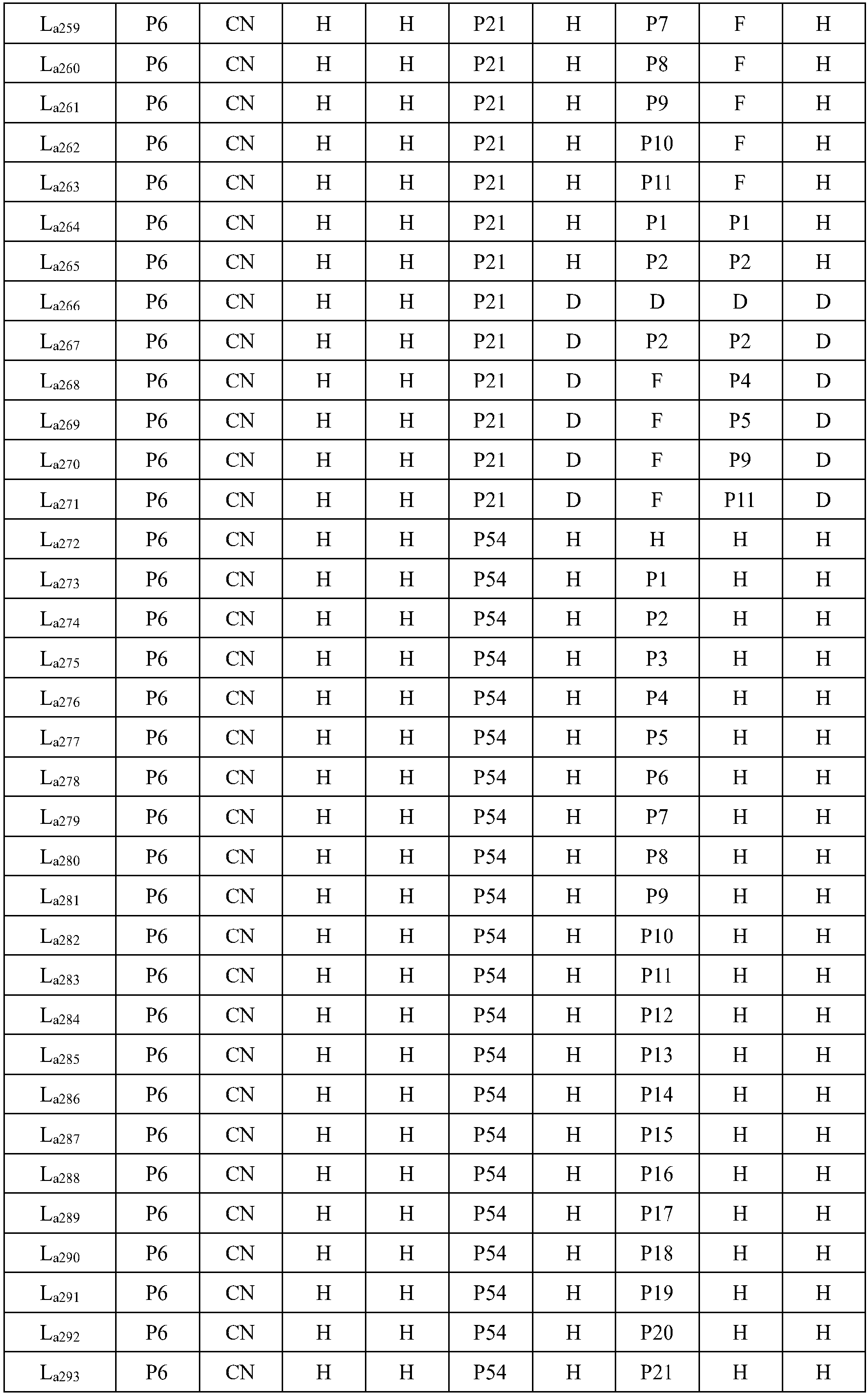 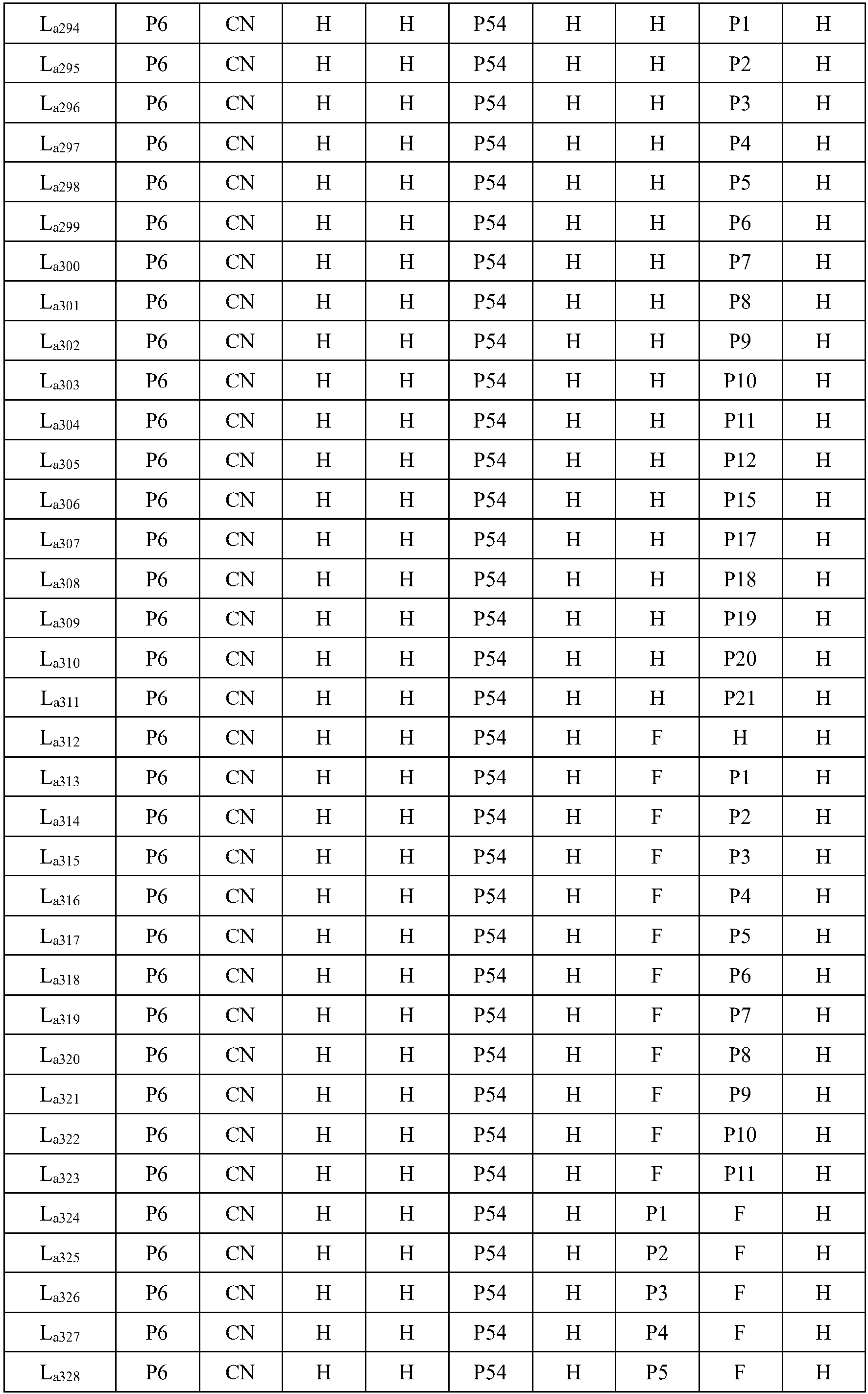 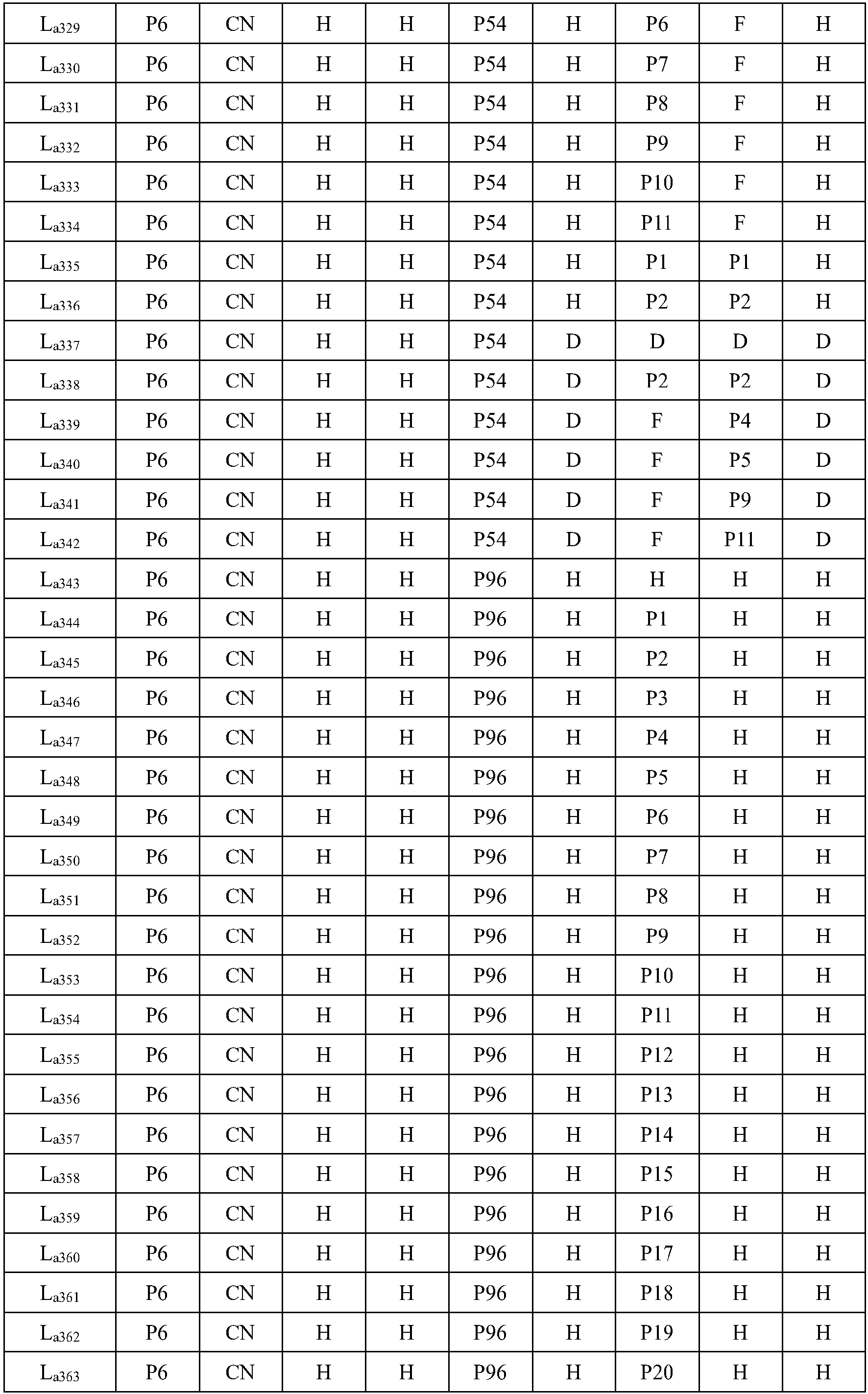 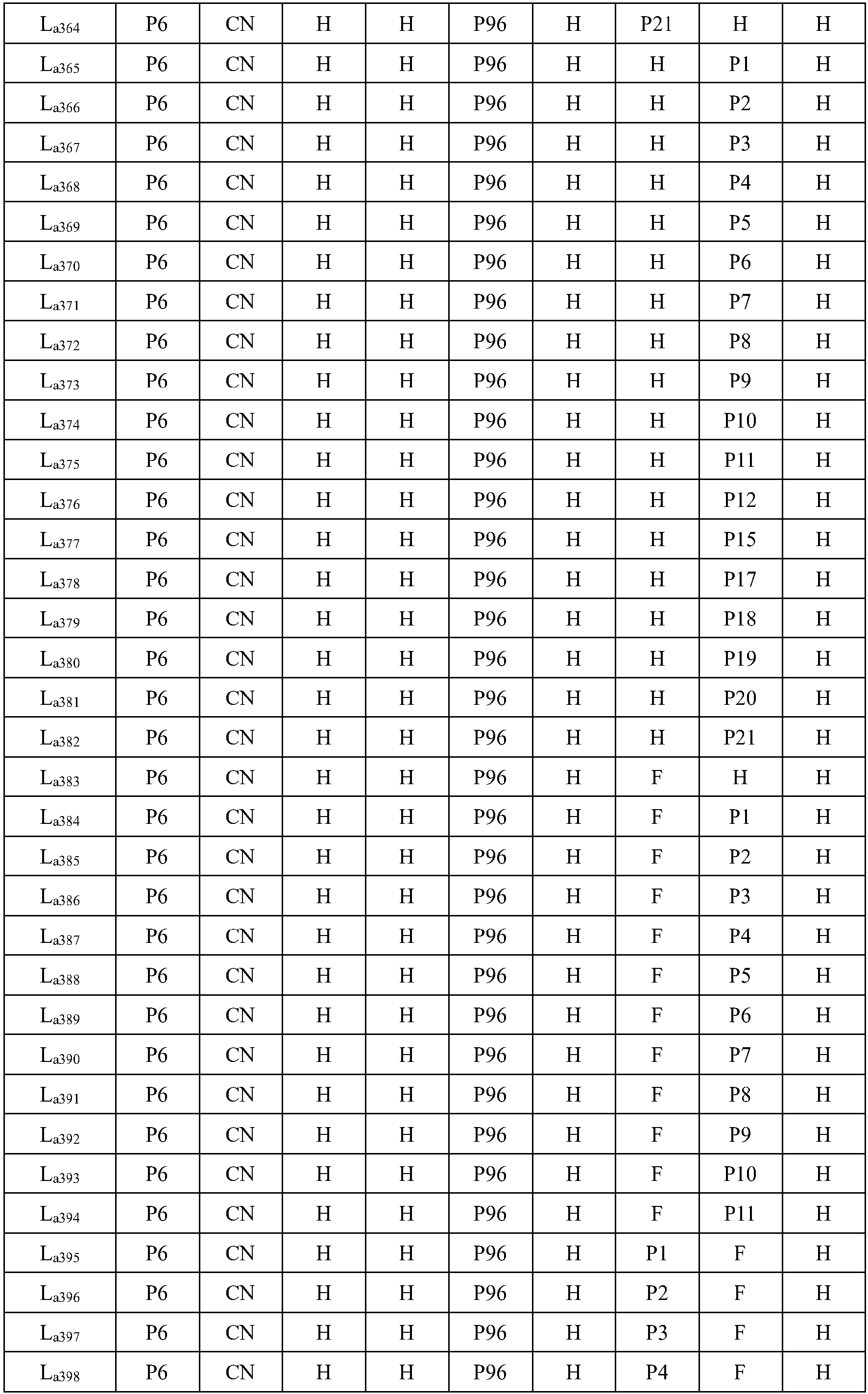 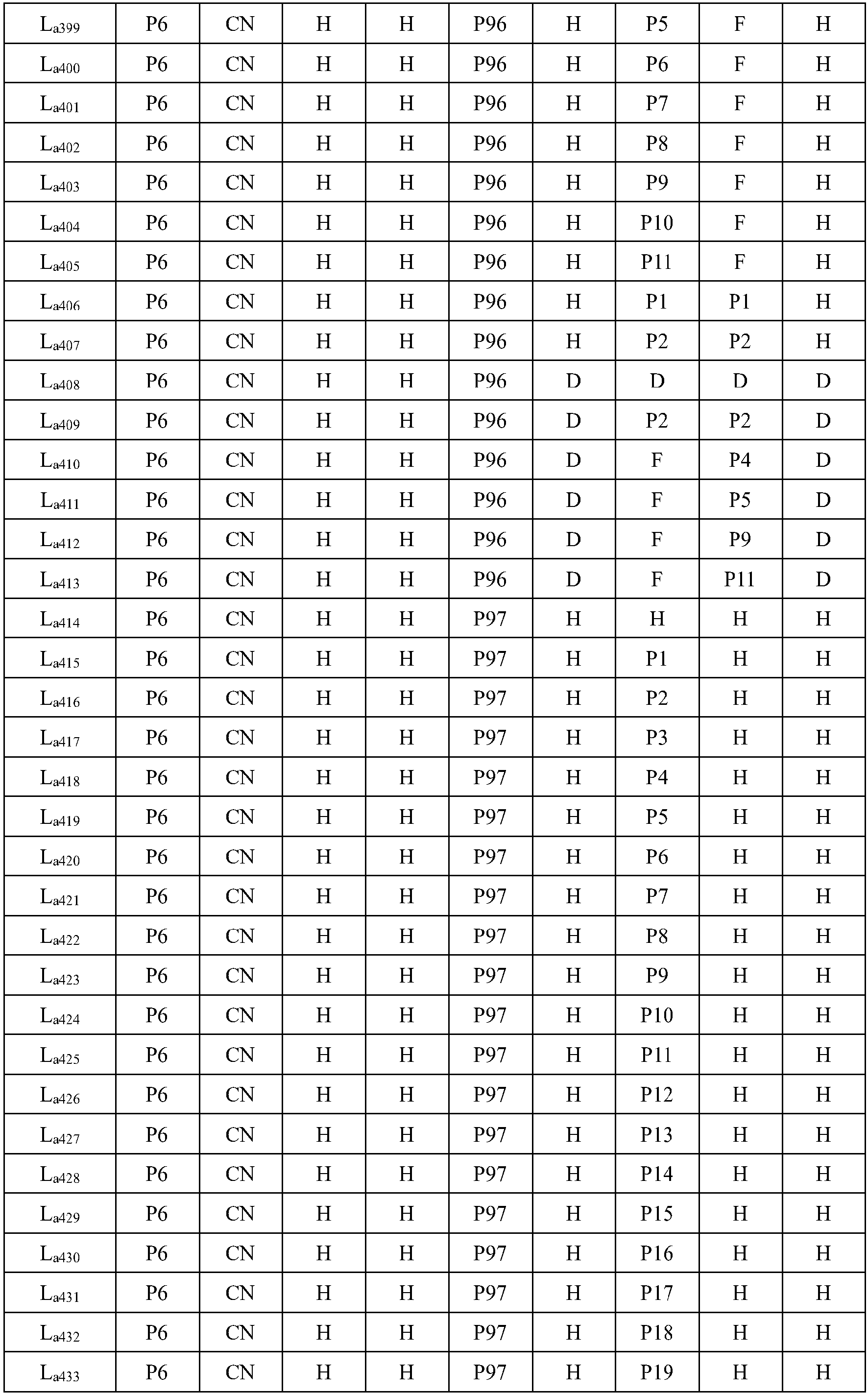 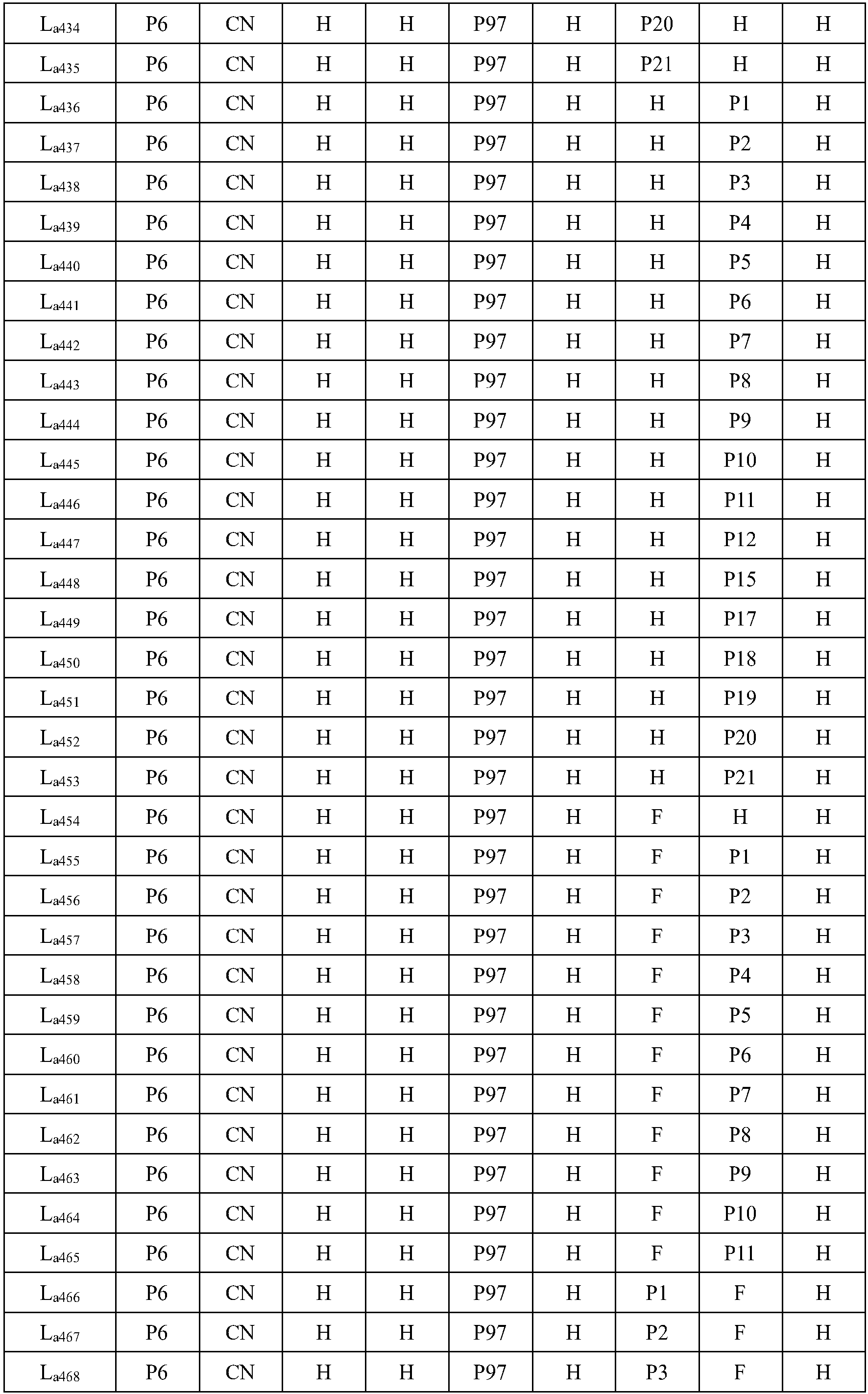 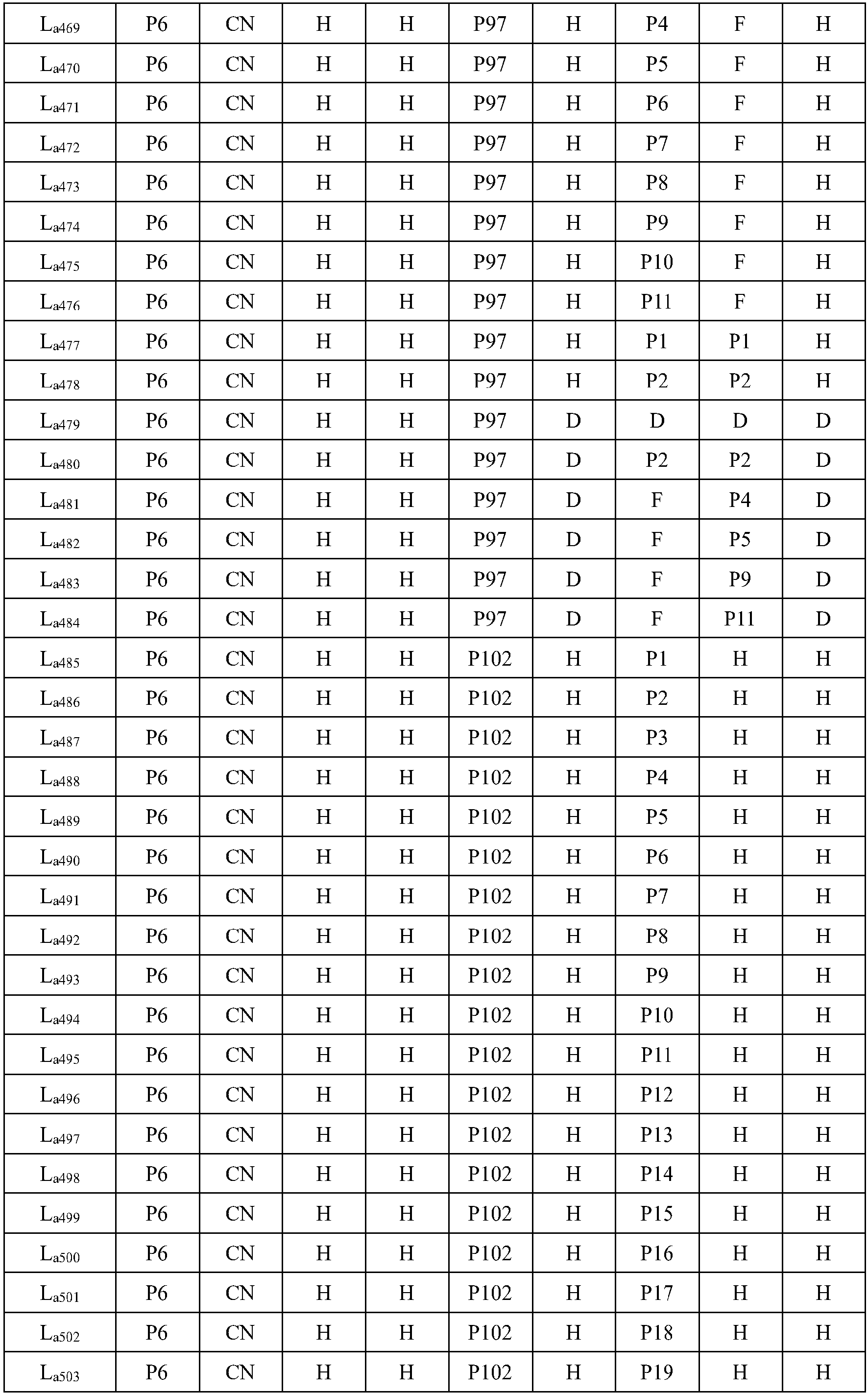 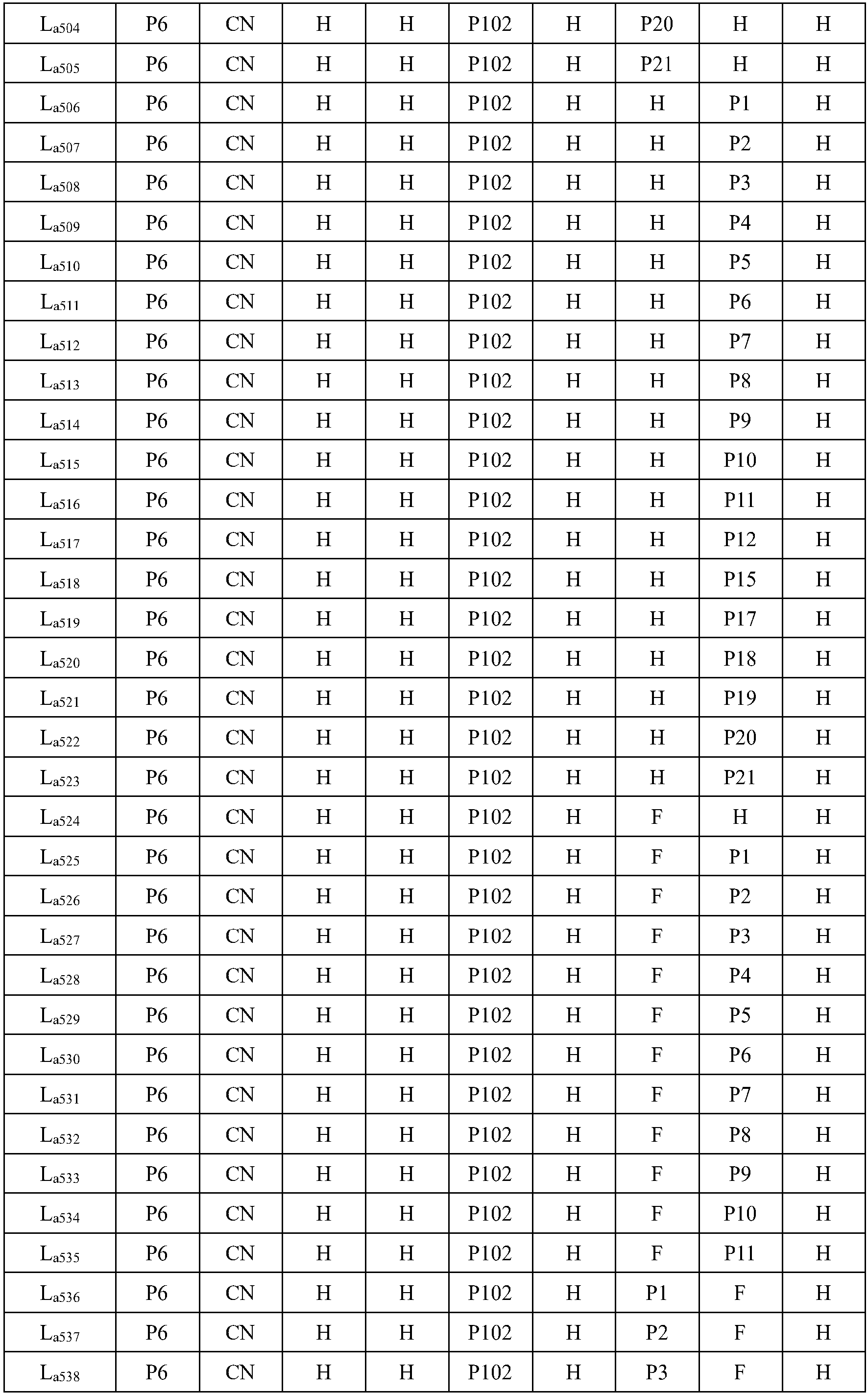 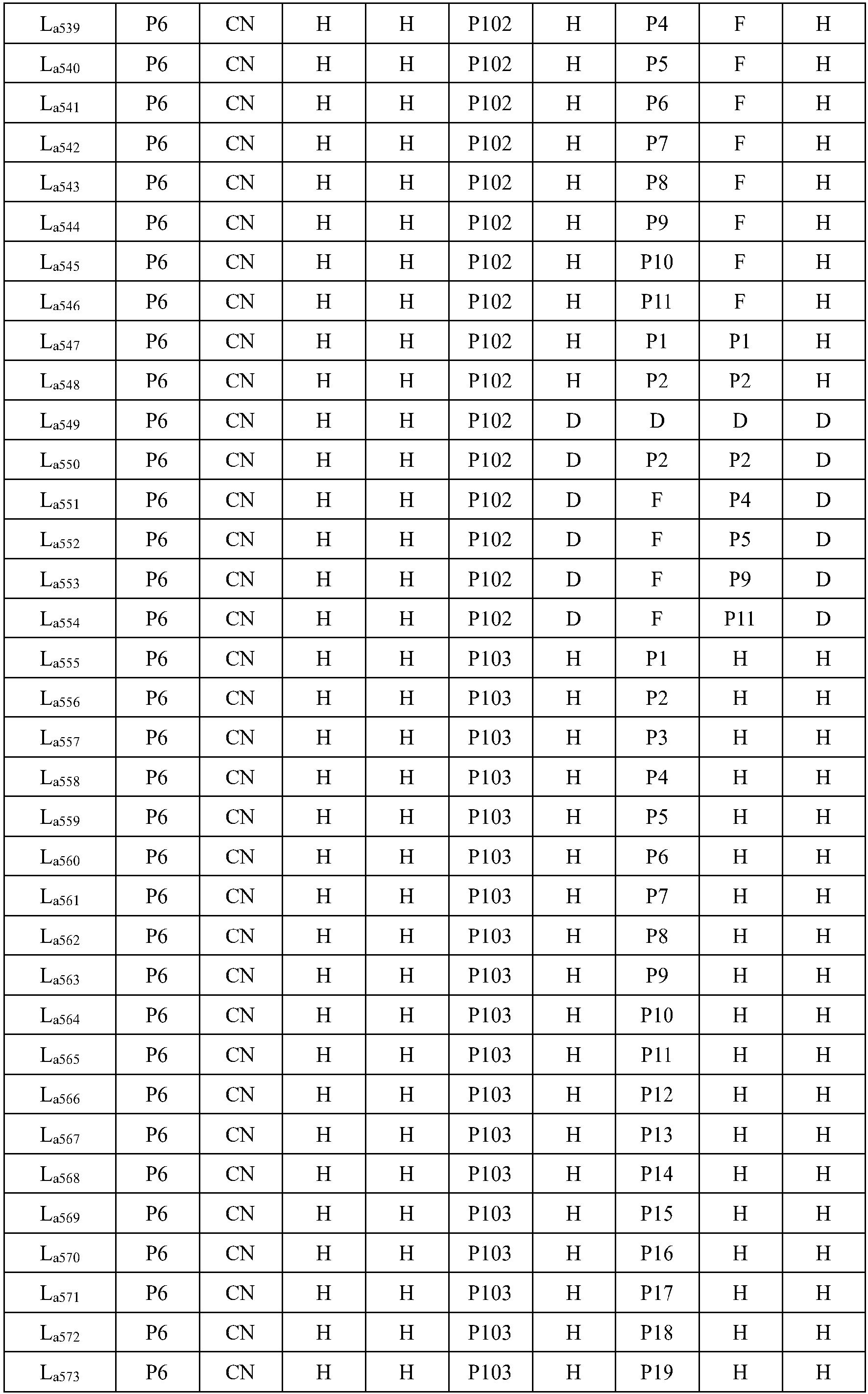 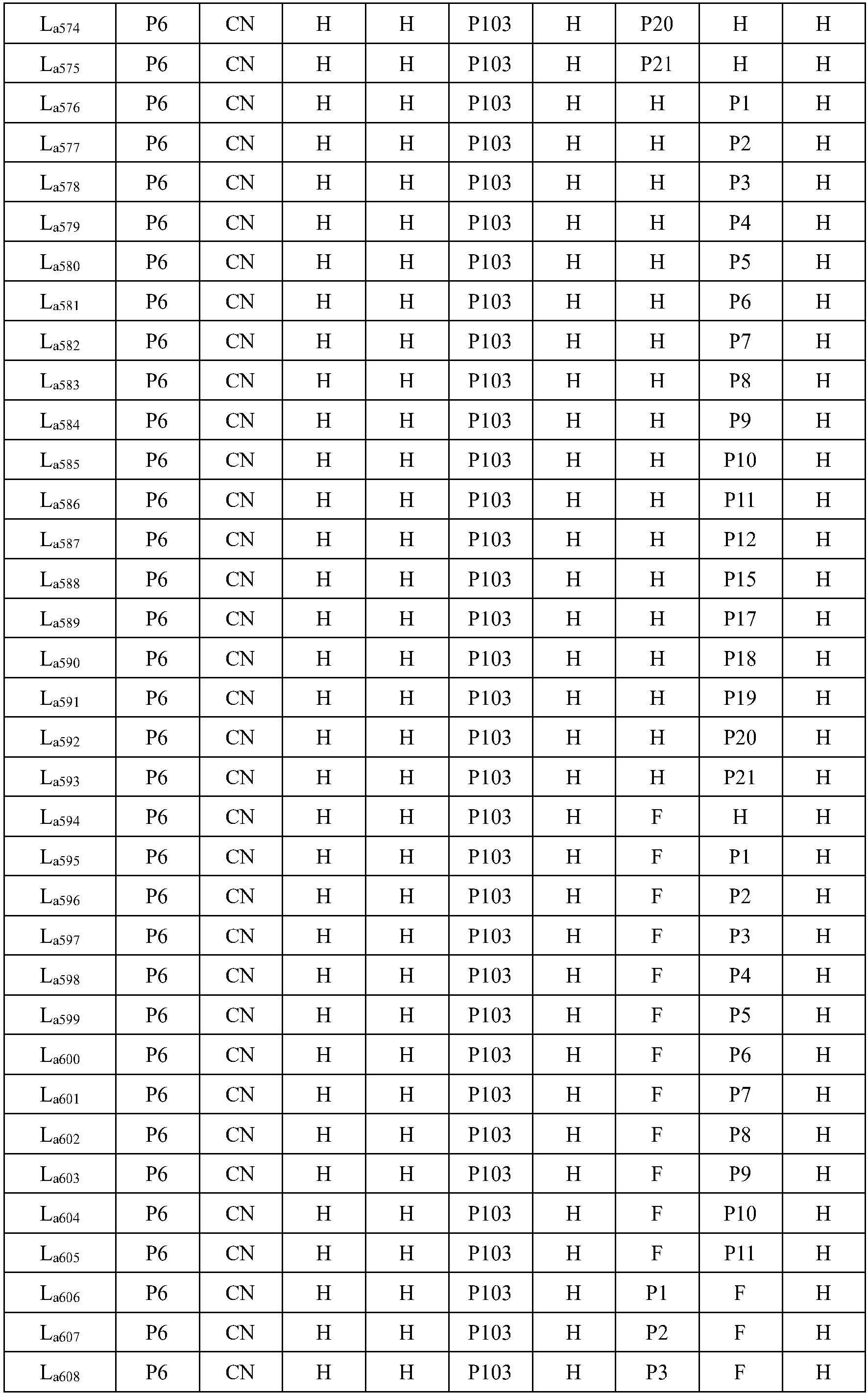 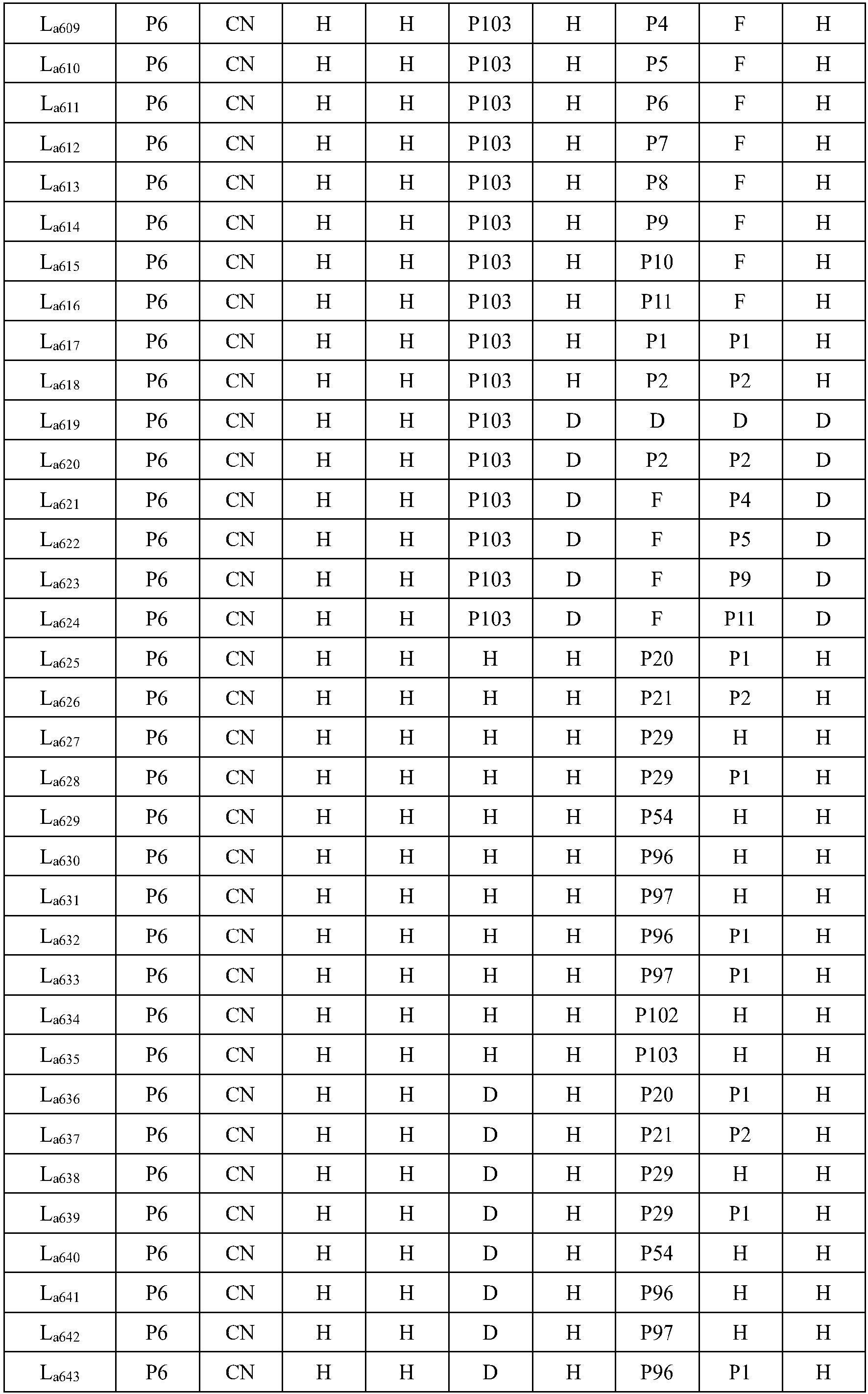 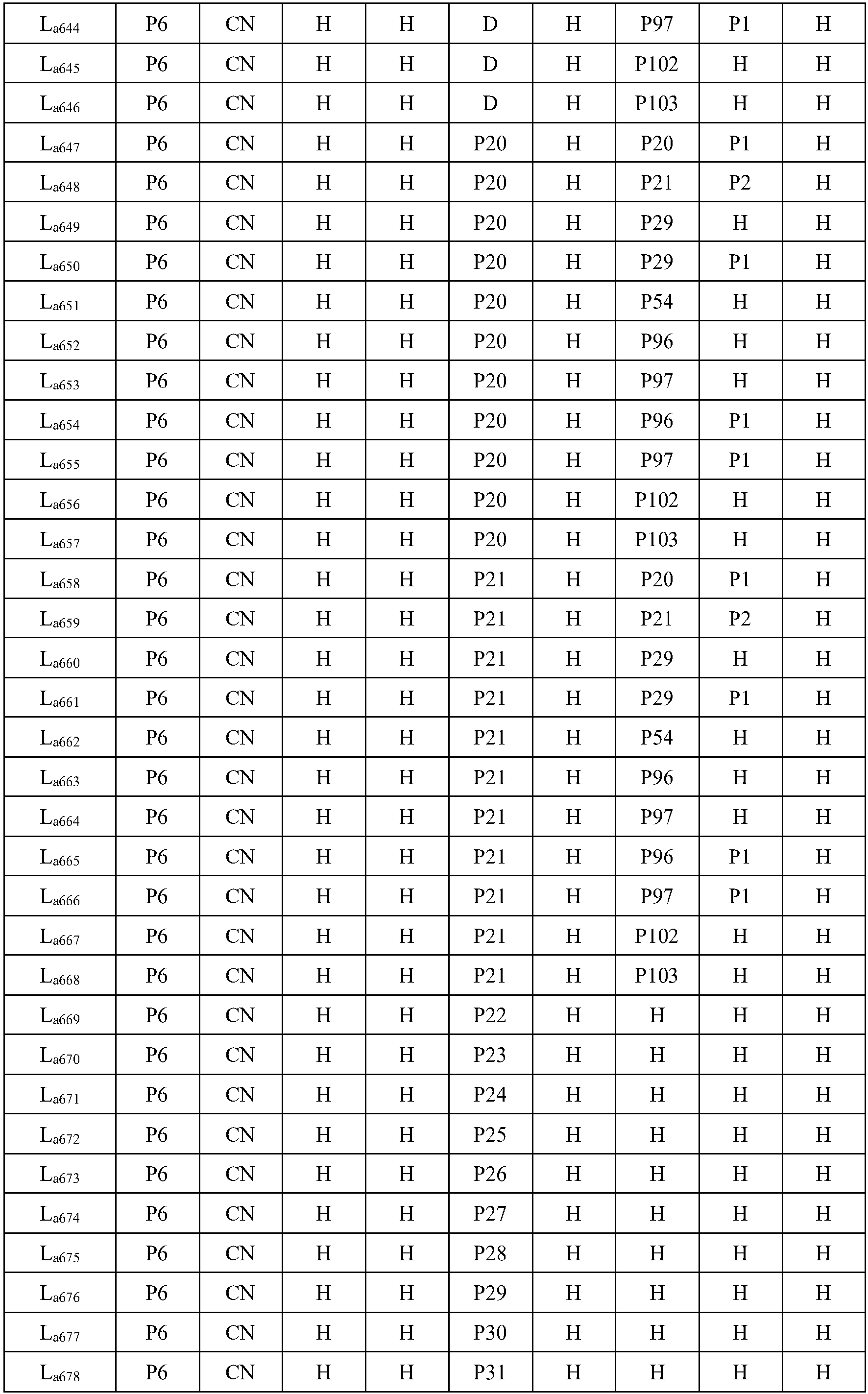 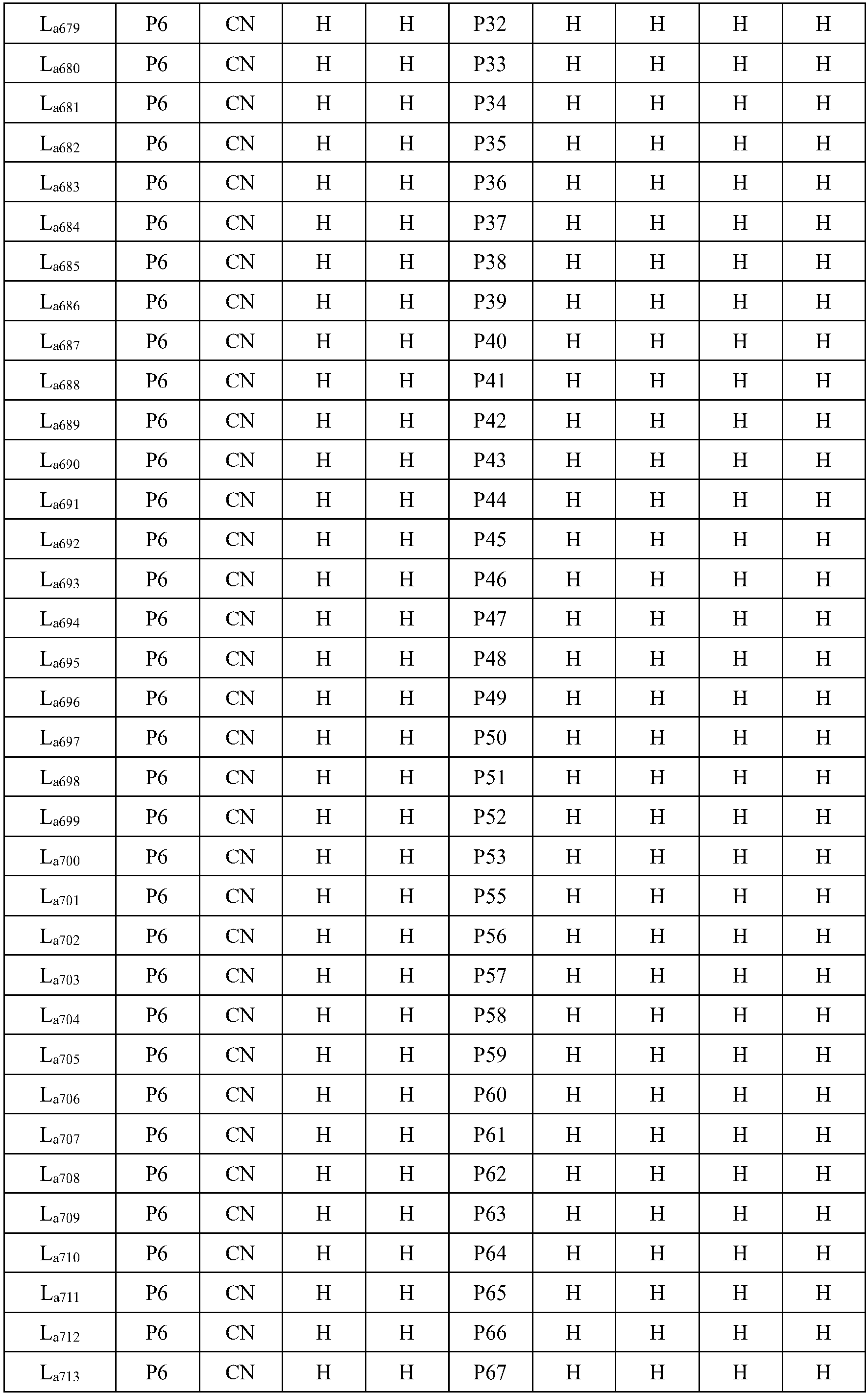 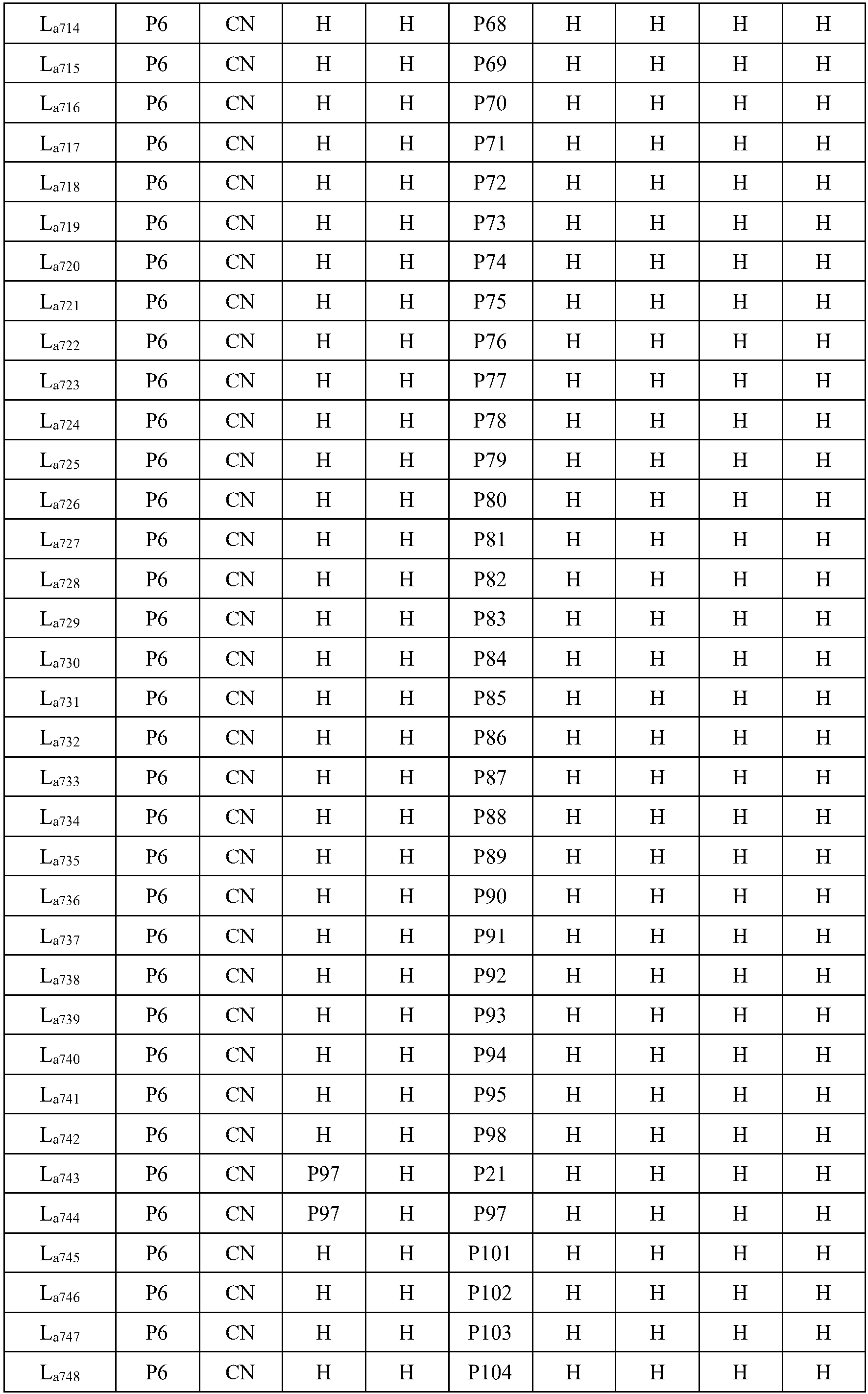 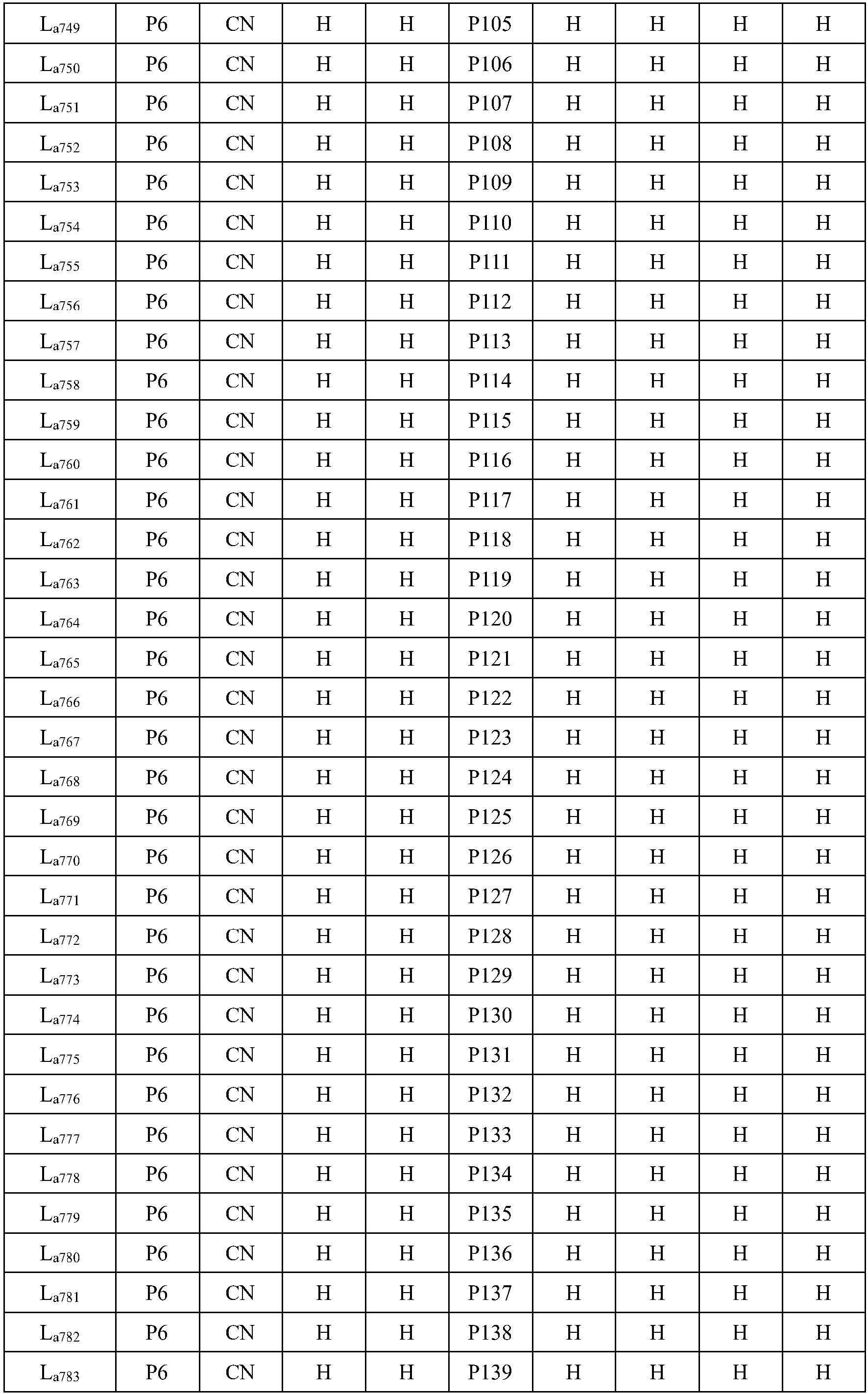 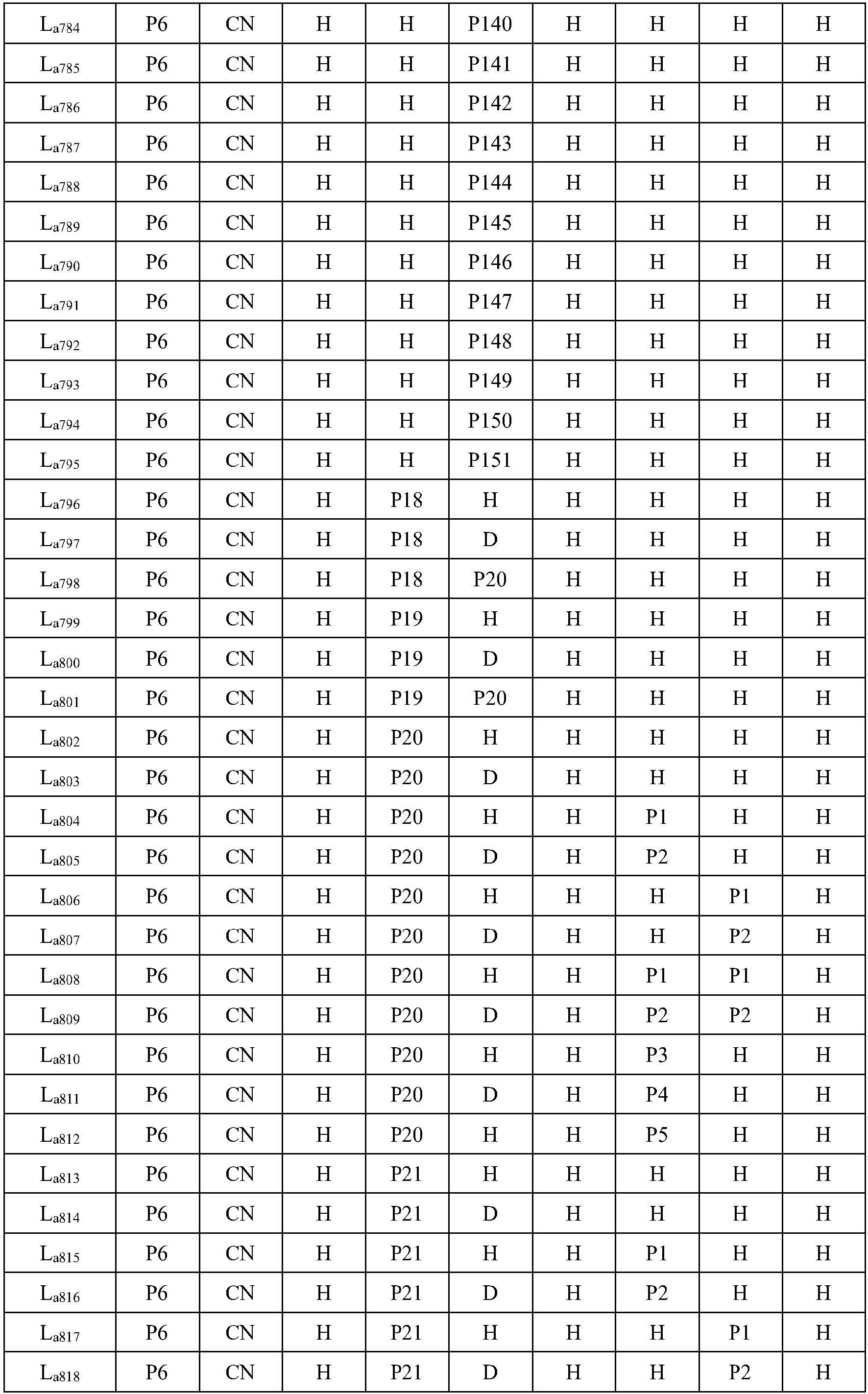 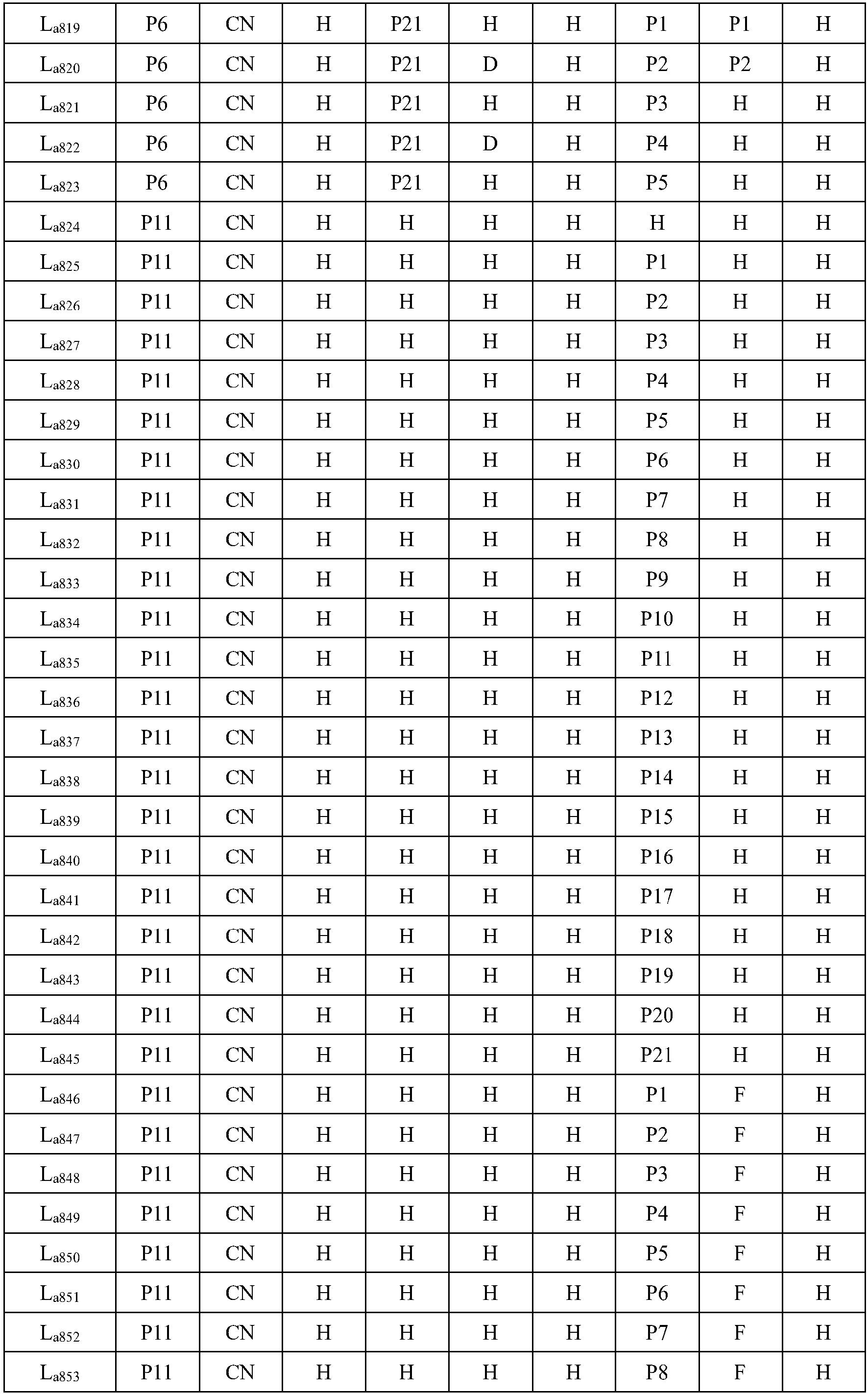 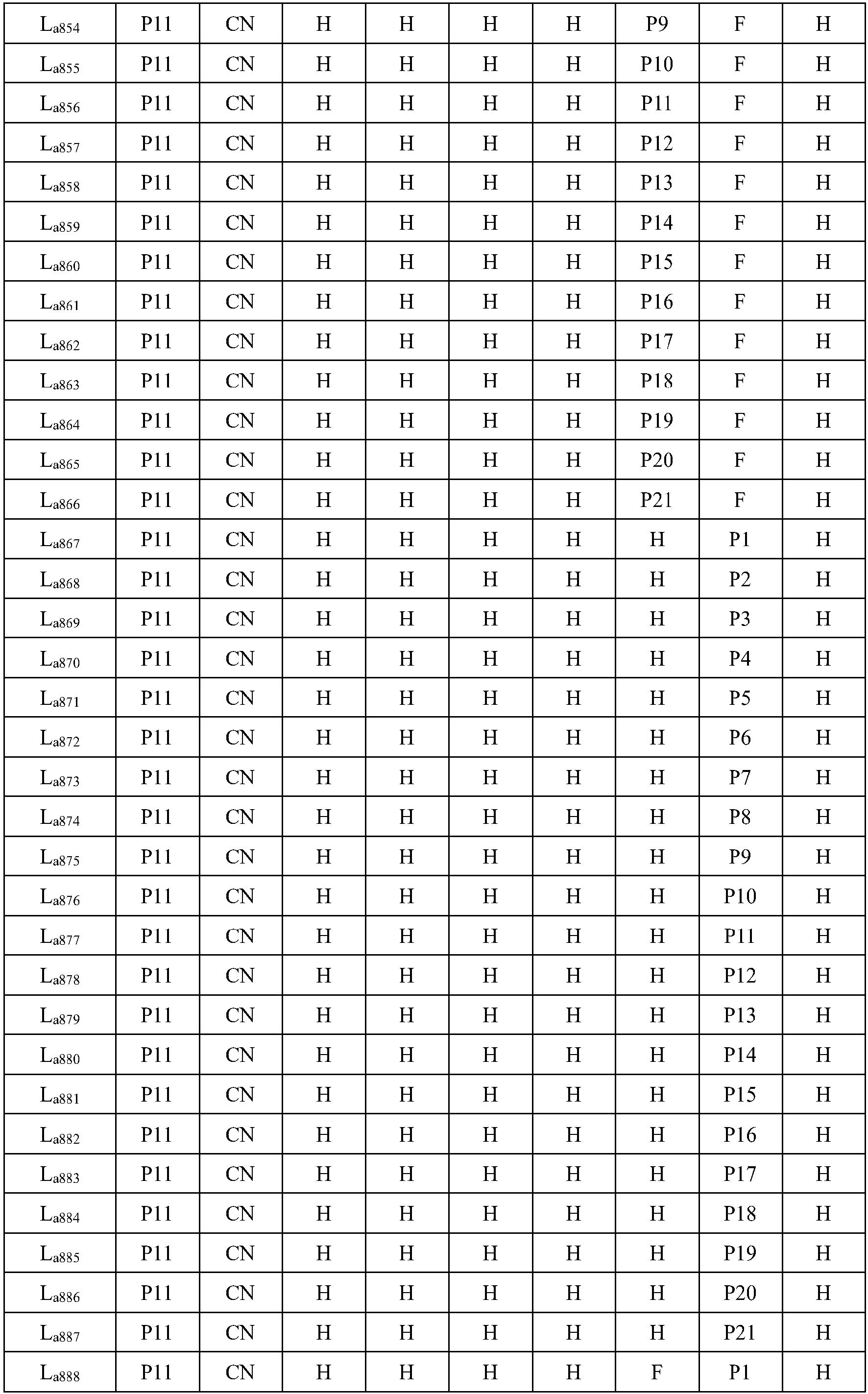 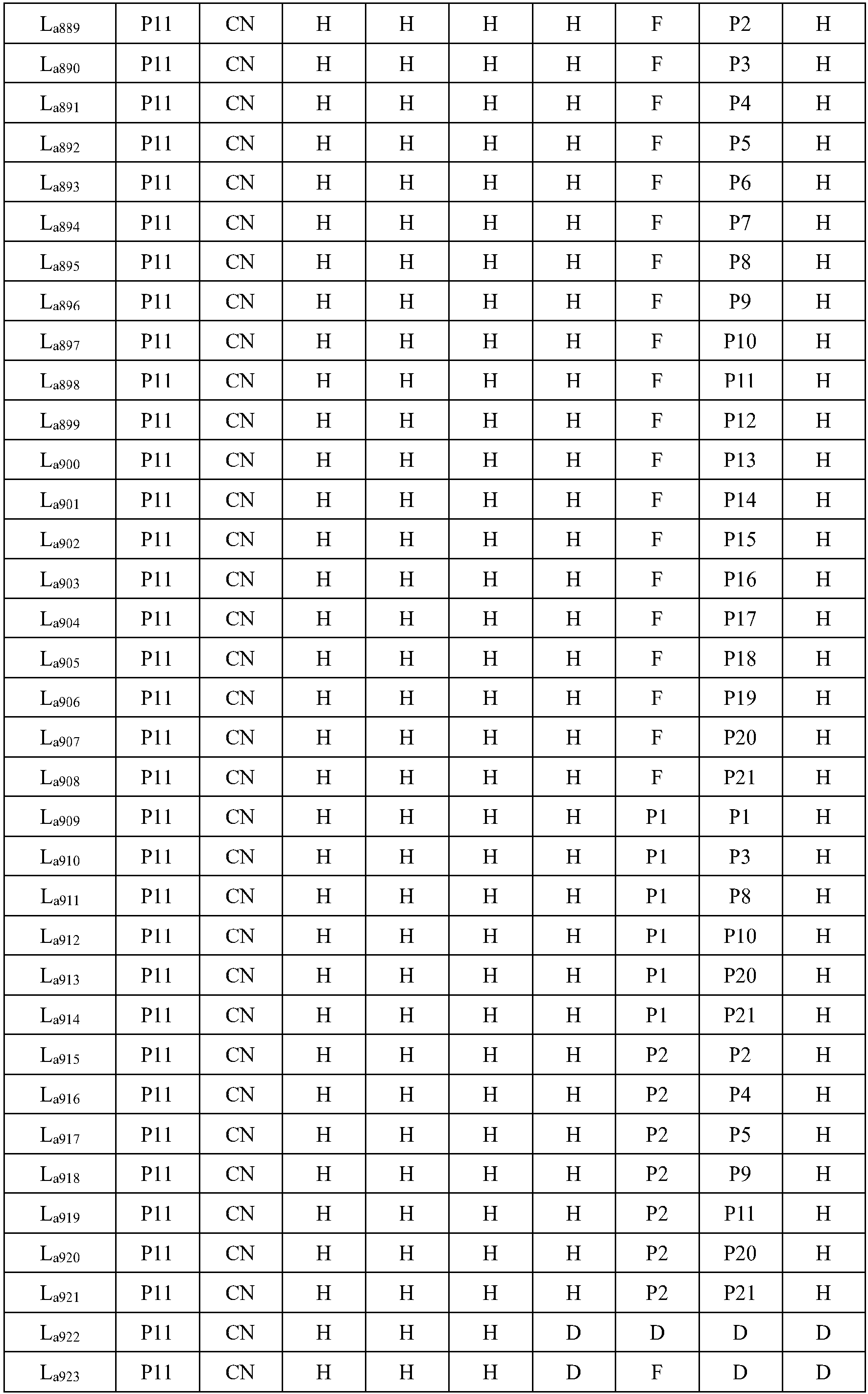 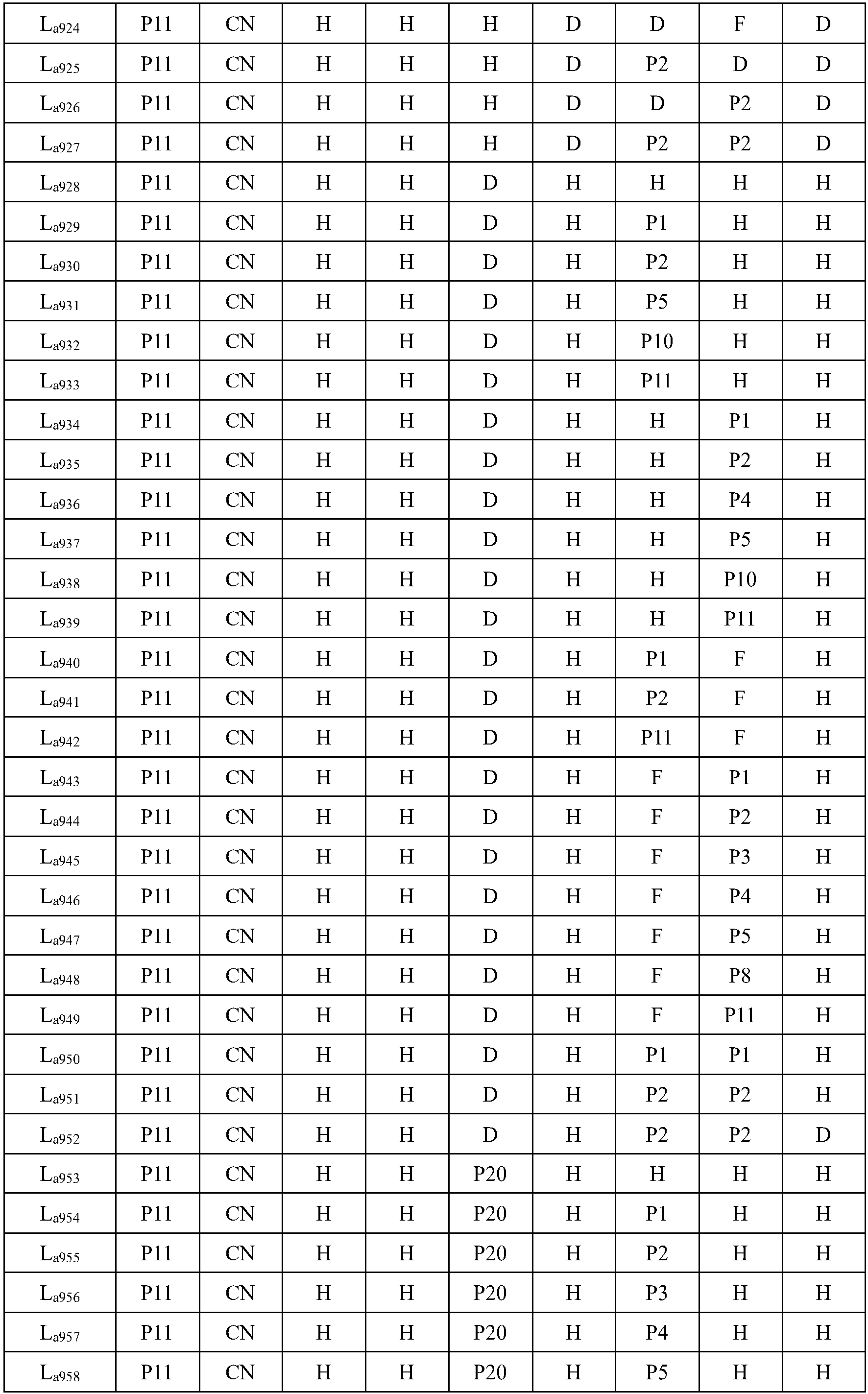 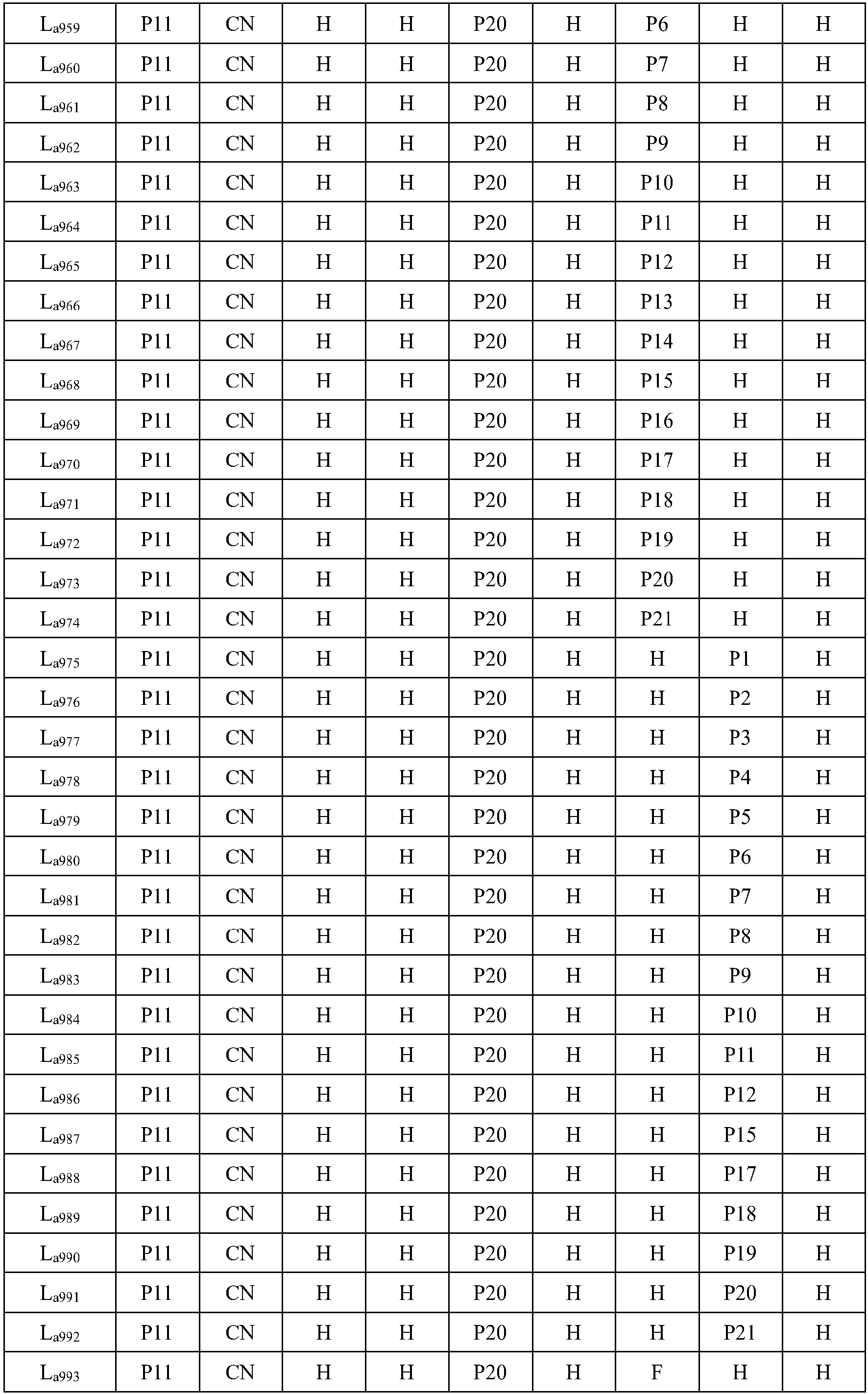 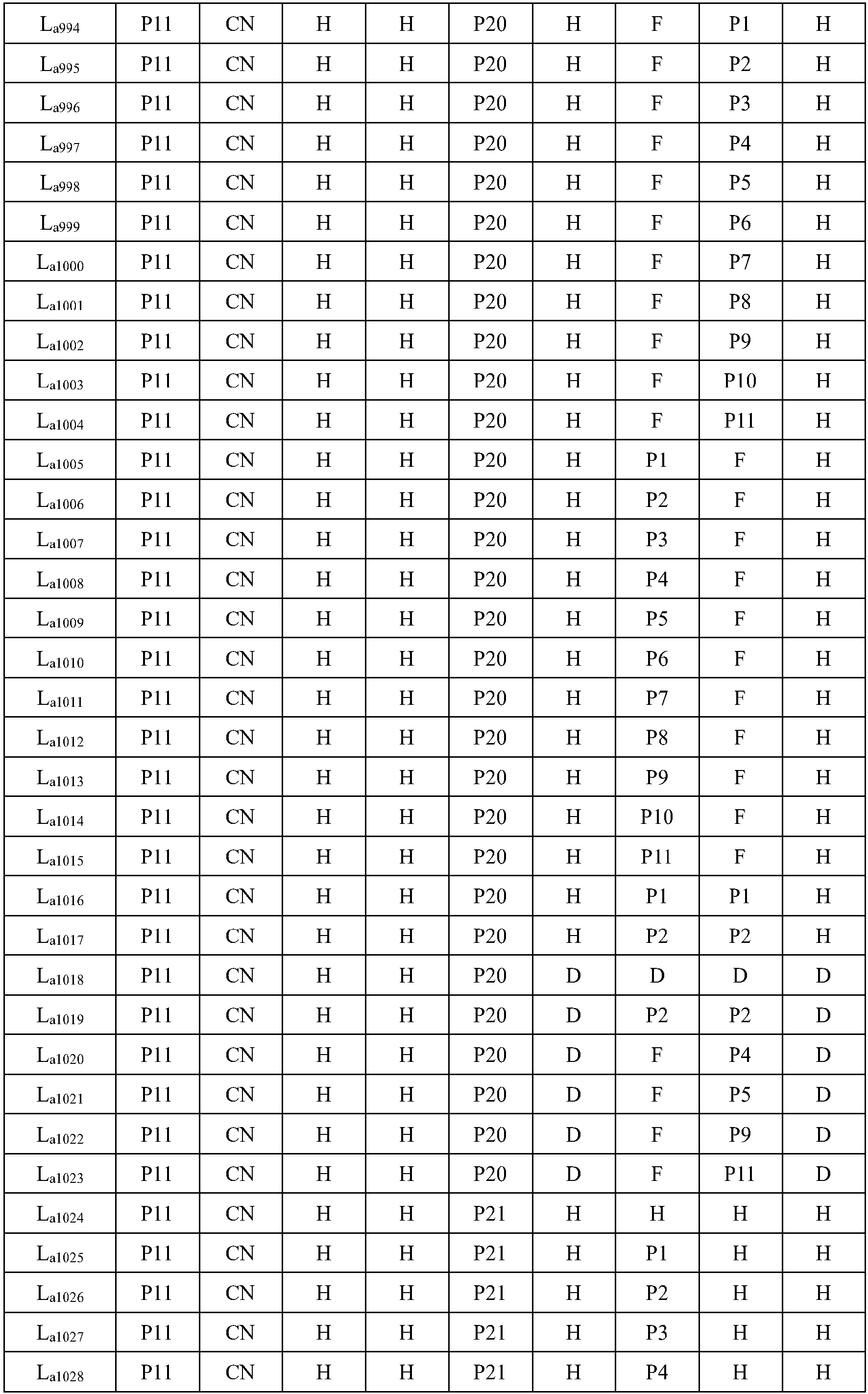 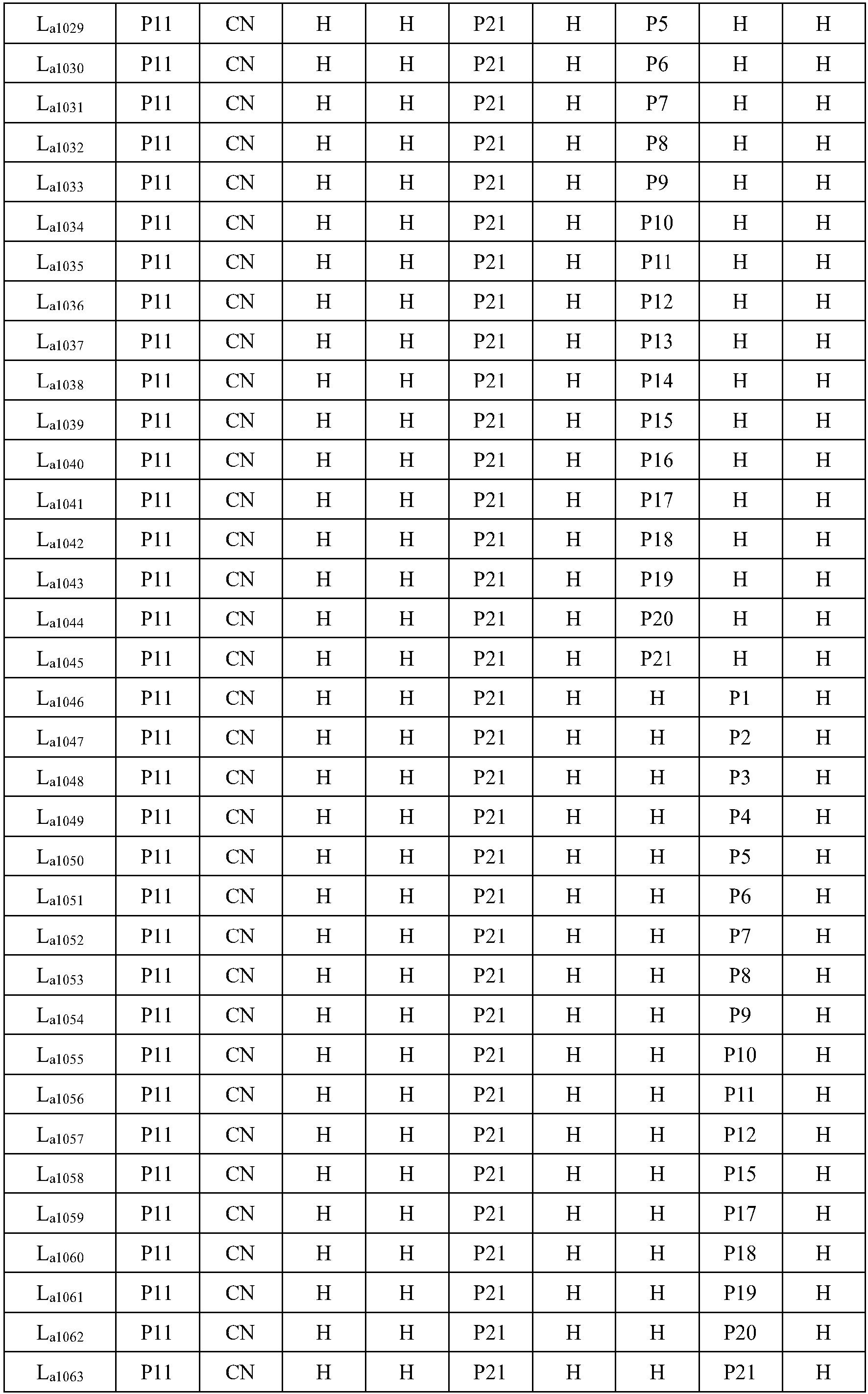 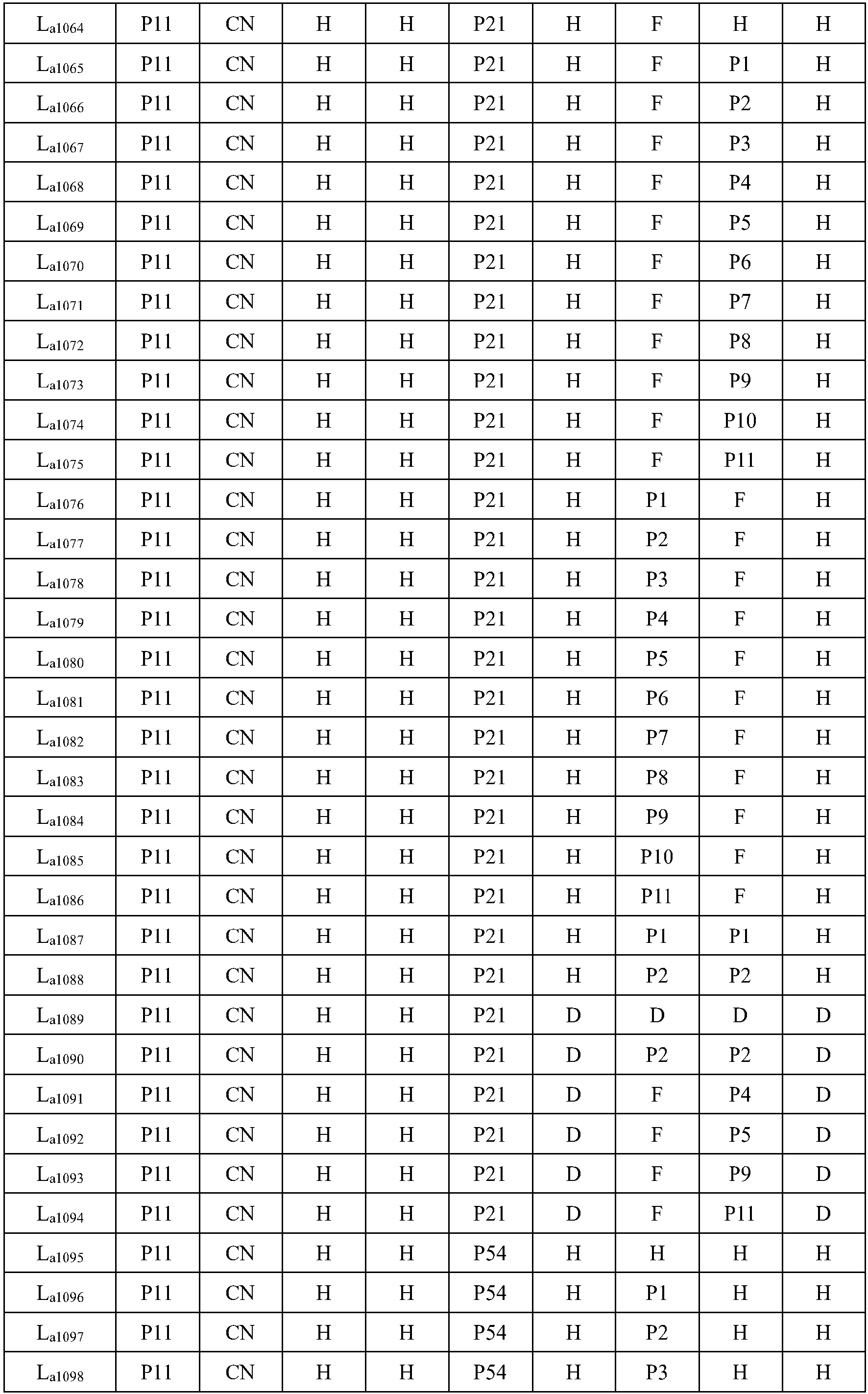 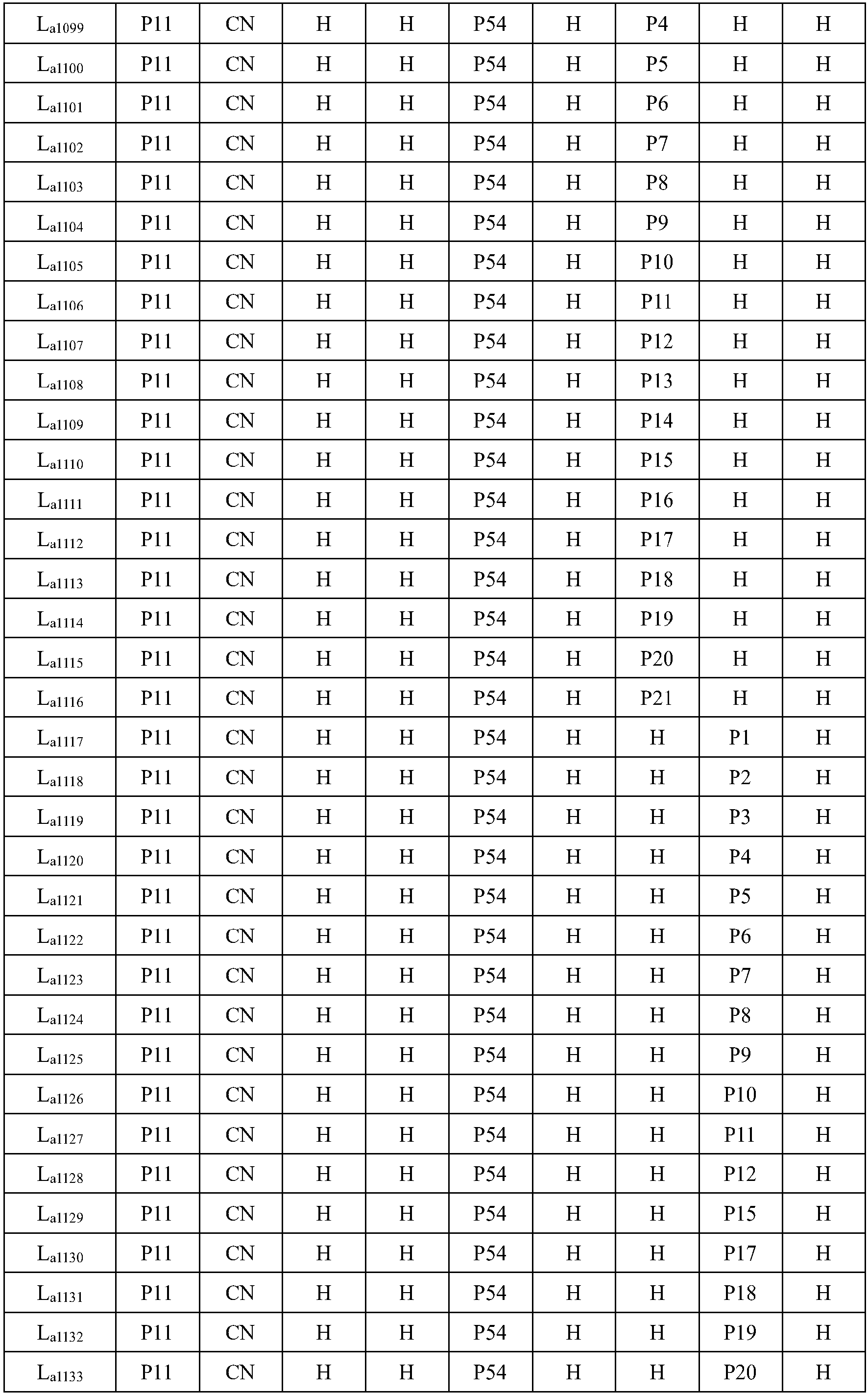 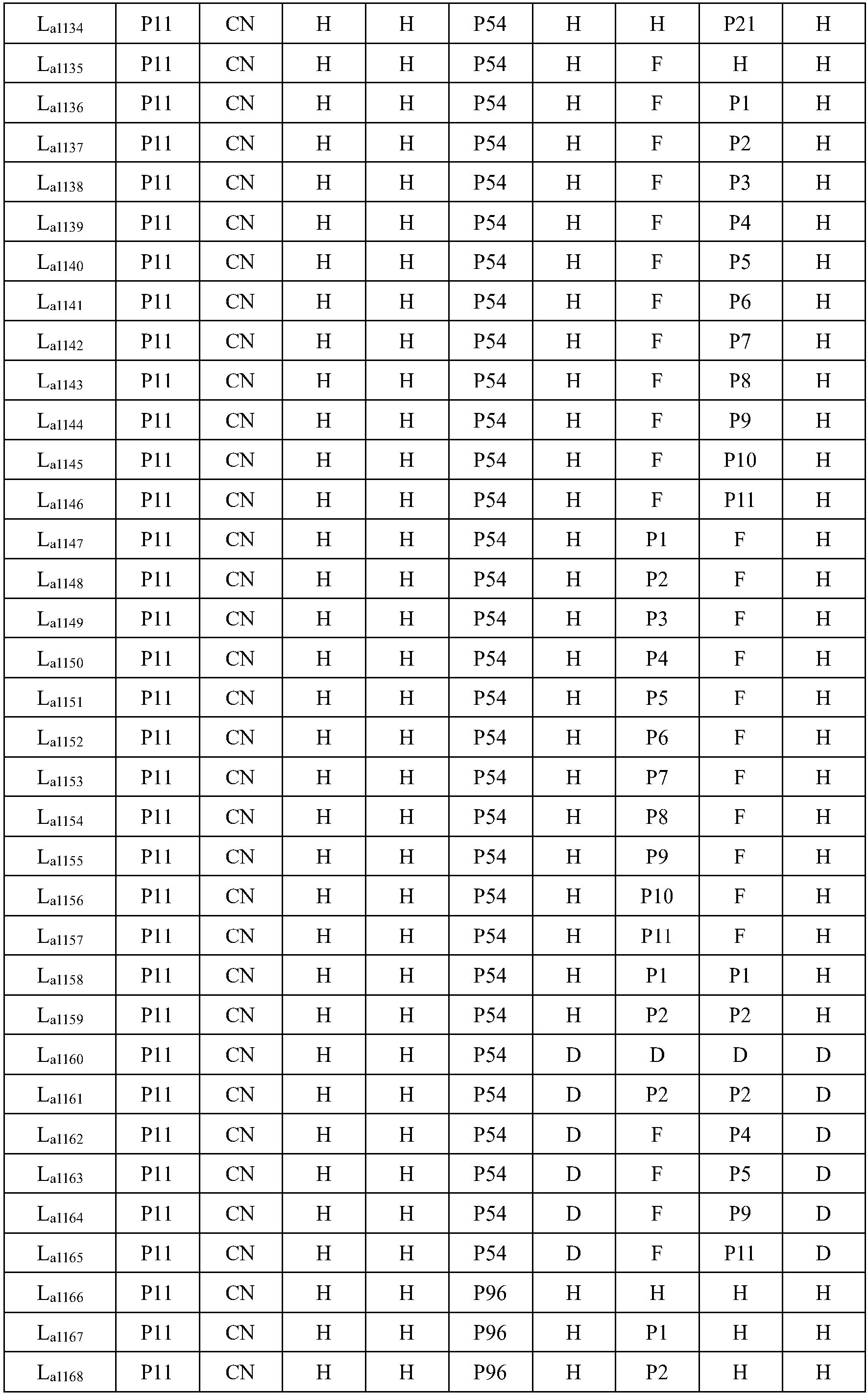 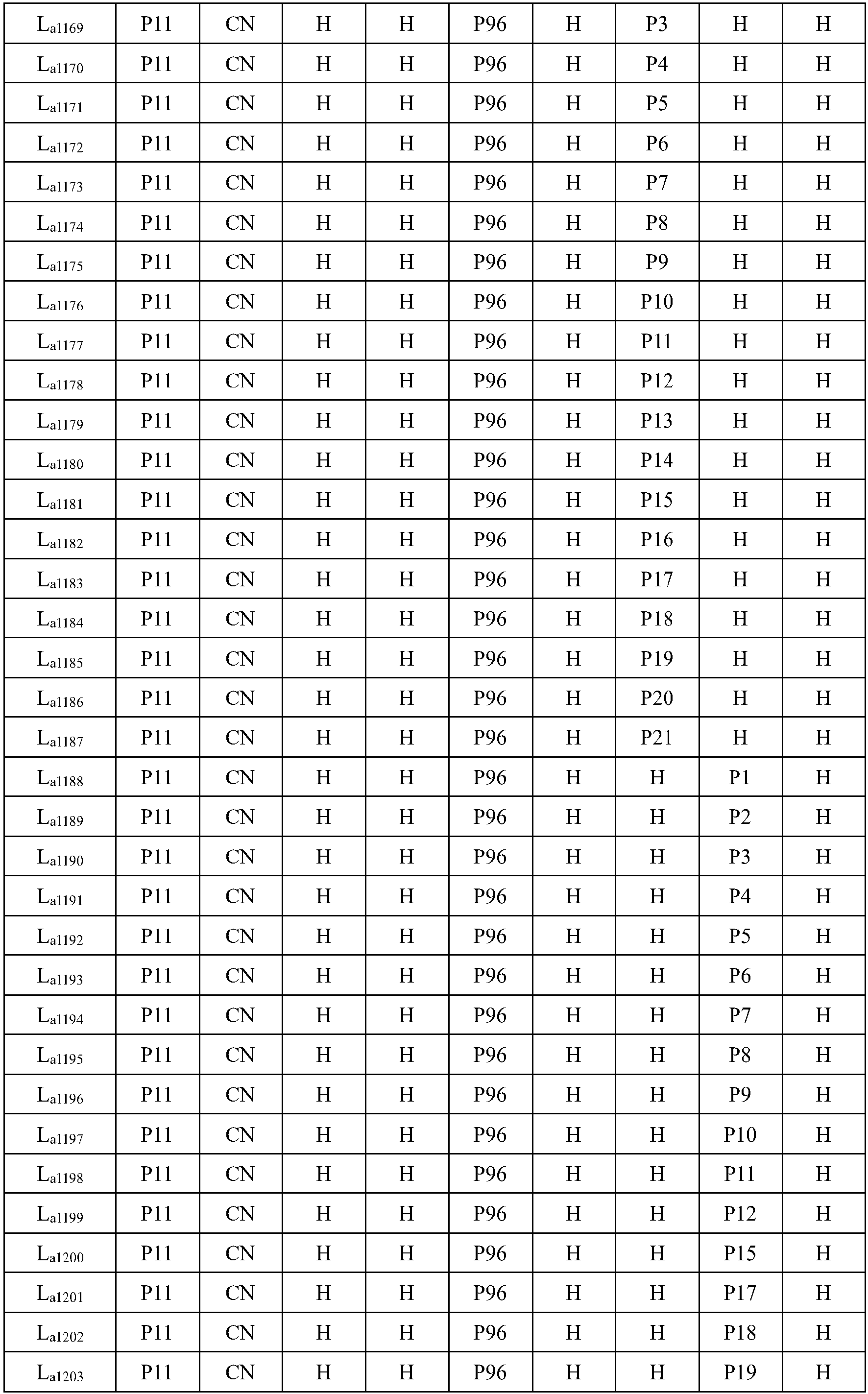 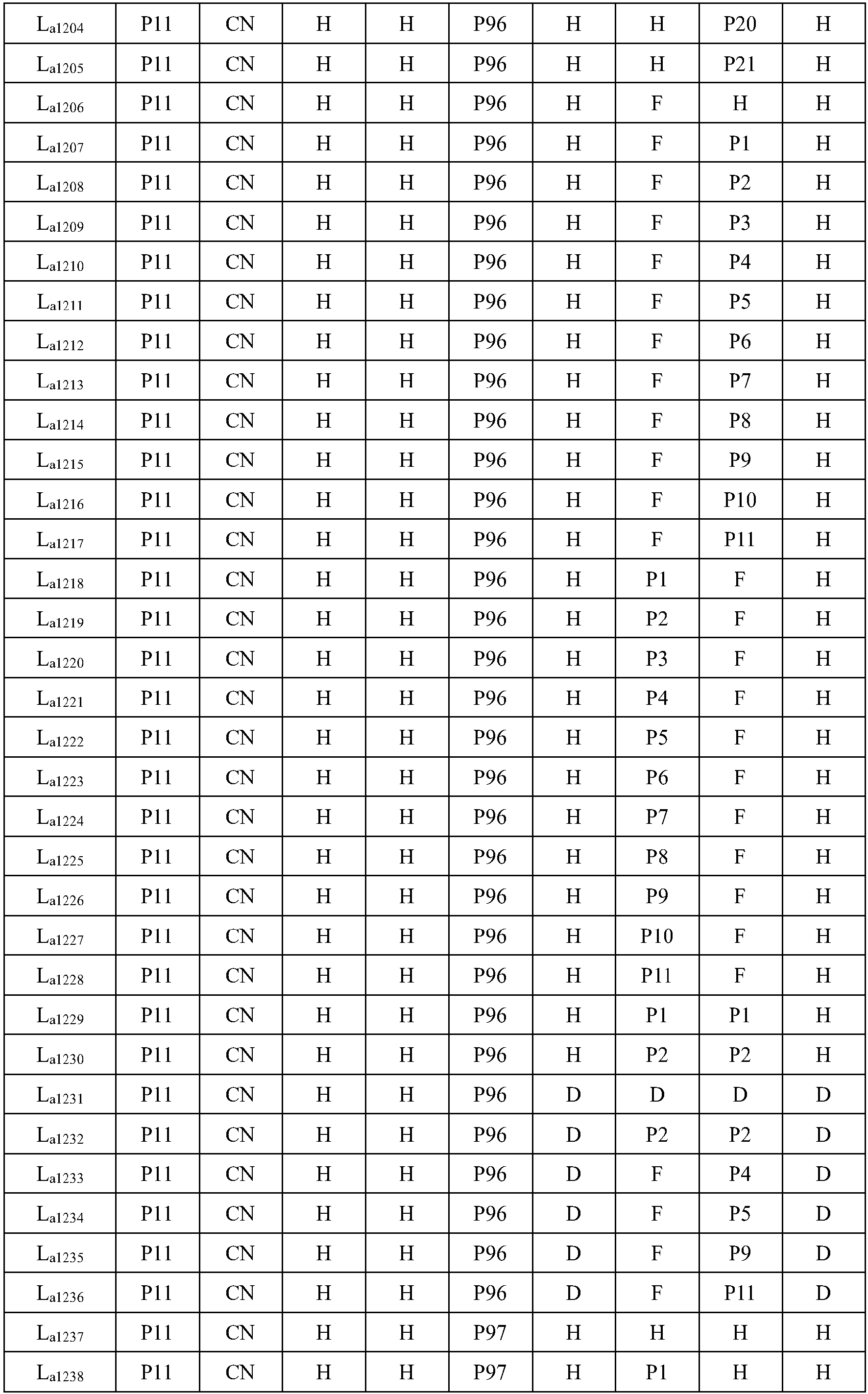 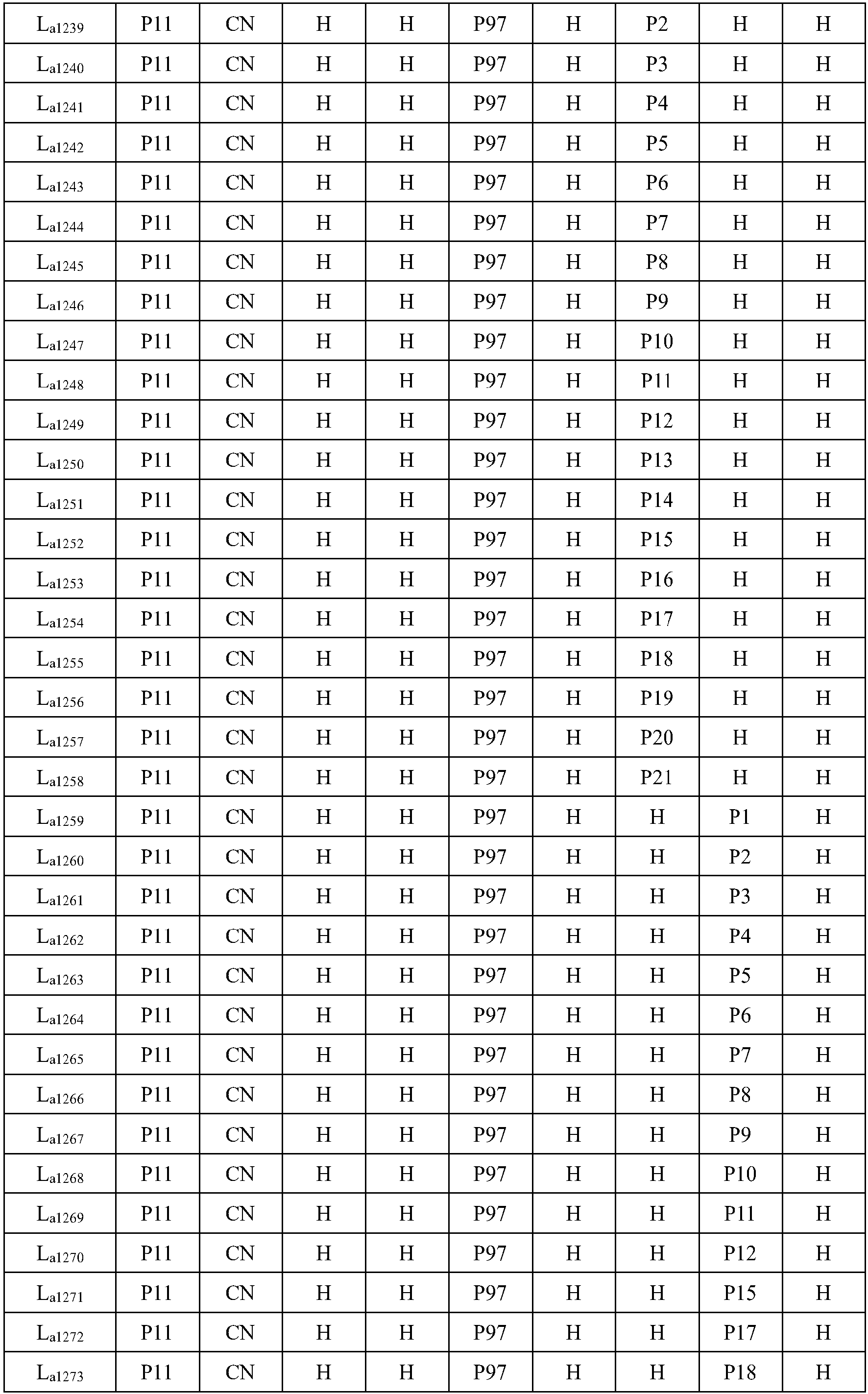 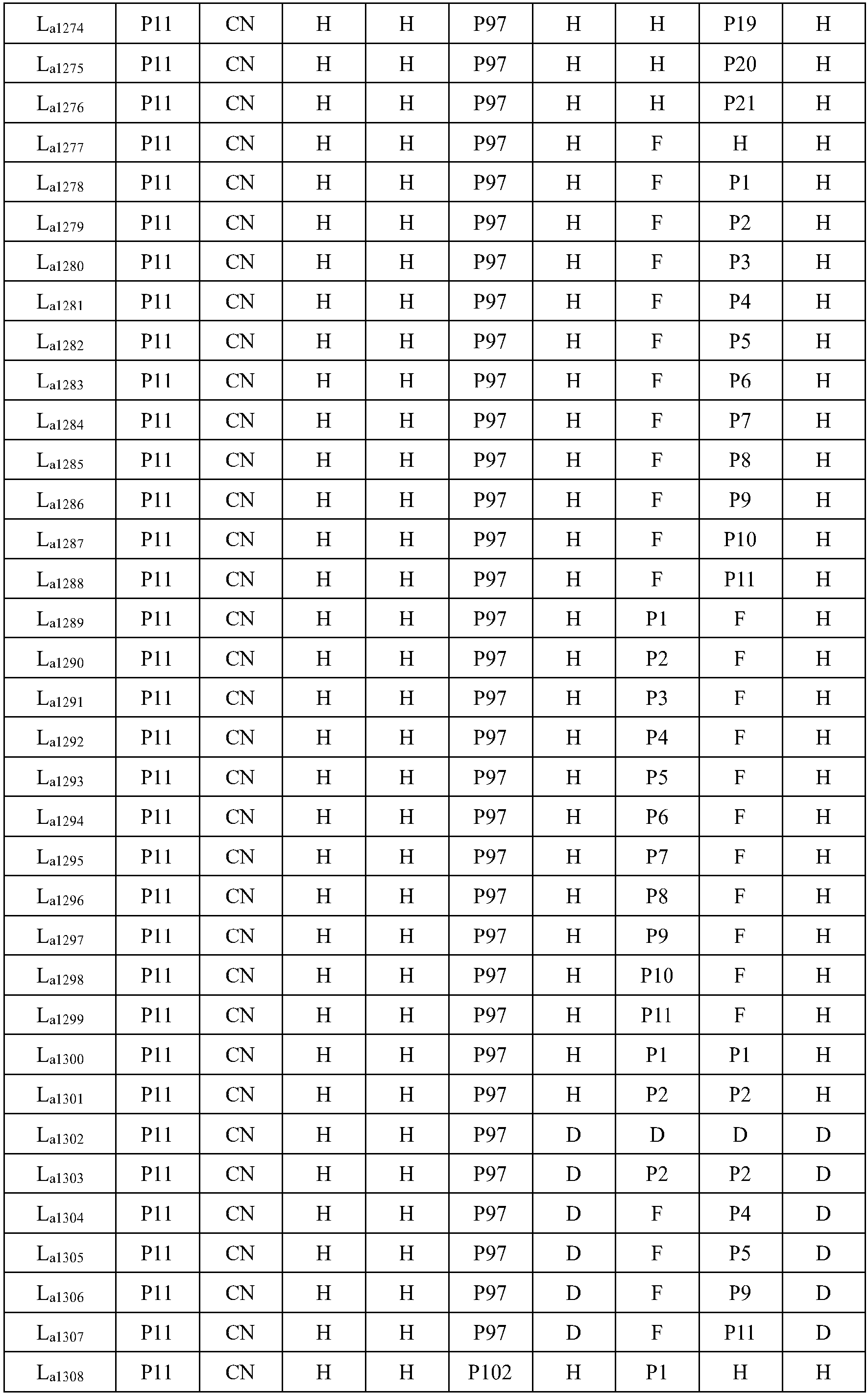 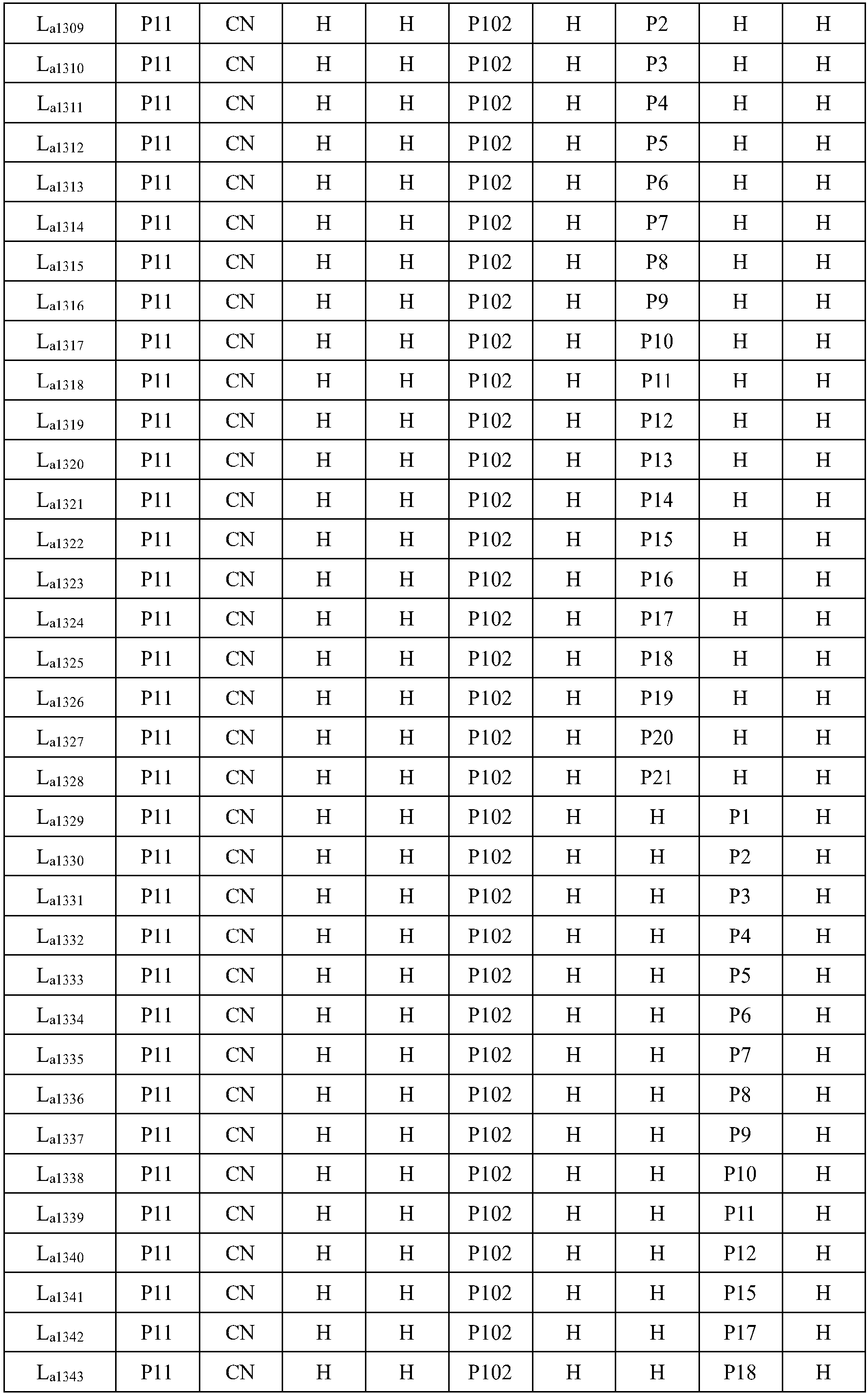 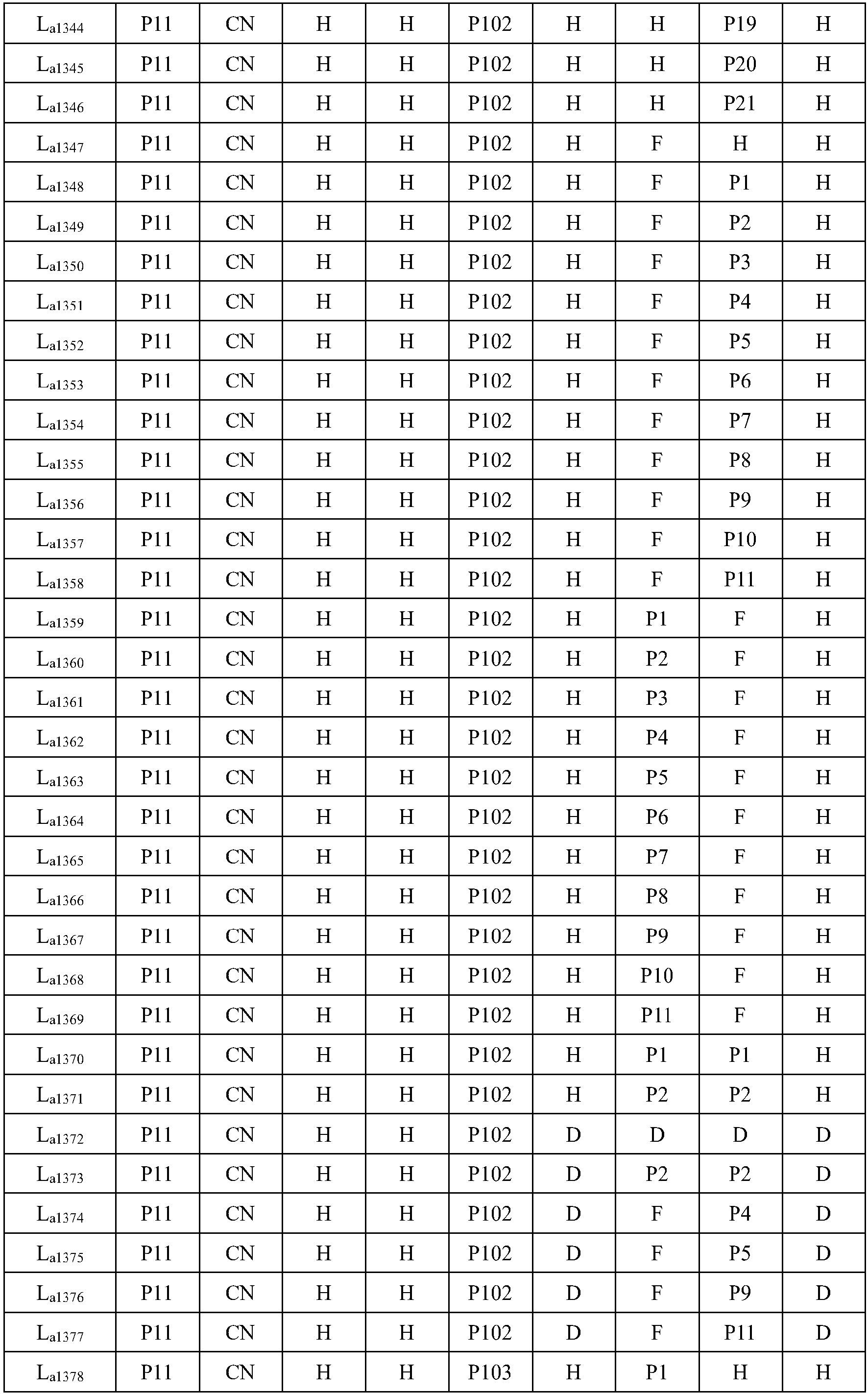 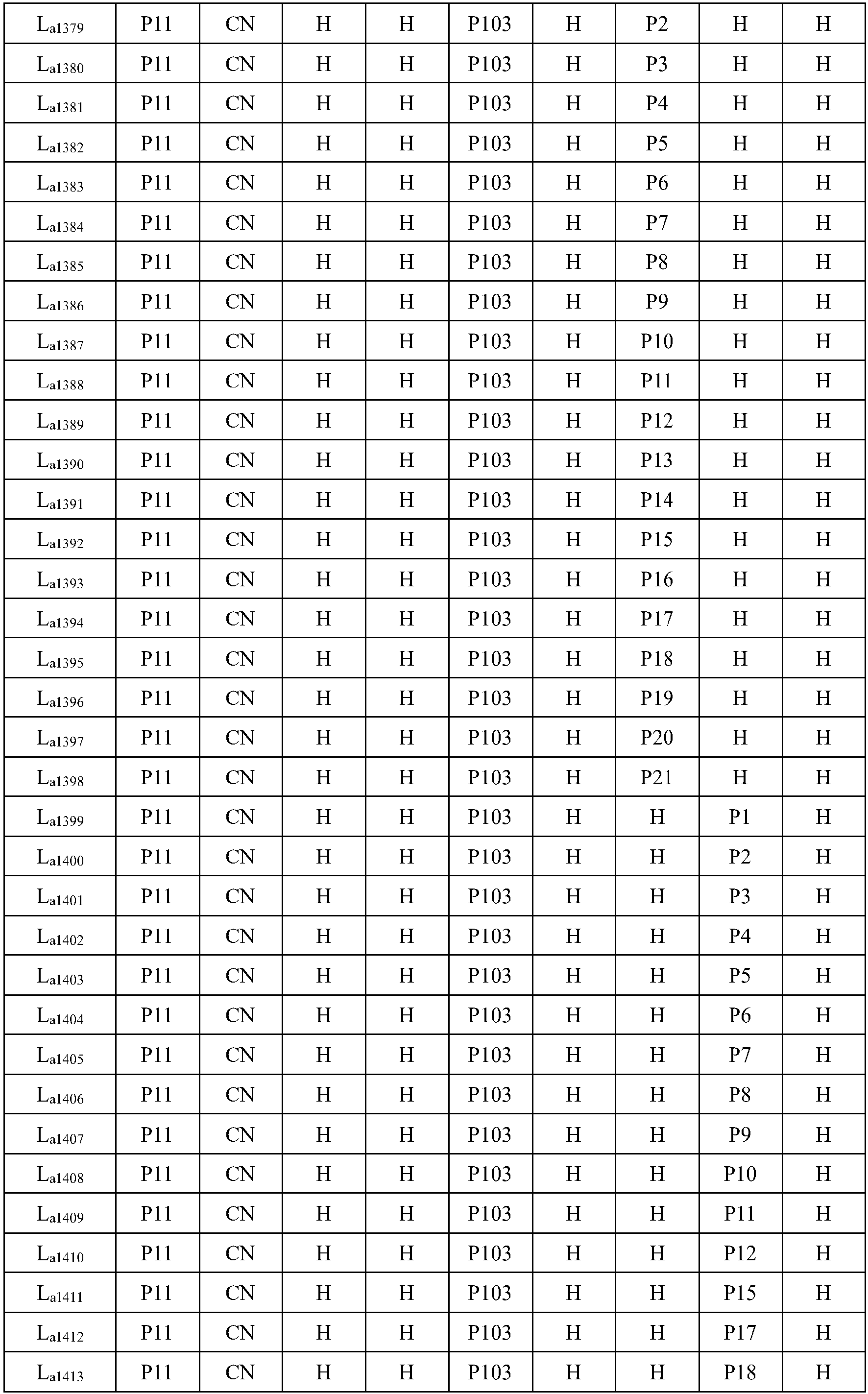 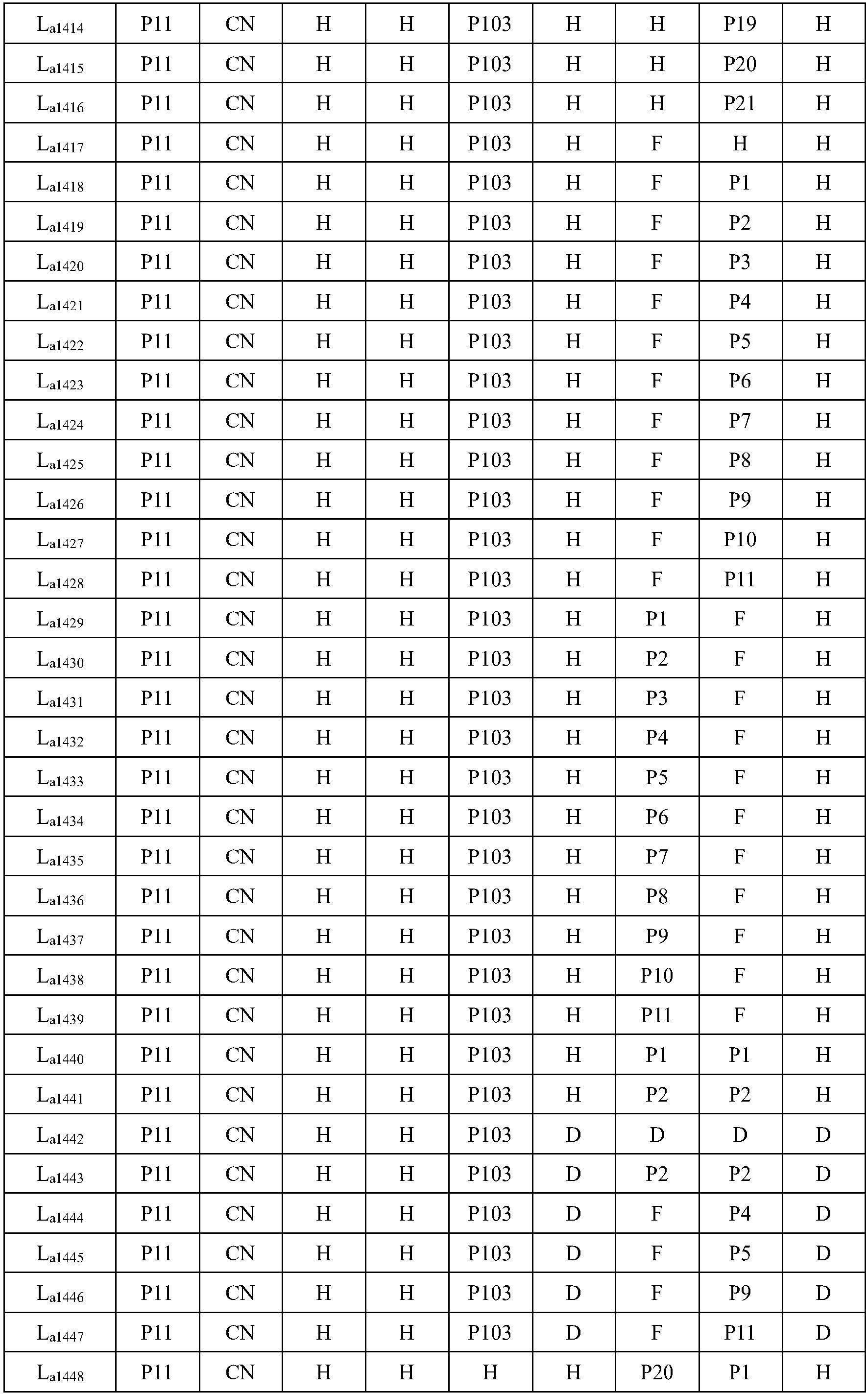 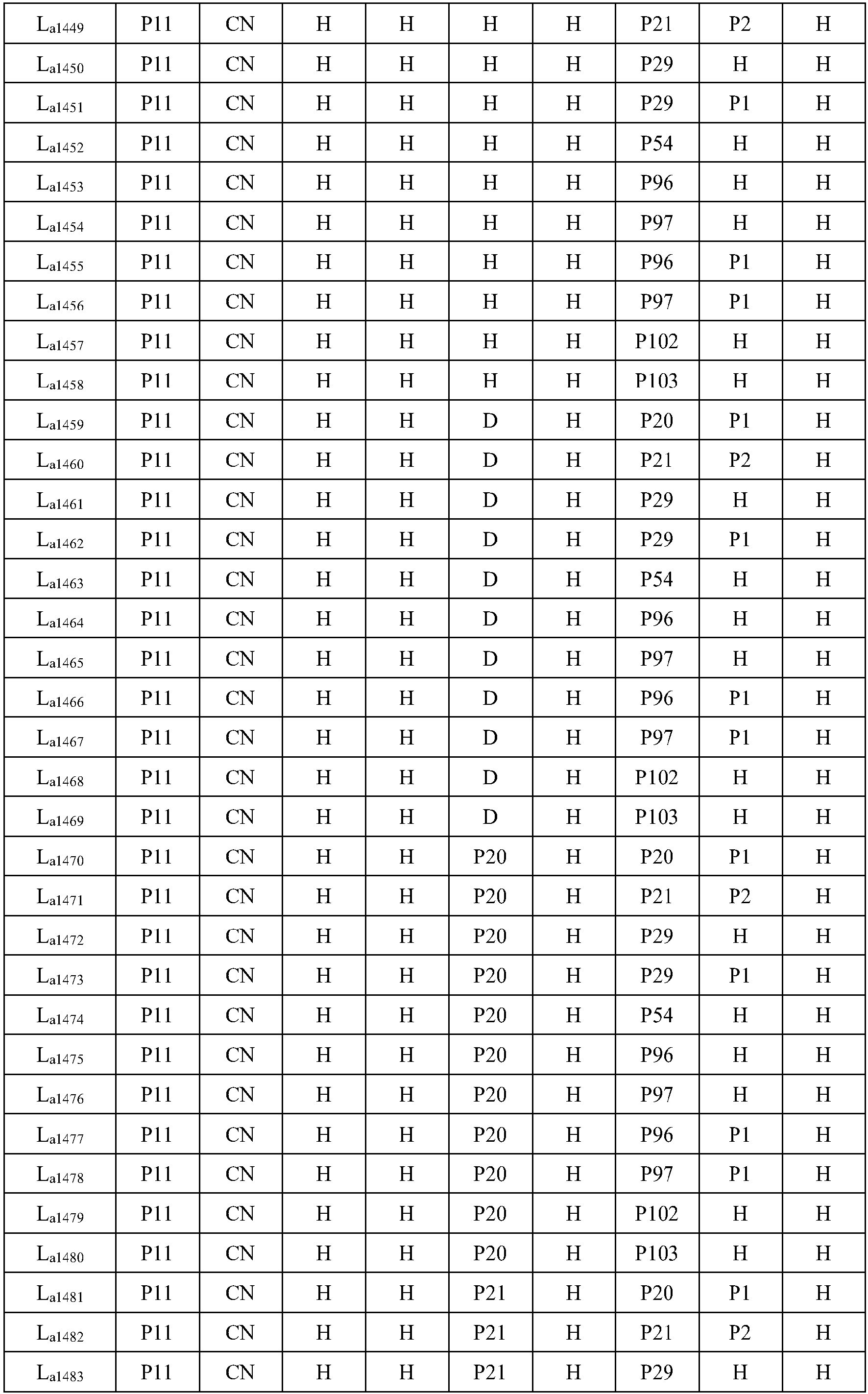 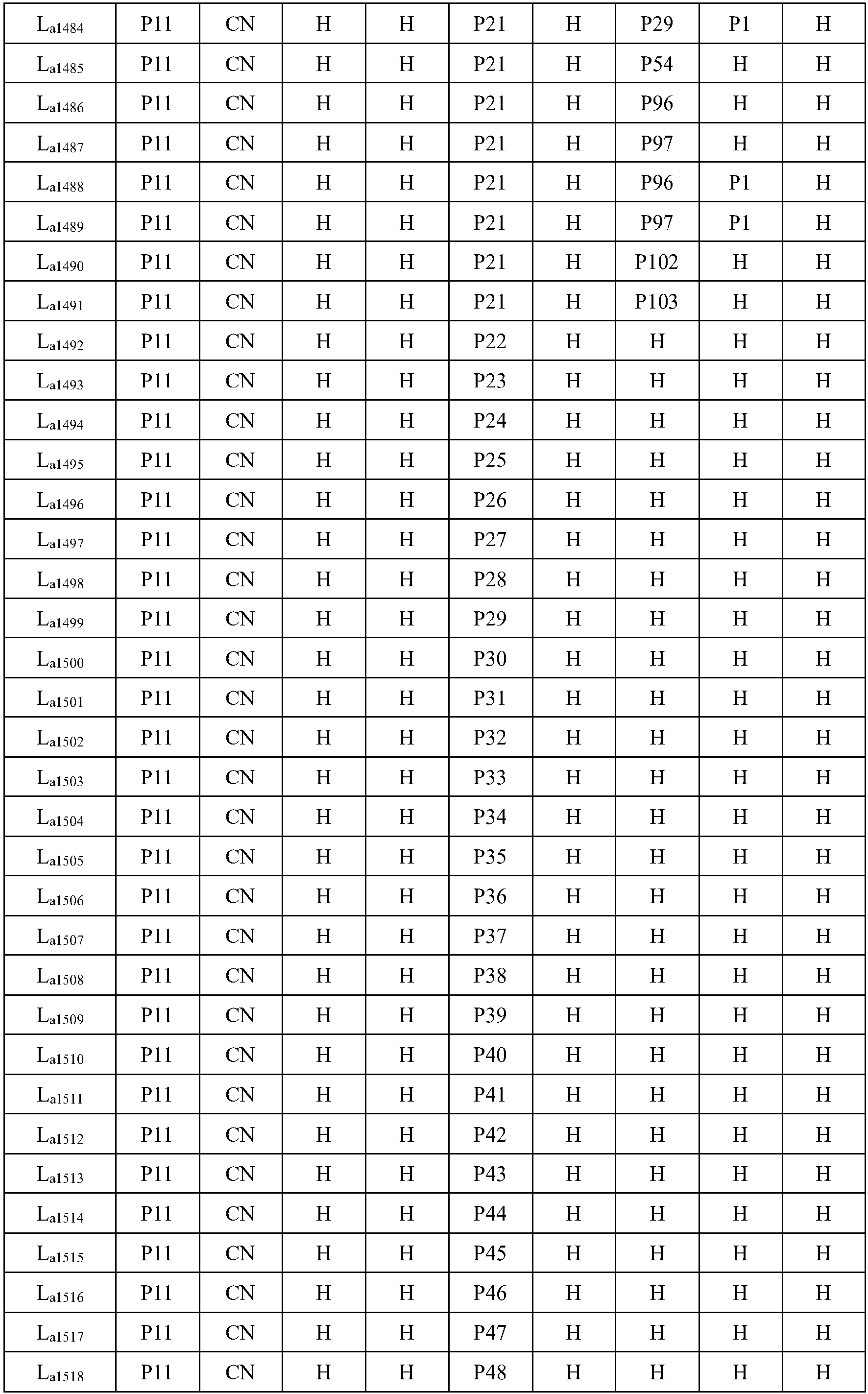 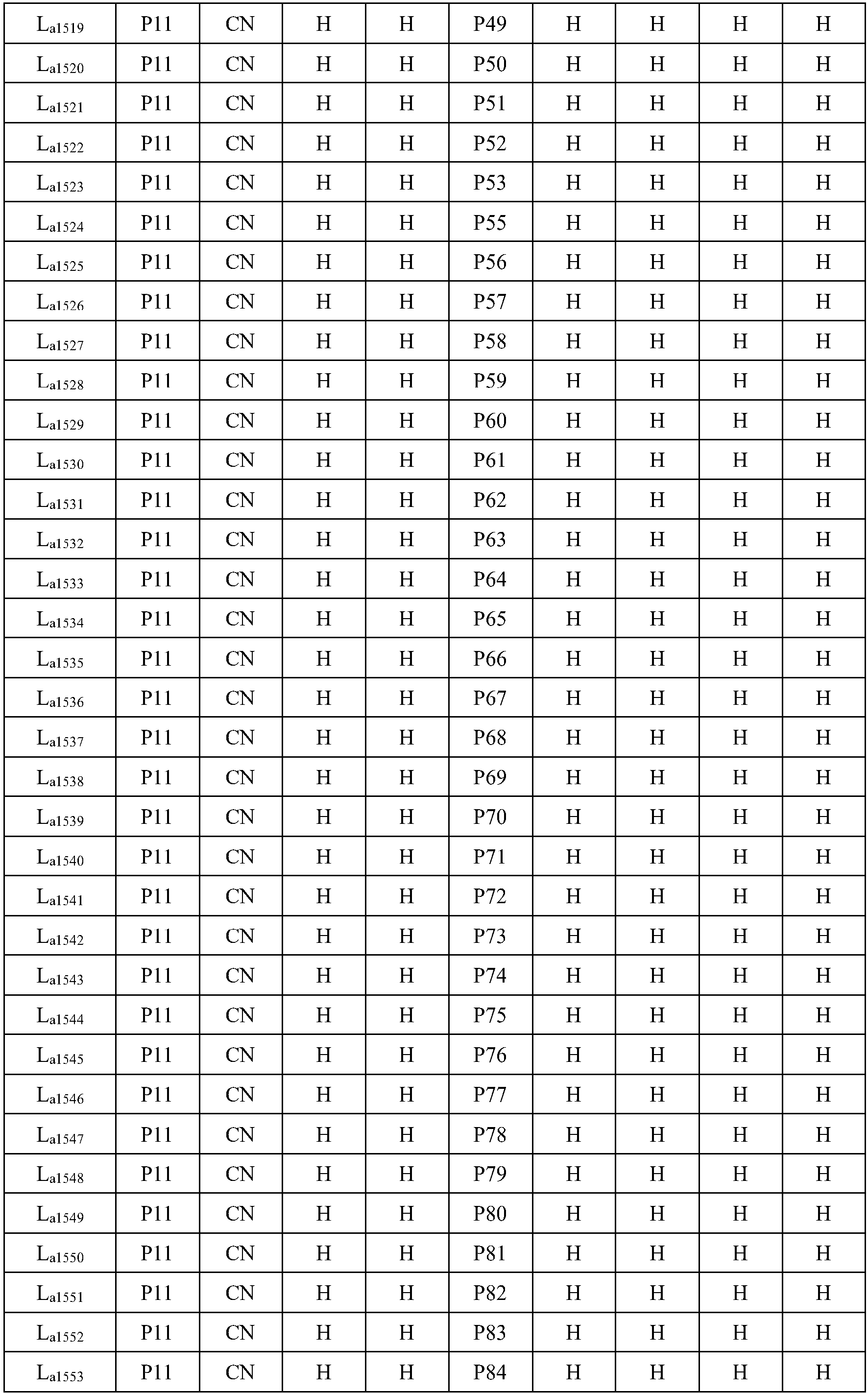 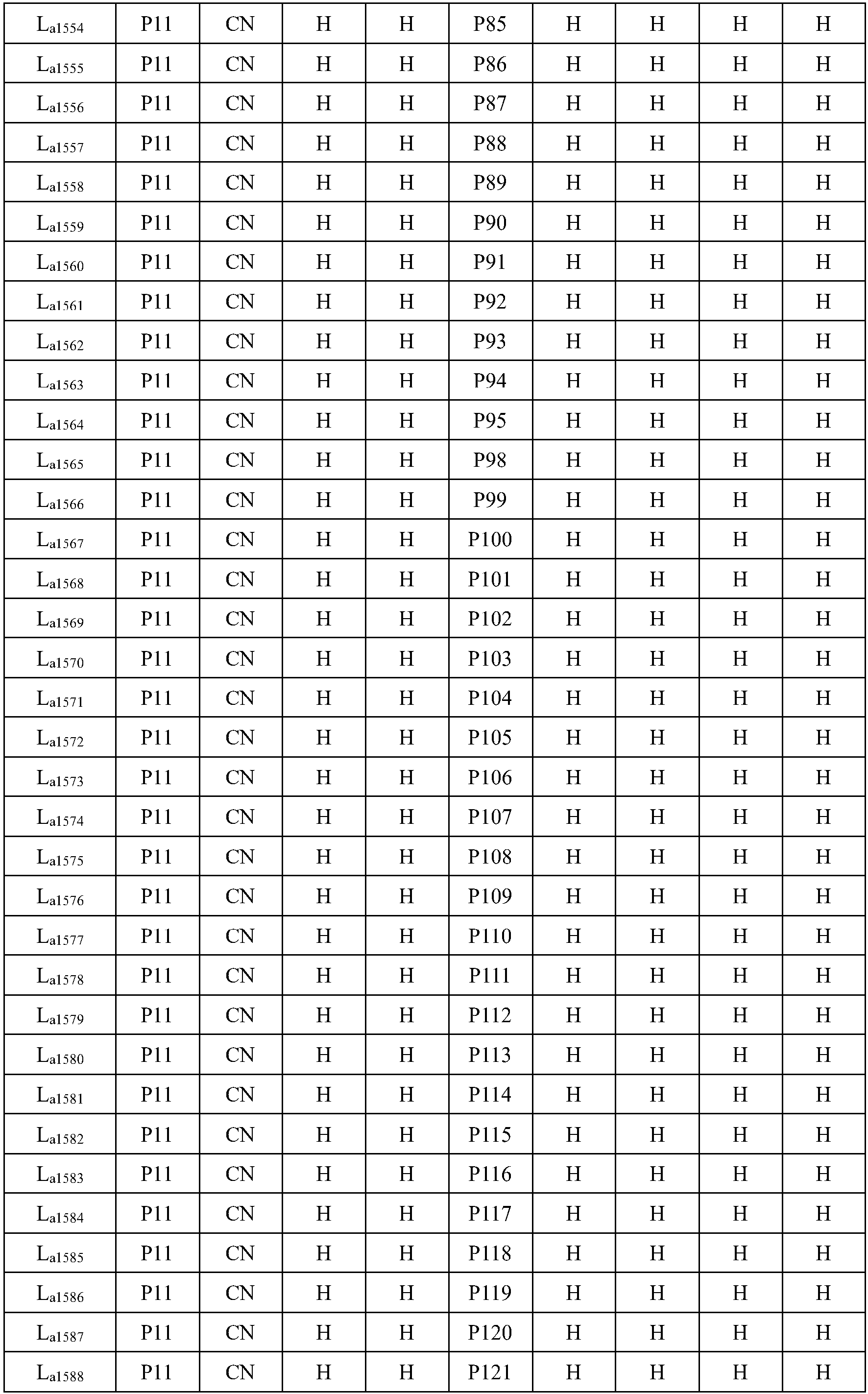 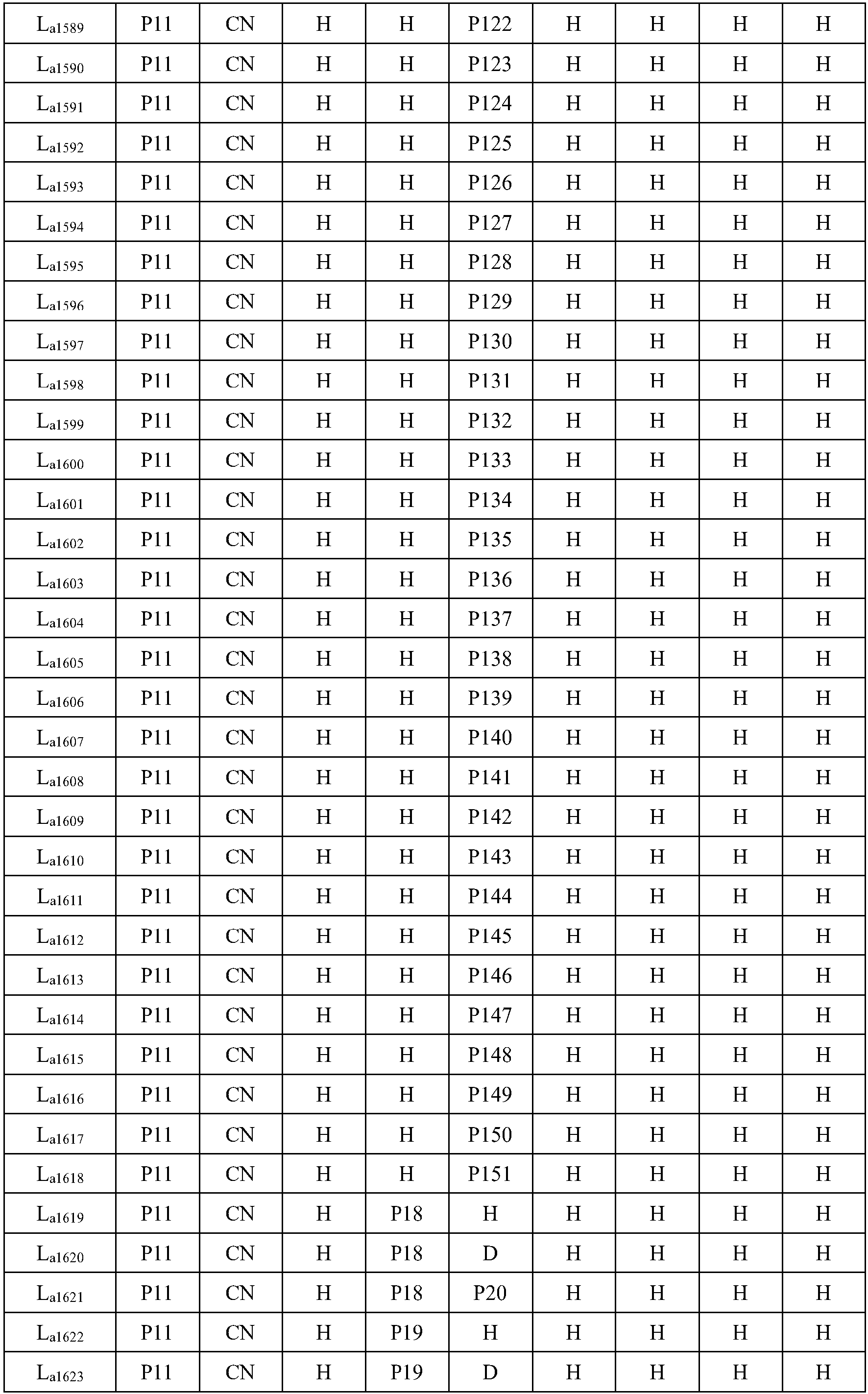 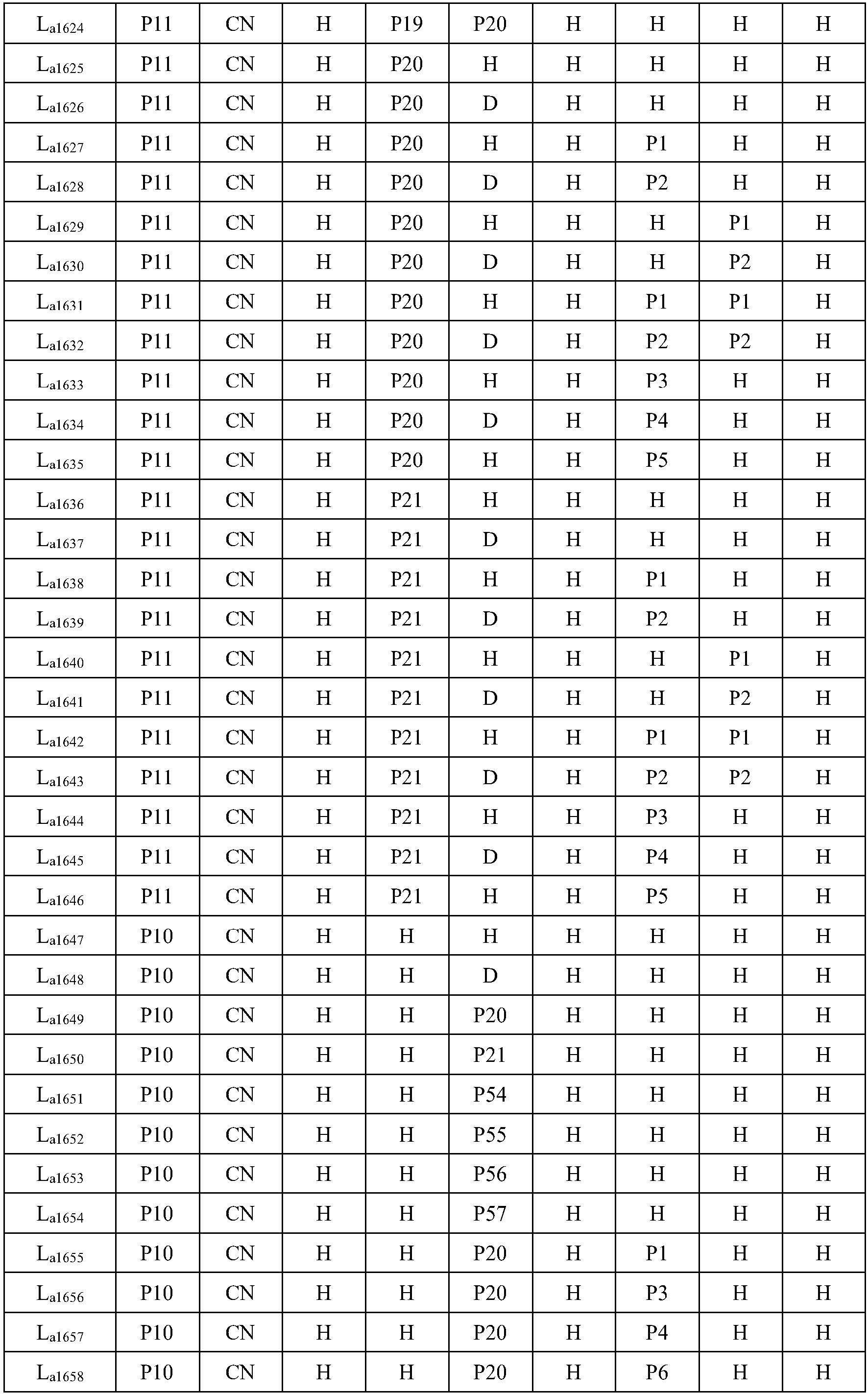 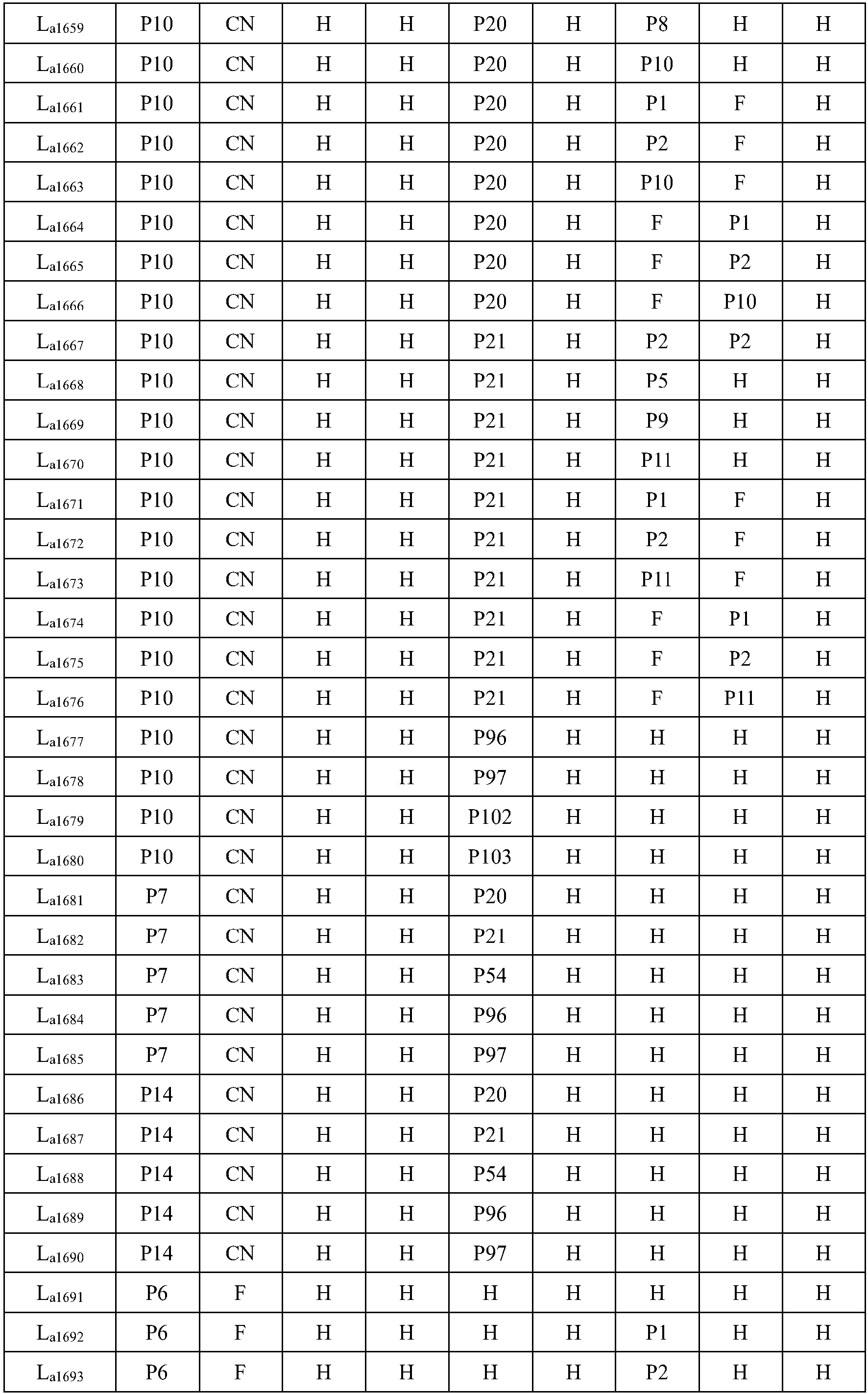 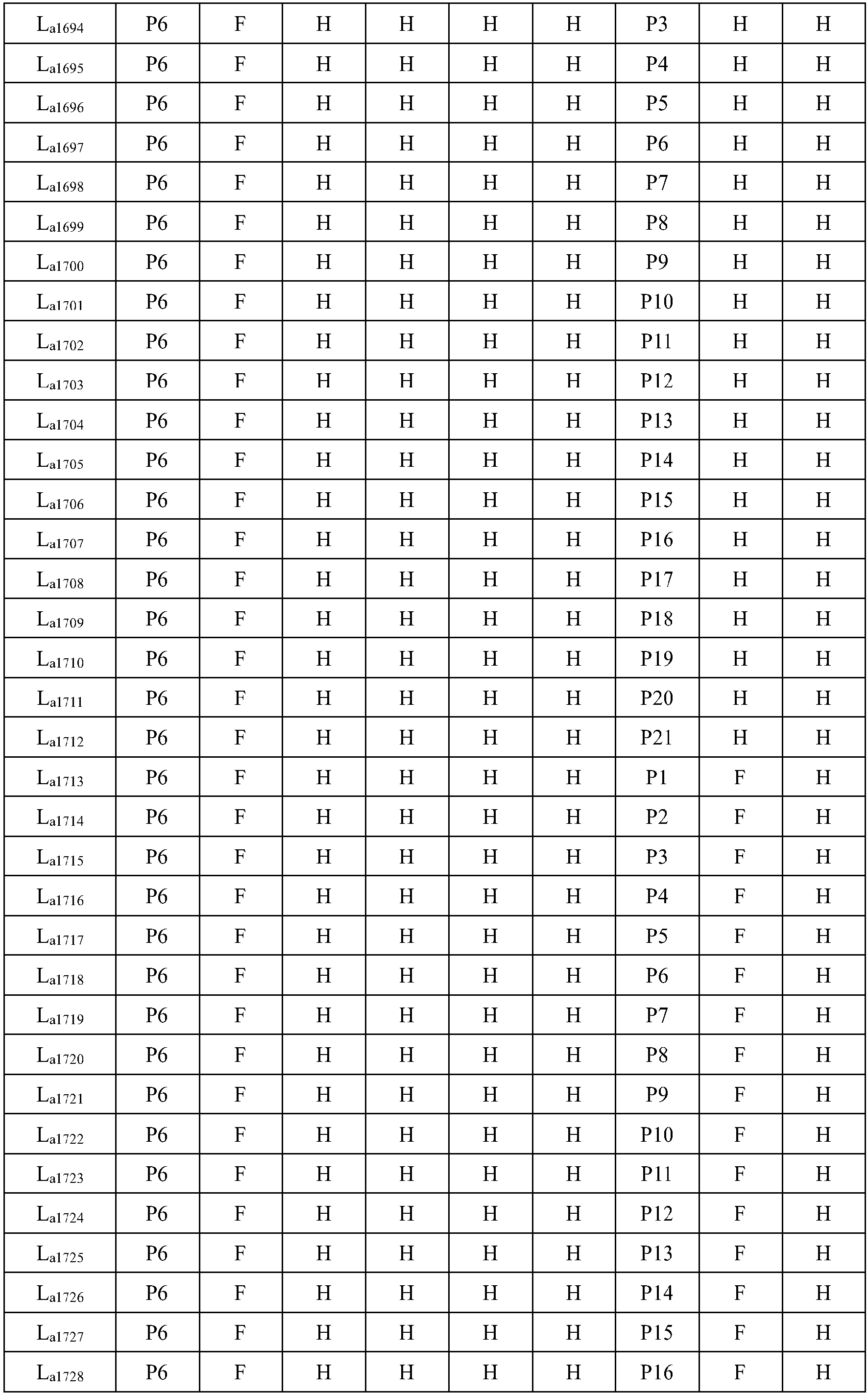 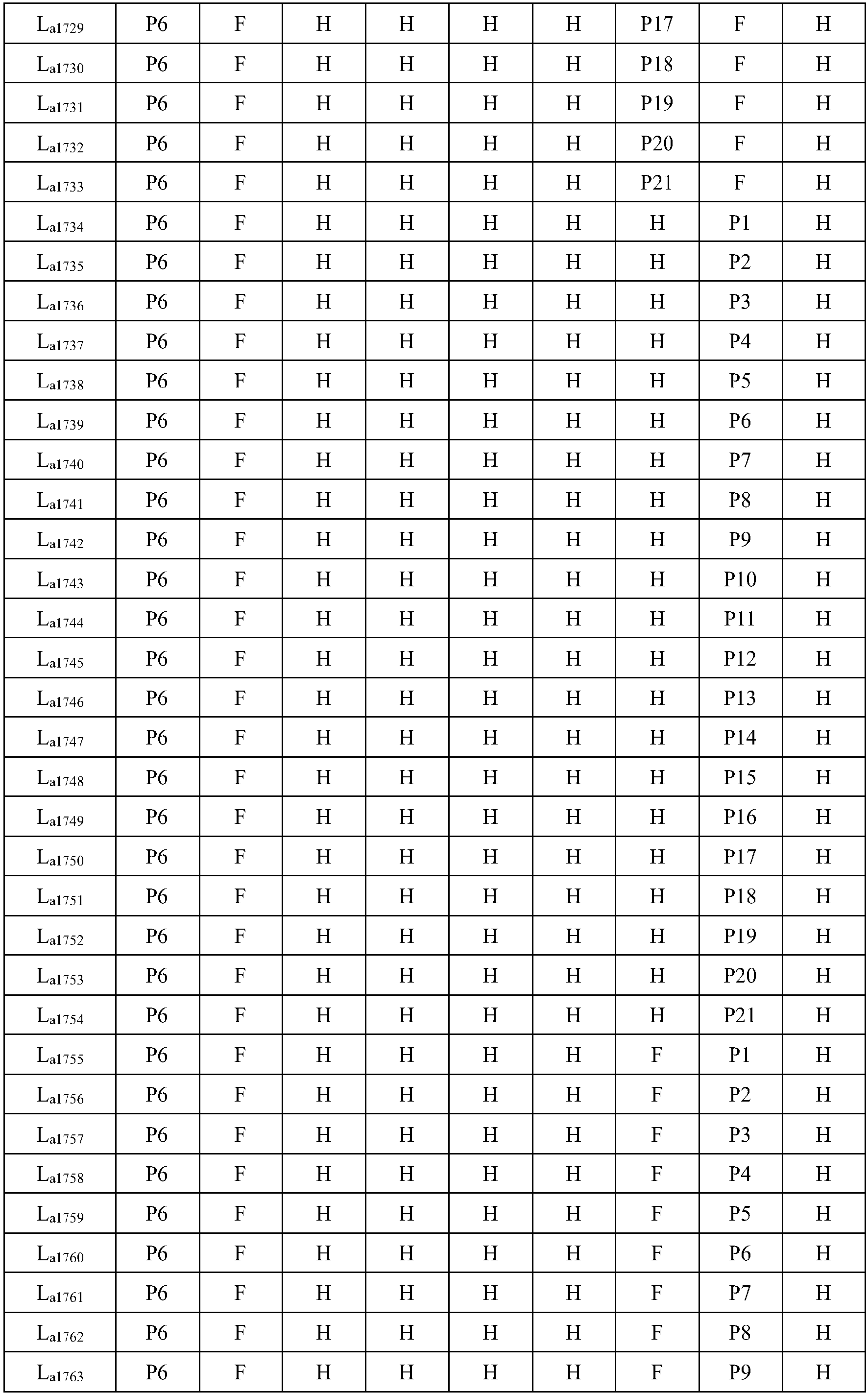 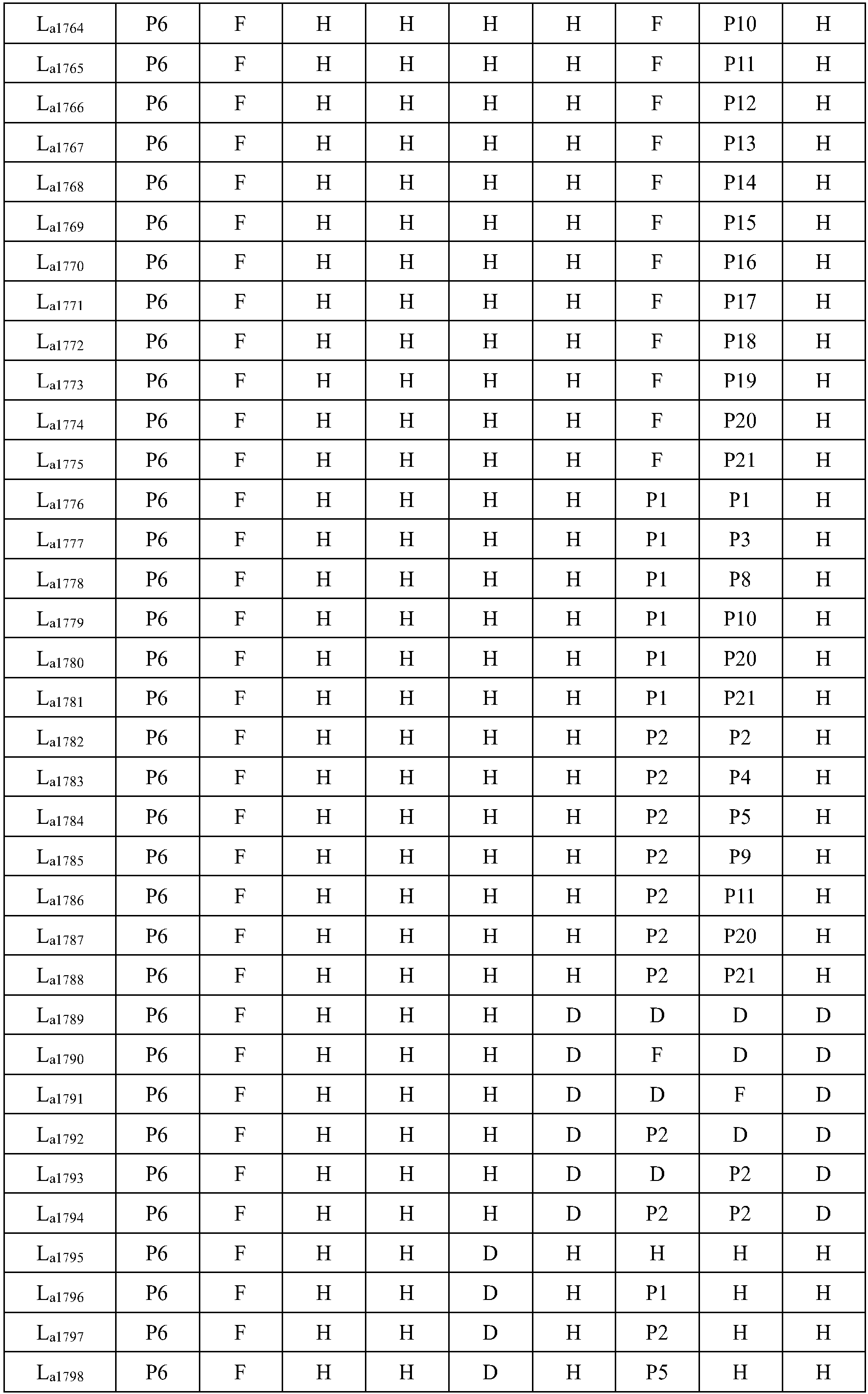 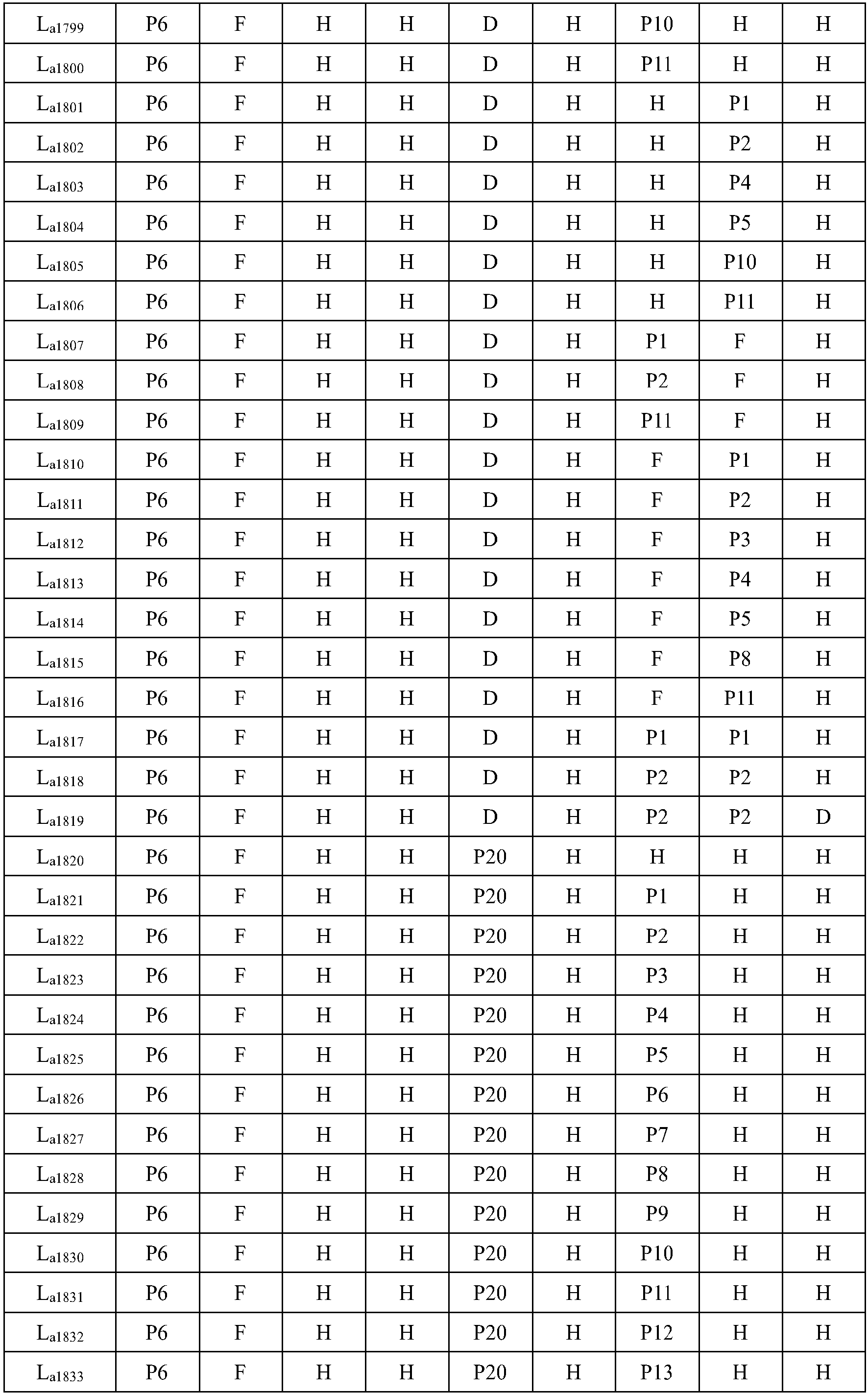 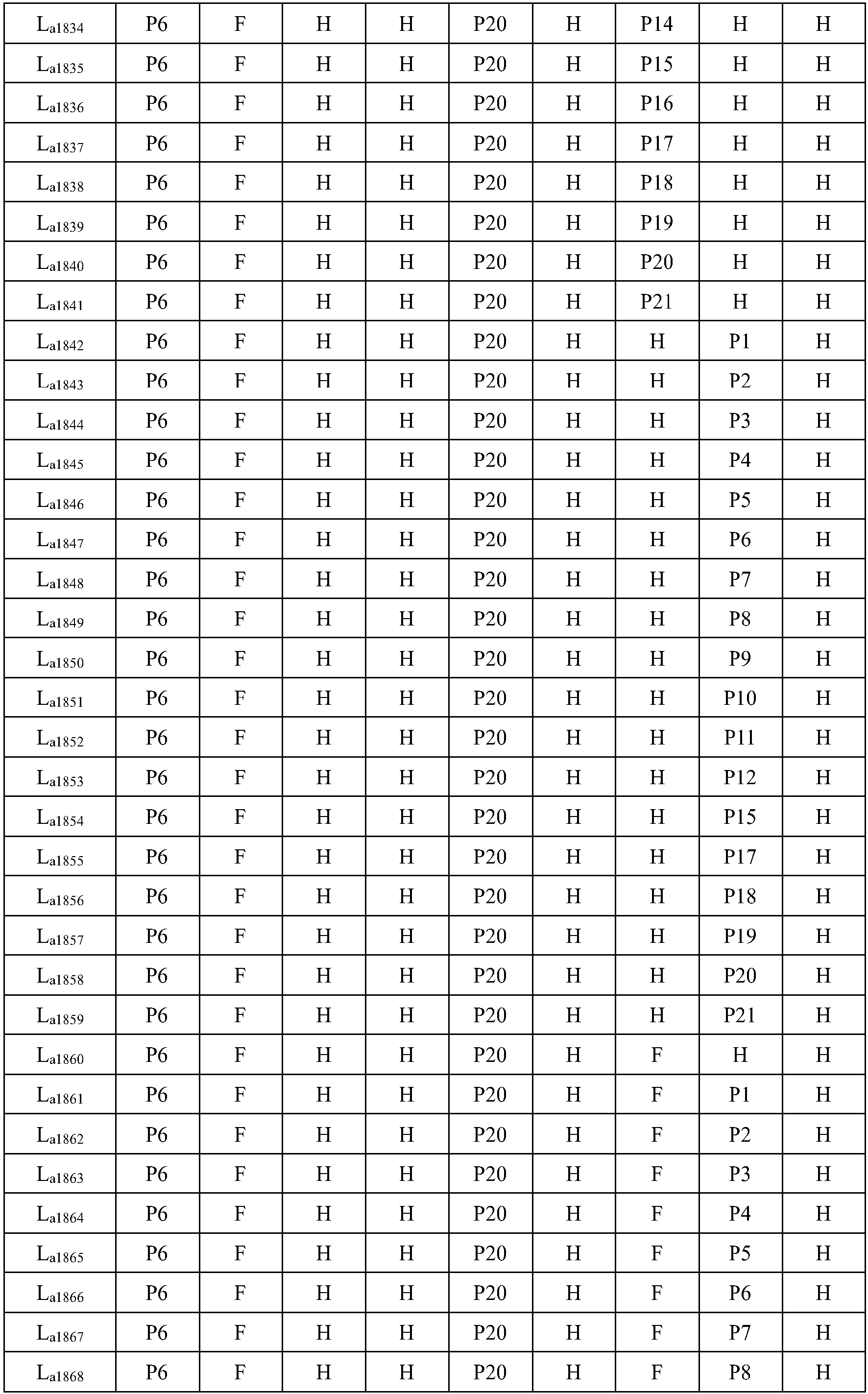 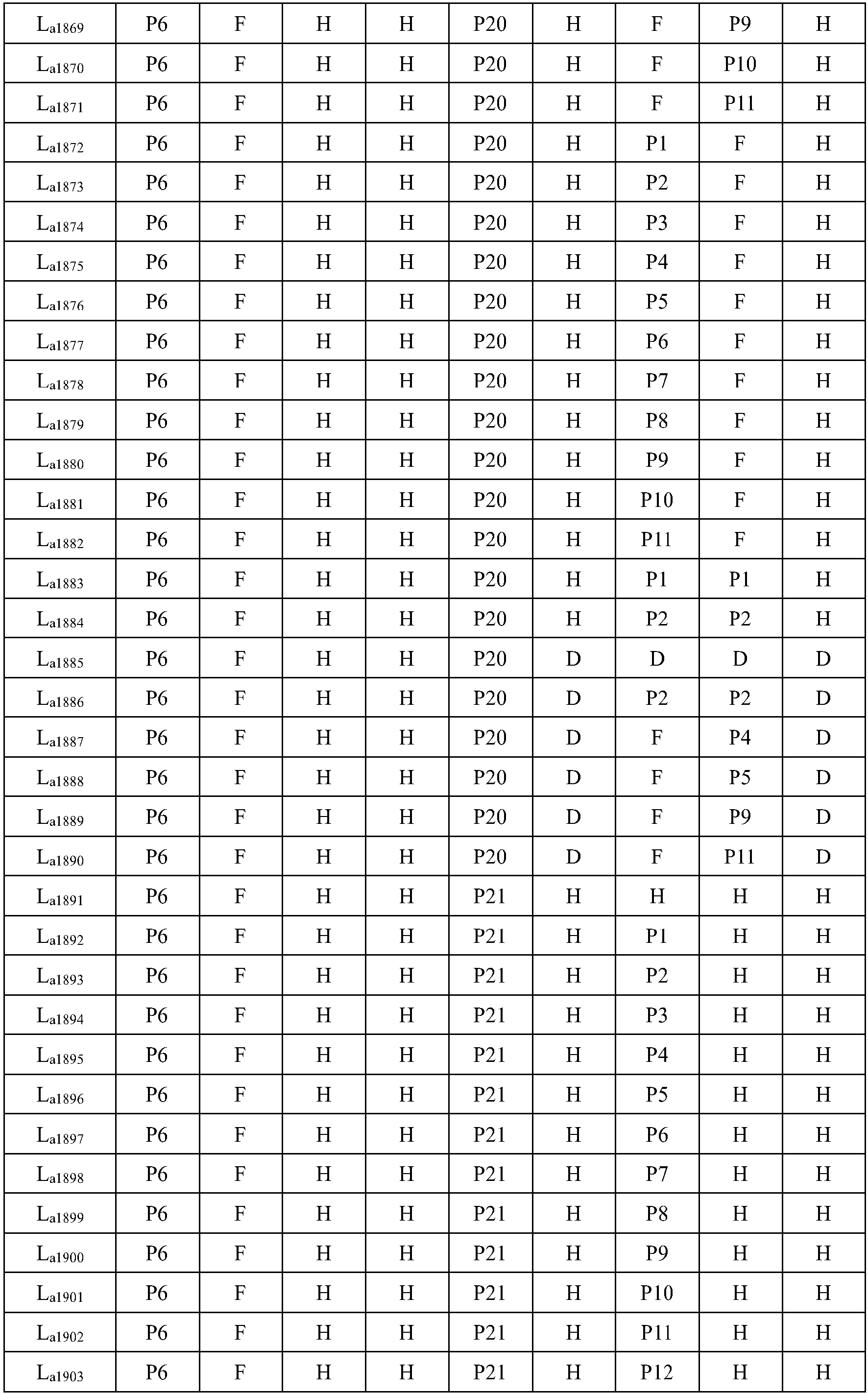 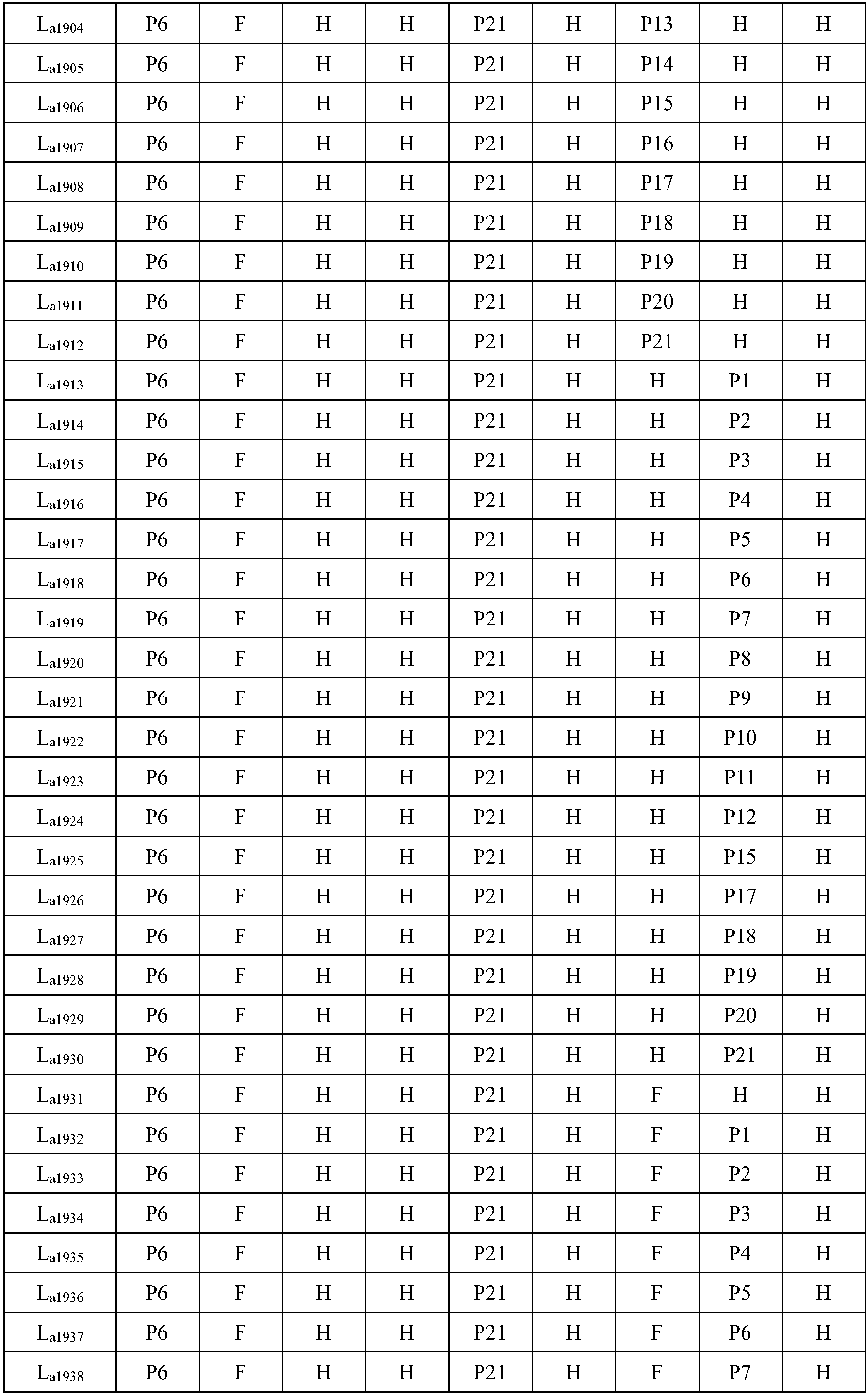 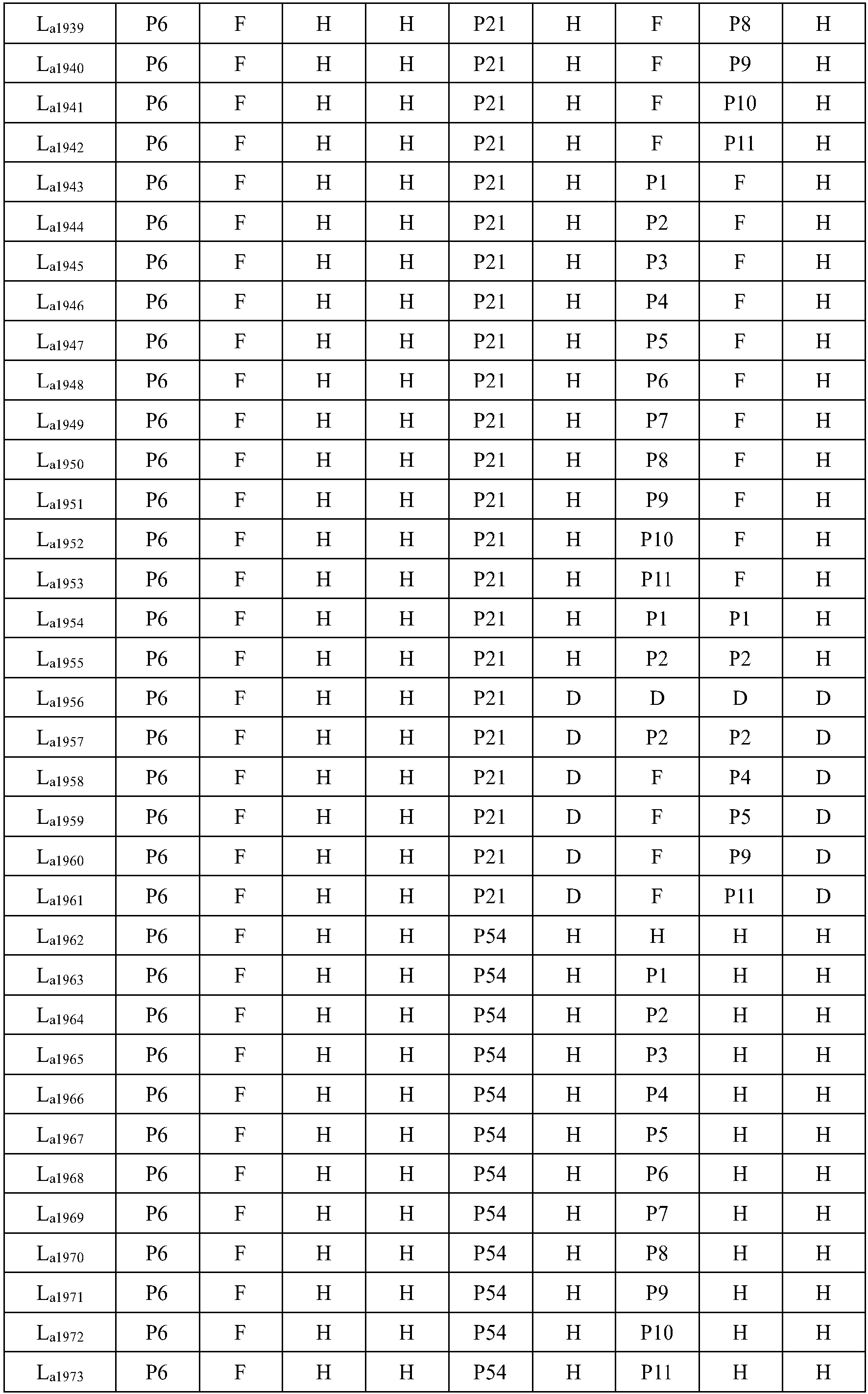 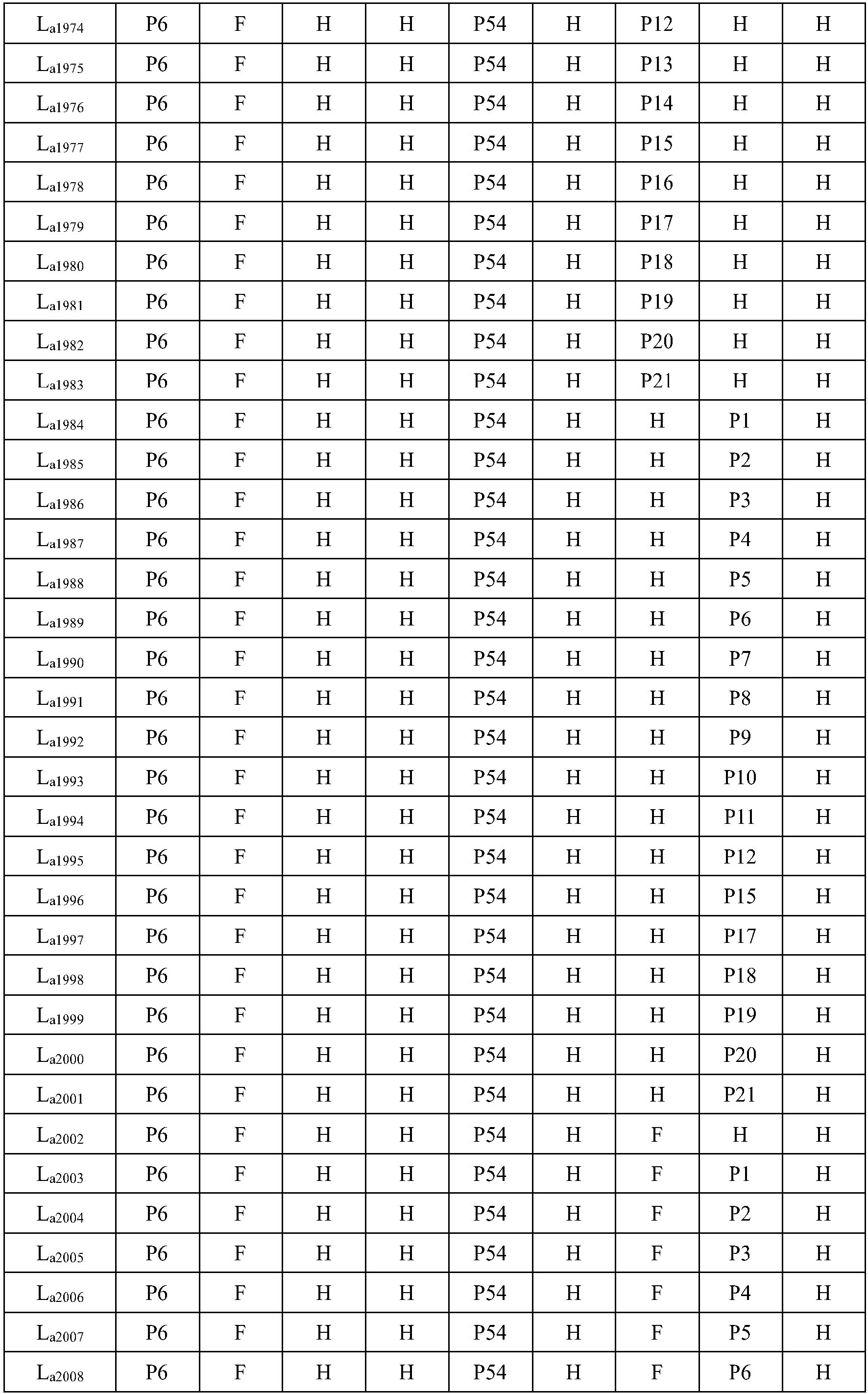 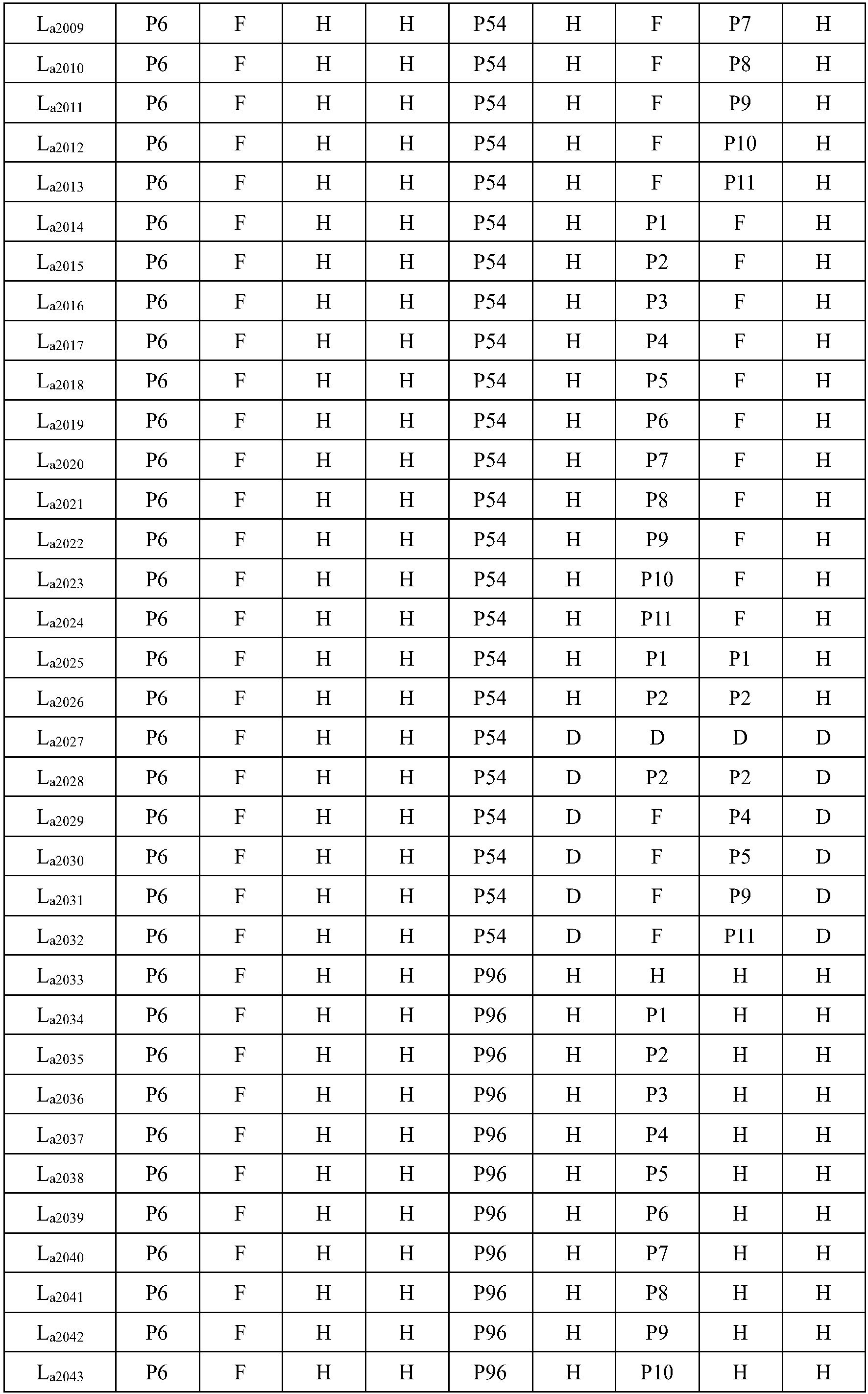 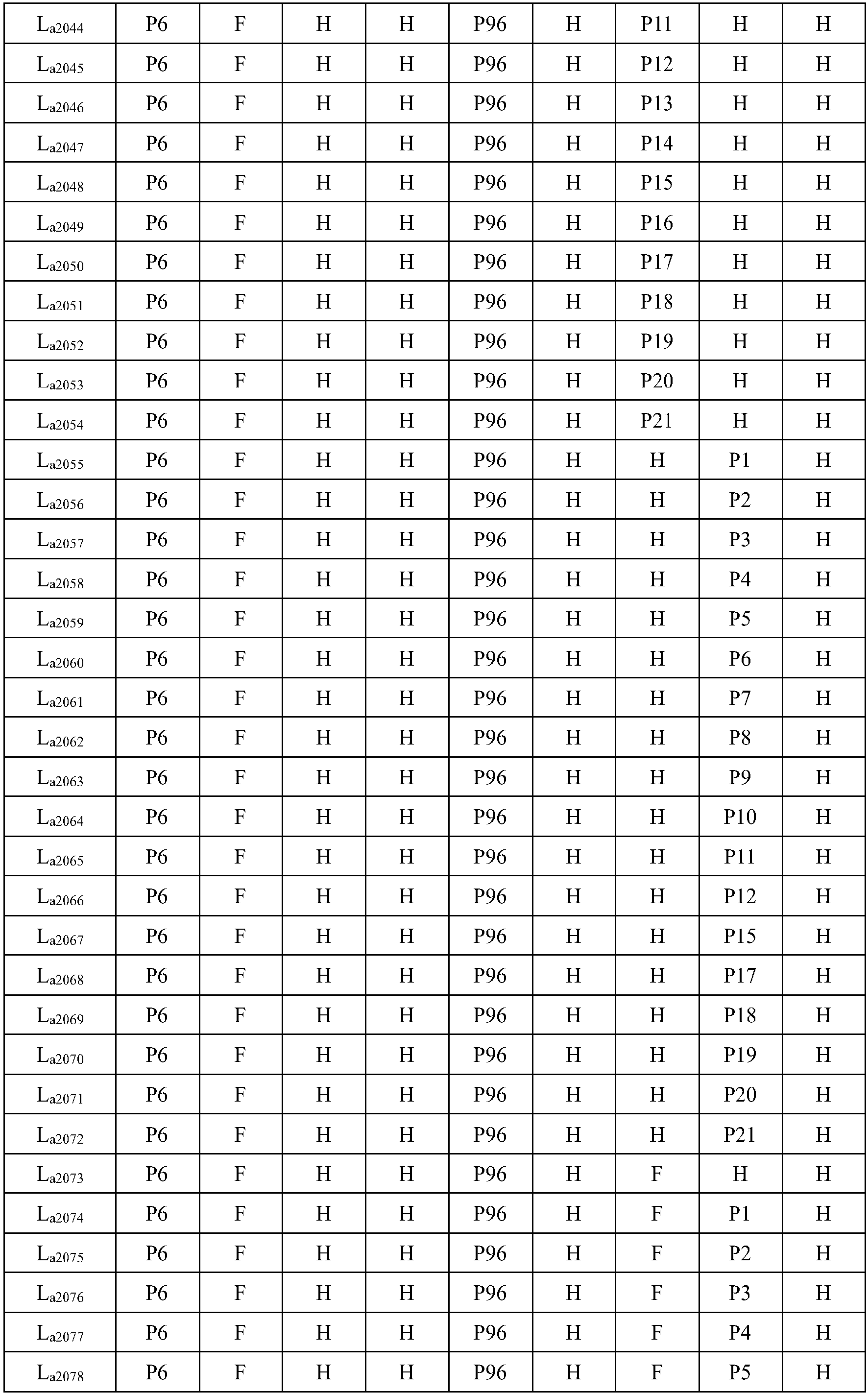 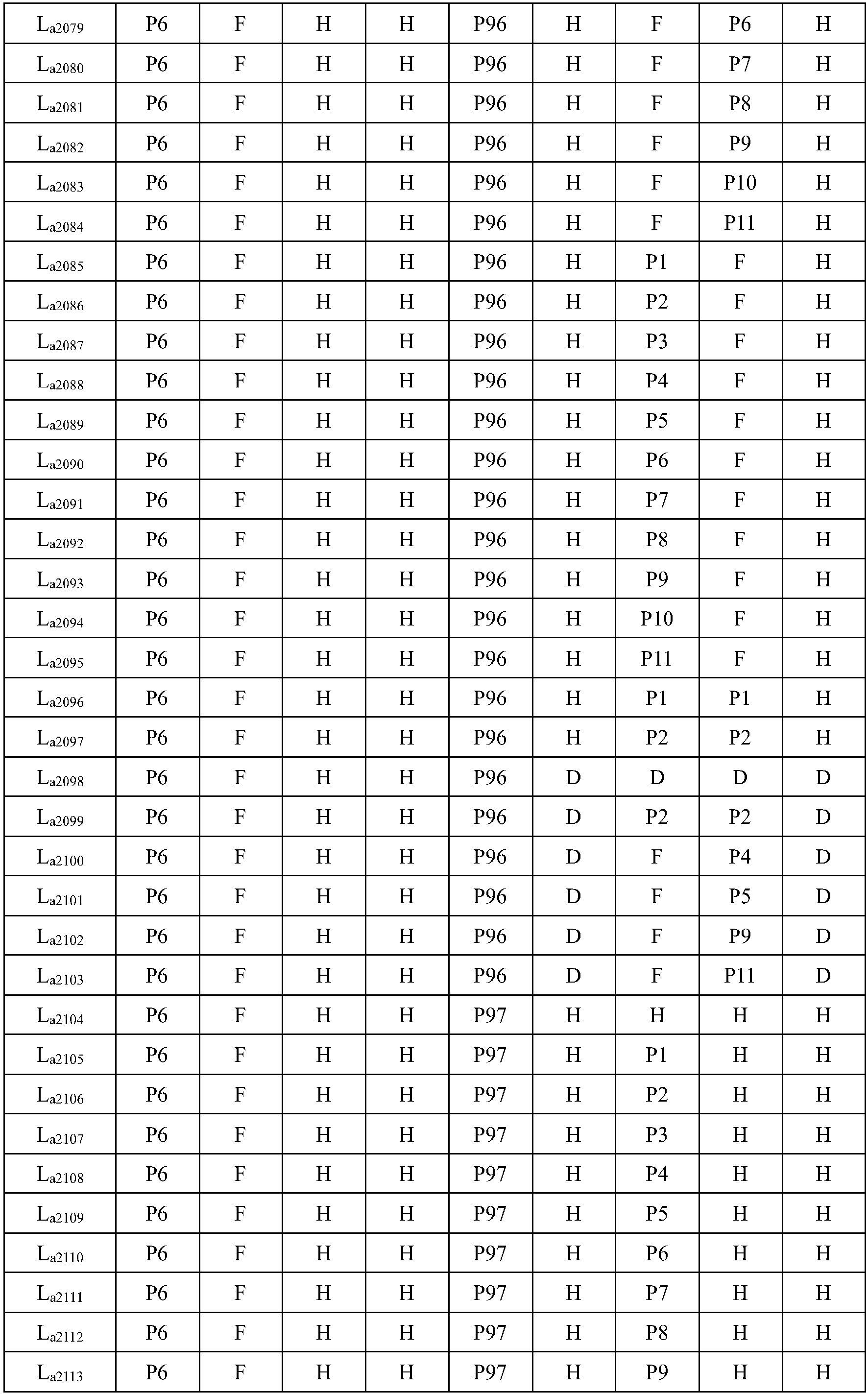 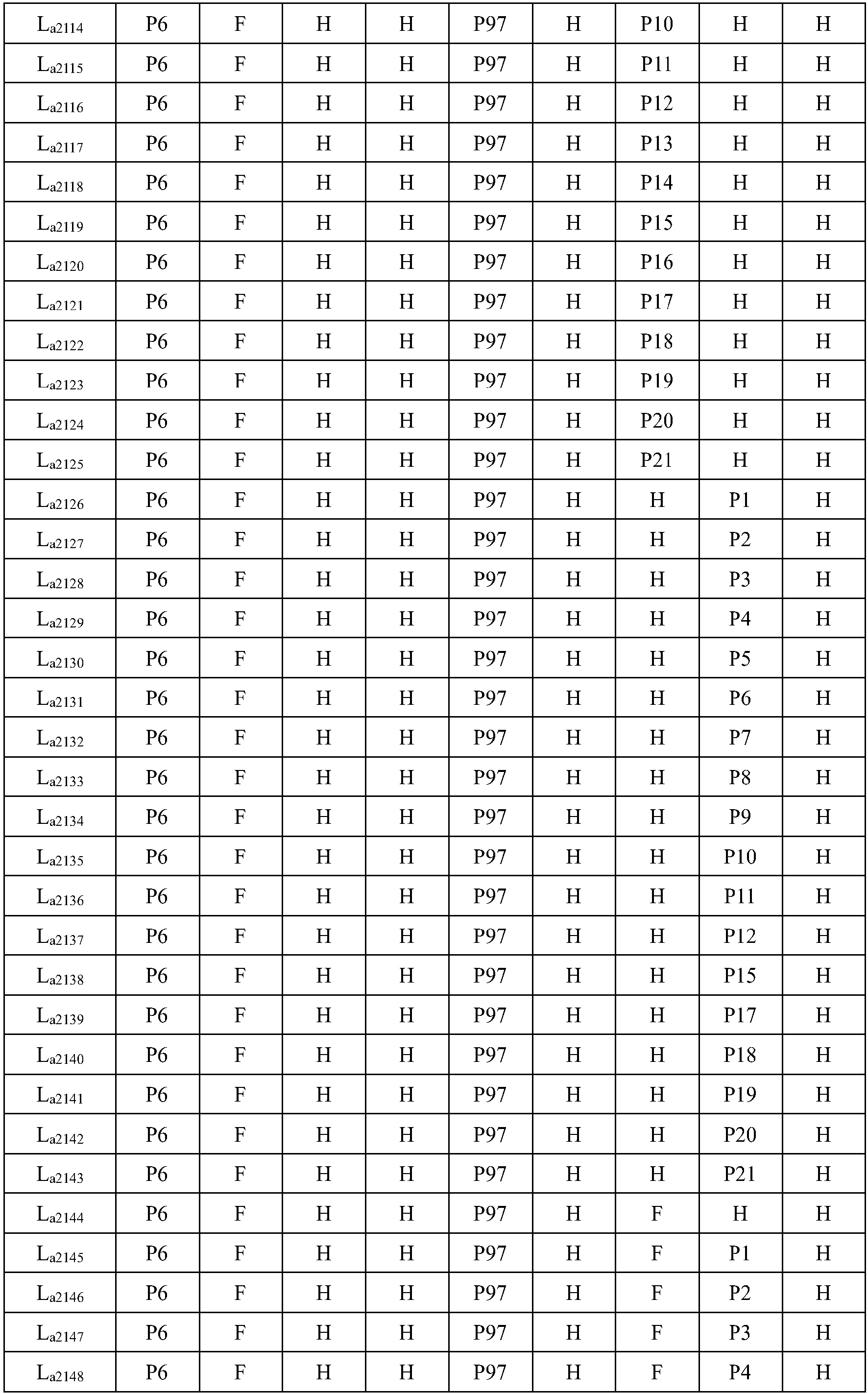 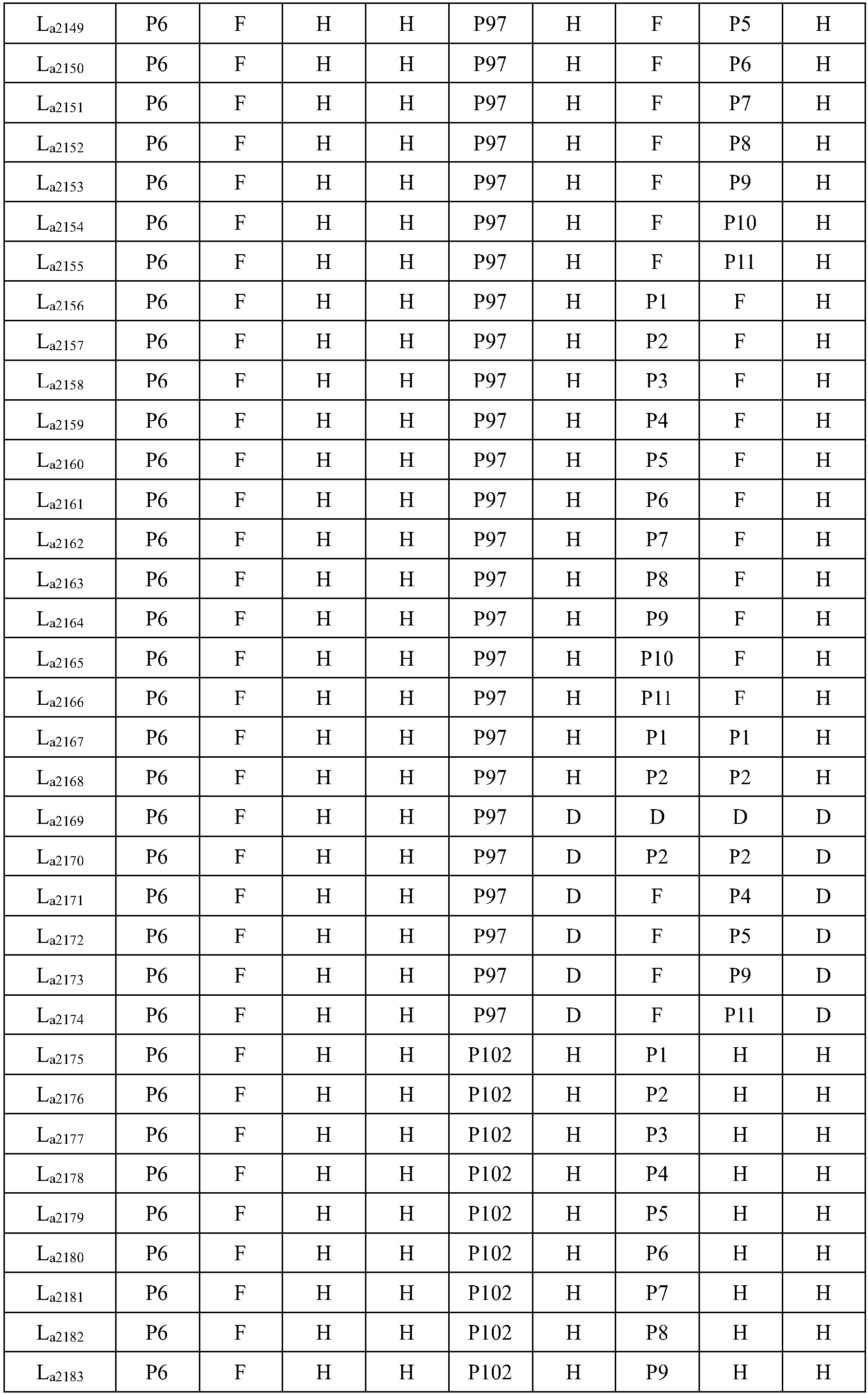 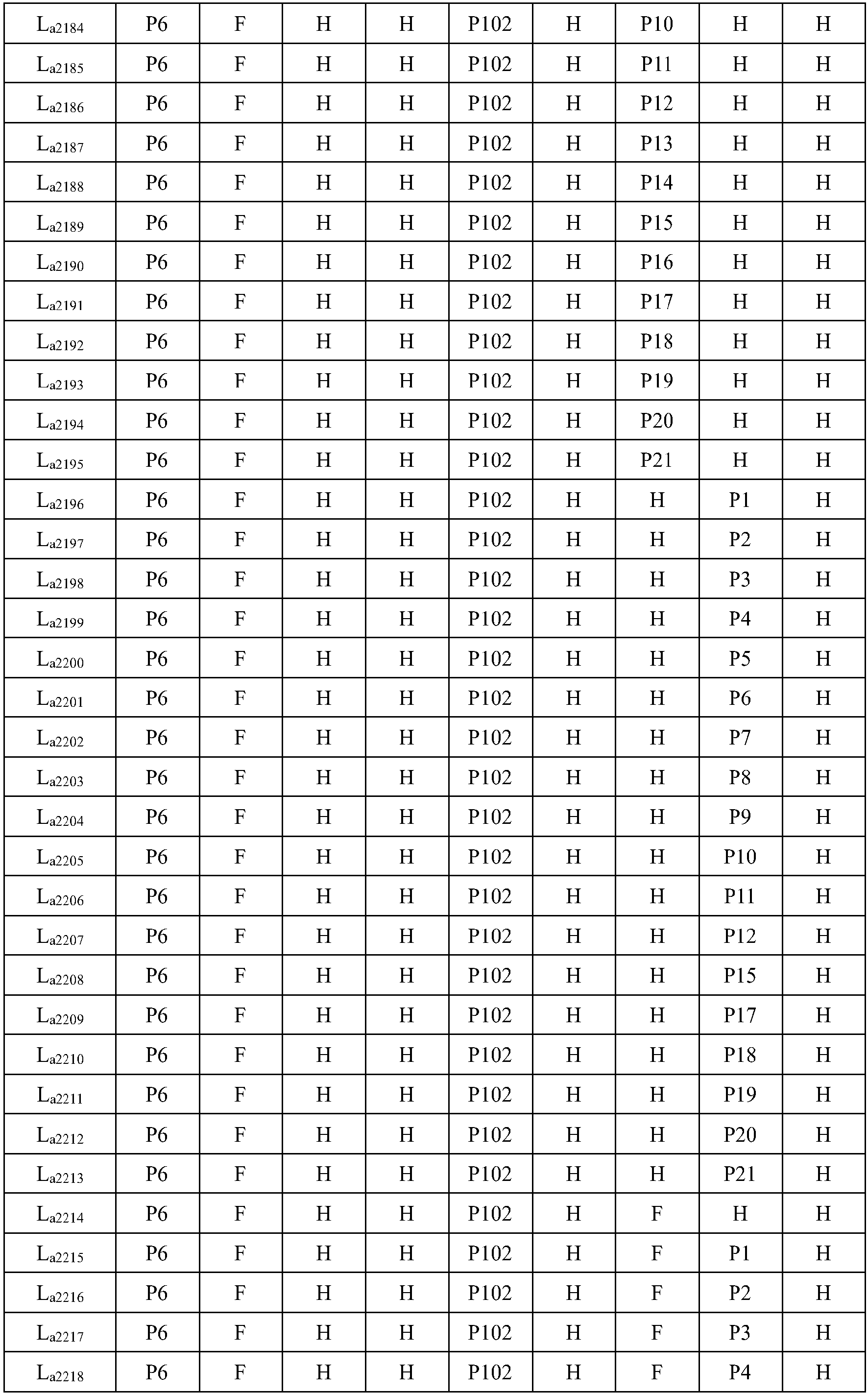 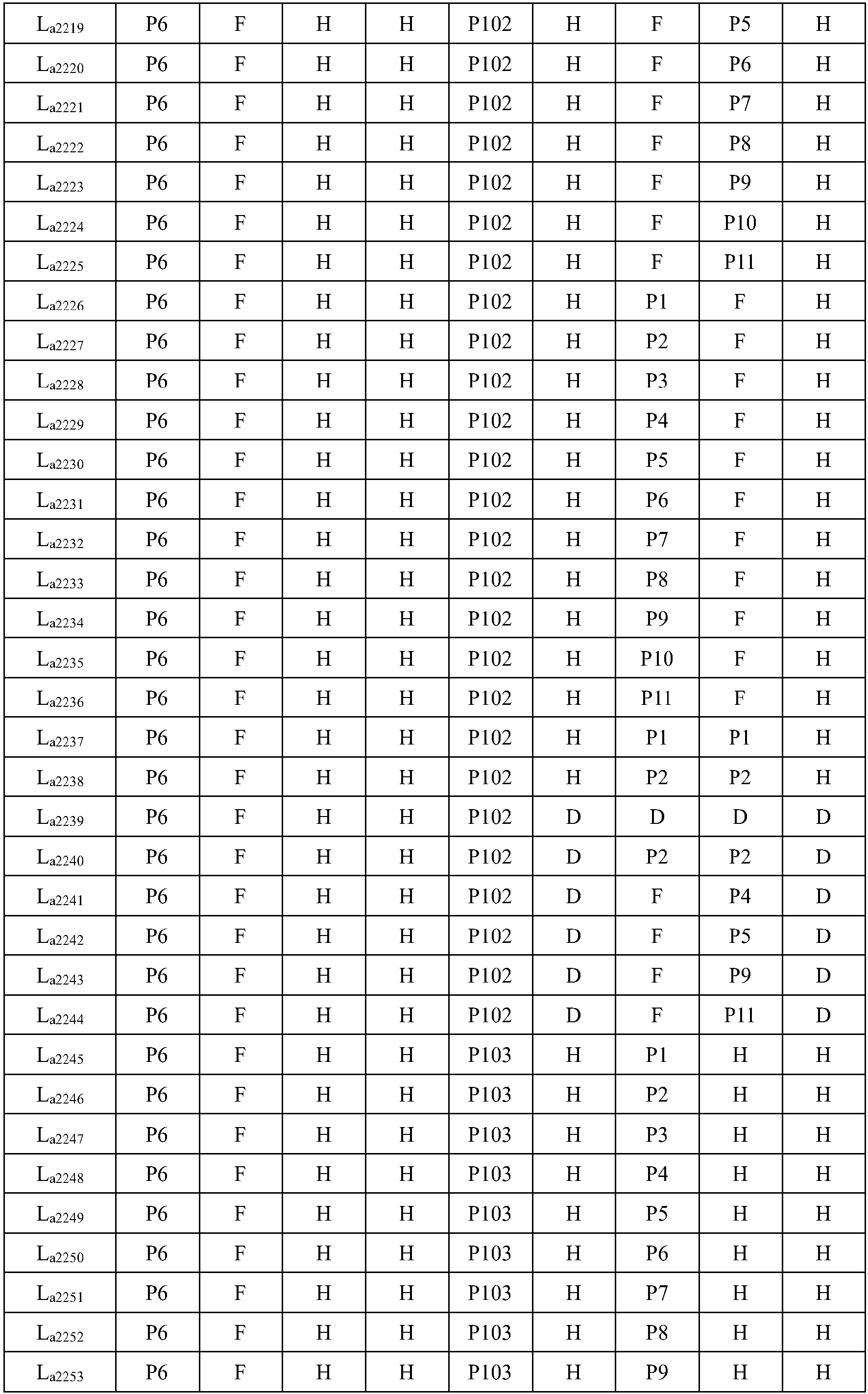 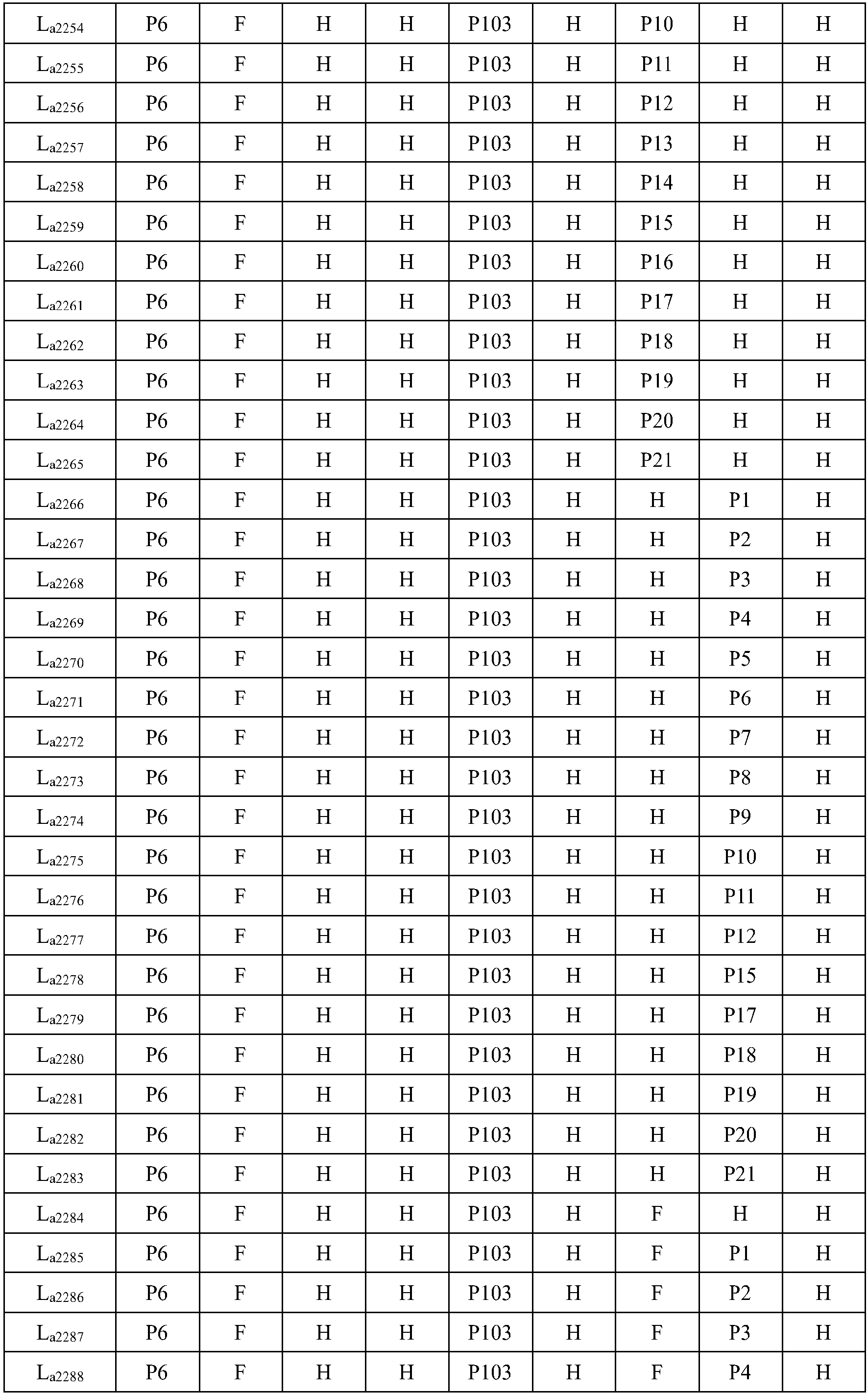 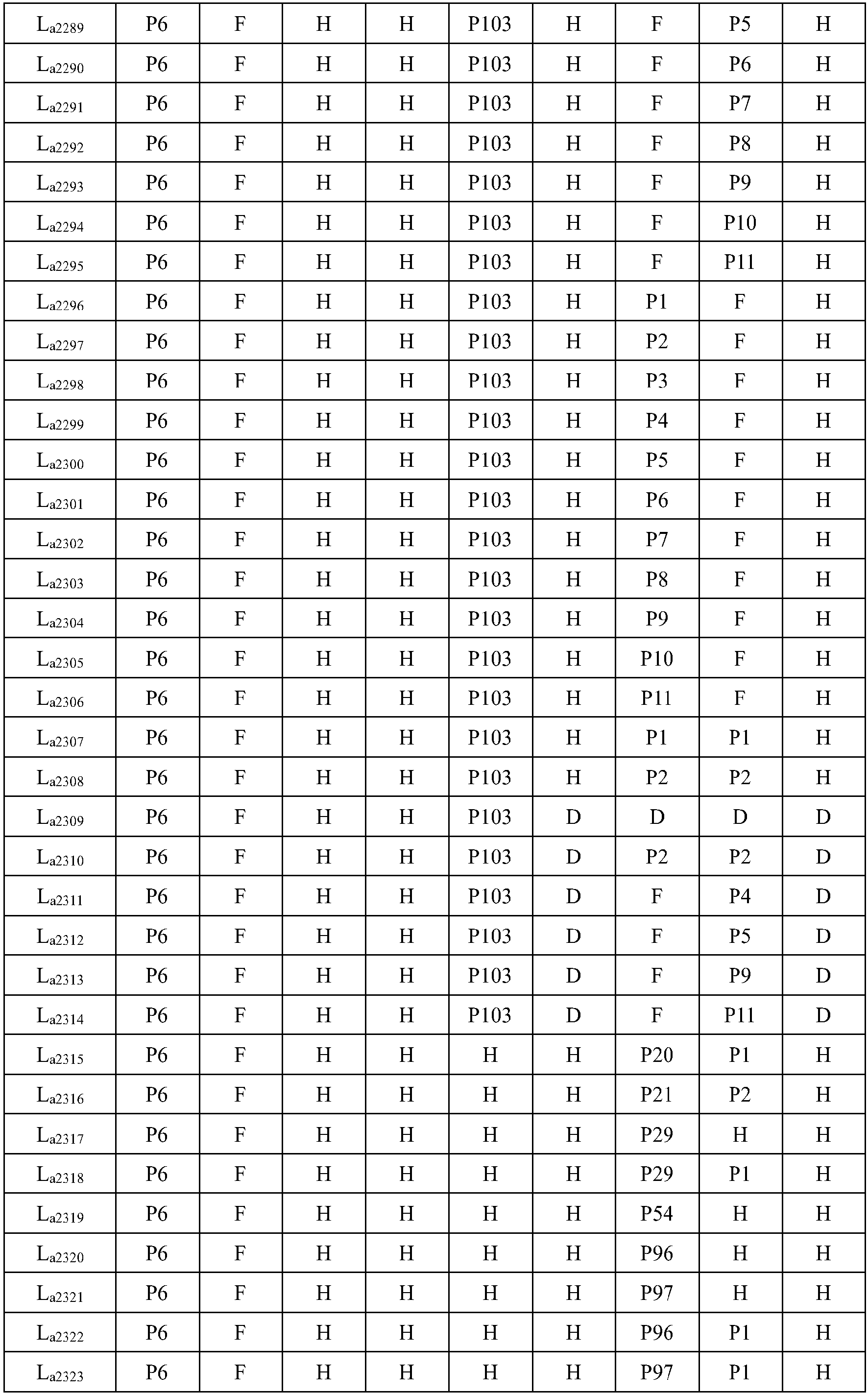 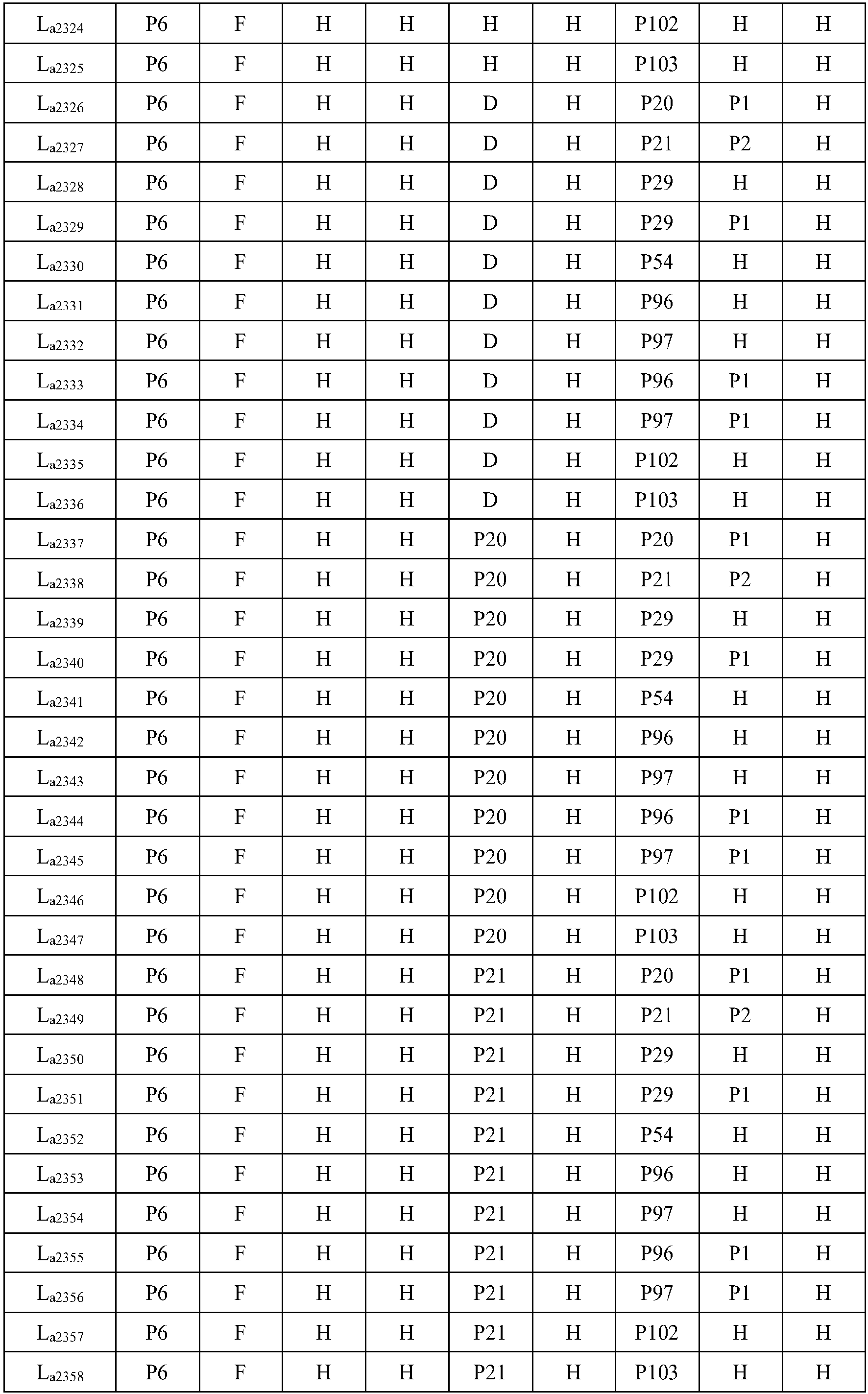 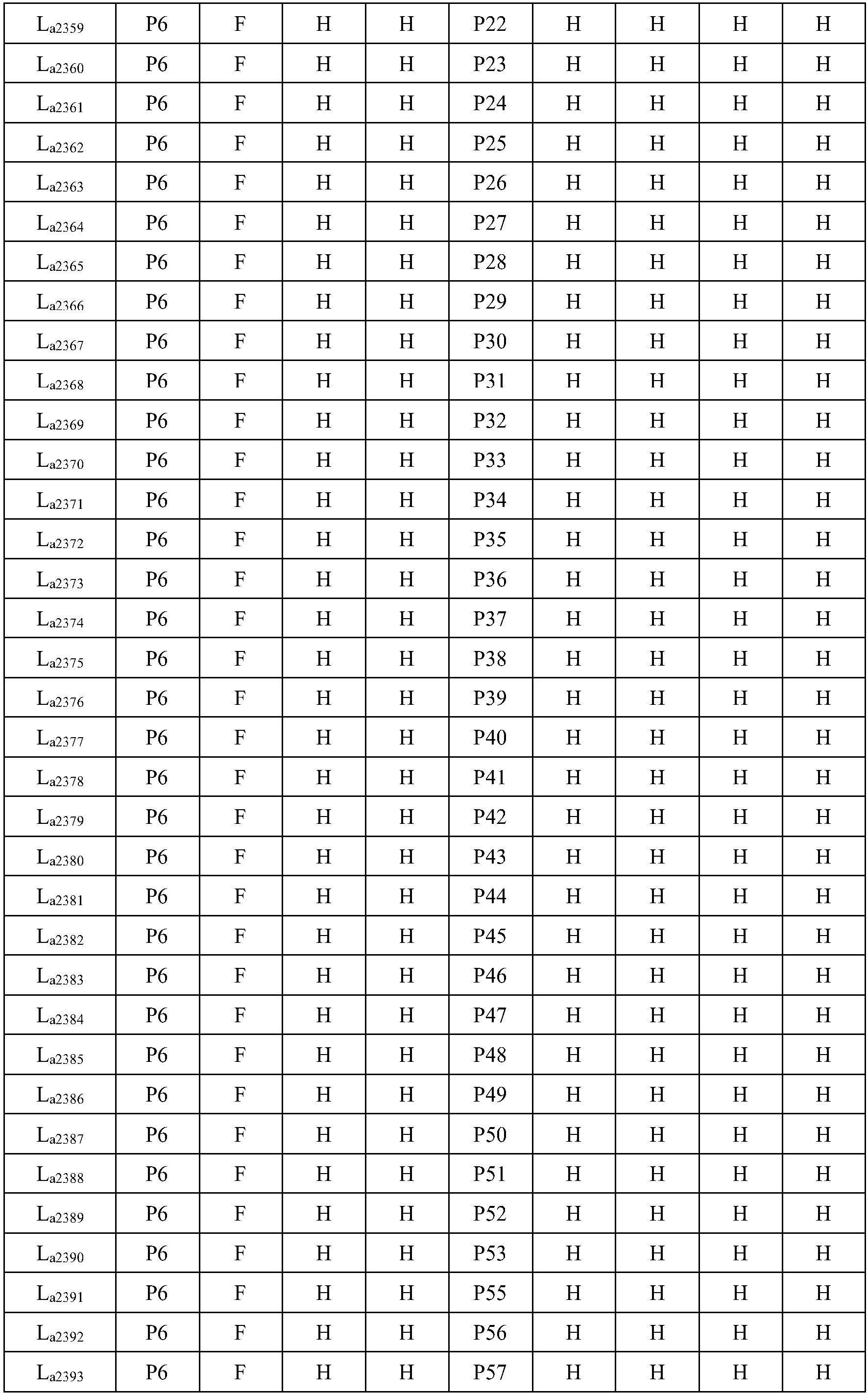 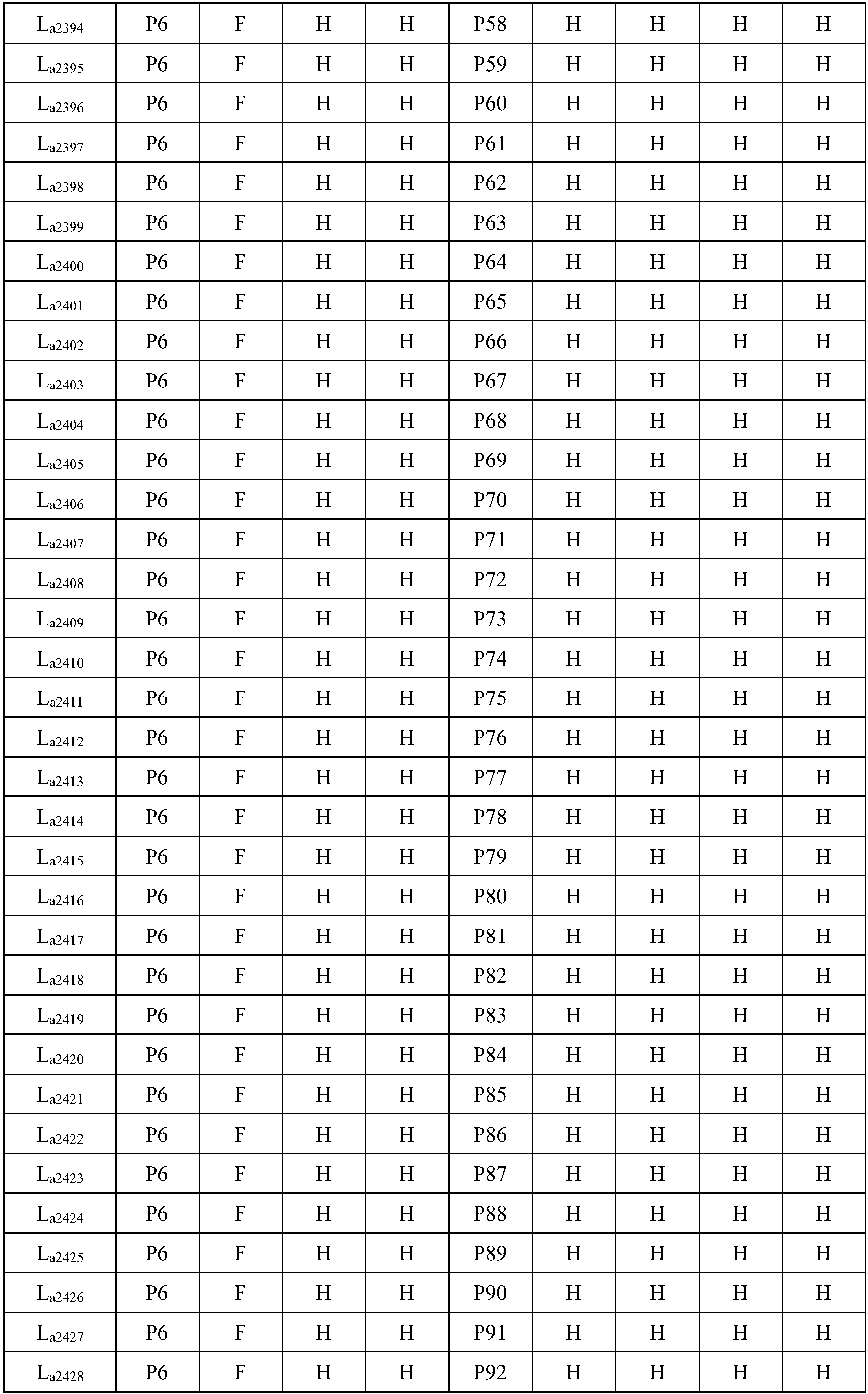 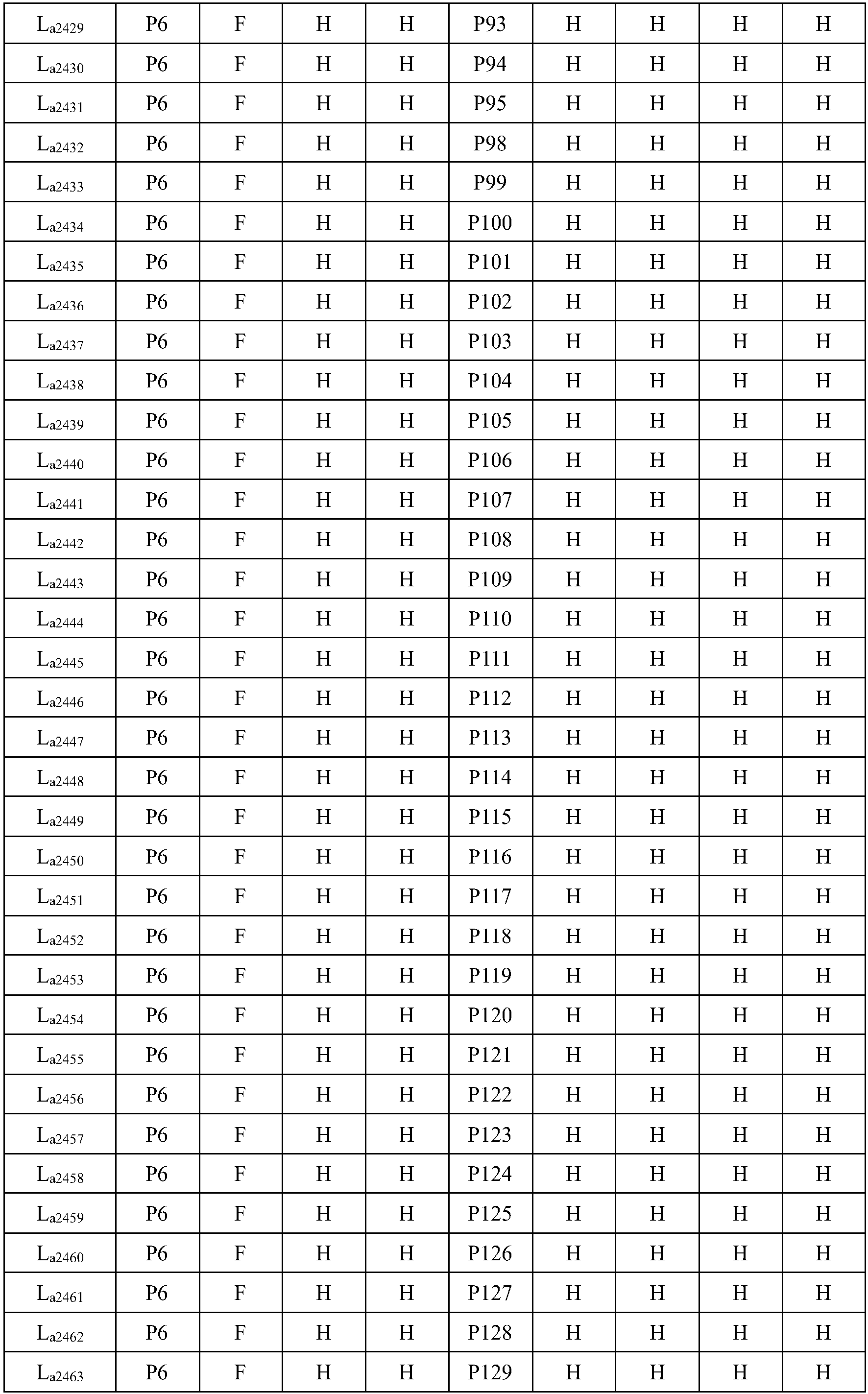 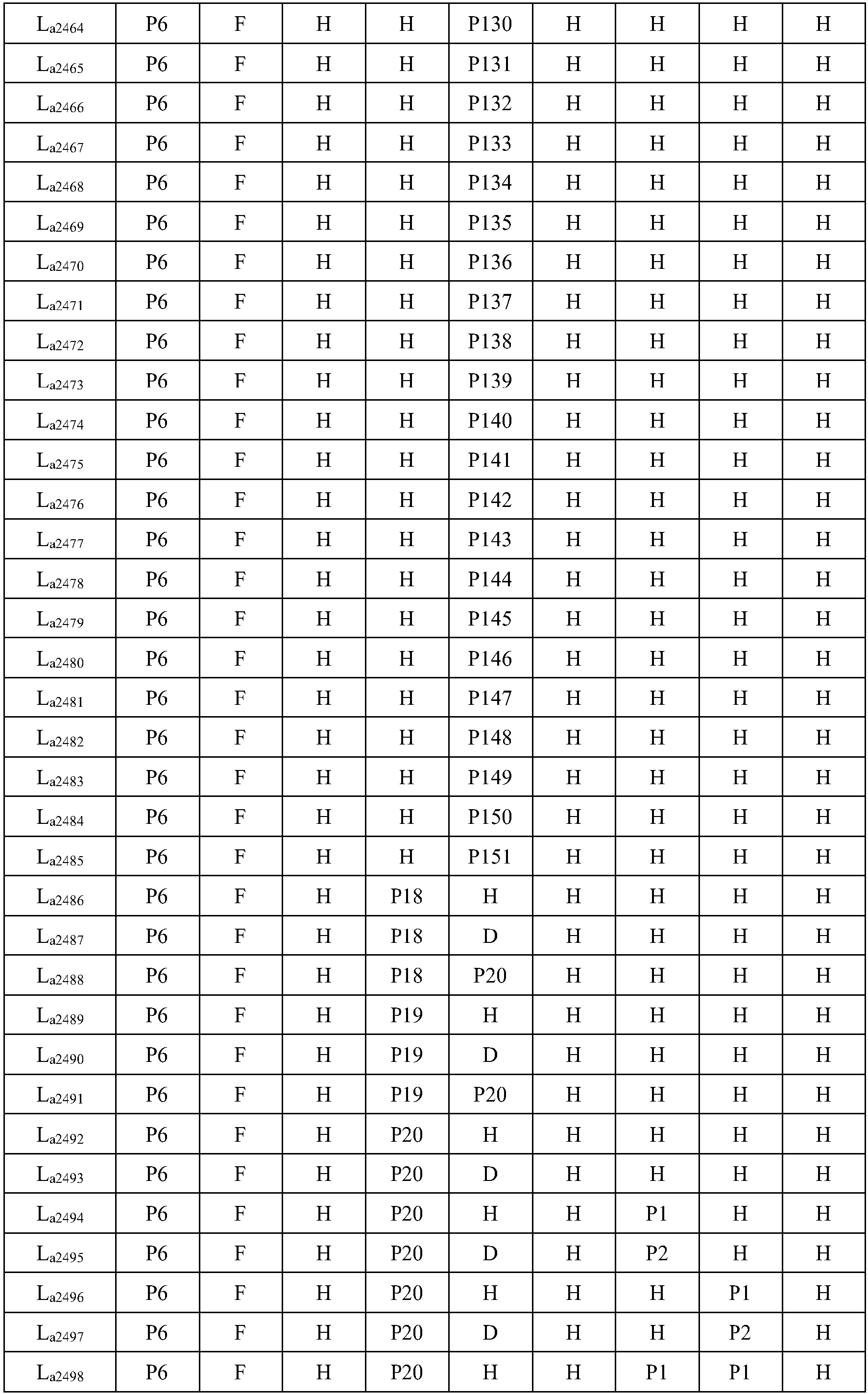 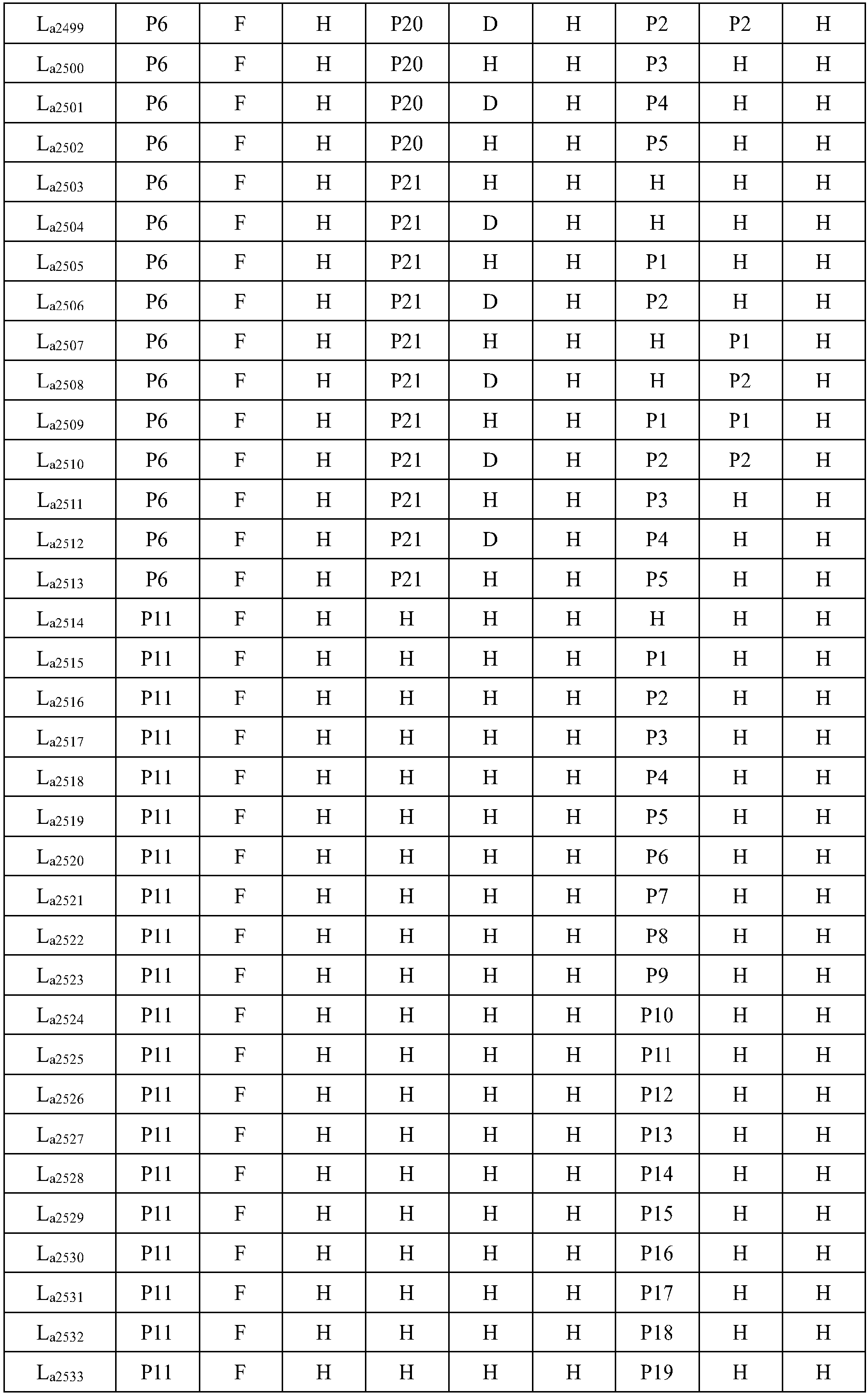 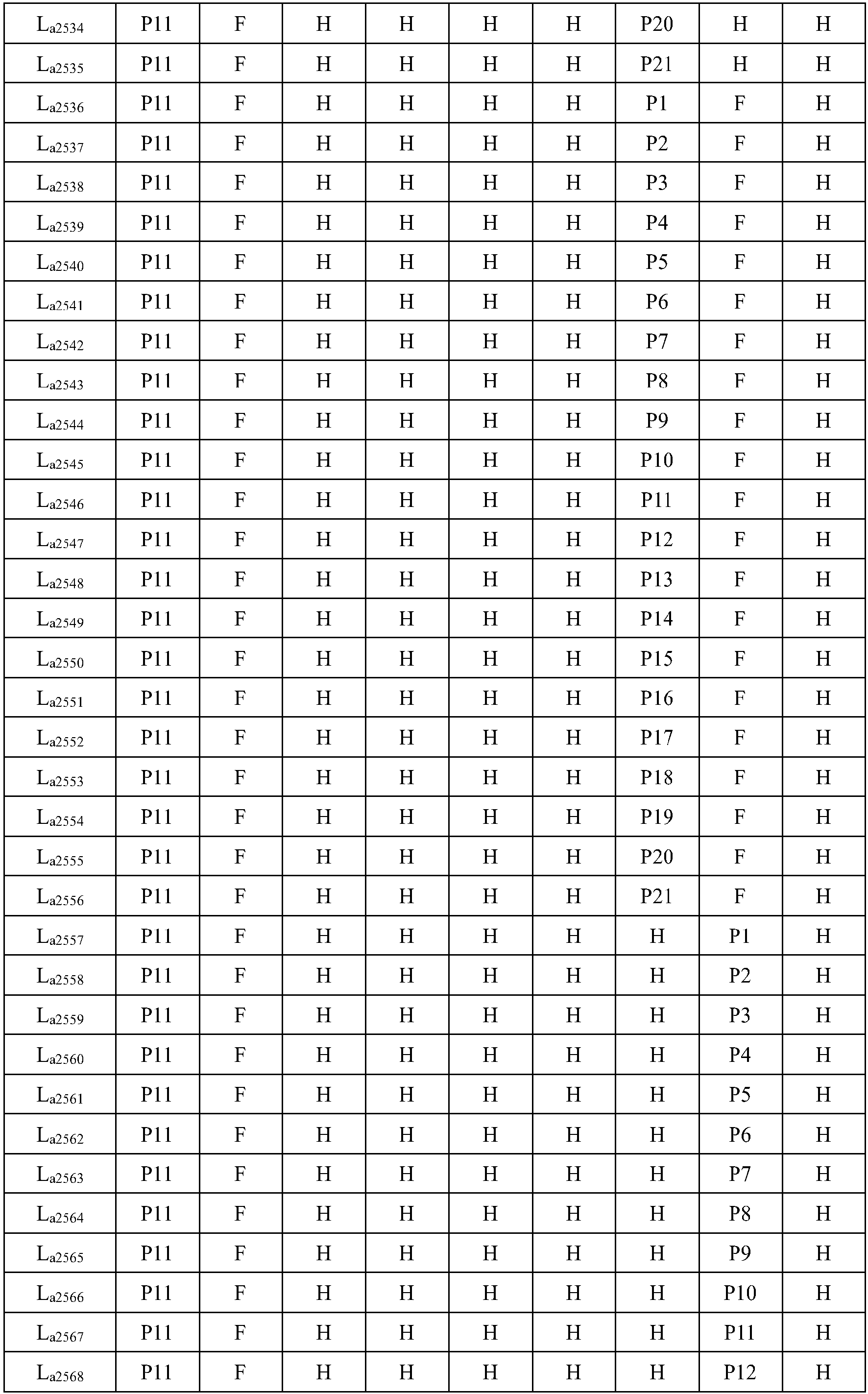 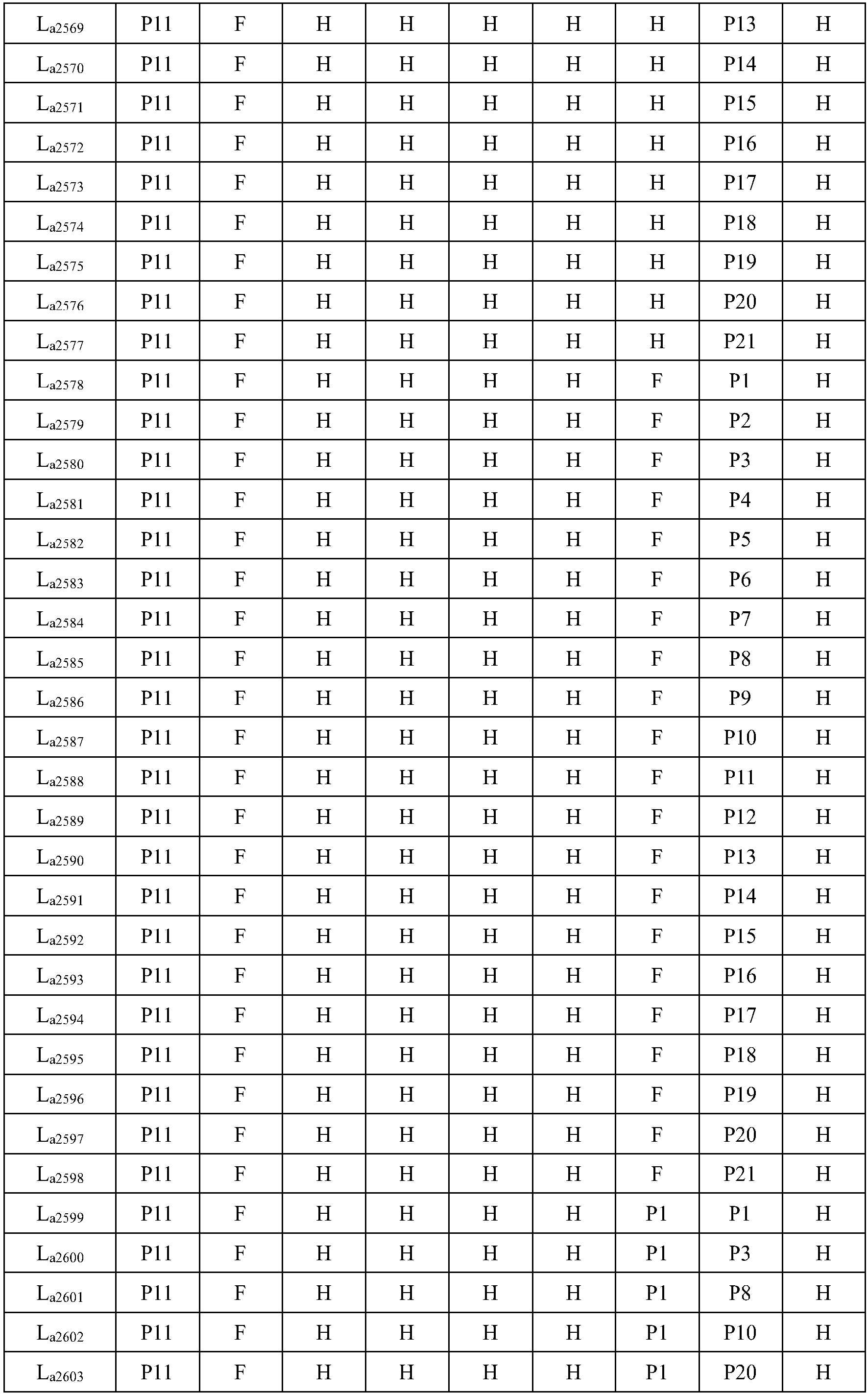 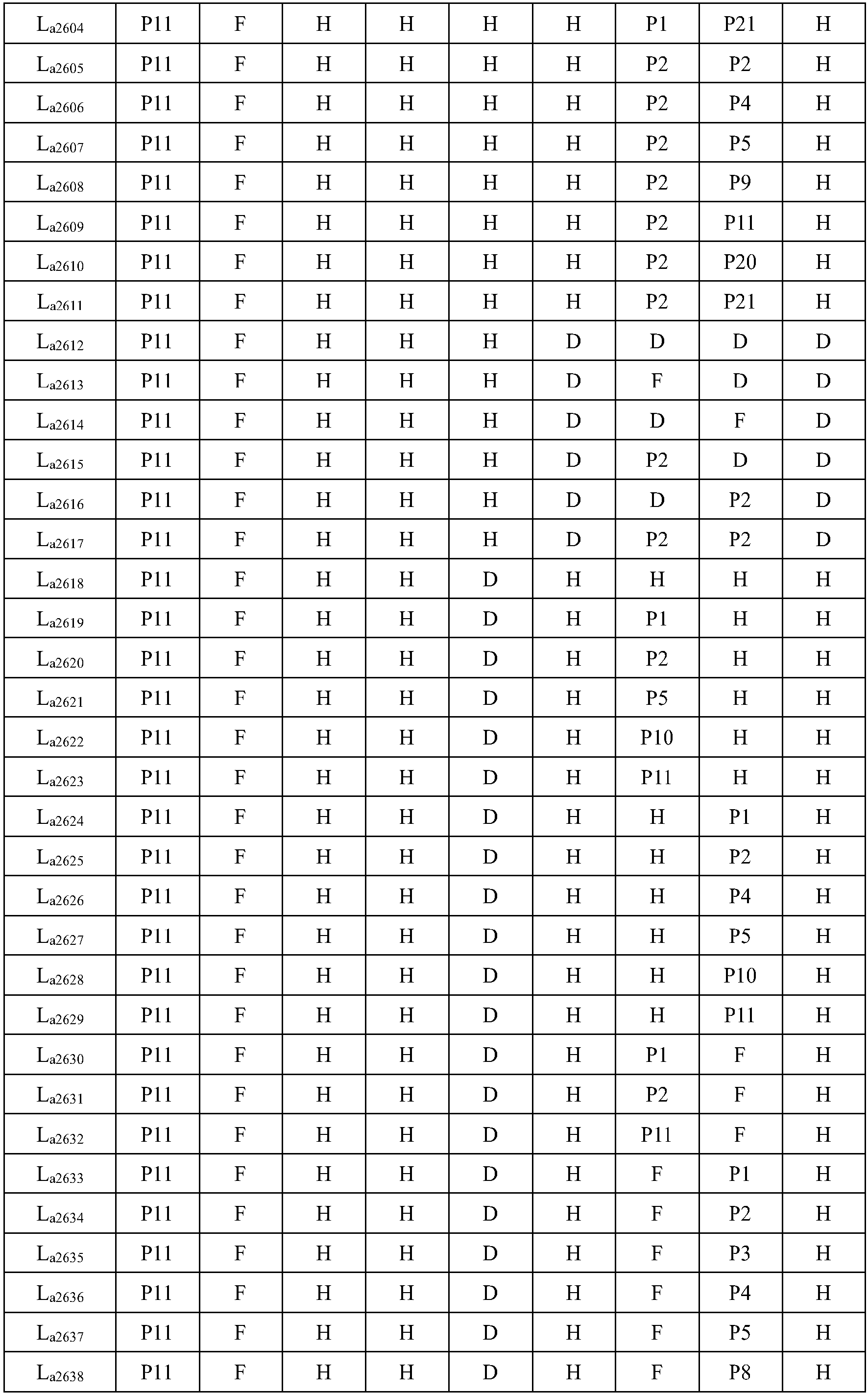 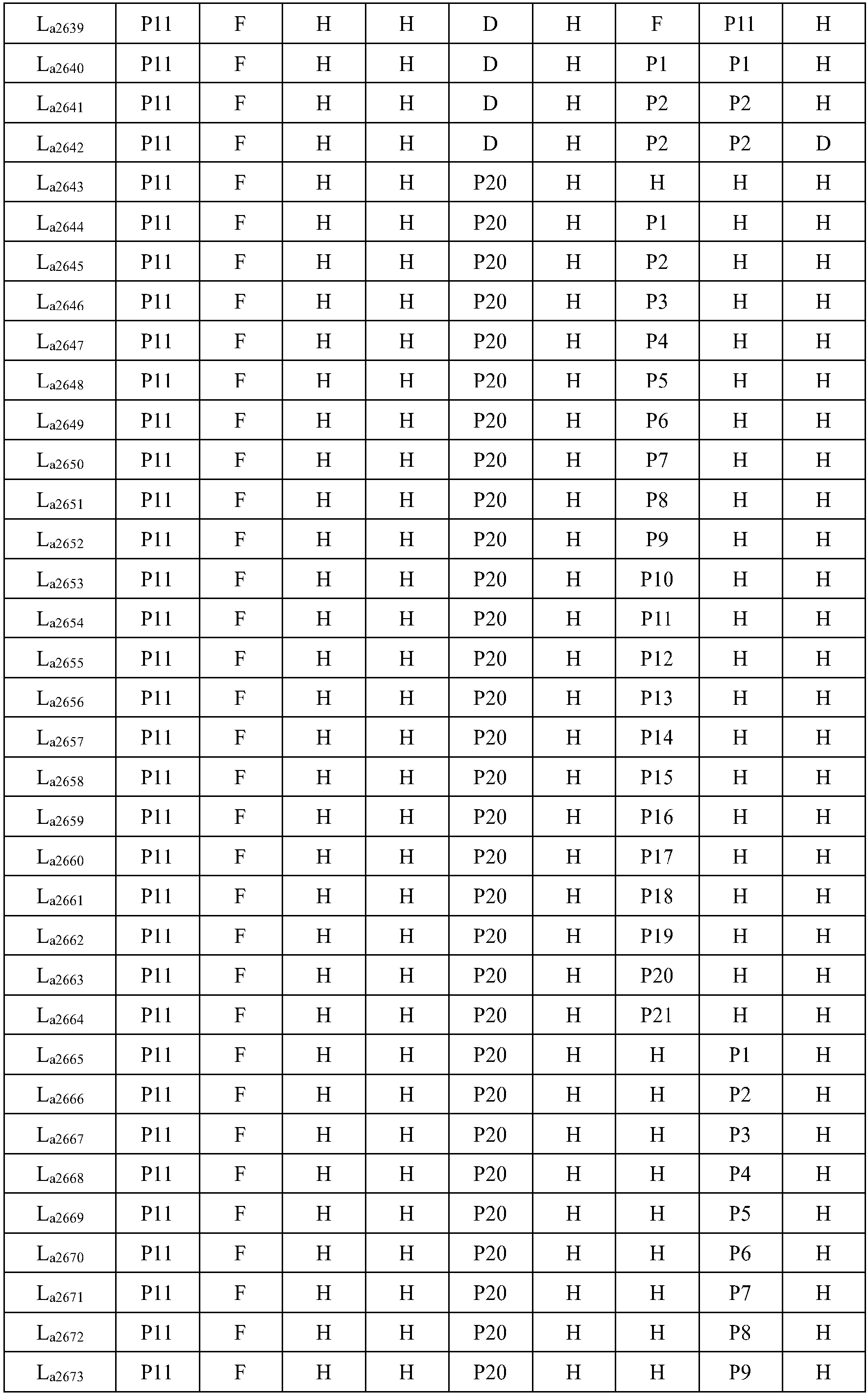 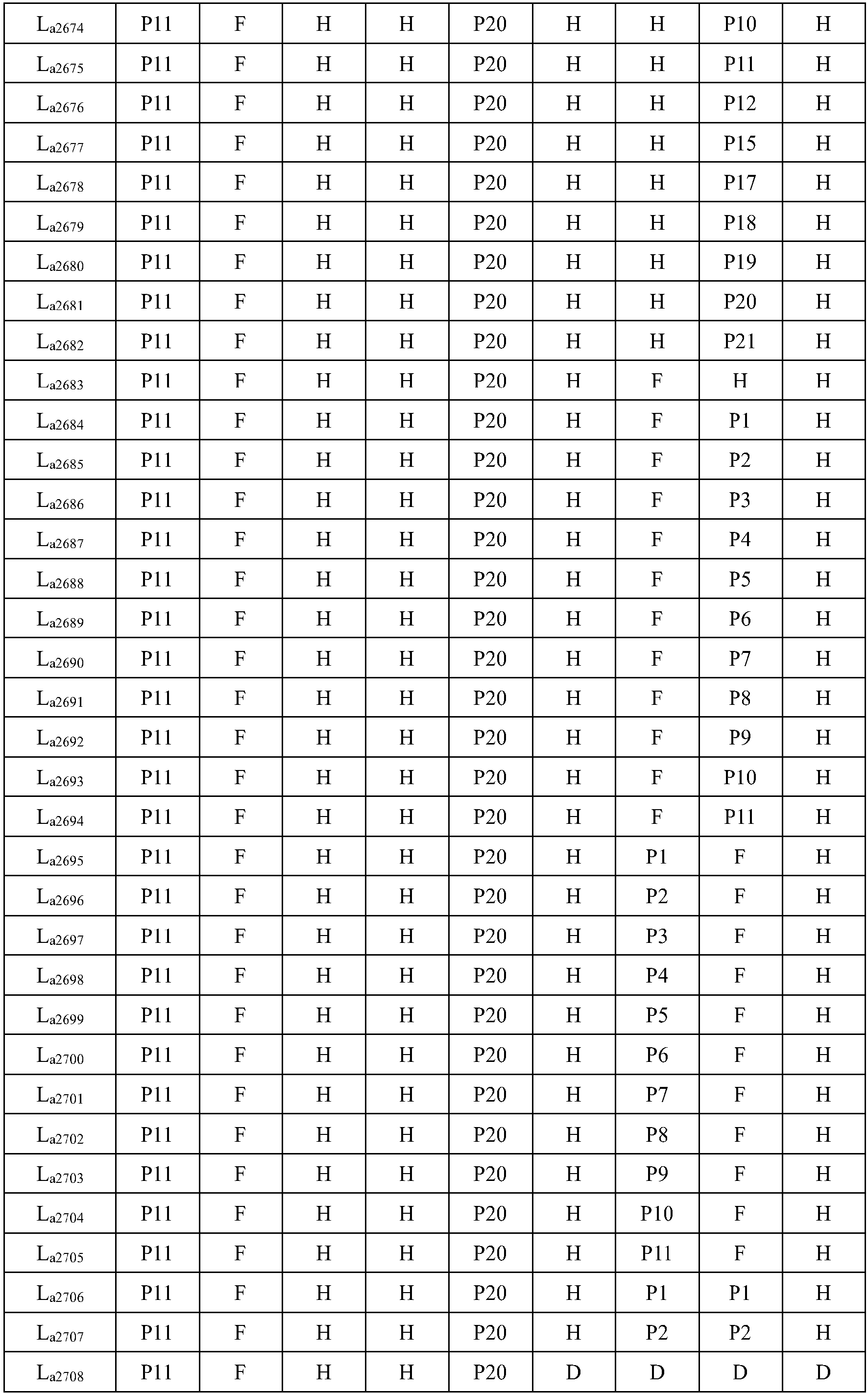 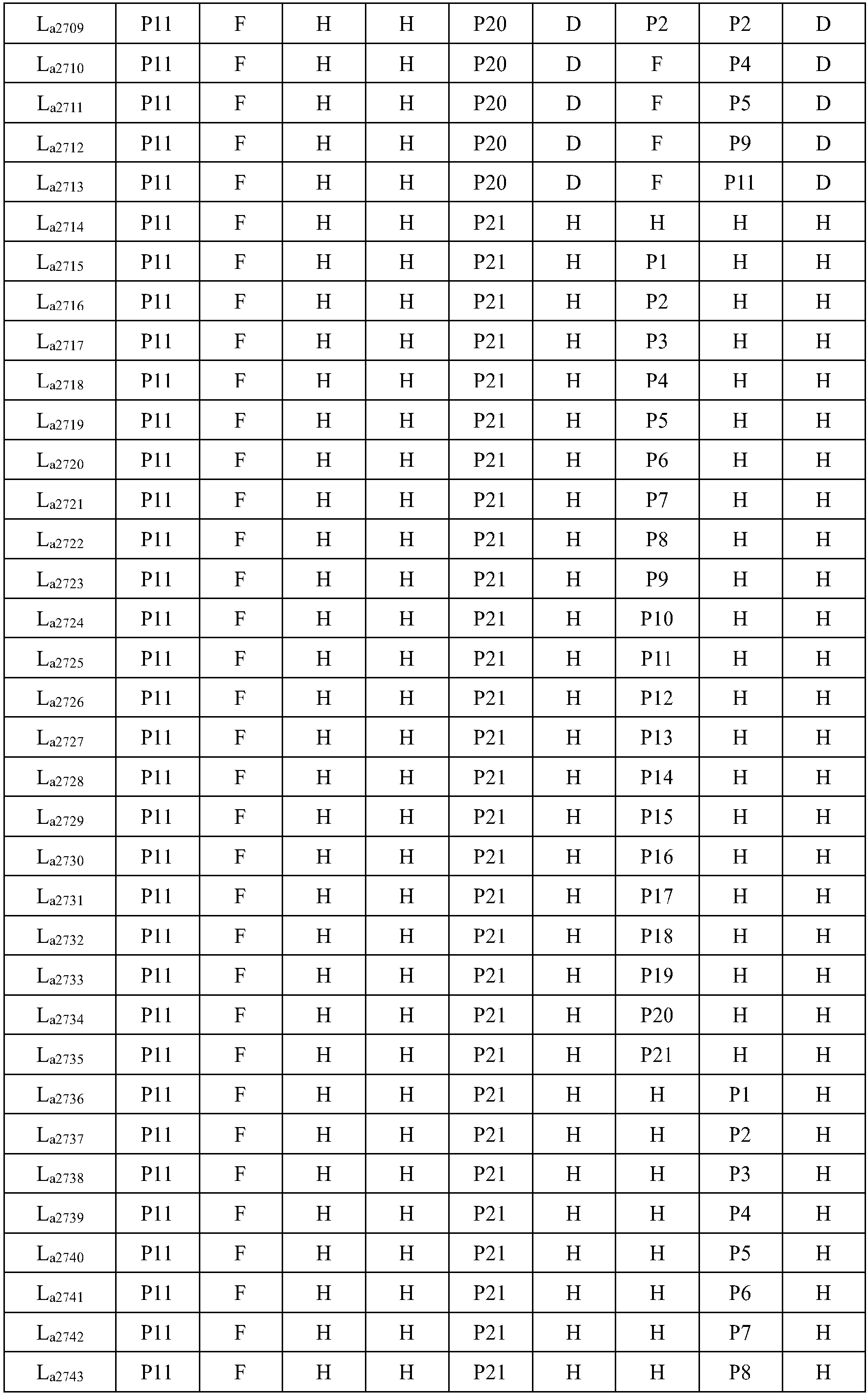 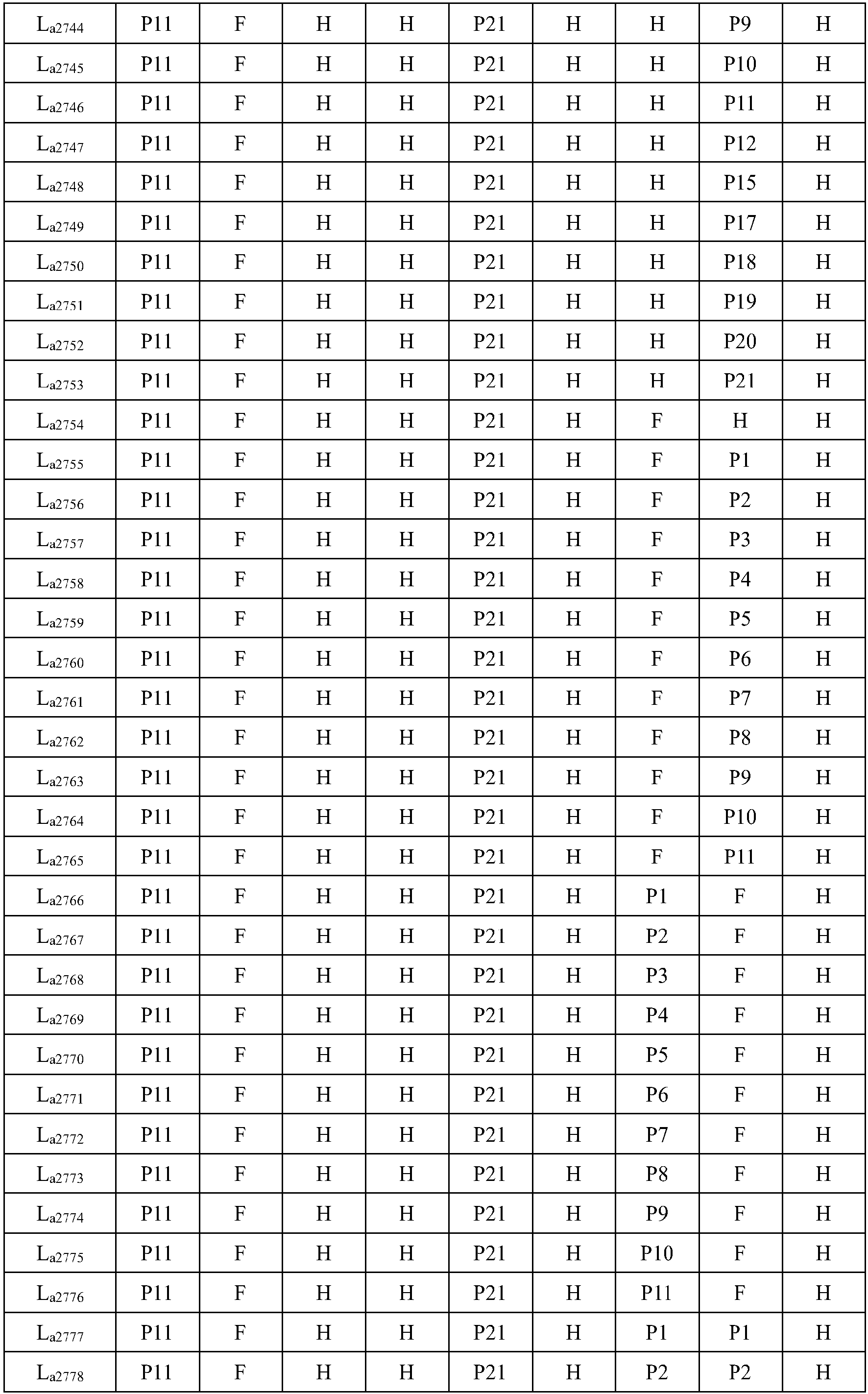 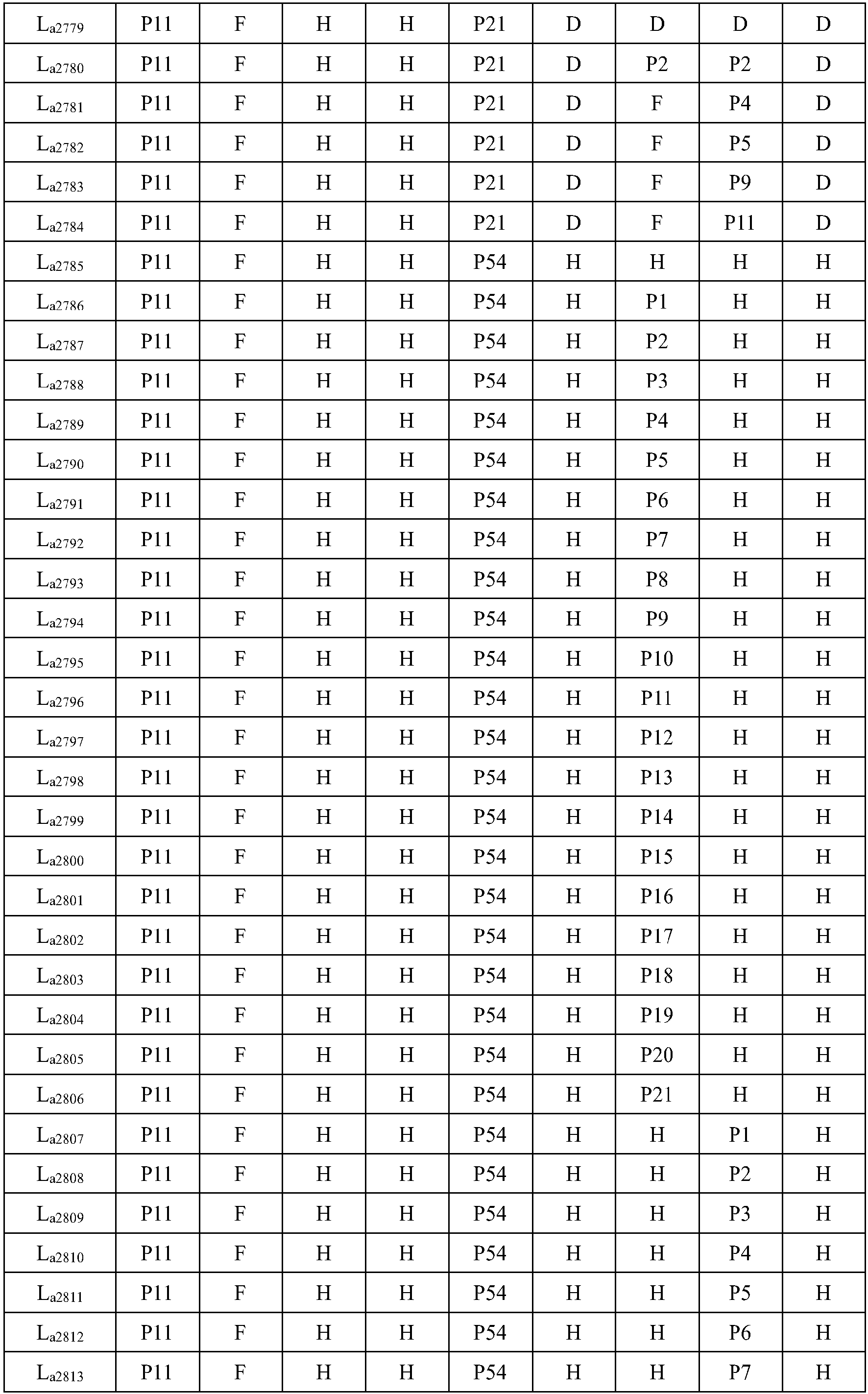 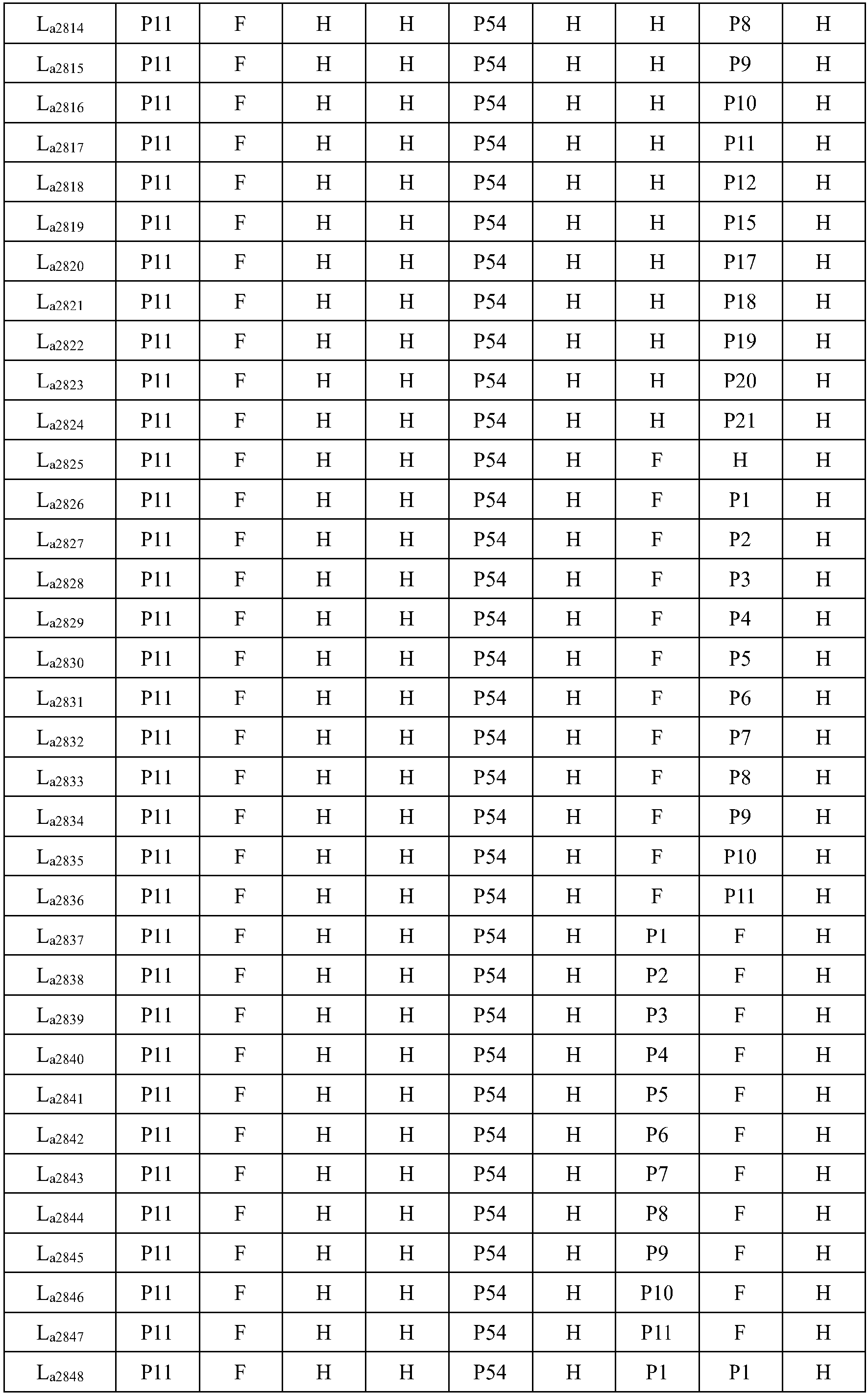 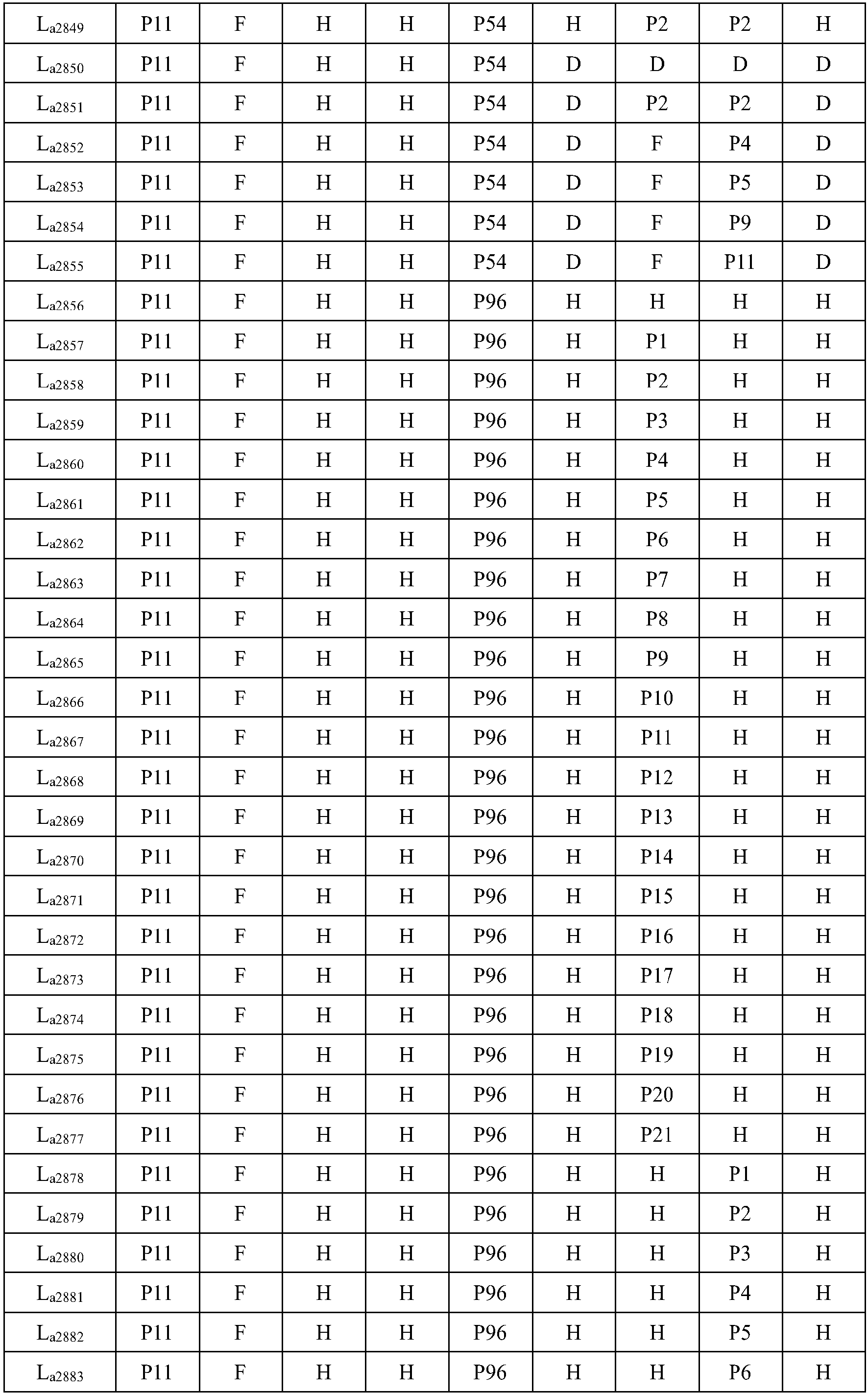 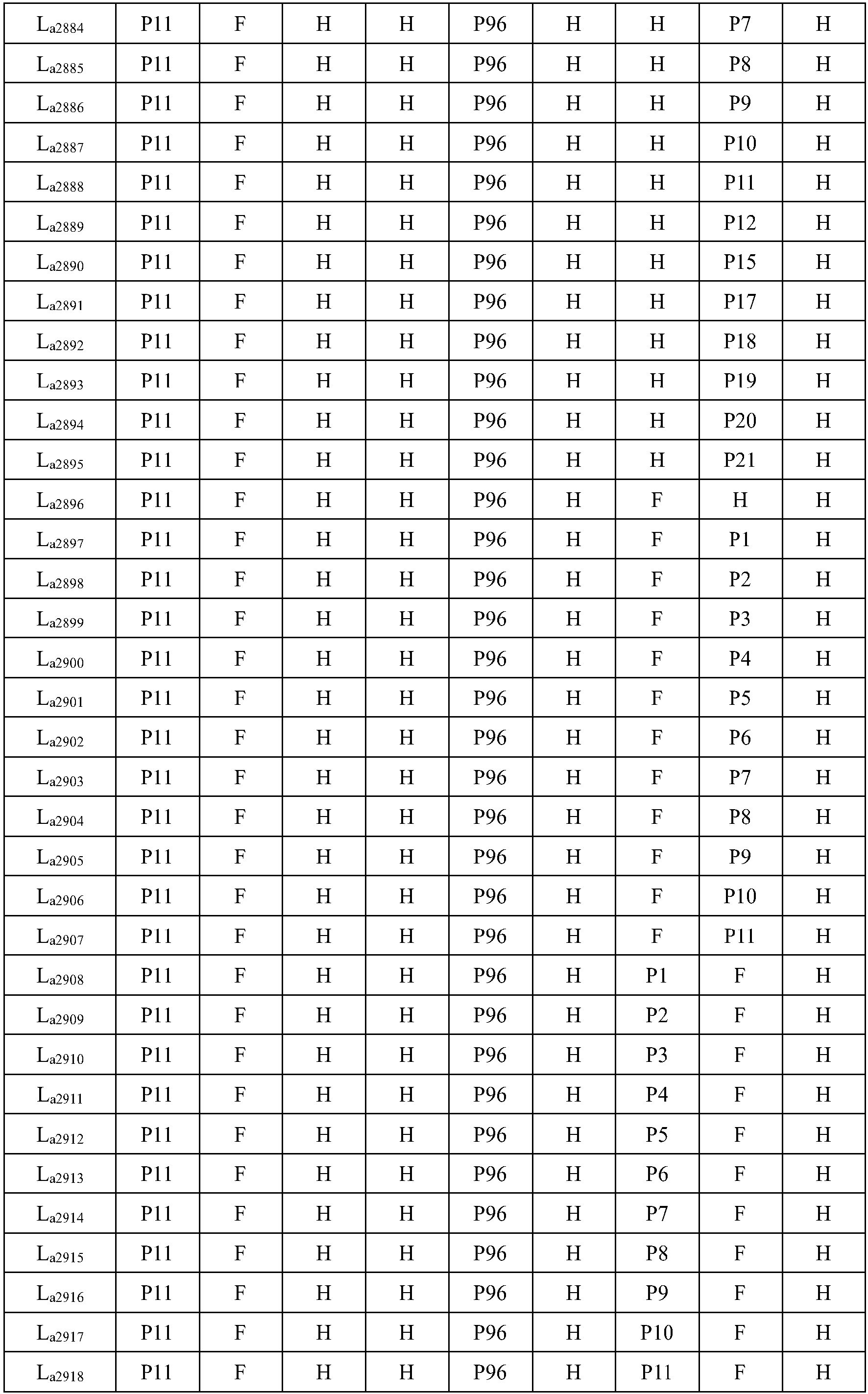 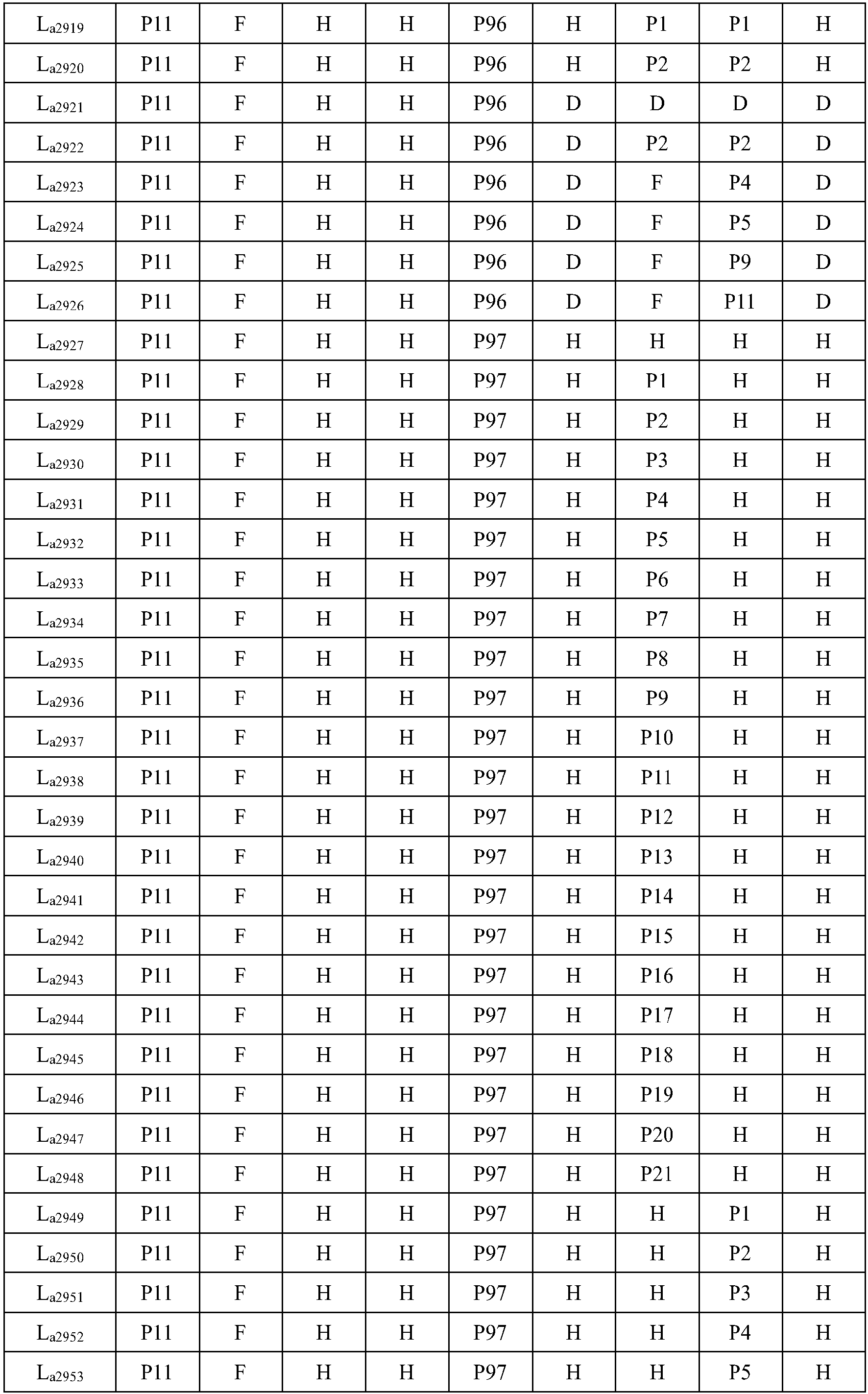 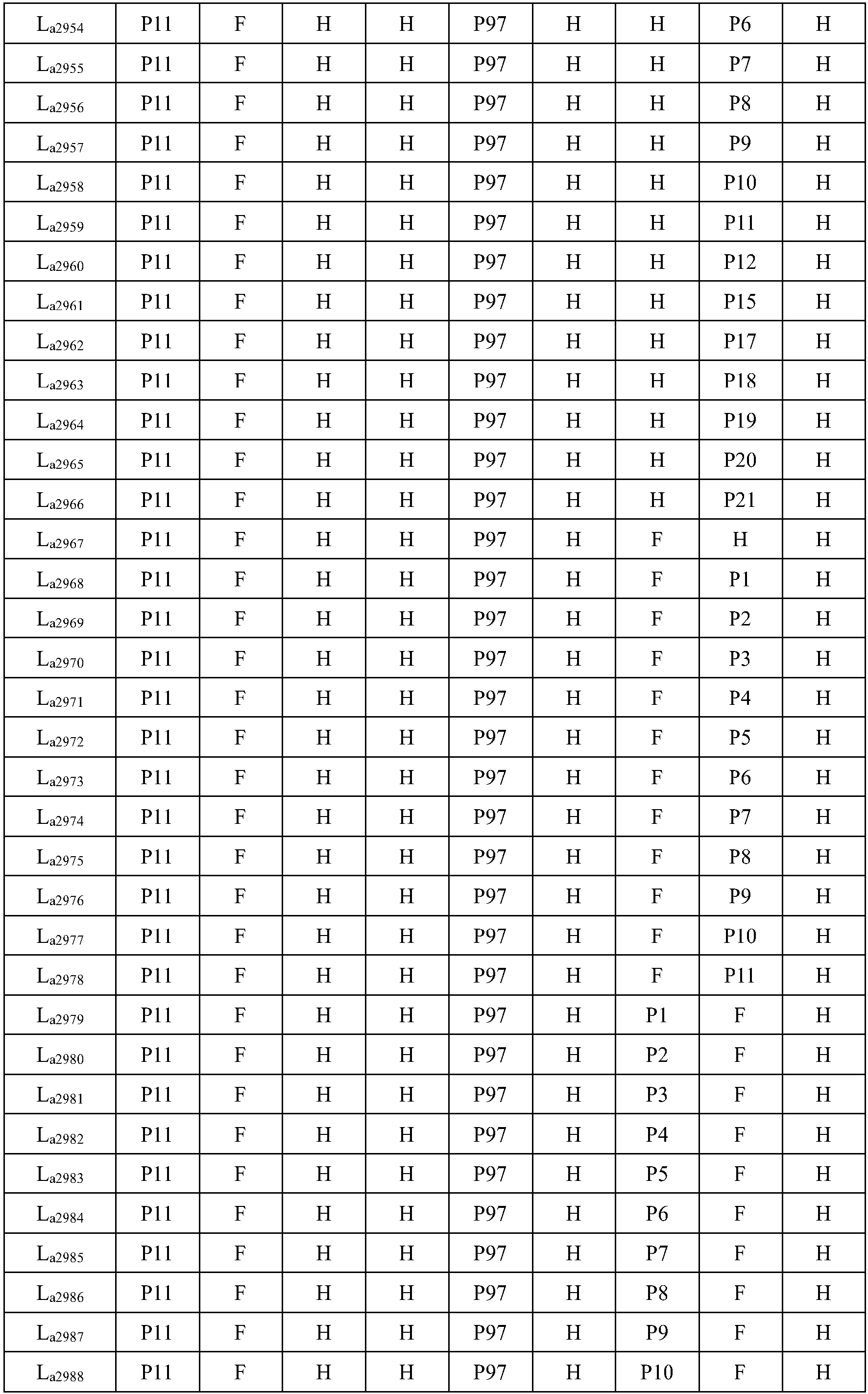 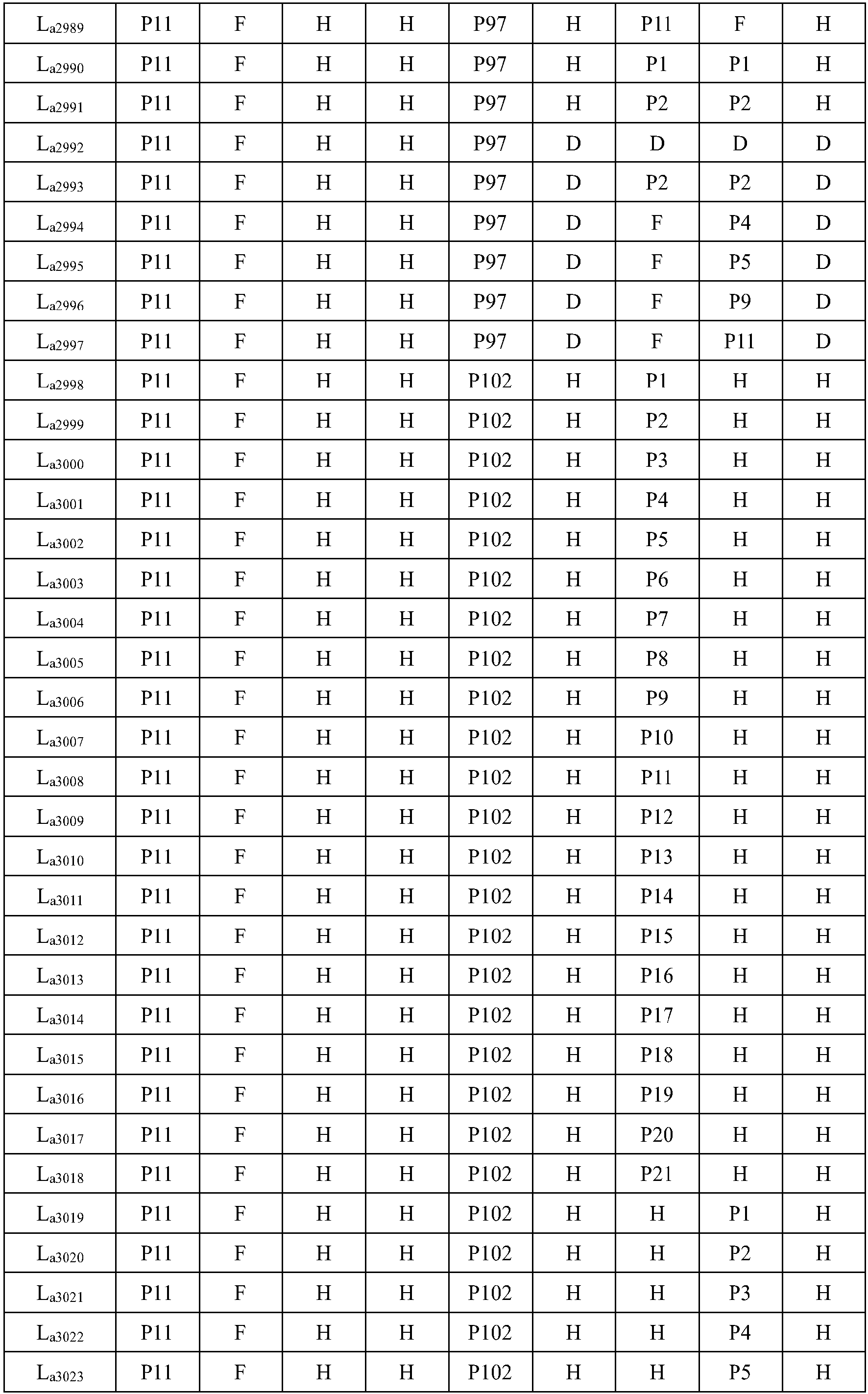 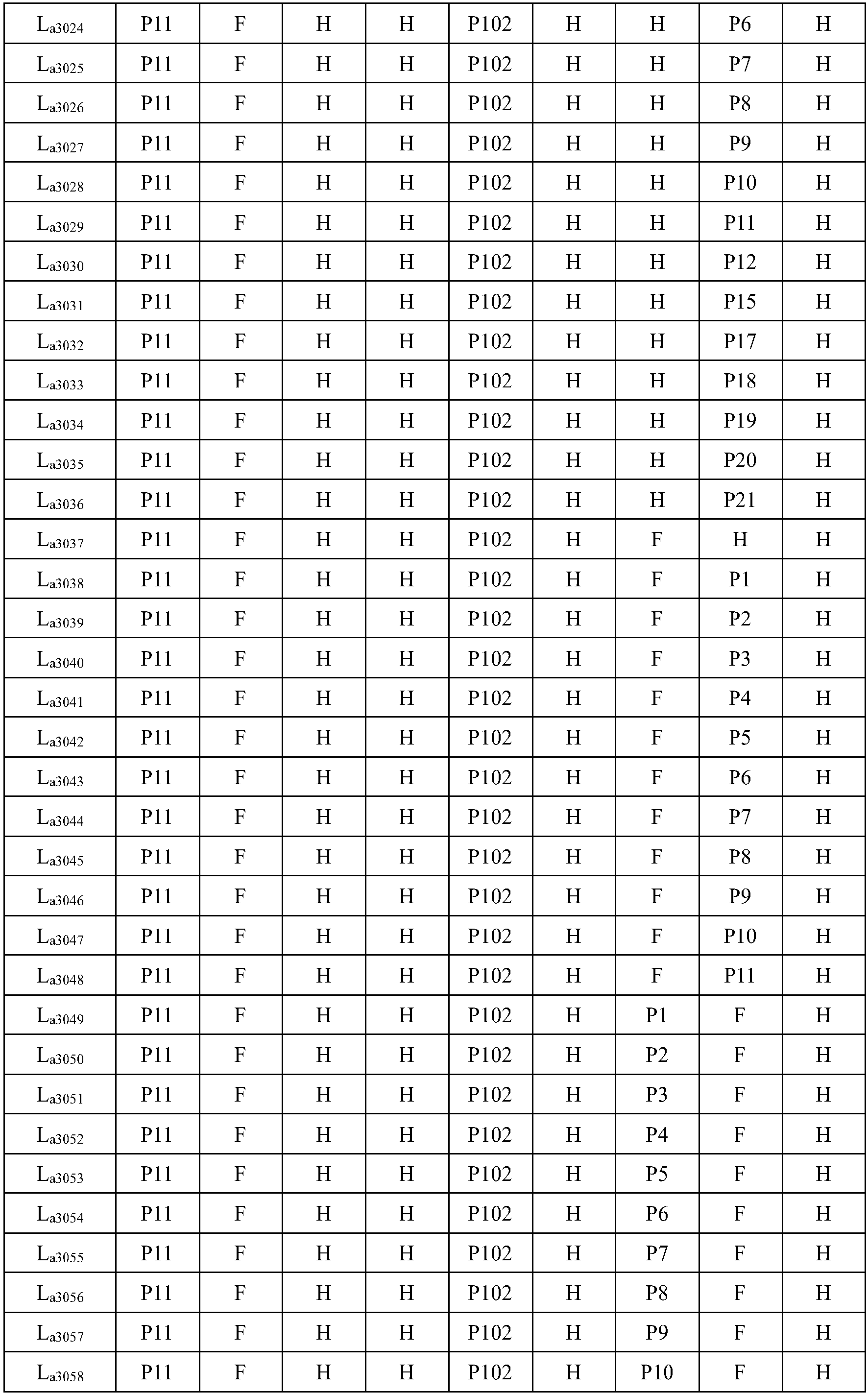 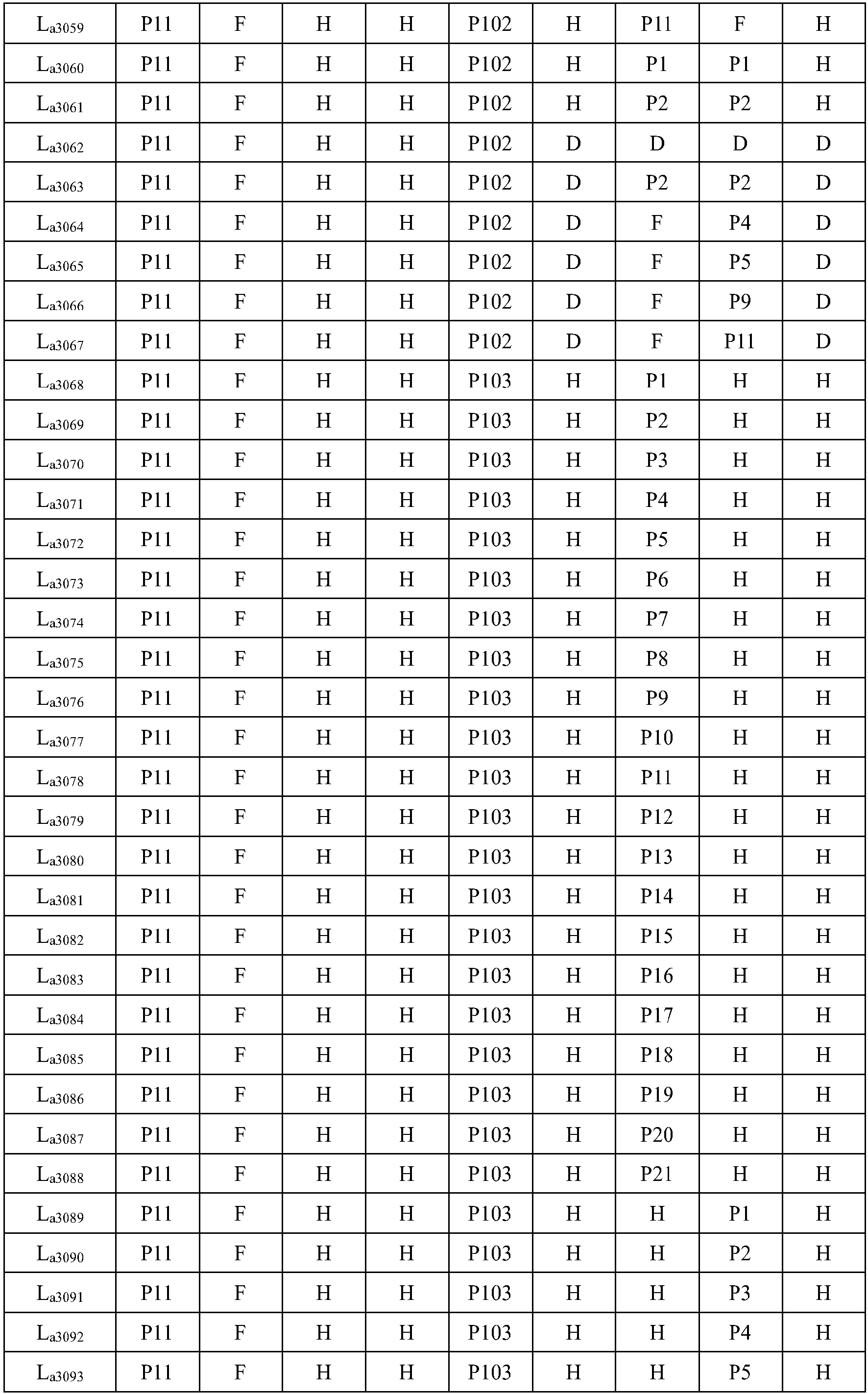 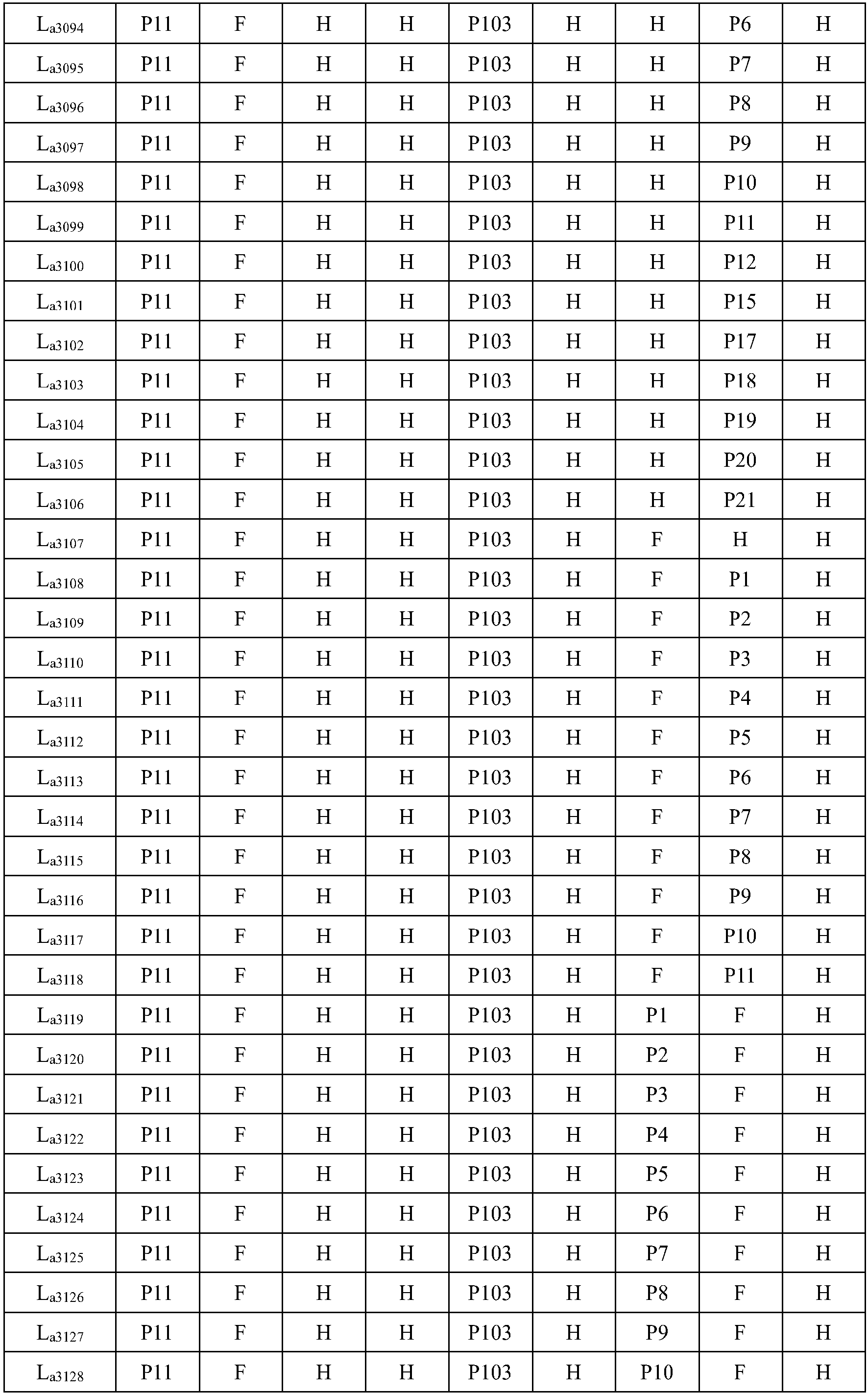 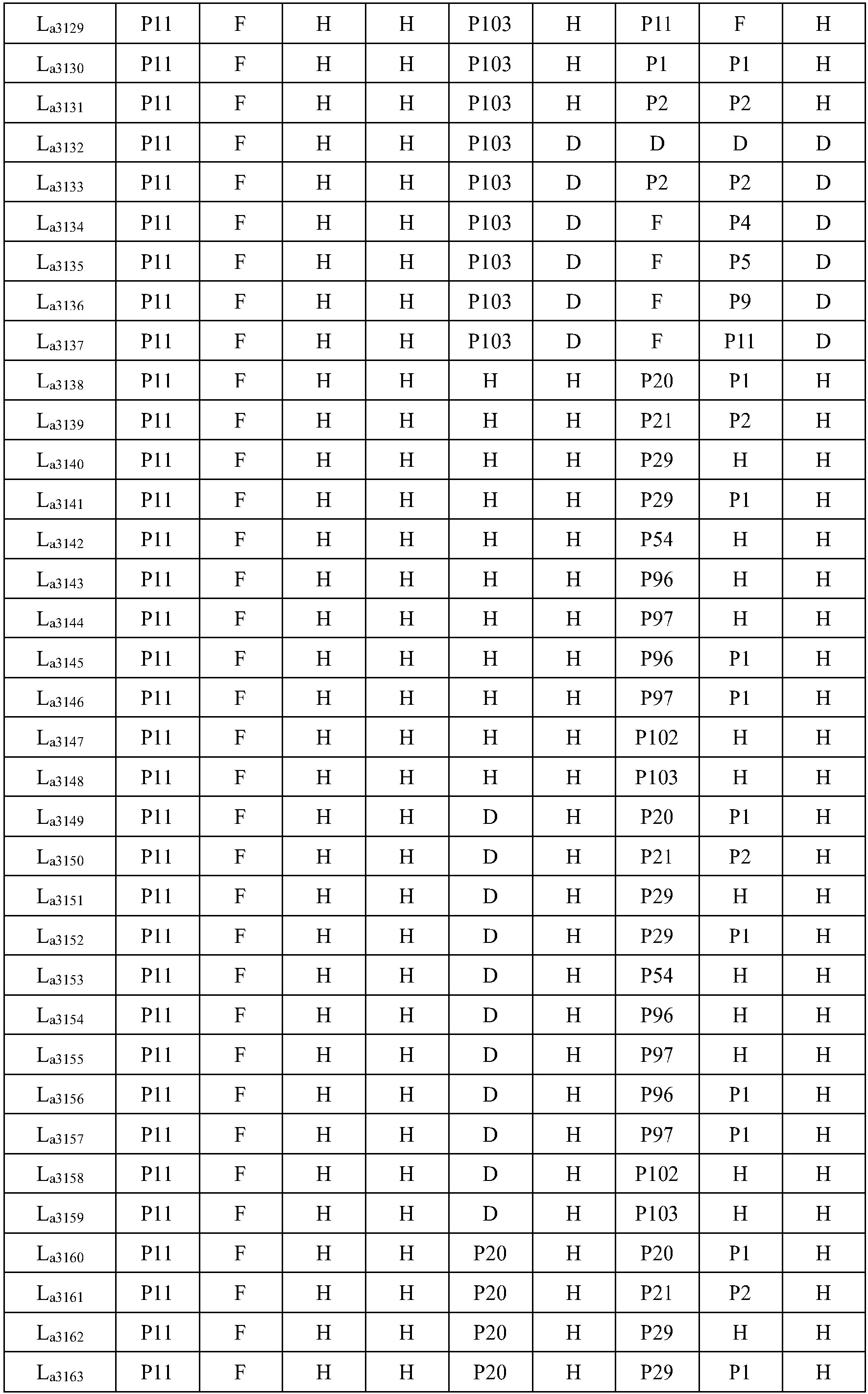 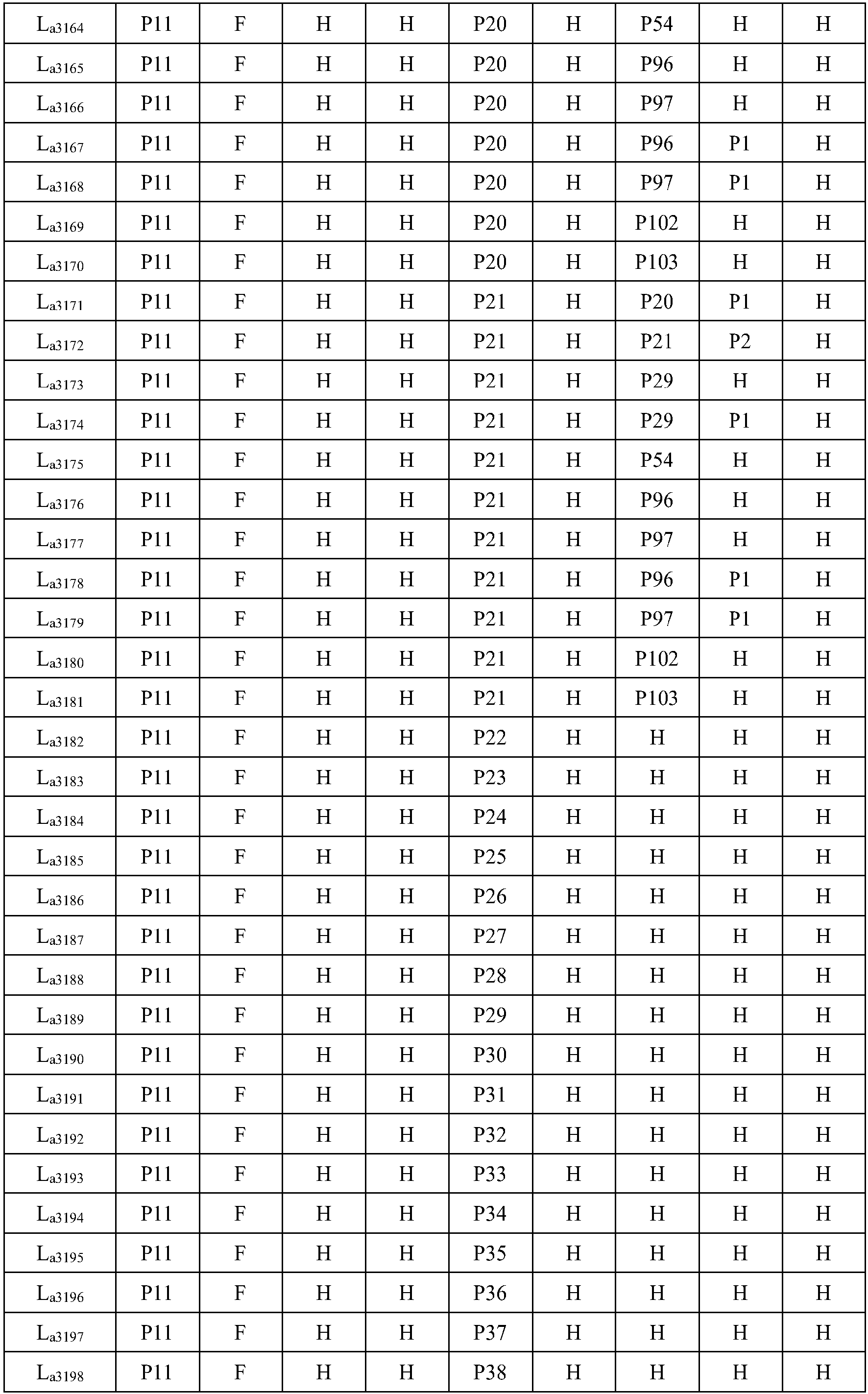 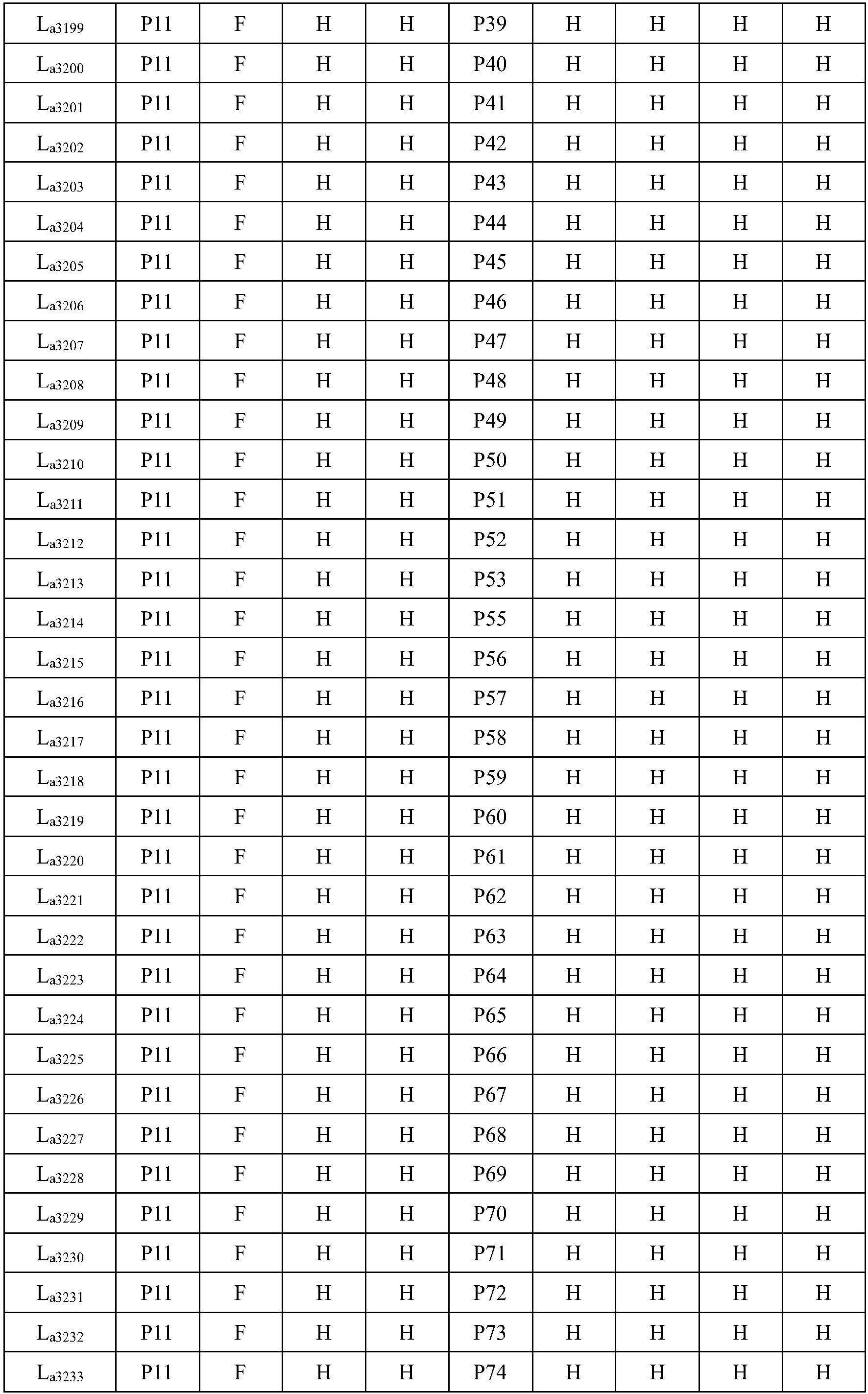 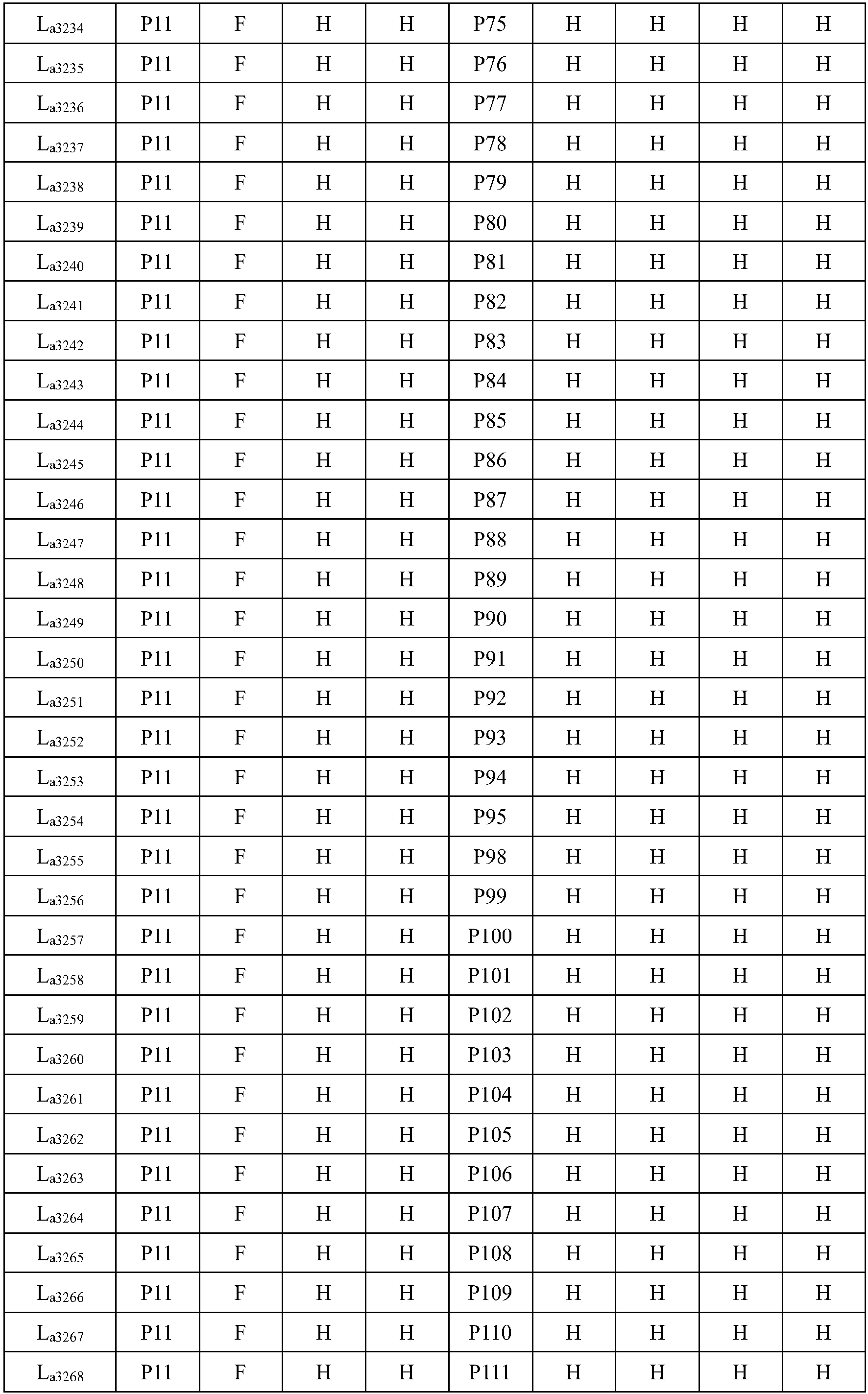 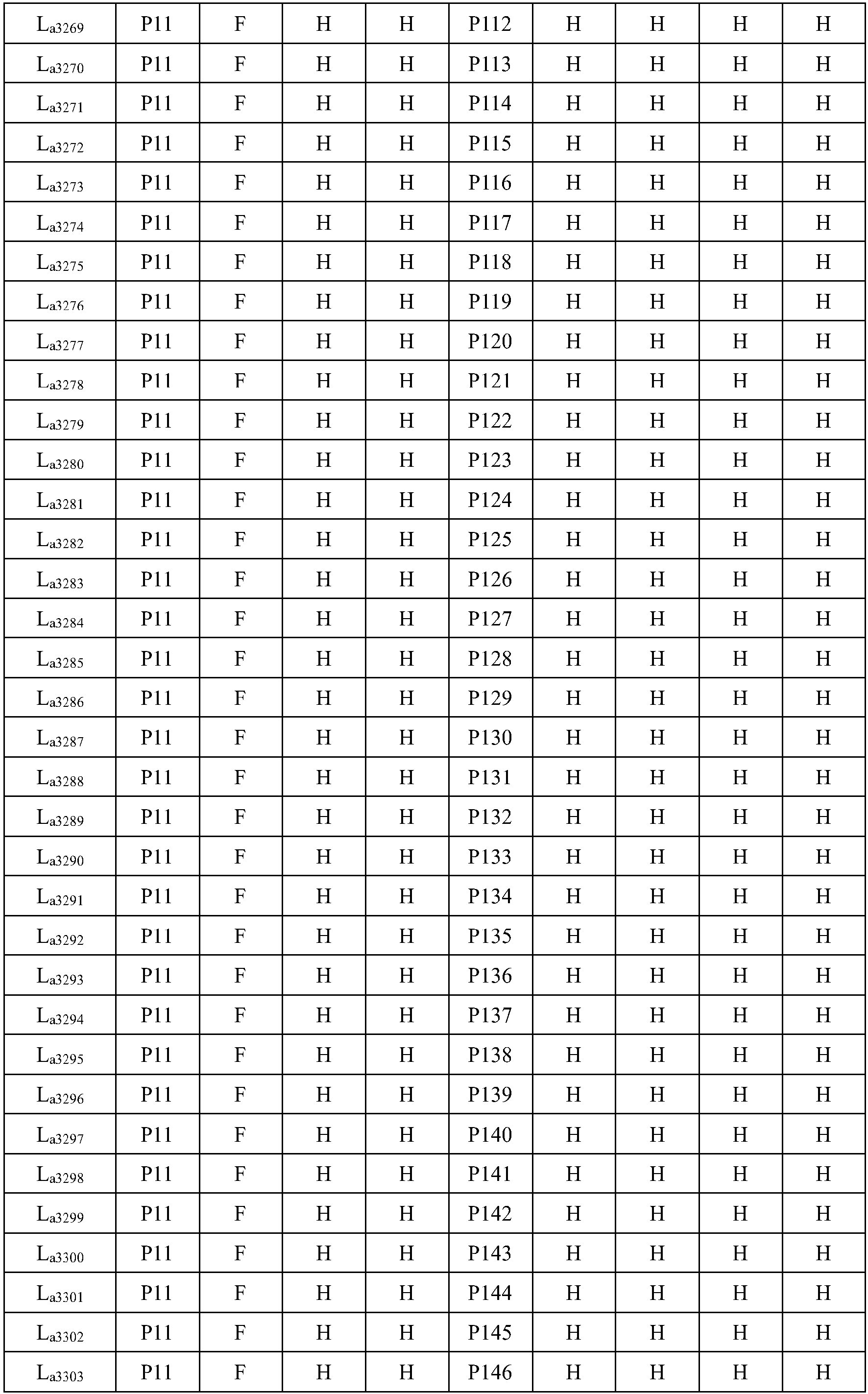 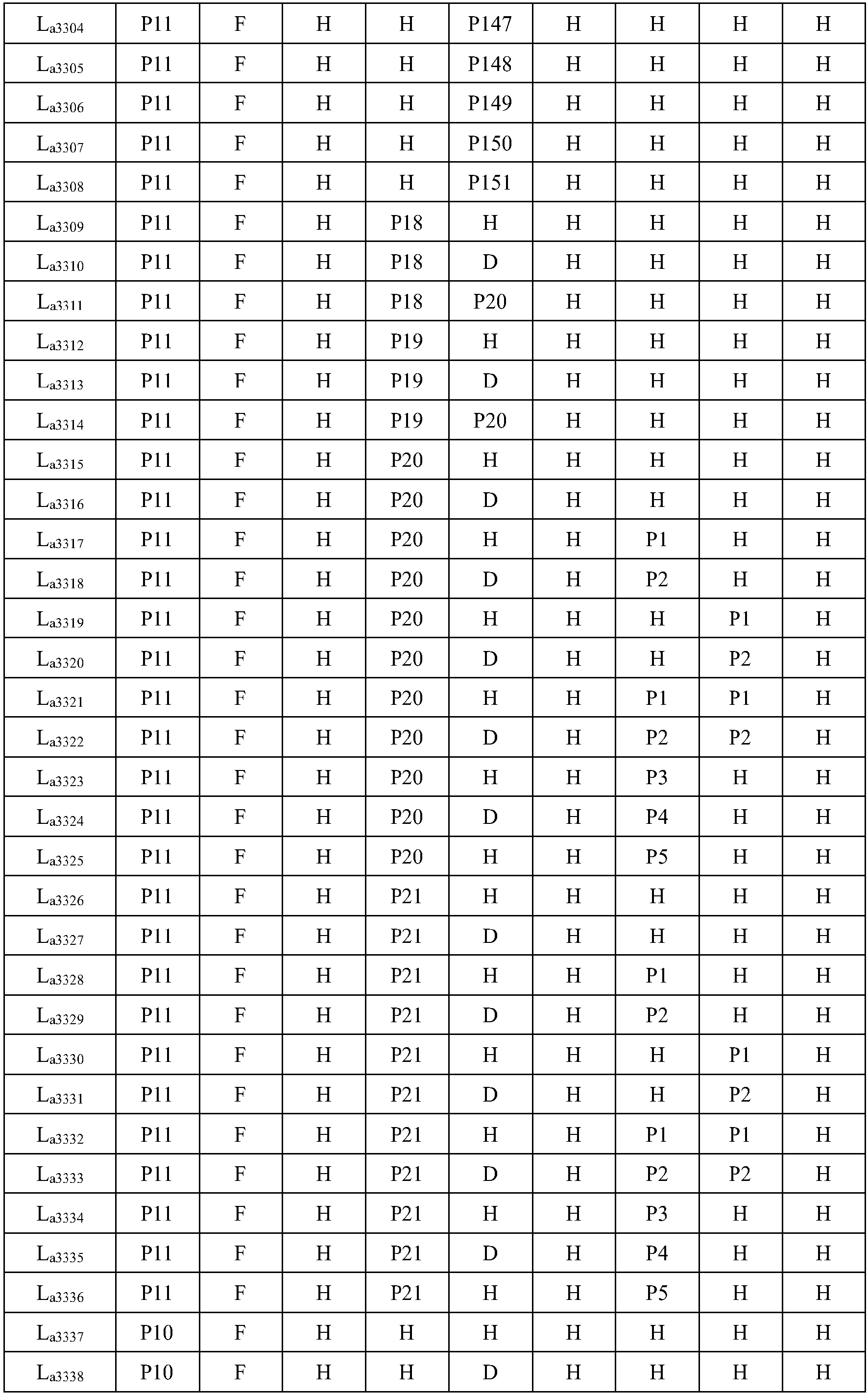 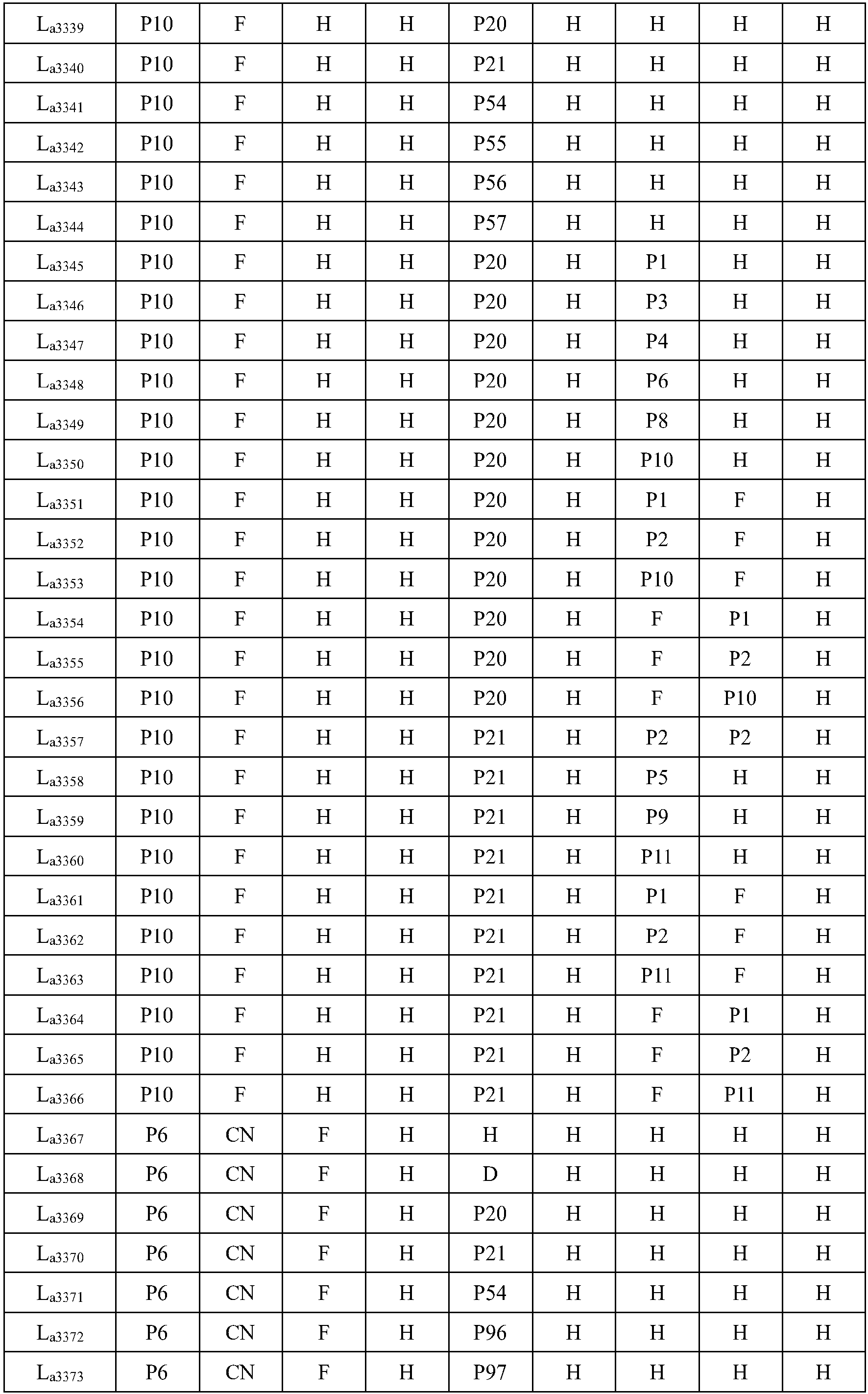 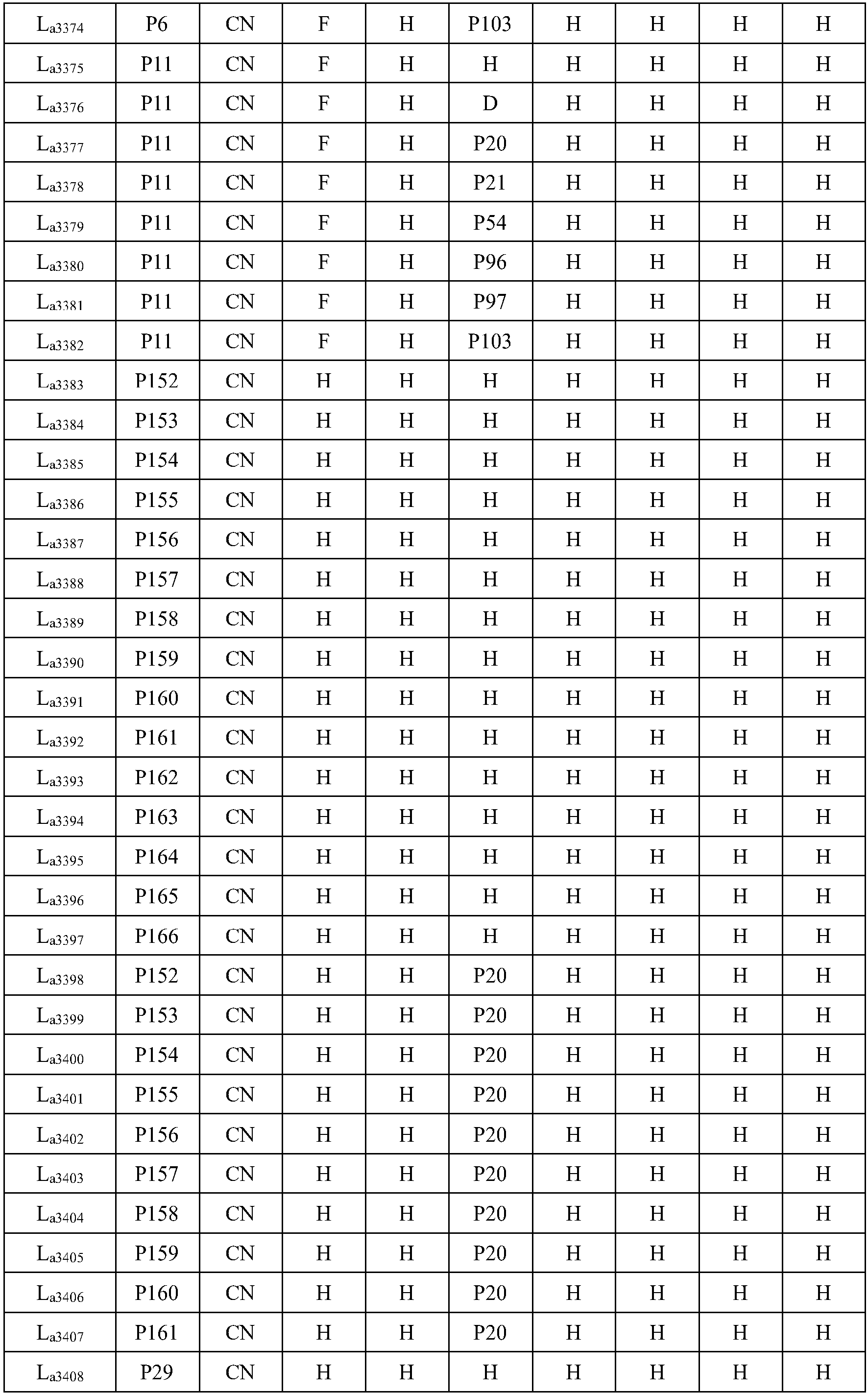 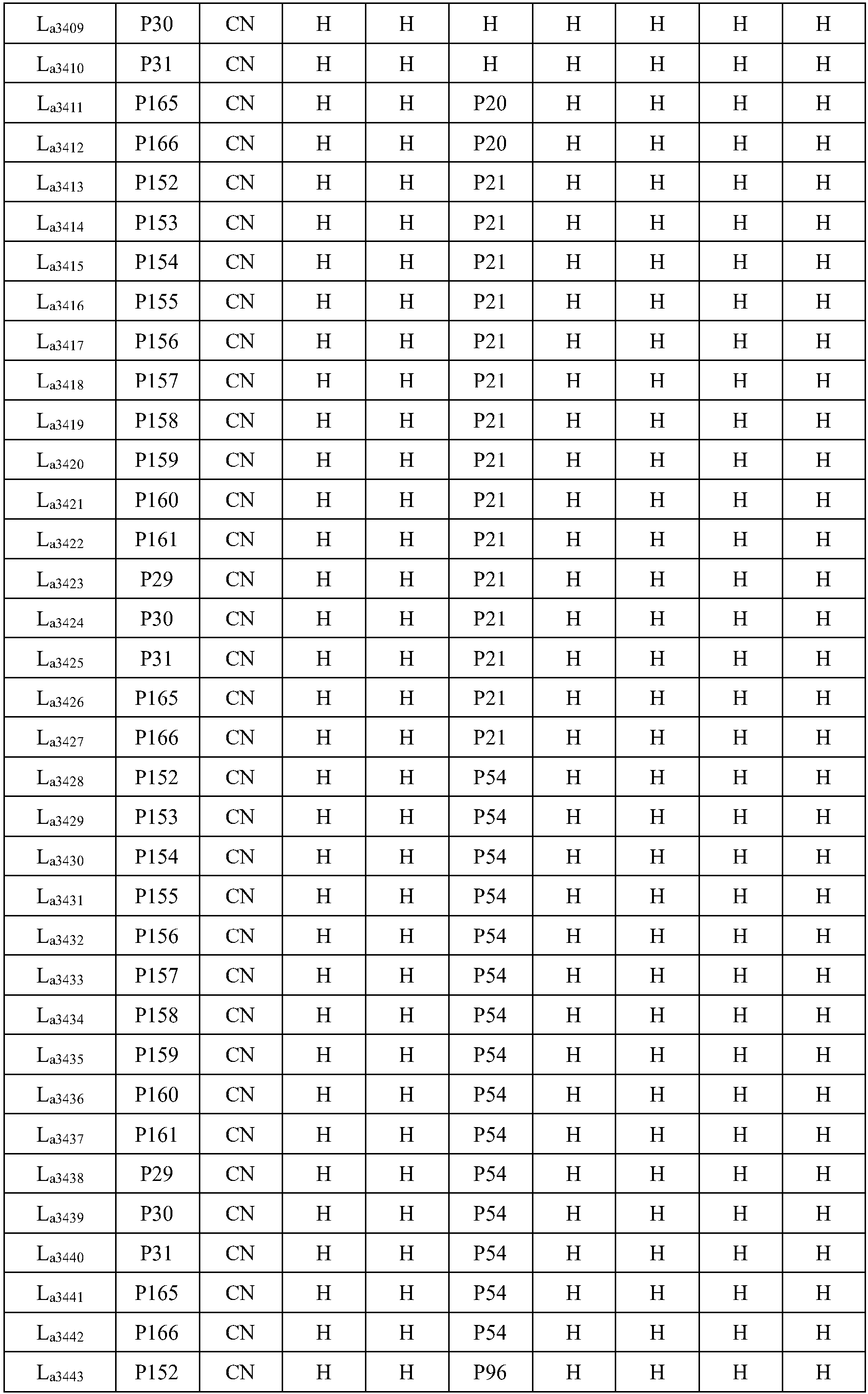 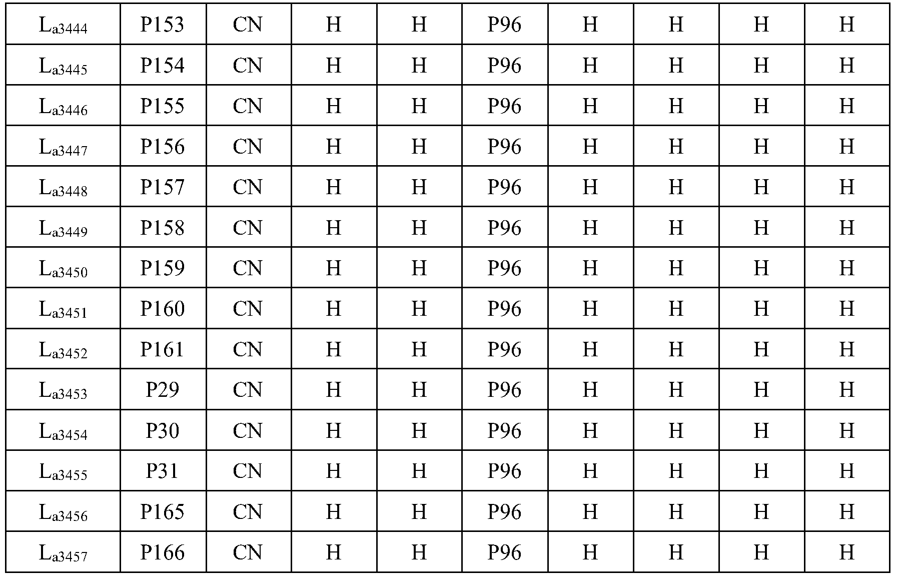 ;
où P1 à P166 présentent les structures suivantes : 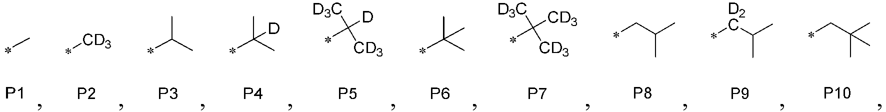 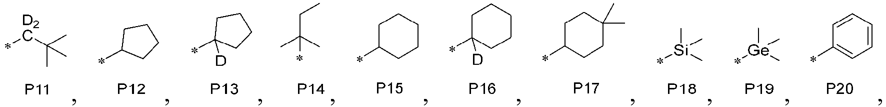 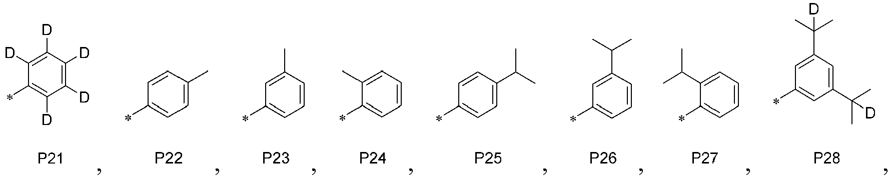 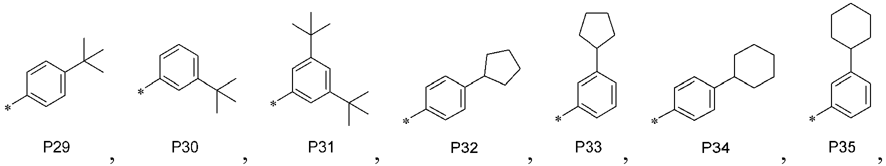 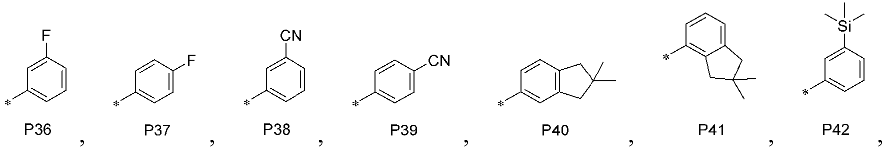 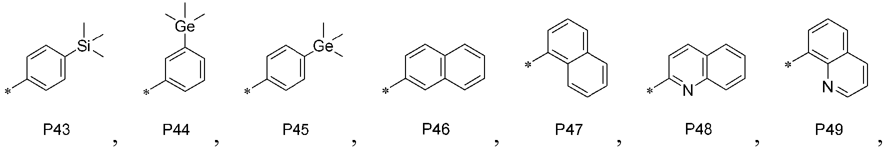 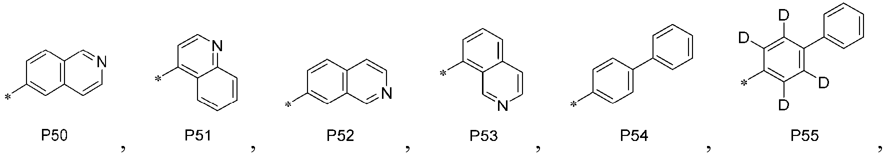 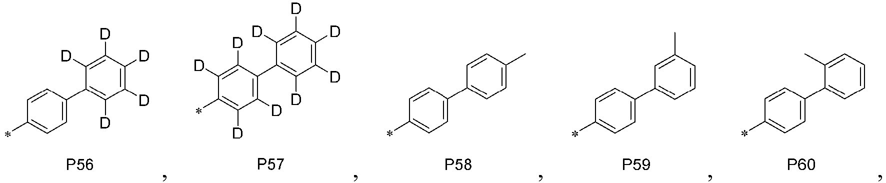 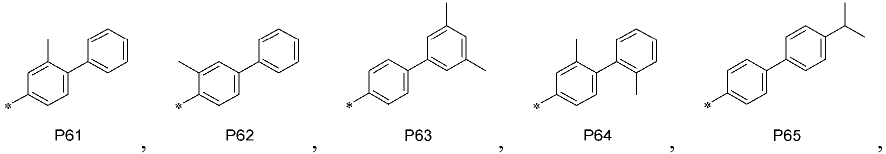 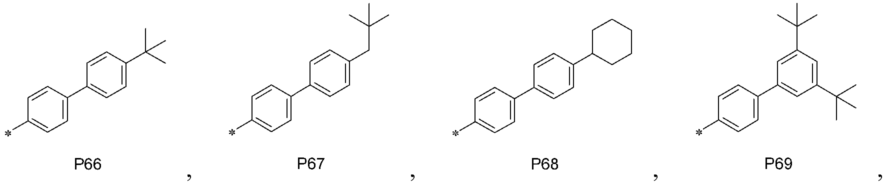 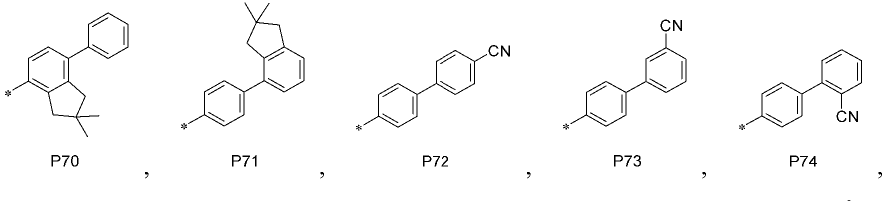 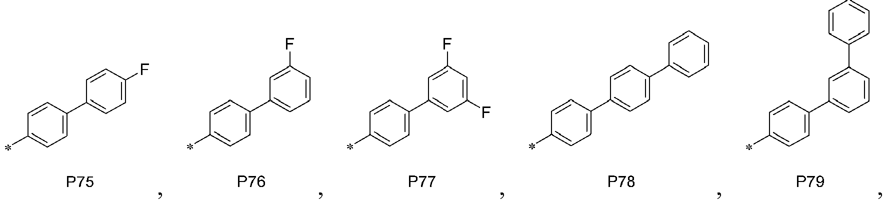 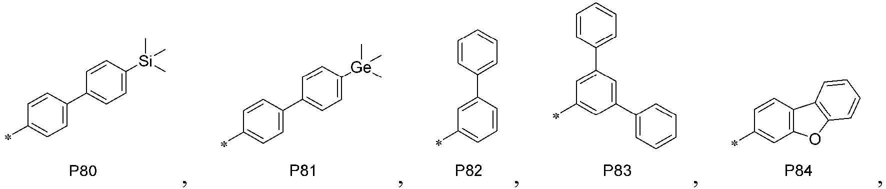 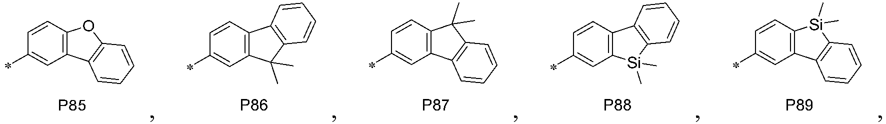 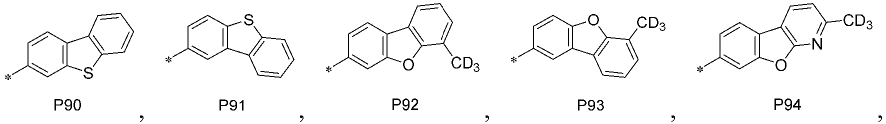 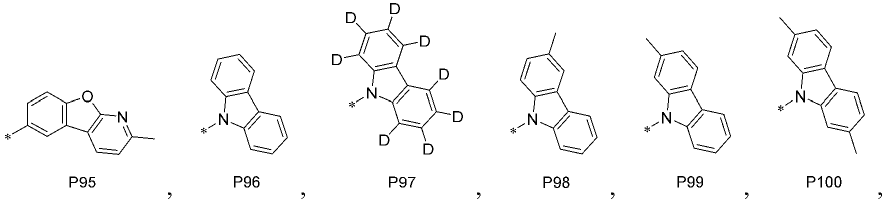 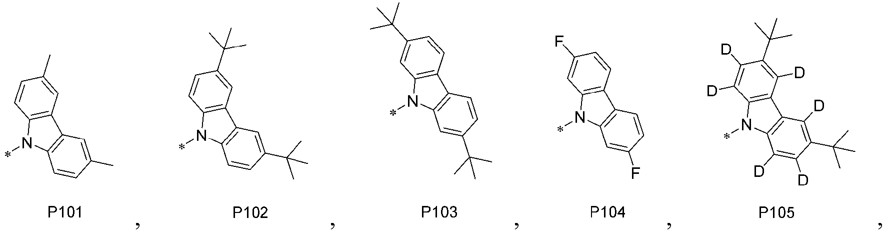 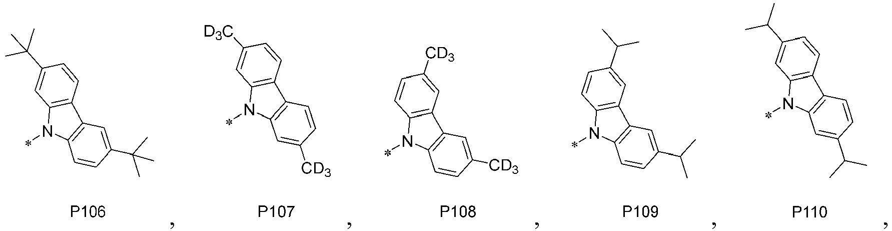 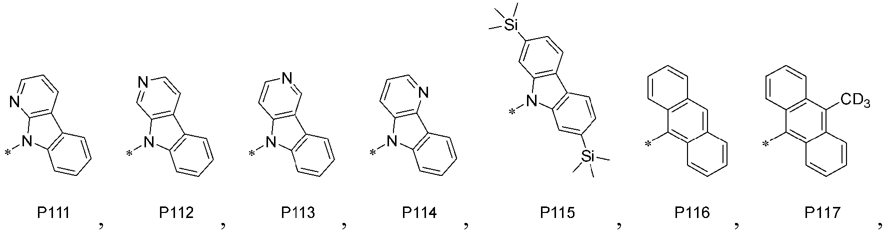 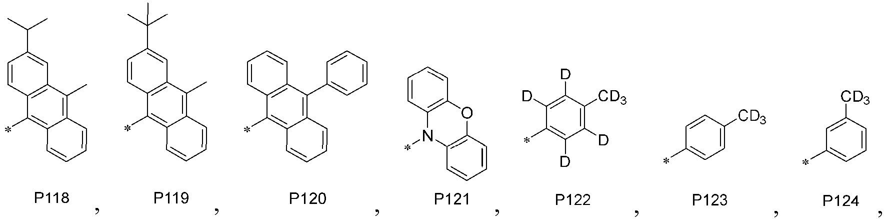 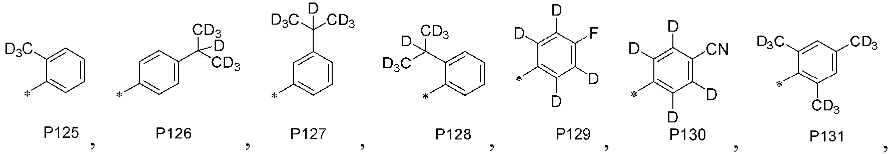 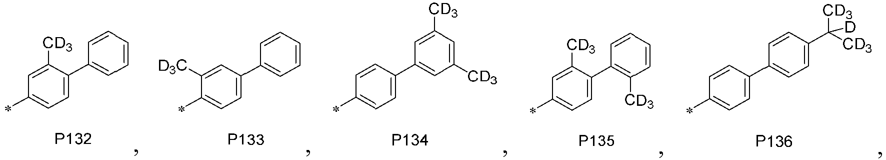 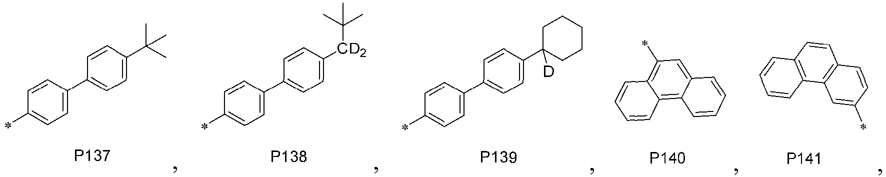 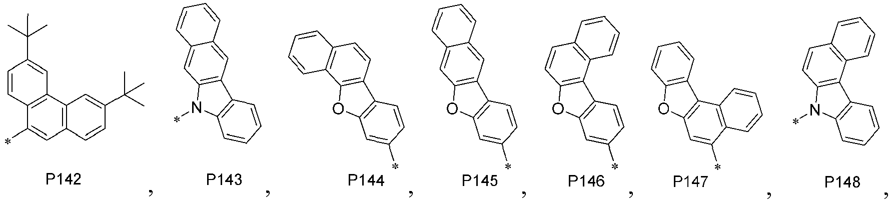 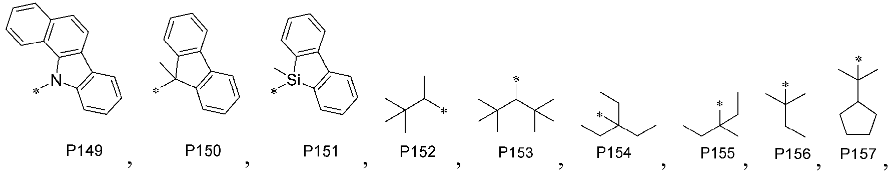 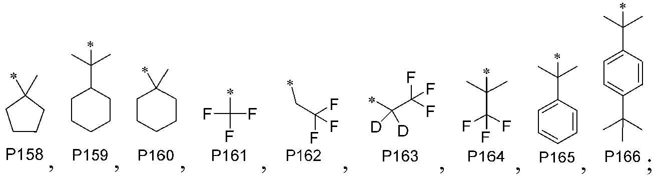
où Lₐ₃₄₅₈ à Lₐ₃₅₃₀ sont représentés comme suit : 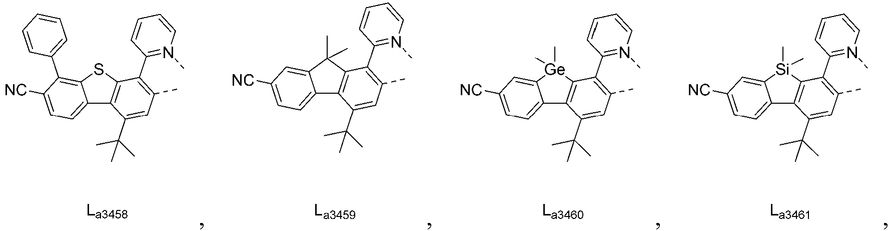 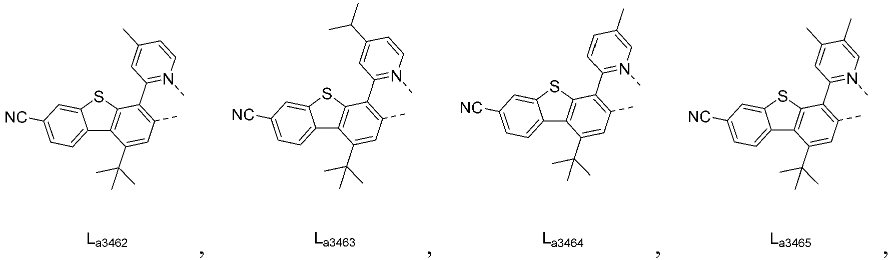 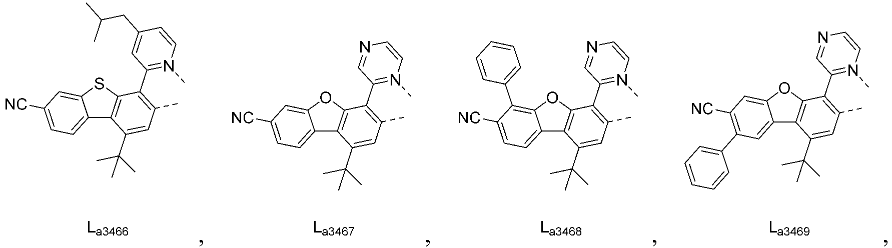 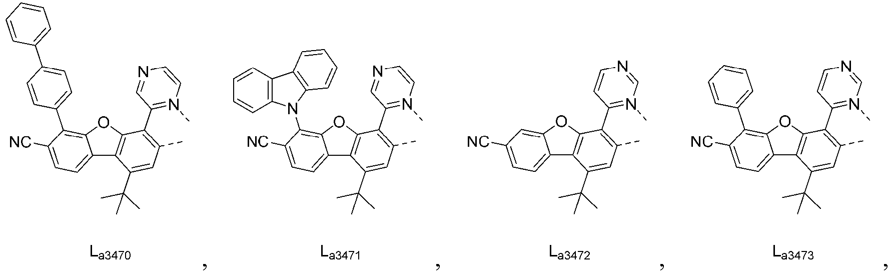 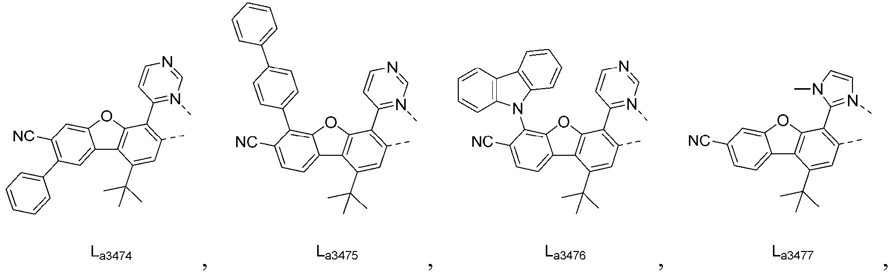 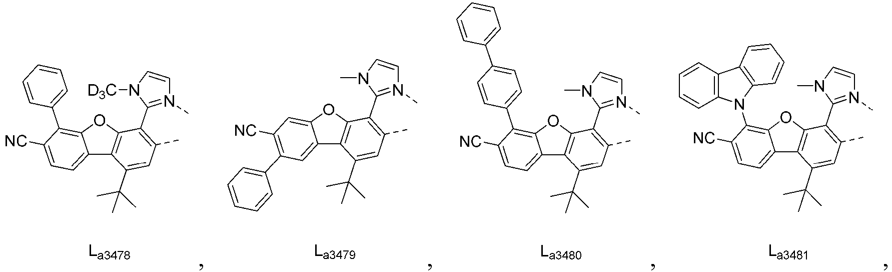 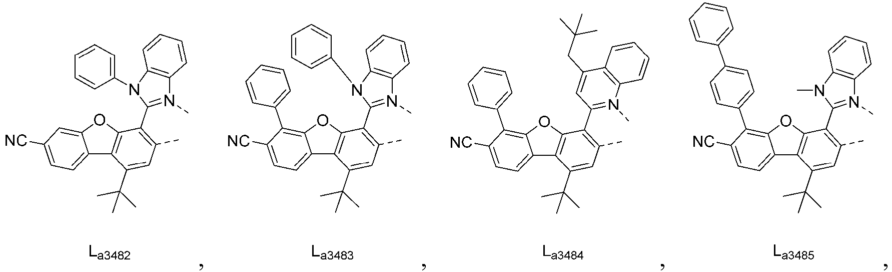 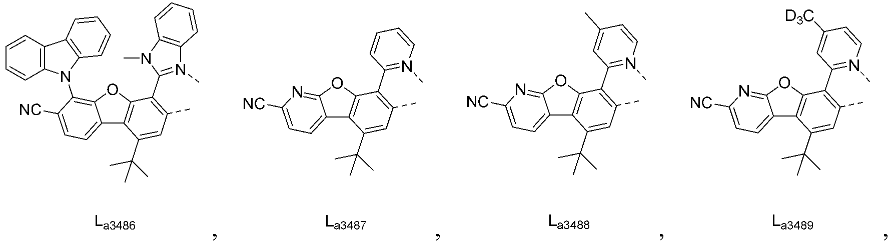 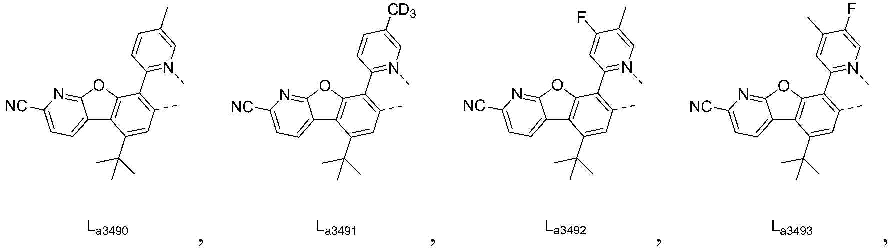 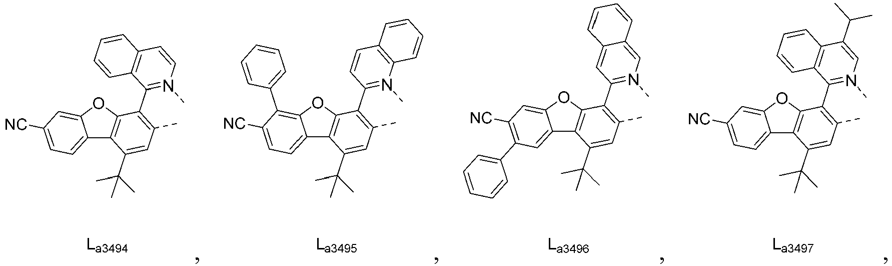 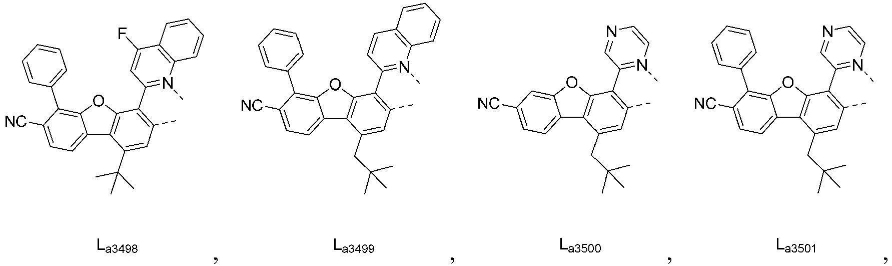 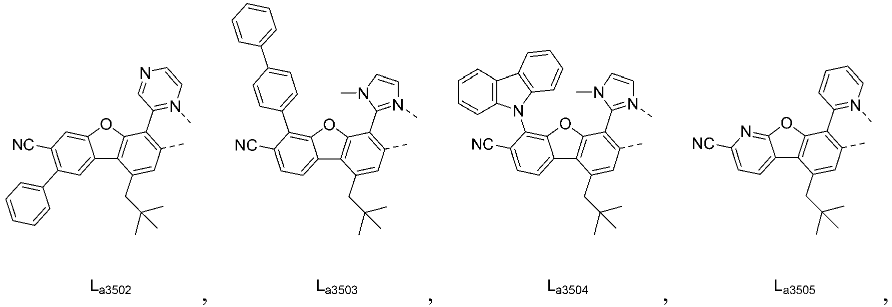 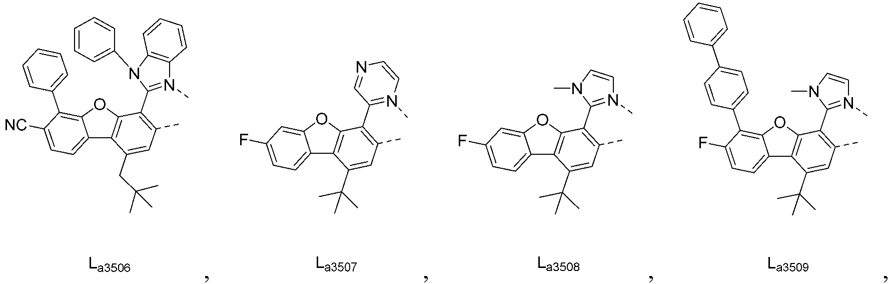 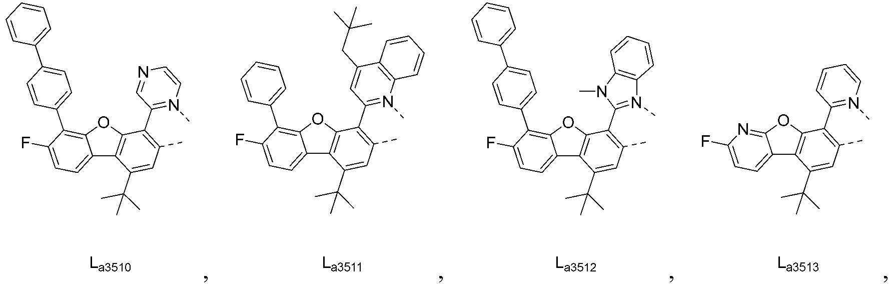 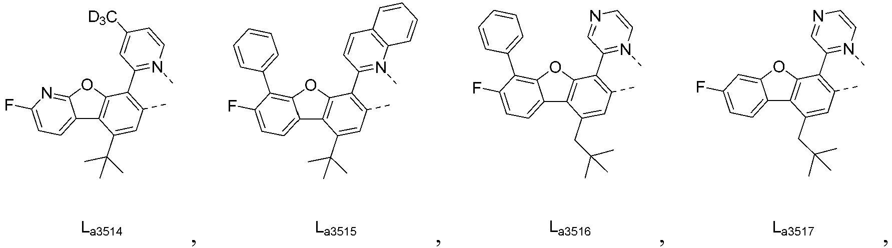 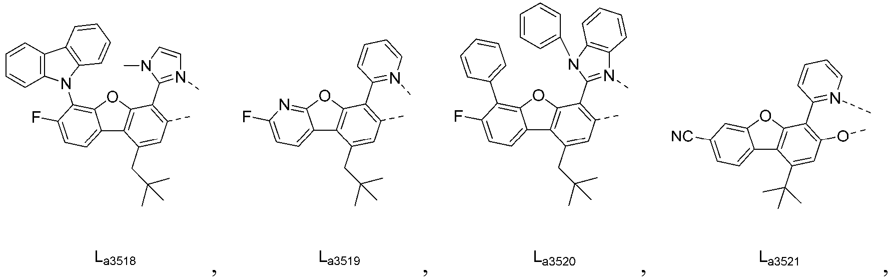 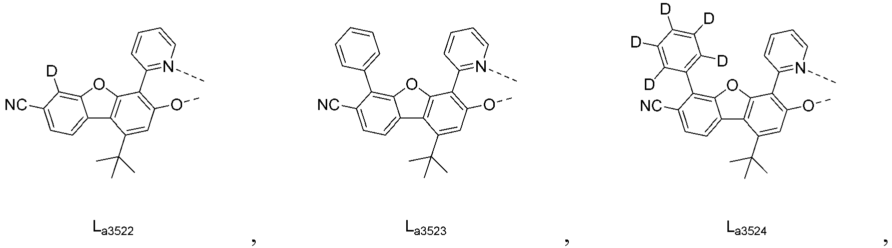 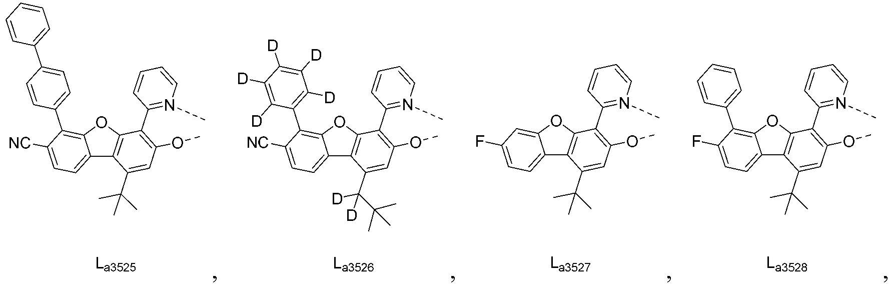 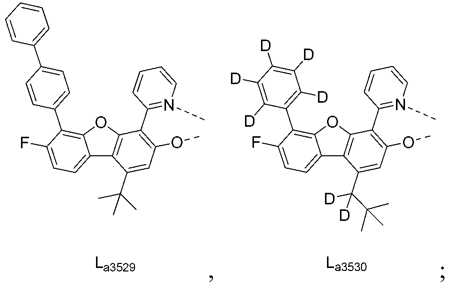
dans lequel, optionnellement, les hydrogènes dans Lₐ₁ à Lₐ₃₅₃₀ peuvent être partiellement ou complètement substitués par du deutérium.

12. Complexe métallique selon la revendication 2, 3 ou 11, dans lequel L_{b} est, à chaque occurrence de manière identique ou différente, choisi parmi : 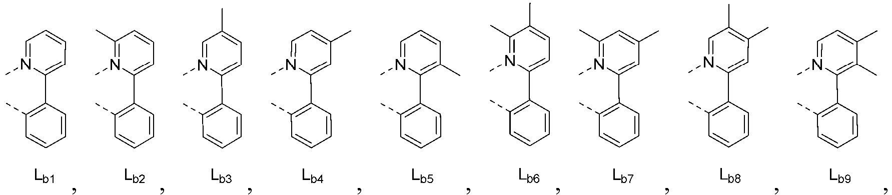 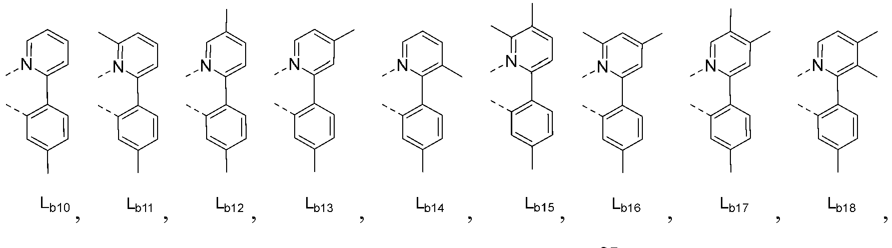 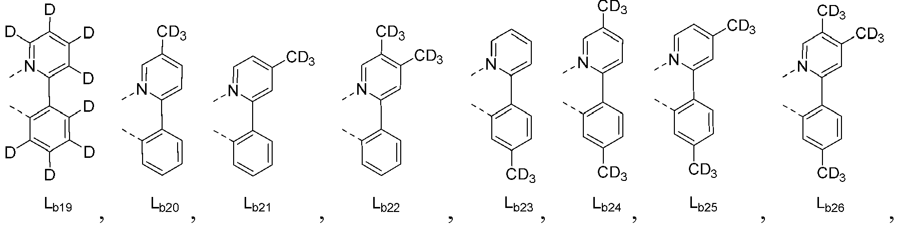 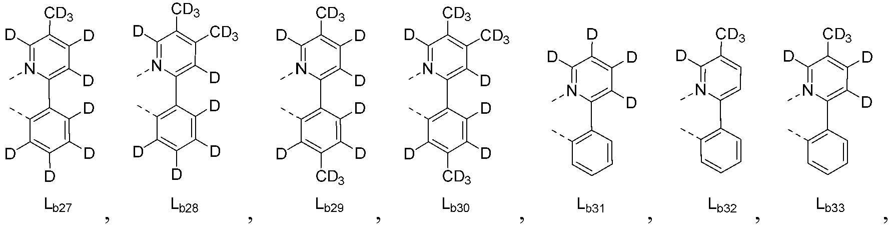 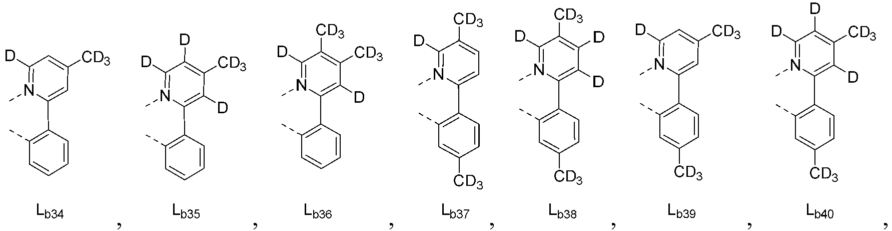 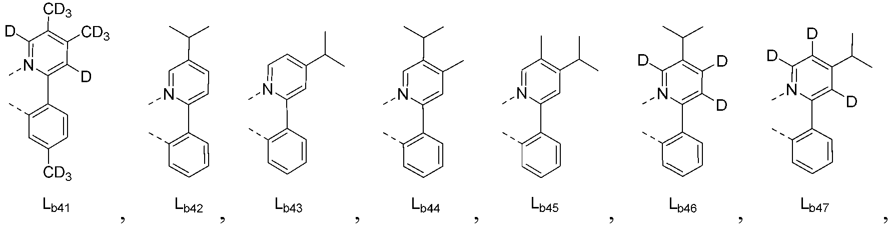 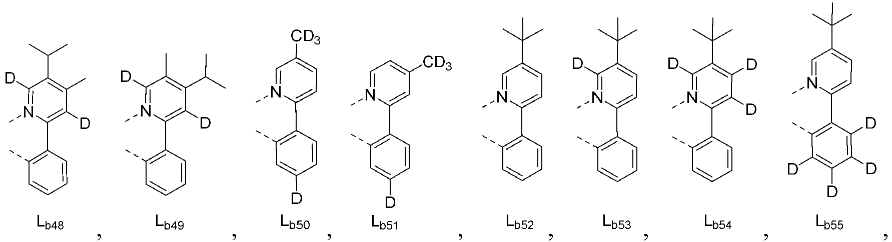 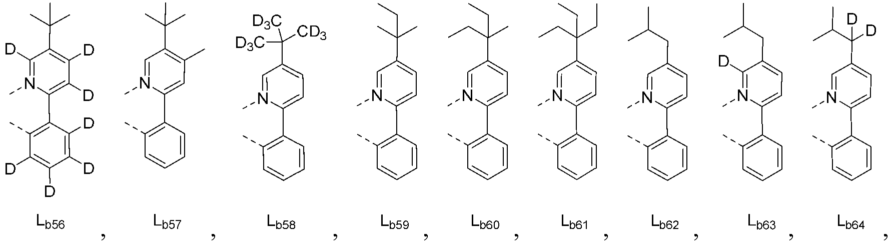 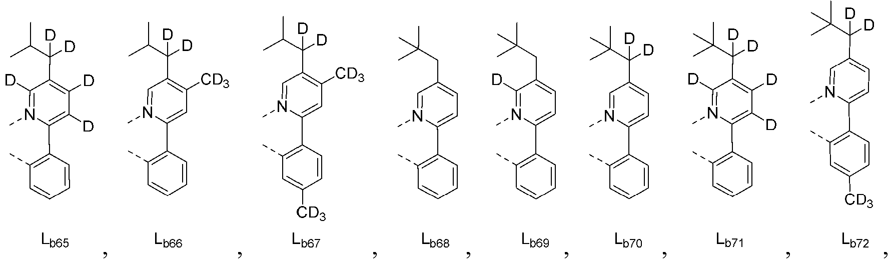 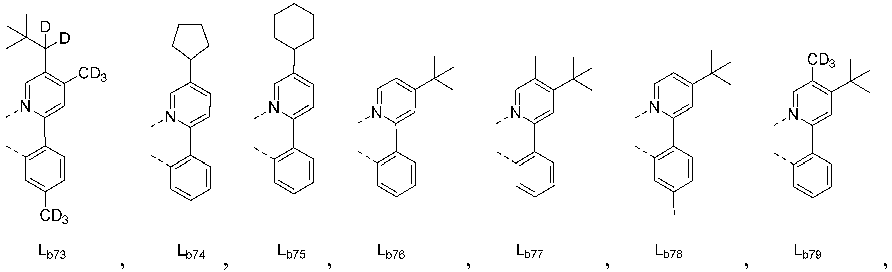 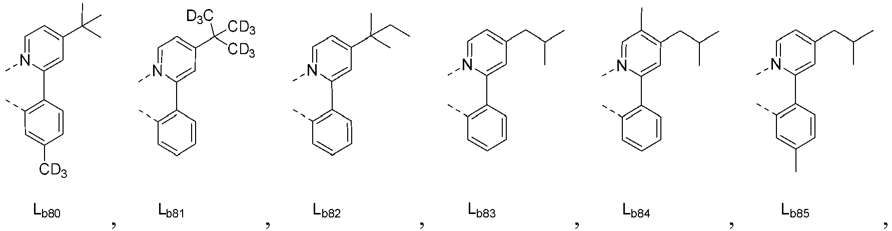 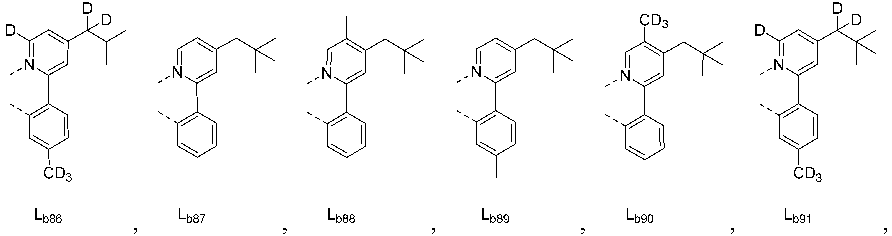 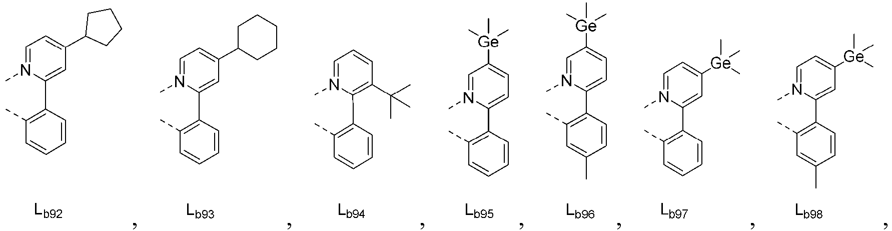 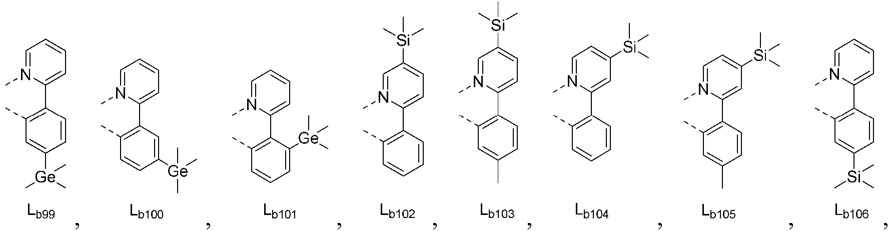 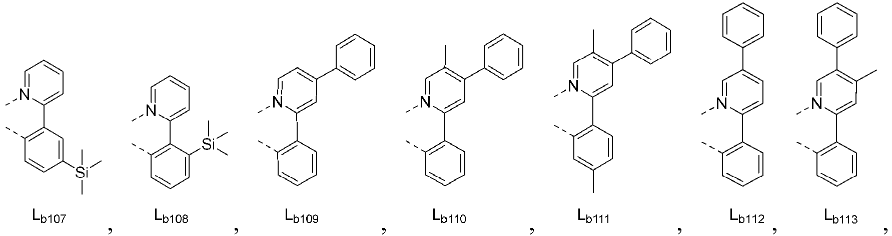 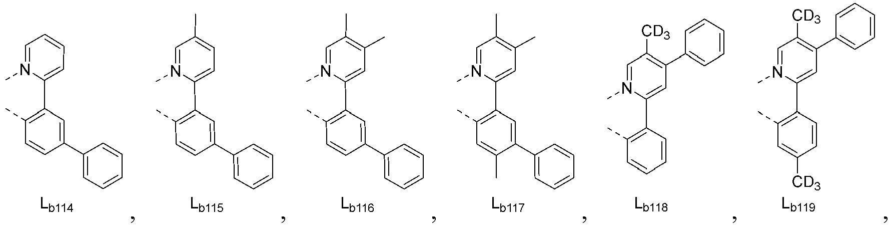 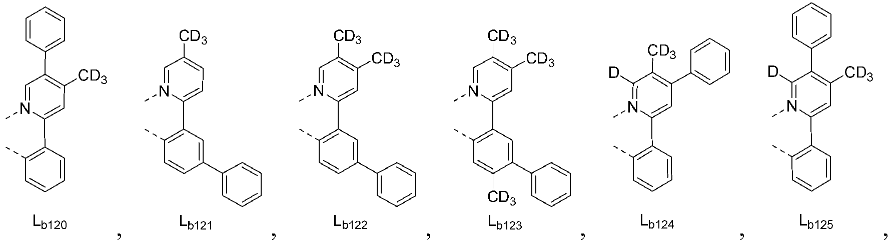 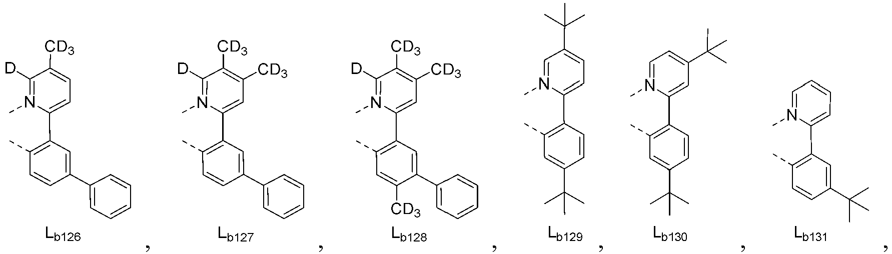 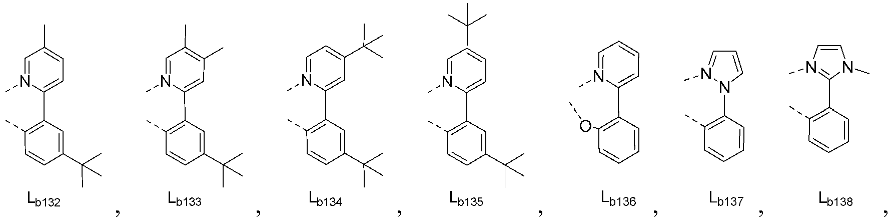 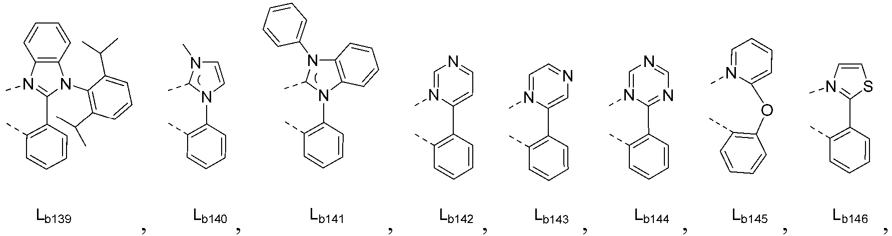 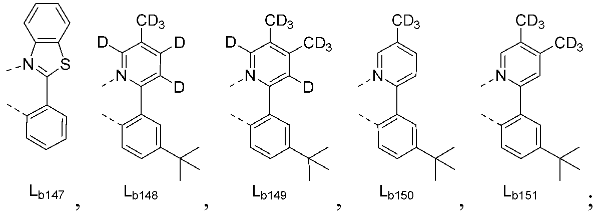 dans lequel, optionnellement, les hydrogènes dans les L_{b1} à L_{b18}, L_{b20} à L_{b26} et L_{b31} à L_{b151} ci-dessus peuvent être substitués partiellement ou complètement par du deutérium.

13. Complexe métallique selon la revendication 12, dans lequel le complexe métallique présente une structure d'Ir(Lₐ)(L_{b})₂, dans lequel les deux L_{b} sont identiques ou différents ; et
de préférence, le complexe métallique est choisi dans le groupe constitué du Complexe Métallique 1 au Complexe Métallique 3806, dans lequel chacun du Complexe Métallique 1 au Complexe Métallique 3806 présente une structure d'Ir(Lₐ)(L_{b})₂, dans lequel les deux L_{b} sont identiques, et Lₐ et L_{b} correspondent respectivement aux structures dans le tableau suivant :
| Complexe métallique N° | Lₐ | L_{b} | Complexe métallique N° | Lₐ | L_{b} |
|---|---|---|---|---|---|
| 1 | Lₐ₁ | L_{b1} | 2 | Lₐ₁ | L_{b3} |
| 3 | Lₐ₁₂ | L_{b1} | 4 | Lₐ₁₂ | L_{b3} |
| 5 | Lₐ₂₁ | L_{b1} | 6 | Lₐ₂₁ | L_{b3} |
| 7 | Lₐ₂₃ | L_{b1} | 8 | Lₐ₂₃ | L_{b3} |
| 9 | Lₐ₃₃ | L_{b1} | 10 | Lₐ₃₃ | L_{b3} |
| 11 | Lₐ₄₂ | L_{b1} | 12 | Lₐ₄₂ | L_{b3} |
| 13 | Lₐ₆₃ | L_{b1} | 14 | Lₐ₆₃ | L_{b3} |
| 15 | Lₐ₆₆ | L_{b1} | 16 | Lₐ₆₆ | L_{b3} |
| 17 | Lₐ₇₅ | L_{b1} | 18 | Lₐ₇₅ | L_{b3} |
| 19 | Lₐ₈₄ | L_{b1} | 20 | Lₐ₈₄ | L_{b3} |
| 21 | Lₐ₁₀₅ | L_{b1} | 22 | Lₐ₁₀₅ | L_{b3} |
| 23 | Lₐ₁₀₇ | L_{b1} | 24 | Lₐ₁₀₇ | L_{b3} |
| 25 | Lₐ₁₂₁ | L_{b1} | 26 | Lₐ₁₂₁ | L_{b3} |
| 27 | Lₐ₁₂₈ | L_{b1} | 28 | Lₐ₁₂₈ | L_{b3} |
| 29 | Lₐ₁₃₀ | L_{b1} | 30 | Lₐ₁₃₀ | L_{b3} |
| 31 | Lₐ₁₃₁ | L_{b1} | 32 | Lₐ₁₃₁ | L_{b3} |
| 33 | Lₐ₁₃₂ | L_{b1} | 34 | Lₐ₁₃₂ | L_{b3} |
| 35 | Lₐ₁₃₃ | L_{b1} | 36 | Lₐ₁₃₃ | L_{b3} |
| 37 | Lₐ₁₃₅ | L_{b1} | 38 | Lₐ₁₃₅ | L_{b3} |
| 39 | Lₐ₁₃₆ | L_{b1} | 40 | Lₐ₁₃₆ | L_{b3} |
| 41 | Lₐ₁₄₀ | L_{b1} | 42 | Lₐ₁₄₀ | L_{b3} |
| 43 | Lₐ₁₅₀ | L_{b1} | 44 | Lₐ₁₅₀ | L_{b3} |
| 45 | Lₐ₁₅₂ | L_{b1} | 46 | Lₐ₁₅₂ | L_{b3} |
| 47 | Lₐ₁₅₄ | L_{b1} | 48 | Lₐ₁₅₄ | L_{b3} |
| 49 | Lₐ₁₅₇ | L_{b1} | 50 | Lₐ₁₅₇ | L_{b3} |
| 51 | Lₐ₁₆₁ | L_{b1} | 52 | Lₐ₁₆₁ | L_{b3} |
| 53 | Lₐ₁₇₀ | L_{b1} | 54 | Lₐ₁₇₀ | L_{b3} |
| 55 | Lₐ₁₇₁ | L_{b1} | 56 | Lₐ₁₇₁ | L_{b3} |
| 57 | Lₐ₁₈₀ | L_{b1} | 58 | Lₐ₁₈₀ | L_{b3} |
| 59 | Lₐ₁₈₂ | L_{b1} | 60 | Lₐ₁₈₂ | L_{b3} |
| 61 | Lₐ₁₈₉ | L_{b1} | 62 | Lₐ₁₈₉ | L_{b3} |
| 63 | Lₐ₁₉₁ | L_{b1} | 64 | Lₐ₁₉₁ | L_{b3} |
| 65 | Lₐ₁₉₃ | L_{b1} | 66 | Lₐ₁₉₃ | L_{b3} |
| 67 | Lₐ₂₀₁ | L_{b1} | 68 | Lₐ₂₀₁ | L_{b3} |
| 69 | Lₐ₂₀₃ | L_{b1} | 70 | Lₐ₂₀₃ | L_{b3} |
| 71 | Lₐ₂₀₅ | L_{b1} | 72 | Lₐ₂₀₅ | L_{b3} |
| 73 | Lₐ₂₀₆ | L_{b1} | 74 | Lₐ₂₀₆ | L_{b3} |
| 75 | Lₐ₂₁₂ | L_{b1} | 76 | Lₐ₂₁₂ | L_{b3} |
| 77 | Lₐ₂₂₄ | L_{b1} | 78 | Lₐ₂₂₄ | L_{b3} |
| 79 | Lₐ₂₂₇ | L_{b1} | 80 | Lₐ₂₂₇ | L_{b3} |
| 81 | Lₐ₂₃₃ | L_{b1} | 82 | Lₐ₂₃₃ | L_{b3} |
| 83 | Lₐ₂₄₀ | L_{b1} | 84 | Lₐ₂₄₀ | L_{b3} |
| 85 | Lₐ₂₄₃ | L_{b1} | 86 | Lₐ₂₄₃ | L_{b3} |
| 87 | Lₐ₂₅₂ | L_{b1} | 88 | Lₐ₂₅₂ | L_{b3} |
| 89 | Lₐ₂₅₃ | L_{b1} | 90 | Lₐ₂₅₃ | L_{b3} |
| 91 | Lₐ₂₆₅ | L_{b1} | 92 | Lₐ₂₆₅ | L_{b3} |
| 93 | Lₐ₂₇₂ | L_{b1} | 94 | Lₐ₂₇₂ | L_{b3} |
| 95 | Lₐ₂₇₃ | L_{b1} | 96 | Lₐ₂₇₃ | L_{b3} |
| 97 | Lₐ₂₇₈ | L_{b1} | 98 | Lₐ₂₇₈ | L_{b3} |
| 99 | Lₐ₂₈₂ | L_{b1} | 100 | Lₐ₂₈₂ | L_{b3} |
| 101 | Lₐ₂₈₃ | L_{b1} | 102 | Lₐ₂₈₃ | L_{b3} |
| 103 | Lₐ₂₉₃ | L_{b1} | 104 | Lₐ₂₉₃ | L_{b3} |
| 105 | Lₐ₂₉₄ | L_{b1} | 106 | Lₐ₂₉₄ | L_{b3} |
| 107 | Lₐ₂₉₅ | L_{b1} | 108 | Lₐ₂₉₅ | L_{b3} |
| 109 | Lₐ₃₁₀ | L_{b1} | 110 | Lₐ₃₁₀ | L_{b3} |
| 111 | Lₐ₃₁₄ | L_{b1} | 112 | Lₐ₃₁₄ | L_{b3} |
| 113 | Lₐ₃₂₅ | L_{b1} | 114 | Lₐ₃₂₅ | L_{b3} |
| 115 | Lₐ₃₄₃ | L_{b1} | 116 | Lₐ₃₄₃ | L_{b3} |
| 117 | Lₐ₃₄₅ | L_{b1} | 118 | Lₐ₃₄₅ | L_{b3} |
| 119 | Lₐ₃₆₃ | L_{b1} | 120 | Lₐ₃₆₃ | L_{b3} |
| 121 | Lₐ₃₈₅ | L_{b1} | 122 | Lₐ₃₈₅ | L_{b3} |
| 123 | Lₐ₃₉₆ | L_{b1} | 124 | Lₐ₃₉₆ | L_{b3} |
| 125 | Lₐ₄₀₇ | L_{b1} | 126 | Lₐ₄₀₇ | L_{b3} |
| 127 | Lₐ₄₀₈ | L_{b1} | 128 | Lₐ₄₀₈ | L_{b3} |
| 129 | Lₐ₄₁₄ | L_{b1} | 130 | Lₐ₄₁₄ | L_{b3} |
| 131 | Lₐ₄₂₃ | L_{b1} | 132 | Lₐ₄₂₃ | L_{b3} |
| 133 | Lₐ₄₃₄ | L_{b1} | 134 | Lₐ₄₃₄ | L_{b3} |
| 135 | Lₐ₄₅₆ | L_{b1} | 136 | Lₐ₄₅₆ | L_{b3} |
| 137 | Lₐ₄₆₇ | L_{b1} | 138 | Lₐ₄₆₇ | L_{b3} |
| 139 | Lₐ₆₃₀ | L_{b1} | 140 | Lₐ₆₃₀ | L_{b3} |
| 141 | Lₐ₆₃₁ | L_{b1} | 142 | Lₐ₆₃₁ | L_{b3} |
| 143 | Lₐ₆₄₅ | L_{b1} | 144 | Lₐ₆₄₅ | L_{b3} |
| 145 | Lₐ₆₄₆ | L_{b1} | 146 | Lₐ₆₄₆ | L_{b3} |
| 147 | Lₐ₆₄₇ | L_{b1} | 148 | Lₐ₆₄₇ | L_{b3} |
| 149 | Lₐ₆₄₈ | L_{b1} | 150 | Lₐ₆₄₈ | L_{b3} |
| 151 | Lₐ₆₆₅ | L_{b1} | 152 | Lₐ₆₆₅ | L_{b3} |
| 153 | Lₐ₇₄₆ | L_{b1} | 154 | Lₐ₇₄₆ | L_{b3} |
| 155 | Lₐ₇₄₇ | L_{b1} | 156 | Lₐ₇₄₇ | L_{b3} |
| 157 | Lₐ₈₂₄ | L_{b1} | 158 | Lₐ₈₂₄ | L_{b3} |
| 159 | Lₐ₈₂₅ | L_{b1} | 160 | Lₐ₈₂₅ | L_{b3} |
| 161 | Lₐ₈₄₄ | L_{b1} | 162 | Lₐ₈₄₄ | L_{b3} |
| 163 | Lₐ₈₄₆ | L_{b1} | 164 | Lₐ₈₄₆ | L_{b3} |
| 165 | Lₐ₈₆₅ | L_{b1} | 166 | Lₐ₈₆₅ | L_{b3} |
| 167 | Lₐ₈₆₈ | L_{b1} | 168 | Lₐ₈₆₈ | L_{b3} |
| 169 | Lₐ₈₈₉ | L_{b1} | 170 | Lₐ₈₈₉ | L_{b3} |
| 171 | Lₐ₉₀₉ | L_{b1} | 172 | Lₐ₉₀₉ | L_{b3} |
| 173 | Lₐ₉₁₃ | L_{b1} | 174 | Lₐ₉₁₃ | L_{b3} |
| 175 | Lₐ₉₁₅ | L_{b1} | 176 | Lₐ₉₁₅ | L_{b3} |
| 177 | Lₐ₉₂₀ | L_{b1} | 178 | Lₐ₉₂₀ | L_{b3} |
| 179 | Lₐ₉₂₂ | L_{b1} | 180 | Lₐ₉₂₂ | L_{b3} |
| 181 | Lₐ₉₂₃ | L_{b1} | 182 | Lₐ₉₂₃ | L_{b3} |
| 183 | Lₐ₉₂₄ | L_{b1} | 184 | Lₐ₉₂₄ | L_{b3} |
| 185 | Lₐ₉₂₅ | L_{b1} | 186 | Lₐ₉₂₅ | L_{b3} |
| 187 | Lₐ₉₂₈ | L_{b1} | 188 | Lₐ₉₂₈ | L_{b3} |
| 189 | Lₐ₉₅₃ | L_{b1} | 190 | Lₐ₉₅₃ | L_{b3} |
| 191 | Lₐ₉₅₄ | L_{b1} | 192 | Lₐ₉₅₄ | L_{b3} |
| 193 | Lₐ₉₇₄ | L_{b1} | 194 | Lₐ₉₇₄ | L_{b3} |
| 195 | Lₐ₉₇₆ | L_{b1} | 196 | Lₐ₉₇₆ | L_{b3} |
| 197 | Lₐ₉₉₅ | L_{b1} | 198 | Lₐ₉₉₅ | L_{b3} |
| 199 | Lₐ₁₀₀₆ | L_{b1} | 200 | Lₐ₁₀₀₆ | L_{b3} |
| 201 | Lₐ₁₀₁₇ | L_{b1} | 202 | Lₐ₁₀₁₇ | L_{b3} |
| 203 | Lₐ₁₀₁₈ | L_{b1} | 204 | Lₐ₁₀₁₈ | L_{b3} |
| 205 | Lₐ₁₀₂₃ | L_{b1} | 206 | Lₐ₁₀₂₃ | L_{b3} |
| 207 | Lₐ₁₀₂₄ | L_{b1} | 208 | Lₐ₁₀₂₄ | L_{b3} |
| 209 | Lₐ₁₀₂₆ | L_{b1} | 210 | Lₐ₁₀₂₆ | L_{b3} |
| 211 | Lₐ₁₀₈₈ | L_{b1} | 212 | Lₐ₁₀₈₈ | L_{b3} |
| 213 | Lₐ₁₀₈₉ | L_{b1} | 214 | Lₐ₁₀₈₉ | L_{b3} |
| 215 | Lₐ₁₀₉₅ | L_{b1} | 216 | Lₐ₁₀₉₅ | L_{b3} |
| 217 | Lₐ₁₁₀₀ | L_{b1} | 218 | Lₐ₁₁₀₀ | L_{b3} |
| 219 | Lₐ₁₁₁₆ | L_{b1} | 220 | Lₐ₁₁₁₆ | L_{b3} |
| 221 | Lₐ₁₁₁₈ | L_{b1} | 222 | Lₐ₁₁₁₈ | L_{b3} |
| 223 | Lₐ₁₁₃₆ | L_{b1} | 224 | Lₐ₁₁₃₆ | L_{b3} |
| 225 | Lₐ₁₁₄₈ | L_{b1} | 226 | Lₐ₁₁₄₈ | L_{b3} |
| 227 | Lₐ₁₁₅₈ | L_{b1} | 228 | Lₐ₁₁₅₈ | L_{b3} |
| 229 | Lₐ₁₁₅₉ | L_{b1} | 230 | Lₐ₁₁₅₉ | L_{b3} |
| 231 | Lₐ₁₁₆₁ | L_{b1} | 232 | Lₐ₁₁₆₁ | L_{b3} |
| 233 | Lₐ₁₁₆₆ | L_{b1} | 234 | Lₐ₁₁₆₆ | L_{b3} |
| 235 | Lₐ₁₁₇₁ | L_{b1} | 236 | Lₐ₁₁₇₁ | L_{b3} |
| 237 | Lₐ₁₁₈₇ | L_{b1} | 238 | Lₐ₁₁₈₇ | L_{b3} |
| 239 | Lₐ₁₁₉₂ | L_{b1} | 240 | Lₐ₁₁₉₂ | L_{b3} |
| 241 | Lₐ₁₂₀₅ | L_{b1} | 242 | Lₐ₁₂₀₅ | L_{b3} |
| 243 | Lₐ₁₂₀₈ | L_{b1} | 244 | Lₐ₁₂₀₈ | L_{b3} |
| 245 | Lₐ₁₂₁₇ | L_{b1} | 246 | Lₐ₁₂₁₇ | L_{b3} |
| 247 | Lₐ₁₂₁₉ | L_{b1} | 248 | Lₐ₁₂₁₉ | L_{b3} |
| 249 | Lₐ₁₂₃₀ | L_{b1} | 250 | Lₐ₁₂₃₀ | L_{b3} |
| 251 | Lₐ₁₂₃₇ | L_{b1} | 252 | Lₐ₁₂₃₇ | L_{b3} |
| 253 | Lₐ₁₂₃₈ | L_{b1} | 254 | Lₐ₁₂₃₈ | L_{b3} |
| 255 | Lₐ₁₂₃₉ | L_{b1} | 256 | Lₐ₁₂₃₉ | L_{b3} |
| 257 | Lₐ₁₂₄₅ | L_{b1} | 258 | Lₐ₁₂₄₅ | L_{b3} |
| 259 | Lₐ₁₂₄₆ | L_{b1} | 260 | Lₐ₁₂₄₆ | L_{b3} |
| 261 | Lₐ₁₂₄₇ | L_{b1} | 262 | Lₐ₁₂₄₇ | L_{b3} |
| 263 | Lₐ₁₂₄₈ | L_{b1} | 264 | Lₐ₁₂₄₈ | L_{b3} |
| 265 | Lₐ₁₂₅₈ | L_{b1} | 266 | Lₐ₁₂₅₈ | L_{b3} |
| 267 | Lₐ₁₂₆₀ | L_{b1} | 268 | Lₐ₁₂₆₀ | L_{b3} |
| 269 | Lₐ₁₂₆₁ | L_{b1} | 270 | Lₐ₁₂₆₁ | L_{b3} |
| 271 | Lₐ₁₂₇₇ | L_{b1} | 272 | Lₐ₁₂₇₇ | L_{b3} |
| 273 | Lₐ₁₂₇₈ | L_{b1} | 274 | Lₐ₁₂₇₈ | L_{b3} |
| 275 | Lₐ₁₂₇₉ | L_{b1} | 276 | Lₐ₁₂₇₉ | L_{b3} |
| 277 | Lₐ₁₂₈₈ | L_{b1} | 278 | Lₐ₁₂₈₈ | L_{b3} |
| 279 | Lₐ₁₂₈₉ | L_{b1} | 280 | Lₐ₁₂₈₉ | L_{b3} |
| 281 | Lₐ₁₃₀₁ | L_{b1} | 282 | Lₐ₁₃₀₁ | L_{b3} |
| 283 | Lₐ₁₃₀₂ | L_{b1} | 284 | Lₐ₁₃₀₂ | L_{b3} |
| 285 | Lₐ₁₄₄₂ | L_{b1} | 286 | Lₐ₁₄₄₂ | L_{b3} |
| 287 | Lₐ₁₄₄₈ | L_{b1} | 288 | Lₐ₁₄₄₈ | L_{b3} |
| 289 | Lₐ₁₄₄₉ | L_{b1} | 290 | Lₐ₁₄₄₉ | L_{b3} |
| 291 | Lₐ₁₄₆₀ | L_{b1} | 292 | Lₐ₁₄₆₀ | L_{b3} |
| 293 | Lₐ₁₄₇₁ | L_{b1} | 294 | Lₐ₁₄₇₁ | L_{b3} |
| 295 | Lₐ₁₅₆₉ | L_{b1} | 296 | Lₐ₁₅₆₉ | L_{b3} |
| 297 | Lₐ₁₅₇₀ | L_{b1} | 298 | Lₐ₁₅₇₀ | L_{b3} |
| 299 | Lₐ₁₆₄₇ | L_{b1} | 300 | Lₐ₁₆₄₇ | L_{b3} |
| 301 | Lₐ₁₆₄₈ | L_{b1} | 302 | Lₐ₁₆₄₈ | L_{b3} |
| 303 | Lₐ₁₆₄₉ | L_{b1} | 304 | Lₐ₁₆₄₉ | L_{b3} |
| 305 | Lₐ₁₆₅₀ | L_{b1} | 306 | Lₐ₁₆₅₀ | L_{b3} |
| 307 | Lₐ₁₆₅₁ | L_{b1} | 308 | Lₐ₁₆₅₁ | L_{b3} |
| 309 | Lₐ₁₆₇₇ | L_{b1} | 310 | Lₐ₁₆₇₇ | L_{b3} |
| 311 | Lₐ₁₆₇₈ | L_{b1} | 312 | Lₐ₁₆₇₈ | L_{b3} |
| 313 | Lₐ₁₆₇₉ | L_{b1} | 314 | Lₐ₁₆₇₉ | L_{b3} |
| 315 | Lₐ₁₆₈₀ | L_{b1} | 316 | Lₐ₁₆₈₀ | L_{b3} |
| 317 | Lₐ₁₆₉₁ | L_{b1} | 318 | Lₐ₁₆₉₁ | L_{b3} |
| 319 | Lₐ₁₆₉₃ | L_{bl} | 320 | Lₐ₁₆₉₃ | L_{b3} |
| 321 | Lₐ₁₆₉₅ | L_{b1} | 322 | Lₐ₁₆₉₅ | L_{b3} |
| 323 | Lₐ₁₆₉₆ | L_{b1} | 324 | Lₐ₁₆₉₆ | L_{b3} |
| 325 | Lₐ₁₆₉₉ | L_{b1} | 326 | Lₐ₁₆₉₉ | L_{b3} |
| 327 | Lₐ₁₇₀₁ | L_{b1} | 328 | Lₐ₁₇₀₁ | L_{b3} |
| 329 | Lₐ₁₇₀₂ | L_{b1} | 330 | Lₐ₁₇₀₂ | L_{b3} |
| 331 | Lₐ₁₇₁₂ | L_{b1} | 332 | Lₐ₁₇₁₂ | L_{b3} |
| 333 | Lₐ₁₇₁₃ | L_{b1} | 334 | Lₐ₁₇₁₃ | L_{b3} |
| 335 | Lₐ₁₇₃₅ | L_{b1} | 336 | Lₐ₁₇₃₅ | L_{b3} |
| 337 | Lₐ₁₇₉₅ | L_{b1} | 338 | Lₐ₁₇₉₅ | L_{b3} |
| 339 | Lₐ₁₈₂₀ | L_{b1} | 340 | Lₐ₁₈₂₀ | L_{b3} |
| 341 | Lₐ₁₈₉₁ | L_{b1} | 342 | Lₐ₁₈₉₁ | L_{b3} |
| 343 | Lₐ₁₈₉₂ | L_{b1} | 344 | Lₐ₁₈₉₂ | L_{b3} |
| 345 | Lₐ₁₈₉₃ | L_{b1} | 346 | Lₐ₁₈₉₃ | L_{b3} |
| 347 | Lₐ₁₈₉₉ | L_{b1} | 348 | Lₐ₁₈₉₉ | L_{b3} |
| 349 | Lₐ₁₉₀₂ | L_{b1} | 350 | Lₐ₁₉₀₂ | L_{b3} |
| 351 | Lₐ₁₉₁₃ | L_{b1} | 352 | Lₐ₁₉₁₃ | L_{b3} |
| 353 | Lₐ₁₉₁₄ | L_{b1} | 354 | Lₐ₁₉₁₄ | L_{b3} |
| 355 | Lₐ₁₉₃₃ | L_{b1} | 356 | Lₐ₁₉₃₃ | L_{b3} |
| 357 | Lₐ₁₉₄₅ | L_{b1} | 358 | Lₐ₁₉₄₅ | L_{b3} |
| 359 | Lₐ₁₉₅₄ | L_{b1} | 360 | Lₐ₁₉₅₄ | L_{b3} |
| 361 | Lₐ₁₉₅₅ | L_{b1} | 362 | Lₐ₁₉₅₅ | L_{b3} |
| 363 | Lₐ₁₉₅₆ | L_{b1} | 364 | Lₐ₁₉₅₆ | L_{b3} |
| 365 | Lₐ₁₉₆₂ | L_{b1} | 366 | Lₐ₁₉₆₂ | L_{b3} |
| 367 | Lₐ₁₉₆₄ | L_{b1} | 368 | Lₐ₁₉₆₄ | L_{b3} |
| 369 | Lₐ₁₉₆₅ | L_{b1} | 370 | Lₐ₁₉₆₅ | L_{b3} |
| 371 | Lₐ₁₉₆₆ | L_{b1} | 372 | Lₐ₁₉₆₆ | L_{b3} |
| 373 | Lₐ₁₉₇₀ | L_{b1} | 374 | Lₐ₁₉₇₀ | L_{b3} |
| 375 | Lₐ₁₉₇₃ | L_{b1} | 376 | Lₐ₁₉₇₃ | L_{b3} |
| 377 | Lₐ₂₀₀₂ | L_{b1} | 378 | Lₐ₂₀₀₂ | L_{b3} |
| 379 | Lₐ₂₀₀₃ | L_{b1} | 380 | Lₐ₂₀₀₃ | L_{b3} |
| 381 | Lₐ₂₀₁₃ | L_{b1} | 382 | Lₐ₂₀₁₃ | L_{b3} |
| 383 | Lₐ₂₀₁₄ | L_{b1} | 384 | Lₐ₂₀₁₄ | L_{b3} |
| 385 | Lₐ₂₀₁₅ | L_{b1} | 386 | Lₐ₂₀₁₅ | L_{b3} |
| 387 | Lₐ₂₀₃₃ | L_{b1} | 388 | Lₐ₂₀₃₃ | L_{b3} |
| 389 | Lₐ₂₁₀₄ | L_{b1} | 390 | Lₐ₂₁₀₄ | L_{b3} |
| 391 | Lₐ₂₃₂₆ | L_{b1} | 392 | Lₐ₂₃₂₆ | L_{b3} |
| 393 | Lₐ₂₃₃₇ | L_{b1} | 394 | Lₐ₂₃₃₇ | L_{b3} |
| 395 | Lₐ₂₄₃₆ | L_{b1} | 396 | Lₐ₂₄₃₆ | L_{b3} |
| 397 | Lₐ₂₄₃₇ | L_{b1} | 398 | Lₐ₂₄₃₇ | L_{b3} |
| 399 | Lₐ₂₅₁₄ | L_{b1} | 400 | Lₐ₂₅₁₄ | L_{b3} |
| 401 | Lₐ₂₆₁₂ | L_{b1} | 402 | Lₐ₂₆₁₂ | L_{b3} |
| 403 | Lₐ₂₆₁₈ | L_{b1} | 404 | Lₐ₂₆₁₈ | L_{b3} |
| 405 | Lₐ₂₆₄₃ | L_{b1} | 406 | Lₐ₂₆₄₃ | L_{b3} |
| 407 | Lₐ₂₆₅₄ | L_{b1} | 408 | Lₐ₂₆₅₄ | L_{b3} |
| 409 | Lₐ₂₇₁₄ | L_{b1} | 410 | Lₐ₂₇₁₄ | L_{b3} |
| 411 | Lₐ₂₇₈₅ | L_{b1} | 412 | Lₐ₂₇₈₅ | L_{b3} |
| 413 | Lₐ₂₈₅₆ | L_{b1} | 414 | Lₐ₂₈₅₆ | L_{b3} |
| 415 | Lₐ₂₉₂₇ | L_{b1} | 416 | Lₐ₂₉₂₇ | L_{b3} |
| 417 | Lₐ₃₃₃₇ | L_{b1} | 418 | Lₐ₃₃₃₇ | L_{b3} |
| 419 | Lₐ₃₃₃₈ | L_{b1} | 420 | Lₐ₃₃₃₈ | L_{b3} |
| 421 | Lₐ₃₃₃₉ | L_{b1} | 422 | Lₐ₃₃₃₉ | L_{b3} |
| 423 | Lₐ₃₃₄₀ | L_{b1} | 424 | Lₐ₃₃₄₀ | L_{b3} |
| 425 | Lₐ₃₃₄₁ | L_{b1} | 426 | Lₐ₃₃₄₁ | L_{b3} |
| 427 | Lₐ₁ | L_{b8} | 428 | Lₐ₁ | L_{b20} |
| 429 | Lₐ₁₂ | L_{b8} | 430 | Lₐ₁₂ | L_{b20} |
| 431 | Lₐ₂₁ | L_{b8} | 432 | Lₐ₂₁ | L_{b20} |
| 433 | Lₐ₂₃ | L_{b8} | 434 | Lₐ₂₃ | L_{b20} |
| 435 | Lₐ₃₃ | L_{b8} | 436 | Lₐ₃₃ | L_{b20} |
| 437 | Lₐ₄₂ | L_{b8} | 438 | Lₐ₄₂ | L_{b20} |
| 439 | Lₐ₆₃ | L_{b8} | 440 | Lₐ₆₃ | L_{b20} |
| 441 | Lₐ₆₆ | L_{b8} | 442 | Lₐ₆₆ | L_{b20} |
| 443 | Lₐ₇₅ | L_{b8} | 444 | Lₐ₇₅ | L_{b20} |
| 445 | Lₐ₈₄ | L_{b8} | 446 | Lₐ₈₄ | L_{b20} |
| 447 | Lₐ₁₀₅ | L_{b8} | 448 | Lₐ₁₀₅ | L_{b20} |
| 449 | Lₐ₁₀₇ | L_{b8} | 450 | Lₐ₁₀₇ | L_{b20} |
| 451 | Lₐ₁₂₁ | L_{b8} | 452 | Lₐ₁₂₁ | L_{b20} |
| 453 | Lₐ₁₂₈ | L_{b8} | 454 | Lₐ₁₂₈ | L_{b20} |
| 455 | Lₐ₁₃₀ | L_{b8} | 456 | Lₐ₁₃₀ | L_{b20} |
| 457 | Lₐ₁₃₁ | L_{b8} | 458 | Lₐ₁₃₁ | L_{b20} |
| 459 | Lₐ₁₃₂ | L_{b8} | 460 | Lₐ₁₃₂ | L_{b20} |
| 461 | Lₐ₁₃₃ | L_{b8} | 462 | Lₐ₁₃₃ | L_{b20} |
| 463 | Lₐ₁₃₅ | L_{b8} | 464 | Lₐ₁₃₅ | L_{b20} |
| 465 | Lₐ₁₃₆ | L_{b8} | 466 | Lₐ₁₃₆ | L_{b20} |
| 467 | Lₐ₁₄₀ | L_{b8} | 468 | Lₐ₁₄₀ | L_{b20} |
| 469 | Lₐ₁₅₀ | L_{b8} | 470 | Lₐ₁₅₀ | L_{b20} |
| 471 | Lₐ₁₅₂ | L_{b8} | 472 | Lₐ₁₅₂ | L_{b20} |
| 473 | Lₐ₁₅₄ | L_{b8} | 474 | Lₐ₁₅₄ | L_{b20} |
| 475 | Lₐ₁₅₇ | L_{b8} | 476 | Lₐ₁₅₇ | L_{b20} |
| 477 | Lₐ₁₆₁ | L_{b8} | 478 | Lₐ₁₆₁ | L_{b20} |
| 479 | Lₐ₁₇₀ | L_{b8} | 480 | Lₐ₁₇₀ | L_{b20} |
| 481 | Lₐ₁₇₁ | L_{b8} | 482 | Lₐ₁₇₁ | L_{b20} |
| 483 | Lₐ₁₈₀ | L_{b8} | 484 | Lₐ₁₈₀ | L_{b20} |
| 485 | Lₐ₁₈₂ | L_{b8} | 486 | Lₐ₁₈₂ | L_{b20} |
| 487 | Lₐ₁₈₉ | L_{b8} | 488 | Lₐ₁₈₉ | L_{b20} |
| 489 | Lₐ₁₉₁ | L_{b8} | 490 | Lₐ₁₉₁ | L_{b20} |
| 491 | Lₐ₁₉₃ | L_{b8} | 492 | Lₐ₁₉₃ | L_{b20} |
| 493 | Lₐ₂₀₁ | L_{b8} | 494 | Lₐ₂₀₁ | L_{b20} |
| 495 | Lₐ₂₀₃ | L_{b8} | 496 | Lₐ₂₀₃ | L_{b20} |
| 497 | Lₐ₂₀₅ | L_{b8} | 498 | Lₐ₂₀₅ | L_{b20} |
| 499 | Lₐ₂₀₆ | L_{b8} | 500 | Lₐ₂₀₆ | L_{b20} |
| 501 | Lₐ₂₁₂ | L_{b8} | 502 | Lₐ₂₁₂ | L_{b20} |
| 503 | Lₐ₂₂₄ | L_{b8} | 504 | Lₐ₂₂₄ | L_{b20} |
| 505 | Lₐ₂₂₇ | L_{b8} | 506 | Lₐ₂₂₇ | L_{b20} |
| 507 | Lₐ₂₃₃ | L_{b8} | 508 | Lₐ₂₃₃ | L_{b20} |
| 509 | Lₐ₂₄₀ | L_{b8} | 510 | Lₐ₂₄₀ | L_{b20} |
| 511 | Lₐ₂₄₃ | L_{b8} | 512 | La₂₄₃ | L_{b20} |
| 513 | Lₐ₂₅₂ | L_{b8} | 514 | Lₐ₂₅₂ | L_{b20} |
| 515 | Lₐ₂₅₃ | L_{b8} | 516 | Lₐ₂₅₃ | L_{b20} |
| 517 | Lₐ₂₆₅ | L_{b8} | 518 | Lₐ₂₆₅ | L_{b20} |
| 519 | Lₐ₂₇₂ | L_{b8} | 520 | Lₐ₂₇₂ | L_{b20} |
| 521 | Lₐ₂₇₃ | L_{b8} | 522 | Lₐ₂₇₃ | L_{b20} |
| 523 | Lₐ₂₇₈ | L_{b8} | 524 | Lₐ₂₇₈ | L_{b20} |
| 525 | Lₐ₂₈₂ | L_{b8} | 526 | Lₐ₂₈₂ | L_{b20} |
| 527 | Lₐ₂₈₃ | L_{b8} | 528 | Lₐ₂₈₃ | L_{b20} |
| 529 | Lₐ₂₉₃ | L_{b8} | 530 | Lₐ₂₉₃ | L_{b20} |
| 531 | Lₐ₂₉₄ | L_{b8} | 532 | Lₐ₂₉₄ | L_{b20} |
| 533 | Lₐ₂₉₅ | L_{b8} | 534 | Lₐ₂₉₅ | L_{b20} |
| 535 | Lₐ₃₁₀ | L_{b8} | 536 | Lₐ₃₁₀ | L_{b20} |
| 537 | Lₐ₃₁₄ | L_{b8} | 538 | Lₐ₃₁₄ | L_{b20} |
| 539 | Lₐ₃₂₅ | L_{b8} | 540 | Lₐ₃₂₅ | L_{b20} |
| 541 | Lₐ₃₄₃ | L_{b8} | 542 | Lₐ₃₄₃ | L_{b20} |
| 543 | Lₐ₃₄₅ | L_{b8} | 544 | Lₐ₃₄₅ | L_{b20} |
| 545 | Lₐ₃₆₃ | L_{b8} | 546 | Lₐ₃₆₃ | L_{b20} |
| 547 | Lₐ₃₈₅ | L_{b8} | 548 | Lₐ₃₈₅ | L_{b20} |
| 549 | Lₐ₃₉₆ | L_{b8} | 550 | Lₐ₃₉₆ | L_{b20} |
| 551 | Lₐ₄₀₇ | L_{b8} | 552 | Lₐ₄₀₇ | L_{b20} |
| 553 | Lₐ₄₀₈ | L_{b8} | 554 | Lₐ₄₀₈ | L_{b20} |
| 555 | Lₐ₄₁₄ | L_{b8} | 556 | Lₐ₄₁₄ | L_{b20} |
| 557 | Lₐ₄₂₃ | L_{b8} | 558 | Lₐ₄₂₃ | L_{b20} |
| 559 | Lₐ₄₃₄ | L_{b8} | 560 | Lₐ₄₃₄ | L_{b20} |
| 561 | Lₐ₄₅₆ | L_{b8} | 562 | Lₐ₄₅₆ | L_{b20} |
| 563 | Lₐ₄₆₇ | L_{b8} | 564 | Lₐ₄₆₇ | L_{b20} |
| 565 | Lₐ₆₃₀ | L_{b8} | 566 | Lₐ₆₃₀ | L_{b20} |
| 567 | Lₐ₆₃₁ | L_{b8} | 568 | Lₐ₆₃₁ | L_{b20} |
| 569 | Lₐ₆₄₅ | L_{b8} | 570 | Lₐ₆₄₅ | L_{b20} |
| 571 | Lₐ₆₄₆ | L_{b8} | 572 | Lₐ₆₄₆ | L_{b20} |
| 573 | Lₐ₆₄₇ | L_{b8} | 574 | Lₐ₆₄₇ | L_{b20} |
| 575 | Lₐ₆₄₈ | L_{b8} | 576 | Lₐ₆₄₈ | L_{b20} |
| 577 | Lₐ₆₆₅ | L_{b8} | 578 | Lₐ₆₆₅ | L_{b20} |
| 579 | Lₐ₇₄₆ | L_{b8} | 580 | Lₐ₇₄₆ | L_{b20} |
| 581 | Lₐ₇₄₇ | L_{b8} | 582 | Lₐ₇₄₇ | L_{b20} |
| 583 | Lₐ₈₂₄ | L_{b8} | 584 | Lₐ₈₂₄ | L_{b20} |
| 585 | Lₐ₈₂₅ | L_{b8} | 586 | Lₐ₈₂₅ | L_{b20} |
| 587 | Lₐ₈₄₄ | L_{b8} | 588 | Lₐ₈₄₄ | L_{b20} |
| 589 | Lₐ₈₄₆ | L_{b8} | 590 | Lₐ₈₄₆ | L_{b20} |
| 591 | Lₐ₈₆₅ | L_{b8} | 592 | Lₐ₈₆₅ | L_{b20} |
| 593 | Lₐ₈₆₈ | L_{b8} | 594 | Lₐ₈₆₈ | L_{b20} |
| 595 | Lₐ₈₈₉ | L_{b8} | 596 | Lₐ₈₈₉ | L_{b20} |
| 597 | Lₐ₉₀₉ | L_{b8} | 598 | Lₐ₉₀₉ | L_{b20} |
| 599 | Lₐ₉₁₃ | L_{b8} | 600 | Lₐ₉₁₃ | L_{b20} |
| 601 | Lₐ₉₁₅ | L_{b8} | 602 | Lₐ₉₁₅ | L_{b20} |
| 603 | Lₐ₉₂₀ | L_{b8} | 604 | Lₐ₉₂₀ | L_{b20} |
| 605 | Lₐ₉₂₂ | L_{b8} | 606 | Lₐ₉₂₂ | L_{b20} |
| 607 | Lₐ₉₂₃ | L_{b8} | 608 | Lₐ₉₂₃ | L_{b20} |
| 609 | Lₐ₉₂₄ | L_{b8} | 610 | Lₐ₉₂₄ | L_{b20} |
| 611 | Lₐ₉₂₅ | L_{b8} | 612 | Lₐ₉₂₅ | L_{b20} |
| 613 | Lₐ₉₂₈ | L_{b8} | 614 | Lₐ₉₂₈ | L_{b20} |
| 615 | Lₐ₉₅₃ | L_{b8} | 616 | Lₐ₉₅₃ | L_{b20} |
| 617 | Lₐ₉₅₄ | L_{b8} | 618 | Lₐ₉₅₄ | L_{b20} |
| 619 | Lₐ₉₇₄ | L_{b8} | 620 | Lₐ₉₇₄ | L_{b20} |
| 621 | Lₐ₉₇₆ | L_{b8} | 622 | Lₐ₉₇₆ | L_{b20} |
| 623 | Lₐ₉₉₅ | L_{b8} | 624 | Lₐ₉₉₅ | L_{b20} |
| 625 | Lₐ₁₀₀₆ | L_{b8} | 626 | Lₐ₁₀₀₆ | L_{b20} |
| 627 | Lₐ₁₀₁₇ | L_{b8} | 628 | Lₐ₁₀₁₇ | L_{b20} |
| 629 | Lₐ₁₀₁₈ | L_{b8} | 630 | Lₐ₁₀₁₈ | L_{b20} |
| 631 | Lₐ₁₀₂₃ | L_{b8} | 632 | Lₐ₁₀₂₃ | L_{b20} |
| 633 | Lₐ₁₀₂₄ | L_{b8} | 634 | Lₐ₁₀₂₄ | L_{b20} |
| 635 | Lₐ₁₀₂₆ | L_{b8} | 636 | Lₐ₁₀₂₆ | L_{b20} |
| 637 | Lₐ₁₀₈₈ | L_{b8} | 638 | Lₐ₁₀₈₈ | L_{b20} |
| 639 | Lₐ₁₀₈₉ | L_{b8} | 640 | Lₐ₁₀₈₉ | L_{b20} |
| 641 | Lₐ₁₀₉₅ | L_{b8} | 642 | Lₐ₁₀₉₅ | L_{b20} |
| 643 | Lₐ₁₁₀₀ | L_{b8} | 644 | Lₐ₁₁₀₀ | L_{b20} |
| 645 | Lₐ₁₁₁₆ | L_{b8} | 646 | Lₐ₁₁₁₆ | L_{b20} |
| 647 | Lₐ₁₁₁₈ | L_{b8} | 648 | Lₐ₁₁₁₈ | L_{b20} |
| 649 | Lₐ₁₁₃₆ | L_{b8} | 650 | Lₐ₁₁₃₆ | L_{b20} |
| 651 | Lₐ₁₁₄₈ | L_{b8} | 652 | Lₐ₁₁₄₈ | L_{b20} |
| 653 | Lₐ₁₁₅₈ | L_{b8} | 654 | Lₐ₁₁₅₈ | L_{b20} |
| 655 | Lₐ₁₁₅₉ | L_{b8} | 656 | Lₐ₁₁₅₉ | L_{b20} |
| 657 | Lₐ₁₁₆₁ | L_{b8} | 658 | Lₐ₁₁₆₁ | L_{b20} |
| 659 | Lₐ₁₁₆₆ | L_{b8} | 660 | Lₐ₁₁₆₆ | L_{b20} |
| 661 | Lₐ₁₁₇₁ | L_{b8} | 662 | Lₐ₁₁₇₁ | L_{b20} |
| 663 | Lₐ₁₁₈₇ | L_{b8} | 664 | Lₐ₁₁₈₇ | L_{b20} |
| 665 | Lₐ₁₁₉₂ | L_{b8} | 666 | Lₐ₁₁₉₂ | L_{b20} |
| 667 | Lₐ₁₂₀₅ | L_{b8} | 668 | Lₐ₁₂₀₅ | L_{b20} |
| 669 | Lₐ₁₂₀₈ | L_{b8} | 670 | Lₐ₁₂₀₈ | L_{b20} |
| 671 | Lₐ₁₂₁₇ | L_{b8} | 672 | Lₐ₁₂₁₇ | L_{b20} |
| 673 | Lₐ₁₂₁₉ | L_{b8} | 674 | Lₐ₁₂₁₉ | L_{b20} |
| 675 | Lₐ₁₂₃₀ | L_{b8} | 676 | Lₐ₁₂₃₀ | L_{b20} |
| 677 | Lₐ₁₂₃₇ | L_{b8} | 678 | Lₐ₁₂₃₇ | L_{b20} |
| 679 | Lₐ₁₂₃₈ | L_{b8} | 680 | Lₐ₁₂₃₈ | L_{b20} |
| 681 | Lₐ₁₂₃₉ | L_{b8} | 682 | Lₐ₁₂₃₉ | L_{b20} |
| 683 | Lₐ₁₂₄₅ | L_{b8} | 684 | Lₐ₁₂₄₅ | L_{b20} |
| 685 | Lₐ₁₂₄₆ | L_{b8} | 686 | Lₐ₁₂₄₆ | L_{b20} |
| 687 | Lₐ₁₂₄₇ | L_{b8} | 688 | Lₐ₁₂₄₇ | L_{b20} |
| 689 | Lₐ₁₂₄₈ | L_{b8} | 690 | Lₐ₁₂₄₈ | L_{b20} |
| 691 | Lₐ₁₂₅₈ | L_{b8} | 692 | Lₐ₁₂₅₈ | L_{b20} |
| 693 | Lₐ₁₂₆₀ | L_{b8} | 694 | Lₐ₁₂₆₀ | L_{b20} |
| 695 | Lₐ₁₂₆₁ | L_{b8} | 696 | Lₐ₁₂₆₁ | L_{b20} |
| 697 | Lₐ₁₂₇₇ | L_{b8} | 698 | Lₐ₁₂₇₇ | L_{b20} |
| 699 | Lₐ₁₂₇₈ | L_{b8} | 700 | Lₐ₁₂₇₈ | L_{b20} |
| 701 | Lₐ₁₂₇₉ | L_{b8} | 702 | Lₐ₁₂₇₉ | L_{b20} |
| 703 | Lₐ₁₂₈₈ | L_{b8} | 704 | Lₐ₁₂₈₈ | L_{b20} |
| 705 | Lₐ₁₂₈₉ | L_{b8} | 706 | Lₐ₁₂₈₉ | L_{b20} |
| 707 | Lₐ₁₃₀₁ | L_{b8} | 708 | Lₐ₁₃₀₁ | L_{b20} |
| 709 | Lₐ₁₃₀₂ | L_{b8} | 710 | Lₐ₁₃₀₂ | L_{b20} |
| 711 | Lₐ₁₄₄₂ | L_{b8} | 712 | Lₐ₁₄₄₂ | L_{b20} |
| 713 | Lₐ₁₄₄₈ | L_{b8} | 714 | Lₐ₁₄₄₈ | L_{b20} |
| 715 | Lₐ₁₄₄₉ | L_{b8} | 716 | Lₐ₁₄₄₉ | L_{b20} |
| 717 | Lₐ₁₄₆₀ | L_{b8} | 718 | Lₐ₁₄₆₀ | L_{b20} |
| 719 | Lₐ₁₄₇₁ | L_{b8} | 720 | Lₐ₁₄₇₁ | L_{b20} |
| 721 | Lₐ₁₅₆₉ | L_{b8} | 722 | Lₐ₁₅₆₉ | L_{b20} |
| 723 | Lₐ₁₅₇₀ | L_{b8} | 724 | Lₐ₁₅₇₀ | L_{b20} |
| 725 | Lₐ₁₆₄₇ | L_{b8} | 726 | Lₐ₁₆₄₇ | L_{b20} |
| 727 | Lₐ₁₆₄₈ | L_{b8} | 728 | Lₐ₁₆₄₈ | L_{b20} |
| 729 | Lₐ₁₆₄₉ | L_{b8} | 730 | Lₐ₁₆₄₉ | L_{b20} |
| 731 | Lₐ₁₆₅₀ | L_{b8} | 732 | Lₐ₁₆₅₀ | L_{b20} |
| 733 | Lₐ₁₆₅₁ | L_{b8} | 734 | Lₐ₁₆₅₁ | L_{b20} |
| 735 | Lₐ₁₆₇₇ | L_{b8} | 736 | Lₐ₁₆₇₇ | L_{b20} |
| 737 | Lₐ₁₆₇₈ | L_{b8} | 738 | Lₐ₁₆₇₈ | L_{b20} |
| 739 | Lₐ₁₆₇₉ | L_{b8} | 740 | Lₐ₁₆₇₉ | L_{b20} |
| 741 | Lₐ₁₆₈₀ | L_{b8} | 742 | Lₐ₁₆₈₀ | L_{b20} |
| 743 | Lₐ₁₆₉₁ | L_{b8} | 744 | Lₐ₁₆₉₁ | L_{b20} |
| 745 | Lₐ₁₆₉₃ | L_{b8} | 746 | Lₐ₁₆₉₃ | L_{b20} |
| 747 | Lₐ₁₆₉₅ | L_{b8} | 748 | Lₐ₁₆₉₅ | L_{b20} |
| 749 | Lₐ₁₆₉₆ | L_{b8} | 750 | Lₐ₁₆₉₆ | L_{b20} |
| 751 | Lₐ₁₆₉₉ | L_{b8} | 752 | Lₐ₁₆₉₉ | L_{b20} |
| 753 | Lₐ₁₇₀₁ | L_{b8} | 754 | Lₐ₁₇₀₁ | L_{b20} |
| 755 | Lₐ₁₇₀₂ | L_{b8} | 756 | Lₐ₁₇₀₂ | L_{b20} |
| 757 | Lₐ₁₇₁₂ | L_{b8} | 758 | Lₐ₁₇₁₂ | L_{b20} |
| 759 | Lₐ₁₇₁₃ | L_{b8} | 760 | Lₐ₁₇₁₃ | L_{b20} |
| 761 | Lₐ₁₇₃₅ | L_{b8} | 762 | Lₐ₁₇₃₅ | L_{b20} |
| 763 | Lₐ₁₇₉₅ | L_{b8} | 764 | Lₐ₁₇₉₅ | L_{b20} |
| 765 | Lₐ₁₈₂₀ | L_{b8} | 766 | Lₐ₁₈₂₀ | L_{b20} |
| 767 | Lₐ₁₈₉₁ | L_{b8} | 768 | Lₐ₁₈₉₁ | L_{b20} |
| 769 | Lₐ₁₈₉₂ | L_{b8} | 770 | Lₐ₁₈₉₂ | L_{b20} |
| 771 | Lₐ₁₈₉₃ | L_{b8} | 772 | Lₐ₁₈₉₃ | L_{b20} |
| 773 | Lₐ₁₈₉₉ | L_{b8} | 774 | Lₐ₁₈₉₉ | L_{b20} |
| 775 | Lₐ₁₉₀₂ | L_{b8} | 776 | Lₐ₁₉₀₂ | L_{b20} |
| 777 | Lₐ₁₉₁₃ | L_{b8} | 778 | Lₐ₁₉₁₃ | L_{b20} |
| 779 | Lₐ₁₉₁₄ | L_{b8} | 780 | Lₐ₁₉₁₄ | L_{b20} |
| 781 | Lₐ₁₉₃₃ | L_{b8} | 782 | Lₐ₁₉₃₃ | L_{b20} |
| 783 | Lₐ₁₉₄₅ | L_{b8} | 784 | Lₐ₁₉₄₅ | L_{b20} |
| 785 | Lₐ₁₉₅₄ | L_{b8} | 786 | Lₐ₁₉₅₄ | L_{b20} |
| 787 | Lₐ₁₉₅₅ | L_{b8} | 788 | Lₐ₁₉₅₅ | L_{b20} |
| 789 | Lₐ₁₉₅₆ | L_{b8} | 790 | Lₐ₁₉₅₆ | L_{b20} |
| 791 | Lₐ₁₉₆₂ | L_{b8} | 792 | Lₐ₁₉₆₂ | L_{b20} |
| 793 | Lₐ₁₉₆₄ | L_{b8} | 794 | Lₐ₁₉₆₄ | L_{b20} |
| 795 | Lₐ₁₉₆₅ | L_{b8} | 796 | Lₐ₁₉₆₅ | L_{b20} |
| 797 | Lₐ₁₉₆₆ | L_{b8} | 798 | Lₐ₁₉₆₆ | L_{b20} |
| 799 | Lₐ₁₉₇₀ | L_{b8} | 800 | Lₐ₁₉₇₀ | L_{b20} |
| 801 | Lₐ₁₉₇₃ | L_{b8} | 802 | Lₐ₁₉₇₃ | L_{b20} |
| 803 | Lₐ₂₀₀₂ | L_{b8} | 804 | Lₐ₂₀₀₂ | L_{b20} |
| 805 | Lₐ₂₀₀₃ | L_{b8} | 806 | Lₐ₂₀₀₃ | L_{b20} |
| 807 | Lₐ₂₀₁₃ | L_{b8} | 808 | Lₐ₂₀₁₃ | L_{b20} |
| 809 | Lₐ₂₀₁₄ | L_{b8} | 810 | Lₐ₂₀₁₄ | L_{b20} |
| 811 | Lₐ₂₀₁₅ | L_{b8} | 812 | Lₐ₂₀₁₅ | L_{b20} |
| 813 | Lₐ₂₀₃₃ | L_{b8} | 814 | Lₐ₂₀₃₃ | L_{b20} |
| 815 | Lₐ₂₁₀₄ | L_{b8} | 816 | Lₐ₂₁₀₄ | L_{b20} |
| 817 | Lₐ₂₃₂₆ | L_{b8} | 818 | Lₐ₂₃₂₆ | L_{b20} |
| 819 | Lₐ₂₃₃₇ | L_{b8} | 820 | Lₐ₂₃₃₇ | L_{b20} |
| 821 | Lₐ₂₄₃₆ | L_{b8} | 822 | Lₐ₂₄₃₆ | L_{b20} |
| 823 | Lₐ₂₄₃₇ | L_{b8} | 824 | Lₐ₂₄₃₇ | L_{b20} |
| 825 | Lₐ₂₅₁₄ | L_{b8} | 826 | Lₐ₂₅₁₄ | L_{b20} |
| 827 | Lₐ₂₆₁₂ | L_{b8} | 828 | Lₐ₂₆₁₂ | L_{b20} |
| 829 | Lₐ₂₆₁₈ | L_{b8} | 830 | Lₐ₂₆₁₈ | L_{b20} |
| 831 | Lₐ₂₆₄₃ | L_{b8} | 832 | Lₐ₂₆₄₃ | L_{b20} |
| 833 | Lₐ₂₆₅₄ | L_{b8} | 834 | Lₐ₂₆₅₄ | L_{b20} |
| 835 | Lₐ₂₇₁₄ | L_{b8} | 836 | Lₐ₂₇₁₄ | L_{b20} |
| 837 | Lₐ₂₇₈₅ | L_{b8} | 838 | Lₐ₂₇₈₅ | L_{b20} |
| 839 | Lₐ₂₈₅₆ | L_{b8} | 840 | Lₐ₂₈₅₆ | L_{b20} |
| 841 | Lₐ₂₉₂₇ | L_{b8} | 842 | Lₐ₂₉₂₇ | L_{b20} |
| 843 | Lₐ₃₃₃₇ | L_{b8} | 844 | Lₐ₃₃₃₇ | L_{b20} |
| 845 | Lₐ₃₃₃₈ | L_{b8} | 846 | Lₐ₃₃₃₈ | L_{b20} |
| 847 | Lₐ₃₃₃₉ | L_{b8} | 848 | Lₐ₃₃₃₉ | L_{b20} |
| 849 | Lₐ₃₃₄₀ | L_{b8} | 850 | Lₐ₃₃₄₀ | L_{b20} |
| 851 | Lₐ₃₃₄₁ | L_{b8} | 852 | Lₐ₃₃₄₁ | L_{b20} |
| 853 | Lₐ₁ | L_{b118} | 854 | Lₐ₁ | L_{b132} |
| 855 | Lₐ₁₂ | L_{b118} | 856 | Lₐ₁₂ | L_{b132} |
| 857 | Lₐ₂₁ | L_{b118} | 858 | Lₐ₂₁ | L_{b132} |
| 859 | Lₐ₂₃ | L_{b118} | 860 | Lₐ₂₃ | L_{b132} |
| 861 | Lₐ₃₃ | L_{b118} | 862 | Lₐ₃₃ | L_{b132} |
| 863 | Lₐ₄₂ | L_{b118} | 864 | Lₐ₄₂ | L_{b132} |
| 865 | Lₐ₆₃ | L_{b118} | 866 | Lₐ₆₃ | L_{b132} |
| 867 | Lₐ₆₆ | L_{b118} | 868 | Lₐ₆₆ | L_{b132} |
| 869 | Lₐ₇₅ | L_{b118} | 870 | Lₐ₇₅ | L_{b132} |
| 871 | Lₐ₈₄ | L_{b118} | 872 | Lₐ₈₄ | L_{b132} |
| 873 | Lₐ₁₀₅ | L_{b118} | 874 | Lₐ₁₀₅ | L_{b132} |
| 875 | Lₐ₁₀₇ | L_{b118} | 876 | Lₐ₁₀₇ | L_{b132} |
| 877 | Lₐ₁₂₁ | L_{b118} | 878 | Lₐ₁₂₁ | L_{b132} |
| 879 | Lₐ₁₂₈ | L_{b118} | 880 | Lₐ₁₂₈ | L_{b132} |
| 881 | Lₐ₁₃₀ | L_{b118} | 882 | Lₐ₁₃₀ | L_{b132} |
| 883 | Lₐ₁₃₁ | L_{b118} | 884 | Lₐ₁₃₁ | L_{b132} |
| 885 | Lₐ₁₃₂ | L_{b118} | 886 | Lₐ₁₃₂ | L_{b132} |
| 887 | Lₐ₁₃₃ | L_{b118} | 888 | Lₐ₁₃₃ | L_{b132} |
| 889 | Lₐ₁₃₅ | L_{b118} | 890 | Lₐ₁₃₅ | L_{b132} |
| 891 | Lₐ₁₃₆ | L_{b118} | 892 | Lₐ₁₃₆ | L_{b132} |
| 893 | Lₐ₁₄₀ | L_{b118} | 894 | Lₐ₁₄₀ | L_{b132} |
| 895 | Lₐ₁₅₀ | L_{b118} | 896 | Lₐ₁₅₀ | L_{b132} |
| 897 | Lₐ₁₅₂ | L_{b118} | 898 | Lₐ₁₅₂ | L_{b132} |
| 899 | Lₐ₁₅₄ | L_{b118} | 900 | Lₐ₁₅₄ | L_{b132} |
| 901 | Lₐ₁₅₇ | L_{b118} | 902 | Lₐ₁₅₇ | L_{b132} |
| 903 | Lₐ₁₆₁ | L_{b118} | 904 | Lₐ₁₆₁ | L_{b132} |
| 905 | Lₐ₁₇₀ | L_{b118} | 906 | Lₐ₁₇₀ | L_{b132} |
| 907 | Lₐ₁₇₁ | L_{b118} | 908 | Lₐ₁₇₁ | L_{b132} |
| 909 | Lₐ₁₈₀ | L_{b118} | 910 | Lₐ₁₈₀ | L_{b132} |
| 911 | Lₐ₁₈₂ | L_{b118} | 912 | Lₐ₁₈₂ | L_{b132} |
| 913 | Lₐ₁₈₉ | L_{b118} | 914 | Lₐ₁₈₉ | L_{b132} |
| 915 | Lₐ₁₉₁ | L_{b118} | 916 | Lₐ₁₉₁ | L_{b132} |
| 917 | Lₐ₁₉₃ | L_{b118} | 918 | Lₐ₁₉₃ | L_{b132} |
| 919 | Lₐ₂₀₁ | L_{b118} | 920 | Lₐ₂₀₁ | L_{b132} |
| 921 | Lₐ₂₀₃ | L_{b118} | 922 | Lₐ₂₀₃ | L_{b132} |
| 923 | Lₐ₂₀₅ | L_{b118} | 924 | Lₐ₂₀₅ | L_{b132} |
| 925 | Lₐ₂₀₆ | L_{b118} | 926 | Lₐ₂₀₆ | L_{b132} |
| 927 | Lₐ₂₁₂ | L_{b118} | 928 | Lₐ₂₁₂ | L_{b132} |
| 929 | Lₐ₂₂₄ | L_{b118} | 930 | Lₐ₂₂₄ | L_{b132} |
| 931 | Lₐ₂₂₇ | L_{b118} | 932 | Lₐ₂₂₇ | L_{b132} |
| 933 | Lₐ₂₃₃ | L_{b118} | 934 | Lₐ₂₃₃ | L_{b132} |
| 935 | Lₐ₂₄₀ | L_{b118} | 936 | Lₐ₂₄₀ | L_{b132} |
| 937 | Lₐ₂₄₃ | L_{b118} | 938 | Lₐ₂₄₃ | L_{b132} |
| 939 | Lₐ₂₅₂ | L_{b118} | 940 | Lₐ₂₅₂ | L_{b132} |
| 941 | Lₐ₂₅₃ | L_{b118} | 942 | Lₐ₂₅₃ | L_{b132} |
| 943 | Lₐ₂₆₅ | L_{b118} | 944 | Lₐ₂₆₅ | L_{b132} |
| 945 | Lₐ₂₇₂ | L_{b118} | 946 | Lₐ₂₇₂ | L_{b132} |
| 947 | Lₐ₂₇₃ | L_{b118} | 948 | Lₐ₂₇₃ | L_{b132} |
| 949 | Lₐ₂₇₈ | L_{b118} | 950 | Lₐ₂₇₈ | L_{b132} |
| 951 | Lₐ₂₈₂ | L_{b118} | 952 | Lₐ₂₈₂ | L_{b132} |
| 953 | Lₐ₂₈₃ | L_{b118} | 954 | Lₐ₂₈₃ | L_{b132} |
| 955 | Lₐ₂₉₃ | L_{b118} | 956 | Lₐ₂₉₃ | L_{b132} |
| 957 | Lₐ₂₉₄ | L_{b118} | 958 | Lₐ₂₉₄ | L_{b132} |
| 959 | Lₐ₂₉₅ | L_{b118} | 960 | Lₐ₂₉₅ | L_{b132} |
| 961 | Lₐ₃₁₀ | L_{b118} | 962 | Lₐ₃₁₀ | L_{b132} |
| 963 | Lₐ₃₁₄ | L_{b118} | 964 | Lₐ₃₁₄ | L_{b132} |
| 965 | Lₐ₃₂₅ | L_{b118} | 966 | Lₐ₃₂₅ | L_{b132} |
| 967 | Lₐ₃₄₃ | L_{b118} | 968 | Lₐ₃₄₃ | L_{b132} |
| 969 | Lₐ₃₄₅ | L_{b118} | 970 | Lₐ₃₄₅ | L_{b132} |
| 971 | Lₐ₃₆₃ | L_{b118} | 972 | Lₐ₃₆₃ | L_{b132} |
| 973 | Lₐ₃₈₅ | L_{b118} | 974 | Lₐ₃₈₅ | L_{b132} |
| 975 | Lₐ₃₉₆ | L_{b118} | 976 | Lₐ₃₉₆ | L_{b132} |
| 977 | Lₐ₄₀₇ | L_{b118} | 978 | Lₐ₄₀₇ | L_{b132} |
| 979 | Lₐ₄₀₈ | L_{b118} | 980 | Lₐ₄₀₈ | L_{b132} |
| 981 | Lₐ₄₁₄ | L_{b118} | 982 | Lₐ₄₁₄ | L_{b132} |
| 983 | Lₐ₄₂₃ | L_{b118} | 984 | Lₐ₄₂₃ | L_{b132} |
| 985 | Lₐ₄₃₄ | L_{b118} | 986 | Lₐ₄₃₄ | L_{b132} |
| 987 | Lₐ₄₅₆ | L_{b118} | 988 | Lₐ₄₅₆ | L_{b132} |
| 989 | Lₐ₄₆₇ | L_{b118} | 990 | Lₐ₄₆₇ | L_{b132} |
| 991 | Lₐ₆₃₀ | L_{b118} | 992 | Lₐ₆₃₀ | L_{b132} |
| 993 | Lₐ₆₃₁ | L_{b118} | 994 | Lₐ₆₃₁ | L_{b132} |
| 995 | Lₐ₆₄₅ | L_{b118} | 996 | Lₐ₆₄₅ | L_{b132} |
| 997 | Lₐ₆₄₆ | L_{b118} | 998 | Lₐ₆₄₆ | L_{b132} |
| 999 | Lₐ₆₄₇ | L_{b118} | 1000 | Lₐ₆₄₇ | L_{b132} |
| 1001 | Lₐ₆₄₈ | L_{b118} | 1002 | Lₐ₆₄₈ | L_{b132} |
| 1003 | Lₐ₆₆₅ | L_{b118} | 1004 | Lₐ₆₆₅ | L_{b132} |
| 1005 | Lₐ₇₄₆ | L_{b118} | 1006 | Lₐ₇₄₆ | L_{b132} |
| 1007 | Lₐ₇₄₇ | L_{b118} | 1008 | Lₐ₇₄₇ | L_{b132} |
| 1009 | Lₐ₈₂₄ | L_{b118} | 1010 | Lₐ₈₂₄ | L_{b132} |
| 1011 | Lₐ₈₂₅ | L_{b118} | 1012 | Lₐ₈₂₅ | L_{b132} |
| 1013 | Lₐ₈₄₄ | L_{b118} | 1014 | Lₐ₈₄₄ | L_{b132} |
| 1015 | Lₐ₈₄₆ | L_{b118} | 1016 | Lₐ₈₄₆ | L_{b132} |
| 1017 | Lₐ₈₆₅ | L_{b118} | 1018 | Lₐ₈₆₅ | L_{b132} |
| 1019 | Lₐ₈₆₈ | L_{b118} | 1020 | Lₐ₈₆₈ | L_{b132} |
| 1021 | Lₐ₈₈₉ | L_{b118} | 1022 | Lₐ₈₈₉ | L_{b132} |
| 1023 | Lₐ₉₀₉ | L_{b118} | 1024 | Lₐ₉₀₉ | L_{b132} |
| 1025 | Lₐ₉₁₃ | L_{b118} | 1026 | Lₐ₉₁₃ | L_{b132} |
| 1027 | Lₐ₉₁₅ | L_{b118} | 1028 | Lₐ₉₁₅ | L_{b132} |
| 1029 | Lₐ₉₂₀ | L_{b118} | 1030 | Lₐ₉₂₀ | L_{b132} |
| 1031 | Lₐ₉₂₂ | L_{b118} | 1032 | Lₐ₉₂₂ | L_{b132} |
| 1033 | Lₐ₉₂₃ | L_{b118} | 1034 | Lₐ₉₂₃ | L_{b132} |
| 1035 | Lₐ₉₂₄ | L_{b118} | 1036 | Lₐ₉₂₄ | L_{b132} |
| 1037 | Lₐ₉₂₅ | L_{b118} | 1038 | Lₐ₉₂₅ | L_{b132} |
| 1039 | Lₐ₉₂₈ | L_{b118} | 1040 | Lₐ₉₂₈ | L_{b132} |
| 1041 | Lₐ₉₅₃ | L_{b118} | 1042 | Lₐ₉₅₃ | L_{b132} |
| 1043 | Lₐ₉₅₄ | L_{b118} | 1044 | Lₐ₉₅₄ | L_{b132} |
| 1045 | Lₐ₉₇₄ | L_{b118} | 1046 | Lₐ₉₇₄ | L_{b132} |
| 1047 | Lₐ₉₇₆ | L_{b118} | 1048 | Lₐ₉₇₆ | L_{b132} |
| 1049 | Lₐ₉₉₅ | L_{b118} | 1050 | Lₐ₉₉₅ | L_{b132} |
| 1051 | Lₐ₁₀₀₆ | L_{b118} | 1052 | Lₐ₁₀₀₆ | L_{b132} |
| 1053 | Lₐ₁₀₁₇ | L_{b118} | 1054 | Lₐ₁₀₁₇ | L_{b132} |
| 1055 | Lₐ₁₀₁₈ | L_{b118} | 1056 | Lₐ₁₀₁₈ | L_{b132} |
| 1057 | Lₐ₁₀₂₃ | L_{b118} | 1058 | Lₐ₁₀₂₃ | L_{b132} |
| 1059 | Lₐ₁₀₂₄ | L_{b118} | 1060 | Lₐ₁₀₂₄ | L_{b132} |
| 1061 | Lₐ₁₀₂₆ | L_{b118} | 1062 | Lₐ₁₀₂₆ | L_{b132} |
| 1063 | Lₐ₁₀₈₈ | L_{b118} | 1064 | Lₐ₁₀₈₈ | L_{b132} |
| 1065 | Lₐ₁₀₈₉ | L_{b118} | 1066 | Lₐ₁₀₈₉ | L_{b132} |
| 1067 | Lₐ₁₀₉₅ | L_{b118} | 1068 | Lₐ₁₀₉₅ | L_{b132} |
| 1069 | Lₐ₁₁₀₀ | L_{b118} | 1070 | Lₐ₁₁₀₀ | L_{b132} |
| 1071 | Lₐ₁₁₁₆ | L_{b118} | 1072 | Lₐ₁₁₁₆ | L_{b132} |
| 1073 | Lₐ₁₁₁₈ | L_{b118} | 1074 | Lₐ₁₁₁₈ | L_{b132} |
| 1075 | Lₐ₁₁₃₆ | L_{b118} | 1076 | Lₐ₁₁₃₆ | L_{b132} |
| 1077 | Lₐ₁₁₄₈ | L_{b118} | 1078 | Lₐ₁₁₄₈ | L_{b132} |
| 1079 | Lₐ₁₁₅₈ | L_{b118} | 1080 | Lₐ₁₁₅₈ | L_{b132} |
| 1081 | Lₐ₁₁₅₉ | L_{b118} | 1082 | Lₐ₁₁₅₉ | L_{b132} |
| 1083 | Lₐ₁₁₆₁ | L_{b118} | 1084 | Lₐ₁₁₆₁ | L_{b132} |
| 1085 | Lₐ₁₁₆₆ | L_{b118} | 1086 | Lₐ₁₁₆₆ | L_{b132} |
| 1087 | Lₐ₁₁₇₁ | L_{b118} | 1088 | Lₐ₁₁₇₁ | L_{b132} |
| 1089 | Lₐ₁₁₈₇ | L_{b118} | 1090 | Lₐ₁₁₈₇ | L_{b132} |
| 1091 | Lₐ₁₁₉₂ | L_{b118} | 1092 | Lₐ₁₁₉₂ | L_{b132} |
| 1093 | Lₐ₁₂₀₅ | L_{b118} | 1094 | Lₐ₁₂₀₅ | L_{b132} |
| 1095 | Lₐ₁₂₀₈ | L_{b118} | 1096 | Lₐ₁₂₀₈ | L_{b132} |
| 1097 | Lₐ₁₂₁₇ | L_{b118} | 1098 | Lₐ₁₂₁₇ | L_{b132} |
| 1099 | Lₐ₁₂₁₉ | L_{b118} | 1100 | Lₐ₁₂₁₉ | L_{b132} |
| 1101 | Lₐ₁₂₃₀ | L_{b118} | 1102 | Lₐ₁₂₃₀ | L_{b132} |
| 1103 | Lₐ₁₂₃₇ | L_{b118} | 1104 | Lₐ₁₂₃₇ | L_{b132} |
| 1105 | Lₐ₁₂₃₈ | L_{b118} | 1106 | Lₐ₁₂₃₈ | L_{b132} |
| 1107 | Lₐ₁₂₃₉ | L_{b118} | 1108 | Lₐ₁₂₃₉ | L_{b132} |
| 1109 | Lₐ₁₂₄₅ | L_{b118} | 1110 | Lₐ₁₂₄₅ | L_{b132} |
| 1111 | Lₐ₁₂₄₆ | L_{b118} | 1112 | Lₐ₁₂₄₆ | L_{b132} |
| 1113 | Lₐ₁₂₄₇ | L_{b118} | 1114 | Lₐ₁₂₄₇ | L_{b132} |
| 1115 | Lₐ₁₂₄₈ | L_{b118} | 1116 | Lₐ₁₂₄₈ | L_{b132} |
| 1117 | Lₐ₁₂₅₈ | L_{b118} | 1118 | Lₐ₁₂₅₈ | L_{b132} |
| 1119 | Lₐ₁₂₆₀ | L_{b118} | 1120 | Lₐ₁₂₆₀ | L_{b132} |
| 1121 | Lₐ₁₂₆₁ | L_{b118} | 1122 | Lₐ₁₂₆₁ | L_{b132} |
| 1123 | Lₐ₁₂₇₇ | L_{b118} | 1124 | Lₐ₁₂₇₇ | L_{b132} |
| 1125 | Lₐ₁₂₇₈ | L_{b118} | 1126 | Lₐ₁₂₇₈ | L_{b132} |
| 1127 | Lₐ₁₂₇₉ | L_{b118} | 1128 | Lₐ₁₂₇₉ | L_{b132} |
| 1129 | Lₐ₁₂₈₈ | L_{b118} | 1130 | Lₐ₁₂₈₈ | L_{b132} |
| 1131 | Lₐ₁₂₈₉ | L_{b118} | 1132 | Lₐ₁₂₈₉ | L_{b132} |
| 1133 | Lₐ₁₃₀₁ | L_{b118} | 1134 | Lₐ₁₃₀₁ | L_{b132} |
| 1135 | Lₐ₁₃₀₂ | L_{b118} | 1136 | Lₐ₁₃₀₂ | L_{b132} |
| 1137 | Lₐ₁₄₄₂ | L_{b118} | 1138 | Lₐ₁₄₄₂ | L_{b132} |
| 1139 | Lₐ₁₄₄₈ | L_{b118} | 1140 | Lₐ₁₄₄₈ | L_{b132} |
| 1141 | Lₐ₁₄₄₉ | L_{b118} | 1142 | Lₐ₁₄₄₉ | L_{b132} |
| 1143 | Lₐ₁₄₆₀ | L_{b118} | 1144 | Lₐ₁₄₆₀ | L_{b132} |
| 1145 | Lₐ₁₄₇₁ | L_{b118} | 1146 | Lₐ₁₄₇₁ | L_{b132} |
| 1147 | Lₐ₁₅₆₉ | L_{b118} | 1148 | Lₐ₁₅₆₉ | L_{b132} |
| 1149 | Lₐ₁₅₇₀ | L_{b118} | 1150 | Lₐ₁₅₇₀ | L_{b132} |
| 1151 | Lₐ₁₆₄₇ | L_{b118} | 1152 | Lₐ₁₆₄₇ | L_{b132} |
| 1153 | Lₐ₁₆₄₈ | L_{b118} | 1154 | Lₐ₁₆₄₈ | L_{b132} |
| 1155 | Lₐ₁₆₄₉ | L_{b118} | 1156 | Lₐ₁₆₄₉ | L_{b132} |
| 1157 | Lₐ₁₆₅₀ | L_{b118} | 1158 | Lₐ₁₆₅₀ | L_{b132} |
| 1159 | Lₐ₁₆₅₁ | L_{b118} | 1160 | Lₐ₁₆₅₁ | L_{b132} |
| 1161 | Lₐ₁₆₇₇ | L_{b118} | 1162 | Lₐ₁₆₇₇ | L_{b132} |
| 1163 | Lₐ₁₆₇₈ | L_{b118} | 1164 | Lₐ₁₆₇₈ | L_{b132} |
| 1165 | Lₐ₁₆₇₉ | L_{b118} | 1166 | Lₐ₁₆₇₉ | L_{b132} |
| 1167 | Lₐ₁₆₈₀ | L_{b118} | 1168 | Lₐ₁₆₈₀ | L_{b132} |
| 1169 | Lₐ₁₆₉₁ | L_{b118} | 1170 | Lₐ₁₆₉₁ | L_{b132} |
| 1171 | Lₐ₁₆₉₃ | L_{b118} | 1172 | Lₐ₁₆₉₃ | L_{b132} |
| 1173 | Lₐ₁₆₉₅ | L_{b118} | 1174 | Lₐ₁₆₉₅ | L_{b132} |
| 1175 | Lₐ₁₆₉₆ | L_{b118} | 1176 | Lₐ₁₆₉₆ | L_{b132} |
| 1177 | Lₐ₁₆₉₉ | L_{b118} | 1178 | Lₐ₁₆₉₉ | L_{b132} |
| 1179 | Lₐ₁₇₀₁ | L_{b118} | 1180 | Lₐ₁₇₀₁ | L_{b132} |
| 1181 | Lₐ₁₇₀₂ | L_{b118} | 1182 | Lₐ₁₇₀₂ | L_{b132} |
| 1183 | Lₐ₁₇₁₂ | L_{b118} | 1184 | Lₐ₁₇₁₂ | L_{b132} |
| 1185 | Lₐ₁₇₁₃ | L_{b118} | 1186 | Lₐ₁₇₁₃ | L_{b132} |
| 1187 | Lₐ₁₇₃₅ | L_{b118} | 1188 | Lₐ₁₇₃₅ | L_{b132} |
| 1189 | Lₐ₁₇₉₅ | L_{b118} | 1190 | Lₐ₁₇₉₅ | L_{b132} |
| 1191 | Lₐ₁₈₂₀ | L_{b118} | 1192 | Lₐ₁₈₂₀ | L_{b132} |
| 1193 | Lₐ₁₈₉₁ | L_{b118} | 1194 | Lₐ₁₈₉₁ | L_{b132} |
| 1195 | Lₐ₁₈₉₂ | L_{b118} | 1196 | Lₐ₁₈₉₂ | L_{b132} |
| 1197 | Lₐ₁₈₉₃ | L_{b118} | 1198 | Lₐ₁₈₉₃ | L_{b132} |
| 1199 | Lₐ₁₈₉₉ | L_{b118} | 1200 | Lₐ₁₈₉₉ | L_{b132} |
| 1201 | Lₐ₁₉₀₂ | L_{b118} | 1202 | Lₐ₁₉₀₂ | L_{b132} |
| 1203 | Lₐ₁₉₁₃ | L_{b118} | 1204 | Lₐ₁₉₁₃ | L_{b132} |
| 1205 | Lₐ₁₉₁₄ | L_{b118} | 1206 | Lₐ₁₉₁₄ | L_{b132} |
| 1207 | Lₐ₁₉₃₃ | L_{b118} | 1208 | Lₐ₁₉₃₃ | L_{b132} |
| 1209 | Lₐ₁₉₄₅ | L_{b118} | 1210 | Lₐ₁₉₄₅ | L_{b132} |
| 1211 | Lₐ₁₉₅₄ | L_{b118} | 1212 | Lₐ₁₉₅₄ | L_{b132} |
| 1213 | Lₐ₁₉₅₅ | L_{b118} | 1214 | Lₐ₁₉₅₅ | L_{b132} |
| 1215 | Lₐ₁₉₅₆ | L_{b118} | 1216 | Lₐ₁₉₅₆ | L_{b132} |
| 1217 | Lₐ₁₉₆₂ | L_{b118} | 1218 | Lₐ₁₉₆₂ | L_{b132} |
| 1219 | Lₐ₁₉₆₄ | L_{b118} | 1220 | Lₐ₁₉₆₄ | L_{b132} |
| 1221 | Lₐ₁₉₆₅ | L_{b118} | 1222 | Lₐ₁₉₆₅ | L_{b132} |
| 1223 | Lₐ₁₉₆₆ | L_{b118} | 1224 | Lₐ₁₉₆₆ | L_{b132} |
| 1225 | Lₐ₁₉₇₀ | L_{b118} | 1226 | Lₐ₁₉₇₀ | L_{b132} |
| 1227 | Lₐ₁₉₇₃ | L_{b118} | 1228 | Lₐ₁₉₇₃ | L_{b132} |
| 1229 | Lₐ₂₀₀₂ | L_{b118} | 1230 | Lₐ₂₀₀₂ | L_{b132} |
| 1231 | Lₐ₂₀₀₃ | L_{b118} | 1232 | Lₐ₂₀₀₃ | L_{b132} |
| 1233 | Lₐ₂₀₁₃ | L_{b118} | 1234 | Lₐ₂₀₁₃ | L_{b132} |
| 1235 | Lₐ₂₀₁₄ | L_{b118} | 1236 | Lₐ₂₀₁₄ | L_{b132} |
| 1237 | Lₐ₂₀₁₅ | L_{b118} | 1238 | Lₐ₂₀₁₅ | L_{b132} |
| 1239 | Lₐ₂₀₃₃ | L_{b118} | 1240 | Lₐ₂₀₃₃ | L_{b132} |
| 1241 | Lₐ₂₁₀₄ | L_{b118} | 1242 | Lₐ₂₁₀₄ | L_{b132} |
| 1243 | Lₐ₂₃₂₆ | L_{b118} | 1244 | Lₐ₂₃₂₆ | L_{b132} |
| 1245 | Lₐ₂₃₃₇ | L_{b118} | 1246 | Lₐ₂₃₃₇ | L_{b132} |
| 1247 | Lₐ₂₄₃₆ | L_{b118} | 1248 | Lₐ₂₄₃₆ | L_{b132} |
| 1249 | Lₐ₂₄₃₇ | L_{b118} | 1250 | Lₐ₂₄₃₇ | L_{b132} |
| 1251 | Lₐ₂₅₁₄ | L_{b118} | 1252 | Lₐ₂₅₁₄ | L_{b132} |
| 1253 | Lₐ₂₆₁₂ | L_{b118} | 1254 | Lₐ₂₆₁₂ | L_{b132} |
| 1255 | Lₐ₂₆₁₈ | L_{b118} | 1256 | Lₐ₂₆₁₈ | L_{b132} |
| 1257 | Lₐ₂₆₄₃ | L_{b118} | 1258 | Lₐ₂₆₄₃ | L_{b132} |
| 1259 | Lₐ₂₆₅₄ | L_{b118} | 1260 | Lₐ₂₆₅₄ | L_{b132} |
| 1261 | Lₐ₂₇₁₄ | L_{b118} | 1262 | Lₐ₂₇₁₄ | L_{b132} |
| 1263 | Lₐ₂₇₈₅ | L_{b118} | 1264 | Lₐ₂₇₈₅ | L_{b132} |
| 1265 | Lₐ₂₈₅₆ | L_{b118} | 1266 | Lₐ₂₈₅₆ | L_{b132} |
| 1267 | Lₐ₂₉₂₇ | L_{b118} | 1268 | Lₐ₂₉₂₇ | L_{b132} |
| 1269 | Lₐ₃₃₃₇ | L_{b118} | 1270 | Lₐ₃₃₃₇ | L_{b132} |
| 1271 | Lₐ₃₃₃₈ | L_{b118} | 1272 | Lₐ₃₃₃₈ | L_{b132} |
| 1273 | Lₐ₃₃₃₉ | L_{b118} | 1274 | Lₐ₃₃₃₉ | L_{b132} |
| 1275 | Lₐ₃₃₄₀ | L_{b118} | 1276 | Lₐ₃₃₄₀ | L_{b132} |
| 1277 | Lₐ₃₃₄₁ | L_{b118} | 1278 | Lₐ₃₃₄₁ | L_{b132} |
| 1279 | Lₐ₁ | L_{b52} | 1280 | Lₐ₈₈ | L_{b52} |
| 1281 | Lₐ₁₂ | L_{b52} | 1282 | Lₐ₈₉ | L_{b52} |
| 1283 | Lₐ₂₁ | L_{b52} | 1284 | Lₐ₉₀ | L_{b52} |
| 1285 | Lₐ₂₃ | L_{b52} | 1286 | Lₐ₉₁ | L_{b52} |
| 1287 | Lₐ₃₃ | L_{b52} | 1288 | Lₐ₉₂ | L_{b52} |
| 1289 | Lₐ₄₂ | L_{b52} | 1290 | Lₐ₁₀₀ | L_{b52} |
| 1291 | Lₐ₆₃ | L_{b52} | 1292 | Lₐ₁₀₁ | L_{b52} |
| 1293 | Lₐ₆₆ | L_{b52} | 1294 | Lₐ₁₀₂ | L_{b52} |
| 1295 | Lₐ₇₅ | L_{b52} | 1296 | Lₐ₁₀₃ | L_{b52} |
| 1297 | Lₐ₈₄ | L_{b52} | 1298 | Lₐ₁₇₄ | L_{b52} |
| 1299 | Lₐ₁₀₅ | L_{b52} | 1300 | Lₐ₁₇₅ | L_{b52} |
| 1301 | Lₐ₁₀₇ | L_{b52} | 1302 | Lₐ₁₇₆ | L_{b52} |
| 1303 | Lₐ₁₂₁ | L_{b52} | 1304 | Lₐ₁₇₇ | L_{b52} |
| 1305 | Lₐ₁₂₈ | L_{b52} | 1306 | Lₐ₂₀₉ | L_{b52} |
| 1307 | Lₐ₁₃₀ | L_{b52} | 1308 | Lₐ₂₁₀ | L_{b52} |
| 1309 | Lₐ₁₃₁ | L_{b52} | 1310 | Lₐ₂₂₁ | L_{b52} |
| 1311 | Lₐ₁₃₂ | L_{b52} | 1312 | Lₐ₂₂₂ | L_{b52} |
| 1313 | Lₐ₁₃₃ | L_{b52} | 1314 | Lₐ₂₄₈ | L_{b52} |
| 1315 | Lₐ₁₃₅ | L_{b52} | 1316 | Lₐ₂₄₉ | L_{b52} |
| 1317 | Lₐ₁₃₆ | L_{b52} | 1318 | Lₐ₂₅₀ | L_{b52} |
| 1319 | Lₐ₁₄₀ | L_{b52} | 1320 | Lₐ₂₆₈ | L_{b52} |
| 1321 | Lₐ₁₅₀ | L_{b52} | 1322 | Lₐ₂₆₉ | L_{b52} |
| 1323 | Lₐ₁₅₂ | L_{b52} | 1324 | Lₐ₃₀₁ | L_{b52} |
| 1325 | Lₐ₁₅₄ | L_{b52} | 1326 | Lₐ₃₀₂ | L_{b52} |
| 1327 | Lₐ₁₅₇ | L_{b52} | 1328 | Lₐ₃₀₃ | L_{b52} |
| 1329 | Lₐ₁₆₁ | L_{b52} | 1330 | Lₐ₃₀₄ | L_{b52} |
| 1331 | Lₐ₁₇₀ | L_{b52} | 1332 | Lₐ₃₂₂ | L_{b52} |
| 1333 | Lₐ₁₇₁ | L_{b52} | 1334 | Lₐ₃₂₃ | L_{b52} |
| 1335 | Lₐ₁₈₀ | L_{b52} | 1336 | Lₐ₃₂₄ | L_{b52} |
| 1337 | Lₐ₁₈₂ | L_{b52} | 1338 | Lₐ₃₃₆ | L_{b52} |
| 1339 | Lₐ₁₈₉ | L_{b52} | 1340 | Lₐ₃₃₇ | L_{b52} |
| 1341 | Lₐ₁₉₁ | L_{b52} | 1342 | Lₐ₃₃₈ | L_{b52} |
| 1343 | Lₐ₁₉₃ | L_{b52} | 1344 | Lₐ₃₆₅ | L_{b52} |
| 1345 | Lₐ₂₀₁ | L_{b52} | 1346 | Lₐ₃₆₆ | L_{b52} |
| 1347 | Lₐ₂₀₃ | L_{b52} | 1348 | Lₐ₃₆₇ | L_{b52} |
| 1349 | Lₐ₂₀₅ | L_{b52} | 1350 | Lₐ₃₈₁ | L_{b52} |
| 1351 | Lₐ₂₀₆ | L_{b52} | 1352 | Lₐ₃₈₂ | L_{b52} |
| 1353 | Lₐ₂₁₂ | L_{b52} | 1354 | Lₐ₃₈₃ | L_{b52} |
| 1355 | Lₐ₂₂₄ | L_{b52} | 1356 | Lₐ₄₁₇ | L_{b52} |
| 1357 | Lₐ₂₂₇ | L_{b52} | 1358 | Lₐ₄₁₈ | L_{b52} |
| 1359 | Lₐ₂₃₃ | L_{b52} | 1360 | Lₐ₄₁₉ | L_{b52} |
| 1361 | Lₐ₂₄₀ | L_{b52} | 1362 | Lₐ₄₂₀ | L_{b52} |
| 1363 | Lₐ₂₄₃ | L_{b52} | 1364 | Lₐ₄₃₇ | L_{b52} |
| 1365 | Lₐ₂₅₂ | L_{b52} | 1366 | Lₐ₄₃₈ | L_{b52} |
| 1367 | Lₐ₂₅₃ | L_{b52} | 1368 | Lₐ₄₃₉ | L_{b52} |
| 1369 | Lₐ₂₆₅ | L_{b52} | 1370 | Lₐ₄₅₃ | L_{b52} |
| 1371 | Lₐ₂₇₂ | L_{b52} | 1372 | Lₐ₄₅₄ | L_{b52} |
| 1373 | Lₐ₂₇₃ | L_{b52} | 1374 | Lₐ₄₆₄ | L_{b52} |
| 1375 | Lₐ₂₇₈ | L_{b52} | 1376 | Lₐ₄₆₅ | L_{b52} |
| 1377 | Lₐ₂₈₂ | L_{b52} | 1378 | Lₐ₄₆₆ | L_{b52} |
| 1379 | Lₐ₂₈₃ | L_{b52} | 1380 | Lₐ₄₆₇ | L_{b52} |
| 1381 | Lₐ₂₉₃ | L_{b52} | 1382 | Lₐ₄₈₅ | L_{b52} |
| 1383 | Lₐ₂₉₄ | L_{b52} | 1384 | Lₐ₄₈₆ | L_{b52} |
| 1385 | Lₐ₂₉₅ | L_{b52} | 1386 | Lₐ₄₈₇ | L_{b52} |
| 1387 | Lₐ₃₁₀ | L_{b52} | 1388 | Lₐ₅₀₄ | L_{b52} |
| 1389 | Lₐ₃₁₄ | L_{b52} | 1390 | Lₐ₅₀₅ | L_{b52} |
| 1391 | Lₐ₃₂₅ | L_{b52} | 1392 | Lₐ₅₀₆ | L_{b52} |
| 1393 | Lₐ₃₄₃ | L_{b52} | 1394 | Lₐ₅₀₇ | L_{b52} |
| 1395 | Lₐ₃₄₅ | L_{b52} | 1396 | Lₐ₅₃₄ | L_{b52} |
| 1397 | Lₐ₃₆₃ | L_{b52} | 1398 | Lₐ₅₃₅ | L_{b52} |
| 1399 | Lₐ₃₈₅ | L_{b52} | 1400 | Lₐ₅₃₆ | L_{b52} |
| 1401 | Lₐ₃₉₆ | L_{b52} | 1402 | Lₐ₅₄₈ | L_{b52} |
| 1403 | Lₐ₄₀₇ | L_{b52} | 1404 | Lₐ₅₄₉ | L_{b52} |
| 1405 | Lₐ₄₀₈ | L_{b52} | 1406 | Lₐ₅₅₀ | L_{b52} |
| 1407 | Lₐ₄₁₄ | L_{b52} | 1408 | Lₐ₅₅₁ | L_{b52} |
| 1409 | Lₐ₄₂₃ | L_{b52} | 1410 | Lₐ₅₇₅ | L_{b52} |
| 1411 | Lₐ₄₃₄ | L_{b52} | 1412 | Lₐ₅₇₆ | L_{b52} |
| 1413 | Lₐ₄₅₆ | L_{b52} | 1414 | Lₐ₆₀₄ | L_{b52} |
| 1415 | Lₐ₄₆₇ | L_{b52} | 1416 | Lₐ₆₀₅ | L_{b52} |
| 1417 | Lₐ₆₃₀ | L_{b52} | 1418 | Lₐ₆₀₆ | L_{b52} |
| 1419 | Lₐ₆₃₁ | L_{b52} | 1420 | Lₐ₆₀₇ | L_{b52} |
| 1421 | Lₐ₆₄₅ | L_{b52} | 1422 | Lₐ₆₃₇ | L_{b52} |
| 1423 | Lₐ₆₄₆ | L_{b52} | 1424 | Lₐ₆₃₈ | L_{b52} |
| 1425 | Lₐ₆₄₇ | L_{b52} | 1426 | Lₐ₆₃₉ | L_{b52} |
| 1427 | Lₐ₆₄₈ | L_{b52} | 1428 | Lₐ₆₅₄ | L_{b52} |
| 1429 | Lₐ₆₆₅ | L_{b52} | 1430 | Lₐ₆₅₅ | L_{b52} |
| 1431 | Lₐ₇₄₆ | L_{b52} | 1432 | Lₐ₆₅₆ | L_{b52} |
| 1433 | Lₐ₇₄₇ | L_{b52} | 1434 | Lₐ₆₅₇ | L_{b52} |
| 1435 | Lₐ₈₂₄ | L_{b52} | 1436 | Lₐ₆₇₀ | L_{b52} |
| 1437 | Lₐ₈₂₅ | L_{b52} | 1438 | Lₐ₆₇₁ | L_{b52} |
| 1439 | Lₐ₈₄₄ | L_{b52} | 1440 | Lₐ₆₇₂ | L_{b52} |
| 1441 | Lₐ₈₄₆ | L_{b52} | 1442 | Lₐ₆₇₃ | L_{b52} |
| 1443 | Lₐ₈₆₅ | L_{b52} | 1444 | Lₐ₆₇₄ | L_{b52} |
| 1445 | Lₐ₈₆₈ | L_{b52} | 1446 | Lₐ₆₇₅ | L_{b52} |
| 1447 | Lₐ₈₈₉ | L_{b52} | 1448 | Lₐ₆₈₄ | L_{b52} |
| 1449 | Lₐ₉₀₉ | L_{b52} | 1450 | Lₐ₆₈₅ | L_{b52} |
| 1451 | Lₐ₉₁₃ | L_{b52} | 1452 | Lₐ₆₈₆ | L_{b52} |
| 1453 | Lₐ₉₁₅ | L_{b52} | 1454 | Lₐ₆₈₇ | L_{b52} |
| 1455 | Lₐ₉₂₀ | L_{b52} | 1456 | Lₐ₇₀₁ | L_{b52} |
| 1457 | Lₐ₉₂₂ | L_{b52} | 1458 | Lₐ₇₀₂ | L_{b52} |
| 1459 | Lₐ₉₂₃ | L_{b52} | 1460 | Lₐ₇₀₃ | L_{b52} |
| 1461 | Lₐ₉₂₄ | L_{b52} | 1462 | Lₐ₇₀₄ | L_{b52} |
| 1463 | Lₐ₉₂₅ | L_{b52} | 1464 | Lₐ₇₀₈ | L_{b52} |
| 1465 | Lₐ₉₂₈ | L_{b52} | 1466 | Lₐ₇₀₉ | L_{b52} |
| 1467 | Lₐ₉₅₃ | L_{b52} | 1468 | Lₐ₇₁₀ | L_{b52} |
| 1469 | Lₐ₉₅₄ | L_{b52} | 1470 | Lₐ₇₁₁ | L_{b52} |
| 1471 | Lₐ₉₇₄ | L_{b52} | 1472 | Lₐ₇₁₂ | L_{b52} |
| 1473 | Lₐ₉₇₆ | L_{b52} | 1474 | Lₐ₇₁₃ | L_{b52} |
| 1475 | Lₐ₉₉₅ | L_{b52} | 1476 | Lₐ₇₁₄ | L_{b52} |
| 1477 | Lₐ₁₀₀₆ | L_{b52} | 1478 | Lₐ₇₂₉ | L_{b52} |
| 1479 | Lₐ₁₀₁₇ | L_{b52} | 1480 | Lₐ₇₃₁ | L_{b52} |
| 1481 | Lₐ₁₀₁₈ | L_{b52} | 1482 | Lₐ₇₃₂ | L_{b52} |
| 1483 | Lₐ₁₀₂₃ | L_{b52} | 1484 | Lₐ₇₃₃ | L_{b52} |
| 1485 | Lₐ₁₀₂₄ | L_{b52} | 1486 | Lₐ₇₄₁ | L_{b52} |
| 1487 | Lₐ₁₀₂₆ | L_{b52} | 1488 | Lₐ₇₄₂ | L_{b52} |
| 1489 | Lₐ₁₀₈₈ | L_{b52} | 1490 | Lₐ₇₄₃ | L_{b52} |
| 1491 | Lₐ₁₀₈₉ | L_{b52} | 1492 | Lₐ₇₄₄ | L_{b52} |
| 1493 | Lₐ₁₀₉₅ | L_{b52} | 1494 | Lₐ₇₄₈ | L_{b52} |
| 1495 | Lₐ₁₁₀₀ | L_{b52} | 1496 | Lₐ₇₄₉ | L_{b52} |
| 1497 | Lₐ₁₁₁₆ | L_{b52} | 1498 | Lₐ₇₅₀ | L_{b52} |
| 1499 | Lₐ₁₁₁₈ | L_{b52} | 1500 | Lₐ₇₅₁ | L_{b52} |
| 1501 | Lₐ₁₁₃₆ | L_{b52} | 1502 | Lₐ₇₅₂ | L_{b52} |
| 1503 | Lₐ₁₁₄₈ | L_{b52} | 1504 | Lₐ₇₅₃ | L_{b52} |
| 1505 | Lₐ₁₁₅₈ | L_{b52} | 1506 | Lₐ₇₅₄ | L_{b52} |
| 1507 | Lₐ₁₁₅₉ | L_{b52} | 1508 | Lₐ₇₅₅ | L_{b52} |
| 1509 | Lₐ₁₁₆₁ | L_{b52} | 1510 | Lₐ₇₅₆ | L_{b52} |
| 1511 | Lₐ₁₁₆₆ | L_{b52} | 1512 | Lₐ₇₅₇ | L_{b52} |
| 1513 | Lₐ₁₁₇₁ | L_{b52} | 1514 | Lₐ₇₅₈ | L_{b52} |
| 1515 | Lₐ₁₁₈₇ | L_{b52} | 1516 | Lₐ₇₆₆ | L_{b52} |
| 1517 | Lₐ₁₁₉₂ | L_{b52} | 1518 | Lₐ₇₆₇ | L_{b52} |
| 1519 | Lₐ₁₂₀₅ | L_{b52} | 1520 | Lₐ₇₆₈ | L_{b52} |
| 1521 | Lₐ₁₂₀₈ | L_{b52} | 1522 | Lₐ₇₆₉ | L_{b52} |
| 1523 | Lₐ₁₂₁₇ | L_{b52} | 1524 | Lₐ₇₇₀ | L_{b52} |
| 1525 | Lₐ₁₂₁₉ | L_{b52} | 1526 | Lₐ₇₇₁ | L_{b52} |
| 1527 | Lₐ₁₂₃₀ | L_{b52} | 1528 | Lₐ₇₇₂ | L_{b52} |
| 1529 | Lₐ₁₂₃₇ | L_{b52} | 1530 | Lₐ₇₇₃ | L_{b52} |
| 1531 | Lₐ₁₂₃₈ | L_{b52} | 1532 | Lₐ₇₇₄ | L_{b52} |
| 1533 | Lₐ₁₂₃₉ | L_{b52} | 1534 | Lₐ₇₇₅ | L_{b52} |
| 1535 | Lₐ₁₂₄₅ | L_{b52} | 1536 | Lₐ₇₇₆ | L_{b52} |
| 1537 | Lₐ₁₂₄₆ | L_{b52} | 1538 | Lₐ₇₇₇ | L_{b52} |
| 1539 | Lₐ₁₂₄₇ | L_{b52} | 1540 | Lₐ₇₇₈ | L_{b52} |
| 1541 | Lₐ₁₂₄₈ | L_{b52} | 1542 | Lₐ₇₇₉ | L_{b52} |
| 1543 | Lₐ₁₂₅₈ | L_{b52} | 1544 | Lₐ₇₈₀ | L_{b52} |
| 1545 | Lₐ₁₂₆₀ | L_{b52} | 1546 | Lₐ₇₈₁ | L_{b52} |
| 1547 | Lₐ₁₂₆₁ | L_{b52} | 1548 | Lₐ₇₈₂ | L_{b52} |
| 1549 | Lₐ₁₂₇₇ | L_{b52} | 1550 | Lₐ₇₉₀ | L_{b52} |
| 1551 | Lₐ₁₂₇₈ | L_{b52} | 1552 | Lₐ₇₉₁ | L_{b52} |
| 1553 | Lₐ₁₂₇₉ | L_{b52} | 1554 | Lₐ₇₉₂ | L_{b52} |
| 1555 | Lₐ₁₂₈₈ | L_{b52} | 1556 | Lₐ₇₉₃ | L_{b52} |
| 1557 | Lₐ₁₂₈₉ | L_{b52} | 1558 | Lₐ₇₉₄ | L_{b52} |
| 1559 | Lₐ₁₃₀₁ | L_{b52} | 1560 | Lₐ₈₀₀ | L_{b52} |
| 1561 | Lₐ₁₃₀₂ | L_{b52} | 1562 | Lₐ₈₀₄ | L_{b52} |
| 1563 | Lₐ₁₄₄₂ | L_{b52} | 1564 | Lₐ₈₀₅ | L_{b52} |
| 1565 | Lₐ₁₄₄₈ | L_{b52} | 1566 | Lₐ₉₃₃ | L_{b52} |
| 1567 | Lₐ₁₄₄₉ | L_{b52} | 1568 | Lₐ₉₃₄ | L_{b52} |
| 1569 | Lₐ₁₄₆₀ | L_{b52} | 1570 | Lₐ₉₃₅ | L_{b52} |
| 1571 | Lₐ₁₄₇₁ | L_{b52} | 1572 | Lₐ₉₃₆ | L_{b52} |
| 1573 | Lₐ₁₅₆₉ | L_{b52} | 1574 | Lₐ₉₉₂ | L_{b52} |
| 1575 | Lₐ₁₅₇₀ | L_{b52} | 1576 | Lₐ₉₉₃ | L_{b52} |
| 1577 | Lₐ₁₆₄₇ | L_{b52} | 1578 | Lₐ₉₉₄ | L_{b52} |
| 1579 | Lₐ₁₆₄₈ | L_{b52} | 1580 | Lₐ₁₀₁₅ | L_{b52} |
| 1581 | Lₐ₁₆₄₉ | L_{b52} | 1582 | Lₐ₁₀₁₁₆ | L_{b52} |
| 1583 | Lₐ₁₆₅₀ | L_{b52} | 1584 | Lₐ₁₀₂₈ | L_{b52} |
| 1585 | Lₐ₁₆₅₁ | L_{b52} | 1586 | Lₐ₁₀₂₉ | L_{b52} |
| 1587 | Lₐ₁₆₇₇ | L_{b52} | 1588 | Lₐ₁₀₃₀ | L_{b52} |
| 1589 | Lₐ₁₆₇₈ | L_{b52} | 1590 | Lₐ₁₀₃₁ | L_{b52} |
| 1591 | Lₐ₁₆₇₉ | L_{b52} | 1592 | Lₐ₁₀₄₄ | L_{b52} |
| 1593 | Lₐ₁₆₈₀ | L_{b52} | 1594 | Lₐ₁₀₄₅ | L_{b52} |
| 1595 | Lₐ₁₆₉₁ | L_{b52} | 1596 | Lₐ₁₀₄₆ | L_{b52} |
| 1597 | Lₐ₁₆₉₃ | L_{b52} | 1598 | Lₐ₁₀₄₇ | L_{b52} |
| 1599 | Lₐ₁₆₉₅ | L_{b52} | 1600 | Lₐ₁₀₆₁ | L_{b52} |
| 1601 | Lₐ₁₆₉₆ | L_{b52} | 1602 | Lₐ₁₀₆₂ | L_{b52} |
| 1603 | Lₐ₁₆₉₉ | L_{b52} | 1604 | Lₐ₁₀₆₃ | L_{b52} |
| 1605 | Lₐ₁₇₀₁ | L_{b52} | 1606 | Lₐ₁₀₆₄ | L_{b52} |
| 1607 | Lₐ₁₇₀₂ | L_{b52} | 1608 | Lₐ₁₀₆₅ | L_{b52} |
| 1609 | Lₐ₁₇₁₂ | L_{b52} | 1610 | Lₐ₁₀₇₄ | L_{b52} |
| 1611 | Lₐ₁₇₁₃ | L_{b52} | 1612 | Lₐ₁₀₇₅ | L_{b52} |
| 1613 | Lₐ₁₇₃₅ | L_{b52} | 1614 | Lₐ₁₀₇₆ | L_{b52} |
| 1615 | Lₐ₁₇₉₅ | L_{b52} | 1616 | Lₐ₁₀₈₃ | L_{b52} |
| 1617 | Lₐ₁₈₂₀ | L_{b52} | 1618 | Lₐ₁₀₈₄ | L_{b52} |
| 1619 | Lₐ₁₈₉₁ | L_{b52} | 1620 | Lₐ₁₀₈₅ | L_{b52} |
| 1621 | Lₐ₁₈₉₂ | L_{b52} | 1622 | Lₐ₁₀₉₀ | L_{b52} |
| 1623 | Lₐ₁₈₉₃ | L_{b52} | 1624 | Lₐ₁₀₉₁ | L_{b52} |
| 1625 | Lₐ₁₈₉₉ | L_{b52} | 1626 | Lₐ₁₀₉₂ | L_{b52} |
| 1627 | Lₐ₁₉₀₂ | L_{b52} | 1628 | Lₐ₁₁₁₃ | L_{b52} |
| 1629 | Lₐ₁₉₁₃ | L_{b52} | 1630 | Lₐ₁₁₁₄ | L_{b52} |
| 1631 | Lₐ₁₉₁₄ | L_{b52} | 1632 | Lₐ₁₁₂₁ | L_{b52} |
| 1633 | Lₐ₁₉₃₃ | L_{b52} | 1634 | Lₐ₁₁₂₂ | L_{b52} |
| 1635 | Lₐ₁₉₄₅ | L_{b52} | 1636 | Lₐ₁₁₂₃ | L_{b52} |
| 1637 | Lₐ₁₉₅₄ | L_{b52} | 1638 | Lₐ₁₁₂₄ | L_{b52} |
| 1639 | Lₐ₁₉₅₅ | L_{b52} | 1640 | Lₐ₁₁₃₃ | L_{b52} |
| 1641 | Lₐ₁₉₅₆ | L_{b52} | 1642 | Lₐ₁₁₃₄ | L_{b52} |
| 1643 | Lₐ₁₉₆₂ | L_{b52} | 1644 | Lₐ₁₁₃₅ | L_{b52} |
| 1645 | Lₐ₁₉₆₄ | L_{b52} | 1646 | Lₐ₁₁₄₅ | L_{b52} |
| 1647 | Lₐ₁₉₆₅ | L_{b52} | 1648 | Lₐ₁₁₄₆ | L_{b52} |
| 1649 | Lₐ₁₉₆₆ | L_{b52} | 1650 | Lₐ₁₁₄₇ | L_{b52} |
| 1651 | Lₐ₁₉₇₀ | L_{b52} | 1652 | Lₐ₁₁₇₅ | L_{b52} |
| 1653 | Lₐ₁₉₇₃ | L_{b52} | 1654 | Lₐ₁₁₇₆ | L_{b52} |
| 1655 | Lₐ₂₀₀₂ | L_{b52} | 1656 | Lₐ₁₁₇₇ | L_{b52} |
| 1657 | Lₐ₂₀₀₃ | L_{b52} | 1658 | Lₐ₁₂₂₇ | L_{b52} |
| 1659 | Lₐ₂₀₁₃ | L_{b52} | 1660 | Lₐ₁₂₂₈ | L_{b52} |
| 1661 | Lₐ₂₀₁₄ | L_{b52} | 1662 | Lₐ₁₂₄₁ | L_{b52} |
| 1663 | Lₐ₂₀₁₅ | L_{b52} | 1664 | Lₐ₁₂₄₂ | L_{b52} |
| 1665 | Lₐ₂₀₃₃ | L_{b52} | 1666 | Lₐ₁₂₆₅ | L_{b52} |
| 1667 | Lₐ₂₁₀₄ | L_{b52} | 1668 | Lₐ₁₂₆₆ | L_{b52} |
| 1669 | Lₐ₂₃₂₆ | L_{b52} | 1670 | Lₐ₁₂₆₇ | L_{b52} |
| 1671 | Lₐ₂₃₃₇ | L_{b52} | 1672 | Lₐ₁₂₉₈ | L_{b52} |
| 1673 | Lₐ₂₄₃₆ | L_{b52} | 1674 | Lₐ₁₂₉₉ | L_{b52} |
| 1675 | Lₐ₂₄₃₇ | L_{b52} | 1676 | Lₐ₁₃₀₈ | L_{b52} |
| 1677 | Lₐ₂₅₁₄ | L_{b52} | 1678 | Lₐ₁₃₀₉ | L_{b52} |
| 1679 | Lₐ₂₆₁₂ | L_{b52} | 1680 | Lₐ₁₃₂₉ | L_{b52} |
| 1681 | Lₐ₂₆₁₈ | L_{b52} | 1682 | Lₐ₁₃₃₀ | L_{b52} |
| 1683 | Lₐ₂₆₄₃ | L_{b52} | 1684 | Lₐ₁₃₃₄ | L_{b52} |
| 1685 | Lₐ₂₆₅₄ | L_{b52} | 1686 | Lₐ₁₃₃₅ | L_{b52} |
| 1687 | Lₐ₂₇₁₄ | L_{b52} | 1688 | Lₐ₁₃₃₆ | L_{b52} |
| 1689 | Lₐ₂₇₈₅ | L_{b52} | 1690 | Lₐ₁₃₄₅ | L_{b52} |
| 1691 | Lₐ₂₈₅₆ | L_{b52} | 1692 | Lₐ₁₃₄₆ | L_{b52} |
| 1693 | Lₐ₂₉₂₇ | L_{b52} | 1694 | Lₐ₁₃₄₇ | L_{b52} |
| 1695 | Lₐ₃₃₃₇ | L_{b52} | 1696 | Lₐ₁₃₄₈ | L_{b52} |
| 1697 | Lₐ₃₃₃₈ | L_{b52} | 1698 | Lₐ₁₃₅₇ | L_{b52} |
| 1699 | Lₐ₃₃₃₉ | L_{b52} | 1700 | Lₐ₁₃₅₈ | L_{b52} |
| 1701 | Lₐ₃₃₄₀ | L_{b52} | 1702 | Lₐ₁₃₅₉ | L_{b52} |
| 1703 | Lₐ₃₃₄₁ | L_{b52} | 1704 | Lₐ₁₃₆₀ | L_{b52} |
| 1705 | Lₐ₁₃₆₉ | L_{b52} | 1706 | Lₐ₁₄₂₇ | L_{b52} |
| 1707 | Lₐ₁₃₇₀ | L_{b52} | 1708 | Lₐ₁₄₂₈ | L_{b52} |
| 1709 | Lₐ₁₃₇₁ | L_{b52} | 1710 | Lₐ₁₄₂₉ | L_{b52} |
| 1711 | Lₐ₁₃₇₂ | L_{b52} | 1712 | Lₐ₁₄₃₀ | L_{b52} |
| 1713 | Lₐ₁₃₉₇ | L_{b52} | 1714 | Lₐ₁₄₃₁ | L_{b52} |
| 1715 | Lₐ₁₃₉₈ | L_{b52} | 1716 | Lₐ₁₄₃₈ | L_{b52} |
| 1717 | Lₐ₁₃₉₉ | L_{b52} | 1718 | Lₐ₁₄₃₉ | L_{b52} |
| 1719 | Lₐ₁₄₀₀ | L_{b52} | 1720 | Lₐ₁₄₄₀ | L_{b52} |
| 1721 | Lₐ₁₄₁₅ | L_{b52} | 1722 | Lₐ₁₄₄₁ | L_{b52} |
| 1723 | Lₐ₁₄₁₆ | L_{b52} | 1724 | Lₐ₁₄₆₃ | L_{b52} |
| 1725 | Lₐ₁₄₁₇ | L_{b52} | 1726 | Lₐ₁₄₆₄ | L_{b52} |
| 1727 | Lₐ₁₄₁₈ | L_{b52} | 1728 | Lₐ₁₄₆₅ | L_{b52} |
| 1729 | Lₐ₁₄₁₉ | L_{b52} | 1730 | Lₐ₁₄₆₆ | L_{b52} |
| 1731 | Lₐ₁₄₇₈ | L_{b52} | 1732 | Lₐ₁₄₉₁ | L_{b52} |
| 1733 | Lₐ₁₄₇₉ | L_{b52} | 1734 | Lₐ₁₄₉₂ | L_{b52} |
| 1735 | Lₐ₁₄₈₀ | L_{b52} | 1736 | Lₐ₁₄₉₃ | L_{b52} |
| 1737 | Lₐ₁₄₈₁ | L_{b52} | 1738 | Lₐ₁₅₀₅ | L_{b52} |
| 1739 | Lₐ₁₄₈₂ | L_{b52} | 1740 | Lₐ₁₅₀₆ | L_{b52} |
| 1741 | Lₐ₁₅₂₅ | L_{b52} | 1742 | Lₐ₁₅₀₇ | L_{b52} |
| 1743 | Lₐ₁₅₂₆ | L_{b52} | 1744 | Lₐ₁₅₀₈ | L_{b52} |
| 1745 | Lₐ₁₅₂₇ | L_{b52} | 1746 | Lₐ₁₅₃₇ | L_{b52} |
| 1747 | Lₐ₁₅₂₈ | L_{b52} | 1748 | Lₐ₁₅₃₈ | L_{b52} |
| 1749 | Lₐ₁₅₂₉ | L_{b52} | 1750 | Lₐ₁₅₃₉ | L_{b52} |
| 1751 | Lₐ₁₅₃₀ | L_{b52} | 1752 | Lₐ₁₅₄₀ | L_{b52} |
| 1753 | Lₐ₁₅₅₀ | L_{b52} | 1754 | Lₐ₁₅₄₁ | L_{b52} |
| 1755 | Lₐ₁₅₅₁ | L_{b52} | 1756 | Lₐ₁₅₄₂ | L_{b52} |
| 1757 | Lₐ₁₅₅₂ | L_{b52} | 1758 | Lₐ₁₅₇₇ | L_{b52} |
| 1759 | Lₐ₁₅₅₉ | L_{b52} | 1760 | Lₐ₁₅₇₈ | L_{b52} |
| 1761 | Lₐ₁₅₆₀ | L_{b52} | 1762 | Lₐ₁₅₇₉ | L_{b52} |
| 1763 | Lₐ₁₅₆₁ | L_{b52} | 1764 | Lₐ₁₅₈₀ | L_{b52} |
| 1765 | Lₐ₁₅₆₂ | L_{b52} | 1766 | Lₐ₁₅₉₂ | L_{b52} |
| 1767 | Lₐ₁₅₆₃ | L_{b52} | 1768 | Lₐ₁₅₉₃ | L_{b52} |
| 1769 | Lₐ₁₅₉₈ | L_{b52} | 1770 | Lₐ₁₅₉₄ | L_{b52} |
| 1771 | Lₐ₁₅₉₉ | L_{b52} | 1772 | Lₐ₁₆₀₆ | L_{b52} |
| 1773 | Lₐ₁₆₀₀ | L_{b52} | 1774 | Lₐ₁₆₀₇ | L_{b52} |
| 1775 | Lₐ₁₆₀₁ | L_{b52} | 1776 | Lₐ₁₆₀₈ | L_{b52} |
| 1777 | Lₐ₁₆₁₇ | L_{b52} | 1778 | Lₐ₁₆₄₃ | L_{b52} |
| 1779 | Lₐ₁₆₁₈ | L_{b52} | 1780 | Lₐ₁₆₄₄ | L_{b52} |
| 1781 | Lₐ₁₆₁₉ | L_{b52} | 1782 | Lₐ₁₆₅₄ | L_{b52} |
| 1783 | Lₐ₁₆₂₀ | L_{b52} | 1784 | Lₐ₁₆₅₅ | L_{b52} |
| 1785 | Lₐ₁₆₈₇ | L_{b52} | 1786 | Lₐ₁₆₅₆ | L_{b52} |
| 1787 | Lₐ₁₆₈₈ | L_{b52} | 1788 | Lₐ₁₆₅₇ | L_{b52} |
| 1789 | Lₐ₁₆₈₉ | L_{b52} | 1790 | Lₐ₁₆₅₈ | L_{b52} |
| 1791 | Lₐ₁₇₁₈ | L_{b52} | 1792 | Lₐ₁₆₅₉ | L_{b52} |
| 1793 | Lₐ₁₇₁₉ | L_{b52} | 1794 | Lₐ₁₇₅₃ | L_{b52} |
| 1795 | Lₐ₁₇₂₀ | L_{b52} | 1796 | Lₐ₁₇₅₄ | L_{b52} |
| 1797 | Lₐ₁₇₂₁ | L_{b52} | 1798 | Lₐ₁₇₅₅ | L_{b52} |
| 1799 | Lₐ₁₇₂₂ | L_{b52} | 1800 | Lₐ₁₇₅₆ | L_{b52} |
| 1801 | Lₐ₁₇₇₃ | L_{b52} | 1802 | Lₐ₁₇₅₇ | L_{b52} |
| 1803 | Lₐ₁₇₇₄ | L_{b52} | 1804 | Lₐ₁₇₈₈ | L_{b52} |
| 1805 | Lₐ₁₇₇₅ | L_{b52} | 1806 | Lₐ₁₇₉₉ | L_{b52} |
| 1807 | Lₐ₁₇₇₆ | L_{b52} | 1808 | Lₐ₁₈₀₀ | L_{b52} |
| 1809 | Lₐ₁₇₇₇ | L_{b52} | 1810 | Lₐ₁₈₀₁ | L_{b52} |
| 1811 | Lₐ₁₇₇₈ | L_{b52} | 1812 | Lₐ₁₈₁₅ | L_{b52} |
| 1813 | Lₐ₁₇₇₉ | L_{b52} | 1814 | Lₐ₁₈₁₆ | L_{b52} |
| 1815 | Lₐ₁₈₂₈ | L_{b52} | 1816 | Lₐ₁₈₁₇ | L_{b52} |
| 1817 | Lₐ₁₈₂₉ | L_{b52} | 1818 | Lₐ₁₈₄₁ | L_{b52} |
| 1819 | Lₐ₁₈₃₀ | L_{b52} | 1820 | Lₐ₁₈₄₂ | L_{b52} |
| 1821 | Lₐ₁₈₄₉ | L_{b52} | 1822 | Lₐ₁₈₄₃ | L_{b52} |
| 1823 | Lₐ₁₈₅₀ | L_{b52} | 1824 | Lₐ₁₈₄₄ | L_{b52} |
| 1825 | Lₐ₁₈₅₁ | L_{b52} | 1826 | Lₐ₁₈₅₉ | L_{b52} |
| 1827 | Lₐ₁₈₇₅ | L_{b52} | 1828 | Lₐ₁₈₆₀ | L_{b52} |
| 1829 | Lₐ₁₈₇₆ | L_{b52} | 1830 | Lₐ₁₈₆₁ | L_{b52} |
| 1831 | Lₐ₁₈₇₇ | L_{b52} | 1832 | Lₐ₁₈₆₂ | L_{b52} |
| 1833 | Lₐ₁₉₁₈ | L_{b52} | 1834 | Lₐ₁₈₈₅ | L_{b52} |
| 1835 | Lₐ₁₉₁₉ | L_{b52} | 1836 | Lₐ₁₈₈₆ | L_{b52} |
| 1837 | Lₐ₁₉₂₀ | L_{b52} | 1838 | Lₐ₁₈₈₇ | L_{b52} |
| 1839 | Lₐ₁₉₅₈ | L_{b52} | 1840 | Lₐ₁₉₈₃ | L_{b52} |
| 1841 | Lₐ₁₉₅₉ | L_{b52} | 1842 | Lₐ₁₉₈₄ | L_{b52} |
| 1843 | Lₐ₁₉₆₀ | L_{b52} | 1844 | Lₐ₁₉₈₅ | L_{b52} |
| 1845 | Lₐ₂₀₂₄ | L_{b52} | 1846 | Lₐ₁₉₈₆ | L_{b52} |
| 1847 | Lₐ₂₀₂₅ | L_{b52} | 1848 | Lₐ₂₀₇₂ | L_{b52} |
| 1849 | Lₐ₂₀₉₆ | L_{b52} | 1850 | Lₐ₂₀₇₃ | L_{b52} |
| 1851 | Lₐ₂₀₉₇ | L_{b52} | 1852 | Lₐ₂₁₂₄ | L_{b52} |
| 1853 | Lₐ₂₀₉₈ | L_{b52} | 1854 | Lₐ₂₁₂₅ | L_{b52} |
| 1855 | Lₐ₂₁₄₃ | L_{b52} | 1856 | Lₐ₂₁₂₆ | L_{b52} |
| 1857 | Lₐ₂₁₄₄ | L_{b52} | 1858 | Lₐ₂₁₂₇ | L_{b52} |
| 1859 | Lₐ₂₁₄₅ | L_{b52} | 1860 | Lₐ₂₁₂₈ | L_{b52} |
| 1861 | Lₐ₂₁₅₄ | L_{b52} | 1862 | Lₐ₂₁₆₀ | L_{b52} |
| 1863 | Lₐ₂₁₅₅ | L_{b52} | 1864 | Lₐ₂₁₆₁ | L_{b52} |
| 1865 | Lₐ₂₁₅₆ | L_{b52} | 1866 | Lₐ₂₁₉₅ | L_{b52} |
| 1867 | Lₐ₂₁₅₇ | L_{b52} | 1868 | Lₐ₂₁₉₆ | L_{b52} |
| 1869 | Lₐ₂₂₁₃ | L_{b52} | 1870 | Lₐ₂₁₉₇ | L_{b52} |
| 1871 | Lₐ₂₂₁₄ | L_{b52} | 1872 | Lₐ₂₂₂₅ | L_{b52} |
| 1873 | Lₐ₂₂₁₅ | L_{b52} | 1874 | Lₐ₂₂₂₆ | L_{b52} |
| 1875 | Lₐ₂₂₁₆ | L_{b52} | 1876 | Lₐ₂₂₂₇ | L_{b52} |
| 1877 | Lₐ₂₂₄₄ | L_{b52} | 1878 | Lₐ₂₂₆₅ | L_{b52} |
| 1879 | Lₐ₂₂₄₅ | L_{b52} | 1880 | Lₐ₂₂₆₆ | L_{b52} |
| 1881 | Lₐ₂₂₄₆ | L_{b52} | 1882 | Lₐ₂₃₀₀ | L_{b52} |
| 1883 | Lₐ₂₃₁₀ | L_{b52} | 1884 | Lₐ₂₃₀₁ | L_{b52} |
| 1885 | Lₐ₂₃₁₁ | L_{b52} | 1886 | Lₐ₂₃₂₀ | L_{b52} |
| 1887 | Lₐ₂₃₁₂ | L_{b52} | 1888 | Lₐ₂₃₂₁ | L_{b52} |
| 1889 | Lₐ₂₃₄₅ | L_{b52} | 1890 | Lₐ₂₃₉₂ | L_{b52} |
| 1891 | Lₐ₂₃₄₆ | L_{b52} | 1892 | Lₐ₂₃₉₃ | L_{b52} |
| 1893 | Lₐ₂₄₂₈ | L_{b52} | 1894 | Lₐ₂₃₉₄ | L_{b52} |
| 1895 | Lₐ₂₄₂₉ | L_{b52} | 1896 | Lₐ₂₃₉₅ | L_{b52} |
| 1897 | Lₐ₂₄₃₀ | L_{b52} | 1898 | Lₐ₂₄₈₅ | L_{b52} |
| 1899 | Lₐ₂₄₆₈ | L_{b52} | 1900 | Lₐ₂₄₈₆ | L_{b52} |
| 1901 | Lₐ₂₄₆₉ | L_{b52} | 1902 | Lₐ₂₄₈₇ | L_{b52} |
| 1903 | Lₐ₂₄₇₀ | L_{b52} | 1904 | Lₐ₂₄₈₈ | L_{b52} |
| 1905 | Lₐ₂₄₇₁ | L_{b52} | 1906 | Lₐ₂₅₃₅ | L_{b52} |
| 1907 | Lₐ₂₅₁₀ | L_{b52} | 1908 | Lₐ₂₅₃₆ | L_{b52} |
| 1909 | Lₐ₂₅₁₁ | L_{b52} | 1910 | Lₐ₂₅₃₇ | L_{b52} |
| 1911 | Lₐ₂₅₁₂ | L_{b52} | 1912 | Lₐ₂₅₅₆ | L_{b52} |
| 1913 | Lₐ₂₅₇₇ | L_{b52} | 1914 | Lₐ₂₅₅₇ | L_{b52} |
| 1915 | Lₐ₂₅₇₈ | L_{b52} | 1916 | Lₐ₂₅₅₈ | L_{b52} |
| 1917 | Lₐ₂₅₇₉ | L_{b52} | 1918 | Lₐ₂₆₃₆ | L_{b52} |
| 1919 | Lₐ₂₅₉₇ | L_{b52} | 1920 | Lₐ₂₆₃₇ | L_{b52} |
| 1921 | Lₐ₂₅₉₈ | L_{b52} | 1922 | Lₐ₂₆₃₈ | L_{b52} |
| 1923 | Lₐ₂₅₉₉ | L_{b52} | 1924 | Lₐ₂₆₈₂ | L_{b52} |
| 1925 | Lₐ₂₆₄₉ | L_{b52} | 1926 | Lₐ₂₆₈₃ | L_{b52} |
| 1927 | Lₐ₂₆₅₀ | L_{b52} | 1928 | Lₐ₂₆₈₄ | L_{b52} |
| 1929 | Lₐ₂₆₅₁ | L_{b52} | 1930 | Lₐ₂₇₂₂ | L_{b52} |
| 1931 | Lₐ₂₆₉₄ | L_{b52} | 1932 | Lₐ₂₇₂₃ | L_{b52} |
| 1933 | Lₐ₂₆₉₅ | L_{b52} | 1934 | Lₐ₂₇₂₄ | L_{b52} |
| 1935 | Lₐ₂₆₉₆ | L_{b52} | 1936 | Lₐ₂₇₃₅ | L_{b52} |
| 1937 | Lₐ₂₇₄₂ | L_{b52} | 1938 | Lₐ₂₇₃₆ | L_{b52} |
| 1939 | Lₐ₂₇₄₃ | L_{b52} | 1940 | Lₐ₂₇₃₇ | L_{b52} |
| 1941 | Lₐ₂₇₄₄ | L_{b52} | 1942 | Lₐ₂₈₀₄ | L_{b52} |
| 1943 | Lₐ₂₇₇₆ | L_{b52} | 1944 | Lₐ₂₈₀₅ | L_{b52} |
| 1945 | Lₐ₂₇₇₇ | L_{b52} | 1946 | Lₐ₂₈₀₆ | L_{b52} |
| 1947 | Lₐ₂₇₇₈ | L_{b52} | 1948 | Lₐ₂₈₀₇ | L_{b52} |
| 1949 | Lₐ₂₇₇₉ | L_{b52} | 1950 | Lₐ₂₈₀₈ | L_{b52} |
| 1951 | Lₐ₂₇₈₀ | L_{b52} | 1952 | Lₐ₂₈₂₅ | L_{b52} |
| 1953 | Lₐ₂₇₈₁ | L_{b52} | 1954 | Lₐ₂₈₂₆ | L_{b52} |
| 1955 | Lₐ₂₇₈₂ | L_{b52} | 1956 | Lₐ₂₈₂₇ | L_{b52} |
| 1957 | Lₐ₂₈₄₇ | L_{b52} | 1958 | Lₐ₂₈₅₅ | L_{b52} |
| 1959 | Lₐ₂₈₄₈ | L_{b52} | 1960 | Lₐ₂₈₅₆ | L_{b52} |
| 1961 | Lₐ₂₈₄₉ | L_{b52} | 1962 | Lₐ₂₈₅₇ | L_{b52} |
| 1963 | Lₐ₂₈₅₀ | L_{b52} | 1964 | Lₐ₂₈₇₆ | L_{b52} |
| 1965 | Lₐ₂₈₉₅ | L_{b52} | 1966 | Lₐ₂₈₇₇ | L_{b52} |
| 1967 | Lₐ₂₈₉₆ | L_{b52} | 1968 | Lₐ₂₈₇₈ | L_{b52} |
| 1969 | Lₐ₂₈₉₇ | L_{b52} | 1970 | Lₐ₂₉₀₇ | L_{b52} |
| 1971 | Lₐ₂₉₂₆ | L_{b52} | 1972 | Lₐ₂₉₀₈ | L_{b52} |
| 1973 | Lₐ₂₉₂₇ | L_{b52} | 1974 | Lₐ₂₉₀₉ | L_{b52} |
| 1975 | Lₐ₂₉₂₈ | L_{b52} | 1976 | Lₐ₂₉₄₈ | L_{b52} |
| 1977 | Lₐ₃₀₀₃ | L_{b52} | 1978 | Lₐ₂₉₄₉ | L_{b52} |
| 1979 | Lₐ₃₀₀₄ | L_{b52} | 1980 | Lₐ₂₉₅₀ | L_{b52} |
| 1981 | Lₐ₃₀₄₈ | L_{b52} | 1982 | Lₐ₃₀₈₈ | L_{b52} |
| 1983 | Lₐ₃₀₄₉ | L_{b52} | 1984 | Lₐ₃₀₈₉ | L_{b52} |
| 1985 | Lₐ₃₀₅₀ | L_{b52} | 1986 | Lₐ₃₀₉₀ | L_{b52} |
| 1987 | Lₐ₃₁₂₈ | L_{b52} | 1988 | Lₐ₃₁₄₇ | L_{b52} |
| 1989 | Lₐ₃₁₂₉ | L_{b52} | 1990 | Lₐ₃₁₄₈ | L_{b52} |
| 1991 | Lₐ₃₁₃₀ | L_{b52} | 1992 | Lₐ₃₁₄₉ | L_{b52} |
| 1993 | Lₐ₃₁₃₁ | L_{b52} | 1994 | Lₐ₃₁₅₀ | L_{b52} |
| 1995 | Lₐ₃₁₇₈ | L_{b52} | 1996 | Lₐ₃₂₈₇ | L_{b52} |
| 1997 | Lₐ₃₁₇₉ | L_{b52} | 1998 | Lₐ₃₂₈₈ | L_{b52} |
| 1999 | Lₐ₃₁₈₀ | L_{b52} | 2000 | Lₐ₃₂₈₉ | L_{b52} |
| 2001 | Lₐ₃₃₃₇ | L_{b52} | 2002 | Lₐ₃₃₆₃ | L_{b52} |
| 2003 | Lₐ₃₃₃₈ | L_{b52} | 2004 | Lₐ₃₃₆₄ | L_{b52} |
| 2005 | Lₐ₃₃₃₉ | L_{b52} | 2006 | Lₐ₃₃₆₅ | L_{b52} |
| 2007 | Lₐ₁ | L_{b2} | 2008 | Lₐ₁₀₅ | L_{b2} |
| 2009 | Lₐ₁ | L_{b4} | 2010 | Lₐ₁₀₅ | L_{b4} |
| 2011 | Lₐ₁ | L_{b5} | 2012 | Lₐ₁₀₅ | L_{b5} |
| 2013 | Lₐ₁ | L_{b10} | 2014 | Lₐ₁₀₅ | L_{b10} |
| 2015 | Lₐ₁ | L_{b11} | 2016 | Lₐ₁₀₅ | L_{b11} |
| 2017 | Lₐ₁ | L_{b12} | 2018 | Lₐ₁₀₅ | L_{b12} |
| 2019 | Lₐ₁ | L_{b13} | 2020 | Lₐ₁₀₅ | L_{b13} |
| 2021 | Lₐ₁ | L_{b14} | 2022 | Lₐ₁₀₅ | L_{b14} |
| 2023 | Lₐ₁ | L_{b15} | 2024 | Lₐ₁₀₅ | L_{b15} |
| 2025 | Lₐ₁ | L_{b17} | 2026 | Lₐ₁₀₅ | L_{b17} |
| 2027 | Lₐ₁ | L_{b19} | 2028 | Lₐ₁₀₅ | L_{b19} |
| 2029 | Lₐ₁ | L_{b21} | 2030 | Lₐ₁₀₅ | L_{b21} |
| 2031 | Lₐ₁ | L_{b22} | 2032 | Lₐ₁₀₅ | L_{b22} |
| 2033 | Lₐ₁ | L_{b23} | 2034 | Lₐ₁₀₅ | L_{b23} |
| 2035 | Lₐ₁ | L_{b24} | 2036 | Lₐ₁₀₅ | L_{b24} |
| 2037 | Lₐ₁ | L_{b25} | 2038 | Lₐ₁₀₅ | L_{b25} |
| 2039 | Lₐ₁ | L_{b26} | 2040 | Lₐ₁₀₅ | L_{b26} |
| 2041 | Lₐ₁ | L_{b27} | 2042 | Lₐ₁₀₅ | L_{b27} |
| 2043 | Lₐ₁ | L_{b28} | 2044 | Lₐ₁₀₅ | L_{b28} |
| 2045 | Lₐ₁ | L_{b29} | 2046 | Lₐ₁₀₅ | L_{b29} |
| 2047 | Lₐ₁ | L_{b30} | 2048 | Lₐ₁₀₅ | L_{b30} |
| 2049 | Lₐ₁ | L_{b31} | 2050 | Lₐ₁₀₅ | L_{b31} |
| 2051 | Lₐ₁ | L_{b32} | 2052 | Lₐ₁₀₅ | L_{b32} |
| 2053 | Lₐ₁ | L_{b33} | 2054 | Lₐ₁₀₅ | L_{b33} |
| 2055 | Lₐ₁ | L_{b42} | 2056 | Lₐ₁₀₅ | L_{b42} |
| 2057 | Lₐ₁ | L_{b43} | 2058 | Lₐ₁₀₅ | L_{b43} |
| 2059 | Lₐ₁ | L_{b44} | 2060 | Lₐ₁₀₅ | L_{b44} |
| 2061 | Lₐ₁ | L_{b45} | 2062 | Lₐ₁₀₅ | L_{b45} |
| 2063 | Lₐ₁ | L_{b46} | 2064 | Lₐ₁₀₅ | L_{b46} |
| 2065 | Lₐ₁ | L_{b50} | 2066 | Lₐ₁₀₅ | L_{b50} |
| 2067 | Lₐ₁ | L_{b51} | 2068 | Lₐ₁₀₅ | L_{b51} |
| 2069 | Lₐ₁ | L_{b53} | 2070 | Lₐ₁₀₅ | L_{b53} |
| 2071 | Lₐ₁ | L_{b54} | 2072 | Lₐ₁₀₅ | L_{b54} |
| 2073 | Lₐ₁ | L_{b55} | 2074 | Lₐ₁₀₅ | L_{b55} |
| 2075 | Lₐ₁ | L_{b56} | 2076 | Lₐ₁₀₅ | L_{b56} |
| 2077 | Lₐ₁ | L_{b57} | 2078 | Lₐ₁₀₅ | L_{b57} |
| 2079 | Lₐ₁ | L_{b58} | 2080 | Lₐ₁₀₅ | L_{b28} |
| 2081 | Lₐ₁ | L_{b59} | 2082 | Lₐ₁₀₅ | L_{b59} |
| 2083 | Lₐ₁ | L_{b66} | 2084 | Lₐ₁₀₅ | L_{b66} |
| 2085 | Lₐ₁ | L_{b68} | 2086 | Lₐ₁₀₅ | L_{b68} |
| 2087 | Lₐ₁ | L_{b70} | 2088 | Lₐ₁₀₅ | L_{b70} |
| 2089 | Lₐ₁ | L_{b75} | 2090 | Lₐ₁₀₅ | L_{b75} |
| 2091 | Lₐ₁ | L_{b76} | 2092 | Lₐ₁₀₅ | L_{b76} |
| 2093 | Lₐ₁ | L_{b87} | 2094 | Lₐ₁₀₅ | L_{b87} |
| 2095 | Lₐ₁ | L_{b95} | 2096 | Lₐ₁₀₅ | L_{b95} |
| 2097 | Lₐ₁ | L_{b96} | 2098 | Lₐ₁₀₅ | L_{b96} |
| 2099 | Lₐ₁ | L_{b97} | 2100 | Lₐ₁₀₅ | L_{b97} |
| 2101 | Lₐ₁ | L_{b98} | 2102 | Lₐ₁₀₅ | L_{b98} |
| 2103 | Lₐ₁ | L_{b109} | 2104 | Lₐ₁₀₅ | L_{b109} |
| 2105 | Lₐ₁ | L_{b110} | 2106 | Lₐ₁₀₅ | L_{b110} |
| 2107 | Lₐ₁ | L_{b111} | 2108 | Lₐ₁₀₅ | L_{b111} |
| 2109 | Lₐ₁ | L_{b112} | 2110 | Lₐ₁₀₅ | L_{b112} |
| 2111 | Lₐ₁ | L_{b114} | 2112 | Lₐ₁₀₅ | L_{b114} |
| 2113 | Lₐ₁ | L_{b117} | 2114 | Lₐ₁₀₅ | L_{b117} |
| 2115 | Lₐ₁ | L_{b122} | 2116 | Lₐ₁₀₅ | L_{b122} |
| 2117 | Lₐ₁ | L_{b123} | 2118 | Lₐ₁₀₅ | L_{b123} |
| 2119 | Lₐ₁ | L_{b129} | 2120 | Lₐ₁₀₅ | L_{b129} |
| 2121 | Lₐ₁ | L_{b130} | 2122 | Lₐ₁₀₅ | L_{b130} |
| 2123 | Lₐ₁ | L_{b131} | 2124 | Lₐ₁₀₅ | L_{b131} |
| 2125 | Lₐ₁ | L_{b133} | 2126 | Lₐ₁₀₅ | L_{b133} |
| 2127 | Lₐ₁ | L_{b134} | 2128 | Lₐ₁₀₅ | L_{b134} |
| 2129 | Lₐ₁ | L_{b135} | 2130 | Lₐ₁₀₅ | L_{b135} |
| 2131 | Lₐ₁ | L_{b148} | 2132 | Lₐ₁₀₅ | L_{b148} |
| 2133 | Lₐ₁ | L_{b149} | 2134 | Lₐ₁₀₅ | L_{b149} |
| 2135 | Lₐ₁ | L_{b150} | 2136 | Lₐ₁₀₅ | L_{b150} |
| 2137 | Lₐ₁ | L_{b151} | 2138 | Lₐ₁₀₅ | L_{b151} |
| 2139 | Lₐ₁₃₀ | L_{b2} | 2140 | Lₐ₂₀₁ | L_{b2} |
| 2141 | Lₐ₁₃₀ | L_{b4} | 2142 | Lₐ₂₀₁ | L_{b4} |
| 2143 | Lₐ₁₃₀ | L_{b5} | 2144 | Lₐ₂₀₁ | L_{b5} |
| 2145 | Lₐ₁₃₀ | L_{b10} | 2146 | Lₐ₂₀₁ | L_{b10} |
| 2147 | Lₐ₁₃₀ | L_{b11} | 2148 | Lₐ₂₀₁ | L_{b11} |
| 2149 | Lₐ₁₃₀ | L_{b12} | 2150 | Lₐ₂₀₁ | L_{b12} |
| 2151 | Lₐ₁₃₀ | L_{b13} | 2152 | Lₐ₂₀₁ | L_{b13} |
| 2153 | Lₐ₁₃₀ | L_{b14} | 2154 | Lₐ₂₀₁ | L_{b14} |
| 2155 | Lₐ₁₃₀ | L_{b15} | 2156 | Lₐ₂₀₁ | L_{b15} |
| 2157 | Lₐ₁₃₀ | L_{b17} | 2158 | Lₐ₂₀₁ | L_{b17} |
| 2159 | Lₐ₁₃₀ | L_{b19} | 2160 | Lₐ₂₀₁ | L_{b19} |
| 2161 | Lₐ₁₃₀ | L_{b21} | 2162 | Lₐ₂₀₁ | L_{b21} |
| 2163 | Lₐ₁₃₀ | L_{b22} | 2164 | Lₐ₂₀₁ | L_{b22} |
| 2165 | Lₐ₁₃₀ | L_{b23} | 2166 | Lₐ₂₀₁ | L_{b23} |
| 2167 | Lₐ₁₃₀ | L_{b24} | 2168 | Lₐ₂₀₁ | L_{b24} |
| 2169 | Lₐ₁₃₀ | L_{b25} | 2170 | Lₐ₂₀₁ | L_{b25} |
| 2171 | Lₐ₁₃₀ | L_{b26} | 2172 | Lₐ₂₀₁ | L_{b26} |
| 2173 | Lₐ₁₃₀ | L_{b27} | 2174 | Lₐ₂₀₁ | L_{b27} |
| 2175 | Lₐ₁₃₀ | L_{b28} | 2176 | Lₐ₂₀₁ | L_{b28} |
| 2177 | Lₐ₁₃₀ | L_{b29} | 2178 | Lₐ₂₀₁ | L_{b29} |
| 2179 | Lₐ₁₃₀ | L_{b30} | 2180 | Lₐ₂₀₁ | L_{b30} |
| 2181 | Lₐ₁₃₀ | L_{b31} | 2182 | Lₐ₂₀₁ | L_{b31} |
| 2183 | Lₐ₁₃₀ | L_{b32} | 2184 | Lₐ₂₀₁ | L_{b32} |
| 2185 | Lₐ₁₃₀ | L_{b33} | 2186 | Lₐ₂₀₁ | L_{b33} |
| 2187 | Lₐ₁₃₀ | L_{b42} | 2188 | Lₐ₂₀₁ | L_{b42} |
| 2189 | Lₐ₁₃₀ | L_{b43} | 2190 | Lₐ₂₀₁ | L_{b43} |
| 2191 | Lₐ₁₃₀ | L_{b44} | 2192 | Lₐ₂₀₁ | L_{b44} |
| 2193 | Lₐ₁₃₀ | L_{b45} | 2194 | Lₐ₂₀₁ | L_{b45} |
| 2195 | Lₐ₁₃₀ | L_{b46} | 2196 | Lₐ₂₀₁ | L_{b46} |
| 2197 | Lₐ₁₃₀ | L_{b50} | 2198 | Lₐ₂₀₁ | L_{b50} |
| 2199 | Lₐ₁₃₀ | L_{b51} | 2200 | Lₐ₂₀₁ | L_{b51} |
| 2201 | Lₐ₁₃₀ | L_{b53} | 2202 | Lₐ₂₀₁ | L_{b53} |
| 2203 | Lₐ₁₃₀ | L_{b54} | 2204 | Lₐ₂₀₁ | L_{b54} |
| 2205 | Lₐ₁₃₀ | L_{b55} | 2206 | Lₐ₂₀₁ | L_{b55} |
| 2207 | Lₐ₁₃₀ | L_{b53} | 2208 | Lₐ₂₀₁ | L_{b56} |
| 2209 | Lₐ₁₃₀ | L_{b57} | 2210 | Lₐ₂₀₁ | L_{b57} |
| 2211 | Lₐ₁₃₀ | L_{b58} | 2212 | Lₐ₂₀₁ | L_{b58} |
| 2213 | Lₐ₁₃₀ | L_{b59} | 2214 | Lₐ₂₀₁ | L_{b59} |
| 2215 | Lₐ₁₃₀ | L_{b66} | 2216 | Lₐ₂₀₁ | L_{b66} |
| 2217 | Lₐ₁₃₀ | L_{b68} | 2218 | Lₐ₂₀₁ | L_{b68} |
| 2219 | Lₐ₁₃₀ | L_{b70} | 2220 | Lₐ₂₀₁ | L_{b70} |
| 2221 | Lₐ₁₃₀ | L_{b75} | 2222 | Lₐ₂₀₁ | L_{b75} |
| 2223 | Lₐ₁₃₀ | L_{b76} | 2224 | Lₐ₂₀₁ | L_{b76} |
| 2225 | Lₐ₁₃₀ | L_{b87} | 2226 | Lₐ₂₀₁ | L_{b87} |
| 2227 | Lₐ₁₃₀ | L_{b95} | 2228 | Lₐ₂₀₁ | L_{b95} |
| 2229 | Lₐ₁₃₀ | L_{b96} | 2230 | Lₐ₂₀₁ | L_{b96} |
| 2231 | Lₐ₁₃₀ | L_{b97} | 2232 | Lₐ₂₀₁ | L_{b97} |
| 2233 | Lₐ₁₃₀ | L_{b98} | 2234 | Lₐ₂₀₁ | L_{b98} |
| 2235 | Lₐ₁₃₀ | L_{b109} | 2236 | Lₐ₂₀₁ | L_{b109} |
| 2237 | Lₐ₁₃₀ | L_{b110} | 2238 | Lₐ₂₀₁ | L_{b110} |
| 2239 | Lₐ₁₃₀ | L_{b111} | 2240 | Lₐ₂₀₁ | L_{b111} |
| 2241 | Lₐ₁₃₀ | L_{b112} | 2242 | Lₐ₂₀₁ | L_{b112} |
| 2243 | Lₐ₁₃₀ | L_{b114} | 2244 | Lₐ₂₀₁ | L_{b114} |
| 2245 | Lₐ₁₃₀ | L_{b117} | 2246 | Lₐ₂₀₁ | L_{b117} |
| 2247 | Lₐ₁₃₀ | L_{b122} | 2248 | Lₐ₂₀₁ | L_{b122} |
| 2249 | Lₐ₁₃₀ | L_{b123} | 2250 | Lₐ₂₀₁ | L_{b123} |
| 2251 | Lₐ₁₃₀ | L_{b129} | 2252 | Lₐ₂₀₁ | L_{b129} |
| 2253 | Lₐ₁₃₀ | L_{b130} | 2254 | Lₐ₂₀₁ | L_{b130} |
| 2255 | Lₐ₁₃₀ | L_{b131} | 2256 | Lₐ₂₀₁ | L_{b131} |
| 2257 | Lₐ₁₃₀ | L_{b133} | 2258 | Lₐ₂₀₁ | L_{b133} |
| 2259 | Lₐ₁₃₀ | L_{b134} | 2260 | Lₐ₂₀₁ | L_{b134} |
| 2261 | Lₐ₁₃₀ | L_{b135} | 2262 | Lₐ₂₀₁ | L_{b135} |
| 2263 | Lₐ₁₃₀ | L_{b148} | 2264 | Lₐ₂₀₁ | L_{b148} |
| 2265 | Lₐ₁₃₀ | L_{b149} | 2266 | Lₐ₂₀₁ | L_{b149} |
| 2267 | Lₐ₁₃₀ | L_{b150} | 2268 | Lₐ₂₀₁ | L_{b150} |
| 2269 | Lₐ₁₃₀ | L_{b151} | 2270 | Lₐ₂₀₁ | L_{b151} |
| 2271 | Lₐ₂₇₂ | L_{b2} | 2272 | Lₐ₃₄₃ | L_{b2} |
| 2273 | Lₐ₂₇₂ | L_{b4} | 2274 | Lₐ₃₄₃ | L_{b4} |
| 2275 | Lₐ₂₇₂ | L_{b5} | 2276 | Lₐ₃₄₃ | L_{b5} |
| 2277 | Lₐ₂₇₂ | L_{b10} | 2278 | Lₐ₃₄₃ | L_{b10} |
| 2279 | Lₐ₂₇₂ | L_{b11} | 2280 | Lₐ₃₄₃ | L_{b11} |
| 2281 | Lₐ₂₇₂ | L_{b12} | 2282 | Lₐ₃₄₃ | L_{b12} |
| 2283 | Lₐ₂₇₂ | L_{b13} | 2284 | Lₐ₃₄₃ | L_{b13} |
| 2285 | Lₐ₂₇₂ | L_{b14} | 2286 | Lₐ₃₄₃ | L_{b14} |
| 2287 | Lₐ₂₇₂ | L_{b15} | 2288 | Lₐ₃₄₃ | L_{b15} |
| 2289 | Lₐ₂₇₂ | L_{b17} | 2290 | Lₐ₃₄₃ | L_{b17} |
| 2291 | Lₐ₂₇₂ | L_{b19} | 2292 | Lₐ₃₄₃ | L_{b19} |
| 2293 | Lₐ₂₇₂ | L_{b21} | 2294 | Lₐ₃₄₃ | L_{b21} |
| 2295 | Lₐ₂₇₂ | L_{b22} | 2296 | Lₐ₃₄₃ | L_{b22} |
| 2297 | Lₐ₂₇₂ | L_{b23} | 2298 | Lₐ₃₄₃ | L_{b23} |
| 2299 | Lₐ₂₇₂ | L_{b24} | 2300 | Lₐ₃₄₃ | L_{b24} |
| 2301 | Lₐ₂₇₂ | L_{b25} | 2302 | Lₐ₃₄₃ | L_{b25} |
| 2303 | Lₐ₂₇₂ | L_{b26} | 2304 | Lₐ₃₄₃ | L_{b26} |
| 2305 | Lₐ₂₇₂ | L_{b27} | 2306 | Lₐ₃₄₃ | L_{b27} |
| 2307 | Lₐ₂₇₂ | L_{b28} | 2308 | Lₐ₃₄₃ | L_{b28} |
| 2309 | Lₐ₂₇₂ | L_{b29} | 2310 | Lₐ₃₄₃ | L_{b29} |
| 2311 | Lₐ₂₇₂ | L_{b30} | 2312 | Lₐ₃₄₃ | L_{b30} |
| 2313 | Lₐ₂₇₂ | L_{b31} | 2314 | Lₐ₃₄₃ | L_{b31} |
| 2315 | Lₐ₂₇₂ | L_{b32} | 2316 | Lₐ₃₄₃ | L_{b32} |
| 2317 | Lₐ₂₇₂ | L_{b33} | 2318 | Lₐ₃₄₃ | L_{b33} |
| 2319 | Lₐ₂₇₂ | L_{b42} | 2320 | Lₐ₃₄₃ | L_{b42} |
| 2321 | Lₐ₂₇₂ | L_{b43} | 2322 | Lₐ₃₄₃ | L_{b43} |
| 2323 | Lₐ₂₇₂ | L_{b44} | 2324 | Lₐ₃₄₃ | L_{b44} |
| 2325 | Lₐ₂₇₂ | L_{b45} | 2326 | Lₐ₃₄₃ | L_{b45} |
| 2327 | Lₐ₂₇₂ | L_{b46} | 2328 | Lₐ₃₄₃ | L_{b46} |
| 2329 | Lₐ₂₇₂ | L_{b50} | 2330 | Lₐ₃₄₃ | L_{b50} |
| 2331 | Lₐ₂₇₂ | L_{b51} | 2332 | Lₐ₃₄₃ | L_{b51} |
| 2333 | Lₐ₂₇₂ | L_{b53} | 2334 | Lₐ₃₄₃ | L_{b53} |
| 2335 | Lₐ₂₇₂ | L_{b54} | 2336 | Lₐ₃₄₃ | L_{b54} |
| 2337 | Lₐ₂₇₂ | L_{b55} | 2338 | Lₐ₃₄₃ | L_{b55} |
| 2339 | Lₐ₂₇₂ | L_{b53} | 2340 | Lₐ₃₄₃ | L_{b56} |
| 2341 | Lₐ₂₇₂ | L_{b57} | 2342 | Lₐ₃₄₃ | L_{b57} |
| 2343 | Lₐ₂₇₂ | L_{b58} | 2344 | Lₐ₃₄₃ | L_{b58} |
| 2345 | Lₐ₂₇₂ | L_{b59} | 2346 | Lₐ₃₄₃ | L_{b59} |
| 2347 | Lₐ₂₇₂ | L_{b66} | 2348 | Lₐ₃₄₃ | L_{b66} |
| 2349 | Lₐ₂₇₂ | L_{b68} | 2350 | Lₐ₃₄₃ | L_{b68} |
| 2351 | Lₐ₂₇₂ | L_{b70} | 2352 | Lₐ₃₄₃ | L_{b70} |
| 2353 | Lₐ₂₇₂ | L_{b75} | 2354 | Lₐ₃₄₃ | L_{b75} |
| 2355 | Lₐ₂₇₂ | L_{b76} | 2356 | Lₐ₃₄₃ | L_{b76} |
| 2357 | Lₐ₂₇₂ | L_{b87} | 2358 | Lₐ₃₄₃ | L_{b87} |
| 2359 | Lₐ₂₇₂ | L_{b95} | 2360 | Lₐ₃₄₃ | L_{b95} |
| 2361 | Lₐ₂₇₂ | L_{b96} | 2362 | Lₐ₃₄₃ | L_{b96} |
| 2363 | Lₐ₂₇₂ | L_{b97} | 2364 | Lₐ₃₄₃ | L_{b97} |
| 2365 | Lₐ₂₇₂ | L_{b98} | 2366 | Lₐ₃₄₃ | L_{b98} |
| 2367 | Lₐ₂₇₂ | L_{b109} | 2368 | Lₐ₃₄₃ | L_{b109} |
| 2369 | Lₐ₂₇₂ | L_{b110} | 2370 | Lₐ₃₄₃ | L_{b110} |
| 2371 | Lₐ₂₇₂ | L_{b111} | 2372 | Lₐ₃₄₃ | L_{b111} |
| 2373 | Lₐ₂₇₂ | L_{b112} | 2374 | Lₐ₃₄₃ | L_{b112} |
| 2375 | Lₐ₂₇₂ | L_{b114} | 2376 | Lₐ₃₄₃ | L_{b114} |
| 2377 | Lₐ₂₇₂ | L_{b117} | 2378 | Lₐ₃₄₃ | L_{b117} |
| 2379 | Lₐ₂₇₂ | L_{b122} | 2380 | Lₐ₃₄₃ | L_{b122} |
| 2381 | Lₐ₂₇₂ | L_{b123} | 2382 | Lₐ₃₄₃ | L_{b123} |
| 2383 | Lₐ₂₇₂ | L_{b129} | 2384 | Lₐ₃₄₃ | L_{b129} |
| 2385 | Lₐ₂₇₂ | L_{b130} | 2386 | Lₐ₃₄₃ | L_{b130} |
| 2387 | Lₐ₂₇₂ | L_{b131} | 2388 | Lₐ₃₄₃ | L_{b131} |
| 2389 | Lₐ₂₇₂ | L_{b133} | 2390 | Lₐ₃₄₃ | L_{b133} |
| 2391 | Lₐ₂₇₂ | L_{b134} | 2392 | Lₐ₃₄₃ | L_{b134} |
| 2393 | Lₐ₂₇₂ | L_{b135} | 2394 | Lₐ₃₄₃ | L_{b135} |
| 2395 | Lₐ₂₇₂ | L_{b148} | 2396 | Lₐ₃₄₃ | L_{b148} |
| 2397 | Lₐ₂₇₂ | L_{b149} | 2398 | Lₐ₃₄₃ | L_{b149} |
| 2399 | Lₐ₂₇₂ | L_{b150} | 2400 | Lₐ₃₄₃ | L_{b150} |
| 2401 | Lₐ₂₇₂ | L_{b151} | 2402 | Lₐ₃₄₃ | L_{b151} |
| 2403 | Lₐ₄₁₄ | L_{b2} | 2404 | Lₐ₇₄₆ | L_{b2} |
| 2405 | Lₐ₄₁₄ | L_{b4} | 2406 | Lₐ₇₄₆ | L_{b4} |
| 2407 | Lₐ₄₁₄ | L_{b5} | 2408 | Lₐ₇₄₆ | L_{b5} |
| 2409 | Lₐ₄₁₄ | L_{b10} | 2410 | Lₐ₇₄₆ | L_{b10} |
| 2411 | Lₐ₄₁₄ | L_{b11} | 2412 | Lₐ₇₄₆ | L_{b11} |
| 2413 | Lₐ₄₁₄ | L_{b12} | 2414 | Lₐ₇₄₆ | L_{b12} |
| 2415 | Lₐ₄₁₄ | L_{b13} | 2416 | Lₐ₇₄₆ | L_{b13} |
| 2417 | Lₐ₄₁₄ | L_{b14} | 2418 | Lₐ₇₄₆ | L_{b14} |
| 2419 | Lₐ₄₁₄ | L_{b15} | 2420 | Lₐ₇₄₆ | L_{b15} |
| 2421 | Lₐ₄₁₄ | L_{b17} | 2422 | Lₐ₇₄₆ | L_{b17} |
| 2423 | Lₐ₄₁₄ | L_{b19} | 2424 | Lₐ₇₄₆ | L_{b19} |
| 2425 | Lₐ₄₁₄ | L_{b21} | 2426 | Lₐ₇₄₆ | L_{b21} |
| 2427 | Lₐ₄₁₄ | L_{b22} | 2428 | Lₐ₇₄₆ | L_{b22} |
| 2429 | Lₐ₄₁₄ | L_{b23} | 2430 | Lₐ₇₄₆ | L_{b23} |
| 2431 | Lₐ₄₁₄ | L_{b24} | 2432 | Lₐ₇₄₆ | L_{b24} |
| 2433 | Lₐ₄₁₄ | L_{b25} | 2434 | Lₐ₇₄₆ | L_{b25} |
| 2435 | Lₐ₄₁₄ | L_{b26} | 2436 | Lₐ₇₄₆ | L_{b26} |
| 2437 | Lₐ₄₁₄ | L_{b27} | 2438 | Lₐ₇₄₆ | L_{b27} |
| 2439 | Lₐ₄₁₄ | L_{b28} | 2440 | Lₐ₇₄₆ | L_{b28} |
| 2441 | Lₐ₄₁₄ | L_{b29} | 2442 | Lₐ₇₄₆ | L_{b29} |
| 2443 | Lₐ₄₁₄ | L_{b30} | 2444 | Lₐ₇₄₆ | L_{b30} |
| 2445 | Lₐ₄₁₄ | L_{b31} | 2446 | Lₐ₇₄₆ | L_{b31} |
| 2447 | Lₐ₄₁₄ | L_{b32} | 2448 | Lₐ₇₄₆ | L_{b32} |
| 2449 | Lₐ₄₁₄ | L_{b33} | 2450 | Lₐ₇₄₆ | L_{b33} |
| 2451 | Lₐ₄₁₄ | L_{b42} | 2452 | Lₐ₇₄₆ | L_{b42} |
| 2453 | Lₐ₄₁₄ | L_{b43} | 2454 | Lₐ₇₄₆ | L_{b43} |
| 2455 | Lₐ₄₁₄ | L_{b44} | 2456 | Lₐ₇₄₆ | L_{b44} |
| 2457 | Lₐ₄₁₄ | L_{b45} | 2458 | Lₐ₇₄₆ | L_{b45} |
| 2459 | Lₐ₄₁₄ | L_{b46} | 2460 | Lₐ₇₄₆ | L_{b46} |
| 2461 | Lₐ₄₁₄ | L_{b50} | 2462 | Lₐ₇₄₆ | L_{b50} |
| 2463 | Lₐ₄₁₄ | L_{b51} | 2464 | Lₐ₇₄₆ | L_{b51} |
| 2465 | Lₐ₄₁₄ | L_{b53} | 2466 | Lₐ₇₄₆ | L_{b53} |
| 2467 | Lₐ₄₁₄ | L_{b54} | 2468 | Lₐ₇₄₆ | L_{b54} |
| 2469 | Lₐ₄₁₄ | L_{b55} | 2470 | Lₐ₇₄₆ | L_{b55} |
| 2471 | Lₐ₄₁₄ | L_{b56} | 2472 | Lₐ₇₄₆ | L_{b56} |
| 2473 | Lₐ₄₁₄ | L_{b57} | 2474 | Lₐ₇₄₆ | L_{b57} |
| 2475 | Lₐ₄₁₄ | L_{b58} | 2476 | Lₐ₇₄₆ | L_{b58} |
| 2477 | Lₐ₄₁₄ | L_{b59} | 2478 | Lₐ₇₄₆ | L_{b59} |
| 2479 | Lₐ₄₁₄ | L_{b66} | 2480 | Lₐ₇₄₆ | L_{b66} |
| 2481 | Lₐ₄₁₄ | L_{b68} | 2482 | Lₐ₇₄₆ | L_{b68} |
| 2483 | Lₐ₄₁₄ | L_{b70} | 2484 | Lₐ₇₄₆ | L_{b70} |
| 2485 | Lₐ₄₁₄ | L_{b75} | 2486 | Lₐ₇₄₆ | L_{b75} |
| 2487 | Lₐ₄₁₄ | L_{b76} | 2488 | Lₐ₇₄₆ | L_{b76} |
| 2489 | Lₐ₄₁₄ | L_{b87} | 2490 | Lₐ₇₄₆ | L_{b87} |
| 2491 | Lₐ₄₁₄ | L_{b95} | 2492 | Lₐ₇₄₆ | L_{b95} |
| 2493 | Lₐ₄₁₄ | L_{b96} | 2494 | Lₐ₇₄₆ | L_{b96} |
| 2495 | Lₐ₄₁₄ | L_{b97} | 2496 | Lₐ₇₄₆ | L_{b97} |
| 2497 | Lₐ₄₁₄ | L_{b98} | 2498 | Lₐ₇₄₆ | L_{b98} |
| 2499 | Lₐ₄₁₄ | L_{b109} | 2500 | Lₐ₇₄₆ | L_{b109} |
| 2501 | Lₐ₄₁₄ | L_{b110} | 2502 | Lₐ₇₄₆ | L_{b110} |
| 2503 | Lₐ₄₁₄ | L_{b111} | 2504 | Lₐ₇₄₆ | L_{b111} |
| 2505 | Lₐ₄₁₄ | L_{b112} | 2506 | Lₐ₇₄₆ | L_{b112} |
| 2507 | Lₐ₄₁₄ | L_{b114} | 2508 | Lₐ₇₄₆ | L_{b114} |
| 2509 | Lₐ₄₁₄ | L_{b117} | 2510 | Lₐ₇₄₆ | L_{b117} |
| 2511 | Lₐ₄₁₄ | L_{b122} | 2512 | Lₐ₇₄₆ | L_{b122} |
| 2513 | Lₐ₄₁₄ | L_{b123} | 2514 | Lₐ₇₄₆ | L_{b123} |
| 2515 | Lₐ₄₁₄ | L_{b129} | 2516 | Lₐ₇₄₆ | L_{b129} |
| 2517 | Lₐ₄₁₄ | L_{b130} | 2518 | Lₐ₇₄₆ | L_{b130} |
| 2519 | Lₐ₄₁₄ | L_{b131} | 2520 | Lₐ₇₄₆ | L_{b131} |
| 2521 | Lₐ₄₁₄ | L_{b133} | 2522 | Lₐ₇₄₆ | L_{b133} |
| 2523 | Lₐ₄₁₄ | L_{b134} | 2524 | Lₐ₇₄₆ | L_{b134} |
| 2525 | Lₐ₄₁₄ | L_{b135} | 2526 | Lₐ₇₄₆ | L_{b135} |
| 2527 | Lₐ₄₁₄ | L_{b148} | 2528 | Lₐ₇₄₆ | L_{b148} |
| 2529 | Lₐ₄₁₄ | L_{b149} | 2530 | Lₐ₇₄₆ | L_{b149} |
| 2531 | Lₐ₄₁₄ | L_{b150} | 2532 | Lₐ₇₄₆ | L_{b150} |
| 2533 | Lₐ₄₁₄ | L_{b151} | 2534 | Lₐ₇₄₆ | L_{b151} |
| 2535 | Lₐ₇₄₇ | L_{b2} | 2536 | Lₐ₈₂₄ | L_{b2} |
| 2537 | Lₐ₇₄₇ | L_{b4} | 2538 | Lₐ₈₂₄ | L_{b4} |
| 2539 | Lₐ₇₄₇ | L_{b5} | 2540 | Lₐ₈₂₄ | L_{b5} |
| 2541 | Lₐ₇₄₇ | L_{b10} | 2542 | Lₐ₈₂₄ | L_{b10} |
| 2543 | Lₐ₇₄₇ | _{Lb11} | 2544 | Lₐ₈₂₄ | L_{b11} |
| 2545 | Lₐ₇₄₇ | L_{b12} | 2546 | Lₐ₈₂₄ | L_{b12} |
| 2547 | Lₐ₇₄₇ | L_{b13} | 2548 | Lₐ₈₂₄ | L_{b13} |
| 2549 | Lₐ₇₄₇ | L_{b14} | 2550 | Lₐ₈₂₄ | L_{b14} |
| 2551 | Lₐ₇₄₇ | L_{b15} | 2552 | Lₐ₈₂₄ | L_{b15} |
| 2553 | Lₐ₇₄₇ | L_{b17} | 2554 | Lₐ₈₂₄ | L_{b17} |
| 2555 | Lₐ₇₄₇ | L_{b19} | 2556 | Lₐ₈₂₄ | L_{b19} |
| 2557 | Lₐ₇₄₇ | L_{b21} | 2558 | Lₐ₈₂₄ | L_{b21} |
| 2559 | Lₐ₇₄₇ | L_{b22} | 2560 | Lₐ₈₂₄ | L_{b22} |
| 2561 | Lₐ₇₄₇ | L_{b23} | 2562 | Lₐ₈₂₄ | L_{b23} |
| 2563 | Lₐ₇₄₇ | L_{b24} | 2564 | Lₐ₈₂₄ | L_{b24} |
| 2565 | Lₐ₇₄₇ | L_{b25} | 2566 | Lₐ₈₂₄ | L_{b25} |
| 2567 | Lₐ₇₄₇ | L_{b26} | 2568 | Lₐ₈₂₄ | L_{b26} |
| 2569 | Lₐ₇₄₇ | L_{b27} | 2570 | Lₐ₈₂₄ | L_{b27} |
| 2571 | Lₐ₇₄₇ | L_{b28} | 2572 | Lₐ₈₂₄ | L_{b28} |
| 2573 | Lₐ₇₄₇ | L_{b29} | 2574 | Lₐ₈₂₄ | L_{b29} |
| 2575 | Lₐ₇₄₇ | L_{b30} | 2576 | Lₐ₈₂₄ | L_{b30} |
| 2577 | Lₐ₇₄₇ | L_{b31} | 2578 | Lₐ₈₂₄ | L_{b31} |
| 2579 | Lₐ₇₄₇ | L_{b32} | 2580 | Lₐ₈₂₄ | L_{b32} |
| 2581 | Lₐ₇₄₇ | L_{b33} | 2582 | Lₐ₈₂₄ | L_{b33} |
| 2583 | Lₐ₇₄₇ | L_{b42} | 2584 | Lₐ₈₂₄ | L_{b42} |
| 2585 | Lₐ₇₄₇ | L_{b43} | 2586 | Lₐ₈₂₄ | L_{b43} |
| 2587 | Lₐ₇₄₇ | L_{b44} | 2588 | Lₐ₈₂₄ | L_{b44} |
| 2589 | Lₐ₇₄₇ | L_{b45} | 2590 | Lₐ₈₂₄ | L_{b45} |
| 2591 | Lₐ₇₄₇ | L_{b46} | 2592 | Lₐ₈₂₄ | L_{b46} |
| 2593 | Lₐ₇₄₇ | L_{b50} | 2594 | Lₐ₈₂₄ | L_{b50} |
| 2595 | Lₐ₇₄₇ | L_{b51} | 2596 | Lₐ₈₂₄ | L_{b51} |
| 2597 | Lₐ₇₄₇ | L_{b53} | 2598 | Lₐ₈₂₄ | L_{b53} |
| 2599 | Lₐ₇₄₇ | L_{b54} | 2600 | Lₐ₈₂₄ | L_{b54} |
| 2601 | Lₐ₇₄₇ | L_{b55} | 2602 | Lₐ₈₂₄ | L_{b55} |
| 2603 | Lₐ₇₄₇ | L_{b53} | 2604 | Lₐ₈₂₄ | L_{b56} |
| 2605 | Lₐ₇₄₇ | L_{b57} | 2606 | Lₐ₈₂₄ | L_{b57} |
| 2607 | Lₐ₇₄₇ | L_{b58} | 2608 | Lₐ₈₂₄ | L_{b58} |
| 2609 | Lₐ₇₄₇ | L_{b59} | 2610 | Lₐ₈₂₄ | L_{b59} |
| 2611 | Lₐ₇₄₇ | L_{b66} | 2612 | Lₐ₈₂₄ | L_{b66} |
| 2613 | Lₐ₇₄₇ | L_{b68} | 2614 | Lₐ₈₂₄ | L_{b68} |
| 2615 | Lₐ₇₄₇ | L_{b70} | 2616 | Lₐ₈₂₄ | L_{b70} |
| 2617 | Lₐ₇₄₇ | L_{b75} | 2618 | Lₐ₈₂₄ | L_{b75} |
| 2619 | Lₐ₇₄₇ | L_{b76} | 2620 | Lₐ₈₂₄ | L_{b76} |
| 2621 | Lₐ₇₄₇ | L_{b87} | 2622 | Lₐ₈₂₄ | L_{b87} |
| 2623 | Lₐ₇₄₇ | L_{b95} | 2624 | Lₐ₈₂₄ | L_{b95} |
| 2625 | Lₐ₇₄₇ | L_{b96} | 2626 | Lₐ₈₂₄ | L_{b96} |
| 2627 | Lₐ₇₄₇ | L_{b97} | 2628 | Lₐ₈₂₄ | L_{b97} |
| 2629 | Lₐ₇₄₇ | L_{b98} | 2630 | Lₐ₈₂₄ | L_{b98} |
| 2631 | Lₐ₇₄₇ | L_{b109} | 2632 | Lₐ₈₂₄ | L_{b109} |
| 2633 | Lₐ₇₄₇ | L_{b110} | 2634 | Lₐ₈₂₄ | L_{b110} |
| 2635 | Lₐ₇₄₇ | L_{b111} | 2636 | Lₐ₈₂₄ | L_{b111} |
| 2637 | Lₐ₇₄₇ | L_{b112} | 2638 | Lₐ₈₂₄ | L_{b112} |
| 2639 | Lₐ₇₄₇ | L_{b114} | 2640 | Lₐ₈₂₄ | L_{b114} |
| 2641 | Lₐ₇₄₇ | L_{b117} | 2642 | Lₐ₈₂₄ | L_{b117} |
| 2643 | Lₐ₇₄₇ | L_{b122} | 2644 | Lₐ₈₂₄ | L_{b122} |
| 2645 | Lₐ₇₄₇ | L_{b123} | 2646 | Lₐ₈₂₄ | L_{b123} |
| 2647 | Lₐ₇₄₇ | L_{b129} | 2648 | Lₐ₈₂₄ | L_{b129} |
| 2649 | Lₐ₇₄₇ | L_{b130} | 2650 | Lₐ₈₂₄ | L_{b130} |
| 2651 | Lₐ₇₄₇ | L_{b131} | 2652 | Lₐ₈₂₄ | L_{b131} |
| 2653 | Lₐ₇₄₇ | L_{b133} | 2654 | Lₐ₈₂₄ | L_{b133} |
| 2655 | Lₐ₇₄₇ | L_{b134} | 2656 | Lₐ₈₂₄ | L_{b134} |
| 2657 | Lₐ₇₄₇ | L_{b135} | 2658 | Lₐ₈₂₄ | L_{b135} |
| 2659 | Lₐ₇₄₇ | L_{b148} | 2660 | Lₐ₈₂₄ | L_{b148} |
| 2661 | Lₐ₇₄₇ | L_{b149} | 2662 | Lₐ₈₂₄ | L_{b149} |
| 2663 | Lₐ₇₄₇ | L_{b150} | 2664 | Lₐ₈₂₄ | L_{b150} |
| 2665 | Lₐ₇₄₇ | L_{b151} | 2666 | Lₐ₈₂₄ | L_{b151} |
| 2667 | Lₐ₉₅₃ | L_{b2} | 2668 | Lₐ₁₀₂₄ | L_{b2} |
| 2669 | Lₐ₉₅₃ | L_{b4} | 2670 | Lₐ₁₀₂₄ | L_{b4} |
| 2671 | Lₐ₉₅₃ | L_{b5} | 2672 | Lₐ₁₀₂₄ | L_{b5} |
| 2673 | Lₐ₉₅₃ | L_{b10} | 2674 | Lₐ₁₀₂₄ | L_{b10} |
| 2675 | Lₐ₉₅₃ | L_{b11} | 2676 | Lₐ₁₀₂₄ | L_{b11} |
| 2677 | Lₐ₉₅₃ | L_{b12} | 2678 | Lₐ₁₀₂₄ | L_{b12} |
| 2679 | Lₐ₉₅₃ | L_{b13} | 2680 | Lₐ₁₀₂₄ | L_{b13} |
| 2681 | Lₐ₉₅₃ | L_{b14} | 2682 | Lₐ₁₀₂₄ | L_{b14} |
| 2683 | Lₐ₉₅₃ | L_{b15} | 2684 | Lₐ₁₀₂₄ | L_{b15} |
| 2685 | Lₐ₉₅₃ | L_{b17} | 2686 | Lₐ₁₀₂₄ | L_{b17} |
| 2687 | Lₐ₉₅₃ | L_{b19} | 2688 | Lₐ₁₀₂₄ | L_{b19} |
| 2689 | Lₐ₉₅₃ | L_{b21} | 2690 | Lₐ₁₀₂₄ | L_{b21} |
| 2691 | Lₐ₉₅₃ | L_{b22} | 2692 | Lₐ₁₀₂₄ | L_{b22} |
| 2693 | Lₐ₉₅₃ | L_{b23} | 2694 | Lₐ₁₀₂₄ | L_{b23} |
| 2695 | Lₐ₉₅₃ | L_{b24} | 2696 | Lₐ₁₀₂₄ | L_{b24} |
| 2697 | Lₐ₉₅₃ | L_{b25} | 2698 | Lₐ₁₀₂₄ | L_{b25} |
| 2699 | Lₐ₉₅₃ | L_{b26} | 2700 | Lₐ₁₀₂₄ | L_{b26} |
| 2701 | Lₐ₉₅₃ | L_{b27} | 2702 | Lₐ₁₀₂₄ | L_{b27} |
| 2703 | Lₐ₉₅₃ | L_{b28} | 2704 | Lₐ₁₀₂₄ | L_{b28} |
| 2705 | Lₐ₉₅₃ | L_{b29} | 2706 | Lₐ₁₀₂₄ | L_{b29} |
| 2707 | Lₐ₉₅₃ | L_{b30} | 2708 | Lₐ₁₀₂₄ | L_{b30} |
| 2709 | Lₐ₉₅₃ | L_{b31} | 2710 | Lₐ₁₀₂₄ | L_{b31} |
| 2711 | Lₐ₉₅₃ | L_{b32} | 2712 | Lₐ₁₀₂₄ | L_{b32} |
| 2713 | Lₐ₉₅₃ | L_{b33} | 2714 | Lₐ₁₀₂₄ | L_{b33} |
| 2715 | Lₐ₉₅₃ | L_{b42} | 2716 | Lₐ₁₀₂₄ | L_{b42} |
| 2717 | Lₐ₉₅₃ | L_{b43} | 2718 | Lₐ₁₀₂₄ | L_{b43} |
| 2719 | Lₐ₉₅₃ | L_{b44} | 2720 | Lₐ₁₀₂₄ | L_{b44} |
| 2721 | Lₐ₉₅₃ | L_{b45} | 2722 | Lₐ₁₀₂₄ | L_{b45} |
| 2723 | Lₐ₉₅₃ | L_{b46} | 2724 | Lₐ₁₀₂₄ | L_{b46} |
| 2725 | Lₐ₉₅₃ | L_{b50} | 2726 | Lₐ₁₀₂₄ | L_{b50} |
| 2727 | Lₐ₉₅₃ | L_{b51} | 2728 | Lₐ₁₀₂₄ | L_{b51} |
| 2729 | Lₐ₉₅₃ | L_{b53} | 2730 | Lₐ₁₀₂₄ | L_{b53} |
| 2731 | Lₐ₉₅₃ | L_{b54} | 2732 | Lₐ₁₀₂₄ | L_{b54} |
| 2733 | Lₐ₉₅₃ | L_{b55} | 2734 | Lₐ₁₀₂₄ | L_{b55} |
| 2735 | Lₐ₉₅₃ | L_{b56} | 2736 | Lₐ₁₀₂₄ | L_{b56} |
| 2737 | Lₐ₉₅₃ | L_{b57} | 2738 | Lₐ₁₀₂₄ | L_{b57} |
| 2739 | Lₐ₉₅₃ | L_{b58} | 2740 | Lₐ₁₀₂₄ | L_{b58} |
| 2741 | Lₐ₉₅₃ | L_{b59} | 2742 | Lₐ₁₀₂₄ | L_{b59} |
| 2743 | Lₐ₉₅₃ | L_{b66} | 2744 | Lₐ₁₀₂₄ | L_{b66} |
| 2745 | Lₐ₉₅₃ | L_{b68} | 2746 | Lₐ₁₀₂₄ | L_{b68} |
| 2747 | Lₐ₉₅₃ | L_{b70} | 2748 | Lₐ₁₀₂₄ | L_{b70} |
| 2749 | Lₐ₉₅₃ | L_{b75} | 2750 | Lₐ₁₀₂₄ | L_{b75} |
| 2751 | Lₐ₉₅₃ | L_{b76} | 2752 | Lₐ₁₀₂₄ | L_{b76} |
| 2753 | Lₐ₉₅₃ | L_{b87} | 2754 | Lₐ₁₀₂₄ | L_{b87} |
| 2755 | Lₐ₉₅₃ | L_{b95} | 2756 | Lₐ₁₀₂₄ | L_{b95} |
| 2757 | Lₐ₉₅₃ | L_{b96} | 2758 | Lₐ₁₀₂₄ | L_{b96} |
| 2759 | Lₐ₉₅₃ | L_{b97} | 2760 | Lₐ₁₀₂₄ | L_{b97} |
| 2761 | Lₐ₉₅₃ | L_{b98} | 2762 | Lₐ₁₀₂₄ | L_{b98} |
| 2763 | Lₐ₉₅₃ | L_{b109} | 2764 | Lₐ₁₀₂₄ | L_{b109} |
| 2765 | Lₐ₉₅₃ | L_{b110} | 2766 | Lₐ₁₀₂₄ | L_{b110} |
| 2767 | Lₐ₉₅₃ | L_{b111} | 2768 | Lₐ₁₀₂₄ | L_{b111} |
| 2769 | Lₐ₉₅₃ | L_{b112} | 2770 | Lₐ₁₀₂₄ | L_{b112} |
| 2771 | Lₐ₉₅₃ | Lb₁₁₄ | 2772 | Lₐ₁₀₂₄ | L_{b114} |
| 2773 | Lₐ₉₅₃ | L_{b117} | 2774 | Lₐ₁₀₂₄ | L_{b117} |
| 2775 | Lₐ₉₅₃ | L_{b122} | 2776 | Lₐ₁₀₂₄ | L_{b122} |
| 2777 | Lₐ₉₅₃ | L_{b123} | 2778 | Lₐ₁₀₂₄ | L_{b123} |
| 2779 | Lₐ₉₅₃ | L_{b129} | 2780 | Lₐ₁₀₂₄ | L_{b129} |
| 2781 | Lₐ₉₅₃ | L_{b130} | 2782 | Lₐ₁₀₂₄ | L_{b130} |
| 2783 | Lₐ₉₅₃ | L_{b131} | 2784 | Lₐ₁₀₂₄ | L_{b131} |
| 2785 | Lₐ₉₅₃ | L_{b133} | 2786 | Lₐ₁₀₂₄ | L_{b133} |
| 2787 | Lₐ₉₅₃ | L_{b134} | 2788 | Lₐ₁₀₂₄ | L_{b134} |
| 2789 | Lₐ₉₅₃ | L_{b135} | 2790 | Lₐ₁₀₂₄ | L_{b135} |
| 2791 | Lₐ₉₅₃ | L_{b148} | 2792 | Lₐ₁₀₂₄ | L_{b148} |
| 2793 | Lₐ₉₅₃ | L_{b149} | 2794 | Lₐ₁₀₂₄ | L_{b149} |
| 2795 | Lₐ₉₅₃ | L_{b150} | 2796 | Lₐ₁₀₂₄ | L_{b150} |
| 2797 | Lₐ₉₅₃ | L_{b151} | 2798 | Lₐ₁₀₂₄ | L_{b151} |
| 2799 | Lₐ₁₀₉₅ | L_{b2} | 2800 | Lₐ₁₁₆₆ | L_{b2} |
| 2801 | Lₐ₁₀₉₅ | L_{b4} | 2802 | Lₐ₁₁₆₆ | L_{b4} |
| 2803 | Lₐ₁₀₉₅ | L_{b5} | 2804 | Lₐ₁₁₆₆ | L_{b5} |
| 2805 | Lₐ₁₀₉₅ | L_{b10} | 2806 | Lₐ₁₁₆₆ | L_{b10} |
| 2807 | Lₐ₁₀₉₅ | L_{b11} | 2808 | Lₐ₁₁₆₆ | L_{b11} |
| 2809 | Lₐ₁₀₉₅ | L_{b12} | 2810 | Lₐ₁₁₆₆ | L_{b12} |
| 2811 | Lₐ₁₀₉₅ | L_{b13} | 2812 | Lₐ₁₁₆₆ | L_{b13} |
| 2813 | Lₐ₁₀₉₅ | L_{b14} | 2814 | Lₐ₁₁₆₆ | L_{b14} |
| 2815 | Lₐ₁₀₉₅ | L_{b15} | 2816 | Lₐ₁₁₆₆ | L_{b15} |
| 2817 | Lₐ₁₀₉₅ | L_{b17} | 2818 | Lₐ₁₁₆₆ | L_{b17} |
| 2819 | Lₐ₁₀₉₅ | L_{b19} | 2820 | Lₐ₁₁₆₆ | L_{b19} |
| 2821 | Lₐ₁₀₉₅ | L_{b21} | 2822 | Lₐ₁₁₆₆ | L_{b21} |
| 2823 | Lₐ₁₀₉₅ | L_{b22} | 2824 | Lₐ₁₁₆₆ | L_{b22} |
| 2825 | Lₐ₁₀₉₅ | L_{b23} | 2826 | Lₐ₁₁₆₆ | L_{b23} |
| 2827 | Lₐ₁₀₉₅ | L_{b24} | 2828 | Lₐ₁₁₆₆ | L_{b24} |
| 2829 | Lₐ₁₀₉₅ | L_{b25} | 2830 | Lₐ₁₁₆₆ | L_{b25} |
| 2831 | Lₐ₁₀₉₅ | L_{b26} | 2832 | Lₐ₁₁₆₆ | L_{b26} |
| 2833 | Lₐ₁₀₉₅ | L_{b27} | 2834 | Lₐ₁₁₆₆ | L_{b27} |
| 2835 | Lₐ₁₀₉₅ | L_{b28} | 2836 | Lₐ₁₁₆₆ | L_{b28} |
| 2837 | Lₐ₁₀₉₅ | L_{b29} | 2838 | Lₐ₁₁₆₆ | L_{b29} |
| 2839 | Lₐ₁₀₉₅ | L_{b30} | 2840 | Lₐ₁₁₆₆ | L_{b30} |
| 2841 | Lₐ₁₀₉₅ | L_{b31} | 2842 | Lₐ₁₁₆₆ | L_{b31} |
| 2843 | Lₐ₁₀₉₅ | L_{b32} | 2844 | Lₐ₁₁₆₆ | L_{b32} |
| 2845 | Lₐ₁₀₉₅ | L_{b33} | 2846 | Lₐ₁₁₆₆ | L_{b33} |
| 2847 | Lₐ₁₀₉₅ | L_{b42} | 2848 | Lₐ₁₁₆₆ | L_{b42} |
| 2849 | Lₐ₁₀₉₅ | L_{b43} | 2850 | Lₐ₁₁₆₆ | L_{b43} |
| 2851 | Lₐ₁₀₉₅ | L_{b44} | 2852 | Lₐ₁₁₆₆ | L_{b44} |
| 2853 | Lₐ₁₀₉₅ | L_{b45} | 2854 | Lₐ₁₁₆₆ | L_{b45} |
| 2855 | Lₐ₁₀₉₅ | L_{b46} | 2856 | Lₐ₁₁₆₆ | L_{b46} |
| 2857 | Lₐ₁₀₉₅ | L_{b50} | 2858 | Lₐ₁₁₆₆ | L_{b50} |
| 2859 | Lₐ₁₀₉₅ | L_{b51} | 2860 | Lₐ₁₁₆₆ | L_{b51} |
| 2861 | Lₐ₁₀₉₅ | L_{b53} | 2862 | Lₐ₁₁₆₆ | L_{b53} |
| 2863 | Lₐ₁₀₉₅ | L_{b54} | 2864 | Lₐ₁₁₆₆ | L_{b54} |
| 2865 | Lₐ₁₀₉₅ | L_{b55} | 2866 | Lₐ₁₁₆₆ | L_{b55} |
| 2867 | Lₐ₁₀₉₅ | L_{b56} | 2868 | Lₐ₁₁₆₆ | L_{b56} |
| 2869 | Lₐ₁₀₉₅ | L_{b57} | 2870 | Lₐ₁₁₆₆ | L_{b57} |
| 2871 | Lₐ₁₀₉₅ | L_{b58} | 2872 | Lₐ₁₁₆₆ | L_{b58} |
| 2873 | Lₐ₁₀₉₅ | L_{b59} | 2874 | Lₐ₁₁₆₆ | L_{b59} |
| 2875 | Lₐ₁₀₉₅ | L_{b66} | 2876 | Lₐ₁₁₆₆ | L_{b66} |
| 2877 | Lₐ₁₀₉₅ | L_{b68} | 2878 | Lₐ₁₁₆₆ | L_{b68} |
| 2879 | Lₐ₁₀₉₅ | L_{b70} | 2880 | Lₐ₁₁₆₆ | L_{b70} |
| 2881 | Lₐ₁₀₉₅ | L_{b75} | 2882 | Lₐ₁₁₆₆ | L_{b75} |
| 2883 | Lₐ₁₀₉₅ | L_{b76} | 2884 | Lₐ₁₁₆₆ | L_{b76} |
| 2885 | Lₐ₁₀₉₅ | L_{b87} | 2886 | Lₐ₁₁₆₆ | L_{b87} |
| 2887 | Lₐ₁₀₉₅ | L_{b95} | 2888 | Lₐ₁₁₆₆ | L_{b95} |
| 2889 | Lₐ₁₀₉₅ | L_{b96} | 2890 | Lₐ₁₁₆₆ | L_{b96} |
| 2891 | Lₐ₁₀₉₅ | L_{b97} | 2892 | Lₐ₁₁₆₆ | L_{b97} |
| 2893 | Lₐ₁₀₉₅ | L_{b98} | 2894 | Lₐ₁₁₆₆ | L_{b98} |
| 2895 | Lₐ₁₀₉₅ | L_{b109} | 2896 | Lₐ₁₁₆₆ | L_{b109} |
| 2897 | Lₐ₁₀₉₅ | L_{b110} | 2898 | Lₐ₁₁₆₆ | L_{b110} |
| 2899 | Lₐ₁₀₉₅ | L_{b111} | 2900 | Lₐ₁₁₆₆ | L_{b111} |
| 2901 | Lₐ₁₀₉₅ | L_{b112} | 2902 | Lₐ₁₁₆₆ | L_{b112} |
| 2903 | Lₐ₁₀₉₅ | L_{b114} | 2904 | Lₐ₁₁₆₆ | L_{b114} |
| 2905 | Lₐ₁₀₉₅ | L_{b117} | 2906 | Lₐ₁₁₆₆ | L_{b117} |
| 2907 | Lₐ₁₀₉₅ | L_{b122} | 2908 | Lₐ₁₁₆₆ | L_{b122} |
| 2909 | Lₐ₁₀₉₅ | L_{b123} | 2910 | Lₐ₁₁₆₆ | L_{b123} |
| 2911 | Lₐ₁₀₉₅ | L_{b129} | 2912 | Lₐ₁₁₆₆ | L_{b129} |
| 2913 | Lₐ₁₀₉₅ | L_{b130} | 2914 | Lₐ₁₁₆₆ | L_{b130} |
| 2915 | Lₐ₁₀₉₅ | L_{b131} | 2916 | Lₐ₁₁₆₆ | L_{b131} |
| 2917 | Lₐ₁₀₉₅ | L_{b133} | 2918 | Lₐ₁₁₆₆ | L_{b133} |
| 2919 | Lₐ₁₀₉₅ | L_{b134} | 2920 | Lₐ₁₁₆₆ | L_{b134} |
| 2921 | Lₐ₁₀₉₅ | L_{b135} | 2922 | Lₐ₁₁₆₆ | L_{b135} |
| 2923 | Lₐ₁₀₉₅ | L_{b148} | 2924 | Lₐ₁₁₆₆ | L_{b148} |
| 2925 | Lₐ₁₀₉₅ | L_{b149} | 2926 | Lₐ₁₁₆₆ | L_{b149} |
| 2927 | Lₐ₁₀₉₅ | L_{b150} | 2928 | Lₐ₁₁₆₆ | L_{b150} |
| 2929 | Lₐ₁₀₉₅ | L_{b151} | 2930 | Lₐ₁₁₆₆ | L_{b151} |
| 2931 | Lₐ₁₂₃₇ | L_{b2} | 2932 | Lₐ₁₅₆₉ | L_{b2} |
| 2933 | Lₐ₁₂₃₇ | L_{b4} | 2934 | Lₐ₁₅₆₉ | L_{b4} |
| 2935 | Lₐ₁₂₃₇ | L_{b5} | 2936 | Lₐ₁₅₆₉ | L_{b5} |
| 2937 | Lₐ₁₂₃₇ | L_{b10} | 2938 | Lₐ₁₅₆₉ | L_{b10} |
| 2939 | Lₐ₁₂₃₇ | L_{b11} | 2940 | Lₐ₁₅₆₉ | L_{b11} |
| 2941 | Lₐ₁₂₃₇ | L_{b12} | 2942 | Lₐ₁₅₆₉ | L_{b12} |
| 2943 | Lₐ₁₂₃₇ | L_{b13} | 2944 | Lₐ₁₅₆₉ | L_{b13} |
| 2945 | Lₐ₁₂₃₇ | L_{b14} | 2946 | Lₐ₁₅₆₉ | L_{b14} |
| 2947 | Lₐ₁₂₃₇ | L_{b15} | 2948 | Lₐ₁₅₆₉ | L_{b15} |
| 2949 | Lₐ₁₂₃₇ | L_{b17} | 2950 | Lₐ₁₅₆₉ | L_{b17} |
| 2951 | Lₐ₁₂₃₇ | L_{b19} | 2952 | Lₐ₁₅₆₉ | L_{b19} |
| 2953 | Lₐ₁₂₃₇ | L_{b21} | 2954 | Lₐ₁₅₆₉ | L_{b21} |
| 2955 | Lₐ₁₂₃₇ | L_{b22} | 2956 | Lₐ₁₅₆₉ | L_{b22} |
| 2957 | Lₐ₁₂₃₇ | L_{b23} | 2958 | Lₐ₁₅₆₉ | L_{b23} |
| 2959 | Lₐ₁₂₃₇ | L_{b24} | 2960 | Lₐ₁₅₆₉ | L_{b24} |
| 2961 | Lₐ₁₂₃₇ | L_{b25} | 2962 | Lₐ₁₅₆₉ | L_{b25} |
| 2963 | Lₐ₁₂₃₇ | L_{b26} | 2964 | Lₐ₁₅₆₉ | L_{b26} |
| 2965 | Lₐ₁₂₃₇ | L_{b27} | 2966 | Lₐ₁₅₆₉ | L_{b27} |
| 2967 | Lₐ₁₂₃₇ | L_{b28} | 2968 | Lₐ₁₅₆₉ | L_{b28} |
| 2969 | Lₐ₁₂₃₇ | L_{b29} | 2970 | Lₐ₁₅₆₉ | L_{b29} |
| 2971 | Lₐ₁₂₃₇ | L_{b30} | 2972 | Lₐ₁₅₆₉ | L_{b30} |
| 2973 | Lₐ₁₂₃₇ | L_{b31} | 2974 | Lₐ₁₅₆₉ | L_{b31} |
| 2975 | Lₐ₁₂₃₇ | L_{b32} | 2976 | Lₐ₁₅₆₉ | L_{b32} |
| 2977 | Lₐ₁₂₃₇ | L_{b33} | 2978 | Lₐ₁₅₆₉ | L_{b33} |
| 2979 | Lₐ₁₂₃₇ | L_{b42} | 2980 | Lₐ₁₅₆₉ | L_{b42} |
| 2981 | Lₐ₁₂₃₇ | L_{b43} | 2982 | Lₐ₁₅₆₉ | L_{b43} |
| 2983 | Lₐ₁₂₃₇ | L_{b44} | 2984 | Lₐ₁₅₆₉ | L_{b44} |
| 2985 | Lₐ₁₂₃₇ | L_{b45} | 2986 | Lₐ₁₅₆₉ | L_{b45} |
| 2987 | Lₐ₁₂₃₇ | L_{b46} | 2988 | Lₐ₁₅₆₉ | L_{b46} |
| 2989 | Lₐ₁₂₃₇ | L_{b50} | 2990 | Lₐ₁₅₆₉ | L_{b50} |
| 2991 | Lₐ₁₂₃₇ | L_{b51} | 2992 | Lₐ₁₅₆₉ | L_{b51} |
| 2993 | Lₐ₁₂₃₇ | L_{b53} | 2994 | Lₐ₁₅₆₉ | L_{b53} |
| 2995 | Lₐ₁₂₃₇ | L_{b54} | 2996 | Lₐ₁₅₆₉ | L_{b54} |
| 2997 | Lₐ₁₂₃₇ | L_{b55} | 2998 | Lₐ₁₅₆₉ | L_{b55} |
| 2999 | Lₐ₁₂₃₇ | L_{b56} | 3000 | Lₐ₁₅₆₉ | L_{b56} |
| 3001 | Lₐ₁₂₃₇ | L_{b57} | 3002 | Lₐ₁₅₆₉ | L_{b57} |
| 3003 | Lₐ₁₂₃₇ | L_{b58} | 3004 | Lₐ₁₅₆₉ | L_{b58} |
| 3005 | Lₐ₁₂₃₇ | L_{b59} | 3006 | Lₐ₁₅₆₉ | L_{b59} |
| 3007 | Lₐ₁₂₃₇ | L_{b66} | 3008 | Lₐ₁₅₆₉ | L_{b66} |
| 3009 | Lₐ₁₂₃₇ | L_{b68} | 3010 | Lₐ₁₅₆₉ | L_{b68} |
| 3011 | Lₐ₁₂₃₇ | L_{b70} | 3012 | Lₐ₁₅₆₉ | L_{b70} |
| 3013 | Lₐ₁₂₃₇ | L_{b75} | 3014 | Lₐ₁₅₆₉ | L_{b75} |
| 3015 | Lₐ₁₂₃₇ | L_{b76} | 3016 | Lₐ₁₅₆₉ | L_{b76} |
| 3017 | Lₐ₁₂₃₇ | L_{b87} | 3018 | Lₐ₁₅₆₉ | L_{b87} |
| 3019 | Lₐ₁₂₃₇ | L_{b95} | 3020 | Lₐ₁₅₆₉ | L_{b95} |
| 3021 | Lₐ₁₂₃₇ | L_{b96} | 3022 | Lₐ₁₅₆₉ | L_{b96} |
| 3023 | Lₐ₁₂₃₇ | L_{b97} | 3024 | Lₐ₁₅₆₉ | L_{b97} |
| 3025 | Lₐ₁₂₃₇ | L_{b98} | 3026 | Lₐ₁₅₆₉ | L_{b98} |
| 3027 | Lₐ₁₂₃₇ | L_{b109} | 3028 | Lₐ₁₅₆₉ | L_{b109} |
| 3029 | Lₐ₁₂₃₇ | L_{b110} | 3030 | Lₐ₁₅₆₉ | L_{b110} |
| 3031 | Lₐ₁₂₃₇ | L_{b111} | 3032 | Lₐ₁₅₆₉ | L_{b111} |
| 3033 | Lₐ₁₂₃₇ | L_{b112} | 3034 | Lₐ₁₅₆₉ | L_{b112} |
| 3035 | Lₐ₁₂₃₇ | L_{b114} | 3036 | Lₐ₁₅₆₉ | L_{b114} |
| 3037 | Lₐ₁₂₃₇ | L_{b117} | 3038 | Lₐ₁₅₆₉ | L_{b117} |
| 3039 | Lₐ₁₂₃₇ | L_{b122} | 3040 | Lₐ₁₅₆₉ | L_{b122} |
| 3041 | Lₐ₁₂₃₇ | L_{b123} | 3042 | Lₐ₁₅₆₉ | L_{b123} |
| 3043 | Lₐ₁₂₃₇ | L_{b129} | 3044 | Lₐ₁₅₆₉ | L_{b129} |
| 3045 | Lₐ₁₂₃₇ | L_{b130} | 3046 | Lₐ₁₅₆₉ | L_{b130} |
| 3047 | Lₐ₁₂₃₇ | L_{b131} | 3048 | Lₐ₁₅₆₉ | L_{b131} |
| 3049 | Lₐ₁₂₃₇ | L_{b133} | 3050 | Lₐ₁₅₆₉ | L_{b133} |
| 3051 | Lₐ₁₂₃₇ | L_{b134} | 3052 | Lₐ₁₅₆₉ | L_{b134} |
| 3053 | Lₐ₁₂₃₇ | L_{b135} | 3054 | Lₐ₁₅₆₉ | L_{b135} |
| 3055 | Lₐ₁₂₃₇ | L_{b148} | 3056 | Lₐ₁₅₆₉ | L_{b148} |
| 3057 | Lₐ₁₂₃₇ | L_{b149} | 3058 | Lₐ₁₅₆₉ | L_{b149} |
| 3059 | Lₐ₁₂₃₇ | L_{b150} | 3060 | Lₐ₁₅₆₉ | L_{b150} |
| 3061 | Lₐ₁₂₃₇ | L_{b151} | 3062 | Lₐ₁₅₆₉ | L_{b151} |
| 3063 | Lₐ₁₅₇₀ | L_{b2} | 3064 | Lₐ₁₈₉₁ | L_{b2} |
| 3065 | Lₐ₁₅₇₀ | L_{b4} | 3066 | Lₐ₁₈₉₁ | L_{b4} |
| 3067 | Lₐ₁₅₇₀ | L_{b5} | 3068 | Lₐ₁₈₉₁ | L_{b5} |
| 3069 | Lₐ₁₅₇₀ | L_{b10} | 3070 | Lₐ₁₈₉₁ | L_{b10} |
| 3071 | Lₐ₁₅₇₀ | L_{b11} | 3072 | Lₐ₁₈₉₁ | L_{b11} |
| 3073 | Lₐ₁₅₇₀ | L_{b12} | 3074 | Lₐ₁₈₉₁ | L_{b12} |
| 3075 | Lₐ₁₅₇₀ | L_{b13} | 3076 | Lₐ₁₈₉₁ | L_{b13} |
| 3077 | Lₐ₁₅₇₀ | L_{b14} | 3078 | Lₐ₁₈₉₁ | L_{b14} |
| 3079 | Lₐ₁₅₇₀ | L_{b15} | 3080 | Lₐ₁₈₉₁ | L_{b15} |
| 3081 | Lₐ₁₅₇₀ | L_{b17} | 3082 | Lₐ₁₈₉₁ | L_{b17} |
| 3083 | Lₐ₁₅₇₀ | L_{b19} | 3084 | Lₐ₁₈₉₁ | L_{b19} |
| 3085 | Lₐ₁₅₇₀ | L_{b21} | 3086 | Lₐ₁₈₉₁ | L_{b21} |
| 3087 | Lₐ₁₅₇₀ | L_{b22} | 3088 | Lₐ₁₈₉₁ | L_{b22} |
| 3089 | Lₐ₁₅₇₀ | L_{b23} | 3090 | Lₐ₁₈₉₁ | L_{b23} |
| 3091 | Lₐ₁₅₇₀ | L_{b24} | 3092 | Lₐ₁₈₉₁ | L_{b24} |
| 3093 | Lₐ₁₅₇₀ | L_{b25} | 3094 | Lₐ₁₈₉₁ | L_{b25} |
| 3095 | Lₐ₁₅₇₀ | L_{b26} | 3096 | Lₐ₁₈₉₁ | L_{b26} |
| 3097 | Lₐ₁₅₇₀ | L_{b27} | 3098 | Lₐ₁₈₉₁ | L_{b27} |
| 3099 | Lₐ₁₅₇₀ | L_{b28} | 3100 | Lₐ₁₈₉₁ | L_{b28} |
| 3101 | Lₐ₁₅₇₀ | L_{b29} | 3102 | Lₐ₁₈₉₁ | L_{b29} |
| 3103 | Lₐ₁₅₇₀ | L_{b30} | 3104 | Lₐ₁₈₉₁ | L_{b30} |
| 3105 | Lₐ₁₅₇₀ | L_{b31} | 3106 | Lₐ₁₈₉₁ | L_{b31} |
| 3107 | Lₐ₁₅₇₀ | L_{b32} | 3108 | Lₐ₁₈₉₁ | L_{b32} |
| 3109 | Lₐ₁₅₇₀ | L_{b33} | 3110 | Lₐ₁₈₉₁ | L_{b33} |
| 3111 | Lₐ₁₅₇₀ | L_{b42} | 3112 | Lₐ₁₈₉₁ | L_{b42} |
| 3113 | Lₐ₁₅₇₀ | L_{b43} | 3114 | Lₐ₁₈₉₁ | L_{b43} |
| 3115 | Lₐ₁₅₇₀ | L_{b44} | 3116 | Lₐ₁₈₉₁ | L_{b44} |
| 3117 | Lₐ₁₅₇₀ | L_{b45} | 3118 | Lₐ₁₈₉₁ | L_{b45} |
| 3119 | Lₐ₁₅₇₀ | L_{b46} | 3120 | Lₐ₁₈₉₁ | L_{b46} |
| 3121 | Lₐ₁₅₇₀ | L_{b50} | 3122 | Lₐ₁₈₉₁ | L_{b50} |
| 3123 | Lₐ₁₅₇₀ | L_{b51} | 3124 | Lₐ₁₈₉₁ | L_{b51} |
| 3125 | Lₐ₁₅₇₀ | L_{b53} | 3126 | Lₐ₁₈₉₁ | L_{b53} |
| 3127 | Lₐ₁₅₇₀ | L_{b54} | 3128 | Lₐ₁₈₉₁ | L_{b54} |
| 3129 | Lₐ₁₅₇₀ | L_{b55} | 3130 | Lₐ₁₈₉₁ | L_{b55} |
| 3131 | Lₐ₁₅₇₀ | L_{b56} | 3132 | Lₐ₁₈₉₁ | L_{b56} |
| 3133 | Lₐ₁₅₇₀ | L_{b57} | 3134 | Lₐ₁₈₉₁ | L_{b57} |
| 3135 | Lₐ₁₅₇₀ | L_{b58} | 3136 | Lₐ₁₈₉₁ | L_{b58} |
| 3137 | Lₐ₁₅₇₀ | L_{b59} | 3138 | Lₐ₁₈₉₁ | L_{b59} |
| 3139 | Lₐ₁₅₇₀ | L_{b66} | 3140 | Lₐ₁₈₉₁ | L_{b66} |
| 3141 | Lₐ₁₅₇₀ | L_{b68} | 3142 | Lₐ₁₈₉₁ | L_{b68} |
| 3143 | Lₐ₁₅₇₀ | L_{b70} | 3144 | Lₐ₁₈₉₁ | L_{b70} |
| 3145 | Lₐ₁₅₇₀ | L_{b75} | 3146 | Lₐ₁₈₉₁ | L_{b75} |
| 3147 | Lₐ₁₅₇₀ | L_{b76} | 3148 | Lₐ₁₈₉₁ | L_{b76} |
| 3149 | Lₐ₁₅₇₀ | L_{b87} | 3150 | Lₐ₁₈₉₁ | L_{b87} |
| 3151 | Lₐ₁₅₇₀ | L_{b95} | 3152 | Lₐ₁₈₉₁ | L_{b95} |
| 3153 | Lₐ₁₅₇₀ | L_{b96} | 3154 | Lₐ₁₈₉₁ | L_{b96} |
| 3155 | Lₐ₁₅₇₀ | L_{b97} | 3156 | Lₐ₁₈₉₁ | L_{b97} |
| 3157 | Lₐ₁₅₇₀ | L_{b98} | 3158 | Lₐ₁₈₉₁ | L_{b98} |
| 3159 | Lₐ₁₅₇₀ | L_{b109} | 3160 | Lₐ₁₈₉₁ | L_{b109} |
| 3161 | Lₐ₁₅₇₀ | L_{b110} | 3162 | Lₐ₁₈₉₁ | L_{b110} |
| 3163 | Lₐ₁₅₇₀ | L_{b111} | 3164 | Lₐ₁₈₉₁ | L_{b111} |
| 3165 | Lₐ₁₅₇₀ | L_{b112} | 3166 | Lₐ₁₈₉₁ | L_{b112} |
| 3167 | Lₐ₁₅₇₀ | L_{b114} | 3168 | Lₐ₁₈₉₁ | L_{b114} |
| 3169 | Lₐ₁₅₇₀ | L_{b117} | 3170 | Lₐ₁₈₉₁ | L_{b117} |
| 3171 | Lₐ₁₅₇₀ | L_{b122} | 3172 | Lₐ₁₈₉₁ | L_{b122} |
| 3173 | Lₐ₁₅₇₀ | L_{b123} | 3174 | Lₐ₁₈₉₁ | L_{b123} |
| 3175 | Lₐ₁₅₇₀ | L_{b129} | 3176 | Lₐ₁₈₉₁ | L_{b129} |
| 3177 | Lₐ₁₅₇₀ | L_{b130} | 3178 | Lₐ₁₈₉₁ | L_{b130} |
| 3179 | Lₐ₁₅₇₀ | L_{b131} | 3180 | Lₐ₁₈₉₁ | L_{b131} |
| 3181 | Lₐ₁₅₇₀ | L_{b133} | 3182 | Lₐ₁₈₉₁ | L_{b133} |
| 3183 | Lₐ₁₅₇₀ | L_{b134} | 3184 | Lₐ₁₈₉₁ | L_{b134} |
| 3185 | Lₐ₁₅₇₀ | L_{b135} | 3186 | Lₐ₁₈₉₁ | L_{b135} |
| 3187 | Lₐ₁₅₇₀ | L_{b148} | 3188 | Lₐ₁₈₉₁ | L_{b148} |
| 3189 | Lₐ₁₅₇₀ | L_{b149} | 3190 | Lₐ₁₈₉₁ | L_{b149} |
| 3191 | Lₐ₁₅₇₀ | L_{b150} | 3192 | Lₐ₁₈₉₁ | L_{b150} |
| 3193 | Lₐ₁₅₇₀ | L_{b151} | 3194 | Lₐ₁₈₉₁ | L_{b151} |
| 3195 | Lₐ₁₉₆₂ | L_{b2} | 3196 | Lₐ₂₇₈₅ | L_{b2} |
| 3197 | Lₐ₁₉₆₂ | L_{b4} | 3198 | Lₐ₂₇₈₅ | L_{b4} |
| 3199 | Lₐ₁₉₆₂ | L_{b5} | 3200 | Lₐ₂₇₈₅ | L_{b5} |
| 3201 | Lₐ₁₉₆₂ | L_{b10} | 3202 | Lₐ₂₇₈₅ | L_{b10} |
| 3203 | Lₐ₁₉₆₂ | L_{b11} | 3204 | Lₐ₂₇₈₅ | L_{b11} |
| 3205 | Lₐ₁₉₆₂ | L_{b12} | 3206 | Lₐ₂₇₈₅ | L_{b12} |
| 3207 | Lₐ₁₉₆₂ | L_{b13} | 3208 | Lₐ₂₇₈₅ | L_{b13} |
| 3209 | Lₐ₁₉₆₂ | L_{b14} | 3210 | Lₐ₂₇₈₅ | L_{b14} |
| 3211 | Lₐ₁₉₆₂ | L_{b15} | 3212 | Lₐ₂₇₈₅ | L_{b15} |
| 3213 | Lₐ₁₉₆₂ | L_{b17} | 3214 | Lₐ₂₇₈₅ | L_{b17} |
| 3215 | Lₐ₁₉₆₂ | L_{b19} | 3216 | Lₐ₂₇₈₅ | L_{b19} |
| 3217 | Lₐ₁₉₆₂ | L_{b21} | 3218 | Lₐ₂₇₈₅ | L_{b21} |
| 3219 | Lₐ₁₉₆₂ | L_{b22} | 3220 | Lₐ₂₇₈₅ | L_{b22} |
| 3221 | Lₐ₁₉₆₂ | L_{b23} | 3222 | Lₐ₂₇₈₅ | L_{b23} |
| 3223 | Lₐ₁₉₆₂ | L_{b24} | 3224 | Lₐ₂₇₈₅ | L_{b24} |
| 3225 | Lₐ₁₉₆₂ | L_{b25} | 3226 | Lₐ₂₇₈₅ | L_{b25} |
| 3227 | Lₐ₁₉₆₂ | L_{b26} | 3228 | Lₐ₂₇₈₅ | L_{b26} |
| 3229 | Lₐ₁₉₆₂ | L_{b27} | 3230 | Lₐ₂₇₈₅ | L_{b27} |
| 3231 | Lₐ₁₉₆₂ | L_{b28} | 3232 | Lₐ₂₇₈₅ | L_{b28} |
| 3233 | Lₐ₁₉₆₂ | L_{b29} | 3234 | Lₐ₂₇₈₅ | L_{b29} |
| 3235 | Lₐ₁₉₆₂ | L_{b30} | 3236 | Lₐ₂₇₈₅ | L_{b30} |
| 3237 | Lₐ₁₉₆₂ | L_{b31} | 3238 | Lₐ₂₇₈₅ | L_{b31} |
| 3239 | Lₐ₁₉₆₂ | L_{b32} | 3240 | Lₐ₂₇₈₅ | L_{b32} |
| 3241 | Lₐ₁₉₆₂ | L_{b33} | 3242 | Lₐ₂₇₈₅ | L_{b33} |
| 3243 | Lₐ₁₉₆₂ | L_{b42} | 3244 | Lₐ₂₇₈₅ | L_{b42} |
| 3245 | Lₐ₁₉₆₂ | L_{b43} | 3246 | Lₐ₂₇₈₅ | L_{b43} |
| 3247 | Lₐ₁₉₆₂ | L_{b44} | 3248 | Lₐ₂₇₈₅ | L_{b44} |
| 3249 | Lₐ₁₉₆₂ | L_{b45} | 3250 | Lₐ₂₇₈₅ | L_{b45} |
| 3251 | Lₐ₁₉₆₂ | L_{b46} | 3252 | Lₐ₂₇₈₅ | L_{b46} |
| 3253 | Lₐ₁₉₆₂ | L_{b50} | 3254 | Lₐ₂₇₈₅ | L_{b50} |
| 3255 | Lₐ₁₉₆₂ | L_{b51} | 3256 | Lₐ₂₇₈₅ | L_{b51} |
| 3257 | Lₐ₁₉₆₂ | L_{b53} | 3258 | Lₐ₂₇₈₅ | L_{b53} |
| 3259 | Lₐ₁₉₆₂ | L_{b54} | 3260 | Lₐ₂₇₈₅ | L_{b54} |
| 3261 | Lₐ₁₉₆₂ | L_{b55} | 3262 | Lₐ₂₇₈₅ | L_{b55} |
| 3263 | Lₐ₁₉₆₂ | L_{b56} | 3264 | Lₐ₂₇₈₅ | L_{b56} |
| 3265 | Lₐ₁₉₆₂ | L_{b57} | 3266 | Lₐ₂₇₈₅ | L_{b57} |
| 3267 | Lₐ₁₉₆₂ | L_{b58} | 3268 | Lₐ₂₇₈₅ | L_{b58} |
| 3269 | Lₐ₁₉₆₂ | L_{b59} | 3270 | Lₐ₂₇₈₅ | L_{b59} |
| 3271 | Lₐ₁₉₆₂ | L_{b66} | 3272 | Lₐ₂₇₈₅ | L_{b66} |
| 3273 | Lₐ₁₉₆₂ | L_{b68} | 3274 | Lₐ₂₇₈₅ | L_{b68} |
| 3275 | Lₐ₁₉₆₂ | L_{b70} | 3276 | Lₐ₂₇₈₅ | L_{b70} |
| 3277 | Lₐ₁₉₆₂ | L_{b75} | 3278 | Lₐ₂₇₈₅ | L_{b75} |
| 3279 | Lₐ₁₉₆₂ | L_{b76} | 3280 | Lₐ₂₇₈₅ | L_{b76} |
| 3281 | Lₐ₁₉₆₂ | L_{b87} | 3282 | Lₐ₂₇₈₅ | L_{b87} |
| 3283 | Lₐ₁₉₆₂ | L_{b95} | 3284 | Lₐ₂₇₈₅ | L_{b95} |
| 3285 | Lₐ₁₉₆₂ | L_{b96} | 3286 | Lₐ₂₇₈₅ | L_{b96} |
| 3287 | Lₐ₁₉₆₂ | L_{b97} | 3288 | Lₐ₂₇₈₅ | L_{b97} |
| 3289 | Lₐ₁₉₆₂ | L_{b98} | 3290 | Lₐ₂₇₈₅ | L_{b98} |
| 3291 | Lₐ₁₉₆₂ | L_{b109} | 3292 | Lₐ₂₇₈₅ | L_{b109} |
| 3293 | Lₐ₁₉₆₂ | L_{b110} | 3294 | Lₐ₂₇₈₅ | L_{b110} |
| 3295 | Lₐ₁₉₆₂ | L_{b111} | 3296 | Lₐ₂₇₈₅ | L_{b111} |
| 3297 | Lₐ₁₉₆₂ | L_{b112} | 3298 | Lₐ₂₇₈₅ | L_{b112} |
| 3299 | Lₐ₁₉₆₂ | L_{b114} | 3300 | Lₐ₂₇₈₅ | L_{b114} |
| 3301 | Lₐ₁₉₆₂ | L_{b117} | 3302 | Lₐ₂₇₈₅ | L_{b117} |
| 3303 | Lₐ₁₉₆₂ | L_{b122} | 3304 | Lₐ₂₇₈₅ | L_{b122} |
| 3305 | Lₐ₁₉₆₂ | L_{b123} | 3306 | Lₐ₂₇₈₅ | L_{b123} |
| 3307 | Lₐ₁₉₆₂ | L_{b129} | 3308 | Lₐ₂₇₈₅ | L_{b129} |
| 3309 | Lₐ₁₉₆₂ | L_{b130} | 3310 | Lₐ₂₇₈₅ | L_{b130} |
| 3311 | Lₐ₁₉₆₂ | L_{b131} | 3312 | Lₐ₂₇₈₅ | L_{b131} |
| 3313 | Lₐ₁₉₆₂ | L_{b133} | 3314 | Lₐ₂₇₈₅ | L_{b133} |
| 3315 | Lₐ₁₉₆₂ | L_{b134} | 3316 | Lₐ₂₇₈₅ | L_{b134} |
| 3317 | Lₐ₁₉₆₂ | L_{b135} | 3318 | Lₐ₂₇₈₅ | L_{b135} |
| 3319 | Lₐ₁₉₆₂ | L_{b148} | 3320 | Lₐ₂₇₈₅ | L_{b148} |
| 3321 | Lₐ₁₉₆₂ | L_{b149} | 3322 | Lₐ₂₇₈₅ | L_{b149} |
| 3323 | Lₐ₁₉₆₂ | L_{b150} | 3324 | Lₐ₂₇₈₅ | L_{b150} |
| 3325 | Lₐ₁₉₆₂ | L_{b151} | 3326 | Lₐ₂₇₈₅ | L_{b151} |
| 3327 | Lₐ₁₆₄₇ | L_{b2} | 3328 | Lₐ₁₆₇₇ | L_{b2} |
| 3329 | Lₐ₁₆₄₇ | L_{b4} | 3330 | Lₐ₁₆₇₇ | L_{b4} |
| 3331 | Lₐ₁₆₄₇ | L_{b5} | 3332 | Lₐ₁₆₇₇ | L_{b5} |
| 3333 | Lₐ₁₆₄₇ | L_{b10} | 3334 | Lₐ₁₆₇₇ | L_{b10} |
| 3335 | Lₐ₁₆₄₇ | L_{b11} | 3336 | Lₐ₁₆₇₇ | L_{b11} |
| 3337 | Lₐ₁₆₄₇ | L_{b12} | 3338 | Lₐ₁₆₇₇ | L_{b12} |
| 3339 | Lₐ₁₆₄₇ | L_{b13} | 3340 | Lₐ₂₈₅₆ | L_{b13} |
| 3341 | Lₐ₁₆₄₇ | L_{b14} | 3342 | Lₐ₂₈₅₆ | L_{b14} |
| 3343 | Lₐ₁₆₄₇ | L_{b15} | 3344 | Lₐ₂₈₅₆ | L_{b15} |
| 3345 | Lₐ₁₆₄₇ | L_{b17} | 3346 | Lₐ₂₈₅₆ | L_{b17} |
| 3347 | Lₐ₁₆₄₈ | L_{b19} | 3348 | Lₐ₂₈₅₆ | L_{b19} |
| 3349 | Lₐ₁₆₄₈ | L_{b21} | 3350 | Lₐ₂₈₅₆ | L_{b21} |
| 3351 | Lₐ₁₆₄₈ | L_{b22} | 3352 | Lₐ₂₈₅₆ | L_{b22} |
| 3353 | Lₐ₁₆₄₈ | L_{b23} | 3354 | Lₐ₁₆₅₁ | L_{b23} |
| 3355 | Lₐ₁₆₄₈ | L_{b24} | 3356 | Lₐ₁₆₅₁ | L_{b24} |
| 3357 | Lₐ₁₆₄₈ | L_{b25} | 3358 | Lₐ₁₆₅₁ | L_{b25} |
| 3359 | Lₐ₁₆₄₈ | L_{b26} | 3360 | Lₐ₁₆₅₁ | L_{b26} |
| 3361 | Lₐ₁₆₄₉ | L_{b27} | 3362 | Lₐ₁₆₅₁ | L_{b27} |
| 3363 | Lₐ₁₆₄₉ | L_{b28} | 3364 | Lₐ₁₆₅₁ | L_{b28} |
| 3365 | Lₐ₁₆₄₉ | L_{b29} | 3366 | Lₐ₁₆₅₁ | L_{b29} |
| 3367 | Lₐ₁₆₄₉ | L_{b30} | 3368 | Lₐ₁₆₅₁ | L_{b30} |
| 3369 | Lₐ₁₆₄₉ | L_{b31} | 3370 | Lₐ₁₆₅₁ | L_{b31} |
| 3371 | Lₐ₁₆₄₉ | L_{b32} | 3372 | Lₐ₁₆₇₈ | L_{b32} |
| 3373 | Lₐ₁₆₄₉ | L_{b33} | 3374 | Lₐ₁₆₇₈ | L_{b33} |
| 3375 | Lₐ₁₆₄₉ | L_{b42} | 3376 | Lₐ₁₆₇₈ | L_{b42} |
| 3377 | Lₐ₁₆₄₉ | L_{b43} | 3378 | Lₐ₁₆₇₈ | L_{b43} |
| 3379 | Lₐ₁₆₄₉ | L_{b44} | 3380 | Lₐ₁₆₇₈ | L_{b44} |
| 3381 | Lₐ₁₆₄₉ | L_{b45} | 3382 | Lₐ₁₆₇₈ | L_{b45} |
| 3383 | Lₐ₁₆₄₉ | L_{b46} | 3384 | Lₐ₁₆₇₈ | L_{b46} |
| 3385 | Lₐ₁₆₅₀ | L_{b50} | 3386 | Lₐ₁₆₇₈ | L_{b50} |
| 3387 | Lₐ₁₆₅₀ | L_{b51} | 3388 | Lₐ₂₁₀₄ | L_{b51} |
| 3389 | Lₐ₁₆₅₀ | L_{b53} | 3390 | Lₐ₂₁₀₄ | L_{b53} |
| 3391 | Lₐ₁₆₅₀ | L_{b54} | 3392 | Lₐ₂₁₀₄ | L_{b54} |
| 3393 | Lₐ₁₆₅₀ | L_{b55} | 3394 | Lₐ₂₁₀₄ | L_{b55} |
| 3395 | Lₐ₁₆₅₀ | L_{b56} | 3396 | Lₐ₂₁₀₄ | L_{b56} |
| 3397 | Lₐ₁₆₅₀ | L_{b57} | 3398 | Lₐ₂₁₀₄ | L_{b57} |
| 3399 | Lₐ₁₆₅₀ | L_{b58} | 3400 | Lₐ₂₁₀₄ | L_{b58} |
| 3401 | Lₐ₁₆₅₀ | L_{b59} | 3402 | Lₐ₂₁₀₄ | L_{b59} |
| 3403 | Lₐ₉₂₈ | L_{b66} | 3404 | Lₐ₂₁₀₄ | L_{b66} |
| 3405 | Lₐ₉₂₈ | L_{b68} | 3406 | Lₐ₂₁₀₄ | L_{b68} |
| 3407 | Lₐ₉₂₈ | L_{b70} | 3408 | Lₐ₂₁₀₄ | L_{b70} |
| 3409 | Lₐ₉₂₈ | L_{b75} | 3410 | Lₐ₂₉₂₇ | L_{b75} |
| 3411 | Lₐ₉₂₈ | L_{b76} | 3412 | Lₐ₂₉₂₇ | L_{b76} |
| 3413 | Lₐ₉₂₈ | L_{b87} | 3414 | Lₐ₂₉₂₇ | L_{b87} |
| 3415 | Lₐ₉₂₈ | L_{b95} | 3416 | Lₐ₂₉₂₇ | L_{b95} |
| 3417 | Lₐ₉₂₈ | L_{b96} | 3418 | Lₐ₂₉₂₇ | L_{b96} |
| 3419 | Lₐ₂₇₁₄ | L_{b97} | 3420 | Lₐ₂₉₂₇ | L_{b97} |
| 3421 | Lₐ₂₇₁₄ | L_{b98} | 3422 | Lₐ₂₉₂₇ | L_{b98} |
| 3423 | Lₐ₂₇₁₄ | L_{b109} | 3424 | Lₐ₂₉₂₇ | L_{b109} |
| 3425 | Lₐ₂₇₁₄ | L_{b110} | 3426 | Lₐ₂₉₂₇ | L_{b110} |
| 3427 | Lₐ₂₇₁₄ | L_{b111} | 3428 | Lₐ₁₆₇₉ | L_{b111} |
| 3429 | Lₐ₂₇₁₄ | L_{b112} | 3430 | Lₐ₁₆₇₉ | L_{b112} |
| 3431 | Lₐ₂₇₁₄ | L_{b114} | 3432 | Lₐ₁₆₇₉ | L_{b114} |
| 3433 | Lₐ₂₇₁₄ | L_{b117} | 3434 | Lₐ₁₆₇₉ | L_{b117} |
| 3435 | Lₐ₂₇₁₄ | L_{b122} | 3436 | Lₐ₁₆₇₉ | L_{b122} |
| 3437 | Lₐ₂₆₄₃ | L_{b123} | 3438 | Lₐ₁₆₇₉ | L_{b123} |
| 3439 | Lₐ₂₆₄₃ | L_{b129} | 3440 | Lₐ₁₆₇₉ | L_{b129} |
| 3441 | Lₐ₂₆₄₃ | L_{b130} | 3442 | Lₐ₁₆₇₉ | L_{b130} |
| 3443 | Lₐ₂₆₄₃ | L_{b131} | 3444 | Lₐ₁₆₈₀ | L_{b131} |
| 3445 | Lₐ₂₆₄₃ | L_{b133} | 3446 | Lₐ₁₆₈₀ | L_{b133} |
| 3447 | Lₐ₂₆₄₃ | L_{b134} | 3448 | Lₐ₁₆₈₀ | L_{b134} |
| 3449 | Lₐ₂₆₄₃ | L_{b135} | 3450 | Lₐ₁₆₈₀ | L_{b135} |
| 3451 | Lₐ₂₀₃₃ | L_{b148} | 3452 | Lₐ₁₆₈₀ | L_{b148} |
| 3453 | Lₐ₂₀₃₃ | L_{b149} | 3454 | Lₐ₁₆₈₀ | L_{b149} |
| 3455 | Lₐ₂₀₃₃ | L_{b150} | 3456 | Lₐ₁₆₈₀ | L_{b150} |
| 3457 | Lₐ₂₀₃₃ | L_{b151} | 3458 | Lₐ₁₆₈₀ | L_{b151} |
| 3459 | Lₐ₁₇₉₅ | L_{b2} | 3460 | Lₐ₁₅₇₀ | L_{b2} |
| 3461 | Lₐ₁₇₉₅ | L_{b4} | 3462 | Lₐ₁₅₇₀ | L_{b4} |
| 3463 | Lₐ₁₇₉₅ | L_{b5} | 3464 | Lₐ₁₅₇₀ | L_{b5} |
| 3465 | Lₐ₁₇₉₅ | L_{b10} | 3466 | Lₐ₁₅₇₀ | L_{b10} |
| 3467 | Lₐ₁₇₉₅ | L_{b11} | 3468 | Lₐ₁₅₇₀ | L_{b11} |
| 3469 | Lₐ₁₇₉₅ | L_{b12} | 3470 | Lₐ₁₅₇₀ | L_{b12} |
| 3471 | Lₐ₁₇₉₅ | L_{b13} | 3472 | Lₐ₁₅₇₀ | L_{b13} |
| 3473 | Lₐ₁₇₉₅ | L_{b14} | 3474 | Lₐ₁₅₇₀ | L_{b14} |
| 3475 | Lₐ₁₇₉₅ | L_{b15} | 3476 | Lₐ₁₅₇₀ | L_{b15} |
| 3477 | Lₐ₁₇₉₅ | L_{b17} | 3478 | Lₐ₁₅₇₀ | L_{b17} |
| 3479 | Lₐ₁₈₂₀ | L_{b19} | 3480 | Lₐ₁₅₇₀ | L_{b19} |
| 3481 | Lₐ₁₈₂₀ | L_{b21} | 3482 | Lₐ₁₅₇₀ | L_{b21} |
| 3483 | Lₐ₁₈₂₀ | L_{b22} | 3484 | Lₐ₁₆₉₁ | L_{b22} |
| 3485 | Lₐ₁₈₂₀ | L_{b23} | 3486 | Lₐ₁₆₉₁ | L_{b23} |
| 3487 | Lₐ₁₈₂₀ | L_{b24} | 3488 | Lₐ₁₆₉₁ | L_{b24} |
| 3489 | Lₐ₁₈₂₀ | L_{b25} | 3490 | Lₐ₁₆₉₁ | L_{b25} |
| 3491 | Lₐ₁₈₂₀ | L_{b26} | 3492 | Lₐ₁₆₉₁ | L_{b26} |
| 3493 | Lₐ₁₈₂₀ | L_{b27} | 3494 | Lₐ₁₆₉₁ | L_{b27} |
| 3495 | Lₐ₁₈₂₀ | L_{b28} | 3496 | Lₐ₁₆₉₁ | L_{b28} |
| 3497 | Lₐ₁₈₂₀ | L_{b29} | 3498 | Lₐ₁₆₉₁ | L_{b29} |
| 3499 | Lₐ₂₄₃₇ | L_{b30} | 3500 | Lₐ₁₆₉₁ | L_{b30} |
| 3501 | Lₐ₂₄₃₇ | L_{b31} | 3502 | Lₐ₁₆₉₁ | L_{b31} |
| 3503 | Lₐ₂₄₃₇ | L_{b32} | 3504 | Lₐ₁₆₉₁ | L_{b32} |
| 3505 | Lₐ₂₄₃₇ | L_{b33} | 3506 | Lₐ₁₆₉₁ | L_{b33} |
| 3507 | Lₐ₂₄₃₇ | L_{b42} | 3508 | Lₐ₂₄₃₆ | L_{b42} |
| 3509 | Lₐ₂₄₃₇ | L_{b43} | 3510 | Lₐ₂₄₃₆ | L_{b43} |
| 3511 | Lₐ₂₄₃₇ | L_{b44} | 3512 | Lₐ₂₄₃₆ | L_{b44} |
| 3513 | Lₐ₂₄₃₇ | L_{b45} | 3514 | Lₐ₂₄₃₆ | L_{b45} |
| 3515 | Lₐ₂₄₃₇ | L_{b46} | 3516 | Lₐ₂₄₃₆ | L_{b46} |
| 3517 | Lₐ₂₄₃₇ | L_{b50} | 3518 | Lₐ₂₄₃₆ | L_{b50} |
| 3519 | Lₐ₂₄₃₇ | L_{b51} | 3520 | Lₐ₂₄₃₆ | L_{b51} |
| 3521 | Lₐ₂₄₃₇ | L_{b53} | 3522 | Lₐ₂₄₃₆ | L_{b53} |
| 3523 | Lₐ₂₄₃₇ | L_{b54} | 3524 | Lₐ₂₄₃₆ | L_{b54} |
| 3525 | Lₐ₂₄₃₇ | L_{b55} | 3526 | Lₐ₂₄₃₆ | L_{b55} |
| 3527 | Lₐ₂₄₃₇ | L_{b56} | 3528 | Lₐ₂₄₃₆ | L_{b56} |
| 3529 | Lₐ₂₄₃₇ | L_{b57} | 3530 | Lₐ₂₄₃₆ | L_{b57} |
| 3531 | Lₐ₂₄₃₇ | L_{b58} | 3532 | Lₐ₂₄₃₆ | L_{b58} |
| 3533 | Lₐ₂₄₃₇ | L_{b59} | 3534 | Lₐ₂₄₃₆ | L_{b59} |
| 3535 | Lₐ₂₄₃₇ | L_{b66} | 3536 | Lₐ₂₄₃₆ | L_{b66} |
| 3537 | Lₐ₂₄₃₇ | L_{b68} | 3538 | Lₐ₂₄₃₆ | L_{b68} |
| 3539 | Lₐ₂₄₃₇ | L_{b70} | 3540 | Lₐ₂₄₃₆ | L_{b70} |
| 3541 | Lₐ₂₆₁₈ | L_{b75} | 3542 | Lₐ₂₄₃₆ | L_{b75} |
| 3543 | Lₐ₂₆₁₈ | L_{b76} | 3544 | Lₐ₂₄₃₆ | L_{b76} |
| 3545 | Lₐ₂₆₁₈ | L_{b87} | 3546 | Lₐ₂₄₃₆ | L_{b87} |
| 3547 | Lₐ₂₆₁₈ | L_{b95} | 3548 | Lₐ₂₄₃₆ | L_{b95} |
| 3549 | Lₐ₂₆₁₈ | L_{b96} | 3550 | Lₐ₂₄₃₆ | L_{b96} |
| 3551 | Lₐ₂₆₁₈ | L_{b97} | 3552 | Lₐ₂₄₃₆ | L_{b97} |
| 3553 | Lₐ₂₆₁₈ | L_{b98} | 3554 | Lₐ₂₄₃₆ | L_{b98} |
| 3555 | Lₐ₂₆₁₈ | L_{b109} | 3556 | Lₐ₂₄₃₆ | L_{b109} |
| 3557 | Lₐ₂₆₁₈ | L_{b110} | 3558 | Lₐ₃₃₆₅ | L_{b110} |
| 3559 | Lₐ₂₆₁₈ | L_{b111} | 3560 | Lₐ₃₃₆₅ | L_{b111} |
| 3561 | Lₐ₂₆₁₈ | L_{b112} | 3562 | Lₐ₃₃₆₅ | L_{b112} |
| 3563 | Lₐ₂₆₁₈ | L_{b114} | 3564 | Lₐ₃₃₆₅ | L_{b114} |
| 3565 | Lₐ₂₆₁₈ | L_{b117} | 3566 | Lₐ₃₃₆₅ | L_{b117} |
| 3567 | Lₐ₂₆₁₈ | L_{b122} | 3568 | Lₐ₃₃₆₅ | L_{b122} |
| 3569 | Lₐ₃₃₄₁ | L_{b123} | 3570 | Lₐ₃₃₆₅ | L_{b123} |
| 3571 | Lₐ₃₃₄₁ | L_{b129} | 3572 | Lₐ₃₃₆₅ | L_{b129} |
| 3573 | Lₐ₃₃₄₁ | L_{b130} | 3574 | Lₐ₃₃₆₅ | L_{b130} |
| 3575 | Lₐ₃₃₄₁ | L_{b131} | 3576 | Lₐ₃₃₆₅ | L_{b131} |
| 3577 | Lₐ₃₃₄₁ | L_{b133} | 3578 | Lₐ₃₃₆₅ | L_{b133} |
| 3579 | Lₐ₃₃₄₁ | L_{b134} | 3580 | Lₐ₃₃₆₅ | L_{b134} |
| 3581 | Lₐ₃₃₄₁ | L_{b135} | 3582 | Lₐ₃₃₆₅ | L_{b135} |
| 3583 | Lₐ₃₃₄₁ | L_{b148} | 3584 | Lₐ₃₃₆₅ | L_{b148} |
| 3585 | Lₐ₃₃₄₁ | L_{b149} | 3586 | Lₐ₃₃₆₅ | L_{b149} |
| 3587 | Lₐ₃₃₄₁ | L_{b150} | 3588 | Lₐ₃₃₆₅ | L_{b150} |
| 3589 | Lₐ₃₃₄₁ | L_{b151} | 3590 | Lₐ₃₃₆₅ | L_{b151} |
| 3591 | Lₐ₃₃₆₇ | L_{b52} | 3592 | Lₐ₃₃₉₁ | L_{b52} |
| 3593 | Lₐ₃₃₆₈ | L_{b52} | 3594 | Lₐ₃₄₀₀ | L_{b52} |
| 3595 | Lₐ₃₃₈₁ | L_{b52} | 3596 | Lₐ₃₄₁₆ | L_{b52} |
| 3597 | Lₐ₃₃₆₇ | L_{b52} | 3598 | Lₐ₃₃₆₇ | L_{b20} |
| 3599 | Lₐ₃₃₆₈ | L_{b52} | 3600 | Lₐ₃₃₆₈ | L_{b20} |
| 3601 | Lₐ₃₃₆₉ | L_{b52} | 3602 | Lₐ₃₃₆₉ | L_{b20} |
| 3603 | Lₐ₃₃₇₀ | L_{b52} | 3604 | Lₐ₃₃₇₀ | L_{b20} |
| 3605 | Lₐ₃₃₇₁ | L_{b52} | 3606 | Lₐ₃₃₇₁ | L_{b20} |
| 3607 | Lₐ₃₃₇₂ | L_{b52} | 3608 | Lₐ₃₃₇₂ | L_{b20} |
| 3609 | Lₐ₃₃₇₃ | L_{b52} | 3610 | Lₐ₃₃₇₃ | L_{b20} |
| 3611 | Lₐ₃₃₇₄ | L_{b52} | 3612 | Lₐ₃₃₇₄ | L_{b20} |
| 3613 | Lₐ₃₃₇₅ | L_{b52} | 3614 | Lₐ₃₃₇₅ | L_{b20} |
| 3615 | Lₐ₃₃₇₆ | L_{b52} | 3616 | Lₐ₃₃₇₆ | L_{b20} |
| 3617 | Lₐ₃₃₇₇ | L_{b52} | 3618 | Lₐ₃₃₇₇ | L_{b20} |
| 3619 | Lₐ₃₃₇₈ | L_{b52} | 3620 | Lₐ₃₃₇₈ | L_{b20} |
| 3621 | Lₐ₃₃₇₉ | L_{b52} | 3622 | Lₐ₃₃₇₉ | L_{b20} |
| 3623 | Lₐ₃₃₈₀ | L_{b52} | 3624 | Lₐ₃₃₈₀ | L_{b20} |
| 3625 | Lₐ₃₃₈₁ | L_{b52} | 3626 | Lₐ₃₃₈₁ | L_{b20} |
| 3627 | Lₐ₃₃₈₂ | L_{b52} | 3628 | Lₐ₃₃₈₂ | L_{b20} |
| 3629 | Lₐ₃₄₀₈ | L_{b52} | 3630 | Lₐ₃₄₀₈ | L_{b20} |
| 3631 | Lₐ₃₄₀₉ | L_{b52} | 3632 | Lₐ₃₄₀₉ | L_{b20} |
| 3633 | Lₐ₃₄₁₀ | L_{b52} | 3634 | Lₐ₃₄₁₀ | L_{b20} |
| 3635 | Lₐ₃₄₂₃ | L_{b52} | 3636 | Lₐ₃₄₂₃ | L_{b20} |
| 3637 | Lₐ₃₄₂₄ | L_{b52} | 3638 | Lₐ₃₄₂₄ | L_{b20} |
| 3639 | Lₐ₃₄₂₅ | L_{b52} | 3640 | Lₐ₃₄₂₅ | L_{b20} |
| 3641 | Lₐ₃₄₅₃ | L_{b52} | 3642 | Lₐ₃₄₅₃ | L_{b20} |
| 3643 | Lₐ₃₄₅₄ | L_{b52} | 3644 | Lₐ₃₄₅₄ | L_{b20} |
| 3645 | Lₐ₃₄₅₅ | L_{b52} | 3646 | Lₐ₃₄₅₅ | L_{b20} |
| 3647 | Lₐ₃₃₈₃ | L_{b52} | 3648 | Lₐ₃₃₈₃ | L_{b20} |
| 3649 | Lₐ₃₃₈₄ | L_{b52} | 3650 | Lₐ₃₃₈₄ | L_{b20} |
| 3651 | Lₐ₃₃₈₅ | L_{b52} | 3652 | Lₐ₃₃₈₅ | L_{b20} |
| 3653 | Lₐ₃₃₈₆ | L_{b52} | 3654 | Lₐ₃₃₈₆ | L_{b20} |
| 3655 | Lₐ₃₃₈₇ | L_{b52} | 3656 | Lₐ₃₃₈₇ | L_{b20} |
| 3657 | Lₐ₃₃₈₈ | L_{b52} | 3658 | Lₐ₃₃₈₈ | L_{b20} |
| 3659 | Lₐ₃₃₈₉ | L_{b52} | 3660 | Lₐ₃₃₈₉ | L_{b20} |
| 3661 | Lₐ₃₃₉₀ | L_{b52} | 3662 | Lₐ₃₃₉₀ | L_{b20} |
| 3663 | Lₐ₃₃₉₁ | L_{b52} | 3664 | Lₐ₃₃₉₁ | L_{b20} |
| 3665 | Lₐ₃₃₉₂ | L_{b52} | 3666 | Lₐ₃₃₉₂ | L_{b20} |
| 3667 | Lₐ₄₂₀ | L_{b52} | 3668 | Lₐ₄₉₀ | L_{b52} |
| 3669 | Lₐ₄₂₀ | L_{b20} | 3670 | Lₐ₄₉₀ | L_{b20} |
| 3671 | Lₐ₄₂₀ | L_{b135} | 3672 | Lₐ₄₉₀ | L_{b135} |
| 3673 | Lₐ₄₂₀ | L_{b1} | 3674 | Lₐ₄₉₀ | L_{b1} |
| 3675 | Lₐ₄₂₀ | L_{b3} | 3676 | Lₐ₄₉₀ | L_{b3} |
| 3677 | Lₐ₄₂₀ | L_{b8} | 3678 | Lₐ₄₉₀ | L_{b8} |
| 3679 | Lₐ₄₂₀ | L_{b118} | 3680 | Lₐ₄₉₀ | L_{b118} |
| 3681 | Lₐ₄₂₀ | L_{b132} | 3682 | Lₐ₄₉₀ | L_{b132} |
| 3683 | Lₐ₄₂₀ | L_{b150} | 3684 | Lₐ₄₉₀ | L_{b150} |
| 3685 | Lₐ₄₂₀ | L_{b151} | 3686 | Lₐ₄₉₀ | L_{b151} |
| 3687 | Lₐ₁₃₆ | L_{b135} | 3688 | Lₐ₁₅₇ | L_{b135} |
| 3689 | Lₐ₁₃₆ | L_{b150} | 3690 | Lₐ₁₅₇ | L_{b150} |
| 3691 | Lₐ₁₃₆ | L_{b151} | 3692 | Lₐ₁₅₇ | L_{b151} |
| 3693 | Lₐ₂₇₈ | L_{b135} | 3694 | Lₐ₆ | L_{b52} |
| 3695 | Lₐ₂₇₈ | L_{b150} | 3696 | Lₐ₆ | L_{b20} |
| 3697 | Lₐ₂₇₈ | L_{b151} | 3698 | Lₐ₆ | L_{b135} |
| 3699 | Lₐ₁₀₆ | L_{b52} | 3700 | Lₐ₆ | L_{b1} |
| 3701 | Lₐ₁₀₆ | L_{b20} | 3702 | Lₐ₆ | L_{b3} |
| 3703 | Lₐ₁₀₆ | L_{b135} | 3704 | Lₐ₆ | L_{b8} |
| 3705 | Lₐ₁₀₆ | L_{b1} | 3706 | Lₐ₆ | L_{b118} |
| 3707 | Lₐ₁₀₆ | L_{b3} | 3708 | Lₐ₆ | L_{b132} |
| 3709 | Lₐ₁₀₆ | L_{b8} | 3710 | Lₐ₆ | L_{b150} |
| 3711 | Lₐ₁₀₆ | L_{b118} | 3712 | Lₐ₆ | L_{b151} |
| 3713 | Lₐ₁₀₆ | L_{b132} | 3714 | Lₐ₁₁₁ | L_{b52} |
| 3715 | Lₐ₁₀₆ | L_{b150} | 3716 | Lₐ₁₁₁ | L_{b20} |
| 3717 | Lₐ₁₀₆ | L_{b151} | 3718 | Lₐ₁₁₁ | L_{b135} |
| 3719 | Lₐ₄₉ | L_{b52} | 3720 | Lₐ₁₁₁ | L_{b1} |
| 3721 | Lₐ₄₉ | L_{b20} | 3722 | Lₐ₁₁₁ | L_{b3} |
| 3723 | Lₐ₄₉ | L_{b135} | 3724 | Lₐ₁₁₁ | L_{b8} |
| 3725 | Lₐ₄₉ | L_{b1} | 3726 | Lₐ₁₁₁ | L_{b118} |
| 3727 | Lₐ₄₉ | L_{b3} | 3728 | Lₐ₁₁₁ | L_{b132} |
| 3729 | Lₐ₄₉ | L_{b8} | 3730 | Lₐ₁₁₁ | L_{b150} |
| 3731 | Lₐ₄₉ | L_{b118} | 3732 | Lₐ₁₁₁ | L_{b151} |
| 3733 | Lₐ₄₉ | L_{b132} | 3734 | Lₐ₂₂₈ | L_{b52} |
| 3735 | Lₐ₄₉ | L_{b150} | 3736 | Lₐ₂₂₈ | L_{b20} |
| 3737 | Lₐ₄₉ | L_{b151} | 3738 | Lₐ₂₂₈ | L_{b135} |
| 3739 | Lₐ₂₀₇ | L_{b52} | 3740 | Lₐ₂₂₈ | L_{b1} |
| 3741 | Lₐ₂₀₇ | L_{b20} | 3742 | Lₐ₂₂₈ | L_{b3} |
| 3743 | Lₐ₂₀₇ | L_{b135} | 3744 | Lₐ₂₂₈ | L_{b8} |
| 3745 | Lₐ₂₀₇ | L_{b1} | 3746 | Lₐ₂₂₈ | L_{b118} |
| 3747 | Lₐ₂₀₇ | L_{b3} | 3748 | Lₐ₂₂₈ | L_{b132} |
| 3749 | Lₐ₂₀₇ | L_{b8} | 3750 | Lₐ₂₂₈ | L_{b150} |
| 3751 | Lₐ₂₀₇ | L_{b118} | 3752 | Lₐ₂₂₈ | L_{b151} |
| 3753 | Lₐ₂₀₇ | L_{b132} | 3754 | Lₐ₃₇₀ | L_{b52} |
| 3755 | Lₐ₂₀₇ | L_{b150} | 3756 | Lₐ₃₇₀ | L_{b20} |
| 3757 | Lₐ₂₀₇ | L_{b151} | 3758 | Lₐ₃₇₀ | L_{b135} |
| 3759 | Lₐ₃₄₉ | L_{b52} | 3760 | Lₐ₃₇₀ | L_{b1} |
| 3761 | Lₐ₃₄₉ | L_{b20} | 3762 | Lₐ₃₇₀ | L_{b3} |
| 3763 | Lₐ₃₄₉ | L_{b135} | 3764 | Lₐ₃₇₀ | L_{b8} |
| 3765 | Lₐ₃₄₉ | L_{b1} | 3766 | Lₐ₃₇₀ | L_{b118} |
| 3767 | Lₐ₃₄₉ | L_{b3} | 3768 | Lₐ₃₇₀ | L_{b132} |
| 3769 | Lₐ₃₄₉ | L_{b8} | 3770 | Lₐ₃₇₀ | L_{b150} |
| 3771 | Lₐ₃₄₉ | L_{b118} | 3772 | Lₐ₃₇₀ | L_{b151} |
| 3773 | Lₐ₃₄₉ | L_{b132} | 3774 | Lₐ₅₁₁ | L_{b52} |
| 3775 | Lₐ₃₄₉ | L_{b150} | 3776 | Lₐ₅₁₁ | L_{b20} |
| 3777 | Lₐ₃₄₉ | L_{b151} | 3778 | Lₐ₅₁₁ | L_{b135} |
| 3779 | Lₐ₅₈₁ | L_{b52} | 3780 | Lₐ₅₁₁ | L_{b1} |
| 3781 | Lₐ₅₈₁ | L_{b20} | 3782 | Lₐ₅₁₁ | L_{b3} |
| 3783 | Lₐ₅₈₁ | L_{b135} | 3784 | Lₐ₅₁₁ | L_{b8} |
| 3785 | Lₐ₅₈₁ | L_{b1} | 3786 | Lₐ₅₁₁ | L_{b118} |
| 3787 | Lₐ₅₈₁ | L_{b3} | 3788 | Lₐ₅₁₁ | L_{b132} |
| 3789 | Lₐ₅₈₁ | L_{b8} | 3790 | Lₐ₅₁₁ | L_{b150} |
| 3791 | Lₐ₅₈₁ | L_{b118} | 3792 | Lₐ₅₁₁ | L_{b151} |
| 3793 | Lₐ₅₈₁ | L_{b132} | 3794 | Lₐ₅₆₀ | L_{b52} |
| 3795 | Lₐ₅₈₁ | L_{b150} | 3796 | Lₐ₅₆₀ | L_{b20} |
| 3797 | Lₐ₅₈₁ | L_{b151} | 3798 | Lₐ₅₆₀ | L_{b135} |
| 3799 | Lₐ₅₆₀ | L_{b118} | 3800 | Lₐ₅₆₀ | L_{b1} |
| 3801 | Lₐ₅₆₀ | L_{b132} | 3802 | Lₐ₅₆₀ | L_{b3} |
| 3803 | Lₐ₅₆₀ | L_{b150} | 3804 | Lₐ₅₆₀ | L_{b8} |
| 3805 | Lₐ₅₆₀ | L_{b151} | 3806 | Lₐ₅₆₀ | L_{b31} |

14. Dispositif électroluminescent organique, comprenant :
une anode,
une cathode, et
une couche organique disposée entre l'anode et la cathode, dans lequel au moins une couche de la couche organique comprend le complexe métallique selon l'une quelconque des revendications 1 à 13 ;
de préférence, dans lequel la couche organique comprenant le complexe métallique est une couche électroluminescente ;
de préférence, dans lequel la couche électroluminescente comprend en outre un premier composé hôte ;
de préférence, la couche électroluminescente comprend en outre un deuxième composé hôte ; et
plus préférablement, le premier composé hôte et/ou le deuxième composé hôte comprennent au moins un groupe chimique choisi parmi : le benzène, la pyridine, la pyrimidine, la triazine, le carbazole, l'azacarbazole, l'indolocarbazole, le dibenzothiophène, l'aza-dibenzothiophène, le dibenzofurane, l'azadibenzofurane, le dibenzosélénophène, le triphénylène, l'azatriphénylène, le fluorène, le silafluorène, le naphtalène, la quinoléine, l'isoquinoléine, la quinazoline, la quinoxaline, le phénanthrène, l'azaphénanthrène et les combinaisons de ceux-ci ;
de préférence, dans lequel le complexe métallique est dopé dans le premier composé hôte et le deuxième composé hôte, et le poids du complexe métallique représente 1% à 30% du poids total de la couche électroluminescente ; et
plus préférablement, le poids du complexe métallique représente 3% à 13% du poids total de la couche électroluminescente.

15. Composition, comprenant le complexe métallique selon l'une quelconque des revendications 1 à 13.
